(19) Europäisches Patentamt
European Patent Office
Office européen des brevets

(11) **EP 3 247 043 A1**

(12) **EUROPEAN PATENT APPLICATION**
published in accordance with Art. 153(4) EPC

(43) Date of publication:
**22.11.2017 Bulletin 2017/47**

(51) Int Cl.:
**H03M 13/19** *(2006.01)*    **H03M 13/27** *(2006.01)*

(21) Application number: **16737227.5**

(22) Date of filing: **04.01.2016**

(86) International application number:
**PCT/JP2016/050017**

(87) International publication number:
**WO 2016/114156 (21.07.2016 Gazette 2016/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **13.01.2015 US 201562102941 P**
**20.01.2015 US 201562105494 P**
**31.08.2015 US 201514840888**

(71) Applicant: **Sony Corporation**
**Tokyo 108-0075 (JP)**

(72) Inventors:
• **IKEGAYA Ryoji**
  **Tokyo 108-0075 (JP)**
• **YAMAMOTO Makiko**
  **Tokyo 108-0075 (JP)**
• **MICHAEL Lachlan Bruce**
  **Tokyo 108-0075 (JP)**
• **LOGHIN Muhammad Nabil Sven**
  **Tokyo 108-0075 (JP)**
• **SHINOHARA Yuji**
  **Tokyo 108-0075 (JP)**

(74) Representative: **Witte, Weller & Partner**
**Patentanwälte mbB**
**Postfach 10 54 62**
**70047 Stuttgart (DE)**

(54) **DATA PROCESSING DEVICE AND DATA PROCESSING METHOD**

(57) The present technology relates to a data processing device and a data processing method realizing efficient coexistence of a plurality of block interleave systems in data transmission using an LDPC code.

For group-wise interleave, group-wise interleave for an LDPC code of MODCOD-B is performed such that a block interleave result identical to a block interleave result of a type B is obtainable at the time of execution of a type A for block interleave of the LDPC code of the MODCOD-B, or group-wise interleave for an LDPC code of MODCOD-A is performed such that a block interleave result identical to a block interleave result of the type A is obtainable at the time of execution of the type B for block interleave of the LDPC code of the MODCOD-A. The present technology is applicable to data transmission using an LDPC code, for example.

*FIG. 231*

**Description**

TECHNICAL FIELD

The present technology relates to a data processing device and a data processing method, and more particularly to a data processing device and a data processing method realizing efficient coexistence of a plurality of block interleave systems in data transmission using an LDPC code, for example.

BACKGROUND ART

A part of information included in the present specification and drawings is provided by Samsung Electronics Co., Ltd. (hereinafter referred to as Samsung), LGE (LG Electronic) Inc., NERC, and CRC/ETRI (indicated in drawings).
A low density parity check (LDPC) code has a high error correcting capability, and therefore has been widely adopted for transmission systems such as digital broadcasting including digital video broadcasting (DVB)-S.2, DVB-T.2, and DVB-C.2 for Europe or other regions, and advanced television systems committee (ATSC) 3.0 for USA or other regions in recent years (for example, see Non-Patent Document 1).
It is becoming clear that performance of an LDPC code approaches a Shannon limit as the length of the code increases, similarly to a turbo code and the like. In addition, an LDPC code is characterized in that the minimum distance of the code is proportional to the length of the code, and therefore offers advantages such as an excellent block error probability characteristic, and substantially no occurrence of a so-called error floor phenomenon which may be observed in decoding performance of a turbo code or the like.

CITATION LIST

NON-PATENT DOCUMENT

Non-Patent Document 1: DVB-S2X: ETSI EN 302 307-2 V1.1.1 (2014-10)

SUMMARY OF THE INVENTION

PROBLEMS TO BE SOLVED BY THE INVENTION

In data transmission using an LDPC code, the LDPC code is a symbol (or symbolized) for quadrature modulation (digital modulation) such as quadrature phase shift keying (QPSK). This symbol is mapped at a signal point of the quadrature modulation, and transmitted in this state. Data transmission using the foregoing LDPC code has been spreading throughout the world.
Incidentally, a plurality of block interleave systems are used for some bit interleave of an LDPC code. Accordingly, realization of efficient coexistence of the plurality of block interleave systems has been demanded.
The present technology has been developed in consideration of the aforementioned circumstances, and realizes efficient coexistence of a plurality of block interleave systems in data transmission using an LDPC code.

SOLUTIONS TO PROBLEMS

A first data processing device/method according to the present technology includes: a group-wise interleave unit/step that performs group-wise interleave for interleaving a low-density parity-check (LDPC) code having a code length N of 16200 bits or 64800 bits in units of bit group of 360 bits; and a block interleave unit/step that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system. A system of block interleave performed by the block interleave unit/step includes a type A that repeats writing of the group-wise interleaved LDPC code to the m columns in a column direction of the columns, and a type B that repeats writing of the group-wise interleaved LDPC code to the m columns in a row direction of the columns in units of bit group. Modulation and coding (MODCOD) as a combination of the LDPC code and the modulation system includes MODCOD-A as MODCOD that assumes execution of block interleave of the type A, and MODCOD-B as MODCOD that assumes execution of block interleave of the type B. The group-wise interleave unit/the group-wise interleave performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A.

According to the first data processing device/method, group-wise interleave is performed to interleave a low-density parity-check (LDPC) code having a code length N of 16200 bits or 64800 bits in units of bit group of 360 bits. Block interleave is performed to write the group-wise interleaved LDPC code to m columns as storage areas arranged in a row direction, and block interleave m bits obtained by reading the LDPC code bit by bit from each of the m columns into one symbol corresponding to any one of $2^m$ signal points defined by a modulation system. A system of block interleave performed by the block interleave unit/step includes a type A that repeats writing of the group-wise interleaved LDPC code to the m columns in a column direction of the columns, and a type B that repeats writing of the group-wise interleaved LDPC code to the m columns in a row direction of the columns in units of bit group. Modulation and coding (MODCOD) as a combination of the LDPC code and the modulation system includes MODCOD-A as MODCOD that assumes execution of block interleave of the type A, and MODCOD-B as MODCOD that assumes execution of block interleave of the type B. The group-wise interleave unit performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A.

In a second data processing device/method according to the present technology, a transmission device includes: a group-wise interleave unit that performs group-wise interleave for interleaving a low-density parity-check (LDPC) code having a code length N of 16200 bits or 64800 bits in units of bit group of 360 bits; and a block interleave unit that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system. A system of block interleave performed by the block interleave unit includes a type A that repeats writing of the group-wise interleaved LDPC code to the m columns in a column direction of the columns, and a type B that repeats writing of the group-wise interleaved LDPC code to the m columns in a row direction in units of bit group. Modulation and coding (MODCOD) as a combination of the LDPC code and the modulation system the MODCOD includes MODCOD-A as MODCOD that assumes execution of block interleave of the type A, and MODCOD-B as MODCOD that assumes execution of block interleave of the type B. The group-wise interleave unit performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A. The data processing device/method includes: a block deinterleave unit/step that performs block deinterleave for returning m bits of the symbol obtained from data transmitted from the transmission device to the group-wise interleaved LDPC code; and a group-wise deinterleave unit/step that performs group-wise deinterleave for returning arrangement of the group-wise interleaved LDPC code to original arrangement.

According to the second data processing device/method, a transmission device includes: a group-wise interleave unit that performs group-wise interleave for interleaving a low-density parity-check (LDPC) code having a code length N of 16200 bits or 64800 bits in units of bit group of 360 bits; and a block interleave unit that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system. A system of block interleave performed by the block interleave unit includes a type A that repeats writing of the group-wise interleaved LDPC code to the m columns in a column direction of the columns, and a type B that repeats writing of the group-wise interleaved LDPC code to the m columns in a row direction in units of bit group. Modulation and coding (MODCOD) as a combination of the LDPC code and the modulation system the MODCOD includes MODCOD-A as MODCOD that assumes execution of block interleave of the type A, and MODCOD-B as MODCOD that assumes execution of block interleave of the type B. The group-wise interleave unit performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A. Block deinterleave is performed to return m bits of the symbol obtained from data transmitted from the transmission device to the group-wise interleaved LDPC code. Group-wise deinterleave is performed to return arrangement of the group-wise interleaved LDPC code to original arrangement.

Note that the data processing device may be either an independent device, or an internal block constituting one device.

EFFECTS OF THE INVENTION

According to the present technology, efficient coexistence of a plurality of block interleave systems is realizable in data transmission using an LDPC code.

Note that advantages to be offered are not limited to the aforementioned advantage, but may be any of advantages described in the present disclosure.

BRIEF DESCRIPTION OF DRAWINGS

Fig. 1 is a diagram showing a parity check matrix H for an LDPC code.
Fig. 2 is a flowchart showing decoding procedures for an LDPC code.
Fig. 3 is a diagram showing an example of a parity check matrix for an LDPC code.
Fig. 4 is a diagram showing an example of a Tanner graph of a parity check matrix.
Fig. 5 is a diagram showing an example of a variable node.
Fig. 6 is a diagram showing an example of a check node.
Fig. 7 is a diagram showing a configuration example of a transmission system according to an embodiment to which the present technology has been applied.
Fig. 8 is a block diagram showing a configuration example of a transmission device 11.
Fig. 9 is a block diagram showing a configuration example of a bit interleaver 116.
Fig. 10 is a diagram showing an example of a parity check matrix.
Fig. 11 is a diagram showing an example of a parity matrix.
Fig. 12 is a diagram showing a parity check matrix for an LDPC code specified in standards of DVB-T.2.
Fig. 13 is a diagram showing a parity check matrix for an LDPC code specified in standards of DVB-T.2.
Fig. 14 is a diagram showing an example of a Tanner graph for decoding of an LDPC code.
Fig. 15 is a diagram showing a parity matrix $H_T$ having an echelon structure, and an example of a Tanner graph corresponding to the parity matrix $H_T$.
Fig. 16 is a diagram showing an example of the parity matrix $H_T$ of the parity check matrix H corresponding to a parity interleaved LDPC code.
Fig. 17 is a flowchart showing an example of a process performed by the bit interleaver 116 and a mapper 117.
Fig. 18 is a block diagram showing a configuration example of an LDPC encoder 115.
Fig. 19 is a flowchart showing an example of a process performed by the LDPC encoder 115.
Fig. 20 is a diagram showing an example of a parity check matrix initial value table for a coding rate of 1/4 and a code length of 16200.
Fig. 21 is a diagram showing a method for obtaining the parity check matrix H on the basis of the parity check matrix initial value table.
Fig. 22 is a diagram showing a structure of a parity check matrix.
Fig. 23 is a diagram showing an example of the parity check matrix initial value table.
Fig. 24 is a diagram showing an A matrix generated on the basis of the parity check matrix initial value table.
Fig. 25 is a diagram showing parity interleave for a B matrix.
Fig. 26 is a diagram showing a C matrix generated on the basis of the parity check matrix initial value table.
Fig. 27 is a diagram showing parity interleave for a D matrix.
Fig. 28 is a diagram showing the parity check matrix subjected to column permutation as parity deinterleave for the parity check matrix to return parity interleave to an original state.
Fig. 29 is a diagram showing a converted parity check matrix obtained by row permutation for the parity check matrix.
Fig. 30 is a diagram showing an example of the parity check matrix initial value table.
Fig. 31 is a diagram showing an example of the parity check matrix initial value table.
Fig. 32 is a diagram showing an example of the parity check matrix initial value table.
Fig. 33 is a diagram showing an example of the parity check matrix initial value table.
Fig. 34 is a diagram showing an example of the parity check matrix initial value table.
Fig. 35 is a diagram showing an example of the parity check matrix initial value table.
Fig. 36 is a diagram showing an example of the parity check matrix initial value table.
Fig. 37 is a diagram showing an example of the parity check matrix initial value table.
Fig. 38 is a diagram showing an example of the parity check matrix initial value table.
Fig. 39 is a diagram showing an example of the parity check matrix initial value table.
Fig. 40 is a diagram showing an example of the parity check matrix initial value table.
Fig. 41 is a diagram showing an example of the parity check matrix initial value table.

Fig. 42 is a diagram showing an example of the parity check matrix initial value table.

Fig. 43 is a diagram showing an example of the parity check matrix initial value table.

Fig. 44 is a diagram showing an example of the parity check matrix initial value table.

Fig. 45 is a diagram showing an example of the parity check matrix initial value table.

Fig. 46 is a diagram showing an example of the parity check matrix initial value table.

Fig. 47 is a diagram showing an example of the parity check matrix initial value table.

Fig. 48 is a diagram showing an example of the parity check matrix initial value table.

Fig. 49 is a diagram showing an example of the parity check matrix initial value table.

Fig. 50 is a diagram showing an example of the parity check matrix initial value table.

Fig. 51 is a diagram showing an example of the parity check matrix initial value table.

Fig. 52 is a diagram showing an example of the parity check matrix initial value table.

Fig. 53 is a diagram showing an example of the parity check matrix initial value table.

Fig. 54 is a diagram showing an example of the parity check matrix initial value table.

Fig. 55 is a diagram showing an example of the parity check matrix initial value table.

Fig. 56 is a diagram showing an example of the parity check matrix initial value table.

Fig. 57 is a diagram showing an example of the parity check matrix initial value table.

Fig. 58 is a diagram showing an example of the parity check matrix initial value table.

Fig. 59 is a diagram showing an example of the parity check matrix initial value table.

Fig. 60 is a diagram showing an example of the parity check matrix initial value table.

Fig. 61 is a diagram showing an example of the parity check matrix initial value table.

Fig. 62 is a diagram showing an example of the parity check matrix initial value table.

Fig. 63 is a diagram showing an example of the parity check matrix initial value table.

Fig. 64 is a diagram showing an example of the parity check matrix initial value table.

Fig. 65 is a diagram showing an example of the parity check matrix initial value table.

Fig. 66 is a diagram showing an example of the parity check matrix initial value table.

Fig. 67 is a diagram showing an example of the parity check matrix initial value table.

Fig. 68 is a diagram showing an example of the parity check matrix initial value table.

Fig. 69 is a diagram showing an example of the parity check matrix initial value table.

Fig. 70 is a diagram showing an example of the parity check matrix initial value table.

Fig. 71 is a diagram showing an example of the parity check matrix initial value table.

Fig. 72 is a diagram showing an example of the parity check matrix initial value table.

Fig. 73 is a diagram showing an example of a Tanner graph of an ensemble which has a degree sequence setting a column weight to 3 and a row weight to 6.

Fig. 74 is a diagram showing an example of a Tanner graph of a multi-edge type ensemble.

Fig. 75 is a diagram showing a parity check matrix.

Fig. 76 is a diagram showing a parity check matrix.

Fig. 77 is a diagram showing a parity check matrix.

Fig. 78 is a diagram showing a parity check matrix.

Fig. 79 is a diagram showing a parity check matrix.

Fig. 80 is a diagram showing a parity check matrix.

Fig. 81 is a diagram showing a parity check matrix.

Fig. 82 is a diagram showing a parity check matrix.

Fig. 83 is a diagram showing examples of constellations when a modulation system is 16QAM.

Fig. 84 is a diagram showing examples of constellations when the modulation system is 64QAM.

Fig. 85 is a diagram showing examples of constellations when the modulation system is 256QAM.

Fig. 86 is a diagram showing examples of constellations when the modulation system is 1024QAM.

Fig. 87 is a diagram showing examples of constellations when the modulation system is 4096QAM.

Fig. 88 is a diagram showing examples of constellations when the modulation system is 4096QAM.

Fig. 89 is a diagram showing examples of coordinates of signal points of UC when the modulation system is QPSK.

Fig. 90 is a diagram showing examples of coordinates of signal points of 2D NUCs when the modulation system is 16QAM.

Fig. 91 is a diagram showing examples of coordinates of signal points of 2D NUCs when the modulation system is 64QAM.

Fig. 92 is a diagram showing examples of coordinates of signal points of 2D NUCs when the modulation system is 256QAM.

Fig. 93 is a diagram showing examples of coordinates of signal points of 2D NUCs when the modulation system is 256QAM.

Fig. 94 is a diagram showing examples of coordinates of signal points of 1D NUCs when the modulation system is 1024QAM.

Fig. 95 is a diagram showing a relationship between a symbol y of 1024QAM and each of a real part $Re(z_q)$ and an imaginary part $Im(z_q)$ of a complex as a coordinate of a signal point $z_q$ of a 1D NUC corresponding to the symbol y.

Fig. 96 is a diagram showing examples of coordinates of signal points of 1D NUCs when the modulation system is 4096QAM.

Fig. 97 is a diagram showing a relationship between a symbol y of 4096QAM and each of a real part $Re(z_q)$ and an imaginary part $Im(z_q)$ of a complex as a coordinate of a signal point $z_q$ of a 1D NUC corresponding to the symbol y.

Fig. 98 is a diagram showing other examples of constellations when the modulation system is 16QAM.

Fig. 99 is a diagram showing other examples of constellations when the modulation system is 64QAM.

Fig. 100 is a diagram showing other examples of constellations when the modulation system is 256QAM.

Fig. 101 is a diagram showing other examples of signal points of 2D NUCs when the modulation system is 16QAM.

Fig. 102 is a diagram showing other examples of signal points of 2D NUCs when the modulation system is 64QAM.

Fig. 103 is a diagram showing other examples of signal points of 2D NUCs when the modulation system is 256QAM.

Fig. 104 is a diagram showing other examples of signal points of 2D NUCs when the modulation system is 256QAM.

Fig. 105 is a block diagram showing a configuration example of a block interleaver 25.

Fig. 106 is a diagram showing an example of column numbers C, and part column lengths R1 and R2 of parts 1 and 2 for combinations of a code length N and the modulation system.

Fig. 107 is a diagram showing block interleave performed by the block interleaver 25.

Fig. 108 is a diagram showing group-wise interleave performed by a group-wise interleaver 24.

Fig. 109 is a diagram showing a first example of a GW pattern for an LDPC code having the code length N of 64k bits.

Fig. 110 is a diagram showing a second example of the GW pattern for the LDPC code having the code length N of 64k bits.

Fig. 111 is a diagram showing a third example of the GW pattern for the LDPC code having the code length N of 64k bits.

Fig. 112 is a diagram showing a fourth example of the GW pattern for the LDPC code having the code length N of 64k bits.

Fig. 113 is a diagram showing a fifth example of the GW pattern for the LDPC code having the code length N of 64k bits.

Fig. 114 is a diagram showing a sixth example of the GW pattern for the LDPC code having the code length N of 64k bits.

Fig. 115 is a diagram showing a seventh example of the GW pattern for the LDPC code having the code length N of 64k bits.

Fig. 116 is a diagram showing an eighth example of the GW pattern for the LDPC code having the code length N of 64k bits.

Fig. 117 is a diagram showing a ninth example of the GW pattern for the LDPC code having the code length N of 64k bits.

Fig. 118 is a diagram showing a tenth example of the GW pattern for the LDPC code having the code length N of 64k bits.

Fig. 119 is a diagram showing an eleventh example of the GW pattern for the LDPC code having the code length N of 64k bits.

Fig. 120 is a diagram showing a twelfth example of the GW pattern for the LDPC code having the code length N of 64k bits.

Fig. 121 is a diagram showing a thirteenth example of the GW pattern for the LDPC code having the code length N of 64k bits.

Fig. 122 is a diagram showing a fourteenth example of the GW pattern for the LDPC code having the code length N of 64k bits.

Fig. 123 is a diagram showing a fifteenth example of the GW pattern for the LDPC code having the code length N of 64k bits.

Fig. 124 is a diagram showing a sixteenth example of the GW pattern for the LDPC code having the code length N of 64k bits.

Fig. 125 is a diagram showing a seventeenth example of the GW pattern for the LDPC code having the code length N of 64k bits.

Fig. 126 is a diagram showing an eighteenth example of the GW pattern for the LDPC code having the code length N of 64k bits.

Fig. 127 is a diagram showing a nineteenth example of the GW pattern for the LDPC code having the code length N of 64k bits.

Fig. 128 is a diagram showing a twentieth example of the GW pattern for the LDPC code having the code length N of 64k bits.

Fig. 129 is a diagram showing a twenty-first example of the GW pattern for the LDPC code having the code length N of 64k bits.

Fig. 130 is a diagram showing a twenty-second example of the GW pattern for the LDPC code having the code length N of 64k bits.

Fig. 131 is a diagram showing a twenty-third example of the GW pattern for the LDPC code having the code length N of 64k bits.

Fig. 132 is a diagram showing a twenty-fourth example of the GW pattern for the LDPC code having the code length N of 64k bits.

Fig. 133 is a diagram showing a twenty-fifth example of the GW pattern for the LDPC code having the code length N of 64k bits.

Fig. 134 is a diagram showing a twenty-sixth example of the GW pattern for the LDPC code having the code length N of 64k bits.

Fig. 135 is a diagram showing a twenty-seventh example of the GW pattern for the LDPC code having the code length N of 64k bits.

Fig. 136 is a diagram showing a twenty-eighth example of the GW pattern for the LDPC code having the code length N of 64k bits.

Fig. 137 is a diagram showing a twenty-ninth example of the GW pattern for the LDPC code having the code length N of 64k bits.

Fig. 138 is a diagram showing a thirtieth example of the GW pattern for the LDPC code having the code length N of 64k bits.

Fig. 139 is a diagram showing a thirty-first example of the GW pattern for the LDPC code having the code length N of 64k bits.

Fig. 140 is a diagram showing a thirty-second example of the GW pattern for the LDPC code having the code length N of 64k bits.

Fig. 141 is a diagram showing a thirty-third example of the GW pattern for the LDPC code having the code length N of 64k bits.

Fig. 142 is a diagram showing a first example of a GW pattern for an LDPC code having the code length N of 16k bits.

Fig. 143 is a diagram showing a second example of the GW pattern for the LDPC code having the code length N of 16k bits.

Fig. 144 is a diagram showing a third example of the GW pattern for the LDPC code having the code length N of 16k bits.

Fig. 145 is a diagram showing a fourth example of the GW pattern for the LDPC code having the code length N of 16k bits.

Fig. 146 is a diagram showing a fifth example of the GW pattern for the LDPC code having the code length N of 16k bits.

Fig. 147 is a diagram showing a sixth example of the GW pattern for the LDPC code having the code length N of 16k bits.

Fig. 148 is a diagram showing a seventh example of the GW pattern for the LDPC code having the code length N of 16k bits.

Fig. 149 is a diagram showing an eighth example of the GW pattern for the LDPC code having the code length N of 16k bits.

Fig. 150 is a diagram showing a ninth example of the GW pattern for the LDPC code having the code length N of 16k bits.

Fig. 151 is a diagram showing a tenth example of the GW pattern for the LDPC code having the code length N of 16k bits.

Fig. 152 is a diagram showing an eleventh example of the GW pattern for the LDPC code having the code length N of 16k bits.

Fig. 153 is a diagram showing a twelfth example of the GW pattern for the LDPC code having the code length N of 16k bits.

Fig. 154 is a diagram showing a thirteenth example of the GW pattern for the LDPC code having the code length N of 16k bits.

Fig. 155 is a diagram showing a fourteenth example of the GW pattern for the LDPC code having the code length N of 16k bits.

Fig. 156 is a diagram showing a fifteenth example of the GW pattern for the LDPC code having the code length N of 16k bits.

Fig. 157 is a diagram showing a sixteenth example of the GW pattern for the LDPC code having the code length N of 16k bits.

Fig. 158 is a diagram showing a simulation result of simulation for measuring error rates.

Fig. 159 is a diagram showing a simulation result of simulation for measuring error rates.

Fig. 160 is a diagram showing a simulation result of simulation for measuring error rates.

Fig. 161 is a diagram showing a simulation result of simulation for measuring error rates.
Fig. 162 is a diagram showing a simulation result of simulation for measuring error rates.
Fig. 163 is a diagram showing a simulation result of simulation for measuring error rates.
Fig. 164 is a diagram showing a simulation result of simulation for measuring error rates.
Fig. 165 is a diagram showing a simulation result of simulation for measuring error rates.
Fig. 166 is a diagram showing a simulation result of simulation for measuring error rates.
Fig. 167 is a diagram showing a simulation result of simulation for measuring error rates.
Fig. 168 is a diagram showing a simulation result of simulation for measuring error rates.
Fig. 169 is a diagram showing a simulation result of simulation for measuring error rates.
Fig. 170 is a diagram showing a simulation result of simulation for measuring error rates.
Fig. 171 is a diagram showing a simulation result of simulation for measuring error rates.
Fig. 172 is a diagram showing a simulation result of simulation for measuring error rates.
Fig. 173 is a diagram showing a simulation result of simulation for measuring error rates.
Fig. 174 is a diagram showing a simulation result of simulation for measuring error rates.
Fig. 175 is a diagram showing a simulation result of simulation for measuring error rates.
Fig. 176 is a diagram showing a simulation result of simulation for measuring error rates.
Fig. 177 is a diagram showing a simulation result of simulation for measuring error rates.
Fig. 178 is a diagram showing a simulation result of simulation for measuring error rates.
Fig. 179 is a diagram showing a simulation result of simulation for measuring error rates.
Fig. 180 is a diagram showing a simulation result of simulation for measuring error rates.
Fig. 181 is a diagram showing a simulation result of simulation for measuring error rates.
Fig. 182 is a diagram showing a simulation result of simulation for measuring error rates.
Fig. 183 is a diagram showing a simulation result of simulation for measuring error rates.
Fig. 184 is a diagram showing a simulation result of simulation for measuring error rates.
Fig. 185 is a diagram showing a simulation result of simulation for measuring error rates.
Fig. 186 is a diagram showing a simulation result of simulation for measuring error rates.
Fig. 187 is a diagram showing a simulation result of simulation for measuring error rates.
Fig. 188 is a diagram showing a simulation result of simulation for measuring error rates.
Fig. 189 is a diagram showing a simulation result of simulation for measuring error rates.
Fig. 190 is a diagram showing a simulation result of simulation for measuring error rates.
Fig. 191 is a diagram showing a simulation result of simulation for measuring error rates.
Fig. 192 is a diagram showing a simulation result of simulation for measuring error rates.
Fig. 193 is a diagram showing a simulation result of simulation for measuring error rates.
Fig. 194 is a diagram showing a simulation result of simulation for measuring error rates.
Fig. 195 is a diagram showing a simulation result of simulation for measuring error rates.
Fig. 196 is a diagram showing a simulation result of simulation for measuring error rates.
Fig. 197 is a diagram showing a simulation result of simulation for measuring error rates.
Fig. 198 is a diagram showing a simulation result of simulation for measuring error rates.
Fig. 199 is a diagram showing a simulation result of simulation for measuring error rates.
Fig. 200 is a diagram showing a simulation result of simulation for measuring error rates.
Fig. 201 is a diagram showing a simulation result of simulation for measuring error rates.
Fig. 202 is a diagram showing a simulation result of simulation for measuring error rates.
Fig. 203 is a diagram showing a simulation result of simulation for measuring error rates.
Fig. 204 is a diagram showing a simulation result of simulation for measuring error rates.
Fig. 205 is a diagram showing a simulation result of simulation for measuring error rates.
Fig. 206 is a diagram showing a simulation result of simulation for measuring error rates.
Fig. 207 is a block diagram showing a configuration example of a reception device 12.
Fig. 208 is a block diagram showing a configuration example of a bit deinterleaver 165.
Fig. 209 is a flowchart showing an example of a process performed by a demapper 164, the bit deinterleaver 165, and an LDPC decoder 166.
Fig. 210 is a diagram showing an example of a parity check matrix for an LDPC code.
Fig. 211 is a diagram showing an example of a matrix (converted parity check matrix) obtained by performing row permutation and column permutation for a parity check matrix.
Fig. 212 is a diagram showing an example of a converted parity check matrix divided into $5 \times 5$ units.
Fig. 213 is a block diagram showing a configuration example of a decoding device which performs node calculation for each set of P calculations.
Fig. 214 is a block diagram showing a configuration example of the LDPC decoder 166.
Fig. 215 is a block diagram showing a configuration example of a block deinterleaver 54.

Fig. 216 is a block diagram showing another configuration example of the bit deinterleaver 165.

Fig. 217 is a block diagram showing a configuration example of the bit interleaver 116.

Fig. 218 is a block diagram showing a configuration example of a block interleaver 1022 corresponding to block interleave of a type A.

Fig. 219 is a diagram showing an example of column numbers C, and part column lengths R1 and R2 of parts 1 and 2 for combinations of the code length N and the modulation system.

Fig. 220 is a diagram showing block interleave performed by the block interleaver 1022 corresponding to block interleave of the type A.

Fig. 221 is a diagram showing group-wise interleave performed by a group-wise interleaver 1021.

Fig. 222 is a diagram showing a specific example (case 1) of block interleave of the type A.

Fig. 223 is a diagram showing a specific example (case 2) of block interleave of the type A.

Fig. 224 is a block diagram showing a configuration example of the block interleaver 1022 corresponding to block interleave of a type B.

Fig. 225 is a diagram showing block interleave performed by the block interleaver 1022 corresponding to block interleave of the type B.

Fig. 226 is a diagram showing a specific example (case 1) of block interleave of the type B.

Fig. 227 is a diagram showing a specific example (case 2) of block interleave of the type B.

Fig. 228 is a diagram showing a specific example (case 1) of conversion of a GW pattern performed by the group-wise interleaver 1021.

Fig. 229 is a diagram showing a specific example (case 2) of conversion of a GW pattern performed by the group-wise interleaver 1021.

Fig. 230 is a diagram showing an example of a GW pattern set for MODCOD as a combination of a 64k-bit LDPC code and the modulation system.

Fig. 231 is a diagram showing an example of a GW pattern for a 64k-bit LDPC code when the modulation system and a coding rate r are set to QPSK and 2/15, respectively.

Fig. 232 is a diagram showing an example of a GW pattern for a 64k-bit LDPC code when the modulation system and the coding rate r are set to QPSK and 3/15, respectively.

Fig. 233 is a diagram showing an example of a GW pattern for a 64k-bit LDPC code when the modulation system and the coding rate r are set to QPSK and 4/15, respectively.

Fig. 234 is a diagram showing an example of a GW pattern for a 64k-bit LDPC code when the modulation system and the coding rate r are set to QPSK and 5/15, respectively.

Fig. 235 is a diagram showing an example of a GW pattern for a 64k-bit LDPC code when the modulation system and the coding rate r are set to QPSK and 6/15, respectively.

Fig. 236 is a diagram showing an example of a GW pattern for a 64k-bit LDPC code when the modulation system and the coding rate r are set to QPSK and 7/15, respectively.

Fig. 237 is a diagram showing an example of a GW pattern for a 64k-bit LDPC code when the modulation system and the coding rate r are set to QPSK and 8/15, respectively.

Fig. 238 is a diagram showing an example of a GW pattern for a 64k-bit LDPC code when the modulation system and the coding rate r are set to QPSK and 9/15, respectively.

Fig. 239 is a diagram showing an example of a GW pattern for a 64k-bit LDPC code when the modulation system and the coding rate r are set to QPSK and 10/15, respectively.

Fig. 240 is a diagram showing an example of a GW pattern for a 64k-bit LDPC code when the modulation system and the coding rate r are set to QPSK and 11/15, respectively.

Fig. 241 is a diagram showing an example of a GW pattern for a 64k-bit LDPC code when the modulation system and the coding rate r are set to QPSK and 12/15, respectively.

Fig. 242 is a diagram showing an example of a GW pattern for a 64k-bit LDPC code when the modulation system and the coding rate r are set to QPSK and 13/15, respectively.

Fig. 243 is a diagram showing an example of a GW pattern for a 64k-bit LDPC code when the modulation system and the coding rate r are set to 16QAM and 2/15, respectively.

Fig. 244 is a diagram showing an example of a GW pattern for a 64k-bit LDPC code when the modulation system and the coding rate r are set to 16QAM and 3/15, respectively.

Fig. 245 is a diagram showing an example of a GW pattern for a 64k-bit LDPC code when the modulation system and the coding rate r are set to 16QAM and 4/15, respectively.

Fig. 246 is a diagram showing an example of a GW pattern for a 64k-bit LDPC code when the modulation system and the coding rate r are set to 16QAM and 5/15, respectively.

Fig. 247 is a diagram showing an example of a GW pattern for a 64k-bit LDPC code when the modulation system and the coding rate r are set to 16QAM and 6/15, respectively.

Fig. 248 is a diagram showing an example of a GW pattern for a 64k-bit LDPC code when the modulation system and the coding rate r are set to 16QAM and 7/15, respectively.

Fig. 249 is a diagram showing an example of a GW pattern for a 64k-bit LDPC code when the modulation system and the coding rate r are set to 16QAM and 8/15, respectively.

Fig. 250 is a diagram showing an example of a GW pattern for a 64k-bit LDPC code when the modulation system and the coding rate r are set to 16QAM and 9/15, respectively.

Fig. 251 is a diagram showing an example of a GW pattern for a 64k-bit LDPC code when the modulation system and the coding rate r are set to 16QAM and 10/15, respectively.

Fig. 252 is a diagram showing an example of a GW pattern for a 64k-bit LDPC code when the modulation system and the coding rate r are set to 16QAM and 11/15, respectively.

Fig. 253 is a diagram showing an example of a GW pattern for a 64k-bit LDPC code when the modulation system and the coding rate r are set to 16QAM and 12/15, respectively.

Fig. 254 is a diagram showing an example of a GW pattern for a 64k-bit LDPC code when the modulation system and the coding rate r are set to 16QAM and 13/15, respectively.

Fig. 255 is a diagram showing an example of a GW pattern for a 64k-bit LDPC code when the modulation system and the coding rate r are set to 64QAM and 2/15, respectively.

Fig. 256 is a diagram showing an example of a GW pattern for a 64k-bit LDPC code when the modulation system and the coding rate r are set to 64QAM and 3/15, respectively.

Fig. 257 is a diagram showing an example of a GW pattern for a 64k-bit LDPC code when the modulation system and the coding rate r are set to 64QAM and 4/15, respectively.

Fig. 258 is a diagram showing an example of a GW pattern for a 64k-bit LDPC code when the modulation system and the coding rate r are set to 64QAM and 5/15, respectively.

Fig. 259 is a diagram showing an example of a GW pattern for a 64k-bit LDPC code when the modulation system and the coding rate r are set to 64QAM and 6/15, respectively.

Fig. 260 is a diagram showing an example of a GW pattern for a 64k-bit LDPC code when the modulation system and the coding rate r are set to 64QAM and 7/15, respectively.

Fig. 261 is a diagram showing an example of a GW pattern for a 64k-bit LDPC code when the modulation system and the coding rate r are set to 64QAM and 8/15, respectively.

Fig. 262 is a diagram showing an example of a GW pattern for a 64k-bit LDPC code when the modulation system and the coding rate r are set to 64QAM and 9/15, respectively.

Fig. 263 is a diagram showing an example of a GW pattern for a 64k-bit LDPC code when the modulation system and the coding rate r are set to 64QAM and 10/15, respectively.

Fig. 264 is a diagram showing an example of a GW pattern for a 64k-bit LDPC code when the modulation system and the coding rate r are set to 64QAM and 11/15, respectively.

Fig. 265 is a diagram showing an example of a GW pattern for a 64k-bit LDPC code when the modulation system and the coding rate r are set to 64QAM and 12/15, respectively.

Fig. 266 is a diagram showing an example of a GW pattern for a 64k-bit LDPC code when the modulation system and the coding rate r are set to 64QAM and 13/15, respectively.

Fig. 267 is a diagram showing an example of a GW pattern for a 64k-bit LDPC code when the modulation system and the coding rate r are set to 256QAM and 2/15, respectively.

Fig. 268 is a diagram showing an example of a GW pattern for a 64k-bit LDPC code when the modulation system and the coding rate r are set to 256QAM and 3/15, respectively.

Fig. 269 is a diagram showing an example of a GW pattern for a 64k-bit LDPC code when the modulation system and the coding rate r are set to 256QAM and 4/15, respectively.

Fig. 270 is a diagram showing an example of a GW pattern for a 64k-bit LDPC code when the modulation system and the coding rate r are set to 256QAM and 5/15, respectively.

Fig. 271 is a diagram showing an example of a GW pattern for a 64k-bit LDPC code when the modulation system and the coding rate r are set to 256QAM and 6/15, respectively.

Fig. 272 is a diagram showing an example of a GW pattern for a 64k-bit LDPC code when the modulation system and the coding rate r are set to 256QAM and 7/15, respectively.

Fig. 273 is a diagram showing an example of a GW pattern for a 64k-bit LDPC code when the modulation system and the coding rate r are set to 256QAM and 8/15, respectively.

Fig. 274 is a diagram showing an example of a GW pattern for a 64k-bit LDPC code when the modulation system and the coding rate r are set to 256QAM and 9/15, respectively.

Fig. 275 is a diagram showing an example of a GW pattern for a 64k-bit LDPC code when the modulation system and the coding rate r are set to 256QAM and 10/15, respectively.

Fig. 276 is a diagram showing an example of a GW pattern for a 64k-bit LDPC code when the modulation system and the coding rate r are set to 256QAM and 11/15, respectively.

Fig. 277 is a diagram showing an example of a GW pattern for a 64k-bit LDPC code when the modulation system and the coding rate r are set to 256QAM and 12/15, respectively.

Fig. 278 is a diagram showing an example of a GW pattern for a 64k-bit LDPC code when the modulation system and the coding rate r are set to 256QAM and 13/15, respectively.

Fig. 279 is a diagram showing an example of a GW pattern for a 64k-bit LDPC code when the modulation system and the coding rate r are set to 1024QAM and 2/15, respectively.

Fig. 280 is a diagram showing an example of a GW pattern for a 64k-bit LDPC code when the modulation system and the coding rate r are set to 1024QAM and 3/15, respectively.

Fig. 281 is a diagram showing an example of a GW pattern for a 64k-bit LDPC code when the modulation system and the coding rate r are set to 1024QAM and 4/15, respectively.

Fig. 282 is a diagram showing an example of a GW pattern for a 64k-bit LDPC code when the modulation system and the coding rate r are set to 1024QAM and 5/15, respectively.

Fig. 283 is a diagram showing an example of a GW pattern for a 64k-bit LDPC code when the modulation system and the coding rate r are set to 1024QAM and 6/15, respectively.

Fig. 284 is a diagram showing an example of a GW pattern for a 64k-bit LDPC code when the modulation system and the coding rate r are set to 1024QAM and 7/15, respectively.

Fig. 285 is a diagram showing an example of a GW pattern for a 64k-bit LDPC code when the modulation system and the coding rate r are set to 1024QAM and 8/15, respectively.

Fig. 286 is a diagram showing an example of a GW pattern for a 64k-bit LDPC code when the modulation system and the coding rate r are set to 1024QAM and 9/15, respectively.

Fig. 287 is a diagram showing an example of a GW pattern for a 64k-bit LDPC code when the modulation system and the coding rate r are set to 1024QAM and 10/15, respectively.

Fig. 288 is a diagram showing an example of a GW pattern for a 64k-bit LDPC code when the modulation system and the coding rate r are set to 1024QAM and 11/15, respectively.

Fig. 289 is a diagram showing an example of a GW pattern for a 64k-bit LDPC code when the modulation system and the coding rate r are set to 1024QAM and 12/15, respectively.

Fig. 290 is a diagram showing an example of a GW pattern for a 64k-bit LDPC code when the modulation system and the coding rate r are set to 1024QAM and 13/15, respectively.

Fig. 291 is a diagram showing an example of a GW pattern for a 64k-bit LDPC code when the modulation system and the coding rate r are set to 4096QAM and 2/15, respectively.

Fig. 292 is a diagram showing an example of a GW pattern for a 64k-bit LDPC code when the modulation system and the coding rate r are set to 4096QAM and 3/15, respectively.

Fig. 293 is a diagram showing an example of a GW pattern for a 64k-bit LDPC code when the modulation system and the coding rate r are set to 4096QAM and 4/15, respectively.

Fig. 294 is a diagram showing an example of a GW pattern for a 64k-bit LDPC code when the modulation system and the coding rate r are set to 4096QAM and 5/15, respectively.

Fig. 295 is a diagram showing an example of a GW pattern for a 64k-bit LDPC code when the modulation system and the coding rate r are set to 4096QAM and 6/15, respectively.

Fig. 296 is a diagram showing an example of a GW pattern for a 64k-bit LDPC code when the modulation system and the coding rate r are set to 4096QAM and 7/15, respectively.

Fig. 297 is a diagram showing an example of a GW pattern for a 64k-bit LDPC code when the modulation system and the coding rate r are set to 4096QAM and 8/15, respectively.

Fig. 298 is a diagram showing an example of a GW pattern for a 64k-bit LDPC code when the modulation system and the coding rate r are set to 4096QAM and 9/15, respectively.

Fig. 299 is a diagram showing an example of a GW pattern for a 64k-bit LDPC code when the modulation system and the coding rate r are set to 4096QAM and 10/15, respectively.

Fig. 300 is a diagram showing an example of a GW pattern for a 64k-bit LDPC code when the modulation system and the coding rate r are set to 4096QAM and 11/15, respectively.

Fig. 301 is a diagram showing an example of a GW pattern for a 64k-bit LDPC code when the modulation system and the coding rate r are set to 4096QAM and 12/15, respectively.

Fig. 302 is a diagram showing an example of a GW pattern for a 64k-bit LDPC code when the modulation system and the coding rate r are set to 4096QAM and 13/15, respectively.

Fig. 303 is a diagram showing an example of a GW pattern set for MODCOD as a combination of a 16k-bit LDPC code and the modulation system.

Fig. 304 is a diagram showing an example of a GW pattern for a 16k-bit LDPC code when the modulation system and the coding rate r are set to QPSK and 2/15, respectively.

Fig. 305 is a diagram showing an example of a GW pattern for a 16k-bit LDPC code when the modulation system and the coding rate r are set to QPSK and 3/15, respectively.

Fig. 306 is a diagram showing an example of a GW pattern for a 16k-bit LDPC code when the modulation system and the coding rate r are set to QPSK and 4/15, respectively.

Fig. 307 is a diagram showing an example of a GW pattern for a 16k-bit LDPC code when the modulation system and the coding rate r are set to QPSK and 5/15, respectively.

Fig. 308 is a diagram showing an example of a GW pattern for a 16k-bit LDPC code when the modulation system and the coding rate r are set to QPSK and 6/15, respectively.

Fig. 309 is a diagram showing an example of a GW pattern for a 16k-bit LDPC code when the modulation system and the coding rate r are set to QPSK and 7/15, respectively.

Fig. 310 is a diagram showing an example of a GW pattern for a 16k-bit LDPC code when the modulation system and the coding rate r are set to QPSK and 8/15, respectively.

Fig. 311 is a diagram showing an example of a GW pattern for a 16k-bit LDPC code when the modulation system and the coding rate r are set to QPSK and 9/15, respectively.

Fig. 312 is a diagram showing an example of a GW pattern for a 16k-bit LDPC code when the modulation system and the coding rate r are set to QPSK and 10/15, respectively.

Fig. 313 is a diagram showing an example of a GW pattern for a 16k-bit LDPC code when the modulation system and the coding rate r are set to QPSK and 11/15, respectively.

Fig. 314 is a diagram showing an example of a GW pattern for a 16k-bit LDPC code when the modulation system and the coding rate r are set to QPSK and 12/15, respectively.

Fig. 315 is a diagram showing an example of a GW pattern for a 16k-bit LDPC code when the modulation system and the coding rate r are set to QPSK and 13/15, respectively.

Fig. 316 is a diagram showing an example of a GW pattern for a 16k-bit LDPC code when the modulation system and the coding rate r are set to 16QAM and 2/15, respectively.

Fig. 317 is a diagram showing an example of a GW pattern for a 16k-bit LDPC code when the modulation system and the coding rate r are set to 16QAM and 3/15, respectively.

Fig. 318 is a diagram showing an example of a GW pattern for a 16k-bit LDPC code when the modulation system and the coding rate r are set to 16QAM and 4/15, respectively.

Fig. 319 is a diagram showing an example of a GW pattern for a 16k-bit LDPC code when the modulation system and the coding rate r are set to 16QAM and 5/15, respectively.

Fig. 320 is a diagram showing an example of a GW pattern for a 16k-bit LDPC code when the modulation system and the coding rate r are set to 16QAM and 6/15, respectively.

Fig. 321 is a diagram showing an example of a GW pattern for a 16k-bit LDPC code when the modulation system and the coding rate r are set to 16QAM and 7/15, respectively.

Fig. 322 is a diagram showing an example of a GW pattern for a 16k-bit LDPC code when the modulation system and the coding rate r are set to 16QAM and 8/15, respectively.

Fig. 323 is a diagram showing an example of a GW pattern for a 16k-bit LDPC code when the modulation system and the coding rate r are set to 16QAM and 9/15, respectively.

Fig. 324 is a diagram showing an example of a GW pattern for a 16k-bit LDPC code when the modulation system and the coding rate r are set to 16QAM and 10/15, respectively.

Fig. 325 is a diagram showing an example of a GW pattern for a 16k-bit LDPC code when the modulation system and the coding rate r are set to 16QAM and 11/15, respectively.

Fig. 326 is a diagram showing an example of a GW pattern for a 16k-bit LDPC code when the modulation system and the coding rate r are set to 16QAM and 12/15, respectively.

Fig. 327 is a diagram showing an example of a GW pattern for a 16k-bit LDPC code when the modulation system and the coding rate r are set to 16QAM and 13/15, respectively.

Fig. 328 is a diagram showing an example of a GW pattern for a 16k-bit LDPC code when the modulation system and the coding rate r are set to 64QAM and 2/15, respectively.

Fig. 329 is a diagram showing an example of a GW pattern for a 16k-bit LDPC code when the modulation system and the coding rate r are set to 64QAM and 3/15, respectively.

Fig. 330 is a diagram showing an example of a GW pattern for a 16k-bit LDPC code when the modulation system and the coding rate r are set to 64QAM and 4/15, respectively.

Fig. 331 is a diagram showing an example of a GW pattern for a 16k-bit LDPC code when the modulation system and the coding rate r are set to 64QAM and 5/15, respectively.

Fig. 332 is a diagram showing an example of a GW pattern for a 16k-bit LDPC code when the modulation system and the coding rate r are set to 64QAM and 6/15, respectively.

Fig. 333 is a diagram showing an example of a GW pattern for a 16k-bit LDPC code when the modulation system and the coding rate r are set to 64QAM and 7/15, respectively.

Fig. 334 is a diagram showing an example of a GW pattern for a 16k-bit LDPC code when the modulation system and the coding rate r are set to 64QAM and 8/15, respectively.

Fig. 335 is a diagram showing an example of a GW pattern for a 16k-bit LDPC code when the modulation system and the coding rate r are set to 64QAM and 9/15, respectively.

Fig. 336 is a diagram showing an example of a GW pattern for a 16k-bit LDPC code when the modulation system and the coding rate r are set to 64QAM and 10/15, respectively.

Fig. 337 is a diagram showing an example of a GW pattern for a 16k-bit LDPC code when the modulation system and the coding rate r are set to 64QAM and 11/15, respectively.

Fig. 338 is a diagram showing an example of a GW pattern for a 16k-bit LDPC code when the modulation system and the coding rate r are set to 64QAM and 12/15, respectively.

Fig. 339 is a diagram showing an example of a GW pattern for a 16k-bit LDPC code when the modulation system and the coding rate r are set to 64QAM and 13/15, respectively.

Fig. 340 is a diagram showing an example of a GW pattern for a 16k-bit LDPC code when the modulation system and the coding rate r are set to 256QAM and 2/15, respectively.

Fig. 341 is a diagram showing an example of a GW pattern for a 16k-bit LDPC code when the modulation system and the coding rate r are set to 256QAM and 3/15, respectively.

Fig. 342 is a diagram showing an example of a GW pattern for a 16k-bit LDPC code when the modulation system and the coding rate r are set to 256QAM and 4/15, respectively.

Fig. 343 is a diagram showing an example of a GW pattern for a 16k-bit LDPC code when the modulation system and the coding rate r are set to 256QAM and 5/15, respectively.

Fig. 344 is a diagram showing an example of a GW pattern for a 16k-bit LDPC code when the modulation system and the coding rate r are set to 256QAM and 6/15, respectively.

Fig. 345 is a diagram showing an example of a GW pattern for a 16k-bit LDPC code when the modulation system and the coding rate r are set to 256QAM and 7/15, respectively.

Fig. 346 is a diagram showing an example of a GW pattern for a 16k-bit LDPC code when the modulation system and the coding rate r are set to 256QAM and 8/15, respectively.

Fig. 347 is a diagram showing an example of a GW pattern for a 16k-bit LDPC code when the modulation system and the coding rate r are set to 256QAM and 9/15, respectively.

Fig. 348 is a diagram showing an example of a GW pattern for a 16k-bit LDPC code when the modulation system and the coding rate r are set to 256QAM and 10/15, respectively.

Fig. 349 is a diagram showing an example of a GW pattern for a 16k-bit LDPC code when the modulation system and the coding rate r are set to 256QAM and 11/15, respectively.

Fig. 350 is a diagram showing an example of a GW pattern for a 16k-bit LDPC code when the modulation system and the coding rate r are set to 256QAM and 12/15, respectively.

Fig. 351 is a diagram showing an example of a GW pattern for a 16k-bit LDPC code when the modulation system and the coding rate r are set to 256QAM and 13/15, respectively.

Fig. 352 is a diagram showing a relationship between a GW pattern (A) and a GW pattern (B) for a 64k-bit LDPC code when the modulation system is QPSK.

Fig. 353 is a diagram showing a relationship between a GW pattern (A) and a GW pattern (B) for a 64k-bit LDPC code when the modulation system is 16QAM.

Fig. 354 is a diagram showing a relationship between a GW pattern (A) and a GW pattern (B) for a 64k-bit LDPC code when the modulation system is 64QAM.

Fig. 355 is a diagram showing a relationship between a GW pattern (A) and a GW pattern (B) for a 64k-bit LDPC code when the modulation system is 256QAM.

Fig. 356 is a diagram showing a relationship between a GW pattern (A) and a GW pattern (B) for a 64k-bit LDPC code when the modulation system is 1024QAM.

Fig. 357 is a diagram showing a relationship between a GW pattern (A) and a GW pattern (B) for a 64k-bit LDPC code when the modulation system is 4096QAM.

Fig. 358 is a diagram showing a relationship between a GW pattern (A) and a GW pattern (B) for a 16k-bit LDPC code when the modulation system is QPSK.

Fig. 359 is a diagram showing a relationship between a GW pattern (A) and a GW pattern (B) for a 16k-bit LDPC code when the modulation system is 16QAM.

Fig. 360 is a diagram showing a relationship between a GW pattern (A) and a GW pattern (B) for a 16k-bit LDPC code when the modulation system is 64QAM.

Fig. 361 is a diagram showing a relationship between a GW pattern (A) and a GW pattern (B) for a 16k-bit LDPC code when the modulation system is 256QAM.

Fig. 362 is a block diagram showing a configuration example of the bit deinterleaver 165.

Fig. 363 is a block diagram showing a configuration example of the block deinterleaver 1031 corresponding to block deinterleave of a type A.

Fig. 364 is a block diagram showing a configuration example of the block deinterleaver 1031 corresponding to block deinterleave of a type B.

Fig. 365 is a block diagram showing another configuration example of the bit deinterleaver 165.

Fig. 366 is a block diagram showing a first configuration example of a reception system to which the reception device 12 is applicable.

Fig. 367 is a block diagram showing a second configuration example of a reception system to which the reception device 12 is applicable.

Fig. 368 is a block diagram showing a third configuration example of a reception system to which the reception device 12 is applicable.

Fig. 369 is a block diagram showing a configuration example of a computer according to an embodiment to which the present technology has been applied.

MODES FOR CARRYING OUT THE INVENTION

<1. First embodiment>

Hereinbelow, an LDPC code is initially touched upon before description of embodiments according to the present technology.

<LDPC code>

Note that an LDPC code is a linear code but not limited to a binary code. It is assumed herein, however, that an LDPC code is a binary code.

The greatest characteristic of an LDPC code is that a parity check matrix for defining an LDPC code is a sparse matrix. A sparse matrix herein refers to a matrix containing an extremely small number of elements of "1" in the matrix (matrix containing "0" for almost all elements).

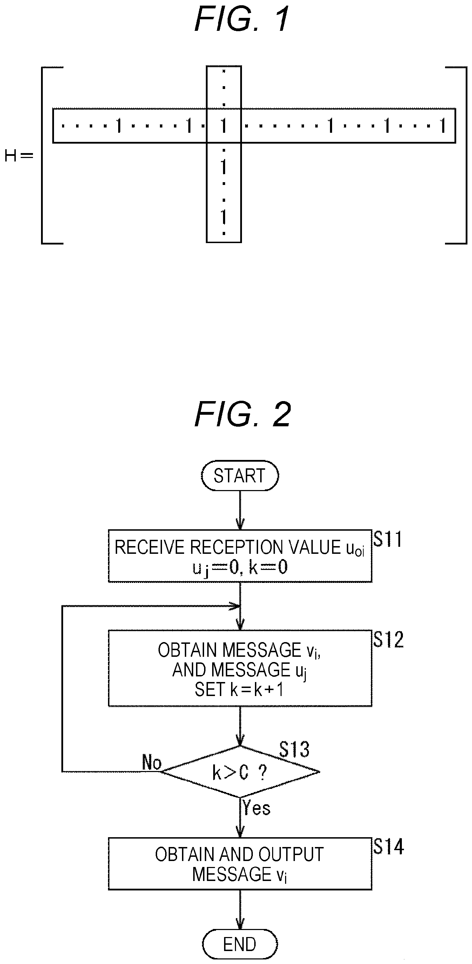

Fig. 1 is a diagram illustrating an example of a parity check matrix H for an LDPC code.

In the parity check matrix H shown in Fig. 1, a weight of each column (column weight) (number of "1") is set to "3", while a weight of each row (row weight) is set to "6".

In encoding into an LDPC code (LDPC encoding), a code word (LDPC code) is generated by generating a generator matrix G on the basis of the parity check matrix H, and multiplying binary information bits by the generated generator matrix G, for example.

More specifically, an encoding device performing LDPC encoding initially calculates a generator matrix G satisfying an equation $GH^T = 0$ with a transposed matrix $H^T$ of the parity check matrix H. When the generator matrix G is a $K \times N$ matrix herein, the encoding device multiplies the generator matrix G by a bit sequence (vector u) of information bits constituted by K bits to generate a code word c (= uG) constituted by N bits. The code word (LDPC code) generated by the encoding device is received by a receiving side via a predetermined communication channel.

The LDPC code may be decoded by using message passing algorithm proposed by Gallager as probabilistic decoding based on belief propagation on a so-called Tanner graph constituted by variable nodes (also called message nodes) and check nodes. The variable nodes and check nodes are hereinafter also abbreviated as nodes where appropriate.

Fig. 2 is a flowchart showing decoding procedures of an LDPC code.

Note that an actual value (reception LLR) which corresponds to an ith sign bit of an LDPC code (1 code word) received on the receiving side and represents "0" likelihood of the value on the basis of a log likelihood ratio is hereinafter also referred to as a reception value $u_{0i}$. In addition, a message output from a check node is referred to as $u_j$, while message output from a variable node is referred to as $v_i$.

For decoding an LDPC code, the LDPC code is initially received in step S11 to initialize the message (check node message) $u_j$ to "0", and initialize an integer variable k as a counter for iterative processing to "0" as shown in Fig. 2. Thereafter, the flow proceeds to step S12. In step S12, the message (variable node message) $v_i$ is obtained by performing calculation shown in Equation (1) (variable node calculation) on the basis of the reception value $u_{0i}$ obtained by reception of the LDPC code. Furthermore, the message $u_j$ is obtained by performing calculation shown in Equation (2) (check node calculation) on the basis of the message $v_i$.

[Mathematical Formula 1]

$$v_i = u_{0i} + \sum_{j=1}^{d_v - 1} u_j \quad \cdots \quad (1)$$

[Mathematical Formula 2]

$$\tanh\left(\frac{u_j}{2}\right) = \prod_{i=1}^{d_c-1} \tanh\left(\frac{v_i}{2}\right) \quad \cdots \text{(2)}$$

Here, in Equation (1) and Equation (2), $d_v$ and $d_c$ are parameters randomly selectable and indicating the number of "1" in the vertical direction (column) and the horizontal direction (row) of the parity check matrix H. For example, $d_v$ = 3 and $d_c$ = 6 are given in case of an LDPC code for the parity check matrix H having a column weight of 3 and a row weight of 6 ((3, 6) LDPC code) shown in Fig. 1.

Note that a message input from an edge (line connecting variable node and check node) to which a message is to be output does not become a target of calculation of the variable node calculation in Equation (1) and the check node calculation in Equation (2). In this case, the calculation range covers 1 through $d_v$ - 1 or 1 through $d_c$ - 1. In addition, in actual calculation of the check node of Equation (2), a table of a function R $(v_1, v_2)$ expressed by Equation (3) defined by one output for two inputs $v_1$ and $v_2$ is prepared beforehand, and successively (recursively) used as indicated in Equation (4) to perform the check node calculation.

[Mathematical Formula 3]

$$x = 2\tanh^{-1}\{\tanh(v_1/2)\tanh(v_2/2)\} = R(v_1, v_2) \quad \cdots \text{(3)}$$

[Mathematical Formula 4]

$$u_j = R(v_1, R(v_2, R(v_3, \cdots R(v_{d_c-2}, v_{d_c-1})))) \quad \cdots \text{(4)}$$

In step S12, the variable k is incremented by "1", whereafter the flow proceeds to step S13. In step S13, it is determined whether or not the variable k is larger than a predetermined iterative decoding number of times C. When it is determined in step S13 that the variable k is not larger than C, the flow returns to step S12 to repeat similar processing from this step.

In addition, when it is determined in step S13 that the variable k is larger than C, the flow proceeds to step S14. In this step, calculation shown in Equation (5) is performed to obtain and output the message $v_1$ as a decoding result to be finally output, and end the decoding process of the LDPC code.

[Mathematical Formula 5]

$$v_i = u_{0i} + \sum_{j=1}^{d_v} u_j \quad \cdots \text{(5)}$$

The calculation of Equation (5) herein is performed on the basis of the messages $u_j$ obtained from all edges connected to the variable node, unlike the variable node calculation of Equation (1).

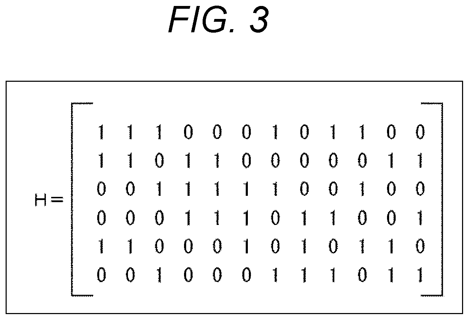

Fig. 3 is a diagram showing an example of the parity check matrix H for a (3, 6) LDPC code (coding rate: 1/2, code length: 12).

The parity check matrix H shown in Fig. 3 has a column weight of 3 and a row weight of 6, similarly to the example in Fig. 1.

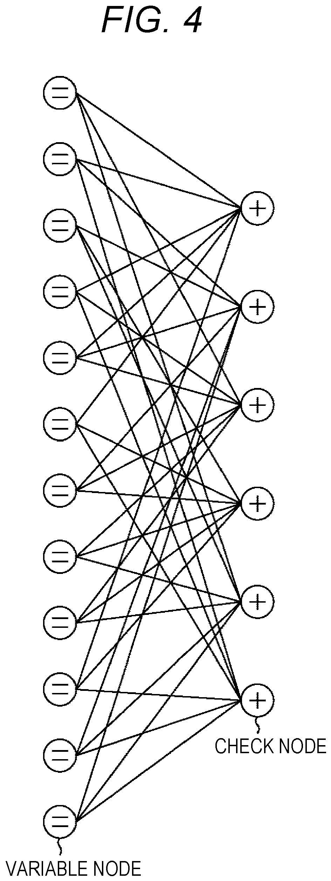

Fig. 4 shows a Tanner graph of the parity check matrix H shown in Fig. 3.

Here, in Fig. 4, each of the check nodes is expressed as plus "+", while each of the variable nodes is expressed as equal "=". The check nodes and the variable nodes correspond to rows and columns of the parity check matrix H, respectively. A connection line between each of the check nodes and each of the variable nodes constitutes an edge, and corresponds to an element "1" in the parity check matrix.

More specifically, when the element in the jth row and the ith column of the parity check matrix is 1, the ith variable node ("=" node) from the top and the jth check node ("+" node) from the top are connected by an edge in Fig. 4. The edge indicates that a sign bit corresponding to the variable node defines a constraint condition for the check node.

In sum product algorithm as a decoding method for an LDPC code, variable node calculation and check node calculation are iteratively performed.

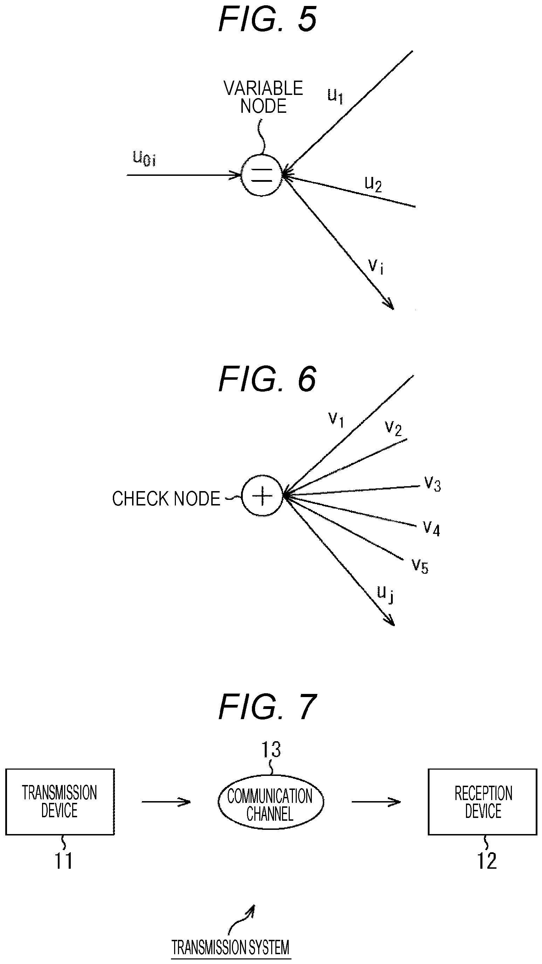

Fig. 5 is a diagram showing variable node calculation performed at a variable node.

At the variable node, the message $v_i$ corresponding to an edge to be calculated is obtained on the basis of the messages $u_1$ and $u_2$ received from remaining edges connected to the variable node, and the variable node calculation of Equation (1) using the reception value $u_{0i}$. Messages corresponding to other edges are similarly obtained.

Fig. 6 is a diagram showing check node calculation performed at a check node.

Here, the check node calculation of Equation (2) is rewritable to Equation (6) on the basis of a relation of an equation $a \times b = \exp\{\ln(|a|) + \ln(|b|)\} \times \text{sign}(a) \times \text{sign}(b)$. Note that sign(x) is 1 when $x \geq 0$, and is -1 when $x < 0$.

[Mathematical Formula 6]

$$u_j = 2\tanh^{-1}\left(\prod_{i=1}^{d_c-1} \tanh\left(\frac{v_i}{2}\right)\right)$$

$$= 2\tanh^{-1}\left[\exp\left\{\sum_{i=1}^{d_c-1} \ln\left(\left|\tanh\left(\frac{v_i}{2}\right)\right|\right)\right\} \times \prod_{i=1}^{d_c-1} \text{sign}\left(\tanh\left(\frac{v_i}{2}\right)\right)\right]$$

$$= 2\tanh^{-1}\left[\exp\left\{-\left(\sum_{i=1}^{d_c-1} -\ln\left(\tanh\left(\frac{|v_i|}{2}\right)\right)\right)\right\} \times \prod_{i=1}^{d_c-1} \text{sign}(v_i)\right]$$

$$\ldots \quad (6)$$

When a function $\phi(x)$ is defined as equation(x) = ln(tanh(x/2)) under $x \geq 0$, an equation $\phi^{-1}(x) = 2\tanh^{-1}(e^{-x})$ holds. Accordingly, Equation (6) is deformable to Equation (7).

[Mathematical Formula 7]

$$u_j = \phi^{-1}\left(\sum_{i=1}^{d_c-1} \phi(|v_i|)\right) \times \prod_{i=1}^{d_c-1} \text{sign}(v_i) \qquad \ldots \quad (7)$$

At the check node, the check node calculation of Equation (2) is performed on the basis of Equation (7).

More specifically, at the check node, the message $u_j$ corresponding to an edge to be calculated is obtained on the basis of the check node calculation of Equation (7) by using messages $v_1$, $v_2$, $v_3$, $v_4$, and $v_5$ received from remaining edges connected to the check node as shown in Fig. 6. Messages corresponding to other edges are similarly obtained.

Note that the function $\phi(x)$ of Equation (7) is expressed as an equation $\phi(x) = \ln((e^x + 1)/(e^x - 1))$, and is equivalent to $\phi^{-1}(x)$ under $x > 0$. The functions $\phi(x)$ and $\phi^{-1}(x)$ may be given to hardware by using a look up table (LUT). In this case, an identical LUT is used for both the functions.

<Configuration example of transmission system to which the present technology has been applied>

Fig. 7 is a diagram showing a configuration example of a transmission system (system corresponding to a logical collection of a plurality of devices, and containing respective constituent elements of a device either in the same housing or different housings) according to an embodiment to which the present technology has been applied.

A transmission system in Fig. 7 is constituted by a transmission device 11 and a reception device 12.

The transmission device 11 transmits (broadcasts) (transfers) programs of television broadcasting, for example. More specifically, the transmission device 11 encodes target data corresponding to a transmission target, such as image data and audio data contained in programs into an LDPC code, and transmits the LDPC code via a communication channel 13 such as a satellite line, a terrestrial wave, and a cable (wired line), for example.

The reception device 12 receives an LDPC code transmitted from the transmission device 11 via the communication channel 13, and decodes the received code into target data to output the decoded data.

Here, it is known that an LDPC code used in the transmission system shown in Fig. 7 has spectacular performance in an additive white Gaussian noise (AWGN) communication channel.

On the other hand, the communication channel 13 causes burst errors and erasures in some case. For example, particularly when the communication channel 13 is a terrestrial wave, power of a particular symbol may become zero (causes erasure) in an orthogonal frequency division multiplexing (OFDM) system in accordance with a delay of an echo (path other than main path) in a multipath environment where desired to undesired ratio (D/U) becomes 0 dB (power of undesired = echo is equivalent to power of desired = main path).

In addition, even in a flutter (communication channel to which echo affected by Doppler frequency is added under delay of zero), power of a whole symbol in an OFDM at a particular time may become zero (cause erasure) when D/U is 0 dB.

Furthermore, burst errors may be caused in a wiring state on the reception device 12 side in a range from a receiving unit (not shown) such as an antenna for receiving signals from the transmission device 11 to the reception device 12, and by instability of power supply of the reception device 12.

On the other hand, in decoding of an LDPC code, however, the variable node calculation of Equation (1) which includes addition of the sign bit (reception value $u_{0i}$ of sign bit) of the LDPC code is performed at a variable node corresponding to a column of the parity check matrix H, and further to the sign bit of the LDPC code as shown in Fig. 5. In this case, accuracy of the obtained message lowers when errors are produced in the sign bit used for the variable node calculation.

Moreover, in decoding of an LDPC code, the check node calculation of Equation (7) is performed at a check node by using a message obtained at a variable node connected to the check node. In this case, performance of decoding deteriorates with increase in the number of check nodes each of which connects to a plurality of variable nodes (sign bit of LDPC code corresponding to variable nodes) simultaneously causing errors (including erasures).

More specifically, for example, when two or more variable nodes connected to a check node simultaneously cause erasures, this check node returns a message indicating an equal probability of 0 and 1 to all the variable nodes. In this case, the check node returning the equal probability does not contribute to a one-time decoding process (one set of variable node calculation and check node calculation), wherefore a larger number of times of iteration of the decoding process is required. Accordingly, decoding performance deteriorates, while power consumption of the reception device 12 which decodes LDPC codes rises.

The transmission system in Fig. 7 therefore is configured to improve resistance to burst errors and erasures while maintaining performance in AWGN communication channels (AWGN channels).

<Configuration example of transmission device 11>

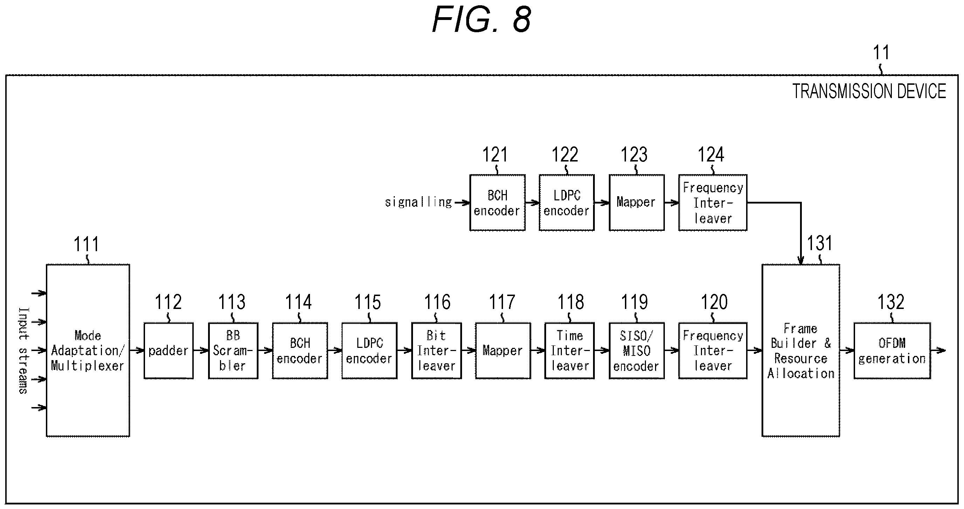

Fig. 8 is a block diagram showing a configuration example of the transmission device 11 in Fig. 7.

One or more input streams as target data are supplied to a mode adaptation/multiplexer 111 of the transmission device 11.

The mode adaptation/multiplexer 111 performs processes such as mode selection and multiplexing of one or more input streams supplied to the mode adaptation/multiplexer 111 as necessary, and supplies data thus obtained to a padder 112.

The padder 112 performs necessary zero padding (insertion of null) for the data received from the mode adaptation/multiplexer 111, and supplies the data thus obtained to a BB scrambler 113.

The BB scrambler 113 performs base-band scrambling (BB scrambling) for the data received from the padder 112, and supplies the data thus obtained to a BCH encoder 114.

The BCH encoder 114 performs BCH encoding for the data received from the BB scrambler 113, and supplies the data thus obtained to an LDPC encoder 115 as LDPC target data corresponding to a target of LDPC encoding.

The LDPC encoder 115 performs LDPC encoding for the LDPC target data received from the BCH encoder 114 on the basis of a parity check matrix having an echelon structure (dual diagonal structure) for a parity matrix as a part associated with a parity bit of an LDPC code, for example, and outputs an LDPC code containing the LDPC target data as an information bit.

More specifically, the LDPC encoder 115 performs LDPC encoding for LDPC target data to encode the data into an LDPC code (corresponding to parity check matrix) specified under predetermined standards such as DVB-S.2, DVB-T.2, and DVB-C.2, and an LDPC code (corresponding to parity check matrix) intended to be adopted under ATSC3.0, for example, and outputs an LDPC code thus obtained.

In this case, an LDPC code specified under DVB-T.2 and an LDPC code intended to be adopted under ATSC3.0 is an irregular repeat accumulate (IRA) code. The parity matrix included in the parity check matrix for the LDPC code has an echelon structure. The parity matrix and the echelon structure will be detailed below. In addition, an IRA code is described in "Irregular Repeat-Accumulate Codes," H. Jin, A. Khandekar, and R. J. McEliece, in Proceedings of 2nd International Symposium on Turbo codes and Related Topics, pp. 1-8, Sept. 2000, for example.

The LDPC code output from the LDPC encoder 115 is supplied to a bit interleaver 116.

The bit interleaver 116 performs bit interleave (described below) for the LDPC code received from the LDPC encoder 115, and supplies the bit interleaved LDPC code to a mapper 117.

The mapper 117 maps the LDPC code received from the bit interleaver 116 at a signal point representing one symbol of quadrature modulation in units of sign bit constituted by one or more bits in the LDPC code (in units of symbol) for quadrature modulation (multilevel modulation).

More specifically, the mapper 117 maps the LDPC code received from the bit interleaver 116 at a signal point specified by a modulation system performing quadrature modulation of the LDPC code on an IQ plane (IQ constellation) specified by an I axis representing I components in the same phase as that of a carrier wave, and a Q axis representing Q components perpendicular to carrier wave for quadrature modulation.

When the number of signal points specified by the modulation system of quadrature modulation performed by the mapper 117 is $2^m$, the mapper 117 maps the LDPC code received from the bit interleaver 116 at a signal point representing a symbol in the $2^m$ signal points in units of symbol, assuming that a sign bit of m bits in the LDPC code is a symbol (1 symbol).

Here, examples of the modulation system for quadrature modulation performed by the mapper 117 include a modulation system specified under standards of DVB-T.2 and the like, a modulation system intended to be adopted under ATSC3.0, and other modulation systems such as binary phase shift keying (BPSK), quadrature phase shift keying (QPSK), 8 phase-shift keying (PSK), 16 amplitude phase-shift keying (APSK), 32APSK, 16 quadrature amplitude modulation (QAM), 16QAM, 64QAM, 256QAM, 1024QAM, 4096QAM, and 4 pulse amplitude modulation (PAM). The modulation system adopted by the mapper 117 for quadrature modulation is set beforehand by an operation of an operator of the transmission device 11, for example.

Data obtained by processing of the mapper 117 (mapping result after symbol is mapped to signal point) is supplied to time interleaver 118.

The time interleaver 118 performs time interleave (interleave in time direction) for the data received from the mapper 117 in units of symbol, and supplies the data thus obtained to a single input single output/multiple input single output (SISO/MISO) encoder 119.

The SISO/MISO encoder 119 performs space-time encoding for the data received from the time interleaver 118, and supplies the resultant data to a frequency interleaver 120.

The frequency interleaver 120 performs frequency interleave (interleave in frequency direction) for the data received from the SISO/MISO encoder 119 in units of symbol, and supplies the resultant data to a frame builder and resource allocation unit 131.

On the other hand, the BCH encoder 121 receives supply of control data (signaling) for transmission control such as base band signaling (BB signaling) (BB header) and the like, for example.

The BCH encoder 121 performs BCH encoding for the supplied control data similarly to the BCH encoder 114, and supplies data thus obtained to the LDPC encoder 122.

The LDPC encoder 122 performs LDPC encoding for the data received from the BCH encoder 121 as LDPC target data similarly to the LDPC encoder 115, and supplies an LDPC code thus obtained to the mapper 123.

The mapper 123 maps the LDPC code received from the LDPC encoder 122 at a signal point representing one symbol of quadrature modulation in units of sign bit (in units of symbol) constituted by one or more bits in the LDPC code for quadrature modulation similarly to the mapper 117, and supplies data thus obtained to a frequency interleaver 124.

The frequency interleaver 124 performs frequency interleave for the data received from the mapper 123 in units of symbol similarly to the frequency interleaver 120, and supplies the resultant data to the frame builder and resource allocation unit 131.

The frame builder and resource allocation unit 131 inserts pilot symbols into necessary positions of the data (symbols) received from the frequency interleavers 120 and 124, generates a frame (such as physical layer (PL) frame, T2 frame, and C2 frame) constituted by a predetermined number of symbols obtained from the resultant data (symbols), and supplies the frame to an OFDM generation unit 132.

The OFDM generation unit 132 generates an OFDM signal from the frame received from the frame builder and resource allocation unit 131 as a signal corresponding to the frame, and transmits the OFDM signal via the communication channel 13 (Fig. 7).

Note that the transmission device 11 may be configured with omission of a part of the block shown in Fig. 8, such as the time interleaver 118, the SISO/MISO encoder 119, the frequency interleaver 120, and the frequency interleaver 124.

<Configuration example of bit interleaver 116>

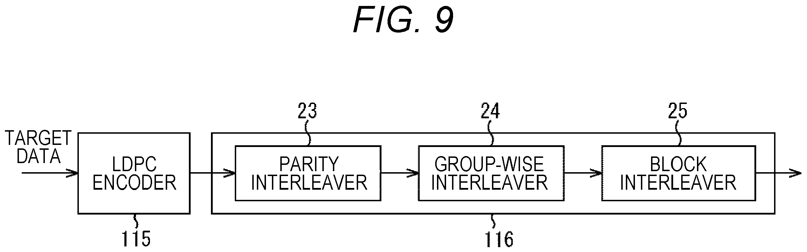

Fig. 9 is a block diagram showing a configuration example of the bit interleaver 116 shown in Fig. 8.

The bit interleaver 116 has a function of interleaving data, and is constituted by a parity interleaver 23, a group-wise interleaver 24, and a block interleaver 25.

The parity interleaver 23 performs parity interleave which interleaves a parity bit of an LDPC code received from the LDPC encoder 115 to a position of a different parity bit, and supplies the parity-interleaved LDPC code to the group-wise interleaver 24.

The group-wise interleaver 24 performs group-wise interleave for the LDPC code received from the parity interleaver 23, and supplies the group-wise interleaved LDPC code to the block interleaver 25.

In group-wise interleave performed herein, the LDPC code received from the parity interleaver 23 is interleaved in units of bit group on the assumption that a bit group is constituted by 360 bits corresponding to one section divided from the head of the one LDPC code in units of 360 bits equivalent to a unit size P described below.

When group-wise interleave is performed, error rates improve in comparison with a case not performing group-wise interleave. As a result, preferable communication quality is securable in data transmission.

The block interleaver 25 performs block interleave which demultiplexes the LDPC code received from the group-wise interleaver 24 to symbolize the one LDPC code into an m-bit symbol corresponding to a unit of mapping, and supply the symbolized LDPC code to the mapper 117 (Fig. 8), for example.

In the block interleave performed herein, the LDPC code received from the group-wise interleaver 24 is written in the column (vertical) direction, and read in the row (horizontal) direction to and from storage areas where the same number of columns as the bit number m of the symbol are arranged in the row direction, each of the columns as a storage area for storing a predetermined bit number in the column direction, for example. As a result, one LDPC code is converted into an m-bit symbol, for example.

<Parity check matrix for LDPC code>

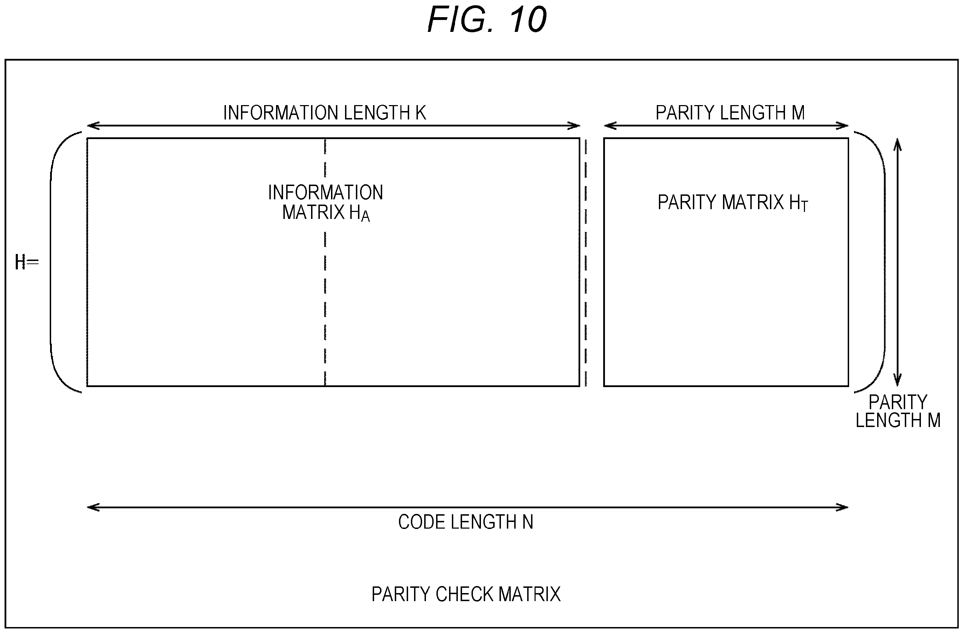

Fig. 10 is a diagram showing an example of the parity check matrix H used for LDPC encoding by the LDPC encoder 115 shown in Fig. 8.

The parity check matrix H has a low-density generation matrix (LDGM) structure, and is expressed, by using an information matrix $H_A$ for a part associated with an information bit and a parity matrix $H_T$ for a part associated with a parity bit in a sign bit of an LDPC code, as an equation H = $[H_A|H_T]$ (matrix containing elements of information matrix $H_A$ as left elements, and elements of parity matrix $H_T$ as right elements).

The bit number of the information bit, and the bit number of the parity bit in the sign bit of one LDPC code (one code word) are herein referred to as an information length K and a parity length M, respectively. The bit number of the sign bit of one LDPC code (one code word) is referred to as a code length N (= K + M).

The information length K and the parity length M for an LDPC code having a certain code length N are determined by a coding rate. The parity check matrix H herein is a row-by-column matrix expressed as an M-by-N matrix (matrix containing M rows and N columns). In addition, the information matrix $H_A$ is an M-by-K matrix, while the parity matrix $H_T$ is an M-by-M matrix.

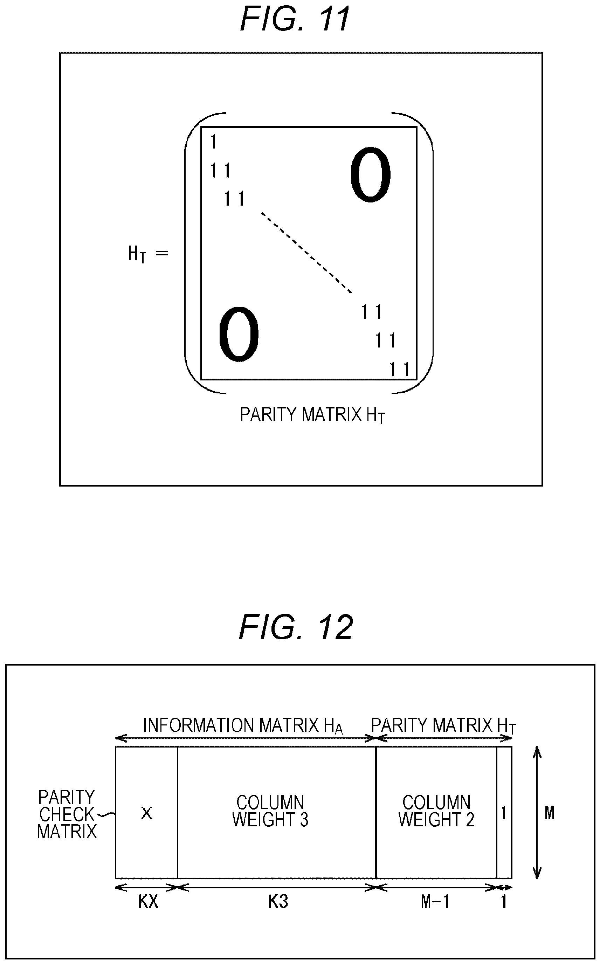

Fig. 11 is a diagram showing an example of the parity matrix $H_T$ of the parity check matrix H used for LDPC encoding by the LDPC encoder 115 shown in Fig. 8.

The parity matrix $H_T$ of the parity check matrix H used for LDPC coding by the LDPC encoder 115 is similar to the parity matrix $H_T$ of the parity check matrix H for an LDPC code specified under standards of DVB-T.2 and the like, for example.

As shown in Fig. 11, the parity matrix $H_T$ of the parity check matrix H for an LDPC code specified under standards of DVB-T.2 and the like is a matrix having an echelon structure (lower bidiagonal matrix) in a sense, where elements of 1 are arranged in a stair shape. The row weight of the parity matrix $H_T$ is 1 for the first row, and 2 for all of the remaining rows. On the other hand, the column weight of the parity matrix $H_T$ is 1 for the final one column, and 2 for all of the remaining columns.

Accordingly, by using the parity check matrix H which includes the parity matrix $H_T$ having an echelon structure, an LDPC code corresponding to the parity check matrix H is easily producible.

More specifically, the LDPC code (one code word) is expressed as a row vector c, while a column vector obtained by transposing the row vector is expressed as $c^T$. In addition, a part associated with an information bit in the row vector c corresponding to the LDPC code is expressed as a row vector A, while a part associated with a parity bit in the row vector c is expressed as a row vector T.

In this case, the row vector c is expressed, by using the row vector A corresponding to the information bit and the row vector T corresponding to the parity bit, as an equation c = [A|T] (row vector containing elements of row vector A as left elements, and elements of row vector T as right elements).

The parity check matrix H, and the row vector c = [A|T] as the LDPC code need to satisfy an equation $Hc^T$ = 0. When the parity matrix $H_T$ of the parity check matrix H = $[H_A|H_T]$ has the echelon structure shown in Fig. 11, the row vector T as the parity bit which constitutes the row vector c = [A|T] satisfying the equation $Hc^T$ = 0 is sequentially (orderly) obtained by setting 0 to the elements of the respective rows in the order from the element of the first row of the column vector $Hc^T$ under the equation $Hc^T$ = 0.

Fig. 12 is a diagram showing the parity check matrix H for an LDPC code specified under standards of DVB-T.2 and the like.

The column weight of a KX column from the first column in the parity check matrix H for the LDPC code specified under standards of DVB-T.2 and the like is set to X. The column weight of a subsequent K3 column is set to 3. The column weight of a subsequent (M - 1) column is set to 2. The column weight of the final one column is set to 1.

In this case, KX + K3 + M - 1 + 1 is equivalent to the code length N.

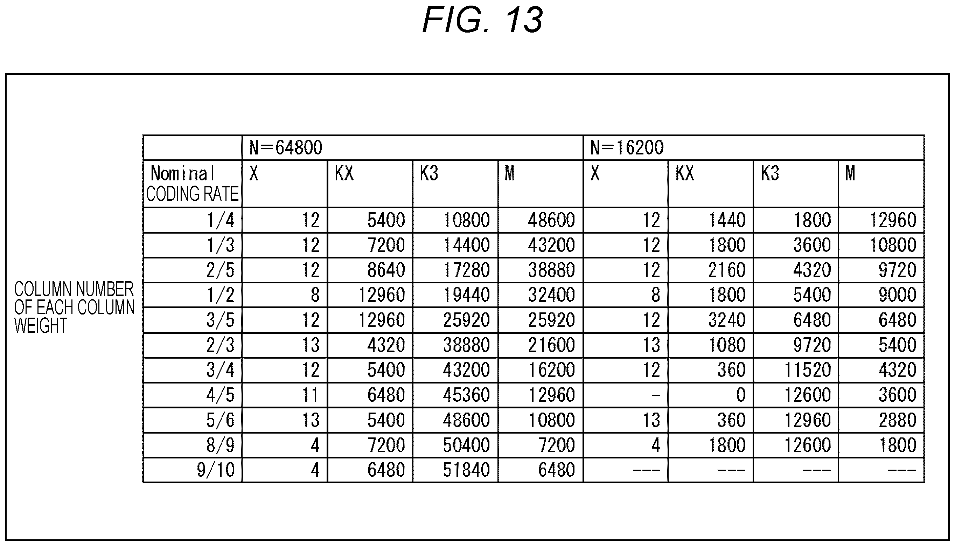

Fig. 13 is a diagram showing the column numbers KX, K3, and M, and the column weights X for the respective coding rates r of an LDPC code specified under standards of DVB-T.2 and the like.

The standards of DVB-T.2 and the like specify LDPC codes having a code length N of 64800 bits and of 16200 bits, respectively.

In this case, eleven coding rates (nominal rates) 1/4, 1/3, 2/5, 1/2, 3/5, 2/3, 3/4, 4/5, 5/6, 8/9, and 9/10 are specified for the LDPC code having the code length N of 64800 bits, while ten coding rates of 1/4, 1/3, 2/5, 1/2, 3/5, 2/3, 3/4, 4/5, 5/6, and 8/9 are specified for the LDPC code having the code length N of 16200 bits.

Hereinafter, the code length N of 64800 bits is also referred to as 64k bits, while the code length N of 16200 bits is also referred to as 16k bits.

In case of an LDPC code, an error rate of a sign bit tends to decrease as a column weight of a column associated with the sign bit in the parity check matrix H increases.

According to the parity check matrix H specified in standards of DVB-T.2 and the like shown in Figs. 12 and 13, the column weight tends to increase with nearness to the head end (left end). Accordingly, the sign bit of the LDPC code associated with the parity check matrix H is more resistant to errors (has higher resistance to errors) with nearness to the head end, and less resistant to errors with nearness to the final end.

<Parity Interleave>

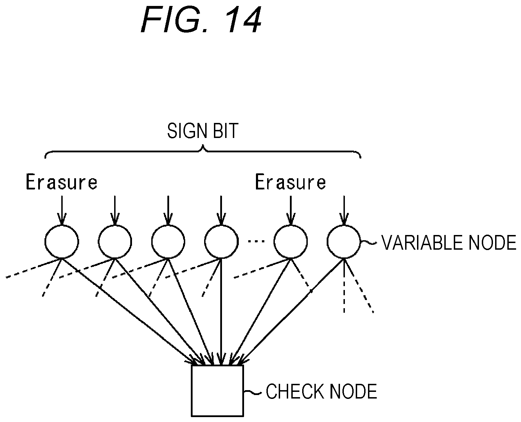

Parity interleave performed by the parity interleaver 23 shown in Fig. 9 is now described with reference to Figs. 14 through 16.

Fig. 14 is a diagram showing an example of (a part of) a Tanner graph of a parity check matrix for an LDPC code.

As shown in Fig. 14, a check node returns a message indicating an equal probability of 0 and of 1 to all variable nodes connected to the check node when a plurality of (such as two) variable nodes (sign bit associated with the variable nodes) connected to the check node simultaneously cause errors such as erasures. Accordingly, when erasures or the like simultaneously occur in a plurality of variable nodes connected to an identical check node, decoding performance deteriorates.

Incidentally, an LDPC code output from the LDPC encoder 115 shown in Fig. 8 is an IRA code similarly to an LDPC code specified in standards of DVB-T.2 and the like, for example. The parity matrix $H_T$ of the parity check matrix H has an echelon structure as shown in Fig. 11.

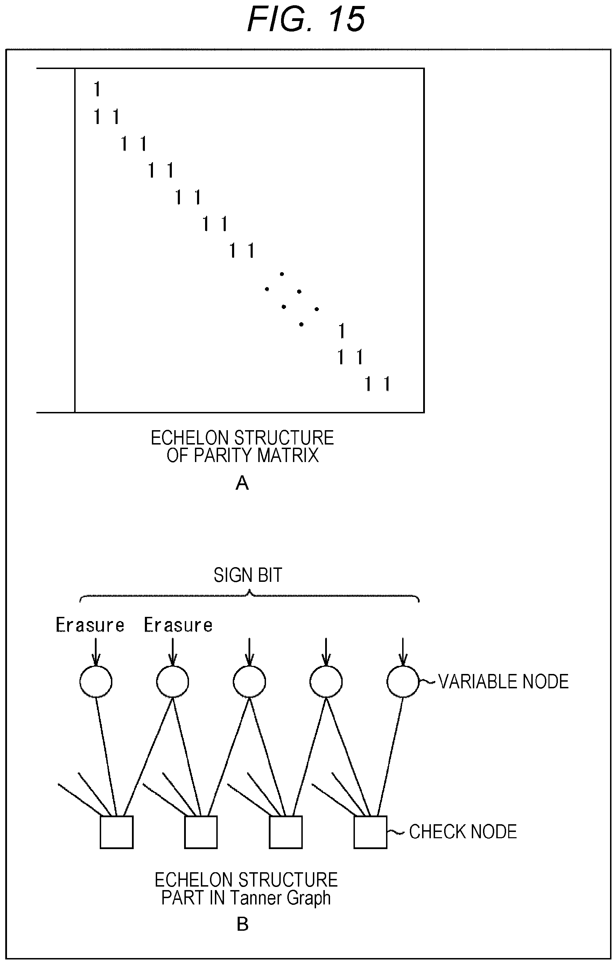

Fig. 15 is a diagram showing an example of the parity matrix $H_T$ having an echelon structure shown in Fig. 11, and an example of a Tanner graph corresponding to the parity matrix $H_T$.

Part A in Fig. 15 shows an example of the parity matrix $H_T$ having an echelon structure, while part B in Fig. 15 shows a Tanner graph corresponding to the parity matrix $H_T$ shown in part A in Fig. 15.

In the parity matrix $H_T$ having an echelon structure, elements of 1 are disposed adjacent to each other in each of the rows (except for first row). In this case, in the Tanner graph of the parity matrix $H_T$, adjoining two variable nodes associated with columns of adjoining two elements having the value of 1 in the parity matrix $H_T$ are connected to an identical check node.

Accordingly, when parity bits associated with the two adjoining variable nodes described above simultaneously cause errors as a result of burst errors, erasures or the like, the check node connected to the two variable nodes associated with the two error parity bits (variable nodes obtaining messages by using parity bits) returns a message indicating an equal probability of 0 and of 1 to the variable nodes connected to the check node. In this case, decoding performance deteriorates. In addition, the number of check nodes returning a message of an equal probability increases as the burst length (bit number of parity bits causing successive errors) increases. As a result, decoding performance further deteriorates.

Therefore, for preventing deterioration of decoding performance described above, the parity interleaver 23 (Fig. 9) performs parity interleave which interleaves a parity bit of an LDPC code received from the LDPC encoder 115 to a position of a different parity bit.

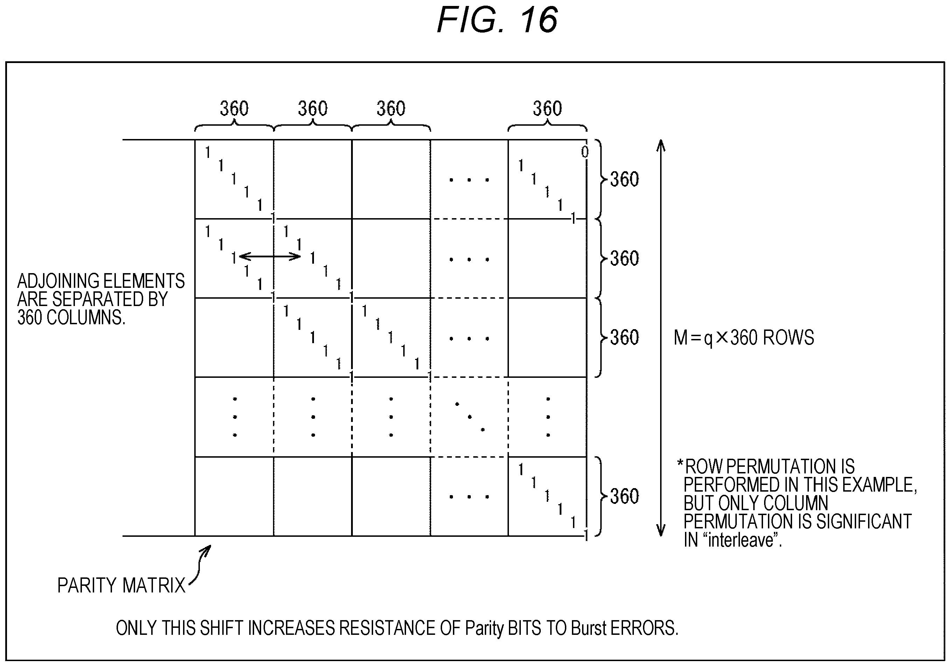

Fig. 16 is a diagram showing the parity matrix $H_T$ of the parity check matrix H associated with the LDPC code parity-interleaved by the parity interleaver 23 shown in Fig. 9.

Here, the information matrix $H_A$ of the parity check matrix H corresponding to an LDPC code output from the LDPC encoder 115 has a circulant structure similarly to an information matrix of the parity check matrix H corresponding to an LDPC code specified in standards of DVB-T.2 and the like.

The circulant structure refers to such a structure which contains a certain column coinciding with a cyclically shifted different column. For example, the circulant structure includes such a structure which contains sets of P columns in each of which elements of 1 are disposed in respective rows at such positions that an initial column of the P columns is cyclically shifted in the column direction by a predetermined value such as a value proportional to a value q obtained by division of the parity length M. The P columns in the circulant structure are hereinafter referred to as a unit size where appropriate.

As described in Figs. 12 and 13, there are two types of LDPC code having the code length N of 64800 bits and of 16200 bits as an LDPC code specified in standards of DVB-T.2 and the like. Each of the unit sizes P of the two types of LDPC code is designated as 360 corresponding one of divisors of the parity length M other than 1 and M.

In addition, the parity length M is a value other than primes, and expressed by an equation $M = q \times P = q \times 360$ by using the value q different for each coding rate. Accordingly, similarly to the unit size P, the value q is another divisor in the divisors of the parity length M other than 1 and M, and obtained by dividing the parity length M by the unit size P (product of P and q as divisors of parity length M is equivalent to parity length M).

As described above, the parity interleaver 23 interleaves a $(K + qx + y + 1)$th sign bit in sign bits of an N-bit LDPC code to a position of $(K + Py + x + 1)$th sign bit for parity interleave on the assumption that an information length is K, that an integer of 0 or more and less than P is x, and that an integer of 0 or more and less than q is y.

Each of the $(K + qx + y + 1)$th sign bit, and the $(K + Py + x + 1)$th sign bit is a $(K + 1)$th or later sign bit, and therefore corresponds to a parity bit. Accordingly, the position of the parity bit of the LDPC code is shifted by parity interleave.

According to parity interleave in this manner, variable nodes (parity bits associated with variable nodes) connected to an identical check node are away from each other by the unit size P, i.e., 360 bits in this example. In this case, a plurality of the variable nodes connected to an identical check node do not simultaneously cause errors when the burst length is smaller than 360 bits. Accordingly, resistance to burst errors improves.

Note that the LDPC code obtained after party interleave which interleaves the $(K + qx + y + 1)$th sign bit to the position of the $(K + Py + x + 1)$th sign bit coincides with an LDPC code of a parity check matrix obtained by column permutation for permutating the $(K + qx + y + 1)$th column of the original parity check matrix H to the $(K + Py + x + 1)$th column (hereinafter also referred to as converted parity check matrix).

In addition, as shown in Fig. 16, a parity matrix of the converted parity check matrix has a pseudo circulant structure appearing in units of P columns (360 columns in Fig. 16).

The pseudo circulant structure herein refers to a structure which has a partial circulant structure except for a part.

The converted parity check matrix obtained by column permutation corresponding to parity interleave for a parity check matrix of an LDPC code specified in standards of DVB-T.2 and the like lacks in only one element of 1 (contains 0 element) in a 360 rows by 360 columns part at the right upper corner of the converted parity check matrix (shift matrix described below), and therefore does not have a (complete) circulant structure, but a so-called pseudo circulant structure in this point.

The converted parity check matrix for a parity check matrix of an LDPC code output from the LDPC encoder 115 has a pseudo circulant structure similarly to a converted parity check matrix for a parity check matrix of an LDPC code specified in standards of DVB-T.2 and the like, for example.

Note that the converted parity check matrix shown in Fig. 16 is a matrix subjected to permutation of rows (row permutation) to be configured by a configuration matrix described below, as well as column permutation corresponding to parity interleave for the original parity check matrix H.

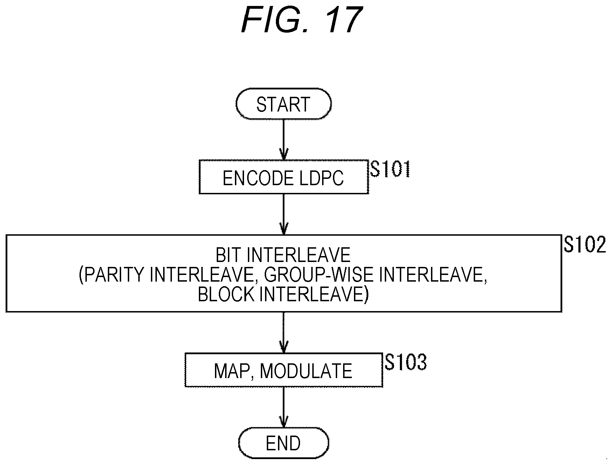

Fig. 17 is a flowchart showing a process performed by the LDPC encoder 115, the bit interleaver 116, and the mapper 117 shown in Fig. 8.

The LDPC encoder 115 waits for supply of LDPC target data from the BCH encoder 114. In step S101, the LDPC encoder 115 encodes the LDPC target data into an LDPC code, and supplies the LDPC code to the bit interleaver 116. Thereafter, the process proceeds to step S102.

In step S102, the bit interleaver 116 performs bit interleave for a target of the LDPC code received from the LDPC encoder 115, and supplies a symbol obtained by bit interleave to the mapper 117. Thereafter, the process proceeds to step S103.

More specifically, the parity interleaver 23 in the bit interleaver 116 (Fig. 9) performs parity interleave for the target of the LDPC code received from the LDPC encoder 115 in step S102, and supplies the parity-interleaved LDPC code to the group-wise interleaver 24.

The group-wise interleaver 24 performs group-wise interleave for a target of the LDPC code received from the parity interleaver 23, and supplies the resultant LDPC code to the block interleaver 25.

The block interleaver 25 performs block interleave for a target of the LDPC code group-wise interleaved by the group-wise interleaver 24, and supplies an m-bit symbol thus obtained to the mapper 117.

In step S103, the mapper 117 maps the symbol received from the block interleaver 25 to any one of $2^m$ signal points defined by a modulation system of quadrature modulation performed by the mapper 117 for quadrature modulation, and supplies the data thus obtained to the time interleaver 118.

Accordingly, error rates improve by parity interleave and group-wise interleave when a plurality of sign bits of an LDPC code are transmitted as one symbol.

According to the example herein shown in Fig. 9, the parity interleaver 23 as a block for performing parity interleave, and the group-wise interleaver 24 as a block for performing group-wise interleave are separately provided for convenience of description. However, the parity interleaver 23 and the group-wise interleaver 24 may be formed integrally with each other.

More specifically, each of parity interleave and the group-wise interleave is performed by writing and reading a sign bit to and from a memory, and expressed as a matrix which converts an address for writing a sign bit (writing address) into an address for reading a sign bit (reading address).

Accordingly, an LDPC code parity-interleaved, and also group-wise interleaved after parity interleave is producible by using a matrix obtained by multiplying a matrix representing parity interleave by a matrix representing group-wise interleave.

Moreover, the block interleaver 25 may be further formed integrally with the parity interleaver 23 and the group-wise interleaver 24.

More specifically, block interleave performed by the block interleaver 25 may be also expressed as a matrix which converts a writing address in a memory storing an LDPC code into a reading address.

Accordingly, parity interleave, group-wise interleave, and block interleave are collectively performed by using a matrix obtained by multiplying a matrix representing parity interleave by a matrix representing group-wise interleave, and further by a matrix representing block interleave.

<Configuration example of LDPC encoder 115>

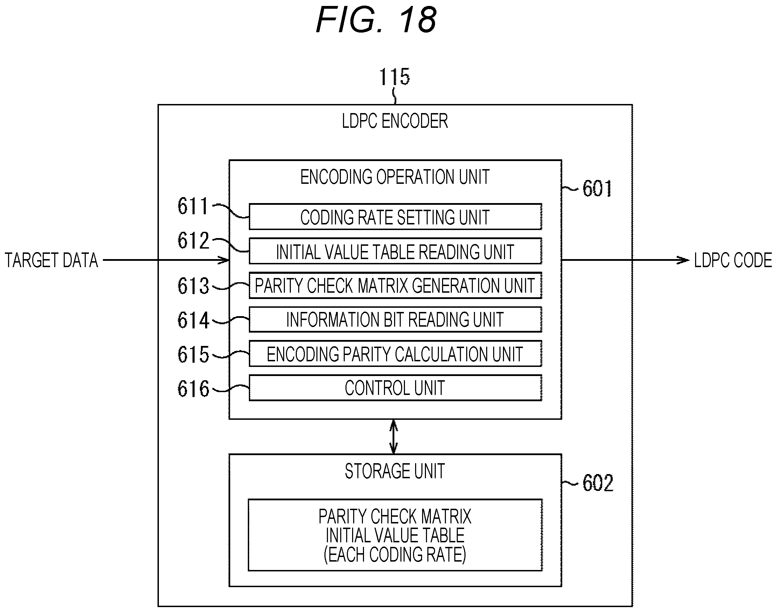

Fig. 18 is a block diagram showing a configuration example of the LDPC encoder 115 shown in Fig. 8.

Note that the LDPC encoder 122 shown in Fig. 8 is similarly configured.

As described with reference to Figs. 12 and 13, there are specified two types of LDPC codes having the code length N of 64800 bits and 16200 bits in standards of DVB-T.2 and the like.

In this case, eleven coding rates 1/4, 1/3, 2/5, 1/2, 3/5, 2/3, 3/4, 4/5, 5/6, 8/9, and 9/10 are specified for the LDPC code having the code length N of 64800 bits, while ten coding rates of 1/4, 1/3, 2/5, 1/2, 3/5, 2/3, 3/4, 4/5, 5/6, and 8/9 for the LDPC code having the code length N of 16200 bits (Figs. 12 and 13).

For example, the LDPC encoder 115 performs encoding (error correction encoding) corresponding to LDPC codes having code lengths N of 64800 bits and 16200 bits at respective coding rates on the basis of the parity check matrix H prepared for each code length N and for each coding rate.

The LDPC encoder 115 is constituted by an encoding operation unit 601 and a storage unit 602.

The encoding operation unit 601 is constituted by a coding rate setting unit 611, an initial value table reading unit 612, a parity check matrix generation unit 613, an information bit reading unit 614, an encoded parity calculation unit 615, and a control unit 616. The encoding operation unit 601 performs LDPC encoding for an LDPC target data supplied to the LDPC encoder 115, and supplies an LDPC code thus obtained to the bit interleaver 116 (Fig. 8).

More specifically, the coding rate setting unit 611 sets a code length N and a coding rate of an LDPC code in accordance with an operation by an operator or the like, for example.

The initial value table reading unit 612 reads a parity check matrix initial value table (described below) corresponding to the code length N and the coding rate set by the coding rate setting unit 611 from the storage unit 602.

The parity check matrix generation unit 613 puts elements of 1 of the information matrix $H_A$ corresponding to an information length K (= code length N - Parity length M) in accordance with the code length N and the coding rate set by the coding rate setting unit 611 on the basis of the parity check matrix initial value table read by the initial value table reading unit 612 in cycles of 360 columns (unit size P) in the column direction to generate the parity check matrix H, and stores the generated parity check matrix H in the storage unit 602.

The information bit reading unit 614 reads (extracts) information bits corresponding to an amount of the information length K from LDPC target data supplied to the LDPC encoder 115.

The encoded parity calculation unit 615 reads the parity check matrix H generated by the parity check matrix generation unit 613 from the storage unit 602, and calculates parity bits for the information bits read by the information bit reading unit 614 by using the read parity check matrix H on the basis of a predetermined equation to generate a code word (LDPC code).

The control unit 616 controls respective blocks constituting the encoding operation unit 601.

The storage unit 602 stores a plurality of parity check matrix initial value tables and the like respectively corresponding to a plurality of coding rates and the like shown in Figs. 12 and 13 for each of the code lengths N of 64800 bits and 16200 bits, for example. The storage unit 602 further temporarily stores data necessary for processing by the encoding operation unit 601.

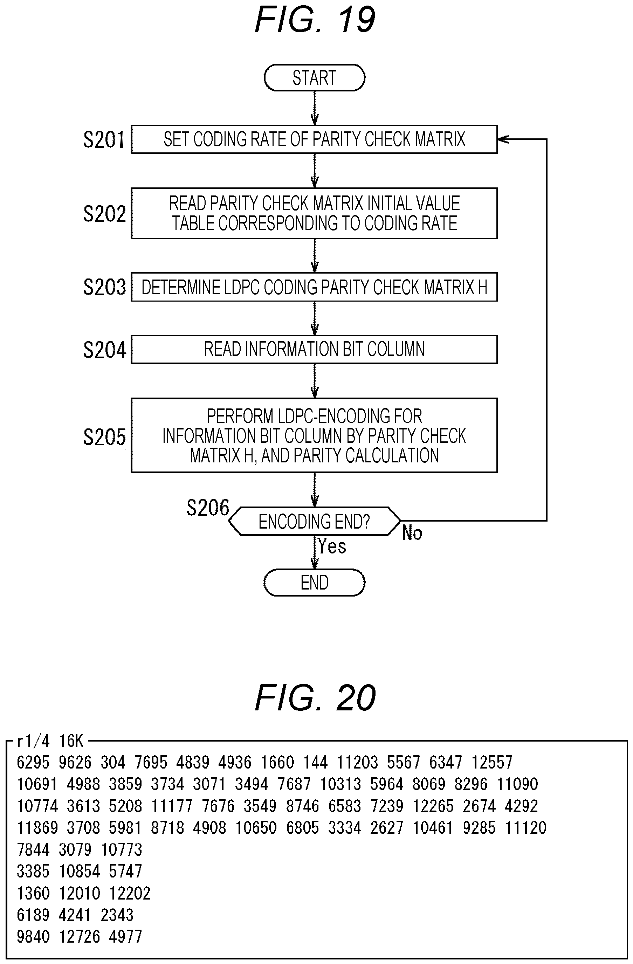

Fig. 19 is a flowchart showing an example of a process performed by the LDPC encoder 115 shown in Fig. 18.

In step S201, the coding rate setting unit 611 determines (sets) the code length N and a coding rate r for LDPC encoding.

In step S202, the initial value table reading unit 612 reads a predetermined parity check matrix initial value table corresponding to the code length N and the coding rate r determined by the coding rate setting unit 611 from the storage unit 602.

In step S203, the parity check matrix generation unit 613 obtains (generates) a parity check matrix H for an LDPC code having the code length N and the coding rate r determined by the coding rate setting unit 611 by using the parity check matrix initial value table read by the initial value table reading unit 612 from the storage unit 602, and supplies the obtained parity check matrix H to the storage unit 602 to store the parity check matrix H therein.

In step S204, the information bit reading unit 614 reads information bits having an information length K (= N $\times$ r) corresponding to the code length N and the coding rate r determined by the coding rate setting unit 611 from the LDPC target data supplied to the LDPC encoder 115, and reads the parity check matrix H obtained by the parity check matrix generation unit 613 from the storage unit 602 to supply the parity check matrix H to the encoded parity calculation unit 615.

In step S205, the encoded parity calculation unit 615 sequentially calculates parity bits of a code word c satisfying Equation (8) by using the information bits received from the information bit reading unit 614 and the parity check matrix H.

$$\mathrm{Hc^T} \; = \; 0 \; \dots \; (8)$$

In Equation (8), c represents a row vector as a code word (LDPC code), while $c^T$ represents transposition of the row vector c.

Here, as described above, when a part associated with the information bits and a part associated with the parity bits in the row vector c as the LDPC code (one code word) are expressed as a row vector A and a row vector T, respectively, the row vector c is expressed as an equation c = [A|T] by using the row vector A as the information bits and the row vector T as the parity bits.

The parity check matrix H and the row vector c = [A|T] as the LDPC code need to satisfy an equation $Hc^T$ = 0. The row vector T as a parity bit which constitutes the row vector c = [A|T] satisfying the equation $Hc^T$ = 0 is sequentially obtained by sequentially setting 0 to elements in respective rows from the element in the first row of the row vector $Hc^T$ under the equation $Hc^T$ = 0 when the parity matrix $H_T$ of the parity check matrix H = [$H_A$|$H_T$] has an echelon structure shown in Fig. 11.

The encoded parity calculation unit 615 obtains the parity bits T for the information bits A obtained from the information bit reading unit 614, and outputs a code word c = [A|T] expressed by the information bits A and the parity bits T as an LDPC coding result of the information bit A.

In subsequent step S206, the control unit 616 determines whether to end LDPC encoding. When it is determined in step S206 that LDPC encoding is not to end, i.e., when LDPC target data for LDPC encoding is still present, for example, the process returns to step S201 (or step S204). Thereafter, processing from step S201 (or step S204) to step S206 is repeated.

On the other hand, when it is determined in step S206 that LDPC coding is to end, i.e., when LDPC target data for LDPC encoding is absent, for example, the LDPC encoder 115 ends processing.

As described above, the parity check matrix initial value tables corresponding to respective code lengths N and coding rates r are prepared. The LDPC encoder 115 performs LDPC encoding in accordance with the predetermined code length N and the predetermine coding rate r by using the parity check matrix H generated on the basis of the parity check matrix initial value table corresponding to the predetermined code length N and the predetermined coding rate r.

<Example of parity check matrix initial value table>

The parity check matrix initial value table is a table which indicates positions of element of 1 in an information matrix $H_A$ (Fig. 10) of a parity check matrix H in correspondence with an information length K corresponding to a code length N and a coding rate r of an LDPC code (LDPC code defined by parity check matrix H) for each set of 360 columns (unit size P), and prepared beforehand for each of parity check matrixes H having respective code lengths N and coding rates r.

In other words, the parity check matrix initial value table indicates at least positions of elements of 1 in the information matrix $H_A$ for each set of 360 columns (unit size P).

In addition, examples of the parity check matrix H include a parity check matrix which includes the parity matrix $H_T$ having an (entire) echelon structure as specified in DVB-T.2 and the like, and a parity check matrix which has an echelon structure in a part of the parity matrix $H_T$, and a diagonal matrix (unit matrix) in a remaining part as proposed by CRC/ETRI.

Hereinafter, an expressing system of a parity check matrix initial value table indicating a parity check matrix which includes the parity matrix $H_T$ having an echelon structure specified in DVB-T.2 and the like is also referred to as a DVB system, while an expressing system of a parity check matrix initial value table indicating a parity check matrix proposed by CRC/ETRI is also referred to as an ETRI system.

Fig. 20 is a diagram showing an example of a DVB system parity check matrix initial value table.

More specifically, Fig. 20 shows a parity check matrix initial value table for a parity check matrix H having a code length N of 16200 bits and a coding rate (coding rate in expression of DVB-T.2) r of 1/4 specified in standards of DVB-T.2.

The parity check matrix generation unit 613 (Fig. 18) obtains the parity check matrix H in the following manner by using the DVB system parity check matrix initial value table.

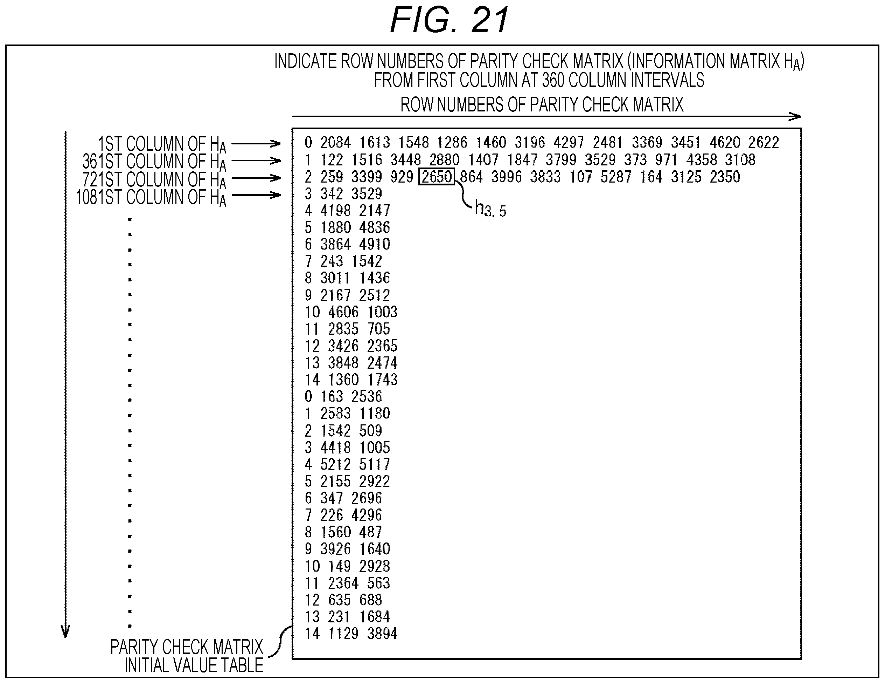

Fig. 21 is a diagram showing a method for obtaining the parity check matrix H from the DVB system parity check matrix initial value table.

More specifically, Fig. 21 shows the parity check matrix initial value table for the parity check matrix H having the code length N of 16200 bits and the coding rate r of 2/3 specified in standards of DVB-T.2.

The DVB system parity check matrix initial value table is a table indicating positions of elements of 1 in the entire information matrix $H_A$ in correspondence with the information length K corresponding to the code length N and the coding rate r of the LDPC code for each set of 360 columns (unit size P). The ith row of the table contains the same number of the row numbers (row number set to 0 in first row of parity check matrix H) of elements of 1 in 1 + 360 × (i - 1)th column of the parity check matrix H as the number of the column weight given to the 1 + 360 × (i - 1)th column.

The parity matrix $H_T$ (Fig. 10) corresponding to the parity length M in the DVB system parity check matrix H herein has a determined echelon structure as shown in Fig. 15. Accordingly, the parity check matrix H is obtained on the basis of the information matrix $H_A$ (Fig. 10) corresponding to the information length K obtained by using the parity check matrix initial value table.

A number of rows (k + 1) of the DVB system parity check matrix initial value table differs for each information length K.

A following relationship shown in an equation (9) holds between the information length K and the number of rows (k + 1) of the parity check matrix initial value table.

$$K = (k + 1) \times 360 \ \dots \ (9)$$

In this case, 360 in Equation (9) indicates the unit size P described with reference to Fig. 16.

According to the parity check matrix initial value table shown in Fig. 21, 13 numerical values are shown from the first to third rows, while 3 numerical values are shown from the fourth row to the (k + 1)th row (30th row in Fig. 21).

Accordingly, the column weight of the parity check matrix H obtained from the parity check matrix initial value table shown in Fig. 21 is 13 from the first column to the (1 + 360 × (3 - 1) - 1)th column, and 3 from the (1 + 360 × (3 - 1))th column to the Kth column.

The parity check matrix initial value table in Fig. 21 indicates 0, 2084, 1613, 1548, 1286, 1460, 3196, 4297, 2481, 3369, 3451, 4620, and 2622 in the first row. This indicates that the row number in the first column of the parity check matrix H is 1 for the elements of the rows of 0, 2084, 1613, 1548, 1286, 1460, 3196, 4297, 2481, 3369, 3451, 4620, and 2622 (and 0 for other elements).

In addition, the parity check matrix initial value table in Fig. 21 indicates 1, 122, 1516, 3448, 2880, 1407, 1847, 3799, 3529, 373, 971, 4358, and 3108 in the second row. This indicates that the row number in the 361st (= 1 + 360 × (2 -1)) column of the parity check matrix H is 1 for the elements of the rows of 1, 122, 1516, 3448, 2880, 1407, 1847, 3799, 3529, 373, 971, 4358, and 3108.

As described above, the parity check matrix initial value table indicates positions of elements of 1 in the information matrix $H_A$ of the parity check matrix H for each set of 360 columns.

Each of columns other than the (1 + 360 × (i - 1))th column of the parity check matrix H, i.e., columns from the (2 + 360 × (i - 1))th column to (360 × i)th column contains an element of 1 defined in the (1 + 360 × (i - 1))th column in the parity check matrix initial value table and cyclically shifted downward (downward in columns) in accordance with the parity length M in a cyclical manner.

More specifically, for example, the (2 + 360 × (i - 1))th column corresponds to a column cyclically shifted downward by M/360 (= q) from the (1 + 360 × (i - 1))th column. The subsequent (3 + 360 × (i - 1))th corresponds to a column cyclically shifted downward by 2 × M/360 (= 2 × q) from the (1 + 360 × (i - 1))th column (i.e., column cyclically shifted downward by M/360 (= q) from 2 + 360 × (i - 1))th column.

Assuming herein that a numerical value in the ith row (ith from the top) and jth column (jth from the left) in the parity check matrix initial value table is expressed as $h_{i, j}$, and that a row number of the jth element of 1 in the wth column in the parity check matrix H is expressed as $H_{w-j}$, the row number $H_{w-j}$ in the wth column as a column other than the (1 + 360 $\times$ (i - 1)th column in the parity check matrix H is obtained by using Equation (10).

$$H_{w-j} = \text{mod}\{h_{i,j} + \text{mod}((w - 1), P) \times q, M) \quad \dots \quad (10)$$

In this equation, mod (x, y) indicates a remainder when x is divided by y.

In addition, P indicates the unit size described above, and is set to 360 according to the first embodiment, for example, similarly to standards of DVB-S.2, DVB-T.2, and DVB-C.2. Furthermore, q indicates a value M/360 obtained by dividing the parity length M by the unit size P (= 360).

The parity check matrix generation unit 613 (Fig. 18) specifies the row number of the element of 1 in the (1 + 360 $\times$ (i - 1)th column in the parity check matrix H on the basis of the parity check matrix initial value table.

The parity check matrix generation unit 613 (Fig. 18) further obtains the row number $H_{w-j}$ of the element of 1 in the wth column as a column other than the (1 + 360 $\times$ (i - 1)th column in the parity check matrix H by using Equation (10) to generate a parity check matrix H which sets 1 to the elements of the row numbers thus obtained.

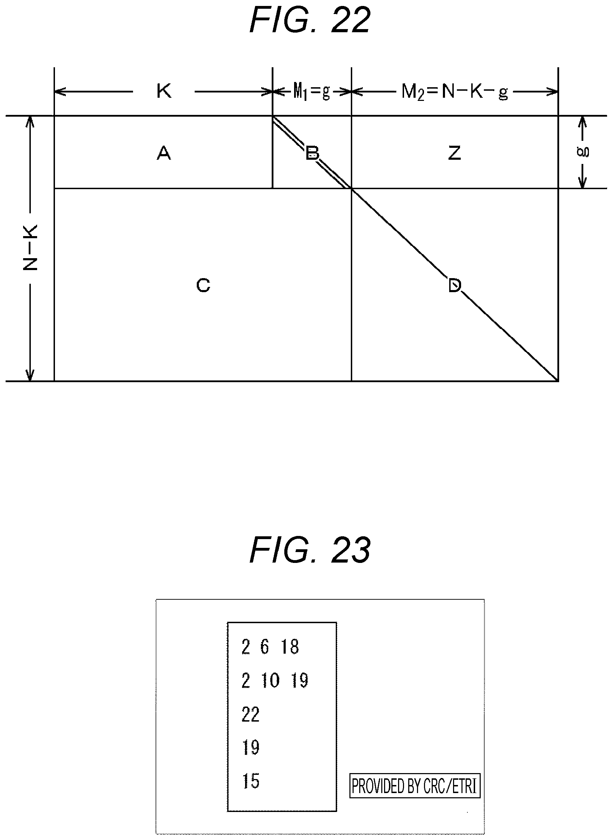

Fig. 22 is a diagram showing a structure of an ETRI system parity check matrix.

The ETRI system parity check matrix is constituted by A matrix, B matrix, C matrix, D matric, and Z matric.

The A matrix is a g-row K-column matrix located at the upper left position in the parity check matrix and expressed by a predetermined value g and an information length K of an LDPC code = code length N $\times$ coding rate r.

The B matrix is a g row g column matrix located on the right side of the A matrix and having an echelon structure.

The C matrix is a (N - K - g) row (K + g) column matrix located on the lower sides of the A matrix and the B matrix.

The D matrix is a (N - K - g) row (N - K - g) column unit matrix located on the right side of the C matrix.

The Z matrix is a g row (N - K - g) column zero (0) matrix located on the right side of the B matrix.

According to the ETRI system parity check matrix constituted by the A matrix through the D matrix and the Z matrix, the A matrix and a part of the C matrix constitute an information matrix, while the B matrix, a remaining part of the C matrix, the D matrix, and the Z matrix constitute a parity matrix.

Note that the B matrix is a matrix having an echelon structure, and that the D matrix is a unit matrix. Accordingly, the parity matrix of the ETRI system parity check matrix has a part (B matrix part) having an echelon structure, and the remaining part (D matrix part) constitutes a diagonal matrix (unit matrix).

Similarly to the information matrix of the DVB system parity check matrix, each of the A matrix and the C matrix has a circulant structure for each set of 360 columns (unit size P). The ETRI system parity check matrix initial value table indicates positions of elements of 1 of the A matrix and the C matrix for each set of 360 columns.

Here, as described above, the A matrix and a part of the C matrix constitute an information matrix. Accordingly, it is apparent that the ETRI system parity check matrix initial value table indicating positions of elements of 1 in the A matrix and the C matrix for each set of 360 columns shows at least positions of elements of 1 in the information matrix for each set of 360 columns.

Fig. 23 is a diagram showing an example of an ETRI system parity check matrix initial value table.

More specifically, Fig. 23 shows an example of a parity check matrix initial value table for a parity check matrix having a code length N of 50 bits and a coding rate r of 1/2.

The ETRI system parity check matrix initial value table is a table which indicates positions of elements of 1 in the A matrix and the C matrix for each unit size P. In this case, the same number as the number of the column weight given to the (1 + P $\times$ (i - 1))th column is indicated in the ith row of the table as the row number (row number set to 0 in first row of parity check matrix) of the element of 1 in the (1 + P $\times$ (i - 1))th column in the parity check matrix.

Note that the unit size P herein is 5, for example, for simplifying the description.

In addition, parameters of the ETRI system parity check matrix include g = $M_1$, $M_2$, $Q_1$, and $Q_2$.

The parameter g = $M_1$ is a parameter for determining the size of the B matrix, and becomes a multiple of the unit size P. Performance of an LDPC code varies by controlling g = $M_1$, wherefore g = $M_1$ is adjusted to a predetermined value when determining a parity check matrix. It is assumed herein that 15 corresponding to 3 times larger than the unit size P = 5 is set to g = $M_1$.

The parameter $M_2$ is a value M - $M_1$ as a value calculated by subtracting $M_1$ from the parity length M.

The information length K herein is N $\times$ r = 50 $\times$ 1/2 = 25, while the parity length M is N - K = 50 - 25 = 25. Accordingly, $M_2$ is calculated as M - $M_1$ = 25 - 15 = 10.

On the other hand, $Q_1$ is calculated by an equation $Q_1 = M_1/P$, and indicates a shift number (number of rows) of a cyclic shift in the A matrix.

More specifically, each of the columns other than the (1 + P $\times$ (i - 1))th column in the A matrix of the ETRI system parity check matrix, i.e., each of the columns from the (2 + P $\times$ (i - 1))th column to the (P $\times$ i)th column cyclically shifts the element of 1 in the (1 + 360 $\times$ (i - 1))th column defined in the parity check matrix initial value table downward (downward in column direction) in a cyclical manner. In this case, $Q_1$ indicates the shift number of the cyclic shift in the A matrix.

On the other hand, $Q_2$ is obtained by an equation $Q_2 = M_2/P$, and indicates the shift number (number of rows) of the cyclic shift of the C matrix.

More specifically, each of the columns other than the $(1 + P \times (i - 1))$th column in the C matrix of the ETRI system parity check matrix, i.e., each of the columns from the $(2 + P \times (i - 1))$th column to the $(P \times i)$th column cyclically shifts the element of 1 in the $(1 + 360 \times (i - 1))$th column defined in the parity check matrix initial value table downward (downward in column direction) in a cyclical manner. In this case, $Q_2$ indicates the shift number of the cyclic shift in the C matrix.

In this example, $Q_1$ herein is set to $M_1/P = 15/5 = 3$, while $Q_2$ is set to $M_2/P = 10/5 = 2$.

In the parity check matrix initial value table shown in Fig. 23, three numerical values are arranged in each of the first row and the second row, while one numerical value is arranged in each of rows from the third row to the fifth row. According to this arrangement of numerical values, the column weight of the parity check matrix obtained from the parity check matrix initial value table shown in Fig. 23 is 3 from the first column to the $(1 + 5 \times (2 - 1) - 1)$th column, and 1 from the $(1 + 5 \times (2 - 1))$th column to the fifth column.

More specifically, 2, 6, and 18 are put in the first row in the parity check matrix initial value table shown in Fig. 23. This indicates that elements of rows corresponding to row numbers of 2, 6, and 18 are set to 1 (and that other elements are set to 0) in the first column of the parity check matrix.

In this case, the A matrix herein is a 15 row 25 column (g row K column) matrix, while the C matrix is a 10 row 40 column ((N - K - g) row (K + g) column) matrix. The rows corresponding to row numbers 0 through 14 in the parity check matrix are therefore rows of the A matrix, while the rows corresponding to row numbers 15 through 24 in the parity check matrix are rows of the C matrix.

Accordingly, in the rows corresponding to row numbers 2, 6, and 18 (hereinafter expressed as rows #2, #6, and #18), the rows #2 and #6 are rows of the A matrix, while the row #18 is a row of the C matrix.

On the other hand, 2, 10, and 19 are put in the second row in the parity check matrix initial value table shown in Fig. 23. This indicates that the elements of the rows #2, #10, and #19 are set to 1 in the 6th (= $1 + 5 \times (2 - 1)$) column of the parity check matrix.

In this case, in the 6th (= $1 + 5 \times (2 - 1)$) column of the parity check matrix, the rows #2 and #10 in the rows #2, #10, and #19 are rows of the A matrix, while the row #19 is a row of the C matrix.

On the other hand, 22 is put in the third row in the parity check matrix initial value table shown in Fig. 23. This indicates that the element of the row #22 is set to 1 in the 11th (= $1 + 5 \times (3 - 1)$) column of the parity check matrix.

In this case, the row #22 in the 11th (= $1 + 5 \times (3 - 1)$) column of the parity check matrix is a row of the C matrix.

Similarly, 19 in the fourth row in the parity check matrix initial value table in Fig. 23 indicates that the element of the row #19 is 1 in the 16th (= $1 + 5 \times (4 - 1)$) column of the parity check matrix, while 15 in the fifth row in the parity check matrix initial value table in Fig. 23 indicates that the element of the row #15 is 1 in the 21st (= $1 + 5 \times (5 - 1)$) column of the parity check matrix

Accordingly, the parity check matrix initial value table indicates positions of elements of 1 in the A matrix and the C matrix of the parity check matrix for each unit size $P = 5$ columns.

Each of the columns other than the $(1 + 5 \times (i - 1))$th column, i.e., from the $(2 + 5 \times (i - 1))$th column to the $(5 \times i)$th column in the A matrix and the C matrix in the parity check matrix contains the element of 1 in the $(1 + 5 \times (i - 1))$th column defined in the parity check matrix initial value table and cyclically shifted downward (downward in column direction) in a cyclical manner in accordance with the parameters $Q_1$ and $Q_2$.

More specifically, for example, the $(2 + 5 \times (i - 1))$th column in the A matrix corresponds to a column cyclically shifted downward by $Q_1$ (= 3) from the $(1 + 5 \times (i - 1))$th column, while the subsequent $(3 + 5 \times (i - 1))$th column corresponds to a column shifted downward by $2 \times Q_1$ (= $2 \times 3$) from the $(1 + 5 \times (i - 1))$th column (corresponds to a column shifted downward by $Q_1$ from the $(2 + 5 \times (i - 1))$th column).

In addition, for example, the $(2 + 5 \times (i - 1))$th column in the C matrix corresponds to a column cyclically shifted downward by $Q_2$ (= 2) from the $(1 + 5 \times (i - 1))$th, while the subsequent $(3 + 5 \times (i - 1))$th column corresponds to a column shifted downward by $2 \times Q_2$ (= $2 \times 2$) from the $(1 + 5 \times (i - 1))$th (corresponds to a column cyclically shifted downward by $Q_2$ from the $(2 + 5 \times (i - 1))$th).

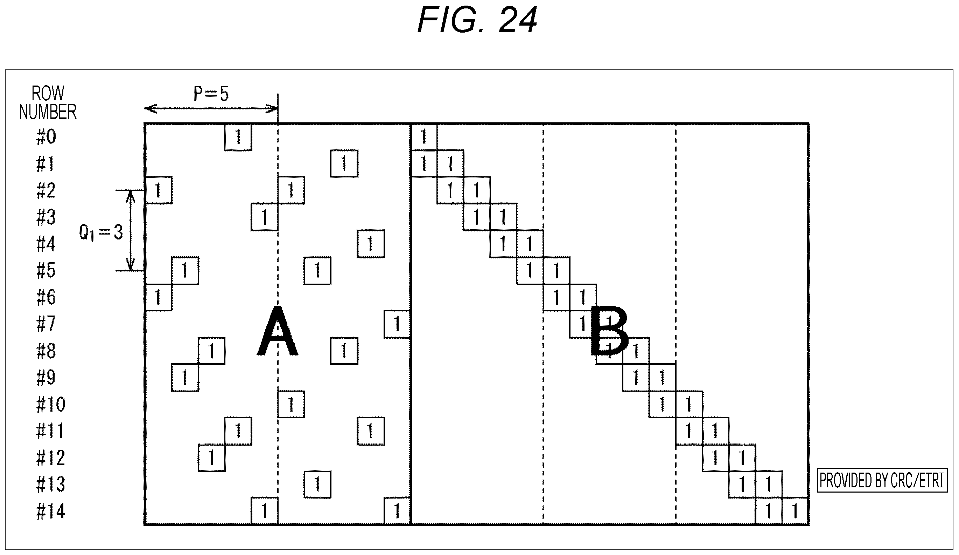

Fig. 24 is a diagram showing the A matrix generated on the basis of the parity check matrix initial value table shown in Fig. 23.

In the A matrix in Fig. 24, the elements in the rows #2 and #6 in the 1st (= $1 + 5 \times (1 - 1)$) column are set to 1 on the basis of the first row in the parity check matrix initial value table in Fig. 23.

In addition, each column from the 2nd (= $2 + 5 \times (1 - 1)$) column to the 5th (= $5 + 5 \times (1 - 1)$) column corresponds to the column located immediately before and cyclically shifted downward by $Q_1 = 3$.

Furthermore, in the A matrix in Fig. 24, the elements in the rows #2 and #10 in the 6th (= $1 + 5 \times (2 - 1)$) column are set to 1 on the basis of the second row in the parity check matrix initial value table in Fig. 23.

In addition, each column from the 7th (= 2 + 5 × (2 - 1)) column to the 10th (= 5 + 5 × (2 - 1)) column corresponds to the column located immediately before and cyclically shifted downward by $Q_1 = 3$.

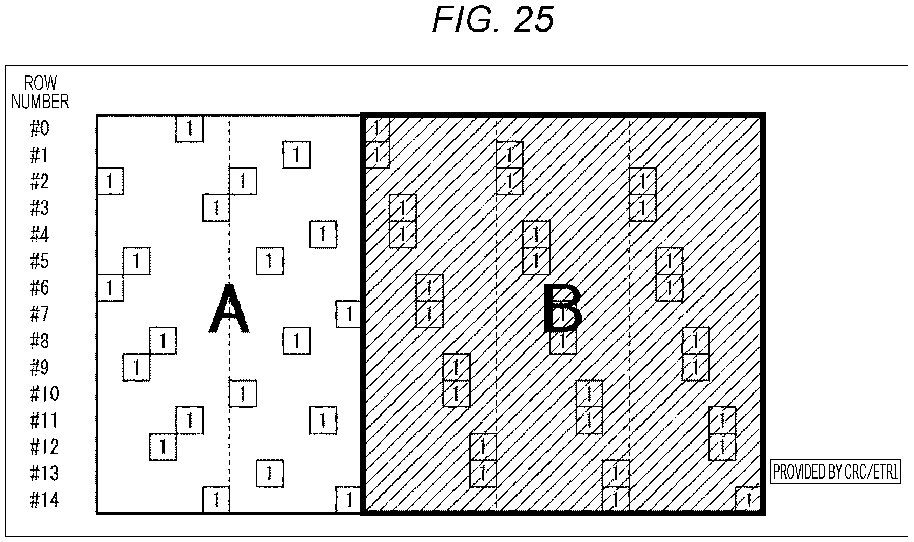

Fig. 25 is a diagram showing parity interleave of the B matrix.

The parity check matrix generation unit 613 (Fig. 18) generates the A matrix by using the parity check matrix initial value table, and positions the B matrix having an echelon structure on the right side of the A matrix. Thereafter, the parity check matrix generation unit 613 determines the B matrix as a parity matrix, and performs parity interleave such that adjoining elements of 1 in the B matrix having the echelon structure are located away from each other by the unit size P = 5 in the row direction.

Fig. 25 shows the A matrix and the B matrix obtained after parity interleave performed for the B matrix.

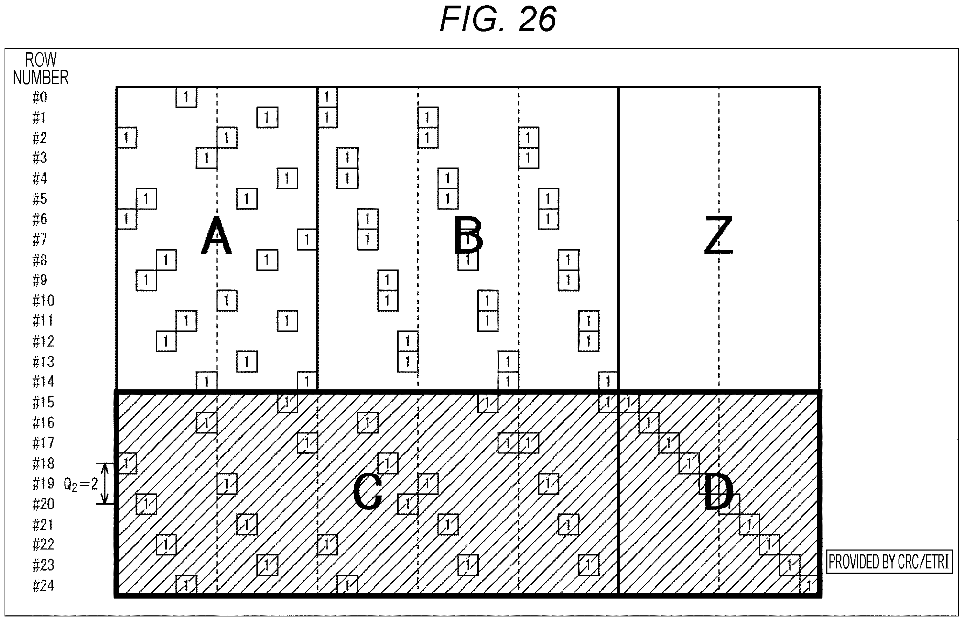

Fig. 26 is a diagram showing the C matrix generated on the basis of the parity check matrix initial value table in Fig. 23.

In the C matrix shown in Fig. 26, the element of the row #18 in the 1st (= 1 + 5 × (1 - 1)) column of the parity check matrix is set to 1 in accordance with the first row of the parity check matrix initial value table shown in Fig. 23.

In this case, each of the columns from the 2nd (= 2 + 5 × (1 - 1)) column to the 5th (= 5 + 5 × (1 - 1)) column in the C matrix corresponds to the column located immediately before and cyclically shifted downward by $Q_2 = 2$.

In addition, in the C matrix shown in Fig. 26, the element of the row #19 in the 6th (= 1 + 5 × (2 - 1)) column, the element of the row #22 in the 11th (= 1 + 5 × (3 - 1)) column, the element of the row #19 in the 16th (= 1 + 5 × (4 - 1)) column, and the element of the row #15 in the 21st (= 1 + 5 × (5 - 1)) column of the parity check matrix are set to 1 in accordance with the second row through the fifth row of the parity check matrix initial value table shown in Fig. 23.

In this case, each of the columns from the 7th (= 2 + 5 × (2 - 1)) column to the 10th (= 5 + 5 × (2 - 1)) column, each of the columns from the 12th (= 2 + 5 × (3 - 1)) column to the 15th (= 5 + 5 × (3 - 1)) column, each of the columns from the 17th (= 2 + 5 × (4 - 1)) column to the 20th (= 5 + 5 × (4 - 1)) column, and each of the columns from the 22nd (= 2 + 5 × (5 - 1)) column to the 25th (= 5 + 5 × (5 - 1)) column corresponds to the column located immediately before and cyclically shifted downward by $Q_2 = 2$.

The parity check matrix generation unit 613 (Fig. 18) generates the C matrix on the basis of the parity check matrix initial value table, and positions the generated C matrix below the A matrix and the B matrix (after parity interleave).

Furthermore, the parity check matrix generation unit 613 positions the Z matrix on the right side of the B matrix, and positions the D matrix on the right side of the C matrix to generate the parity check matrix shown in Fig. 26.

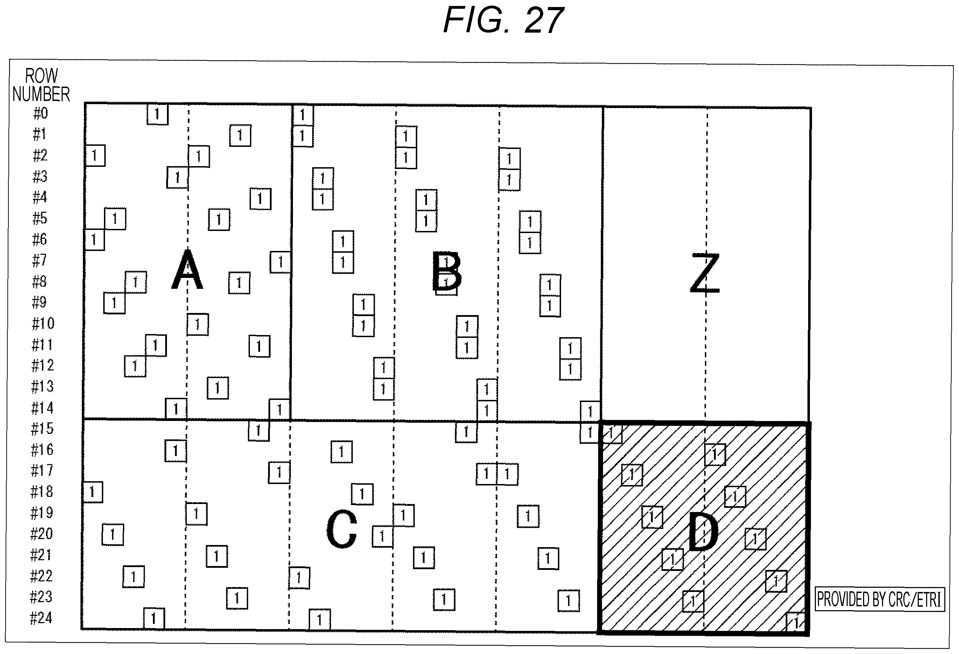

Fig. 27 is a diagram showing parity interleave for the D matrix.

The parity check matrix generation unit 613 having generated the parity check matrix shown in Fig. 26 determines the D matrix as a parity matrix, and performs parity interleave (only for D matrix) such that elements of 1 in odd rows and subsequent even rows in the D matrix as a unit matrix are located away from each other by the unit size P = 5 in the row direction.

Fig. 27 shows the parity check matrix obtained after parity interleave performed for the D matrix of the parity check matrix shown in Fig. 26.

The LDPC encoder 115 (encoded parity calculation unit 615 (Fig. 18) of LDPC encoder 115) performs LDPC encoding (generation of LDPC code) by using the parity check matrix shown in Fig. 27, for example.

The LDPC code generated by using the parity check matrix shown in Fig. 27 herein is a parity-interleaved LDPC code, wherefore the parity interleaver 23 (Fig. 9) need not perform parity interleave for the LDPC code generated by using the parity check matrix in Fig. 27.

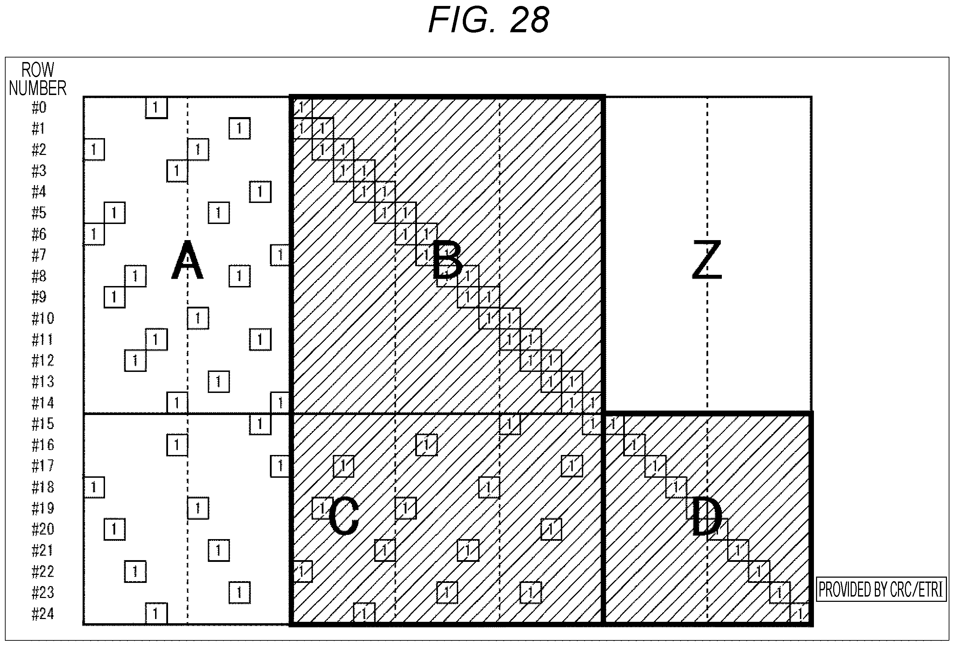

Fig. 28 is a diagram showing a parity check matrix subjected to column permutation as parity deinterleave for restoring the B matrix, a part of the C matrix (part of C matrix positioned below B matrix), and the D matrix of the parity check matrix shown in Fig. 27 to an original state.

The LDPC encoder 115 is allowed to perform LDPC encoding (generation of LDPC code) by using the parity check matrix shown in Fig. 28.

When the parity check matrix shown in Fig. 28 is used for LDPC encoding, an LDPC code not subjected to parity interleave is obtained. Accordingly, when the parity check matrix shown in Fig. 28 is used for LDPC encoding, parity interleave is performed by the parity interleaver 23 (Fig. 9).

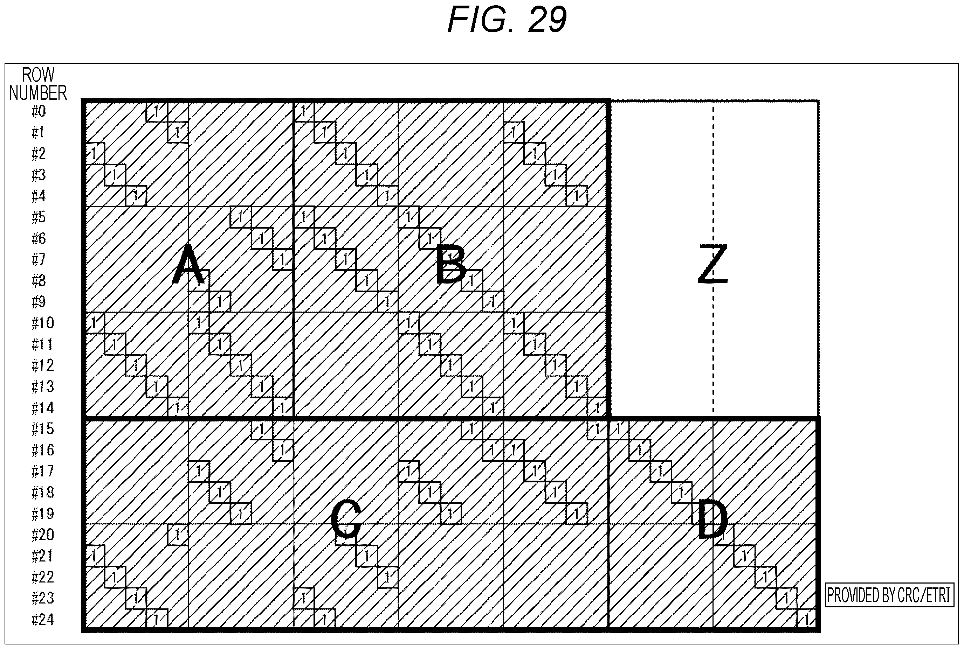

Fig. 29 is a diagram showing a converted parity check matrix obtained by performing row permutation for the parity check matrix in Fig. 27.

As described below, the converted parity check matrix is a matrix expressed by a combination of a P × P unit matrix, a quasi-unit matrix containing one or more elements of 0 in the unit matrix in place of 1, a shift matrix as a cyclically shifted unit matrix or quasi-unit matrix, a sum matrix as a sum of two or more of a unit matrix, a quasi-unit matrix, and a shift matrix, and a P × P zero matrix.

When the converted parity check matrix is used for LDPC code decoding, architecture which simultaneously performs P check node calculations and variable node calculations of an LDPC code is adoptable in LDPC code decoding as described below.

\<New LDPC code\>

Incidentally, standards for terrestrial digital television broadcasting called ATSC3.0 are under development.

Therefore, a new LDPC code usable for data transmission under ATSC3.0 and others (hereinafter also referred to as new LDPC code) is hereinafter described.

For example, a new LDPC code is constituted by a DVB-system LDPC code, or an ETRI system LDPC code having a unit size P of 360 similarly to DVB-T.2, and corresponding to a parity check matrix having a circulant structure.

The LDPC encoder 115 (Figs. 8, 18) is capable of performing LDPC encoding into a new LDPC code by using a parity check matrix obtained on the basis of any one of new LDPC code parity check matrix initial value tables for code lengths N of 16k bits and 64k bits and coding rates r of 5/15, 6, 15, 7/15, 8/15, 9/15, 10/15, 11/15, 12/15, and 13/15.

In this case, the storage unit 602 of the LDPC encoder 115 (Fig. 8) stores a new LDPC code parity check matrix initial value table.

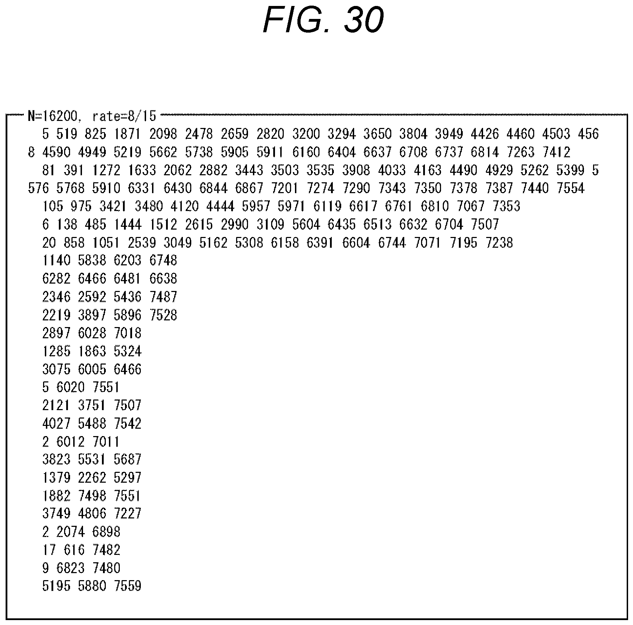

Fig. 30 is a diagram showing an example of a DVB system parity check matrix initial value table for a new LDPC code proposed by the applicant of the present application and having a code length N of 16k bits and a coding rate r of 8/15 (hereinafter also referred to as (16k, 8/15) Sony code).

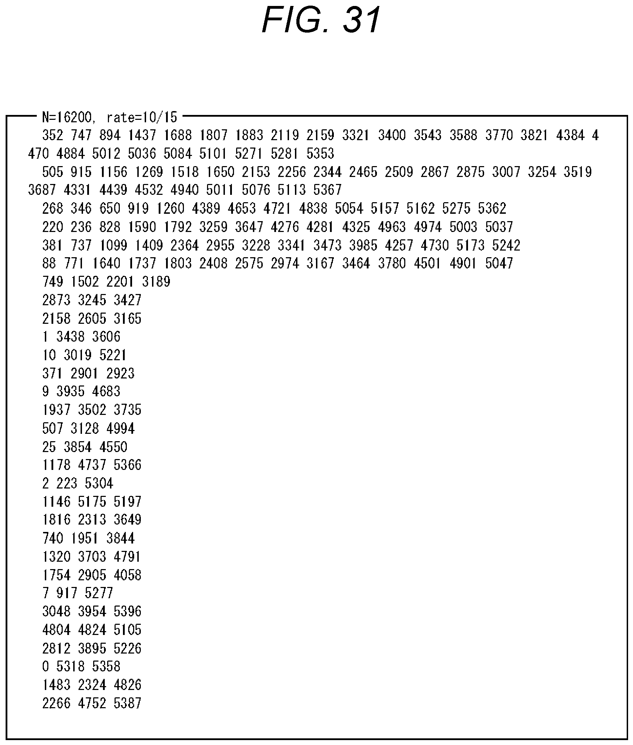

Fig. 31 is a diagram showing an example of a DVB system parity check matrix initial value table for a new LDPC code proposed by the applicant of the present application and having a code length N of 16k bits and a coding rate r of 10/15 (hereinafter also referred to as (16k, 10/15) Sony code).

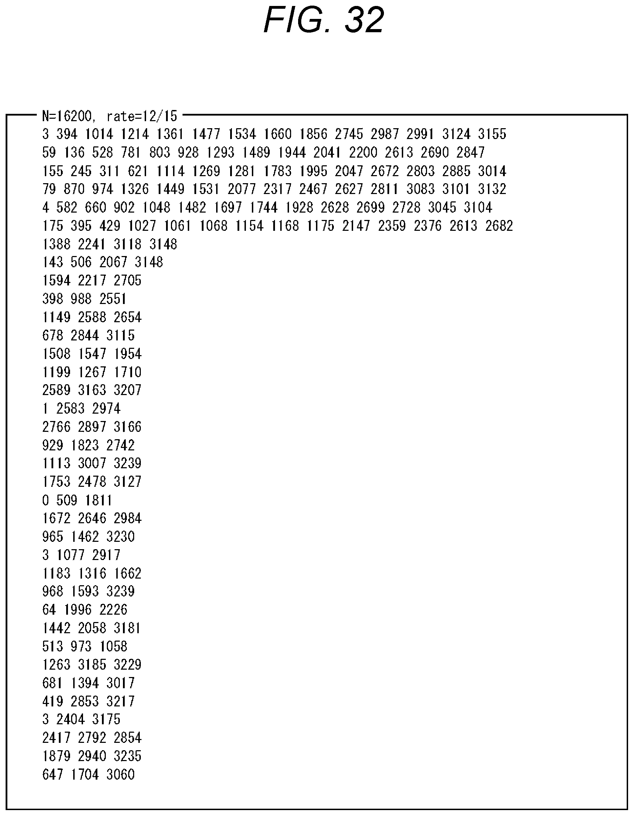

Fig. 32 is a diagram showing an example of a DVB system parity check matrix initial value table for a new LDPC code proposed by the applicant of the present application and having a code length N of 16k bits and a coding rate r of 12/15 (hereinafter also referred to as (16k, 12/15) Sony code).

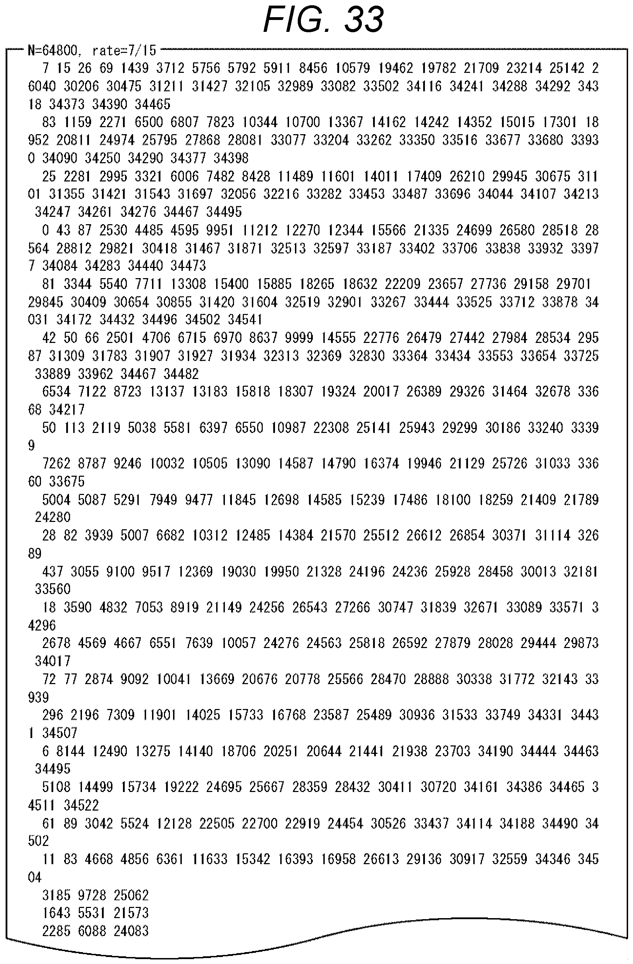

Figs. 33, 34, and 35 are diagrams showing an example of a DVB system parity check matrix initial value table for a new LDPC code proposed by the applicant of the present application and having a code length N of 64k bits and a coding rate r of 7/15 (hereinafter also referred to as (64k, 7/15) Sony code).

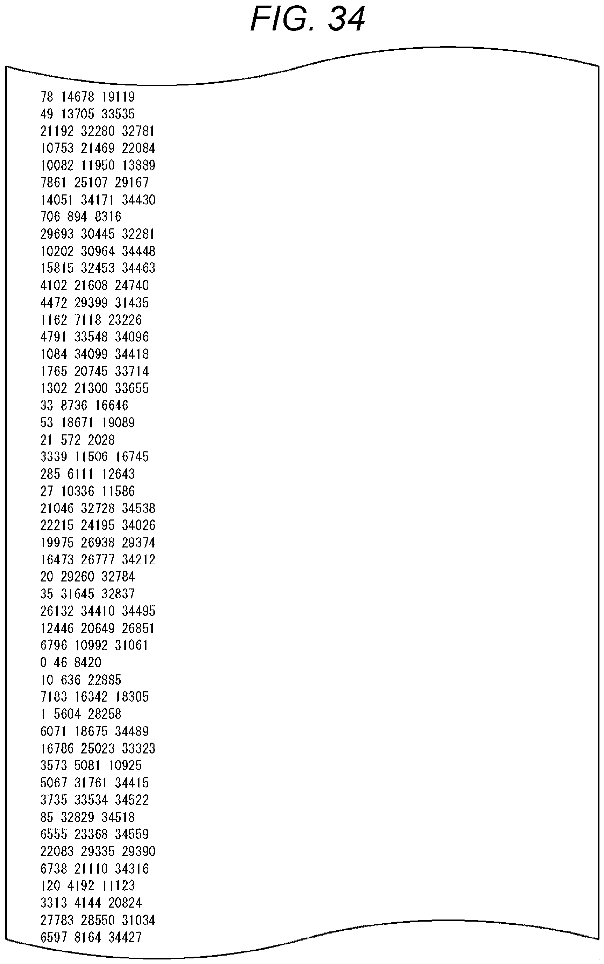

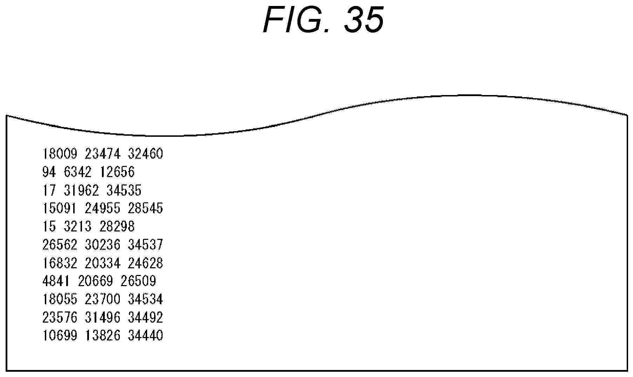

Note that Fig. 34 is a diagram continuing from Fig. 33, and that Fig. 35 is a diagram continuing from Fig. 34.

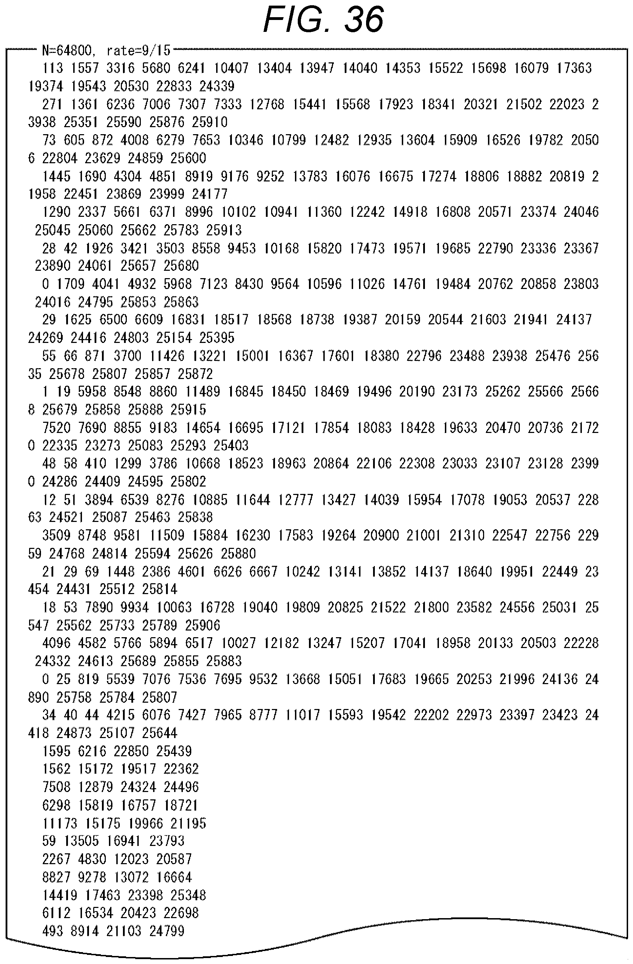

Figs. 36, 37, and 38 are diagrams showing an example of a DVB system parity check matrix initial value table for a new LDPC code proposed by the applicant of the present application and having a code length N of 64k bits and a coding rate r of 9/15 (hereinafter also referred to as (64k, 9/15) Sony code).

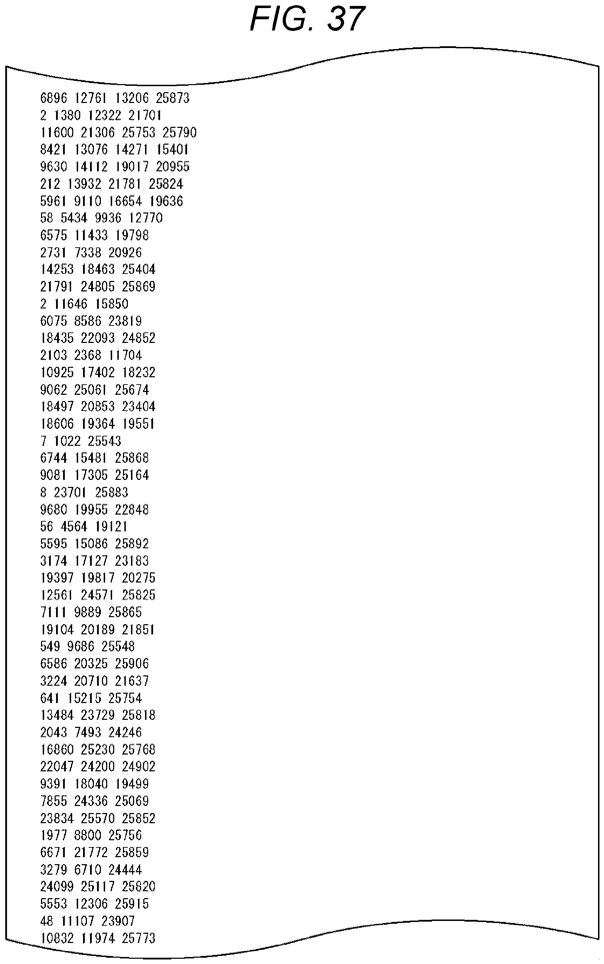

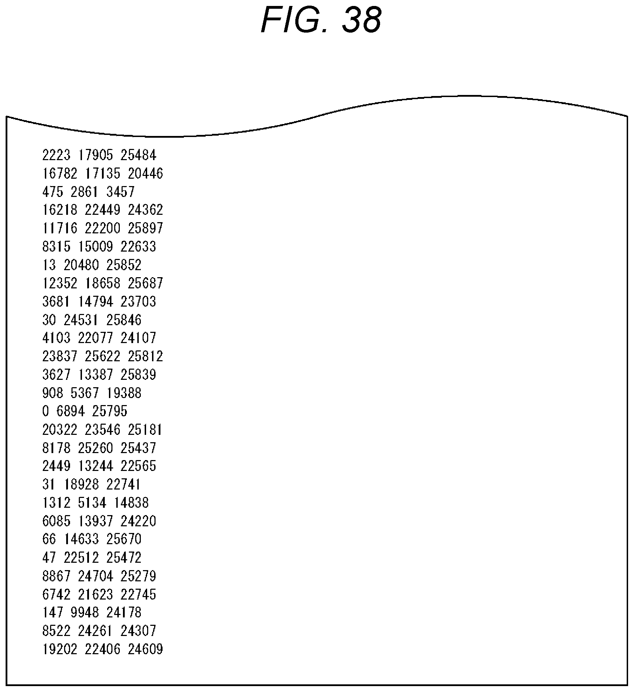

Note that Fig. 37 is a diagram continuing from Fig. 36, and that Fig. 38 is a diagram continuing from Fig. 37.

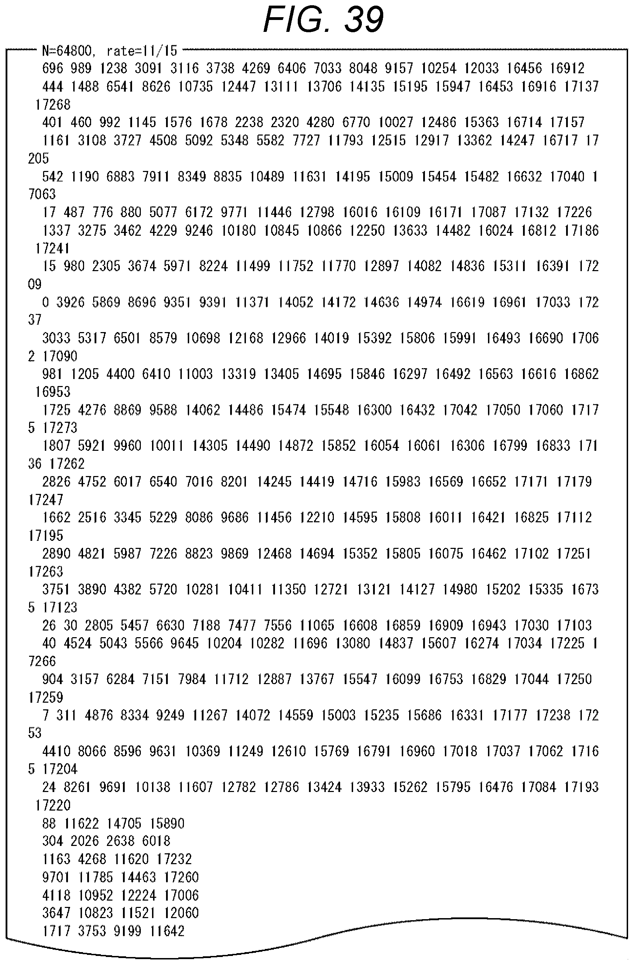

Figs. 39, 40, 41, and 42 are diagrams showing an example of a DVB system parity check matrix initial value table for a new LDPC code proposed by the applicant of the present application and having a code length N of 64k bits and a coding rate r of 11/15 (hereinafter also referred to as (64k, 11/15) Sony code).

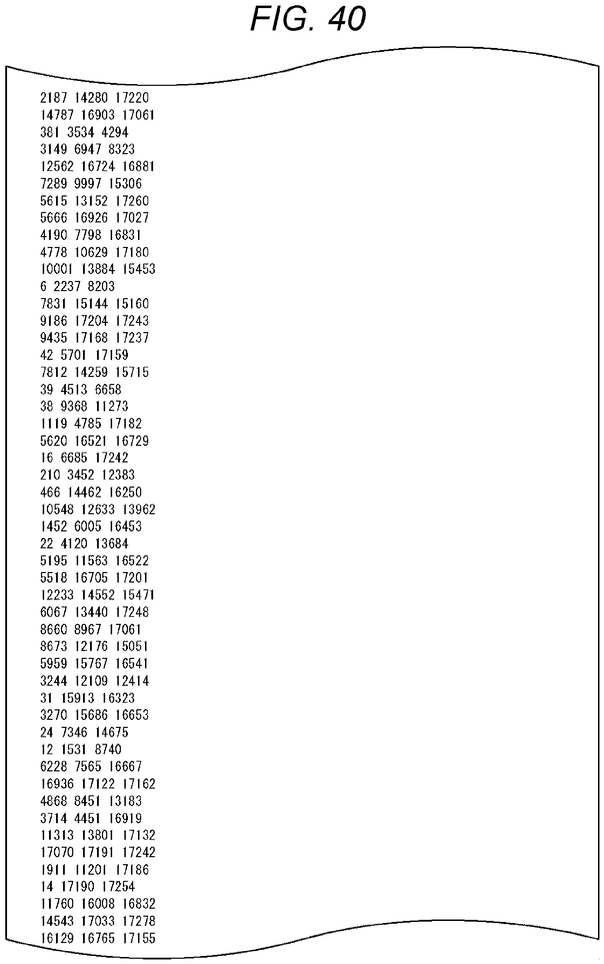

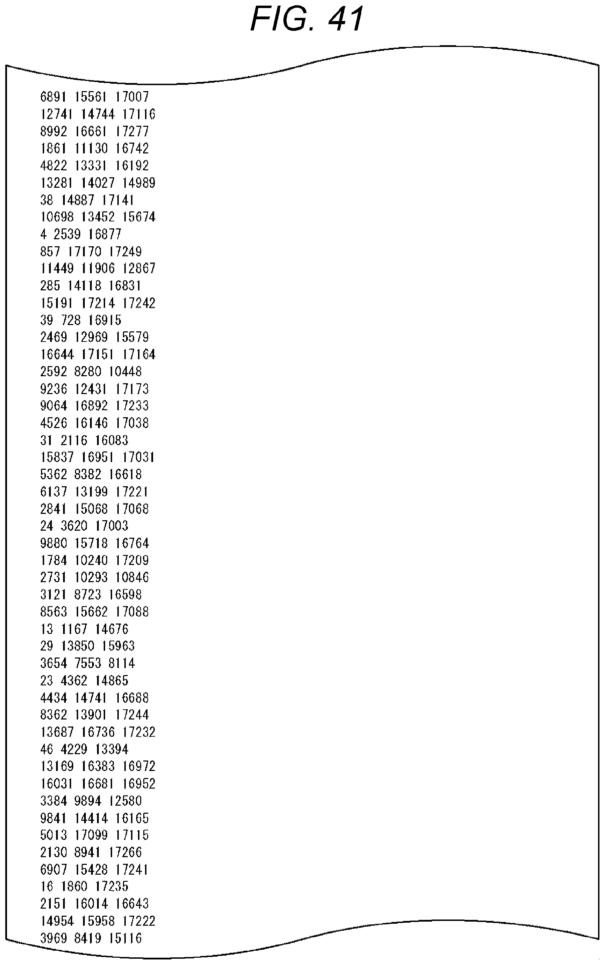

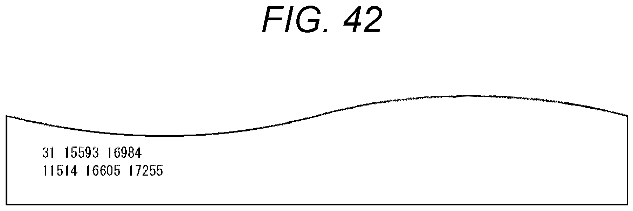

Note that Fig. 40 is a diagram continuing from Fig. 39, that Fig. 41 is a diagram continuing from Fig. 40, and that Fig. 42 is a diagram continuing from Fig. 41.

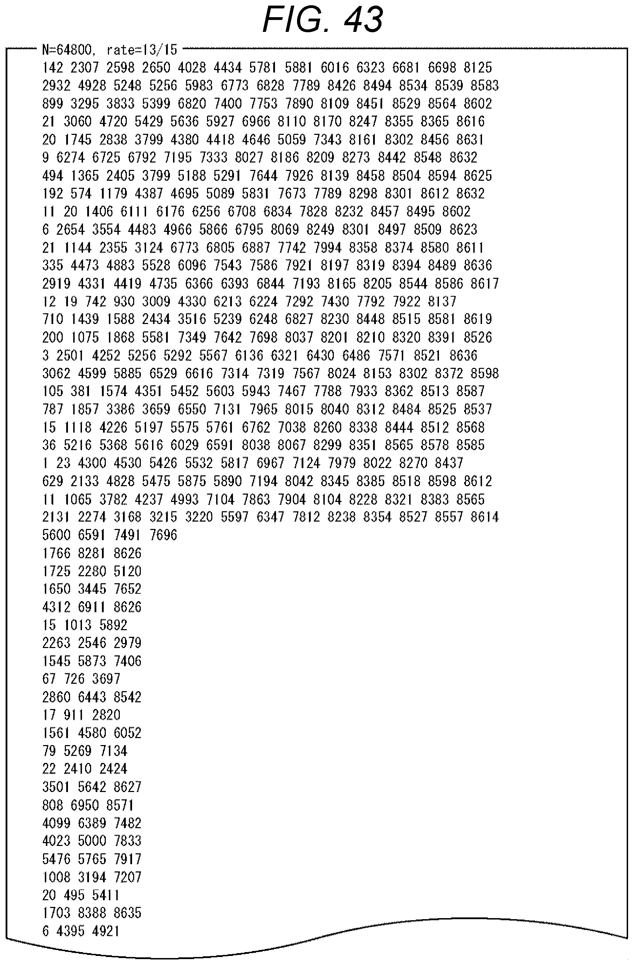

Figs. 43, 44, 45, and 46 are diagrams showing an example of a DVB system parity check matrix initial value table for a new LDPC code proposed by the applicant of the present application and having a code length N of 64k bits and a coding rate r of 13/15 (hereinafter also referred to as (64k, 13/15) Sony code).

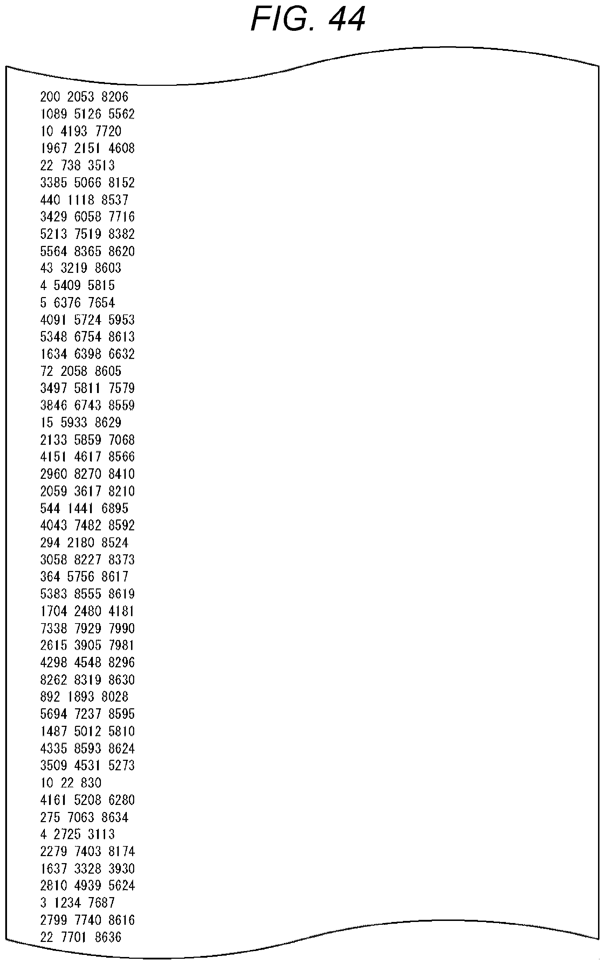

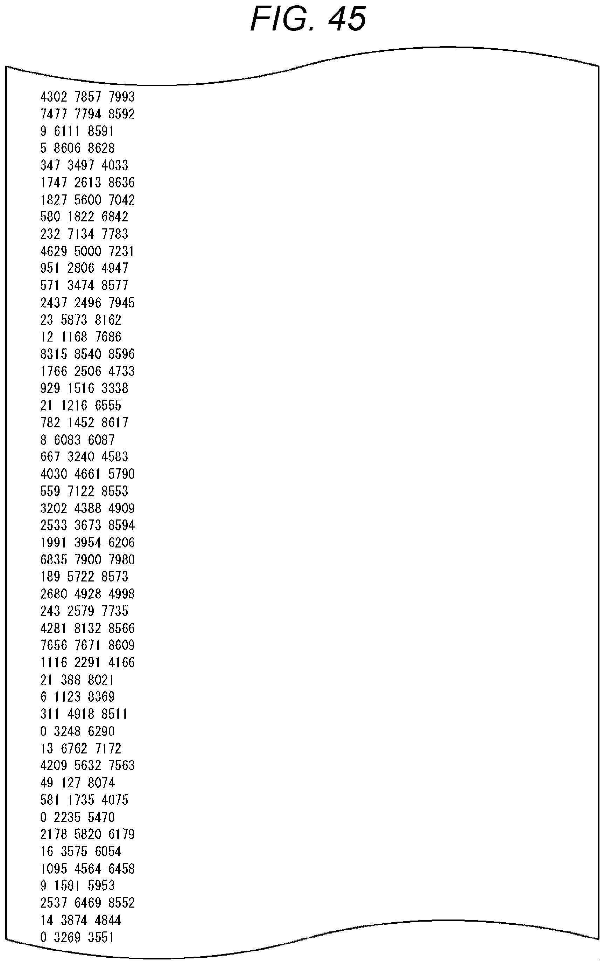

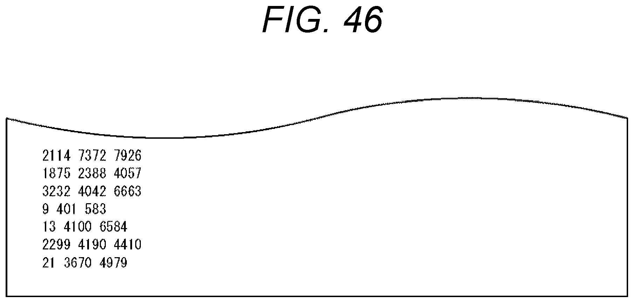

Note that Fig. 44 is a diagram continuing from Fig. 43, that Fig. 45 is a diagram continuing from Fig. 44, and that Fig. 46 is a diagram continuing from Fig. 45.

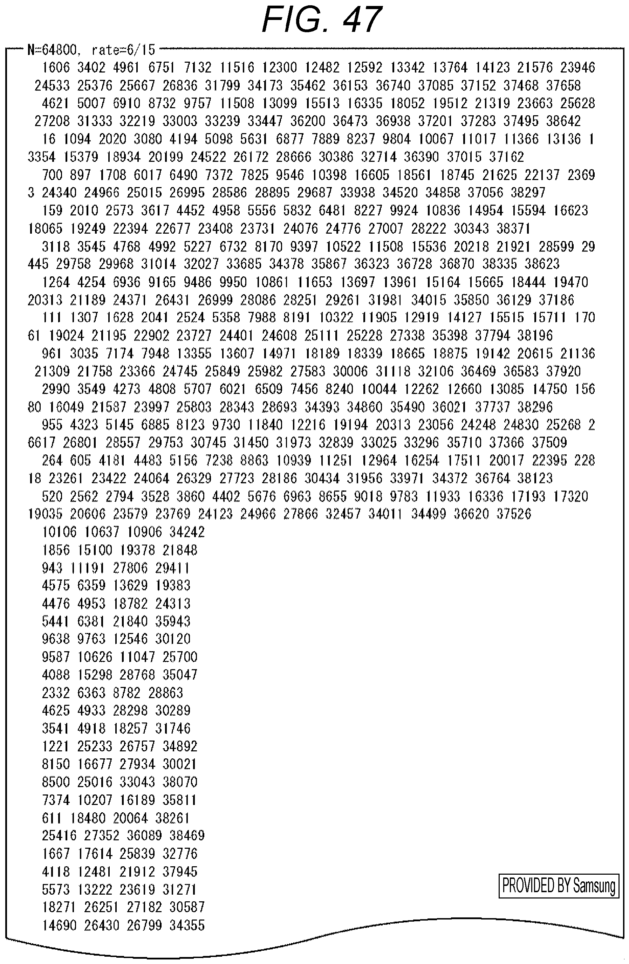

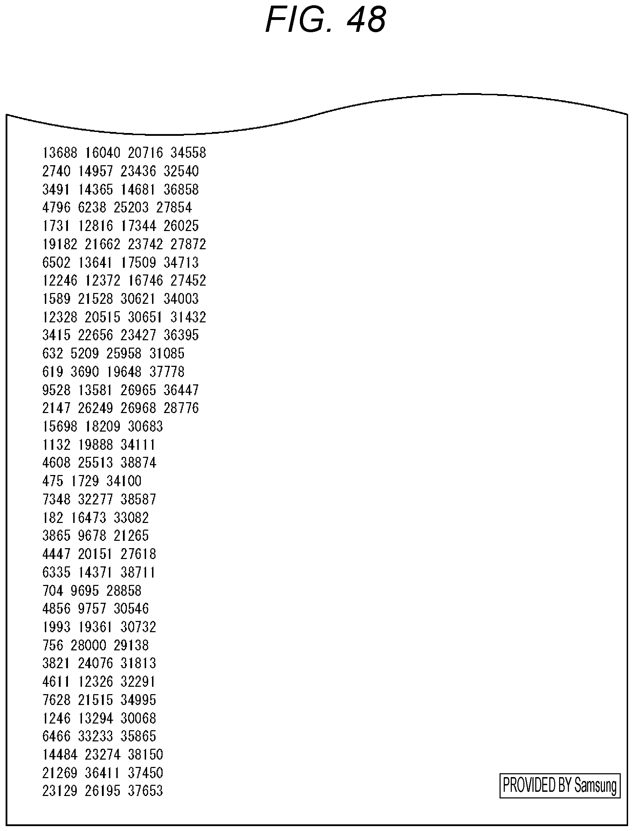

Figs. 47 and 48 are diagrams showing an example of a DVB system parity check matrix initial value table for a new LDPC code proposed by Samsung Co. and having a code length N of 64k bits and a coding rate r of 6/15 (hereinafter also referred to as (64k, 6/15) Samsung code).

Note that Fig. 48 is a diagram continuing from Fig. 47.

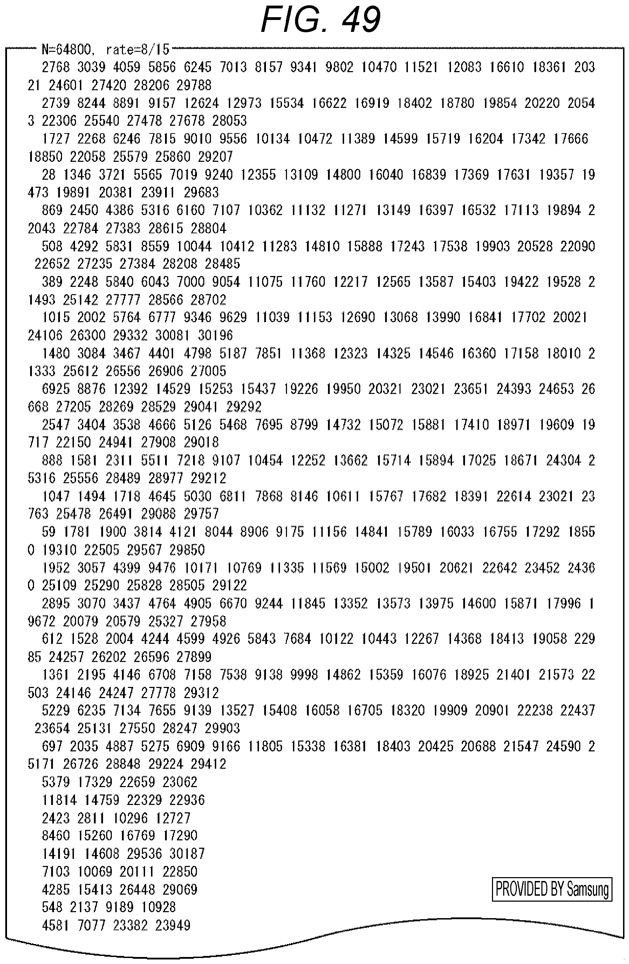

Figs. 49, 50 and 51 are diagrams showing an example of a DVB system parity check matrix initial value table for a new LDPC code proposed by Samsung Co. and having a code length N of 64k bits and a coding rate r of 8/15 (hereinafter also referred to as (64k, 8/15) Samsung code).

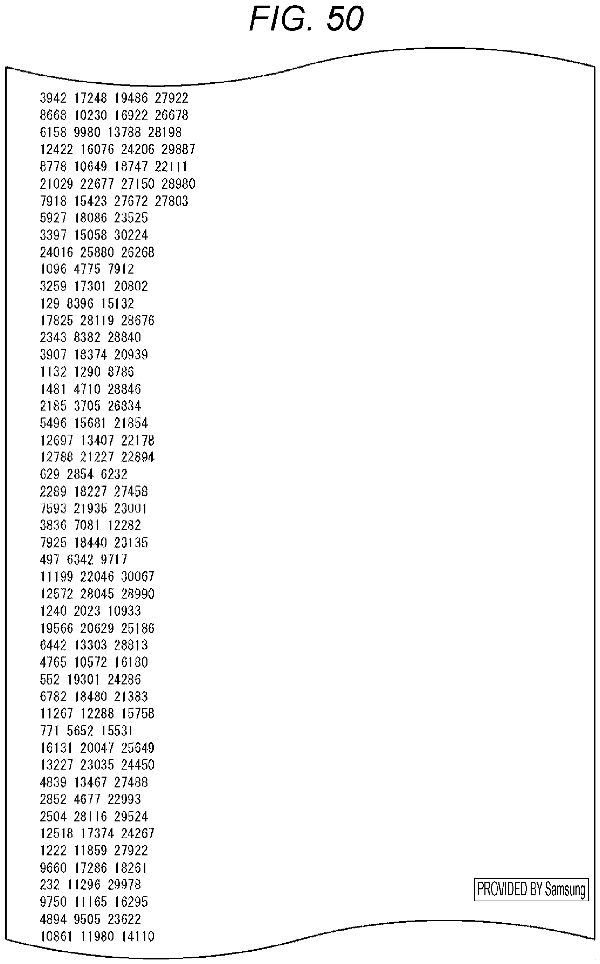

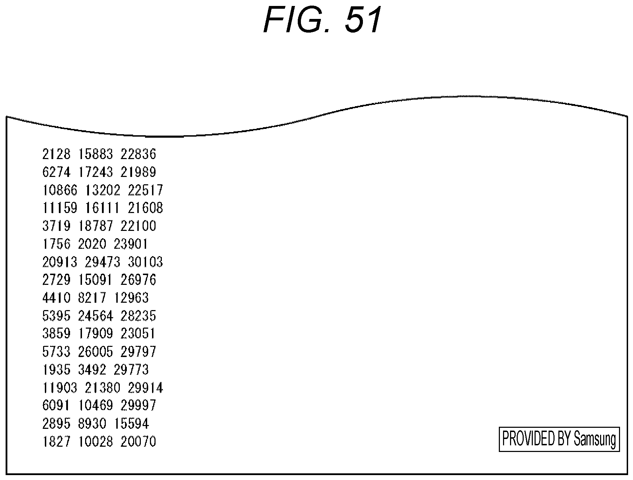

Note that Fig. 50 is a diagram continuing from Fig. 49, and that Fig. 51 is a diagram continuing from Fig. 50.

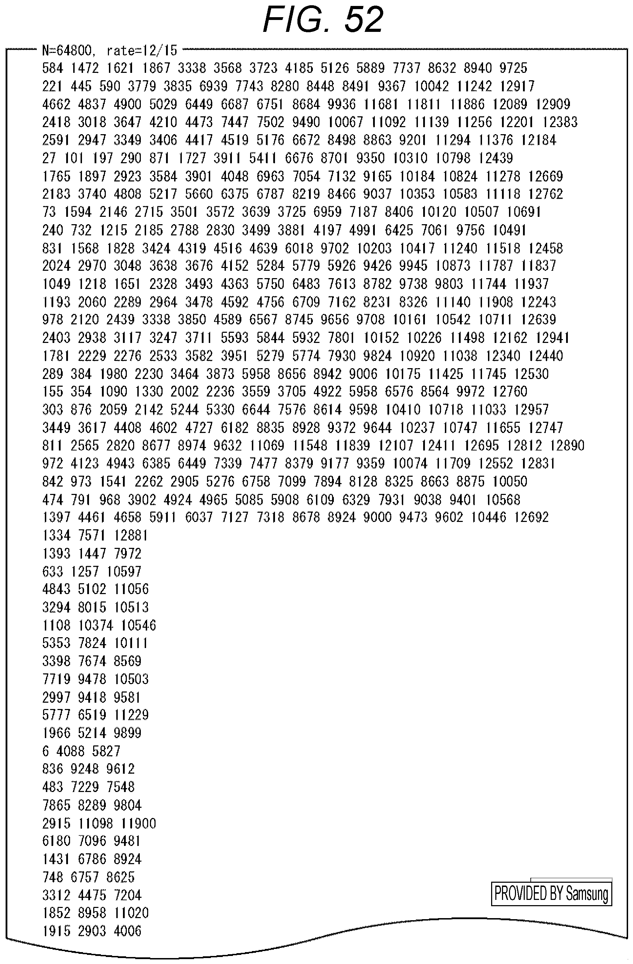

Figs. 52, 53 and 54 are diagrams showing an example of a DVB system parity check matrix initial value table for a new LDPC code proposed by Samsung Co. and having a code length N of 64k bits and a coding rate r of 12/15 (hereinafter also referred to as (64k, 12/15) Samsung code).

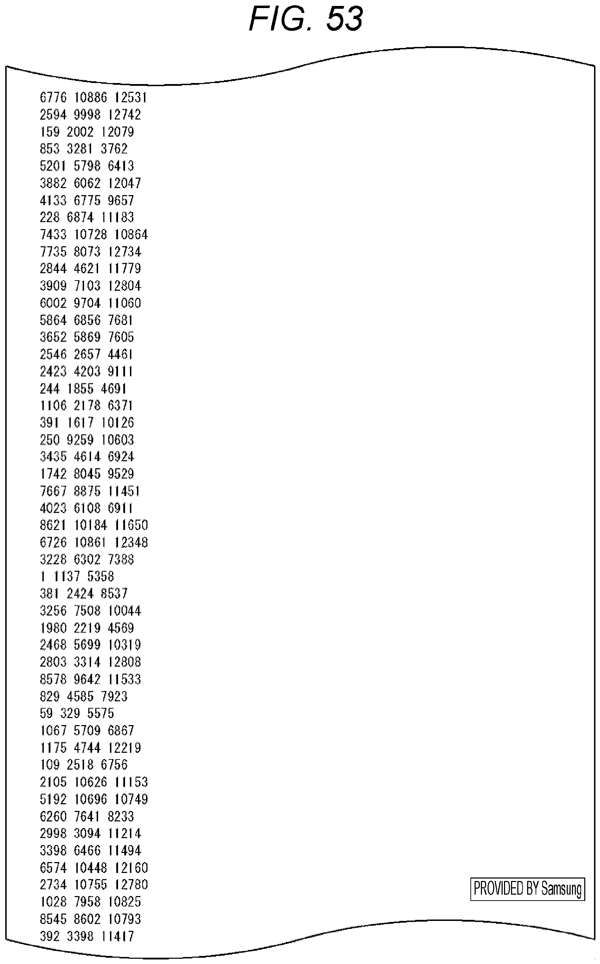

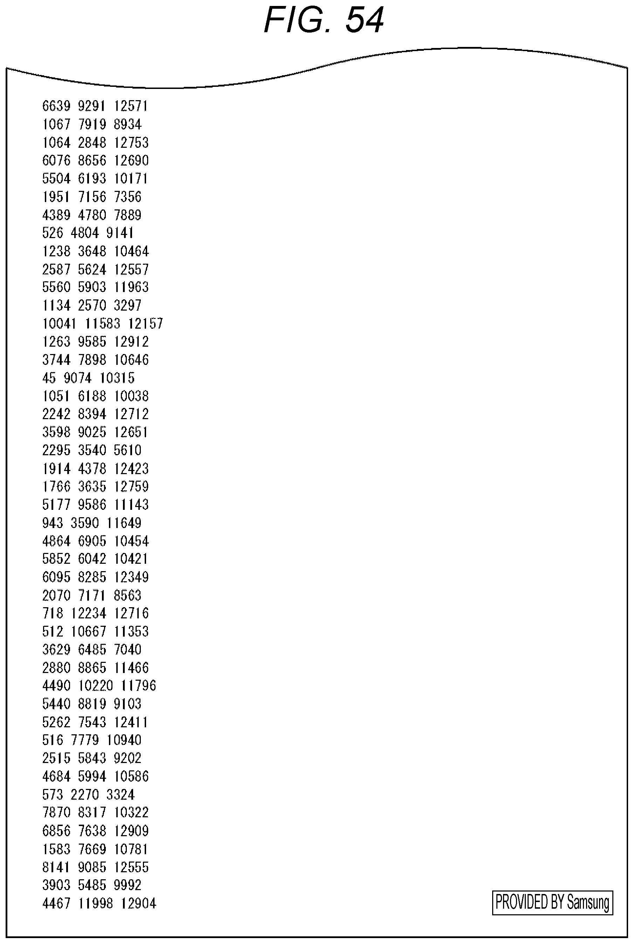

Note that Fig. 53 is a diagram continuing from Fig. 52, and that Fig. 54 is a diagram continuing from Fig. 53.

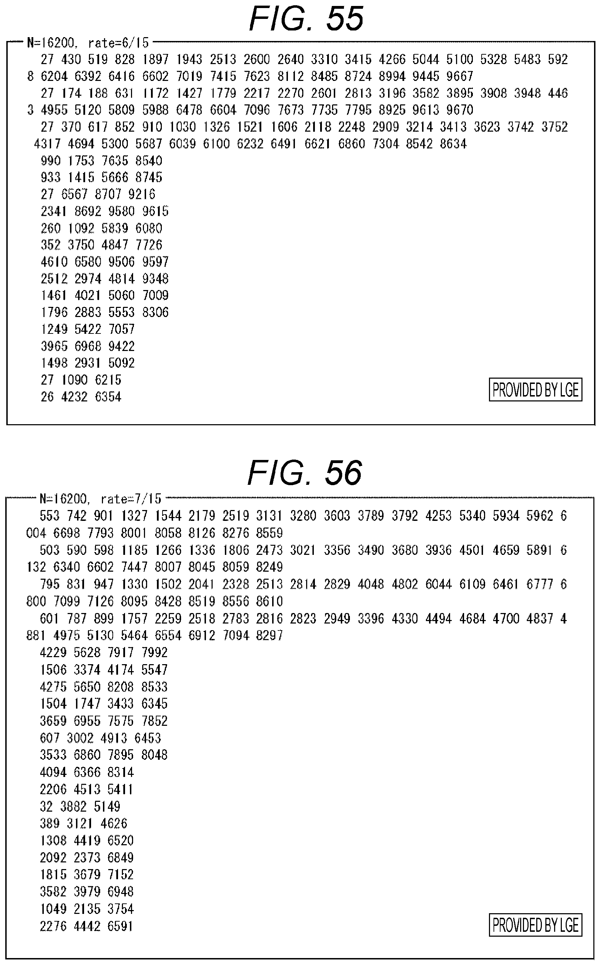

Fig. 55 is a diagram showing an example of a DVB system parity check matrix initial value table for a new LDPC code proposed by LGE Inc. and having a code length N of 16k bits and a coding rate r of 6/15 (hereinafter also referred to as (16k, 6/15) LGE code).

Fig. 56 is a diagram showing an example of a DVB system parity check matrix initial value table for a new LDPC code proposed by LGE Inc. and having a code length N of 16k bits and a coding rate r of 7/15 (hereinafter also referred to as (16k, 7/15) LGE code).

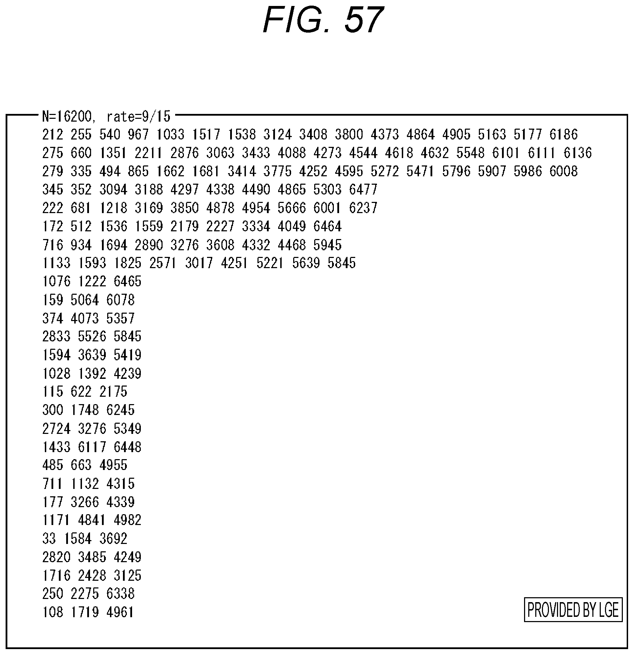

Fig. 57 is a diagram showing an example of a DVB system parity check matrix initial value table for a new LDPC code proposed by LGE Inc. and having the code length N of 16k bits and the coding rate r of 9/15 (hereinafter also referred to as (16k, 9/15) LGE code).

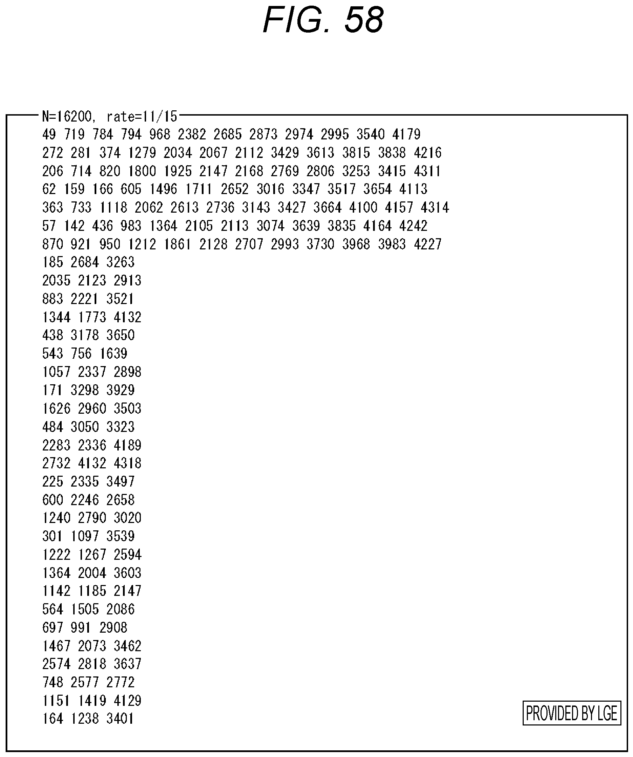

Fig. 58 is a diagram showing an example of a DVB system parity check matrix initial value table for a new LDPC code proposed by LGE Inc. and having a code length N of 16k bits and a coding rate r of 11/15 (hereinafter also referred to as (16k, 11/15) LGE code).

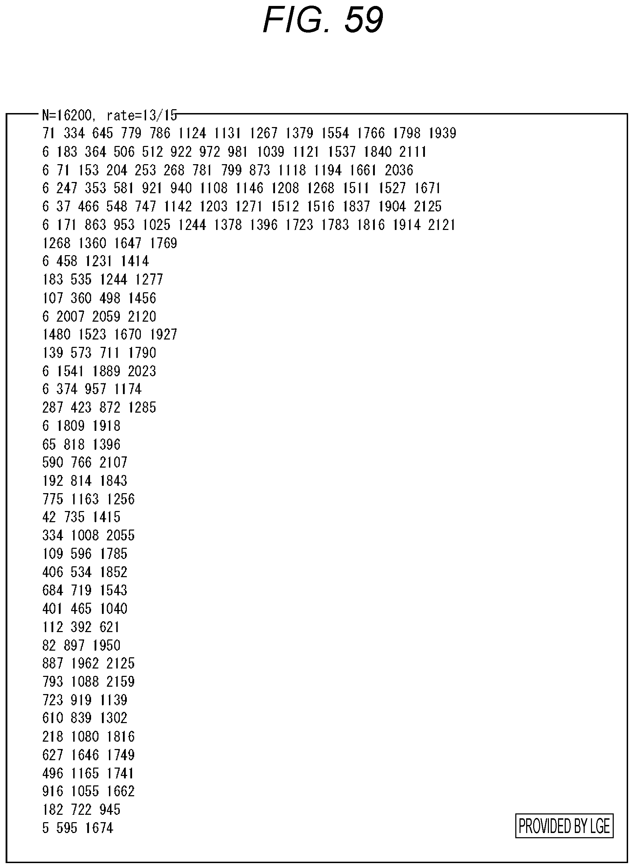

Fig. 59 is a diagram showing an example of a DVB system parity check matrix initial value table for a new LDPC code proposed by LGE Inc. and having a code length N of 16k bits and a coding rate r of 13/15 (hereinafter also referred to as (16k, 13/15) LGE code).

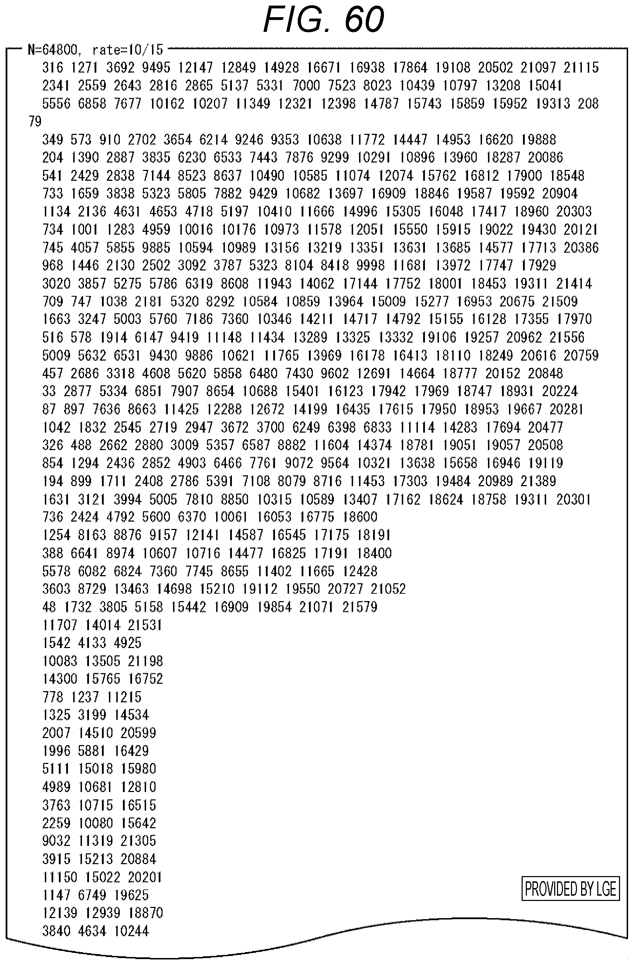

Figs. 60, 61, and 62 are diagrams showing an example of a DVB system parity check matrix initial value table for a new LDPC code proposed by LGE Inc. and having a code length N of 64k bits and a coding rate r of 10/15 (hereinafter also referred to as (64k, 10/15) LGE code).

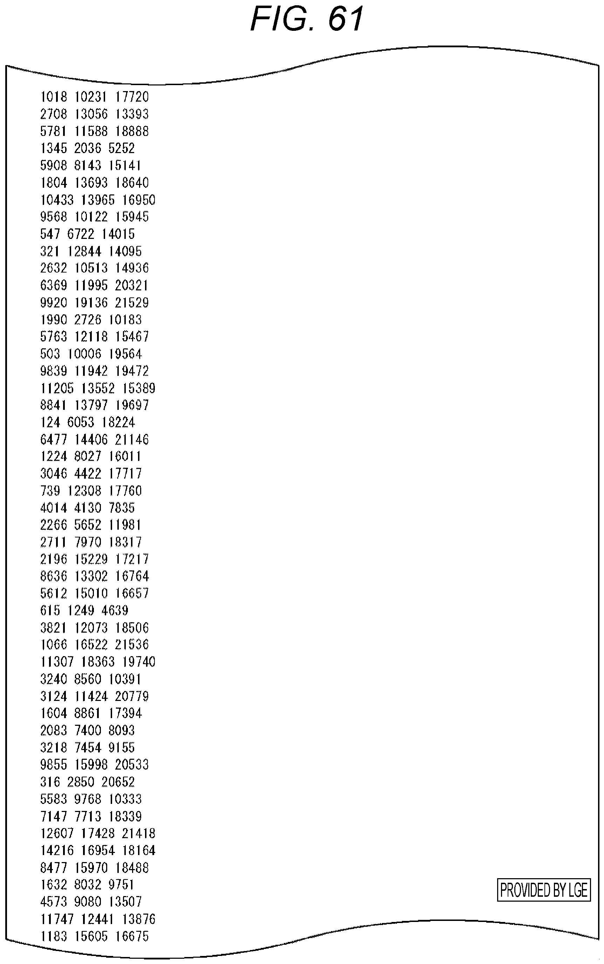

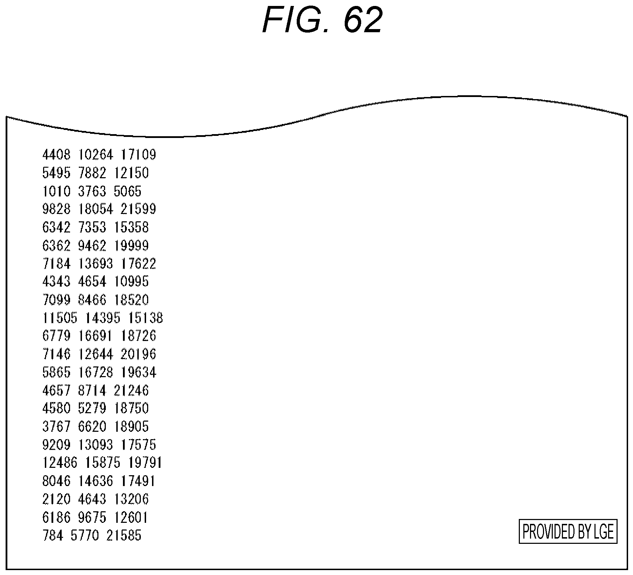

Note that Fig. 61 is a diagram continuing from Fig. 60, and that Fig. 62 is a diagram continuing from Fig. 61.

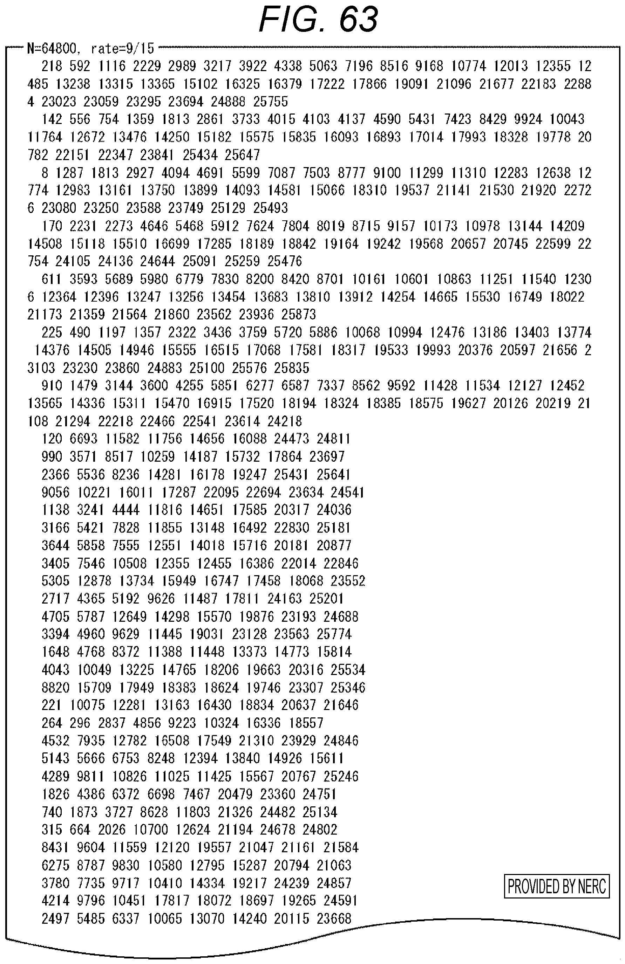

Figs. 63, 64, and 65 are diagrams showing an example of a DVB system parity check matrix initial value table for a new LDPC code proposed by NERC and having a code length N of 64k bits and a coding rate r of 9/15 (hereinafter also referred to as (64k, 9/15) NERC code).

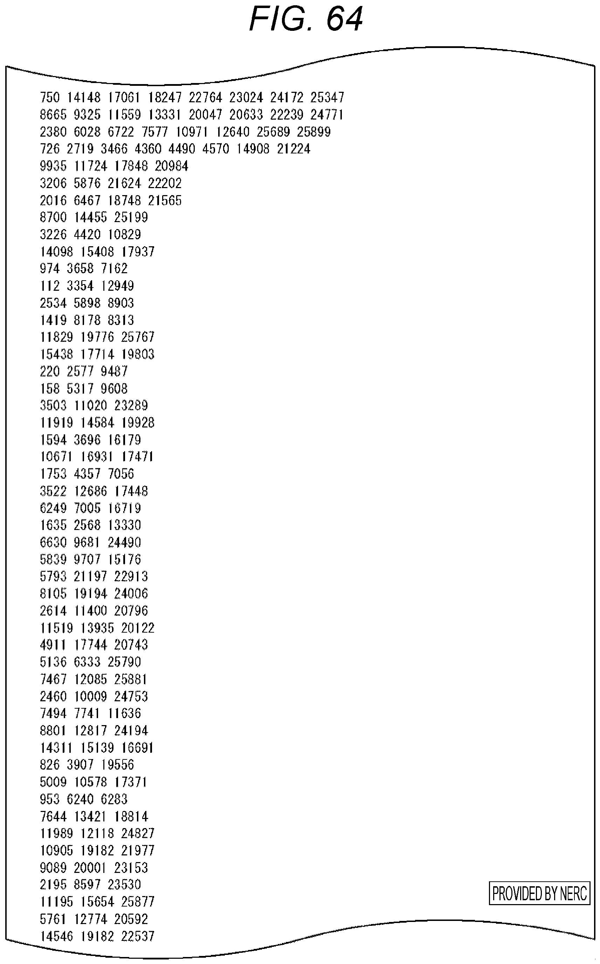

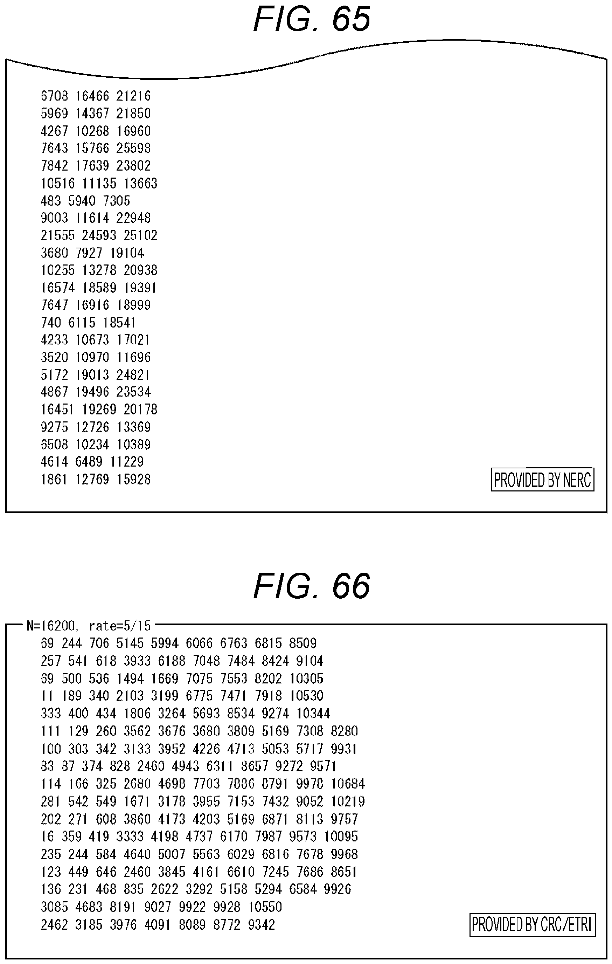

Note that Fig. 64 is a diagram continuing from Fig. 63, and that Fig. 65 is a diagram continuing from Fig. 64.

Fig. 66 is a diagram showing an example of an ETRI system parity check matrix initial value table for a new LDPC code proposed by CRC/ETRI and having a code length N of 16k bits and a coding rate r of 5/15 (hereinafter also referred to as (16k, 5/15) ETRI code).

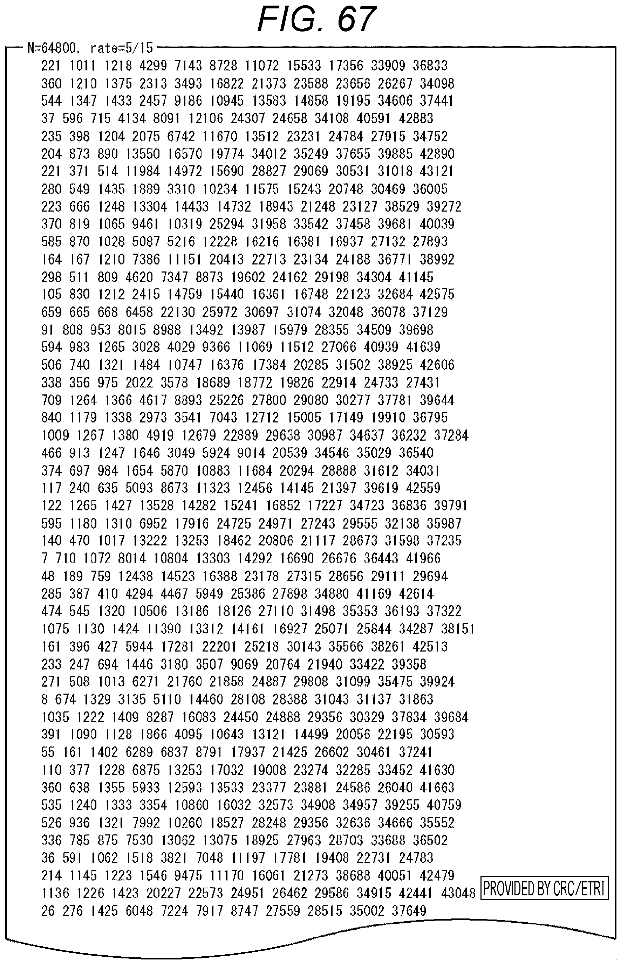

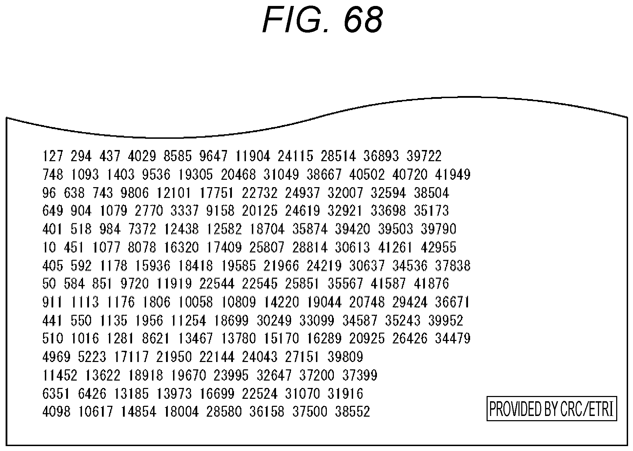

Figs. 67 and 68 are diagrams showing an example of an ETRI system parity check matrix initial value table for a new LDPC code proposed by CRC/ETRI and having a code length N of 64k bits and a coding rate r of 5/15 (hereinafter also referred to as (64k, 5/15) ETRI code).

Note that Fig. 68 is a diagram continuing from Fig. 67.

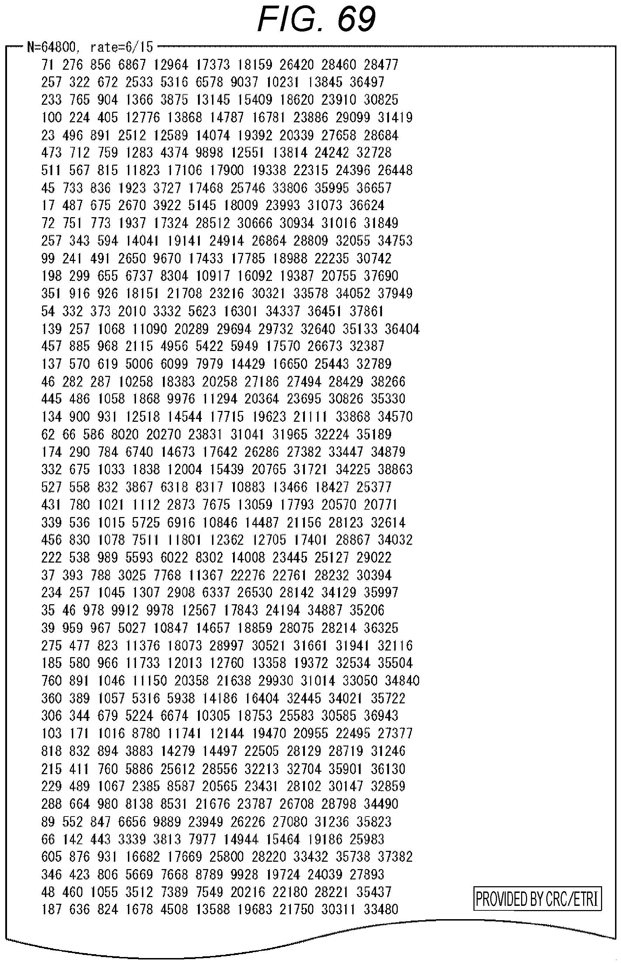

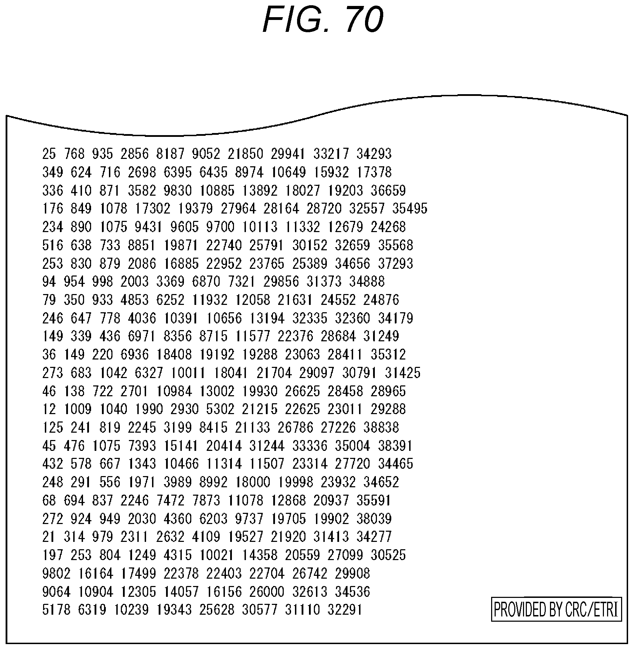

Figs. 69 and 70 are diagrams showing an example of an ETRI system parity check matrix initial value table for a new LDPC code proposed by CRC/ETRI and having a code length N of 64k bits and a coding rate r of 6/15 (hereinafter also referred to as (64k, 6/15) ETRI code).

Note that Fig. 70 is a diagram continuing from Fig. 69.

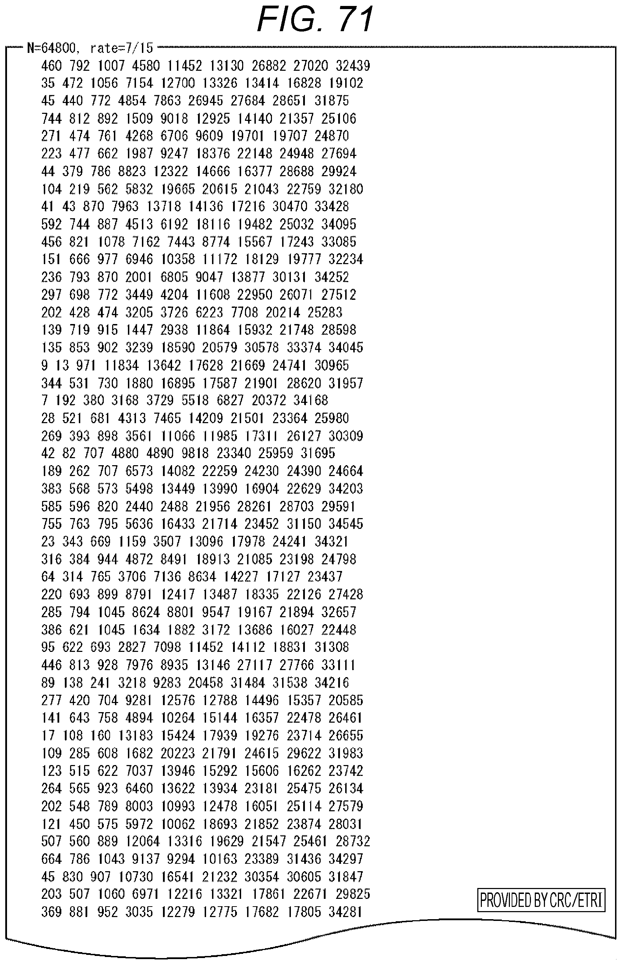

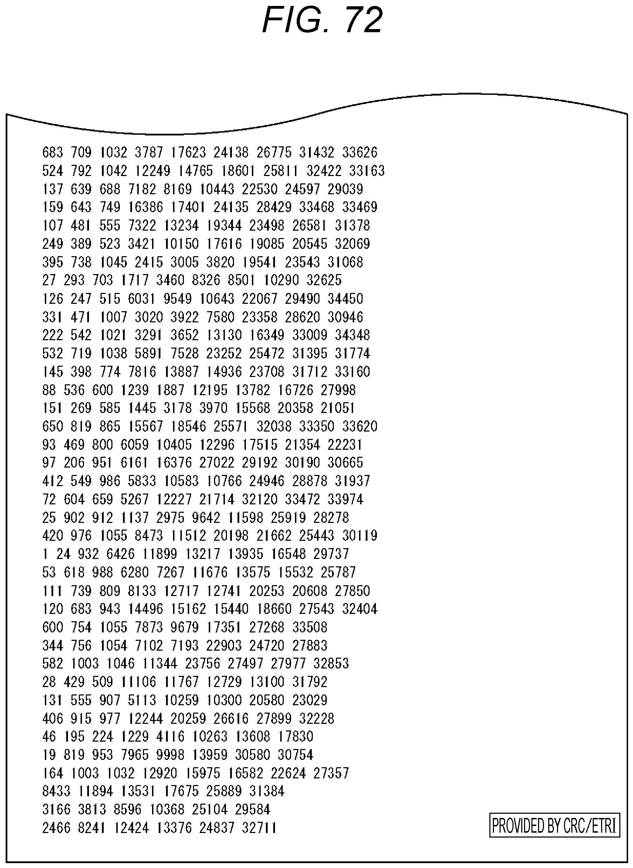

Figs. 71 and 72 are diagrams showing an example of an ETRI system parity check matrix initial value table for a new LDPC code proposed by CRC/ETRI and having a code length N of 64k bits and a coding rate r of 7/15 (hereinafter also referred to as (64k, 7/15) ETRI code).

Note that Fig. 72 is a diagram continuing from Fig. 71.

Particularly the Sony codes are high-performance LDPC codes in the respective new LDPC codes.

A high-performance LDPC code herein refers to an LDPC code obtained from an appropriate parity check matrix H.

An appropriate parity check matrix H is a parity check matrix which meets predetermined conditions for reduction of a bit error rate (BER) and a frame error rate (FER) to the minimum at the time of transmission of an LDPC code obtained by the parity check matrix H at a low $E_s/N_0$ or $E_b/N_0$ (ratio of signal power to noise power per bit), for example.

The appropriate parity check matrix H is obtained by simulation for measuring BERs when LDPC codes obtained from various parity check matrixes meeting predetermined conditions are transmitted at a low $E_s/N_0$, for example.

The predetermined conditions to be met by the appropriate parity check matrix H include a preferable analysis result of code performance analysis called density evolution, absence of a loop of elements of 1 called cycle 4, and others.

Here, it is known that LDPC code decoding performance deteriorates when elements of 1 are densely present in the information matrix $H_A$ as in a state of cycle 4. Accordingly, absence of cycle 4 is one of the predetermined conditions to be met by the appropriate parity check matrix H.

Note that the predetermined conditions to be met by the appropriate parity check matrix H may be appropriately determined in view of improvement of LDPC code decoding performance, facilitation (simplification) of LDPC code decoding, and other points.

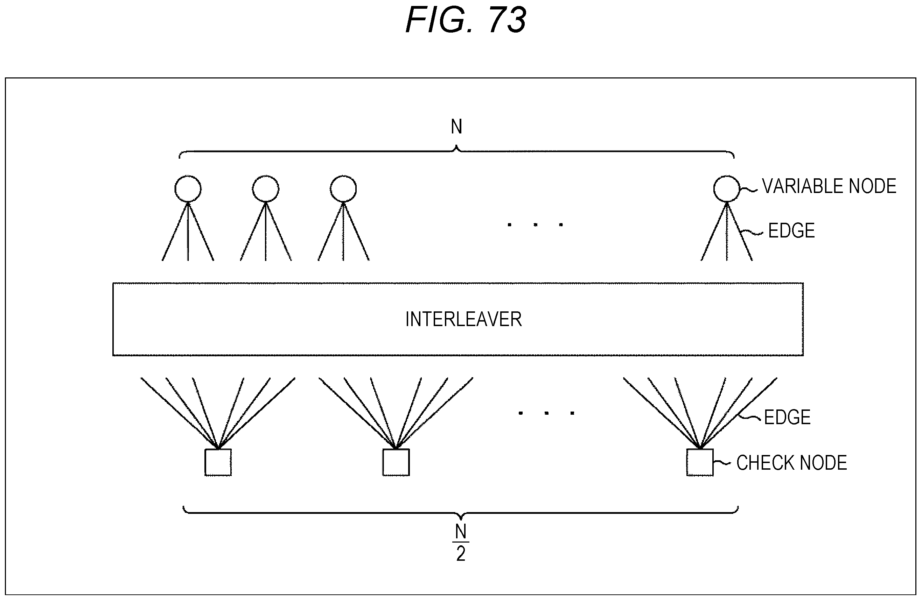

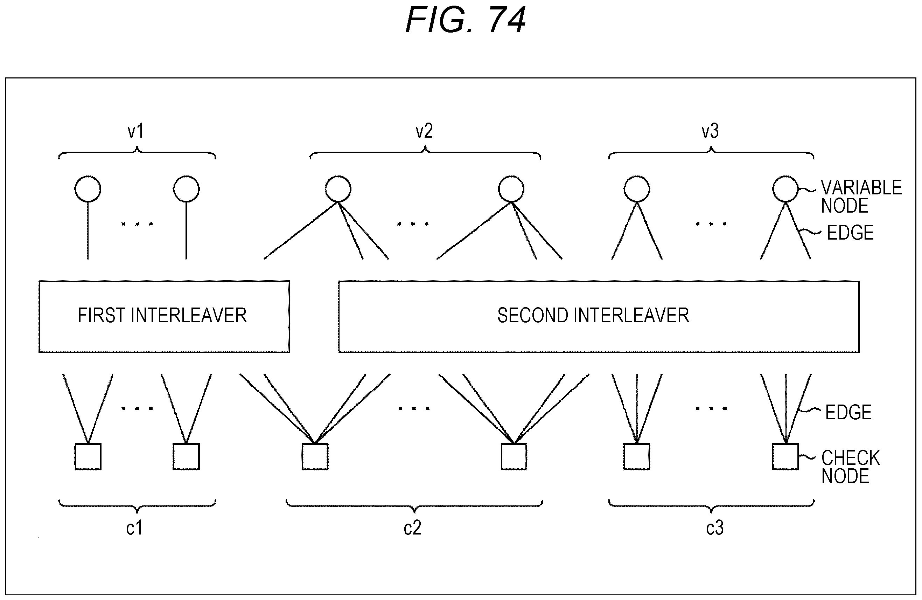

Figs. 73 and 74 are diagrams showing density evolution which offers an analysis result corresponding to the predetermined condition to be met by the appropriate parity check matrix H.

Density evolution is a code analyzing method which calculates an expectation value of an error probability for an entire LDPC code (ensemble) having a code length N of ∞ and characterized by a degree sequence described below.

For example, with increase in noise variances from zero in an AWGN channel, the expectation value of the error probability of a certain ensemble initially remains zero, but becomes a different value when the noise variances reach a certain threshold or larger.

According to density evolution, excellence of performance of an ensemble (appropriateness of parity check matrix) is determined on the basis of comparison of a threshold of noise variances (hereinafter also referred to as performance threshold) where an expectation value of a corresponding error probability becomes a value other than zero.

Note that rough performance of a specific LDPC code is predictable on the basis of density evolution performed for an ensemble determined as one to which the LDPC code belongs.

Accordingly, a high-performance LDPC code is selectable from LDPC codes belonging to a high-performance ensemble selected by this method.

Here, the degree sequence described above represents a ratio of variable nodes and check nodes having respective weights to the code length N of an LDPC code.

For example, a regular (3, 6) LDPC code having a coding rate of 1/2 belongs to an ensemble characterized by a degree sequence setting weights of all variable nodes (column weights) to 3, and weights of all check nodes (row weights) to 6.

Fig. 73 shows a Tanner graph of this ensemble.

In the Tanner graph shown in Fig. 73, there are N variable nodes indicated as circles in the figure, i.e., the same number as the code length N, and N/2 check nodes indicated as squares in the figure, i.e., the same number as the code length N multiplied by the coding rate 1/2.

Three edges equivalent to the column weight are connected to each of the variable nodes, wherefore edges connected to the N variable nodes are 3N edges in total.

In addition, six edges equivalent to the row weight are connected to each of the check nodes, wherefore 3N edges are connected to the N/2 check nodes in total.

Furthermore, one interleaver is present in the Tanner graph in Fig. 73.

The interleaver randomly rearranges the 3N edges connected to the N variable nodes, and connects each of the rearranged edges to any one of the 3N edges connected to the N/2 check nodes.

There are (3N)! (= (3N) × (3N - 1) × ... × 1) rearrangement patterns for rearrangement of the 3N edges connected to the N variable nodes in the interleaver. Accordingly, ensembles characterized by the degree sequence determining weights of all variable nodes as 3, and weights of all check nodes as 6 are a collection of (3N). LDPC codes.

For simulation obtaining a high-performance LDPC code (appropriate parity check matrix), a multi-edge type ensemble was used in density evolution.

According to the multi-edge type, the interleaver through which edges connected to variable nodes and edges connected to check nodes pass are divided into a plurality of parts (multi-edges). In this case, an ensemble is more strictly characterized.

Fig. 74 shows an example of a Tanner graph of a multi-edge type ensemble.

There are two interleavers constituted by a first interleaver and a second interleaver in the Tanner graph shown in Fig. 74.

Moreover, in the Tanner graph in Fig. 74, there are v1 variable nodes each of which has one edge connected to the first interleaver and no edge connected to the second interleaver, v2 variable nodes each of which has one edge connected to the first interleaver and two edges connected to the second interleaver, and v3 variable nodes each of which has no edge connected to the first interleaver and two edges connected to the second interleaver.

Furthermore, in the Tanner graph in Fig. 74, there are c1 variable nodes each of which has two edges connected to the first interleaver and no edge connected to the second interleaver, c2 variable nodes each of which has two edges connected to the first interleaver and two edges connected to the second interleaver, and c3 variable nodes each of which has no edge connected to the first interleaver and three edges connected to the second interleaver.

Here, density evolution and insertion of density evolution are described in "On the Design of Low-Density Parity-Check Codes within 0.0045 dB of the Shannon Limit", S.Y.Chung, G.D.Forney, T.J.Richardson, R.Urbanke, IEEE Communications Leggers, VOL.5, NO.2, Feb 2001, for example.

For simulation obtaining a Sony code (parity check matrix initial value table of Sony code), ensembles each of which has a predetermined value or smaller performance threshold, i.e., $E_b/N_0$ (ratio of signal power to noise power per bit) where BER starts to drop (decrease), were selected by multi-edge type density evolution. Thereafter, an LDPC code which decreases BER at the time of use of one or more quadrature modulations such as QPSK was selected as a high-performance LDPC code from LDPC codes belonging to the selected ensembles.

A parity check matrix initial value table for Sony codes was obtained by the foregoing simulation.

Accordingly, Sony codes obtained on the basis of the parity check matrix initial value table securely offer excellent communication quality.

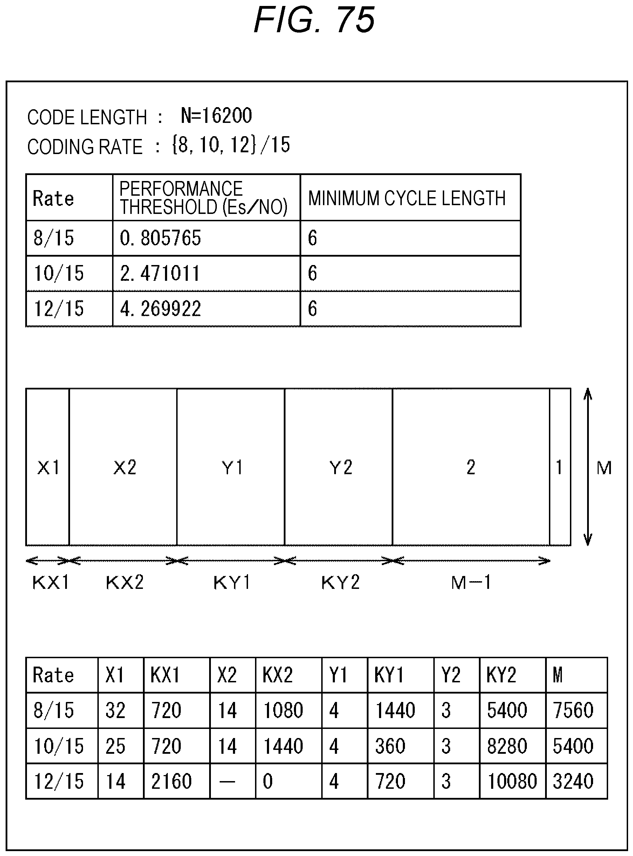

Fig. 75 is a diagram showing a parity check matrix H obtained by using the parity check matrix initial value tables for (16k, 8/15), (16k, 10/15), and (16k, 12/15) Sony codes (hereinafter also expressed as "parity check matrix H for (16k, 8/15), (16k, 10/15), and (16k, 12/15) Sony codes").

A minimum cycle length of the parity check matrix H for each of the (16k, 8/15), (16k, 10/15), and (16k, 12/15) Sony codes exceeds cycle 4. Accordingly, cycle 4 (loop of elements of 1 having loop length of 4) is absent. The minimum cycle length (girth) herein refers to a minimum value of a length of a loop (loop length) constituted by elements of 1 in the parity check matrix H.

In addition, a performance threshold of the (16k, 8/15) Sony code is 0.805765, a performance threshold of the (16k, 10/15) Sony code is 2.471011, and a performance threshold of the (16k, 12/15) Sony code is 4.269922.

The column weight of KX1 columns from the first column in the parity check matrix H for each of the (16k, 8/15), (16k, 10/15), and (16k, 12/15) Sony codes is X1. The column weight of subsequent KX2 columns is X2. The column weight of subsequent KY1 columns is Y1. The column weight of subsequent KY2 columns is Y2. The column weight of subsequent (M - 1) columns is 2. The column weight of the final one column is 1.

In this case, KX1 + KX2 + KY1 + KY2+ M - 1 + 1 is equivalent to the code length N = 16200 bits of each of the (16k, 8/15), (16k, 10/15), and (16k, 12/15) Sony codes.

Fig. 75 shows the numbers of columns KX1, KX2, KY1, KY2, and M, and the column weights X1, X2, Y1, and Y2 of the parity check matrix H for the (16k, 8/15), (16k, 10/15), and (16k, 12/15) Sony codes.

The column weight of the parity check matrix H for each of the (16k, 8/15), (16k, 10/15), and (16k, 12/15) Sony codes tends to increase with nearness to the head (left) column similarly to the parity check matrix described with reference to Figs. 12 and 13. Accordingly, the sign bit of the Sony code tends to become more resistant to errors (has higher resistance to errors) with nearness to the head of the code.

According to simulation performed by the applicant of the present application, preferable BER/FER is obtained for the (16k, 8/15), (16k, 10/15), and (16k, 12/15) Sony codes. Accordingly, preferable communication quality is securable in data transmission using the (16k, 8/15), (16k, 10/15), and (16k, 12/15) Sony codes.

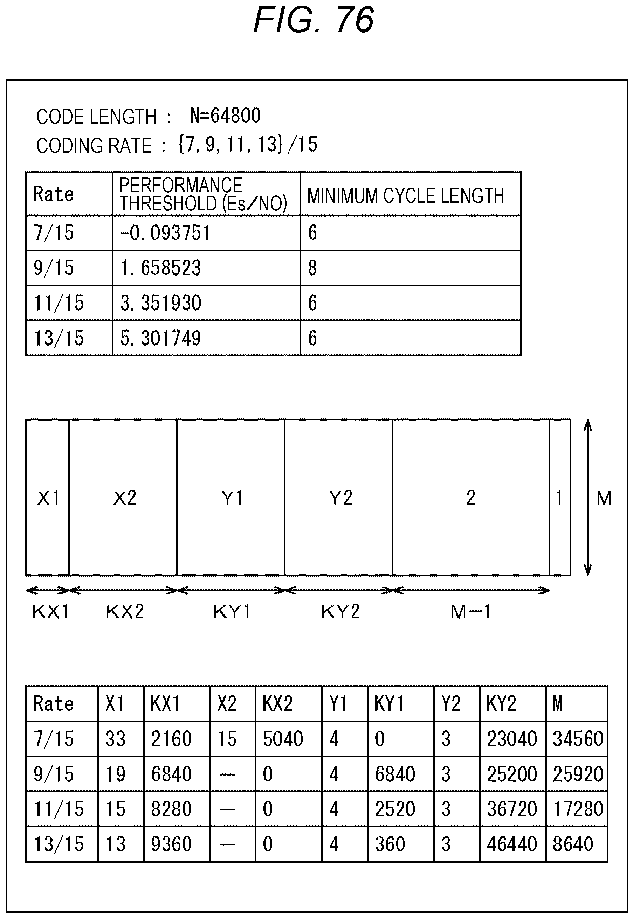

Fig. 76 is a diagram showing a parity check matrix H for each of (64k, 7/15), (64k, 9/15), (64k, 11/15), and (64k, 13/15) Sony codes.

A minimum cycle length of the parity check matrix H for each of the (64k, 7/15), (64k, 9/15), (64k, 11/15), and (64k, 13/15) Sony codes exceeds cycle 4. Accordingly, cycle 4 is absent.

In addition, a performance threshold of the (64k, 7/15) Sony code is -0.093751, a performance threshold of the (64k, 9/15) Sony code is 1.658523, a performance threshold of the (64k, 11/15) Sony code is 3.351930, and a performance threshold of the (64k, 13/15) Sony code is 5.301749.

The column weight of KX1 columns from the first column in the parity check matrix H for each of the (64k, 7/15), (64k, 9/15), (64k, 11/15), and (64k, 13/15) Sony codes is X1. The column weight of subsequent KX2 columns is X2. The column weight of subsequent KY1 columns is Y1. The column weight of subsequent KY2 columns is Y2. The column weight of subsequent (M - 1) column is 2. The column weight of the final one column is 1.

In this case, KX1 + KX2 + KY1 + KY2+ M-1 + 1 is equivalent to the code length N = 64800 bits of each of the (64k, 7/15), (64k, 9/15), (64k, 11/15), and (64k, 13/15) Sony codes.

Fig. 76 shows the numbers of columns KX1, KX2, KY1, KY2, and M, and the column weights X1, X2, Y1, and Y2 of the parity check matrix H for the (64k, 7/15), (64k, 9/15), (64k, 11/15), and (64k, 13/15) Sony codes.

The column weight of the parity check matrix H for each of the (64k, 7/15), (64k, 9/15), (64k, 11/15), and (64k, 13/15) Sony codes tends to increase with nearness to the head (left) column similarly to the parity check matrix described with reference to Figs. 12 and 13. Accordingly, the sign bit of the Sony code tends to become more resistant to errors (has higher resistance to errors) with nearness to the head of the code.

According to simulation performed by the applicant of the present application, preferable BER/FER is obtained for the (64k, 7/15), (64k, 9/15), (64k, 11/15), and (64k, 13/15) Sony codes. Accordingly, preferable communication quality is securable in data transmission using the (64k, 7/15), (64k, 9/15), (64k, 11/15), and (64k, 13/15) Sony codes.

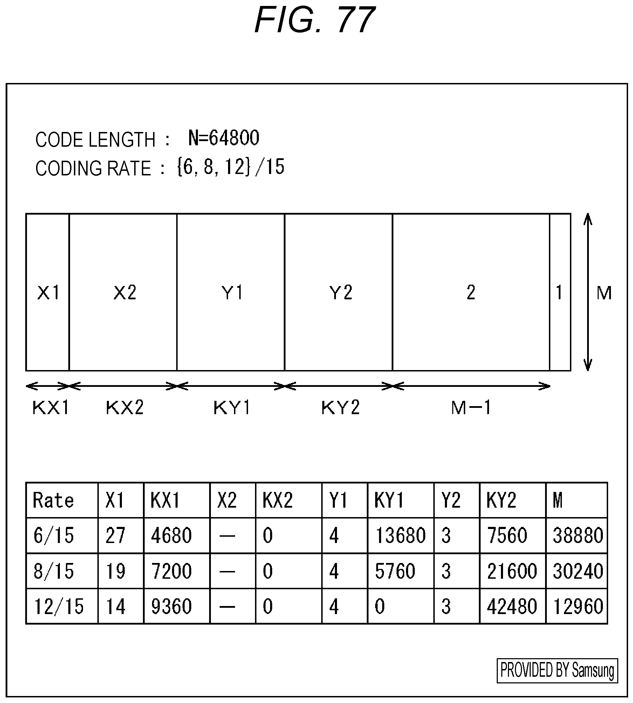

Fig. 77 is a diagram showing a parity check matrix H for each of (64k, 6/15), (64k, 8/15), and (64k, 12/15) Samsung codes.

The column weight of KX1 columns from the first column in the parity check matrix H for each of the (64k, 6/15), (64k, 8/15), and (64k, 12/15) Samsung codes is X1. The column weight of subsequent KX2 columns is X2. The column weight of subsequent KY1 columns is Y1. The column weight of subsequent KY2 columns is Y2. The column weight of subsequent (M - 1) columns is 2. The column weight of the final one column is 1.

In this case, KX1 + KX2 + KY1 + KY2+ M - 1 + 1 is equivalent to the code length N = 64800 bits of each of the (64k, 6/15), (64k, 8/15), and (64k, 12/15) Samsung codes.

Fig. 77 shows the numbers of columns KX1, KX2, KY1, KY2, and M, and the column weights X1, X2, Y1, and Y2 of the parity check matrix H for the (64k, 6/15), (64k, 8/15), and (64k, 12/15) Samsung codes.

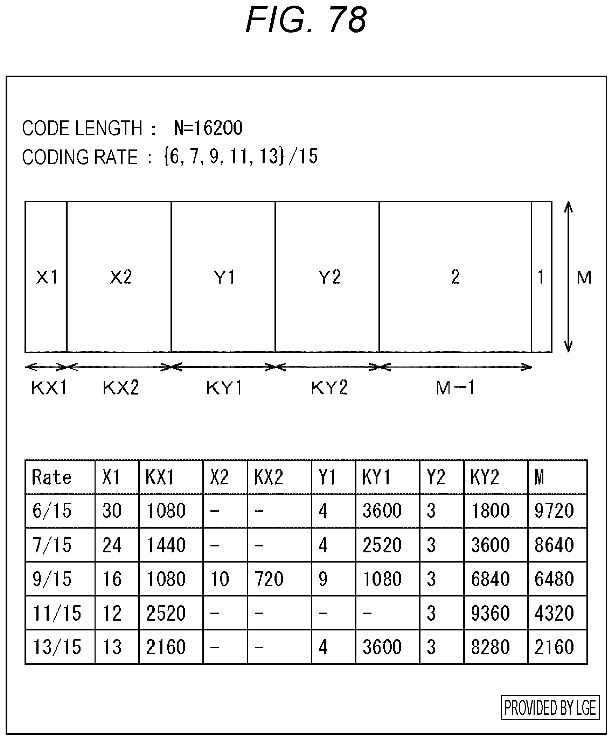

Fig. 78 is a diagram showing a parity check matrix H for each of (16k, 6/15), (16k, 7/15), (16k, 9/15), (16k, 11/15), and (16k, 13/15) LGE codes.

The column weight of KX1 columns from the first column in the parity check matrix H for each of the (16k, 6/15), (16k, 7/15), (16k, 9/15), (16k, 11/15), and (16k, 13/15) LGE codes is X1. The column weight of subsequent KX2 columns is X2. The column weight of subsequent KY1 columns is Y1. The column weight of subsequent KY2 columns is Y2. The column weight of subsequent (M - 1) columns is 2. The column weight of the final one column is 1.

In this case, KX1 + KX2 + KY1 + KY2+ M - 1 + 1 is equivalent to the code length N = 16200 bits of each of the (16k, 6/15), (16k, 7/15), (16k, 9/15), (16k, 11/15), and (16k, 13/15) LGE codes.

Fig. 78 shows the numbers of columns KX1, KX2, KY1, KY2, and M, and the column weights X1, X2, Y1, and Y2 of the parity check matrix H for the (16k, 6/15), (16k, 7/15), (16k, 9/15), (16k, 11/15), and (16k, 13/15) LGE codes.

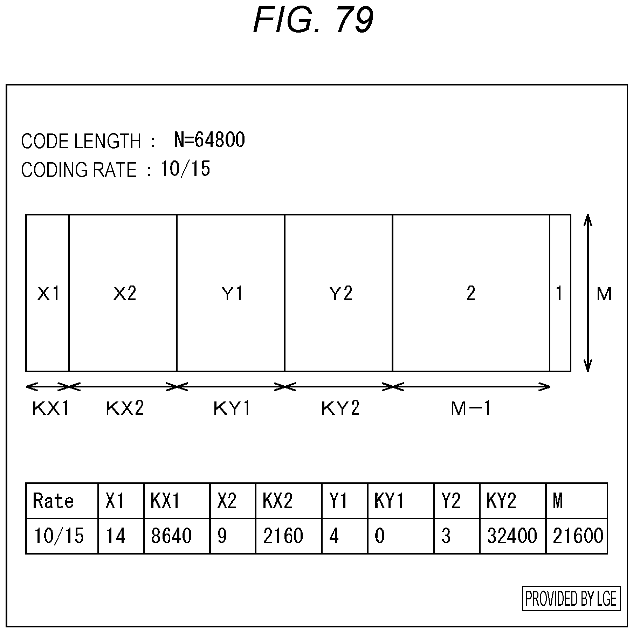

Fig. 79 is a diagram showing a parity check matrix H for a (64k, 10/15) LGE code.

The column weight of KX1 columns from the first column in the parity check matrix H for the (64k, 10/15) LGE code is X1. The column weight of subsequent KX2 columns is X2. The column weight of subsequent KY1 columns is Y1. The column weight of subsequent KY2 columns is Y2. The column weight of subsequent (M - 1) columns is 2. The column weight of the final one column is 1.

In this case, KX1 + KX2 + KY1 + KY2+ M - 1 + 1 is equivalent to the code length N = 64800 bits of the (64k, 10/15) LGE code.

Fig. 79 shows the numbers of columns KX1, KX2, KY1, KY2, and M, and the column weights X1, X2, Y1, and Y2 of the parity check matrix H for the (64k, 10/15) LGE code.

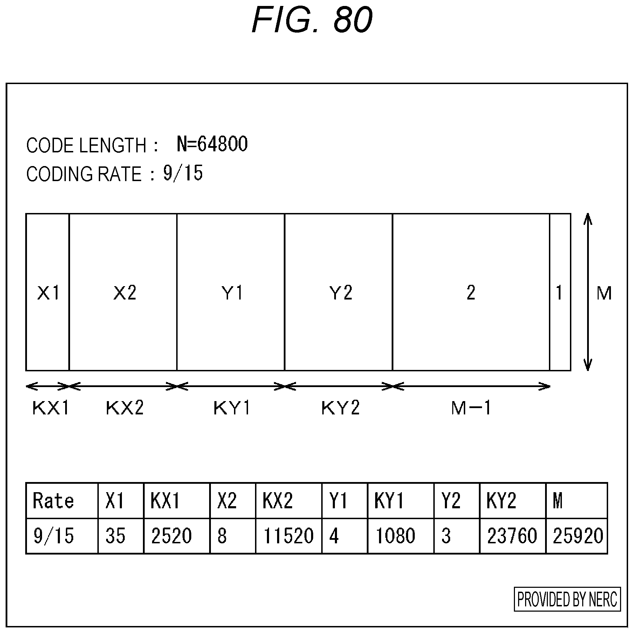

Fig. 80 is a diagram showing a parity check matrix H for a (64k, 9/15) NERC code.

The column weight of KX1 columns from the first column in the parity check matrix H for the (64k, 9/15) NERC code is X1. The column weight of subsequent KX2 columns is X2. The column weight of subsequent KY1 columns is Y1. The column weight of subsequent KY2 columns is Y2. The column weight of subsequent (M - 1) columns is 2. The column weight of the final one column is 1.

In this case, KX1 + KX2 + KY1 + KY2+ M - 1 + 1 is equivalent to the code length N = 64800 bits of the (64k, 9/15) NERC code.

Fig. 80 shows the numbers of columns KX1, KX2, KY1, KY2, and M, and the column weights X1, X2, Y1, and Y2 of the parity check matrix H for the (64k, 9/15) NERC code.

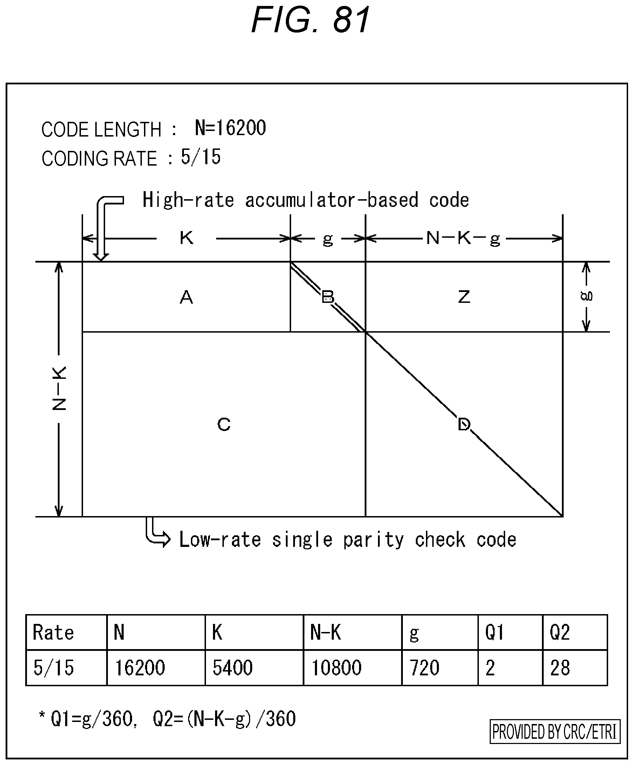

Fig. 81 is a diagram showing a parity check matrix H for a (16k, 5/15) ETRI code.

The parameter $g = M_1$ is 720 for the parity check matrix H for the (16k, 5/15) ETRI code

In addition, the code length N and the coding rate r of the (16k, 5/15) ETRI code are 16200 and 5/15, respectively. Accordingly, the information length $K = N \times r$ is $16200 \times 5/15 = 5400$, while the parity length $M = N - K$ is 16200 - 5400 = 10800.

Furthermore, the parameter $M_2 = M - M_1 = N - K - g$ is 10800 - 720 = 10080.

Accordingly, the parameter $Q_1 = M_1/P$ is 720/360 = 2, while the parameter $Q_2 = M_2/P$ is 10080/360 = 28.

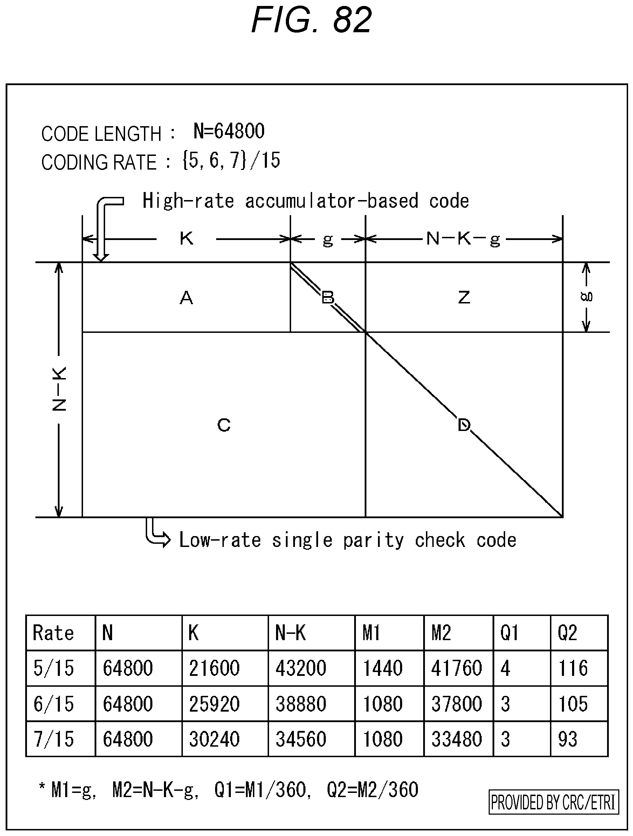

Fig. 82 is a diagram showing a parity check matrix H for each of (64k, 5/15), (64k, 6/15), and (64k, 7/15) ETRI codes.

Fig. 82 shows parameters $g = M_1$, $M_2$, $Q_1$, and $Q_2$ of the parity check matrix H for each of the (64k, 5/15), (64k, 6/15), and (64k, 7/15) ETRI codes.

<Constellation>

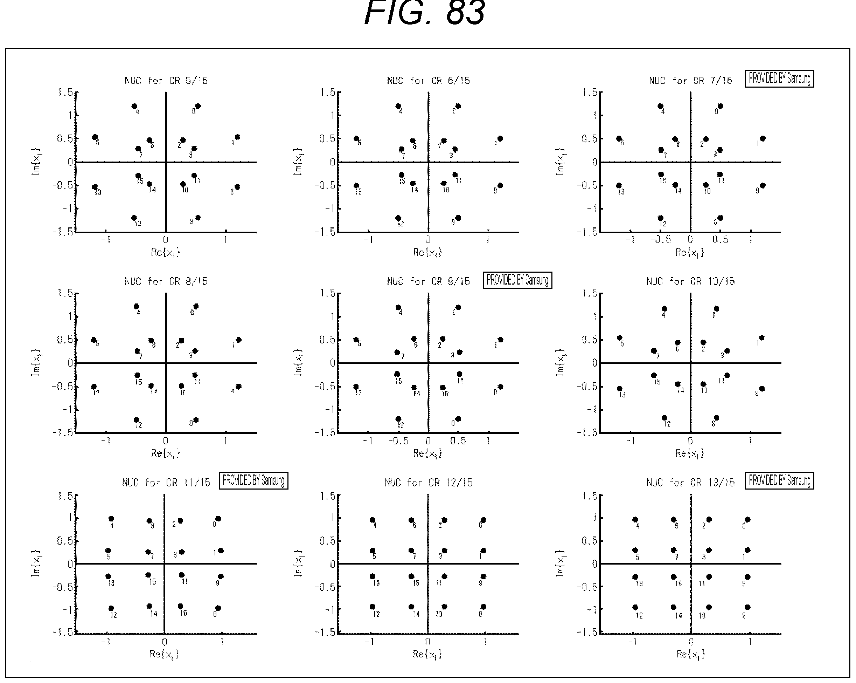

Figs. 83 through 104 are diagrams showing example of types of constellations adopted in the transmission system shown in Fig. 7.

The transmission system shown in Fig. 7 sets constellations used for MODCOD as combinations of modulation systems and LDPC codes, for example.

More specifically, for example, the transmission system shown in Fig. 7 divides LDPC codes into nine types of coding rates r of 5/15, 6/15, 7/15, 8/15, 9/15, 10/15, 11/15, 12,15, and 13/15 (regardless of code length N), and adopts, as MODCOD, combinations of the nine types of LDPC codes (LDPC codes having coding rates r of 5/15, 6/15, 7/15, 8/15, 9/15, 10/15, 11/15, 12,15, and 13/15) and respective modulation systems.

In addition, the transmission system shown in Fig. 7 sets one or more constellations used for each MODCOD as a MODCOD modulation system.

Constellations are classified into uniform constellations (UCs) defining uniform signal points, and non-uniform constellations (NUCs) defining non-uniform signal points.

In addition, NUCs include constellations called 1-dimensional $M^2$-QAM non-uniform constellations (ID NUCs), and 2-dimensional QQAM non-uniform constellations (2D NUCs), for example.

In general, BER of 1D NUCs is more preferable than that of UCs, and BER of 2D NUCs is more preferable than that of 1D NUCs.

A UC is adopted as a constellation using QPSK modulation system. On the other hand, a 2D NUC is adopted for a constellation using 16QAM, 64QAM, 256QAM, or like modulation system, while a 1D NUC is adopted for a constellation using 1024QAM, 4096QAM or like modulation system, for example.

An NUC constellation which adopts a modulation system for mapping an m-bit symbol to any one of $2^m$ signal points for MODCOD of an LDPC code having a coding rate r is hereinafter also referred to as $NUC\_2^m\_r$.

For example, "NUC_16_6/15" represents an NUC constellation which adopts 16QAM modulation system (or other modulation system for mapping symbol to any one of 16 signal points) for MODCOD of an LDPC code having a coding rate r of 6/15.

The transmission system shown in Fig. 7 uses an identical constellation for LDPC codes having respective coding rates r when the modulation system is QPSK.

On the other hand, the transmission system shown in Fig. 7 uses a different 2D NUC constellation for each of coding rates r of LDPC codes when the modulation system is 16QAM, 64QAM, or 256QAM.

Furthermore, the transmission system shown in Fig. 7 uses a different 1D NUC constellation for each of coding rates r of LDPC codes when the modulation system is 1024QAM or 4096QAM.

Accordingly, when LDPC codes are classified into nine types of coding rates r of 5/15, 6/15, 7/15, 8/15, 9/15, 10/15, 11/15, 12,15, 13/15, one type of constellation is prepared for QPSK. On the other hand, nine types of 2D NUC constellation are prepared for 16QAM, 64QAM, and 256QAM, while nine types of 1D NUC constellation are prepared for 1024QAM and 4096QAM.

Fig. 83 is a diagram showing examples of 2D NUC constellations corresponding to LDPC codes having the nine types of coding rates r (= 5/15, 6/15, 7/15, 8/15, 9/15, 10/15, 11/15, 12,15, 13/15) when the modulation system is 16QAM.

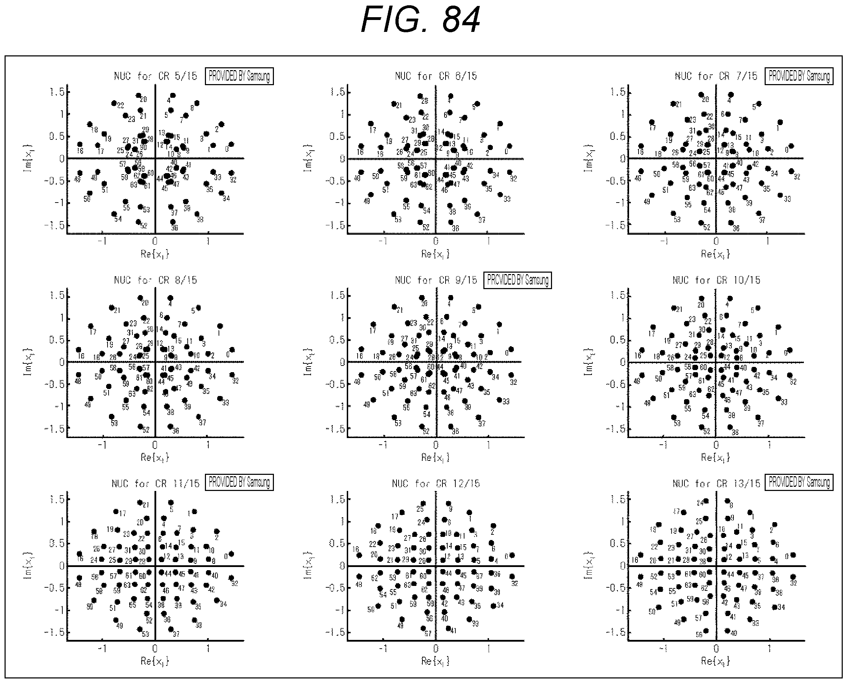

Fig. 84 is a diagram showing examples of 2D NUC constellations corresponding to LDPC codes having the nine types of coding rates r (= 5/15, 6/15, 7/15, 8/15, 9/15, 10/15, 11/15, 12,15, 13/15) when the modulation system is 64QAM.

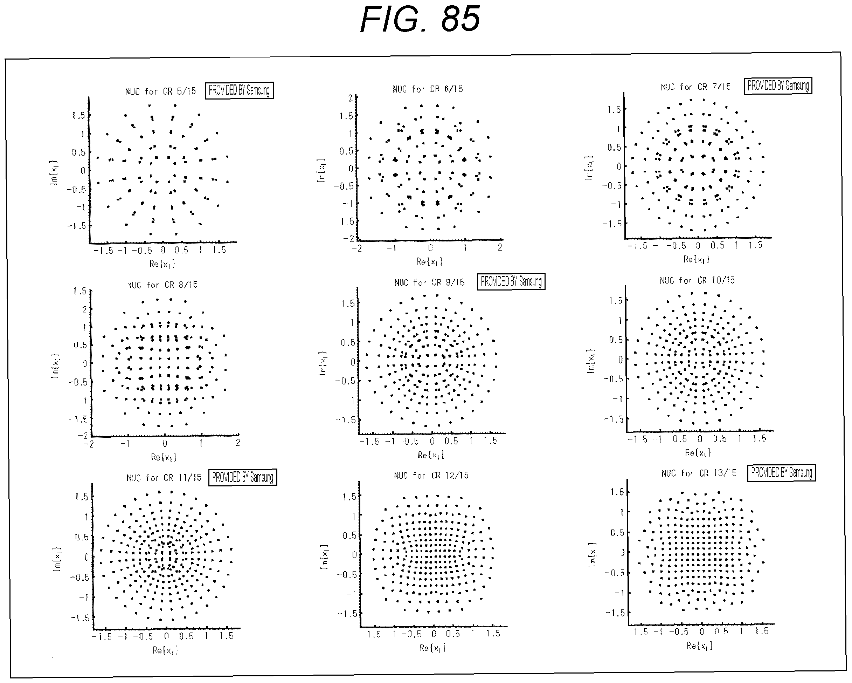

Fig. 85 is a diagram showing examples of 2D NUC constellations corresponding to LDPC codes having the nine types of coding rates r (= 5/15, 6/15, 7/15, 8/15, 9/15, 10/15, 11/15, 12,15, 13/15) when the modulation system is 256QAM.

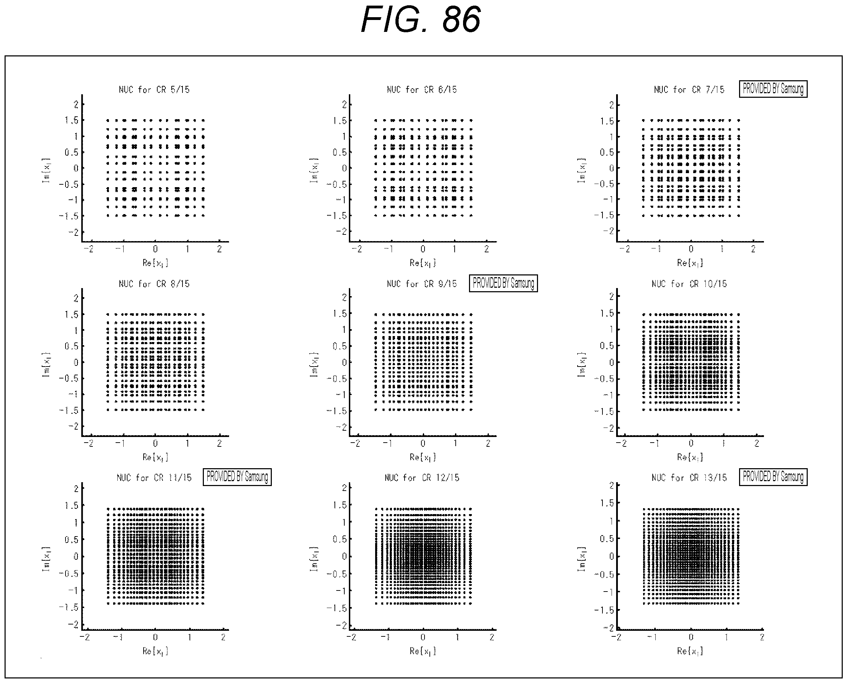

Fig. 86 is a diagram showing examples of 1D NUC constellations corresponding to LDPC codes having the nine types of coding rates r (= 5/15, 6/15, 7/15, 8/15, 9/15, 10/15, 11/15, 12,15, 13/15) when the modulation system is 1024QAM.

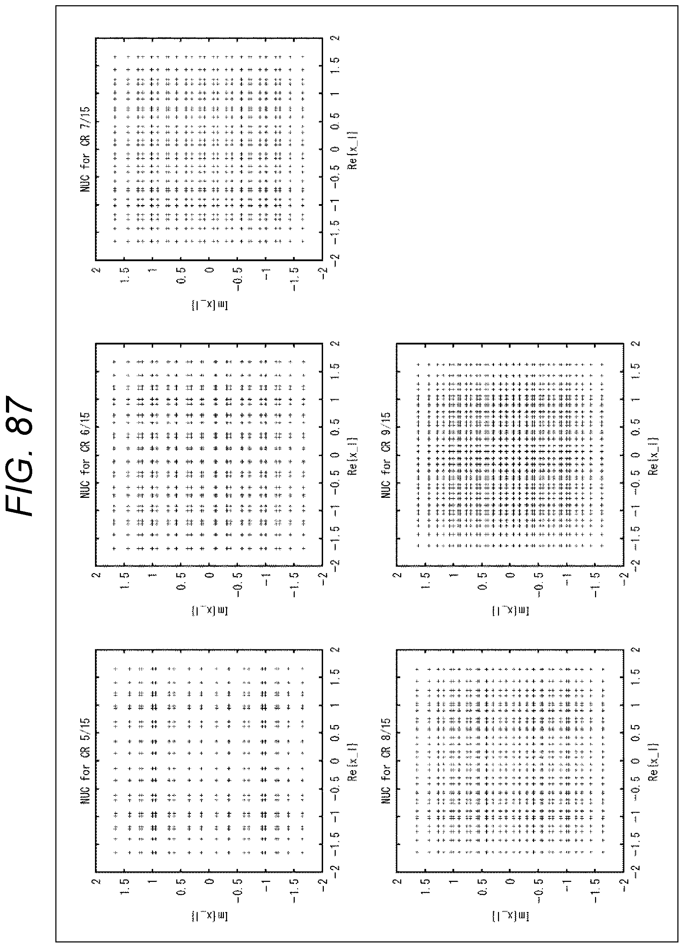

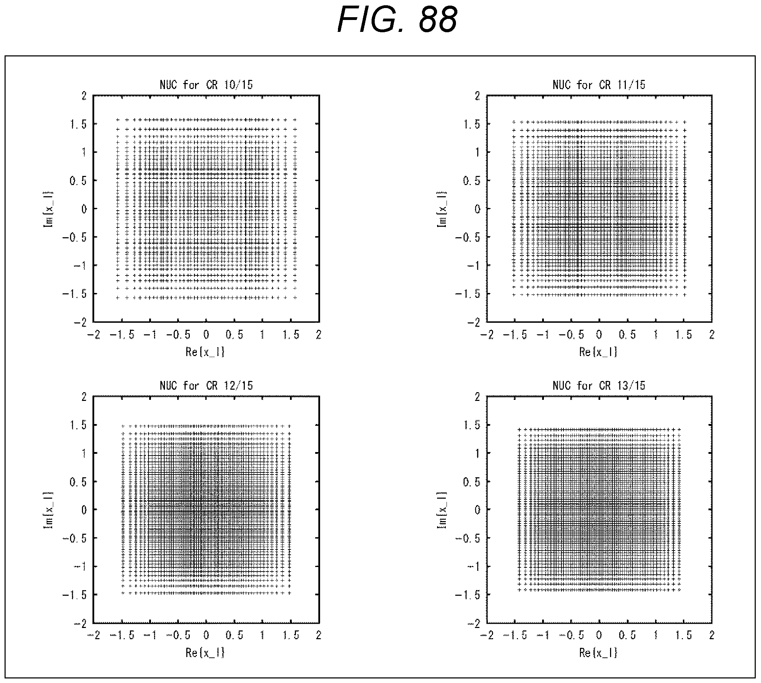

Each of Figs. 87 and 88 is a diagram showing examples of 1D NUC constellations corresponding to LDPC codes having the nine types of coding rates r (= 5/15, 6/15, 7/15, 8/15, 9/15, 10/15, 11/15, 12,15, 13/15) when the modulation system is 4096QAM.

In each of Figs. 83 through 88, the horizontal axis and the vertical axis represent an I axis and a Q axis, respectively. In addition, $Re\{x_1\}$ and $Im\{x_1\}$ represent a real part and an imaginary part of a signal point $x_1$ as a coordinate of the signal point $x_1$.

Furthermore, in each of Figs. 83 through 88, a numerical value shown after "for CR" represents a coding rate r of a corresponding LDPC code.

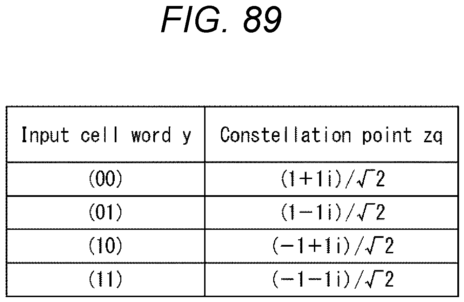

Fig. 89 is a diagram showing examples of coordinates of signal points of a UC common to the nine types of coding rates r (= 5/15, 6/15, 7/15, 8/15, 9/15, 10/15, 11/15, 12,15, 13/15) of LDPC codes when the modulation system is QPSK.

In Fig. 89, "Input cell word y" represents a 2-bit symbol mapped to the UC of QPSK, while "Constellation point $z_q$" represents a coordinate of a signal point $z_q$. Note that the index q of the signal point $z_q$ represents a discrete time of a symbol (time interval between a symbol and subsequent symbol).

In Fig. 89, the coordinate of the signal point $z_q$ is expressed in the form of a complex number. In this case, i represents an imaginary unit ($\sqrt{-1}$).

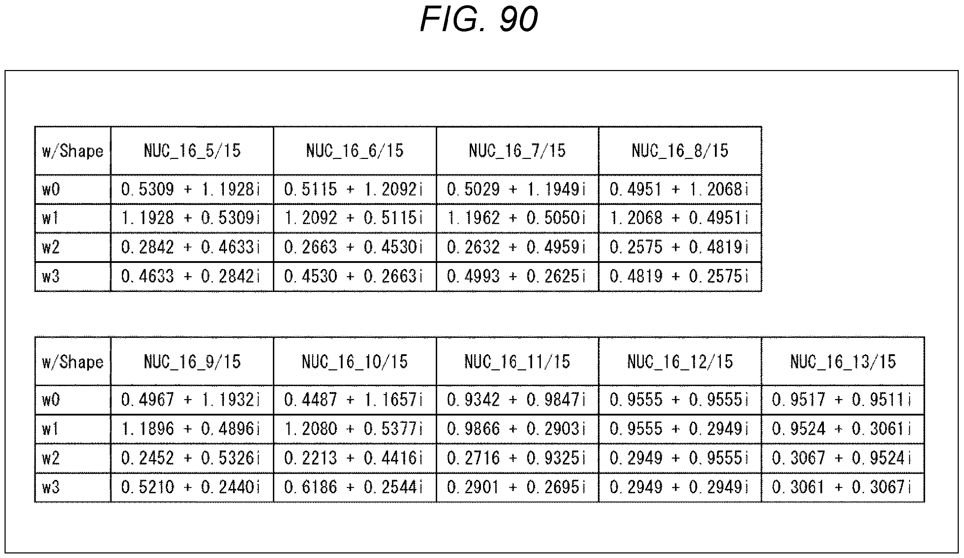

Fig. 90 is a diagram showing examples of coordinates of signal points of 2D NUCs shown in Fig. 83 and used for the nine types of coding rates r (= 5/15, 6/15, 7/15, 8/15, 9/15, 10/15, 11/15, 12,15, 13/15) of LDPC codes when the modulation system is 16QAM.

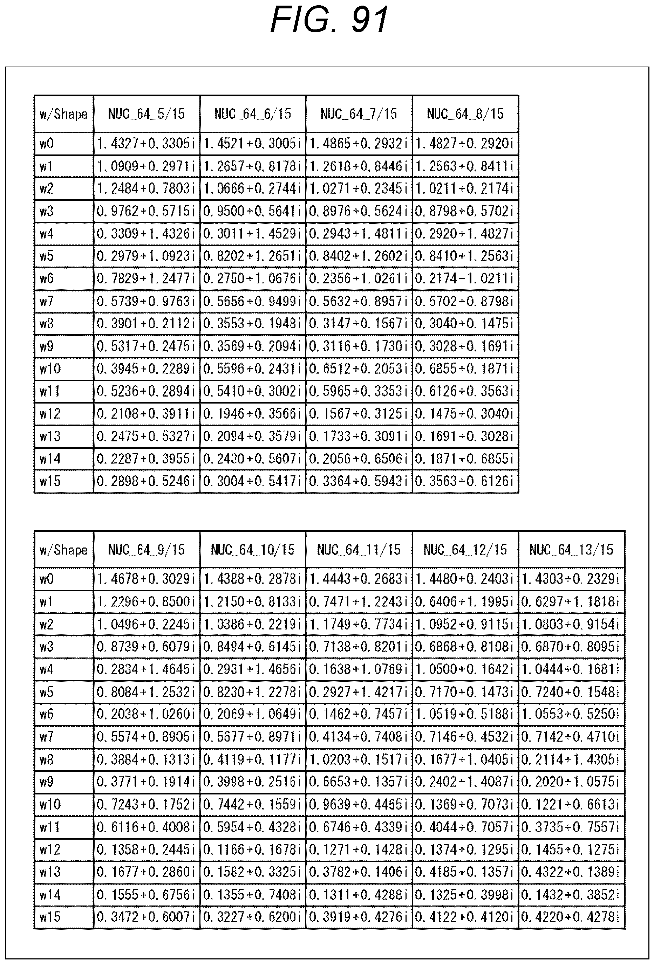

Fig. 91 is a diagram showing examples of coordinates of signal points of 2D NUCs shown in Fig. 84 and used for the nine types of coding rates r (= 5/15, 6/15, 7/15, 8/15, 9/15, 10/15, 11/15, 12,15, 13/15) of LDPC codes when the modulation system is 64QAM.

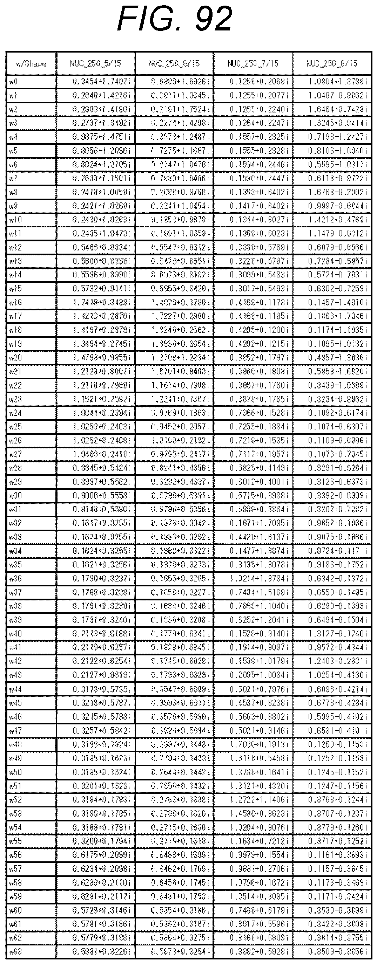

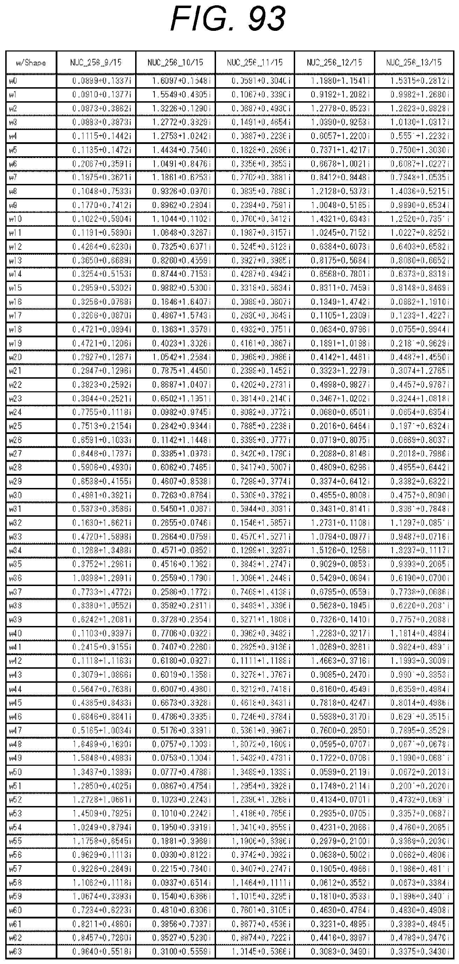

Each of Figs. 92 and 93 is a diagram showing examples of coordinates of signal points of 2D NUCs shown in Fig. 85 and used for the nine types of coding rates r (= 5/15, 6/15, 7/15, 8/15, 9/15, 10/15, 11/15, 12,15, 13/15) of LDPC codes when the modulation system is 256QAM.

In Figs. 90 through 93, NUC_$2^m$_r represents the coordinate of the signal point of the 2D NUC used when the modulation system and the coding rate of the LDPC code are $2^m$QAM and r, respectively.

In Figs. 90 through 93, the coordinate of the signal point $z_q$ is expressed in the form of a complex number, while i represents an imaginary unit, similarly to those in Fig. 89.

In Figs. 90 through 93, w#k represents a coordinate of a signal point in the first quadrant of the constellation.

In the 2D NUC, a signal point in the second quadrant of the constellation is disposed at a position shifted symmetrically with respect to the Q axis from the signal point in the first quadrant, while a signal point in the third quadrant is disposed at a position shifted symmetrically with respect to the origin from the signal point in the first quadrant. In addition, a signal point in the fourth quadrant is disposed at a position shifted symmetrically with respect to the I axis from the signal point in the first quadrant.

When the modulation system is $2^m$QAM herein, one symbol constituted by m bits is mapped to a signal point corresponding to the symbol.

The m-bit symbol is expressed by an integer value ranging from 0 to $2^m$ - 1, for example. Assuming that b = $2^m/4$ herein, symbols y(0), y(1) and up to y ($2^m$ - 1) expressed by an integer value ranging from 0 to $2^m$ - 1 are classified into four groups of symbols y(0) through y(b - 1), symbols y(b) through y(2b - 1), symbols y(2b) through y(3b - 1), and y(3b) through y(4b - 1).

In Figs. 90 through 93, a suffix k of w#k is an integer value ranging from 0 to b - 1. In this case, a coordinate of a signal point corresponding to a symbol y(k) ranging from symbols y(0) to y(b - 1) is expressed as w#k.

Moreover, a coordinate of a signal point corresponding to a symbol y(k + b) ranging from symbols y(b) to y(2b - 1) is expressed as - conj(w#k), while a coordinate of a signal point corresponding to a symbol y(k + 2b) ranging from symbols y(2b) to y(3b - 1) is expressed as conj(w#k). Furthermore, a coordinate of a signal point corresponding to a symbol y(k + 3b) ranging from symbols y(3b) to y(4b - 1) is expressed as -w#k.

In this case, conj(w#k) represents a complex conjugate of w#k.

When the modulation system is 16QAM, for example, m = 4-bit symbols y(0), y(1), and up to y(15) are classified into four types of symbols ranging from y(0) to y(3), y(4) to y(7), y(8) to y(11), and y(12) to y(15) under $b = 2^4/4 = 4$.

In this case, the symbol y(12) in the symbols ranging from y(0) to y(15), for example, is the symbol y(k + 3b) = $y(0 + 3 \times 4)$ in the range from symbol y(3b) to y(4b - 1). Accordingly, the coordinate of the signal point corresponding to the symbol y(12) is -w#k = -w0 under k = 0.

When the coding rate r of the LDPC code is 9/15, for example, w0 under the modulation system of 16QAM and the coding rate r of 9/15 (NUC_16_9/15) is 0.4967 + 1.1932i as shown in Fig. 90. Accordingly, the coordinate -w0 of the signal point corresponding to the symbol y(12) is -(0.4967 + 1.1932i).

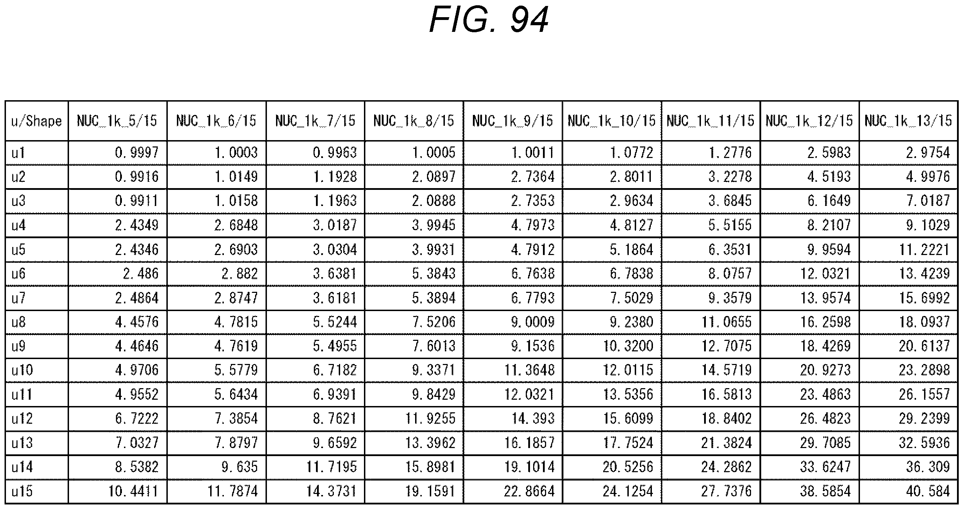

Fig. 94 is a diagram showing examples of coordinates of signal points of 1D NUCs shown in Fig. 86 and used for the nine types of coding rates r (= 5/15, 6/15, 7/15, 8/15, 9/15, 10/15, 11/15, 12,15, 13/15) of LDPC codes when the modulation system is 1024QAM.

In Fig. 94, an NUC_1k_r column indicates values of u#k representing coordinates of signal points in a 1D NUC used when the coding rate of the LDPC code is r under the modulation system of 1024QAM.

In this case, u#k represents a real part $Re(z_q)$ and an imaginary part $Im(z_q)$ of a complex number as a coordinate of a signal point $z_q$ of a 1D NUC.

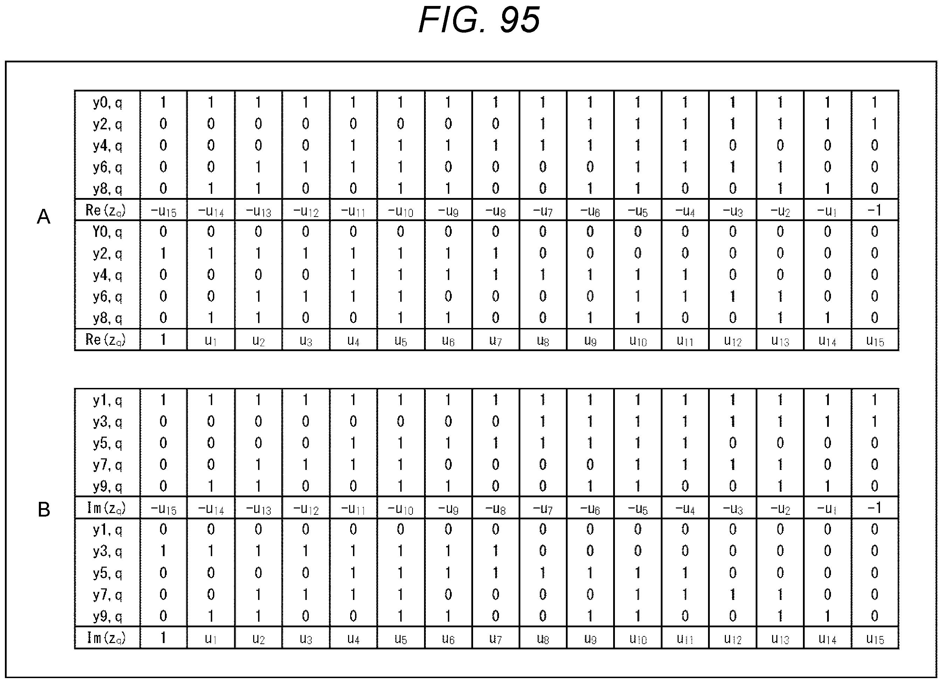

Fig. 95 is a diagram showing a relationship between a symbol y of 1024QAM, and u#k for each of a real part $Re(z_q)$ and an imaginary part $Im(z_q)$ of a complex representing a coordinate of a signal point $z_q$ of a 1D NUC corresponding to the symbol y.

It is assumed herein that the 10-bit symbol y of 1024QAM is expressed as $y_{0,q}$, $y_{1,q}$, $y_{2,q}$, $y_{3,q}$, $y_{4,q}$, $y_{5,q}$, $y_{6,q}$, $y_{7,q}$, $y_{8,q}$, and $y_{9,q}$ from the head bit (highest-order bit).

Part A in Fig. 95 shows a correlation between the odd-numbered 5 bits $y_{0,q}$, $y_{2,q}$, $y_{4,q}$, $y_{6,q}$, and $y_{8,q}$ of the symbol y, and u#k representing the real part $Re(z_q)$ of (coordinates of) the signal point $z_q$ corresponding to the symbol y.

Part B in Fig. 95 shows a correlation between the even-numbered 5 bits $y_{1,q}$, $y_{3,q}$. $y_{5,q}$, $y_{7,q}$, and $y_{9,q}$ of the symbol y, and u#k representing the imaginary part $Im(z_q)$ of (coordinates of) the signal point $z_q$ corresponding to the symbol y.

When the 10-bit symbol y = ($y_{0,q}$, $y_{1,q}$, $y_{2,q}$, $y_{3,q}$, $y_{4,q}$, $y_{5,q}$, $y_{6,q}$, $y_7$,q, $y_{8,q}$, and $y_{9,q}$) of 1024QAM is (0, 0, 1, 0, 0, 1, 1, 1, 0, 0), for example, the odd-numbered 5 bits ($y_{0,q}$, $y_{2,q}$, $y_{4,q}$, $y_{6,q}$, and $y_{8,q}$) is (0, 1, 0, 1, 0), while the even-numbered 5 bits $y_{1,q}$, $y_{3,q}$, $y_{5,q}$, $y_{7,q}$, and $y_{9,q}$ is (0, 0, 1, 1, 0).

In part A in Fig. 95, the odd-numbered 5 bits (0, 1, 0, 1, 0) are associated with u3, wherefore the real part $Re(z_q)$ of the signal point $z_q$ corresponding to the symbol y = (0, 0, 1, 0, 0, 1, 1, 1, 0, 0) is u3.

In addition, in part B in Fig. 95, the even-numbered 5 bits (0, 0, 1, 1, 0) are associated with u11, wherefore the imaginary part $Im(z_q)$ of the signal point $z_q$ corresponding to the symbol y = (0, 0, 1, 0, 0, 1, 1, 1, 0, 0) is u11.

On the other hand, when the coding rate r of the LDPC code is 7/15, for example, u3 is 1.1963 for the 1D NUC (NUC_1k_7/15) used when the coding rate r of the LDPC code is 7/15 under the modulation system 1024QAM according to Fig. 94 described above. In this case, u11 is 6.9391.

Accordingly, the real part $Re(z_q)$ of the signal point $z_q$ corresponding to the symbol y = (0, 0, 1, 0, 0, 1, 1, 1, 0, 0) is u3 = 1.1963, while the Im $(z_q)$ is u11 = 6.9391. As a result, the coordinate of the signal point $z_q$ corresponding to the symbol y = (0, 0, 1, 0, 0, 1, 1, 1, 0, 0) is expressed as 1.1963+6.9391i.

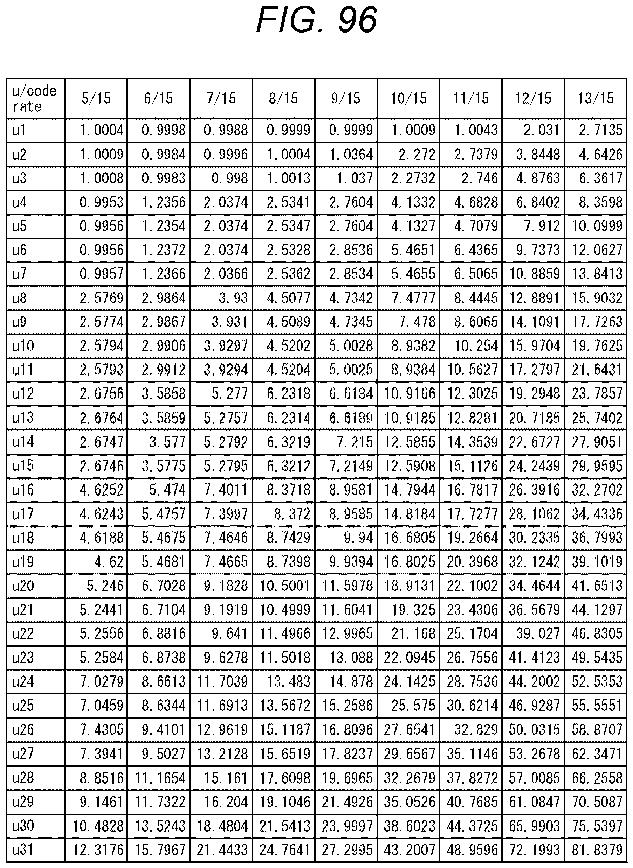

Fig. 96 is a diagram showing examples of coordinates of signal points of 1D NUCs shown in Figs. 87 and 88 and used for the nine types of the coding rates r of the LDPC code (= 5/15, 6/15, 7/15, 8/15, 9/15, 10/15, 11/15, 12,15, 13/15) when the modulation system is 4096QAM.

In Fig. 96, each of columns indicates values of u#k representing a coordinate of a signal point of a 1D NUC used for each of the coding rates r = 5/15, 6/15, 7/15, 8/15, 9/15, 10/15, 11/15, 12,15, 13/15 of the LDPC code under the modulation system of 4096QAM.

In this case, u#k represents a real part $Re(z_q)$ and an imaginary part $Im(z_q)$ of a complex number as a coordinate of a signal point $z_q$ of a 1D NUC.

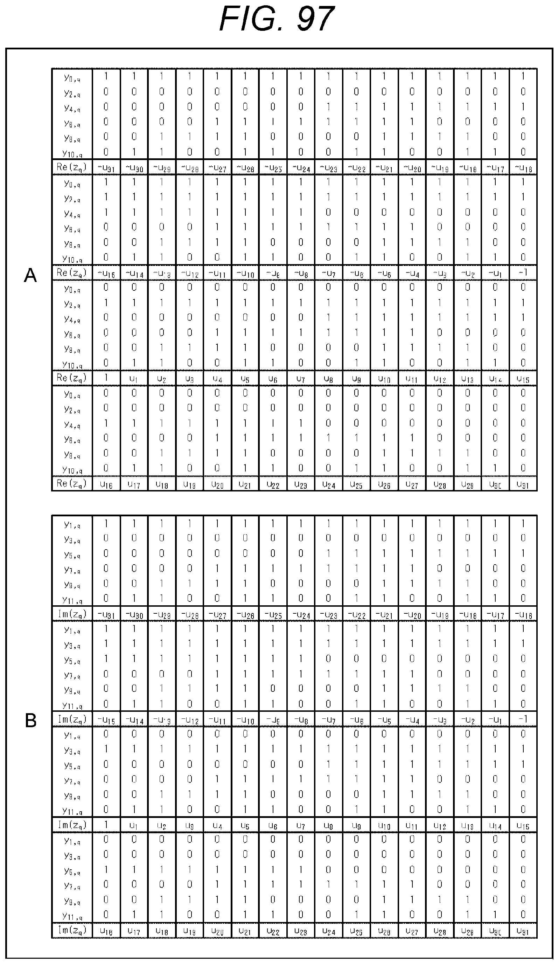

Fig. 97 is a diagram showing a relationship between a symbol y of 4096QAM and u#k for each of a real part $Re(z_q)$ and an imaginary part $Im(z_q)$ of a complex of a signal point $z_q$ of a 1D NUC for the corresponding symbol y.

The method for obtaining the coordinate of the signal point of the 1D NUC of 4096QAM on the basis of Figs.

96 and 97 is similar to the method for obtaining the coordinate of the signal point of the 1D NUC of 1024QAM on the basis of Figs. 94 and 95. Accordingly, the same explanation is not repeated.

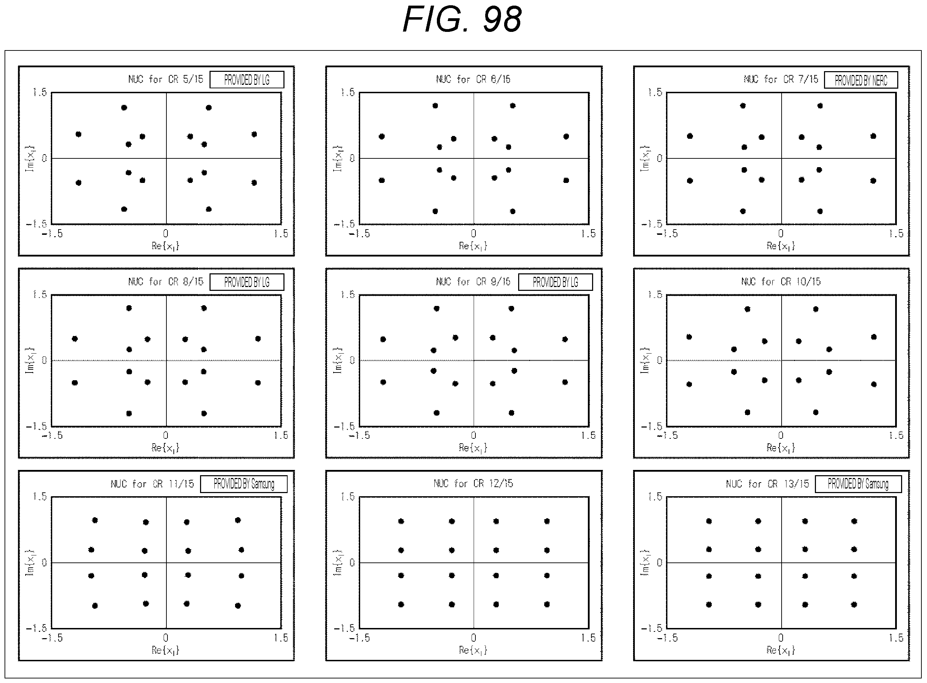

Fig. 98 is a diagram showing other examples of 2D NUCs for each of the nine types of coding rate r of the LDPC code when the modulation system is 16QAM.

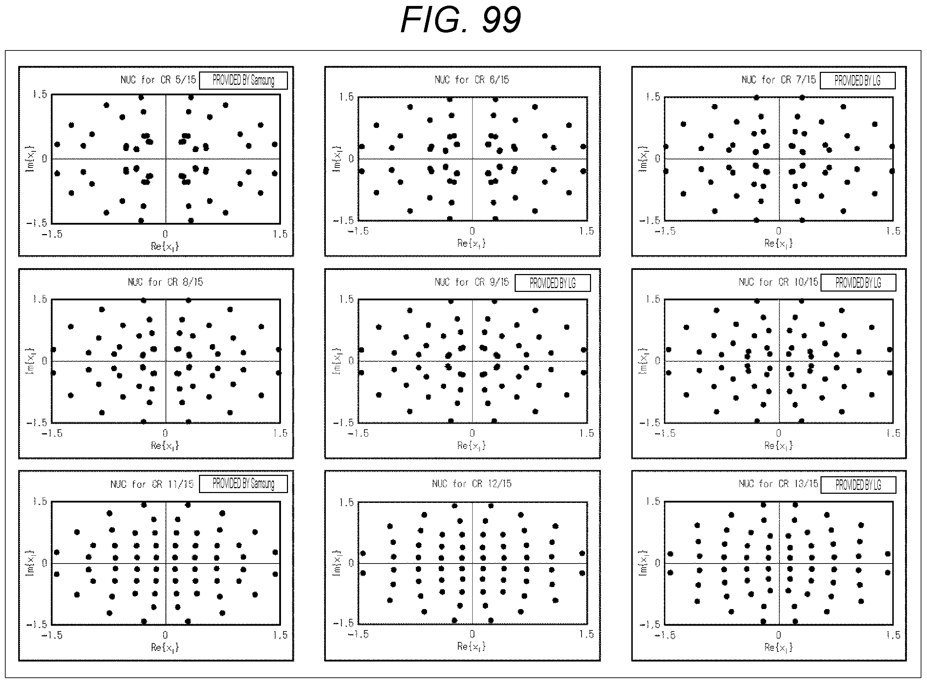

Fig. 99 is a diagram showing other examples of 2D NUCs for each of the nine types of coding rate r of the LDPC code when the modulation system is 64QAM.

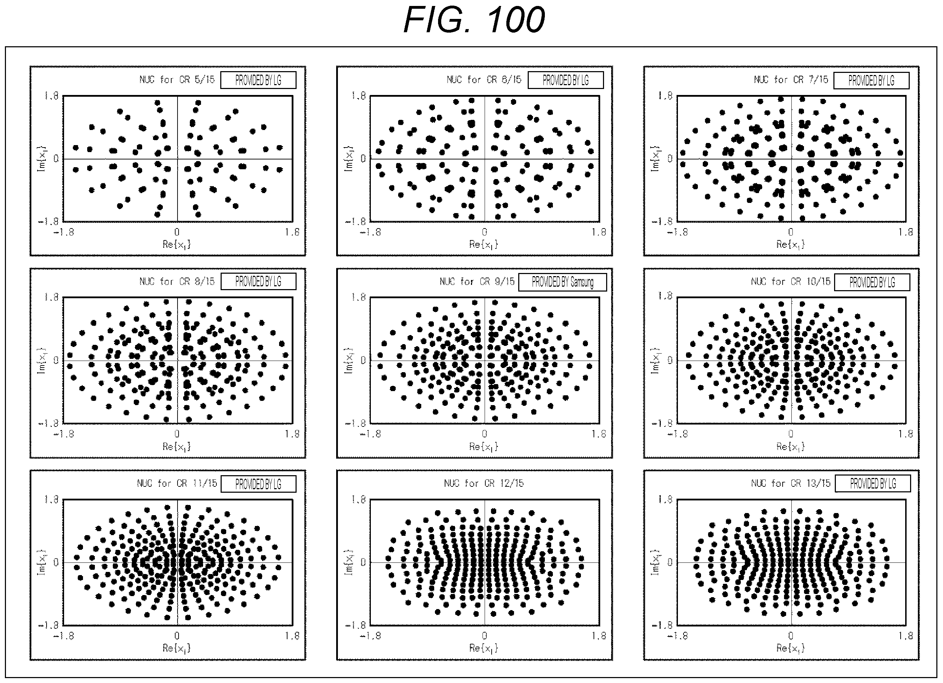

Fig. 100 is a diagram showing other examples of 2D NUCs for each of the nine types of coding rate r of the LDPC code when the modulation system is 256QAM.

Note that in each of Figs. 98 through 100, the horizontal axis and the vertical axis represent an I axis and a Q axis, respectively. In addition, $Re\{x_1\}$ and $Im\{x_1\}$ represent a real part and an imaginary part of a signal point $x_1$ as coordinates of the signal point $x_1$, similarly to Figs. 83 through 88. Furthermore, in each of Figs. 98 through 100, a numerical value shown after "for CR" represents a coding rate r of a corresponding LDPC code.

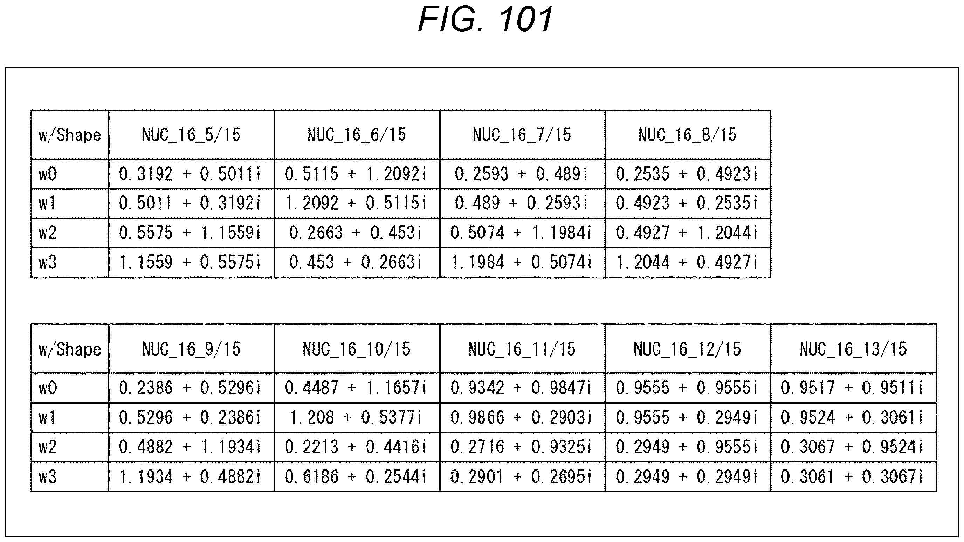

Fig. 101 is a diagram showing examples of coordinates of signal points of 2D NUCs in Fig. 98 used for the nine types of coding rates r of an LDPC code when the modulation system is 16QAM.

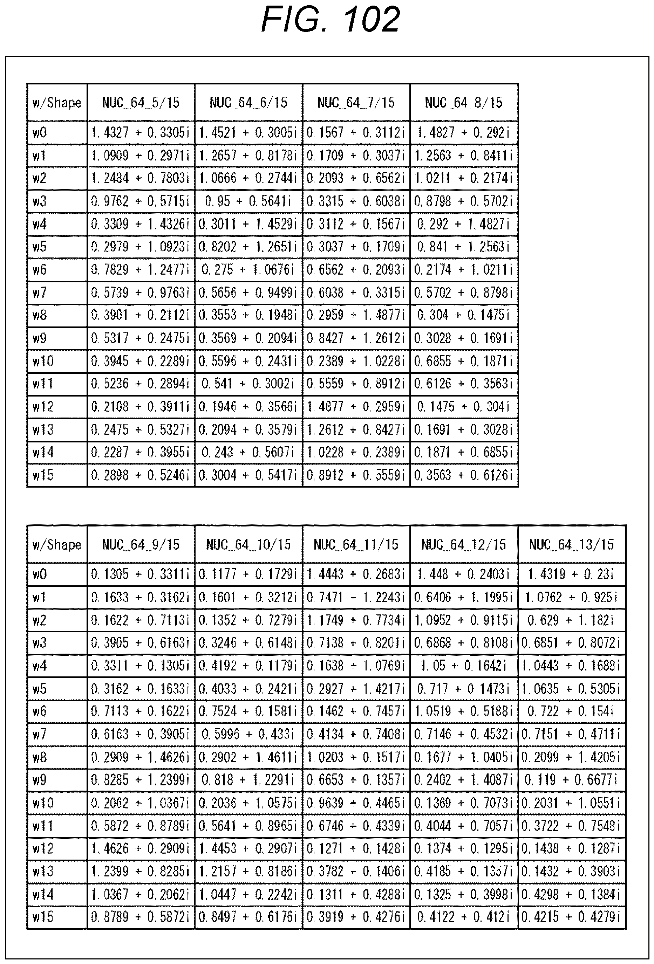

Fig. 102 is a diagram showing examples of coordinates of signal points of 2D NUCs in Fig. 99 used for the nine types of coding rates r of an LDPC code when the modulation system is 64QAM.

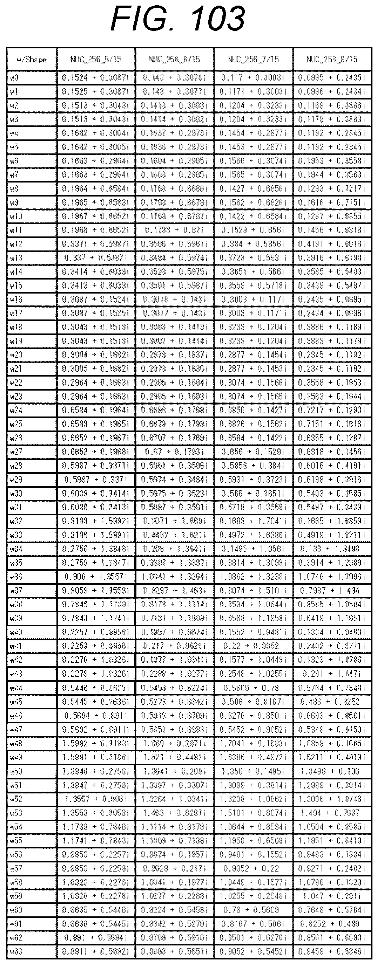

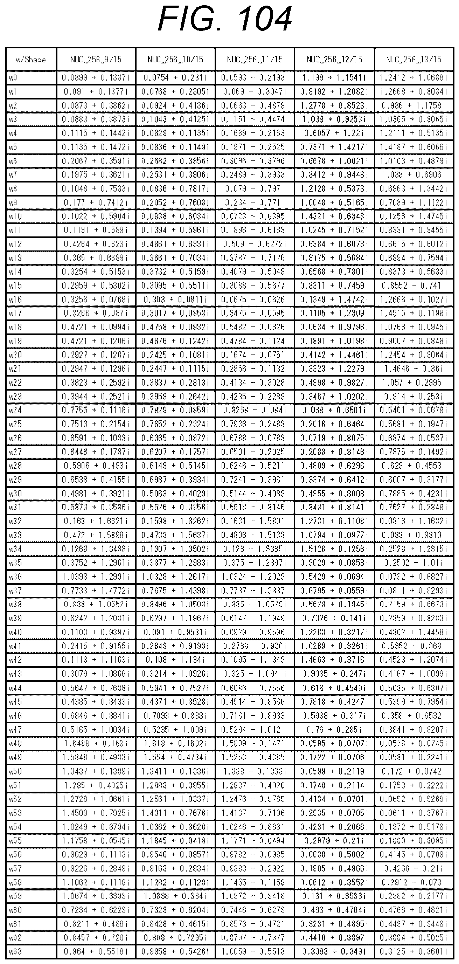

Each of Figs. 103 and 104 is a diagram showing examples of coordinates of signal points of 2D NUCs in Fig. 100 used for the nine types of coding rates r of an LDPC code when the modulation system is 256QAM.

In Figs. 101 through 104, NUC_$2^m$_r represents a coordinate of a signal of the 2D NUC used when the LDPC coding rate of the LDPC code is r under the modulation system of $2^m$QAM similarly to Figs. 90 through 93.

Note that signal points of a 1D NUC are arranged in a grid shape on straight lines parallel with the I axis and on straight lines parallel with the Q axis. However, intervals between the signal points are not uniform. In addition, for transmission of signal points (data mapped to signal points), average power for the signal points on the constellation is normalized. This normalization is achieved by multiplying the respective signal points $z_q$ on the constellation by the reciprocal $1/(\sqrt{P_{ave}})$ of the square root $\sqrt{P_{ave}}$ of a mean-square value Pave which represents a mean-square value of absolute values of (coordinates of) all the signal points on the constellation.

It has been confirmed that preferable error rates are obtained from the respective constellations described with reference to Figs. 83 through 104.

<Block interleaver 25>

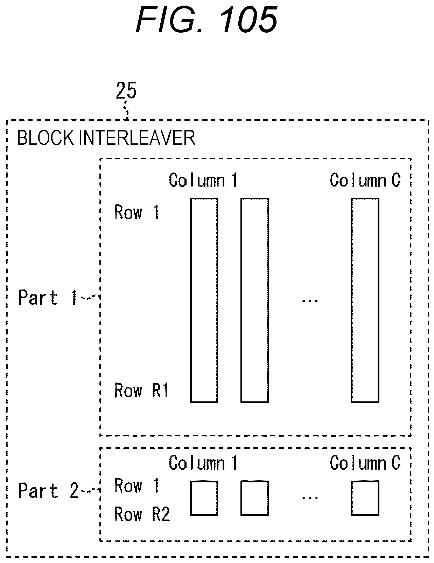

Fig. 105 is a block diagram showing a configuration example of the block interleaver 25 shown in Fig. 9.

The block interleaver 25 includes a storage area called a part 1, and a storage area called part 2.

Each of the parts 1 and 2 is constituted by a number C of columns as storage areas each of which stores a predetermined bit number in the column (vertical) direction. The number C of the columns arranged in the row direction is the same number as a bit number m of a symbol.

Assuming that the bit number stored in each column of the part 1 in the column direction (hereinafter also referred to as part column length) is expressed as R1, and that the part column length of the column of the part 2 is expressed as R2, (R1 + R2) × C is equivalent to the code length N (64800 bits or 16200 bits according to the first embodiment) of an LDPC code corresponding to a target of block interleave.

In addition, the part column length R1 is equivalent to a multiple of 360 bits corresponding to the unit size P, while the part column length R2 is equivalent to a remainder obtained when the sum of the part column length R1 of the part 1 and the part column length R2 of the part 2, i.e., R1 + R2 (hereinafter also referred to as column length), is divided by 360 bits corresponding to the unit size P.

Here, the column length R1 + R2 is equivalent to the value obtained by dividing the code length N of the LDPC code corresponding to the target of block interleave by the bit number m of the symbol.

For example, when 16QAM is adopted as a modulation system for an LDPC code having the code length N of 16200 bits, the bit number m of the symbol is 4 bits. Accordingly, the column length R1 + R2 is 4050 (16200/4) bits.

In addition, the remainder obtained when the column length R1 + R2 = 4050 is divided by 360 bits corresponding to the unit size P is 90. Accordingly, the part column length R2 of the part 2 is 90 bits.

In this case, the column length R1 of the part 1 is calculated as R1 + R2 - R2 = 4050 - 90 = 3960 bits.

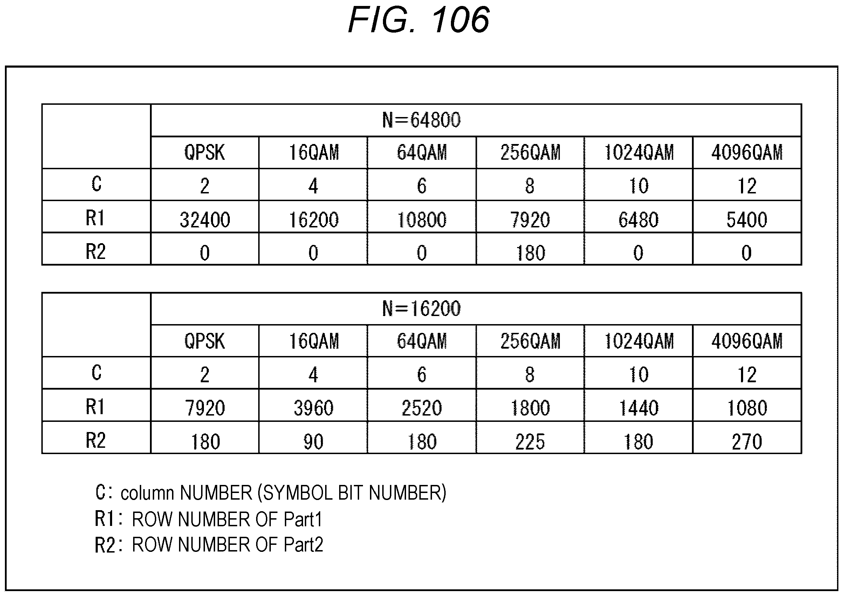

Fig. 106 is a diagram showing the column number C of each of the parts 1 and 2, and the part column lengths (row numbers) R1 and R2 for combinations of the code length N and the modulation system.

Fig. 106 shows the column numbers C of the parts 1 and 2, and the part column lengths R1 and R2 for each of the combinations of LDPC codes having the code lengths N of 16200 bits and 64800 bits, and the modulation systems of QPSK, 16QAM, 64QAM, 256QAM, 1024QAM, and 4096QAM.

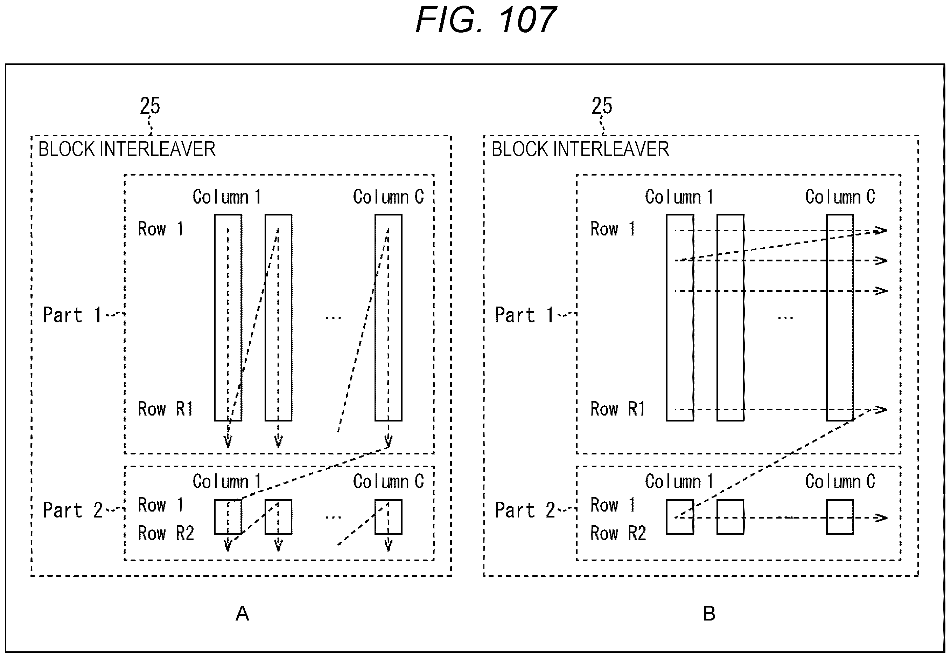

Fig. 107 is a diagram showing block interleave performed by the block interleaver 25 shown in Fig. 105.

The block interleaver 25 performs block interleave by writing and reading an LDPC code to and from the parts 1 and 2.

More specifically, for block interleave, writing of sign bits of the LDPC code as one code word to each column in the part 1 in the direction from the top to the bottom (column direction) is performed for the columns from the left to the right as shown in part A in Fig. 107.

Then, when writing of the sign bits is completed for the lowermost position of the rightmost column (Cth column) in the part 1, writing of remaining sign bits to each column in the part 2 from the top to the bottom (column direction) is initiated for the columns from the left to the right.

When writing of the sign bits is subsequently completed for the lowermost position of the rightmost column (Cth column) in the part 2, the sign bits are read from the first rows of all the C columns in the part 1 in the row direction in units of C = m bits as shown in part B in Fig. 107.

In addition, reading of the sign bits from all the C columns in the part 1 is sequentially performed toward the lower row. When reading is completed for the R1th row corresponding to the final row, the sign bits are read from the first rows of all the C columns in the part 2 in the row direction in units of C = m bits.

Reading of the sign bits from all the C columns of the part 2 is sequentially performed toward the lower row up to the R2th row corresponding to the final row.

The sign bits read from the parts 1 and 2 in units of m bits in the manner described above are supplied as symbols to the mapper 117 (Fig. 8).

<Group-wise interleave>

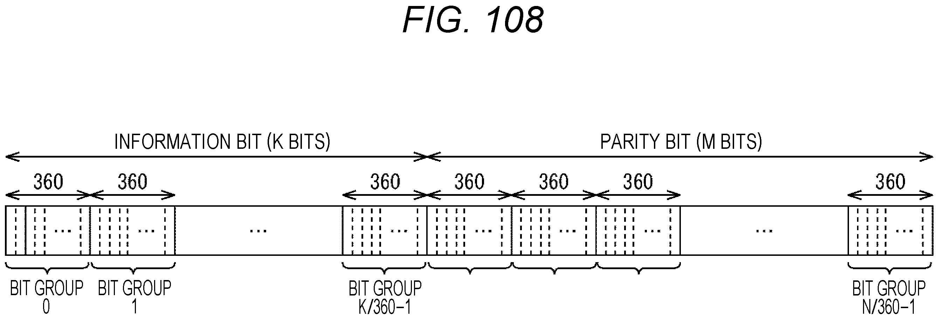

Fig. 108 is a diagram showing group-wise interleave performed by the group-wise interleaver 24 shown in Fig. 9.

For group-wise interleave, a section of 360 bits in an LDPC code as one code word, which has been sectioned in units of 360 bits corresponding to the unit size P from the head of the code, is determined as a bit group. The LDPC code as one cord word is interleaved in units of bit group according to a predetermined pattern (hereinafter also referred to as GW pattern).

The (i + 1)th bit group from the head when a LDPC code of one code word is sectioned into bit groups is hereinafter also referred to as bit group i.

When the unit size P is 360, an LDPC code having the code length N of 1800 bits is sectioned into 5 (= 1800/360) bit groups 0, 1, 2, 3, and 4, for example. On the other hand, an LDPC code having the code length N of 16200 bits is sectioned into 45 (= 16200/360) bit groups 0, 1, and up to 44, while an LDPC code having the code length N of 64800 bits is sectioned into 180 (= 64800/360) bit groups 0, 1, and up to 179, for example.

In addition, each GW pattern is hereinafter expressed as arrangement of numerals representing bit groups. For example, for an LDPC code having the code length N of 1800 bits, a GW pattern 4, 2, 0, 3, 1 interleaves (rearranges) arrangement of a bit group 0, 1, 2, 3, 4 as arrangement of a bit group 4, 2, 0, 3, 1.

A GW pattern may be set at least for each code length N of an LDPC code.

<Examples of GW pattern for 64k-bit LDPC code>

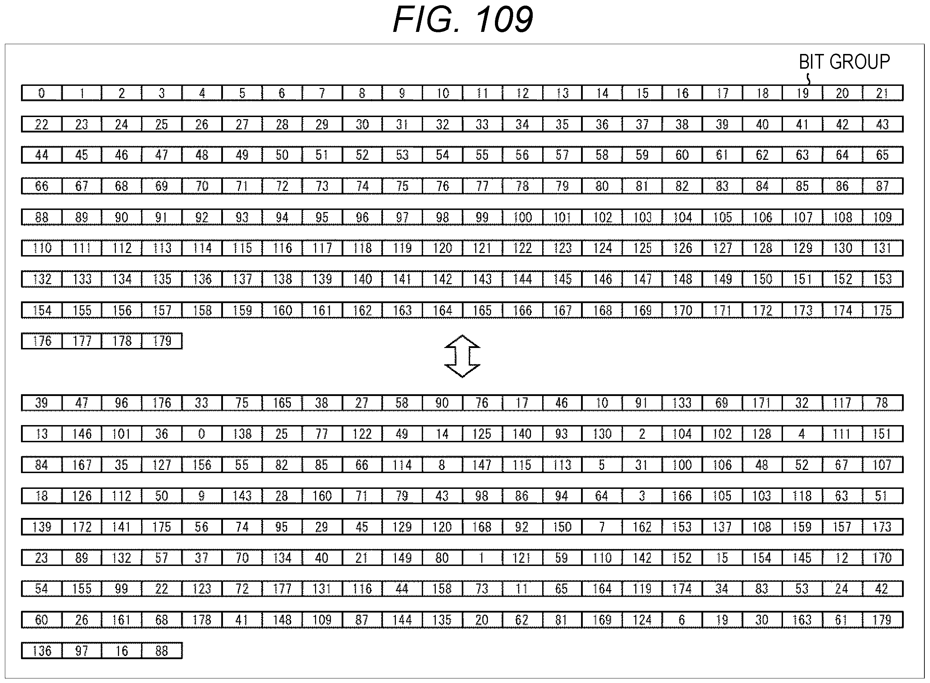

Fig. 109 is a diagram showing a first example of a GW pattern for an LDPC code having a code length N of 64k bits.

According to the GW pattern shown in Fig. 109, arrangement of bit groups from 0 to 179 of a 64k-bit LDPC code is interleaved to arrangement of 39, 47, 96, 176, 33, 75, 165, 38, 27, 58, 90, 76, 17, 46, 10, 91, 133, 69, 171, 32, 117, 78, 13, 146, 101, 36, 0, 138, 25, 77, 122, 49, 14, 125, 140, 93, 130, 2, 104, 102, 128, 4, 111, 151, 84, 167, 35, 127, 156, 55, 82, 85, 66, 114, 8, 147, 115, 113, 5, 31, 100, 106, 48, 52, 67, 107, 18, 126, 112, 50, 9, 143, 28, 160, 71, 79, 43, 98, 86, 94, 64, 3, 166, 105, 103, 118, 63, 51, 139, 172, 141, 175, 56, 74, 95, 29, 45, 129, 120, 168, 92, 150, 7, 162, 153, 137, 108, 159, 157, 173, 23, 89, 132, 57, 37, 70, 134, 40, 21, 149, 80, 1, 121, 59, 110, 142, 152, 15, 154, 145, 12, 170, 54, 155, 99, 22, 123, 72, 177, 131, 116, 44, 158, 73, 11, 65, 164, 119, 174, 34, 83, 53, 24, 42, 60, 26, 161, 68, 178, 41, 148, 109, 87, 144, 135, 20, 62, 81, 169, 124, 6, 19, 30, 163, 61, 179, 136, 97, 16, 88.

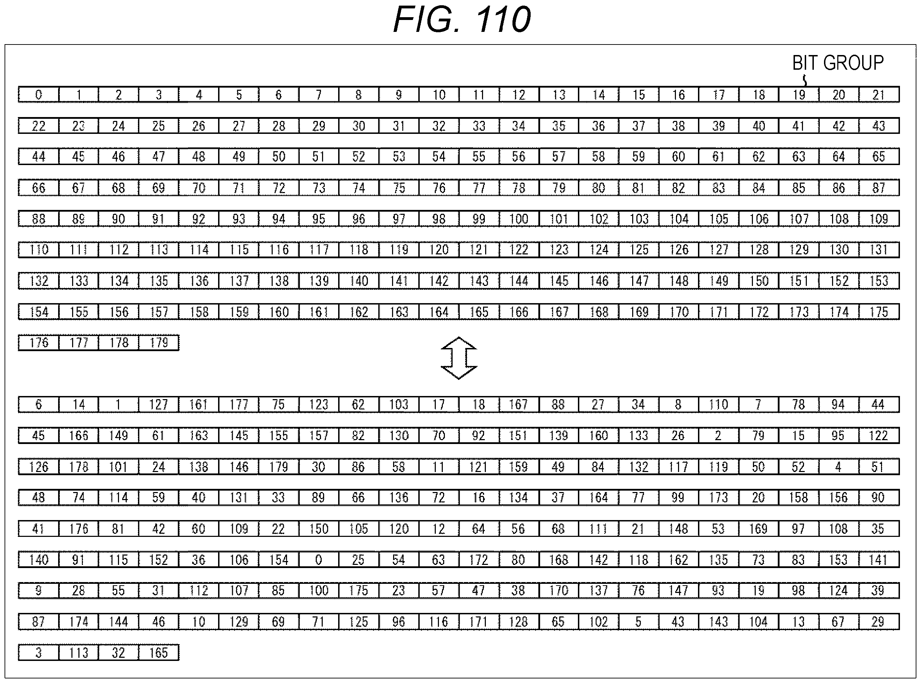

Fig. 110 is a diagram showing a second example of a GW pattern for an LDPC code having a code length N of 64k bits.

According to the GW pattern shown in Fig. 110, arrangement of bit groups from 0 to 179 of the 64k-bit LDPC code is interleaved to arrangement of 6, 14, 1, 127, 161, 177, 75, 123, 62, 103, 17, 18, 167, 88, 27, 34, 8, 110, 7, 78, 94, 44, 45, 166, 149, 61, 163, 145, 155, 157, 82, 130, 70, 92, 151, 139, 160, 133, 26, 2, 79, 15, 95, 122, 126, 178, 101, 24, 138, 146, 179, 30, 86, 58, 11, 121, 159, 49, 84, 132, 117, 119, 50, 52, 4, 51, 48, 74, 114, 59, 40, 131, 33, 89, 66, 136, 72, 16, 134, 37, 164, 77, 99, 173, 20, 158, 156, 90, 41, 176, 81, 42, 60, 109, 22, 150, 105, 120, 12, 64, 56, 68, 111, 21, 148, 53, 169, 97, 108, 35, 140, 91, 115, 152, 36, 106, 154, 0, 25, 54, 63, 172, 80, 168, 142, 118, 162, 135, 73, 83, 153, 141, 9, 28, 55, 31, 112, 107, 85, 100, 175, 23, 57, 47, 38, 170, 137, 76, 147, 93, 19, 98, 124, 39, 87, 174, 144, 46, 10, 129, 69, 71, 125, 96, 116, 171, 128, 65, 102, 5, 43, 143, 104, 13, 67, 29, 3, 113, 32, 165.

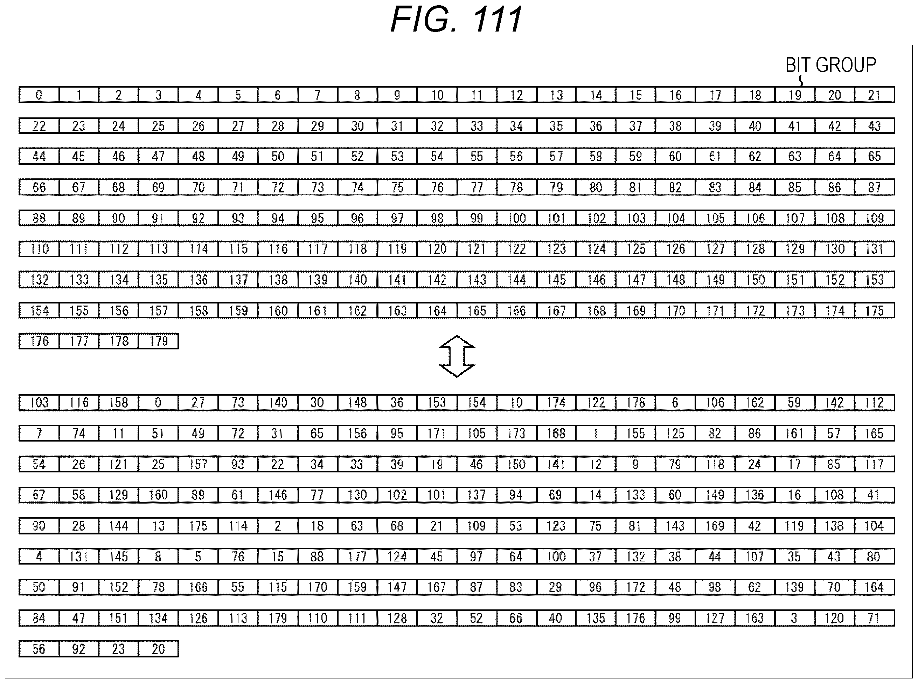

Fig. 111 is a diagram showing a third example of a GW pattern for an LDPC code having a code length N of 64k bits.

According to the GW pattern shown in Fig. 111, arrangement of bit groups from 0 to 179 of the 64k-bit LDPC code is interleaved to arrangement of 103, 116, 158, 0, 27, 73, 140, 30, 148, 36, 153, 154, 10, 174, 122, 178, 6, 106, 162, 59, 142, 112, 7, 74, 11, 51, 49, 72, 31, 65, 156, 95, 171, 105, 173, 168, 1, 155, 125, 82, 86, 161, 57, 165, 54, 26, 121, 25, 157, 93, 22, 34, 33, 39, 19, 46, 150, 141, 12, 9, 79, 118, 24, 17, 85, 117, 67, 58, 129, 160, 89, 61, 146, 77, 130, 102, 101, 137, 94, 69, 14, 133, 60, 149, 136, 16, 108, 41, 90, 28, 144, 13, 175, 114, 2, 18, 63, 68, 21, 109, 53, 123, 75, 81, 143, 169, 42, 119, 138, 104, 4, 131, 145, 8, 5, 76, 15, 88, 177, 124, 45, 97, 64, 100, 37, 132, 38, 44, 107, 35, 43, 80, 50, 91, 152, 78, 166, 55, 115, 170, 159, 147, 167, 87, 83, 29, 96, 172, 48, 98, 62, 139, 70, 164, 84, 47, 151, 134, 126, 113, 179, 110, 111, 128, 32, 52, 66, 40, 135, 176, 99, 127, 163, 3, 120, 71, 56, 92, 23, 20.

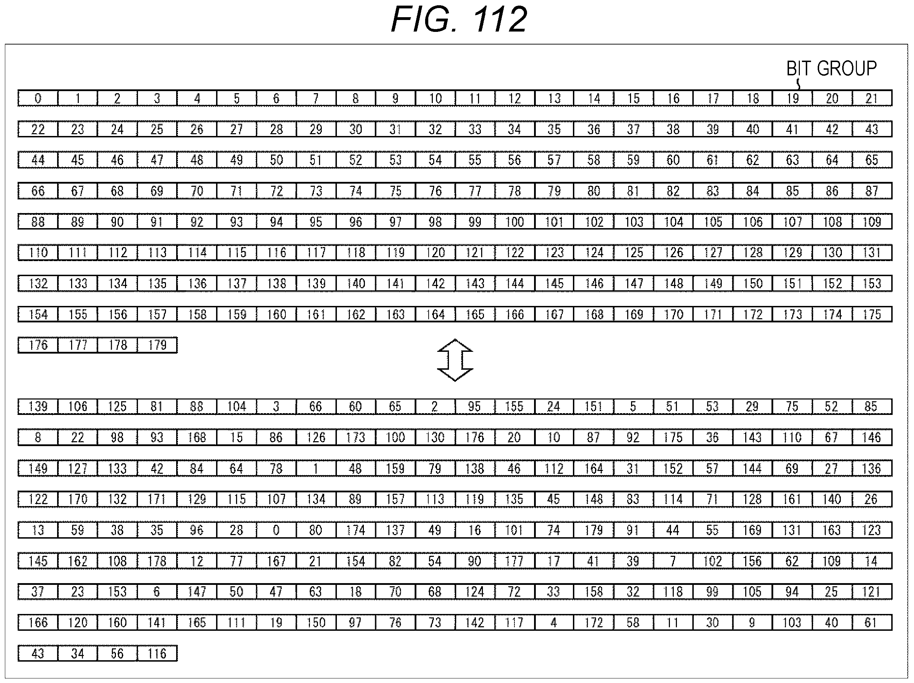

Fig. 112 is a diagram showing a fourth example of a GW pattern for an LDPC code having a code length N of 64k bits.

According to the GW pattern shown in Fig. 112, arrangement of bit groups from 0 to 179 of the 64k-bit LDPC code is interleaved to arrangement of 139, 106, 125, 81, 88, 104, 3, 66, 60, 65, 2, 95, 155, 24, 151, 5, 51, 53, 29, 75, 52, 85, 8, 22, 98, 93, 168, 15, 86, 126, 173, 100, 130, 176, 20, 10, 87, 92, 175, 36, 143, 110, 67, 146, 149, 127, 133, 42, 84, 64, 78, 1, 48, 159, 79, 138, 46, 112, 164, 31, 152, 57, 144, 69, 27, 136, 122, 170, 132, 171, 129, 115, 107, 134, 89, 157, 113, 119, 135, 45, 148, 83, 114, 71, 128, 161, 140, 26, 13, 59, 38, 35, 96, 28, 0, 80, 174, 137, 49, 16, 101, 74, 179, 91, 44, 55, 169, 131, 163, 123, 145, 162, 108, 178, 12, 77, 167, 21, 154, 82, 54, 90, 177, 17, 41, 39, 7, 102, 156, 62, 109, 14, 37, 23, 153, 6, 147, 50, 47, 63, 18, 70, 68, 124, 72, 33, 158, 32, 118, 99, 105, 94, 25, 121, 166, 120, 160, 141, 165, 111, 19, 150, 97, 76, 73, 142, 117, 4, 172, 58, 11, 30, 9, 103, 40, 61, 43, 34, 56, 116.

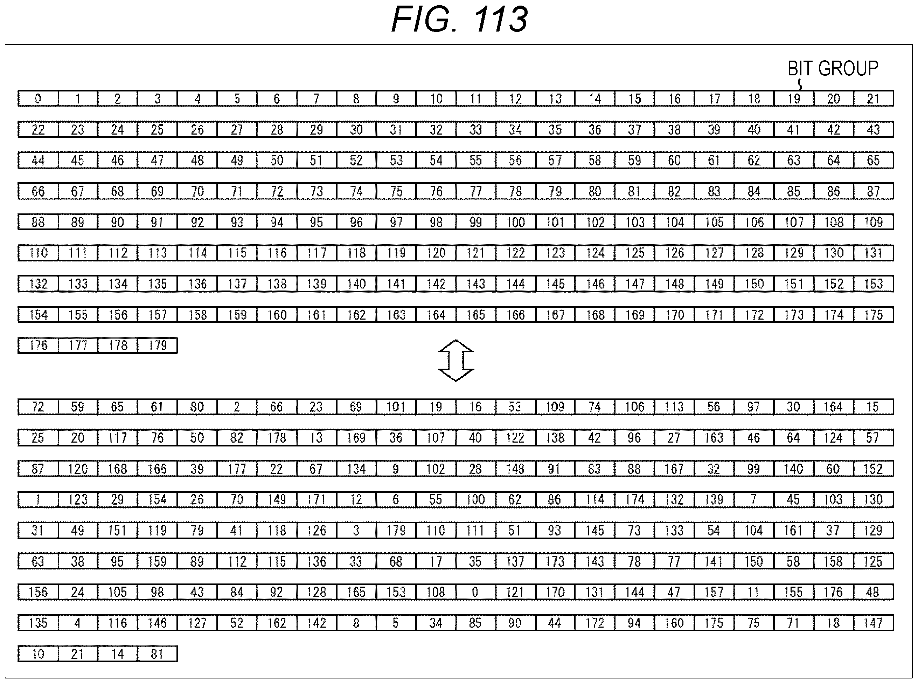

Fig. 113 is a diagram showing a fifth example of a GW pattern for an LDPC code having a code length N of 64k bits.

According to the GW pattern shown in Fig. 113, arrangement of bit groups from 0 to 179 of the 64k-bit LDPC code is interleaved to arrangement of 72, 59, 65, 61, 80, 2, 66, 23, 69, 101, 19, 16, 53, 109, 74, 106, 113, 56, 97, 30, 164, 15, 25, 20, 117, 76, 50, 82, 178, 13, 169, 36, 107, 40, 122, 138, 42, 96, 27, 163, 46, 64, 124, 57, 87, 120, 168, 166, 39, 177, 22, 67, 134, 9, 102, 28, 148, 91, 83, 88, 167, 32, 99, 140, 60, 152, 1, 123, 29, 154, 26, 70, 149, 171, 12, 6, 55, 100, 62, 86, 114, 174, 132, 139, 7, 45, 103, 130, 31, 49, 151, 119, 79, 41, 118, 126, 3, 179, 110, 111, 51, 93, 145, 73, 133, 54, 104, 161, 37, 129, 63, 38, 95, 159, 89, 112, 115, 136, 33, 68, 17, 35, 137, 173, 143, 78, 77, 141, 150, 58, 158, 125, 156, 24, 105, 98, 43, 84, 92, 128, 165, 153, 108, 0, 121, 170, 131, 144, 47, 157, 11, 155, 176, 48, 135, 4, 116, 146, 127, 52, 162, 142, 8, 5, 34, 85, 90, 44, 172, 94, 160, 175, 75, 71, 18, 147, 10, 21, 14, 81.

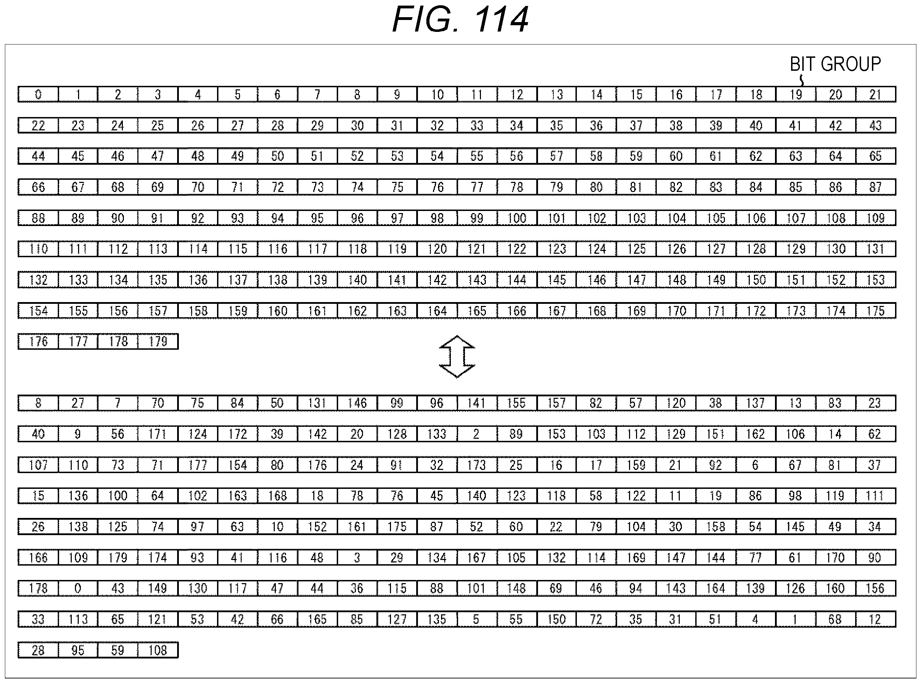

Fig. 114 is a diagram showing a sixth example of a GW pattern for an LDPC code having a code length N of 64k bits.

According to the GW pattern shown in Fig. 114, arrangement of bit groups from 0 to 179 of the 64k-bit LDPC code is interleaved to arrangement of 8, 27, 7, 70, 75, 84, 50, 131, 146, 99, 96, 141, 155, 157, 82, 57, 120, 38, 137, 13, 83, 23, 40, 9, 56, 171, 124, 172, 39, 142, 20, 128, 133, 2, 89, 153, 103, 112, 129, 151, 162, 106, 14, 62, 107, 110, 73, 71, 177, 154, 80, 176, 24, 91, 32, 173, 25, 16, 17, 159, 21, 92, 6, 67, 81, 37, 15, 136, 100, 64, 102, 163, 168, 18, 78, 76, 45, 140, 123, 118, 58, 122, 11, 19, 86, 98, 119, 111, 26, 138, 125, 74, 97, 63, 10, 152, 161, 175, 87, 52, 60, 22, 79, 104, 30, 158, 54, 145, 49, 34, 166, 109, 179, 174, 93, 41, 116, 48, 3, 29, 134, 167, 105, 132, 114, 169, 147, 144, 77, 61, 170, 90, 178, 0, 43, 149, 130, 117, 47, 44, 36, 115, 88, 101, 148, 69, 46, 94, 143, 164, 139, 126, 160, 156, 33, 113, 65, 121, 53, 42, 66, 165, 85, 127, 135, 5, 55, 150, 72, 35, 31, 51, 4, 1, 68, 12, 28, 95, 59, 108.

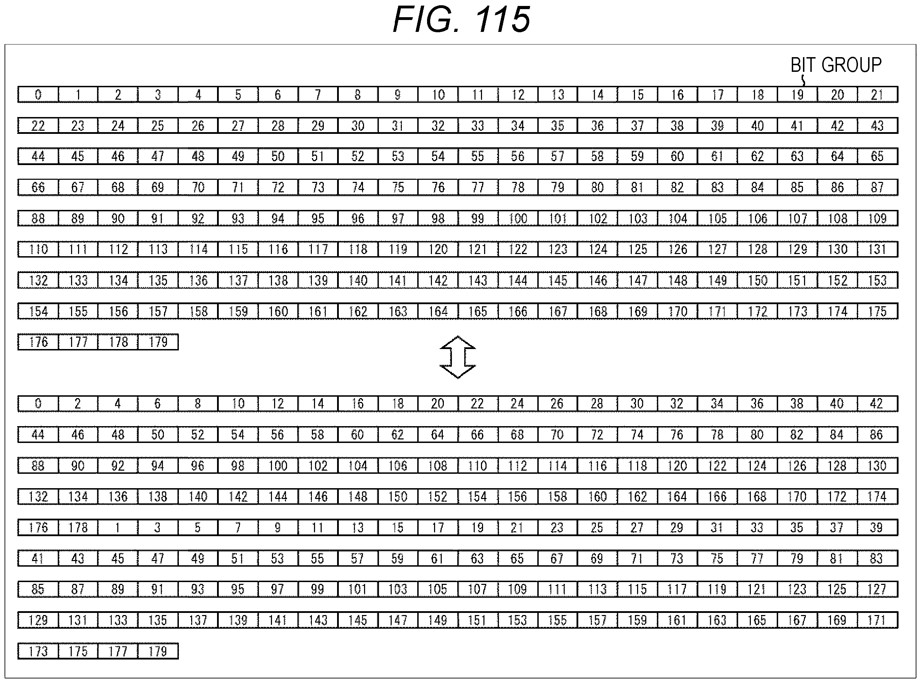

Fig. 115 is a diagram showing a seventh example of a GW pattern for an LDPC code having a code length N of 64k bits.

According to the GW pattern shown in Fig. 115, arrangement of bit groups from 0 to 179 of the 64k-bit LDPC code is interleaved to arrangement of 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

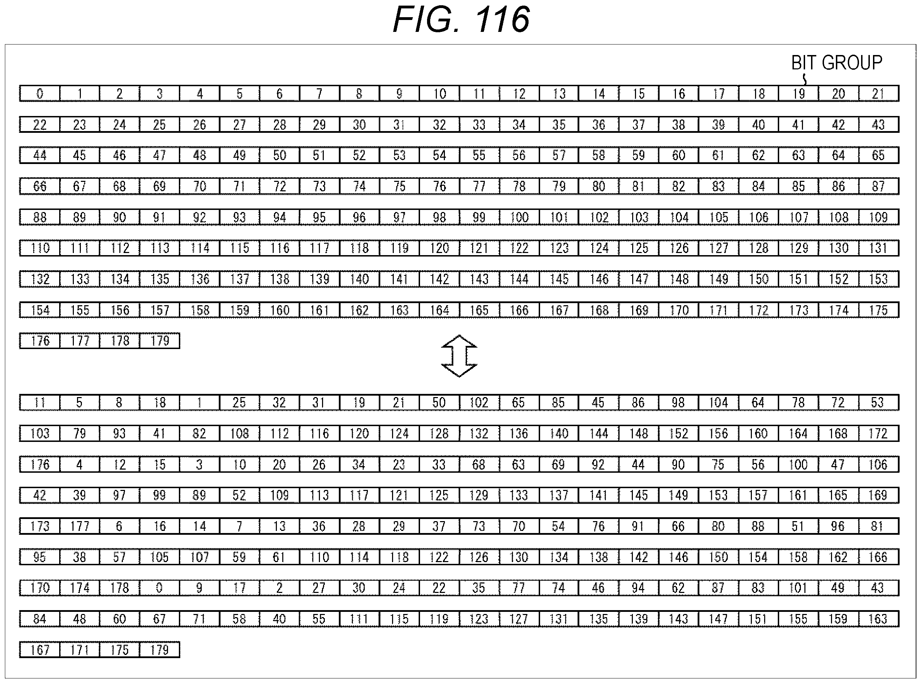

Fig. 116 is a diagram showing an eighth example of a GW pattern for an LDPC code having a code length N of 64k bits.

According to the GW pattern shown in Fig. 116, arrangement of bit groups from 0 to 179 of the 64k-bit LDPC code is interleaved to arrangement of 11, 5, 8, 18, 1, 25, 32, 31, 19, 21, 50, 102, 65, 85, 45, 86, 98, 104, 64, 78, 72, 53, 103, 79, 93, 41, 82, 108, 112, 116, 120, 124, 128, 132, 136, 140, 144, 148, 152, 156, 160, 164, 168, 172, 176, 4, 12, 15, 3, 10, 20, 26, 34, 23, 33, 68, 63, 69, 92, 44, 90, 75, 56, 100, 47, 106, 42, 39, 97, 99, 89, 52, 109, 113, 117, 121, 125, 129, 133, 137, 141, 145, 149, 153, 157, 161, 165, 169, 173, 177, 6, 16, 14, 7, 13, 36, 28, 29, 37, 73, 70, 54, 76, 91, 66, 80, 88, 51, 96, 81, 95, 38, 57, 105, 107, 59, 61, 110, 114, 118, 122, 126, 130, 134, 138, 142, 146, 150, 154, 158, 162, 166, 170, 174, 178, 0, 9, 17, 2, 27, 30, 24, 22, 35, 77, 74, 46, 94, 62, 87, 83, 101, 49, 43, 84, 48, 60, 67, 71, 58, 40, 55, 111, 115, 119, 123, 127, 131, 135, 139, 143, 147, 151, 155, 159, 163, 167, 171, 175, 179.

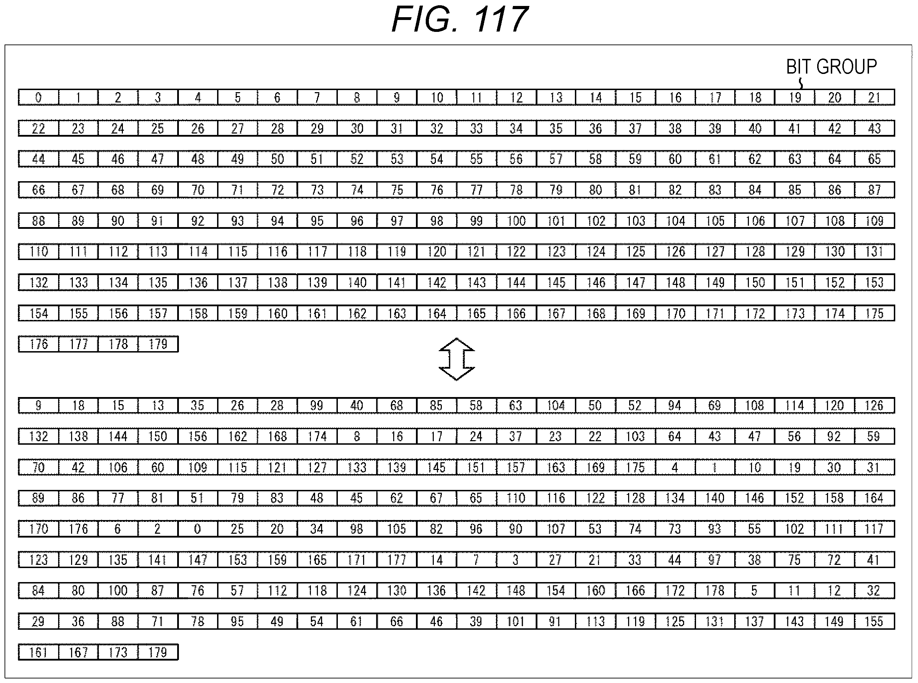

Fig. 117 is a diagram showing a ninth example of a GW pattern for an LDPC code having a code length N of 64k bits.

According to the GW pattern shown in Fig. 117, arrangement of bit groups from 0 to 179 of the 64k-bit LDPC code is interleaved to arrangement of 9, 18, 15, 13, 35, 26, 28, 99, 40, 68, 85, 58, 63, 104, 50, 52, 94, 69, 108, 114, 120, 126, 132, 138, 144, 150, 156, 162, 168, 174, 8, 16, 17, 24, 37, 23, 22, 103, 64, 43, 47, 56, 92, 59, 70, 42, 106, 60, 109, 115, 121, 127, 133, 139, 145, 151, 157, 163, 169, 175, 4, 1, 10, 19, 30, 31, 89, 86, 77, 81, 51, 79, 83, 48, 45, 62, 67, 65, 110, 116, 122, 128, 134, 140, 146, 152, 158, 164, 170, 176, 6, 2, 0, 25, 20, 34, 98, 105, 82, 96, 90, 107, 53, 74, 73, 93, 55, 102, 111, 117, 123, 129, 135, 141, 147, 153, 159, 165, 171, 177, 14, 7, 3, 27, 21, 33, 44, 97, 38, 75, 72, 41, 84, 80, 100, 87, 76, 57, 112, 118, 124, 130, 136, 142, 148, 154, 160, 166, 172, 178, 5, 11, 12, 32, 29, 36, 88, 71, 78, 95, 49, 54, 61, 66, 46, 39, 101, 91, 113, 119, 125, 131, 137, 143, 149, 155, 161, 167, 173, 179.

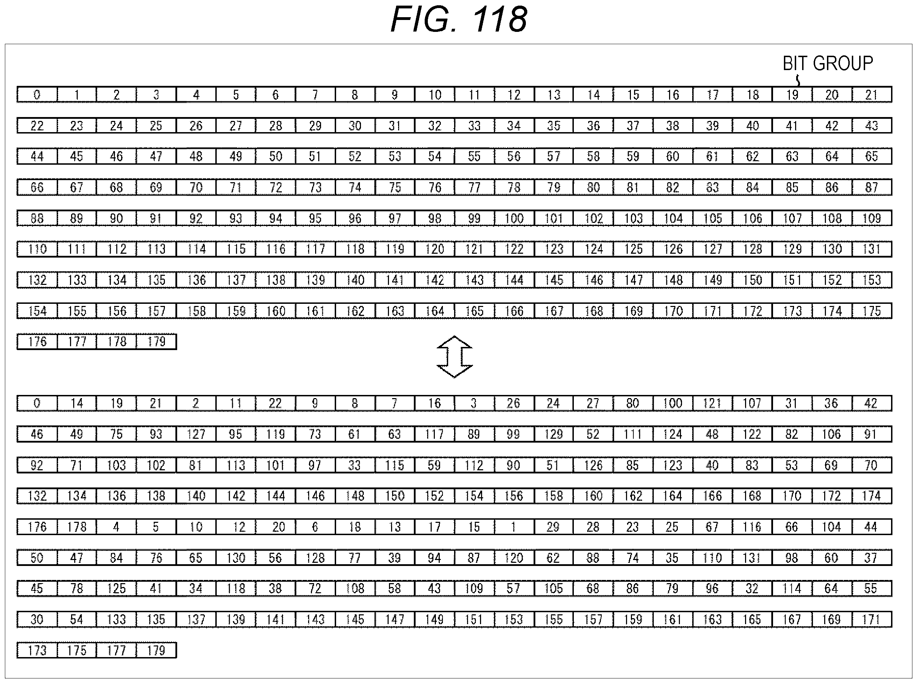

Fig. 118 is a diagram showing a tenth example of a GW pattern for an LDPC code having a code length N of 64k bits.

According to the GW pattern shown in Fig. 118, arrangement of bit groups from 0 to 179 of the 64k-bit LDPC code is interleaved to arrangement of 0, 14, 19, 21, 2, 11, 22, 9, 8, 7, 16, 3, 26, 24, 27, 80, 100, 121, 107, 31, 36, 42, 46, 49, 75, 93, 127, 95, 119, 73, 61, 63, 117, 89, 99, 129, 52, 111, 124, 48, 122, 82, 106, 91, 92, 71, 103, 102, 81, 113, 101, 97, 33, 115, 59, 112, 90, 51, 126, 85, 123, 40, 83, 53, 69, 70, 132, 134, 136, 138, 140, 142, 144, 146, 148, 150, 152, 154, 156, 158, 160, 162, 164, 166, 168, 170, 172, 174, 176, 178, 4, 5, 10, 12, 20, 6, 18, 13, 17, 15, 1, 29, 28, 23, 25, 67, 116, 66, 104, 44, 50, 47, 84, 76, 65, 130, 56, 128, 77, 39, 94, 87, 120, 62, 88, 74, 35, 110, 131, 98, 60, 37, 45, 78, 125, 41, 34, 118, 38, 72, 108, 58, 43, 109, 57, 105, 68, 86, 79, 96, 32, 114, 64, 55, 30, 54, 133, 135, 137, 139, 141, 143, 145, 147, 149, 151, 153, 155, 157, 159, 161, 163, 165, 167, 169, 171, 173, 175, 177, 179.

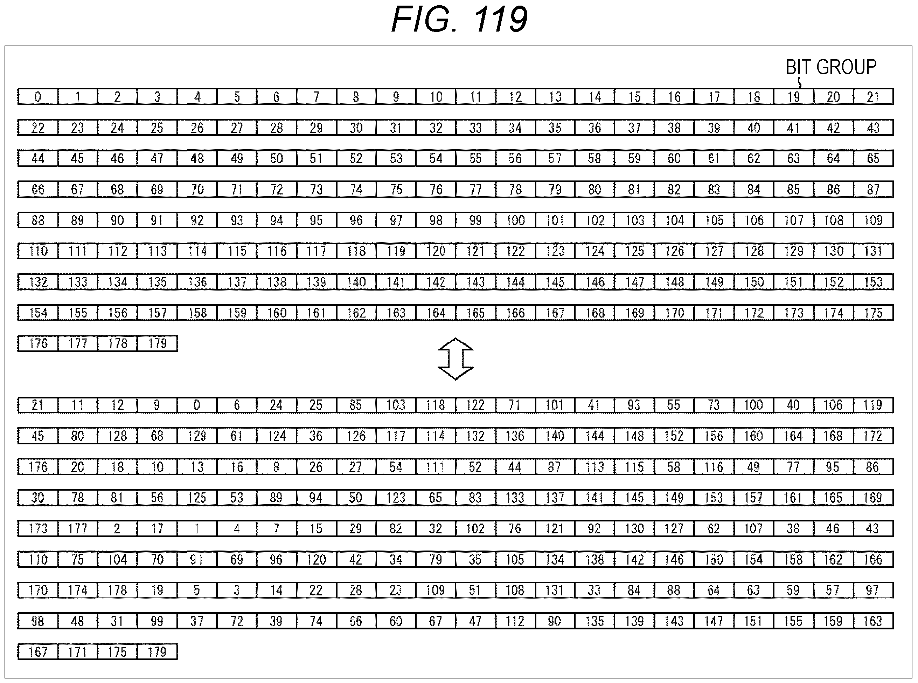

Fig. 119 is a diagram showing an eleventh example of a GW pattern for an LDPC code having a code length N of 64k bits.

According to the GW pattern shown in Fig. 119, arrangement of bit groups from 0 to 179 of the 64k-bit LDPC code is interleaved to arrangement of 21, 11, 12, 9, 0, 6, 24, 25, 85, 103, 118, 122, 71, 101, 41, 93, 55, 73, 100, 40, 106, 119, 45, 80, 128, 68, 129, 61, 124, 36, 126, 117, 114, 132, 136, 140, 144, 148, 152, 156, 160, 164, 168, 172, 176, 20, 18, 10, 13, 16, 8, 26, 27, 54, 111, 52, 44, 87, 113, 115, 58, 116, 49, 77, 95, 86, 30, 78, 81, 56, 125, 53, 89, 94, 50, 123, 65, 83, 133, 137, 141, 145, 149, 153, 157, 161, 165, 169, 173, 177, 2, 17, 1, 4, 7, 15, 29, 82, 32, 102, 76, 121, 92, 130, 127, 62, 107, 38, 46, 43, 110, 75, 104, 70, 91, 69, 96, 120, 42, 34, 79, 35, 105, 134, 138, 142, 146, 150, 154, 158, 162, 166, 170, 174, 178, 19, 5, 3, 14, 22, 28, 23, 109, 51, 108, 131, 33, 84, 88, 64, 63, 59, 57, 97, 98, 48, 31, 99, 37, 72, 39, 74, 66, 60, 67, 47, 112, 90, 135, 139, 143, 147, 151, 155, 159, 163, 167, 171, 175, 179.

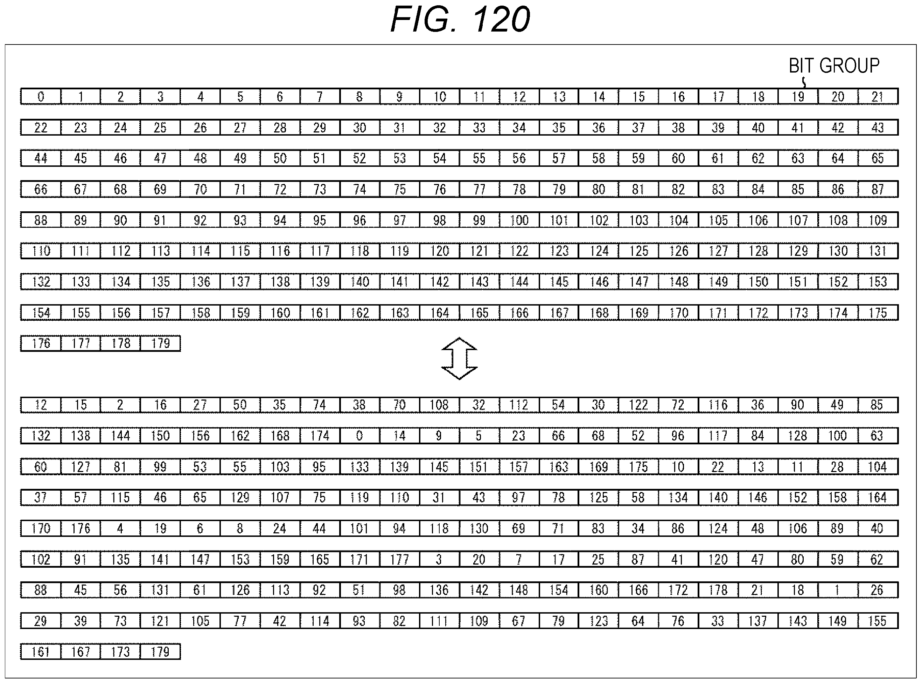

Fig. 120 is a diagram showing a twelfth example of a GW pattern for an LDPC code having a code length N of 64k bits.

According to the GW pattern shown in Fig. 120, arrangement of bit groups from 0 to 179 of the 64k-bit LDPC code is interleaved to arrangement of 12, 15, 2, 16, 27, 50, 35, 74, 38, 70, 108, 32, 112, 54, 30, 122, 72, 116, 36, 90, 49, 85, 132, 138, 144, 150, 156, 162, 168, 174, 0, 14, 9, 5, 23, 66, 68, 52, 96, 117, 84, 128, 100, 63, 60, 127, 81, 99, 53, 55, 103, 95, 133, 139, 145, 151, 157, 163, 169, 175, 10, 22, 13, 11, 28, 104, 37, 57, 115, 46, 65, 129, 107, 75, 119, 110, 31, 43, 97, 78, 125, 58, 134, 140, 146, 152, 158, 164, 170, 176, 4, 19, 6, 8, 24, 44, 101, 94, 118, 130, 69, 71, 83, 34, 86, 124, 48, 106, 89, 40, 102, 91, 135, 141, 147, 153, 159, 165, 171, 177, 3, 20, 7, 17, 25, 87, 41, 120, 47, 80, 59, 62, 88, 45, 56, 131, 61, 126, 113, 92, 51, 98, 136, 142, 148, 154, 160, 166, 172, 178, 21, 18, 1, 26, 29, 39, 73, 121, 105, 77, 42, 114, 93, 82, 111, 109, 67, 79, 123, 64, 76, 33, 137, 143, 149, 155, 161, 167, 173, 179.

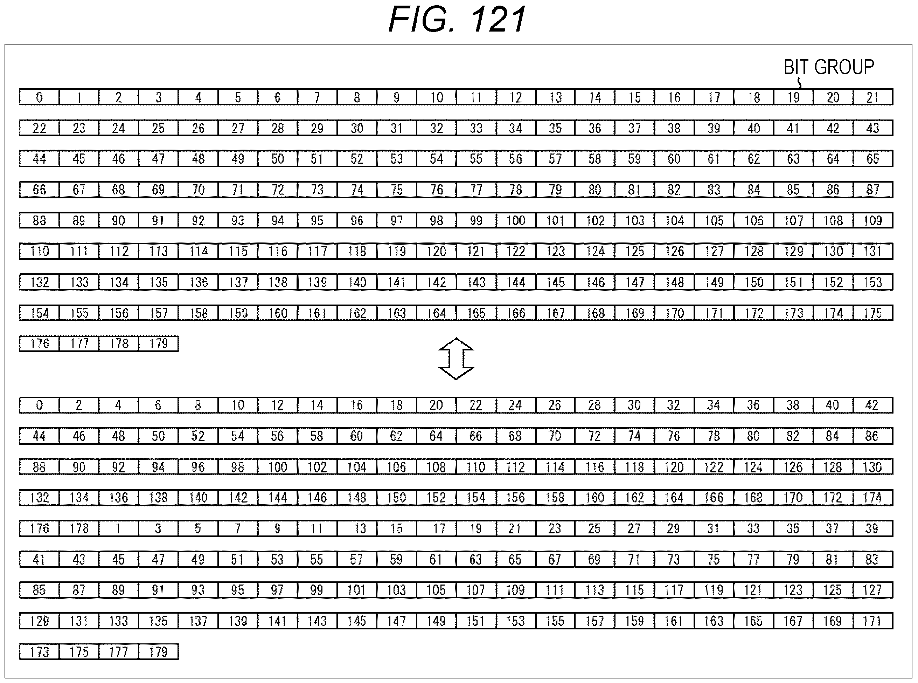

Fig. 121 is a diagram showing a thirteenth example of a GW pattern for an LDPC code having a code length N of 64k bits.

According to the GW pattern shown in Fig. 121, arrangement of bit groups from 0 to 179 of the 64k-bit LDPC code is interleaved to arrangement of 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

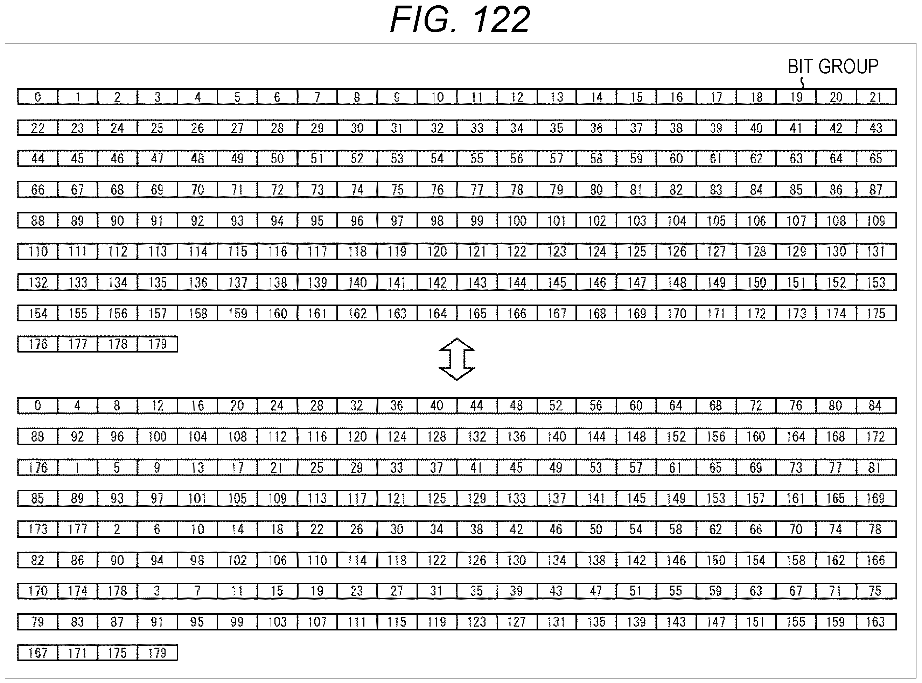

Fig. 122 is a diagram showing a fourteenth example of a GW pattern for an LDPC code having a code length N of 64k bits.

According to the GW pattern shown in Fig. 122, arrangement of bit groups from 0 to 179 of the 64k-bit LDPC code is interleaved to arrangement of 0, 4, 8, 12, 16, 20, 24, 28, 32, 36, 40, 44, 48, 52, 56, 60, 64, 68, 72, 76, 80, 84, 88, 92, 96, 100, 104, 108, 112, 116, 120, 124, 128, 132, 136, 140, 144, 148, 152, 156, 160, 164, 168, 172, 176, 1, 5, 9, 13, 17, 21, 25, 29, 33, 37, 41, 45, 49, 53, 57, 61, 65, 69, 73, 77, 81, 85, 89, 93, 97, 101, 105, 109, 113, 117, 121, 125, 129, 133, 137, 141, 145, 149, 153, 157, 161, 165, 169, 173, 177, 2, 6, 10, 14, 18, 22, 26, 30, 34, 38, 42, 46, 50, 54, 58, 62, 66, 70, 74, 78, 82, 86, 90, 94, 98, 102, 106, 110, 114, 118, 122, 126, 130, 134, 138, 142, 146, 150, 154, 158, 162, 166, 170, 174, 178, 3, 7, 11, 15, 19, 23, 27, 31, 35, 39, 43, 47, 51, 55, 59, 63, 67, 71, 75, 79, 83, 87, 91, 95, 99, 103, 107, 111, 115, 119, 123, 127, 131, 135, 139, 143, 147, 151, 155, 159, 163, 167, 171, 175, 179.

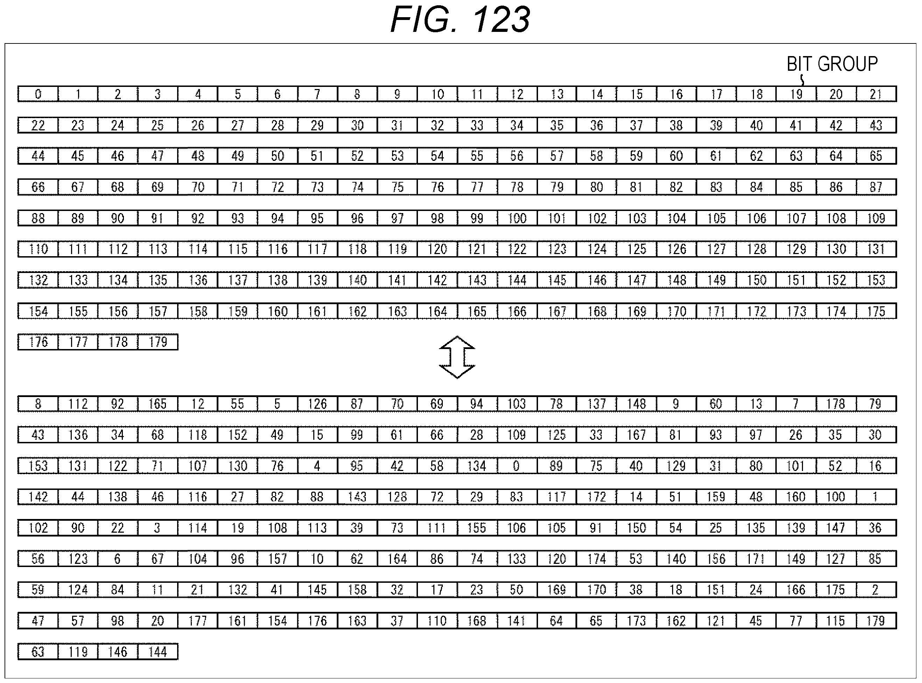

Fig. 123 is a diagram showing a fifteenth example of a GW pattern for an LDPC code having a code length N of 64k bits.

According to the GW pattern shown in Fig. 123, arrangement of bit groups from 0 to 179 of the 64k-bit LDPC code is interleaved to arrangement of 8, 112, 92, 165, 12, 55, 5, 126, 87, 70, 69, 94, 103, 78, 137, 148, 9, 60, 13, 7, 178, 79, 43, 136, 34, 68, 118, 152, 49, 15, 99, 61, 66, 28, 109, 125, 33, 167, 81, 93, 97, 26, 35, 30, 153, 131, 122, 71, 107, 130, 76, 4, 95, 42, 58, 134, 0, 89, 75, 40, 129, 31, 80, 101, 52, 16, 142, 44, 138, 46, 116, 27, 82, 88, 143, 128, 72, 29, 83, 117, 172, 14, 51, 159, 48, 160, 100, 1, 102, 90, 22, 3, 114, 19, 108, 113, 39, 73, 111, 155, 106, 105, 91, 150, 54, 25, 135, 139, 147, 36, 56, 123, 6, 67, 104, 96, 157, 10, 62, 164, 86, 74, 133, 120, 174, 53, 140, 156, 171, 149, 127, 85, 59, 124, 84, 11, 21, 132, 41, 145, 158, 32, 17, 23, 50, 169, 170, 38, 18, 151, 24, 166, 175, 2, 47, 57, 98, 20, 177, 161, 154, 176, 163, 37, 110, 168, 141, 64, 65, 173, 162, 121, 45, 77, 115, 179, 63, 119, 146, 144.

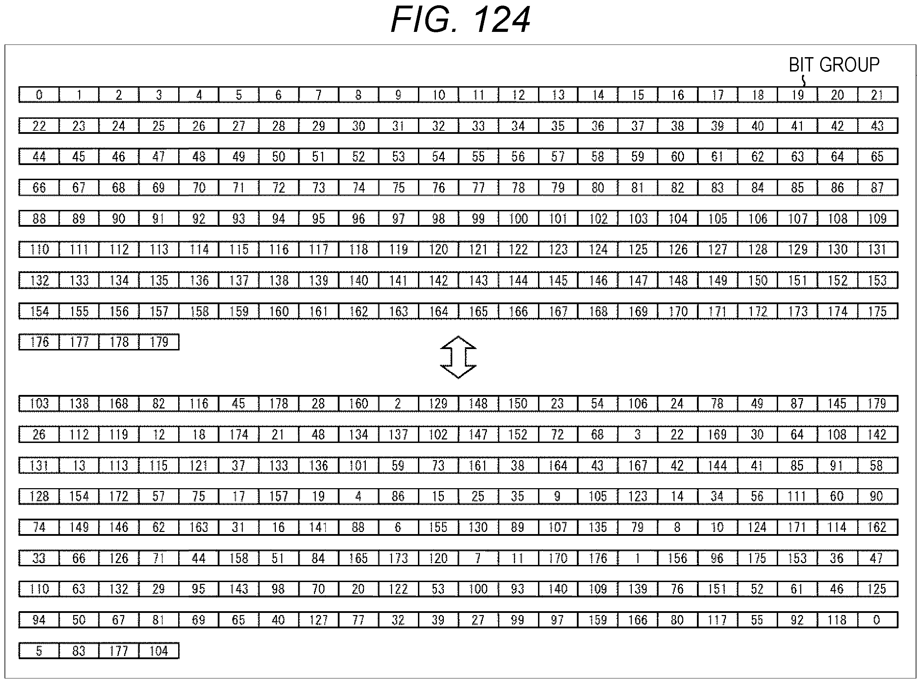

Fig. 124 is a diagram showing a sixteenth example of a GW pattern for an LDPC code having a code length N of 64k bits.

According to the GW pattern shown in Fig. 124, arrangement of bit groups from 0 to 179 of the 64k-bit LDPC code is interleaved to arrangement of 103, 138, 168, 82, 116, 45, 178, 28, 160, 2, 129, 148, 150, 23, 54, 106, 24, 78, 49, 87, 145, 179, 26, 112, 119, 12, 18, 174, 21, 48, 134, 137, 102, 147, 152, 72, 68, 3, 22, 169, 30, 64, 108, 142, 131, 13, 113, 115, 121, 37, 133, 136, 101, 59, 73, 161, 38, 164, 43, 167, 42, 144, 41, 85, 91, 58, 128, 154, 172, 57, 75, 17, 157, 19, 4, 86, 15, 25, 35, 9, 105, 123, 14, 34, 56, 111, 60, 90, 74, 149, 146, 62, 163, 31, 16, 141, 88, 6, 155, 130, 89, 107, 135, 79, 8, 10, 124, 171, 114, 162, 33, 66, 126, 71, 44, 158, 51, 84, 165, 173, 120, 7, 11, 170, 176, 1, 156, 96, 175, 153, 36, 47, 110, 63, 132, 29, 95, 143, 98, 70, 20, 122, 53, 100, 93, 140, 109, 139, 76, 151, 52, 61, 46, 125, 94, 50, 67, 81, 69, 65, 40, 127, 77, 32, 39, 27, 99, 97, 159, 166, 80, 117, 55, 92, 118, 0, 5, 83, 177, 104.

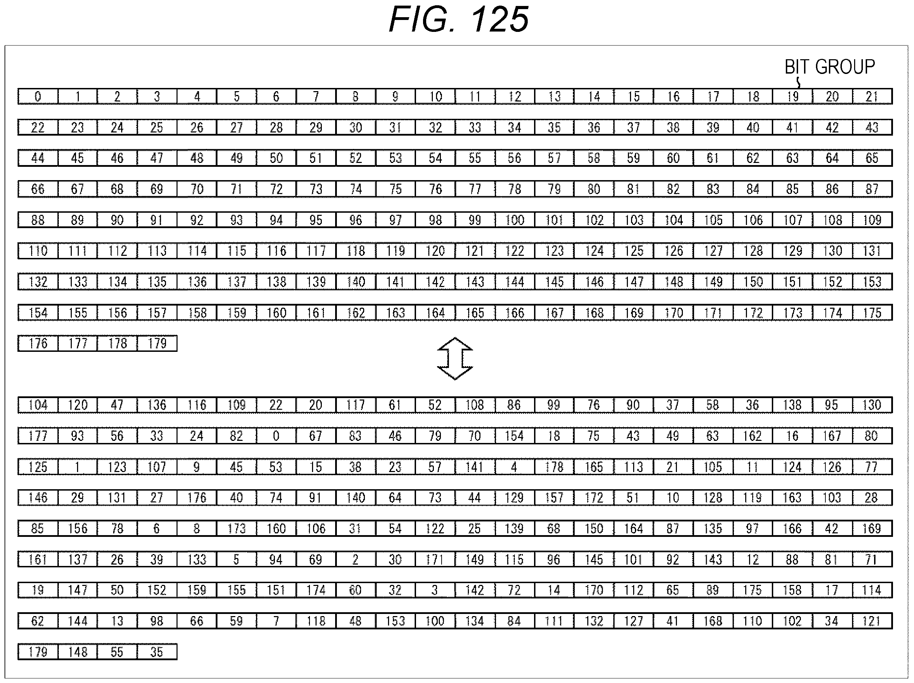

Fig. 125 is a diagram showing a seventeenth example of a GW pattern for an LDPC code having a code length N of 64k bits.

According to the GW pattern shown in Fig. 125, arrangement of bit groups from 0 to 179 of the 64k-bit LDPC code is interleaved to arrangement of 104, 120, 47, 136, 116, 109, 22, 20, 117, 61, 52, 108, 86, 99, 76, 90, 37, 58, 36, 138, 95, 130, 177, 93, 56, 33, 24, 82, 0, 67, 83, 46, 79, 70, 154, 18, 75, 43, 49, 63, 162, 16, 167, 80, 125, 1, 123, 107, 9, 45, 53, 15, 38, 23, 57, 141, 4, 178, 165, 113, 21, 105, 11, 124, 126, 77, 146, 29, 131, 27, 176, 40, 74, 91, 140, 64, 73, 44, 129, 157, 172, 51, 10, 128, 119, 163, 103, 28, 85, 156, 78, 6, 8, 173, 160, 106, 31, 54, 122, 25, 139, 68, 150, 164, 87, 135, 97, 166, 42, 169, 161, 137, 26, 39, 133, 5, 94, 69, 2, 30, 171, 149, 115, 96, 145, 101, 92, 143, 12, 88, 81, 71, 19, 147, 50, 152, 159, 155, 151, 174, 60, 32, 3, 142, 72, 14, 170, 112, 65, 89, 175, 158, 17, 114, 62, 144, 13, 98, 66, 59, 7, 118, 48, 153, 100, 134, 84, 111, 132, 127, 41, 168, 110, 102, 34, 121, 179, 148, 55, 35.

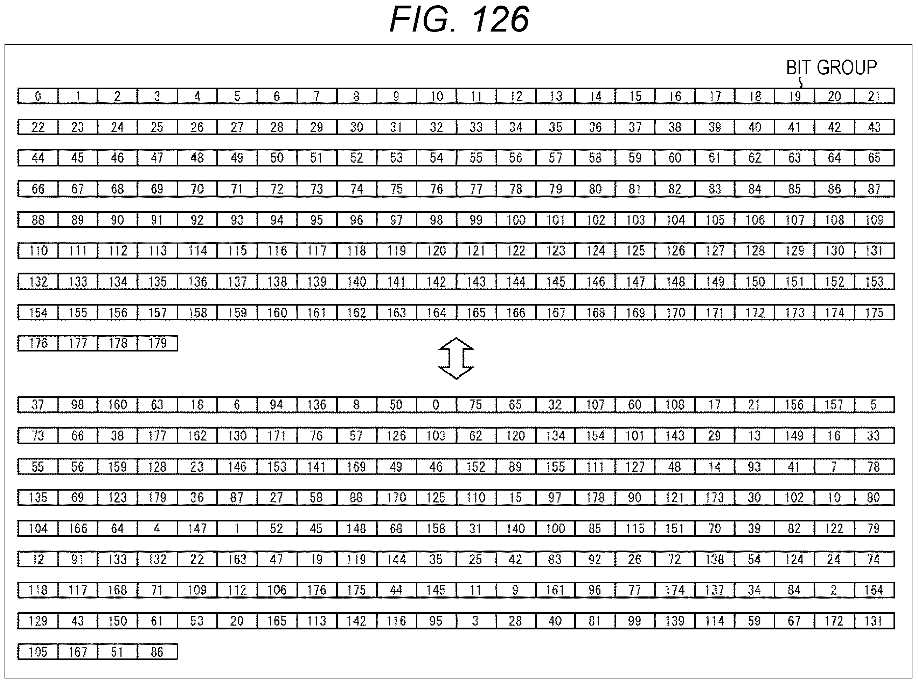

Fig. 126 is a diagram showing an eighteenth example of a GW pattern for an LDPC code having a code length N of 64k bits.

According to the GW pattern shown in Fig. 126, arrangement of bit groups from 0 to 179 of the 64k-bit LDPC code is interleaved to arrangement of 37, 98, 160, 63, 18, 6, 94, 136, 8, 50, 0, 75, 65, 32, 107, 60, 108, 17, 21, 156, 157, 5, 73, 66, 38, 177, 162, 130, 171, 76, 57, 126, 103, 62, 120, 134, 154, 101, 143, 29, 13, 149, 16, 33, 55, 56, 159, 128, 23, 146, 153, 141, 169, 49, 46, 152, 89, 155, 111, 127, 48, 14, 93, 41, 7, 78, 135, 69, 123, 179, 36, 87, 27, 58, 88, 170, 125, 110, 15, 97, 178, 90, 121, 173, 30, 102, 10, 80, 104, 166, 64, 4, 147, 1, 52, 45, 148, 68, 158, 31, 140, 100, 85, 115, 151, 70, 39, 82, 122, 79, 12, 91, 133, 132, 22, 163, 47, 19, 119, 144, 35, 25, 42, 83, 92, 26, 72, 138, 54, 124, 24, 74, 118, 117, 168, 71, 109, 112, 106, 176, 175, 44, 145, 11, 9, 161, 96, 77, 174, 137, 34, 84, 2, 164, 129, 43, 150, 61, 53, 20, 165, 113, 142, 116, 95, 3, 28, 40, 81, 99, 139, 114, 59, 67, 172, 131, 105, 167, 51, 86.

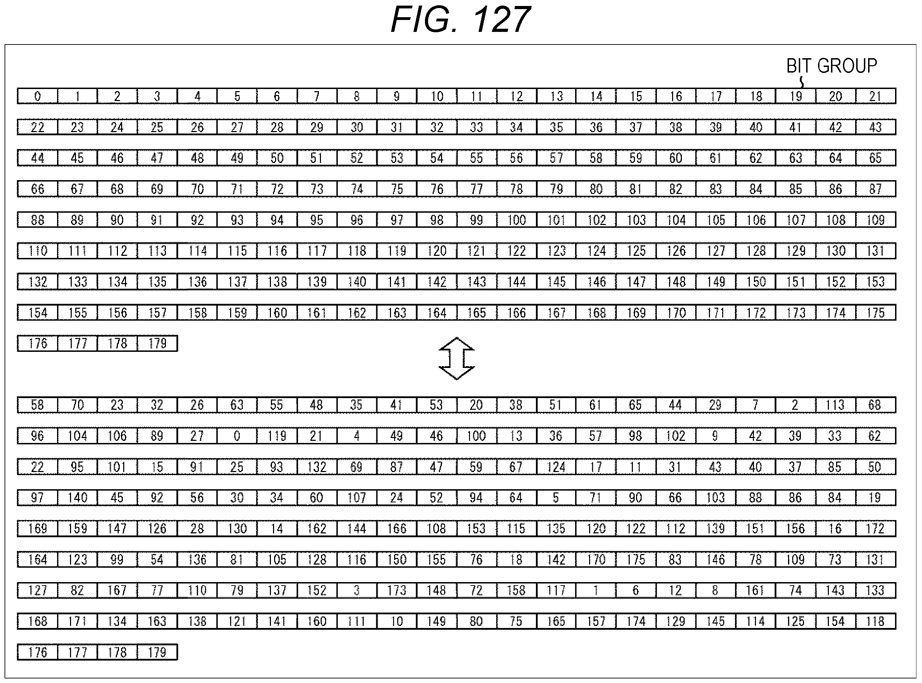

Fig. 127 is a diagram showing a nineteenth example of a GW pattern for an LDPC code having a code length N of 64k bits.

According to the GW pattern shown in Fig. 127, arrangement of bit groups from 0 to 179 of the 64k-bit LDPC code is interleaved to arrangement of 58, 70, 23, 32, 26, 63, 55, 48, 35, 41, 53, 20, 38, 51, 61, 65, 44, 29, 7, 2, 113, 68, 96, 104, 106, 89, 27, 0, 119, 21, 4, 49, 46, 100, 13, 36, 57, 98, 102, 9, 42, 39, 33, 62, 22, 95, 101, 15, 91, 25, 93, 132, 69, 87, 47, 59, 67, 124, 17, 11, 31, 43, 40, 37, 85, 50, 97, 140, 45, 92, 56, 30, 34, 60, 107, 24, 52, 94, 64, 5, 71, 90, 66, 103, 88, 86, 84, 19, 169, 159, 147, 126, 28, 130, 14, 162, 144, 166, 108, 153, 115, 135, 120, 122, 112, 139, 151, 156, 16, 172, 164, 123, 99, 54, 136, 81, 105, 128, 116, 150, 155, 76, 18, 142, 170, 175, 83, 146, 78, 109, 73, 131, 127, 82, 167, 77, 110, 79, 137, 152, 3, 173, 148, 72, 158, 117, 1, 6, 12, 8, 161, 74, 143, 133, 168, 171, 134, 163, 138, 121, 141, 160, 111, 10, 149, 80, 75, 165, 157, 174, 129, 145, 114, 125, 154, 118, 176, 177, 178, 179.

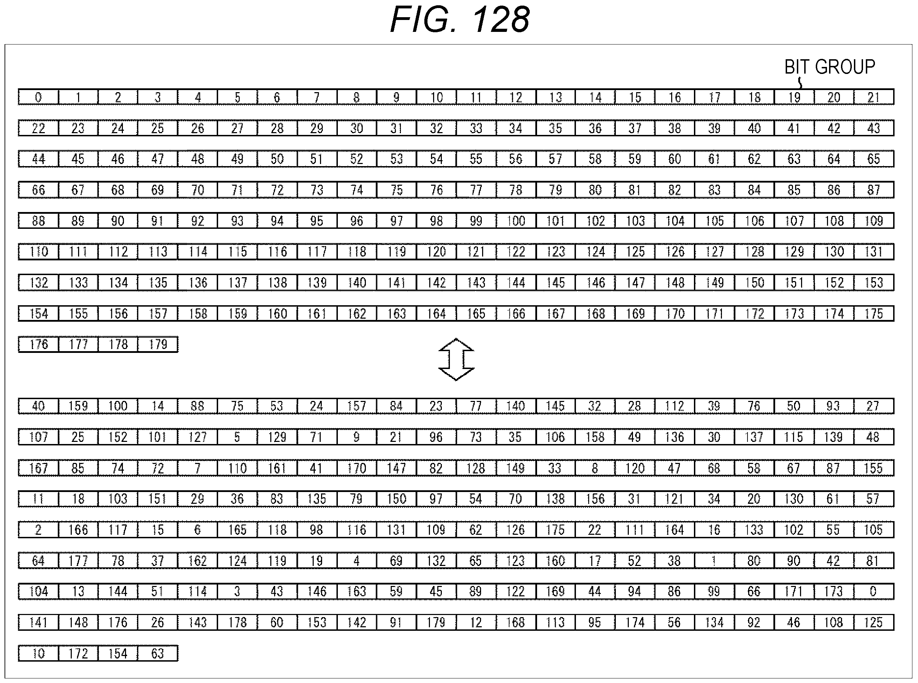

Fig. 128 is a diagram showing a twentieth example of a GW pattern for an LDPC code having a code length N of 64k bits.

According to the GW pattern shown in Fig. 128, arrangement of bit groups from 0 to 179 of the 64k-bit LDPC code is interleaved to arrangement of 40, 159, 100, 14, 88, 75, 53, 24, 157, 84, 23, 77, 140, 145, 32, 28, 112, 39, 76, 50, 93, 27, 107, 25, 152, 101, 127, 5, 129, 71, 9, 21, 96, 73, 35, 106, 158, 49, 136, 30, 137, 115, 139, 48, 167, 85, 74, 72, 7, 110, 161, 41, 170, 147, 82, 128, 149, 33, 8, 120, 47, 68, 58, 67, 87, 155, 11, 18, 103, 151, 29, 36, 83, 135, 79, 150, 97, 54, 70, 138, 156, 31, 121, 34, 20, 130, 61, 57, 2, 166, 117, 15, 6, 165, 118, 98, 116, 131, 109, 62, 126, 175, 22, 111, 164, 16, 133, 102, 55, 105, 64, 177, 78, 37, 162, 124, 119, 19, 4, 69, 132, 65, 123, 160, 17, 52, 38, 1, 80, 90, 42, 81, 104, 13, 144, 51, 114, 3, 43, 146, 163, 59, 45, 89, 122, 169, 44, 94, 86, 99, 66, 171, 173, 0, 141, 148, 176, 26, 143, 178, 60, 153, 142, 91, 179, 12, 168, 113, 95, 174, 56, 134, 92, 46, 108, 125, 10, 172, 154, 63.

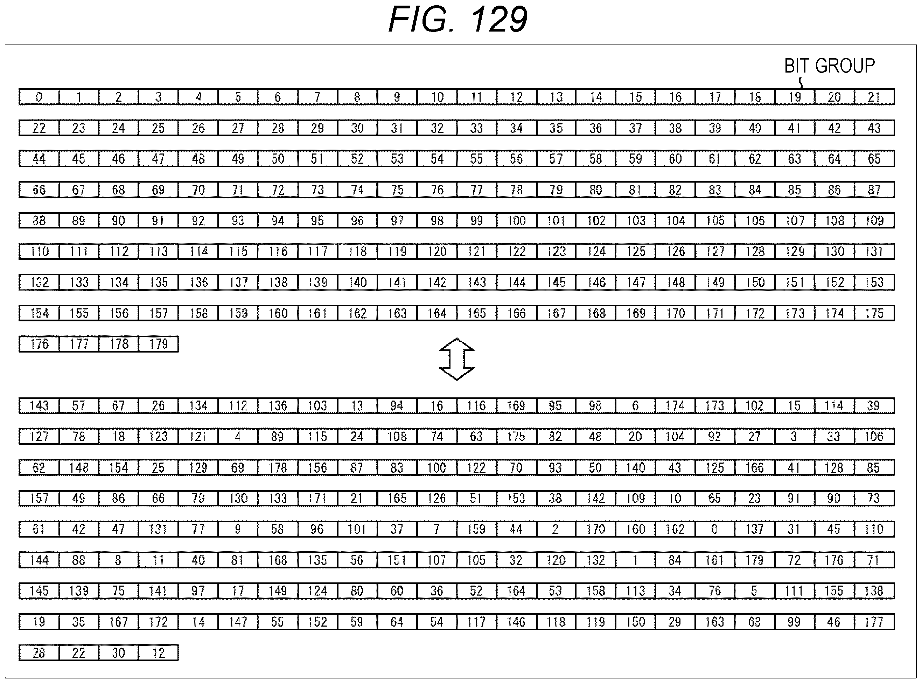

Fig. 129 is a diagram showing a twenty-first example of a GW pattern for an LDPC code having a code length N of 64k bits.

According to the GW pattern shown in Fig. 129, arrangement of bit groups from 0 to 179 of the 64k-bit LDPC code is interleaved to arrangement of 143, 57, 67, 26, 134, 112, 136, 103, 13, 94, 16, 116, 169, 95, 98, 6, 174, 173, 102, 15, 114, 39, 127, 78, 18, 123, 121, 4, 89, 115, 24, 108, 74, 63, 175, 82, 48, 20, 104, 92, 27, 3, 33, 106, 62, 148, 154, 25, 129, 69, 178, 156, 87, 83, 100, 122, 70, 93, 50, 140, 43, 125, 166, 41, 128, 85, 157, 49, 86, 66, 79, 130, 133, 171, 21, 165, 126, 51, 153, 38, 142, 109, 10, 65, 23, 91, 90, 73, 61, 42, 47, 131, 77, 9, 58, 96, 101, 37, 7, 159, 44, 2, 170, 160, 162, 0, 137, 31, 45, 110, 144, 88, 8, 11, 40, 81, 168, 135, 56, 151, 107, 105, 32, 120, 132, 1, 84, 161, 179, 72, 176, 71, 145, 139, 75, 141, 97, 17, 149, 124, 80, 60, 36, 52, 164, 53, 158, 113, 34, 76, 5, 111, 155, 138, 19, 35, 167, 172, 14, 147, 55, 152, 59, 64, 54, 117, 146, 118, 119, 150, 29, 163, 68, 99, 46, 177, 28, 22, 30, 12.

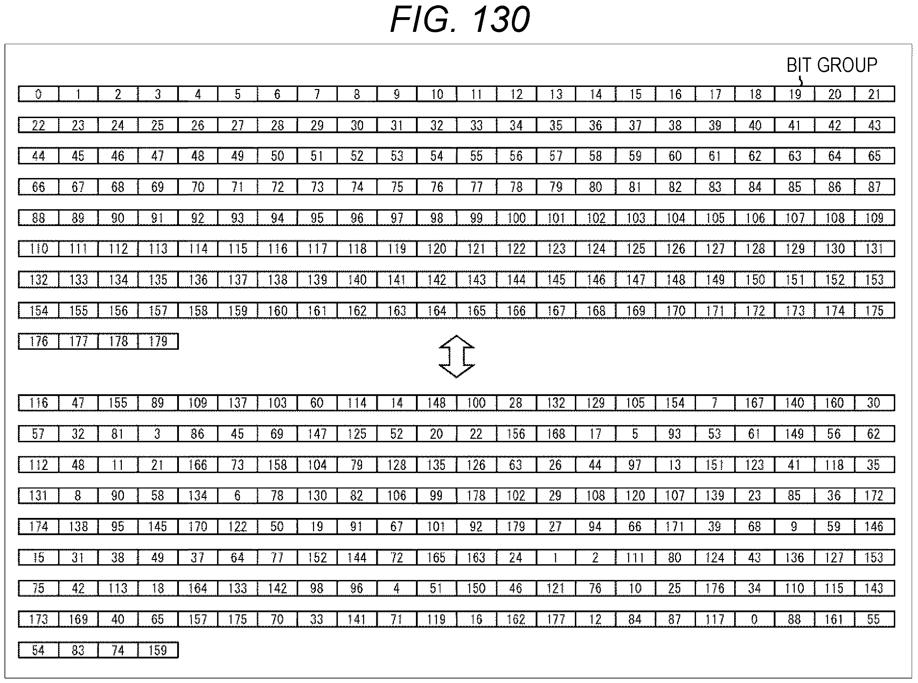

Fig. 130 is a diagram showing a twenty-second example of a GW pattern for an LDPC code having a code length N of 64k bits.

According to the GW pattern shown in Fig. 130, arrangement of bit groups from 0 to 179 of the 64k-bit LDPC code is interleaved to arrangement of 116, 47, 155, 89, 109, 137, 103, 60, 114, 14, 148, 100, 28, 132, 129, 105, 154, 7, 167, 140, 160, 30, 57, 32, 81, 3, 86, 45, 69, 147, 125, 52, 20, 22, 156, 168, 17, 5, 93, 53, 61, 149, 56, 62, 112, 48, 11, 21, 166, 73, 158, 104, 79, 128, 135, 126, 63, 26, 44, 97, 13, 151, 123, 41, 118, 35, 131, 8, 90, 58, 134, 6, 78, 130, 82, 106, 99, 178, 102, 29, 108, 120, 107, 139, 23, 85, 36, 172, 174, 138, 95, 145, 170, 122, 50, 19, 91, 67, 101, 92, 179, 27, 94, 66, 171, 39, 68, 9, 59, 146, 15, 31, 38, 49, 37, 64, 77, 152, 144, 72, 165, 163, 24, 1, 2, 111, 80, 124, 43, 136, 127, 153, 75, 42, 113, 18, 164, 133, 142, 98, 96, 4, 51, 150, 46, 121, 76, 10, 25, 176, 34, 110, 115, 143, 173, 169, 40, 65, 157, 175, 70, 33, 141, 71, 119, 16, 162, 177, 12, 84, 87, 117, 0, 88, 161, 55, 54, 83, 74, 159.

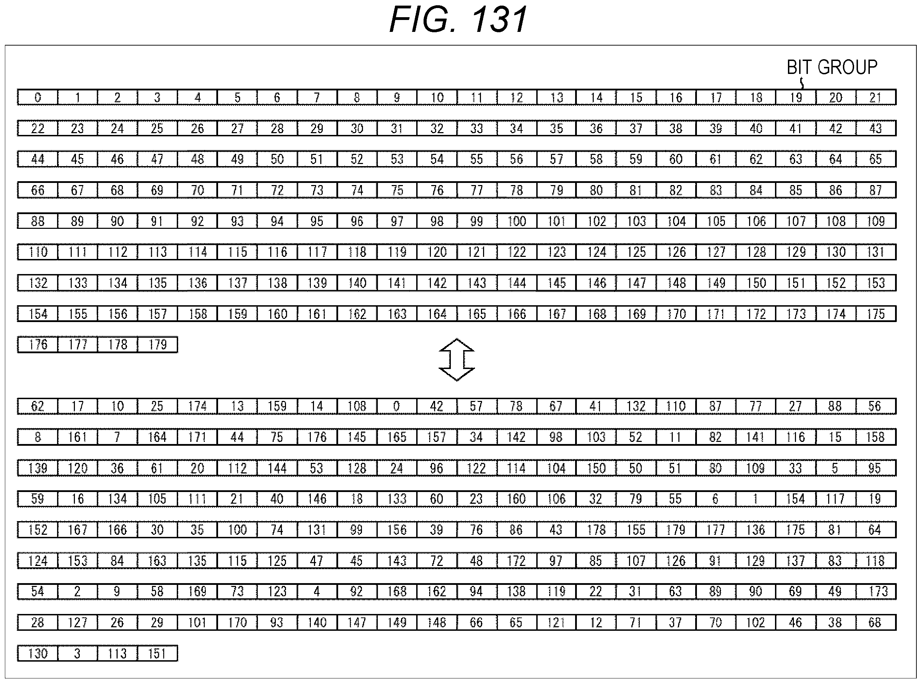

Fig. 131 is a diagram showing a twenty-third example of a GW pattern for an LDPC code having a code length N of 64k bits.

According to the GW pattern shown in Fig. 131, arrangement of bit groups from 0 to 179 of the 64k-bit LDPC code is interleaved to arrangement of 62, 17, 10, 25, 174, 13, 159, 14, 108, 0, 42, 57, 78, 67, 41, 132, 110, 87, 77, 27, 88, 56, 8, 161, 7, 164, 171, 44, 75, 176, 145, 165, 157, 34, 142, 98, 103, 52, 11, 82, 141, 116, 15, 158, 139, 120, 36, 61, 20, 112, 144, 53, 128, 24, 96, 122, 114, 104, 150, 50, 51, 80, 109, 33, 5, 95, 59, 16, 134, 105, 111, 21, 40, 146, 18, 133, 60, 23, 160, 106, 32, 79, 55, 6, 1, 154, 117, 19, 152, 167, 166, 30, 35, 100, 74, 131, 99, 156, 39, 76, 86, 43, 178, 155, 179, 177, 136, 175, 81, 64, 124, 153, 84, 163, 135, 115, 125, 47, 45, 143, 72, 48, 172, 97, 85, 107, 126, 91, 129, 137, 83, 118, 54, 2, 9, 58, 169, 73, 123, 4, 92, 168, 162, 94, 138, 119, 22, 31, 63, 89, 90, 69, 49, 173, 28, 127, 26, 29, 101, 170, 93, 140, 147, 149, 148, 66, 65, 121, 12, 71, 37, 70, 102, 46, 38, 68, 130, 3, 113, 151.

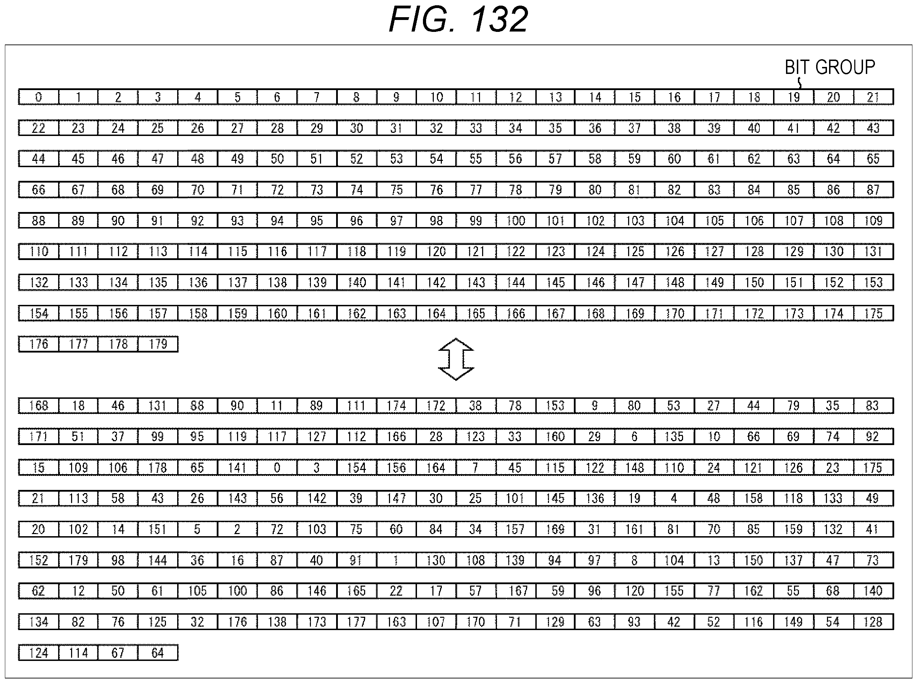

Fig. 132 is a diagram showing a twenty-fourth example of a GW pattern for an LDPC code having a code length N of 64k bits.

According to the GW pattern shown in Fig. 132, arrangement of bit groups from 0 to 179 of the 64k-bit LDPC code is interleaved to arrangement of 168, 18, 46, 131, 88, 90, 11, 89, 111, 174, 172, 38, 78, 153, 9, 80, 53, 27, 44, 79, 35, 83, 171, 51, 37, 99, 95, 119, 117, 127, 112, 166, 28, 123, 33, 160, 29, 6, 135, 10, 66, 69, 74, 92, 15, 109, 106, 178, 65, 141, 0, 3, 154, 156, 164, 7, 45, 115, 122, 148, 110, 24, 121, 126, 23, 175, 21, 113, 58, 43, 26, 143, 56, 142, 39, 147, 30, 25, 101, 145, 136, 19, 4, 48, 158, 118, 133, 49, 20, 102, 14, 151, 5, 2, 72, 103, 75, 60, 84, 34, 157, 169, 31, 161, 81, 70, 85, 159, 132, 41, 152, 179, 98, 144, 36, 16, 87, 40, 91, 1, 130, 108, 139, 94, 97, 8, 104, 13, 150, 137, 47, 73, 62, 12, 50, 61, 105, 100, 86, 146, 165, 22, 17, 57, 167, 59, 96, 120, 155, 77, 162, 55, 68, 140, 134, 82, 76, 125, 32, 176, 138, 173, 177, 163, 107, 170, 71, 129, 63, 93, 42, 52, 116, 149, 54, 128, 124, 114, 67, 64.

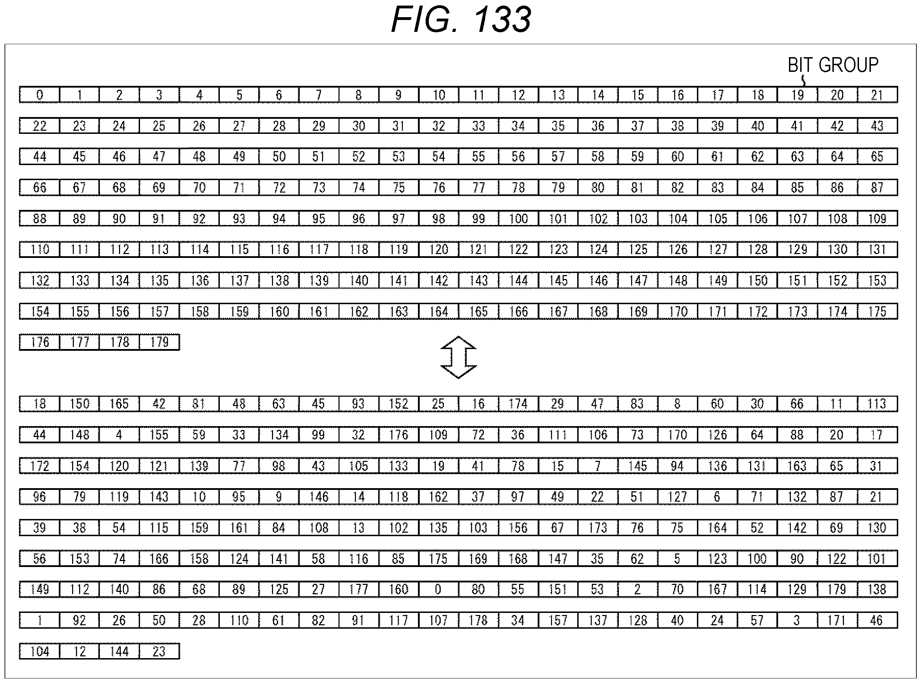

Fig. 133 is a diagram showing a twenty-fifth example of a GW pattern for an LDPC code having a code length N of 64k bits.

According to the GW pattern shown in Fig. 133, arrangement of bit groups from 0 to 179 of the 64k-bit LDPC code is interleaved to arrangement of 18, 150, 165, 42, 81, 48, 63, 45, 93, 152, 25, 16, 174, 29, 47, 83, 8, 60, 30, 66, 11, 113, 44, 148, 4, 155, 59, 33, 134, 99, 32, 176, 109, 72, 36, 111, 106, 73, 170, 126, 64, 88, 20, 17, 172, 154, 120, 121, 139, 77, 98, 43, 105, 133, 19, 41, 78, 15, 7, 145, 94, 136, 131, 163, 65, 31, 96, 79, 119, 143, 10, 95, 9, 146, 14, 118, 162, 37, 97, 49, 22, 51, 127, 6, 71, 132, 87, 21, 39, 38, 54, 115, 159, 161, 84, 108, 13, 102, 135, 103, 156, 67, 173, 76, 75, 164, 52, 142, 69, 130, 56, 153, 74, 166, 158, 124, 141, 58, 116, 85, 175, 169, 168, 147, 35, 62, 5, 123, 100, 90, 122, 101, 149, 112, 140, 86, 68, 89, 125, 27, 177, 160, 0, 80, 55, 151, 53, 2, 70, 167, 114, 129, 179, 138, 1, 92, 26, 50, 28, 110, 61, 82, 91, 117, 107, 178, 34, 157, 137, 128, 40, 24, 57, 3, 171, 46, 104, 12, 144, 23.

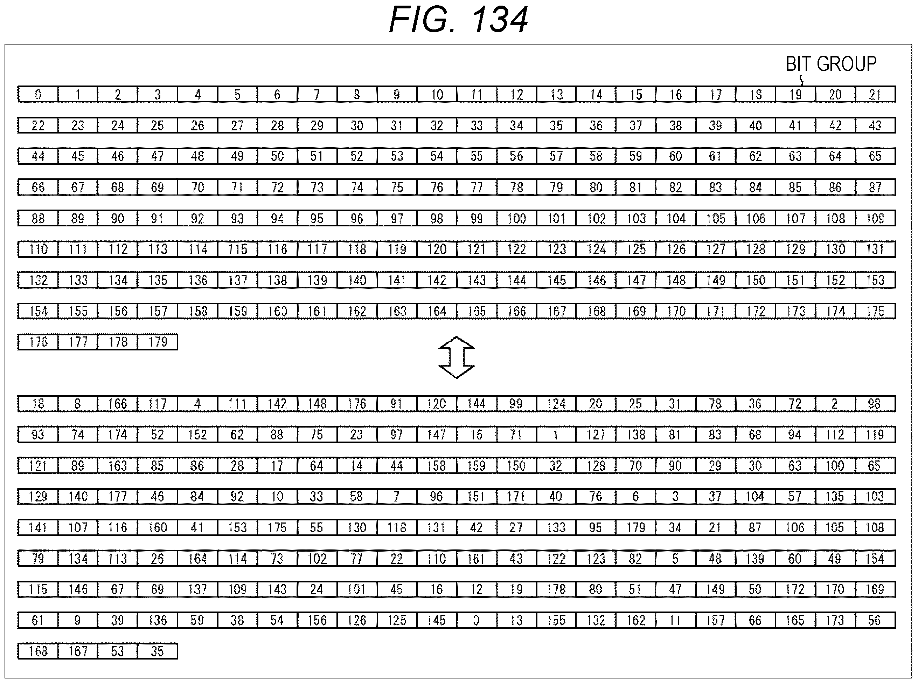

Fig. 134 is a diagram showing a twenty-sixth example of a GW pattern for an LDPC code having a code length N of 64k bits.

According to the GW pattern shown in Fig. 134, arrangement of bit groups from 0 to 179 of the 64k-bit LDPC code is interleaved to arrangement of 18, 8, 166, 117, 4, 111, 142, 148, 176, 91, 120, 144, 99, 124, 20, 25, 31, 78, 36, 72, 2, 98, 93, 74, 174, 52, 152, 62, 88, 75, 23, 97, 147, 15, 71, 1, 127, 138, 81, 83, 68, 94, 112, 119, 121, 89, 163, 85, 86, 28, 17, 64, 14, 44, 158, 159, 150, 32, 128, 70, 90, 29, 30, 63, 100, 65, 129, 140, 177, 46, 84, 92, 10, 33, 58, 7, 96, 151, 171, 40, 76, 6, 3, 37, 104, 57, 135, 103, 141, 107, 116, 160, 41, 153, 175, 55, 130, 118, 131, 42, 27, 133, 95, 179, 34, 21, 87, 106, 105, 108, 79, 134, 113, 26, 164, 114, 73, 102, 77, 22, 110, 161, 43, 122, 123, 82, 5, 48, 139, 60, 49, 154, 115, 146, 67, 69, 137, 109, 143, 24, 101, 45, 16, 12, 19, 178, 80, 51, 47, 149, 50, 172, 170, 169, 61, 9, 39, 136, 59, 38, 54, 156, 126, 125, 145, 0, 13, 155, 132, 162, 11, 157, 66, 165, 173, 56, 168, 167, 53, 35.

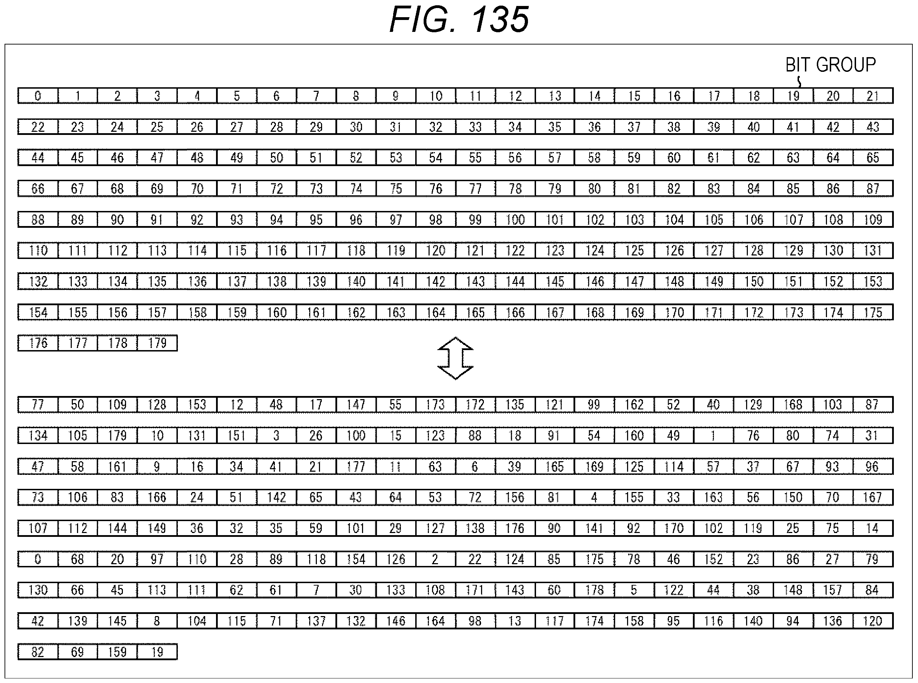

Fig. 135 is a diagram showing a twenty-seventh example of a GW pattern for an LDPC code having a code length N of 64k bits.

According to the GW pattern shown in Fig. 135, arrangement of bit groups from 0 to 179 of the 64k-bit LDPC code is interleaved to arrangement of 77, 50, 109, 128, 153, 12, 48, 17, 147, 55, 173, 172, 135, 121, 99, 162, 52, 40, 129, 168, 103, 87, 134, 105, 179, 10, 131, 151, 3, 26, 100, 15, 123, 88, 18, 91, 54, 160, 49, 1, 76, 80, 74, 31, 47, 58, 161, 9, 16, 34, 41, 21, 177, 11, 63, 6, 39, 165, 169, 125, 114, 57, 37, 67, 93, 96, 73, 106, 83, 166, 24, 51, 142, 65, 43, 64, 53, 72, 156, 81, 4, 155, 33, 163, 56, 150, 70, 167, 107, 112, 144, 149, 36, 32, 35, 59, 101, 29, 127, 138, 176, 90, 141, 92, 170, 102, 119, 25, 75, 14, 0, 68, 20, 97, 110, 28, 89, 118, 154, 126, 2, 22, 124, 85, 175, 78, 46, 152, 23, 86, 27, 79, 130, 66, 45, 113, 111, 62, 61, 7, 30, 133, 108, 171, 143, 60, 178, 5, 122, 44, 38, 148, 157, 84, 42, 139, 145, 8, 104, 115, 71, 137, 132, 146, 164, 98, 13, 117, 174, 158, 95, 116, 140, 94, 136, 120, 82, 69, 159, 19.

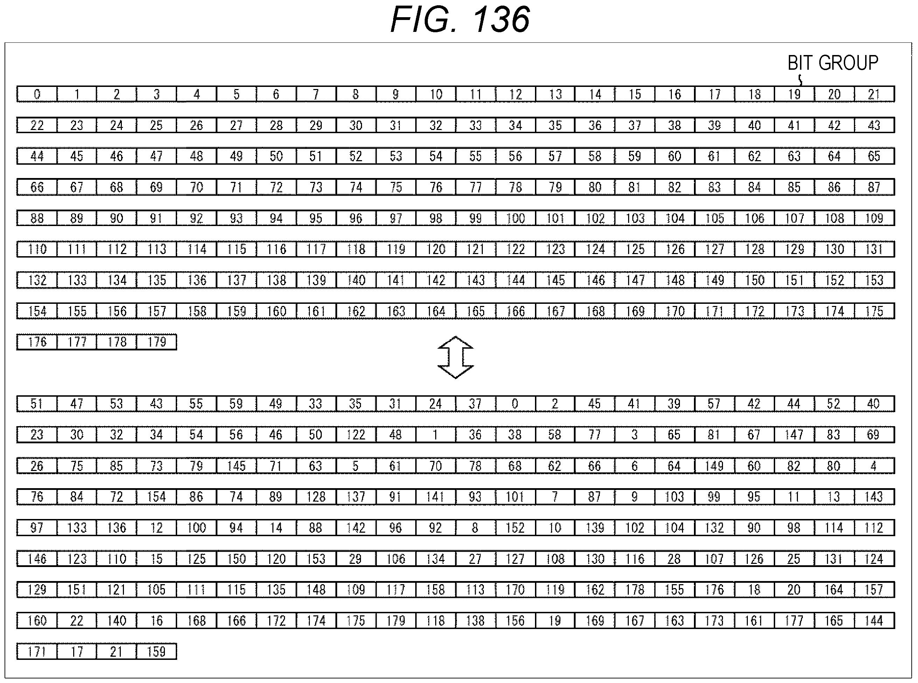

Fig. 136 is a diagram showing a twenty-eighth example of a GW pattern for an LDPC code having a code length N of 64k bits.

According to the GW pattern shown in Fig. 136, arrangement of bit groups from 0 to 179 of the 64k-bit LDPC code is interleaved to arrangement of 51, 47, 53, 43, 55, 59, 49, 33, 35, 31, 24, 37, 0, 2, 45, 41, 39, 57, 42, 44, 52, 40, 23, 30, 32, 34, 54, 56, 46, 50, 122, 48, 1, 36, 38, 58, 77, 3, 65, 81, 67, 147, 83, 69, 26, 75, 85, 73, 79, 145, 71, 63, 5, 61, 70, 78, 68, 62, 66, 6, 64, 149, 60, 82, 80, 4, 76, 84, 72, 154, 86, 74, 89, 128, 137, 91, 141, 93, 101, 7, 87, 9, 103, 99, 95, 11, 13, 143, 97, 133, 136, 12, 100, 94, 14, 88, 142, 96, 92, 8, 152, 10, 139, 102, 104, 132, 90, 98, 114, 112, 146, 123, 110, 15, 125, 150, 120, 153, 29, 106, 134, 27, 127, 108, 130, 116, 28, 107, 126, 25, 131, 124, 129, 151, 121, 105, 111, 115, 135, 148, 109, 117, 158, 113, 170, 119, 162, 178, 155, 176, 18, 20, 164, 157, 160, 22, 140, 16, 168, 166, 172, 174, 175, 179, 118, 138, 156, 19, 169, 167, 163, 173, 161, 177, 165, 144, 171, 17, 21, 159.

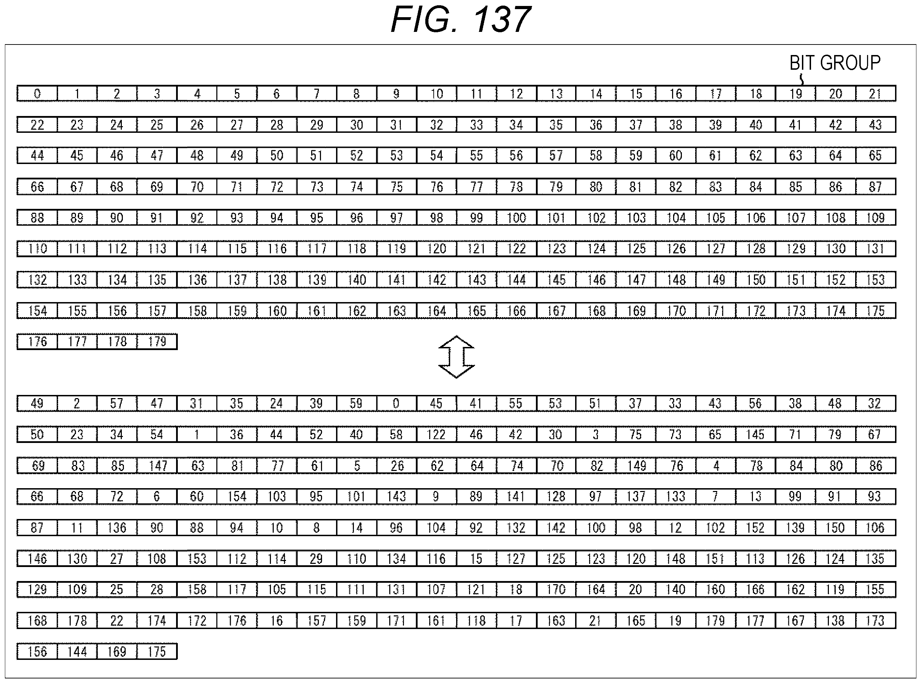

Fig. 137 is a diagram showing a twenty-ninth example of a GW pattern for an LDPC code having a code length N of 64k bits.

According to the GW pattern shown in Fig. 137, arrangement of bit groups from 0 to 179 of the 64k-bit LDPC code is interleaved to arrangement of 49, 2, 57, 47, 31, 35, 24, 39, 59, 0, 45, 41, 55, 53, 51, 37, 33, 43, 56, 38, 48, 32, 50, 23, 34, 54, 1, 36, 44, 52, 40, 58, 122, 46, 42, 30, 3, 75, 73, 65, 145, 71, 79, 67, 69, 83, 85, 147, 63, 81, 77, 61, 5, 26, 62, 64, 74, 70, 82, 149, 76, 4, 78, 84, 80, 86, 66, 68, 72, 6, 60, 154, 103, 95, 101, 143, 9, 89, 141, 128, 97, 137, 133, 7, 13, 99, 91, 93, 87, 11, 136, 90, 88, 94, 10, 8, 14, 96, 104, 92, 132, 142, 100, 98, 12, 102, 152, 139, 150, 106, 146, 130, 27, 108, 153, 112, 114, 29, 110, 134, 116, 15, 127, 125, 123, 120, 148, 151, 113, 126, 124, 135, 129, 109, 25, 28, 158, 117, 105, 115, 111, 131, 107, 121, 18, 170, 164, 20, 140, 160, 166, 162, 119, 155, 168, 178, 22, 174, 172, 176, 16, 157, 159, 171, 161, 118, 17, 163, 21, 165, 19, 179, 177, 167, 138, 173, 156, 144, 169, 175.

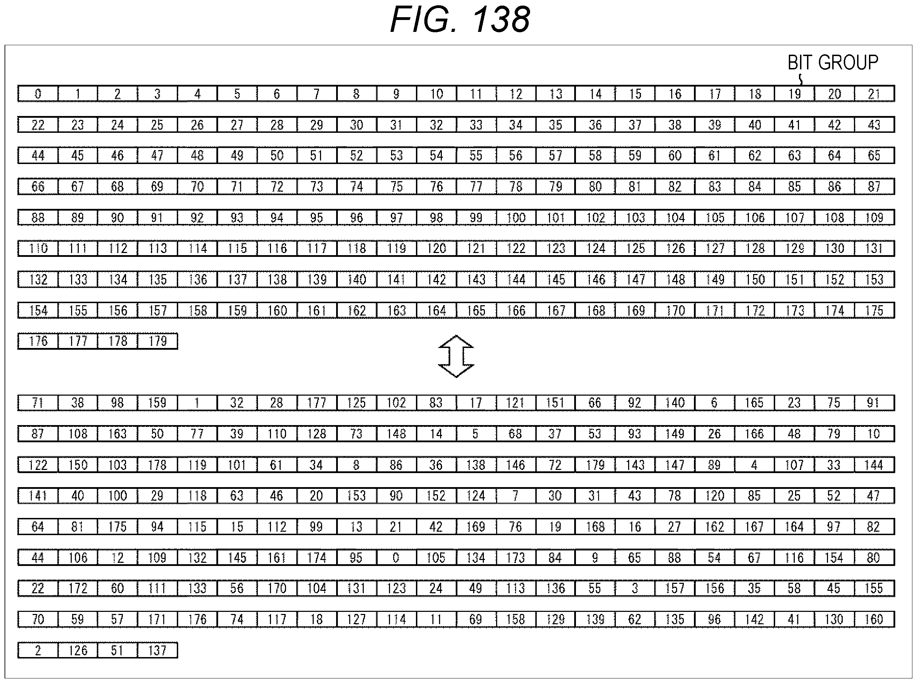

Fig. 138 is a diagram showing a thirtieth example of a GW pattern for an LDPC code having a code length N of 64k bits.

According to the GW pattern shown in Fig. 138, arrangement of bit groups from 0 to 179 of the 64k-bit LDPC code is interleaved to arrangement of 71, 38, 98, 159, 1, 32, 28, 177, 125, 102, 83, 17, 121, 151, 66, 92, 140, 6, 165, 23, 75, 91, 87, 108, 163, 50, 77, 39, 110, 128, 73, 148, 14, 5, 68, 37, 53, 93, 149, 26, 166, 48, 79, 10, 122, 150, 103, 178, 119, 101, 61, 34, 8, 86, 36, 138, 146, 72, 179, 143, 147, 89, 4, 107, 33, 144, 141, 40, 100, 29, 118, 63, 46, 20, 153, 90, 152, 124, 7, 30, 31, 43, 78, 120, 85, 25, 52, 47, 64, 81, 175, 94, 115, 15, 112, 99, 13, 21, 42, 169, 76, 19, 168, 16, 27, 162, 167, 164, 97, 82, 44, 106, 12, 109, 132, 145, 161, 174, 95, 0, 105, 134, 173, 84, 9, 65, 88, 54, 67, 116, 154, 80, 22, 172, 60, 111, 133, 56, 170, 104, 131, 123, 24, 49, 113, 136, 55, 3, 157, 156, 35, 58, 45, 155, 70, 59, 57, 171, 176, 74, 117, 18, 127, 114, 11, 69, 158, 129, 139, 62, 135, 96, 142, 41, 130, 160, 2, 126, 51, 137.

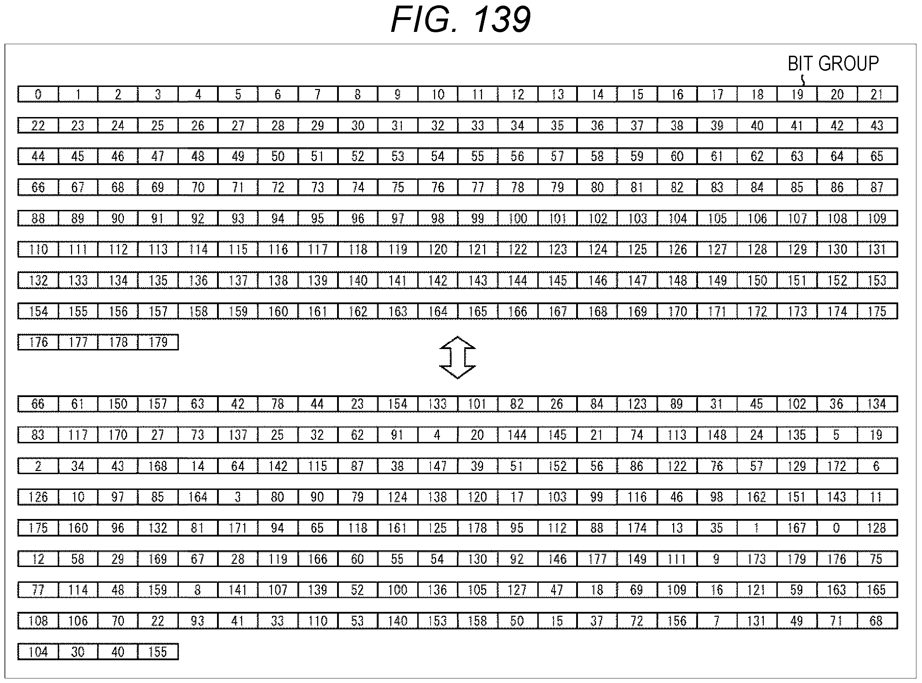

Fig. 139 is a diagram showing a thirty-first example of a GW pattern for an LDPC code having a code length N of 64k bits.

According to the GW pattern shown in Fig. 139, arrangement of bit groups from 0 to 179 of the 64k-bit LDPC code is interleaved to arrangement of 66, 61, 150, 157, 63, 42, 78, 44, 23, 154, 133, 101, 82, 26, 84, 123, 89, 31, 45, 102, 36, 134, 83, 117, 170, 27, 73, 137, 25, 32, 62, 91, 4, 20, 144, 145, 21, 74, 113, 148, 24, 135, 5, 19, 2, 34, 43, 168, 14, 64, 142, 115, 87, 38, 147, 39, 51, 152, 56, 86, 122, 76, 57, 129, 172, 6, 126, 10, 97, 85, 164, 3, 80, 90, 79, 124, 138, 120, 17, 103, 99, 116, 46, 98, 162, 151, 143, 11, 175, 160, 96, 132, 81, 171, 94, 65, 118, 161, 125, 178, 95, 112, 88, 174, 13, 35, 1, 167, 0, 128, 12, 58, 29, 169, 67, 28, 119, 166, 60, 55, 54, 130, 92, 146, 177, 149, 111, 9, 173, 179, 176, 75, 77, 114, 48, 159, 8, 141, 107, 139, 52, 100, 136, 105, 127, 47, 18, 69, 109, 16, 121, 59, 163, 165, 108, 106, 70, 22, 93, 41, 33, 110, 53, 140, 153, 158, 50, 15, 37, 72, 156, 7, 131, 49, 71, 68, 104, 30, 40, 155.

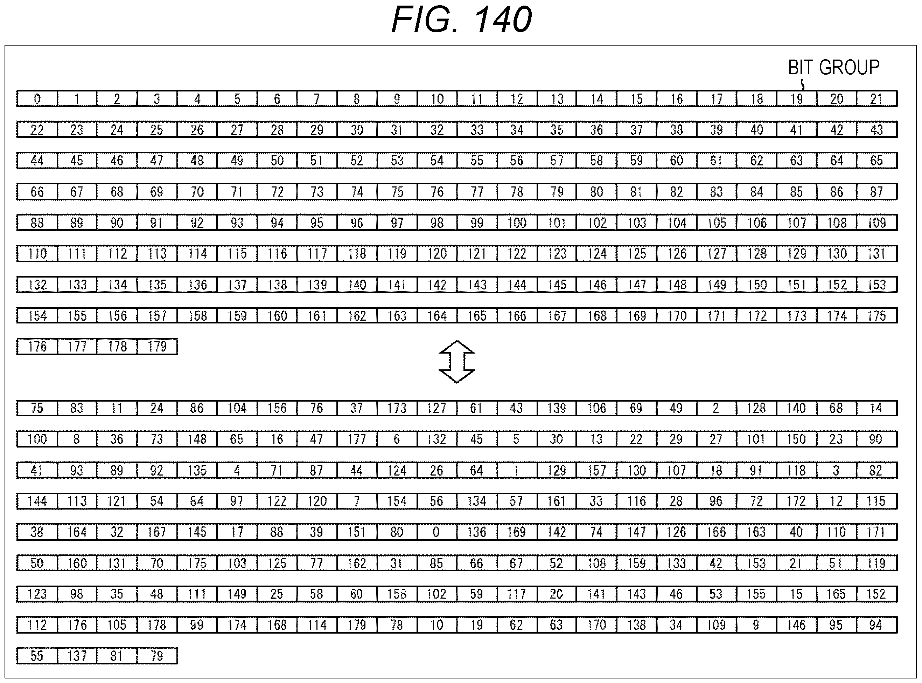

Fig. 140 is a diagram showing a thirty-second example of a GW pattern for an LDPC code having a code length N of 64k bits.

According to the GW pattern shown in Fig. 140, arrangement of bit groups from 0 to 179 of the 64k-bit LDPC code is interleaved to arrangement of 75, 83, 11, 24, 86, 104, 156, 76, 37, 173, 127, 61, 43, 139, 106, 69, 49, 2, 128, 140, 68, 14, 100, 8, 36, 73, 148, 65, 16, 47, 177, 6, 132, 45, 5, 30, 13, 22, 29, 27, 101, 150, 23, 90, 41, 93, 89, 92, 135, 4, 71, 87, 44, 124, 26, 64, 1, 129, 157, 130, 107, 18, 91, 118, 3, 82, 144, 113, 121, 54, 84, 97, 122, 120, 7, 154, 56, 134, 57, 161, 33, 116, 28, 96, 72, 172, 12, 115, 38, 164, 32, 167, 145, 17, 88, 39, 151, 80, 0, 136, 169, 142, 74, 147, 126, 166, 163, 40, 110, 171, 50, 160, 131, 70, 175, 103, 125, 77, 162, 31, 85, 66, 67, 52, 108, 159, 133, 42, 153, 21, 51, 119, 123, 98, 35, 48, 111, 149, 25, 58, 60, 158, 102, 59, 117, 20, 141, 143, 46, 53, 155, 15, 165, 152, 112, 176, 105, 178, 99, 174, 168, 114, 179, 78, 10, 19, 62, 63, 170, 138, 34, 109, 9, 146, 95, 94, 55, 137, 81, 79.

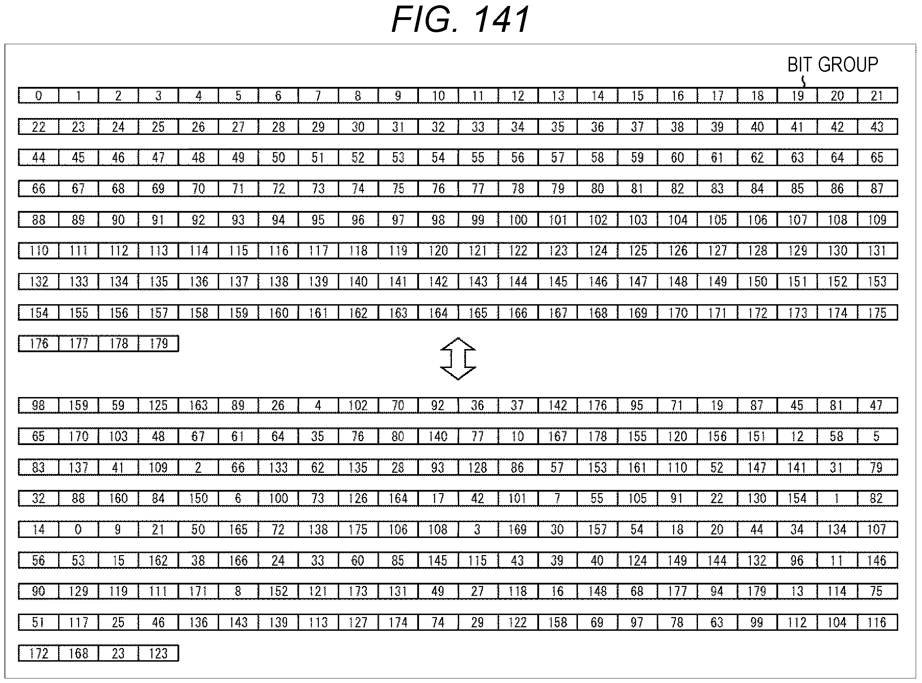

Fig. 141 is a diagram showing a thirty-third example of a GW pattern for an LDPC code having a code length N of 64k bits.

According to the GW pattern shown in Fig. 141, arrangement of bit groups from 0 to 179 of the 64k-bit LDPC code is interleaved to arrangement of 98, 159, 59, 125, 163, 89, 26, 4, 102, 70, 92, 36, 37, 142, 176, 95, 71, 19, 87, 45, 81, 47, 65, 170, 103, 48, 67, 61, 64, 35, 76, 80, 140, 77, 10, 167, 178, 155, 120, 156, 151, 12, 58, 5, 83, 137, 41, 109, 2, 66, 133, 62, 135, 28, 93, 128, 86, 57, 153, 161, 110, 52, 147, 141, 31, 79, 32, 88, 160, 84, 150, 6, 100, 73, 126, 164, 17, 42, 101, 7, 55, 105, 91, 22, 130, 154, 1, 82, 14, 0, 9, 21, 50, 165, 72, 138, 175, 106, 108, 3, 169, 30, 157, 54, 18, 20, 44, 34, 134, 107, 56, 53, 15, 162, 38, 166, 24, 33, 60, 85, 145, 115, 43, 39, 40, 124, 149, 144, 132, 96, 11, 146, 90, 129, 119, 111, 171, 8, 152, 121, 173, 131, 49, 27, 118, 16, 148, 68, 177, 94, 179, 13, 114, 75, 51, 117, 25, 46, 136, 143, 139, 113, 127, 174, 74, 29, 122, 158, 69, 97, 78, 63, 99, 112, 104, 116, 172, 168, 23, 123.

The first through thirty-third examples of the GW pattern for the LDPC code having the code length N of 64k bits described above are applicable to any combinations of the LDPC code having the code length N of 64k bits and the coding rate r, and the modulation system (constellation).

However, in case of group-wise interleave, error rates of the respective combinations further improve when the GW pattern to be adopted is individually set for each of combinations of the code length N of the LDPC code, the coding rate r of the LDPC code, and the modulation system (constellation).

The GW pattern shown in Fig. 109 particularly achieves preferable error rates when applied to the combination of the (64k, 5/15) ETRI code and QPSK shown in Fig. 89, for example.

The GW pattern shown in Fig. 110 particularly achieves preferable error rates when applied to the combination of the (64k, 5/15) ETRI code and 16QAM shown in Fig. 90, for example.

The GW pattern shown in Fig. 111 particularly achieves preferable error rates when applied to the combination of the (64k, 5/15) ETRI code and 64QAM shown in Fig. 91, for example.

The GW pattern shown in Fig. 112 particularly achieves preferable error rates when applied to the combination of the (64k, 7/15) Sony code and QPSK shown in Fig. 89, for example.

The GW pattern shown in Fig. 113 particularly achieves preferable error rates when applied to the combination of the (64k, 7/15) Sony code and 16QAM shown in Fig. 90, for example.

The GW pattern shown in Fig. 114 particularly achieves preferable error rates when applied to the combination of the (64k, 7/15) Sony code and 64QAM shown in Fig. 91, for example.

The GW pattern shown in Fig. 115 particularly achieves preferable error rates when applied to the combination of the (64k, 9/15) Sony code and QPSK shown in Fig. 89, for example.

The GW pattern shown in Fig. 116 particularly achieves preferable error rates when applied to the combination of the (64k, 9/15) Sony code and 16QAM shown in Fig. 90, for example.

The GW pattern shown in Fig. 117 particularly achieves preferable error rates when applied to the combination of the (64k, 9/15) Sony code and 64QAM shown in Fig. 91, for example.

The GW pattern shown in Fig. 118 particularly achieves preferable error rates when applied to the combination of the (64k, 11/15) Sony code and QPSK shown in Fig. 89, for example.

The GW pattern shown in Fig. 119 particularly achieves preferable error rates when applied to the combination of the (64k, 11/15) Sony code and 16QAM shown in Fig. 90, for example.

The GW pattern shown in Fig. 120 particularly achieves preferable error rates when applied to the combination of the (64k, 11/15) Sony code and 64QAM shown in Fig. 91, for example.

The GW pattern shown in Fig. 121 particularly achieves preferable error rates when applied to the combination of the (64k, 13/15) Sony code and QPSK shown in Fig. 89, for example.

The GW pattern shown in Fig. 122 particularly achieves preferable error rates when applied to the combination of the (64k, 13/15) Sony code and 16QAM shown in Fig. 90, for example.

The GW pattern shown in Fig. 123 particularly achieves preferable error rates when applied to the combination of the (64k, 13/15) Sony code and 64QAM shown in Fig. 91, for example.

The GW pattern shown in Fig. 124 particularly achieves preferable error rates when applied to the combination of the (64k, 5/15) ETRI code and 256QAM shown in Figs. 92 and 93, for example.

The GW pattern shown in Fig. 125 particularly achieves preferable error rates when applied to the combination of the (64k, 7/15) ETRI code and 256QAM shown in Figs. 92 and 93, for example.

The GW pattern shown in Fig. 126 particularly achieves preferable error rates when applied to the combination of the (64k, 7/15) Sony code and 256QAM shown in Figs. 92 and 93, for example.

The GW pattern shown in Fig. 127 particularly achieves preferable error rates when applied to the combination of the (64k, 9/15) Sony code and 256QAM shown in Figs. 92 and 93, for example.

The GW pattern shown in Fig. 128 particularly achieves preferable error rates when applied to the combination of the (64k, 9/15) NERC code and 256QAM shown in Figs. 92 and 93, for example.

The GW pattern shown in Fig. 129 particularly achieves preferable error rates when applied to the combination of the (64k, 11/15) Sony code and 256QAM shown in Figs. 92 and 93, for example.

The GW pattern shown in Fig. 130 particularly achieves preferable error rates when applied to the combination of the (64k, 13/15) Sony code and 256QAM shown in Figs. 92 and 93, for example.

The GW pattern shown in Fig. 131 particularly achieves preferable error rates when applied to the combination of the (64k, 5/15) ETRI code and 1024QAM shown in Figs. 94 and 95, for example.

The GW pattern shown in Fig. 132 particularly achieves preferable error rates when applied to the combination of the (64k, 7/15) ETRI code and 1024QAM shown in Figs. 94 and 95, for example.

The GW pattern shown in Fig. 133 particularly achieves preferable error rates when applied to the combination of the (64k, 7/15) Sony code and 1024QAM shown in Figs. 94 and 95, for example.

The GW pattern shown in Fig. 134 particularly achieves preferable error rates when applied to the combination of the (64k, 9/15) Sony code and 1024QAM shown in Figs. 94 and 95, for example.

The GW pattern shown in Fig. 135 particularly achieves preferable error rates when applied to the combination of the (64k, 9/15) NERC code and 1024QAM shown in Figs. 94 and 95, for example.

The GW pattern shown in Fig. 136 particularly achieves preferable error rates when applied to the combination of the (64k, 11/15) Sony code and 1024QAM shown in Figs. 94 and 95, for example.

The GW pattern shown in Fig. 137 particularly achieves preferable error rates when applied to the combination of the (64k, 13/15) Sony code and 1024QAM shown in Figs. 94 and 95, for example.

The GW pattern shown in Fig. 138 particularly achieves preferable error rates when applied to the combination of the (64k, 6/15) Samsung code and 4096QAM shown in Figs. 96 and 97, for example.

The GW pattern shown in Fig. 139 particularly achieves preferable error rates when applied to the combination of the (64k, 7/15) ETRI code and 4096QAM shown in Figs. 96 and 97, for example.

The GW pattern shown in Fig. 140 particularly achieves preferable error rates when applied to the combination of the (64k, 8/15) Samsung code and 4096QAM shown in Figs. 96 and 97, for example.

The GW pattern shown in Fig. 141 particularly achieves preferable error rates when applied to the combination of the (64k, 9/15) Sony code and 4096QAM shown in Figs. 96 and 97, for example.

<Example of GW pattern for 16k-bit LDPC code>

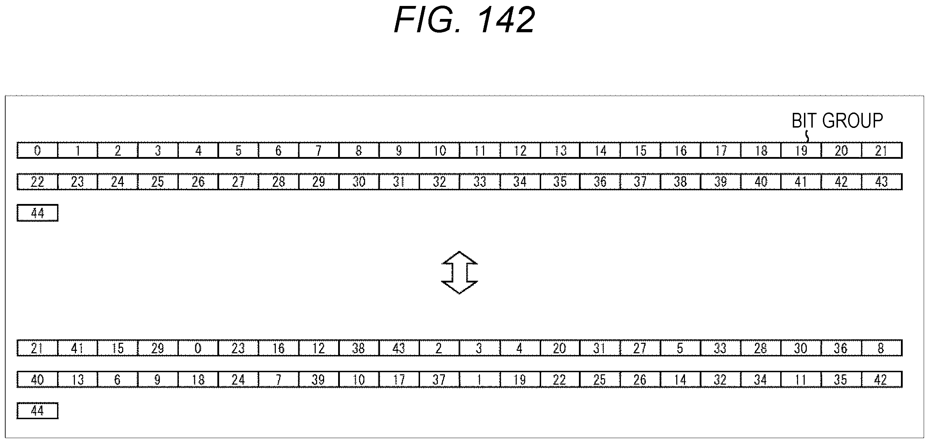

Fig. 142 is a diagram showing a first example of a GW pattern for an LDPC code having a code length N of 16k bit.

According to the GW pattern shown in Fig. 142, a bit group 0 through 44 of the 16k-bit LDPC code is interleaved to an arrangement of 21, 41, 15, 29, 0, 23, 16, 12, 38, 43, 2, 3, 4, 20, 31, 27, 5, 33, 28, 30, 36, 8, 40, 13, 6, 9, 18, 24, 7, 39, 10, 17, 37, 1, 19, 22, 25, 26, 14, 32, 34, 11, 35, 42, 44.

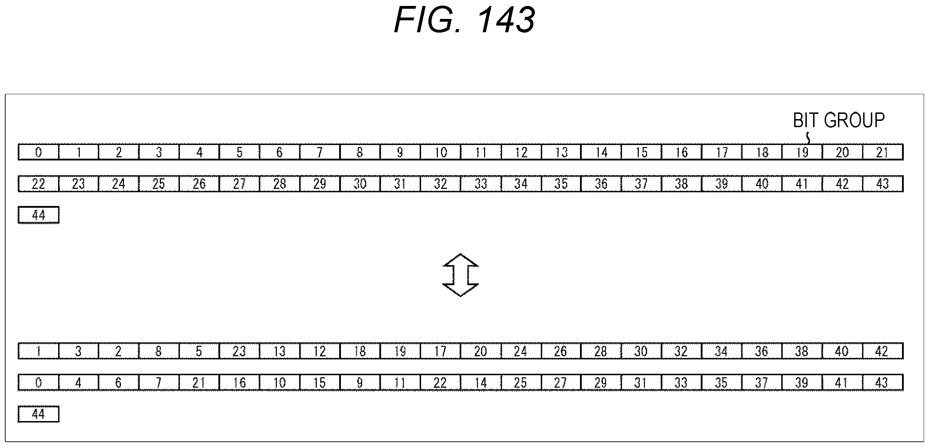

Fig. 143 is a diagram showing a second example of a GW pattern for an LDPC code having a code length N of 16k bit.

According to the GW pattern shown in Fig. 143, a bit group 0 through 44 of the 16k-bit LDPC code is interleaved to an arrangement of 1, 3, 2, 8, 5, 23, 13, 12, 18, 19, 17, 20, 24, 26, 28, 30, 32, 34, 36, 38, 40, 42, 0, 4, 6, 7, 21, 16, 10, 15, 9, 11, 22, 14, 25, 27, 29, 31, 33, 35, 37, 39, 41, 43, 44.

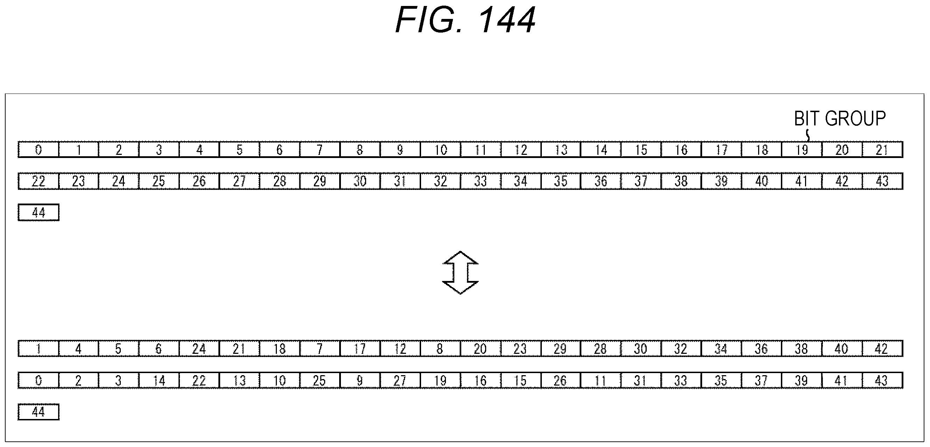

Fig. 144 is a diagram showing a third example of a GW pattern for an LDPC code having a code length N of 16k bit.

According to the GW pattern shown in Fig. 144, arrangement of bit groups 0 through 44 of the 16k-bit LDPC code is interleaved to arrangement of 1, 4, 5, 6, 24, 21, 18, 7, 17, 12, 8, 20, 23, 29, 28, 30, 32, 34, 36, 38, 40, 42, 0, 2, 3, 14, 22, 13, 10, 25, 9, 27, 19, 16, 15, 26, 11, 31, 33, 35, 37, 39, 41, 43, 44.

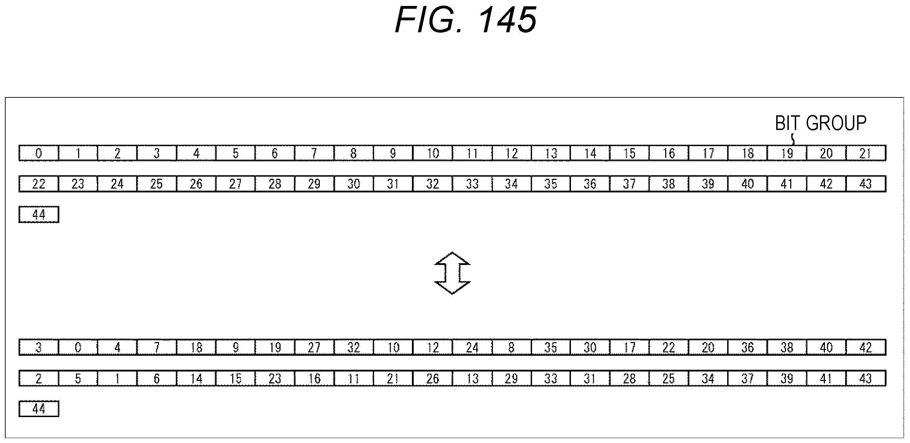

Fig. 145 is a diagram showing a fourth example of a GW pattern for an LDPC code having a code length N of 16k bit.

According to the GW pattern shown in Fig. 145, arrangement of bit groups 0 through 44 of the 16k-bit LDPC code is interleaved to arrangement of 3, 0, 4, 7, 18, 9, 19, 27, 32, 10, 12, 24, 8, 35, 30, 17, 22, 20, 36, 38, 40, 42, 2, 5, 1, 6, 14, 15, 23, 16, 11, 21, 26, 13, 29, 33, 31, 28, 25, 34, 37, 39, 41, 43, 44.

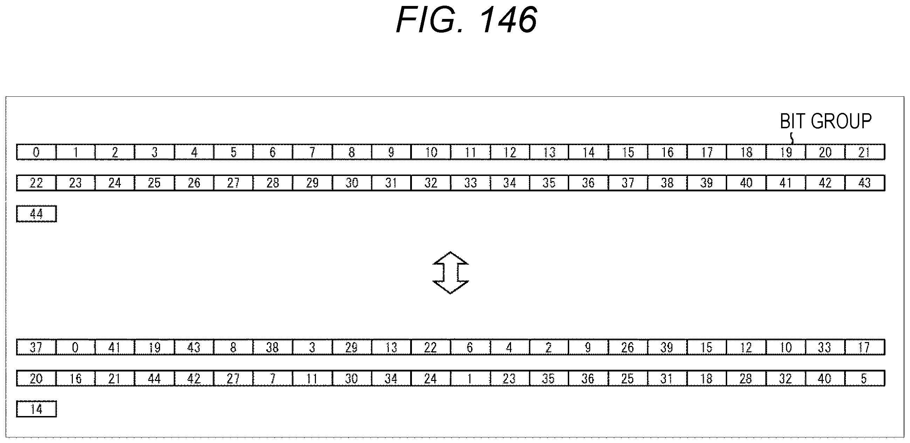

Fig. 146 is a diagram showing a fifth example of a GW pattern for an LDPC code having a code length N of 16k bit.

According to the GW pattern shown in Fig. 146, arrangement of bit groups 0 through 44 of the 16k-bit LDPC code is interleaved to arrangement of 37, 0, 41, 19, 43, 8, 38, 3, 29, 13, 22, 6, 4, 2, 9, 26, 39, 15, 12, 10, 33, 17, 20, 16, 21, 44, 42, 27, 7, 11, 30, 34, 24, 1, 23, 35, 36, 25, 31, 18, 28, 32, 40, 5, 14.

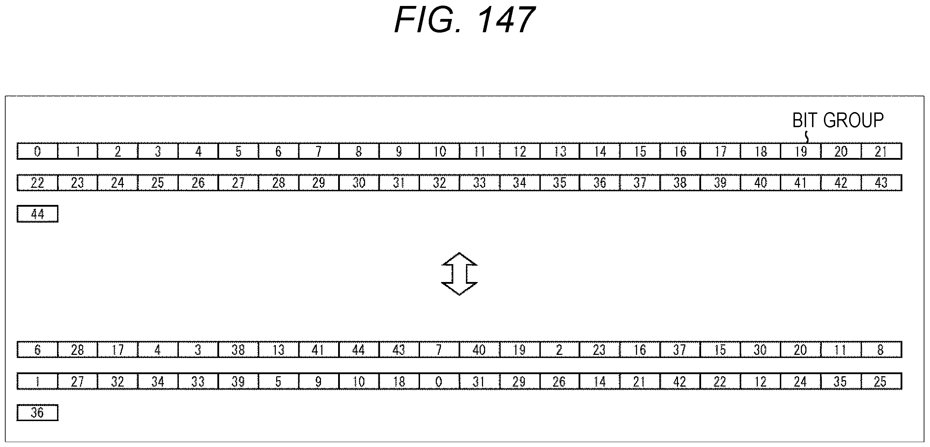

Fig. 147 is a diagram showing a sixth example of a GW pattern for an LDPC code having a code length N of 16k bit.

According to the GW pattern shown in Fig. 147, arrangement of bit groups 0 through 44 of the 16k-bit LDPC code is interleaved to arrangement of 6, 28, 17, 4, 3, 38, 13, 41, 44, 43, 7, 40, 19, 2, 23, 16, 37, 15, 30, 20, 11, 8, 1, 27, 32, 34, 33, 39, 5, 9, 10, 18, 0, 31, 29, 26, 14, 21, 42, 22, 12, 24, 35, 25, 36.

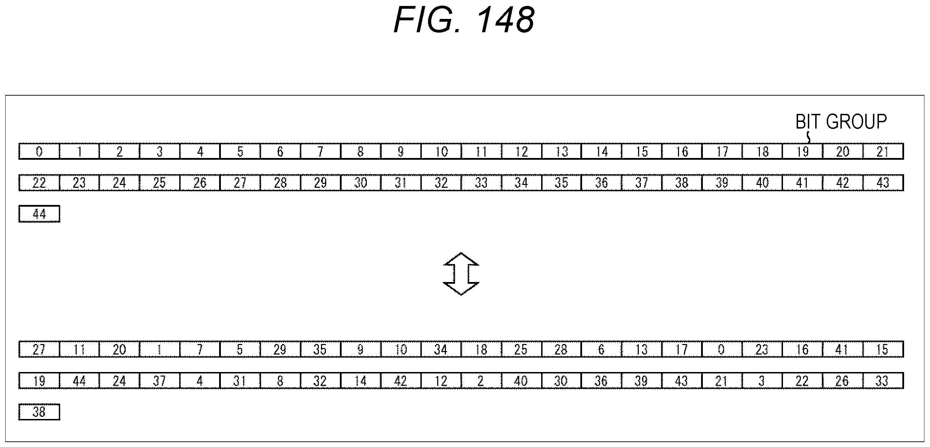

Fig. 148 is a diagram showing a seventh example of a GW pattern for an LDPC code having a code length N of 16k bit.

According to the GW pattern shown in Fig. 148, arrangement of bit groups 0 through 44 of the 16k-bit LDPC code is interleaved to arrangement of 27, 11, 20, 1, 7, 5, 29, 35, 9, 10, 34, 18, 25, 28, 6, 13, 17, 0, 23, 16, 41, 15, 19, 44, 24, 37, 4, 31, 8, 32, 14, 42, 12, 2, 40, 30, 36, 39, 43, 21, 3, 22, 26, 33, 38.

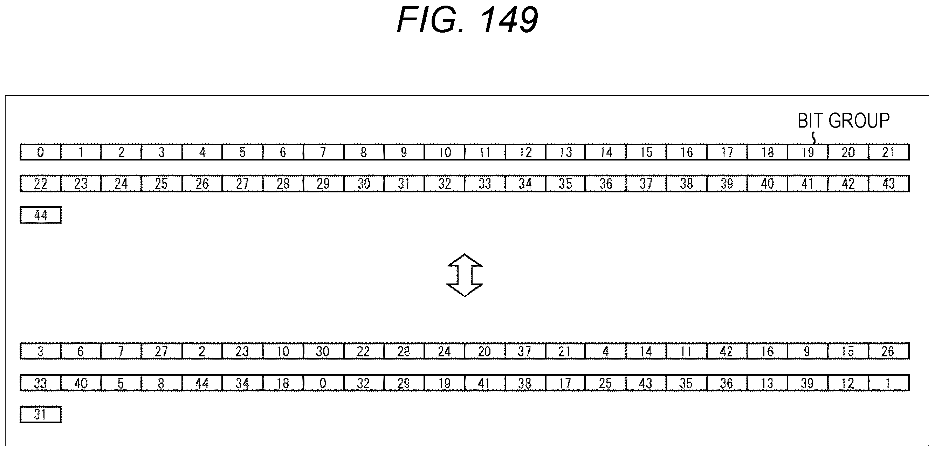

Fig. 149 is a diagram showing an eighth example of a GW pattern for an LDPC code having a code length N of 16k bit.

According to the GW pattern shown in Fig. 149, arrangement of bit groups 0 through 44 of the 16k-bit LDPC code is interleaved to arrangement of 3, 6, 7, 27, 2, 23, 10, 30, 22, 28, 24, 20, 37, 21, 4, 14, 11, 42, 16, 9, 15, 26, 33, 40, 5, 8, 44, 34, 18, 0, 32, 29, 19, 41, 38, 17, 25, 43, 35, 36, 13, 39, 12, 1, 31.

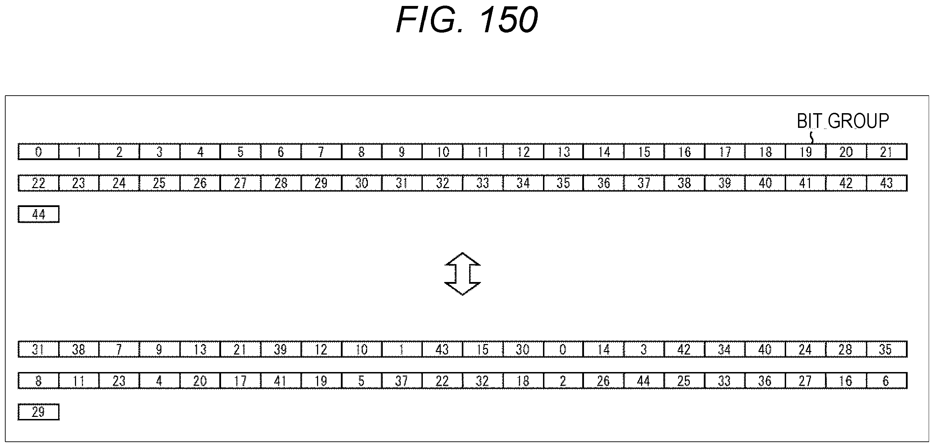

Fig. 150 is a diagram showing a ninth example of a GW pattern for an LDPC code having a code length N of 16k bit.

According to the GW pattern shown in Fig. 150, arrangement of bit groups 0 through 44 of the 16k-bit LDPC code is interleaved to arrangement of 31, 38, 7, 9, 13, 21, 39, 12, 10, 1, 43, 15, 30, 0, 14, 3, 42, 34, 40, 24, 28, 35, 8, 11, 23, 4, 20, 17, 41, 19, 5, 37, 22, 32, 18, 2, 26, 44, 25, 33, 36, 27, 16, 6, 29.

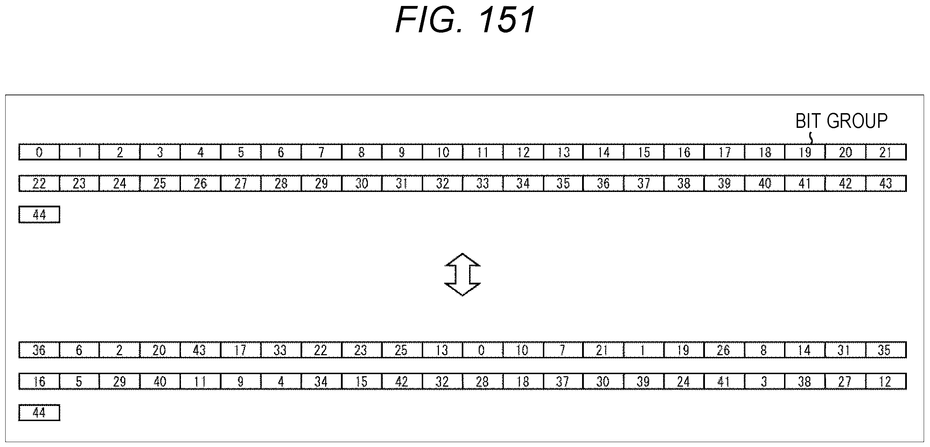

Fig. 151 is a diagram showing a tenth example of a GW pattern for an LDPC code having a code length N of 16k bit.

According to the GW pattern shown in Fig. 151, arrangement of bit groups 0 through 44 of the 16k-bit LDPC code is interleaved to arrangement of 36, 6, 2, 20, 43, 17, 33, 22, 23, 25, 13, 0, 10, 7, 21, 1, 19, 26, 8, 14, 31, 35, 16, 5, 29, 40, 11, 9, 4, 34, 15, 42, 32, 28, 18, 37, 30, 39, 24, 41, 3, 38, 27, 12, 44.

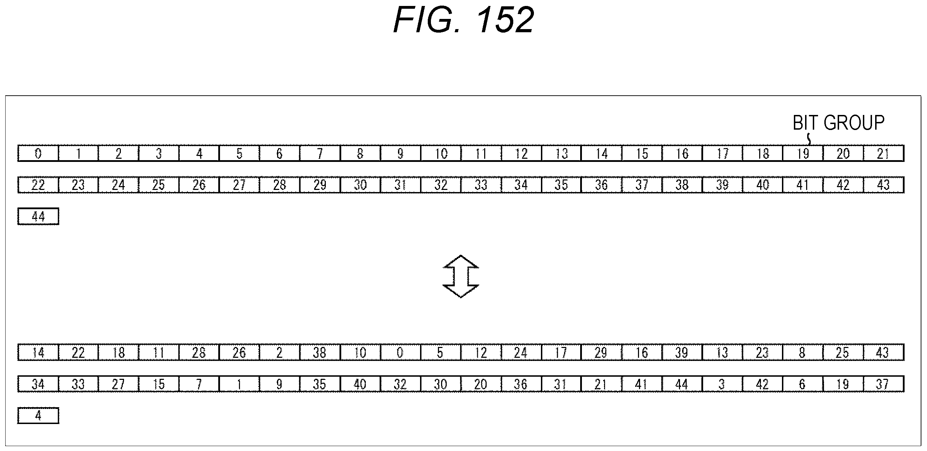

Fig. 152 is a diagram showing an eleventh example of a GW pattern for an LDPC code having a code length N of 16k bit.

According to the GW pattern shown in Fig. 152, arrangement of bit groups 0 through 44 of the 16k-bit LDPC code is interleaved to arrangement of 14, 22, 18, 11, 28, 26, 2, 38, 10, 0, 5, 12, 24, 17, 29, 16, 39, 13, 23, 8, 25, 43, 34, 33, 27, 15, 7, 1, 9, 35, 40, 32, 30, 20, 36, 31, 21, 41, 44, 3, 42, 6, 19, 37, 4.

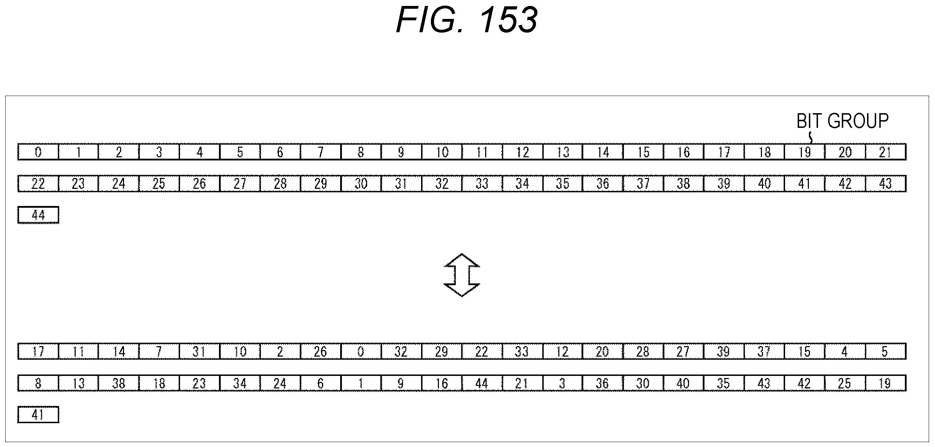

Fig. 153 is a diagram showing a twelfth example of a GW pattern for an LDPC code having a code length N of 16k bit.

According to the GW pattern shown in Fig. 153, arrangement of bit groups 0 through 44 of the 16k-bit LDPC code is interleaved to arrangement of 17, 11, 14, 7, 31, 10, 2, 26, 0, 32, 29, 22, 33, 12, 20, 28, 27, 39, 37, 15, 4, 5, 8, 13, 38, 18, 23, 34, 24, 6, 1, 9, 16, 44, 21, 3, 36, 30, 40, 35, 43, 42, 25, 19, 41.

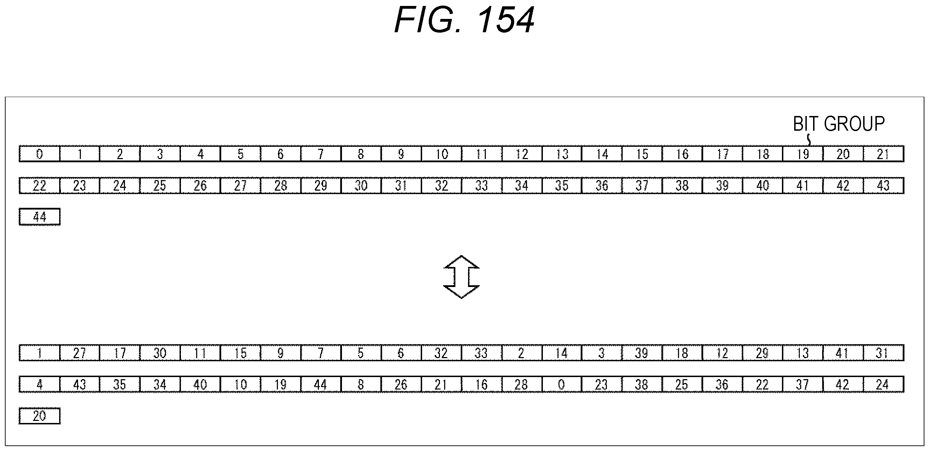

Fig. 154 is a diagram showing a thirteen example of a GW pattern for an LDPC code having a code length N of 16k bit.

According to the GW pattern shown in Fig. 154, arrangement of bit groups 0 through 44 of the 16k-bit LDPC code is interleaved to arrangement of 1, 27, 17, 30, 11, 15, 9, 7, 5, 6, 32, 33, 2, 14, 3, 39, 18, 12, 29, 13, 41, 31, 4, 43, 35, 34, 40, 10, 19, 44, 8, 26, 21, 16, 28, 0, 23, 38, 25, 36, 22, 37, 42, 24, 20.

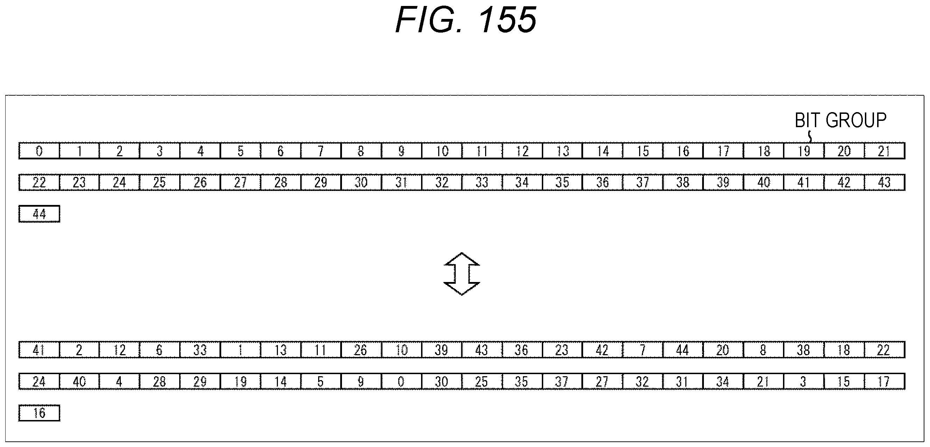

Fig. 155 is a diagram showing a fourteenth example of a GW pattern for an LDPC code having a code length N of 16k bit.

According to the GW pattern shown in Fig. 155, arrangement of bit groups 0 through 44 of the 16k-bit LDPC code is interleaved to arrangement of 41, 2, 12, 6, 33, 1, 13, 11, 26, 10, 39, 43, 36, 23, 42, 7, 44, 20, 8, 38, 18, 22, 24, 40, 4, 28, 29, 19, 14, 5, 9, 0, 30, 25, 35, 37, 27, 32, 31, 34, 21, 3, 15, 17, 16.

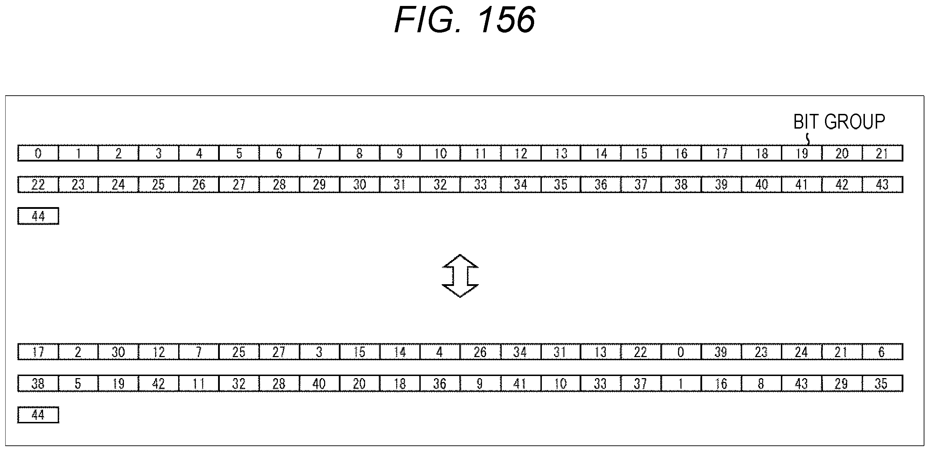

Fig. 156 is a diagram showing a fifteenth example of a GW pattern for an LDPC code having a code length N of 16k bit.

According to the GW pattern shown in Fig. 156, arrangement of bit groups 0 through 44 of the 16k-bit LDPC code is interleaved to arrangement of 17, 2, 30, 12, 7, 25, 27, 3, 15, 14, 4, 26, 34, 31, 13, 22, 0, 39, 23, 24, 21, 6, 38, 5, 19, 42, 11, 32, 28, 40, 20, 18, 36, 9, 41, 10, 33, 37, 1, 16, 8, 43, 29, 35, 44.

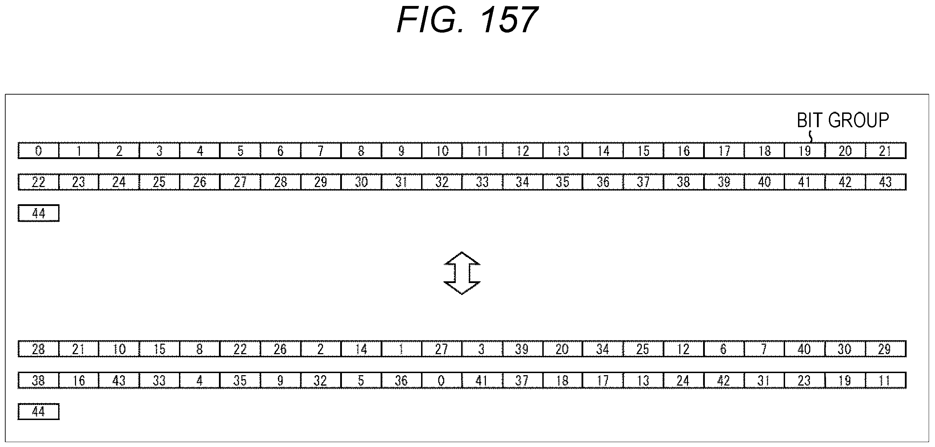

Fig. 157 is a diagram showing a sixteenth example of a GW pattern for an LDPC code having a code length N of 16k bit.

According to the GW pattern shown in Fig. 157, arrangement of bit groups 0 through 44 of the 16k-bit LDPC code is interleaved to arrangement of 28, 21, 10, 15, 8, 22, 26, 2, 14, 1, 27, 3, 39, 20, 34, 25, 12, 6, 7, 40, 30, 29, 38, 16, 43, 33, 4, 35, 9, 32, 5, 36, 0, 41, 37, 18, 17, 13, 24, 42, 31, 23, 19, 11, 44.

The first through sixteenth examples of the GW pattern for the LDPC code having the code length N f 16k bits are applicable to any combinations of the LDPC code having the code length N of 16k bits and the coding rate r, and the modulation system (constellation).

However, in case of group-wise interleave, error rates of the respective combinations further improve when the GW pattern to be adopted is individually set for each of combinations of the code length N of the LDPC code, the coding rate r of the LDPC code, and the modulation system (constellation), as described above.

The GW pattern shown in Fig. 142 particularly achieves preferable error rates when applied to the combination of the (16k, 6/15) LGE code and QPSK shown in Fig. 89, for example.

The GW pattern shown in Fig. 143 particularly achieves preferable error rates when applied to the combination of the (16k, 8/15) Sony code and QPSK shown in Fig. 89, for example.

The GW pattern shown in Fig. 144 particularly achieves preferable error rates when applied to the combination of the (16k, 10/15) Sony code and QPSK shown in Fig. 89, for example.

The GW pattern shown in Fig. 145 particularly achieves preferable error rates when applied to the combination of the (16k, 12/15) Sony code and QPSK shown in Fig. 89, for example.

The GW pattern shown in Fig. 146 particularly achieves preferable error rates when applied to the combination of the (16k, 6/15) LGE code and 16QAM shown in Fig. 101, for example.

The GW pattern shown in Fig. 147 particularly achieves preferable error rates when applied to the combination of the (16k, 8/15) Sony code and 16QAM shown in Fig. 101, for example.

The GW pattern shown in Fig. 148 particularly achieves preferable error rates when applied to the combination of the (16k, 10/15) Sony code and 16QAM shown in Fig. 101, for example.

The GW pattern shown in Fig. 149 particularly achieves preferable error rates when applied to the combination of the (16k, 12/15) Sony code and 16QAM shown in Fig. 101, for example.

The GW pattern shown in Fig. 150 particularly achieves preferable error rates when applied to the combination of the (16k, 6/15) LGE code and 64QAM shown in Fig. 102, for example.

The GW pattern shown in Fig. 151 particularly achieves preferable error rates when applied to the combination of the (16k, 8/15) Sony code and 64QAM shown in Fig. 102, for example.

The GW pattern shown in Fig. 152 particularly achieves preferable error rates when applied to the combination of the (16k, 10/15) Sony code and 64QAM shown in Fig. 102, for example.

The GW pattern shown in Fig. 153 particularly achieves preferable error rates when applied to the combination of the (16k, 12/15) Sony code and 64QAM shown in Fig. 102, for example.

The GW pattern shown in Fig. 154 particularly achieves preferable error rates when applied to the combination of the (16k, 6/15) LGE code and 256QAM shown in Figs. 103 and 104, for example.

The GW pattern shown in Fig. 155 particularly achieves preferable error rates when applied to the combination of the (16k, 8/15) Sony code and 256QAM shown in Figs. 103 and 104, for example.

The GW pattern shown in Fig. 156 particularly achieves preferable error rates when applied to the combination of the (16k, 10/15) Sony code and 256QAM shown in Figs. 103 and 104, for example.

The GW pattern shown in Fig. 157 particularly achieves preferable error rates when applied to the combination of the (16k, 12/15) Sony code and 256QAM shown in Figs. 103 and 104, for example.

<Simulation results>

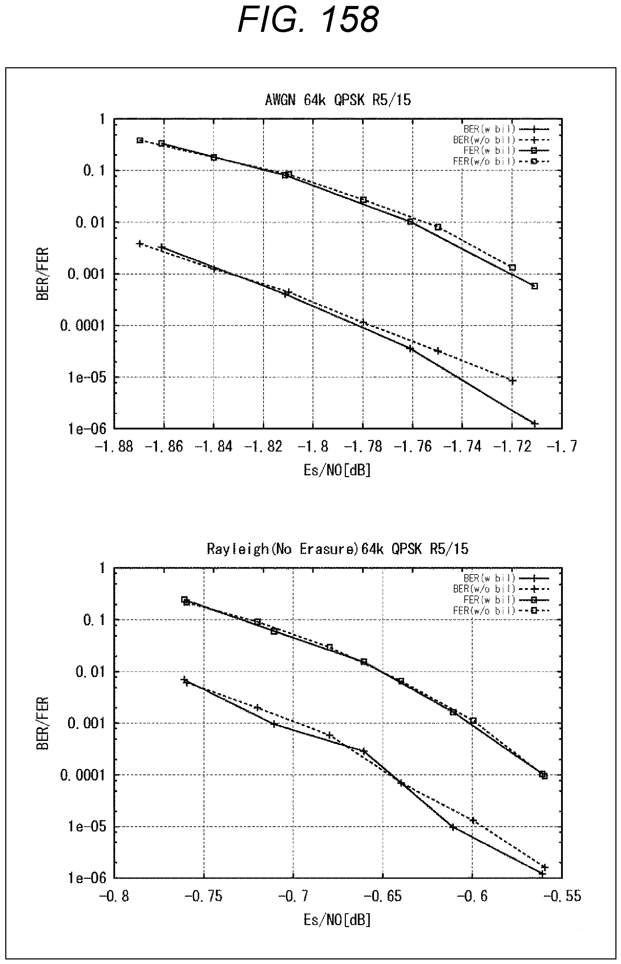

Fig. 158 is a diagram showing a BER/FER curve indicating results of simulation for measuring error rates produced when the GW pattern shown in Fig. 109 is adopted to the combination of the (64k, 5/15) ETRI code and QPSK shown in Fig. 89.

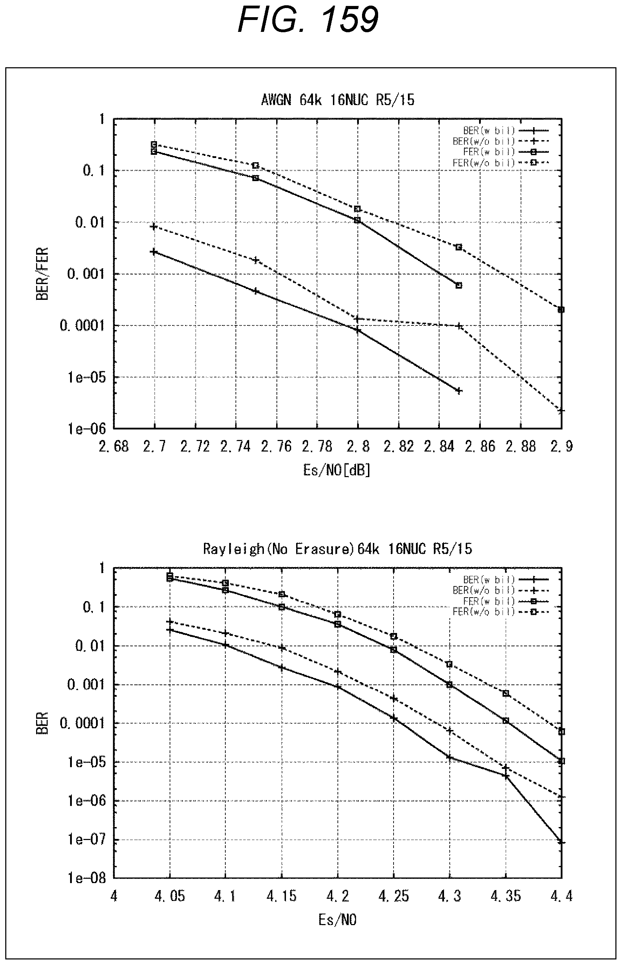

Fig. 159 is a diagram showing a BER/FER curve indicating results of simulation for measuring error rates produced when the GW pattern shown in Fig. 110 is adopted to the combination of the (64k, 5/15) ETRI code and 16QAM shown in Fig. 90.

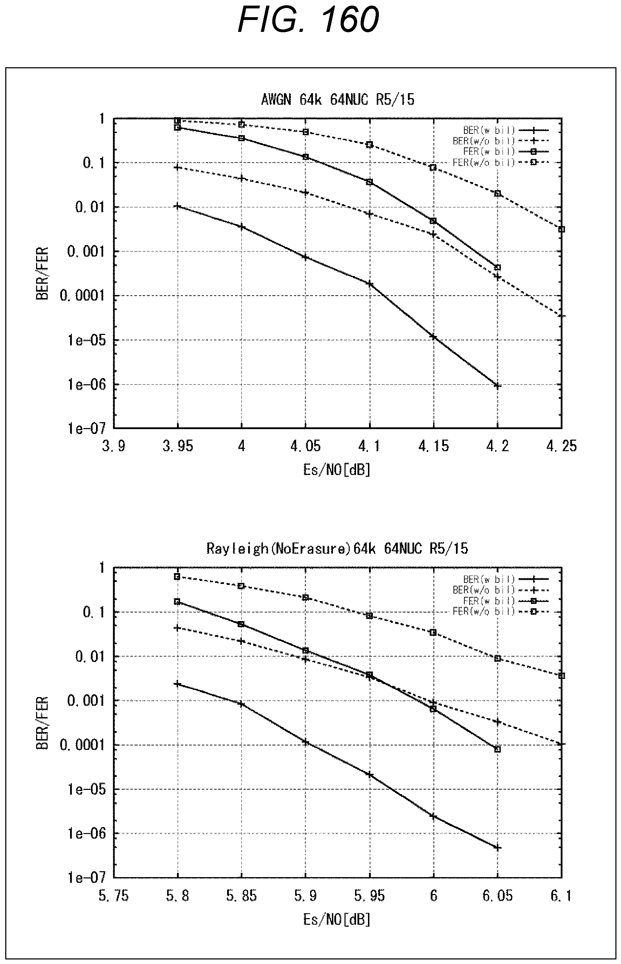

Fig. 160 is a diagram showing a BER/FER curve indicating results of simulation for measuring error rates produced when the GW pattern shown in Fig. 111 is adopted to the combination of the (64k, 5/15) ETRI code and 64QAM shown in Fig. 91.

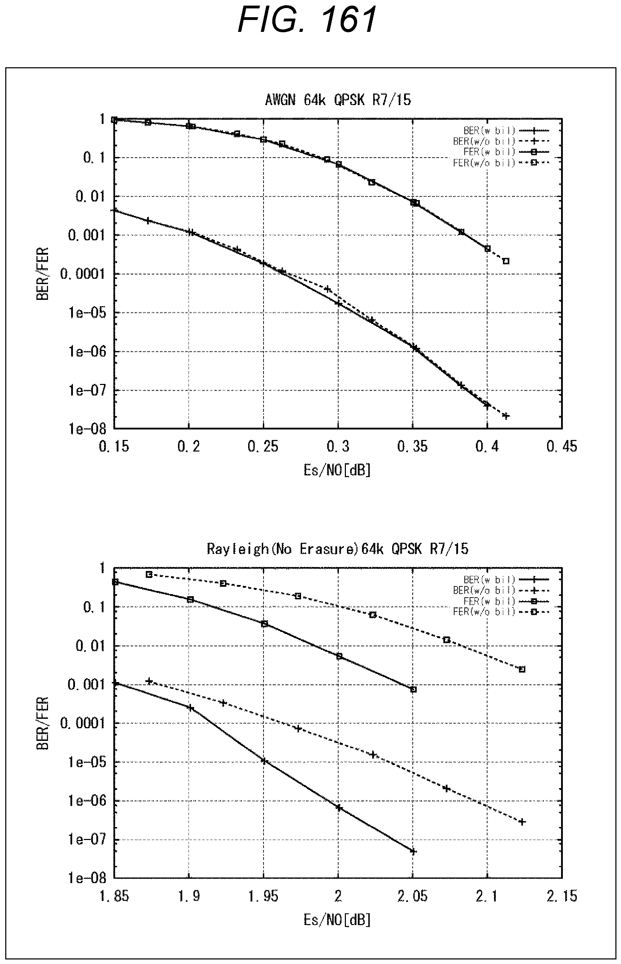

Fig. 161 is a diagram showing a BER/FER curve indicating results of simulation for measuring error rates produced when the GW pattern shown in Fig. 112 is adopted to the combination of the (64k, 7/15) Sony code and QPSK shown in Fig. 89.

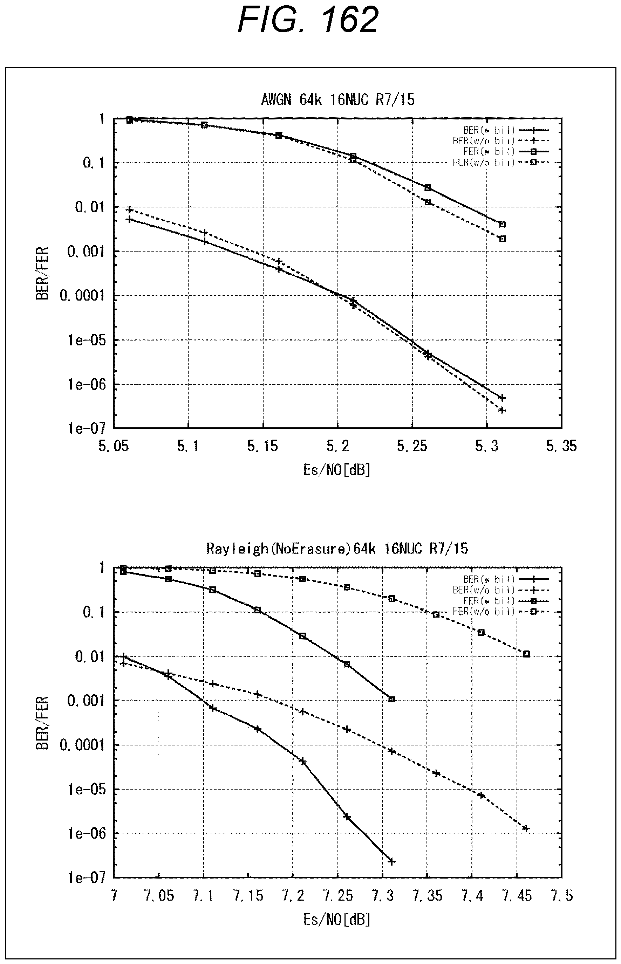

Fig. 162 is a diagram showing a BER/FER curve indicating results of simulation for measuring error rates produced when the GW pattern shown in Fig. 113 is adopted to the combination of the (64k, 7/15) Sony code and 16QAM shown in Fig. 90.

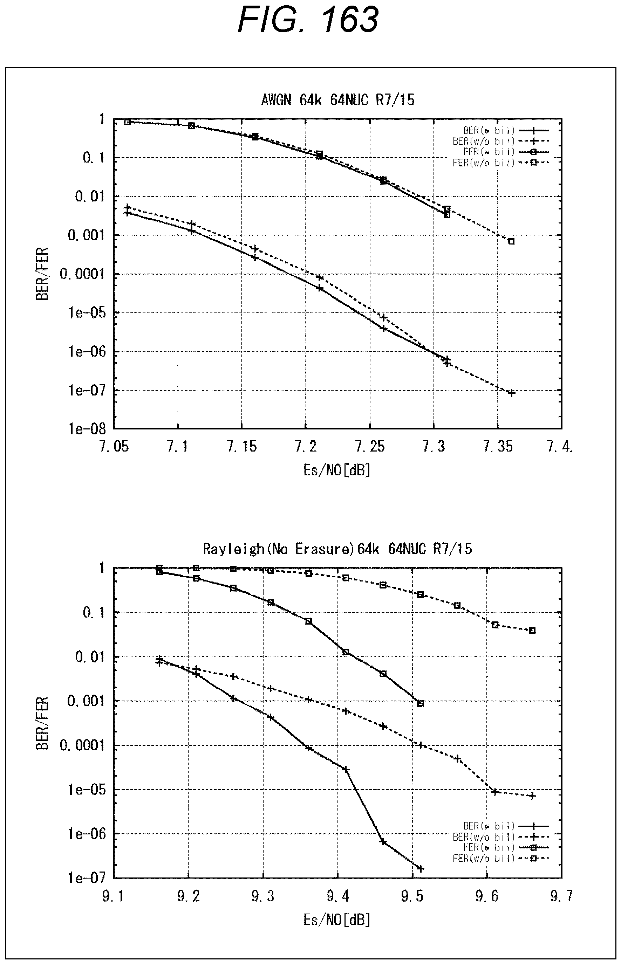

Fig. 163 is a diagram showing a BER/FER curve indicating results of simulation for measuring error rates produced when the GW pattern shown in Fig. 114 is adopted to the combination of the (64k, 7/15) Sony code and 64QAM shown in Fig. 91.

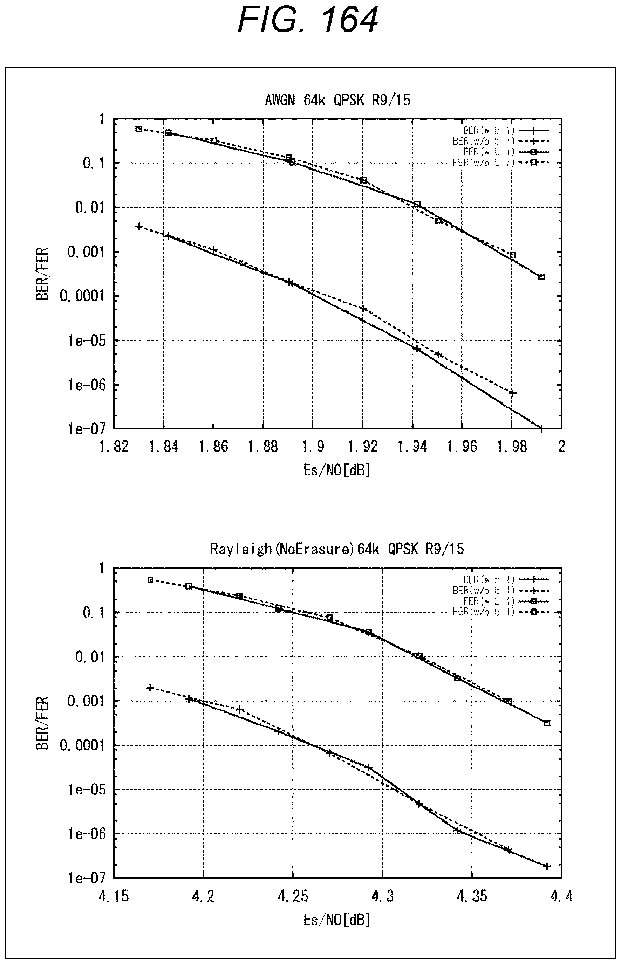

Fig. 164 is a diagram showing a BER/FER curve indicating results of simulation for measuring error rates produced when the GW pattern shown in Fig. 115 is adopted to the combination of the (64k, 9/15) Sony code and QPSK shown in Fig. 89.

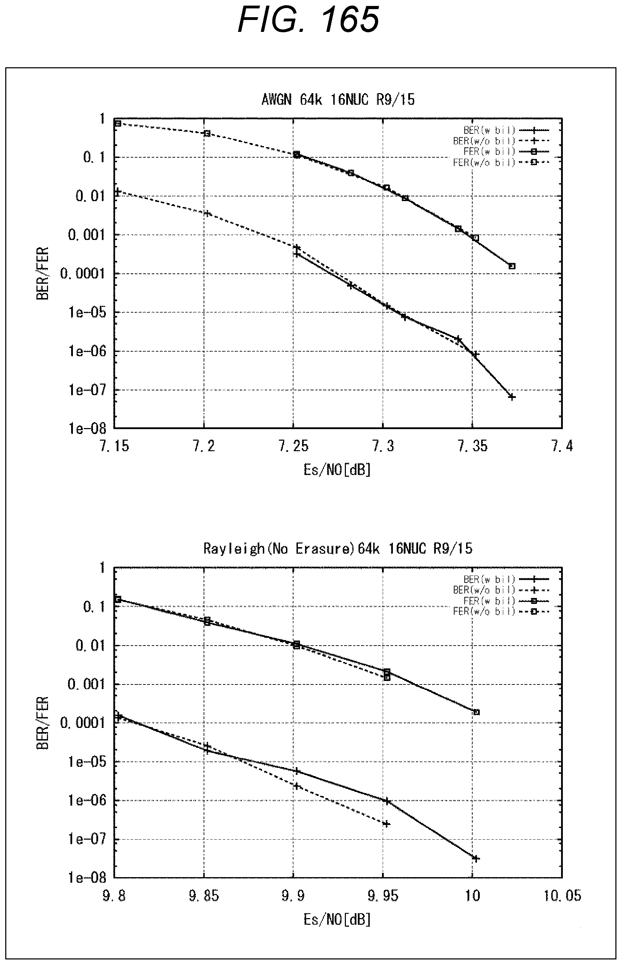

Fig. 165 is a diagram showing a BER/FER curve indicating results of simulation for measuring error rates produced when the GW pattern shown in Fig. 116 is adopted to the combination of the (64k, 9/15) Sony code and 16QAM shown in Fig. 90.

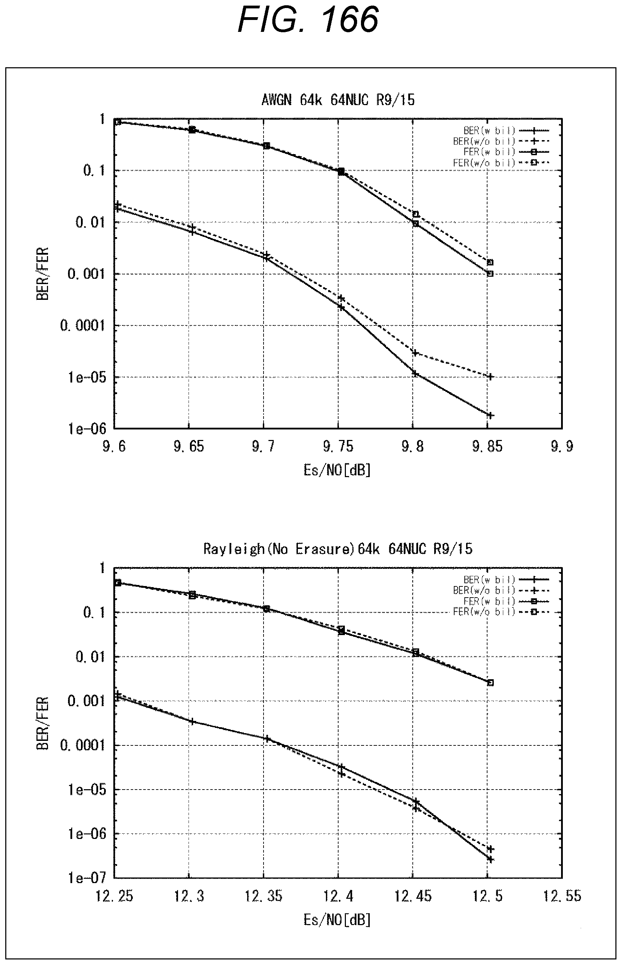

Fig. 166 is a diagram showing a BER/FER curve indicating results of simulation for measuring error rates produced when the GW pattern shown in Fig. 117 is adopted to the combination of the (64k, 9/15) Sony code and 64QAM shown in Fig. 91.

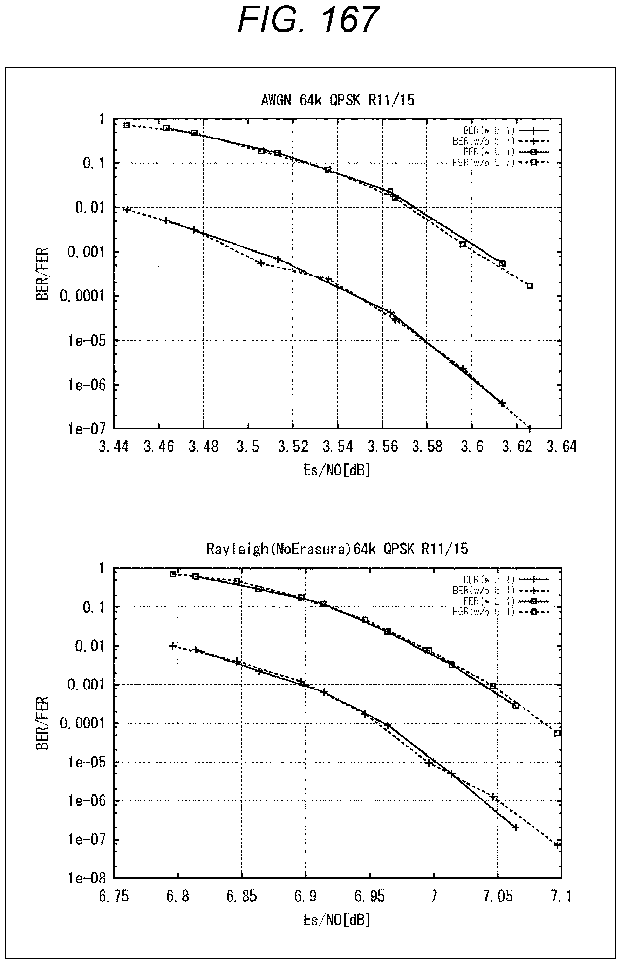

Fig. 167 is a diagram showing a BER/FER curve indicating results of simulation for measuring error rates produced when the GW pattern shown in Fig. 118 is adopted to the combination of the (64k, 11/15) Sony code and QPSK shown in Fig. 89.

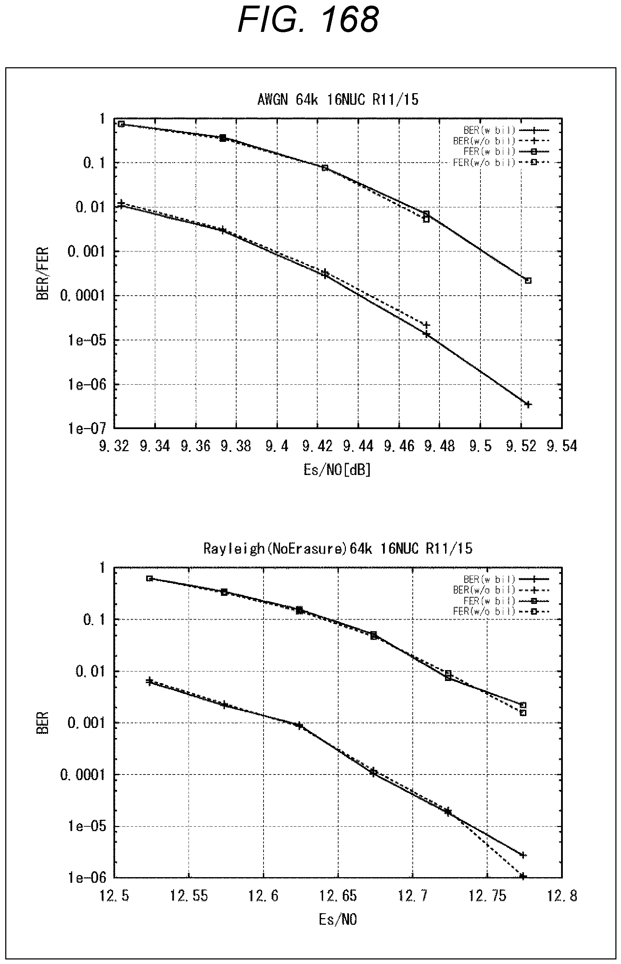

Fig. 168 is a diagram showing a BER/FER curve indicating results of simulation for measuring error rates produced when the GW pattern shown in Fig. 119 is adopted to the combination of the (64k, 11/15) Sony code and 16QAM shown in Fig. 90.

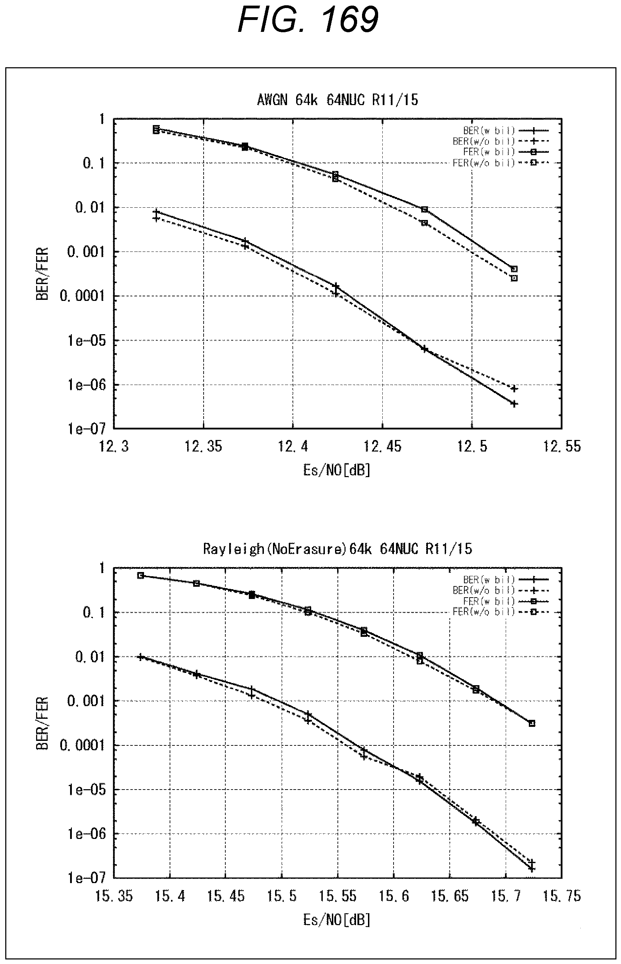

Fig. 169 is a diagram showing a BER/FER curve indicating results of simulation for measuring error rates produced when the GW pattern shown in Fig. 120 is adopted to the combination of the (64k, 11/15) Sony code and 64QAM shown in Fig. 91.

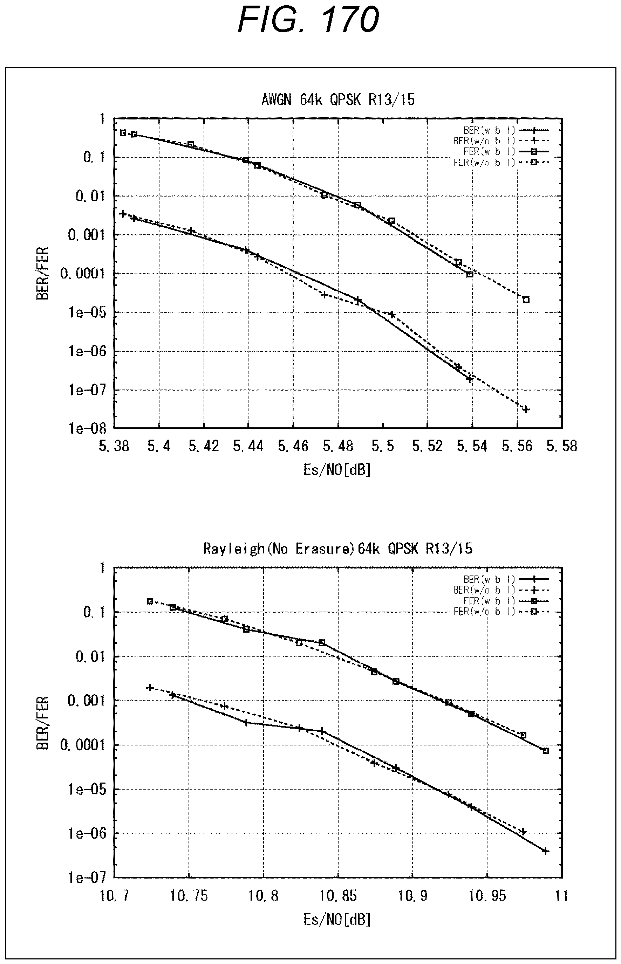

Fig. 170 is a diagram showing a BER/FER curve indicating results of simulation for measuring error rates produced when the GW pattern shown in Fig. 121 is adopted to the combination of the (64k, 13/15) Sony code and QPSK shown in Fig. 89.

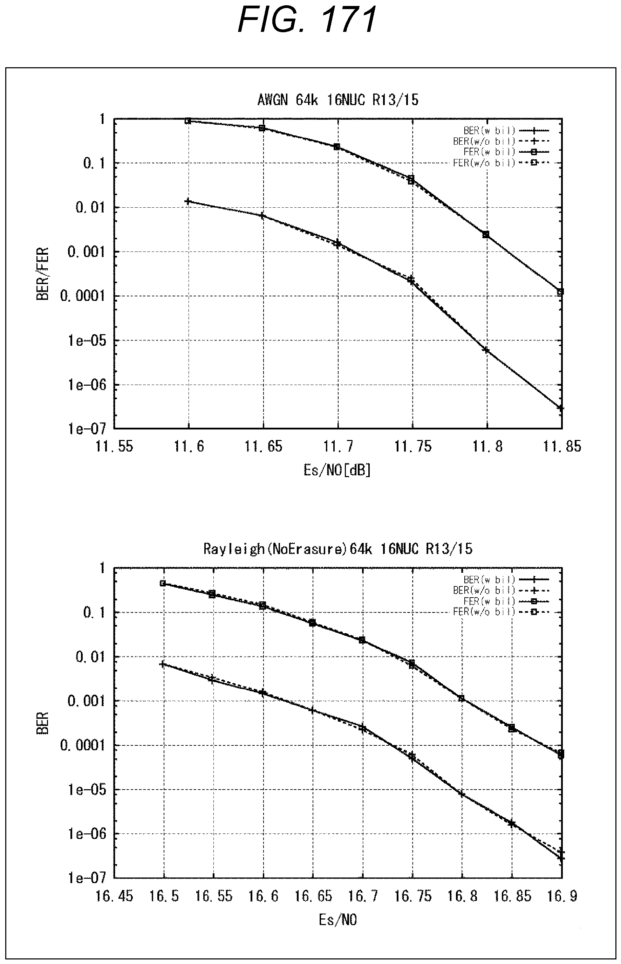

Fig. 171 is a diagram showing a BER/FER curve indicating results of simulation for measuring error rates produced when the GW pattern shown in Fig. 122 is adopted to the combination of the (64k, 13/15) Sony code and 16QAM shown in Fig. 90.

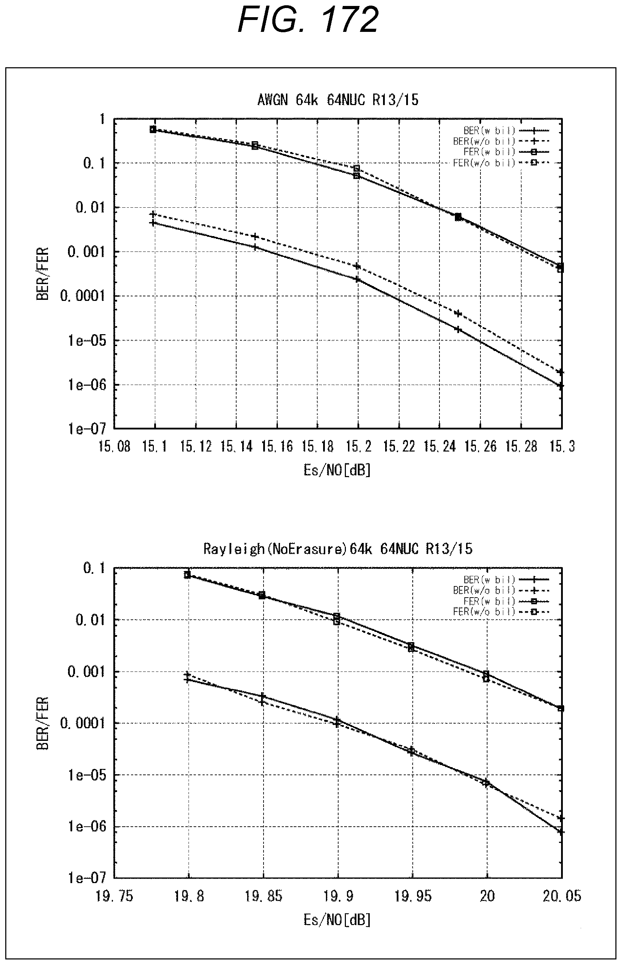

Fig. 172 is a diagram showing a BER/FER curve indicating results of simulation for measuring error rates produced when the GW pattern shown in Fig. 123 is adopted to the combination of the (64k, 13/15) Sony code and 64QAM shown in Fig. 91.

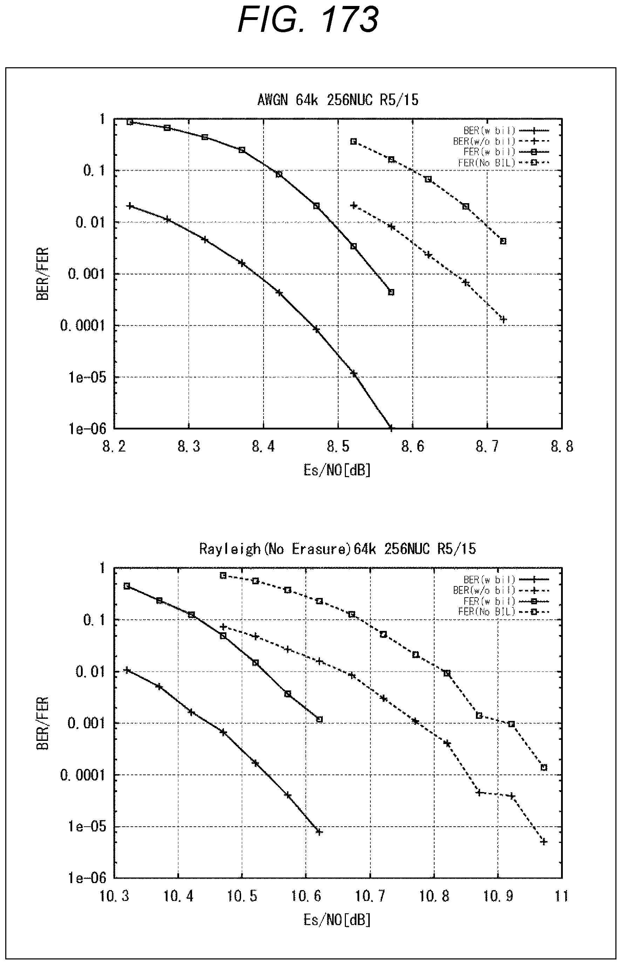

Fig. 173 is a diagram showing a BER/FER curve indicating results of simulation for measuring error rates produced when the GW pattern shown in Fig. 124 is adopted to the combination of the (64k, 5/15) ETRI code and 256QAM shown in Figs. 92 and 93.

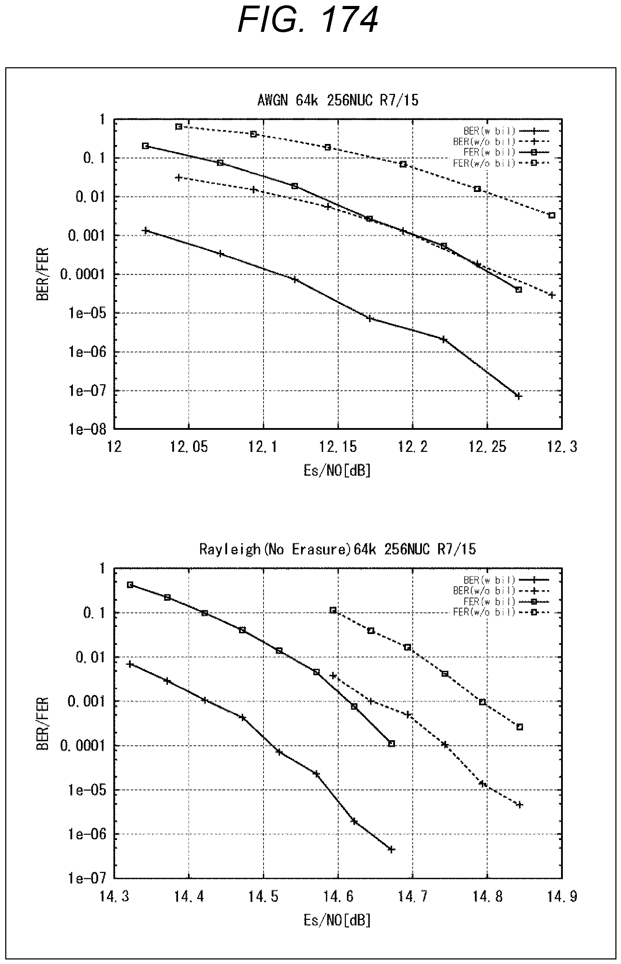

Fig. 174 is a diagram showing a BER/FER curve indicating results of simulation for measuring error rates produced when the GW pattern shown in Fig. 125 is adopted to the combination of the (64k, 7/15) ETRI code and 256QAM shown in Figs. 92 and 93.

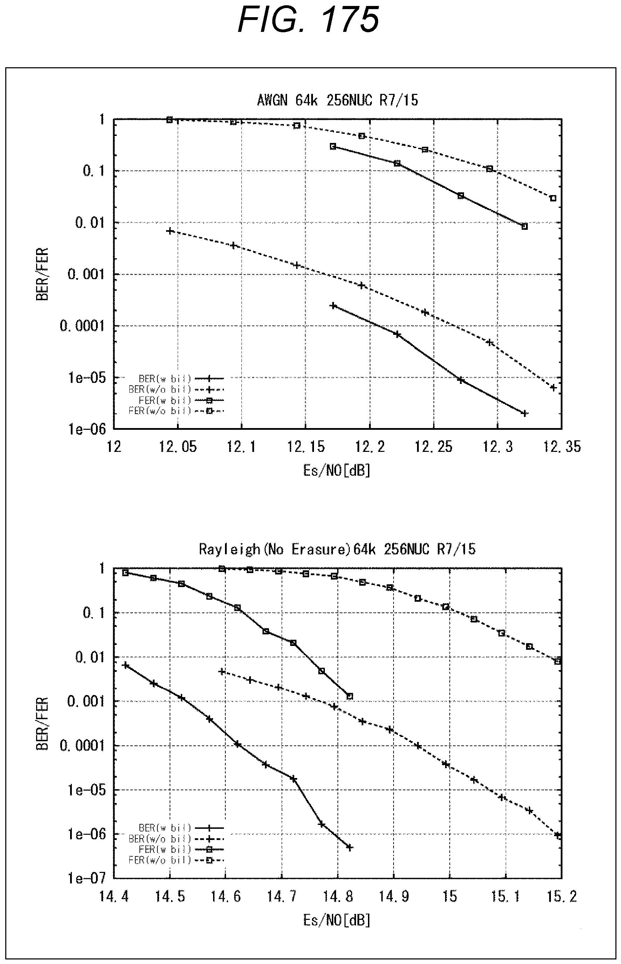

Fig. 175 is a diagram showing a BER/FER curve indicating results of simulation for measuring error rates produced when the GW pattern shown in Fig. 126 is adopted to the combination of the (64k, 7/15) Sony code and 256QAM shown in Figs. 92 and 93.

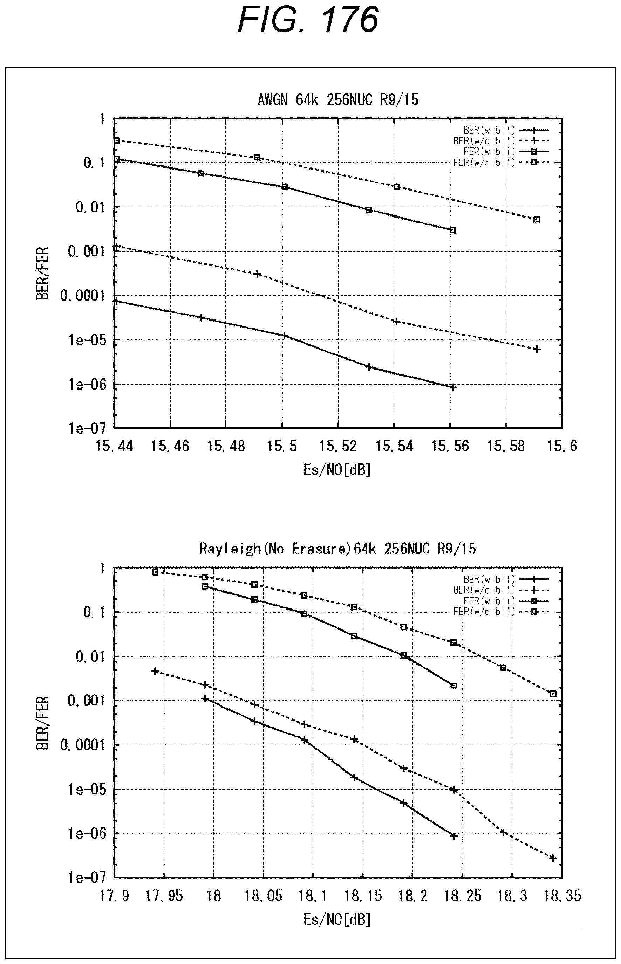

Fig. 176 is a diagram showing a BER/FER curve indicating results of simulation for measuring error rates produced when the GW pattern shown in Fig. 127 is adopted to the combination of the (64k, 9/15) Sony code and 256QAM shown in Figs. 92 and 93.

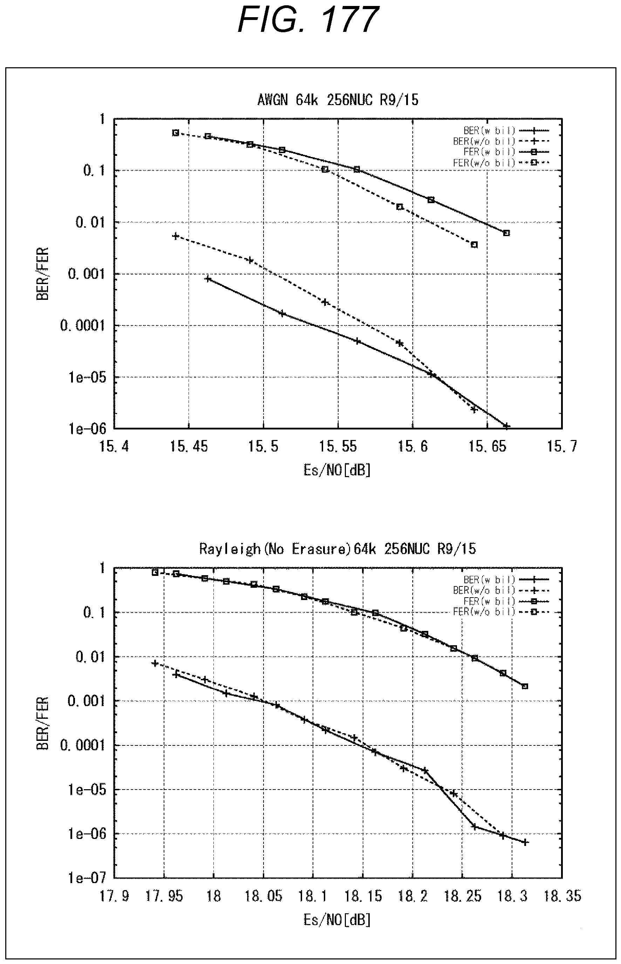

Fig. 177 is a diagram showing a BER/FER curve indicating results of simulation for measuring error rates produced when the GW pattern shown in Fig. 128 is adopted to the combination of the (64k, 9/15) NERC code and 256QAM shown in Figs. 92 and 93.

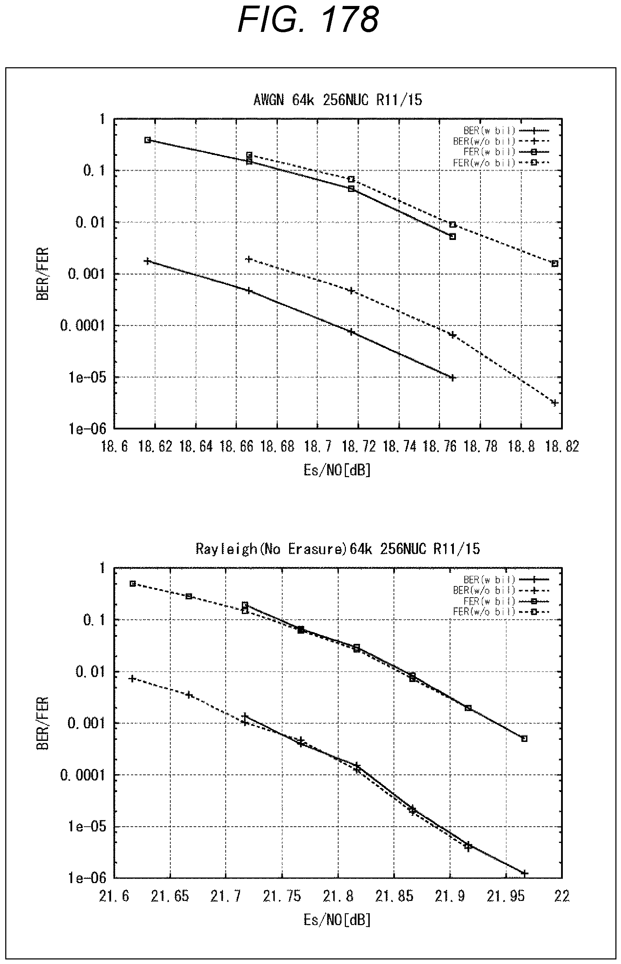

Fig. 178 is a diagram showing a BER/FER curve indicating results of simulation for measuring error rates produced when the GW pattern shown in Fig. 129 is adopted to the combination of the (64k, 11/15) Sony code and 256QAM shown in Figs. 92 and 93.

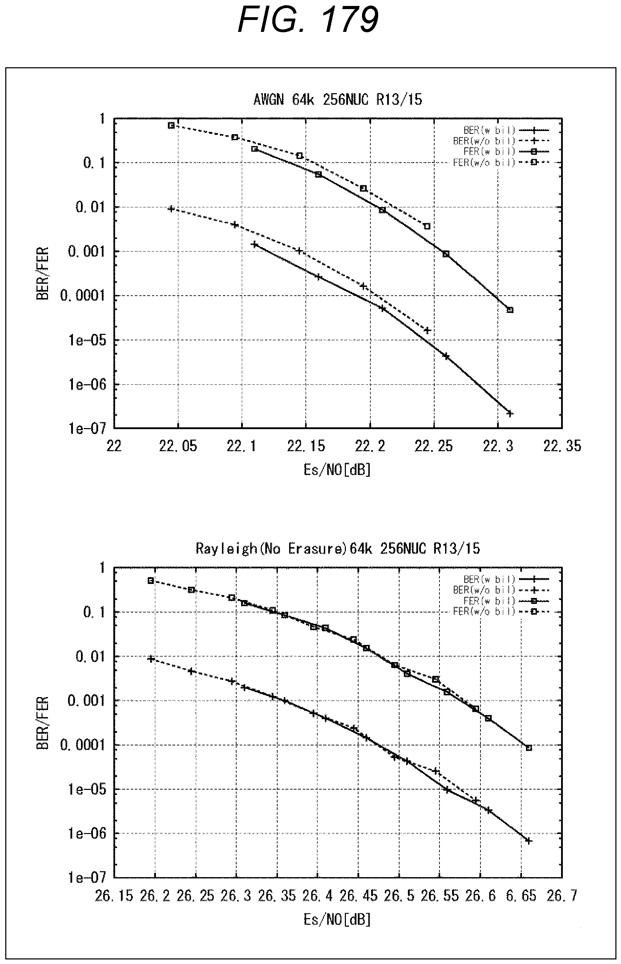

Fig. 179 is a diagram showing a BER/FER curve indicating results of simulation for measuring error rates produced when the GW pattern shown in Fig. 130 is adopted to the combination of the (64k, 13/15) Sony code and 256QAM shown in Figs. 92 and 93.

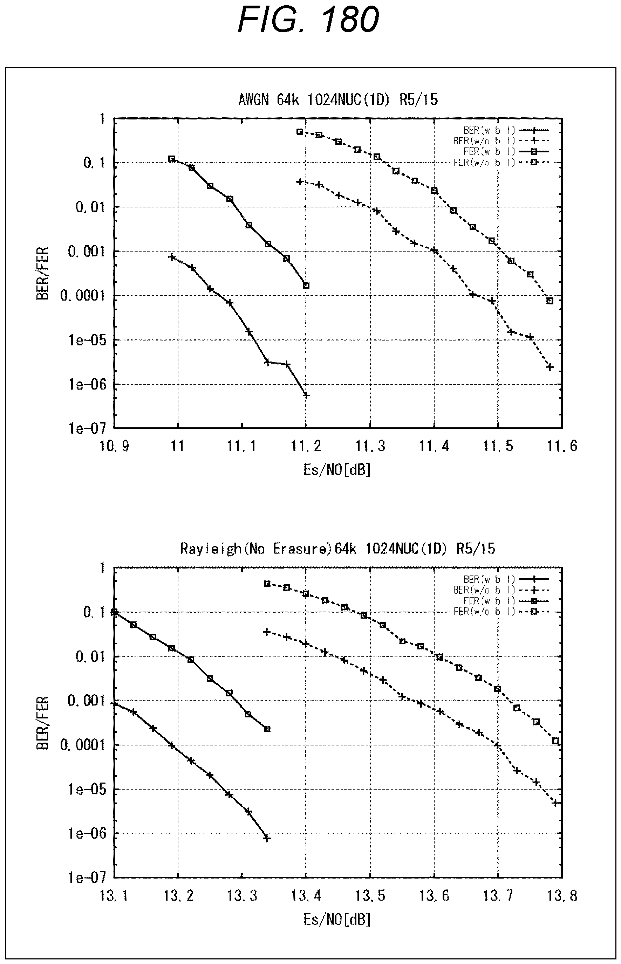

Fig. 180 is a diagram showing a BER/FER curve indicating results of simulation for measuring error rates produced when the GW pattern shown in Fig. 131 is adopted to the combination of the (64k, 5/15) ETRI code and 1024QAM shown in Figs. 94 and 95.

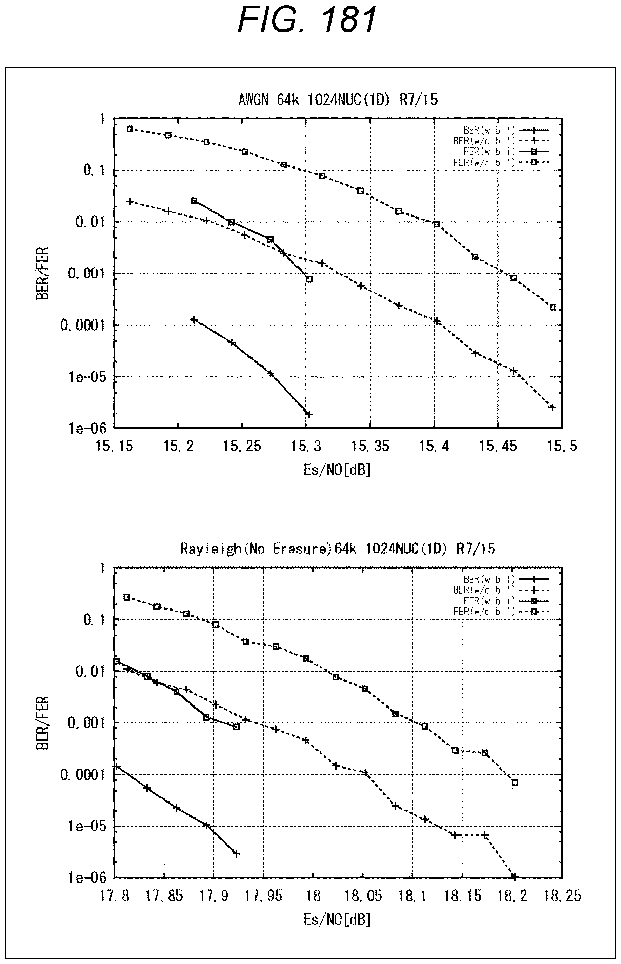

Fig. 181 is a diagram showing a BER/FER curve indicating results of simulation for measuring error rates produced when the GW pattern shown in Fig. 132 is adopted to the combination of the (64k, 7/15) ETRI code and 1024QAM shown in Figs. 94 and 95.

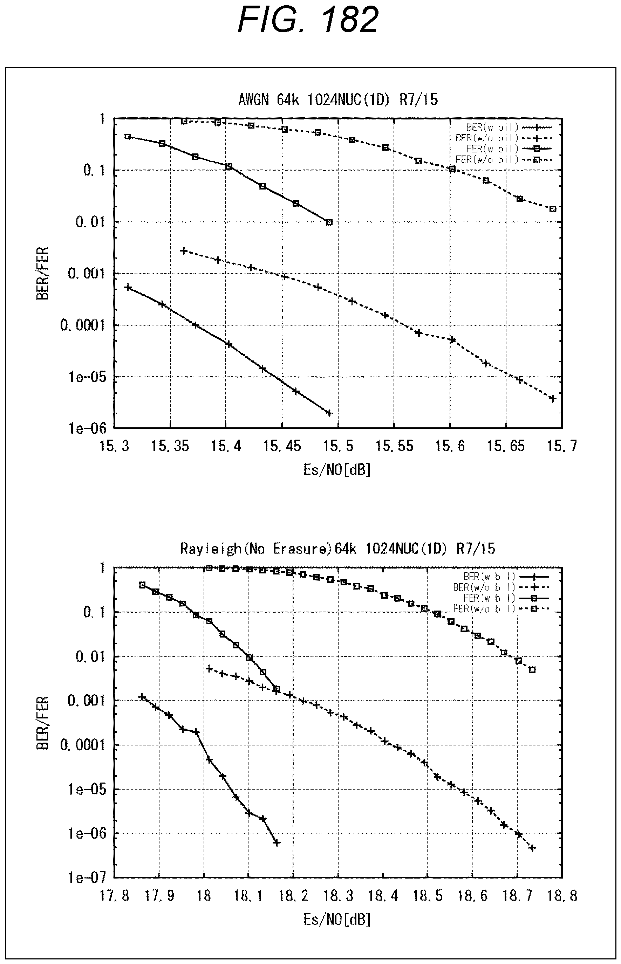

Fig. 182 is a diagram showing a BER/FER curve indicating results of simulation for measuring error rates produced when the GW pattern shown in Fig. 133 is adopted to the combination of the (64k, 7/15) Sony code and 1024QAM shown in Figs. 94 and 95.

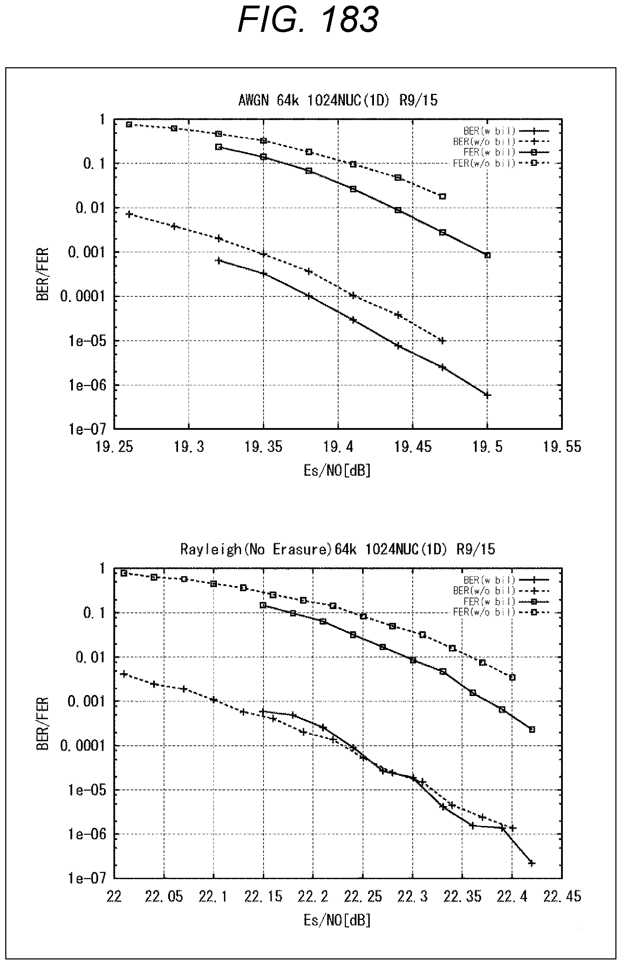

Fig. 183 is a diagram showing a BER/FER curve indicating results of simulation for measuring error rates produced when the GW pattern shown in Fig. 134 is adopted to the combination of the (64k, 9/15) Sony code and 1024QAM shown in Figs. 94 and 95.

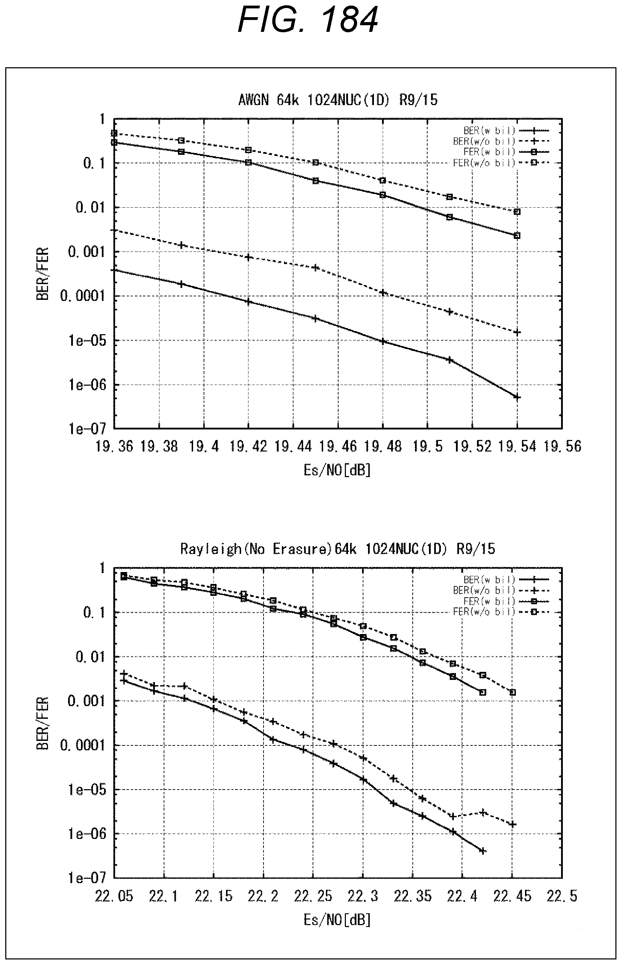

Fig. 184 is a diagram showing a BER/FER curve indicating results of simulation for measuring error rates produced when the GW pattern shown in Fig. 135 is adopted to the combination of the (64k, 9/15) NERC code and 1024QAM shown in Figs. 94 and 95.

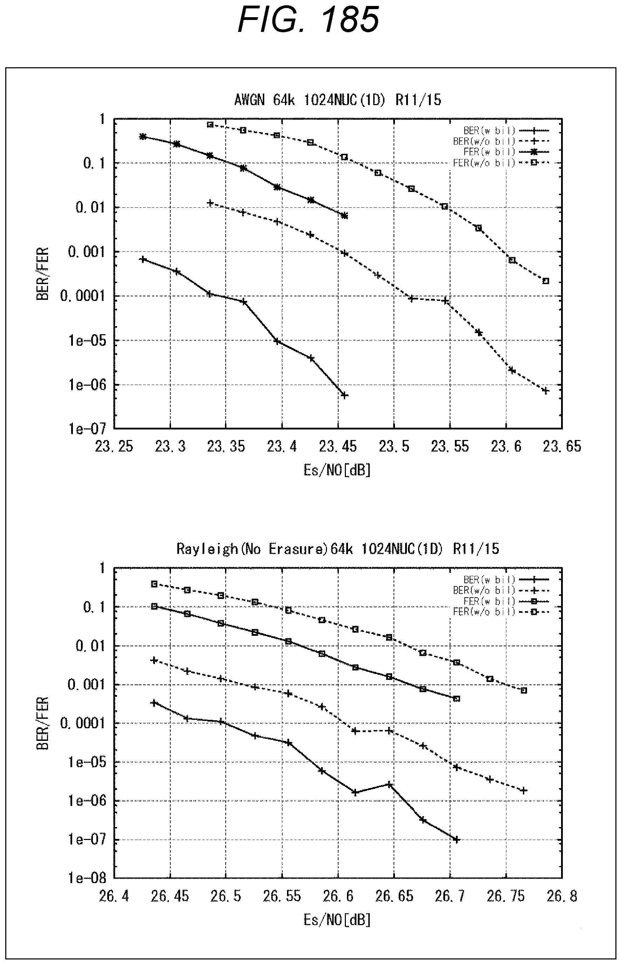

Fig. 185 is a diagram showing a BER/FER curve indicating results of simulation for measuring error rates produced when the GW pattern shown in Fig. 136 is adopted to the combination of the (64k, 11/15) Sony code and 1024QAM shown in Figs. 94 and 95.

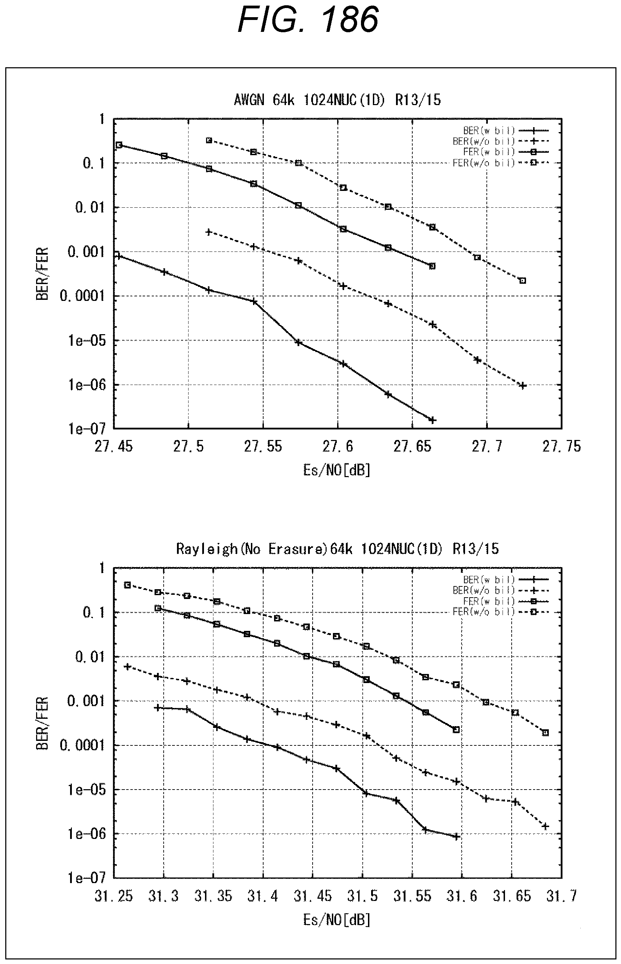

Fig. 186 is a diagram showing a BER/FER curve indicating results of simulation for measuring error rates produced when the GW pattern shown in Fig. 137 is adopted to the combination of the (64k, 13/15) Sony code and 1024QAM shown in Figs. 94 and 95.

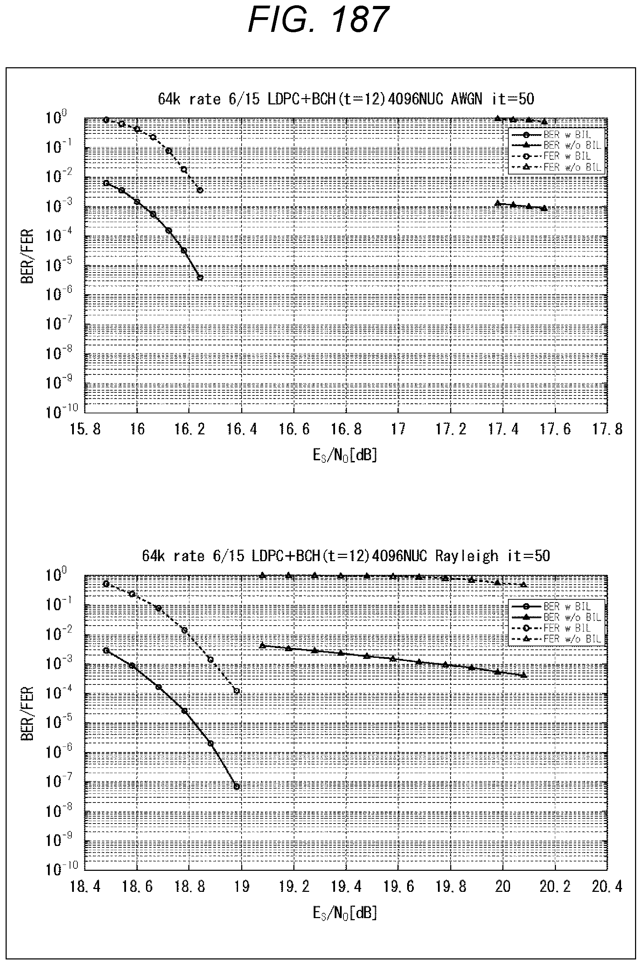

Fig. 187 is a diagram showing a BER/FER curve indicating results of simulation for measuring error rates produced when the GW pattern shown in Fig. 138 is adopted to the combination of the (64k, 6/15) Samsung code and 4096QAM shown in Figs. 96 and 97.

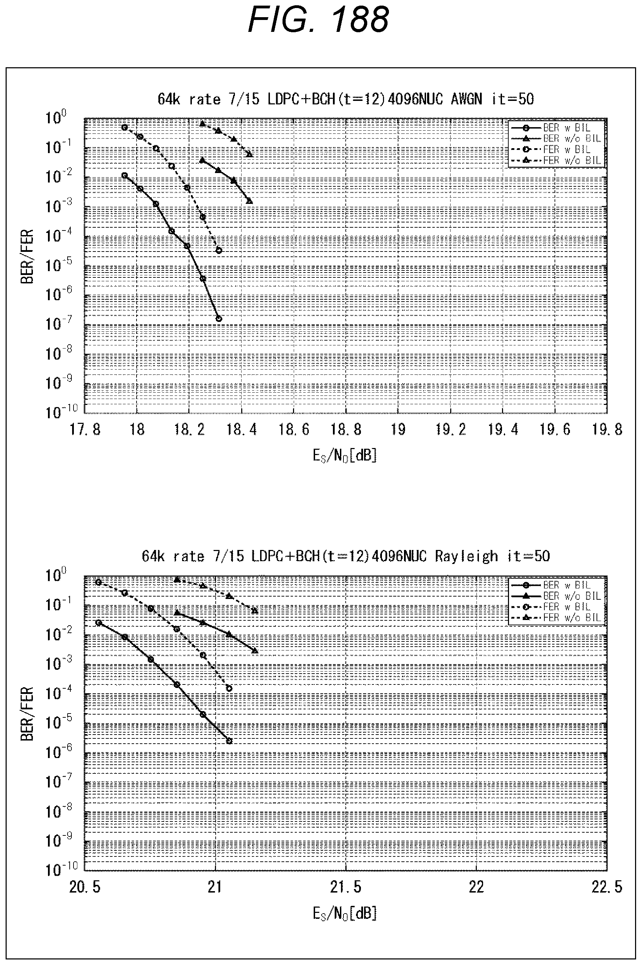

Fig. 188 is a diagram showing a BER/FER curve indicating results of simulation for measuring error rates produced when the GW pattern shown in Fig. 139 is adopted to the combination of the (64k, 7/15) ETRI code and 4096QAM shown in Figs. 96 and 97.

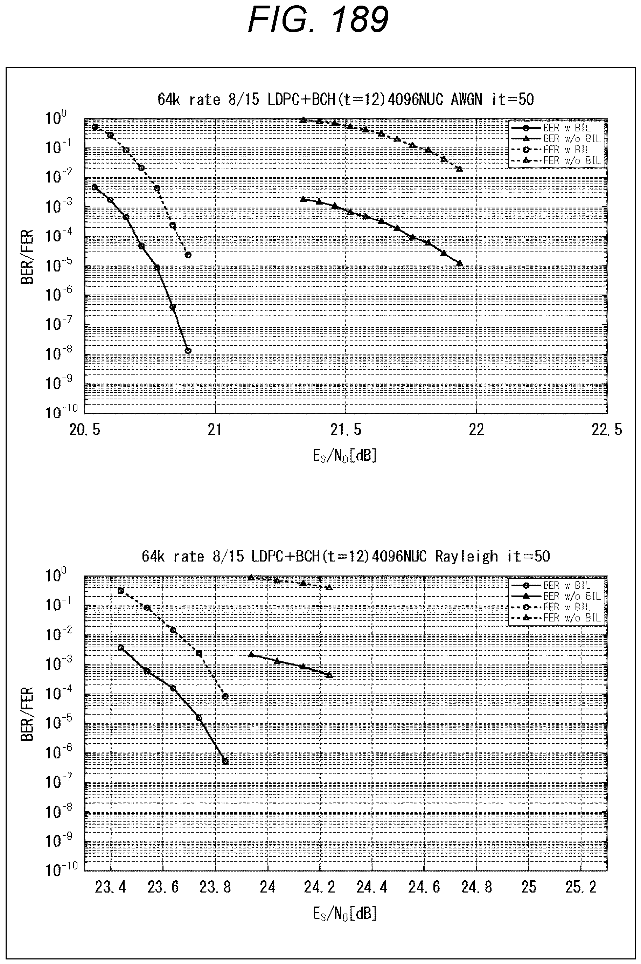

Fig. 189 is a diagram showing a BER/FER curve indicating results of simulation for measuring error rates produced when the GW pattern shown in Fig. 140 is adopted to the combination of the (64k, 8/15) Samsung code and 4096QAM shown in Figs. 96 and 97.

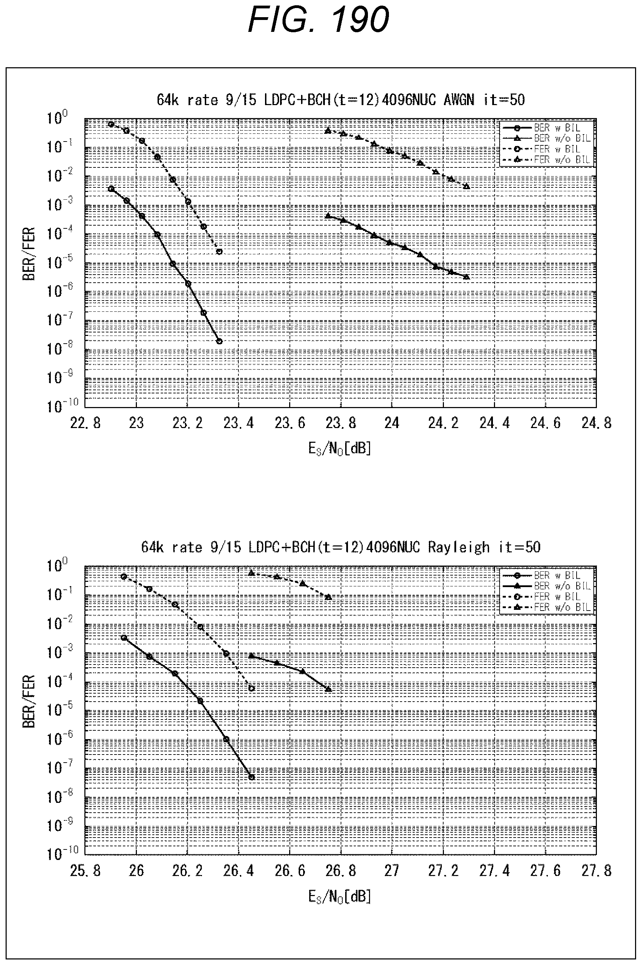

Fig. 190 is a diagram showing a BER/FER curve indicating results of simulation for measuring error rates produced when the GW pattern shown in Fig. 141 is adopted to the combination of the (64k, 9/15) Sony code and 4096QAM shown in Figs. 96 and 97.

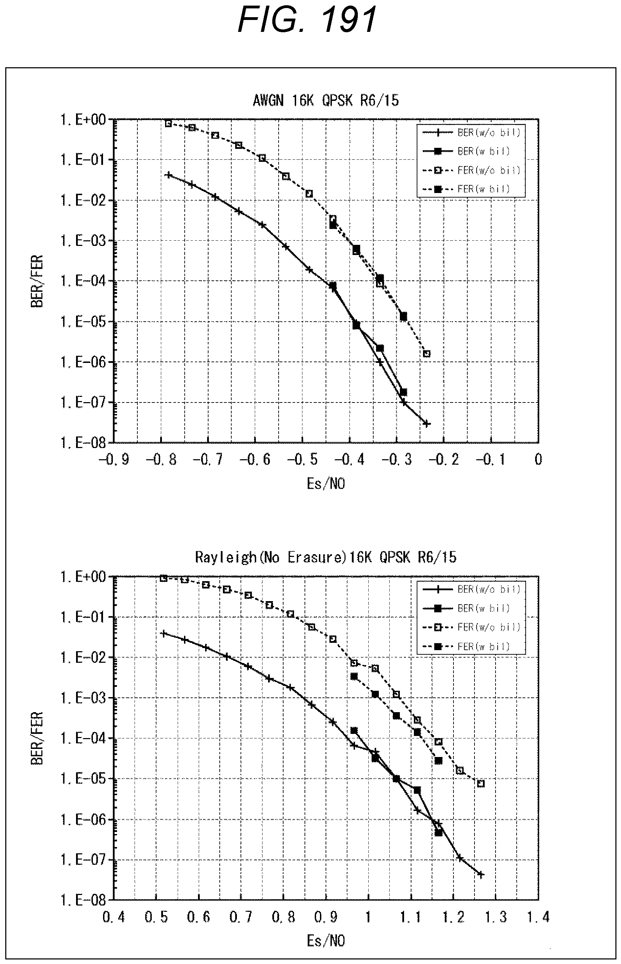

Fig. 191 is a diagram showing a BER/FER curve indicating results of simulation for measuring error rates produced when the GW pattern shown in Fig. 142 is adopted to the combination of the (16k, 6/15) LGE code and QPSK shown in Fig. 89.

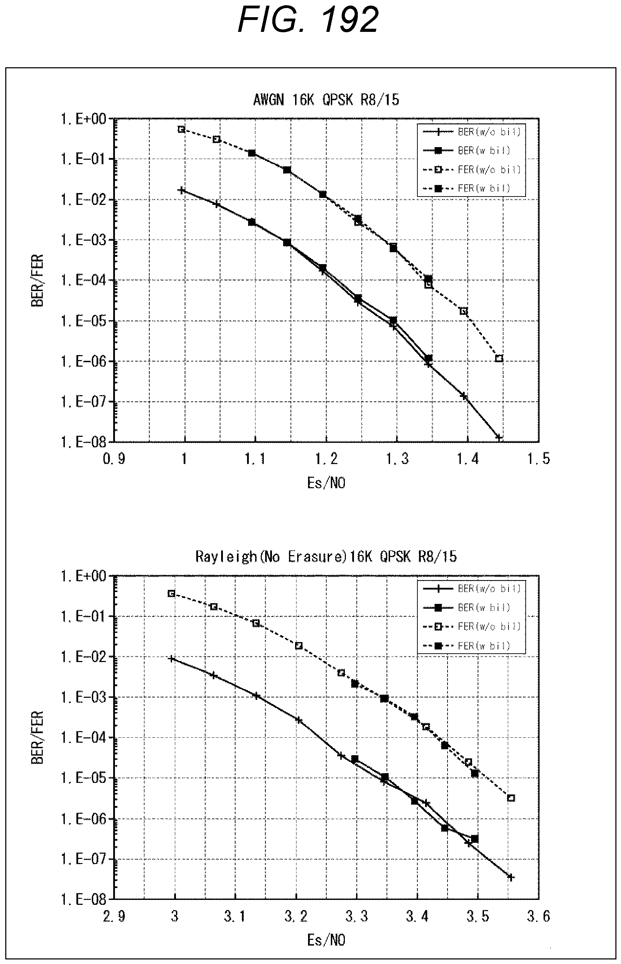

Fig. 192 is a diagram showing a BER/FER curve indicating results of simulation for measuring error rates produced when the GW pattern shown in Fig. 143 is adopted to the combination of the (16k, 8/15) Sony code and QPSK shown in Fig. 89.

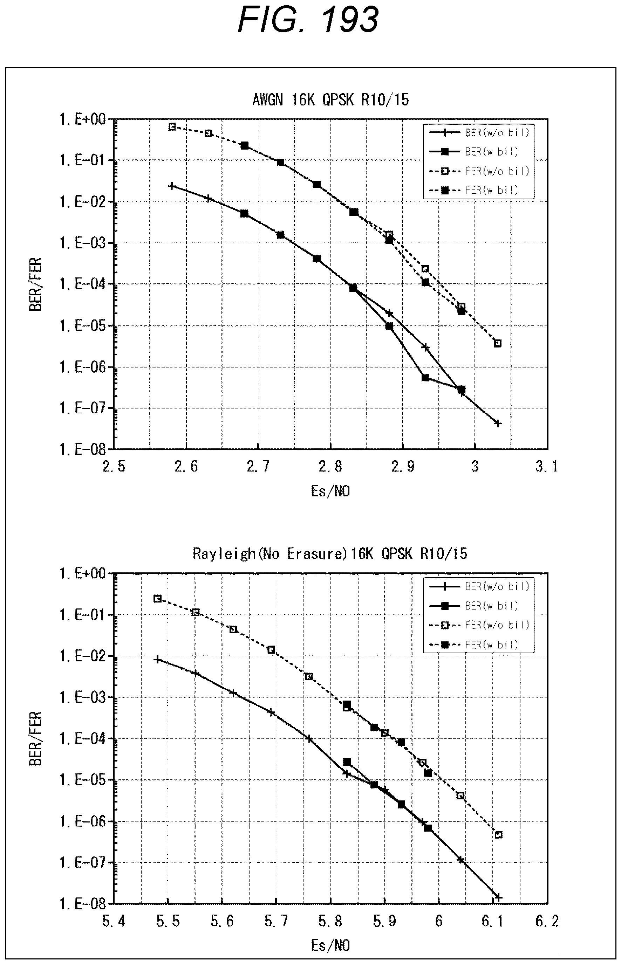

Fig. 193 is a diagram showing a BER/FER curve indicating results of simulation for measuring error rates produced when the GW pattern shown in Fig. 144 is adopted to the combination of the (16k, 10/15) Sony code and QPSK shown in Fig. 89.

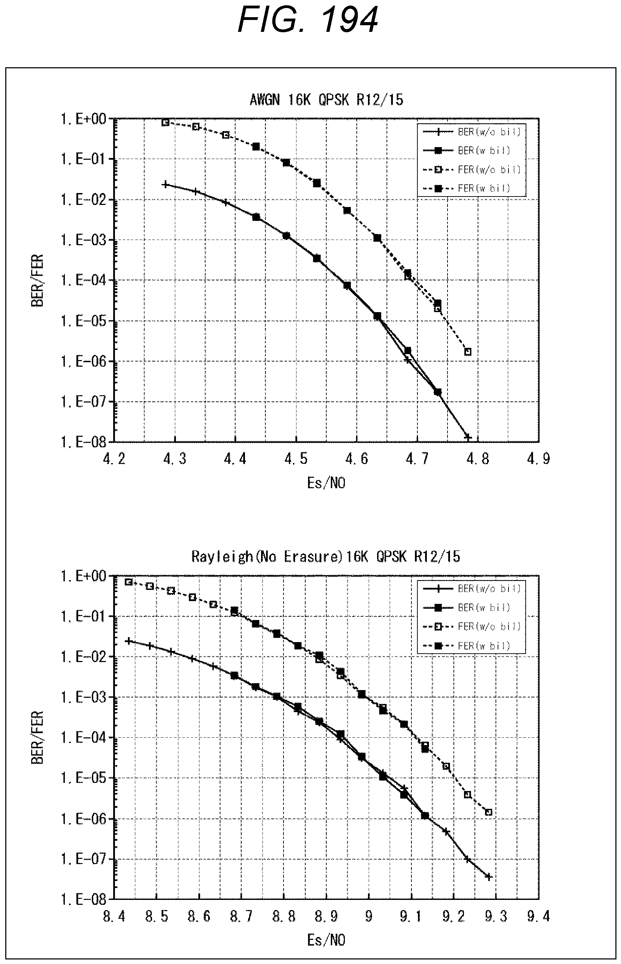

Fig. 194 is a diagram showing a BER/FER curve indicating results of simulation for measuring error rates produced when the GW pattern shown in Fig. 145 is adopted to the combination of the (16k, 12/15) Sony code and QPSK shown in Fig. 89.

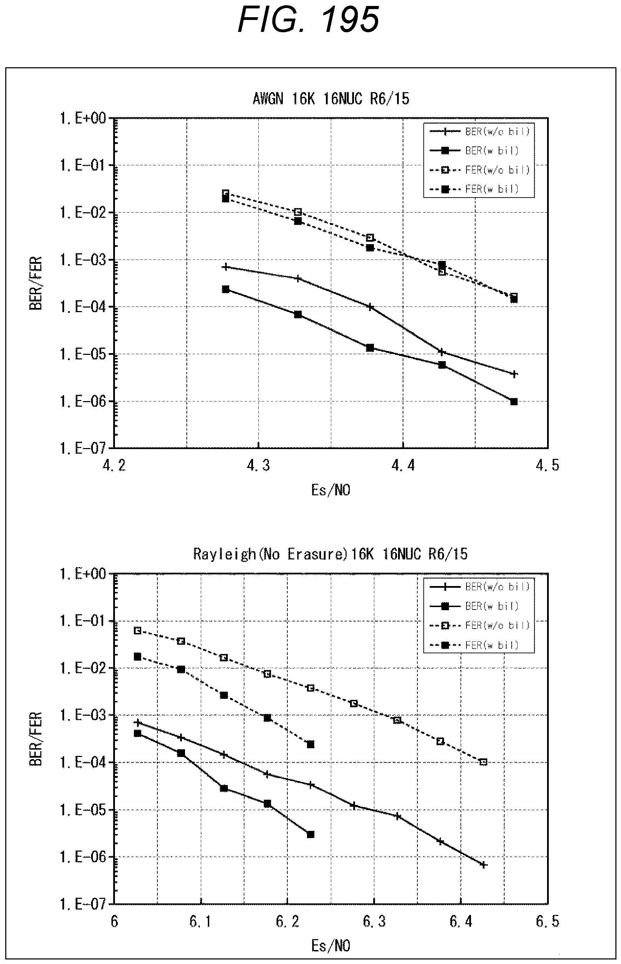

Fig. 195 is a diagram showing a BER/FER curve indicating results of simulation for measuring error rates produced when the GW pattern shown in Fig. 146 is adopted to the combination of the (16k, 6/15) LGE code and 16QAM shown in Fig. 101.

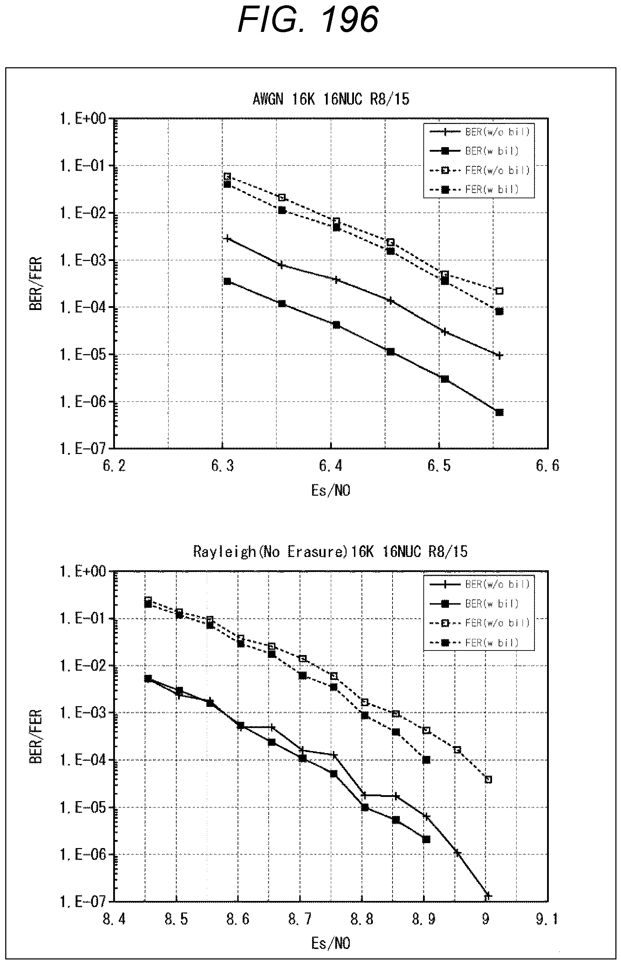

Fig. 196 is a diagram showing a BER/FER curve indicating results of simulation for measuring error rates produced when the GW pattern shown in Fig. 147 is adopted to the combination of the (16k, 8/15) Sony code and 16QAM shown in Fig. 101.

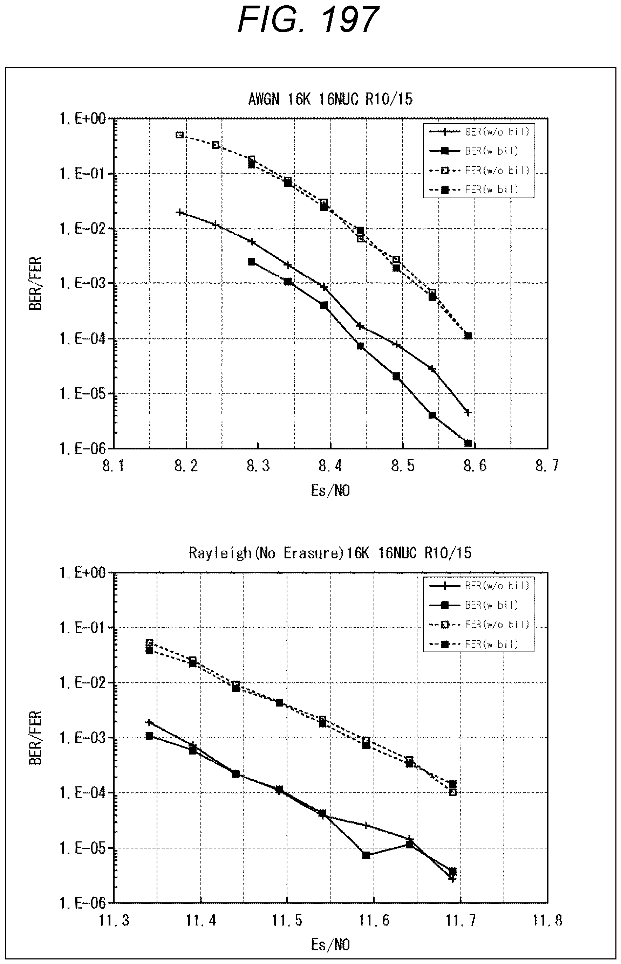

Fig. 197 is a diagram showing a BER/FER curve indicating results of simulation for measuring error rates produced when the GW pattern shown in Fig. 148 is adopted to the combination of the (16k, 10/15) Sony code and 16QAM shown in Fig. 101.

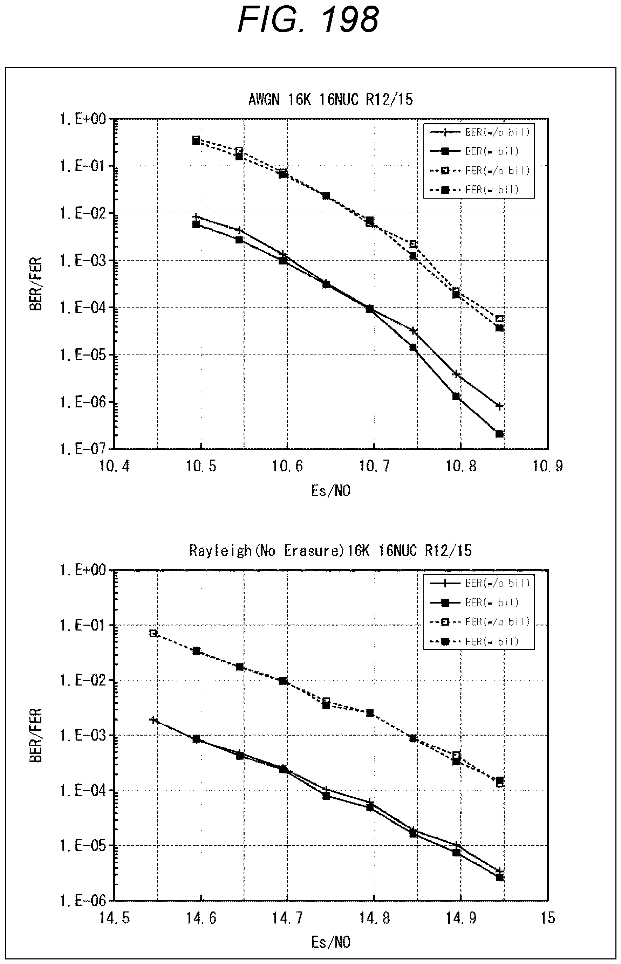

Fig. 198 is a diagram showing a BER/FER curve indicating results of simulation for measuring error rates produced when the GW pattern shown in Fig. 149 is adopted to the combination of the (16k, 12/15) Sony code and 16QAM shown in Fig. 101.

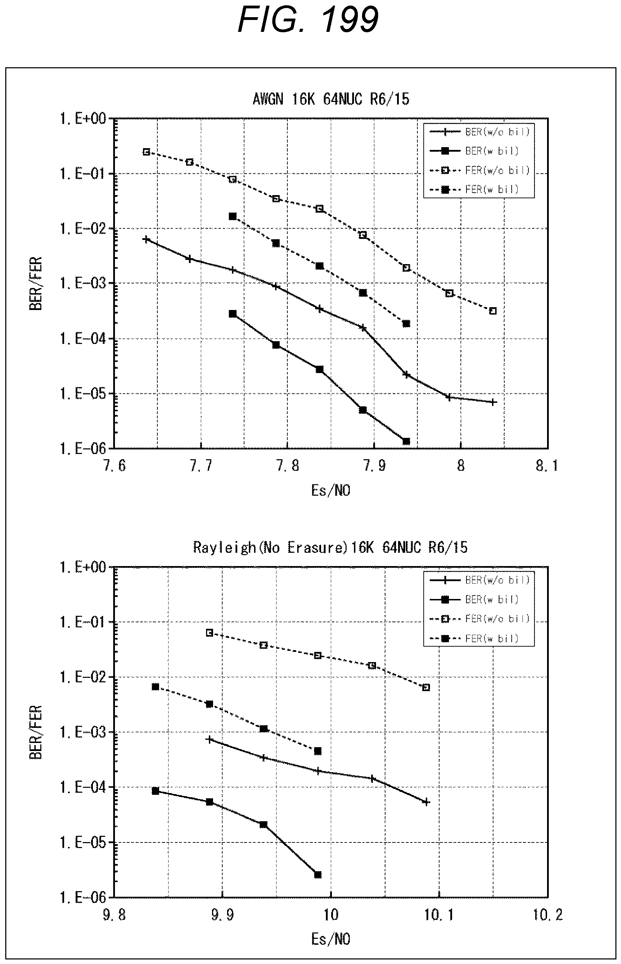

Fig. 199 is a diagram showing a BER/FER curve indicating results of simulation for measuring error rates produced when the GW pattern shown in Fig. 150 is adopted to the combination of the (16k, 6/15) LGE code and 64QAM shown in Fig. 102.

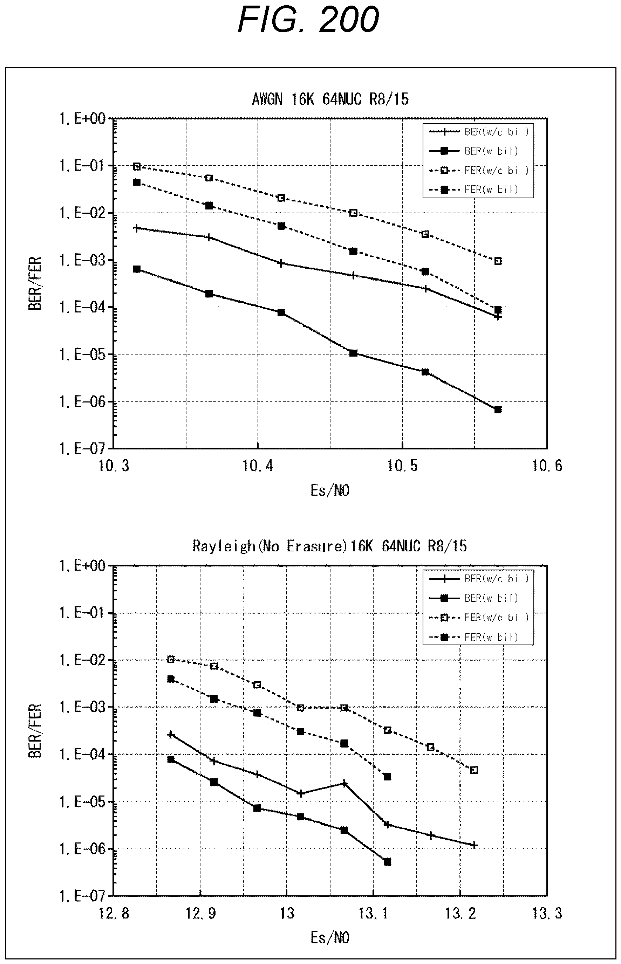

Fig. 200 is a diagram showing a BER/FER curve indicating results of simulation for measuring error rates produced when the GW pattern shown in Fig. 151 is adopted to the combination of the (16k, 8/15) Sony code and 64QAM shown in Fig. 102.

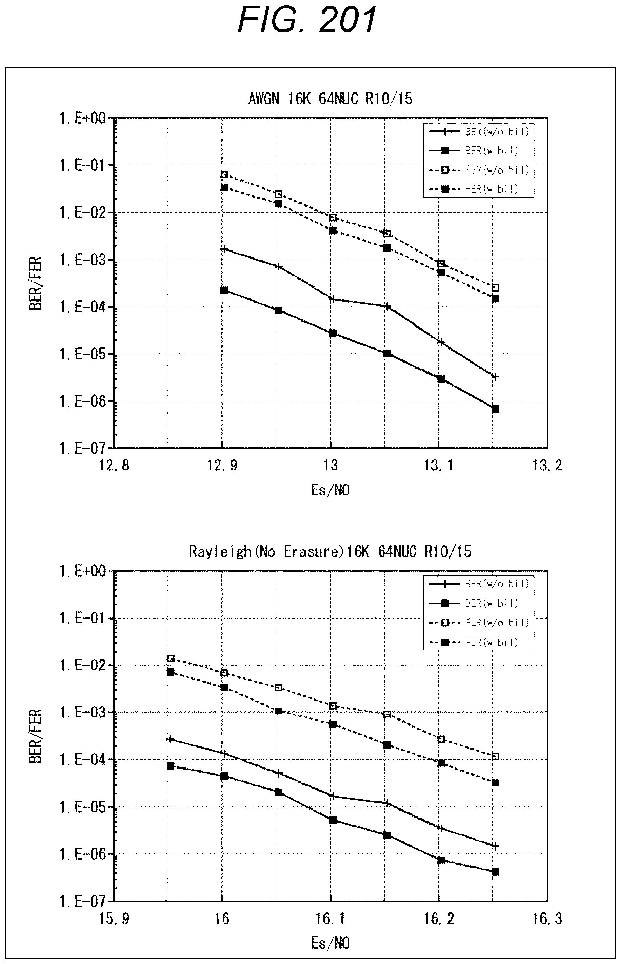

Fig. 201 is a diagram showing a BER/FER curve indicating results of simulation for measuring error rates produced when the GW pattern shown in Fig. 152 is adopted to the combination of the (16k, 10/15) Sony code and 64QAM shown in Fig. 102.

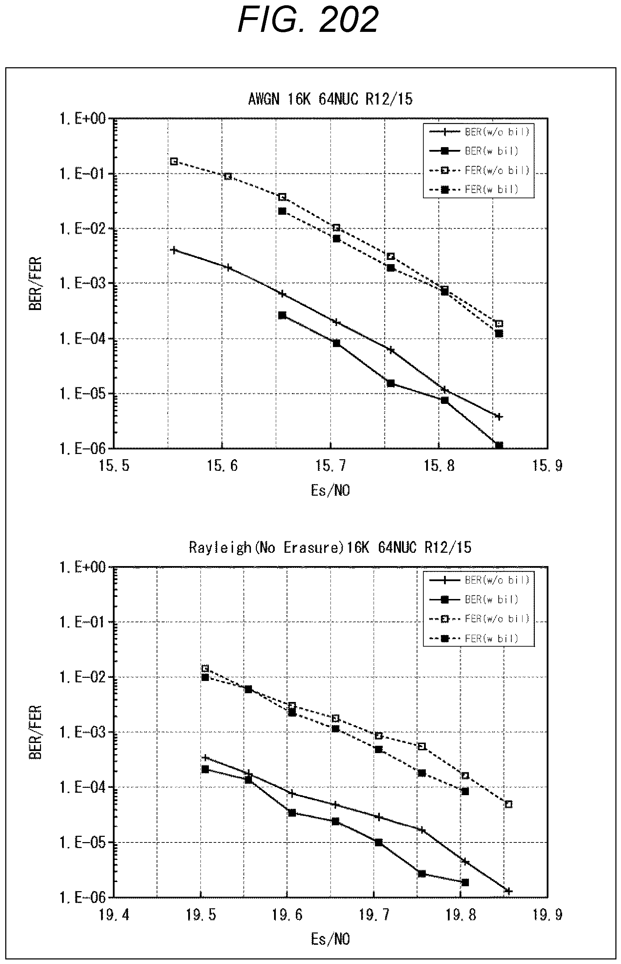

Fig. 202 is a diagram showing a BER/FER curve indicating results of simulation for measuring error rates produced when the GW pattern shown in Fig. 153 is adopted to the combination of the (16k, 12/15) Sony code and 64QAM shown in Fig. 102.

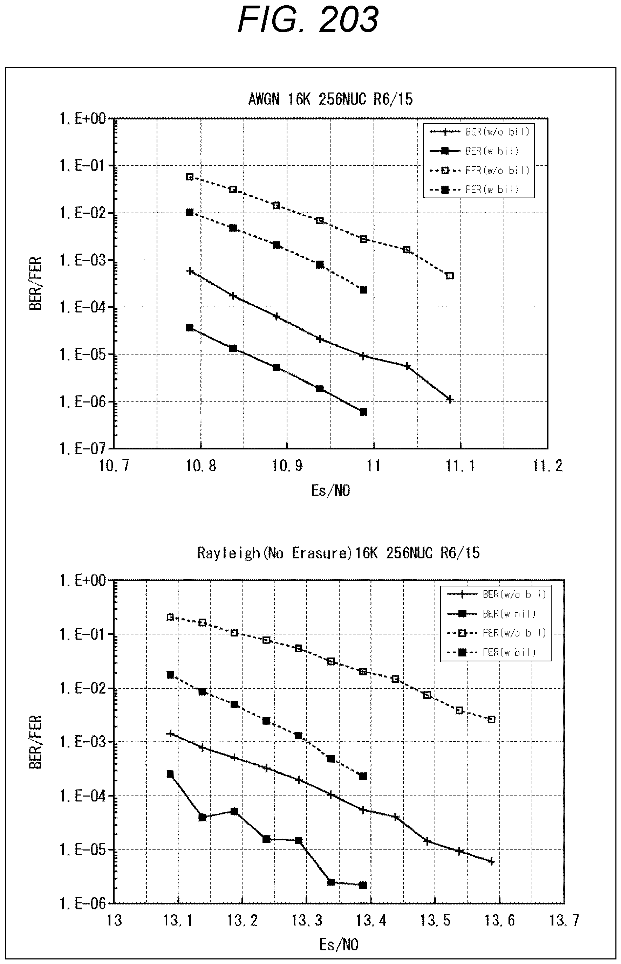

Fig. 203 is a diagram showing a BER/FER curve indicating results of simulation for measuring error rates produced when the GW pattern shown in Fig. 154 is adopted to the combination of the (16k, 6/15) LGE code and 256QAM shown in Figs. 103 and 104.

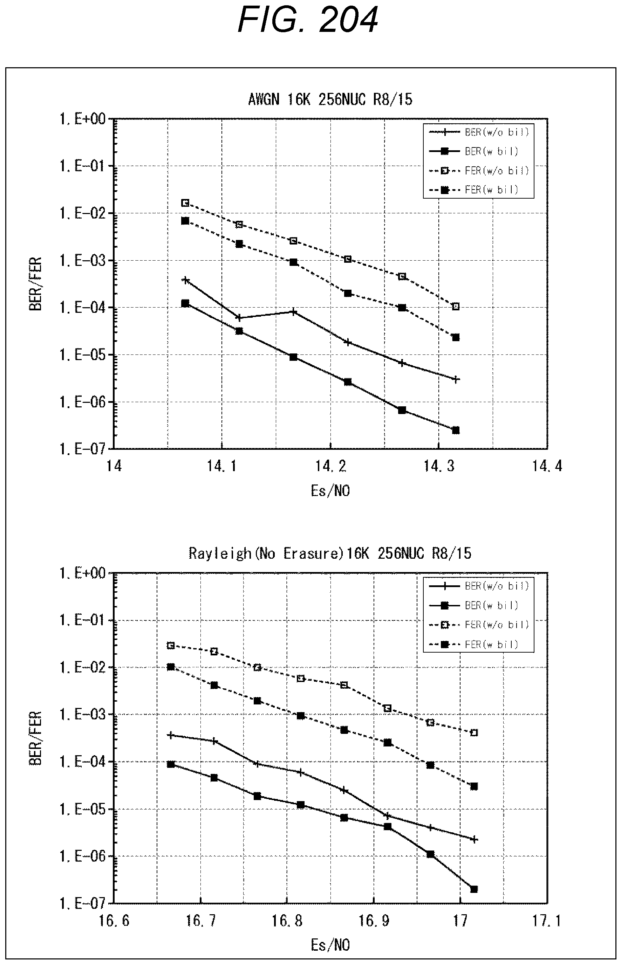

Fig. 204 is a diagram showing a BER/FER curve indicating results of simulation for measuring error rates produced when the GW pattern shown in Fig. 155 is adopted to the combination of the (16k, 8/15) Sony code and 256QAM shown in Figs. 103 and 104.

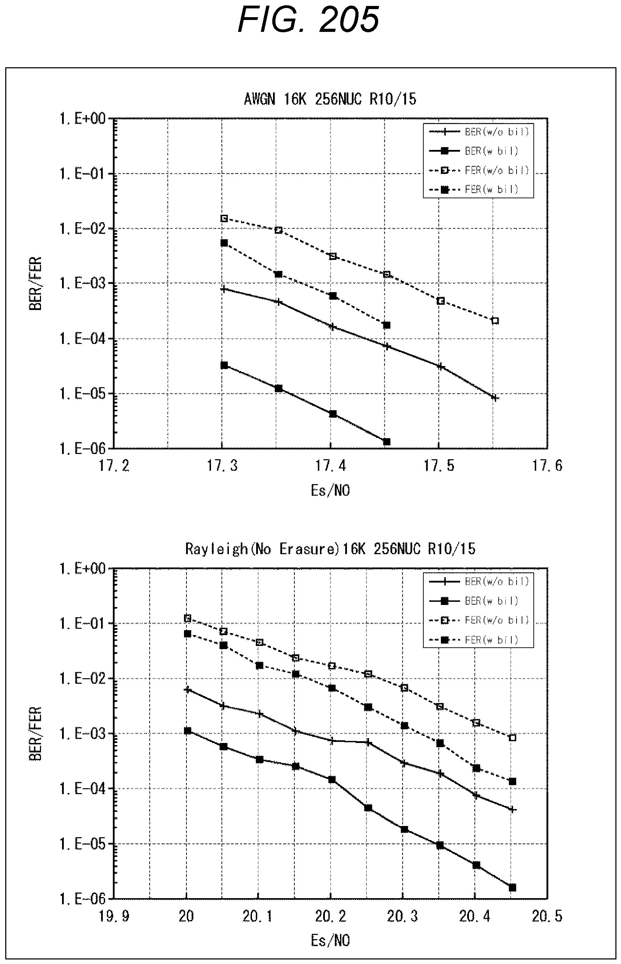

Fig. 205 is a diagram showing a BER/FER curve indicating results of simulation for measuring error rates produced when the GW pattern shown in Fig. 156 is adopted to the combination of the (16k, 10/15) Sony code and 256QAM shown in Figs. 103 and 104.

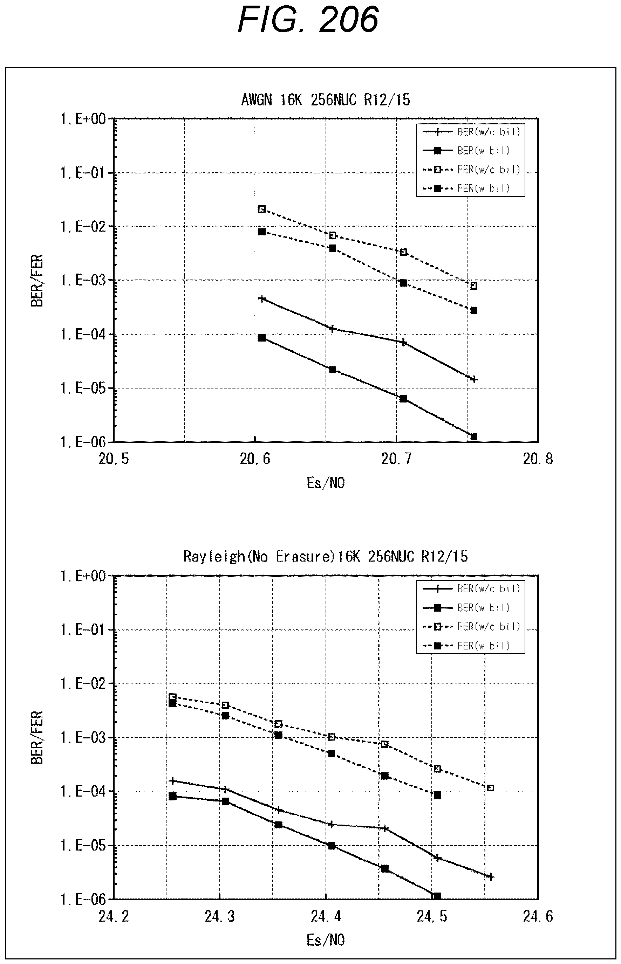

Fig. 206 is a diagram showing a BER/FER curve indicating results of simulation for measuring error rates produced when the GW pattern shown in Fig. 157 is adopted to the combination of the (16k, 12/15) Sony code and 256QAM shown in Figs. 103 and 104.

Note that a BER/FER curve produced when the communication channel 13 (Fig. 7) is constituted by an AWGN channel (upper diagram), and a BER/FER curve produced when the communication channel 13 is constituted by a Rayleigh (fading) channel (lower diagram) are shown in each of Figs. 158 through 206.

In addition, in each of Figs. 158 through 206, "w bil" indicates a BER/FER curve produced when parity interleave, group-wise interleave, and block-wise interleave are performed, while "w/o bil" indicates a BER/FER curve produced when none of parity interleave, group-wise interleave, and block-wise interleave is performed.

According to Figs. 158 through 206, it is confirmable that a BER/FER tends to improve when parity interleave, group-wise interleave, and block-wise interleave are performed in comparison with a BER/FER produced when none of parity interleave, group-wise interleave, and block-wise interleave is performed. Preferable error rates are therefore achievable with improvement of a BER/FER.

Note that the GW patterns shown in Figs. 109 through 157 are applicable to the constellation symmetrically shifting signal point positions with respect to the I axis or the Q axis, the constellation symmetrically shifting signal point positions with respect to the origin, the constellation rotating signal point positions through any angles around the origin, and other constellations as shown in Figs. 83 through 104, as well as signal point positions in QPSK, 16QAM, 64QAM, 256QAM, 1024QAM, and 4096QAM constellations as shown in Figs. 83 through 104 described above, and offer similar advantageous effects as those of the GW patterns applied to signal point positions in QPSK, 16QAM, 64QAM, 256QAM, 1024QAM, and 4096QAM constellations as shown in Figs. 83 through 104.

Moreover, the GW patterns shown in Figs. 109 through 157 are applicable to the constellation switching most significant bit (MSB) and least significant bit (LSB) of each of symbols applied (allocated) to signal points in signal point arrangements shown in Figs. 83 through 104 as well as signal point positions in QPSK, 16QAM, 64QAM, 256QAM, 1024QAM, and 4096QAM constellations as shown in Figs. 83 through 104 described above, and also offer similar advantageous effects as those of the GW patterns applied to signal point positions in QPSK, 16QAM, 64QAM, 256QAM, 1024QAM, and 4096QAM constellations as shown in Figs. 83 through 104.

<Configuration example of reception device 12>

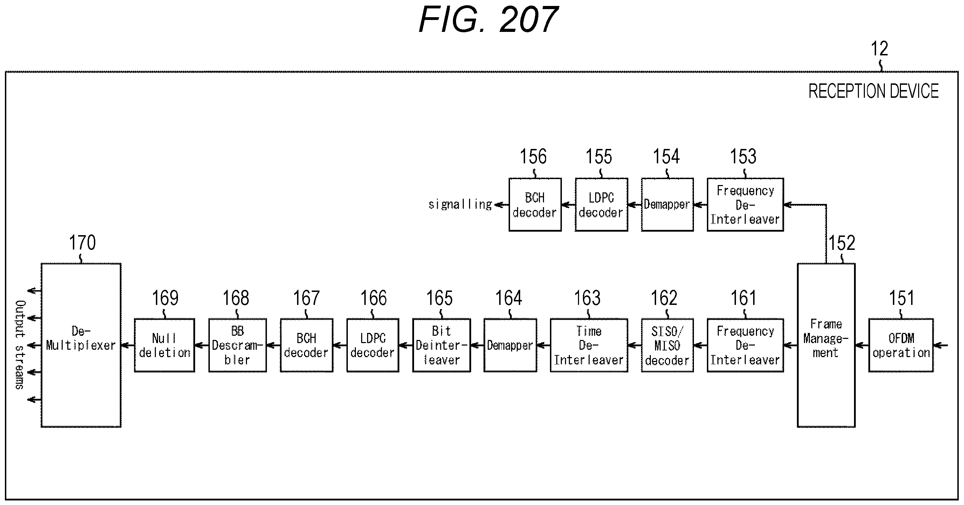

Fig. 207 is a block diagram showing a configuration example of the reception device 12 shown in Fig. 7.

An OFDM operation unit 151 receives an OFDM signal from the transmission device 11 (Fig. 7), and processes the OFDM signal. Data obtained from the signal processing performed by the OFDM operation unit 151 is supplied to a frame management unit 152.

The frame management unit 152 processes a frame (interprets frame) constituted by the data supplied from the OFDM operation unit 151, and supplies a signal of target data and a signal of control data thus obtained to frequency deinterleavers 161 and 153.

The frequency deinterleaver 153 performs frequency deinterleave in units of symbol for the data received from the frame management unit 152, and supplies the resultant data to a demapper 154.

The demapper 154 demaps the data received from the frequency deinterleaver 153 (data in constellation) for quadrature modulation on the basis of positions of signal points (constellation) defined by quadrature modulation performed by the transmission device 11, and supplies resultant data ((likelihood) of LDPC code) to an LDPC decoder 155.

The LDPC decoder 155 performs LDPC decoding for the LDPC code received from the demapper 154, and supplies resultant LDPC target data (BCH code herein) to a BCH decoder 156.

The BCH decoder 156 performs BCH decoding for the LDPC target data received from the LDPC decoder 155, and outputs resultant control data (signaling).

On the other hand, the frequency deinterleaver 161 performs frequency deinterleave in units of symbol for the data received from the frame management unit 152, and supplies resultant data to an SISO/MISO decoder 162.

The SISO/MISO decoder 162 performs space-time decoding for the data received from the frequency deinterleaver 161, and supplies the resultant data to a time deinterleaver 163.

The time deinterleaver 163 performs time-deinterleave in units of symbol for the data received from the SISO/MISO decoder 162, and supplies the resultant data to the demapper 164.

The demapper 164 demaps (decodes positions of signal points of) the data received from the time deinterleaver 163 for quadrature modulation on the basis of positions of signals (constellation) defined by quadrature modulation performed by the transmission device 11, and supplies the resultant data to a bit deinterleaver 165.

The bit deinterleaver 165 performs bit deinterleave for the data received from the demapper 164, and supplies (likelihood) of the LDPC code as bit-deinterleaved data to an LDPC decoder 166.

The LDPC decoder 166 performs LDPC decoding for the LDPC code received from the bit deinterleaver 165, and supplies LDPC target data thus obtained (BCH code herein) to a BCH decoder 167.

The BCH decoder 167 performs BCH decoding for the LDPC target data received from the LDPC decoder 155, and supplies the resultant data to a BB descrambler 168.

The BB descrambler 168 performs BB descrambling for the data received from the BCH decoder 167, and supplies the resultant data to a null deletion unit 169.

The null deletion unit 169 deletes null, which has been inserted by the padder 112 in Fig. 8 into the data received from the BB descrambler 168, from the corresponding data, and supplies the resultant data to a demultiplexer 170.

The demultiplexer 170 separates one or more streams (target data) multiplexed on the data received from the null deletion unit 169, performs necessary processing, and outputs the separated stream(s) as output stream(s).

Note that the reception device 12 may have a configuration not containing a part of the blocks shown in Fig. 207. More specifically, when the transmission device 11 (Fig. 8) has a configuration not containing the time interleaver 118, the SISO/MISO encoder 119, the frequency interleaver 120, and the frequency interleaver 124, the reception device 12 may have a configuration not containing the time deinterleaver 163, the SISO/MISO decoder 162, the frequency deinterleaver 161, and the frequency deinterleaver 153 as blocks corresponding to the time interleaver 118, the SISO/MISO encoder 119, the frequency interleaver 120, and the frequency interleaver 124 of the transmission device 11, respectively.

<Configuration example of bit deinterleaver 165>

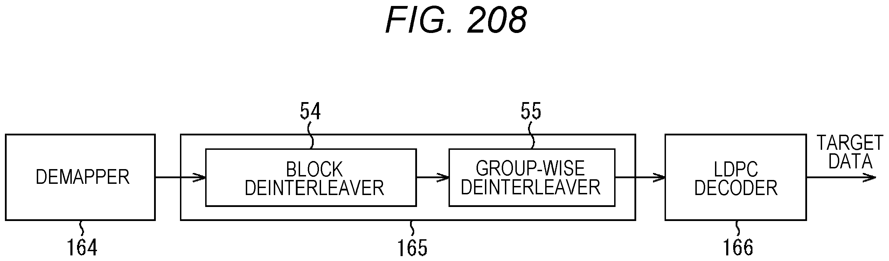

Fig. 208 is a block diagram showing a configuration example of the bit deinterleaver 165 shown in Fig. 207.

The bit deinterleaver 165 is constituted by a block deinterleaver 54 and a group-wise deinterleaver 55, and performs (bit) deinterleave for a symbol bit of a symbol corresponding to data received from the demapper 164 (Fig. 207).

More specifically, the block deinterleaver 54 performs, for a target of the symbol bit of the symbol received from the demapper 164, block deinterleave (reverse process of block interleave) corresponding to block interleave performed by the block interleaver 25 shown in Fig. 9, i.e., block deinterleave for returning the position of (likelihood of) the sign bit of the LDPC code rearranged by block interleave, and supplies the resultant LDPC code to the group-wise deinterleaver 55.

The group-wise deinterleaver 55 performs, for a target of the LDPC code received from the block deinterleaver 54, group-wise deinterleave (reverse process of group-wise interleave) corresponding to group-wise interleave performed by the group-wise interleaver 24 shown in Fig. 9, i.e., group-wise deinterleave for rearranging arrangement of the sign bit of the LDPC code, which has been changed by group-wise interleave in units of bit group described with reference to Fig. 108, into the original arrangement in units of bit group, for example.

When parity interleave, group-wise interleave, and block interleave are performed for the LDPC code supplied from the demapper 164 to the bit deinterleaver 165, the bit deinterleaver 165 is allowed to perform all of parity deinterleave corresponding to parity interleave (reverse process of parity interleave, i.e., parity deinterleave for returning arrangement of sign bit of LDPC code changed by parity interleave to original arrangement), block deinterleave corresponding to block interleave, and group-wise deinterleave corresponding to block interleave.

Note that, while the bit deinterleaver 165 shown in Fig. 208 includes the block deinterleaver 54 for performing block deinterleave corresponding to block interleave, and the group-wise deinterleaver 55 for performing group-wise deinterleave corresponding to group-wise interleave, the bit deinterleaver 165 does not include a block for performing parity deinterleave corresponding to parity interleave. In this case, the bit deinterleaver 165 does not perform parity deinterleave.

Accordingly, the LDPC code block-deinterleaved and group-wise-deinterleaved, but not parity-deinterleaved is supplied from (group-wise deinterleaver 55 of) the bit deinterleaver 165 to the LDPC decoder 166.

The LDPC decoder 166 performs LDPC decoding for the LDPC code received from the bit deinterleaver 165 by using a converted parity check matrix obtained by performing at least column permutation corresponding to parity interleave for the DVB system parity check matrix H used by the LDPC encoder 115 in Fig. 8 for LDPC encoding (or converted parity check matrix (Fig. 29) obtained by row permutation for ETRI system parity check matrix (Fig. 27)), and outputs resultant data as a decoding result of the LDPC target data.

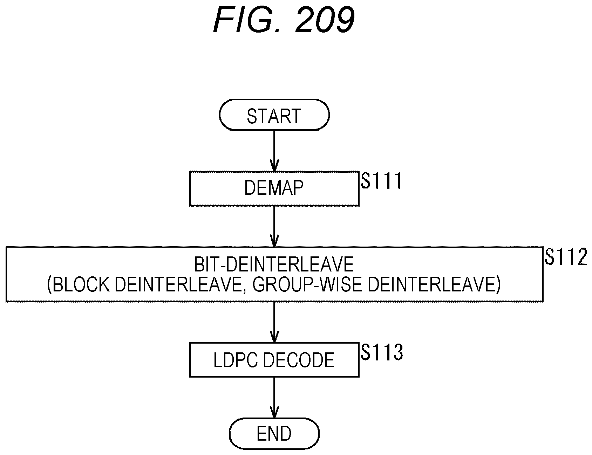

Fig. 209 is a flowchart showing a process performed by the demapper 164, the bit deinterleaver 165, and the LDPC decoder 166 shown in Fig. 208.

In step S111, the demapper 164 demaps data received from the time deinterleaver 163 (data mapped on signal points in constellation) for quadrature modulation, and supplies the resultant data to the bit deinterleaver 165. Thereafter, the process proceeds to step S112.

In step S112, the bit deinterleaver 165 performs deinterleave (bit deinterleave) for the data received from the demapper 164, whereafter the process proceeds to step S113.

More specifically, in step S112, the block deinterleaver 54 of the bit deinterleaver 165 performs block deinterleave for a target of the data (symbol) received from the demapper 164, and supplies the sign bit of the LDPC code thus obtained to the group-wise deinterleaver 55.

The group-wise deinterleaver 55 performs group-wise deinterleave for a target of the LDPC code received from the block deinterleaver 54, and supplies (likelihood of) the LDPC code thus obtained to the LDPC decoder 166.

In step S113, the LDPC decoder 166 performs LDPC decoding for the LDPC code received from the group-wise deinterleaver 55 by using the parity check matrix H used by the LDPC encoder 115 in Fig. 8 for LDPC encoding, i.e., performs LDPC decoding by using a converted parity check matrix obtained from the parity check matrix H, for example, and outputs the resultant data to the BCH decoder 167 as a decoding result of the LDPC target data.

Note that the block deinterleaver 54 performing block deinterleave, and the group-wise deinterleaver 55 performing group-wise deinterleave are separately provided in Fig. 208 for convenience of description similarly to the configuration in Fig. 9. However, the block deinterleaver 54 and the group-wise deinterleaver 55 may be formed integrally with each other.

<LDPC decoding>

LDPC decoding performed by the LDPC decoder 166 shown in Fig. 207 is further detailed.

As described above, the LDPC decoder 166 in Fig. 207 performs LDPC decoding of an LDPC code received from the group-wise deinterleaver 55, as a code block-deinterleaved and group-wise-deinterleaved but not parity-deinterleaved, by using a converted parity check matrix obtained by performing at least column permutation corresponding to parity interleave for the DVB system parity check matrix H used by the LDPC encoder 115 in Fig. 8 for LDPC encoding (or converted parity check matrix (Fig. 29) obtained by performing row permutation for ETRI system parity check matrix (Fig. 27).

Here, there has been previously proposed LDPC decoding which uses a converted parity check matrix to reduce an operation frequency to a sufficiently realizable range while reducing a circuit scale (for example, see Japanese Patent No. 4224777).

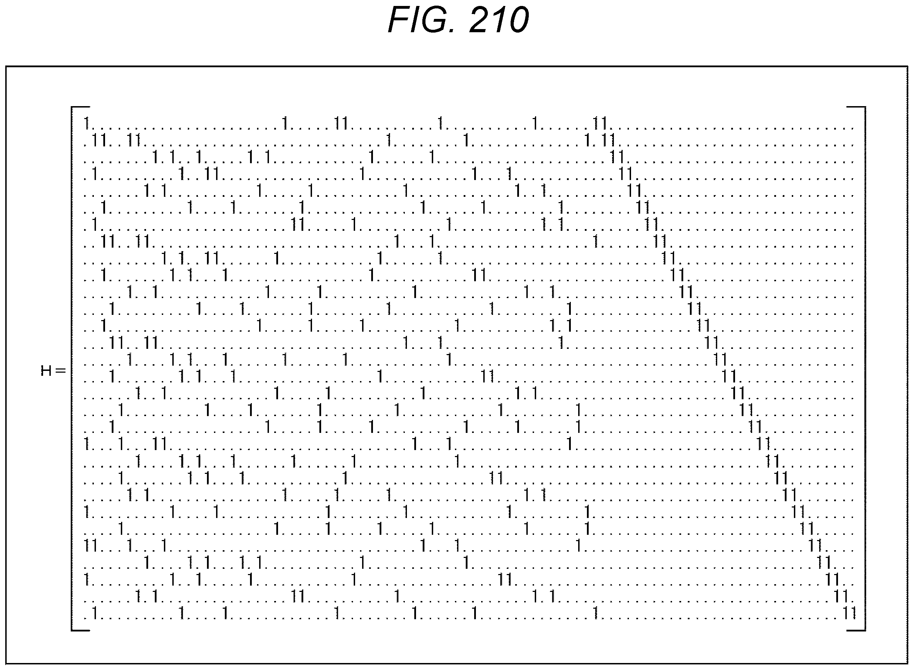

Accordingly, LDPC decoding using a converted parity check matrix as previously proposed is initially touched upon with reference to Figs. 210 through 213.

Fig. 210 is a diagram showing an example of a parity check matrix H for an LDPC code having a code length N of 90 and an encoding rate of 2/3.

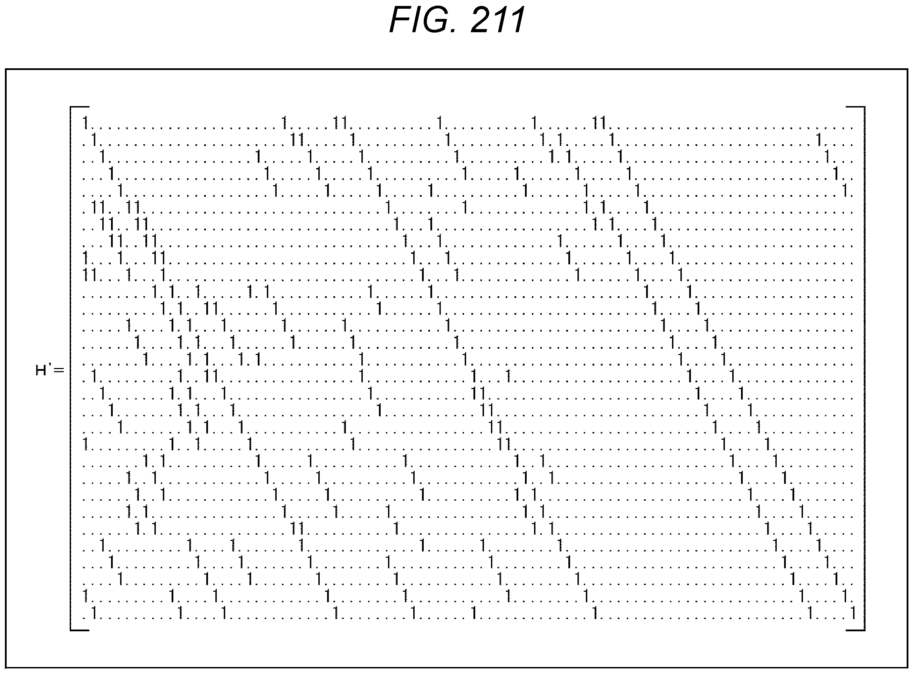

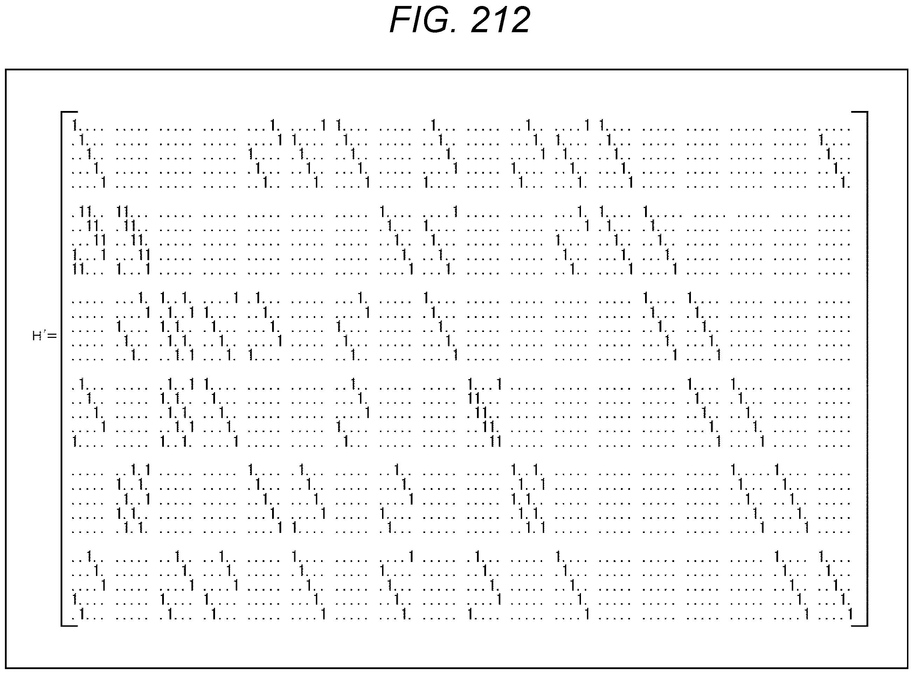

Note that 0 is expressed by period (.) in Fig. 210 (similar in Figs. 211 and 212 described below).

A parity matrix of the parity check matrix H shown in Fig. 210 has an echelon structure.

Fig. 211 is a diagram showing a parity check matrix H' obtained by performing row permutation on the basis of Equation (11) and column permutation on the basis of Equation (12) for the parity check matrix H in Fig. 210.

$$\text{row permutation: } (6s + t + 1)\text{th row} \rightarrow (5t + s + 1)\text{th row} \dots (11)$$

$$\text{column permutation: } (6x + y + 61)\text{th column} \rightarrow (5y + x + 61)\text{th column} \dots (12)$$

Note that s, t, x, and y in Equations (11) and (12) are integers in ranges of $0 \leq s < 5$, $0 \leq t < 6$, $0 \leq x < 5$, and $0 \leq t < 6$, respectively.

Row permutation based on Equation (11) is performed such that 1st, 7th, 13th, 19th, and 25th rows producing a remainder of 1 when divided by 6 are permutated to 1st, 2nd, 3rd, 4th, and 5th rows, respectively, and that 2nd, 8th, 14th, 20th, and 26th rows producing a remainder of 2 when divided by 6 are permutated to 6th, 7th, 8th, 9th, and 10th rows, respectively.

On the other hand, column permutation based on Equation (12) is performed such that 61st, 67th, 73rd, 79th, and 85th columns located in and after the 61st column (parity matrix) and producing a remainder of 1 when divided by 6 are permutated to 61st, 62nd, 63rd, 64th, and 65th columns, respectively, and that 62nd, 68th, 74th, 80th, and 86th columns producing a remainder of 2 when divided by 6 are permutated to 66th, 67th, 68th, 69th, and 70th columns, respectively.

A matrix obtained by row and column permutations in this manner for the parity check matrix H in Fig. 210 corresponds to the parity check matrix H' shown in Fig. 211.

Note that arrangement of the sign bit of the LDPC code is not affected by the row permutation of the parity check matrix H.

On the other hand, the column permutation based on equation (12) corresponds to parity interleave for interleaving the (K + qx + y + 1)th sign bit to the position of the (K + Py + x + 1)th sign bit as described above in a state that the information length K is set to 60, that the unit size P is set to 5, and that the devisor q (= M/P) of the parity length M (30 in this example) to 6.

Accordingly, the parity check matrix H' shown in Fig. 211 is a converted parity check matrix obtained by performing at least column permutation for permutating the (K + qx + y + 1)th column of the parity check matrix H shown in Fig. 210 (hereinafter referred to as original parity check matrix where appropriate) to the (K + Py + x + 1)th column.

When the converted parity check matrix H' in Fig. 211 is multiplied by the permutated LDPC code of the original parity check matrix H in Fig. 210 in the same manner as in Equation (12), 0 vector is output. More specifically, assuming that a row vector obtained by performing column permutation of Equation (12) for a row vector c as an LDPC code (one code word) of the original parity check matrix H is expressed as c', $Hc^T$ becomes 0 vector on the basis of characteristics of the parity check matrix. It is therefore obvious that $H'c'^T$ also becomes 0 vector.

As described above, the converted parity check matrix H' shown in Fig. 211 is a parity check matrix of the LDPC code c' obtained by performing column permutation of Equation (12) for the LDPC code c of the original parity check matrix H.

Accordingly, a decoding result similar to a result of decoding the LDPC code c of the original parity check matrix H by using the parity check matrix H is obtained by performing column permutation of Equation (12) for the LDPC code c of the original parity check matrix H, decoding the column-permutated LDPC code c' by using the converted parity check matrix H' shown in Fig. 211 (LDPC decoding), and performing inverse permutation of the column permutation of Equation (12) for the decoding result.

Fig. 212 is a diagram showing the converted parity check matrix H' shown in Fig. 211 and including intervals between units of 5 × 5 matrix.

In Fig. 212, the converted parity check matrix H' is expressed by a combination of a 5 × 5 (= P × P) unit matrix corresponding to the unit size P, a matrix containing one or more elements of 0 in place of elements of 1 in the unit matrix (hereinafter referred to as quasi-unit matrix where appropriate), a matrix cyclically shifted from the unit matrix or quasi-unit matrix (hereinafter referred to as shift matrix where appropriate), a sum of two or more of the unit matrix, quasi-unit matrix, and shift matrix (hereinafter referred to as sum matrix where appropriate), and 5 × 5 zero matrix.

It is therefore considered that the converted parity check matrix H' shown in Fig. 212 is constituted by a 5 × 5 unit matrix, a quasi-unit matrix, a shift matrix, a sum matrix, and a zero matrix. Accordingly, these 5 × 5 matrixes (unit matrix, quasi-unit matrix, shift matrix, sum matrix, and zero matrix) constituting the converted parity check matrix H' are hereinafter referred to as configuration matrixes where appropriate.

Decoding of an LDPC code of a parity check matrix expressed by P × P configuration matrixes may be performed by using architecture which simultaneously executes P check node operations and variable node operations.

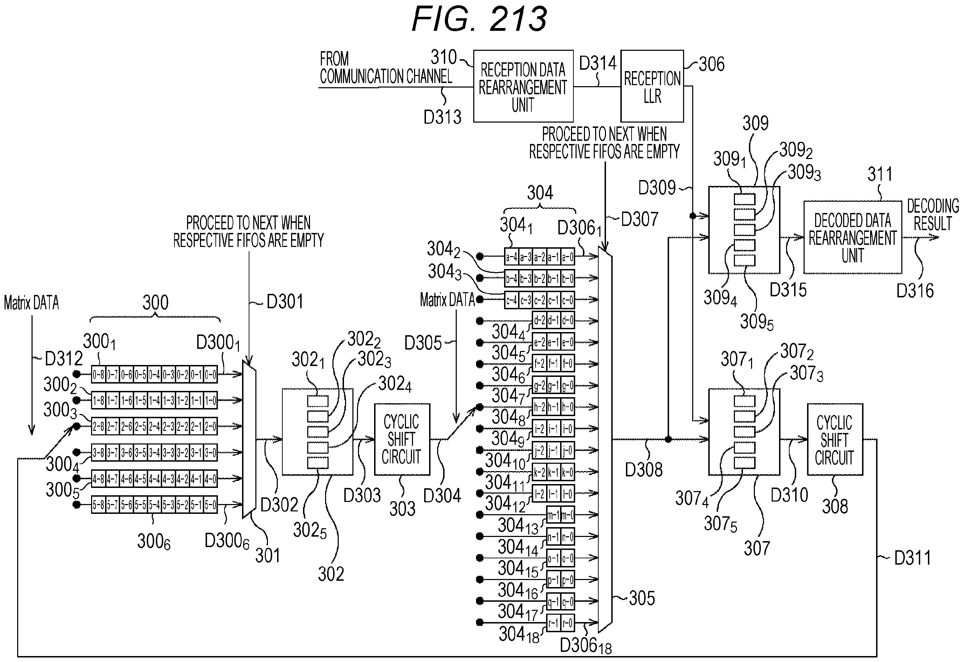

Fig. 213 is a block diagram showing a configuration example of a decoding device performing this decoding.

More specifically, Fig. 213 shows a configuration example of a decoding device which decodes an LDPC code by using the converted parity check matrix H' shown in Fig. 212 and obtained by performing at least row permutation matrix for the original parity check matrix H shown in Fig. 210 on the basis of Equation (12).

The decoding device shown in Fig. 213 includes an edge data storage memory 300 constituted by six FIFOs $300_1$ through $300_6$, a selector 301 which selects the FIFOs $300_1$ through $300_6$, a check node calculation unit 302, two cyclic shift circuits 303 and 308, an edge data storage memory 304 constituted by eighteen FIFOs $304_1$ through $304_{18}$, a selector 305 which selects the FIFOs $304_1$ through $304_{18}$, a reception data memory 306 which stores reception data, a variable node calculation unit 307, a decode word calculation unit 309, a reception data rearrangement unit 310, and a decoded data rearrangement unit 311.

Data storage into the edge data storage memories 300 and 304 is initially described.

The edge data storage memory 300 is constituted by the six FIFOs $300_1$ through $300_6$. This number is equivalent to a number obtained by dividing the row number 30 of the converted parity check matrix H' in Fig. 212 by the number 5 of row numbers of the configuration matrix (unit size P). The FIFO $300_y$ (y = 1, 2, and up to 6) is constituted by a plurality of stages of storage areas. Messages corresponding to the five edges as the number of rows and the number of columns of the configuration matrixes (unit size P) are simultaneously read from and written into each of the stages of the storage areas. In addition, the number of stages of each storage area of the FIFO $300_y$ is nine corresponding to the maximum number of 1 (hamming weight) in the row direction of the converted parity check matrix shown in Fig. 212.

Data corresponding to positions of 1 in the first through fifth rows of the converted parity check matrix H' in Fig. 212 (messages $v_i$ from variable nodes) is stored in the FIFO $300_1$ in a narrowed form (zero-ignored form) in the horizontal direction in each of rows. More specifically, assuming that the jth row ith column is expressed as (j, i), data corresponding to positions of 1 of the 5 × 5 unit matrix from (1, 1) to (5, 5) of the converted parity check matrix H' is stored in the first stage storage area of the FIFO $300_1$. Data corresponding to positions of 1 of a shift matrix (shift matrix cyclically shifted rightward by three from 5 × 5 unit matrix) from (1, 21) to (5, 25) of the converted parity check matrix H' is stored in the second stage storage area. Similarly, data is stored in each of the third through eighth storage areas in association with the converted parity check matrix H'. In addition, data corresponding to positions of 1 of a shift matrix (shift matrix containing 0 in first row of 5 × 5 unit matrix instead of 1, and cyclically shifted leftward by one from 5 × 5 unit matrix) from (1, 86) to (5, 90) of the converted parity check matrix H' is stored in the ninth stage storage area.

Data corresponding to positions of 1 in the sixth through tenth rows of the converted parity check matrix H' in Fig. 212 are stored in the FIFO $300_2$. More specifically, data corresponding to positions of 1 in a first shift matrix constituting a sum matrix (sum matrix corresponding to a sum of the first shift matrix cyclically shifted rightward by one from the 5 × 5 unit matrix and a second shift matrix cyclically shifted rightward by two from 5 × 5 unit matrix) from (6, 1) to (10, 5) of the converted parity check matrix H' is stored in the first stage storage area of the FIFO $300_2$. In addition, data corresponding to positions of 1 of the second shift matrix constituting the sum matrix from (6, 1) to (10, 5) of the converted parity check matrix H' is stored in the second storage area.

Accordingly, in case of a configuration matrix having a weight of 2 or larger, and expressed as a sum of a plurality of matrixes each of which is a matrix having a weight of 1, and constituted by a P × P unit matrix, a quasi-unit matrix containing 0 in place of one or more elements of 1 in a unit matrix, or a shift matrix cyclically shifted from a unit matrix or a quasi-unit matrix, data (messages corresponding to edges belonging to unit matrix, quasi-unit matrix, or shift matrix) corresponding to positions of 1 of the foregoing matrix having a weight of 1, and constituted by the unit matrix, the quasi-unit matrix, or the shift matrix is stored in an identical address (identical FIFO of FIFOs $300_1$ through $300_6$).

Similarly, data is stored in each of the third through ninth storage areas in association with the converted parity check matrix H'.

Data is stored in the FIFOs $300_3$ through $300_6$ in association with the converted parity check matrix H' in a similar manner.

The edge data storage memory 304 is constituted by eighteen FIFOs $304_1$ through $304_{18}$. This number is equivalent to a number obtained by dividing the row number 90 of the converted parity check matrix H' by the row number 5 of the configuration matrix (unit size P). The FIFO $304_x$ (x = 1, 2, and up to 18) is constituted by a plurality of stages of storage areas. Messages corresponding to the five edges as the number of rows and the number of columns of each configuration matrix (unit size P) are simultaneously read from and written into each of the stages of the storage areas.

Data corresponding to positions of 1 in the first through fifth columns of the converted parity check matrix H' in Fig. 212 (messages $u_j$ from check nodes) is stored in the FIFO $304_1$ in a narrowed form (zero-ignored form) in the vertical direction in each of columns. More specifically, data corresponding to positions of 1 of a 5 × 5 unit matrix from (1, 1) to (5, 5) of the converted parity check matrix H' is stored in the first stage storage area of the FIFO $304_1$. Data corresponding to positions of 1 in a first shift matrix constituting a sum matrix (sum matrix corresponding to a sum of the first shift matrix cyclically shifted rightward by one from the 5 × 5 unit matrix and a second shift matrix cyclically shifted rightward by two from the 5 × 5 unit matrix) from (6, 1) to (10, 5) of the converted parity check matrix H' is stored in the second stage storage area. In addition, data corresponding to positions of 1 of the second shift matrix constituting the sum matrix from (6, 1) to (10, 5) of the converted parity check matrix H' is stored in the third stage storage area.

Accordingly, in case of a configuration matrix having a weight of 2 or larger, and expressed as a sum of a plurality of matrixes each of which is a matrix having a weight of 1, and constituted by a P × P unit matrix, a quasi-unit matrix containing 0 in place of one or more elements of 1 in the unit matrix, or a shift matrix cyclically shifted from the unit matrix or quasi-unit matrix, data (messages corresponding to edges belonging to unit matrix, quasi-unit matrix, or shift matrix) corresponding to positions of 1 of the foregoing matrix having a weight of 1, and constituted by the unit matrix, the quasi-unit matrix, or the shift matrix is stored in an identical address (identical FIFO of FIFOs $304_1$ through $304_{18}$).

Similarly, data is stored in each of the fourth and fifth storage areas in association with the converted parity check matrix H'. The number of stages of the storage areas of the FIFO $304_1$ is five corresponding to the maximum number of 1 (hamming weight) in the row direction of the first column to the fifth column of the converted parity check matrix H'.

Data is stored in the FIFOs $304_2$ and $304_3$ in association with the converted parity check matrix H' in a similar manner. The length (stage number) is five for each. Data is stored in the FIFOs $304_4$ through $304_{12}$ in association with the converted parity check matrix H' in a similar manner. The length (stage number) is three for each. Data is stored in the FIFOs $304_{13}$ through $304_{18}$ in association with the converted parity check matrix H' in a similar manner. The length (stage number) is two for each.

An operation of the decoding device shown in Fig. 213 is hereinafter described.

The edge data storage memory 300 is constituted by the six FIFOs $300_1$ through $300_6$. The edge data storage memory 300 selects an FIFO for storing data from the FIFOs $300_1$ through $300_6$ on the basis of information (matrix data) D312 indicating which row of the converted parity check matrix H' in Fig. 212 five messages D311 supplied from the cyclic shift circuit 308 in the preceding stage belong to, and sequentially and collectively stores the five messages D311 in the selected FIFO. In addition, the edge data storage memory 300 sequentially reads five messages $D300_1$ from the FIFO $300_1$ at the time of data reading, and supplies the read data to the selector 301 in the subsequent stage. The edge data storage memory 300 also sequentially reads messages from the FIFOs $300_2$ through $300_6$ after completion of reading of messages from the FIFO $300_1$, and supplies the read messages to the selector 301.

The selector 301 selects five messages from the FIFO from which data is currently read in the FIFOs $300_1$ through $300_6$ on the basis of a select signal D301, and supplies the selected messages to the check node calculation unit 302 as messages D302.

The check node calculation unit 302 is constituted by five check node calculators $302_1$ through $302_5$. The check node calculation unit 302 performs check node calculation by using Equation (7) on the basis of the messages D302 ($D302_1$ through $D302_5$) (message $v_i$ in Equation (7)) supplied via the selector 301, and supplies five messages 303 ($D303_1$ through $D303_5$) (message $u_j$ in Equation (7)) obtained by the check node calculation to the cyclic shift circuit 303.

The cyclic shift circuit 303 cyclically shifts the five messages $D303_1$ through $D303_5$ obtained by the check node calculation unit 302 on the basis of information (matrix data) D305 indicating the numbers of cyclic shifts by the corresponding edges for shifting the original unit matrix (or quasi-unit matrix) of the converted parity check matrix H', and supplies a result to the edge data storage memory 304 as messages D304.

The edge data storage memory 304 is constituted by the eighteen FIFOs $304_1$ through $304_{18}$. The edge data storage memory 304 selects an FIFO for storing data from the FIFOs $304_1$ through $304_{18}$ on the basis of information D305 indicating which row of the converted parity check matrix H' five messages D304 supplied from the cyclic shift circuit 303 in the preceding stage belong to, and sequentially and collectively stores the five messages D304 in the selected FIFO. In addition, the edge data storage memory 304 sequentially reads five messages $D306_1$ from the FIFO $304_1$ at the time of data reading, and supplies the read data to the selector 305 in the subsequent stage. The edge data storage memory 304 also sequentially reads messages from the FIFOs $304_2$ through $304_{18}$ after completion of reading of messages from the FIFO $304_1$, and supplies the read messages to the selector 305.

The selector 305 selects five messages from the FIFO from which data is currently read in the FIFOs $304_1$ through $304_{18}$ on the basis of a select signal D307, and supplies the selected messages to the variable node calculation unit 307 and the decode word calculation unit 309 as messages D308.

On the other hand, the reception data rearrangement unit 310 performs column permutation on the basis of Equation (12) for an LDPC code D313 corresponding to the parity check matrix H in Fig. 210 received via the communication channel 13 to rearrange the LDPC code D313, and supplies the rearranged code D313 to the reception data memory 306 as reception data D314. The reception data memory 306 calculates a reception LLR (log likelihood ratio) on the basis of the reception data D314 supplied from the reception data rearrangement unit 310, and stores the reception LLR. The reception data memory 306 supplies sets of the five reception LLRs to the variable node calculation unit 307 and the decode word calculation unit 309 as reception values D309.

The variable node calculation unit 307 is constituted by five variable node calculators $307_1$ through $307_5$. The variable node calculation unit 307 performs variable node calculation by using Equation (1) on the basis of on the messages D308 ($D308_1$ through $D308_5$) (message $u_j$ in Equation (1)) supplied via the selector 305, and the five reception values D309 (reception value $u_{0i}$ in Equation (1)) supplied from the reception data memory 306, and supplies messages D310 ($D310_1$ through $D310_5$) obtained by the calculation (message $v_i$ in Equation (1)) to the cyclic shift circuit 308.

The cyclic shift circuit 308 cyclically shifts the messages $D310_1$ through $D310_5$ calculated by the variable node calculation unit 307 on the basis of on information indicating the number of cyclic shifts of the original unit matrix (or quasi-unit matrix) of the converted parity check matrix H' performed by the corresponding edges, and supplies a result to the edge data storage memory 300 as the messages D311.

One process of decoding of an LDPC code (variable node calculation and check node calculation) is performed by completing a cycle of the foregoing operation. The decoding device in Fig. 213 decodes an LDPC code a predetermined number of times, and subsequently obtains a final decoding result by using the decode word calculation unit 309 and the decoded data rearrangement unit 311 to output the result.

More specifically, the decode word calculation unit 309 is constituted by five decode word calculators $309_1$ through $309_5$. The decode word calculation unit 309 calculates a decode result (decode word) as a final stage of a plurality of times of decoding by using Equation (5) on the basis of the five messages D308 ($D308_1$ through $D308_5$) output from the selector 305 (message $u_j$ in Equation (5)), and the five reception values D309 (reception value $u_{0i}$ in Equation (5)) supplied from the reception data memory 306, and supplies resultant decoded data D315 to the decoded data rearrangement unit 311.

The decoded data rearrangement unit 311 performs inverse permutation of the column permutation of Equation (12) for a target of the decoded data D315 supplied from the decode word calculation unit 309 to rearrange the order of the decoded data D315, and outputs the resultant data as a final decoding result D316.

Accordingly, in decoding of an LDPC code, adaptable is such architecture which simultaneously performs P check node calculations and variable node calculations, P as a number smaller than the number of rows or number columns in a parity check matrix, by performing either one or both of row permutation and column permutation for the parity check matrix (original parity check matrix) to convert the parity check matrix into a parity check matrix (converted parity check matrix) representable as a combination of a P $\times$ P unit matrix, a quasi-unit matrix containing one or more elements of 1 in the unit matrix, a shift matrix cyclically shifted from a unit matrix or a quasi-unit matrix, a sum matrix as a sum of a plurality of matrixes of a unit matrix, a quasi-unit matrix, and a shift matrix, a $P \times P$ zero matrix, i.e., a combination of configuration matrixes. When the architecture which simultaneously performs P node calculations (check node calculations and variable node calculations), P as a number smaller than the number of rows or the number of columns in a parity check matrix, is adopted, execution of a number of iterative decoding operations is allowed by reducing the node calculations to a range realizing an operation frequency in comparison with a case which simultaneously performs the same number of node calculations as the number of rows and the number of columns in the parity check matrix.

The LDPC decoder 166 constituting the reception device 12 in Fig. 207 simultaneously performs P check node calculations and variable node calculations for LDPC decoding similarly to the decoding device shown in Fig. 213, for example.

More specifically, for simplifying the description, assuming herein that a parity check matrix for an LDPC code output from the LDPC encoder 115 constituting the transmission device 11 in Fig. 8 is the parity check matrix H whose parity matrix has an echelon structure shown in Fig. 210, for example, the parity interleaver 23 of the transmission device 11 performs parity interleave for interleaving the (K + qx + y + 1)th sign bit to the position of the (K +Py + x+ 1)th sign bit in a state that the information length K is set to 60, that the unit size P is set to 5, and that the divisor q (= M/P) of the parity length M is set to 6.

This parity interleave corresponds to the column permutation based on Equation (12) as described above. Accordingly, the LDPC decoder 166 need not perform the column permutation on the basis of Equation (12).

Accordingly, as described above, the reception device 12 in Fig. 207 performs processing similar to the corresponding processing of the decoding device in Fig. 213, except that the column permutation based on Equation (12) is not performed by the LDPC decoder 166 which receives a not parity-deinterleaved LDPC code, i.e., an LDPC code subjected to column permutation based on Equation (12) from the group-wise deinterleaver 55.

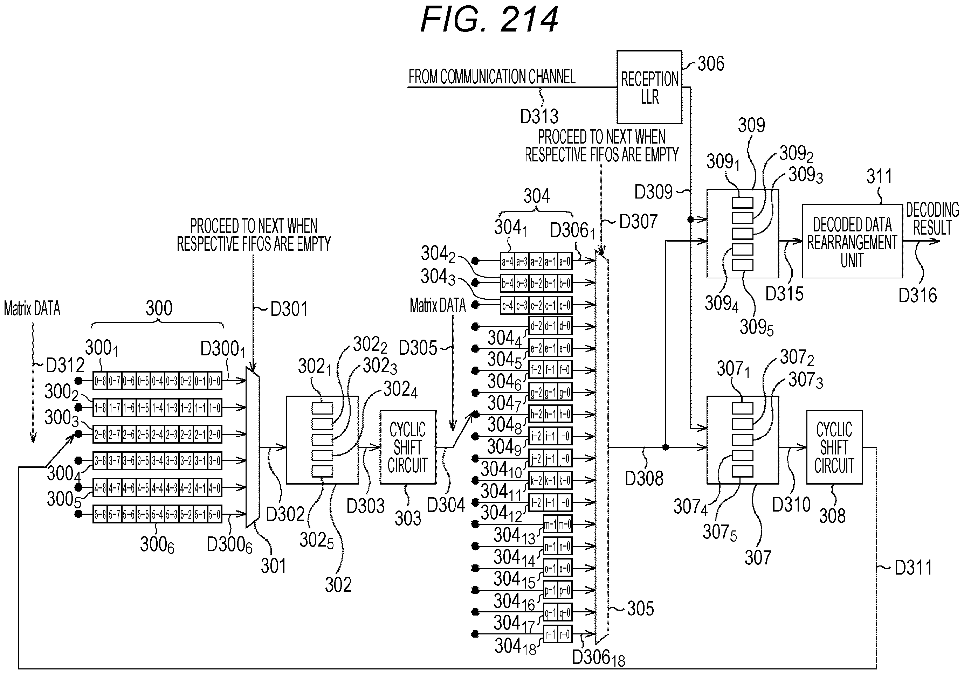

More specifically, Fig. 214 is a diagram showing a configuration example of the LDPC decoder 166 shown in Fig. 207.

The LDPC decoder 166 in Fig. 214 is configured similarly to the decoding device in Fig. 213 except that the reception data rearrangement unit 310 in Fig. 213 is not provided. In this case, the LDPC decoder 166 performs processing similarly to the decoding device in Fig. 213 except that column permutation of Equation (12) is not performed. Accordingly, description of the LDPC decoder 166 is not repeated herein.

As described above, the reception data rearrangement unit 310 may be eliminated from the configuration of the LDPC decoder 166. Accordingly, the scale of the LDPC decoder 166 is smaller than that of the decoding device in Fig. 213.

Note that the LDPC code in Figs. 210 through 214 is determined such that the code length N and the information length K are set to 90 and 60, respectively, and that the unit size (number of rows and number of columns in configuration matrix) P and the divisor q (= M/P) of the parity length M are set to 5 and 6, respectively, for simplifying the description. However, the respective values are not limited to these specific examples.

More specifically, the LDPC encoder 115 of the transmission device 11 in Fig. 8 outputs an LDPC code having the code length N of 64800 or 16200, for example, the information length K of N - Pq (= N - M), the unit size P of 360, and the divisor q of M/P. The LDPC decoder 166 in Fig. 214 is capable of performing LDPC decoding of this LDPC code by simultaneously performing P check node calculations and variable node calculations.

Moreover, after decoding of the LDPC code by the LDPC decoder 166, a parity part of the decoding result is unnecessary. Accordingly, the decoded data rearrangement unit 311 may be eliminated from the configuration of the LDPC decoder 166 when only the information bit of the decoding result is output.

<Configuration example of block deinterleaver 54>

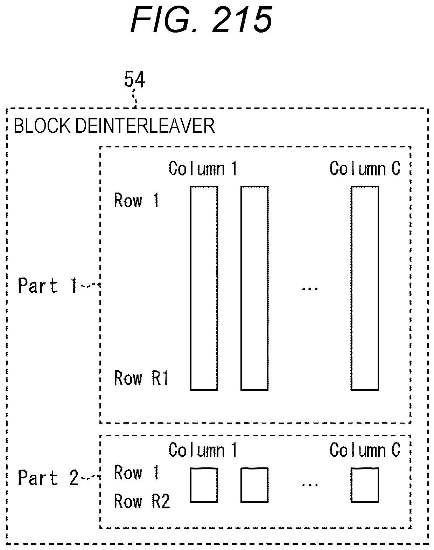

Fig. 215 is a block diagram showing a configuration example of the block deinterleaver 54 shown in Fig. 208.

The block deinterleaver 54 is configured similarly to the block interleaver 25 described with reference to Fig. 105.

Accordingly, the block deinterleaver 54 includes a storage area called part 1, and a storage area called part 2. Each of the parts 1 and 2 contains columns as storage areas each of which stores 1 bit in the row direction, and a predetermined number of bits in the column direction. The number of the columns arranged in the row direction is C equivalent to a bit number m of a symbol.

The block deinterleaver 54 performs block deinterleave by writing and reading an LDPC code to and from the parts 1 and 2.

However, in block deinterleave, an LDPC code (corresponding to symbol) is written in the order of reading of the LDPC code by the block interleaver 25 shown in Fig. 105.

Furthermore, in block deinterleave, an LDPC code is read in the order of writing of the LDPC code by the block interleaver 25 shown in Fig. 105.

More specifically, in block interleave performed by the block interleaver 25 in Fig. 105, an LDPC code is written to the parts 1 and 2 in the column direction, and read therefrom in the row direction. However, in block deinterleave performed by the block deinterleaver 54 in Fig. 215, an LDPC code is written to the parts 1 and 2 in the row direction, and read therefrom in the column direction.

<Other configuration example of bit deinterleaver 165>

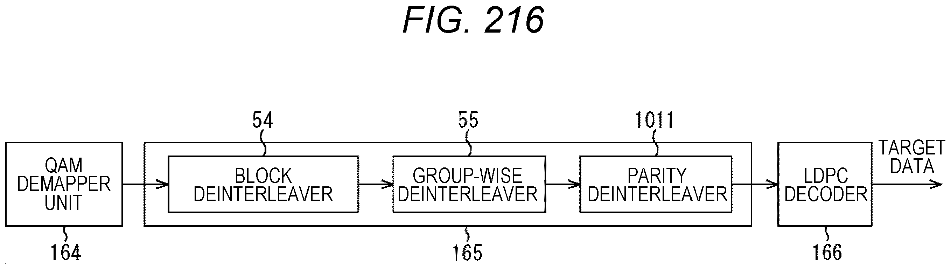

Fig. 216 is a block diagram showing another configuration example of the bit deinterleaver 165 shown in Fig. 207.
Note that parts in the figure identical to the corresponding parts in Fig. 208 have been given identical reference numbers. The same description of these parts is not repeated.
More specifically, the bit deinterleaver 165 in Fig. 216 is configured similarly to the example shown in Fig. 208 except that a parity deinterleaver 1011 is additionally provided.
The bit deinterleaver 165 in Fig. 216 is constituted by the block deinterleaver 54, the group-wise deinterleaver 55, and the parity deinterleaver 1011, and performs bit deinterleave for a sign bit of an LDPC code received from the demapper 164.
More specifically, the block deinterleaver 54 performs block deinterleave corresponding to block interleave performed by the block interleaver 25 of the transmission device 11 (i.e., reverse process of block interleave) for a target of an LDPC code received from the demapper 164, in other words, block deinterleave for returning the position of the sign bit changed by block interleave to the original position, and supplies the resultant LDPC code to the group-wise deinterleaver 55.
The group-wise deinterleaver 55 performs group-wise deinterleave corresponding to group-wise interleave as the rearranging process performed by the group-wise interleaver 24 of the transmission device 11 for a target of an LDPC code received from the block deinterleaver 54.
The LDPC code obtained by group-wise deinterleave is supplied from the group-wise deinterleaver 55 to the parity deinterleaver 1011.
The parity deinterleaver 1011 performs parity deinterleave corresponding to parity interleave performed by the parity interleaver 23 of the transmission device 11 (i.e., reverse process of parity interleave) for a target of the sign bit group-wise deinterleaved by the group-wise deinterleaver 55, in other words, parity deinterleave for returning the sign bit of the LDPC code whose arrangement has been changed by parity interleave to original arrangement.
The LDPC code obtained by parity deinterleave is supplied from the parity deinterleaver 1011 to the LDPC decoder 166.
Accordingly, the bit deinterleaver 165 shown in Fig. 216 supplies a block deinterleaved, group-wise deinterleaved, and parity deinterleaved LDPC code, i.e., an LDPC code obtained by LDPC encoding based on the parity check matrix H, to the LDPC decoder 166.
The LDPC decoder 166 performs LDPC decoding for the LDPC code received from the bit deinterleaver 165 by using the parity check matrix H used by the LDPC encoder 115 of the transmission device 11 for LDPC encoding. More specifically, the LDPC decoder 166 performs LDPC decoding for the LDPC code received from the bit deinterleaver 165 by using the (DVB system) parity check matrix H used by the LDPC encoder 115 of the transmission device 11 for LDPC encoding without change, or a converted parity check matrix obtained by performing at least column permutation corresponding to parity inter leave for the parity check matrix H (for ETRI system, by using parity check matrix (Fig. 28) obtained by column permutation for parity check matrix (Fig. 27) used for LDPC encoding, or converted parity check matrix (Fig. 29) obtained by performing at least row permutation for the parity check matrix (Fig. 27) used for LDPC encoding).
According to the example in Fig. 216, an LDPC code obtained by LDPC encoding using the parity check matrix H is supplied from (the parity deinterleaver 1011 of) the bit deinterleaver 165 to the LDPC decoder 166. Accordingly, when LDPC decoding of the LDPC code is performed by using the (DVB system) parity check matrix H used by the LDPC encoder 115 of the transmission device 11 for LDPC encoding without change (for ETRI system, parity check matrix (Fig. 28) obtained by performing column permutation for parity check matrix (Fig. 27) used for LDPC encoding), the LDPC decoder 166 may be a decoding device performing LDPC decoding of a full serial decoding system which sequentially performs calculation of a message (check node message and variable node message) for each node, or a decoding device performing full parallel decoding system LDPC decoding which simultaneously (in parallel) performs message calculation for all nodes.
In addition, when the LDPC decoder 166 performs LDPC decoding for the LDPC code by using a converted parity check matrix obtained by performing at least column permutation corresponding to parity interleave for the (DVB system) parity check matrix H used by the LDPC encoder 115 of the transmission device 11 for LDPC encoding (for ETRI system, converted parity check matrix (Fig. 29) obtained by performing row permutation for parity check matrix (Fig. 27) used for LDPC encoding), the LDPC decoder 166 may be a decoding device (Fig. 213) which has architecture simultaneously performing P (or devisor of P other than 1) check node calculations and variable node calculations, and includes the reception data rearrangement unit 310 for rearranging the sign bit of the LDPC code by performing column permutation for the LDPC code in a manner similar to column permutation for obtaining a converted parity check matrix (parity interleave).

While the block deinterleaver 54 for performing block deinterleave, the group-wise deinterleaver 55 for performing group-wise deinterleave, and the parity deinterleaver 1011 for performing parity deinterleave are separately constituted in Fig. 216 for convenience of description, two or more of the block deinterleaver 54, the group-wise deinterleaver 55, and the parity deinterleaver 1011 may be formed integrally with each other similarly to the parity interleaver 23, the group-wise interleaver 24, and the block interleaver 25 of the transmission device 11.

<2. Second embodiment>

Incidentally, under ATSC3.0, two types of block interleave system, i.e., a type A and a type B, are adopted for block interleaver performed by (block interleaver) of the bit interleaver 116 shown in Fig. 8.

Here, block interleave of the type A is a system which repeats writing of a group-wise interleaved LDPC code to each of m columns in the column direction, the columns as m storage areas arranged in the row direction. On the other hand, block interleave of the type B is a system which repeats writing of a group-wise interleaved LDPC code in units of bit group in the row direction of the m columns.

As described above, two types of system, i.e., the type A and the type B, are adopted as the system of block interleave. In this case, (block interleaver of) the bit interleaver 116 of the transmission device 11 performing block interleave writes or reads an LDPC code to or from the storage areas in accordance with the type A or the type B.

However, block interleave of the type A and block interleave of the type B are different from each other in the method of writing and the method of a part of reading to and from the storage areas. In this case, two types of address generation circuit are needed for (block interleaver) of the bit interleaver 116 to generate a writing address of an LDPC code and a reading address of an LDPC code.

Similarly, the reading method and a part of writing method from and to the storage areas are different for each type in block deinterleave performed by the (block deinterleaver) of the bit deinterleaver 165 of the reception device 12. Accordingly, (block deinterleaver of) the bit deinterleaver 165 needs to include two types of address generation circuit for generating an LDPC code reading address and an LDPC code writing address.

As apparent from above, two types of address generation circuit are required when two types of system, i.e., the type A and the type B, are adopted for the block interleave system. It is therefore demanded to use a common address generation circuit to realize block interleave of the type A and block interleave of the type B with efficient coexistence of the two types of systems as the type A and the type B.

Discussed hereinbelow is a method for realizing efficient coexistence of a plurality of block interleave systems (type A and type B) in data transmission using an LDPC code according to a second embodiment.

<Configuration example of bit interleaver 116>

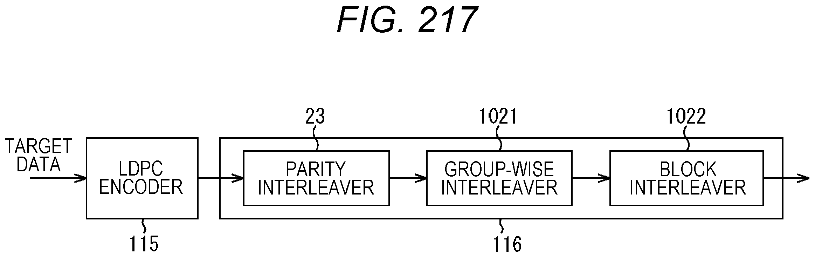

Fig. 217 is a block diagram showing a configuration example of the bit interleaver 116 shown in Fig. 8.

Note that parts in the figure identical to the corresponding parts in Fig. 9 have been given identical reference numbers. The same description of these parts is not repeated.

More specifically, the bit interleaver 116 shown in Fig. 217 is configured similarly to the configuration shown in Fig. 9, except that a group-wise interleaver 1021 and a block interleaver 1022 are provided in place of the group-wise interleaver 24 and the block interleaver 25 in Fig. 9.

The bit interleaver 116 in Fig. 217 is constituted by the parity interleaver 23, the group-wise interleaver 1021, and the block interleaver 1022, and performs bit interleave for a sign bit of an LDPC code received from the LDPC encoder 115.

The group-wise interleaver 1021 performs group-wise interleave for an LDPC code received from the parity interleaver 23, and supplies the group-wise interleaved LDPC code to the block interleaver 1022.

Here, when performing block interleave of the type A on the assumption of execution of block interleave of the type B, the group-wise interleaver 1021 rewrites a GW pattern for block interleave of the type B to a GW pattern for block interleave of the type A such that the same block interleave result as that of the type B is obtainable.

On the other hand, when performing block interleave of the type B on the assumption of execution of block interleave of the type A, the group-wise interleaver 1021 rewrites a GW pattern for block interleave of the type A to a GW pattern for block interleave of the type B such that the same block interleave result as that of the type A is obtainable.

The block interleaver 1022 performs block interleave for demultiplexing the LDPC code received from the group-wise interleaver 1021 to symbolize the one LDPC code into an m-bit symbol corresponding to a unit of mapping, for example, and supplies the symbolized LDPC code to the mapper 117 (Fig. 8).

Note that the block interleaver 1022 corresponds to block interleave of the type A or the type B, and performs block interleave of the type A or the type B.

<Block interleaver 1022 corresponding to block interleave of type A>

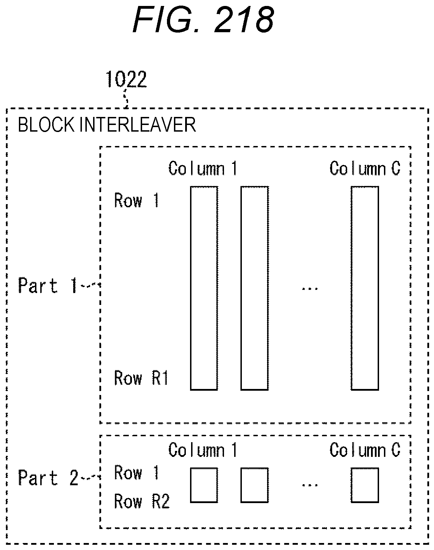

Block interleave of the type A is hereinafter described. Fig. 218 is a block diagram showing a configuration example of the block interleaver 1022 (Fig. 217) corresponding to block interleave of the type A.

The block interleaver 1022 corresponding to block interleave of the type A includes a storage area called part 1, and a storage area called part 2.

Each of the parts 1 and 2 is constituted by a number C of columns as storage areas each of which stores a predetermined bit number in the column (vertical) direction. The number C of the columns arranged in the row direction is the same number as a bit number m of a symbol.

Assuming that the part column length corresponding to the bit number stored in the column of the part 1 in the column direction is expressed as R1, and that the part column length of the column of the part 2 is expressed as R2, (R1 + R2) × C is equivalent to a code length N of an LDPC code as a target of block interleave (length N: 64800 bits or 16200 bits according to second embodiment).

In addition, the part column length R1 is equivalent to a multiple of 360 bits corresponding to the unit size P, while the part column length R2 is equivalent to a remainder obtained by dividing the column length R1 + R2, i.e., the sum of the part column length R1 of the part 1 and the part column length R2 of the part 2, by 360 bits corresponding to the unit size P.

Here, the column length R1 + R2 is equivalent to the value obtained by dividing the code length N of the LDPC code corresponding to the target of block interleave by the bit number m of the symbol.

For example, when 16QAM is adopted as a modulation system for an LDPC code having the code length N of 16200 bits, the bit number m of the symbol is 4 bits. Accordingly, the column length R1 + R2 is 4050 (16200/4) bits.

In addition, the remainder obtained when the column length R1 + R2 = 4050 is divided by 360 bits corresponding to the unit size P is 90. Accordingly, the part column length R2 of the part 2 is 90 bits.

In this case, the column length R1 of the part 1 is calculated as R1 + R2 - R2 = 4050 - 90 = 3960 bits.

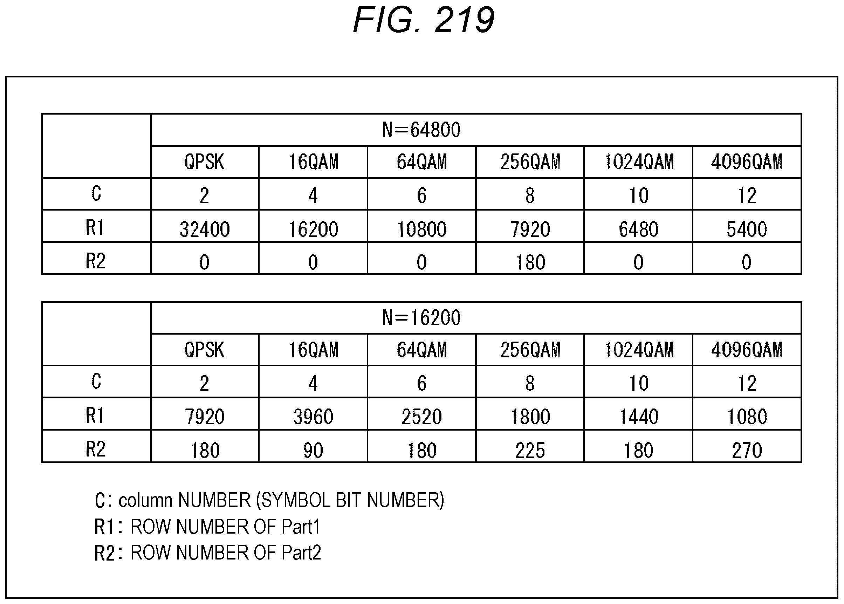

Fig. 219 is a diagram showing the column number C of the parts 1 and 2, and the part column lengths (numbers of rows) of R1 and R2 for each combination of the code length N and the modulation system.

Fig. 219 shows the column number C of the parts 1 and 2, and the part column lengths R1 and R2 for each of combinations of LDPC codes having code lengths N of 16200 bits and 64800 bits, and the modulation systems of QPSK, 16QAM, 64QAM, 256QAM, 1024QAM, and 4096QAM

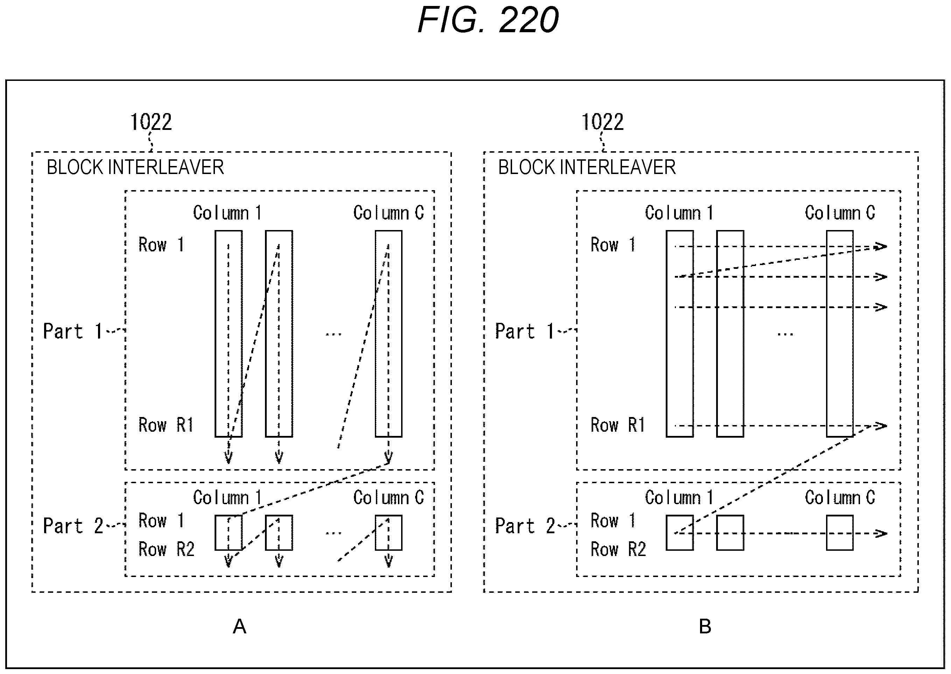

Fig. 220 is a diagram showing block interleave of the type A performed by the block interleaver 1022 (Fig. 217).

The block interleaver 1022 writes and reads an LDPC code to and from the parts 1 and 2 to perform block interleave of the type A.

More specifically, in block interleave of the type A, writing of sign bits of an LDPC code as one code word to each column in the part 1 in the direction from the top to the bottom (column direction) is performed in such a manner as to write the sign bits to the respective columns in the part 1 from the left to the right as shown in part A in Fig. 220.

Then, when writing of the sign bits is completed for the lowermost position of the rightmost column (Cth column) in the part 1, writing of remaining sign bits to each column in the part 2 from the top to the bottom (column direction) is initiated for the columns from the left to the right.

When writing of the sign bits is subsequently completed for the lowermost position of the column located at the rightmost position in the part 2 (Cth column), the sign bits are read in the row direction in units of C = m bits from the first row of the C columns in the part 1 as shown in part B in Fig. 220.

In addition, reading of the sign bits from all the C columns in the part 1 is sequentially performed toward the lower row. When reading is completed for the R1th row corresponding to the final row, the sign bits are read from the first rows of all the C columns in the part 2 in the row direction in units of C = m bits.

Reading of the sign bits from all the C columns of the part 2 is sequentially performed toward the lower row up to the R2th row corresponding to the final row.

The sign bits read from the parts 1 and 2 in units of m bits in the manner described above are supplied as symbols to the mapper 117 (Fig. 8).

<Group-wise interleave>

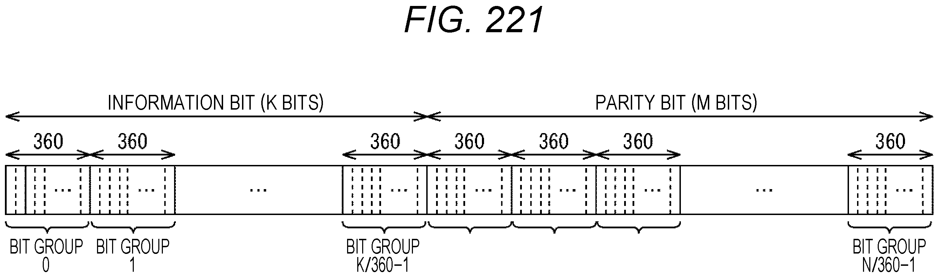

Fig. 221 is a diagram showing group-wise interleave performed by the group-wise interleaver 1021 shown in Fig. 217.

In group-wise interleave, an LDPC code as one code word is interleaved on the basis of a predetermined pattern (GW pattern) in units of bit group, which group is constituted by 360 bits as a unit of sections of the LDPC code as one code word sectioned from the head of the LDPC code. The unit of 360 bits is equivalent to the unit size P.

When the unit size P is 360, an LDPC code having the code length N of 1800 bits is sectioned into 5 (= 1800/360) bit groups 0, 1, 2, 3, and 4, for example. On the other hand, an LDPC code having the code length N of 16200 bits is sectioned into 45 (= 16200/360) bit groups 0, 1, and up to 44, while an LDPC code having the code length N of 64800 bits is sectioned into 180 (= 64800/360) bit groups 0, 1, and up to 179, for example.

Note that the (i + 1)th bit group from the head of the LDPC code as one code word sectioned into bit groups is hereinafter expressed as a bit group i. In addition, each GW pattern is hereinafter expressed as arrangement of numerals representing bit groups. For example, for an LDPC code having the code length N of 1800 bits, a GW pattern 4, 2, 0, 3, 1 interleaves (rearranges) arrangement of a bit group 0, 1, 2, 3, 4 as arrangement of a bit group 4, 2, 0, 3, 1.

<Specific example of block interleave of type A>

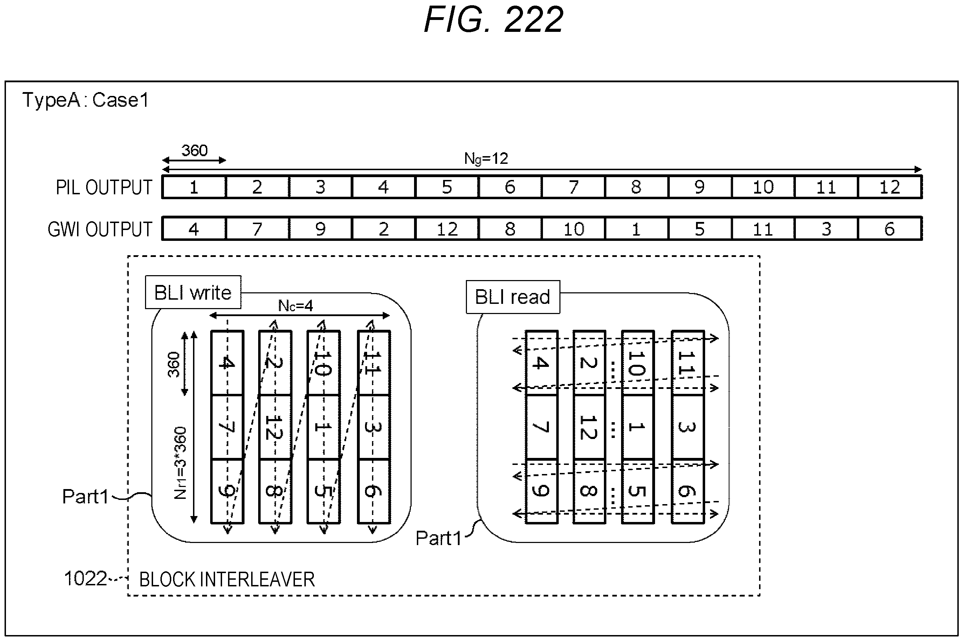

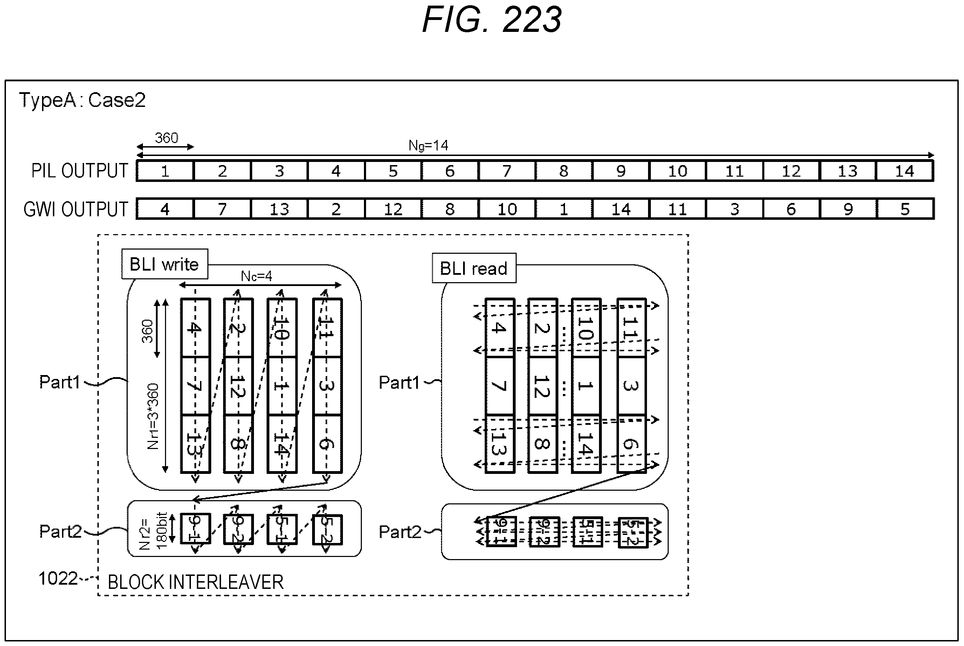

Hereinafter described with reference to Figs. 222 and 223 is bit interleave performed by the bit interleaver 116 including the block interleaver 1022 corresponding to block interleave of the type A.

Fig. 222 shows an example of a case 1 as a specific example of block interleave of the type A, where the number of bit groups and the number of columns are determined as $N_g$ = 12 and $N_c$ = 4, respectively. In addition, bit groups in Fig. 222 are sectioned in units of 360 bits.

According to the case 1 of block interleave of the type A, a column length $N_{r1}$ of the part 1 is floor $(N_g/N_c) \times$ 360 = 12/4 × 360 = 3 × 360 bits. On the other hand, a column length $N_{r2}$ of the part 2 is $(N_g \times 360 - N_{r1} \times N_c)/N_c$ = (12 × 360 - 3 × 360 × 4)/4 = 0. Accordingly, only the storage area of the part 1 is used, while the storage area of the part 2 is not used. Note that a floor function is a function which cuts off after the decimal point.

In addition, parity interleaver (PIL) output in Fig. 222 indicates output from the parity interleaver 23, i.e., input to the group-wise interleaver 1021, while group-wise interleaver (GWI) output indicates output from the group-wise interleaver 1021. More specifically, the group-wise interleaver 1021 interleaves arrangement of bit groups 1, 2, 3, 4, 5, 6, 7, 8, 9, 10, 11, 12 into arrangement of bit groups 4, 7, 9, 2, 12, 8, 10, 1, 5, 11, 3, 6 on the basis of a GW pattern 4, 7, 9, 2, 12, 8, 10, 1, 5, 11, 3, 6.

The block interleaver 1022 performs writing of output from the group-wise interleaver 1021 to each column in the part 1 in the direction from the top to the bottom (column direction) in such a manner as to write the output to the respective columns in the direction from the left to the right.

As a result, as shown in "BLI (block interleaver) write" in Fig. 222, sign bits of bit groups 4, 7, 9 are written to the first column (leftmost column), sign bits of bit groups 2, 12, 8 are written to the second column, sign bits of bit groups 10, 1, 5 are written to the third column, and sign bits of bit groups 11, 3, 6 are written to the fourth column (rightmost column).

When writing of the sign bits is completed for the lowermost position of the fourth column (rightmost column) in the part 1, the sign bits are read in the row direction in units of C = m bits from the first rows of all the four columns of the part 1 as indicated in "BLI read" in Fig. 222. Thereafter, reading of the sign bit from all the four columns of the part 1 is sequentially performed toward the lower rows until the final row.

The sign bits read in units of m bits from the part 1 are supplied to the mapper 117 (Fig. 8) as symbols. Thereafter, the mapper 117 maps the LDPC code received from the bit interleaver 116 in units of symbol to signal points indicating symbols in 16($2^4$) signal points.

Fig. 223 shows a case 2 where the number of bit groups and the column number are determined as $N_g$ = 14 and $N_c$ = 4, respectively, as a specific example of block interleave of the type A. In addition, the respective bit groups in Fig. 223 are sectioned in units of 360 bits.

According to the case 2 of block interleave of the type A, the column length $N_{r1}$ of the part 1 is floor $(N_g/N_c) \times$ 360 = 14/4 × 360 = 3 × 360 bits. On the other hand, the column length $N_{r2}$ of the part 2 is $(N_g \times 360 - N_{r1} \times N_c)/N_c$ = (14 × 360 - 3 × 360 × 4)/4 = (2 × 360)/4 = 180 bits. Accordingly, the storage area of the part 2 is used as well as the storage area of the part 1.

In addition, PIL output and GWI output in Fig. 223 indicate input and output to and from the group-wise interleaver 1021. More specifically, the group-wise interleaver 1021 interleaves arrangement of bit groups 1, 2, 3, 4, 5, 6, 7, 8, 9, 10, 11, 12, 13, 14 to arrangement of bit groups 4, 7, 13, 2, 12, 8, 10, 1, 14, 11, 3, 6, 9, 5 on the basis of a GW pattern 4, 7, 13, 2, 12, 8, 10, 1, 14, 11, 3, 6, 9, 5.

The block interleaver 1022 performs writing of output from the group-wise interleaver 1021 to each column in the part 1 in the direction from the top to the bottom (column direction) in such a manner as to write the output to the respective columns in the direction from the left to the right. Then, when writing of sign bits is completed for the lowermost position of the rightmost column of the columns of the part 1, writing of remaining sign bits to each column in the part 2 in the direction from the top to the bottom (column direction) is performed in such a manner as to write the remaining sign bits to the respective columns in the direction from the left to the right.

As a result, as shown in "BLI write" in Fig. 223, sign bits of bit groups 4, 7, 13 are written to the first column (leftmost column), sign bits of bit groups 2, 12, 8 are written to the second column, sign bits of bit groups 10, 1, 14 are written to the third column, and sign bits of bit groups 11, 3, 6 are written to the fourth column (rightmost column) in the part 1.

In addition, a sign bit of a bit group 9-1 is written to the first column (leftmost column), a sign bit of a bit group 9-2 is written to the second column, a sign bit of a bit group 5-1 is written to the third column, and a sign bit of a bit group 5-2 is written to the fourth column (rightmost column) in the part 2.

In this case, each of the bit group 9-1 and the bit group 9-2 is constituted by 180 bits. The bit groups 9-1 and 9-2 are combined to constitute a bit group 9. On the other hand, each of the bit group 5-1 and the bit group 5-2 is constituted by 180 bits. The bit groups 5-1 and 5-2 are combined to constitute a bit group 5.

When writing of the sign bits is completed for the lowermost position of the fourth column (rightmost column) in the part 2, sign bits are read in the row direction in units of C = m bits from the first rows of all the four columns in the part 1 as indicated in "BLI read" in Fig. 223.

Thereafter, reading of sign bits from all the four columns of the part 1 is sequentially performed toward the lower rows. When reading of the sign bits is completed in the final row, sign bits are read in the row direction in units of C = m bits from the first rows of all the four columns of the part 2.

Thereafter, reading of the sign bits from all the four columns of the part 2 is sequentially performed toward the lower rows until the final row.

The sign bits read from the parts 1 and 2 in units of m bits in the manner described above are supplied as symbols to the mapper 117 (Fig. 8). Thereafter, the mapper 117 maps the LDPC code received from the bit interleaver 116 in units of symbol to signal points indicating symbols in $16(2^4)$ signal points.

<Block interleaver 1022 corresponding to block interleave of type B>

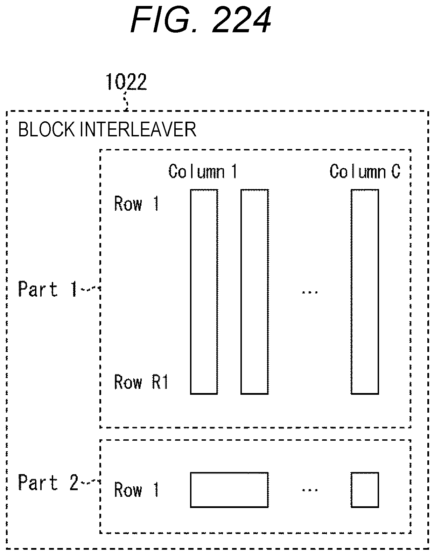

Block interleave of the type B is hereinafter described. Fig. 224 is a block diagram showing a configuration example of the block interleaver 1022 (Fig. 217) corresponding to block interleave of the type B.

The block interleaver 1022 corresponding to block interleave of the type B includes a storage area called part 1, and a storage area called part 2.

The part 1 contains columns as storage areas each of which stores 1 bit in the row (horizontal) direction, and a predetermined number of bits in the column (vertical) direction. The number of the columns arranged in the row direction is C equivalent to a bit number m of a symbol. On the other hand, the part 2 contains rows as storage areas each of which stores 1 bit in the column (vertical) direction, and a predetermined number of bits in the row (horizontal) direction.

Assuming that the part column length as the bit number stored in the column of the part 1 in the column direction is expressed as R1, and that the row length of the row of the part 2 is expressed as R2, $R1 \times C + R2$ is equivalent to the code length N (64800 bits or 16200 bits according to the second embodiment) of an LDPC code corresponding to a target of block interleave.

In addition, the part column length R1 is equivalent to a multiple of 360 bits corresponding to the unit size P, while the row length R2 is equivalent to a value obtained by multiplying a remainder by C, the reminder obtained when a column length corresponding to the sum of the part column length R1 of the part 1, and the row length R2 divided by C, i.e., R1 + R2/C is divided by 360 bits corresponding to the unit size P.

The column length R1 + R2/C herein is equivalent to the value obtained by dividing the code length N of the LDPC code corresponding to the target of block interleave by the bit number m of the symbol.

For example, when 16QAM is adopted as a modulation system for an LDPC code having the code length N of 16200 bits, the bit number m of the symbol is 4 bits. Accordingly, the column length R1 + R2/C is 4050 (= 16200/4) bits.

In addition, the remainder obtained when the column length R1 + R2/C = 4050 is divided by 360 bits corresponding to the unit size P is 90. Accordingly, the row length R2 of the part 2 is 360 (= $90 \times 4$) bits.

In this case, the column length R1 of the part 1 is calculated as R1 + R2/C - R2/4 = 4050 - 90 = 3960.

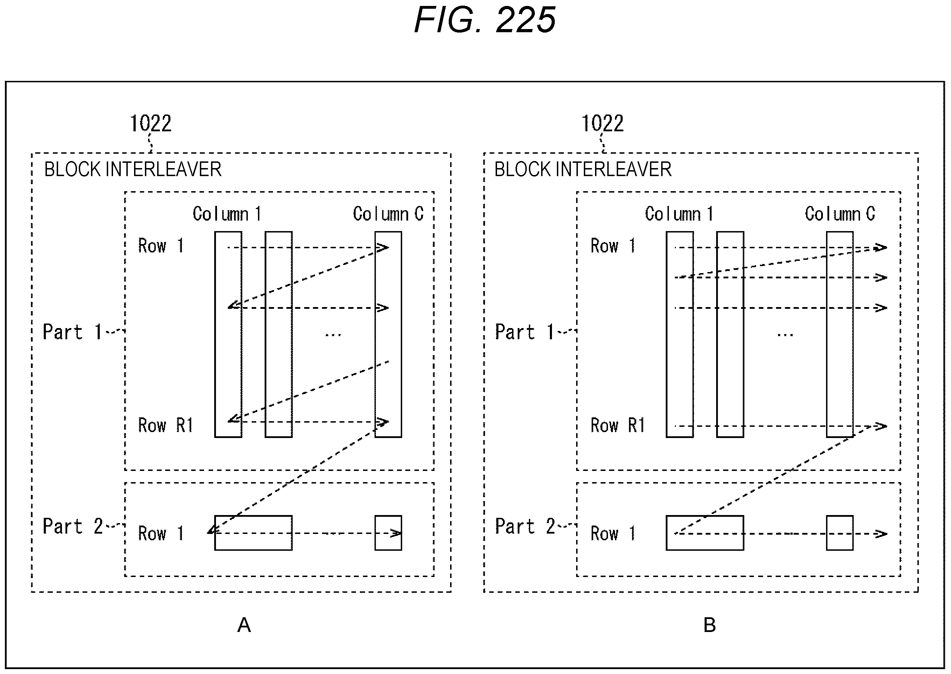

Fig. 225 is a diagram showing block interleave of the type B performed by the block interleaver 1022 (Fig. 217).

The block interleaver 1022 writes and reads an LDPC code to and from the parts 1 and 2 to perform block interleave of the type B.

More specifically, in block interleave of the type B, writing of sign bits of an LDPC code as one code word to the column of the part 1 in the direction from the left to the right (row direction) is repeatedly performed in units of bit group as shown in part A in Fig. 225.

Then, when writing of the sign bits is completed for the lowermost position of the rightmost column (Cth column) in the part 1, writing of the remaining sign bits to the rows of the part 2 from the left to the right (row direction) is performed.

When writing of the sign bits is subsequently completed for the rightmost position of the rows in the part 2, the sign bits are read in the row direction in units of C = m bits from the first row of the C columns in the part 1 as shown in part B in Fig. 225.

Then, reading of the sign bits from all the C columns of the part 1 is sequentially performed toward the lower row. When reading is completed for the R1th row corresponding to the final row, the sign bits are read from the rows of the part 2 in the direction from the left to the right (row direction) in units of C = m bits.

The sign bits read from the parts 1 and 2 in units of m bits in the manner described above are supplied as symbols to the mapper 117 (Fig. 8).

<Specific example of block interleave of type B>

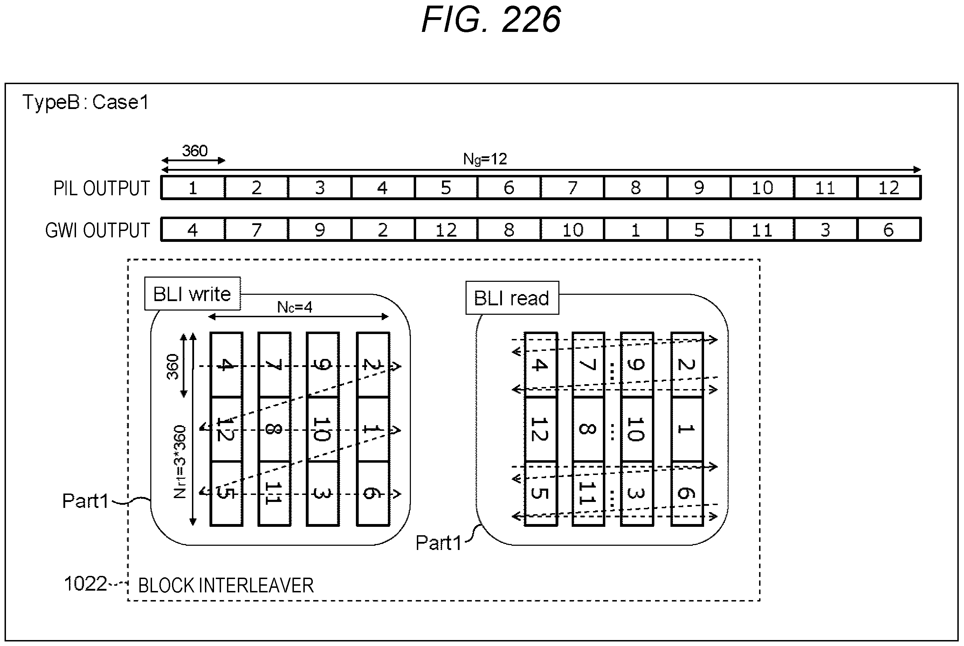

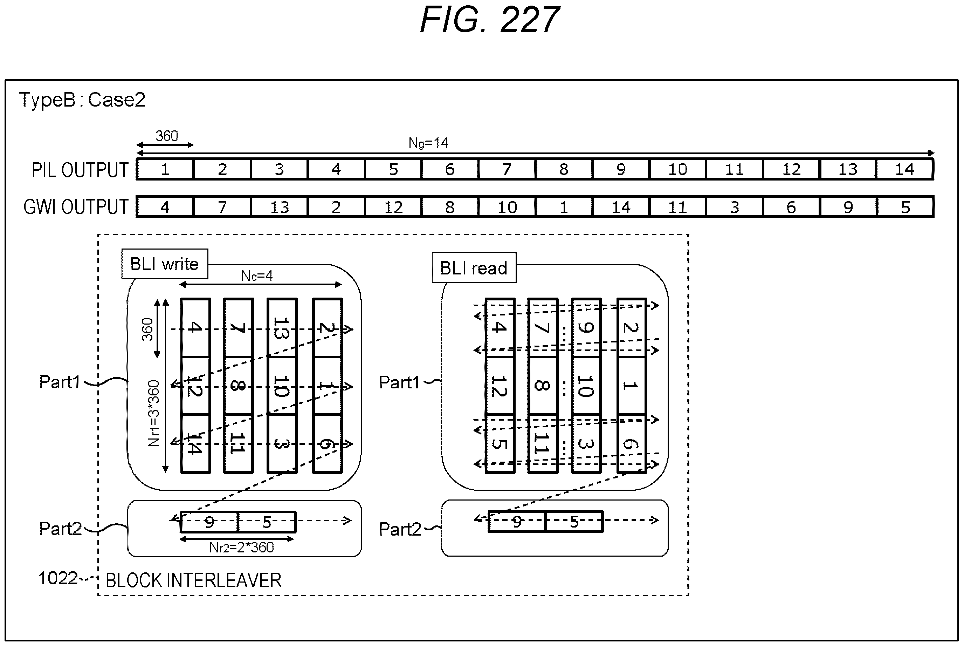

Hereinafter described with reference to Figs. 226 and 227 is bit interleave performed by the bit interleaver 116 including the block interleaver 1022 corresponding to block interleave of the type B.

Fig. 226 shows an example of a case 1 as a specific example of block interleave of the type B, where the number of bit groups and the number of columns are determined as $N_g = 12$ and $N_c = 4$, respectively. In addition, bit groups in Fig. 226 are sectioned in units of 360 bits.

According to the case 1 of block interleave of the type B, a column length $N_{r1}$ of the part 1 is floor ($N_g/N_c$) $\times$ 360 = 12/4 $\times$ 360 = 3 $\times$ 360 bits. On the other hand, a row length $N_{r2}$ of the part 2 is Ng $\times$ 360 - $N_{r1}$ $\times$ $N_c$ = 12 $\times$ 360 -3 $\times$ 360 $\times$ 4 = 0 bit. Accordingly, only the storage area of the part 1 is used, while the storage area of the part 2 is not used.

In addition, PIL output and GWI output in Fig. 226 indicate input and output from the group-wise interleaver 1021. More specifically, the group-wise interleaver 1021 interleaves arrangement of bit groups 1, 2, 3, 4, 5, 6, 7, 8, 9, 10, 11, 12 into arrangement of bit groups 4, 7, 9, 2, 12, 8, 10, 1, 5, 11, 3, 6 on the basis of a GW pattern 4, 7, 9, 2, 12, 8, 10, 1, 5, 11, 3, 6.

The block interleaver 1022 repeatedly performs writing of output from the group-wise interleaver 1021 to the columns of the part 1 in the direction from the left to the right (row direction) in units of bit group.

As a result, as shown in "BLI write" in Fig. 226, sign bits of bit groups 4, 12, 5 are written to the first column (leftmost column), sign bits of a bit group 7, 8, 11 are written to the second column, sign bits of bit groups 9, 10, 3 are written to the third column, and sign bits of bit groups 2, 1, 6 are written to the fourth column (rightmost column).

When writing of the sign bits is completed for the lowermost position of the fourth column (rightmost column) in the part 1, the sign bits are read in the row direction in units of C = m bits from the first rows of all the four columns of the part 1 as indicated in "BLI read" in Fig. 226. Thereafter, reading of the sign bit from all the four columns of the part 1 is sequentially performed toward the lower rows until the final row.

The sign bits read in units of m bits from the part 1 are supplied to the mapper 117 (Fig. 8) as symbols. Thereafter, the mapper 117 maps the LDPC code received from the bit interleaver 116 in units of symbol to signal points indicating symbols in 16($2^4$) signal points.

Fig. 227 shows a case 2 where the number of bit groups and the number of columns are determined as Ng = 14 and $N_c = 4$, respectively, as a specific example of block interleave of the type B. In addition, the respective bit groups in Fig. 227 are sectioned in units of 360 bits.

According to the case 2 of block interleave of the type B, the column length $N_{r1}$ of the part 1 is floor ($N_g/N_c$) $\times$ 360 = 14/4 $\times$ 360 = 3 $\times$ 360 bits. On the other hand, the row length $N_{r2}$ of the part 2 is $N_g$ $\times$ 360 - $N_{r1}$ $\times$ $N_c$ = 14 $\times$ 360 - 3 $\times$ 360 $\times$ 4 = 2 $\times$ 360 bits. Accordingly, the storage area of the part 2 is used as well as the storage area of the part 1.

In addition, PIL output and GWI output in Fig. 227 indicate input and output to and from the group-wise interleaver 1021. More specifically, the group-wise interleaver 1021 interleaves arrangement of bit groups 1, 2, 3, 4, 5, 6, 7, 8, 9, 10, 11, 12, 13, 14 to arrangement of bit groups 4, 7, 13, 2, 12, 8, 10, 1, 14, 11, 3, 6, 9, 5 on the basis of a GW pattern 4, 7, 13, 2, 12, 8, 10, 1, 14, 11, 3, 6, 9, 5.

The block interleaver 1022 repeatedly performs writing of output from the group-wise interleaver 1021 to the columns of the part 1 in the direction from the left to the right (row direction) in units of bit group. Then, when writing of sign bits is completed for the lowermost position of the rightmost column of the columns in the part 1, writing of remaining sign bits to the respective columns in the part 2 in the direction from the left to the right (row direction) is performed.

As a result, as shown in "BLI write" in Fig. 227, sign bits of bit groups 4, 12, 14 are written to the first column (leftmost column), sign bits of bit groups 7, 8, 11 are written to the second column, sign bits of bit groups 13, 10, 3 are written to the third column, and sign bits of a bit group 2, 1, 6 are written to the fourth column (rightmost column) in the part 1. In addition, sign bits of bit groups 9, 5 are written to the rows in the part 2.

When writing of the sign bits is subsequently completed for the rightmost position of the rows in the part 2, the sign bits are read in the row direction in units of C = m bits from the first rows of all the four columns of the part 1 as indicated in "BLI read" in Fig. 227.

Thereafter, reading of sign bits from all the four columns of the part 1 is sequentially performed toward the lower rows. When reading of the sign bits is completed for the final row, the sign bits are read from the rows of the part 2 in the direction from the left to the right (row direction) in units of C = m bits. In this example, the sign bits of the bit group 9, 5 written to the rows in the part 2 are sequentially read from the head for every 4 bits.

The sign bits read from the parts 1 and 2 in units of m bits in the manner described above are supplied as symbols to the mapper 117 (Fig. 8). Thereafter, the mapper 117 maps the LDPC code received from the bit interleaver 116 in units of symbol to signal points indicating symbols in 16($2^4$) signal points.

<Rewriting of GW pattern in accordance with type of block interleave>

The group-wise interleaver 1021 needs to prepare a GW pattern for block interleave of the type A, and a GW pattern for block interleave of the type B in accordance with types of block interleave performed by the block interleaver 1022 provided downstream.

In addition, the writing method and a part of the reading method to and from the storage area used in block interleave of the type A is different from those methods used in block interleave of the type B. In this case, two types of address generation circuits are needed in correspondence with the respective types. Accordingly, there has been a demand for a common address generation circuit used for both block interleave of the type A and block interleave of the type B, as described above.

For meeting this demand, the group-wise interleaver 1021 converts a GW pattern for block interleave of the type B into a GW pattern for block interleave of the type A, or converts a GW pattern for block interleave of the type A into a GW pattern for block interleave of the type B to commonize the address generation circuit.

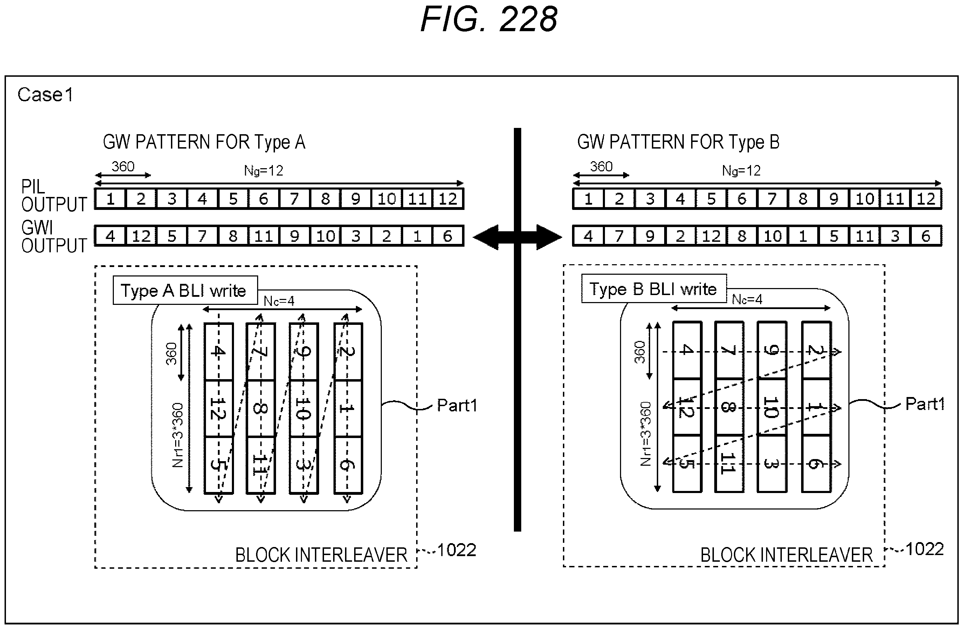

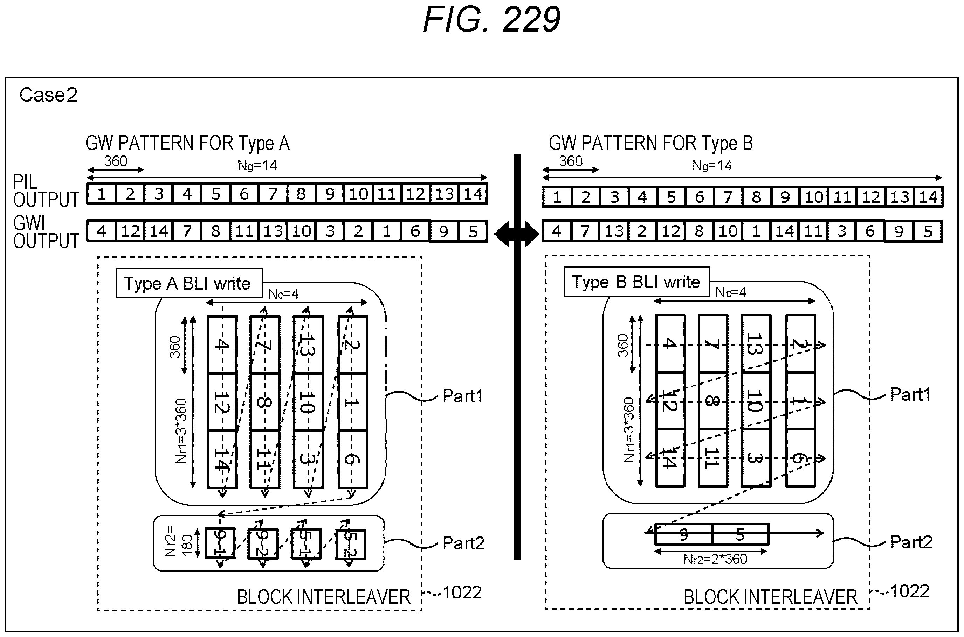

Rewriting (conversion) of a GW pattern performed by the group-wise interleaver 1021 is hereinafter described with reference to Figs. 228 and 229.

Fig. 228 shows a case 1 where the number of bit groups and the number of columns are determined as Ng = 12 and $N_c$ = 4, respectively, as a specific example of conversion of a GW pattern.

A left part of Fig. 228 shows the block interleaver 1022 corresponding to block interleave of the type A, while a right part of Fig. 228 shows the block interleaver 1022 corresponding to block interleave of the type B.

Note that each block interleave in Fig. 228 uses only the storage areas of the part 1, and does not use the storage areas of the part 2, similarly to the foregoing examples shown in Figs. 222 and 226. In addition, each bit group is sectioned in units of 360 bits.

In Fig. 228, PIL output and GWI output indicate input and output of the group-wise interleaver 1021. As shown in the left part of the figure, the group-wise interleaver 1021 interleaves arrangement of bit groups 1, 2, 3, 4, 5, 6, 7, 8, 9, 10, 11, 12 to arrangement of bit groups 4, 12, 5, 7, 8, 11, 9, 10, 3, 2, 1, 6, and outputs the result to the block interleaver 1022 corresponding to block interleave of the type A.

More specifically, the group-wise interleaver 1021 interleaves arrangement of the bit groups 1, 2, 3, 4, 5, 6, 7, 8, 9, 10, 11, 12 to arrangement of the bit groups 4, 12, 5, 7, 8, 11, 9, 10, 3, 2, 1, 6 on the basis of a GW pattern 4, 12, 5, 7, 8, 11, 9, 10, 3, 2, 1, 6 for block interleave of the type A.

The block interleaver 1022 corresponding to block interleave of the type A performs writing of output from the group-wise interleaver 1021 to each column in the part 1 in the direction from the top to the bottom (column direction) in such a manner as to write the output to the respective columns in the direction from the left to the right.

As a result, as shown in "Type A BLI write" in the left part in the figure, sign bits of bit groups 4, 12, 5 are written to the first column (leftmost column), sign bits of bit groups 7, 8, 11 are written to the second column, sign bits of bit groups 9, 10, 3 are written to the third column, and sign bits of bit groups 2, 1, 6 are written to the fourth column (rightmost column). When writing of the sign bits is completed for the lowermost position of the fourth column of the part 1, writing of sign bits ends.

On the other hand, as shown in the right part of the figure, the group-wise interleaver 1021 interleaves arrangement of bit groups 1, 2, 3, 4, 5, 6, 7, 8, 9, 10, 11, 12 to arrangement of bit groups 4, 7, 9, 2, 12, 8, 10, 1, 5, 11, 3, 6, and outputs the interleaved bit groups to the block interleaver 1022 corresponding to block interleave of the type B.

More specifically, the group-wise interleaver 1021 interleaves arrangement of the bit groups 1, 2, 3, 4, 5, 6, 7, 8, 9, 10, 11, 12 into arrangement of the bit groups 4, 7, 9, 2, 12, 8, 10, 1, 5, 11, 3, 6 on the basis of a GW pattern 4, 7, 9, 2, 12, 8, 10, 1, 5, 11, 3, 6 for block interleave of the type B.

The block interleaver 1022 corresponding to block interleave of the type B performs writing of output from the group-wise interleaver 1021 in the direction from the left to the right (row direction) of the column in the part 1 in units of bit group.

As a result, as shown in "Type B BLI write" in the right part in the figure, sign bits of bit groups 4, 12, 5 are written to the first column (leftmost column), sign bits of bit groups 7, 8, 11 are written to the second column, sign bits of bit groups 9, 10, 3 are written to the third column, and sign bits of bit groups 2, 1, 6 are written to the fourth column (rightmost column). When writing of the sign bits is completed for the lowermost position of the fourth column of the part 1, writing of sign bits ends.

The group-wise interleaver 1021 interleaves in the manner described above on the basis of the GW pattern corresponding to types of block interleave. In this case, the block interleaver 1022 produces the same writing result of the sign bits written to the columns in the part 1 for block interleave of the type A and for block interleave of the type B.

More specifically, in both block interleave of the type A and block interleave of the type B, the sign bits of the bit groups 4, 12, 5 are written to the first column, the sign bits of the bit groups 7, 8, 11 are written to the second column, the sign bits of the bit groups 9, 10, 3 are written to the third column, and the sign bits of the bit groups 2, 1, 6 are written to the fourth column.

When the writing result of the sign bits written to the columns of the part 1 is identical, only the writing address generated by the address generation circuit for block interleave of the type A, or the writing address generated by the address generation circuit for block interleave of the type B is needed. In other words, block interleave of the type A and block interleave of the type B are realizable by using a common address generation circuit.

Accordingly, when initiating block interleave of the type A of the assumption of execution of block interleave of the type B, the group-wise interleaver 1021 shown in Fig. 228 rewrites a GW pattern such that a block interleave result (writing result of sign bit written to columns in part 1) identical to a corresponding block interleave result of the type B is obtainable.

For example, on the assumption of execution of block interleave of the type B, the group-wise interleaver 1021 in Fig. 228 assumes a case 1-1 where a GW pattern 4, 7, 9, 2, 12, 8, 10, 1, 5, 11, 3, 6 is set as a GW pattern for block interleave of the type B.

When the block interleaver 1022 performs block interleave of the type A in the case 1-1, the group-wise interleaver 1021 rewrites the GW pattern 4, 7, 9, 2, 12, 8, 10, 1, 5, 11, 3, 6 for block interleave of the type B to a GW pattern 4, 12, 5, 7, 8, 11, 9, 10, 3, 2, 1, 6 for block interleave of the type A. As a result, the block interleave result of the type A obtained by the group-wise interleaver 1021 becomes identical to the block interleave result of the type B.

In addition, when initiating block interleave of the type B of the assumption of execution of block interleave of the type A, the group-wise interleaver 1021 shown in Fig. 228 rewrites a GW pattern such that a block interleave result (writing result of sign bit written to columns in part 1) identical to a corresponding block interleave result of the type A is obtainable.

For example, on the assumption of execution of block interleave of the type A, the group-wise interleaver 1021 in Fig. 228 assumes a case 1-2 where a GW pattern 4, 12, 5, 7, 8, 11, 9, 10, 3, 2, 1, 6 is set as a GW pattern for block interleave of the type A.

When the block interleaver 1022 performs block interleave of the type B in the case 1-2, the group-wise interleaver 1021 rewrites the GW pattern 4, 12, 5, 7, 8, 11, 9, 10, 3, 2, 1, 6 for block interleave of the type A to a GW pattern 4, 7, 9, 2, 12, 8, 10, 1, 5, 11, 3, 6 for block interleave of the type B. As a result, the block interleave result of the type B obtained by the group-wise interleaver 1021 becomes identical to the block interleave result of the type A.

Accordingly, the group-wise interleaver 1021 converts the GW pattern for block interleave of the type B into the GW pattern for block interleave of the type A, or converts the GW pattern for block interleave of the type A into the GW pattern for block interleave of the type B, thereby commonizing the address generation circuit.

In addition, only rewriting of the GW pattern by the group-wise interleaver 1021 in accordance with the types of block interleave does not cause performance deterioration as a result of conversion of the GW pattern. For example, completely the same performance is produced by block interleave of the type A on the basis of the GW pattern for block interleave of the type A on the assumption of execution of block interleave of the type A, and by block interleave of the type B on the basis of the rewritten GW pattern for block interleave of the type B. Accordingly, no performance deterioration is caused as a result of conversion of the GW pattern.

Note that the block interleaver 1022 in Fig. 228 reads sign bits from the columns of the part 1 in a manner similar to the examples in Figs. 222 and 226. The sign bits thus read from the part 1 are supplied to the mapper 117 (Fig. 8) as symbols.

Fig. 229 shows a case 2 where the number of bit groups and the number of columns are determined as $N_g = 14$ and $N_c = 4$, respectively, as a specific example of conversion of a GW pattern.

Similarly to Fig. 228 described above, a left part of Fig. 229 shows the block interleaver 1022 corresponding to block interleave of the type A, while a right part of Fig. 228 shows the block interleaver 1022 corresponding to block interleave of the type B.

Note that each block interleave in Fig. 229 uses the storage areas of the part 2 as well as the storage areas of the part 1, similarly to the foregoing examples shown in Figs. 223 and 227. In addition, each bit group is sectioned in units of 360 bits.

In Fig. 229, PIL output and GWI output indicate input and output of the group-wise interleaver 1021. As shown in the left part of the figure, the group-wise interleaver 1021 interleaves arrangement of bit groups 1, 2, 3, 4, 5, 6, 7, 8, 9, 10, 11, 12, 13, 14 to arrangement of bit groups 4, 12, 14, 7, 8, 11, 13, 10, 3, 2, 1, 6, 9, 5, and outputs the result to the block interleaver 1022 corresponding to block interleave of the type A.

More specifically, the group-wise interleaver 1021 interleaves arrangement of the bit groups 1, 2, 3, 4, 5, 6, 7, 8, 9, 10, 11, 12, 13, 14 into arrangement of the bit groups 4, 12, 14, 7, 8, 11, 13, 10, 3, 2, 1, 6, 9, 5 on the basis of a GW pattern 4, 12, 14, 7, 8, 11, 13, 10, 3, 2, 1, 6, 9, 5 for block interleave of the type A.

The block interleaver 1022 corresponding to block interleave of the type A performs writing of output from the group-wise interleaver 1021 to each column in the part 1 in the direction from the top to the bottom (column direction) in such a manner as to write the output to the respective columns in the direction from the left to the right. Then, when writing of sign bits is completed for the lowermost position of the rightmost column of the columns of the part 1, writing of remaining sign bits to each column in the part 2 in the direction from the top to the bottom (column direction) is performed in such a manner as to write the remaining sign bits to the respective columns in the direction from the left to the right.

As a result, as shown in "Type A BLI write" in the left part in the figure, sign bits of bit groups 4, 12, 14 are written to the first column (leftmost column), sign bits of a bit group 7, 8, 11 are written to the second column, sign bits of bit groups 13, 10, 3 are written to the third column, and sign bits of bit groups 2, 1, 6 are written to the fourth column (rightmost column).

In addition, a sign bit of a bit group 9-1 is written to the first column (leftmost column), a sign bit of a bit group 9-2 is written to the second column, a sign bit of a bit group 5-1 is written to the third column, and a sign bit of a bit group 5-2 is written to the fourth column (rightmost column) in the part 2.

In this case, each of the bit group 9-1 and the bit group 9-2 is constituted by 180 bits. The bit groups 9-1 and 9-2 are combined to constitute a bit group 9. On the other hand, each of the bit group 5-1 and the bit group 5-2 is constituted by 180 bits. The bit groups 5-1 and 5-2 are combined to constitute a bit group 5. When writing of the sign bits is completed for the lowermost position of the fourth column in the part 2, writing of sign bits ends.

On the other hand, as shown in the right part of the figure, the group-wise interleaver 1021 interleaves arrangement of bit groups 1, 2, 3, 4, 5, 6, 7, 8, 9, 10, 11, 12, 13, 14 to arrangement of bit groups 4, 7, 13, 2, 12, 8, 10, 1, 14, 11, 3, 6, 9, 5, and outputs the result to the block interleaver 1022 corresponding to block interleave of the type B.

More specifically, the group-wise interleaver 1021 interleaves arrangement of the bit groups 1, 2, 3, 4, 5, 6, 7, 8, 9, 10, 11, 12, 13, 14 into arrangement of the bit groups 4, 7, 13, 2, 12, 8, 10, 1, 14, 11, 3, 6, 9, 5 on the basis of a GW pattern 4, 7, 13, 2, 12, 8, 10, 1, 14, 11, 3, 6, 9, 5 for block interleave of the type B.

The block interleaver 1022 corresponding to block interleave of the type B performs writing of output from the group-wise interleaver 1021 in the direction from the left to the right (row direction) of the column in the part 1 in units of bit group. Then, when writing of sign bits is completed for the lowermost position of the rightmost column of the columns in the part 1, writing of remaining sign bits to the respective columns in the part 2 in the direction from the left to the right (row direction) is performed.

As a result, as shown in "Type B BLI write" in the right part in the figure, sign bits of bit groups 4, 12, 14 are written to the first column (leftmost column), sign bits of bit groups 7, 8, 11 are written to the second column, sign bits of bit groups 13, 10, 3 are written to the third column, and sign bits of bit groups 2, 1, 6 are written to the fourth column (rightmost column). In addition, sign bits of bit groups 9, 5 are written to the rows in the part 2. When writing of the sign bits is completed for the rightmost position in the part 2, writing of sign bits ends.

The group-wise interleaver 1021 interleaves in the manner described above on the basis of the GW pattern corresponding to types of block interleave. In this case, the block interleaver 1022 produces the same writing result of the sign bits written to the columns in the part 1 for block interleave of the type A and for block interleave of the type B.

More specifically, in both block interleave of the type A and block interleave of the type B, the sign bits of the bit groups 4, 12, 14 are written to the first column, the sign bits of the bit groups 7, 8, 11 are written to the second column, the sign bits of the bit groups 13, 10, 3 are written to the third column, and the sign bits of the bit groups 2, 1, 6 are written to the fourth column.

Moreover, when the same writing result of the sign bits written to the columns of the part 1 is obtained, block interleave of the type A and block interleave of the type B are realizable by using the common address generation circuit, similarly to the example shown in Fig. 228.

Accordingly, when initiating block interleave of the type A of the assumption of execution of block interleave of the type B, the group-wise interleaver 1021 shown in Fig. 229 also rewrites a GW pattern such that a block interleave result (writing result of sign bit written to columns in part 1) identical to a corresponding block interleave result of the type B is obtainable.

For example, on the assumption of execution of block interleave of the type B, the group-wise interleaver 1021 in Fig. 229 assumes a case 2-1 where a GW pattern 4, 7, 13, 2, 12, 8, 10, 1, 14, 11, 3, 6, 9, 5 is set as a GW pattern for block interleave of the type B.

When the block interleaver 1022 performs block interleave of the type A in the case 2-1, the group-wise interleaver 1021 rewrites the GW pattern 4, 7, 13, 2, 12, 8, 10, 1, 14, 11, 3, 6, 9, 5 for block interleave of the type B to a GW pattern 4, 12, 14, 7, 8, 11, 13, 10, 3, 2, 1, 6, 9, 5 for block interleave of the type A. As a result, the block interleave result of the type A obtained by the group-wise interleaver 1021 becomes identical to the block interleave result of the type B.

In addition, when initiating block interleave of the type B on the assumption of execution of block interleave of the type A, the group-wise interleaver 1021 shown in Fig. 229 rewrites a GW pattern such that a block interleave result (writing result of sign bit written to columns in part 1) identical to a corresponding block interleave result of the type A is obtainable.

For example, on the assumption of execution of block interleave of the type A, the group-wise interleaver 1021 in Fig. 229 assumes a case 2-2 where a GW pattern 4, 12, 14, 7, 8, 11, 13, 10, 3, 2, 1, 6, 9, 5 is set as a GW pattern for block interleave of the type A.

When the block interleaver 1022 performs block interleave of the type B in the case 2-2, the group-wise interleaver 1021 rewrites the GW pattern 4, 12, 14, 7, 8, 11, 13, 10, 3, 2, 1, 6, 9, 5 for block interleave of the type A to a GW pattern 4, 7, 13, 2, 12, 8, 10, 1, 14, 11, 3, 6, 9, 5 for block interleave of the type B. As a result, the block interleave result of the type B obtained by the group-wise interleaver 1021 becomes identical to the block interleave result of the type A.

Accordingly, the group-wise interleaver 1021 converts the GW pattern for block interleave of the type B into the GW pattern for block interleave of the type A, or converts the GW pattern for block interleave of the type A into the GW pattern for block interleave of the type B, thereby commonizing the address generation circuit for the columns in the part 1.

In addition, only rewriting of the GW pattern by the group-wise interleaver 1021 in accordance with the types of block interleave does not cause performance deterioration as a result of conversion of the GW pattern. For example, completely the same performance is produced by block interleave of the type B based on the GW pattern for block interleave of the type B on the assumption of execution of block interleave of the type B, and by block interleave of the type A based on the rewritten GW pattern for block interleave of the type A. Accordingly, no performance deterioration is caused as a result of conversion of the GW pattern.

However, for (storage areas of) the part 2, the sign bit writing address of block interleave of the type A is different from the corresponding address of block interleave of the type B. Accordingly, the address generation circuit needs to be provided for each of the types.

Note that the block interleaver 1022 in Fig. 229 reads sign bits from (storage areas of) the part 1 and the part 2 in a manner similar to the examples in Figs. 223 and 227. The sign bits thus read from (storage areas of) the part 1 and the part 2 are supplied to the mapper 117 (Fig. 8) as symbols.

<Examples of GW patterns set for MODCOD (64k-bit LDPC code>

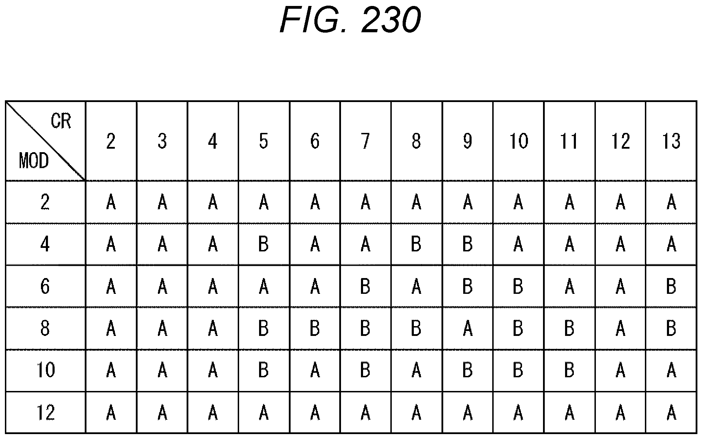

Fig. 230 shows examples of GW patterns set for MODCOD as a combination of a 64k-bit LDPC code and a modulation system.

Note that "A" put to MODCOD as a of combinations of 12 types of coding rates (CR) of LDPC codes and 6 types of modulation systems (MOD) in Fig. 230 indicates a GW pattern for block interleave of the type A set for the MODCOD on the assumption of execution of block interleave of the type A. On the other hand, "B" put to MODCOD indicates a GW pattern for block interleave of the type B set for the MODCOD on the assumption of execution of block interleave of the type B.

In Fig. 230, execution of block interleave of the type A is assumed for MODCOD in a state that the modulation system is set to QPSK (MOD 2), and that the coding rate r of the 64k-bit LDPC code is set to 2/15. Similarly, execution of block interleave of the type A is assumed for MODCOD in a state that the modulation system set to QPSK (MOD 2), and that the coding rate r of the 64k-bit LDPC code is set to 3/15, 4/15, 5/15, 6/15, 7/15, 8/15, 9/15, 10/15, 11/15, 12/15, and 13/15.

In Fig. 230, execution of block interleave of the type A is assumed for MODCOD in a state that the modulation system is set to 16QAM (MOD 4), and that the coding rate r of the 64k-bit LDPC code is set to 2/15, 3/15, 4/15, 6/15, 7/15, 10/15, 11/15, 12/15, and 13/15. On the other hand, execution of block interleave of the type B is assumed for MODCOD in a state that the modulation system is set to 16QAM (MOD 4), and that the coding rate r of the 64k-bit LDPC code is set to 5/15, 8/15, and 9/15.

In Fig. 230, execution of block interleave of the type A is assumed for MODCOD in a state that the modulation system set to 64QAM (MOD 6), and that the coding rate r of the 64k-bit LDPC code is set to 2/15, 3/15, 4/15, 5/15, 6/15, 8/15, 11/15, and 12/15. On the other hand, execution of block interleave of the type B is assumed for MODCOD in a state that the modulation system is set to 64QAM (MOD 6), and that the coding rate r of the 64k-bit LDPC code is set to 7/15, 9/15, 10/15, and 13/15.

In Fig. 230, execution of block interleave of the type A is assumed for MODCOD in a state that the modulation system is set to 256QAM (MOD 8), and that the coding rate r of the 64k-bit LDPC code is set to 2/15, 3/15, 4/15, 9/15, and 12/15. On the other hand, execution of block interleave of the type B is assumed for MODCOD in a state that the modulation system is set to 256QAM (MOD 8), and that the coding rate r of the 64k-bit LDPC code is set to 5/15, 6/15, 7/15, 8/15, 10/15, 11/15, and 13/15.

In Fig. 230, execution of block interleave of the type A is assumed for MODCOD in a state that the modulation system is set to 1024QAM (MOD 10), and that the coding rate r of the 64k-bit LDPC code is set to 2/15, 3/15, 4/15, 6/15, 8/15, 12/15, and 13/15. On the other hand, execution of block interleave of the type B is assumed for MODCOD in a state that the modulation system is set to 1024QAM (MOD 10), and that the coding rate r of the 64k-bit LDPC code is set to 5/15, 7/15, 9/15, 10/15, and 11/15.

In Fig. 230, execution of block interleave of the type A is assumed for MODCOD in a state that the modulation system is set to 4096QAM (MOD 12), and that the coding rate r of the 64k-bit LDPC code is set to 2/15, 3/15, 4/15, 5/15, 6/15, 7/15, 8/15, 9/15, 10/15, 11/15, 12/15, and 13/15.

As described above, the GW pattern for block interleave of the type A, or the GW pattern for block interleave of the type B is set in correspondence with the assumed type for each MODCOD as a combination of the 64k-bit LDPC code and the modulation system.

In addition, as described above, when performing block interleave of the type A on the assumption of execution of block interleave of the type B, the group-wise interleaver 1021 rewrites the GW pattern for block interleave of the type B to the GW pattern for block interleave of the type A such that the same block interleave result as that of the type B is obtainable.

On the other hand, when performing block interleave of the type B on the assumption of execution of block interleave of the type A, the group-wise interleaver 1021 rewrites the GW pattern for block interleave of the type A to the GW pattern for block interleave of the type B such that the same block interleave result as that of the type A is obtainable.

Shown hereinbelow are examples of a GW pattern for block interleave of the assumed type (hereinafter also referred to as original GW pattern (original pattern)), and a GW pattern rewritten for performing block interleave of the type different from the assumed pattern (hereinafter also referred to as converted GW pattern (converted pattern), as specific examples of the GW pattern set for each MODCOD shown in Fig. 230. Note that a uniform constellation (UC) or a non-uniform constellation (NUC) is applicable to a constellation of QAM such as 16QAM.

Note that the GW pattern for block interleave of the type B is set as the converted GW pattern (B) when the GW pattern for block interleave of the type A is set as the original GW pattern (A) for each MODCOD. In addition, inversely, the GW pattern for block interleave of the type A is set as the converted GW pattern (A) when the GW pattern for block interleave of the type B is set as the original GW pattern (B) for each MODCOD.

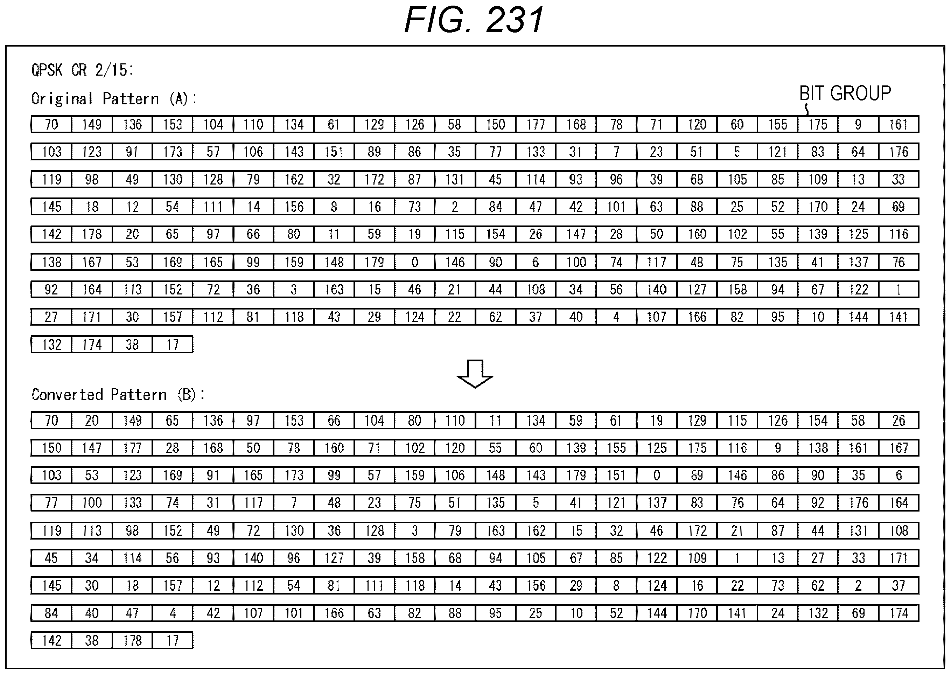

Fig. 231 is a diagram showing an example of a GW pattern for an LDPC code having a code length N of 64k bits with the modulation system set to QPSK and the coding rate r set to 2/15.

According to the original GW pattern (A) in Fig. 231, arrangement of bit groups 0 through 179 of the 64k-bit LDPC code is interleaved to arrangement of bit groups 70, 149, 136, 153, 104, 110, 134, 61, 129, 126, 58, 150, 177, 168, 78, 71, 120, 60, 155, 175, 9, 161, 103, 123, 91, 173, 57, 106, 143, 151, 89, 86, 35, 77, 133, 31, 7, 23, 51, 5, 121, 83, 64, 176, 119, 98, 49, 130, 128, 79, 162, 32, 172, 87, 131, 45, 114, 93, 96, 39, 68, 105, 85, 109, 13, 33, 145, 18, 12, 54, 111, 14, 156, 8, 16, 73, 2, 84, 47, 42, 101, 63, 88, 25, 52, 170, 24, 69, 142, 178, 20, 65, 97, 66, 80, 11, 59, 19, 115, 154, 26, 147, 28, 50, 160, 102, 55, 139, 125, 116, 138, 167, 53, 169, 165, 99, 159, 148, 179, 0, 146, 90, 6, 100, 74, 117, 48, 75, 135, 41, 137, 76, 92, 164, 113, 152, 72, 36, 3, 163, 15, 46, 21, 44, 108, 34, 56, 140, 127, 158, 94, 67, 122, 1, 27, 171, 30, 157, 112, 81, 118, 43, 29, 124, 22, 62, 37, 40, 4, 107, 166, 82, 95, 10, 144, 141, 132, 174, 38, 17.

According to the converted GW pattern (B) in Fig. 231, arrangement of bit groups 0 through 179 of the 64k-bit LDPC code is interleaved to arrangement of bit groups 70, 20, 149, 65, 136, 97, 153, 66, 104, 80, 110, 11, 134, 59, 61, 19, 129, 115, 126, 154, 58, 26, 150, 147, 177, 28, 168, 50, 78, 160, 71, 102, 120, 55, 60, 139, 155, 125, 175, 116, 9, 138, 161, 167, 103, 53, 123, 169, 91, 165, 173, 99, 57, 159, 106, 148, 143, 179, 151, 0, 89, 146, 86, 90, 35, 6, 77, 100, 133, 74, 31, 117, 7, 48, 23, 75, 51, 135, 5, 41, 121, 137, 83, 76, 64, 92, 176, 164, 119, 113, 98, 152, 49, 72, 130, 36, 128, 3, 79, 163, 162, 15, 32, 46, 172, 21, 87, 44, 131, 108, 45, 34, 114, 56, 93, 140, 96, 127, 39, 158, 68, 94, 105, 67, 85, 122, 109, 1, 13, 27, 33, 171, 145, 30, 18, 157, 12, 112, 54, 81, 111, 118, 14, 43, 156, 29, 8, 124, 16, 22, 73, 62, 2, 37, 84, 40, 47, 4, 42, 107, 101, 166, 63, 82, 88, 95, 25, 10, 52, 144, 170, 141, 24, 132, 69, 174, 142, 38, 178, 17.

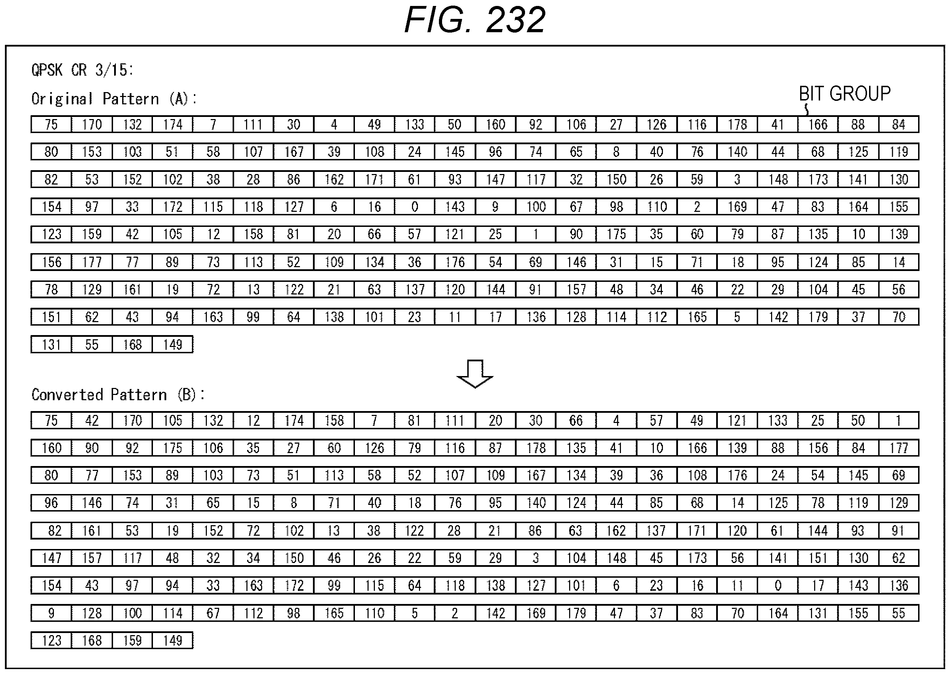

Fig. 232 is a diagram showing an example of a GW pattern for an LDPC code having a code length N of 64k bits with the modulation system set to QPSK and the coding rate r set to 3/15.

According to the original GW pattern (A) in Fig. 232, arrangement of bit groups 0 through 179 of the 64k-bit LDPC code is interleaved to arrangement of bit groups 75, 170, 132, 174, 7, 111, 30, 4, 49, 133, 50, 160, 92, 106, 27, 126, 116, 178, 41, 166, 88, 84, 80, 153, 103, 51, 58, 107, 167, 39, 108, 24, 145, 96, 74, 65, 8, 40, 76, 140, 44, 68, 125, 119, 82, 53, 152, 102, 38, 28, 86, 162, 171, 61, 93, 147, 117, 32, 150, 26, 59, 3, 148, 173, 141, 130, 154, 97, 33, 172, 115, 118, 127, 6, 16, 0, 143, 9, 100, 67, 98, 110, 2, 169, 47, 83, 164, 155, 123, 159, 42, 105, 12, 158, 81, 20, 66, 57, 121, 25, 1, 90, 175, 35, 60, 79, 87, 135, 10, 139, 156, 177, 77, 89, 73, 113, 52, 109, 134, 36, 176, 54, 69, 146, 31, 15, 71, 18, 95, 124, 85, 14, 78, 129, 161, 19, 72, 13, 122, 21, 63, 137, 120, 144, 91, 157, 48, 34, 46, 22, 29, 104, 45, 56, 151, 62, 43, 94, 163, 99, 64, 138, 101, 23, 11, 17, 136, 128, 114, 112, 165, 5, 142, 179, 37, 70, 131, 55, 168, 149.

According to the converted GW pattern (B) in Fig. 232, arrangement of bit groups 0 through 179 of the 64k-bit LDPC code is interleaved to arrangement of bit groups 75, 42, 170, 105, 132, 12, 174, 158, 7, 81, 111, 20, 30, 66, 4, 57, 49, 121, 133, 25, 50, 1, 160, 90, 92, 175, 106, 35, 27, 60, 126, 79, 116, 87, 178, 135, 41, 10, 166, 139, 88, 156, 84, 177, 80, 77, 153, 89, 103, 73, 51, 113, 58, 52, 107, 109, 167, 134, 39, 36, 108, 176, 24, 54, 145, 69, 96, 146, 74, 31, 65, 15, 8, 71, 40, 18, 76, 95, 140, 124, 44, 85, 68, 14, 125, 78, 119, 129, 82, 161, 53, 19, 152, 72, 102, 13, 38, 122, 28, 21, 86, 63, 162, 137, 171, 120, 61, 144, 93, 91, 147, 157, 117, 48, 32, 34, 150, 46, 26, 22, 59, 29, 3, 104, 148, 45, 173, 56, 141, 151, 130, 62, 154, 43, 97, 94, 33, 163, 172, 99, 115, 64, 118, 138, 127, 101, 6, 23, 16, 11, 0, 17, 143, 136, 9, 128, 100, 114, 67, 112, 98, 165, 110, 5, 2, 142, 169, 179, 47, 37, 83, 70, 164, 131, 155, 55, 123, 168, 159, 149.

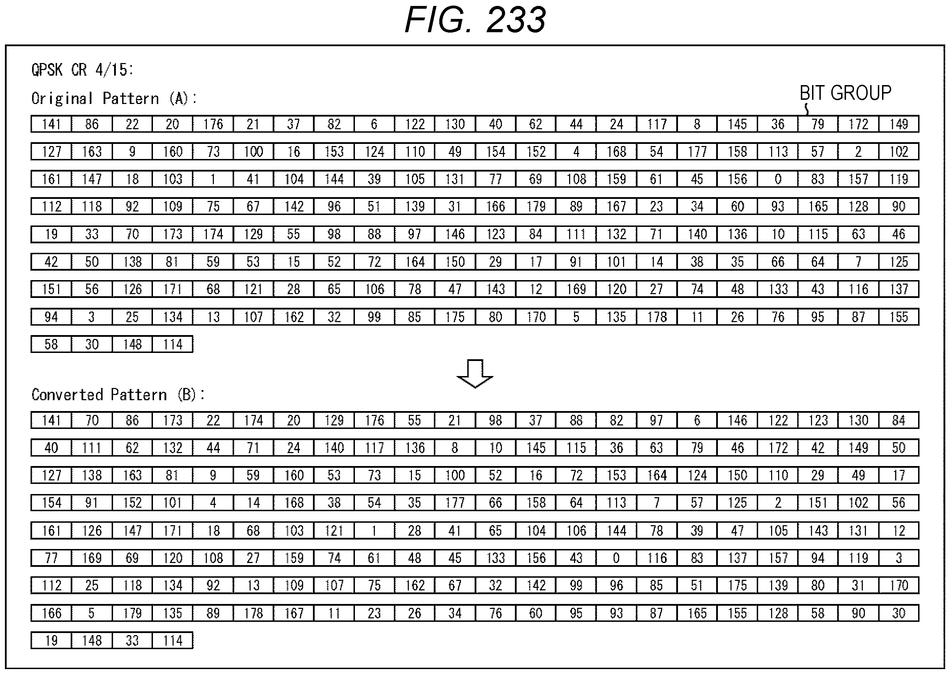

Fig. 233 is a diagram showing an example of a GW pattern for an LDPC code having a code length N of 64k bits with the modulation system set to QPSK and the coding rate r set to 4/15.

According to the original GW pattern (A) in Fig. 233, arrangement of bit groups 0 through 179 of the 64k-bit LDPC code is interleaved to arrangement of bit groups 141, 86, 22, 20, 176, 21, 37, 82, 6, 122, 130, 40, 62, 44, 24, 117, 8, 145, 36, 79, 172, 149, 127, 163, 9, 160, 73, 100, 16, 153, 124, 110, 49, 154, 152, 4, 168, 54, 177, 158, 113, 57, 2, 102, 161, 147, 18, 103, 1, 41, 104, 144, 39, 105, 131, 77, 69, 108, 159, 61, 45, 156, 0, 83, 157, 119, 112, 118, 92, 109, 75, 67, 142, 96, 51, 139, 31, 166, 179, 89, 167, 23, 34, 60, 93, 165, 128, 90, 19, 33, 70, 173, 174, 129, 55, 98, 88, 97, 146, 123, 84, 111, 132, 71, 140, 136, 10, 115, 63, 46, 42, 50, 138, 81, 59, 53, 15, 52, 72, 164, 150, 29, 17, 91, 101, 14, 38, 35, 66, 64, 7, 125, 151, 56, 126, 171, 68, 121, 28, 65, 106, 78, 47, 143, 12, 169, 120, 27, 74, 48, 133, 43, 116, 137, 94, 3, 25, 134, 13, 107, 162, 32, 99, 85, 175, 80, 170, 5, 135, 178, 11, 26, 76, 95, 87, 155, 58, 30, 148, 114.

According to the converted GW pattern (B) in Fig. 233, arrangement of bit groups 0 through 179 of the 64k-bit LDPC code is interleaved to arrangement of bit groups 141, 70, 86, 173, 22, 174, 20, 129, 176, 55, 21, 98, 37, 88, 82, 97, 6, 146, 122, 123, 130, 84, 40, 111, 62, 132, 44, 71, 24, 140, 117, 136, 8, 10, 145, 115, 36, 63, 79, 46, 172, 42, 149, 50, 127, 138, 163, 81, 9, 59, 160, 53, 73, 15, 100, 52, 16, 72, 153, 164, 124, 150, 110, 29, 49, 17, 154, 91, 152, 101, 4, 14, 168, 38, 54, 35, 177, 66, 158, 64, 113, 7, 57, 125, 2, 151, 102, 56, 161, 126, 147, 171, 18, 68, 103, 121, 1, 28, 41, 65, 104, 106, 144, 78, 39, 47, 105, 143, 131, 12, 77, 169, 69, 120, 108, 27, 159, 74, 61, 48, 45, 133, 156, 43, 0, 116, 83, 137, 157, 94, 119, 3, 112, 25, 118, 134, 92, 13, 109, 107, 75, 162, 67, 32, 142, 99, 96, 85, 51, 175, 139, 80, 31, 170, 166, 5, 179, 135, 89, 178, 167, 11, 23, 26, 34, 76, 60, 95, 93, 87, 165, 155, 128, 58, 90, 30, 19, 148, 33, 114.

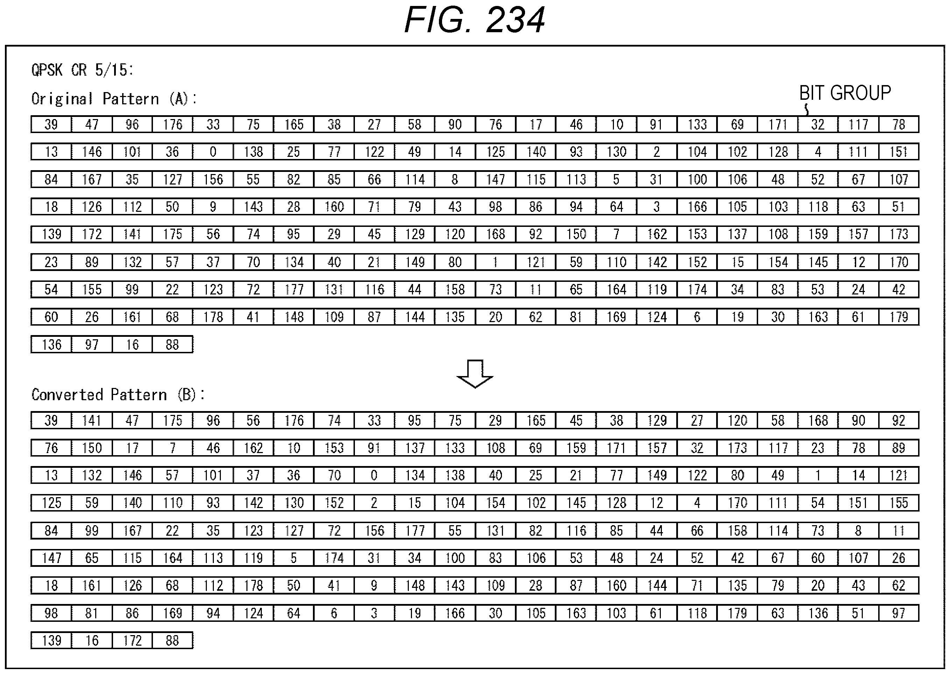

Fig. 234 is a diagram showing an example of a GW pattern for an LDPC code having a code length N of 64k bits with the modulation system set to QPSK and the coding rate r set to 5/15.

According to the original GW pattern (A) in Fig. 234, arrangement of bit groups 0 through 179 of the 64k-bit LDPC code is interleaved to arrangement of bit groups 39, 47, 96, 176, 33, 75, 165, 38, 27, 58, 90, 76, 17, 46, 10, 91, 133, 69, 171, 32, 117, 78, 13, 146, 101, 36, 0, 138, 25, 77, 122, 49, 14, 125, 140, 93, 130, 2, 104, 102, 128, 4, 111, 151, 84, 167, 35, 127, 156, 55, 82, 85, 66, 114, 8, 147, 115, 113, 5, 31, 100, 106, 48, 52, 67, 107, 18, 126, 112, 50, 9, 143, 28, 160, 71, 79, 43, 98, 86, 94, 64, 3, 166, 105, 103, 118, 63, 51, 139, 172, 141, 175, 56, 74, 95, 29, 45, 129, 120, 168, 92, 150, 7, 162, 153, 137, 108, 159, 157, 173, 23, 89, 132, 57, 37, 70, 134, 40, 21, 149, 80, 1, 121, 59, 110, 142, 152, 15, 154, 145, 12, 170, 54, 155, 99, 22, 123, 72, 177, 131, 116, 44, 158, 73, 11, 65, 164, 119, 174, 34, 83, 53, 24, 42, 60, 26, 161, 68, 178, 41, 148, 109, 87, 144, 135, 20, 62, 81, 169, 124, 6, 19, 30, 163, 61, 179, 136, 97, 16, 88.

According to the converted GW pattern (B) in Fig. 234, arrangement of bit groups 0 through 179 of the 64k-bit LDPC code is interleaved to arrangement of bit groups 39, 141, 47, 175, 96, 56, 176, 74, 33, 95, 75, 29, 165, 45, 38, 129, 27, 120, 58, 168, 90, 92, 76, 150, 17, 7, 46, 162, 10, 153, 91, 137, 133, 108, 69, 159, 171, 157, 32, 173, 117, 23, 78, 89, 13, 132, 146, 57, 101, 37, 36, 70, 0, 134, 138, 40, 25, 21, 77, 149, 122, 80, 49, 1, 14, 121, 125, 59, 140, 110, 93, 142, 130, 152, 2, 15, 104, 154, 102, 145, 128, 12, 4, 170, 111, 54, 151, 155, 84, 99, 167, 22, 35, 123, 127, 72, 156, 177, 55, 131, 82, 116, 85, 44, 66, 158, 114, 73, 8, 11, 147, 65, 115, 164, 113, 119, 5, 174, 31, 34, 100, 83, 106, 53, 48, 24, 52, 42, 67, 60, 107, 26, 18, 161, 126, 68, 112, 178, 50, 41, 9, 148, 143, 109, 28, 87, 160, 144, 71, 135, 79, 20, 43, 62, 98, 81, 86, 169, 94, 124, 64, 6, 3, 19, 166, 30, 105, 163, 103, 61, 118, 179, 63, 136, 51, 97, 139, 16, 172, 88.

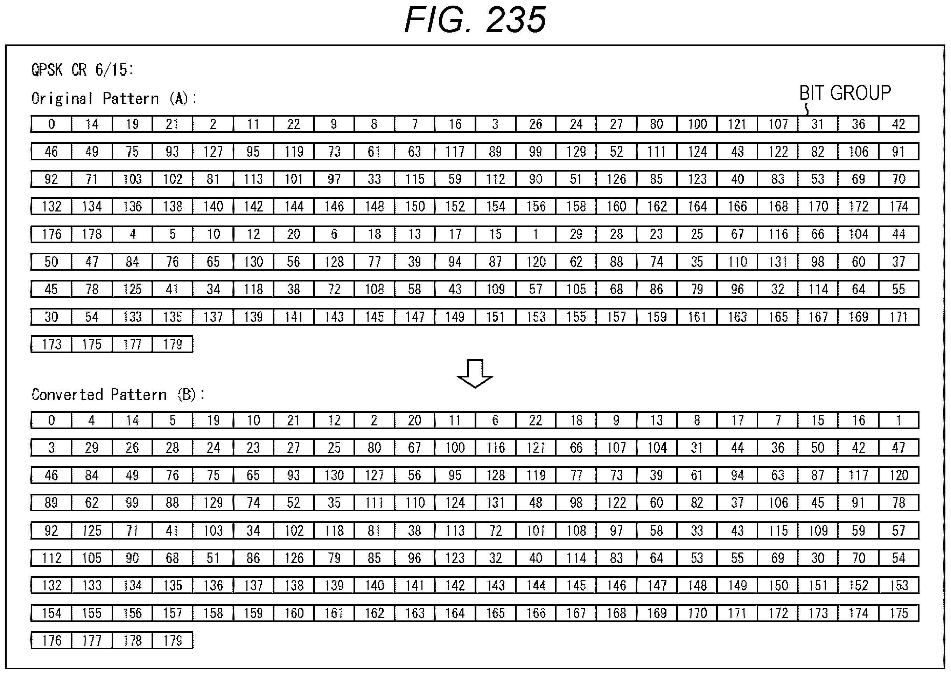

Fig. 235 is a diagram showing an example of a GW pattern for an LDPC code having a code length N of 64k bits with the modulation system set to QPSK and the coding rate r set to 6/15.

According to the original GW pattern (A) in Fig. 235, arrangement of bit groups 0 through 179 of the 64k-bit LDPC code is interleaved to arrangement of bit groups 0, 14, 19, 21, 2, 11, 22, 9, 8, 7, 16, 3, 26, 24, 27, 80, 100, 121, 107, 31, 36, 42, 46, 49, 75, 93, 127, 95, 119, 73, 61, 63, 117, 89, 99, 129, 52, 111, 124, 48, 122, 82, 106, 91, 92, 71, 103, 102, 81, 113, 101, 97, 33, 115, 59, 112, 90, 51, 126, 85, 123, 40, 83, 53, 69, 70, 132, 134, 136, 138, 140, 142, 144, 146, 148, 150, 152, 154, 156, 158, 160, 162, 164, 166, 168, 170, 172, 174, 176, 178, 4, 5, 10, 12, 20, 6, 18, 13, 17, 15, 1, 29, 28, 23, 25, 67, 116, 66, 104, 44, 50, 47, 84, 76, 65, 130, 56, 128, 77, 39, 94, 87, 120, 62, 88, 74, 35, 110, 131, 98, 60, 37, 45, 78, 125, 41, 34, 118, 38, 72, 108, 58, 43, 109, 57, 105, 68, 86, 79, 96, 32, 114, 64, 55, 30, 54, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 235, arrangement of bit groups 0 through 179 of the 64k-bit LDPC code is interleaved to arrangement of bit groups 0, 4, 14, 5, 19, 10, 21, 12, 2, 20, 11, 6, 22, 18, 9, 13, 8, 17, 7, 15, 16, 1, 3, 29, 26, 28, 24, 23, 27, 25, 80, 67, 100, 116, 121, 66, 107, 104, 31, 44, 36, 50, 42, 47, 46, 84, 49, 76, 75, 65, 93, 130, 127, 56, 95, 128, 119, 77, 73, 39, 61, 94, 63, 87, 117, 120, 89, 62, 99, 88, 129, 74, 52, 35, 111, 110, 124, 131, 48, 98, 122, 60, 82, 37, 106, 45, 91, 78, 92, 125, 71, 41, 103, 34, 102, 118, 81, 38, 113, 72, 101, 108, 97, 58, 33, 43, 115, 109, 59, 57, 112, 105, 90, 68, 51, 86, 126, 79, 85, 96, 123, 32, 40, 114, 83, 64, 53, 55, 69, 30, 70, 54, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

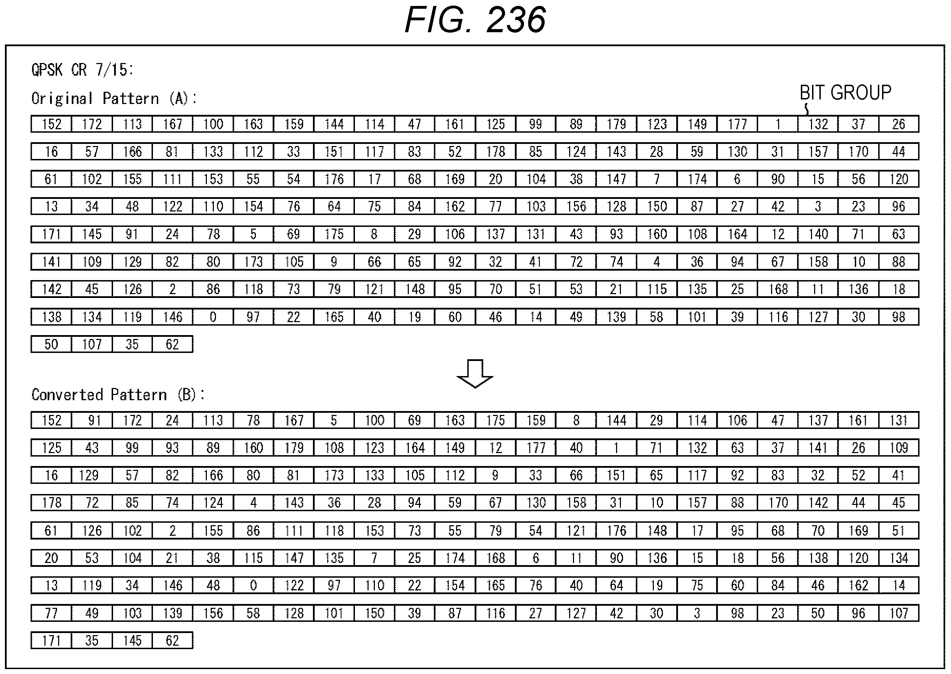

Fig. 236 is a diagram showing an example of a GW pattern for an LDPC code having a code length N of 64k bits with the modulation system set to QPSK and the coding rate r set to 7/15.

According to the original GW pattern (A) in Fig. 236, arrangement of bit groups 0 through 179 of the 64k-bit LDPC code is interleaved to arrangement of bit groups 152, 172, 113, 167, 100, 163, 159, 144, 114, 47, 161, 125, 99, 89, 179, 123, 149, 177, 1, 132, 37, 26, 16, 57, 166, 81, 133, 112, 33, 151, 117, 83, 52, 178, 85, 124, 143, 28, 59, 130, 31, 157, 170, 44, 61, 102, 155, 111, 153, 55, 54, 176, 17, 68, 169, 20, 104, 38, 147, 7, 174, 6, 90, 15, 56, 120, 13, 34, 48, 122, 110, 154, 76, 64, 75, 84, 162, 77, 103, 156, 128, 150, 87, 27, 42, 3, 23, 96, 171, 145, 91, 24, 78, 5, 69, 175, 8, 29, 106, 137, 131, 43, 93, 160, 108, 164, 12, 140, 71, 63, 141, 109, 129, 82, 80, 173, 105, 9, 66, 65, 92, 32, 41, 72, 74, 4, 36, 94, 67, 158, 10, 88, 142, 45, 126, 2, 86, 118, 73, 79, 121, 148, 95, 70, 51, 53, 21, 115, 135, 25, 168, 11, 136, 18, 138, 134, 119, 146, 0, 97, 22, 165, 40, 19, 60, 46, 14, 49, 139, 58, 101, 39, 116, 127, 30, 98, 50, 107, 35, 62.

According to the converted GW pattern (B) in Fig. 236, arrangement of bit groups 0 through 179 of the 64k-bit LDPC code is interleaved to arrangement of bit groups 152, 91, 172, 24, 113, 78, 167, 5, 100, 69, 163, 175, 159, 8, 144, 29, 114, 106, 47, 137, 161, 131, 125, 43, 99, 93, 89, 160, 179, 108, 123, 164, 149, 12, 177, 140, 1, 71, 132, 63, 37, 141, 26, 109, 16, 129, 57, 82, 166, 80, 81, 173, 133, 105, 112, 9, 33, 66, 151, 65, 117, 92, 83, 32, 52, 41, 178, 72, 85, 74, 124, 4, 143, 36, 28, 94, 59, 67, 130, 158, 31, 10, 157, 88, 170, 142, 44, 45, 61, 126, 102, 2, 155, 86, 111, 118, 153, 73, 55, 79, 54, 121, 176, 148, 17, 95, 68, 70, 169, 51, 20, 53, 104, 21, 38, 115, 147, 135, 7, 25, 174, 168, 6, 11, 90, 136, 15, 18, 56, 138, 120, 134, 13, 119, 34, 146, 48, 0, 122, 97, 110, 22, 154, 165, 76, 40, 64, 19, 75, 60, 84, 46, 162, 14, 77, 49, 103, 139, 156, 58, 128, 101, 150, 39, 87, 116, 27, 127, 42, 30, 3, 98, 23, 50, 96, 107, 171, 35, 145, 62.

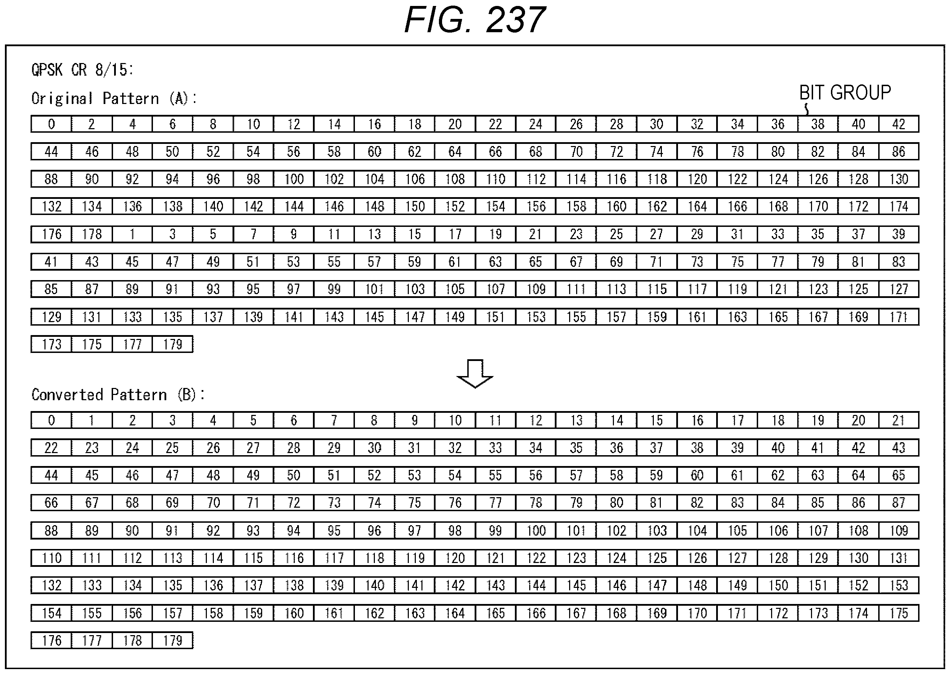

Fig. 237 is a diagram showing an example of a GW pattern for an LDPC code having a code length N of 64k bits with the modulation system set to QPSK and the coding rate r set to 8/15.

According to the original GW pattern (A) in Fig. 237, arrangement of bit groups 0 through 179 of the 64k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 237, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

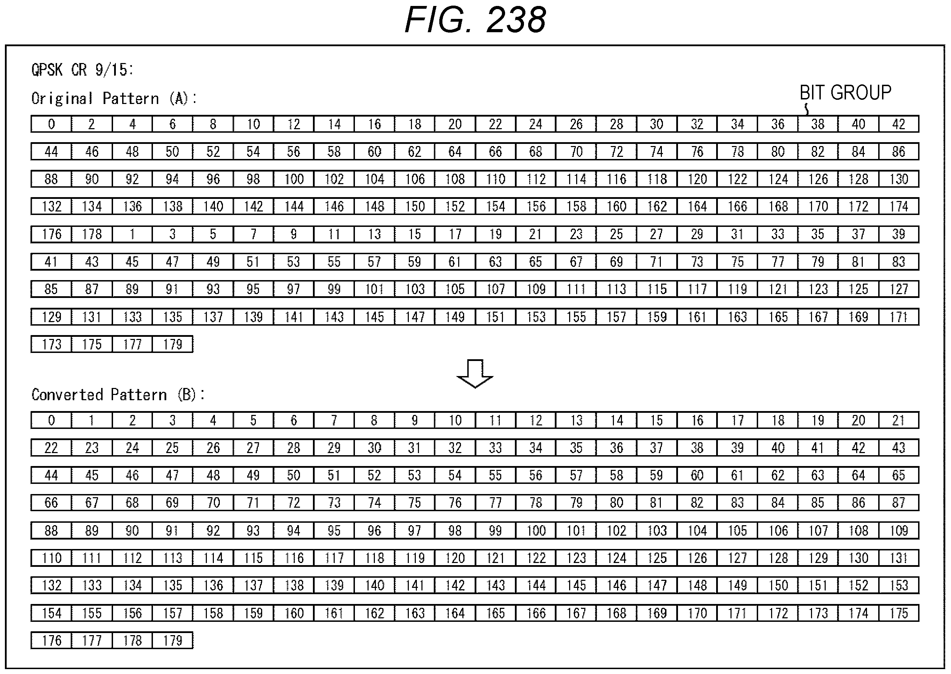

Fig. 238 is a diagram showing an example of a GW pattern for an LDPC code having a code length N of 64k bits with the modulation system set to QPSK and the coding rate r set to 9/15.

According to the original GW pattern (A) in Fig. 238, arrangement of bit groups 0 through 179 of the 64k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 238, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

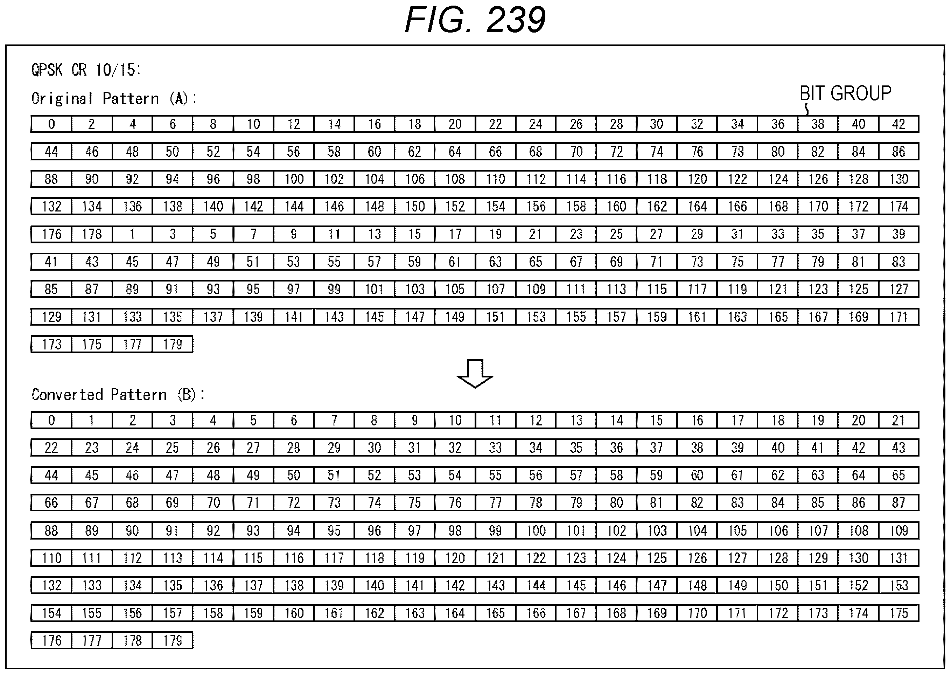

Fig. 239 is a diagram showing an example of a GW pattern for an LDPC code having a code length N of 64k bits with the modulation system set to QPSK and the coding rate r set to 10/15.

According to the original GW pattern (A) in Fig. 239, arrangement of bit groups 0 through 179 of the 64k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 239, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

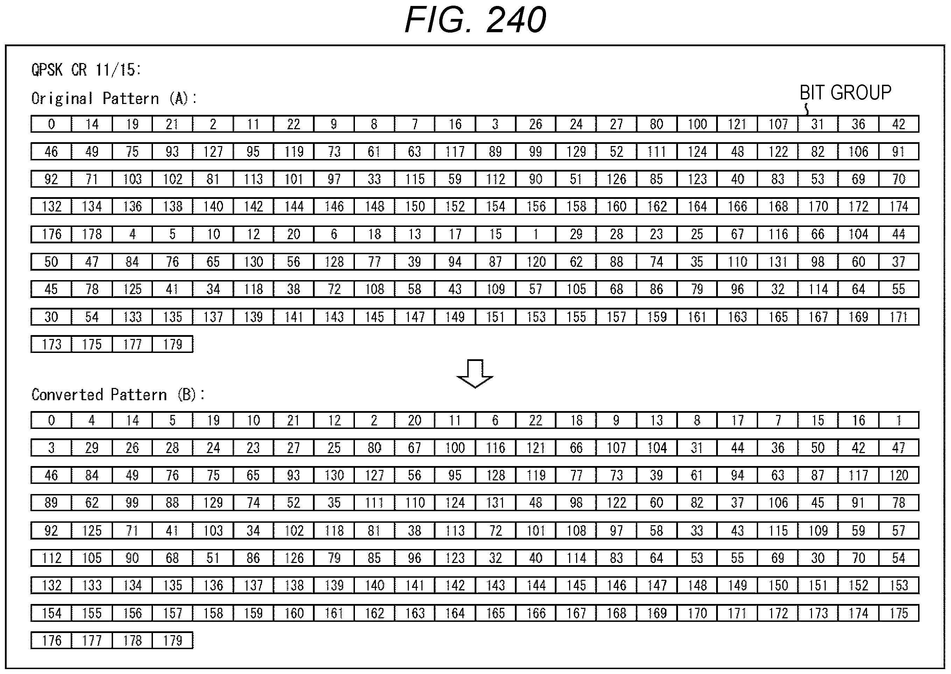

Fig. 240 is a diagram showing an example of a GW pattern for an LDPC code having a code length N of 64k bits with the modulation system set to QPSK and the coding rate r set to 11/15.

According to the original GW pattern (A) in Fig. 240, arrangement of bit groups 0 through 179 of the 64k-bit LDPC code is interleaved to arrangement of bit groups 0, 14, 19, 21, 2, 11, 22, 9, 8, 7, 16, 3, 26, 24, 27, 80, 100, 121, 107, 31, 36, 42, 46, 49, 75, 93, 127, 95, 119, 73, 61, 63, 117, 89, 99, 129, 52, 111, 124, 48, 122, 82, 106, 91, 92, 71, 103, 102, 81, 113, 101, 97, 33, 115, 59, 112, 90, 51, 126, 85, 123, 40, 83, 53, 69, 70, 132, 134, 136, 138, 140, 142, 144, 146, 148, 150, 152, 154, 156, 158, 160, 162, 164, 166, 168, 170, 172, 174, 176, 178, 4, 5, 10, 12, 20, 6, 18, 13, 17, 15, 1, 29, 28, 23, 25, 67, 116, 66, 104, 44, 50, 47, 84, 76, 65, 130, 56, 128, 77, 39, 94, 87, 120, 62, 88, 74, 35, 110, 131, 98, 60, 37, 45, 78, 125, 41, 34, 118, 38, 72, 108, 58, 43, 109, 57, 105, 68, 86, 79, 96, 32, 114, 64, 55, 30, 54, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 240, arrangement of bit groups 0 through 179 of the 64k-bit LDPC code is interleaved to arrangement of bit groups 0, 4, 14, 5, 19, 10, 21, 12, 2, 20, 11, 6, 22, 18, 9, 13, 8, 17, 7, 15, 16, 1, 3, 29, 26, 28, 24, 23, 27, 25, 80, 67, 100, 116, 121, 66, 107, 104, 31, 44, 36, 50, 42, 47, 46, 84, 49, 76, 75, 65, 93, 130, 127, 56, 95, 128, 119, 77, 73, 39, 61, 94, 63, 87, 117, 120, 89, 62, 99, 88, 129, 74, 52, 35, 111, 110, 124, 131, 48, 98, 122, 60, 82, 37, 106, 45, 91, 78, 92, 125, 71, 41, 103, 34, 102, 118, 81, 38, 113, 72, 101, 108, 97, 58, 33, 43, 115, 109, 59, 57, 112, 105, 90, 68, 51, 86, 126, 79, 85, 96, 123, 32, 40, 114, 83, 64, 53, 55, 69, 30, 70, 54, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

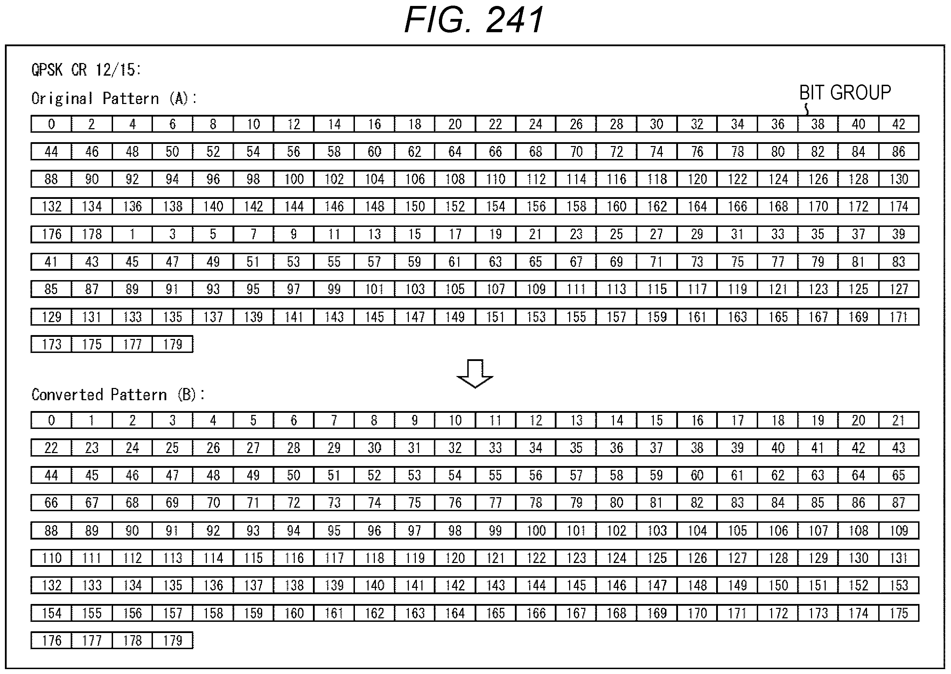

Fig. 241 is a diagram showing an example of a GW pattern for an LDPC code having a code length N of 64k bits with the modulation system set to QPSK and the coding rate r set to 12/15.

According to the original GW pattern (A) in Fig. 241, arrangement of bit groups 0 through 179 of the 64k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 241, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

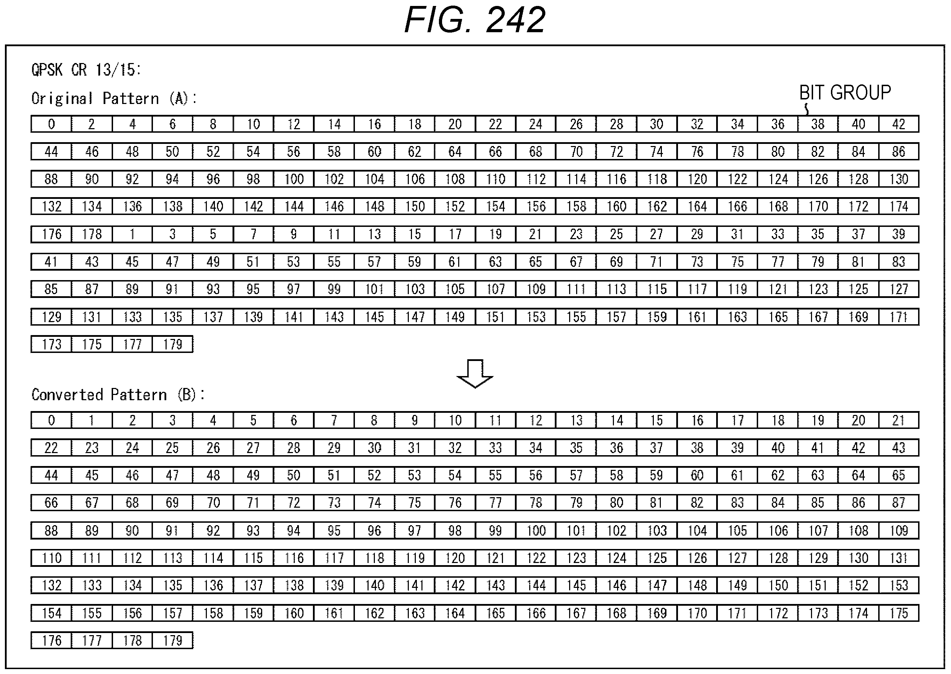

Fig. 242 is a diagram showing an example of a GW pattern for an LDPC code having a code length N of 64k bits with the modulation system set to QPSK and the coding rate r set to 13/15.

According to the original GW pattern (A) in Fig. 242, arrangement of bit groups 0 through 179 of the 64k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 44, 46, 48, 50, 52, 54, 56, 58, 60, 62, 64, 66, 68, 70, 72, 74, 76, 78, 80, 82, 84, 86, 88, 90, 92, 94, 96, 98, 100, 102, 104, 106, 108, 110, 112, 114, 116, 118, 120, 122, 124, 126, 128, 130, 132, 134, 136, 138, 140, 142, 144, 146, 148, 150, 152, 154, 156, 158, 160, 162, 164, 166, 168, 170, 172, 174, 176, 178, 1, 3, 5, 7, 9, 11, 13, 15, 17, 19, 21, 23, 25, 27, 29, 31, 33, 35, 37, 39, 41, 43, 45, 47, 49, 51, 53, 55, 57, 59, 61, 63, 65, 67, 69, 71, 73, 75, 77, 79, 81, 83, 85, 87, 89, 91, 93, 95, 97, 99, 101, 103, 105, 107, 109, 111, 113, 115, 117, 119, 121, 123, 125, 127, 129, 131, 133, 135, 137, 139, 141, 143, 145, 147, 149, 151, 153, 155, 157, 159, 161, 163, 165, 167, 169, 171, 173, 175, 177, 179.

According to the converted GW pattern (B) in Fig. 242, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

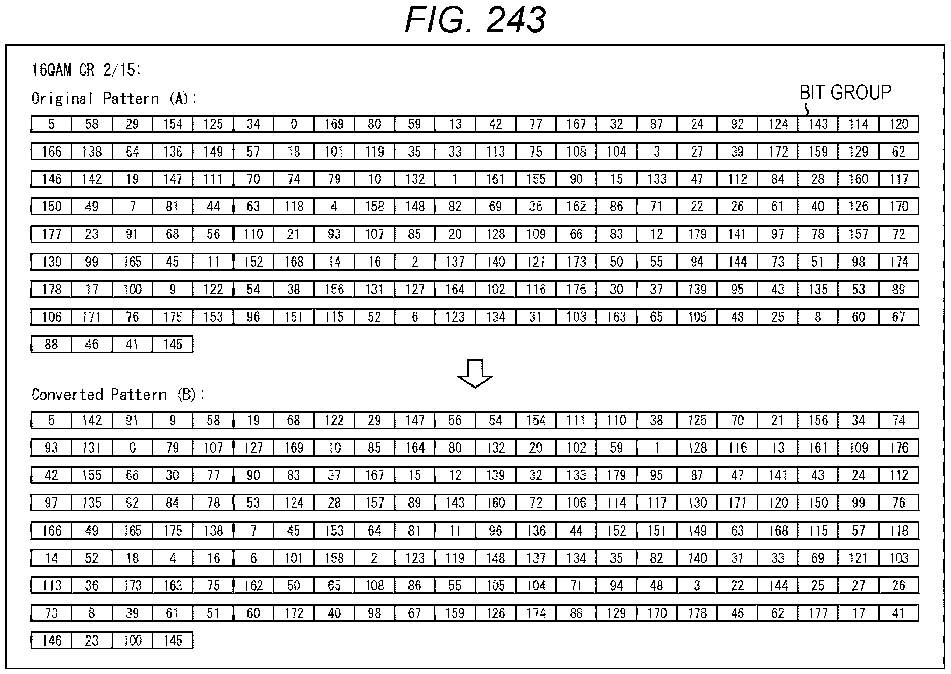

Fig. 243 is a diagram showing an example of a GW pattern for an LDPC code having a code length N of 64k bits with the modulation system set to 16QAM and the coding rate r set to 2/15.

According to the original GW pattern (A) in Fig. 243, arrangement of bit groups 0 through 179 of the 64k-bit LDPC code is interleaved to arrangement of bit groups 5, 58, 29, 154, 125, 34, 0, 169, 80, 59, 13, 42, 77, 167, 32, 87, 24, 92, 124, 143, 114, 120, 166, 138, 64, 136, 149, 57, 18, 101, 119, 35, 33, 113, 75, 108, 104, 3, 27, 39, 172, 159, 129, 62, 146, 142, 19, 147, 111, 70, 74, 79, 10, 132, 1, 161, 155, 90, 15, 133, 47, 112, 84, 28, 160, 117, 150, 49, 7, 81, 44, 63, 118, 4, 158, 148, 82, 69, 36, 162, 86, 71, 22, 26, 61, 40, 126, 170, 177, 23, 91, 68, 56, 110, 21, 93, 107, 85, 20, 128, 109, 66, 83, 12, 179, 141, 97, 78, 157, 72, 130, 99, 165, 45, 11, 152, 168, 14, 16, 2, 137, 140, 121, 173, 50, 55, 94, 144, 73, 51, 98, 174, 178, 17, 100, 9, 122, 54, 38, 156, 131, 127, 164, 102, 116, 176, 30, 37, 139, 95, 43, 135, 53, 89, 106, 171, 76, 175, 153, 96, 151, 115, 52, 6, 123, 134, 31, 103, 163, 65, 105, 48, 25, 8, 60, 67, 88, 46, 41, 145.

According to the converted GW pattern (B) in Fig. 243, arrangement of bit groups 0 through 179 of the 64k-bit LDPC code is interleaved to arrangement of bit groups 5, 142, 91, 9, 58, 19, 68, 122, 29, 147, 56, 54, 154, 111, 110, 38, 125, 70, 21, 156, 34, 74, 93, 131, 0, 79, 107, 127, 169, 10, 85, 164, 80, 132, 20, 102, 59, 1, 128, 116, 13, 161, 109, 176, 42, 155, 66, 30, 77, 90, 83, 37, 167, 15, 12, 139, 32, 133, 179, 95, 87, 47, 141, 43, 24, 112, 97, 135, 92, 84, 78, 53, 124, 28, 157, 89, 143, 160, 72, 106, 114, 117, 130, 171, 120, 150, 99, 76, 166, 49, 165, 175, 138, 7, 45, 153, 64, 81, 11, 96, 136, 44, 152, 151, 149, 63, 168, 115, 57, 118, 14, 52, 18, 4, 16, 6, 101, 158, 2, 123, 119, 148, 137, 134, 35, 82, 140, 31, 33, 69, 121, 103, 113, 36, 173, 163, 75, 162, 50, 65, 108, 86, 55, 105, 104, 71, 94, 48, 3, 22, 144, 25, 27, 26, 73, 8, 39, 61, 51, 60, 172, 40, 98, 67, 159, 126, 174, 88, 129, 170, 178, 46, 62, 177, 17, 41, 146, 23, 100, 145.

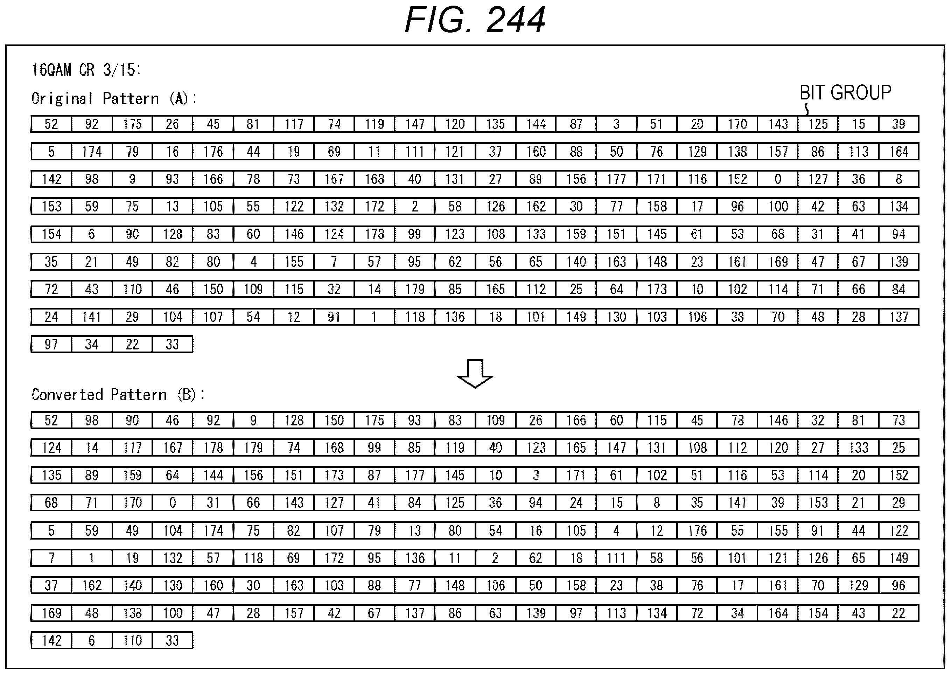

Fig. 244 is a diagram showing an example of a GW pattern for an LDPC code having a code length N of 64k bits with the modulation system set to 16QAM and the coding rate r set to 3/15.

According to the original GW pattern (A) in Fig. 244, arrangement of bit groups 0 through 179 of the 64k-bit LDPC code is interleaved to arrangement of bit groups 52, 92, 175, 26, 45, 81, 117, 74, 119, 147, 120, 135, 144, 87, 3, 51, 20, 170, 143, 125, 15, 39, 5, 174, 79, 16, 176, 44, 19, 69, 11, 111, 121, 37, 160, 88, 50, 76, 129, 138, 157, 86, 113, 164, 142, 98, 9, 93, 166, 78, 73, 167, 168, 40, 131, 27, 89, 156, 177, 171, 116, 152, 0, 127, 36, 8, 153, 59, 75, 13, 105, 55, 122, 132, 172, 2, 58, 126, 162, 30, 77, 158, 17, 96, 100, 42, 63, 134, 154, 6, 90, 128, 83, 60, 146, 124, 178, 99, 123, 108, 133, 159, 151, 145, 61, 53, 68, 31, 41, 94, 35, 21, 49, 82, 80, 4, 155, 7, 57, 95, 62, 56, 65, 140, 163, 148, 23, 161, 169, 47, 67, 139, 72, 43, 110, 46, 150, 109, 115, 32, 14, 179, 85, 165, 112, 25, 64, 173, 10, 102, 114, 71, 66, 84, 24, 141, 29, 104, 107, 54, 12, 91, 1, 118, 136, 18, 101, 149, 130, 103, 106, 38, 70, 48, 28, 137, 97, 34, 22, 33.

According to the converted GW pattern (B) in Fig. 244, arrangement of bit groups 0 through 179 of the 64k-bit LDPC code is interleaved to arrangement of bit groups 52, 98, 90, 46, 92, 9, 128, 150, 175, 93, 83, 109, 26, 166, 60, 115, 45, 78, 146, 32, 81, 73, 124, 14, 117, 167, 178, 179, 74, 168, 99, 85, 119, 40, 123, 165, 147, 131, 108, 112, 120, 27, 133, 25, 135, 89, 159, 64, 144, 156, 151, 173, 87, 177, 145, 10, 3, 171, 61, 102, 51, 116, 53, 114, 20, 152, 68, 71, 170, 0, 31, 66, 143, 127, 41, 84, 125, 36, 94, 24, 15, 8, 35, 141, 39, 153, 21, 29, 5, 59, 49, 104, 174, 75, 82, 107, 79, 13, 80, 54, 16, 105, 4, 12, 176, 55, 155, 91, 44, 122, 7, 1, 19, 132, 57, 118, 69, 172, 95, 136, 11, 2, 62, 18, 111, 58, 56, 101, 121, 126, 65, 149, 37, 162, 140, 130, 160, 30, 163, 103, 88, 77, 148, 106, 50, 158, 23, 38, 76, 17, 161, 70, 129, 96, 169, 48, 138, 100, 47, 28, 157, 42, 67, 137, 86, 63, 139, 97, 113, 134, 72, 34, 164, 154, 43, 22, 142, 6, 110, 33.

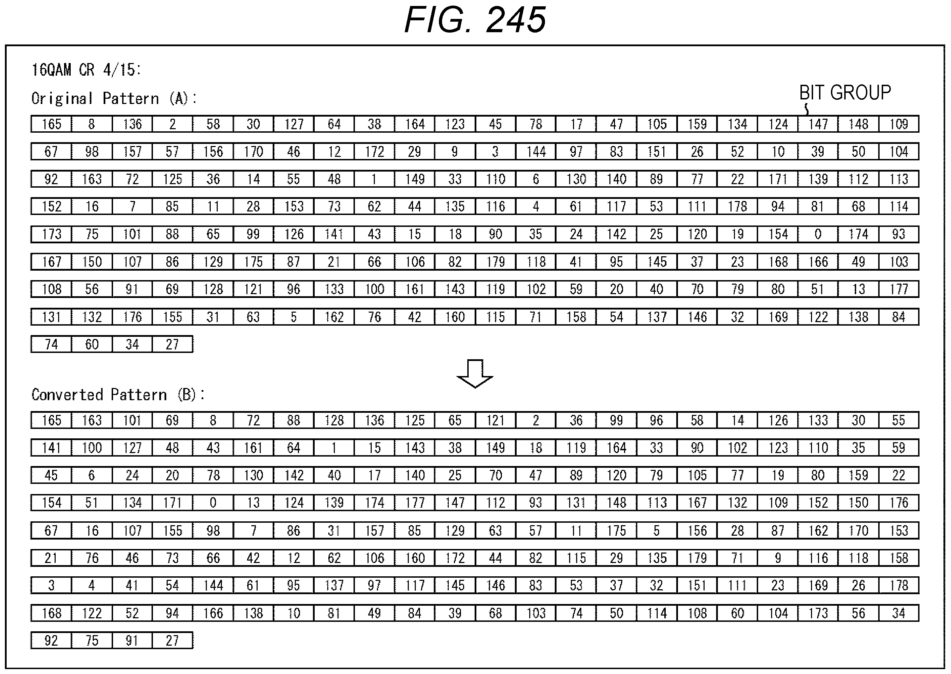

Fig. 245 is a diagram showing an example of a GW pattern for an LDPC code having a code length N of 64k bits with the modulation system set to 16QAM and the coding rate r set to 4/15.

According to the original GW pattern (A) in Fig. 245, arrangement of bit groups 0 through 179 of the 64k-bit LDPC code is interleaved to arrangement of bit groups 165, 8, 136, 2, 58, 30, 127, 64, 38, 164, 123, 45, 78, 17, 47, 105, 159, 134, 124, 147, 148, 109, 67, 98, 157, 57, 156, 170, 46, 12, 172, 29, 9, 3, 144, 97, 83, 151, 26, 52, 10, 39, 50, 104, 92, 163, 72, 125, 36, 14, 55, 48, 1, 149, 33, 110, 6, 130, 140, 89, 77, 22, 171, 139, 112, 113, 152, 16, 7, 85, 11, 28, 153, 73, 62, 44, 135, 116, 4, 61, 117, 53, 111, 178, 94, 81, 68, 114, 173, 75, 101, 88, 65, 99, 126, 141, 43, 15, 18, 90, 35, 24, 142, 25, 120, 19, 154, 0, 174, 93, 167, 150, 107, 86, 129, 175, 87, 21, 66, 106, 82, 179, 118, 41, 95, 145, 37, 23, 168, 166, 49, 103, 108, 56, 91, 69, 128, 121, 96, 133, 100, 161, 143, 119, 102, 59, 20, 40, 70, 79, 80, 51, 13, 177, 131, 132, 176, 155, 31, 63, 5, 162, 76, 42, 160, 115, 71, 158, 54, 137, 146, 32, 169, 122, 138, 84, 74, 60, 34, 27.

According to the converted GW pattern (B) in Fig. 245, arrangement of bit groups 0 through 179 of the 64k-bit LDPC code is interleaved to arrangement of bit groups 165, 163, 101, 69, 8, 72, 88, 128, 136, 125, 65, 121, 2, 36, 99, 96, 58, 14, 126, 133, 30, 55, 141, 100, 127, 48, 43, 161, 64, 1, 15, 143, 38, 149, 18, 119, 164, 33, 90, 102, 123, 110, 35, 59, 45, 6, 24, 20, 78, 130, 142, 40, 17, 140, 25, 70, 47, 89, 120, 79, 105, 77, 19, 80, 159, 22, 154, 51, 134, 171, 0, 13, 124, 139, 174, 177, 147, 112, 93, 131, 148, 113, 167, 132, 109, 152, 150, 176, 67, 16, 107, 155, 98, 7, 86, 31, 157, 85, 129, 63, 57, 11, 175, 5, 156, 28, 87, 162, 170, 153, 21, 76, 46, 73, 66, 42, 12, 62, 106, 160, 172, 44, 82, 115, 29, 135, 179, 71, 9, 116, 118, 158, 3, 4, 41, 54, 144, 61, 95, 137, 97, 117, 145, 146, 83, 53, 37, 32, 151, 111, 23, 169, 26, 178, 168, 122, 52, 94, 166, 138, 10, 81, 49, 84, 39, 68, 103, 74, 50, 114, 108, 60, 104, 173, 56, 34, 92, 75, 91, 27.

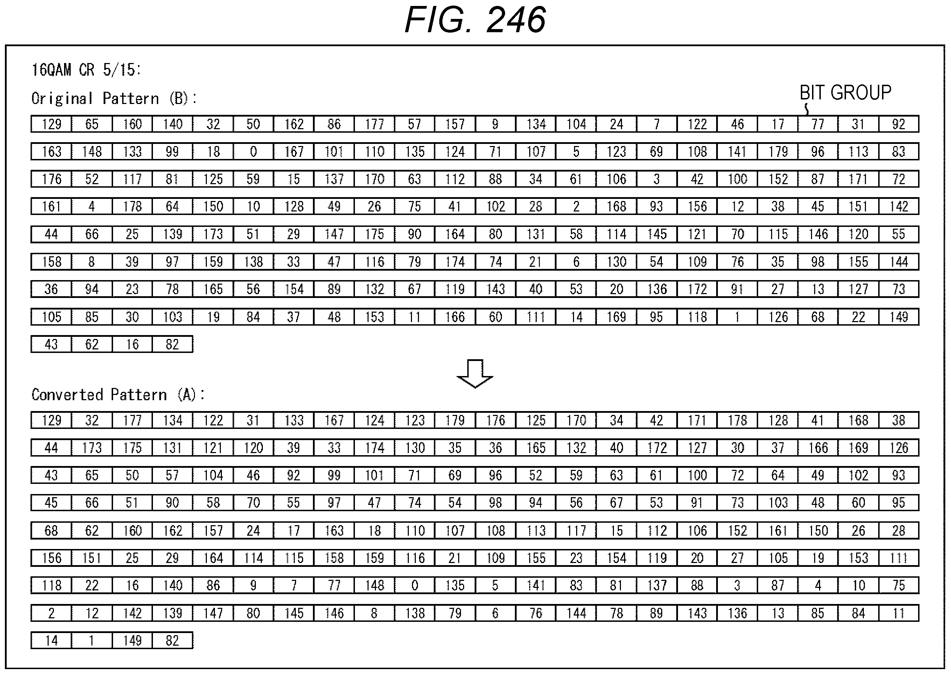

Fig. 246 is a diagram showing an example of a GW pattern for an LDPC code having a code length N of 64k bits with the modulation system set to 16QAM and the coding rate r set to 5/15.

According to the original GW pattern (B) in Fig. 246, arrangement of bit groups 0 through 179 of the 64k-bit LDPC code is interleaved to arrangement of bit groups 129, 65, 160, 140, 32, 50, 162, 86, 177, 57, 157, 9, 134, 104, 24, 7, 122, 46, 17, 77, 31, 92, 163, 148, 133, 99, 18, 0, 167, 101, 110, 135, 124, 71, 107, 5, 123, 69, 108, 141, 179, 96, 113, 83, 176, 52, 117, 81, 125, 59, 15, 137, 170, 63, 112, 88, 34, 61, 106, 3, 42, 100, 152, 87, 171, 72, 161, 4, 178, 64, 150, 10, 128, 49, 26, 75, 41, 102, 28, 2, 168, 93, 156, 12, 38, 45, 151, 142, 44, 66, 25, 139, 173, 51, 29, 147, 175, 90, 164, 80, 131, 58, 114, 145, 121, 70, 115, 146, 120, 55, 158, 8, 39, 97, 159, 138, 33, 47, 116, 79, 174, 74, 21, 6, 130, 54, 109, 76, 35, 98, 155, 144, 36, 94, 23, 78, 165, 56, 154, 89, 132, 67, 119, 143, 40, 53, 20, 136, 172, 91, 27, 13, 127, 73, 105, 85, 30, 103, 19, 84, 37, 48, 153, 11, 166, 60, 111, 14, 169, 95, 118, 1, 126, 68, 22, 149, 43, 62, 16, 82.

According to the converted GW pattern (A) in Fig. 246, arrangement of bit groups 0 through 179 of the 64k-bit LDPC code is interleaved to arrangement of bit groups 129, 32, 177, 134, 122, 31, 133, 167, 124, 123, 179, 176, 125, 170, 34, 42, 171, 178, 128, 41, 168, 38, 44, 173, 175, 131, 121, 120, 39, 33, 174, 130, 35, 36, 165, 132, 40, 172, 127, 30, 37, 166, 169, 126, 43, 65, 50, 57, 104, 46, 92, 99, 101, 71, 69, 96, 52, 59, 63, 61, 100, 72, 64, 49, 102, 93, 45, 66, 51, 90, 58, 70, 55, 97, 47, 74, 54, 98, 94, 56, 67, 53, 91, 73, 103, 48, 60, 95, 68, 62, 160, 162, 157, 24, 17, 163, 18, 110, 107, 108, 113, 117, 15, 112, 106, 152, 161, 150, 26, 28, 156, 151, 25, 29, 164, 114, 115, 158, 159, 116, 21, 109, 155, 23, 154, 119, 20, 27, 105, 19, 153, 111, 118, 22, 16, 140, 86, 9, 7, 77, 148, 0, 135, 5, 141, 83, 81, 137, 88, 3, 87, 4, 10, 75, 2, 12, 142, 139, 147, 80, 145, 146, 8, 138, 79, 6, 76, 144, 78, 89, 143, 136, 13, 85, 84, 11, 14, 1, 149, 82.

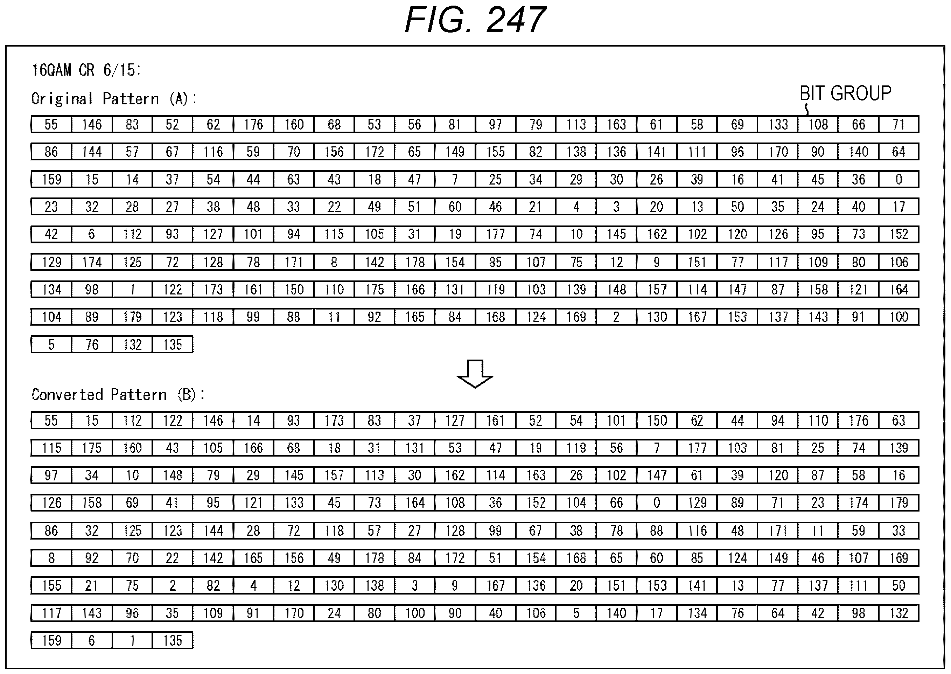

Fig. 247 is a diagram showing an example of a GW pattern for an LDPC code having a code length N of 64k bits with the modulation system set to 16QAM and the coding rate r set to 6/15.

According to the original GW pattern (A) in Fig. 247, arrangement of bit groups 0 through 179 of the 64k-bit LDPC code is interleaved to arrangement of bit groups 55, 146, 83, 52, 62, 176, 160, 68, 53, 56, 81, 97, 79, 113, 163, 61, 58, 69, 133, 108, 66, 71, 86, 144, 57, 67, 116, 59, 70, 156, 172, 65, 149, 155, 82, 138, 136, 141, 111, 96, 170, 90, 140, 64, 159, 15, 14, 37, 54, 44, 63, 43, 18, 47, 7, 25, 34, 29, 30, 26, 39, 16, 41, 45, 36, 0, 23, 32, 28, 27, 38, 48, 33, 22, 49, 51, 60, 46, 21, 4, 3, 20, 13, 50, 35, 24, 40, 17, 42, 6, 112, 93, 127, 101, 94, 115, 105, 31, 19, 177, 74, 10, 145, 162, 102, 120, 126, 95, 73, 152, 129, 174, 125, 72, 128, 78, 171, 8, 142, 178, 154, 85, 107, 75, 12, 9, 151, 77, 117, 109, 80, 106, 134, 98, 1, 122, 173, 161, 150, 110, 175, 166, 131, 119, 103, 139, 148, 157, 114, 147, 87, 158, 121, 164, 104, 89, 179, 123, 118, 99, 88, 11, 92, 165, 84, 168, 124, 169, 2, 130, 167, 153, 137, 143, 91, 100, 5, 76, 132, 135.

According to the converted GW pattern (B) in Fig. 247, arrangement of bit groups 0 through 179 of the 64k-bit LDPC code is interleaved to arrangement of bit groups 55, 15, 112, 122, 146, 14, 93, 173, 83, 37, 127, 161, 52, 54, 101, 150, 62, 44, 94, 110, 176, 63, 115, 175, 160, 43, 105, 166, 68, 18, 31, 131, 53, 47, 19, 119, 56, 7, 177, 103, 81, 25, 74, 139, 97, 34, 10, 148, 79, 29, 145, 157, 113, 30, 162, 114, 163, 26, 102, 147, 61, 39, 120, 87, 58, 16, 126, 158, 69, 41, 95, 121, 133, 45, 73, 164, 108, 36, 152, 104, 66, 0, 129, 89, 71, 23, 174, 179, 86, 32, 125, 123, 144, 28, 72, 118, 57, 27, 128, 99, 67, 38, 78, 88, 116, 48, 171, 11, 59, 33, 8, 92, 70, 22, 142, 165, 156, 49, 178, 84, 172, 51, 154, 168, 65, 60, 85, 124, 149, 46, 107, 169, 155, 21, 75, 2, 82, 4, 12, 130, 138, 3, 9, 167, 136, 20, 151, 153, 141, 13, 77, 137, 111, 50, 117, 143, 96, 35, 109, 91, 170, 24, 80, 100, 90, 40, 106, 5, 140, 17, 134, 76, 64, 42, 98, 132, 159, 6, 1, 135.

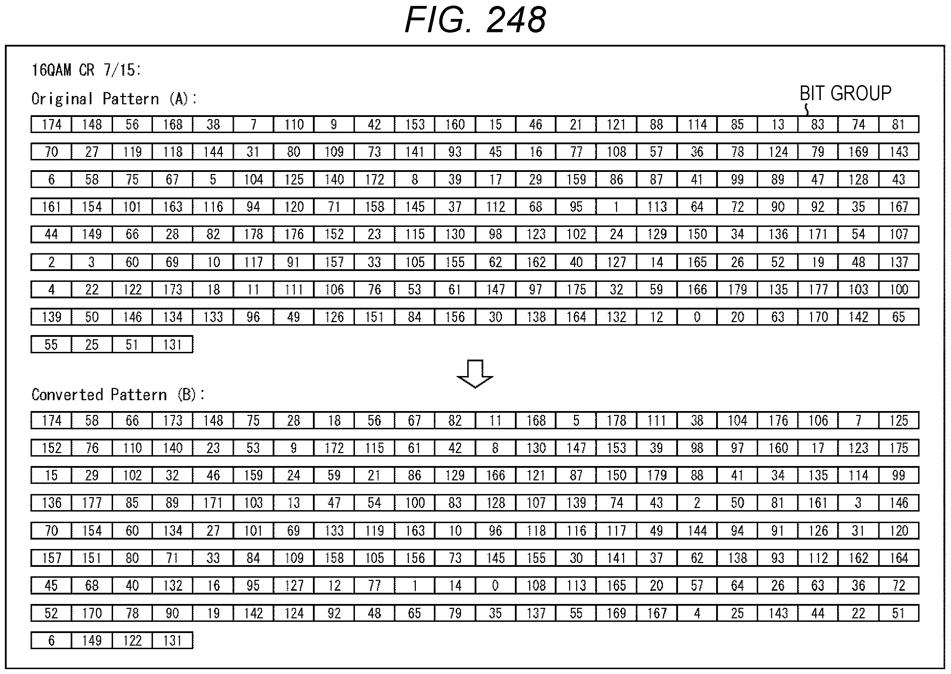

Fig. 248 is a diagram showing an example of a GW pattern for an LDPC code having a code length N of 64k bits with the modulation system set to 16QAM and the coding rate r set to 7/15.

According to the original GW pattern (A) in Fig. 248, arrangement of bit groups 0 through 179 of the 64k-bit LDPC code is interleaved to arrangement of bit groups 174, 148, 56, 168, 38, 7, 110, 9, 42, 153, 160, 15, 46, 21, 121, 88, 114, 85, 13, 83, 74, 81, 70, 27, 119, 118, 144, 31, 80, 109, 73, 141, 93, 45, 16, 77, 108, 57, 36, 78, 124, 79, 169, 143, 6, 58, 75, 67, 5, 104, 125, 140, 172, 8, 39, 17, 29, 159, 86, 87, 41, 99, 89, 47, 128, 43, 161, 154, 101, 163, 116, 94, 120, 71, 158, 145, 37, 112, 68, 95, 1, 113, 64, 72, 90, 92, 35, 167, 44, 149, 66, 28, 82, 178, 176, 152, 23, 115, 130, 98, 123, 102, 24, 129, 150, 34, 136, 171, 54, 107, 2, 3, 60, 69, 10, 117, 91, 157, 33, 105, 155, 62, 162, 40, 127, 14, 165, 26, 52, 19, 48, 137, 4, 22, 122, 173, 18, 11, 111, 106, 76, 53, 61, 147, 97, 175, 32, 59, 166, 179, 135, 177, 103, 100, 139, 50, 146, 134, 133, 96, 49, 126, 151, 84, 156, 30, 138, 164, 132, 12, 0, 20, 63, 170, 142, 65, 55, 25, 51, 131.

According to the converted GW pattern (B) in Fig. 248, arrangement of bit groups 0 through 179 of the 64k-bit LDPC code is interleaved to arrangement of bit groups 174, 58, 66, 173, 148, 75, 28, 18, 56, 67, 82, 11, 168, 5, 178, 111, 38, 104, 176, 106, 7, 125, 152, 76, 110, 140, 23, 53, 9, 172, 115, 61, 42, 8, 130, 147, 153, 39, 98, 97, 160, 17, 123, 175, 15, 29, 102, 32, 46, 159, 24, 59, 21, 86, 129, 166, 121, 87, 150, 179, 88, 41, 34, 135, 114, 99, 136, 177, 85, 89, 171, 103, 13, 47, 54, 100, 83, 128, 107, 139, 74, 43, 2, 50, 81, 161, 3, 146, 70, 154, 60, 134, 27, 101, 69, 133, 119, 163, 10, 96, 118, 116, 117, 49, 144, 94, 91, 126, 31, 120, 157, 151, 80, 71, 33, 84, 109, 158, 105, 156, 73, 145, 155, 30, 141, 37, 62, 138, 93, 112, 162, 164, 45, 68, 40, 132, 16, 95, 127, 12, 77, 1, 14, 0, 108, 113, 165, 20, 57, 64, 26, 63, 36, 72, 52, 170, 78, 90, 19, 142, 124, 92, 48, 65, 79, 35, 137, 55, 169, 167, 4, 25, 143, 44, 22, 51, 6, 149, 122, 131.

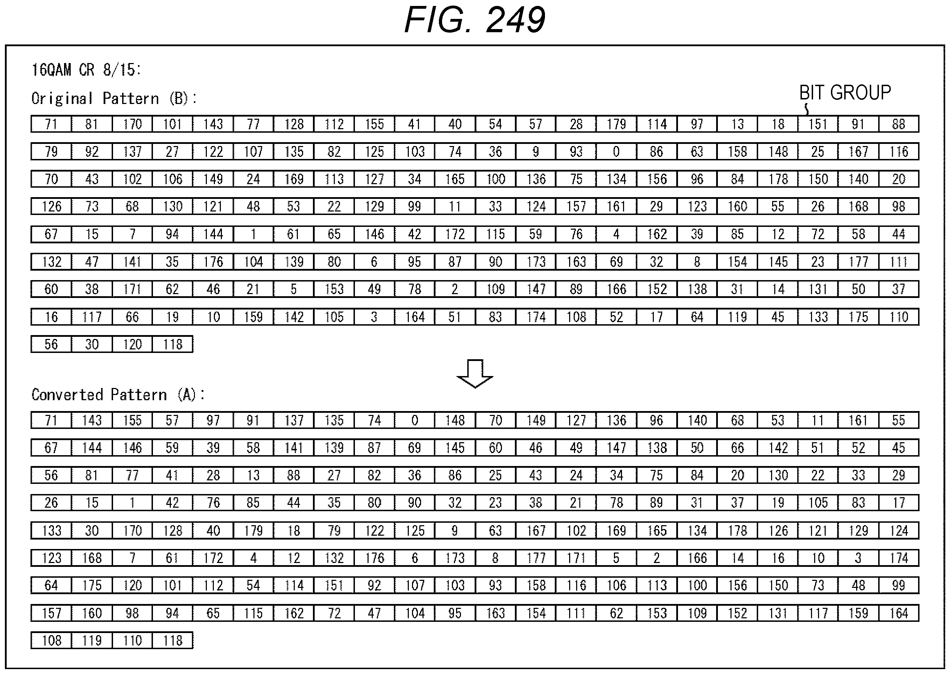

Fig. 249 is a diagram showing an example of a GW pattern for an LDPC code having a code length N of 64k bits with the modulation system set to 16QAM and the coding rate r set to 8/15.

According to the original GW pattern (B) in Fig. 249, arrangement of bit groups 0 through 179 of the 64k-bit LDPC code is interleaved to arrangement of bit groups 71, 81, 170, 101, 143, 77, 128, 112, 155, 41, 40, 54, 57, 28, 179, 114, 97, 13, 18, 151, 91, 88, 79, 92, 137, 27, 122, 107, 135, 82, 125, 103, 74, 36, 9, 93, 0, 86, 63, 158, 148, 25, 167, 116, 70, 43, 102, 106, 149, 24, 169, 113, 127, 34, 165, 100, 136, 75, 134, 156, 96, 84, 178, 150, 140, 20, 126, 73, 68, 130, 121, 48, 53, 22, 129, 99, 11, 33, 124, 157, 161, 29, 123, 160, 55, 26, 168, 98, 67, 15, 7, 94, 144, 1, 61, 65, 146, 42, 172, 115, 59, 76, 4, 162, 39, 85, 12, 72, 58, 44, 132, 47, 141, 35, 176, 104, 139, 80, 6, 95, 87, 90, 173, 163, 69, 32, 8, 154, 145, 23, 177, 111, 60, 38, 171, 62, 46, 21, 5, 153, 49, 78, 2, 109, 147, 89, 166, 152, 138, 31, 14, 131, 50, 37, 16, 117, 66, 19, 10, 159, 142, 105, 3, 164, 51, 83, 174, 108, 52, 17, 64, 119, 45, 133, 175, 110, 56, 30, 120, 118.

According to the converted GW pattern (A) in Fig. 249, arrangement of bit groups 0 through 179 of the 64k-bit LDPC code is interleaved to arrangement of bit groups 71, 143, 155, 57, 97, 91, 137, 135, 74, 0, 148, 70, 149, 127, 136, 96, 140, 68, 53, 11, 161, 55, 67, 144, 146, 59, 39, 58, 141, 139, 87, 69, 145, 60, 46, 49, 147, 138, 50, 66, 142, 51, 52, 45, 56, 81, 77, 41, 28, 13, 88, 27, 82, 36, 86, 25, 43, 24, 34, 75, 84, 20, 130, 22, 33, 29, 26, 15, 1, 42, 76, 85, 44, 35, 80, 90, 32, 23, 38, 21, 78, 89, 31, 37, 19, 105, 83, 17, 133, 30, 170, 128, 40, 179, 18, 79, 122, 125, 9, 63, 167, 102, 169, 165, 134, 178, 126, 121, 129, 124, 123, 168, 7, 61, 172, 4, 12, 132, 176, 6, 173, 8, 177, 171, 5, 2, 166, 14, 16, 10, 3, 174, 64, 175, 120, 101, 112, 54, 114, 151, 92, 107, 103, 93, 158, 116, 106, 113, 100, 156, 150, 73, 48, 99, 157, 160, 98, 94, 65, 115, 162, 72, 47, 104, 95, 163, 154, 111, 62, 153, 109, 152, 131, 117, 159, 164, 108, 119, 110, 118.

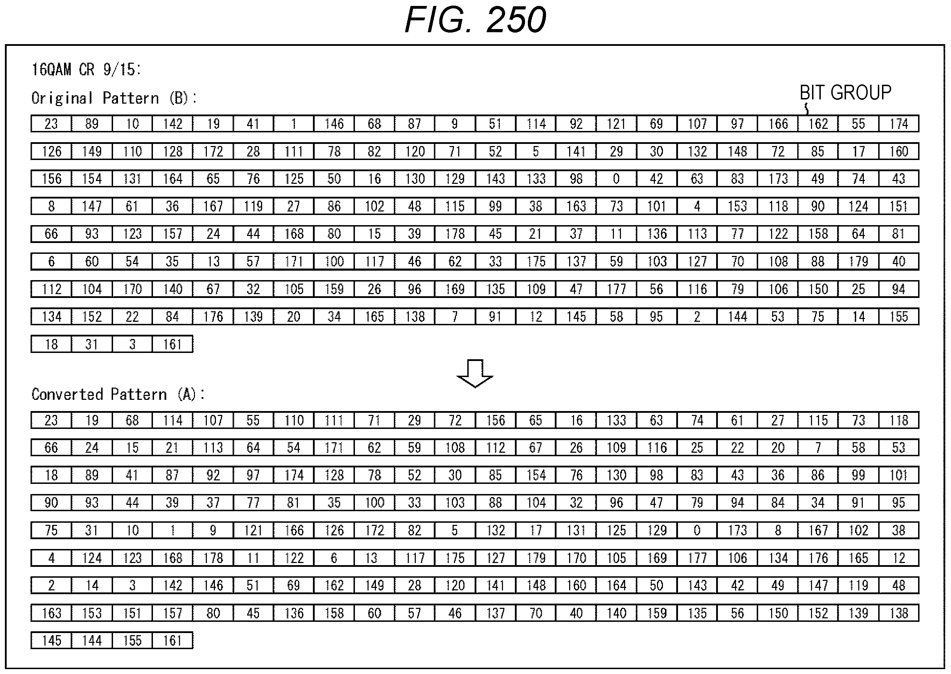

Fig. 250 is a diagram showing an example of a GW pattern for an LDPC code having a code length N of 64k bits with the modulation system set to 16QAM and the coding rate r set to 9/15.

According to the original GW pattern (B) in Fig. 250, arrangement of bit groups 0 through 179 of the 64k-bit LDPC code is interleaved to arrangement of bit groups 23, 89, 10, 142, 19, 41, 1, 146, 68, 87, 9, 51, 114, 92, 121, 69, 107, 97, 166, 162, 55, 174, 126, 149, 110, 128, 172, 28, 111, 78, 82, 120, 71, 52, 5, 141, 29, 30, 132, 148, 72, 85, 17, 160, 156, 154, 131, 164, 65, 76, 125, 50, 16, 130, 129, 143, 133, 98, 0, 42, 63, 83, 173, 49, 74, 43, 8, 147, 61, 36, 167, 119, 27, 86, 102, 48, 115, 99, 38, 163, 73, 101, 4, 153, 118, 90, 124, 151, 66, 93, 123, 157, 24, 44, 168, 80, 15, 39, 178, 45, 21, 37, 11, 136, 113, 77, 122, 158, 64, 81, 6, 60, 54, 35, 13, 57, 171, 100, 117, 46, 62, 33, 175, 137, 59, 103, 127, 70, 108, 88, 179, 40, 112, 104, 170, 140, 67, 32, 105, 159, 26, 96, 169, 135, 109, 47, 177, 56, 116, 79, 106, 150, 25, 94, 134, 152, 22, 84, 176, 139, 20, 34, 165, 138, 7, 91, 12, 145, 58, 95, 2, 144, 53, 75, 14, 155, 18, 31, 3, 161.

According to the converted GW pattern (A) in Fig. 250, arrangement of bit groups 0 through 179 of the 64k-bit LDPC code is interleaved to arrangement of bit groups 23, 19, 68, 114, 107, 55, 110, 111, 71, 29, 72, 156, 65, 16, 133, 63, 74, 61, 27, 115, 73, 118, 66, 24, 15, 21, 113, 64, 54, 171, 62, 59, 108, 112, 67, 26, 109, 116, 25, 22, 20, 7, 58, 53, 18, 89, 41, 87, 92, 97, 174, 128, 78, 52, 30, 85, 154, 76, 130, 98, 83, 43, 36, 86, 99, 101, 90, 93, 44, 39, 37, 77, 81, 35, 100, 33, 103, 88, 104, 32, 96, 47, 79, 94, 84, 34, 91, 95, 75, 31, 10, 1, 9, 121, 166, 126, 172, 82, 5, 132, 17, 131, 125, 129, 0, 173, 8, 167, 102, 38, 4, 124, 123, 168, 178, 11, 122, 6, 13, 117, 175, 127, 179, 170, 105, 169, 177, 106, 134, 176, 165, 12, 2, 14, 3, 142, 146, 51, 69, 162, 149, 28, 120, 141, 148, 160, 164, 50, 143, 42, 49, 147, 119, 48, 163, 153, 151, 157, 80, 45, 136, 158, 60, 57, 46, 137, 70, 40, 140, 159, 135, 56, 150, 152, 139, 138, 145, 144, 155, 161.

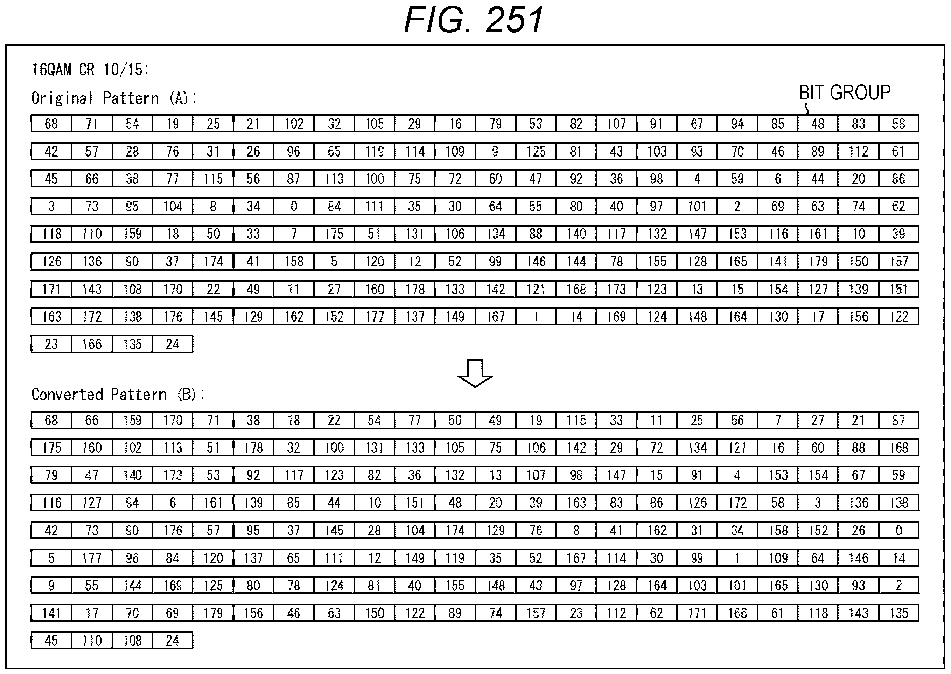

Fig. 251 is a diagram showing an example of a GW pattern for an LDPC code having a code length N of 64k bits with the modulation system set to 16QAM and the coding rate r set to 10/15.

According to the original GW pattern (A) in Fig. 251, arrangement of bit groups 0 through 179 of the 64k-bit LDPC code is interleaved to arrangement of bit groups 68, 71, 54, 19, 25, 21, 102, 32, 105, 29, 16, 79, 53, 82, 107, 91, 67, 94, 85, 48, 83, 58, 42, 57, 28, 76, 31, 26, 96, 65, 119, 114, 109, 9, 125, 81, 43, 103, 93, 70, 46, 89, 112, 61, 45, 66, 38, 77, 115, 56, 87, 113, 100, 75, 72, 60, 47, 92, 36, 98, 4, 59, 6, 44, 20, 86, 3, 73, 95, 104, 8, 34, 0, 84, 111, 35, 30, 64, 55, 80, 40, 97, 101, 2, 69, 63, 74, 62, 118, 110, 159, 18, 50, 33, 7, 175, 51, 131, 106, 134, 88, 140, 117, 132, 147, 153, 116, 161, 10, 39, 126, 136, 90, 37, 174, 41, 158, 5, 120, 12, 52, 99, 146, 144, 78, 155, 128, 165, 141, 179, 150, 157, 171, 143, 108, 170, 22, 49, 11, 27, 160, 178, 133, 142, 121, 168, 173, 123, 13, 15, 154, 127, 139, 151, 163, 172, 138, 176, 145, 129, 162, 152, 177, 137, 149, 167, 1, 14, 169, 124, 148, 164, 130, 17, 156, 122, 23, 166, 135, 24.

According to the converted GW pattern (B) in Fig. 251, arrangement of bit groups 0 through 179 of the 64k-bit LDPC code is interleaved to arrangement of bit groups 68, 66, 159, 170, 71, 38, 18, 22, 54, 77, 50, 49, 19, 115, 33, 11, 25, 56, 7, 27, 21, 87, 175, 160, 102, 113, 51, 178, 32, 100, 131, 133, 105, 75, 106, 142, 29, 72, 134, 121, 16, 60, 88, 168, 79, 47, 140, 173, 53, 92, 117, 123, 82, 36, 132, 13, 107, 98, 147, 15, 91, 4, 153, 154, 67, 59, 116, 127, 94, 6, 161, 139, 85, 44, 10, 151, 48, 20, 39, 163, 83, 86, 126, 172, 58, 3, 136, 138, 42, 73, 90, 176, 57, 95, 37, 145, 28, 104, 174, 129, 76, 8, 41, 162, 31, 34, 158, 152, 26, 0, 5, 177, 96, 84, 120, 137, 65, 111, 12, 149, 119, 35, 52, 167, 114, 30, 99, 1, 109, 64, 146, 14, 9, 55, 144, 169, 125, 80, 78, 124, 81, 40, 155, 148, 43, 97, 128, 164, 103, 101, 165, 130, 93, 2, 141, 17, 70, 69, 179, 156, 46, 63, 150, 122, 89, 74, 157, 23, 112, 62, 171, 166, 61, 118, 143, 135, 45, 110, 108, 24.

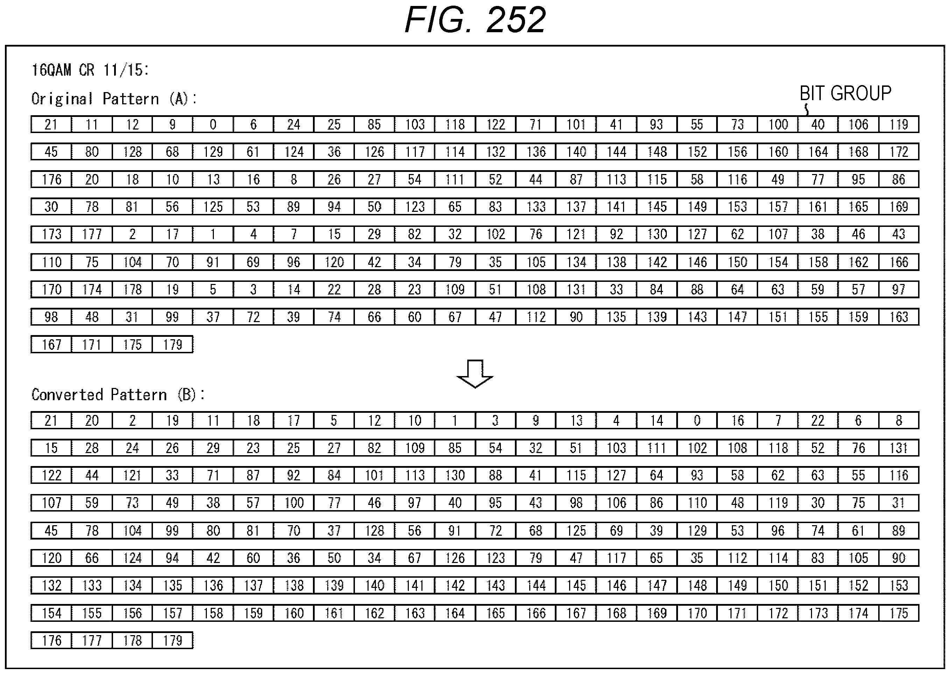

Fig. 252 is a diagram showing an example of a GW pattern for an LDPC code having a code length N of 64k bits with the modulation system set to 16QAM and the coding rate r set to 11/15.

According to the original GW pattern (A) in Fig. 252, arrangement of bit groups 0 through 179 of the 64k-bit LDPC code is interleaved to arrangement of bit groups 21, 11, 12, 9, 0, 6, 24, 25, 85, 103, 118, 122, 71, 101, 41, 93, 55, 73, 100, 40, 106, 119, 45, 80, 128, 68, 129, 61, 124, 36, 126, 117, 114, 132, 136, 140, 144, 148, 152, 156, 160, 164, 168, 172, 176, 20, 18, 10, 13, 16, 8, 26, 27, 54, 111, 52, 44, 87, 113, 115, 58, 116, 49, 77, 95, 86, 30, 78, 81, 56, 125, 53, 89, 94, 50, 123, 65, 83, 133, 137, 141, 145, 149, 153, 157, 161, 165, 169, 173, 177, 2, 17, 1, 4, 7, 15, 29, 82, 32, 102, 76, 121, 92, 130, 127, 62, 107, 38, 46, 43, 110, 75, 104, 70, 91, 69, 96, 120, 42, 34, 79, 35, 105, 134, 138, 142, 146, 150, 154, 158, 162, 166, 170, 174, 178, 19, 5, 3, 14, 22, 28, 23, 109, 51, 108, 131, 33, 84, 88, 64, 63, 59, 57, 97, 98, 48, 31, 99, 37, 72, 39, 74, 66, 60, 67, 47, 112, 90, 135, 139, 143, 147, 151, 155, 159, 163, 167, 171, 175, 179.

According to the converted GW pattern (B) in Fig. 252, arrangement of bit groups 0 through 179 of the 64k-bit LDPC code is interleaved to arrangement of bit groups 21, 20, 2, 19, 11, 18, 17, 5, 12, 10, 1, 3, 9, 13, 4, 14, 0, 16, 7, 22, 6, 8, 15, 28, 24, 26, 29, 23, 25, 27, 82, 109, 85, 54, 32, 51, 103, 111, 102, 108, 118, 52, 76, 131, 122, 44, 121, 33, 71, 87, 92, 84, 101, 113, 130, 88, 41, 115, 127, 64, 93, 58, 62, 63, 55, 116, 107, 59, 73, 49, 38, 57, 100, 77, 46, 97, 40, 95, 43, 98, 106, 86, 110, 48, 119, 30, 75, 31, 45, 78, 104, 99, 80, 81, 70, 37, 128, 56, 91, 72, 68, 125, 69, 39, 129, 53, 96, 74, 61, 89, 120, 66, 124, 94, 42, 60, 36, 50, 34, 67, 126, 123, 79, 47, 117, 65, 35, 112, 114, 83, 105, 90, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

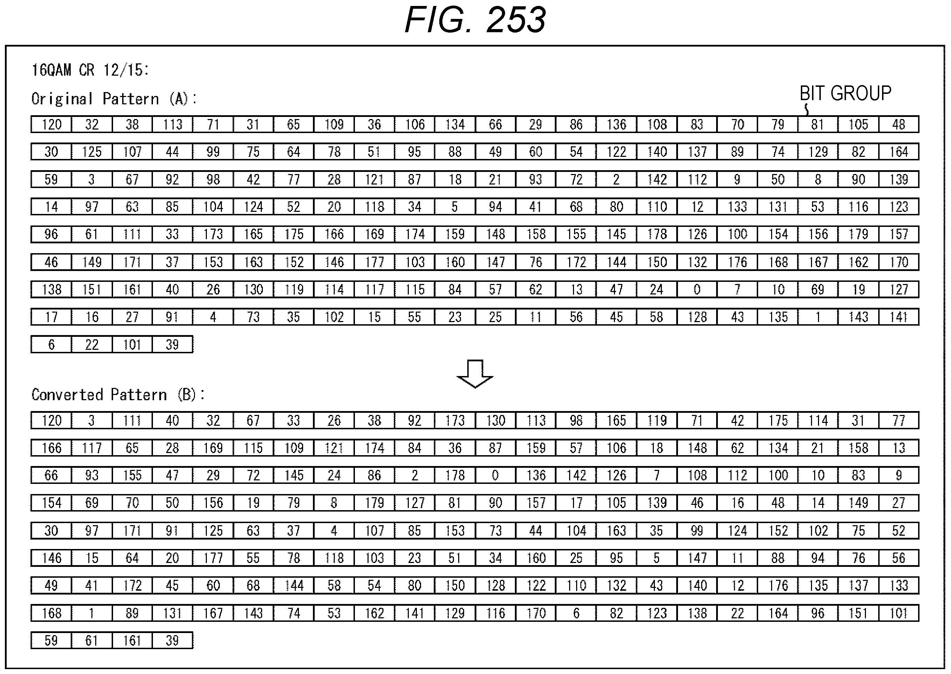

Fig. 253 is a diagram showing an example of a GW pattern for an LDPC code having a code length N of 64k bits with the modulation system set to 16QAM and the coding rate r set to 12/15.

According to the original GW pattern (A) in Fig. 253, arrangement of bit groups 0 through 179 of the 64k-bit LDPC code is interleaved to arrangement of bit groups 120, 32, 38, 113, 71, 31, 65, 109, 36, 106, 134, 66, 29, 86, 136, 108, 83, 70, 79, 81, 105, 48, 30, 125, 107, 44, 99, 75, 64, 78, 51, 95, 88, 49, 60, 54, 122, 140, 137, 89, 74, 129, 82, 164, 59, 3, 67, 92, 98, 42, 77, 28, 121, 87, 18, 21, 93, 72, 2, 142, 112, 9, 50, 8, 90, 139, 14, 97, 63, 85, 104, 124, 52, 20, 118, 34, 5, 94, 41, 68, 80, 110, 12, 133, 131, 53, 116, 123, 96, 61, 111, 33, 173, 165, 175, 166, 169, 174, 159, 148, 158, 155, 145, 178, 126, 100, 154, 156, 179, 157, 46, 149, 171, 37, 153, 163, 152, 146, 177, 103, 160, 147, 76, 172, 144, 150, 132, 176, 168, 167, 162, 170, 138, 151, 161, 40, 26, 130, 119, 114, 117, 115, 84, 57, 62, 13, 47, 24, 0, 7, 10, 69, 19, 127, 17, 16, 27, 91, 4, 73, 35, 102, 15, 55, 23, 25, 11, 56, 45, 58, 128, 43, 135, 1, 143, 141, 6, 22, 101, 39.

According to the converted GW pattern (B) in Fig. 253, arrangement of bit groups 0 through 179 of the 64k-bit LDPC code is interleaved to arrangement of bit groups 120, 3, 111, 40, 32, 67, 33, 26, 38, 92, 173, 130, 113, 98, 165, 119, 71, 42, 175, 114, 31, 77, 166, 117, 65, 28, 169, 115, 109, 121, 174, 84, 36, 87, 159, 57, 106, 18, 148, 62, 134, 21, 158, 13, 66, 93, 155, 47, 29, 72, 145, 24, 86, 2, 178, 0, 136, 142, 126, 7, 108, 112, 100, 10, 83, 9, 154, 69, 70, 50, 156, 19, 79, 8, 179, 127, 81, 90, 157, 17, 105, 139, 46, 16, 48, 14, 149, 27, 30, 97, 171, 91, 125, 63, 37, 4, 107, 85, 153, 73, 44, 104, 163, 35, 99, 124, 152, 102, 75, 52, 146, 15, 64, 20, 177, 55, 78, 118, 103, 23, 51, 34, 160, 25, 95, 5, 147, 11, 88, 94, 76, 56, 49, 41, 172, 45, 60, 68, 144, 58, 54, 80, 150, 128, 122, 110, 132, 43, 140, 12, 176, 135, 137, 133, 168, 1, 89, 131, 167, 143, 74, 53, 162, 141, 129, 116, 170, 6, 82, 123, 138, 22, 164, 96, 151, 101, 59, 61, 161, 39.

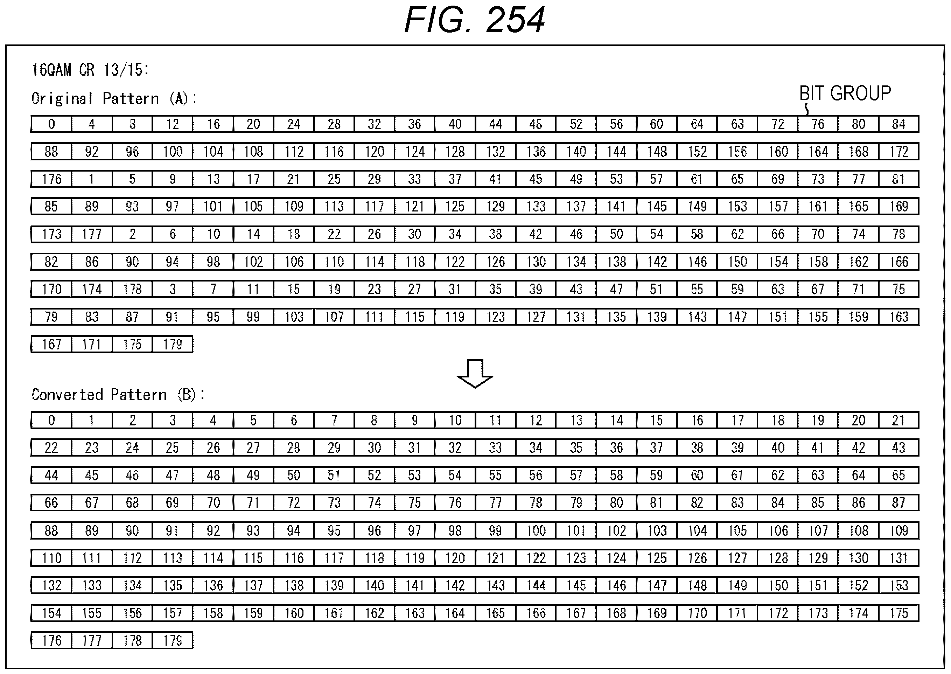

Fig. 254 is a diagram showing an example of a GW pattern for an LDPC code having a code length N of 64k bits with the modulation system set to 16QAM and the coding rate r set to 13/15.

According to the original GW pattern (A) in Fig. 254, arrangement of bit groups 0 through 179 of the 64k-bit LDPC code is interleaved to arrangement of bit groups 0, 4, 8, 12, 16, 20, 24, 28, 32, 36, 40, 44, 48, 52, 56, 60, 64, 68, 72, 76, 80, 84, 88, 92, 96, 100, 104, 108, 112, 116, 120, 124, 128, 132, 136, 140, 144, 148, 152, 156, 160, 164, 168, 172, 176, 1, 5, 9, 13, 17, 21, 25, 29, 33, 37, 41, 45, 49, 53, 57, 61, 65, 69, 73, 77, 81, 85, 89, 93, 97, 101, 105, 109, 113, 117, 121, 125, 129, 133, 137, 141, 145, 149, 153, 157, 161, 165, 169, 173, 177, 2, 6, 10, 14, 18, 22, 26, 30, 34, 38, 42, 46, 50, 54, 58, 62, 66, 70, 74, 78, 82, 86, 90, 94, 98, 102, 106, 110, 114, 118, 122, 126, 130, 134, 138, 142, 146, 150, 154, 158, 162, 166, 170, 174, 178, 3, 7, 11, 15, 19, 23, 27, 31, 35, 39, 43, 47, 51, 55, 59, 63, 67, 71, 75, 79, 83, 87, 91, 95, 99, 103, 107, 111, 115, 119, 123, 127, 131, 135, 139, 143, 147, 151, 155, 159, 163, 167, 171, 175, 179.

According to the converted GW pattern (B) in Fig. 254, arrangement of bit groups 0 through 179 of the 64k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, 65, 66, 67, 68, 69, 70, 71, 72, 73, 74, 75, 76, 77, 78, 79, 80, 81, 82, 83, 84, 85, 86, 87, 88, 89, 90, 91, 92, 93, 94, 95, 96, 97, 98, 99, 100, 101, 102, 103, 104, 105, 106, 107, 108, 109, 110, 111, 112, 113, 114, 115, 116, 117, 118, 119, 120, 121, 122, 123, 124, 125, 126, 127, 128, 129, 130, 131, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

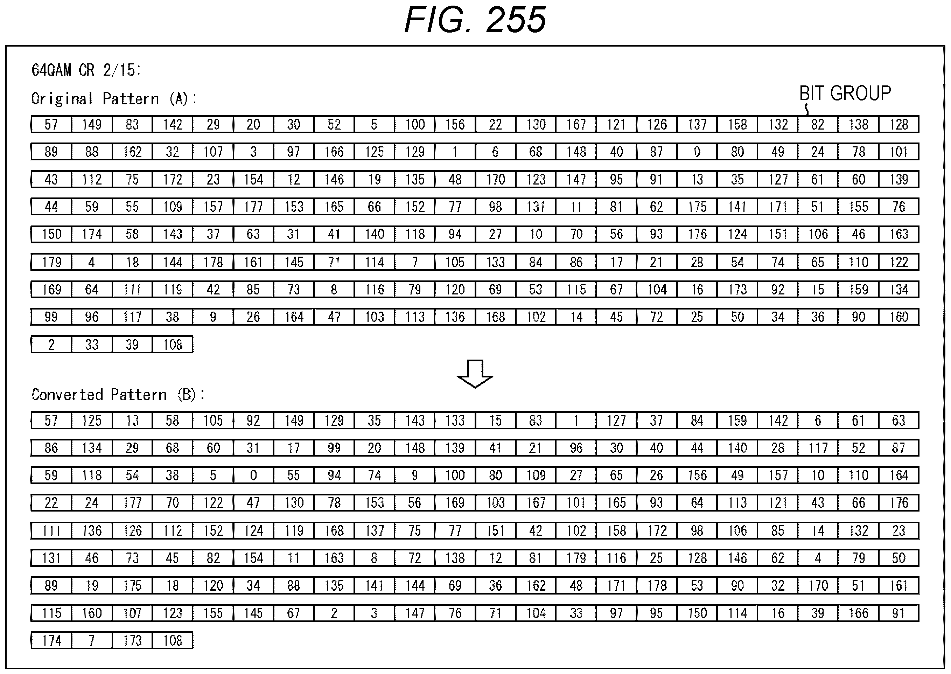

Fig. 255 is a diagram showing an example of a GW pattern for an LDPC code having a code length N of 64k bits with the modulation system set to 64QAM and the coding rate r set to 2/15.

According to the original GW pattern (A) in Fig. 255, arrangement of bit groups 0 through 179 of the 64k-bit LDPC code is interleaved to arrangement of bit groups 57, 149, 83, 142, 29, 20, 30, 52, 5, 100, 156, 22, 130, 167, 121, 126, 137, 158, 132, 82, 138, 128, 89, 88, 162, 32, 107, 3, 97, 166, 125, 129, 1, 6, 68, 148, 40, 87, 0, 80, 49, 24, 78, 101, 43, 112, 75, 172, 23, 154, 12, 146, 19, 135, 48, 170, 123, 147, 95, 91, 13, 35, 127, 61, 60, 139, 44, 59, 55, 109, 157, 177, 153, 165, 66, 152, 77, 98, 131, 11, 81, 62, 175, 141, 171, 51, 155, 76, 150, 174, 58, 143, 37, 63, 31, 41, 140, 118, 94, 27, 10, 70, 56, 93, 176, 124, 151, 106, 46, 163, 179, 4, 18, 144, 178, 161, 145, 71, 114, 7, 105, 133, 84, 86, 17, 21, 28, 54, 74, 65, 110, 122, 169, 64, 111, 119, 42, 85, 73, 8, 116, 79, 120, 69, 53, 115, 67, 104, 16, 173, 92, 15, 159, 134, 99, 96, 117, 38, 9, 26, 164, 47, 103, 113, 136, 168, 102, 14, 45, 72, 25, 50, 34, 36, 90, 160, 2, 33, 39, 108.

According to the converted GW pattern (B) in Fig. 255, arrangement of bit groups 0 through 179 of the 64k-bit LDPC code is interleaved to arrangement of bit groups 57, 125, 13, 58, 105, 92, 149, 129, 35, 143, 133, 15, 83, 1, 127, 37, 84, 159, 142, 6, 61, 63, 86, 134, 29, 68, 60, 31, 17, 99, 20, 148, 139, 41, 21, 96, 30, 40, 44, 140, 28, 117, 52, 87, 59, 118, 54, 38, 5, 0, 55, 94, 74, 9, 100, 80, 109, 27, 65, 26, 156, 49, 157, 10, 110, 164, 22, 24, 177, 70, 122, 47, 130, 78, 153, 56, 169, 103, 167, 101, 165, 93, 64, 113, 121, 43, 66, 176, 111, 136, 126, 112, 152, 124, 119, 168, 137, 75, 77, 151, 42, 102, 158, 172, 98, 106, 85, 14, 132, 23, 131, 46, 73, 45, 82, 154, 11, 163, 8, 72, 138, 12, 81, 179, 116, 25, 128, 146, 62, 4, 79, 50, 89, 19, 175, 18, 120, 34, 88, 135, 141, 144, 69, 36, 162, 48, 171, 178, 53, 90, 32, 170, 51, 161, 115, 160, 107, 123, 155, 145, 67, 2, 3, 147, 76, 71, 104, 33, 97, 95, 150, 114, 16, 39, 166, 91, 174, 7, 173, 108.

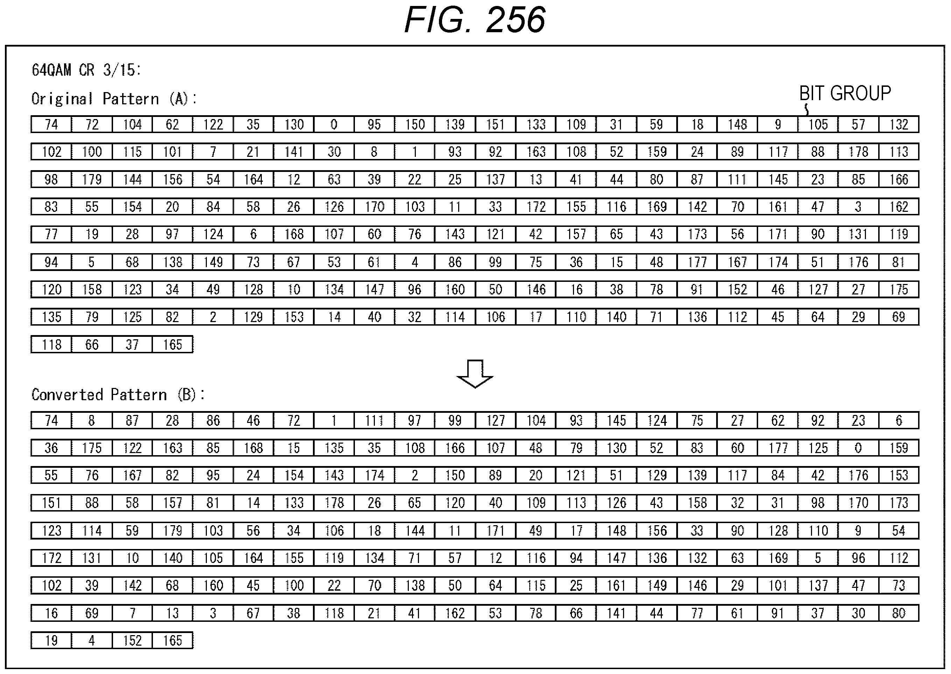

Fig. 256 is a diagram showing an example of a GW pattern for an LDPC code having a code length N of 64k bits with the modulation system set to 64QAM and the coding rate r set to 3/15.

According to the original GW pattern (A) in Fig. 256, arrangement of bit groups 0 through 179 of the 64k-bit LDPC code is interleaved to arrangement of bit groups 74, 72, 104, 62, 122, 35, 130, 0, 95, 150, 139, 151, 133, 109, 31, 59, 18, 148, 9, 105, 57, 132, 102, 100, 115, 101, 7, 21, 141, 30, 8, 1, 93, 92, 163, 108, 52, 159, 24, 89, 117, 88, 178, 113, 98, 179, 144, 156, 54, 164, 12, 63, 39, 22, 25, 137, 13, 41, 44, 80, 87, 111, 145, 23, 85, 166, 83, 55, 154, 20, 84, 58, 26, 126, 170, 103, 11, 33, 172, 155, 116, 169, 142, 70, 161, 47, 3, 162, 77, 19, 28, 97, 124, 6, 168, 107, 60, 76, 143, 121, 42, 157, 65, 43, 173, 56, 171, 90, 131, 119, 94, 5, 68, 138, 149, 73, 67, 53, 61, 4, 86, 99, 75, 36, 15, 48, 177, 167, 174, 51, 176, 81, 120, 158, 123, 34, 49, 128, 10, 134, 147, 96, 160, 50, 146, 16, 38, 78, 91, 152, 46, 127, 27, 175, 135, 79, 125, 82, 2, 129, 153, 14, 40, 32, 114, 106, 17, 110, 140, 71, 136, 112, 45, 64, 29, 69, 118, 66, 37, 165.

According to the converted GW pattern (B) in Fig. 256, arrangement of bit groups 0 through 179 of the 64k-bit LDPC code is interleaved to arrangement of bit groups 74, 8, 87, 28, 86, 46, 72, 1, 111, 97, 99, 127, 104, 93, 145, 124, 75, 27, 62, 92, 23, 6, 36, 175, 122, 163, 85, 168, 15, 135, 35, 108, 166, 107, 48, 79, 130, 52, 83, 60, 177, 125, 0, 159, 55, 76, 167, 82, 95, 24, 154, 143, 174, 2, 150, 89, 20, 121, 51, 129, 139, 117, 84, 42, 176, 153, 151, 88, 58, 157, 81, 14, 133, 178, 26, 65, 120, 40, 109, 113, 126, 43, 158, 32, 31, 98, 170, 173, 123, 114, 59, 179, 103, 56, 34, 106, 18, 144, 11, 171, 49, 17, 148, 156, 33, 90, 128, 110, 9, 54, 172, 131, 10, 140, 105, 164, 155, 119, 134, 71, 57, 12, 116, 94, 147, 136, 132, 63, 169, 5, 96, 112, 102, 39, 142, 68, 160, 45, 100, 22, 70, 138, 50, 64, 115, 25, 161, 149, 146, 29, 101, 137, 47, 73, 16, 69, 7, 13, 3, 67, 38, 118, 21, 41, 162, 53, 78, 66, 141, 44, 77, 61, 91, 37, 30, 80, 19, 4, 152, 165.

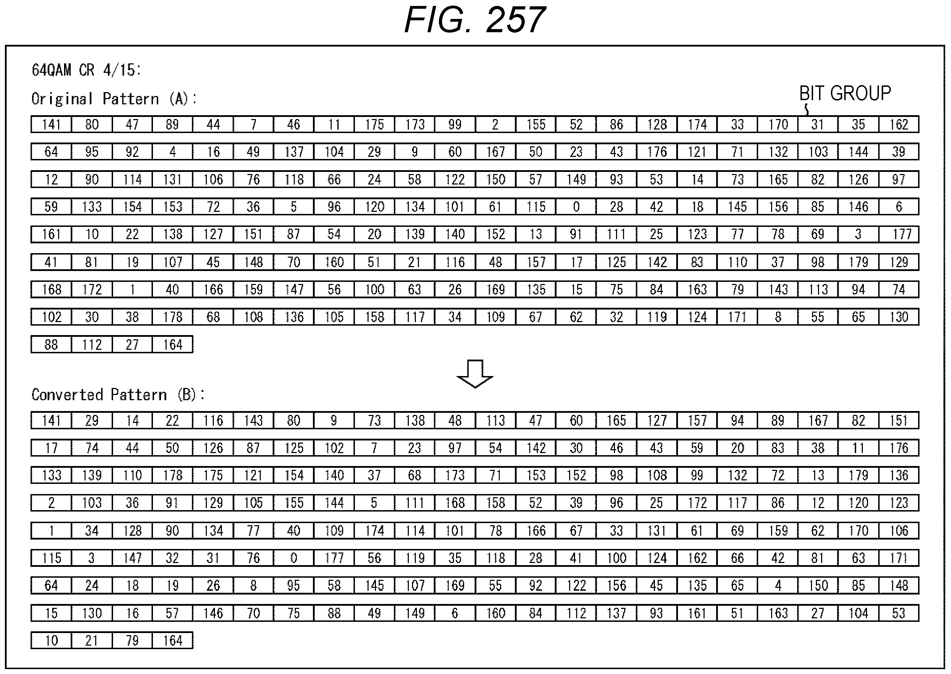

Fig. 257 is a diagram showing an example of a GW pattern for an LDPC code having a code length N of 64k bits with the modulation system set to 64QAM and the coding rate r set to 4/15.

According to the original GW pattern (A) in Fig. 257, arrangement of bit groups 0 through 179 of the 64k-bit LDPC code is interleaved to arrangement of bit groups 141, 80, 47, 89, 44, 7, 46, 11, 175, 173, 99, 2, 155, 52, 86, 128, 174, 33, 170, 31, 35, 162, 64, 95, 92, 4, 16, 49, 137, 104, 29, 9, 60, 167, 50, 23, 43, 176, 121, 71, 132, 103, 144, 39, 12, 90, 114, 131, 106, 76, 118, 66, 24, 58, 122, 150, 57, 149, 93, 53, 14, 73, 165, 82, 126, 97, 59, 133, 154, 153, 72, 36, 5, 96, 120, 134, 101, 61, 115, 0, 28, 42, 18, 145, 156, 85, 146, 6, 161, 10, 22, 138, 127, 151, 87, 54, 20, 139, 140, 152, 13, 91, 111, 25, 123, 77, 78, 69, 3, 177, 41, 81, 19, 107, 45, 148, 70, 160, 51, 21, 116, 48, 157, 17, 125, 142, 83, 110, 37, 98, 179, 129, 168, 172, 1, 40, 166, 159, 147, 56, 100, 63, 26, 169, 135, 15, 75, 84, 163, 79, 143, 113, 94, 74, 102, 30, 38, 178, 68, 108, 136, 105, 158, 117, 34, 109, 67, 62, 32, 119, 124, 171, 8, 55, 65, 130, 88, 112, 27, 164.

According to the converted GW pattern (B) in Fig. 257, arrangement of bit groups 0 through 179 of the 64k-bit LDPC code is interleaved to arrangement of bit groups 141, 29, 14, 22, 116, 143, 80, 9, 73, 138, 48, 113, 47, 60, 165, 127, 157, 94, 89, 167, 82, 151, 17, 74, 44, 50, 126, 87, 125, 102, 7, 23, 97, 54, 142, 30, 46, 43, 59, 20, 83, 38, 11, 176, 133, 139, 110, 178, 175, 121, 154, 140, 37, 68, 173, 71, 153, 152, 98, 108, 99, 132, 72, 13, 179, 136, 2, 103, 36, 91, 129, 105, 155, 144, 5, 111, 168, 158, 52, 39, 96, 25, 172, 117, 86, 12, 120, 123, 1, 34, 128, 90, 134, 77, 40, 109, 174, 114, 101, 78, 166, 67, 33, 131, 61, 69, 159, 62, 170, 106, 115, 3, 147, 32, 31, 76, 0, 177, 56, 119, 35, 118, 28, 41, 100, 124, 162, 66, 42, 81, 63, 171, 64, 24, 18, 19, 26, 8, 95, 58, 145, 107, 169, 55, 92, 122, 156, 45, 135, 65, 4, 150, 85, 148, 15, 130, 16, 57, 146, 70, 75, 88, 49, 149, 6, 160, 84, 112, 137, 93, 161, 51, 163, 27, 104, 53, 10, 21, 79, 164.

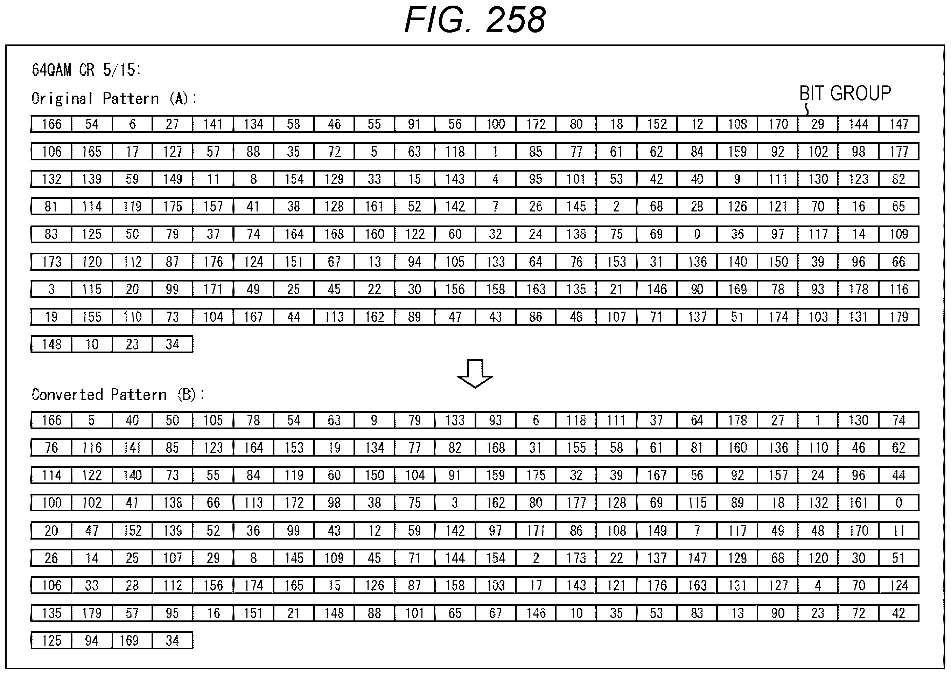

Fig. 258 is a diagram showing an example of a GW pattern for an LDPC code having a code length N of 64k bits with the modulation system set to 64QAM and the coding rate r set to 5/15.

According to the original GW pattern (A) in Fig. 258, arrangement of bit groups 0 through 179 of the 64k-bit LDPC code is interleaved to arrangement of bit groups 166, 54, 6, 27, 141, 134, 58, 46, 55, 91, 56, 100, 172, 80, 18, 152, 12, 108, 170, 29, 144, 147, 106, 165, 17, 127, 57, 88, 35, 72, 5, 63, 118, 1, 85, 77, 61, 62, 84, 159, 92, 102, 98, 177, 132, 139, 59, 149, 11, 8, 154, 129, 33, 15, 143, 4, 95, 101, 53, 42, 40, 9, 111, 130, 123, 82, 81, 114, 119, 175, 157, 41, 38, 128, 161, 52, 142, 7, 26, 145, 2, 68, 28, 126, 121, 70, 16, 65, 83, 125, 50, 79, 37, 74, 164, 168, 160, 122, 60, 32, 24, 138, 75, 69, 0, 36, 97, 117, 14, 109, 173, 120, 112, 87, 176, 124, 151, 67, 13, 94, 105, 133, 64, 76, 153, 31, 136, 140, 150, 39, 96, 66, 3, 115, 20, 99, 171, 49, 25, 45, 22, 30, 156, 158, 163, 135, 21, 146, 90, 169, 78, 93, 178, 116, 19, 155, 110, 73, 104, 167, 44, 113, 162, 89, 47, 43, 86, 48, 107, 71, 137, 51, 174, 103, 131, 179, 148, 10, 23, 34.

According to the converted GW pattern (B) in Fig. 258, arrangement of bit groups 0 through 179 of the 64k-bit LDPC code is interleaved to arrangement of bit groups 166, 5, 40, 50, 105, 78, 54, 63, 9, 79, 133, 93, 6, 118, 111, 37, 64, 178, 27, 1, 130, 74, 76, 116, 141, 85, 123, 164, 153, 19, 134, 77, 82, 168, 31, 155, 58, 61, 81, 160, 136, 110, 46, 62, 114, 122, 140, 73, 55, 84, 119, 60, 150, 104, 91, 159, 175, 32, 39, 167, 56, 92, 157, 24, 96, 44, 100, 102, 41, 138, 66, 113, 172, 98, 38, 75, 3, 162, 80, 177, 128, 69, 115, 89, 18, 132, 161, 0, 20, 47, 152, 139, 52, 36, 99, 43, 12, 59, 142, 97, 171, 86, 108, 149, 7, 117, 49, 48, 170, 11, 26, 14, 25, 107, 29, 8, 145, 109, 45, 71, 144, 154, 2, 173, 22, 137, 147, 129, 68, 120, 30, 51, 106, 33, 28, 112, 156, 174, 165, 15, 126, 87, 158, 103, 17, 143, 121, 176, 163, 131, 127, 4, 70, 124, 135, 179, 57, 95, 16, 151, 21, 148, 88, 101, 65, 67, 146, 10, 35, 53, 83, 13, 90, 23, 72, 42, 125, 94, 169, 34.

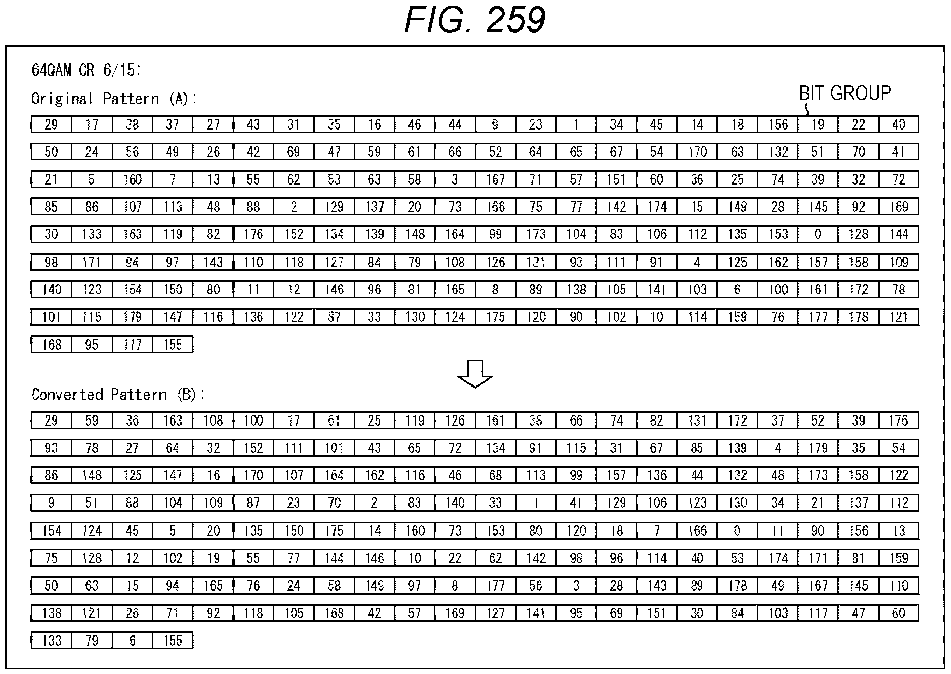

Fig. 259 is a diagram showing an example of a GW pattern for an LDPC code having a code length N of 64k bits with the modulation system set to 64QAM and the coding rate r set to 6/15.

According to the original GW pattern (A) in Fig. 259, arrangement of bit groups 0 through 179 of the 64k-bit LDPC code is interleaved to arrangement of bit groups 29, 17, 38, 37, 27, 43, 31, 35, 16, 46, 44, 9, 23, 1, 34, 45, 14, 18, 156, 19, 22, 40, 50, 24, 56, 49, 26, 42, 69, 47, 59, 61, 66, 52, 64, 65, 67, 54, 170, 68, 132, 51, 70, 41, 21, 5, 160, 7, 13, 55, 62, 53, 63, 58, 3, 167, 71, 57, 151, 60, 36, 25, 74, 39, 32, 72, 85, 86, 107, 113, 48, 88, 2, 129, 137, 20, 73, 166, 75, 77, 142, 174, 15, 149, 28, 145, 92, 169, 30, 133, 163, 119, 82, 176, 152, 134, 139, 148, 164, 99, 173, 104, 83, 106, 112, 135, 153, 0, 128, 144, 98, 171, 94, 97, 143, 110, 118, 127, 84, 79, 108, 126, 131, 93, 111, 91, 4, 125, 162, 157, 158, 109, 140, 123, 154, 150, 80, 11, 12, 146, 96, 81, 165, 8, 89, 138, 105, 141, 103, 6, 100, 161, 172, 78, 101, 115, 179, 147, 116, 136, 122, 87, 33, 130, 124, 175, 120, 90, 102, 10, 114, 159, 76, 177, 178, 121, 168, 95, 117, 155.

According to the converted GW pattern (B) in Fig. 259, arrangement of bit groups 0 through 179 of the 64k-bit LDPC code is interleaved to arrangement of bit groups 29, 59, 36, 163, 108, 100, 17, 61, 25, 119, 126, 161, 38, 66, 74, 82, 131, 172, 37, 52, 39, 176, 93, 78, 27, 64, 32, 152, 111, 101, 43, 65, 72, 134, 91, 115, 31, 67, 85, 139, 4, 179, 35, 54, 86, 148, 125, 147, 16, 170, 107, 164, 162, 116, 46, 68, 113, 99, 157, 136, 44, 132, 48, 173, 158, 122, 9, 51, 88, 104, 109, 87, 23, 70, 2, 83, 140, 33, 1, 41, 129, 106, 123, 130, 34, 21, 137, 112, 154, 124, 45, 5, 20, 135, 150, 175, 14, 160, 73, 153, 80, 120, 18, 7, 166, 0, 11, 90, 156, 13, 75, 128, 12, 102, 19, 55, 77, 144, 146, 10, 22, 62, 142, 98, 96, 114, 40, 53, 174, 171, 81, 159, 50, 63, 15, 94, 165, 76, 24, 58, 149, 97, 8, 177, 56, 3, 28, 143, 89, 178, 49, 167, 145, 110, 138, 121, 26, 71, 92, 118, 105, 168, 42, 57, 169, 127, 141, 95, 69, 151, 30, 84, 103, 117, 47, 60, 133, 79, 6, 155.

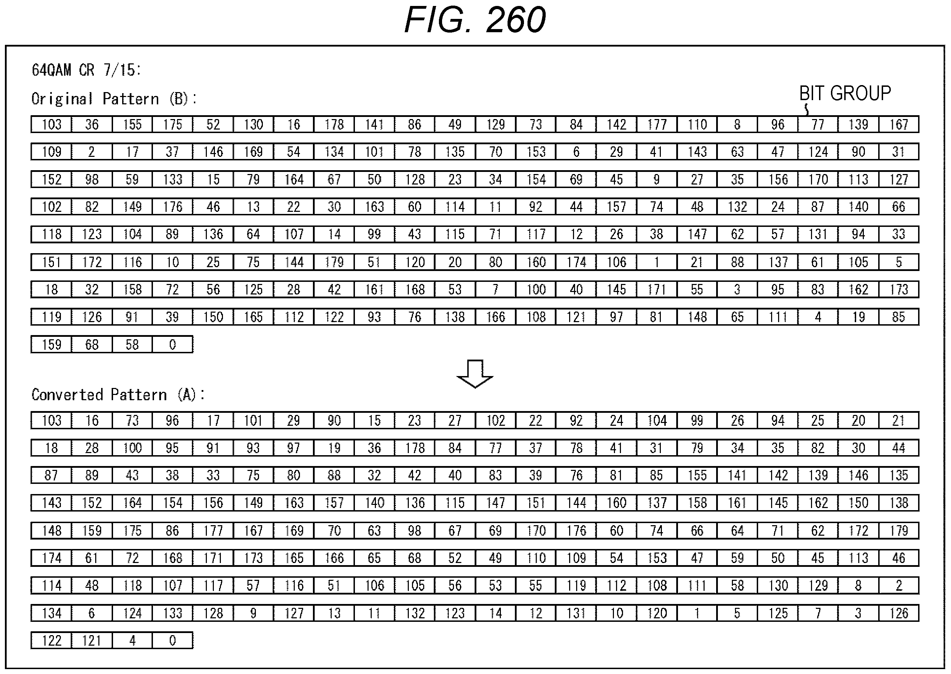

Fig. 260 is a diagram showing an example of a GW pattern for an LDPC code having a code length N of 64k bits with the modulation system set to 64QAM and the coding rate r set to 7/15.

According to the original GW pattern (B) in Fig. 260, arrangement of bit groups 0 through 179 of the 64k-bit LDPC code is interleaved to arrangement of bit groups 103, 36, 155, 175, 52, 130, 16, 178, 141, 86, 49, 129, 73, 84, 142, 177, 110, 8, 96, 77, 139, 167, 109, 2, 17, 37, 146, 169, 54, 134, 101, 78, 135, 70, 153, 6, 29, 41, 143, 63, 47, 124, 90, 31, 152, 98, 59, 133, 15, 79, 164, 67, 50, 128, 23, 34, 154, 69, 45, 9, 27, 35, 156, 170, 113, 127, 102, 82, 149, 176, 46, 13, 22, 30, 163, 60, 114, 11, 92, 44, 157, 74, 48, 132, 24, 87, 140, 66, 118, 123, 104, 89, 136, 64, 107, 14, 99, 43, 115, 71, 117, 12, 26, 38, 147, 62, 57, 131, 94, 33, 151, 172, 116, 10, 25, 75, 144, 179, 51, 120, 20, 80, 160, 174, 106, 1, 21, 88, 137, 61, 105, 5, 18, 32, 158, 72, 56, 125, 28, 42, 161, 168, 53, 7, 100, 40, 145, 171, 55, 3, 95, 83, 162, 173, 119, 126, 91, 39, 150, 165, 112, 122, 93, 76, 138, 166, 108, 121, 97, 81, 148, 65, 111, 4, 19, 85, 159, 68, 58, 0.

According to the converted GW pattern (A) in Fig. 260, arrangement of bit groups 0 through 179 of the 64k-bit LDPC code is interleaved to arrangement of bit groups 103, 16, 73, 96, 17, 101, 29, 90, 15, 23, 27, 102, 22, 92, 24, 104, 99, 26, 94, 25, 20, 21, 18, 28, 100, 95, 91, 93, 97, 19, 36, 178, 84, 77, 37, 78, 41, 31, 79, 34, 35, 82, 30, 44, 87, 89, 43, 38, 33, 75, 80, 88, 32, 42, 40, 83, 39, 76, 81, 85, 155, 141, 142, 139, 146, 135, 143, 152, 164, 154, 156, 149, 163, 157, 140, 136, 115, 147, 151, 144, 160, 137, 158, 161, 145, 162, 150, 138, 148, 159, 175, 86, 177, 167, 169, 70, 63, 98, 67, 69, 170, 176, 60, 74, 66, 64, 71, 62, 172, 179, 174, 61, 72, 168, 171, 173, 165, 166, 65, 68, 52, 49, 110, 109, 54, 153, 47, 59, 50, 45, 113, 46, 114, 48, 118, 107, 117, 57, 116, 51, 106, 105, 56, 53, 55, 119, 112, 108, 111, 58, 130, 129, 8, 2, 134, 6, 124, 133, 128, 9, 127, 13, 11, 132, 123, 14, 12, 131, 10, 120, 1, 5, 125, 7, 3, 126, 122, 121, 4, 0.

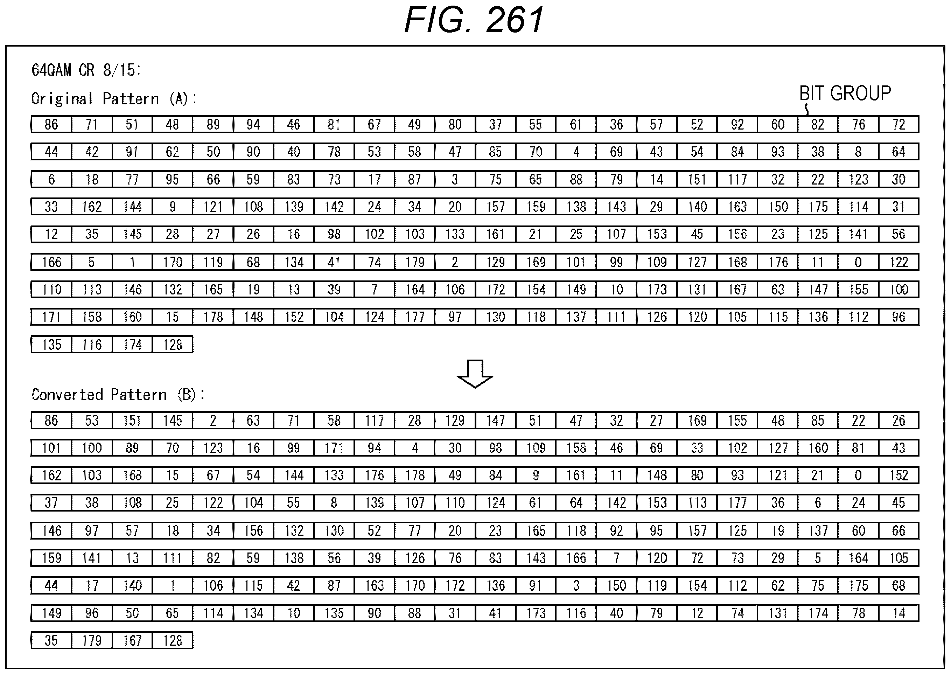

Fig. 261 is a diagram showing an example of a GW pattern for an LDPC code having a code length N of 64k bits with the modulation system set to 64QAM and the coding rate r set to 8/15.

According to the original GW pattern (A) in Fig. 261, arrangement of bit groups 0 through 179 of the 64k-bit LDPC code is interleaved to arrangement of bit groups 86, 71, 51, 48, 89, 94, 46, 81, 67, 49, 80, 37, 55, 61, 36, 57, 52, 92, 60, 82, 76, 72, 44, 42, 91, 62, 50, 90, 40, 78, 53, 58, 47, 85, 70, 4, 69, 43, 54, 84, 93, 38, 8, 64, 6, 18, 77, 95, 66, 59, 83, 73, 17, 87, 3, 75, 65, 88, 79, 14, 151, 117, 32, 22, 123, 30, 33, 162, 144, 9, 121, 108, 139, 142, 24, 34, 20, 157, 159, 138, 143, 29, 140, 163, 150, 175, 114, 31, 12, 35, 145, 28, 27, 26, 16, 98, 102, 103, 133, 161, 21, 25, 107, 153, 45, 156, 23, 125, 141, 56, 166, 5, 1, 170, 119, 68, 134, 41, 74, 179, 2, 129, 169, 101, 99, 109, 127, 168, 176, 11, 0, 122, 110, 113, 146, 132, 165, 19, 13, 39, 7, 164, 106, 172, 154, 149, 10, 173, 131, 167, 63, 147, 155, 100, 171, 158, 160, 15, 178, 148, 152, 104, 124, 177, 97, 130, 118, 137, 111, 126, 120, 105, 115, 136, 112, 96, 135, 116, 174, 128.

According to the converted GW pattern (B) in Fig. 261, arrangement of bit groups 0 through 179 of the 64k-bit LDPC code is interleaved to arrangement of bit groups 86, 53, 151, 145, 2, 63, 71, 58, 117, 28, 129, 147, 51, 47, 32, 27, 169, 155, 48, 85, 22, 26, 101, 100, 89, 70, 123, 16, 99, 171, 94, 4, 30, 98, 109, 158, 46, 69, 33, 102, 127, 160, 81, 43, 162, 103, 168, 15, 67, 54, 144, 133, 176, 178, 49, 84, 9, 161, 11, 148, 80, 93, 121, 21, 0, 152, 37, 38, 108, 25, 122, 104, 55, 8, 139, 107, 110, 124, 61, 64, 142, 153, 113, 177, 36, 6, 24, 45, 146, 97, 57, 18, 34, 156, 132, 130, 52, 77, 20, 23, 165, 118, 92, 95, 157, 125, 19, 137, 60, 66, 159, 141, 13, 111, 82, 59, 138, 56, 39, 126, 76, 83, 143, 166, 7, 120, 72, 73, 29, 5, 164, 105, 44, 17, 140, 1, 106, 115, 42, 87, 163, 170, 172, 136, 91, 3, 150, 119, 154, 112, 62, 75, 175, 68, 149, 96, 50, 65, 114, 134, 10, 135, 90, 88, 31, 41, 173, 116, 40, 79, 12, 74, 131, 174, 78, 14, 35, 179, 167, 128.

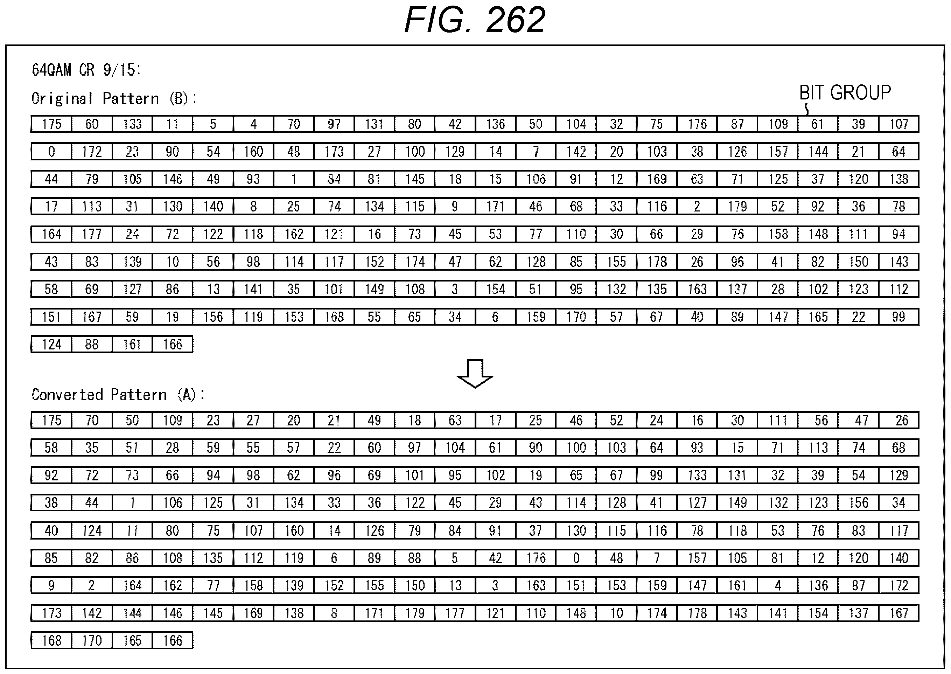

Fig. 262 is a diagram showing an example of a GW pattern for an LDPC code having a code length N of 64k bits with the modulation system set to 64QAM and the coding rate r set to 9/15.

According to the original GW pattern (B) in Fig. 262, arrangement of bit groups 0 through 179 of the 64k-bit LDPC code is interleaved to arrangement of bit groups 175, 60, 133, 11, 5, 4, 70, 97, 131, 80, 42, 136, 50, 104, 32, 75, 176, 87, 109, 61, 39, 107, 0, 172, 23, 90, 54, 160, 48, 173, 27, 100, 129, 14, 7, 142, 20, 103, 38, 126, 157, 144, 21, 64, 44, 79, 105, 146, 49, 93, 1, 84, 81, 145, 18, 15, 106, 91, 12, 169, 63, 71, 125, 37, 120, 138, 17, 113, 31, 130, 140, 8, 25, 74, 134, 115, 9, 171, 46, 68, 33, 116, 2, 179, 52, 92, 36, 78, 164, 177, 24, 72, 122, 118, 162, 121, 16, 73, 45, 53, 77, 110, 30, 66, 29, 76, 158, 148, 111, 94, 43, 83, 139, 10, 56, 98, 114, 117, 152, 174, 47, 62, 128, 85, 155, 178, 26, 96, 41, 82, 150, 143, 58, 69, 127, 86, 13, 141, 35, 101, 149, 108, 3, 154, 51, 95, 132, 135, 163, 137, 28, 102, 123, 112, 151, 167, 59, 19, 156, 119, 153, 168, 55, 65, 34, 6, 159, 170, 57, 67, 40, 89, 147, 165, 22, 99, 124, 88, 161, 166.

According to the converted GW pattern (A) in Fig. 262, arrangement of bit groups 0 through 179 of the 64k-bit LDPC code is interleaved to arrangement of bit groups 175, 70, 50, 109, 23, 27, 20, 21, 49, 18, 63, 17, 25, 46, 52, 24, 16, 30, 111, 56, 47, 26, 58, 35, 51, 28, 59, 55, 57, 22, 60, 97, 104, 61, 90, 100, 103, 64, 93, 15, 71, 113, 74, 68, 92, 72, 73, 66, 94, 98, 62, 96, 69, 101, 95, 102, 19, 65, 67, 99, 133, 131, 32, 39, 54, 129, 38, 44, 1, 106, 125, 31, 134, 33, 36, 122, 45, 29, 43, 114, 128, 41, 127, 149, 132, 123, 156, 34, 40, 124, 11, 80, 75, 107, 160, 14, 126, 79, 84, 91, 37, 130, 115, 116, 78, 118, 53, 76, 83, 117, 85, 82, 86, 108, 135, 112, 119, 6, 89, 88, 5, 42, 176, 0, 48, 7, 157, 105, 81, 12, 120, 140, 9, 2, 164, 162, 77, 158, 139, 152, 155, 150, 13, 3, 163, 151, 153, 159, 147, 161, 4, 136, 87, 172, 173, 142, 144, 146, 145, 169, 138, 8, 171, 179, 177, 121, 110, 148, 10, 174, 178, 143, 141, 154, 137, 167, 168, 170, 165, 166.

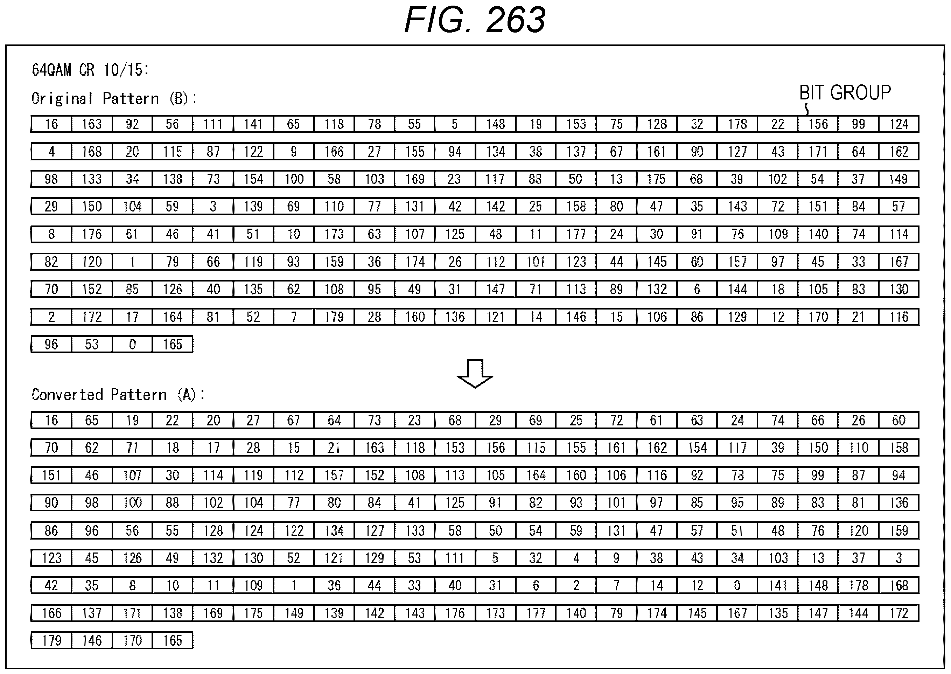

Fig. 263 is a diagram showing an example of a GW pattern for an LDPC code having a code length N of 64k bits with the modulation system set to 64QAM and the coding rate r set to 10/15.

According to the original GW pattern (B) in Fig. 263, arrangement of bit groups 0 through 179 of the 64k-bit LDPC code is interleaved to arrangement of bit groups 16, 163, 92, 56, 111, 141, 65, 118, 78, 55, 5, 148, 19, 153, 75, 128, 32, 178, 22, 156, 99, 124, 4, 168, 20, 115, 87, 122, 9, 166, 27, 155, 94, 134, 38, 137, 67, 161, 90, 127, 43, 171, 64, 162, 98, 133, 34, 138, 73, 154, 100, 58, 103, 169, 23, 117, 88, 50, 13, 175, 68, 39, 102, 54, 37, 149, 29, 150, 104, 59, 3, 139, 69, 110, 77, 131, 42, 142, 25, 158, 80, 47, 35, 143, 72, 151, 84, 57, 8, 176, 61, 46, 41, 51, 10, 173, 63, 107, 125, 48, 11, 177, 24, 30, 91, 76, 109, 140, 74, 114, 82, 120, 1, 79, 66, 119, 93, 159, 36, 174, 26, 112, 101, 123, 44, 145, 60, 157, 97, 45, 33, 167, 70, 152, 85, 126, 40, 135, 62, 108, 95, 49, 31, 147, 71, 113, 89, 132, 6, 144, 18, 105, 83, 130, 2, 172, 17, 164, 81, 52, 7, 179, 28, 160, 136, 121, 14, 146, 15, 106, 86, 129, 12, 170, 21, 116, 96, 53, 0, 165.

According to the converted GW pattern (A) in Fig. 263, arrangement of bit groups 0 through 179 of the 64k-bit LDPC code is interleaved to arrangement of bit groups 16, 65, 19, 22, 20, 27, 67, 64, 73, 23, 68, 29, 69, 25, 72, 61, 63, 24, 74, 66, 26, 60, 70, 62, 71, 18, 17, 28, 15, 21, 163, 118, 153, 156, 115, 155, 161, 162, 154, 117, 39, 150, 110, 158, 151, 46, 107, 30, 114, 119, 112, 157, 152, 108, 113, 105, 164, 160, 106, 116, 92, 78, 75, 99, 87, 94, 90, 98, 100, 88, 102, 104, 77, 80, 84, 41, 125, 91, 82, 93, 101, 97, 85, 95, 89, 83, 81, 136, 86, 96, 56, 55, 128, 124, 122, 134, 127, 133, 58, 50, 54, 59, 131, 47, 57, 51, 48, 76, 120, 159, 123, 45, 126, 49, 132, 130, 52, 121, 129, 53, 111, 5, 32, 4, 9, 38, 43, 34, 103, 13, 37, 3, 42, 35, 8, 10, 11, 109, 1, 36, 44, 33, 40, 31, 6, 2, 7, 14, 12, 0, 141, 148, 178, 168, 166, 137, 171, 138, 169, 175, 149, 139, 142, 143, 176, 173, 177, 140, 79, 174, 145, 167, 135, 147, 144, 172, 179, 146, 170, 165.

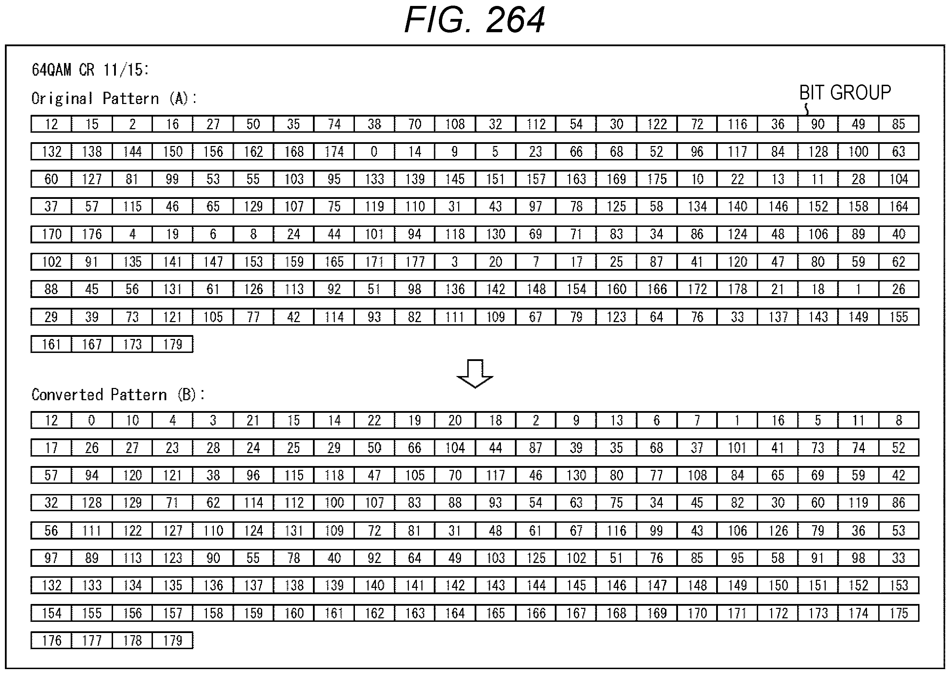

Fig. 264 is a diagram showing an example of a GW pattern for an LDPC code having a code length N of 64k bits with the modulation system set to 64QAM and the coding rate r set to 11/15.

According to the original GW pattern (A) in Fig. 264, arrangement of bit groups 0 through 179 of the 64k-bit LDPC code is interleaved to arrangement of bit groups 12, 15, 2, 16, 27, 50, 35, 74, 38, 70, 108, 32, 112, 54, 30, 122, 72, 116, 36, 90, 49, 85, 132, 138, 144, 150, 156, 162, 168, 174, 0, 14, 9, 5, 23, 66, 68, 52, 96, 117, 84, 128, 100, 63, 60, 127, 81, 99, 53, 55, 103, 95, 133, 139, 145, 151, 157, 163, 169, 175, 10, 22, 13, 11, 28, 104, 37, 57, 115, 46, 65, 129, 107, 75, 119, 110, 31, 43, 97, 78, 125, 58, 134, 140, 146, 152, 158, 164, 170, 176, 4, 19, 6, 8, 24, 44, 101, 94, 118, 130, 69, 71, 83, 34, 86, 124, 48, 106, 89, 40, 102, 91, 135, 141, 147, 153, 159, 165, 171, 177, 3, 20, 7, 17, 25, 87, 41, 120, 47, 80, 59, 62, 88, 45, 56, 131, 61, 126, 113, 92, 51, 98, 136, 142, 148, 154, 160, 166, 172, 178, 21, 18, 1, 26, 29, 39, 73, 121, 105, 77, 42, 114, 93, 82, 111, 109, 67, 79, 123, 64, 76, 33, 137, 143, 149, 155, 161, 167, 173, 179.

According to the converted GW pattern (B) in Fig. 264, arrangement of bit groups 0 through 179 of the 64k-bit LDPC code is interleaved to arrangement of bit groups 12, 0, 10, 4, 3, 21, 15, 14, 22, 19, 20, 18, 2, 9, 13, 6, 7, 1, 16, 5, 11, 8, 17, 26, 27, 23, 28, 24, 25, 29, 50, 66, 104, 44, 87, 39, 35, 68, 37, 101, 41, 73, 74, 52, 57, 94, 120, 121, 38, 96, 115, 118, 47, 105, 70, 117, 46, 130, 80, 77, 108, 84, 65, 69, 59, 42, 32, 128, 129, 71, 62, 114, 112, 100, 107, 83, 88, 93, 54, 63, 75, 34, 45, 82, 30, 60, 119, 86, 56, 111, 122, 127, 110, 124, 131, 109, 72, 81, 31, 48, 61, 67, 116, 99, 43, 106, 126, 79, 36, 53, 97, 89, 113, 123, 90, 55, 78, 40, 92, 64, 49, 103, 125, 102, 51, 76, 85, 95, 58, 91, 98, 33, 132, 133, 134, 135, 136, 137, 138, 139, 140, 141, 142, 143, 144, 145, 146, 147, 148, 149, 150, 151, 152, 153, 154, 155, 156, 157, 158, 159, 160, 161, 162, 163, 164, 165, 166, 167, 168, 169, 170, 171, 172, 173, 174, 175, 176, 177, 178, 179.

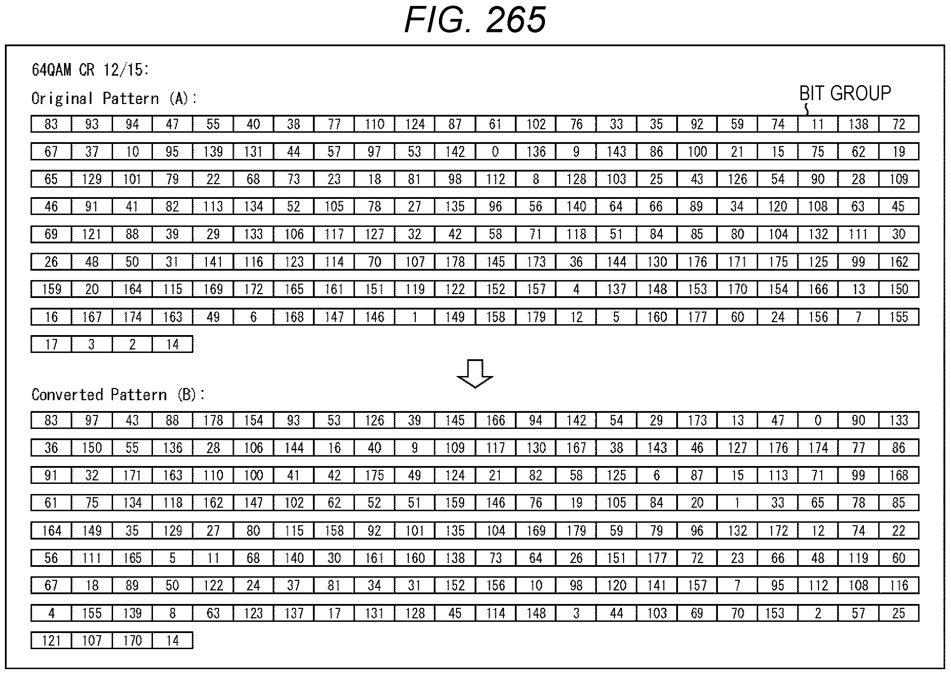

Fig. 265 is a diagram showing an example of a GW pattern for an LDPC code having a code length N of 64k bits with the modulation system set to 64QAM and the coding rate r set to 12/15.

According to the original GW pattern (A) in Fig. 265, arrangement of bit groups 0 through 179 of the 64k-bit LDPC code is interleaved to arrangement of bit groups 83, 93, 94, 47, 55, 40, 38, 77, 110, 124, 87, 61, 102, 76, 33, 35, 92, 59, 74, 11, 138, 72, 67, 37, 10, 95, 139, 131, 44, 57, 97, 53, 142, 0, 136, 9, 143, 86, 100, 21, 15, 75, 62, 19, 65, 129, 101, 79, 22, 68, 73, 23, 18, 81, 98, 112, 8, 128, 103, 25, 43, 126, 54, 90, 28, 109, 46, 91, 41, 82, 113, 134, 52, 105, 78, 27, 135, 96, 56, 140, 64, 66, 89, 34, 120, 108, 63, 45, 69, 121, 88, 39, 29, 133, 106, 117, 127, 32, 42, 58, 71, 118, 51, 84, 85, 80, 104, 132, 111, 30, 26, 48, 50, 31, 141, 116, 123, 114, 70, 107, 178, 145, 173, 36, 144, 130, 176, 171, 175, 125, 99, 162, 159, 20, 164, 115, 169, 172, 165, 161, 151, 119, 122, 152, 157, 4, 137, 148, 153, 170, 154, 166, 13, 150, 16, 167, 174, 163, 49, 6, 168, 147, 146, 1, 149, 158, 179, 12, 5, 160, 177, 60, 24, 156, 7, 155, 17, 3, 2, 14.

According to the converted GW pattern (B) in Fig. 265, arrangement of bit groups 0 through 179 of the 64k-bit LDPC code is interleaved to arrangement of bit groups 83, 97, 43, 88, 178, 154, 93, 53, 126, 39, 145, 166, 94, 142, 54, 29, 173, 13, 47, 0, 90, 133, 36, 150, 55, 136, 28, 106, 144, 16, 40, 9, 109, 117, 130, 167, 38, 143, 46, 127, 176, 174, 77, 86, 91, 32, 171, 163, 110, 100, 41, 42, 175, 49, 124, 21, 82, 58, 125, 6, 87, 15, 113, 71, 99, 168, 61, 75, 134, 118, 162, 147, 102, 62, 52, 51, 159, 146, 76, 19, 105, 84, 20, 1, 33, 65, 78, 85, 164, 149, 35, 129, 27, 80, 115, 158, 92, 101, 135, 104, 169, 179, 59, 79, 96, 132, 172, 12, 74, 22, 56, 111, 165, 5, 11, 68, 140, 30, 161, 160, 138, 73, 64, 26, 151, 177, 72, 23, 66, 48, 119, 60, 67, 18, 89, 50, 122, 24, 37, 81, 34, 31, 152, 156, 10, 98, 120, 141, 157, 7, 95, 112, 108, 116, 4, 155, 139, 8, 63, 123, 137, 17, 131, 128, 45, 114, 148, 3, 44, 103, 69, 70, 153, 2, 57, 25, 121, 107, 170, 14.

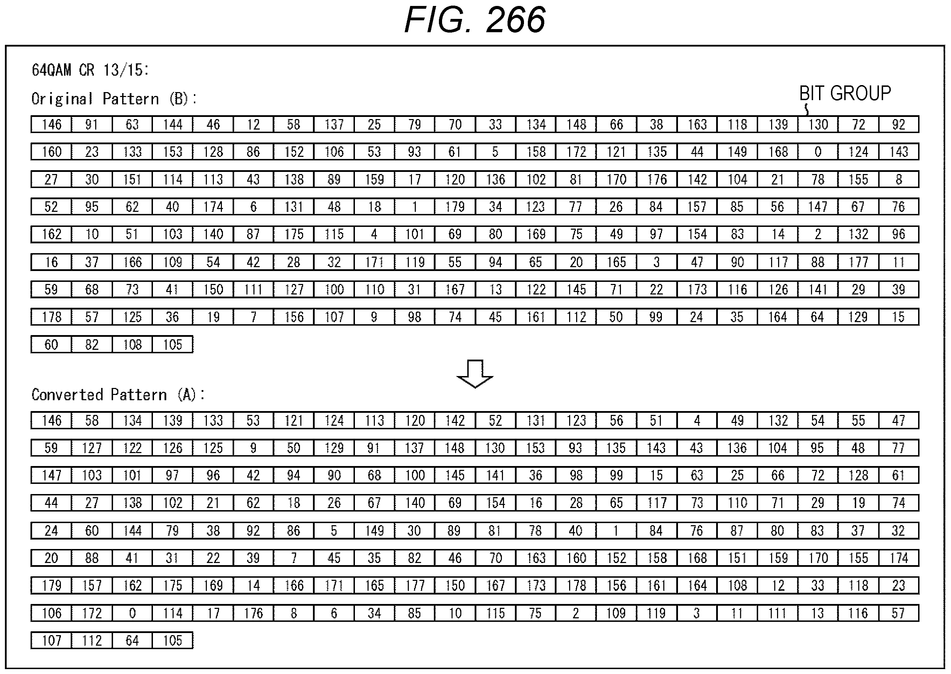

Fig. 266 is a diagram showing an example of a GW pattern for an LDPC code having a code length N of 64k bits with the modulation system set to 64QAM and the coding rate r set to 13/15.

According to the original GW pattern (B) in Fig. 266, arrangement of bit groups 0 through 179 of the 64k-bit LDPC code is interleaved to arrangement of bit groups 146, 91, 63, 144, 46, 12, 58, 137, 25, 79, 70, 33, 134, 148, 66, 38, 163, 118, 139, 130, 72, 92, 160, 23, 133, 153, 128, 86, 152, 106, 53, 93, 61, 5, 158, 172, 121, 135, 44, 149, 168, 0, 124, 143, 27, 30, 151, 114, 113, 43, 138, 89, 159, 17, 120, 136, 102, 81, 170, 176, 142, 104, 21, 78, 155, 8, 52, 95, 62, 40, 174, 6, 131, 48, 18, 1, 179, 34, 123, 77, 26, 84, 157, 85, 56, 147, 67, 76, 162, 10, 51, 103, 140, 87, 175, 115, 4, 101, 69, 80, 169, 75, 49, 97, 154, 83, 14, 2, 132, 96, 16, 37, 166, 109, 54, 42, 28, 32, 171, 119, 55, 94, 65, 20, 165, 3, 47, 90, 117, 88, 177, 11, 59, 68, 73, 41, 150, 111, 127, 100, 110, 31, 167, 13, 122, 145, 71, 22, 173, 116, 126, 141, 29, 39, 178, 57, 125, 36, 19, 7, 156, 107, 9, 98, 74, 45, 161, 112, 50, 99, 24, 35, 164, 64, 129, 15, 60, 82, 108, 105.

According to the converted GW pattern (A) in Fig. 266, arrangement of bit groups 0 through 179 of the 64k-bit LDPC code is interleaved to arrangement of bit groups 146, 58, 134, 139, 133, 53, 121, 124, 113, 120, 142, 52, 131, 123, 56, 51, 4, 49, 132, 54, 55, 47, 59, 127, 122, 126, 125, 9, 50, 129, 91, 137, 148, 130, 153, 93, 135, 143, 43, 136, 104, 95, 48, 77, 147, 103, 101, 97, 96, 42, 94, 90, 68, 100, 145, 141, 36, 98, 99, 15, 63, 25, 66, 72, 128, 61, 44, 27, 138, 102, 21, 62, 18, 26, 67, 140, 69, 154, 16, 28, 65, 117, 73, 110, 71, 29, 19, 74, 24, 60, 144, 79, 38, 92, 86, 5, 149, 30, 89, 81, 78, 40, 1, 84, 76, 87, 80, 83, 37, 32, 20, 88, 41, 31, 22, 39, 7, 45, 35, 82, 46, 70, 163, 160, 152, 158, 168, 151, 159, 170, 155, 174, 179, 157, 162, 175, 169, 14, 166, 171, 165, 177, 150, 167, 173, 178, 156, 161, 164, 108, 12, 33, 118, 23, 106, 172, 0, 114, 17, 176, 8, 6, 34, 85, 10, 115, 75, 2, 109, 119, 3, 11, 111, 13, 116, 57, 107, 112, 64, 105.

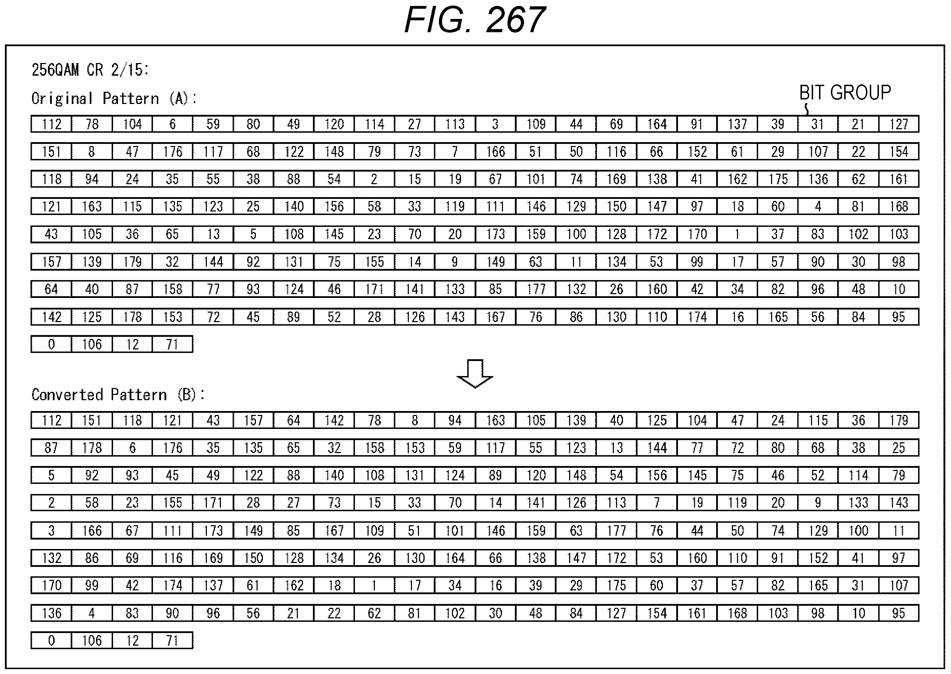

Fig. 267 is a diagram showing an example of a GW pattern for an LDPC code having a code length N of 64k bits with the modulation system set to 256QAM and the coding rate r set to 2/15.

According to the original GW pattern (A) in Fig. 267, arrangement of bit groups 0 through 179 of the 64k-bit LDPC code is interleaved to arrangement of bit groups 112, 78, 104, 6, 59, 80, 49, 120, 114, 27, 113, 3, 109, 44, 69, 164, 91, 137, 39, 31, 21, 127, 151, 8, 47, 176, 117, 68, 122, 148, 79, 73, 7, 166, 51, 50, 116, 66, 152, 61, 29, 107, 22, 154, 118, 94, 24, 35, 55, 38, 88, 54, 2, 15, 19, 67, 101, 74, 169, 138, 41, 162, 175, 136, 62, 161, 121, 163, 115, 135, 123, 25, 140, 156, 58, 33, 119, 111, 146, 129, 150, 147, 97, 18, 60, 4, 81, 168, 43, 105, 36, 65, 13, 5, 108, 145, 23, 70, 20, 173, 159, 100, 128, 172, 170, 1, 37, 83, 102, 103, 157, 139, 179, 32, 144, 92, 131, 75, 155, 14, 9, 149, 63, 11, 134, 53, 99, 17, 57, 90, 30, 98, 64, 40, 87, 158, 77, 93, 124, 46, 171, 141, 133, 85, 177, 132, 26, 160, 42, 34, 82, 96, 48, 10, 142, 125, 178, 153, 72, 45, 89, 52, 28, 126, 143, 167, 76, 86, 130, 110, 174, 16, 165, 56, 84, 95, 0, 106, 12, 71.

According to the converted GW pattern (B) in Fig. 267, arrangement of bit groups 0 through 179 of the 64k-bit LDPC code is interleaved to arrangement of bit groups 112, 151, 118, 121, 43, 157, 64, 142, 78, 8, 94, 163, 105, 139, 40, 125, 104, 47, 24, 115, 36, 179, 87, 178, 6, 176, 35, 135, 65, 32, 158, 153, 59, 117, 55, 123, 13, 144, 77, 72, 80, 68, 38, 25, 5, 92, 93, 45, 49, 122, 88, 140, 108, 131, 124, 89, 120, 148, 54, 156, 145, 75, 46, 52, 114, 79, 2, 58, 23, 155, 171, 28, 27, 73, 15, 33, 70, 14, 141, 126, 113, 7, 19, 119, 20, 9, 133, 143, 3, 166, 67, 111, 173, 149, 85, 167, 109, 51, 101, 146, 159, 63, 177, 76, 44, 50, 74, 129, 100, 11, 132, 86, 69, 116, 169, 150, 128, 134, 26, 130, 164, 66, 138, 147, 172, 53, 160, 110, 91, 152, 41, 97, 170, 99, 42, 174, 137, 61, 162, 18, 1, 17, 34, 16, 39, 29, 175, 60, 37, 57, 82, 165, 31, 107, 136, 4, 83, 90, 96, 56, 21, 22, 62, 81, 102, 30, 48, 84, 127, 154, 161, 168, 103, 98, 10, 95, 0, 106, 12, 71.

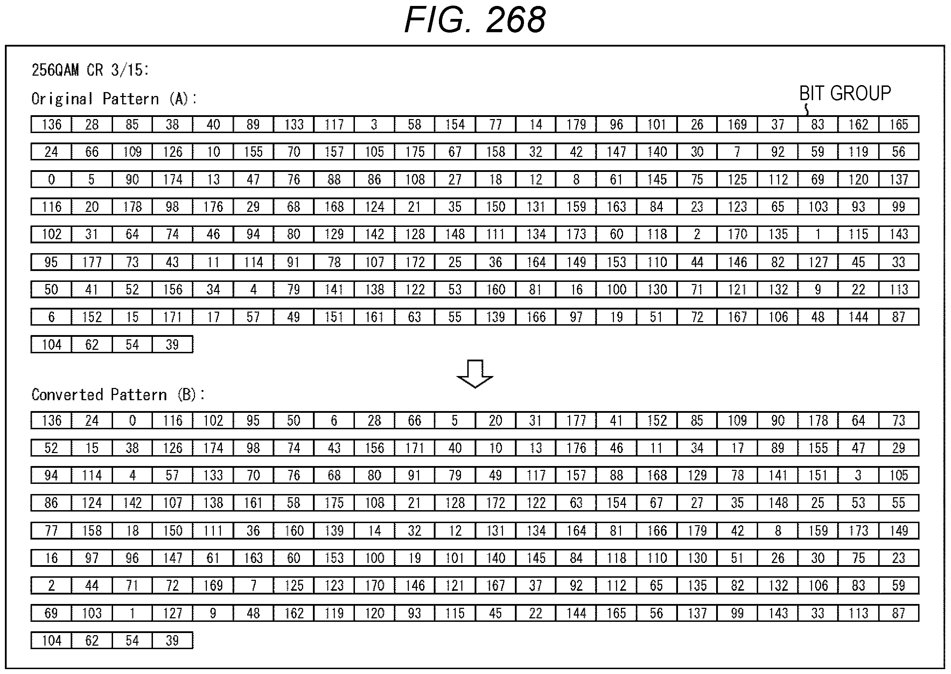

Fig. 268 is a diagram showing an example of a GW pattern for an LDPC code having a code length N of 64k bits with the modulation system set to 256QAM and the coding rate r set to 3/15.

According to the original GW pattern (A) in Fig. 268, arrangement of bit groups 0 through 179 of the 64k-bit LDPC code is interleaved to arrangement of bit groups 136, 28, 85, 38, 40, 89, 133, 117, 3, 58, 154, 77, 14, 179, 96, 101, 26, 169, 37, 83, 162, 165, 24, 66, 109, 126, 10, 155, 70, 157, 105, 175, 67, 158, 32, 42, 147, 140, 30, 7, 92, 59, 119, 56, 0, 5, 90, 174, 13, 47, 76, 88, 86, 108, 27, 18, 12, 8, 61, 145, 75, 125, 112, 69, 120, 137, 116, 20, 178, 98, 176, 29, 68, 168, 124, 21, 35, 150, 131, 159, 163, 84, 23, 123, 65, 103, 93, 99, 102, 31, 64, 74, 46, 94, 80, 129, 142, 128, 148, 111, 134, 173, 60, 118, 2, 170, 135, 1, 115, 143, 95, 177, 73, 43, 11, 114, 91, 78, 107, 172, 25, 36, 164, 149, 153, 110, 44, 146, 82, 127, 45, 33, 50, 41, 52, 156, 34, 4, 79, 141, 138, 122, 53, 160, 81, 16, 100, 130, 71, 121, 132, 9, 22, 113, 6, 152, 15, 171, 17, 57, 49, 151, 161, 63, 55, 139, 166, 97, 19, 51, 72, 167, 106, 48, 144, 87, 104, 62, 54, 39.

According to the converted GW pattern (B) in Fig. 268, arrangement of bit groups 0 through 179 of the 64k-bit LDPC code is interleaved to arrangement of bit groups 136, 24, 0, 116, 102, 95, 50, 6, 28, 66, 5, 20, 31, 177, 41, 152, 85, 109, 90, 178, 64, 73, 52, 15, 38, 126, 174, 98, 74, 43, 156, 171, 40, 10, 13, 176, 46, 11, 34, 17, 89, 155, 47, 29, 94, 114, 4, 57, 133, 70, 76, 68, 80, 91, 79, 49, 117, 157, 88, 168, 129, 78, 141, 151, 3, 105, 86, 124, 142, 107, 138, 161, 58, 175, 108, 21, 128, 172, 122, 63, 154, 67, 27, 35, 148, 25, 53, 55, 77, 158, 18, 150, 111, 36, 160, 139, 14, 32, 12, 131, 134, 164, 81, 166, 179, 42, 8, 159, 173, 149, 16, 97, 96, 147, 61, 163, 60, 153, 100, 19, 101, 140, 145, 84, 118, 110, 130, 51, 26, 30, 75, 23, 2, 44, 71, 72, 169, 7, 125, 123, 170, 146, 121, 167, 37, 92, 112, 65, 135, 82, 132, 106, 83, 59, 69, 103, 1, 127, 9, 48, 162, 119, 120, 93, 115, 45, 22, 144, 165, 56, 137, 99, 143, 33, 113, 87, 104, 62, 54, 39.

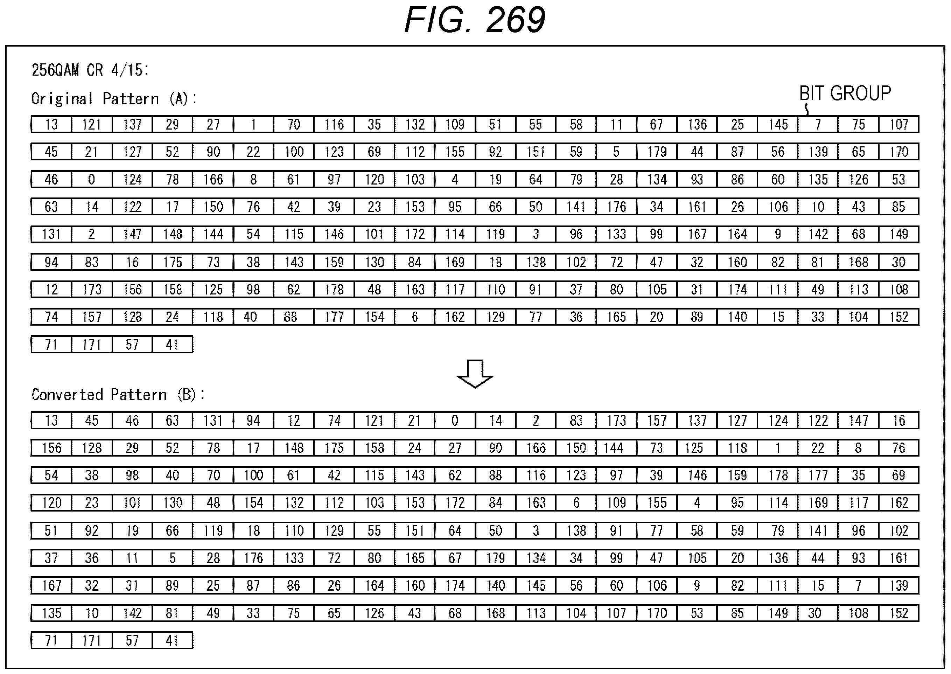

Fig. 269 is a diagram showing an example of a GW pattern for an LDPC code having a code length N of 64k bits with the modulation system set to 256QAM and the coding rate r set to 4/15.

According to the original GW pattern (A) in Fig. 269, arrangement of bit groups 0 through 179 of the 64k-bit LDPC code is interleaved to arrangement of bit groups 13, 121, 137, 29, 27, 1, 70, 116, 35, 132, 109, 51, 55, 58, 11, 67, 136, 25, 145, 7, 75, 107, 45, 21, 127, 52, 90, 22, 100, 123, 69, 112, 155, 92, 151, 59, 5, 179, 44, 87, 56, 139, 65, 170, 46, 0, 124, 78, 166, 8, 61, 97, 120, 103, 4, 19, 64, 79, 28, 134, 93, 86, 60, 135, 126, 53, 63, 14, 122, 17, 150, 76, 42, 39, 23, 153, 95, 66, 50, 141, 176, 34, 161, 26, 106, 10, 43, 85, 131, 2, 147, 148, 144, 54, 115, 146, 101, 172, 114, 119, 3, 96, 133, 99, 167, 164, 9, 142, 68, 149, 94, 83, 16, 175, 73, 38, 143, 159, 130, 84, 169, 18, 138, 102, 72, 47, 32, 160, 82, 81, 168, 30, 12, 173, 156, 158, 125, 98, 62, 178, 48, 163, 117, 110, 91, 37, 80, 105, 31, 174, 111, 49, 113, 108, 74, 157, 128, 24, 118, 40, 88, 177, 154, 6, 162, 129, 77, 36, 165, 20, 89, 140, 15, 33, 104, 152, 71, 171, 57, 41.

According to the converted GW pattern (B) in Fig. 269, arrangement of bit groups 0 through 179 of the 64k-bit LDPC code is interleaved to arrangement of bit groups 13, 45, 46, 63, 131, 94, 12, 74, 121, 21, 0, 14, 2, 83, 173, 157, 137, 127, 124, 122, 147, 16, 156, 128, 29, 52, 78, 17, 148, 175, 158, 24, 27, 90, 166, 150, 144, 73, 125, 118, 1, 22, 8, 76, 54, 38, 98, 40, 70, 100, 61, 42, 115, 143, 62, 88, 116, 123, 97, 39, 146, 159, 178, 177, 35, 69, 120, 23, 101, 130, 48, 154, 132, 112, 103, 153, 172, 84, 163, 6, 109, 155, 4, 95, 114, 169, 117, 162, 51, 92, 19, 66, 119, 18, 110, 129, 55, 151, 64, 50, 3, 138, 91, 77, 58, 59, 79, 141, 96, 102, 37, 36, 11, 5, 28, 176, 133, 72, 80, 165, 67, 179, 134, 34, 99, 47, 105, 20, 136, 44, 93, 161, 167, 32, 31, 89, 25, 87, 86, 26, 164, 160, 174, 140, 145, 56, 60, 106, 9, 82, 111, 15, 7, 139, 135, 10, 142, 81, 49, 33, 75, 65, 126, 43, 68, 168, 113, 104, 107, 170, 53, 85, 149, 30, 108, 152, 71, 171, 57, 41.

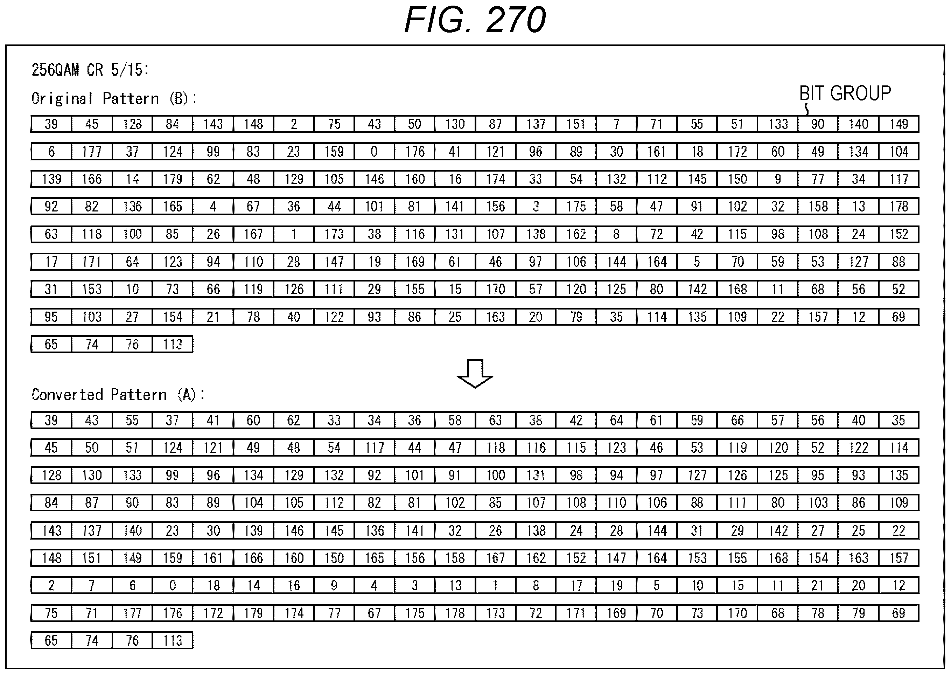

Fig. 270 is a diagram showing an example of a GW pattern for an LDPC code having a code length N of 64k bits with the modulation system set to 256QAM and the coding rate r set to 5/15.

According to the original GW pattern (B) in Fig. 270, arrangement of bit groups 0 through 179 of the 64k-bit LDPC code is interleaved to arrangement of bit groups 39, 45, 128, 84, 143, 148, 2, 75, 43, 50, 130, 87, 137, 151, 7, 71, 55, 51, 133, 90, 140, 149, 6, 177, 37, 124, 99, 83, 23, 159, 0, 176, 41, 121, 96, 89, 30, 161, 18, 172, 60, 49, 134, 104, 139, 166, 14, 179, 62, 48, 129, 105, 146, 160, 16, 174, 33, 54, 132, 112, 145, 150, 9, 77, 34, 117, 92, 82, 136, 165, 4, 67, 36, 44, 101, 81, 141, 156, 3, 175, 58, 47, 91, 102, 32, 158, 13, 178, 63, 118, 100, 85, 26, 167, 1, 173, 38, 116, 131, 107, 138, 162, 8, 72, 42, 115, 98, 108, 24, 152, 17, 171, 64, 123, 94, 110, 28, 147, 19, 169, 61, 46, 97, 106, 144, 164, 5, 70, 59, 53, 127, 88, 31, 153, 10, 73, 66, 119, 126, 111, 29, 155, 15, 170, 57, 120, 125, 80, 142, 168, 11, 68, 56, 52, 95, 103, 27, 154, 21, 78, 40, 122, 93, 86, 25, 163, 20, 79, 35, 114, 135, 109, 22, 157, 12, 69, 65, 74, 76, 113.

According to the converted GW pattern (A) in Fig. 270, arrangement of bit groups 0 through 179 of the 64k-bit LDPC code is interleaved to arrangement of bit groups 39, 43, 55, 37, 41, 60, 62, 33, 34, 36, 58, 63, 38, 42, 64, 61, 59, 66, 57, 56, 40, 35, 45, 50, 51, 124, 121, 49, 48, 54, 117, 44, 47, 118, 116, 115, 123, 46, 53, 119, 120, 52, 122, 114, 128, 130, 133, 99, 96, 134, 129, 132, 92, 101, 91, 100, 131, 98, 94, 97, 127, 126, 125, 95, 93, 135, 84, 87, 90, 83, 89, 104, 105, 112, 82, 81, 102, 85, 107, 108, 110, 106, 88, 111, 80, 103, 86, 109, 143, 137, 140, 23, 30, 139, 146, 145, 136, 141, 32, 26, 138, 24, 28, 144, 31, 29, 142, 27, 25, 22, 148, 151, 149, 159, 161, 166, 160, 150, 165, 156, 158, 167, 162, 152, 147, 164, 153, 155, 168, 154, 163, 157, 2, 7, 6, 0, 18, 14, 16, 9, 4, 3, 13, 1, 8, 17, 19, 5, 10, 15, 11, 21, 20, 12, 75, 71, 177, 176, 172, 179, 174, 77, 67, 175, 178, 173, 72, 171, 169, 70, 73, 170, 68, 78, 79, 69, 65, 74, 76, 113.

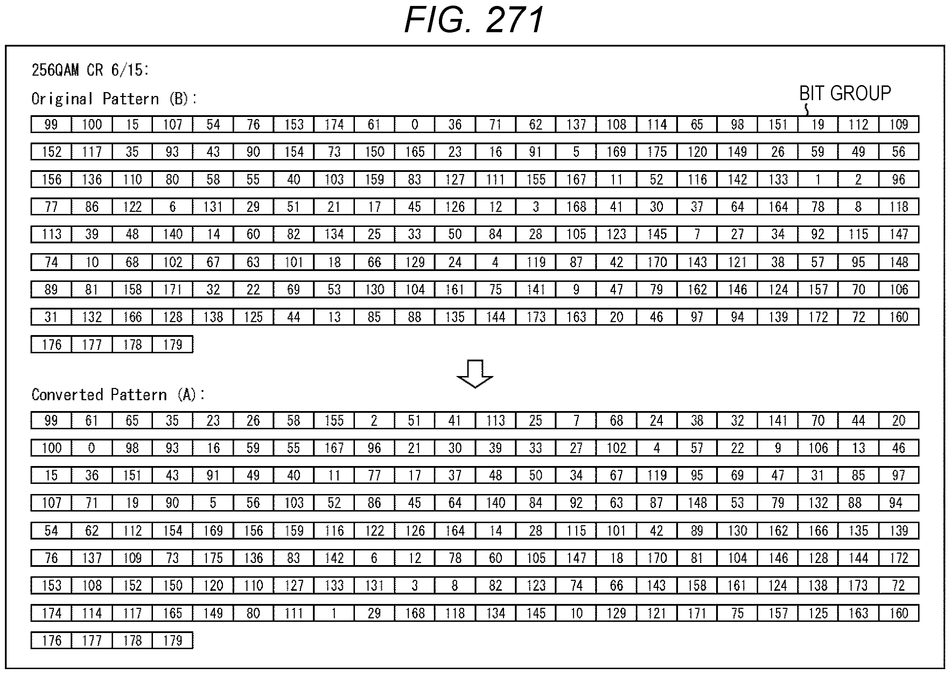

Fig. 271 is a diagram showing an example of a GW pattern for an LDPC code having a code length N of 64k bits with the modulation system set to 256QAM and the coding rate r set to 6/15.

According to the original GW pattern (B) in Fig. 271, arrangement of bit groups 0 through 179 of the 64k-bit LDPC code is interleaved to arrangement of bit groups 99, 100, 15, 107, 54, 76, 153, 174, 61, 0, 36, 71, 62, 137, 108, 114, 65, 98, 151, 19, 112, 109, 152, 117, 35, 93, 43, 90, 154, 73, 150, 165, 23, 16, 91, 5, 169, 175, 120, 149, 26, 59, 49, 56, 156, 136, 110, 80, 58, 55, 40, 103, 159, 83, 127, 111, 155, 167, 11, 52, 116, 142, 133, 1, 2, 96, 77, 86, 122, 6, 131, 29, 51, 21, 17, 45, 126, 12, 3, 168, 41, 30, 37, 64, 164, 78, 8, 118, 113, 39, 48, 140, 14, 60, 82, 134, 25, 33, 50, 84, 28, 105, 123, 145, 7, 27, 34, 92, 115, 147, 74, 10, 68, 102, 67, 63, 101, 18, 66, 129, 24, 4, 119, 87, 42, 170, 143, 121, 38, 57, 95, 148, 89, 81, 158, 171, 32, 22, 69, 53, 130, 104, 161, 75, 141, 9, 47, 79, 162, 146, 124, 157, 70, 106, 31, 132, 166, 128, 138, 125, 44, 13, 85, 88, 135, 144, 173, 163, 20, 46, 97, 94, 139, 172, 72, 160, 176, 177, 178, 179.

According to the converted GW pattern (A) in Fig. 271, arrangement of bit groups 0 through 179 of the 64k-bit LDPC code is interleaved to arrangement of bit groups 99, 61, 65, 35, 23, 26, 58, 155, 2, 51, 41, 113, 25, 7, 68, 24, 38, 32, 141, 70, 44, 20, 100, 0, 98, 93, 16, 59, 55, 167, 96, 21, 30, 39, 33, 27, 102, 4, 57, 22, 9, 106, 13, 46, 15, 36, 151, 43, 91, 49, 40, 11, 77, 17, 37, 48, 50, 34, 67, 119, 95, 69, 47, 31, 85, 97, 107, 71, 19, 90, 5, 56, 103, 52, 86, 45, 64, 140, 84, 92, 63, 87, 148, 53, 79, 132, 88, 94, 54, 62, 112, 154, 169, 156, 159, 116, 122, 126, 164, 14, 28, 115, 101, 42, 89, 130, 162, 166, 135, 139, 76, 137, 109, 73, 175, 136, 83, 142, 6, 12, 78, 60, 105, 147, 18, 170, 81, 104, 146, 128, 144, 172, 153, 108, 152, 150, 120, 110, 127, 133, 131, 3, 8, 82, 123, 74, 66, 143, 158, 161, 124, 138, 173, 72, 174, 114, 117, 165, 149, 80, 111, 1, 29, 168, 118, 134, 145, 10, 129, 121, 171, 75, 157, 125, 163, 160, 176, 177, 178, 179.

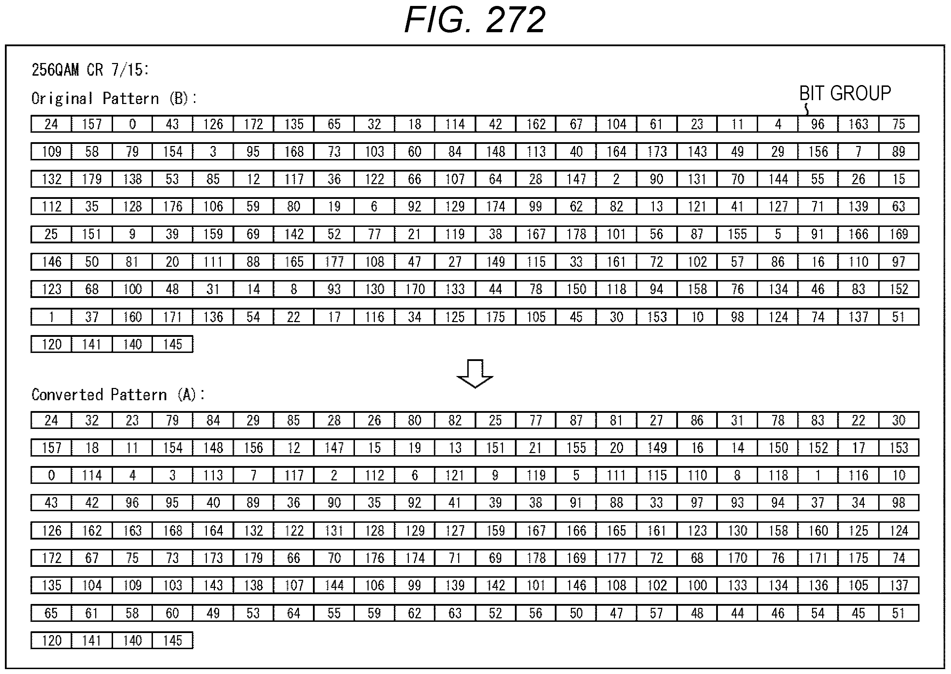

Fig. 272 is a diagram showing an example of a GW pattern for an LDPC code having a code length N of 64k bits with the modulation system set to 256QAM and the coding rate r set to 7/15.

According to the original GW pattern (B) in Fig. 272, arrangement of bit groups 0 through 179 of the 64k-bit LDPC code is interleaved to arrangement of bit groups 24, 157, 0, 43, 126, 172, 135, 65, 32, 18, 114, 42, 162, 67, 104, 61, 23, 11, 4, 96, 163, 75, 109, 58, 79, 154, 3, 95, 168, 73, 103, 60, 84, 148, 113, 40, 164, 173, 143, 49, 29, 156, 7, 89, 132, 179, 138, 53, 85, 12, 117, 36, 122, 66, 107, 64, 28, 147, 2, 90, 131, 70, 144, 55, 26, 15, 112, 35, 128, 176, 106, 59, 80, 19, 6, 92, 129, 174, 99, 62, 82, 13, 121, 41, 127, 71, 139, 63, 25, 151, 9, 39, 159, 69, 142, 52, 77, 21, 119, 38, 167, 178, 101, 56, 87, 155, 5, 91, 166, 169, 146, 50, 81, 20, 111, 88, 165, 177, 108, 47, 27, 149, 115, 33, 161, 72, 102, 57, 86, 16, 110, 97, 123, 68, 100, 48, 31, 14, 8, 93, 130, 170, 133, 44, 78, 150, 118, 94, 158, 76, 134, 46, 83, 152, 1, 37, 160, 171, 136, 54, 22, 17, 116, 34, 125, 175, 105, 45, 30, 153, 10, 98, 124, 74, 137, 51, 120, 141, 140, 145.

According to the converted GW pattern (A) in Fig. 272, arrangement of bit groups 0 through 179 of the 64k-bit LDPC code is interleaved to arrangement of bit groups 24, 32, 23, 79, 84, 29, 85, 28, 26, 80, 82, 25, 77, 87, 81, 27, 86, 31, 78, 83, 22, 30, 157, 18, 11, 154, 148, 156, 12, 147, 15, 19, 13, 151, 21, 155, 20, 149, 16, 14, 150, 152, 17, 153, 0, 114, 4, 3, 113, 7, 117, 2, 112, 6, 121, 9, 119, 5, 111, 115, 110, 8, 118, 1, 116, 10, 43, 42, 96, 95, 40, 89, 36, 90, 35, 92, 41, 39, 38, 91, 88, 33, 97, 93, 94, 37, 34, 98, 126, 162, 163, 168, 164, 132, 122, 131, 128, 129, 127, 159, 167, 166, 165, 161, 123, 130, 158, 160, 125, 124, 172, 67, 75, 73, 173, 179, 66, 70, 176, 174, 71, 69, 178, 169, 177, 72, 68, 170, 76, 171, 175, 74, 135, 104, 109, 103, 143, 138, 107, 144, 106, 99, 139, 142, 101, 146, 108, 102, 100, 133, 134, 136, 105, 137, 65, 61, 58, 60, 49, 53, 64, 55, 59, 62, 63, 52, 56, 50, 47, 57, 48, 44, 46, 54, 45, 51, 120, 141, 140, 145.

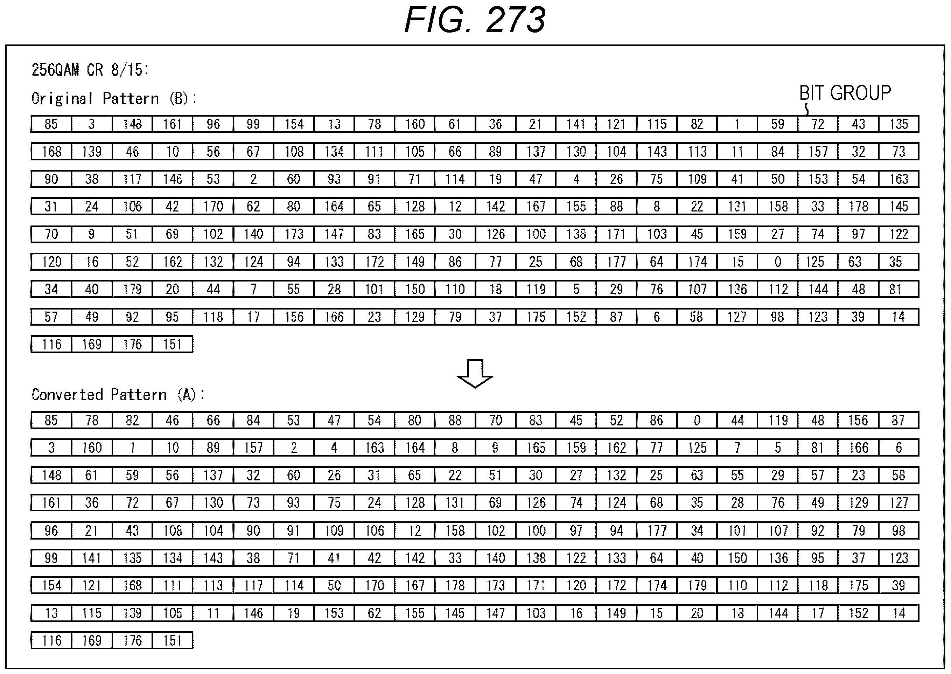

Fig. 273 is a diagram showing an example of a GW pattern for an LDPC code having a code length N of 64k bits with the modulation system set to 256QAM and the coding rate r set to 8/15.

According to the original GW pattern (B) in Fig. 273, arrangement of bit groups 0 through 179 of the 64k-bit LDPC code is interleaved to arrangement of bit groups 85, 3, 148, 161, 96, 99, 154, 13, 78, 160, 61, 36, 21, 141, 121, 115, 82, 1, 59, 72, 43, 135, 168, 139, 46, 10, 56, 67, 108, 134, 111, 105, 66, 89, 137, 130, 104, 143, 113, 11, 84, 157, 32, 73, 90, 38, 117, 146, 53, 2, 60, 93, 91, 71, 114, 19, 47, 4, 26, 75, 109, 41, 50, 153, 54, 163, 31, 24, 106, 42, 170, 62, 80, 164, 65, 128, 12, 142, 167, 155, 88, 8, 22, 131, 158, 33, 178, 145, 70, 9, 51, 69, 102, 140, 173, 147, 83, 165, 30, 126, 100, 138, 171, 103, 45, 159, 27, 74, 97, 122, 120, 16, 52, 162, 132, 124, 94, 133, 172, 149, 86, 77, 25, 68, 177, 64, 174, 15, 0, 125, 63, 35, 34, 40, 179, 20, 44, 7, 55, 28, 101, 150, 110, 18, 119, 5, 29, 76, 107, 136, 112, 144, 48, 81, 57, 49, 92, 95, 118, 17, 156, 166, 23, 129, 79, 37, 175, 152, 87, 6, 58, 127, 98, 123, 39, 14, 116, 169, 176, 151.

According to the converted GW pattern (A) in Fig. 273, arrangement of bit groups 0 through 179 of the 64k-bit LDPC code is interleaved to arrangement of bit groups 85, 78, 82, 46, 66, 84, 53, 47, 54, 80, 88, 70, 83, 45, 52, 86, 0, 44, 119, 48, 156, 87, 3, 160, 1, 10, 89, 157, 2, 4, 163, 164, 8, 9, 165, 159, 162, 77, 125, 7, 5, 81, 166, 6, 148, 61, 59, 56, 137, 32, 60, 26, 31, 65, 22, 51, 30, 27, 132, 25, 63, 55, 29, 57, 23, 58, 161, 36, 72, 67, 130, 73, 93, 75, 24, 128, 131, 69, 126, 74, 124, 68, 35, 28, 76, 49, 129, 127, 96, 21, 43, 108, 104, 90, 91, 109, 106, 12, 158, 102, 100, 97, 94, 177, 34, 101, 107, 92, 79, 98, 99, 141, 135, 134, 143, 38, 71, 41, 42, 142, 33, 140, 138, 122, 133, 64, 40, 150, 136, 95, 37, 123, 154, 121, 168, 111, 113, 117, 114, 50, 170, 167, 178, 173, 171, 120, 172, 174, 179, 110, 112, 118, 175, 39, 13, 115, 139, 105, 11, 146, 19, 153, 62, 155, 145, 147, 103, 16, 149, 15, 20, 18, 144, 17, 152, 14, 116, 169, 176, 151.

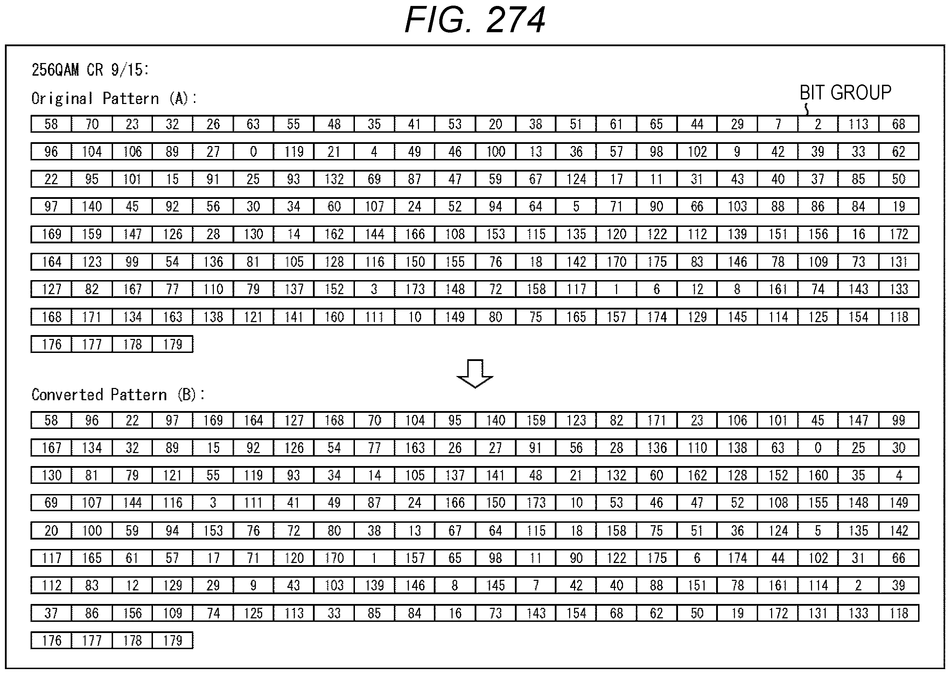

Fig. 274 is a diagram showing an example of a GW pattern for an LDPC code having a code length N of 64k bits with the modulation system set to 256QAM and the coding rate r set to 9/15.

According to the original GW pattern (A) in Fig. 274, arrangement of bit groups 0 through 179 of the 64k-bit LDPC code is interleaved to arrangement of bit groups 58, 70, 23, 32, 26, 63, 55, 48, 35, 41, 53, 20, 38, 51, 61, 65, 44, 29, 7, 2, 113, 68, 96, 104, 106, 89, 27, 0, 119, 21, 4, 49, 46, 100, 13, 36, 57, 98, 102, 9, 42, 39, 33, 62, 22, 95, 101, 15, 91, 25, 93, 132, 69, 87, 47, 59, 67, 124, 17, 11, 31, 43, 40, 37, 85, 50, 97, 140, 45, 92, 56, 30, 34, 60, 107, 24, 52, 94, 64, 5, 71, 90, 66, 103, 88, 86, 84, 19, 169, 159, 147, 126, 28, 130, 14, 162, 144, 166, 108, 153, 115, 135, 120, 122, 112, 139, 151, 156, 16, 172, 164, 123, 99, 54, 136, 81, 105, 128, 116, 150, 155, 76, 18, 142, 170, 175, 83, 146, 78, 109, 73, 131, 127, 82, 167, 77, 110, 79, 137, 152, 3, 173, 148, 72, 158, 117, 1, 6, 12, 8, 161, 74, 143, 133, 168, 171, 134, 163, 138, 121, 141, 160, 111, 10, 149, 80, 75, 165, 157, 174, 129, 145, 114, 125, 154, 118, 176, 177, 178, 179.

According to the converted GW pattern (B) in Fig. 274, arrangement of bit groups 0 through 179 of the 64k-bit LDPC code is interleaved to arrangement of bit groups 58, 96, 22, 97, 169, 164, 127, 168, 70, 104, 95, 140, 159, 123, 82, 171, 23, 106, 101, 45, 147, 99, 167, 134, 32, 89, 15, 92, 126, 54, 77, 163, 26, 27, 91, 56, 28, 136, 110, 138, 63, 0, 25, 30, 130, 81, 79, 121, 55, 119, 93, 34, 14, 105, 137, 141, 48, 21, 132, 60, 162, 128, 152, 160, 35, 4, 69, 107, 144, 116, 3, 111, 41, 49, 87, 24, 166, 150, 173, 10, 53, 46, 47, 52, 108, 155, 148, 149, 20, 100, 59, 94, 153, 76, 72, 80, 38, 13, 67, 64, 115, 18, 158, 75, 51, 36, 124, 5, 135, 142, 117, 165, 61, 57, 17, 71, 120, 170, 1, 157, 65, 98, 11, 90, 122, 175, 6, 174, 44, 102, 31, 66, 112, 83, 12, 129, 29, 9, 43, 103, 139, 146, 8, 145, 7, 42, 40, 88, 151, 78, 161, 114, 2, 39, 37, 86, 156, 109, 74, 125, 113, 33, 85, 84, 16, 73, 143, 154, 68, 62, 50, 19, 172, 131, 133, 118, 176, 177, 178, 179.

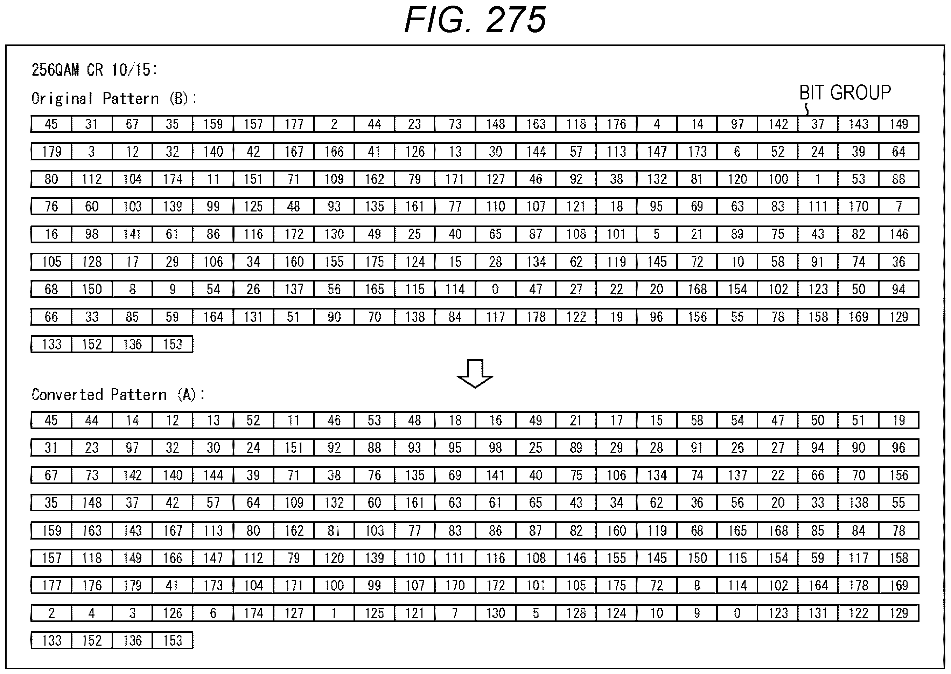

Fig. 275 is a diagram showing an example of a GW pattern for an LDPC code having a code length N of 64k bits with the modulation system set to 256QAM and the coding rate r set to 10/15.

According to the original GW pattern (B) in Fig. 275, arrangement of bit groups 0 through 179 of the 64k-bit LDPC code is interleaved to arrangement of bit groups 45, 31, 67, 35, 159, 157, 177, 2, 44, 23, 73, 148, 163, 118, 176, 4, 14, 97, 142, 37, 143, 149, 179, 3, 12, 32, 140, 42, 167, 166, 41, 126, 13, 30, 144, 57, 113, 147, 173, 6, 52, 24, 39, 64, 80, 112, 104, 174, 11, 151, 71, 109, 162, 79, 171, 127, 46, 92, 38, 132, 81, 120, 100, 1, 53, 88, 76, 60, 103, 139, 99, 125, 48, 93, 135, 161, 77, 110, 107, 121, 18, 95, 69, 63, 83, 111, 170, 7, 16, 98, 141, 61, 86, 116, 172, 130, 49, 25, 40, 65, 87, 108, 101, 5, 21, 89, 75, 43, 82, 146, 105, 128, 17, 29, 106, 34, 160, 155, 175, 124, 15, 28, 134, 62, 119, 145, 72, 10, 58, 91, 74, 36, 68, 150, 8, 9, 54, 26, 137, 56, 165, 115, 114, 0, 47, 27, 22, 20, 168, 154, 102, 123, 50, 94, 66, 33, 85, 59, 164, 131, 51, 90, 70, 138, 84, 117, 178, 122, 19, 96, 156, 55, 78, 158, 169, 129, 133, 152, 136, 153.

According to the converted GW pattern (A) in Fig. 275, arrangement of bit groups 0 through 179 of the 64k-bit LDPC code is interleaved to arrangement of bit groups 45, 44, 14, 12, 13, 52, 11, 46, 53, 48, 18, 16, 49, 21, 17, 15, 58, 54, 47, 50, 51, 19, 31, 23, 97, 32, 30, 24, 151, 92, 88, 93, 95, 98, 25, 89, 29, 28, 91, 26, 27, 94, 90, 96, 67, 73, 142, 140, 144, 39, 71, 38, 76, 135, 69, 141, 40, 75, 106, 134, 74, 137, 22, 66, 70, 156, 35, 148, 37, 42, 57, 64, 109, 132, 60, 161, 63, 61, 65, 43, 34, 62, 36, 56, 20, 33, 138, 55, 159, 163, 143, 167, 113, 80, 162, 81, 103, 77, 83, 86, 87, 82, 160, 119, 68, 165, 168, 85, 84, 78, 157, 118, 149, 166, 147, 112, 79, 120, 139, 110, 111, 116, 108, 146, 155, 145, 150, 115, 154, 59, 117, 158, 177, 176, 179, 41, 173, 104, 171, 100, 99, 107, 170, 172, 101, 105, 175, 72, 8, 114, 102, 164, 178, 169, 2, 4, 3, 126, 6, 174, 127, 1, 125, 121, 7, 130, 5, 128, 124, 10, 9, 0, 123, 131, 122, 129, 133, 152, 136, 153.

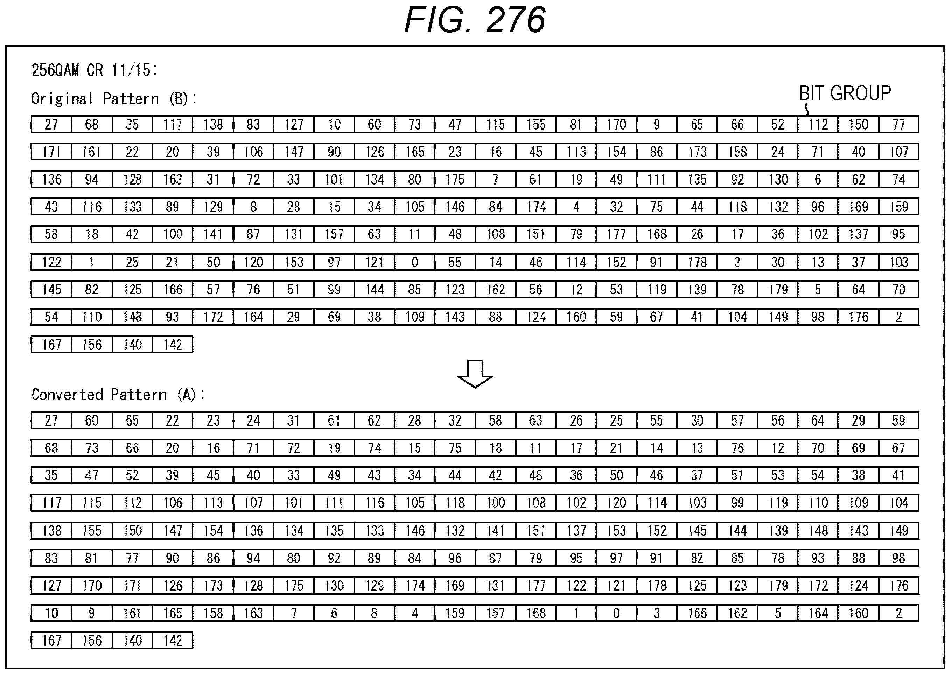

Fig. 276 is a diagram showing an example of a GW pattern for an LDPC code having a code length N of 64k bits with the modulation system set to 256QAM and the coding rate r set to 11/15.

According to the original GW pattern (B) in Fig. 276, arrangement of bit groups 0 through 179 of the 64k-bit LDPC code is interleaved to arrangement of bit groups 27, 68, 35, 117, 138, 83, 127, 10, 60, 73, 47, 115, 155, 81, 170, 9, 65, 66, 52, 112, 150, 77, 171, 161, 22, 20, 39, 106, 147, 90, 126, 165, 23, 16, 45, 113, 154, 86, 173, 158, 24, 71, 40, 107, 136, 94, 128, 163, 31, 72, 33, 101, 134, 80, 175, 7, 61, 19, 49, 111, 135, 92, 130, 6, 62, 74, 43, 116, 133, 89, 129, 8, 28, 15, 34, 105, 146, 84, 174, 4, 32, 75, 44, 118, 132, 96, 169, 159, 58, 18, 42, 100, 141, 87, 131, 157, 63, 11, 48, 108, 151, 79, 177, 168, 26, 17, 36, 102, 137, 95, 122, 1, 25, 21, 50, 120, 153, 97, 121, 0, 55, 14, 46, 114, 152, 91, 178, 3, 30, 13, 37, 103, 145, 82, 125, 166, 57, 76, 51, 99, 144, 85, 123, 162, 56, 12, 53, 119, 139, 78, 179, 5, 64, 70, 54, 110, 148, 93, 172, 164, 29, 69, 38, 109, 143, 88, 124, 160, 59, 67, 41, 104, 149, 98, 176, 2, 167, 156, 140, 142.

According to the converted GW pattern (A) in Fig. 276, arrangement of bit groups 0 through 179 of the 64k-bit LDPC code is interleaved to arrangement of bit groups 27, 60, 65, 22, 23, 24, 31, 61, 62, 28, 32, 58, 63, 26, 25, 55, 30, 57, 56, 64, 29, 59, 68, 73, 66, 20, 16, 71, 72, 19, 74, 15, 75, 18, 11, 17, 21, 14, 13, 76, 12, 70, 69, 67, 35, 47, 52, 39, 45, 40, 33, 49, 43, 34, 44, 42, 48, 36, 50, 46, 37, 51, 53, 54, 38, 41, 117, 115, 112, 106, 113, 107, 101, 111, 116, 105, 118, 100, 108, 102, 120, 114, 103, 99, 119, 110, 109, 104, 138, 155, 150, 147, 154, 136, 134, 135, 133, 146, 132, 141, 151, 137, 153, 152, 145, 144, 139, 148, 143, 149, 83, 81, 77, 90, 86, 94, 80, 92, 89, 84, 96, 87, 79, 95, 97, 91, 82, 85, 78, 93, 88, 98, 127, 170, 171, 126, 173, 128, 175, 130, 129, 174, 169, 131, 177, 122, 121, 178, 125, 123, 179, 172, 124, 176, 10, 9, 161, 165, 158, 163, 7, 6, 8, 4, 159, 157, 168, 1, 0, 3, 166, 162, 5, 164, 160, 2, 167, 156, 140, 142.

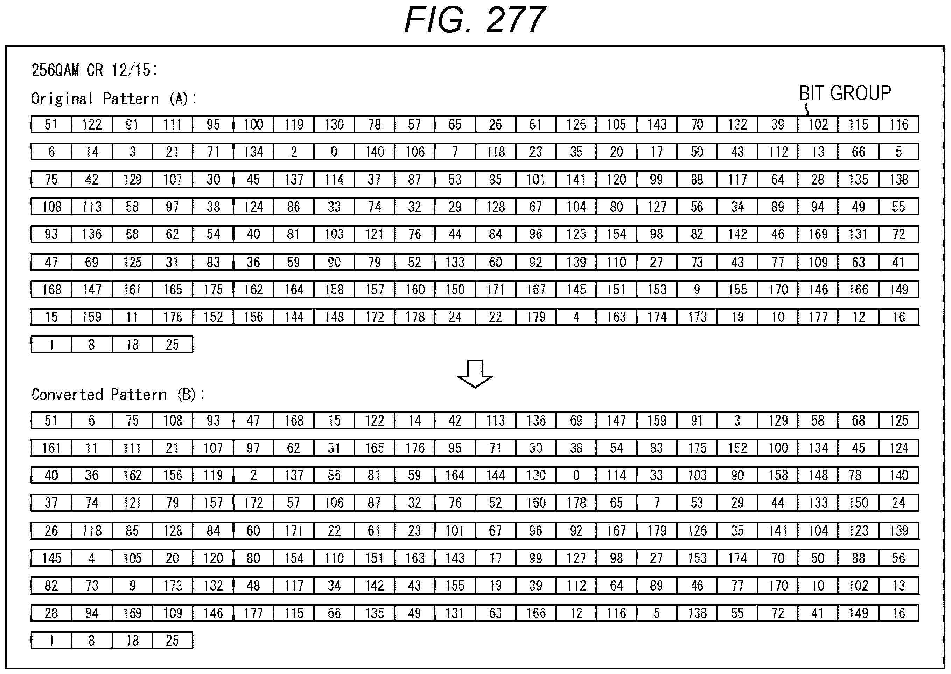

Fig. 277 is a diagram showing an example of a GW pattern for an LDPC code having a code length N of 64k bits with the modulation system set to 256QAM and the coding rate r set to 12/15.

According to the original GW pattern (A) in Fig. 277, arrangement of bit groups 0 through 179 of the 64k-bit LDPC code is interleaved to arrangement of bit groups 51, 122, 91, 111, 95, 100, 119, 130, 78, 57, 65, 26, 61, 126, 105, 143, 70, 132, 39, 102, 115, 116, 6, 14, 3, 21, 71, 134, 2, 0, 140, 106, 7, 118, 23, 35, 20, 17, 50, 48, 112, 13, 66, 5, 75, 42, 129, 107, 30, 45, 137, 114, 37, 87, 53, 85, 101, 141, 120, 99, 88, 117, 64, 28, 135, 138, 108, 113, 58, 97, 38, 124, 86, 33, 74, 32, 29, 128, 67, 104, 80, 127, 56, 34, 89, 94, 49, 55, 93, 136, 68, 62, 54, 40, 81, 103, 121, 76, 44, 84, 96, 123, 154, 98, 82, 142, 46, 169, 131, 72, 47, 69, 125, 31, 83, 36, 59, 90, 79, 52, 133, 60, 92, 139, 110, 27, 73, 43, 77, 109, 63, 41, 168, 147, 161, 165, 175, 162, 164, 158, 157, 160, 150, 171, 167, 145, 151, 153, 9, 155, 170, 146, 166, 149, 15, 159, 11, 176, 152, 156, 144, 148, 172, 178, 24, 22, 179, 4, 163, 174, 173, 19, 10, 177, 12, 16, 1, 8, 18, 25.

According to the converted GW pattern (B) in Fig. 277, arrangement of bit groups 0 through 179 of the 64k-bit LDPC code is interleaved to arrangement of bit groups 51, 6, 75, 108, 93, 47, 168, 15, 122, 14, 42, 113, 136, 69, 147, 159, 91, 3, 129, 58, 68, 125, 161, 11, 111, 21, 107, 97, 62, 31, 165, 176, 95, 71, 30, 38, 54, 83, 175, 152, 100, 134, 45, 124, 40, 36, 162, 156, 119, 2, 137, 86, 81, 59, 164, 144, 130, 0, 114, 33, 103, 90, 158, 148, 78, 140, 37, 74, 121, 79, 157, 172, 57, 106, 87, 32, 76, 52, 160, 178, 65, 7, 53, 29, 44, 133, 150, 24, 26, 118, 85, 128, 84, 60, 171, 22, 61, 23, 101, 67, 96, 92, 167, 179, 126, 35, 141, 104, 123, 139, 145, 4, 105, 20, 120, 80, 154, 110, 151, 163, 143, 17, 99, 127, 98, 27, 153, 174, 70, 50, 88, 56, 82, 73, 9, 173, 132, 48, 117, 34, 142, 43, 155, 19, 39, 112, 64, 89, 46, 77, 170, 10, 102, 13, 28, 94, 169, 109, 146, 177, 115, 66, 135, 49, 131, 63, 166, 12, 116, 5, 138, 55, 72, 41, 149, 16, 1, 8, 18, 25.

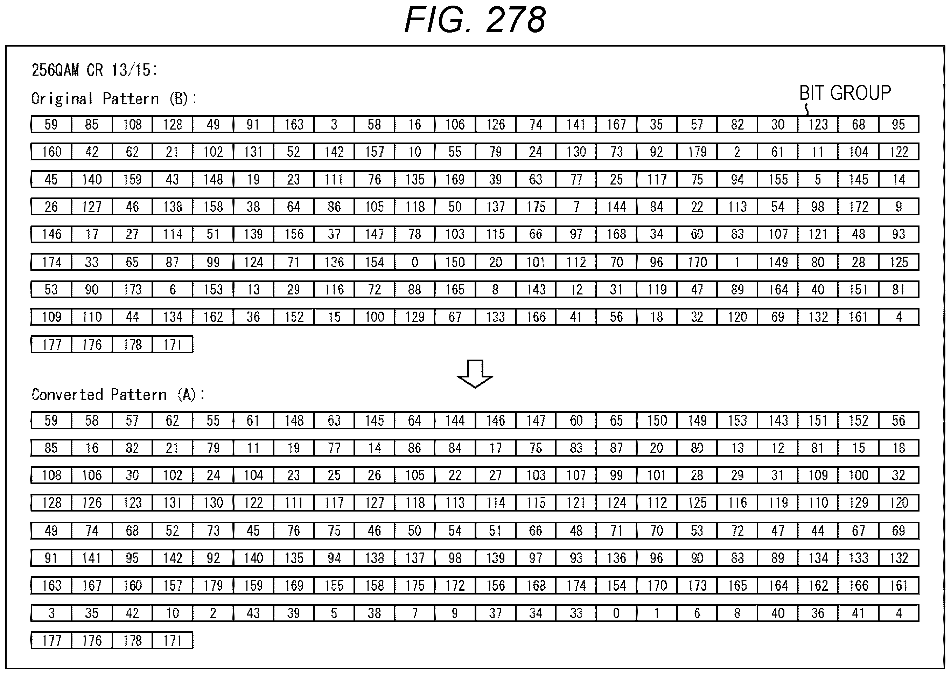

Fig. 278 is a diagram showing an example of a GW pattern for an LDPC code having a code length N of 64k bits with the modulation system set to 256QAM and the coding rate r set to 13/15.

According to the original GW pattern (B) in Fig. 278, arrangement of bit groups 0 through 179 of the 64k-bit LDPC code is interleaved to arrangement of bit groups 59, 85, 108, 128, 49, 91, 163, 3, 58, 16, 106, 126, 74, 141, 167, 35, 57, 82, 30, 123, 68, 95, 160, 42, 62, 21, 102, 131, 52, 142, 157, 10, 55, 79, 24, 130, 73, 92, 179, 2, 61, 11, 104, 122, 45, 140, 159, 43, 148, 19, 23, 111, 76, 135, 169, 39, 63, 77, 25, 117, 75, 94, 155, 5, 145, 14, 26, 127, 46, 138, 158, 38, 64, 86, 105, 118, 50, 137, 175, 7, 144, 84, 22, 113, 54, 98, 172, 9, 146, 17, 27, 114, 51, 139, 156, 37, 147, 78, 103, 115, 66, 97, 168, 34, 60, 83, 107, 121, 48, 93, 174, 33, 65, 87, 99, 124, 71, 136, 154, 0, 150, 20, 101, 112, 70, 96, 170, 1, 149, 80, 28, 125, 53, 90, 173, 6, 153, 13, 29, 116, 72, 88, 165, 8, 143, 12, 31, 119, 47, 89, 164, 40, 151, 81, 109, 110, 44, 134, 162, 36, 152, 15, 100, 129, 67, 133, 166, 41, 56, 18, 32, 120, 69, 132, 161, 4, 177, 176, 178, 171.

According to the converted GW pattern (A) in Fig. 278, arrangement of bit groups 0 through 179 of the 64k-bit LDPC code is interleaved to arrangement of bit groups 59, 58, 57, 62, 55, 61, 148, 63, 145, 64, 144, 146, 147, 60, 65, 150, 149, 153, 143, 151, 152, 56, 85, 16, 82, 21, 79, 11, 19, 77, 14, 86, 84, 17, 78, 83, 87, 20, 80, 13, 12, 81, 15, 18, 108, 106, 30, 102, 24, 104, 23, 25, 26, 105, 22, 27, 103, 107, 99, 101, 28, 29, 31, 109, 100, 32, 128, 126, 123, 131, 130, 122, 111, 117, 127, 118, 113, 114, 115, 121, 124, 112, 125, 116, 119, 110, 129, 120, 49, 74, 68, 52, 73, 45, 76, 75, 46, 50, 54, 51, 66, 48, 71, 70, 53, 72, 47, 44, 67, 69, 91, 141, 95, 142, 92, 140, 135, 94, 138, 137, 98, 139, 97, 93, 136, 96, 90, 88, 89, 134, 133, 132, 163, 167, 160, 157, 179, 159, 169, 155, 158, 175, 172, 156, 168, 174, 154, 170, 173, 165, 164, 162, 166, 161, 3, 35, 42, 10, 2, 43, 39, 5, 38, 7, 9, 37, 34, 33, 0, 1, 6, 8, 40, 36, 41, 4, 177, 176, 178, 171.

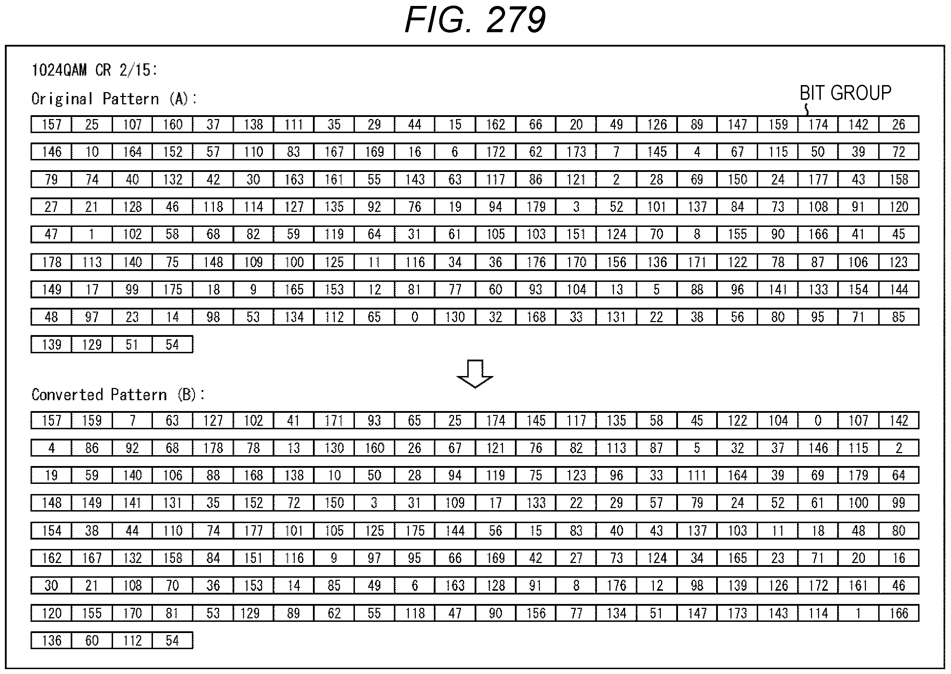

Fig. 279 is a diagram showing an example of a GW pattern for an LDPC code having a code length N of 64k bits with the modulation system set to 1024QAM and the coding rate r set to 2/15.

According to the original GW pattern (A) in Fig. 279, arrangement of bit groups 0 through 179 of the 64k-bit LDPC code is interleaved to arrangement of bit groups 157, 25, 107, 160, 37, 138, 111, 35, 29, 44, 15, 162, 66, 20, 49, 126, 89, 147, 159, 174, 142, 26, 146, 10, 164, 152, 57, 110, 83, 167, 169, 16, 6, 172, 62, 173, 7, 145, 4, 67, 115, 50, 39, 72, 79, 74, 40, 132, 42, 30, 163, 161, 55, 143, 63, 117, 86, 121, 2, 28, 69, 150, 24, 177, 43, 158, 27, 21, 128, 46, 118, 114, 127, 135, 92, 76, 19, 94, 179, 3, 52, 101, 137, 84, 73, 108, 91, 120, 47, 1, 102, 58, 68, 82, 59, 119, 64, 31, 61, 105, 103, 151, 124, 70, 8, 155, 90, 166, 41, 45, 178, 113, 140, 75, 148, 109, 100, 125, 11, 116, 34, 36, 176, 170, 156, 136, 171, 122, 78, 87, 106, 123, 149, 17, 99, 175, 18, 9, 165, 153, 12, 81, 77, 60, 93, 104, 13, 5, 88, 96, 141, 133, 154, 144, 48, 97, 23, 14, 98, 53, 134, 112, 65, 0, 130, 32, 168, 33, 131, 22, 38, 56, 80, 95, 71, 85, 139, 129, 51, 54.

According to the converted GW pattern (B) in Fig. 279, arrangement of bit groups 0 through 179 of the 64k-bit LDPC code is interleaved to arrangement of bit groups 157, 159, 7, 63, 127, 102, 41, 171, 93, 65, 25, 174, 145, 117, 135, 58, 45, 122, 104, 0, 107, 142, 4, 86, 92, 68, 178, 78, 13, 130, 160, 26, 67, 121, 76, 82, 113, 87, 5, 32, 37, 146, 115, 2, 19, 59, 140, 106, 88, 168, 138, 10, 50, 28, 94, 119, 75, 123, 96, 33, 111, 164, 39, 69, 179, 64, 148, 149, 141, 131, 35, 152, 72, 150, 3, 31, 109, 17, 133, 22, 29, 57, 79, 24, 52, 61, 100, 99, 154, 38, 44, 110, 74, 177, 101, 105, 125, 175, 144, 56, 15, 83, 40, 43, 137, 103, 11, 18, 48, 80, 162, 167, 132, 158, 84, 151, 116, 9, 97, 95, 66, 169, 42, 27, 73, 124, 34, 165, 23, 71, 20, 16, 30, 21, 108, 70, 36, 153, 14, 85, 49, 6, 163, 128, 91, 8, 176, 12, 98, 139, 126, 172, 161, 46, 120, 155, 170, 81, 53, 129, 89, 62, 55, 118, 47, 90, 156, 77, 134, 51, 147, 173, 143, 114, 1, 166, 136, 60, 112, 54.

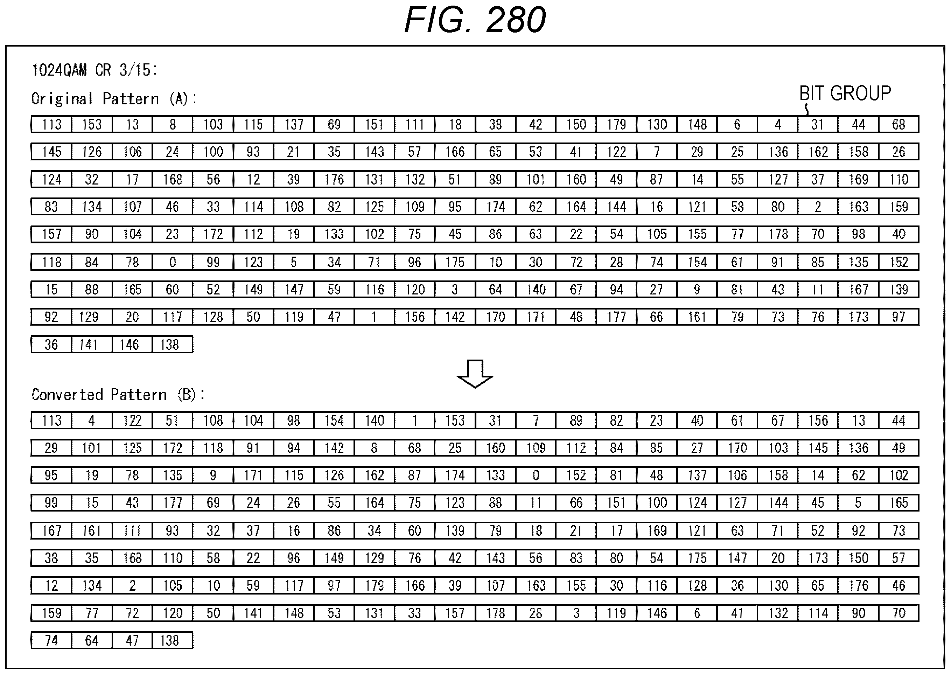

Fig. 280 is a diagram showing an example of a GW pattern for an LDPC code having a code length N of 64k bits with the modulation system set to 1024QAM and the coding rate r set to 3/15.

According to the original GW pattern (A) in Fig. 280, arrangement of bit groups 0 through 179 of the 64k-bit LDPC code is interleaved to arrangement of bit groups 113, 153, 13, 8, 103, 115, 137, 69, 151, 111, 18, 38, 42, 150, 179, 130, 148, 6, 4, 31, 44, 68, 145, 126, 106, 24, 100, 93, 21, 35, 143, 57, 166, 65, 53, 41, 122, 7, 29, 25, 136, 162, 158, 26, 124, 32, 17, 168, 56, 12, 39, 176, 131, 132, 51, 89, 101, 160, 49, 87, 14, 55, 127, 37, 169, 110, 83, 134, 107, 46, 33, 114, 108, 82, 125, 109, 95, 174, 62, 164, 144, 16, 121, 58, 80, 2, 163, 159, 157, 90, 104, 23, 172, 112, 19, 133, 102, 75, 45, 86, 63, 22, 54, 105, 155, 77, 178, 70, 98, 40, 118, 84, 78, 0, 99, 123, 5, 34, 71, 96, 175, 10, 30, 72, 28, 74, 154, 61, 91, 85, 135, 152, 15, 88, 165, 60, 52, 149, 147, 59, 116, 120, 3, 64, 140, 67, 94, 27, 9, 81, 43, 11, 167, 139, 92, 129, 20, 117, 128, 50, 119, 47, 1, 156, 142, 170, 171, 48, 177, 66, 161, 79, 73, 76, 173, 97, 36, 141, 146, 138.

According to the converted GW pattern (B) in Fig. 280, arrangement of bit groups 0 through 179 of the 64k-bit LDPC code is interleaved to arrangement of bit groups 113, 4, 122, 51, 108, 104, 98, 154, 140, 1, 153, 31, 7, 89, 82, 23, 40, 61, 67, 156, 13, 44, 29, 101, 125, 172, 118, 91, 94, 142, 8, 68, 25, 160, 109, 112, 84, 85, 27, 170, 103, 145, 136, 49, 95, 19, 78, 135, 9, 171, 115, 126, 162, 87, 174, 133, 0, 152, 81, 48, 137, 106, 158, 14, 62, 102, 99, 15, 43, 177, 69, 24, 26, 55, 164, 75, 123, 88, 11, 66, 151, 100, 124, 127, 144, 45, 5, 165, 167, 161, 111, 93, 32, 37, 16, 86, 34, 60, 139, 79, 18, 21, 17, 169, 121, 63, 71, 52, 92, 73, 38, 35, 168, 110, 58, 22, 96, 149, 129, 76, 42, 143, 56, 83, 80, 54, 175, 147, 20, 173, 150, 57, 12, 134, 2, 105, 10, 59, 117, 97, 179, 166, 39, 107, 163, 155, 30, 116, 128, 36, 130, 65, 176, 46, 159, 77, 72, 120, 50, 141, 148, 53, 131, 33, 157, 178, 28, 3, 119, 146, 6, 41, 132, 114, 90, 70, 74, 64, 47, 138.

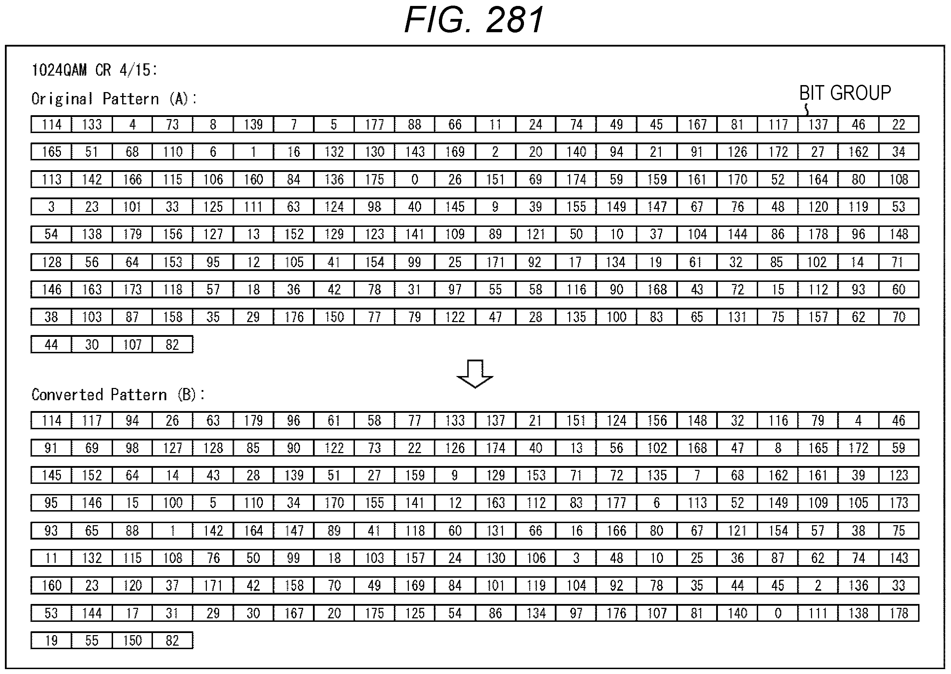

Fig. 281 is a diagram showing an example of a GW pattern for an LDPC code having a code length N of 64k bits with the modulation system set to 1024QAM and the coding rate r set to 4/15.

According to the original GW pattern (A) in Fig. 281, arrangement of bit groups 0 through 179 of the 64k-bit LDPC code is interleaved to arrangement of bit groups 114, 133, 4, 73, 8, 139, 7, 5, 177, 88, 66, 11, 24, 74, 49, 45, 167, 81, 117, 137, 46, 22, 165, 51, 68, 110, 6, 1, 16, 132, 130, 143, 169, 2, 20, 140, 94, 21, 91, 126, 172, 27, 162, 34, 113, 142, 166, 115, 106, 160, 84, 136, 175, 0, 26, 151, 69, 174, 59, 159, 161, 170, 52, 164, 80, 108, 3, 23, 101, 33, 125, 111, 63, 124, 98, 40, 145, 9, 39, 155, 149, 147, 67, 76, 48, 120, 119, 53, 54, 138, 179, 156, 127, 13, 152, 129, 123, 141, 109, 89, 121, 50, 10, 37, 104, 144, 86, 178, 96, 148, 128, 56, 64, 153, 95, 12, 105, 41, 154, 99, 25, 171, 92, 17, 134, 19, 61, 32, 85, 102, 14, 71, 146, 163, 173, 118, 57, 18, 36, 42, 78, 31, 97, 55, 58, 116, 90, 168, 43, 72, 15, 112, 93, 60, 38, 103, 87, 158, 35, 29, 176, 150, 77, 79, 122, 47, 28, 135, 100, 83, 65, 131, 75, 157, 62, 70, 44, 30, 107, 82.

According to the converted GW pattern (B) in Fig. 281, arrangement of bit groups 0 through 179 of the 64k-bit LDPC code is interleaved to arrangement of bit groups 114, 117, 94, 26, 63, 179, 96, 61, 58, 77, 133, 137, 21, 151, 124, 156, 148, 32, 116, 79, 4, 46, 91, 69, 98, 127, 128, 85, 90, 122, 73, 22, 126, 174, 40, 13, 56, 102, 168, 47, 8, 165, 172, 59, 145, 152, 64, 14, 43, 28, 139, 51, 27, 159, 9, 129, 153, 71, 72, 135, 7, 68, 162, 161, 39, 123, 95, 146, 15, 100, 5, 110, 34, 170, 155, 141, 12, 163, 112, 83, 177, 6, 113, 52, 149, 109, 105, 173, 93, 65, 88, 1, 142, 164, 147, 89, 41, 118, 60, 131, 66, 16, 166, 80, 67, 121, 154, 57, 38, 75, 11, 132, 115, 108, 76, 50, 99, 18, 103, 157, 24, 130, 106, 3, 48, 10, 25, 36, 87, 62, 74, 143, 160, 23, 120, 37, 171, 42, 158, 70, 49, 169, 84, 101, 119, 104, 92, 78, 35, 44, 45, 2, 136, 33, 53, 144, 17, 31, 29, 30, 167, 20, 175, 125, 54, 86, 134, 97, 176, 107, 81, 140, 0, 111, 138, 178, 19, 55, 150, 82.

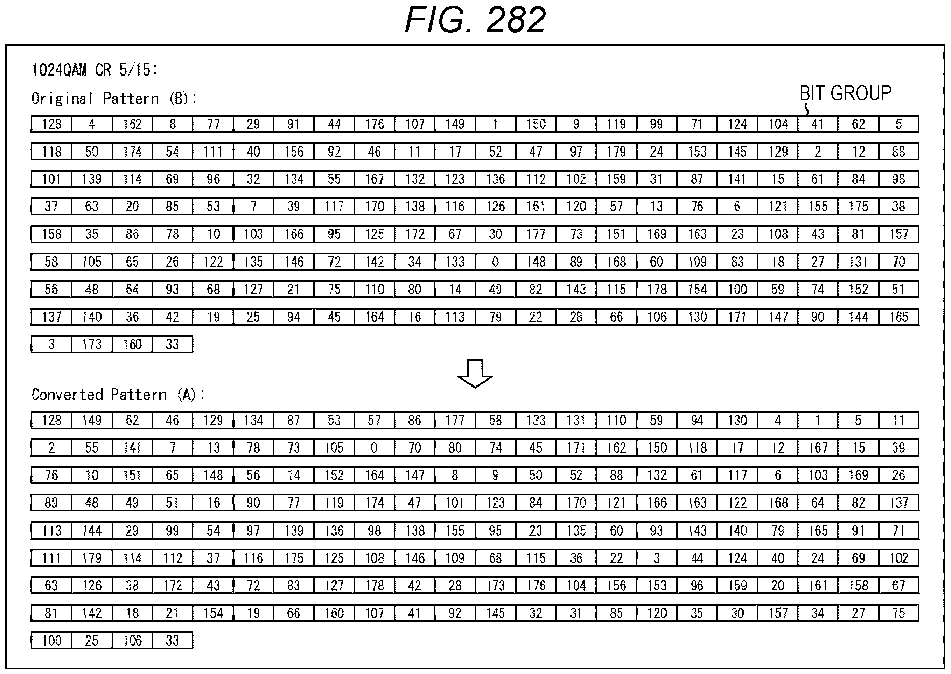

Fig. 282 is a diagram showing an example of a GW pattern for an LDPC code having a code length N of 64k bits with the modulation system set to 1024QAM and the coding rate r set to 5/15.

According to the original GW pattern (B) in Fig. 282, arrangement of bit groups 0 through 179 of the 64k-bit LDPC code is interleaved to arrangement of bit groups 128, 4, 162, 8, 77, 29, 91, 44, 176, 107, 149, 1, 150, 9, 119, 99, 71, 124, 104, 41, 62, 5, 118, 50, 174, 54, 111, 40, 156, 92, 46, 11, 17, 52, 47, 97, 179, 24, 153, 145, 129, 2, 12, 88, 101, 139, 114, 69, 96, 32, 134, 55, 167, 132, 123, 136, 112, 102, 159, 31, 87, 141, 15, 61, 84, 98, 37, 63, 20, 85, 53, 7, 39, 117, 170, 138, 116, 126, 161, 120, 57, 13, 76, 6, 121, 155, 175, 38, 158, 35, 86, 78, 10, 103, 166, 95, 125, 172, 67, 30, 177, 73, 151, 169, 163, 23, 108, 43, 81, 157, 58, 105, 65, 26, 122, 135, 146, 72, 142, 34, 133, 0, 148, 89, 168, 60, 109, 83, 18, 27, 131, 70, 56, 48, 64, 93, 68, 127, 21, 75, 110, 80, 14, 49, 82, 143, 115, 178, 154, 100, 59, 74, 152, 51, 137, 140, 36, 42, 19, 25, 94, 45, 164, 16, 113, 79, 22, 28, 66, 106, 130, 171, 147, 90, 144, 165, 3, 173, 160, 33.

According to the converted GW pattern (A) in Fig. 282, arrangement of bit groups 0 through 179 of the 64k-bit LDPC code is interleaved to arrangement of bit groups 128, 149, 62, 46, 129, 134, 87, 53, 57, 86, 177, 58, 133, 131, 110, 59, 94, 130, 4, 1, 5, 11, 2, 55, 141, 7, 13, 78, 73, 105, 0, 70, 80, 74, 45, 171, 162, 150, 118, 17, 12, 167, 15, 39, 76, 10, 151, 65, 148, 56, 14, 152, 164, 147, 8, 9, 50, 52, 88, 132, 61, 117, 6, 103, 169, 26, 89, 48, 49, 51, 16, 90, 77, 119, 174, 47, 101, 123, 84, 170, 121, 166, 163, 122, 168, 64, 82, 137, 113, 144, 29, 99, 54, 97, 139, 136, 98, 138, 155, 95, 23, 135, 60, 93, 143, 140, 79, 165, 91, 71, 111, 179, 114, 112, 37, 116, 175, 125, 108, 146, 109, 68, 115, 36, 22, 3, 44, 124, 40, 24, 69, 102, 63, 126, 38, 172, 43, 72, 83, 127, 178, 42, 28, 173, 176, 104, 156, 153, 96, 159, 20, 161, 158, 67, 81, 142, 18, 21, 154, 19, 66, 160, 107, 41, 92, 145, 32, 31, 85, 120, 35, 30, 157, 34, 27, 75, 100, 25, 106, 33.

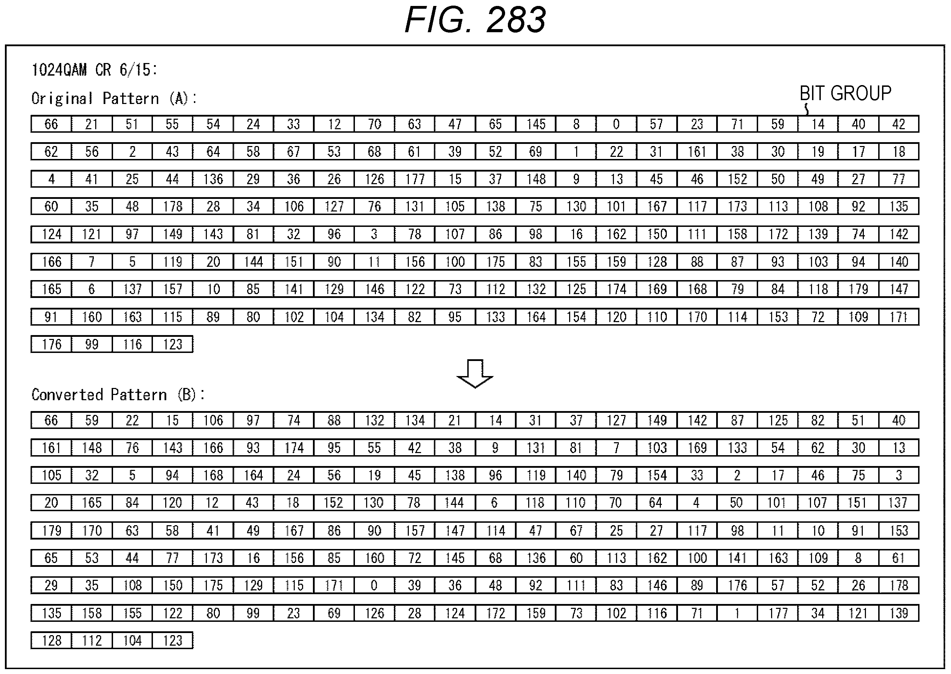

Fig. 283 is a diagram showing an example of a GW pattern for an LDPC code having a code length N of 64k bits with the modulation system set to 1024QAM and the coding rate r set to 6/15.

According to the original GW pattern (A) in Fig. 283, arrangement of bit groups 0 through 179 of the 64k-bit LDPC code is interleaved to arrangement of bit groups 66, 21, 51, 55, 54, 24, 33, 12, 70, 63, 47, 65, 145, 8, 0, 57, 23, 71, 59, 14, 40, 42, 62, 56, 2, 43, 64, 58, 67, 53, 68, 61, 39, 52, 69, 1, 22, 31, 161, 38, 30, 19, 17, 18, 4, 41, 25, 44, 136, 29, 36, 26, 126, 177, 15, 37, 148, 9, 13, 45, 46, 152, 50, 49, 27, 77, 60, 35, 48, 178, 28, 34, 106, 127, 76, 131, 105, 138, 75, 130, 101, 167, 117, 173, 113, 108, 92, 135, 124, 121, 97, 149, 143, 81, 32, 96, 3, 78, 107, 86, 98, 16, 162, 150, 111, 158, 172, 139, 74, 142, 166, 7, 5, 119, 20, 144, 151, 90, 11, 156, 100, 175, 83, 155, 159, 128, 88, 87, 93, 103, 94, 140, 165, 6, 137, 157, 10, 85, 141, 129, 146, 122, 73, 112, 132, 125, 174, 169, 168, 79, 84, 118, 179, 147, 91, 160, 163, 115, 89, 80, 102, 104, 134, 82, 95, 133, 164, 154, 120, 110, 170, 114, 153, 72, 109, 171, 176, 99, 116, 123.

According to the converted GW pattern (B) in Fig. 283, arrangement of bit groups 0 through 179 of the 64k-bit LDPC code is interleaved to arrangement of bit groups 66, 59, 22, 15, 106, 97, 74, 88, 132, 134, 21, 14, 31, 37, 127, 149, 142, 87, 125, 82, 51, 40, 161, 148, 76, 143, 166, 93, 174, 95, 55, 42, 38, 9, 131, 81, 7, 103, 169, 133, 54, 62, 30, 13, 105, 32, 5, 94, 168, 164, 24, 56, 19, 45, 138, 96, 119, 140, 79, 154, 33, 2, 17, 46, 75, 3, 20, 165, 84, 120, 12, 43, 18, 152, 130, 78, 144, 6, 118, 110, 70, 64, 4, 50, 101, 107, 151, 137, 179, 170, 63, 58, 41, 49, 167, 86, 90, 157, 147, 114, 47, 67, 25, 27, 117, 98, 11, 10, 91, 153, 65, 53, 44, 77, 173, 16, 156, 85, 160, 72, 145, 68, 136, 60, 113, 162, 100, 141, 163, 109, 8, 61, 29, 35, 108, 150, 175, 129, 115, 171, 0, 39, 36, 48, 92, 111, 83, 146, 89, 176, 57, 52, 26, 178, 135, 158, 155, 122, 80, 99, 23, 69, 126, 28, 124, 172, 159, 73, 102, 116, 71, 1, 177, 34, 121, 139, 128, 112, 104, 123.

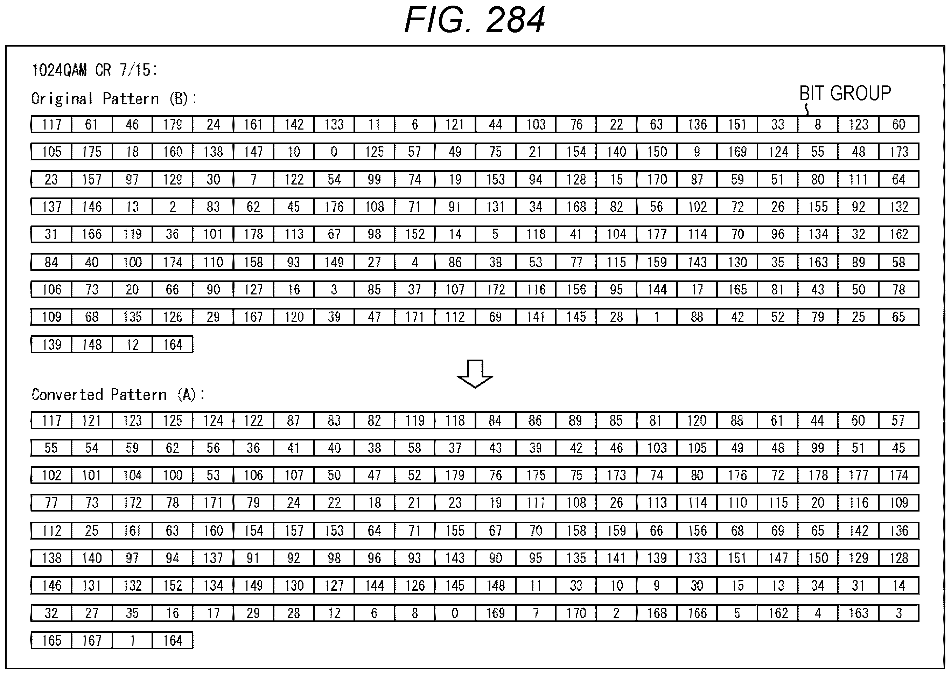

Fig. 284 is a diagram showing an example of a GW pattern for an LDPC code having a code length N of 64k bits with the modulation system set to 1024QAM and the coding rate r set to 7/15.

According to the original GW pattern (B) in Fig. 284, arrangement of bit groups 0 through 179 of the 64k-bit LDPC code is interleaved to arrangement of bit groups 117, 61, 46, 179, 24, 161, 142, 133, 11, 6, 121, 44, 103, 76, 22, 63, 136, 151, 33, 8, 123, 60, 105, 175, 18, 160, 138, 147, 10, 0, 125, 57, 49, 75, 21, 154, 140, 150, 9, 169, 124, 55, 48, 173, 23, 157, 97, 129, 30, 7, 122, 54, 99, 74, 19, 153, 94, 128, 15, 170, 87, 59, 51, 80, 111, 64, 137, 146, 13, 2, 83, 62, 45, 176, 108, 71, 91, 131, 34, 168, 82, 56, 102, 72, 26, 155, 92, 132, 31, 166, 119, 36, 101, 178, 113, 67, 98, 152, 14, 5, 118, 41, 104, 177, 114, 70, 96, 134, 32, 162, 84, 40, 100, 174, 110, 158, 93, 149, 27, 4, 86, 38, 53, 77, 115, 159, 143, 130, 35, 163, 89, 58, 106, 73, 20, 66, 90, 127, 16, 3, 85, 37, 107, 172, 116, 156, 95, 144, 17, 165, 81, 43, 50, 78, 109, 68, 135, 126, 29, 167, 120, 39, 47, 171, 112, 69, 141, 145, 28, 1, 88, 42, 52, 79, 25, 65, 139, 148, 12, 164.

According to the converted GW pattern (A) in Fig. 284, arrangement of bit groups 0 through 179 of the 64k-bit LDPC code is interleaved to arrangement of bit groups 117, 121, 123, 125, 124, 122, 87, 83, 82, 119, 118, 84, 86, 89, 85, 81, 120, 88, 61, 44, 60, 57, 55, 54, 59, 62, 56, 36, 41, 40, 38, 58, 37, 43, 39, 42, 46, 103, 105, 49, 48, 99, 51, 45, 102, 101, 104, 100, 53, 106, 107, 50, 47, 52, 179, 76, 175, 75, 173, 74, 80, 176, 72, 178, 177, 174, 77, 73, 172, 78, 171, 79, 24, 22, 18, 21, 23, 19, 111, 108, 26, 113, 114, 110, 115, 20, 116, 109, 112, 25, 161, 63, 160, 154, 157, 153, 64, 71, 155, 67, 70, 158, 159, 66, 156, 68, 69, 65, 142, 136, 138, 140, 97, 94, 137, 91, 92, 98, 96, 93, 143, 90, 95, 135, 141, 139, 133, 151, 147, 150, 129, 128, 146, 131, 132, 152, 134, 149, 130, 127, 144, 126, 145, 148, 11, 33, 10, 9, 30, 15, 13, 34, 31, 14, 32, 27, 35, 16, 17, 29, 28, 12, 6, 8, 0, 169, 7, 170, 2, 168, 166, 5, 162, 4, 163, 3, 165, 167, 1, 164.

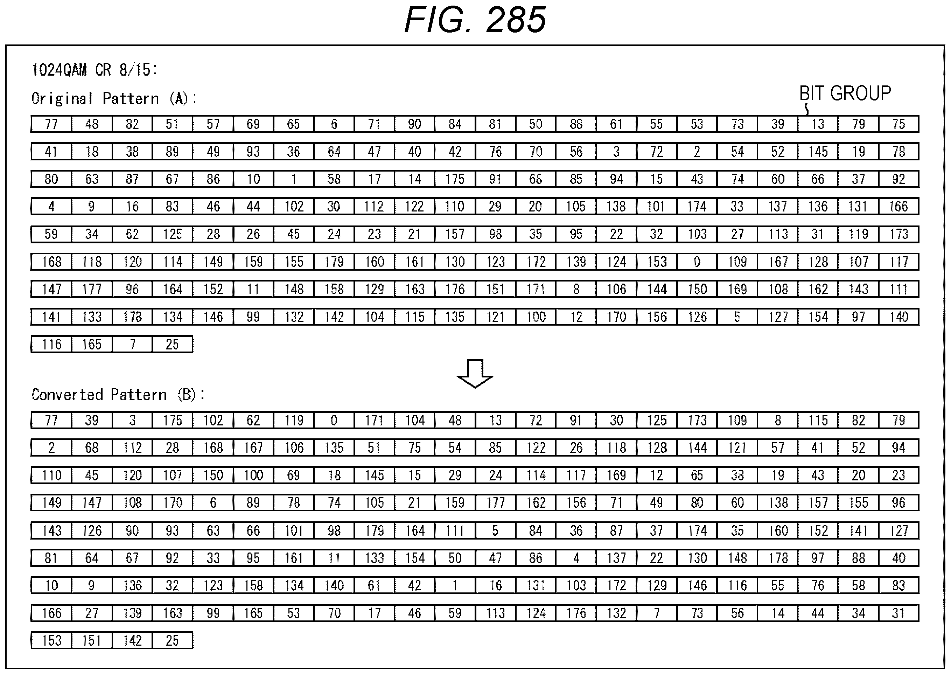

Fig. 285 is a diagram showing an example of a GW pattern for an LDPC code having a code length N of 64k bits with the modulation system set to 1024QAM and the coding rate r set to 8/15.

According to the original GW pattern (A) in Fig. 285, arrangement of bit groups 0 through 179 of the 64k-bit LDPC code is interleaved to arrangement of bit groups 77, 48, 82, 51, 57, 69, 65, 6, 71, 90, 84, 81, 50, 88, 61, 55, 53, 73, 39, 13, 79, 75, 41, 18, 38, 89, 49, 93, 36, 64, 47, 40, 42, 76, 70, 56, 3, 72, 2, 54, 52, 145, 19, 78, 80, 63, 87, 67, 86, 10, 1, 58, 17, 14, 175, 91, 68, 85, 94, 15, 43, 74, 60, 66, 37, 92, 4, 9, 16, 83, 46, 44, 102, 30, 112, 122, 110, 29, 20, 105, 138, 101, 174, 33, 137, 136, 131, 166, 59, 34, 62, 125, 28, 26, 45, 24, 23, 21, 157, 98, 35, 95, 22, 32, 103, 27, 113, 31, 119, 173, 168, 118, 120, 114, 149, 159, 155, 179, 160, 161, 130, 123, 172, 139, 124, 153, 0, 109, 167, 128, 107, 117, 147, 177, 96, 164, 152, 11, 148, 158, 129, 163, 176, 151, 171, 8, 106, 144, 150, 169, 108, 162, 143, 111, 141, 133, 178, 134, 146, 99, 132, 142, 104, 115, 135, 121, 100, 12, 170, 156, 126, 5, 127, 154, 97, 140, 116, 165, 7, 25.

According to the converted GW pattern (B) in Fig. 285, arrangement of bit groups 0 through 179 of the 64k-bit LDPC code is interleaved to arrangement of bit groups 77, 39, 3, 175, 102, 62, 119, 0, 171, 104, 48, 13, 72, 91, 30, 125, 173, 109, 8, 115, 82, 79, 2, 68, 112, 28, 168, 167, 106, 135, 51, 75, 54, 85, 122, 26, 118, 128, 144, 121, 57, 41, 52, 94, 110, 45, 120, 107, 150, 100, 69, 18, 145, 15, 29, 24, 114, 117, 169, 12, 65, 38, 19, 43, 20, 23, 149, 147, 108, 170, 6, 89, 78, 74, 105, 21, 159, 177, 162, 156, 71, 49, 80, 60, 138, 157, 155, 96, 143, 126, 90, 93, 63, 66, 101, 98, 179, 164, 111, 5, 84, 36, 87, 37, 174, 35, 160, 152, 141, 127, 81, 64, 67, 92, 33, 95, 161, 11, 133, 154, 50, 47, 86, 4, 137, 22, 130, 148, 178, 97, 88, 40, 10, 9, 136, 32, 123, 158, 134, 140, 61, 42, 1, 16, 131, 103, 172, 129, 146, 116, 55, 76, 58, 83, 166, 27, 139, 163, 99, 165, 53, 70, 17, 46, 59, 113, 124, 176, 132, 7, 73, 56, 14, 44, 34, 31, 153, 151, 142, 25.

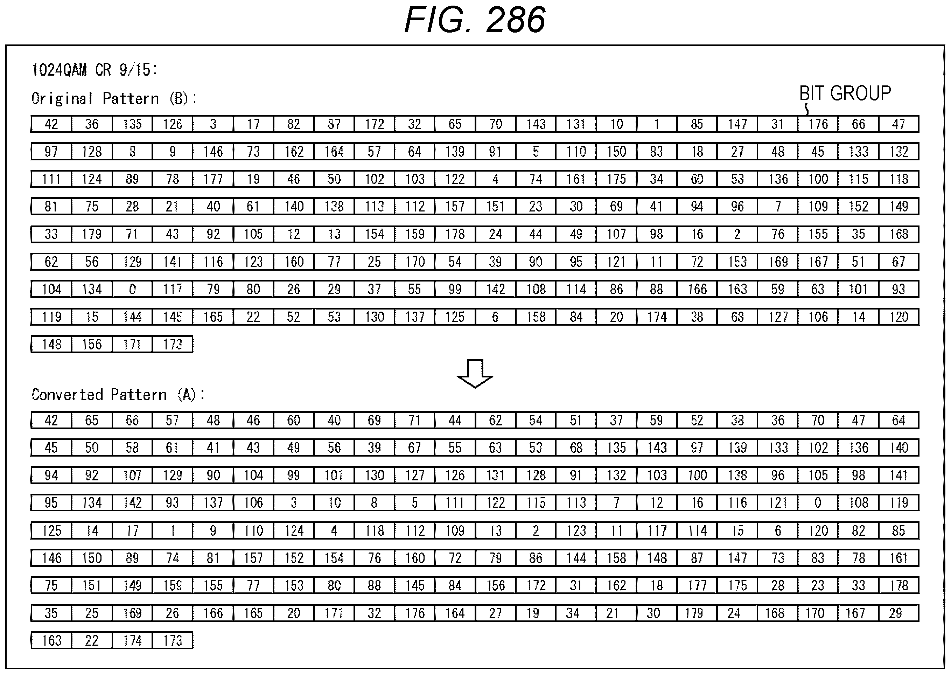

Fig. 286 is a diagram showing an example of a GW pattern for an LDPC code having a code length N of 64k bits with the modulation system set to 1024QAM and the coding rate r set to 9/15.

According to the original GW pattern (B) in Fig. 286, arrangement of bit groups 0 through 179 of the 64k-bit LDPC code is interleaved to arrangement of bit groups 42, 36, 135, 126, 3, 17, 82, 87, 172, 32, 65, 70, 143, 131, 10, 1, 85, 147, 31, 176, 66, 47, 97, 128, 8, 9, 146, 73, 162, 164, 57, 64, 139, 91, 5, 110, 150, 83, 18, 27, 48, 45, 133, 132, 111, 124, 89, 78, 177, 19, 46, 50, 102, 103, 122, 4, 74, 161, 175, 34, 60, 58, 136, 100, 115, 118, 81, 75, 28, 21, 40, 61, 140, 138, 113, 112, 157, 151, 23, 30, 69, 41, 94, 96, 7, 109, 152, 149, 33, 179, 71, 43, 92, 105, 12, 13, 154, 159, 178, 24, 44, 49, 107, 98, 16, 2, 76, 155, 35, 168, 62, 56, 129, 141, 116, 123, 160, 77, 25, 170, 54, 39, 90, 95, 121, 11, 72, 153, 169, 167, 51, 67, 104, 134, 0, 117, 79, 80, 26, 29, 37, 55, 99, 142, 108, 114, 86, 88, 166, 163, 59, 63, 101, 93, 119, 15, 144, 145, 165, 22, 52, 53, 130, 137, 125, 6, 158, 84, 20, 174, 38, 68, 127, 106, 14, 120, 148, 156, 171, 173.

According to the converted GW pattern (A) in Fig. 286, arrangement of bit groups 0 through 179 of the 64k-bit LDPC code is interleaved to arrangement of bit groups 42, 65, 66, 57, 48, 46, 60, 40, 69, 71, 44, 62, 54, 51, 37, 59, 52, 38, 36, 70, 47, 64, 45, 50, 58, 61, 41, 43, 49, 56, 39, 67, 55, 63, 53, 68, 135, 143, 97, 139, 133, 102, 136, 140, 94, 92, 107, 129, 90, 104, 99, 101, 130, 127, 126, 131, 128, 91, 132, 103, 100, 138, 96, 105, 98, 141, 95, 134, 142, 93, 137, 106, 3, 10, 8, 5, 111, 122, 115, 113, 7, 12, 16, 116, 121, 0, 108, 119, 125, 14, 17, 1, 9, 110, 124, 4, 118, 112, 109, 13, 2, 123, 11, 117, 114, 15, 6, 120, 82, 85, 146, 150, 89, 74, 81, 157, 152, 154, 76, 160, 72, 79, 86, 144, 158, 148, 87, 147, 73, 83, 78, 161, 75, 151, 149, 159, 155, 77, 153, 80, 88, 145, 84, 156, 172, 31, 162, 18, 177, 175, 28, 23, 33, 178, 35, 25, 169, 26, 166, 165, 20, 171, 32, 176, 164, 27, 19, 34, 21, 30, 179, 24, 168, 170, 167, 29, 163, 22, 174, 173.

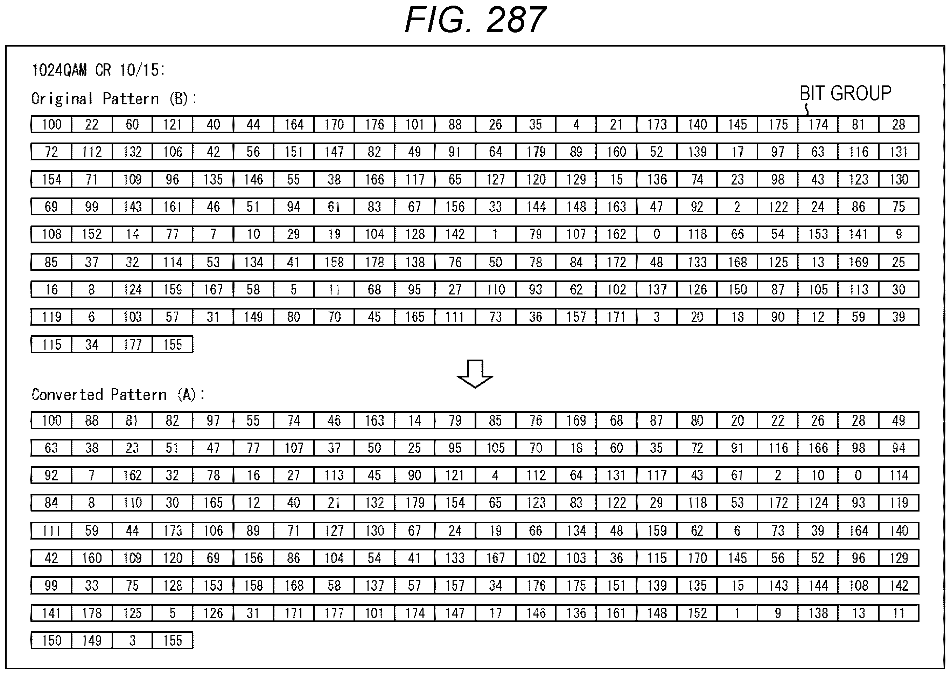

Fig. 287 is a diagram showing an example of a GW pattern for an LDPC code having a code length N of 64k bits with the modulation system set to 1024QAM and the coding rate r set to 10/15.

According to the original GW pattern (B) in Fig. 287, arrangement of bit groups 0 through 179 of the 64k-bit LDPC code is interleaved to arrangement of bit groups 100, 22, 60, 121, 40, 44, 164, 170, 176, 101, 88, 26, 35, 4, 21, 173, 140, 145, 175, 174, 81, 28, 72, 112, 132, 106, 42, 56, 151, 147, 82, 49, 91, 64, 179, 89, 160, 52, 139, 17, 97, 63, 116, 131, 154, 71, 109, 96, 135, 146, 55, 38, 166, 117, 65, 127, 120, 129, 15, 136, 74, 23, 98, 43, 123, 130, 69, 99, 143, 161, 46, 51, 94, 61, 83, 67, 156, 33, 144, 148, 163, 47, 92, 2, 122, 24, 86, 75, 108, 152, 14, 77, 7, 10, 29, 19, 104, 128, 142, 1, 79, 107, 162, 0, 118, 66, 54, 153, 141, 9, 85, 37, 32, 114, 53, 134, 41, 158, 178, 138, 76, 50, 78, 84, 172, 48, 133, 168, 125, 13, 169, 25, 16, 8, 124, 159, 167, 58, 5, 11, 68, 95, 27, 110, 93, 62, 102, 137, 126, 150, 87, 105, 113, 30, 119, 6, 103, 57, 31, 149, 80, 70, 45, 165, 111, 73, 36, 157, 171, 3, 20, 18, 90, 12, 59, 39, 115, 34, 177, 155.

According to the converted GW pattern (A) in Fig. 287, arrangement of bit groups 0 through 179 of the 64k-bit LDPC code is interleaved to arrangement of bit groups 100, 88, 81, 82, 97, 55, 74, 46, 163, 14, 79, 85, 76, 169, 68, 87, 80, 20, 22, 26, 28, 49, 63, 38, 23, 51, 47, 77, 107, 37, 50, 25, 95, 105, 70, 18, 60, 35, 72, 91, 116, 166, 98, 94, 92, 7, 162, 32, 78, 16, 27, 113, 45, 90, 121, 4, 112, 64, 131, 117, 43, 61, 2, 10, 0, 114, 84, 8, 110, 30, 165, 12, 40, 21, 132, 179, 154, 65, 123, 83, 122, 29, 118, 53, 172, 124, 93, 119, 111, 59, 44, 173, 106, 89, 71, 127, 130, 67, 24, 19, 66, 134, 48, 159, 62, 6, 73, 39, 164, 140, 42, 160, 109, 120, 69, 156, 86, 104, 54, 41, 133, 167, 102, 103, 36, 115, 170, 145, 56, 52, 96, 129, 99, 33, 75, 128, 153, 158, 168, 58, 137, 57, 157, 34, 176, 175, 151, 139, 135, 15, 143, 144, 108, 142, 141, 178, 125, 5, 126, 31, 171, 177, 101, 174, 147, 17, 146, 136, 161, 148, 152, 1, 9, 138, 13, 11, 150, 149, 3, 155.

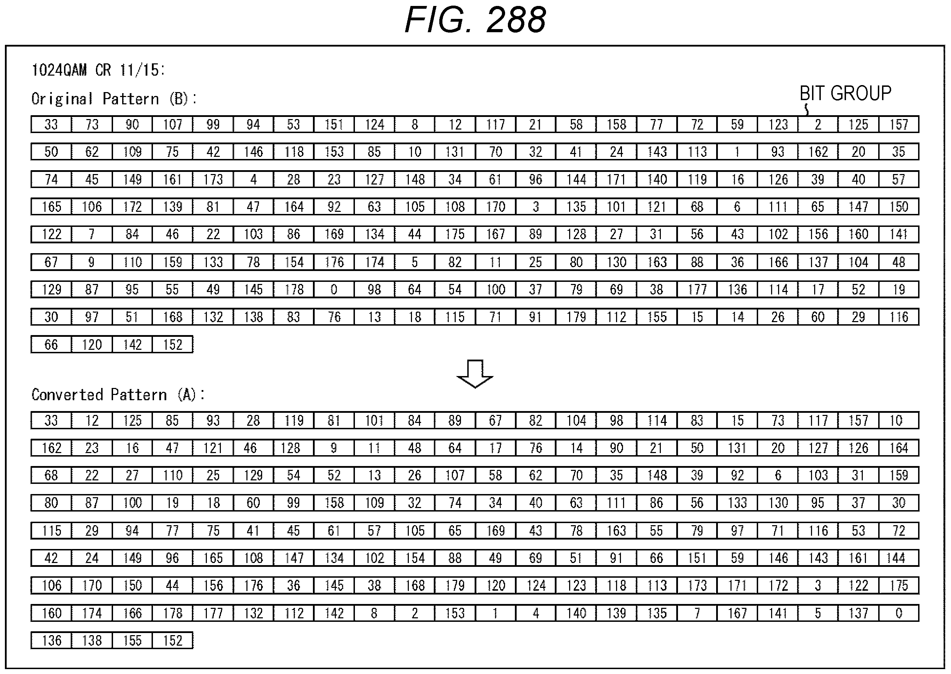

Fig. 288 is a diagram showing an example of a GW pattern for an LDPC code having a code length N of 64k bits with the modulation system set to 1024QAM and the coding rate r set to 11/15.

According to the original GW pattern (B) in Fig. 288, arrangement of bit groups 0 through 179 of the 64k-bit LDPC code is interleaved to arrangement of bit groups 33, 73, 90, 107, 99, 94, 53, 151, 124, 8, 12, 117, 21, 58, 158, 77, 72, 59, 123, 2, 125, 157, 50, 62, 109, 75, 42, 146, 118, 153, 85, 10, 131, 70, 32, 41, 24, 143, 113, 1, 93, 162, 20, 35, 74, 45, 149, 161, 173, 4, 28, 23, 127, 148, 34, 61, 96, 144, 171, 140, 119, 16, 126, 39, 40, 57, 165, 106, 172, 139, 81, 47, 164, 92, 63, 105, 108, 170, 3, 135, 101, 121, 68, 6, 111, 65, 147, 150, 122, 7, 84, 46, 22, 103, 86, 169, 134, 44, 175, 167, 89, 128, 27, 31, 56, 43, 102, 156, 160, 141, 67, 9, 110, 159, 133, 78, 154, 176, 174, 5, 82, 11, 25, 80, 130, 163, 88, 36, 166, 137, 104, 48, 129, 87, 95, 55, 49, 145, 178, 0, 98, 64, 54, 100, 37, 79, 69, 38, 177, 136, 114, 17, 52, 19, 30, 97, 51, 168, 132, 138, 83, 76, 13, 18, 115, 71, 91, 179, 112, 155, 15, 14, 26, 60, 29, 116, 66, 120, 142, 152.

According to the converted GW pattern (A) in Fig. 288, arrangement of bit groups 0 through 179 of the 64k-bit LDPC code is interleaved to arrangement of bit groups 33, 12, 125, 85, 93, 28, 119, 81, 101, 84, 89, 67, 82, 104, 98, 114, 83, 15, 73, 117, 157, 10, 162, 23, 16, 47, 121, 46, 128, 9, 11, 48, 64, 17, 76, 14, 90, 21, 50, 131, 20, 127, 126, 164, 68, 22, 27, 110, 25, 129, 54, 52, 13, 26, 107, 58, 62, 70, 35, 148, 39, 92, 6, 103, 31, 159, 80, 87, 100, 19, 18, 60, 99, 158, 109, 32, 74, 34, 40, 63, 111, 86, 56, 133, 130, 95, 37, 30, 115, 29, 94, 77, 75, 41, 45, 61, 57, 105, 65, 169, 43, 78, 163, 55, 79, 97, 71, 116, 53, 72, 42, 24, 149, 96, 165, 108, 147, 134, 102, 154, 88, 49, 69, 51, 91, 66, 151, 59, 146, 143, 161, 144, 106, 170, 150, 44, 156, 176, 36, 145, 38, 168, 179, 120, 124, 123, 118, 113, 173, 171, 172, 3, 122, 175, 160, 174, 166, 178, 177, 132, 112, 142, 8, 2, 153, 1, 4, 140, 139, 135, 7, 167, 141, 5, 137, 0, 136, 138, 155, 152.

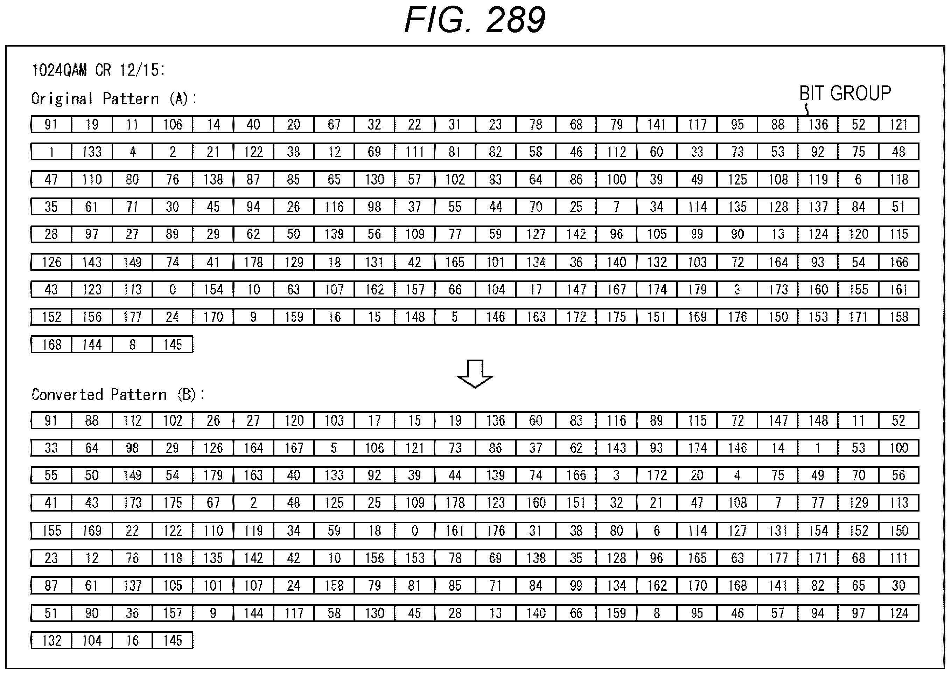

Fig. 289 is a diagram showing an example of a GW pattern for an LDPC code having a code length N of 64k bits with the modulation system set to 1024QAM and the coding rate r set to 12/15.

According to the original GW pattern (A) in Fig. 289, arrangement of bit groups 0 through 179 of the 64k-bit LDPC code is interleaved to arrangement of bit groups 91, 19, 11, 106, 14, 40, 20, 67, 32, 22, 31, 23, 78, 68, 79, 141, 117, 95, 88, 136, 52, 121, 1, 133, 4, 2, 21, 122, 38, 12, 69, 111, 81, 82, 58, 46, 112, 60, 33, 73, 53, 92, 75, 48, 47, 110, 80, 76, 138, 87, 85, 65, 130, 57, 102, 83, 64, 86, 100, 39, 49, 125, 108, 119, 6, 118, 35, 61, 71, 30, 45, 94, 26, 116, 98, 37, 55, 44, 70, 25, 7, 34, 114, 135, 128, 137, 84, 51, 28, 97, 27, 89, 29, 62, 50, 139, 56, 109, 77, 59, 127, 142, 96, 105, 99, 90, 13, 124, 120, 115, 126, 143, 149, 74, 41, 178, 129, 18, 131, 42, 165, 101, 134, 36, 140, 132, 103, 72, 164, 93, 54, 166, 43, 123, 113, 0, 154, 10, 63, 107, 162, 157, 66, 104, 17, 147, 167, 174, 179, 3, 173, 160, 155, 161, 152, 156, 177, 24, 170, 9, 159, 16, 15, 148, 5, 146, 163, 172, 175, 151, 169, 176, 150, 153, 171, 158, 168, 144, 8, 145.

According to the converted GW pattern (B) in Fig. 289, arrangement of bit groups 0 through 179 of the 64k-bit LDPC code is interleaved to arrangement of bit groups 91, 88, 112, 102, 26, 27, 120, 103, 17, 15, 19, 136, 60, 83, 116, 89, 115, 72, 147, 148, 11, 52, 33, 64, 98, 29, 126, 164, 167, 5, 106, 121, 73, 86, 37, 62, 143, 93, 174, 146, 14, 1, 53, 100, 55, 50, 149, 54, 179, 163, 40, 133, 92, 39, 44, 139, 74, 166, 3, 172, 20, 4, 75, 49, 70, 56, 41, 43, 173, 175, 67, 2, 48, 125, 25, 109, 178, 123, 160, 151, 32, 21, 47, 108, 7, 77, 129, 113, 155, 169, 22, 122, 110, 119, 34, 59, 18, 0, 161, 176, 31, 38, 80, 6, 114, 127, 131, 154, 152, 150, 23, 12, 76, 118, 135, 142, 42, 10, 156, 153, 78, 69, 138, 35, 128, 96, 165, 63, 177, 171, 68, 111, 87, 61, 137, 105, 101, 107, 24, 158, 79, 81, 85, 71, 84, 99, 134, 162, 170, 168, 141, 82, 65, 30, 51, 90, 36, 157, 9, 144, 117, 58, 130, 45, 28, 13, 140, 66, 159, 8, 95, 46, 57, 94, 97, 124, 132, 104, 16, 145.

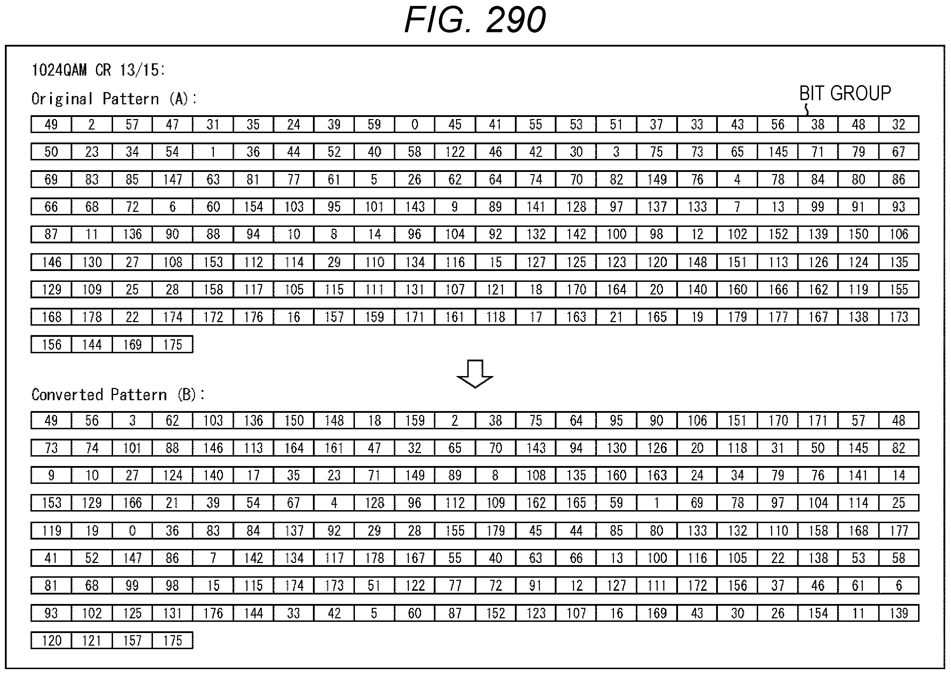

Fig. 290 is a diagram showing an example of a GW pattern for an LDPC code having a code length N of 64k bits with the modulation system set to 1024QAM and the coding rate r set to 13/15.

According to the original GW pattern (A) in Fig. 290, arrangement of bit groups 0 through 179 of the 64k-bit LDPC code is interleaved to arrangement of bit groups 49, 2, 57, 47, 31, 35, 24, 39, 59, 0, 45, 41, 55, 53, 51, 37, 33, 43, 56, 38, 48, 32, 50, 23, 34, 54, 1, 36, 44, 52, 40, 58, 122, 46, 42, 30, 3, 75, 73, 65, 145, 71, 79, 67, 69, 83, 85, 147, 63, 81, 77, 61, 5, 26, 62, 64, 74, 70, 82, 149, 76, 4, 78, 84, 80, 86, 66, 68, 72, 6, 60, 154, 103, 95, 101, 143, 9, 89, 141, 128, 97, 137, 133, 7, 13, 99, 91, 93, 87, 11, 136, 90, 88, 94, 10, 8, 14, 96, 104, 92, 132, 142, 100, 98, 12, 102, 152, 139, 150, 106, 146, 130, 27, 108, 153, 112, 114, 29, 110, 134, 116, 15, 127, 125, 123, 120, 148, 151, 113, 126, 124, 135, 129, 109, 25, 28, 158, 117, 105, 115, 111, 131, 107, 121, 18, 170, 164, 20, 140, 160, 166, 162, 119, 155, 168, 178, 22, 174, 172, 176, 16, 157, 159, 171, 161, 118, 17, 163, 21, 165, 19, 179, 177, 167, 138, 173, 156, 144, 169, 175.

According to the converted GW pattern (B) in Fig. 290, arrangement of bit groups 0 through 179 of the 64k-bit LDPC code is interleaved to arrangement of bit groups 49, 56, 3, 62, 103, 136, 150, 148, 18, 159, 2, 38, 75, 64, 95, 90, 106, 151, 170, 171, 57, 48, 73, 74, 101, 88, 146, 113, 164, 161, 47, 32, 65, 70, 143, 94, 130, 126, 20, 118, 31, 50, 145, 82, 9, 10, 27, 124, 140, 17, 35, 23, 71, 149, 89, 8, 108, 135, 160, 163, 24, 34, 79, 76, 141, 14, 153, 129, 166, 21, 39, 54, 67, 4, 128, 96, 112, 109, 162, 165, 59, 1, 69, 78, 97, 104, 114, 25, 119, 19, 0, 36, 83, 84, 137, 92, 29, 28, 155, 179, 45, 44, 85, 80, 133, 132, 110, 158, 168, 177, 41, 52, 147, 86, 7, 142, 134, 117, 178, 167, 55, 40, 63, 66, 13, 100, 116, 105, 22, 138, 53, 58, 81, 68, 99, 98, 15, 115, 174, 173, 51, 122, 77, 72, 91, 12, 127, 111, 172, 156, 37, 46, 61, 6, 93, 102, 125, 131, 176, 144, 33, 42, 5, 60, 87, 152, 123, 107, 16, 169, 43, 30, 26, 154, 11, 139, 120, 121, 157, 175.

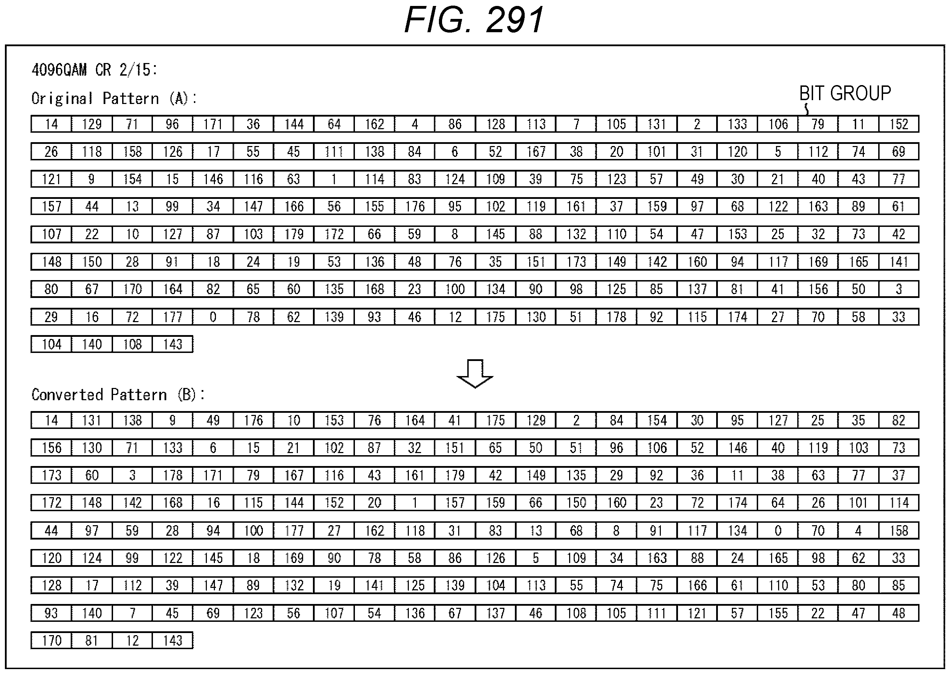

Fig. 291 is a diagram showing an example of a GW pattern for an LDPC code having a code length N of 64k bits with the modulation system set to 4096QAM and the coding rate r set to 2/15.

According to the original GW pattern (A) in Fig. 291, arrangement of bit groups 0 through 179 of the 64k-bit LDPC code is interleaved to arrangement of bit groups 14, 129, 71, 96, 171, 36, 144, 64, 162, 4, 86, 128, 113, 7, 105, 131, 2, 133, 106, 79, 11, 152, 26, 118, 158, 126, 17, 55, 45, 111, 138, 84, 6, 52, 167, 38, 20, 101, 31, 120, 5, 112, 74, 69, 121, 9, 154, 15, 146, 116, 63, 1, 114, 83, 124, 109, 39, 75, 123, 57, 49, 30, 21, 40, 43, 77, 157, 44, 13, 99, 34, 147, 166, 56, 155, 176, 95, 102, 119, 161, 37, 159, 97, 68, 122, 163, 89, 61, 107, 22, 10, 127, 87, 103, 179, 172, 66, 59, 8, 145, 88, 132, 110, 54, 47, 153, 25, 32, 73, 42, 148, 150, 28, 91, 18, 24, 19, 53, 136, 48, 76, 35, 151, 173, 149, 142, 160, 94, 117, 169, 165, 141, 80, 67, 170, 164, 82, 65, 60, 135, 168, 23, 100, 134, 90, 98, 125, 85, 137, 81, 41, 156, 50, 3, 29, 16, 72, 177, 0, 78, 62, 139, 93, 46, 12, 175, 130, 51, 178, 92, 115, 174, 27, 70, 58, 33, 104, 140, 108, 143.

According to the converted GW pattern (B) in Fig. 291, arrangement of bit groups 0 through 179 of the 64k-bit LDPC code is interleaved to arrangement of bit groups 14, 131, 138, 9, 49, 176, 10, 153, 76, 164, 41, 175, 129, 2, 84, 154, 30, 95, 127, 25, 35, 82, 156, 130, 71, 133, 6, 15, 21, 102, 87, 32, 151, 65, 50, 51, 96, 106, 52, 146, 40, 119, 103, 73, 173, 60, 3, 178, 171, 79, 167, 116, 43, 161, 179, 42, 149, 135, 29, 92, 36, 11, 38, 63, 77, 37, 172, 148, 142, 168, 16, 115, 144, 152, 20, 1, 157, 159, 66, 150, 160, 23, 72, 174, 64, 26, 101, 114, 44, 97, 59, 28, 94, 100, 177, 27, 162, 118, 31, 83, 13, 68, 8, 91, 117, 134, 0, 70, 4, 158, 120, 124, 99, 122, 145, 18, 169, 90, 78, 58, 86, 126, 5, 109, 34, 163, 88, 24, 165, 98, 62, 33, 128, 17, 112, 39, 147, 89, 132, 19, 141, 125, 139, 104, 113, 55, 74, 75, 166, 61, 110, 53, 80, 85, 93, 140, 7, 45, 69, 123, 56, 107, 54, 136, 67, 137, 46, 108, 105, 111, 121, 57, 155, 22, 47, 48, 170, 81, 12, 143.

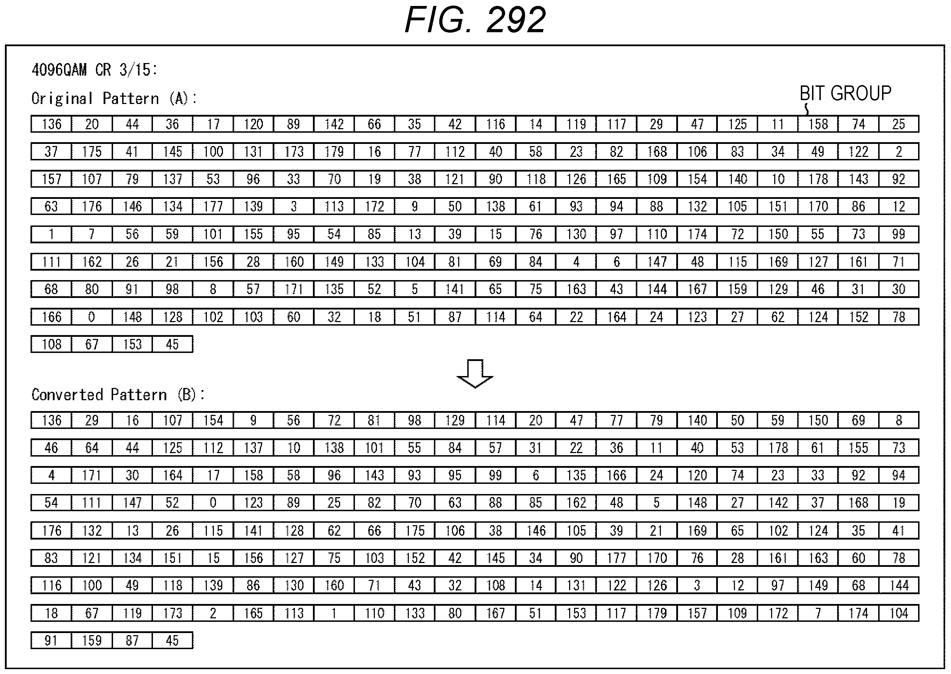

Fig. 292 is a diagram showing an example of a GW pattern for an LDPC code having a code length N of 64k bits with the modulation system set to 4096QAM and the coding rate r set to 3/15.

According to the original GW pattern (A) in Fig. 292, arrangement of bit groups 0 through 179 of the 64k-bit LDPC code is interleaved to arrangement of bit groups 136, 20, 44, 36, 17, 120, 89, 142, 66, 35, 42, 116, 14, 119, 117, 29, 47, 125, 11, 158, 74, 25, 37, 175, 41, 145, 100, 131, 173, 179, 16, 77, 112, 40, 58, 23, 82, 168, 106, 83, 34, 49, 122, 2, 157, 107, 79, 137, 53, 96, 33, 70, 19, 38, 121, 90, 118, 126, 165, 109, 154, 140, 10, 178, 143, 92, 63, 176, 146, 134, 177, 139, 3, 113, 172, 9, 50, 138, 61, 93, 94, 88, 132, 105, 151, 170, 86, 12, 1, 7, 56, 59, 101, 155, 95, 54, 85, 13, 39, 15, 76, 130, 97, 110, 174, 72, 150, 55, 73, 99, 111, 162, 26, 21, 156, 28, 160, 149, 133, 104, 81, 69, 84, 4, 6, 147, 48, 115, 169, 127, 161, 71, 68, 80, 91, 98, 8, 57, 171, 135, 52, 5, 141, 65, 75, 163, 43, 144, 167, 159, 129, 46, 31, 30, 166, 0, 148, 128, 102, 103, 60, 32, 18, 51, 87, 114, 64, 22, 164, 24, 123, 27, 62, 124, 152, 78, 108, 67, 153, 45.

According to the converted GW pattern (B) in Fig. 292, arrangement of bit groups 0 through 179 of the 64k-bit LDPC code is interleaved to arrangement of bit groups 136, 29, 16, 107, 154, 9, 56, 72, 81, 98, 129, 114, 20, 47, 77, 79, 140, 50, 59, 150, 69, 8, 46, 64, 44, 125, 112, 137, 10, 138, 101, 55, 84, 57, 31, 22, 36, 11, 40, 53, 178, 61, 155, 73, 4, 171, 30, 164, 17, 158, 58, 96, 143, 93, 95, 99, 6, 135, 166, 24, 120, 74, 23, 33, 92, 94, 54, 111, 147, 52, 0, 123, 89, 25, 82, 70, 63, 88, 85, 162, 48, 5, 148, 27, 142, 37, 168, 19, 176, 132, 13, 26, 115, 141, 128, 62, 66, 175, 106, 38, 146, 105, 39, 21, 169, 65, 102, 124, 35, 41, 83, 121, 134, 151, 15, 156, 127, 75, 103, 152, 42, 145, 34, 90, 177, 170, 76, 28, 161, 163, 60, 78, 116, 100, 49, 118, 139, 86, 130, 160, 71, 43, 32, 108, 14, 131, 122, 126, 3, 12, 97, 149, 68, 144, 18, 67, 119, 173, 2, 165, 113, 1, 110, 133, 80, 167, 51, 153, 117, 179, 157, 109, 172, 7, 174, 104, 91, 159, 87, 45.

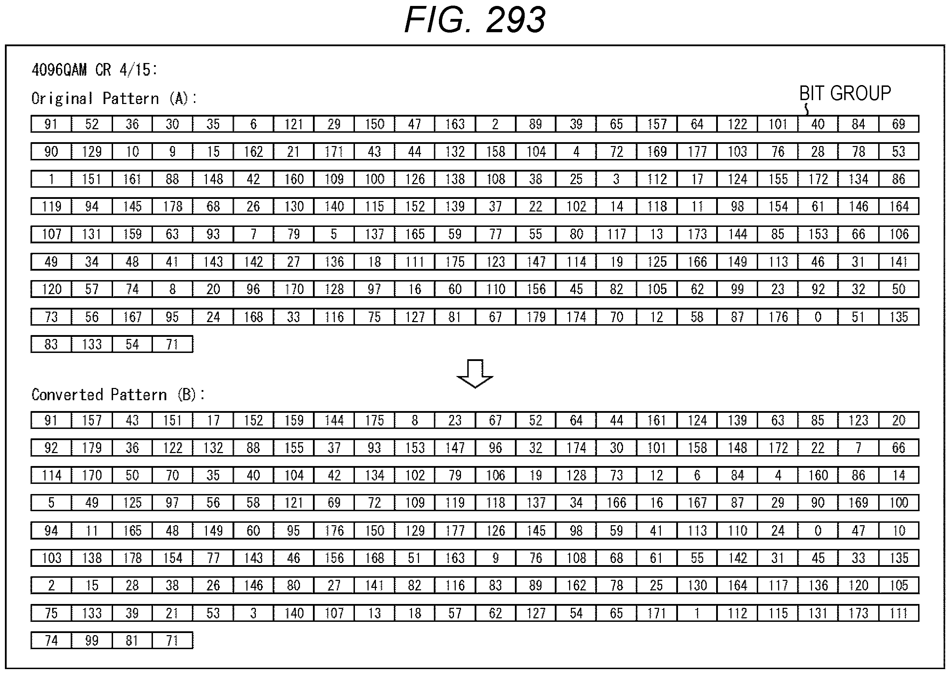

Fig. 293 is a diagram showing an example of a GW pattern for an LDPC code having a code length N of 64k bits with the modulation system set to 4096QAM and the coding rate r set to 4/15.

According to the original GW pattern (A) in Fig. 293, arrangement of bit groups 0 through 179 of the 64k-bit LDPC code is interleaved to arrangement of bit groups 91, 52, 36, 30, 35, 6, 121, 29, 150, 47, 163, 2, 89, 39, 65, 157, 64, 122, 101, 40, 84, 69, 90, 129, 10, 9, 15, 162, 21, 171, 43, 44, 132, 158, 104, 4, 72, 169, 177, 103, 76, 28, 78, 53, 1, 151, 161, 88, 148, 42, 160, 109, 100, 126, 138, 108, 38, 25, 3, 112, 17, 124, 155, 172, 134, 86, 119, 94, 145, 178, 68, 26, 130, 140, 115, 152, 139, 37, 22, 102, 14, 118, 11, 98, 154, 61, 146, 164, 107, 131, 159, 63, 93, 7, 79, 5, 137, 165, 59, 77, 55, 80, 117, 13, 173, 144, 85, 153, 66, 106, 49, 34, 48, 41, 143, 142, 27, 136, 18, 111, 175, 123, 147, 114, 19, 125, 166, 149, 113, 46, 31, 141, 120, 57, 74, 8, 20, 96, 170, 128, 97, 16, 60, 110, 156, 45, 82, 105, 62, 99, 23, 92, 32, 50, 73, 56, 167, 95, 24, 168, 33, 116, 75, 127, 81, 67, 179, 174, 70, 12, 58, 87, 176, 0, 51, 135, 83, 133, 54, 71.

According to the converted GW pattern (B) in Fig. 293, arrangement of bit groups 0 through 179 of the 64k-bit LDPC code is interleaved to arrangement of bit groups 91, 157, 43, 151, 17, 152, 159, 144, 175, 8, 23, 67, 52, 64, 44, 161, 124, 139, 63, 85, 123, 20, 92, 179, 36, 122, 132, 88, 155, 37, 93, 153, 147, 96, 32, 174, 30, 101, 158, 148, 172, 22, 7, 66, 114, 170, 50, 70, 35, 40, 104, 42, 134, 102, 79, 106, 19, 128, 73, 12, 6, 84, 4, 160, 86, 14, 5, 49, 125, 97, 56, 58, 121, 69, 72, 109, 119, 118, 137, 34, 166, 16, 167, 87, 29, 90, 169, 100, 94, 11, 165, 48, 149, 60, 95, 176, 150, 129, 177, 126, 145, 98, 59, 41, 113, 110, 24, 0, 47, 10, 103, 138, 178, 154, 77, 143, 46, 156, 168, 51, 163, 9, 76, 108, 68, 61, 55, 142, 31, 45, 33, 135, 2, 15, 28, 38, 26, 146, 80, 27, 141, 82, 116, 83, 89, 162, 78, 25, 130, 164, 117, 136, 120, 105, 75, 133, 39, 21, 53, 3, 140, 107, 13, 18, 57, 62, 127, 54, 65, 171, 1, 112, 115, 131, 173, 111, 74, 99, 81, 71.

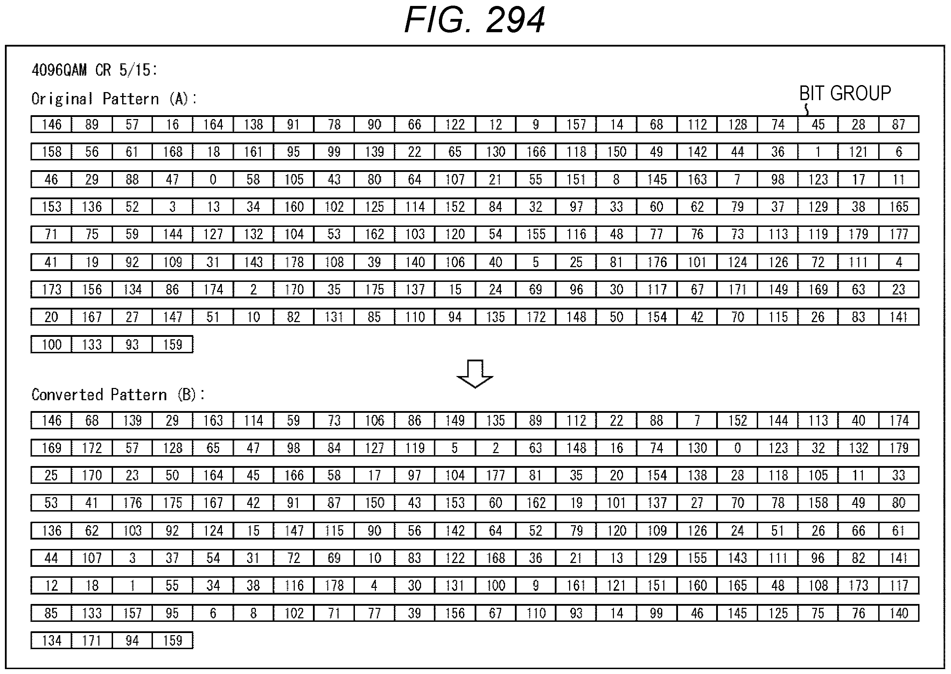

Fig. 294 is a diagram showing an example of a GW pattern for an LDPC code having a code length N of 64k bits with the modulation system set to 4096QAM and the coding rate r set to 5/15.

According to the original GW pattern (A) in Fig. 294, arrangement of bit groups 0 through 179 of the 64k-bit LDPC code is interleaved to arrangement of bit groups 146, 89, 57, 16, 164, 138, 91, 78, 90, 66, 122, 12, 9, 157, 14, 68, 112, 128, 74, 45, 28, 87, 158, 56, 61, 168, 18, 161, 95, 99, 139, 22, 65, 130, 166, 118, 150, 49, 142, 44, 36, 1, 121, 6, 46, 29, 88, 47, 0, 58, 105, 43, 80, 64, 107, 21, 55, 151, 8, 145, 163, 7, 98, 123, 17, 11, 153, 136, 52, 3, 13, 34, 160, 102, 125, 114, 152, 84, 32, 97, 33, 60, 62, 79, 37, 129, 38, 165, 71, 75, 59, 144, 127, 132, 104, 53, 162, 103, 120, 54, 155, 116, 48, 77, 76, 73, 113, 119, 179, 177, 41, 19, 92, 109, 31, 143, 178, 108, 39, 140, 106, 40, 5, 25, 81, 176, 101, 124, 126, 72, 111, 4, 173, 156, 134, 86, 174, 2, 170, 35, 175, 137, 15, 24, 69, 96, 30, 117, 67, 171, 149, 169, 63, 23, 20, 167, 27, 147, 51, 10, 82, 131, 85, 110, 94, 135, 172, 148, 50, 154, 42, 70, 115, 26, 83, 141, 100, 133, 93, 159.

According to the converted GW pattern (B) in Fig. 294, arrangement of bit groups 0 through 179 of the 64k-bit LDPC code is interleaved to arrangement of bit groups 146, 68, 139, 29, 163, 114, 59, 73, 106, 86, 149, 135, 89, 112, 22, 88, 7, 152, 144, 113, 40, 174, 169, 172, 57, 128, 65, 47, 98, 84, 127, 119, 5, 2, 63, 148, 16, 74, 130, 0, 123, 32, 132, 179, 25, 170, 23, 50, 164, 45, 166, 58, 17, 97, 104, 177, 81, 35, 20, 154, 138, 28, 118, 105, 11, 33, 53, 41, 176, 175, 167, 42, 91, 87, 150, 43, 153, 60, 162, 19, 101, 137, 27, 70, 78, 158, 49, 80, 136, 62, 103, 92, 124, 15, 147, 115, 90, 56, 142, 64, 52, 79, 120, 109, 126, 24, 51, 26, 66, 61, 44, 107, 3, 37, 54, 31, 72, 69, 10, 83, 122, 168, 36, 21, 13, 129, 155, 143, 111, 96, 82, 141, 12, 18, 1, 55, 34, 38, 116, 178, 4, 30, 131, 100, 9, 161, 121, 151, 160, 165, 48, 108, 173, 117, 85, 133, 157, 95, 6, 8, 102, 71, 77, 39, 156, 67, 110, 93, 14, 99, 46, 145, 125, 75, 76, 140, 134, 171, 94, 159.

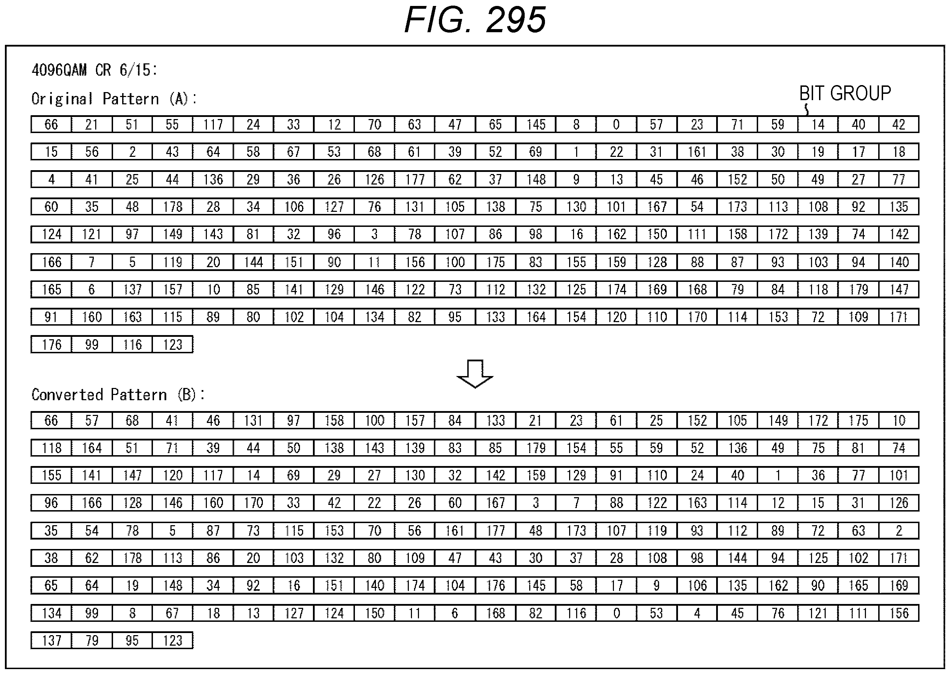

Fig. 295 is a diagram showing an example of a GW pattern for an LDPC code having a code length N of 64k bits with the modulation system set to 4096QAM and the coding rate r set to 6/15.

According to the original GW pattern (A) in Fig. 295, arrangement of bit groups 0 through 179 of the 64k-bit LDPC code is interleaved to arrangement of bit groups 66, 21, 51, 55, 117, 24, 33, 12, 70, 63, 47, 65, 145, 8, 0, 57, 23, 71, 59, 14, 40, 42, 15, 56, 2, 43, 64, 58, 67, 53, 68, 61, 39, 52, 69, 1, 22, 31, 161, 38, 30, 19, 17, 18, 4, 41, 25, 44, 136, 29, 36, 26, 126, 177, 62, 37, 148, 9, 13, 45, 46, 152, 50, 49, 27, 77, 60, 35, 48, 178, 28, 34, 106, 127, 76, 131, 105, 138, 75, 130, 101, 167, 54, 173, 113, 108, 92, 135, 124, 121, 97, 149, 143, 81, 32, 96, 3, 78, 107, 86, 98, 16, 162, 150, 111, 158, 172, 139, 74, 142, 166, 7, 5, 119, 20, 144, 151, 90, 11, 156, 100, 175, 83, 155, 159, 128, 88, 87, 93, 103, 94, 140, 165, 6, 137, 157, 10, 85, 141, 129, 146, 122, 73, 112, 132, 125, 174, 169, 168, 79, 84, 118, 179, 147, 91, 160, 163, 115, 89, 80, 102, 104, 134, 82, 95, 133, 164, 154, 120, 110, 170, 114, 153, 72, 109, 171, 176, 99, 116, 123.

According to the converted GW pattern (B) in Fig. 295, arrangement of bit groups 0 through 179 of the 64k-bit LDPC code is interleaved to arrangement of bit groups 66, 57, 68, 41, 46, 131, 97, 158, 100, 157, 84, 133, 21, 23, 61, 25, 152, 105, 149, 172, 175, 10, 118, 164, 51, 71, 39, 44, 50, 138, 143, 139, 83, 85, 179, 154, 55, 59, 52, 136, 49, 75, 81, 74, 155, 141, 147, 120, 117, 14, 69, 29, 27, 130, 32, 142, 159, 129, 91, 110, 24, 40, 1, 36, 77, 101, 96, 166, 128, 146, 160, 170, 33, 42, 22, 26, 60, 167, 3, 7, 88, 122, 163, 114, 12, 15, 31, 126, 35, 54, 78, 5, 87, 73, 115, 153, 70, 56, 161, 177, 48, 173, 107, 119, 93, 112, 89, 72, 63, 2, 38, 62, 178, 113, 86, 20, 103, 132, 80, 109, 47, 43, 30, 37, 28, 108, 98, 144, 94, 125, 102, 171, 65, 64, 19, 148, 34, 92, 16, 151, 140, 174, 104, 176, 145, 58, 17, 9, 106, 135, 162, 90, 165, 169, 134, 99, 8, 67, 18, 13, 127, 124, 150, 11, 6, 168, 82, 116, 0, 53, 4, 45, 76, 121, 111, 156, 137, 79, 95, 123.

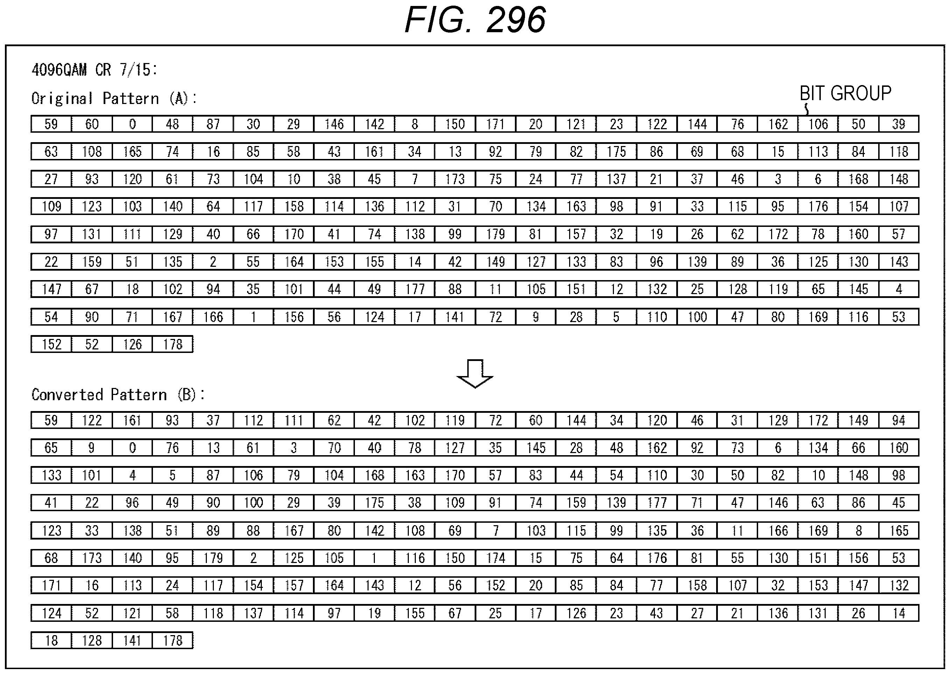

Fig. 296 is a diagram showing an example of a GW pattern for an LDPC code having a code length N of 64k bits with the modulation system set to 4096QAM and the coding rate r set to 7/15.

According to the original GW pattern (A) in Fig. 296, arrangement of bit groups 0 through 179 of the 64k-bit LDPC code is interleaved to arrangement of bit groups 59, 60, 0, 48, 87, 30, 29, 146, 142, 8, 150, 171, 20, 121, 23, 122, 144, 76, 162, 106, 50, 39, 63, 108, 165, 174, 16, 85, 58, 43, 161, 34, 13, 92, 79, 82, 175, 86, 69, 68, 15, 113, 84, 118, 27, 93, 120, 61, 73, 104, 10, 38, 45, 7, 173, 75, 24, 77, 137, 21, 37, 46, 3, 6, 168, 148, 109, 123, 103, 140, 64, 117, 158, 114, 136, 112, 31, 70, 134, 163, 98, 91, 33, 115, 95, 176, 154, 107, 97, 131, 111, 129, 40, 66, 170, 41, 74, 138, 99, 179, 81, 157, 32, 19, 26, 62, 172, 78, 160, 57, 22, 159, 51, 135, 2, 55, 164, 153, 155, 14, 42, 149, 127, 133, 83, 96, 139, 89, 36, 125, 130, 143, 147, 67, 18, 102, 94, 35, 101, 44, 49, 177, 88, 11, 105, 151, 12, 132, 25, 128, 119, 65, 145, 4, 54, 90, 71, 167, 166, 1, 156, 56, 124, 17, 141, 72, 9, 28, 5, 110, 100, 47, 80, 169, 116, 53, 152, 52, 126, 178.

According to the converted GW pattern (B) in Fig. 296, arrangement of bit groups 0 through 179 of the 64k-bit LDPC code is interleaved to arrangement of bit groups 59, 122, 161, 93, 37, 112, 111, 62, 42, 102, 119, 72, 60, 144, 34, 120, 46, 31, 129, 172, 149, 94, 65, 9, 0, 76, 13, 61, 3, 70, 40, 78, 127, 35, 145, 28, 48, 162, 92, 73, 6, 134, 66, 160, 133, 101, 4, 5, 87, 106, 79, 104, 168, 163, 170, 57, 83, 44, 54, 110, 30, 50, 82, 10, 148, 98, 41, 22, 96, 49, 90, 100, 29, 39, 175, 38, 109, 91, 74, 159, 139, 177, 71, 47, 146, 63, 86, 45, 123, 33, 138, 51, 89, 88, 167, 80, 142, 108, 69, 7, 103, 115, 99, 135, 36, 11, 166, 169, 8, 165, 68, 173, 140, 95, 179, 2, 125, 105, 1, 116, 150, 174, 15, 75, 64, 176, 81, 55, 130, 151, 156, 53, 171, 16, 113, 24, 117, 154, 157, 164, 143, 12, 56, 152, 20, 85, 84, 77, 158, 107, 32, 153, 147, 132, 124, 52, 121, 58, 118, 137, 114, 97, 19, 155, 67, 25, 17, 126, 23, 43, 27, 21, 136, 131, 26, 14, 18, 128, 141, 178.

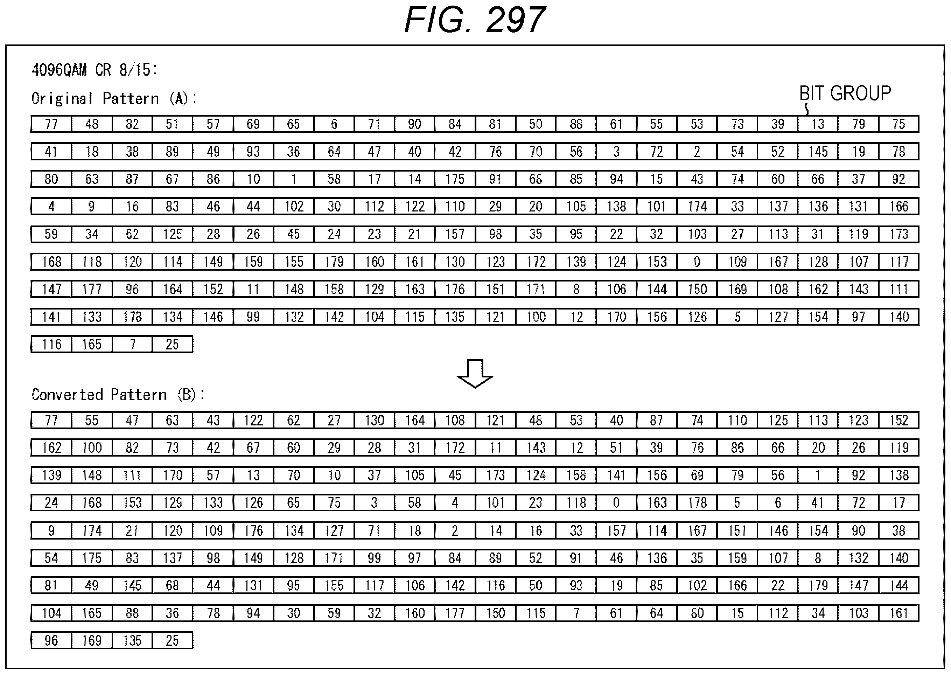

Fig. 297 is a diagram showing an example of a GW pattern for an LDPC code having a code length N of 64k bits with the modulation system set to 4096QAM and the coding rate r set to 8/15.

According to the original GW pattern (A) in Fig. 297, arrangement of bit groups 0 through 179 of the 64k-bit LDPC code is interleaved to arrangement of bit groups 77, 48, 82, 51, 57, 69, 65, 6, 71, 90, 84, 81, 50, 88, 61, 55, 53, 73, 39, 13, 79, 75, 41, 18, 38, 89, 49, 93, 36, 64, 47, 40, 42, 76, 70, 56, 3, 72, 2, 54, 52, 145, 19, 78, 80, 63, 87, 67, 86, 10, 1, 58, 17, 14, 175, 91, 68, 85, 94, 15, 43, 74, 60, 66, 37, 92, 4, 9, 16, 83, 46, 44, 102, 30, 112, 122, 110, 29, 20, 105, 138, 101, 174, 33, 137, 136, 131, 166, 59, 34, 62, 125, 28, 26, 45, 24, 23, 21, 157, 98, 35, 95, 22, 32, 103, 27, 113, 31, 119, 173, 168, 118, 120, 114, 149, 159, 155, 179, 160, 161, 130, 123, 172, 139, 124, 153, 0, 109, 167, 128, 107, 117, 147, 177, 96, 164, 152, 11, 148, 158, 129, 163, 176, 151, 171, 8, 106, 144, 150, 169, 108, 162, 143, 111, 141, 133, 178, 134, 146, 99, 132, 142, 104, 115, 135, 121, 100, 12, 170, 156, 126, 5, 127, 154, 97, 140, 116, 165, 7, 25.

According to the converted GW pattern (B) in Fig. 297, arrangement of bit groups 0 through 179 of the 64k-bit LDPC code is interleaved to arrangement of bit groups 77, 55, 47, 63, 43, 122, 62, 27, 130, 164, 108, 121, 48, 53, 40, 87, 74, 110, 125, 113, 123, 152, 162, 100, 82, 73, 42, 67, 60, 29, 28, 31, 172, 11, 143, 12, 51, 39, 76, 86, 66, 20, 26, 119, 139, 148, 111, 170, 57, 13, 70, 10, 37, 105, 45, 173, 124, 158, 141, 156, 69, 79, 56, 1, 92, 138, 24, 168, 153, 129, 133, 126, 65, 75, 3, 58, 4, 101, 23, 118, 0, 163, 178, 5, 6, 41, 72, 17, 9, 174, 21, 120, 109, 176, 134, 127, 71, 18, 2, 14, 16, 33, 157, 114, 167, 151, 146, 154, 90, 38, 54, 175, 83, 137, 98, 149, 128, 171, 99, 97, 84, 89, 52, 91, 46, 136, 35, 159, 107, 8, 132, 140, 81, 49, 145, 68, 44, 131, 95, 155, 117, 106, 142, 116, 50, 93, 19, 85, 102, 166, 22, 179, 147, 144, 104, 165, 88, 36, 78, 94, 30, 59, 32, 160, 177, 150, 115, 7, 61, 64, 80, 15, 112, 34, 103, 161, 96, 169, 135, 25.

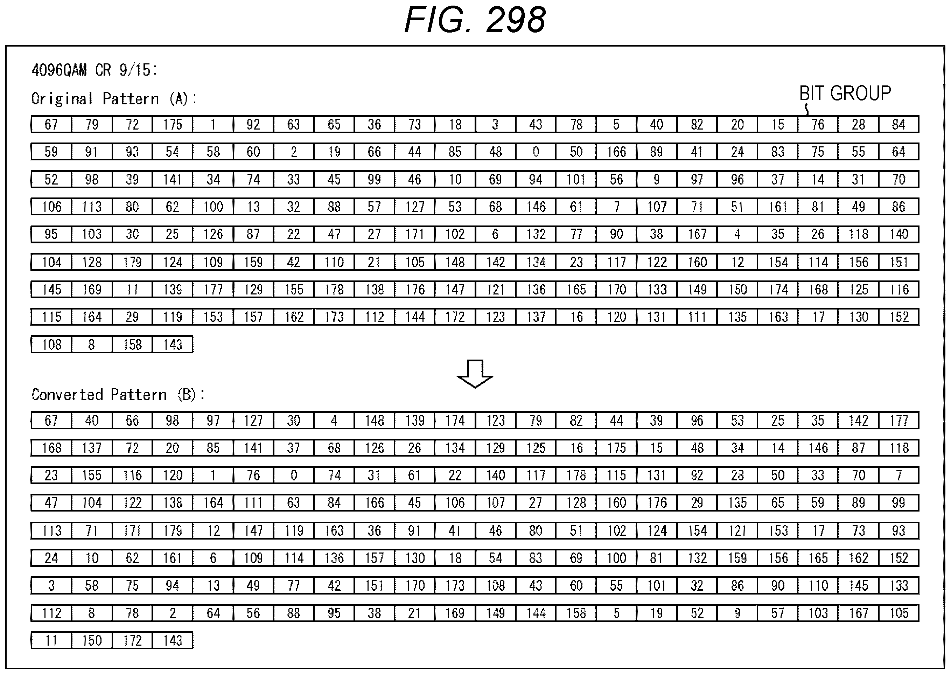

Fig. 298 is a diagram showing an example of a GW pattern for an LDPC code having a code length N of 64k bits with the modulation system set to 4096QAM and the coding rate r set to 9/15.

According to the original GW pattern (A) in Fig. 298, arrangement of bit groups 0 through 179 of the 64k-bit LDPC code is interleaved to arrangement of bit groups 67, 79, 72, 175, 1, 92, 63, 65, 36, 73, 18, 3, 43, 78, 5, 40, 82, 20, 15, 76, 28, 84, 59, 91, 93, 54, 58, 60, 2, 19, 66, 44, 85, 48, 0, 50, 166, 89, 41, 24, 83, 75, 55, 64, 52, 98, 39, 141, 34, 74, 33, 45, 99, 46, 10, 69, 94, 101, 56, 9, 97, 96, 37, 14, 31, 70, 106, 113, 80, 62, 100, 13, 32, 88, 57, 127, 53, 68, 146, 61, 7, 107, 71, 51, 161, 81, 49, 86, 95, 103, 30, 25, 126, 87, 22, 47, 27, 171, 102, 6, 132, 77, 90, 38, 167, 4, 35, 26, 118, 140, 104, 128, 179, 124, 109, 159, 42, 110, 21, 105, 148, 142, 134, 23, 117, 122, 160, 12, 154, 114, 156, 151, 145, 169, 11, 139, 177, 129, 155, 178, 138, 176, 147, 121, 136, 165, 170, 133, 149, 150, 174, 168, 125, 116, 115, 164, 29, 119, 153, 157, 162, 173, 112, 144, 172, 123, 137, 16, 120, 131, 111, 135, 163, 17, 130, 152, 108, 8, 158, 143.

According to the converted GW pattern (B) in Fig. 298, arrangement of bit groups 0 through 179 of the 64k-bit LDPC code is interleaved to arrangement of bit groups 67, 40, 66, 98, 97, 127, 30, 4, 148, 139, 174, 123, 79, 82, 44, 39, 96, 53, 25, 35, 142, 177, 168, 137, 72, 20, 85, 141, 37, 68, 126, 26, 134, 129, 125, 16, 175, 15, 48, 34, 14, 146, 87, 118, 23, 155, 116, 120, 1, 76, 0, 74, 31, 61, 22, 140, 117, 178, 115, 131, 92, 28, 50, 33, 70, 7, 47, 104, 122, 138, 164, 111, 63, 84, 166, 45, 106, 107, 27, 128, 160, 176, 29, 135, 65, 59, 89, 99, 113, 71, 171, 179, 12, 147, 119, 163, 36, 91, 41, 46, 80, 51, 102, 124, 154, 121, 153, 17, 73, 93, 24, 10, 62, 161, 6, 109, 114, 136, 157, 130, 18, 54, 83, 69, 100, 81, 132, 159, 156, 165, 162, 152, 3, 58, 75, 94, 13, 49, 77, 42, 151, 170, 173, 108, 43, 60, 55, 101, 32, 86, 90, 110, 145, 133, 112, 8, 78, 2, 64, 56, 88, 95, 38, 21, 169, 149, 144, 158, 5, 19, 52, 9, 57, 103, 167, 105, 11, 150, 172, 143.

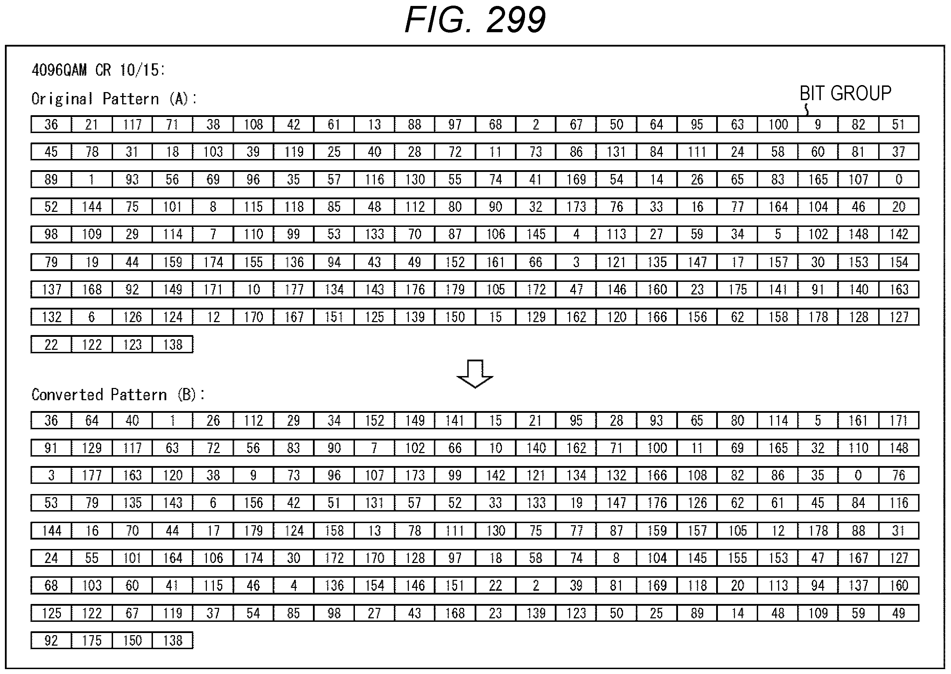

Fig. 299 is a diagram showing an example of a GW pattern for an LDPC code having a code length N of 64k bits with the modulation system set to 4096QAM and the coding rate r set to 10/15.

According to the original GW pattern (A) in Fig. 299, arrangement of bit groups 0 through 179 of the 64k-bit LDPC code is interleaved to arrangement of bit groups 36, 21, 117, 71, 38, 108, 42, 61, 13, 88, 97, 68, 2, 67, 50, 64, 95, 63, 100, 9, 82, 51, 45, 78, 31, 18, 103, 39, 119, 25, 40, 28, 72, 11, 73, 86, 131, 84, 111, 24, 58, 60, 81, 37, 89, 1, 93, 56, 69, 96, 35, 57, 116, 130, 55, 74, 41, 169, 54, 14, 26, 65, 83, 165, 107, 0, 52, 144, 75, 101, 8, 115, 118, 85, 48, 112, 80, 90, 32, 173, 76, 33, 16, 77, 164, 104, 46, 20, 98, 109, 29, 114, 7, 110, 99, 53, 133, 70, 87, 106, 145, 4, 113, 27, 59, 34, 5, 102, 148, 142, 79, 19, 44, 159, 174, 155, 136, 94, 43, 49, 152, 161, 66, 3, 121, 135, 147, 17, 157, 30, 153, 154, 137, 168, 92, 149, 171, 10, 177, 134, 143, 176, 179, 105, 172, 47, 146, 160, 23, 175, 141, 91, 140, 163, 132, 6, 126, 124, 12, 170, 167, 151, 125, 139, 150, 15, 129, 162, 120, 166, 156, 62, 158, 178, 128, 127, 22, 122, 123, 138.

According to the converted GW pattern (B) in Fig. 299, arrangement of bit groups 0 through 179 of the 64k-bit LDPC code is interleaved to arrangement of bit groups 36, 64, 40, 1, 26, 112, 29, 34, 152, 149, 141, 15, 21, 95, 28, 93, 65, 80, 114, 5, 161, 171, 91, 129, 117, 63, 72, 56, 83, 90, 7, 102, 66, 10, 140, 162, 71, 100, 11, 69, 165, 32, 110, 148, 3, 177, 163, 120, 38, 9, 73, 96, 107, 173, 99, 142, 121, 134, 132, 166, 108, 82, 86, 35, 0, 76, 53, 79, 135, 143, 6, 156, 42, 51, 131, 57, 52, 33, 133, 19, 147, 176, 126, 62, 61, 45, 84, 116, 144, 16, 70, 44, 17, 179, 124, 158, 13, 78, 111, 130, 75, 77, 87, 159, 157, 105, 12, 178, 88, 31, 24, 55, 101, 164, 106, 174, 30, 172, 170, 128, 97, 18, 58, 74, 8, 104, 145, 155, 153, 47, 167, 127, 68, 103, 60, 41, 115, 46, 4, 136, 154, 146, 151, 22, 2, 39, 81, 169, 118, 20, 113, 94, 137, 160, 125, 122, 67, 119, 37, 54, 85, 98, 27, 43, 168, 23, 139, 123, 50, 25, 89, 14, 48, 109, 59, 49, 92, 175, 150, 138.

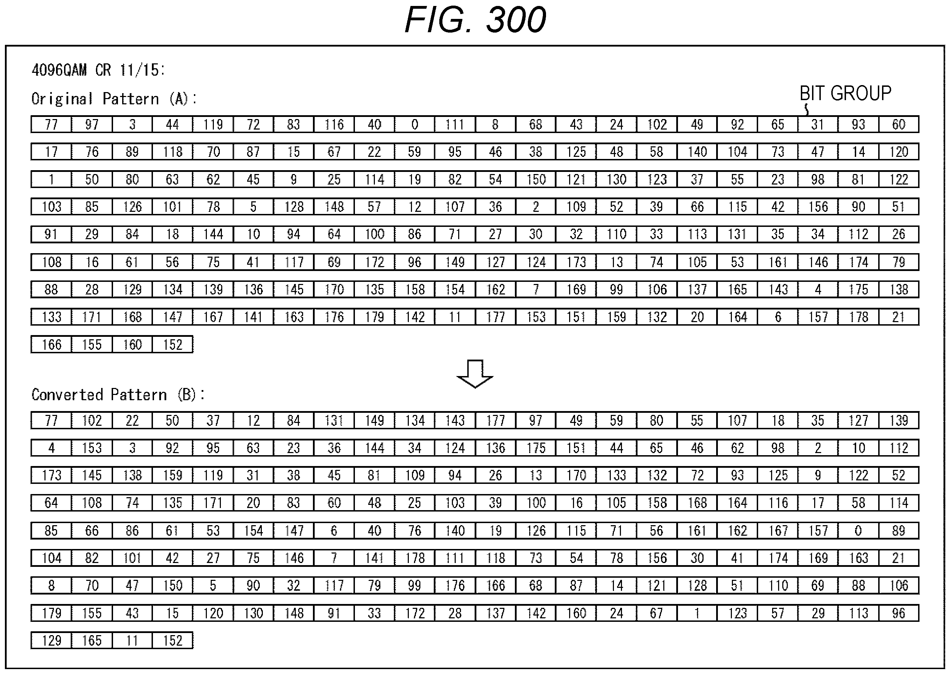

Fig. 300 is a diagram showing an example of a GW pattern for an LDPC code having a code length N of 64k bits with the modulation system set to 4096QAM and the coding rate r set to 11/15.

According to the original GW pattern (A) in Fig. 300, arrangement of a bit group 0 through 179 of the 64k-bit LDPC code is interleaved to arrangement of a bit group 77, 97, 3, 44, 119, 72, 83, 116, 40, 0, 111, 8, 68, 43, 24, 102, 49, 92, 65, 31, 93, 60, 17, 76, 89, 118, 70, 87, 15, 67, 22, 59, 95, 46, 38, 125, 48, 58, 140, 104, 73, 47, 14, 120, 1, 50, 80, 63, 62, 45, 9, 25, 114, 19, 82, 54, 150, 121, 130, 123, 37, 55, 23, 98, 81, 122, 103, 85, 126, 101, 78, 5, 128, 148, 57, 12, 107, 36, 2, 109, 52, 39, 66, 115, 42, 156, 90, 51, 91, 29, 84, 18, 144, 10, 94, 64, 100, 86, 71, 27, 30, 32, 110, 33, 113, 131, 35, 34, 112, 26, 108, 16, 61, 56, 75, 41, 117, 69, 172, 96, 149, 127, 124, 173, 13, 74, 105, 53, 161, 146, 174, 79, 88, 28, 129, 134, 139, 136, 145, 170, 135, 158, 154, 162, 7, 169, 99, 106, 137, 165, 143, 4, 175, 138, 133, 171, 168, 147, 167, 141, 163, 176, 179, 142, 11, 177, 153, 151, 159, 132, 20, 164, 6, 157, 178, 21, 166, 155, 160, 152.

According to the converted GW pattern (B) in Fig. 300, arrangement of bit groups 0 through 179 of the 64k-bit LDPC code is interleaved to arrangement of bit groups 77, 102, 22, 50, 37, 12, 84, 131, 149, 134, 143, 177, 97, 49, 59, 80, 55, 107, 18, 35, 127, 139, 4, 153, 3, 92, 95, 63, 23, 36, 144, 34, 124, 136, 175, 151, 44, 65, 46, 62, 98, 2, 10, 112, 173, 145, 138, 159, 119, 31, 38, 45, 81, 109, 94, 26, 13, 170, 133, 132, 72, 93, 125, 9, 122, 52, 64, 108, 74, 135, 171, 20, 83, 60, 48, 25, 103, 39, 100, 16, 105, 158, 168, 164, 116, 17, 58, 114, 85, 66, 86, 61, 53, 154, 147, 6, 40, 76, 140, 19, 126, 115, 71, 56, 161, 162, 167, 157, 0, 89, 104, 82, 101, 42, 27, 75, 146, 7, 141, 178, 111, 118, 73, 54, 78, 156, 30, 41, 174, 169, 163, 21, 8, 70, 47, 150, 5, 90, 32, 117, 79, 99, 176, 166, 68, 87, 14, 121, 128, 51, 110, 69, 88, 106, 179, 155, 43, 15, 120, 130, 148, 91, 33, 172, 28, 137, 142, 160, 24, 67, 1, 123, 57, 29, 113, 96, 129, 165, 11, 152.

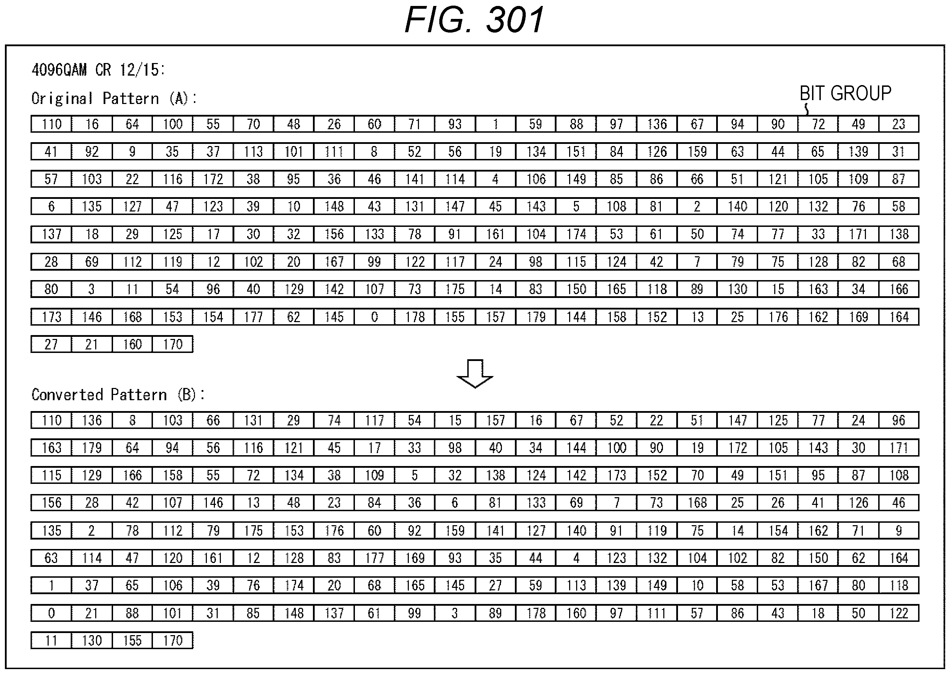

Fig. 301 is a diagram showing an example of a GW pattern for an LDPC code having a code length N of 64k bits with the modulation system set to 4096QAM and the coding rate r set to 12/15.

According to the original GW pattern (A) in Fig. 301, arrangement of bit groups 0 through 179 of the 64k-bit LDPC code is interleaved to arrangement of bit groups 110, 16, 64, 100, 55, 70, 48, 26, 60, 71, 93, 1, 59, 88, 97, 136, 67, 94, 90, 72, 49, 23, 41, 92, 9, 35, 37, 113, 101, 111, 8, 52, 56, 19, 134, 151, 84, 126, 159, 63, 44, 65, 139, 31, 57, 103, 22, 116, 172, 38, 95, 36, 46, 141, 114, 4, 106, 149, 85, 86, 66, 51, 121, 105, 109, 87, 6, 135, 127, 47, 123, 39, 10, 148, 43, 131, 147, 45, 143, 5, 108, 81, 2, 140, 120, 132, 76, 58, 137, 18, 29, 125, 17, 30, 32, 156, 133, 78, 91, 161, 104, 174, 53, 61, 50, 74, 77, 33, 171, 138, 28, 69, 112, 119, 12, 102, 20, 167, 99, 122, 117, 24, 98, 115, 124, 42, 7, 79, 75, 128, 82, 68, 80, 3, 11, 54, 96, 40, 129, 142, 107, 73, 175, 14, 83, 150, 165, 118, 89, 130, 15, 163, 34, 166, 173, 146, 168, 153, 154, 177, 62, 145, 0, 178, 155, 157, 179, 144, 158, 152, 13, 25, 176, 162, 169, 164, 27, 21, 160, 170.

According to the converted GW pattern (B) in Fig. 301, arrangement of bit groups 0 through 179 of the 64k-bit LDPC code is interleaved to arrangement of bit groups 110, 136, 8, 103, 66, 131, 29, 74, 117, 54, 15, 157, 16, 67, 52, 22, 51, 147, 125, 77, 24, 96, 163, 179, 64, 94, 56, 116, 121, 45, 17, 33, 98, 40, 34, 144, 100, 90, 19, 172, 105, 143, 30, 171, 115, 129, 166, 158, 55, 72, 134, 38, 109, 5, 32, 138, 124, 142, 173, 152, 70, 49, 151, 95, 87, 108, 156, 28, 42, 107, 146, 13, 48, 23, 84, 36, 6, 81, 133, 69, 7, 73, 168, 25, 26, 41, 126, 46, 135, 2, 78, 112, 79, 175, 153, 176, 60, 92, 159, 141, 127, 140, 91, 119, 75, 14, 154, 162, 71, 9, 63, 114, 47, 120, 161, 12, 128, 83, 177, 169, 93, 35, 44, 4, 123, 132, 104, 102, 82, 150, 62, 164, 1, 37, 65, 106, 39, 76, 174, 20, 68, 165, 145, 27, 59, 113, 139, 149, 10, 58, 53, 167, 80, 118, 0, 21, 88, 101, 31, 85, 148, 137, 61, 99, 3, 89, 178, 160, 97, 111, 57, 86, 43, 18, 50, 122, 11, 130, 155, 170.

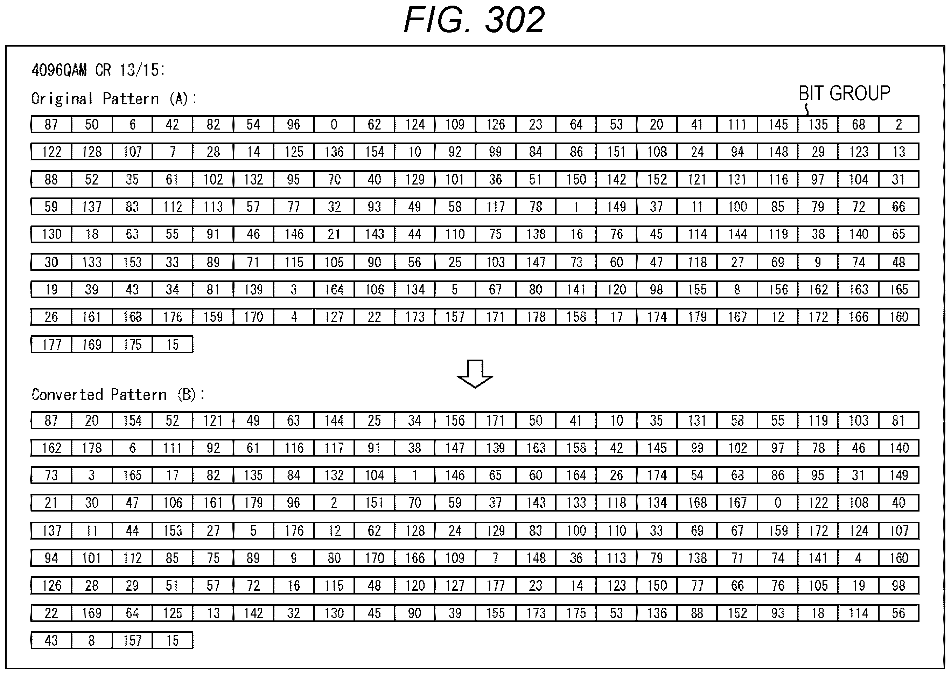

Fig. 302 is a diagram showing an example of a GW pattern for an LDPC code having a code length N of 64k bits with the modulation system set to 4096QAM and the coding rate r set to 13/15.

According to the original GW pattern (A) in Fig. 302, arrangement of bit groups 0 through 179 of the 64k-bit LDPC code is interleaved to arrangement of bit groups 87, 50, 6, 42, 82, 54, 96, 0, 62, 124, 109, 126, 23, 64, 53, 20, 41, 111, 145, 135, 68, 2, 122, 128, 107, 7, 28, 14, 125, 136, 154, 10, 92, 99, 84, 86, 151, 108, 24, 94, 148, 29, 123, 13, 88, 52, 35, 61, 102, 132, 95, 70, 40, 129, 101, 36, 51, 150, 142, 152, 121, 131, 116, 97, 104, 31, 59, 137, 83, 112, 113, 57, 77, 32, 93, 49, 58, 117, 78, 1, 149, 37, 11, 100, 85, 79, 72, 66, 130, 18, 63, 55, 91, 46, 146, 21, 143, 44, 110, 75, 138, 16, 76, 45, 114, 144, 119, 38, 140, 65, 30, 133, 153, 33, 89, 71, 115, 105, 90, 56, 25, 103, 147, 73, 60, 47, 118, 27, 69, 9, 74, 48, 19, 39, 43, 34, 81, 139, 3, 164, 106, 134, 5, 67, 80, 141, 120, 98, 155, 8, 156, 162, 163, 165, 26, 161, 168, 176, 159, 170, 4, 127, 22, 173, 157, 171, 178, 158, 17, 174, 179, 167, 12, 172, 166, 160, 177, 169, 175, 15.

According to the converted GW pattern (B) in Fig. 302, arrangement of bit groups 0 through 179 of the 64k-bit LDPC code is interleaved to arrangement of bit groups 87, 20, 154, 52, 121, 49, 63, 144, 25, 34, 156, 171, 50, 41, 10, 35, 131, 58, 55, 119, 103, 81, 162, 178, 6, 111, 92, 61, 116, 117, 91, 38, 147, 139, 163, 158, 42, 145, 99, 102, 97, 78, 46, 140, 73, 3, 165, 17, 82, 135, 84, 132, 104, 1, 146, 65, 60, 164, 26, 174, 54, 68, 86, 95, 31, 149, 21, 30, 47, 106, 161, 179, 96, 2, 151, 70, 59, 37, 143, 133, 118, 134, 168, 167, 0, 122, 108, 40, 137, 11, 44, 153, 27, 5, 176, 12, 62, 128, 24, 129, 83, 100, 110, 33, 69, 67, 159, 172, 124, 107, 94, 101, 112, 85, 75, 89, 9, 80, 170, 166, 109, 7, 148, 36, 113, 79, 138, 71, 74, 141, 4, 160, 126, 28, 29, 51, 57, 72, 16, 115, 48, 120, 127, 177, 23, 14, 123, 150, 77, 66, 76, 105, 19, 98, 22, 169, 64, 125, 13, 142, 32, 130, 45, 90, 39, 155, 173, 175, 53, 136, 88, 152, 93, 18, 114, 56, 43, 8, 157, 15.

<Example of GW pattern set for MODCOD (16k-bit LDPC code>

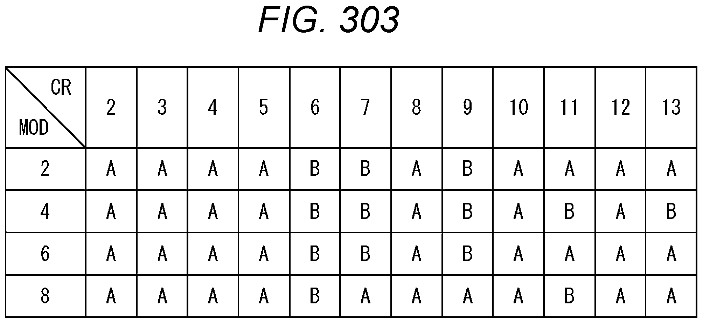

Fig. 303 shows an example of GW patterns set for MODCOD as a combination of 16k-bit LDPC codes and modulation systems.

Note that "A" put to MODCOD as one of combinations of 12 types of coding rates (CR) of LDPC codes and 4 types of modulation systems (MOD) in Fig. 303 indicates a GW pattern for block interleave of the type A set on the assumption of execution of block interleave of the type A, similarly to Fig. 230. On the other hand, "B" put to MODCOD indicates a GW pattern for block interleave of the type B set on the assumption of execution of block interleave of the type B.

In Fig. 303, execution of block interleave of the type A is assumed for MODCOD in a state that the modulation system is set to QPSK (MOD 2), and that the coding rate r of the 16k-bit LDPC code is set to 2/15, 3/15, 4/15, 5/15, 8/15, 10/15, 11/15, 12/15, and 13/15. On the other hand, execution of block interleave of the type B is assumed for MODCOD in a state that the modulation system is set to QPSK (MOD 2), and that the coding rate r of the 16k-bit LDPC code is set to 6/15, 7/15, and 9/15.

In Fig. 303, execution of block interleave of the type A is assumed for MODCOD in a state that the modulation system is set to 16QAM (MOD 4), and that the coding rate r of the 16k-bit LDPC code is set to 2/15, 3/15, 4/15, 5/15, 8/15, 10/15, 12/15. On the other hand, execution of block interleave of the type B is assumed for MODCOD in a state that the modulation system is set to 16QAM (MOD 4), and that the coding rate r of the 16k-bit LDPC code is set to 6/15, 7/15, 9/15, 11/15, and 13/15.

In Fig. 303, execution of block interleave of the type A is assumed for MODCOD in a state that the modulation system is set to 64QAM (MOD 6), and that the coding rate r of the 16k-bit LDPC code is set to 2/15, 3/15, 4/15, 5/15, 8/15, 10/15, 11/15, 12/15, and 13/15. On the other hand, execution of block interleave of the type B is assumed for MODCOD in a state that the modulation system is set to 64QAM (MOD 6), and that the coding rate r of the 16k-bit LDPC code is set to 6/15, 7/15, and 9/15.

In Fig. 303, execution of block interleave of the type A is assumed for MODCOD in a state that the modulation system is set to 256QAM (MOD 8), and that the coding rate r of the 16k-bit LDPC code is set to 2/15, 3/15, 4/15, 5/15, 7/15, 8/15, 9/15, 10/15, 12/15, and 13/15. On the other hand, execution of block interleave of the type B is assumed for MODCOD in a state that the modulation system is set to 256QAM (MOD 8), and that the coding rate r of the 16k-bit LDPC code is set to 6/15 and 11/15.

As described above, the GW pattern for block interleave of the type A, or the GW pattern for block interleave of the type B is set in correspondence with the assumed type for each MODCOD as a combination of the 16k-bit LDPC code and the modulation system.

In addition, as described above, when performing block interleave of the type A on the assumption of execution of block interleave of the type B, the group-wise interleaver 1021 rewrites the GW pattern for block interleave of the type B to the GW pattern for block interleave of the type A such that the same block interleave result as that of the type B is obtainable.

On the other hand, when performing block interleave of the type B on the assumption of execution of block interleave of the type A, the group-wise interleaver 1021 rewrites the GW pattern for block interleave of the type A to the GW pattern for block interleave of the type B such that the same block interleave result as that of the type A is obtainable.

Shown hereinbelow are examples of the original GW pattern and the converted GW pattern as specific examples of the GW pattern set for each MODCOD shown in Fig. 303. Note that a UC or an NUC is applicable to a constellation of QAM such as 16QAM.

Note that the GW pattern for block interleave of the type B is set as the converted GW pattern (B) when the GW pattern for block interleave of the type A is set as the original GW pattern (A) for each MODCOD. In addition, inversely, the GW pattern for block interleave of the type A is set as the converted GW pattern (A) when the GW pattern for block interleave of the type B is set as the original GW pattern (B) for each MODCOD.

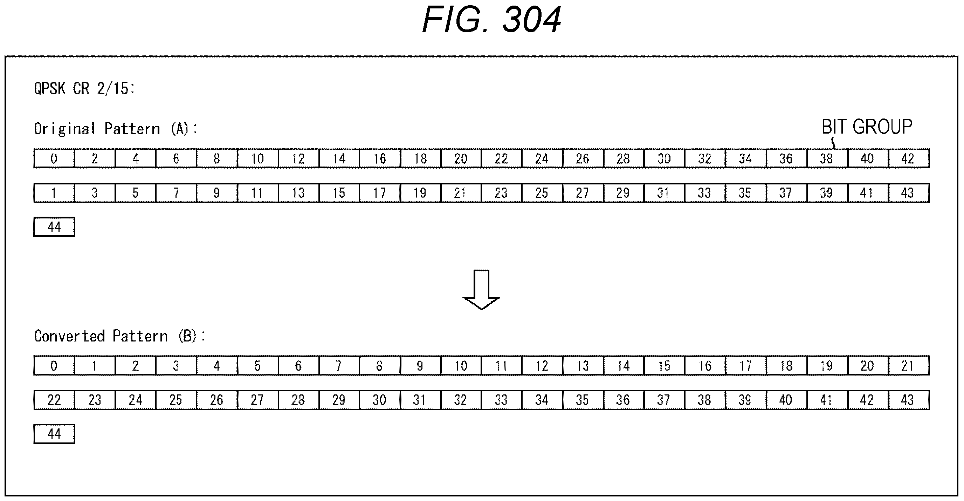

Fig. 304 is a diagram showing an example of a GW pattern for an LDPC code having a code length N of 16k bits with the modulation system set to QPSK and the coding rate r set to 2/15.

According to the original GW pattern (A) in Fig. 304, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

According to the converted GW pattern (B) in Fig. 304, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

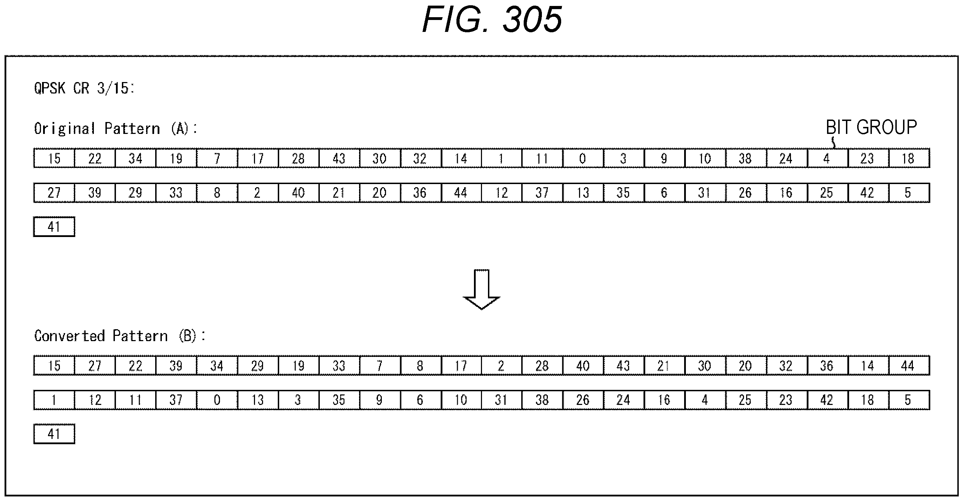

Fig. 305 is a diagram showing an example of a GW pattern for an LDPC code having a code length N of 16k bits with the modulation system set to QPSK and the coding rate r set to 3/15.

According to the original GW pattern (A) in Fig. 305, arrangement of bit groups 0 through 44 of the 16k-bit LDPC code is interleaved to arrangement of bit groups 15, 22, 34, 19, 7, 17, 28, 43, 30, 32, 14, 1, 11, 0, 3, 9, 10, 38, 24, 4, 23, 18, 27, 39, 29, 33, 8, 2, 40, 21, 20, 36, 44, 12, 37, 13, 35, 6, 31, 26, 16, 25, 42, 5, 41.

According to the converted GW pattern (B) in Fig. 305, arrangement of bit groups 0 through 44 of the 16k-bit LDPC code is interleaved to arrangement of bit groups 15, 27, 22, 39, 34, 29, 19, 33, 7, 8, 17, 2, 28, 40, 43, 21, 30, 20, 32, 36, 14, 44, 1, 12, 11, 37, 0, 13, 3, 35, 9, 6, 10, 31, 38, 26, 24, 16, 4, 25, 23, 42, 18, 5, 41.

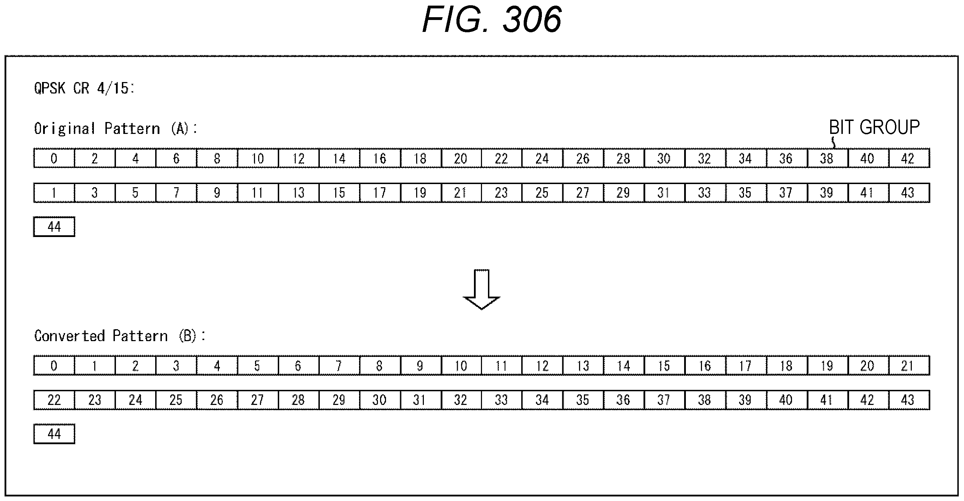

Fig. 306 is a diagram showing an example of a GW pattern for an LDPC code having a code length N of 16k bits with the modulation system set to QPSK and the coding rate r set to 4/15.

According to the original GW pattern (A) in Fig. 306, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

According to the converted GW pattern (B) in Fig. 306, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

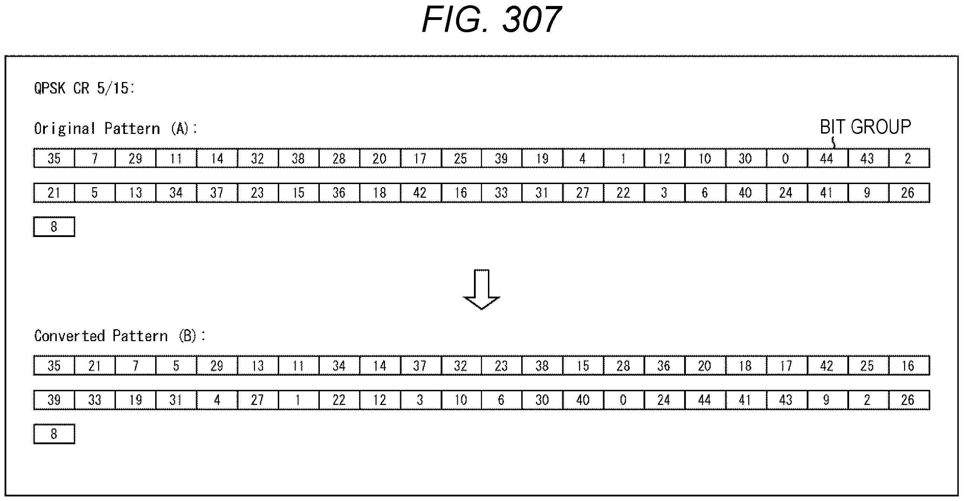

Fig. 307 is a diagram showing an example of a GW pattern for an LDPC code having a code length N of 16k bits with the modulation system set to QPSK and the coding rate r set to 5/15.

According to the original GW pattern (A) in Fig. 307, arrangement of bit groups 0 through 44 of the 16k-bit LDPC code is interleaved to arrangement of bit groups 35, 7, 29, 11, 14, 32, 38, 28, 20, 17, 25, 39, 19, 4, 1, 12, 10, 30, 0, 44, 43, 2, 21, 5, 13, 34, 37, 23, 15, 36, 18, 42, 16, 33, 31, 27, 22, 3, 6, 40, 24, 41, 9, 26, 8.

According to the converted GW pattern (B) in Fig. 307, arrangement of bit groups 0 through 44 of the 16k-bit LDPC code is interleaved to arrangement of bit groups 35, 21, 7, 5, 29, 13, 11, 34, 14, 37, 32, 23, 38, 15, 28, 36, 20, 18, 17, 42, 25, 16, 39, 33, 19, 31, 4, 27, 1, 22, 12, 3, 10, 6, 30, 40, 0, 24, 44, 41, 43, 9, 2, 26, 8.

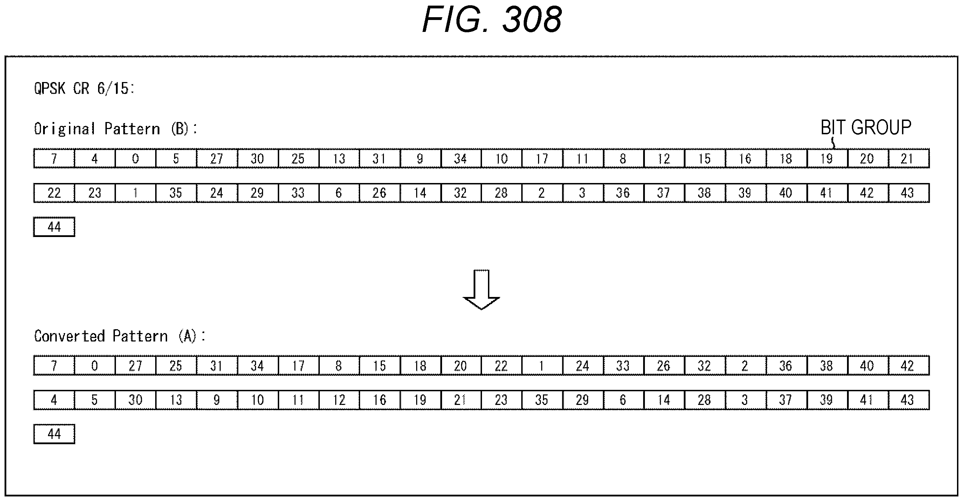

Fig. 308 is a diagram showing an example of a GW pattern for an LDPC code having a code length N of 16k bits with the modulation system set to QPSK and the coding rate r set to 6/15.

According to the original GW pattern (B) in Fig. 308, arrangement of bit groups 0 through 44 of the 16k-bit LDPC code is interleaved to arrangement of bit groups 7, 4, 0, 5, 27, 30, 25, 13, 31, 9, 34, 10, 17, 11, 8, 12, 15, 16, 18, 19, 20, 21, 22, 23, 1, 35, 24, 29, 33, 6, 26, 14, 32, 28, 2, 3, 36, 37, 38, 39, 40, 41, 42, 43, 44.

According to the converted GW pattern (A) in Fig. 308, arrangement of bit groups 0 through 44 of the 16k-bit LDPC code is interleaved to arrangement of bit groups 7, 0, 27, 25, 31, 34, 17, 8, 15, 18, 20, 22, 1, 24, 33, 26, 32, 2, 36, 38, 40, 42, 4, 5, 30, 13, 9, 10, 11, 12, 16, 19, 21, 23, 35, 29, 6, 14, 28, 3, 37, 39, 41, 43, 44.

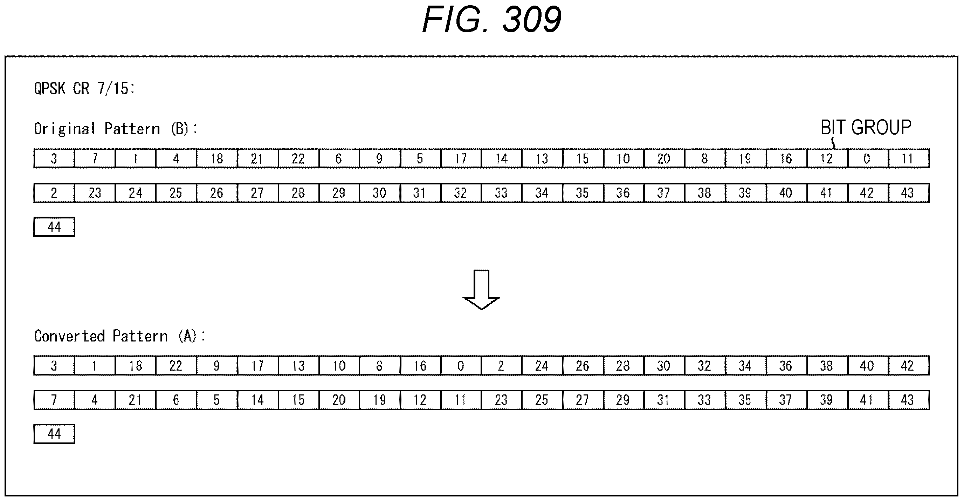

Fig. 309 is a diagram showing an example of a GW pattern for an LDPC code having a code length N of 16k bits with the modulation system set to QPSK and the coding rate r set to 7/15.

According to the original GW pattern (B) in Fig. 309, arrangement of bit groups 0 through 44 of the 16k-bit LDPC code is interleaved to arrangement of bit groups 3, 7, 1, 4, 18, 21, 22, 6, 9, 5, 17, 14, 13, 15, 10, 20, 8, 19, 16, 12, 0, 11, 2, 23, 24, 25, 26, 27, 28, 29, 30, 31, 32, 33, 34, 35, 36, 37, 38, 39, 40, 41, 42, 43, 44.

According to the converted GW pattern (A) in Fig. 309, arrangement of bit groups 0 through 44 of the 16k-bit LDPC code is interleaved to arrangement of bit groups 3, 1, 18, 22, 9, 17, 13, 10, 8, 16, 0, 2, 24, 26, 28, 30, 32, 34, 36, 38, 40, 42, 7, 4, 21, 6, 5, 14, 15, 20, 19, 12, 11, 23, 25, 27, 29, 31, 33, 35, 37, 39, 41, 43, 44.

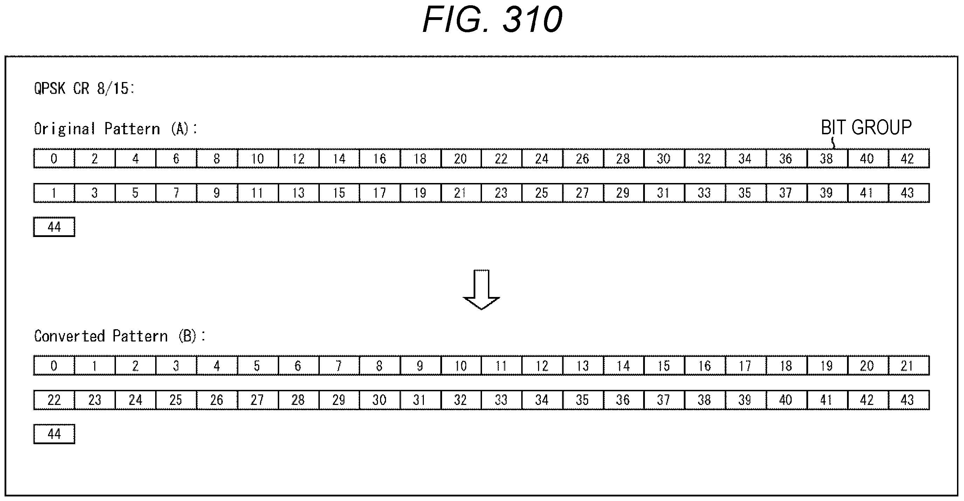

Fig. 310 is a diagram showing an example of a GW pattern for an LDPC code having a code length N of 16k bits with the modulation system set to QPSK and the coding rate r set to 8/15.

According to the original GW pattern (A) in Fig. 310, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

According to the converted GW pattern (B) in Fig. 310, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

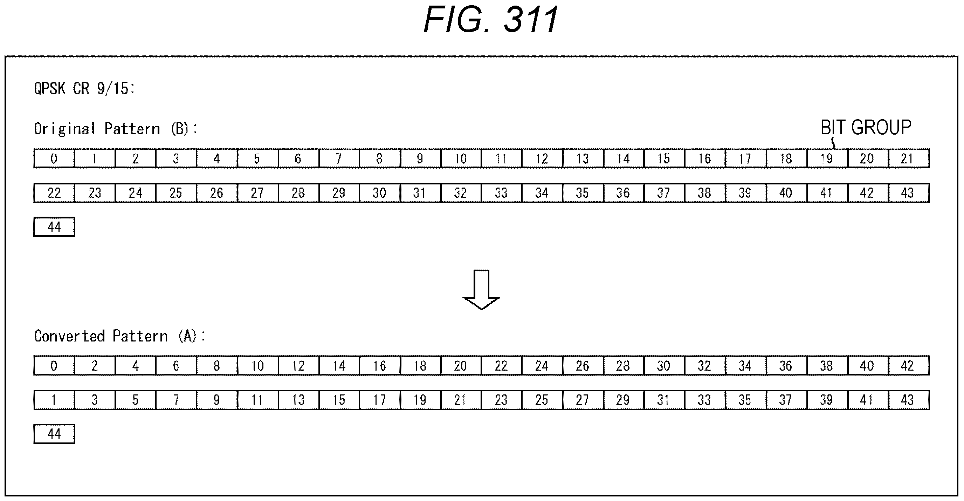

Fig. 311 is a diagram showing an example of a GW pattern for an LDPC code having a code length N of 16k bits with the modulation system set to QPSK and the coding rate r set to 9/15.

According to the original GW pattern (B) in Fig. 311, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

According to the converted GW pattern (A) in Fig. 311, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

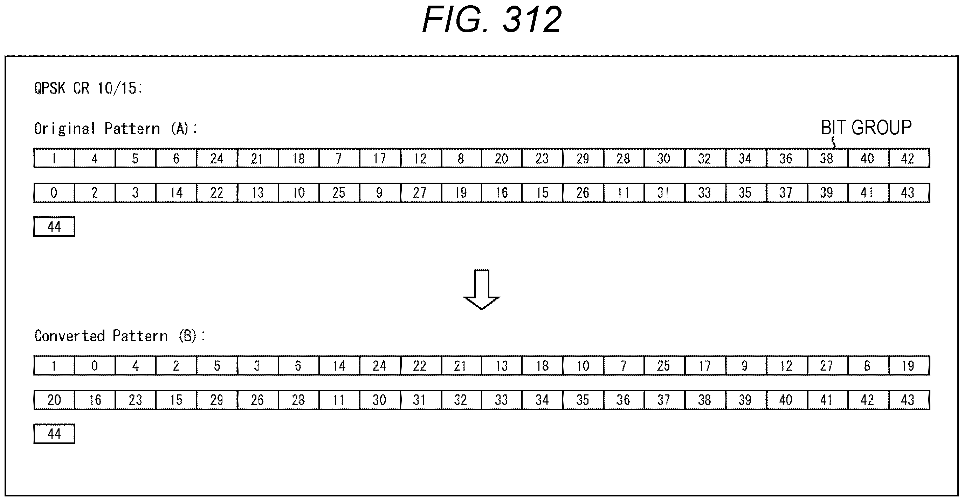

Fig. 312 is a diagram showing an example of a GW pattern for an LDPC code having a code length N of 16k bits with the modulation system set to QPSK and the coding rate r set to 10/15.

According to the original GW pattern (A) in Fig. 312, arrangement of bit groups 0 through 44 of the 16k-bit LDPC code is interleaved to arrangement of bit groups 1, 4, 5, 6, 24, 21, 18, 7, 17, 12, 8, 20, 23, 29, 28, 30, 32, 34, 36, 38, 40, 42, 0, 2, 3, 14, 22, 13, 10, 25, 9, 27, 19, 16, 15, 26, 11, 31, 33, 35, 37, 39, 41, 43, 44.

According to the converted GW pattern (B) in Fig. 312, arrangement of bit groups 0 through 44 of the 16k-bit LDPC code is interleaved to arrangement of bit groups 1, 0, 4, 2, 5, 3, 6, 14, 24, 22, 21, 13, 18, 10, 7, 25, 17, 9, 12, 27, 8, 19, 20, 16, 23, 15, 29, 26, 28, 11, 30, 31, 32, 33, 34, 35, 36, 37, 38, 39, 40, 41, 42, 43, 44.

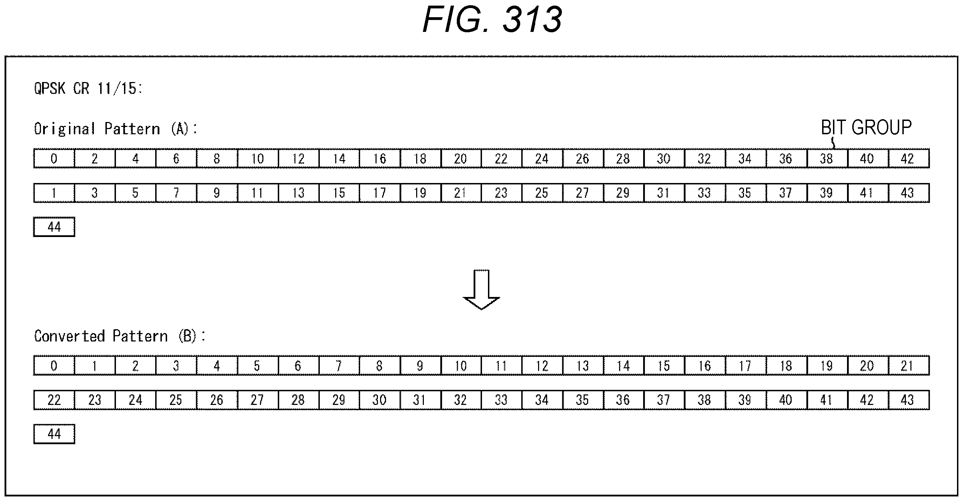

Fig. 313 is a diagram showing an example of a GW pattern for an LDPC code having a code length N of 16k bits with the modulation system set to QPSK and the coding rate r set to 11/15.

According to the original GW pattern (A) in Fig. 313, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

According to the converted GW pattern (B) in Fig. 313, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

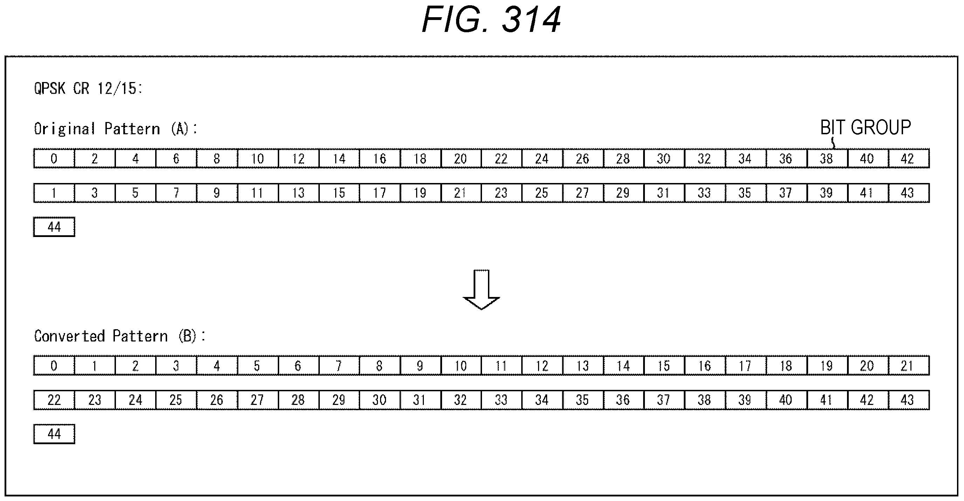

Fig. 314 is a diagram showing an example of a GW pattern for an LDPC code having a code length N of 16k bits with the modulation system set to QPSK and the coding rate r set to 12/15.

According to the original GW pattern (A) in Fig. 314, arrangement of bit groups 0 through 44 of the 16k-bit LDPC code is interleaved to arrangement of bit groups 0, 2, 4, 6, 8, 10, 12, 14, 16, 18, 20, 22, 24, 26, 28, 30, 32, 34, 36, 38, 40, 42, 1, 3, 5, 7, 9, 11, 13, 15, 17, 19, 21, 23, 25, 27, 29, 31, 33, 35, 37, 39, 41, 43, 44.

According to the converted GW pattern (B) in Fig. 314, arrangement of bit groups 0 through 44 of the 16k-bit LDPC code is interleaved to arrangement of bit groups 0, 1, 2, 3, 4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44.

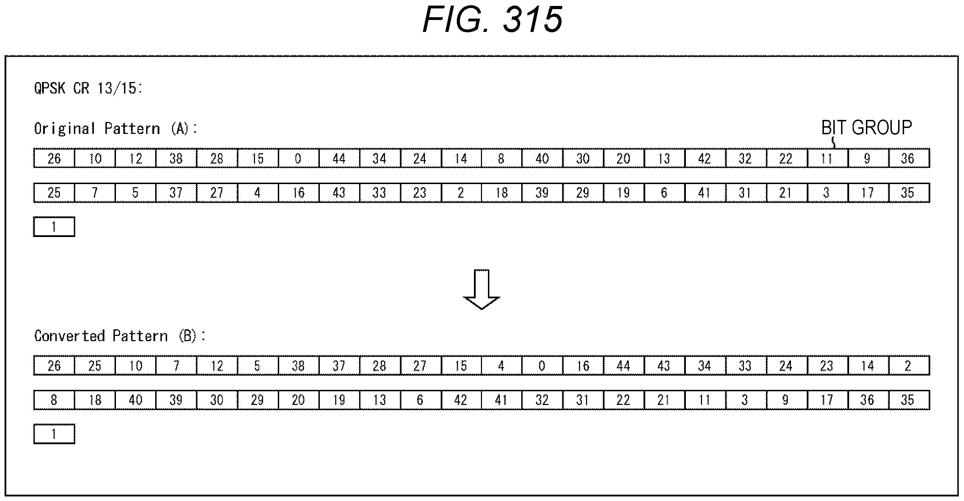

Fig. 315 is a diagram showing an example of a GW pattern for an LDPC code having a code length N of 16k bits with the modulation system set to QPSK and the coding rate r set to 13/15.

According to the original GW pattern (A) in Fig. 315, arrangement of bit groups 0 through 44 of the 16k-bit LDPC code is interleaved to arrangement of bit groups 26, 10, 12, 38, 28, 15, 0, 44, 34, 24, 14, 8, 40, 30, 20, 13, 42, 32, 22, 11, 9, 36, 25, 7, 5, 37, 27, 4, 16, 43, 33, 23, 2, 18, 39, 29, 19, 6, 41, 31, 21, 3, 17, 35, 1.

According to the converted GW pattern (B) in Fig. 315, arrangement of bit groups 0 through 44 of the 16k-bit LDPC code is interleaved to arrangement of bit groups 26, 25, 10, 7, 12, 5, 38, 37, 28, 27, 15, 4, 0, 16, 44, 43, 34, 33, 24, 23, 14, 2, 8, 18, 40, 39, 30, 29, 20, 19, 13, 6, 42, 41, 32, 31, 22, 21, 11, 3, 9, 17, 36, 35, 1.

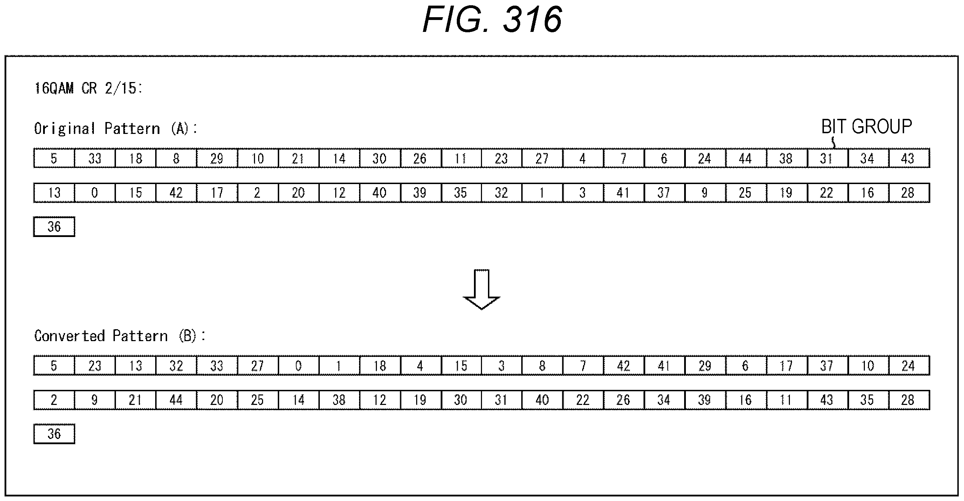

Fig. 316 is a diagram showing an example of a GW pattern for an LDPC code having a code length N of 16k bits with the modulation system set to 16QAM and the coding rate r set to 2/15.

According to the original GW pattern (A) in Fig. 316, arrangement of bit groups 0 through 44 of the 16k-bit LDPC code is interleaved to arrangement of bit groups 5, 33, 18, 8, 29, 10, 21, 14, 30, 26, 11, 23, 27, 4, 7, 6, 24, 44, 38, 31, 34, 43, 13, 0, 15, 42, 17, 2, 20, 12, 40, 39, 35, 32, 1, 3, 41, 37, 9, 25, 19, 22, 16, 28, 36.

According to the converted GW pattern (B) in Fig. 316, arrangement of bit groups 0 through 44 of the 16k-bit LDPC code is interleaved to arrangement of bit groups 5, 23, 13, 32, 33, 27, 0, 1, 18, 4, 15, 3, 8, 7, 42, 41, 29, 6, 17, 37, 10, 24, 2, 9, 21, 44, 20, 25, 14, 38, 12, 19, 30, 31, 40, 22, 26, 34, 39, 16, 11, 43, 35, 28, 36.

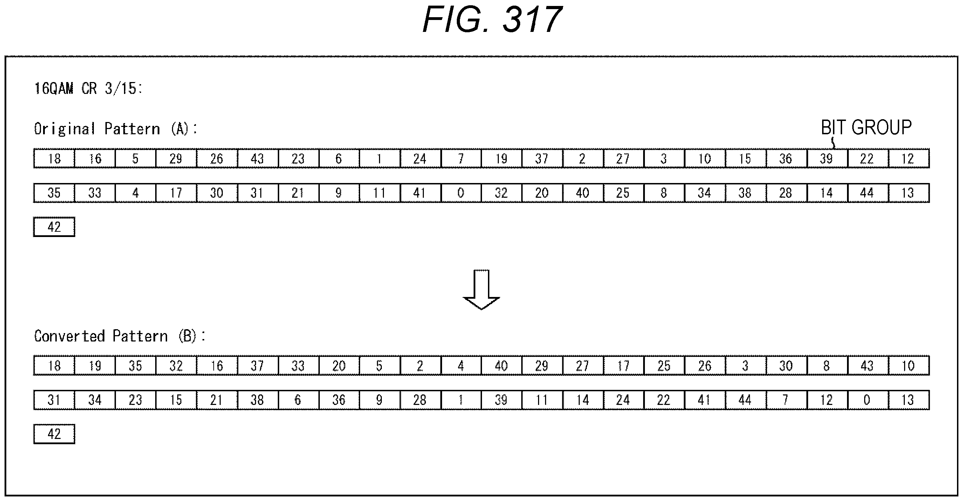

Fig. 317 is a diagram showing an example of a GW pattern for an LDPC code having a code length N of 16k bits with the modulation system set to 16QAM and the coding rate r set to 3/15.

According to the original GW pattern (A) in Fig. 317, arrangement of bit groups 0 through 44 of the 16k-bit LDPC code is interleaved to arrangement of bit groups 18, 16, 5, 29, 26, 43, 23, 6, 1, 24, 7, 19, 37, 2, 27, 3, 10, 15, 36, 39, 22, 12, 35, 33, 4, 17, 30, 31, 21, 9, 11, 41, 0, 32, 20, 40, 25, 8, 34, 38, 28, 14, 44, 13, 42.

According to the converted GW pattern (B) in Fig. 317, arrangement of bit groups 0 through 44 of the 16k-bit LDPC code is interleaved to arrangement of bit groups 18, 19, 35, 32, 16, 37, 33, 20, 5, 2, 4, 40, 29, 27, 17, 25, 26, 3, 30, 8, 43, 10, 31, 34, 23, 15, 21, 38, 6, 36, 9, 28, 1, 39, 11, 14, 24, 22, 41, 44, 7, 12, 0, 13, 42.

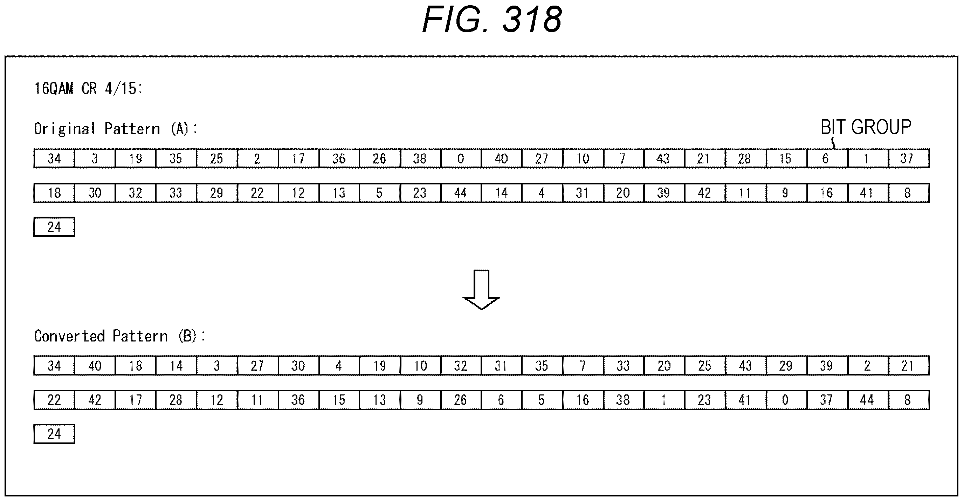

Fig. 318 is a diagram showing an example of a GW pattern for an LDPC code having a code length N of 16k bits with the modulation system set to 16QAM and the coding rate r set to 4/15.

According to the original GW pattern (A) in Fig. 318, arrangement of bit groups 0 through 44 of the 16k-bit LDPC code is interleaved to arrangement of bit groups 34, 3, 19, 35, 25, 2, 17, 36, 26, 38, 0, 40, 27, 10, 7, 43, 21, 28, 15, 6, 1, 37, 18, 30, 32, 33, 29, 22, 12, 13, 5, 23, 44, 14, 4, 31, 20, 39, 42, 11, 9, 16, 41, 8, 24.

According to the converted GW pattern (B) in Fig. 318, arrangement of bit groups 0 through 44 of the 16k-bit LDPC code is interleaved to arrangement of bit groups 34, 40, 18, 14, 3, 27, 30, 4, 19, 10, 32, 31, 35, 7, 33, 20, 25, 43, 29, 39, 2, 21, 22, 42, 17, 28, 12, 11, 36, 15, 13, 9, 26, 6, 5, 16, 38, 1, 23, 41, 0, 37, 44, 8, 24.

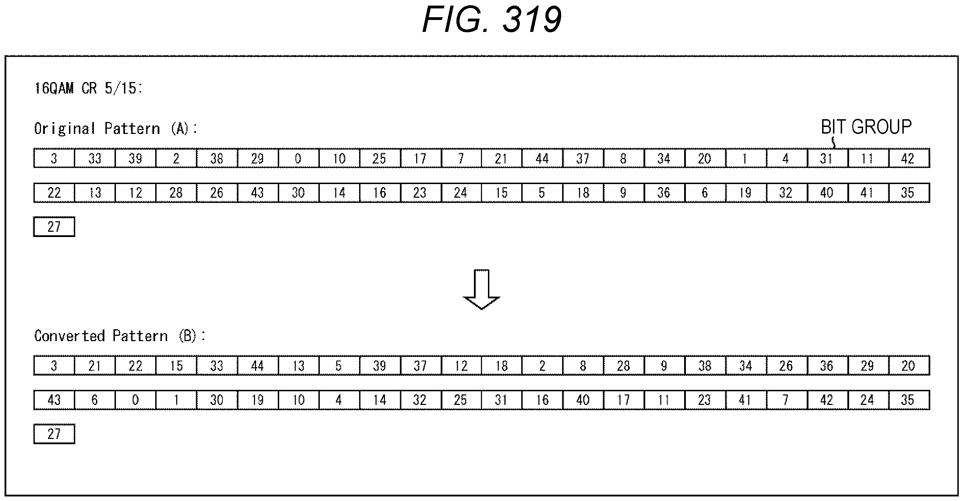

Fig. 319 is a diagram showing an example of a GW pattern for an LDPC code having a code length N of 16k bits with the modulation system set to 16QAM and the coding rate r set to 5/15.

According to the original GW pattern (A) in Fig. 319, arrangement of bit groups 0 through 44 of the 16k-bit LDPC code is interleaved to arrangement of bit groups 3, 33, 39, 2, 38, 29, 0, 10, 25, 17, 7, 21, 44, 37, 8, 34, 20, 1, 4, 31, 11, 42, 22, 13, 12, 28, 26, 43, 30, 14, 16, 23, 24, 15, 5, 18, 9, 36, 6, 19, 32, 40, 41, 35, 27.

According to the converted GW pattern (B) in Fig. 319, arrangement of bit groups 0 through 44 of the 16k-bit LDPC code is interleaved to arrangement of bit groups 3, 21, 22, 15, 33, 44, 13, 5, 39, 37, 12, 18, 2, 8, 28, 9, 38, 34, 26, 36, 29, 20, 43, 6, 0, 1, 30, 19, 10, 4, 14, 32, 25, 31, 16, 40, 17, 11, 23, 41, 7, 42, 24, 35, 27.

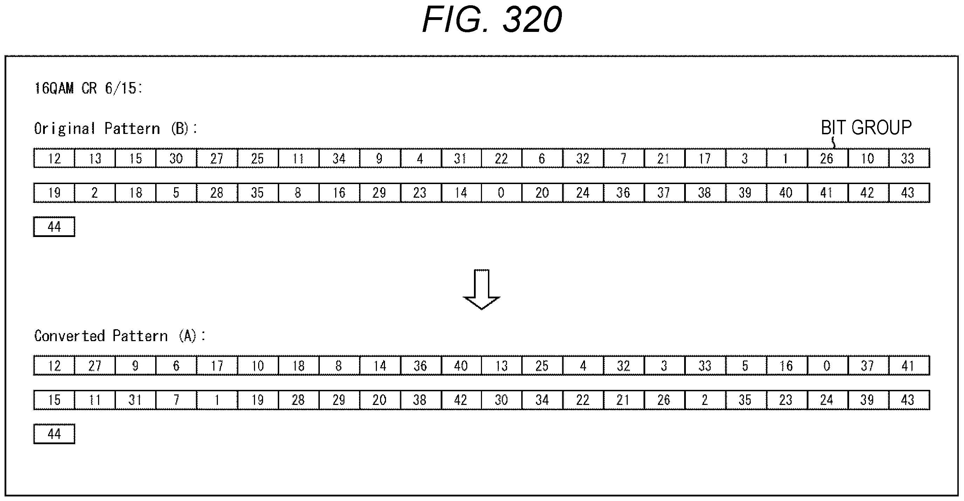

Fig. 320 is a diagram showing an example of a GW pattern for an LDPC code having a code length N of 16k bits with the modulation system set to 16QAM and the coding rate r set to 6/15.

According to the original GW pattern (B) in Fig. 320, arrangement of bit groups 0 through 44 of the 16k-bit LDPC code is interleaved to arrangement of bit groups 12, 13, 15, 30, 27, 25, 11, 34, 9, 4, 31, 22, 6, 32, 7, 21, 17, 3, 1, 26, 10, 33, 19, 2, 18, 5, 28, 35, 8, 16, 29, 23, 14, 0, 20, 24, 36, 37, 38, 39, 40, 41, 42, 43, 44.

According to the converted GW pattern (A) in Fig. 320, arrangement of bit groups 0 through 44 of the 16k-bit LDPC code is interleaved to arrangement of bit groups 12, 27, 9, 6, 17, 10, 18, 8, 14, 36, 40, 13, 25, 4, 32, 3, 33, 5, 16, 0, 37, 41, 15, 11, 31, 7, 1, 19, 28, 29, 20, 38, 42, 30, 34, 22, 21, 26, 2, 35, 23, 24, 39, 43, 44.

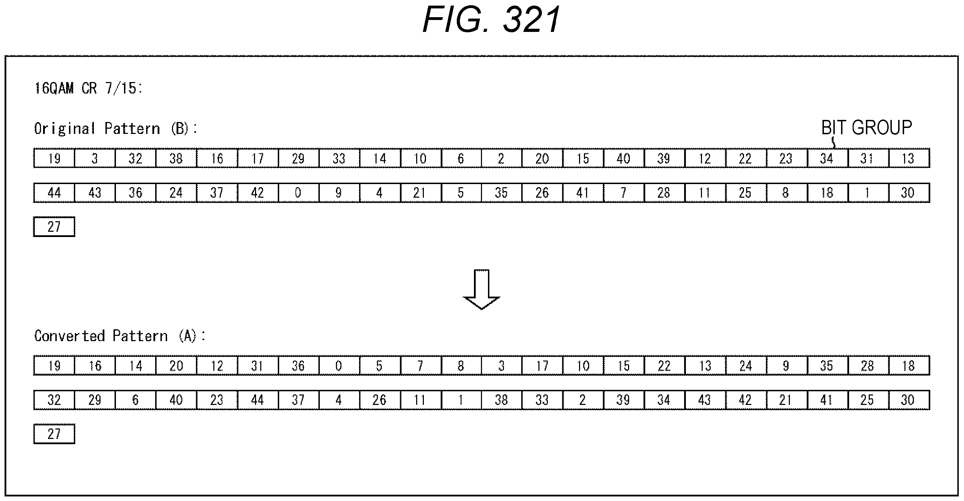

Fig. 321 is a diagram showing an example of a GW pattern for an LDPC code having a code length N of 16k bits with the modulation system set to 16QAM and the coding rate r set to 7/15.

According to the original GW pattern (B) in Fig. 321, arrangement of bit groups 0 through 44 of the 16k-bit LDPC code is interleaved to arrangement of bit groups 19, 3, 32, 38, 16, 17, 29, 33, 14, 10, 6, 2, 20, 15, 40, 39, 12, 22, 23, 34, 31, 13, 44, 43, 36, 24, 37, 42, 0, 9, 4, 21, 5, 35, 26, 41, 7, 28, 11, 25, 8, 18, 1, 30, 27.

According to the converted GW pattern (A) in Fig. 321, arrangement of bit groups 0 through 44 of the 16k-bit LDPC code is interleaved to arrangement of bit groups 19, 16, 14, 20, 12, 31, 36, 0, 5, 7, 8, 3, 17, 10, 15, 22, 13, 24, 9, 35, 28, 18, 32, 29, 6, 40, 23, 44, 37, 4, 26, 11, 1, 38, 33, 2, 39, 34, 43, 42, 21, 41, 25, 30, 27.

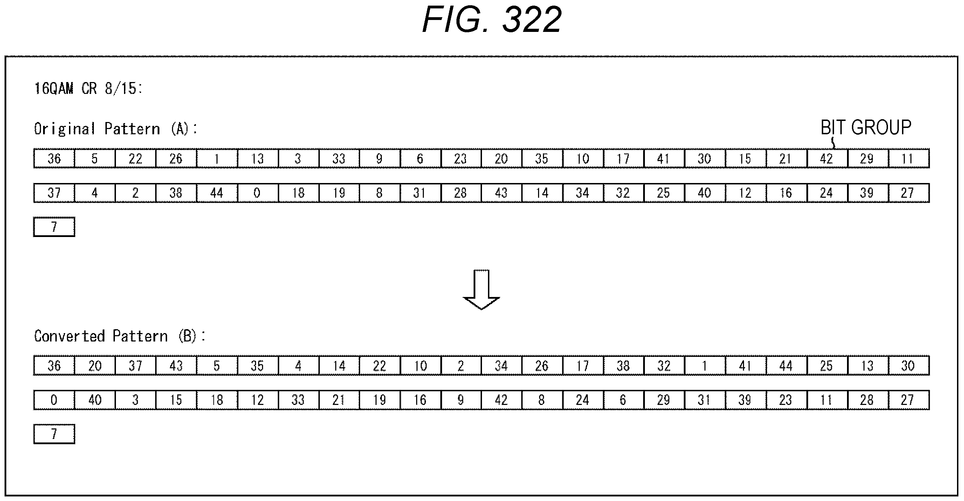

Fig. 322 is a diagram showing an example of a GW pattern for an LDPC code having a code length N of 16k bits with the modulation system set to 16QAM and the coding rate r set to 8/15.

According to the original GW pattern (A) in Fig. 322, arrangement of bit groups 0 through 44 of the 16k-bit LDPC code is interleaved to arrangement of bit groups 36, 5, 22, 26, 1, 13, 3, 33, 9, 6, 23, 20, 35, 10, 17, 41, 30, 15, 21, 42, 29, 11, 37, 4, 2, 38, 44, 0, 18, 19, 8, 31, 28, 43, 14, 34, 32, 25, 40, 12, 16, 24, 39, 27, 7.

According to the converted GW pattern (B) in Fig. 322, arrangement of bit groups 0 through 44 of the 16k-bit LDPC code is interleaved to arrangement of bit groups 36, 20, 37, 43, 5, 35, 4, 14, 22, 10, 2, 34, 26, 17, 38, 32, 1, 41, 44, 25, 13, 30, 0, 40, 3, 15, 18, 12, 33, 21, 19, 16, 9, 42, 8, 24, 6, 29, 31, 39, 23, 11, 28, 27, 7.

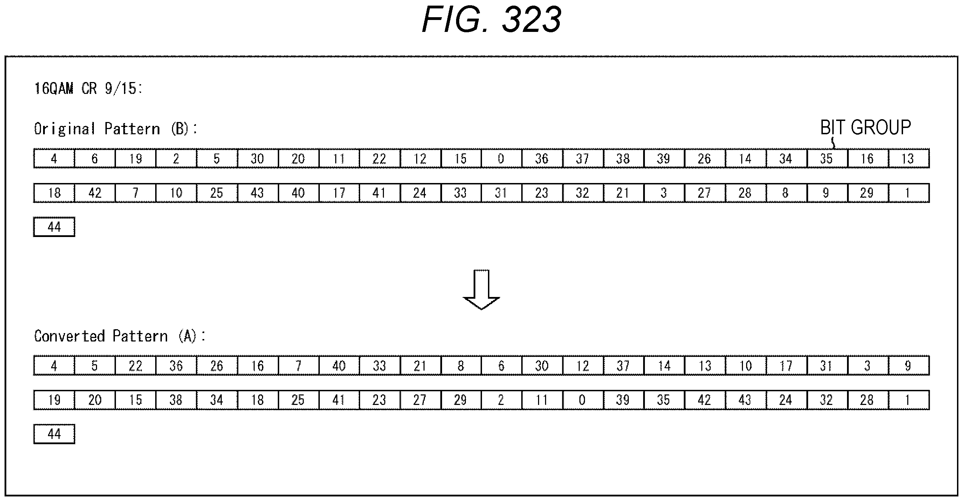

Fig. 323 is a diagram showing an example of a GW pattern for an LDPC code having a code length N of 16k bits with the modulation system set to 16QAM and the coding rate r set to 9/15.

According to the original GW pattern (B) in Fig. 323, arrangement of bit groups 0 through 44 of the 16k-bit LDPC code is interleaved to arrangement of bit groups 4, 6, 19, 2, 5, 30, 20, 11, 22, 12, 15, 0, 36, 37, 38, 39, 26, 14, 34, 35, 16, 13, 18, 42, 7, 10, 25, 43, 40, 17, 41, 24, 33, 31, 23, 32, 21, 3, 27, 28, 8, 9, 29, 1, 44.

According to the converted GW pattern (A) in Fig. 323, arrangement of bit groups 0 through 44 of the 16k-bit LDPC code is interleaved to arrangement of bit groups 4, 5, 22, 36, 26, 16, 7, 40, 33, 21, 8, 6, 30, 12, 37, 14, 13, 10, 17, 31, 3, 9, 19, 20, 15, 38, 34, 18, 25, 41, 23, 27, 29, 2, 11, 0, 39, 35, 42, 43, 24, 32, 28, 1, 44.

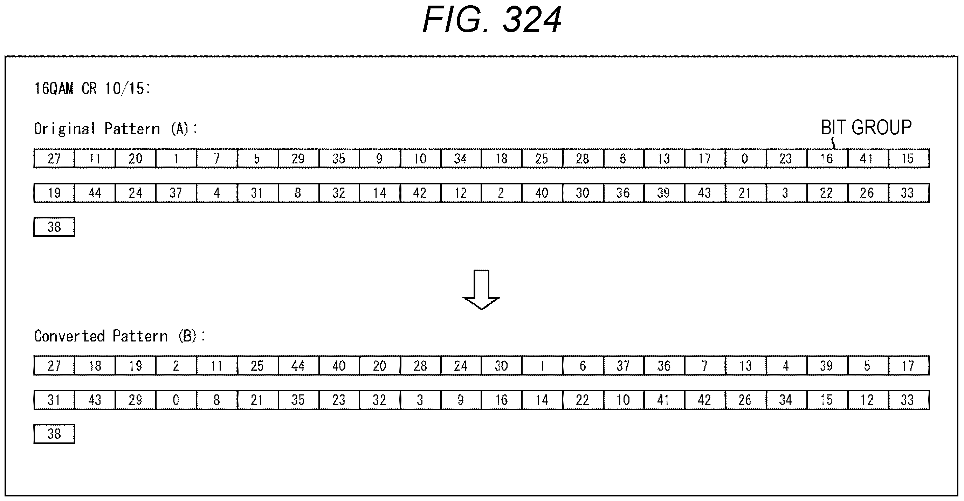

Fig. 324 is a diagram showing an example of a GW pattern for an LDPC code having a code length N of 16k bits with the modulation system set to 16QAM and the coding rate r set to 10/15.

According to the original GW pattern (A) in Fig. 324, arrangement of bit groups 0 through 44 of the 16k-bit LDPC code is interleaved to arrangement of bit groups 27, 11, 20, 1, 7, 5, 29, 35, 9, 10, 34, 18, 25, 28, 6, 13, 17, 0, 23, 16, 41, 15, 19, 44, 24, 37, 4, 31, 8, 32, 14, 42, 12, 2, 40, 30, 36, 39, 43, 21, 3, 22, 26, 33, 38.

According to the converted GW pattern (B) in Fig. 324, arrangement of bit groups 0 through 44 of the 16k-bit LDPC code is interleaved to arrangement of bit groups 27, 18, 19, 2, 11, 25, 44, 40, 20, 28, 24, 30, 1, 6, 37, 36, 7, 13, 4, 39, 5, 17, 31, 43, 29, 0, 8, 21, 35, 23, 32, 3, 9, 16, 14, 22, 10, 41, 42, 26, 34, 15, 12, 33, 38.

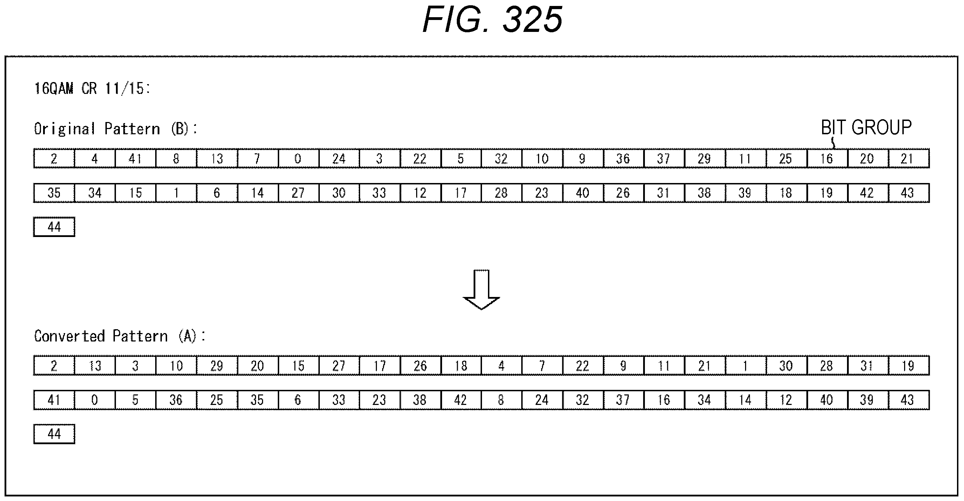

Fig. 325 is a diagram showing an example of a GW pattern for an LDPC code having a code length N of 16k bits with the modulation system set to 16QAM and the coding rate r set to 11/15.

According to the original GW pattern (B) in Fig. 325, arrangement of bit groups 0 through 44 of the 16k-bit LDPC code is interleaved to arrangement of bit groups 2, 4, 41, 8, 13, 7, 0, 24, 3, 22, 5, 32, 10, 9, 36, 37, 29, 11, 25, 16, 20, 21, 35, 34, 15, 1, 6, 14, 27, 30, 33, 12, 17, 28, 23, 40, 26, 31, 38, 39, 18, 19, 42, 43, 44.

According to the converted GW pattern (A) in Fig. 325, arrangement of bit groups 0 through 44 of the 16k-bit LDPC code is interleaved to arrangement of bit groups 2, 13, 3, 10, 29, 20, 15, 27, 17, 26, 18, 4, 7, 22, 9, 11, 21, 1, 30, 28, 31, 19, 41, 0, 5, 36, 25, 35, 6, 33, 23, 38, 42, 8, 24, 32, 37, 16, 34, 14, 12, 40, 39, 43, 44.

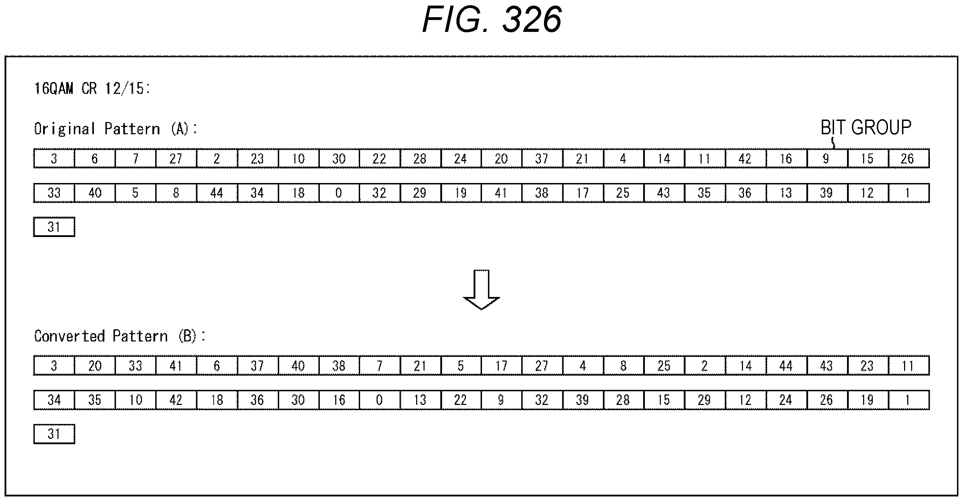

Fig. 326 is a diagram showing an example of a GW pattern for an LDPC code having a code length N of 16k bits with the modulation system set to 16QAM and the coding rate r set to 12/15.

According to the original GW pattern (A) in Fig. 326, arrangement of bit groups 0 through 44 of the 16k-bit LDPC code is interleaved to arrangement of bit groups 3, 6, 7, 27, 2, 23, 10, 30, 22, 28, 24, 20, 37, 21, 4, 14, 11, 42, 16, 9, 15, 26, 33, 40, 5, 8, 44, 34, 18, 0, 32, 29, 19, 41, 38, 17, 25, 43, 35, 36, 13, 39, 12, 1, 31.

According to the converted GW pattern (B) in Fig. 326, arrangement of bit groups 0 through 44 of the 16k-bit LDPC code is interleaved to arrangement of bit groups 3, 20, 33, 41, 6, 37, 40, 38, 7, 21, 5, 17, 27, 4, 8, 25, 2, 14, 44, 43, 23, 11, 34, 35, 10, 42, 18, 36, 30, 16, 0, 13, 22, 9, 32, 39, 28, 15, 29, 12, 24, 26, 19, 1, 31.

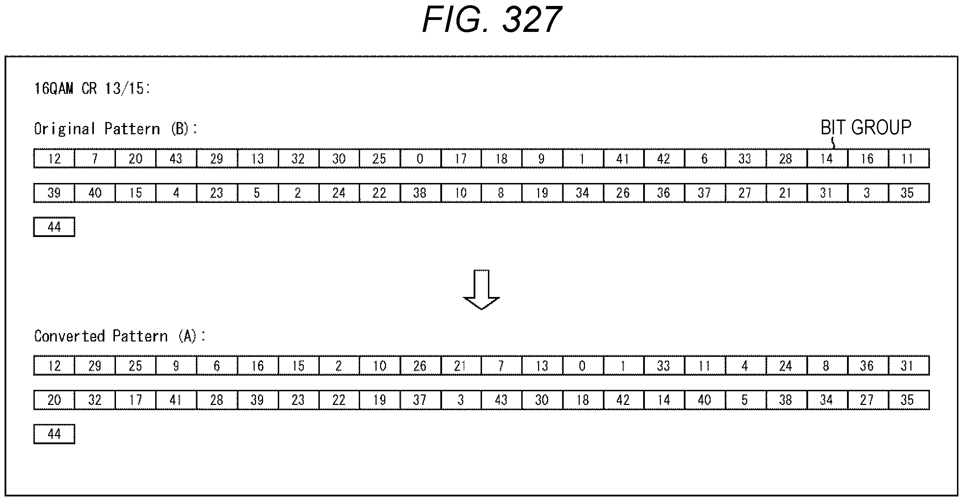

Fig. 327 is a diagram showing an example of a GW pattern for an LDPC code having a code length N of 16k bits with the modulation system set to 16QAM and the coding rate r set to 13/15.

According to the original GW pattern (B) in Fig. 327, arrangement of bit groups 0 through 44 of the 16k-bit LDPC code is interleaved to arrangement of bit groups 12, 7, 20, 43, 29, 13, 32, 30, 25, 0, 17, 18, 9, 1, 41, 42, 6, 33, 28, 14, 16, 11, 39, 40, 15, 4, 23, 5, 2, 24, 22, 38, 10, 8, 19, 34, 26, 36, 37, 27, 21, 31, 3, 35, 44.

According to the converted GW pattern (A) in Fig. 327, arrangement of bit groups 0 through 44 of the 16k-bit LDPC code is interleaved to arrangement of bit groups 12, 29, 25, 9, 6, 16, 15, 2, 10, 26, 21, 7, 13, 0, 1, 33, 11, 4, 24, 8, 36, 31, 20, 32, 17, 41, 28, 39, 23, 22, 19, 37, 3, 43, 30, 18, 42, 14, 40, 5, 38, 34, 27, 35, 44.

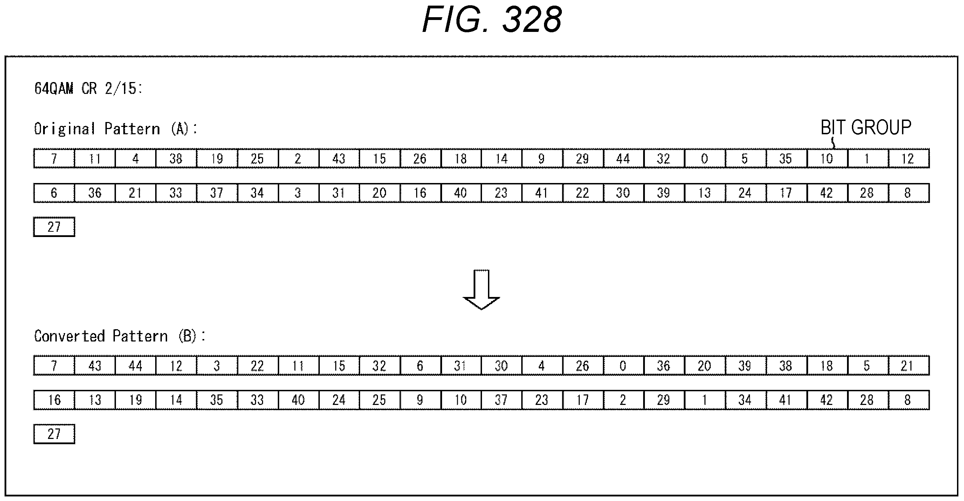

Fig. 328 is a diagram showing an example of a GW pattern for an LDPC code having a code length N of 16k bits with the modulation system set to 64QAM and the coding rate r set to 2/15.

According to the original GW pattern (A) in Fig. 328, arrangement of bit groups 0 through 44 of the 16k-bit LDPC code is interleaved to arrangement of bit groups 7, 11, 4, 38, 19, 25, 2, 43, 15, 26, 18, 14, 9, 29, 44, 32, 0, 5, 35, 10, 1, 12, 6, 36, 21, 33, 37, 34, 3, 31, 20, 16, 40, 23, 41, 22, 30, 39, 13, 24, 17, 42, 28, 8, 27.

According to the converted GW pattern (B) in Fig. 328, arrangement of bit groups 0 through 44 of the 16k-bit LDPC code is interleaved to arrangement of bit groups 7, 43, 44, 12, 3, 22, 11, 15, 32, 6, 31, 30, 4, 26, 0, 36, 20, 39, 38, 18, 5, 21, 16, 13, 19, 14, 35, 33, 40, 24, 25, 9, 10, 37, 23, 17, 2, 29, 1, 34, 41, 42, 28, 8, 27.

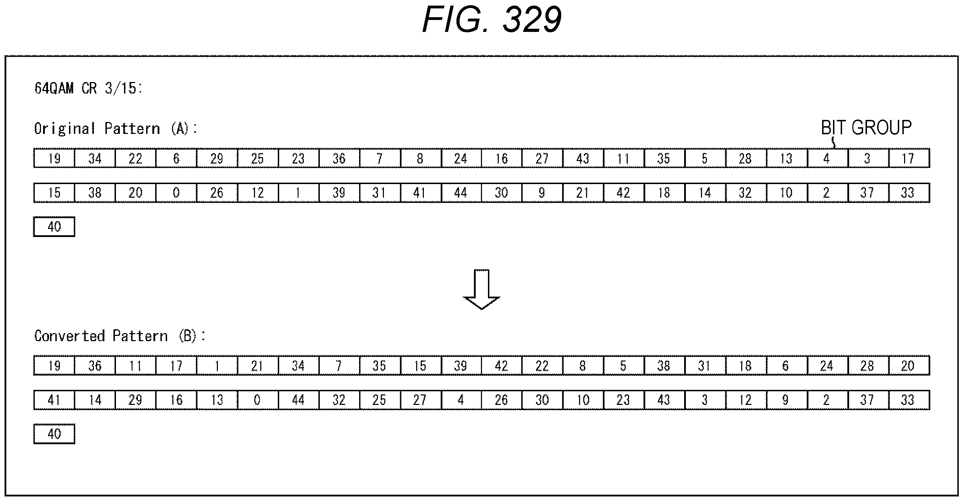

Fig. 329 is a diagram showing an example of a GW pattern for an LDPC code having a code length N of 16k bits with the modulation system set to 64QAM and the coding rate r set to 3/15.

According to the original GW pattern (A) in Fig. 329, arrangement of bit groups 0 through 44 of the 16k-bit LDPC code is interleaved to arrangement of bit groups 19, 34, 22, 6, 29, 25, 23, 36, 7, 8, 24, 16, 27, 43, 11, 35, 5, 28, 13, 4, 3, 17, 15, 38, 20, 0, 26, 12, 1, 39, 31, 41, 44, 30, 9, 21, 42, 18, 14, 32, 10, 2, 37, 33, 40.

According to the converted GW pattern (B) in Fig. 329, arrangement of bit groups 0 through 44 of the 16k-bit LDPC code is interleaved to arrangement of bit groups 19, 36, 11, 17, 1, 21, 34, 7, 35, 15, 39, 42, 22, 8, 5, 38, 31, 18, 6, 24, 28, 20, 41, 14, 29, 16, 13, 0, 44, 32, 25, 27, 4, 26, 30, 10, 23, 43, 3, 12, 9, 2, 37, 33, 40.

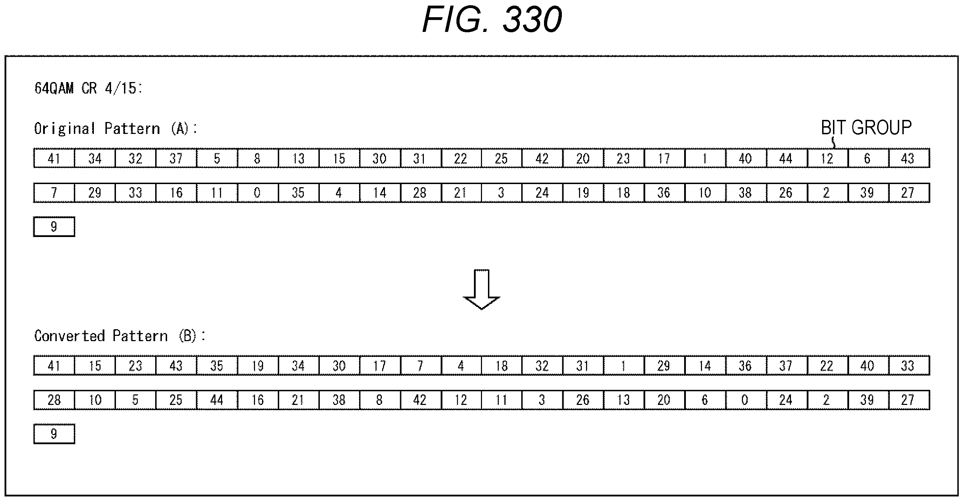

Fig. 330 is a diagram showing an example of a GW pattern for an LDPC code having a code length N of 16k bits with the modulation system set to 64QAM and the coding rate r set to 4/15.

According to the original GW pattern (A) in Fig. 330, arrangement of bit groups 0 through 44 of the 16k-bit LDPC code is interleaved to arrangement of bit groups 41, 34, 32, 37, 5, 8, 13, 15, 30, 31, 22, 25, 42, 20, 23, 17, 1, 40, 44, 12, 6, 43, 7, 29, 33, 16, 11, 0, 35, 4, 14, 28, 21, 3, 24, 19, 18, 36, 10, 38, 26, 2, 39, 27, 9.

According to the converted GW pattern (B) in Fig. 330, arrangement of bit groups 0 through 44 of the 16k-bit LDPC code is interleaved to arrangement of bit groups 41, 15, 23, 43, 35, 19, 34, 30, 17, 7, 4, 18, 32, 31, 1, 29, 14, 36, 37, 22, 40, 33, 28, 10, 5, 25, 44, 16, 21, 38, 8, 42, 12, 11, 3, 26, 13, 20, 6, 0, 24, 2, 39, 27, 9.

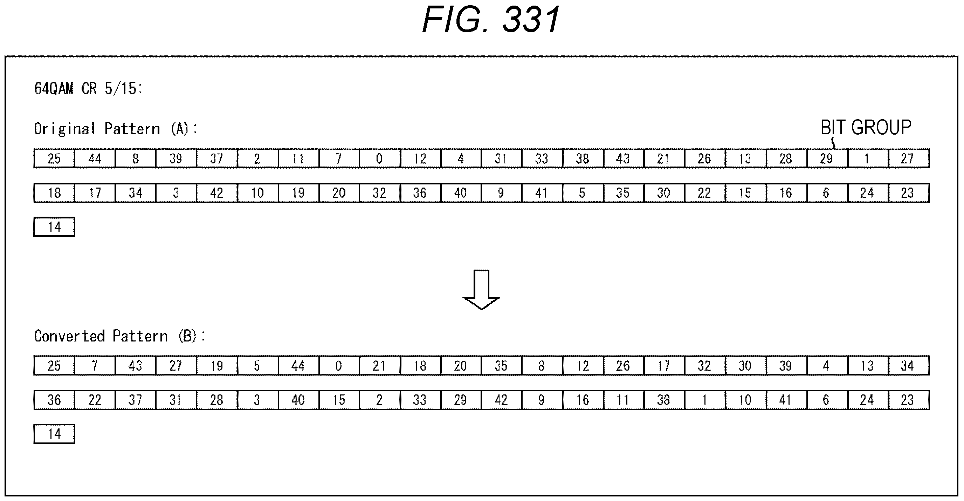

Fig. 331 is a diagram showing an example of a GW pattern for an LDPC code having a code length N of 16k bits with the modulation system set to 64QAM and the coding rate r set to 5/15.

According to the original GW pattern (A) in Fig. 331, arrangement of bit groups 0 through 44 of the 16k-bit LDPC code is interleaved to arrangement of bit groups 25, 44, 8, 39, 37, 2, 11, 7, 0, 12, 4, 31, 33, 38, 43, 21, 26, 13, 28, 29, 1, 27, 18, 17, 34, 3, 42, 10, 19, 20, 32, 36, 40, 9, 41, 5, 35, 30, 22, 15, 16, 6, 24, 23, 14.

According to the converted GW pattern (B) in Fig. 331, arrangement of bit groups 0 through 44 of the 16k-bit LDPC code is interleaved to arrangement of bit groups 25 7 43 27 19 5 44 0 21 18 20 35 8 12 26 17 32 30 39 4 13 34 36 22 37 31 28 3 40 15 2 33 29 42 9 16 11 38 1 10 41 6 24 23 14.

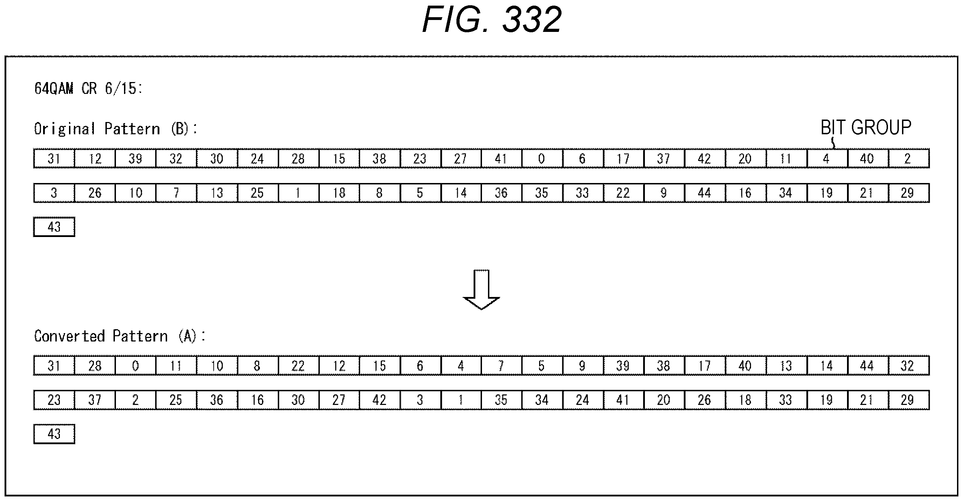

Fig. 332 is a diagram showing an example of a GW pattern for an LDPC code having a code length N of 16k bits with the modulation system set to 64QAM and the coding rate r set to 6/15.

According to the original GW pattern (B) in Fig. 332, arrangement of bit groups 0 through 44 of the 16k-bit LDPC code is interleaved to arrangement of bit groups 31, 12, 39, 32, 30, 24, 28, 15, 38, 23, 27, 41, 0, 6, 17, 37, 42, 20, 11, 4, 40, 2, 3, 26, 10, 7, 13, 25, 1, 18, 8, 5, 14, 36, 35, 33, 22, 9, 44, 16, 34, 19, 21, 29, 43.

According to the converted GW pattern (A) in Fig. 332, arrangement of bit groups 0 through 44 of the 16k-bit LDPC code is interleaved to arrangement of bit groups 31, 28, 0, 11, 10, 8, 22, 12, 15, 6, 4, 7, 5, 9, 39, 38, 17, 40, 13, 14, 44, 32, 23, 37, 2, 25, 36, 16, 30, 27, 42, 3, 1, 35, 34, 24, 41, 20, 26, 18, 33, 19, 21, 29, 43.

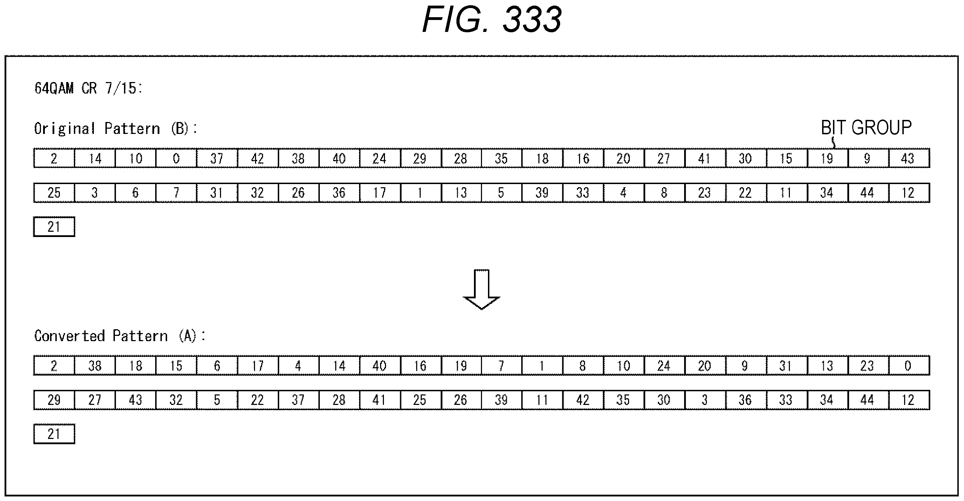

Fig. 333 is a diagram showing an example of a GW pattern for an LDPC code having a code length N of 16k bits with the modulation system set to 64QAM and the coding rate r set to 7/15.

According to the original GW pattern (B) in Fig. 333, arrangement of bit groups 0 through 44 of the 16k-bit LDPC code is interleaved to arrangement of bit groups 2, 14, 10, 0, 37, 42, 38, 40, 24, 29, 28, 35, 18, 16, 20, 27, 41, 30, 15, 19, 9, 43, 25, 3, 6, 7, 31, 32, 26, 36, 17, 1, 13, 5, 39, 33, 4, 8, 23, 22, 11, 34, 44, 12, 21.

According to the converted GW pattern (A) in Fig. 333, arrangement of a bit group 0 through 44 of the 16k-bit LDPC code is interleaved to arrangement of a bit group 2, 38, 18, 15, 6, 17, 4, 14, 40, 16, 19, 7, 1, 8, 10, 24, 20, 9, 31, 13, 23, 0, 29, 27, 43, 32, 5, 22, 37, 28, 41, 25, 26, 39, 11, 42, 35, 30, 3, 36, 33, 34, 44, 12, 21.

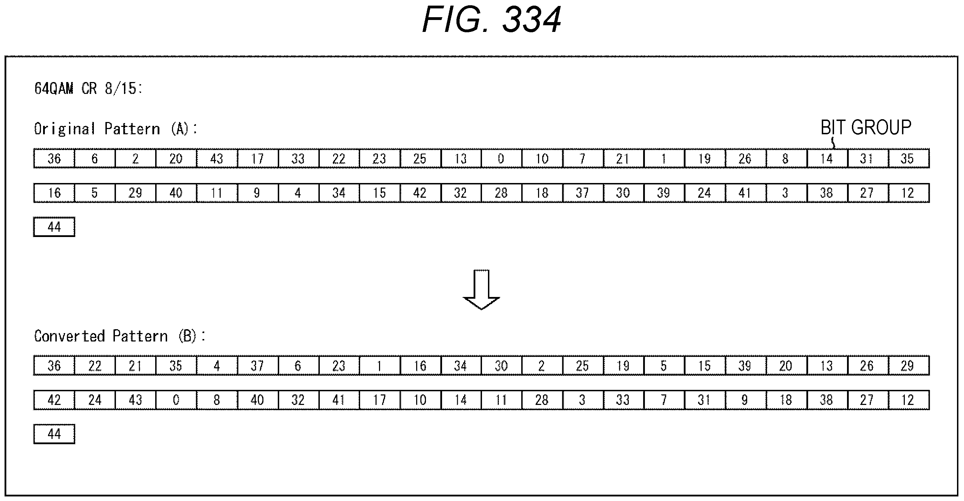

Fig. 334 is a diagram showing an example of a GW pattern for an LDPC code having a code length N of 16k bits with the modulation system set to 64QAM and the coding rate r set to 8/15.

According to the original GW pattern (A) in Fig. 334, arrangement of bit groups 0 through 44 of the 16k-bit LDPC code is interleaved to arrangement of bit groups 36, 6, 2, 20, 43, 17, 33, 22, 23, 25, 13, 0, 10, 7, 21, 1, 19, 26, 8, 14, 31, 35, 16, 5, 29, 40, 11, 9, 4, 34, 15, 42, 32, 28, 18, 37, 30, 39, 24, 41, 3, 38, 27, 12, 44.

According to the converted GW pattern (B) in Fig. 334, arrangement of bit groups 0 through 44 of the 16k-bit LDPC code is interleaved to arrangement of bit groups 36, 22, 21, 35, 4, 37, 6, 23, 1, 16, 34, 30, 2, 25, 19, 5, 15, 39, 20, 13, 26, 29, 42, 24, 43, 0, 8, 40, 32, 41, 17, 10, 14, 11, 28, 3, 33, 7, 31, 9, 18, 38, 27, 12, 44.

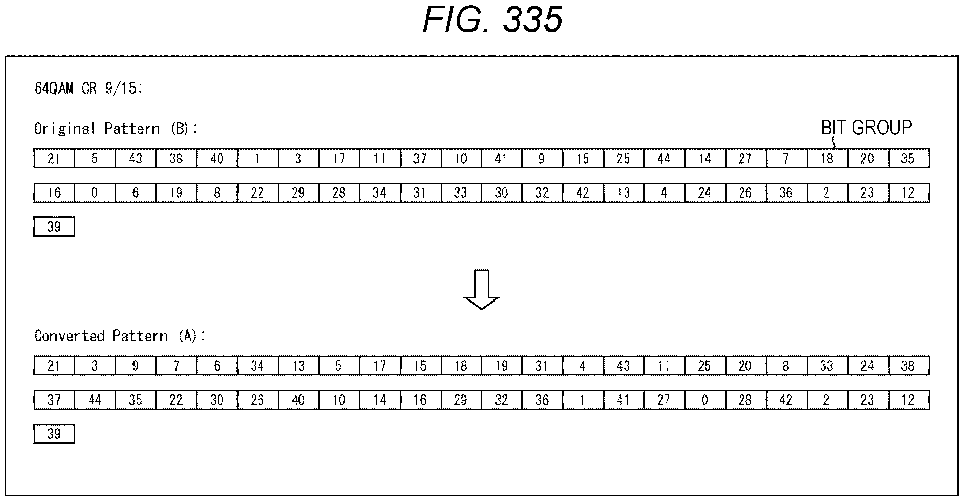

Fig. 335 is a diagram showing an example of a GW pattern for an LDPC code having a code length N of 16k bits with the modulation system set to 64QAM and the coding rate r set to 9/15.

According to the original GW pattern (B) in Fig. 335, arrangement of bit groups 0 through 44 of the 16k-bit LDPC code is interleaved to arrangement of bit groups 21, 5, 43, 38, 40, 1, 3, 17, 11, 37, 10, 41, 9, 15, 25, 44, 14, 27, 7, 18, 20, 35, 16, 0, 6, 19, 8, 22, 29, 28, 34, 31, 33, 30, 32, 42, 13, 4, 24, 26, 36, 2, 23, 12, 39.

According to the converted GW pattern (A) in Fig. 335, arrangement of bit groups 0 through 44 of the 16k-bit LDPC code is interleaved to arrangement of bit groups 21, 3, 9, 7, 6, 34, 13, 5, 17, 15, 18, 19, 31, 4, 43, 11, 25, 20, 8, 33, 24, 38, 37, 44, 35, 22, 30, 26, 40, 10, 14, 16, 29, 32, 36, 1, 41, 27, 0, 28, 42, 2, 23, 12, 39.

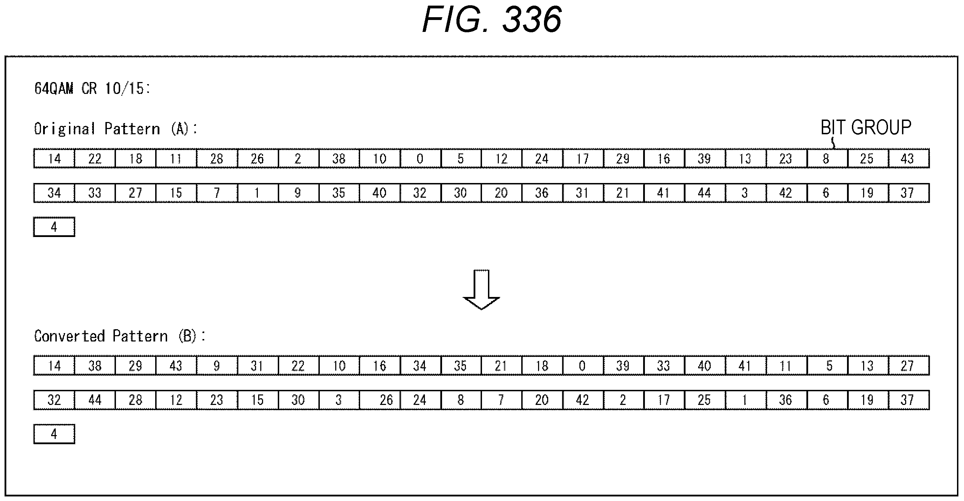

Fig. 336 is a diagram showing an example of a GW pattern for an LDPC code having a code length N of 16k bits with the modulation system set to 64QAM and the coding rate r set to 10/15.

According to the original GW pattern (A) in Fig. 336, arrangement of bit groups 0 through 44 of the 16k-bit LDPC code is interleaved to arrangement of bit groups 14, 22, 18, 11, 28, 26, 2, 38, 10, 0, 5, 12, 24, 17, 29, 16, 39, 13, 23, 8, 25, 43, 34, 33, 27, 15, 7, 1, 9, 35, 40, 32, 30, 20, 36, 31, 21, 41, 44, 3, 42, 6, 19, 37, 4.

According to the converted GW pattern (B) in Fig. 336, arrangement of bit groups 0 through 44 of the 16k-bit LDPC code is interleaved to arrangement of bit groups 14, 38, 29, 43, 9, 31, 22, 10, 16, 34, 35, 21, 18, 0, 39, 33, 40, 41, 11, 5, 13, 27, 32, 44, 28, 12, 23, 15, 30, 3, 26, 24, 8, 7, 20, 42, 2, 17, 25, 1, 36, 6, 19, 37, 4.

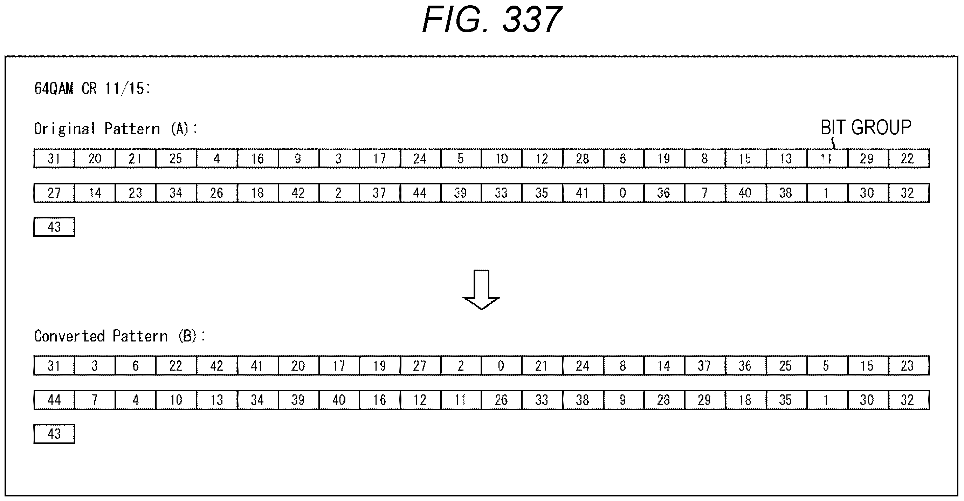

Fig. 337 is a diagram showing an example of a GW pattern for an LDPC code having a code length N of 16k bits with the modulation system set to 64QAM and the coding rate r set to 11/15.

According to the original GW pattern (A) in Fig. 337, arrangement of bit groups 0 through 44 of the 16k-bit LDPC code is interleaved to arrangement of bit groups 31, 20, 21, 25, 4, 16, 9, 3, 17, 24, 5, 10, 12, 28, 6, 19, 8, 15, 13, 11, 29, 22, 27, 14, 23, 34, 26, 18, 42, 2, 37, 44, 39, 33, 35, 41, 0, 36, 7, 40, 38, 1, 30, 32, 43.

According to the converted GW pattern (B) in Fig. 337, arrangement of bit groups 0 through 44 of the 16k-bit LDPC code is interleaved to arrangement of bit groups 31, 3, 6, 22, 42, 41, 20, 17, 19, 27, 2, 0, 21, 24, 8, 14, 37, 36, 25, 5, 15, 23, 44, 7, 4, 10, 13, 34, 39, 40, 16, 12, 11, 26, 33, 38, 9, 28, 29, 18, 35, 1, 30, 32, 43.

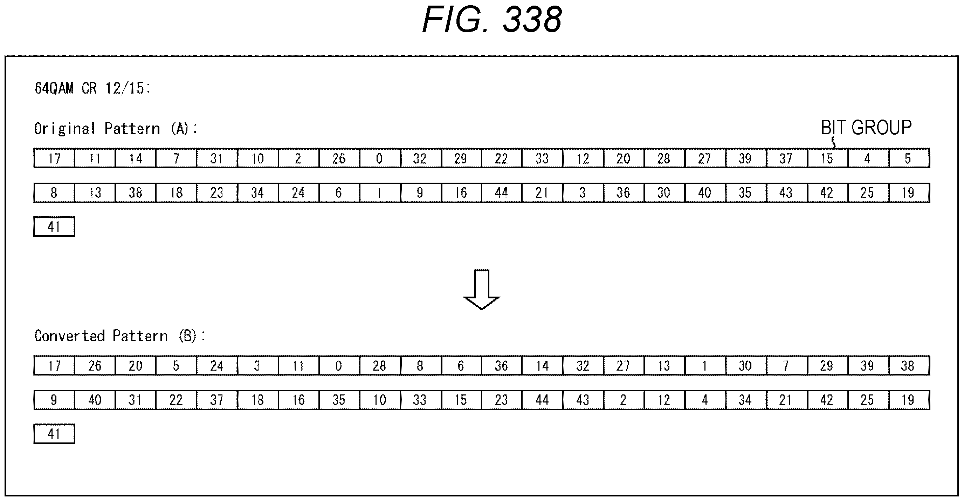

Fig. 338 is a diagram showing an example of a GW pattern for an LDPC code having a code length N of 16k bits with the modulation system set to 64QAM and the coding rate r set to 12/15.

According to the original GW pattern (A) in Fig. 338, arrangement of bit groups 0 through 44 of the 16k-bit LDPC code is interleaved to arrangement of bit groups 17, 11, 14, 7, 31, 10, 2, 26, 0, 32, 29, 22, 33, 12, 20, 28, 27, 39, 37, 15, 4, 5, 8, 13, 38, 18, 23, 34, 24, 6, 1, 9, 16, 44, 21, 3, 36, 30, 40, 35, 43, 42, 25, 19, 41.

According to the converted GW pattern (B) in Fig. 338, arrangement of bit groups 0 through 44 of the 16k-bit LDPC code is interleaved to arrangement of bit groups 17, 26, 20, 5, 24, 3, 11, 0, 28, 8, 6, 36, 14, 32, 27, 13, 1, 30, 7, 29, 39, 38, 9, 40, 31, 22, 37, 18, 16, 35, 10, 33, 15, 23, 44, 43, 2, 12, 4, 34, 21, 42, 25, 19, 41.

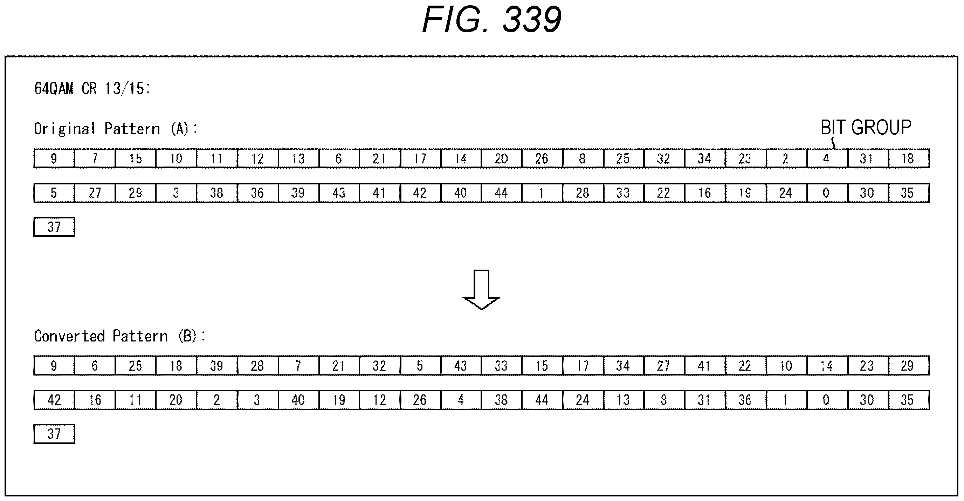

Fig. 339 is a diagram showing an example of a GW pattern for an LDPC code having a code length N of 16k bits with the modulation system set to 64QAM and the coding rate r set to 13/15.

According to the original GW pattern (A) in Fig. 339, arrangement of bit groups 0 through 44 of the 16k-bit LDPC code is interleaved to arrangement of bit groups 9, 7, 15, 10, 11, 12, 13, 6, 21, 17, 14, 20, 26, 8, 25, 32, 34, 23, 2, 4, 31, 18, 5, 27, 29, 3, 38, 36, 39, 43, 41, 42, 40, 44, 1, 28, 33, 22, 16, 19, 24, 0, 30, 35, 37.

According to the converted GW pattern (B) in Fig. 339, arrangement of bit groups 0 through 44 of the 16k-bit LDPC code is interleaved to arrangement of bit groups 9, 6, 25, 18, 39, 28, 7, 21, 32, 5, 43, 33, 15, 17, 34, 27, 41, 22, 10, 14, 23, 29, 42, 16, 11, 20, 2, 3, 40, 19, 12, 26, 4, 38, 44, 24, 13, 8, 31, 36, 1, 0, 30, 35, 37.

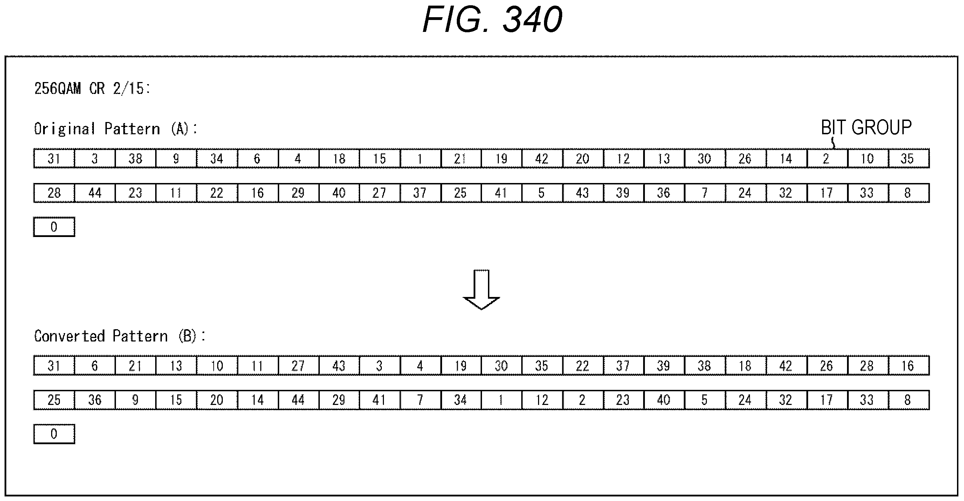

Fig. 340 is a diagram showing an example of a GW pattern for an LDPC code having a code length N of 16k bits with the modulation system set to 256QAM and the coding rate r set to 2/15.

According to the original GW pattern (A) in Fig. 340, arrangement of bit groups 0 through 44 of the 16k-bit LDPC code is interleaved to arrangement of bit groups 31, 3, 38, 9, 34, 6, 4, 18, 15, 1, 21, 19, 42, 20, 12, 13, 30, 26, 14, 2, 10, 35, 28, 44, 23, 11, 22, 16, 29, 40, 27, 37, 25, 41, 5, 43, 39, 36, 7, 24, 32, 17, 33, 8, 0.

According to the converted GW pattern (B) in Fig. 340, arrangement of bit groups 0 through 44 of the 16k-bit LDPC code is interleaved to arrangement of bit groups 31, 6, 21, 13, 10, 11, 27, 43, 3, 4, 19, 30, 35, 22, 37, 39, 38, 18, 42, 26, 28, 16, 25, 36, 9, 15, 20, 14, 44, 29, 41, 7, 34, 1, 12, 2, 23, 40, 5, 24, 32, 17, 33, 8, 0.

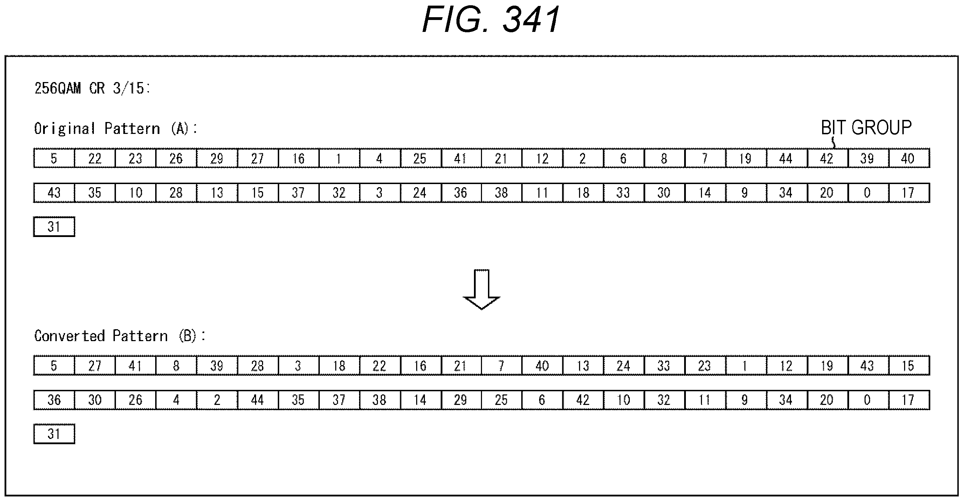

Fig. 341 is a diagram showing an example of a GW pattern for an LDPC code having a code length N of 16k bits with the modulation system set to 256QAM and the coding rate r set to 3/15.

According to the original GW pattern (A) in Fig. 341, arrangement of bit groups 0 through 44 of the 16k-bit LDPC code is interleaved to arrangement of bit groups 5, 22, 23, 26, 29, 27, 16, 1, 4, 25, 41, 21, 12, 2, 6, 8, 7, 19, 44, 42, 39, 40, 43, 35, 10, 28, 13, 15, 37, 32, 3, 24, 36, 38, 11, 18, 33, 30, 14, 9, 34, 20, 0, 17, 31.

According to the converted GW pattern (B) in Fig. 341, arrangement of bit groups 0 through 44 of the 16k-bit LDPC code is interleaved to arrangement of bit groups 5, 27, 41, 8, 39, 28, 3, 18, 22, 16, 21, 7, 40, 13, 24, 33, 23, 1, 12, 19, 43, 15, 36, 30, 26, 4, 2, 44, 35, 37, 38, 14, 29, 25, 6, 42, 10, 32, 11, 9, 34, 20, 0, 17, 31.

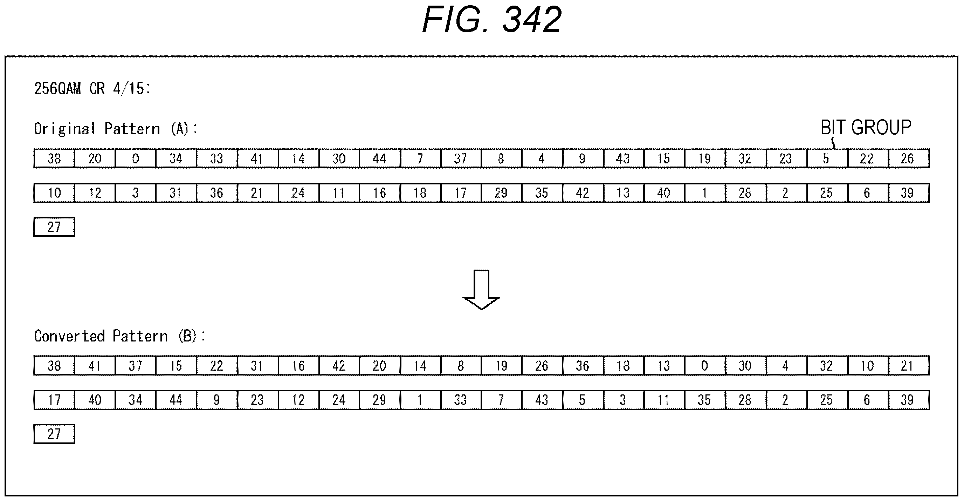

Fig. 342 is a diagram showing an example of a GW pattern for an LDPC code having a code length N of 16k bits with the modulation system set to 256QAM and the coding rate r set to 4/15.

According to the original GW pattern (A) in Fig. 342, arrangement of a bit group 0 through 44 of the 16k-bit LDPC code is interleaved to arrangement of a bit group 38, 20, 0, 34, 33, 41, 14, 30, 44, 7, 37, 8, 4, 9, 43, 15, 19, 32, 23, 5, 22, 26, 10, 12, 3, 31, 36, 21, 24, 11, 16, 18, 17, 29, 35, 42, 13, 40, 1, 28, 2, 25, 6, 39, 27.

According to the converted GW pattern (B) in Fig. 342, arrangement of bit groups 0 through 44 of the 16k-bit LDPC code is interleaved to arrangement of bit groups 38, 41, 37, 15, 22, 31, 16, 42, 20, 14, 8, 19, 26, 36, 18, 13, 0, 30, 4, 32, 10, 21, 17, 40, 34, 44, 9, 23, 12, 24, 29, 1, 33, 7, 43, 5, 3, 11, 35, 28, 2, 25, 6, 39, 27.

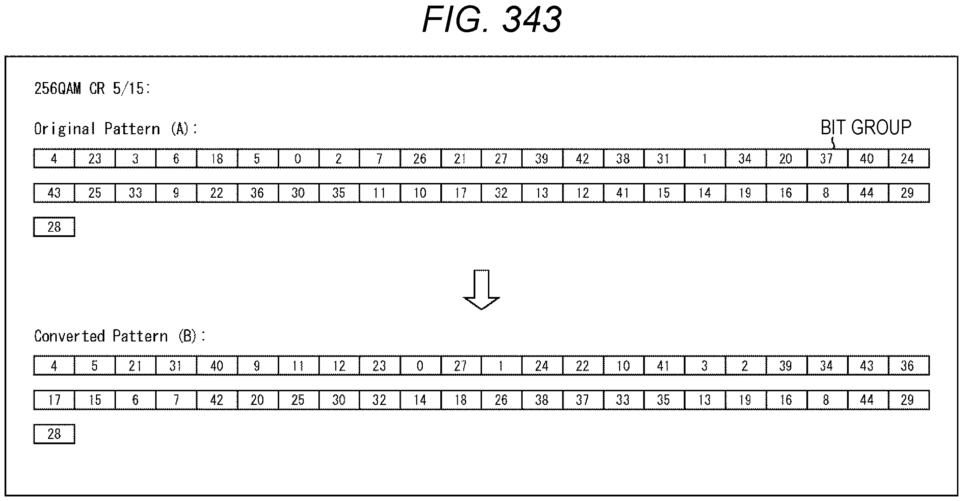

Fig. 343 is a diagram showing an example of a GW pattern for an LDPC code having a code length N of 16k bits with the modulation system set to 256QAM and the coding rate r set to 5/15.

According to the original GW pattern (A) in Fig. 343, arrangement of bit groups 0 through 44 of the 16k-bit LDPC code is interleaved to arrangement of bit groups 4, 23, 3, 6, 18, 5, 0, 2, 7, 26, 21, 27, 39, 42, 38, 31, 1, 34, 20, 37, 40, 24, 43, 25, 33, 9, 22, 36, 30, 35, 11, 10, 17, 32, 13, 12, 41, 15, 14, 19, 16, 8, 44, 29, 28.

According to the converted GW pattern (B) in Fig. 343, arrangement of bit groups 0 through 44 of the 16k-bit LDPC code is interleaved to arrangement of bit groups 4, 5, 21, 31, 40, 9, 11, 12, 23, 0, 27, 1, 24, 22, 10, 41, 3, 2, 39, 34, 43, 36, 17, 15, 6, 7, 42, 20, 25, 30, 32, 14, 18, 26, 38, 37, 33, 35, 13, 19, 16, 8, 44, 29, 28.

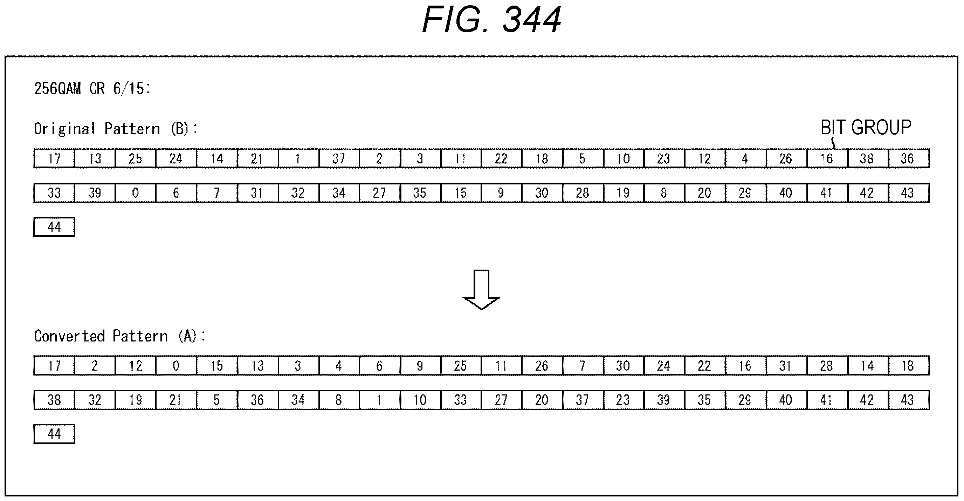

Fig. 344 is a diagram showing an example of a GW pattern for an LDPC code having a code length N of 16k bits with the modulation system set to 256QAM and the coding rate r set to 6/15.

According to the original GW pattern (B) in Fig. 344, arrangement of bit groups 0 through 44 of the 16k-bit LDPC code is interleaved to arrangement of bit groups 17, 13, 25, 24, 14, 21, 1, 37, 2, 3, 11, 22, 18, 5, 10, 23, 12, 4, 26, 16, 38, 36, 33, 39, 0, 6, 7, 31, 32, 34, 27, 35, 15, 9, 30, 28, 19, 8, 20, 29, 40, 41, 42, 43, 44.

According to the converted GW pattern (A) in Fig. 344, arrangement of bit groups 0 through 44 of the 16k-bit LDPC code is interleaved to arrangement of bit groups 17, 2, 12, 0, 15, 13, 3, 4, 6, 9, 25, 11, 26, 7, 30, 24, 22, 16, 31, 28, 14, 18, 38, 32, 19, 21, 5, 36, 34, 8, 1, 10, 33, 27, 20, 37, 23, 39, 35, 29, 40, 41, 42, 43, 44.

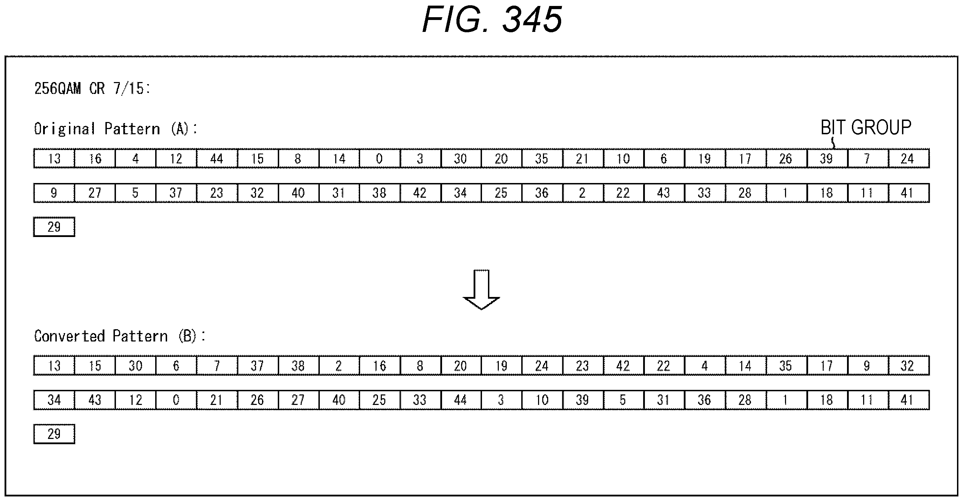

Fig. 345 is a diagram showing an example of a GW pattern for an LDPC code having a code length N of 16k bits with the modulation system set to 256QAM and the coding rate r set to 7/15.

According to the original GW pattern (A) in Fig. 345, arrangement of bit groups 0 through 44 of the 16k-bit LDPC code is interleaved to arrangement of bit groups 13, 16, 4, 12, 44, 15, 8, 14, 0, 3, 30, 20, 35, 21, 10, 6, 19, 17, 26, 39, 7, 24, 9, 27, 5, 37, 23, 32, 40, 31, 38, 42, 34, 25, 36, 2, 22, 43, 33, 28, 1, 18, 11, 41, 29.

According to the converted GW pattern (B) in Fig. 345, arrangement of bit groups 0 through 44 of the 16k-bit LDPC code is interleaved to arrangement of bit groups 13, 15, 30, 6, 7, 37, 38, 2, 16, 8, 20, 19, 24, 23, 42, 22, 4, 14, 35, 17, 9, 32, 34, 43, 12, 0, 21, 26, 27, 40, 25, 33, 44, 3, 10, 39, 5, 31, 36, 28, 1, 18, 11, 41, 29.

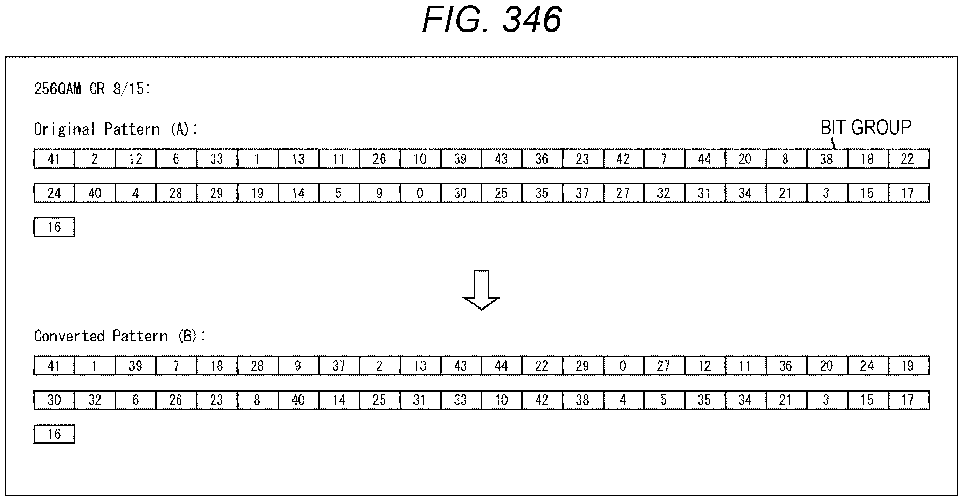

Fig. 346 is a diagram showing an example of a GW pattern for an LDPC code having a code length N of 16k bits with the modulation system set to 256QAM and the coding rate r set to 8/15.

According to the original GW pattern (A) in Fig. 346, arrangement of bit groups 0 through 44 of the 16k-bit LDPC code is interleaved to arrangement of bit groups 41, 2, 12, 6, 33, 1, 13, 11, 26, 10, 39, 43, 36, 23, 42, 7, 44, 20, 8, 38, 18, 22, 24, 40, 4, 28, 29, 19, 14, 5, 9, 0, 30, 25, 35, 37, 27, 32, 31, 34, 21, 3, 15, 17, 16.

According to the converted GW pattern (B) in Fig. 346, arrangement of bit groups 0 through 44 of the 16k-bit LDPC code is interleaved to arrangement of bit groups 41, 1, 39, 7, 18, 28, 9, 37, 2, 13, 43, 44, 22, 29, 0, 27, 12, 11, 36, 20, 24, 19, 30, 32, 6, 26, 23, 8, 40, 14, 25, 31, 33, 10, 42, 38, 4, 5, 35, 34, 21, 3, 15, 17, 16.

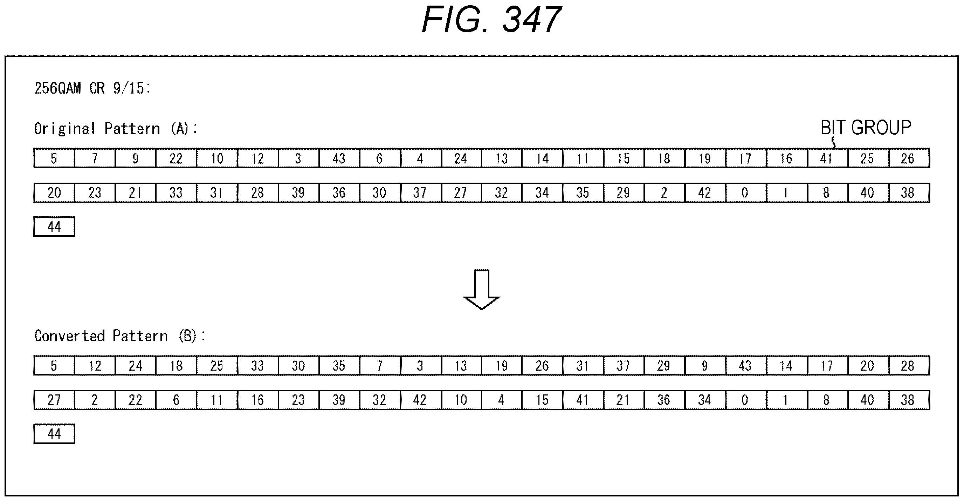

Fig. 347 is a diagram showing an example of a GW pattern for an LDPC code having a code length N of 16k bits with the modulation system set to 256QAM and the coding rate r set to 9/15.

According to the original GW pattern (A) in Fig. 347, arrangement of bit groups 0 through 44 of the 16k-bit LDPC code is interleaved to arrangement of bit groups 5, 7, 9, 22, 10, 12, 3, 43, 6, 4, 24, 13, 14, 11, 15, 18, 19, 17, 16, 41, 25, 26, 20, 23, 21, 33, 31, 28, 39, 36, 30, 37, 27, 32, 34, 35, 29, 2, 42, 0, 1, 8, 40, 38, 44.

According to the converted GW pattern (B) in Fig. 347, arrangement of bit groups 0 through 44 of the 16k-bit LDPC code is interleaved to arrangement of bit groups 5, 12, 24, 18, 25, 33, 30, 35, 7, 3, 13, 19, 26, 31, 37, 29, 9, 43, 14, 17, 20, 28, 27, 2, 22, 6, 11, 16, 23, 39, 32, 42, 10, 4, 15, 41, 21, 36, 34, 0, 1, 8, 40, 38, 44.

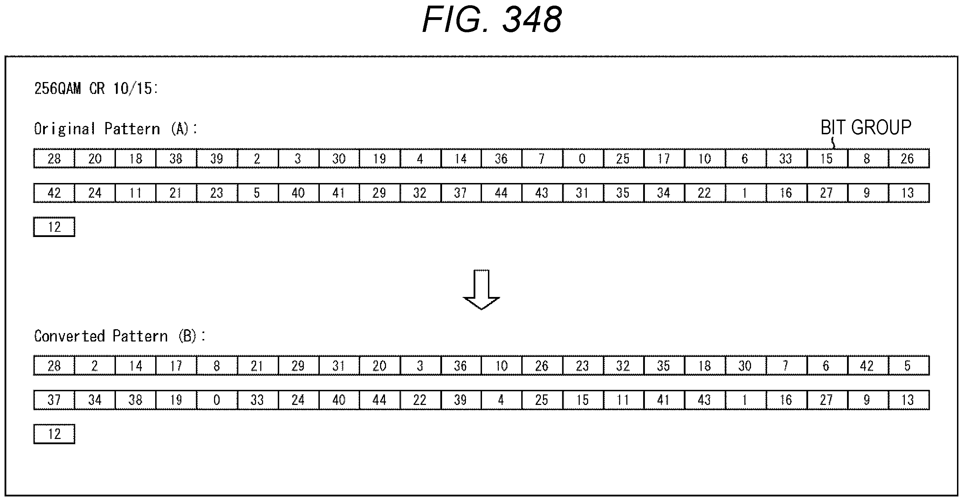

Fig. 348 is a diagram showing an example of a GW pattern for an LDPC code having a code length N of 16k bits with the modulation system set to 256QAM and the coding rate r set to 10/15.

According to the original GW pattern (A) in Fig. 348, arrangement of bit groups 0 through 44 of the 16k-bit LDPC code is interleaved to arrangement of bit groups 28, 20, 18, 38, 39, 2, 3, 30, 19, 4, 14, 36, 7, 0, 25, 17, 10, 6, 33, 15, 8, 26, 42, 24, 11, 21, 23, 5, 40, 41, 29, 32, 37, 44, 43, 31, 35, 34, 22, 1, 16, 27, 9, 13, 12.

According to the converted GW pattern (B) in Fig. 348, arrangement of bit groups 0 through 44 of the 16k-bit LDPC code is interleaved to arrangement of bit groups 28, 2, 14, 17, 8, 21, 29, 31, 20, 3, 36, 10, 26, 23, 32, 35, 18, 30, 7, 6, 42, 5, 37, 34, 38, 19, 0, 33, 24, 40, 44, 22, 39, 4, 25, 15, 11, 41, 43, 1, 16, 27, 9, 13, 12.

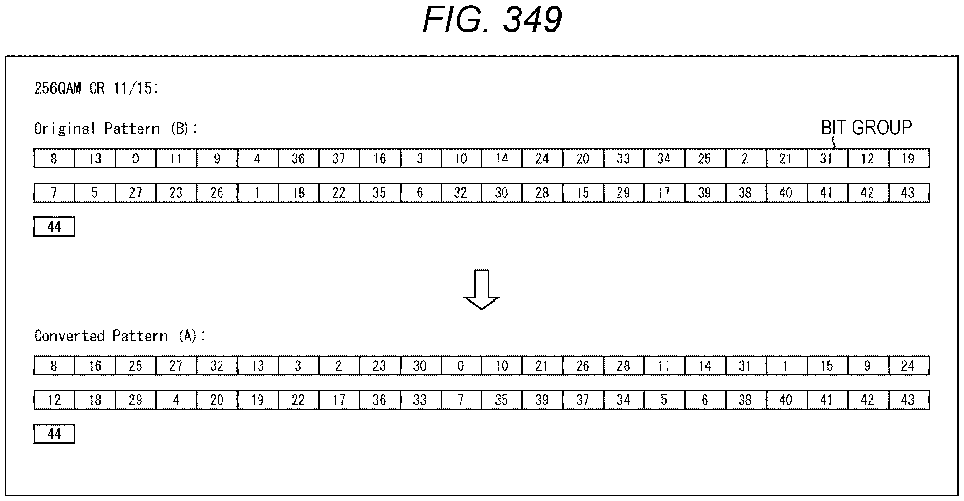

Fig. 349 is a diagram showing an example of a GW pattern for an LDPC code having a code length N of 16k bits with the modulation system set to 256QAM and the coding rate r set to 11/15.

According to the original GW pattern (B) in Fig. 349, arrangement of bit groups 0 through 44 of the 16k-bit LDPC code is interleaved to arrangement of bit groups 8, 13, 0, 11, 9, 4, 36, 37, 16, 3, 10, 14, 24, 20, 33, 34, 25, 2, 21, 31, 12, 19, 7, 5, 27, 23, 26, 1, 18, 22, 35, 6, 32, 30, 28, 15, 29, 17, 39, 38, 40, 41, 42, 43, 44.

According to the converted GW pattern (A) in Fig. 349, arrangement of bit groups 0 through 44 of the 16k-bit LDPC code is interleaved to arrangement of bit groups 8, 16, 25, 27, 32, 13, 3, 2, 23, 30, 0, 10, 21, 26, 28, 11, 14, 31, 1, 15, 9, 24, 12, 18, 29, 4, 20, 19, 22, 17, 36, 33, 7, 35, 39, 37, 34, 5, 6, 38, 40, 41, 42, 43, 44.

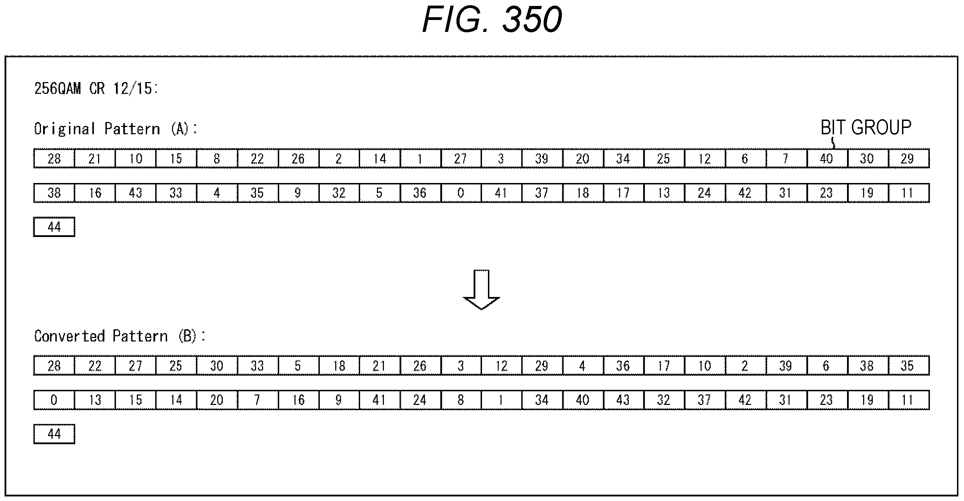

Fig. 350 is a diagram showing an example of a GW pattern for an LDPC code having a code length N of 16k bits with the modulation system set to 256QAM and the coding rate r set to 12/15.

According to the original GW pattern (A) in Fig. 350, arrangement of bit groups 0 through 44 of the 16k-bit LDPC code is interleaved to arrangement of bit groups 28, 21, 10, 15, 8, 22, 26, 2, 14, 1, 27, 3, 39, 20, 34, 25, 12, 6, 7, 40, 30, 29, 38, 16, 43, 33, 4, 35, 9, 32, 5, 36, 0, 41, 37, 18, 17, 13, 24, 42, 31, 23, 19, 11, 44.

According to the converted GW pattern (B) in Fig. 350, arrangement of bit groups 0 through 44 of the 16k-bit LDPC code is interleaved to arrangement of bit groups 28, 22, 27, 25, 30, 33, 5, 18, 21, 26, 3, 12, 29, 4, 36, 17, 10, 2, 39, 6, 38, 35, 0, 13, 15, 14, 20, 7, 16, 9, 41, 24, 8, 1, 34, 40, 43, 32, 37, 42, 31, 23, 19, 11, 44.

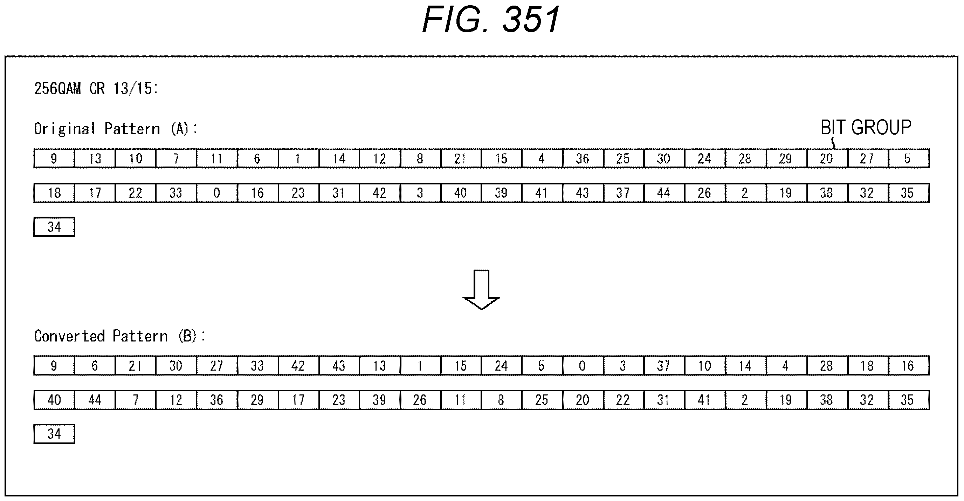

Fig. 351 is a diagram showing an example of a GW pattern for an LDPC code having a code length N of 16k bits with the modulation system set to 256QAM and the coding rate r set to 13/15.

According to the original GW pattern (A) in Fig. 351, arrangement of bit groups 0 through 44 of the 16k-bit LDPC code is interleaved to arrangement of bit groups 9, 13, 10, 7, 11, 6, 1, 14, 12, 8, 21, 15, 4, 36, 25, 30, 24, 28, 29, 20, 27, 5, 18, 17, 22, 33, 0, 16, 23, 31, 42, 3, 40, 39, 41, 43, 37, 44, 26, 2, 19, 38, 32, 35, 34.

According to the converted GW pattern (B) in Fig. 351, arrangement of bit groups 0 through 44 of the 16k-bit LDPC code is interleaved to arrangement of bit groups 9, 6, 21, 30, 27, 33, 42, 43, 13, 1, 15, 24, 5, 0, 3, 37, 10, 14, 4, 28, 18, 16, 40, 44, 7, 12, 36, 29, 17, 23, 39, 26, 11, 8, 25, 20, 22, 31, 41, 2, 19, 38, 32, 35, 34.

<Relationship between original GW pattern and converted GW pattern>

Examples of a relationship between an original GW pattern and a converted GW pattern are hereinafter described for each of the modulation systems and for each of the 64k-bit code length N or the 16k-bit code length N.

Described herein is an example of a relationship between a GW pattern for block interleave of the type A (hereinafter also referred to as GW pattern (A)) and a GW pattern for block interleave of the type B (hereinafter also referred to as GW pattern (B)) when the GW pattern (A) and the GW pattern (B) are set as an original GW pattern (A) and a converted GW pattern (B), respectively.

Note that while discussed hereinbelow is only the case where a GW pattern (A) and a GW pattern (B) are set as an original GW pattern (A) and a converted GW pattern (B), respectively, for simplifying the description, a similar relationship is obtained when a GW pattern (B) and a GW pattern (A) are set as an original GW pattern (B) and a converted GW pattern (A), respectively.

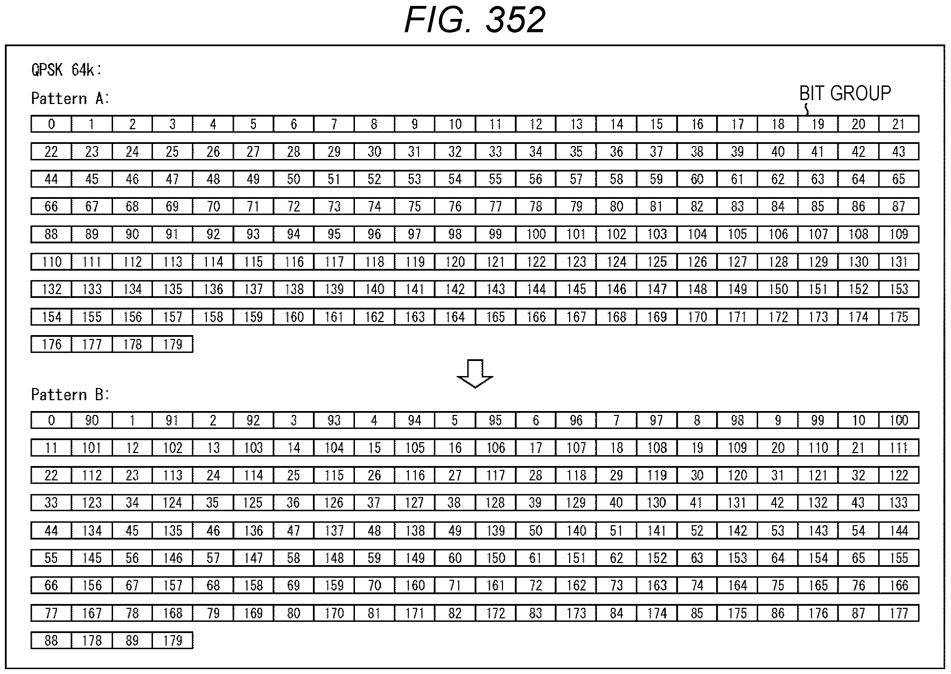

Fig. 352 is a diagram showing a relationship between a GW pattern (A) and a GW pattern (B) for the modulation system QPSK and an LDPC code having a code length N of 64k bits.

In Fig. 352, a GW pattern (A) constituted by a GW pattern 0, 1, 2, and up to 177, 178, 179 is rewritten to a GW pattern (B).

According to the GW pattern (B) in Fig. 352, arrangement of bit groups 0 through 179 for a 64k-bit LDPC code is interleaved to arrangement 0, 90, 1, 91, 2, 92, 3, 93, 4, 94, 5, 95, 6, 96, 7, 97, 8, 98, 9, 99, 10, 100, 11, 101, 12, 102, 13, 103, 14, 104, 15, 105, 16, 106, 17, 107, 18, 108, 19, 109, 20, 110, 21, 111, 22, 112, 23, 113, 24, 114, 25, 115, 26, 116, 27, 117, 28, 118, 29, 119, 30, 120, 31, 121, 32, 122, 33, 123, 34, 124, 35, 125, 36, 126, 37, 127, 38, 128, 39, 129, 40, 130, 41, 131, 42, 132, 43, 133, 44, 134, 45, 135, 46, 136, 47, 137, 48, 138, 49, 139, 50, 140, 51, 141, 52, 142, 53, 143, 54, 144, 55, 145, 56, 146, 57, 147, 58, 148, 59, 149, 60, 150, 61, 151, 62, 152, 63, 153, 64, 154, 65, 155, 66, 156, 67, 157, 68, 158, 69, 159, 70, 160, 71, 161, 72, 162, 73, 163, 74, 164, 75, 165, 76, 166, 77, 167, 78, 168, 79, 169, 80, 170, 81, 171, 82, 172, 83, 173, 84, 174, 85, 175, 86, 176, 87, 177, 88, 178, 89, 179.

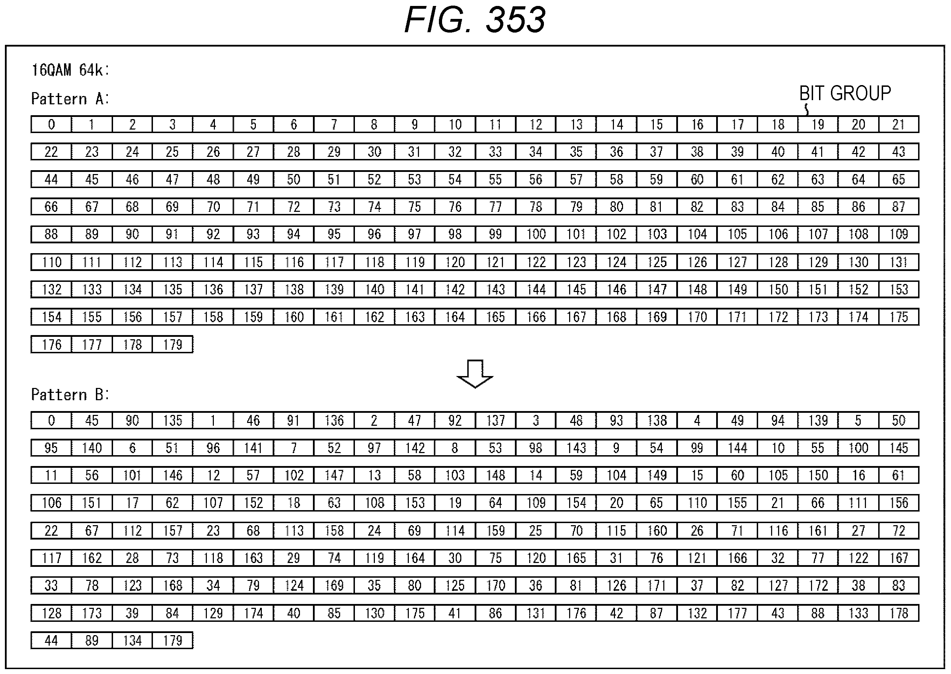

Fig. 353 is a diagram showing a relationship between a GW pattern (A) and a GW pattern (B) for the modulation system 16QAM and an LDPC code having a code length N of 64k bits.

In Fig. 353, a GW pattern (A) constituted by a GW pattern 0, 1, 2, and up to 177, 178, 179 is rewritten to a GW pattern (B).

According to the GW pattern (B) in Fig. 353, arrangement of bit groups 0 through 179 for a 64k-bit LDPC code is interleaved to arrangement 0, 45, 90, 135, 1, 46, 91, 136, 2, 47, 92, 137, 3, 48, 93, 138, 4, 49, 94, 139, 5, 50, 95, 140, 6, 51, 96, 141, 7, 52, 97, 142, 8, 53, 98, 143, 9, 54, 99, 144, 10, 55, 100, 145, 11, 56, 101, 146, 12, 57, 102, 147, 13, 58, 103, 148, 14, 59, 104, 149, 15, 60, 105, 150, 16, 61, 106, 151, 17, 62, 107, 152, 18, 63, 108, 153, 19, 64, 109, 154, 20, 65, 110, 155, 21, 66, 111, 156, 22, 67, 112, 157, 23, 68, 113, 158, 24, 69, 114, 159, 25, 70, 115, 160, 26, 71, 116, 161, 27, 72, 117, 162, 28, 73, 118, 163, 29, 74, 119, 164, 30, 75, 120, 165, 31, 76, 121, 166, 32, 77, 122, 167, 33, 78, 123, 168, 34, 79, 124, 169, 35, 80, 125, 170, 36, 81, 126, 171, 37, 82, 127, 172, 38, 83, 128, 173, 39, 84, 129, 174, 40, 85, 130, 175, 41, 86, 131, 176, 42, 87, 132, 177, 43, 88, 133, 178, 44, 89, 134, 179.

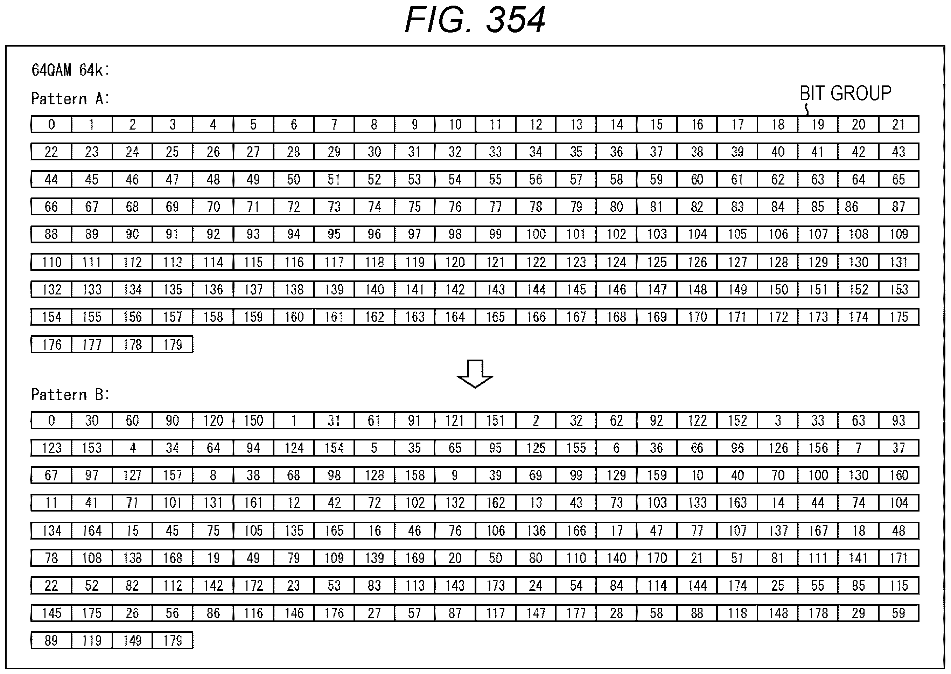

Fig. 354 is a diagram showing a relationship between a GW pattern (A) and a GW pattern (B) for the modulation system 64QAM and an LDPC code having a code length N of 64k bits.

In Fig. 354, a GW pattern (A) constituted by a GW pattern 0, 1, 2, and up to 177, 178, 179 is rewritten to a GW pattern (B).

According to the GW pattern (B) in Fig. 354, arrangement of bit groups 0 through 179 for a 64k-bit LDPC code is interleaved to arrangement 0, 30, 60, 90, 120, 150, 1, 31, 61, 91, 121, 151, 2, 32, 62, 92, 122, 152, 3, 33, 63, 93, 123, 153, 4, 34, 64, 94, 124, 154, 5, 35, 65, 95, 125, 155, 6, 36, 66, 96, 126, 156, 7, 37, 67, 97, 127, 157, 8, 38, 68, 98, 128, 158, 9, 39, 69, 99, 129, 159, 10, 40, 70, 100, 130, 160, 11, 41, 71, 101, 131, 161, 12, 42, 72, 102, 132, 162, 13, 43, 73, 103, 133, 163, 14, 44, 74, 104, 134, 164, 15, 45, 75, 105, 135, 165, 16, 46, 76, 106, 136, 166, 17, 47, 77, 107, 137, 167, 18, 48, 78, 108, 138, 168, 19, 49, 79, 109, 139, 169, 20, 50, 80, 110, 140, 170, 21, 51, 81, 111, 141, 171, 22, 52, 82, 112, 142, 172, 23, 53, 83, 113, 143, 173, 24, 54, 84, 114, 144, 174, 25, 55, 85, 115, 145, 175, 26, 56, 86, 116, 146, 176, 27, 57, 87, 117, 147, 177, 28, 58, 88, 118, 148, 178, 29, 59, 89, 119, 149, 179.

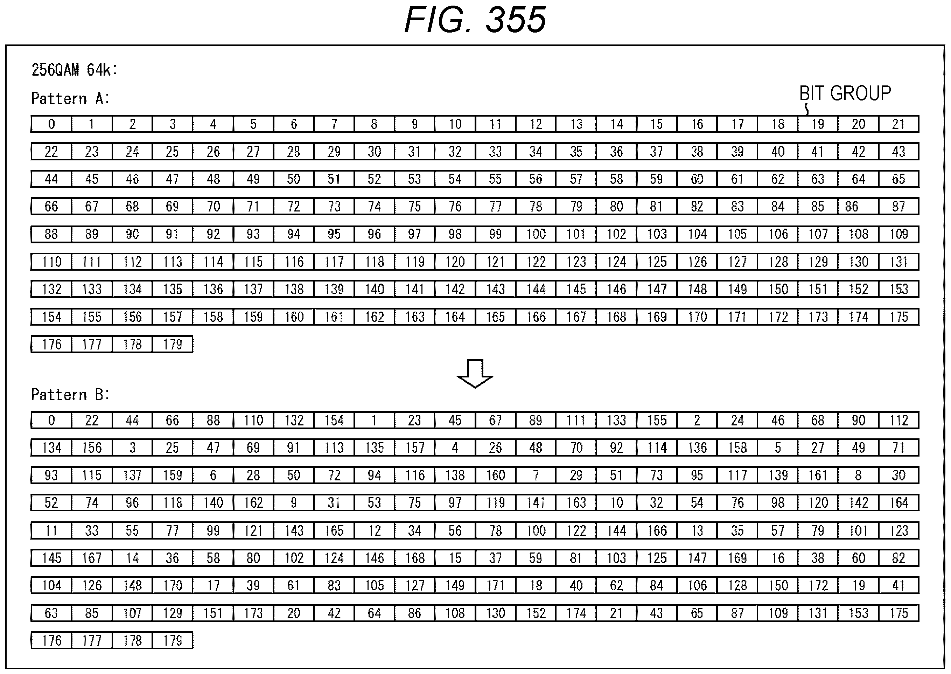

Fig. 355 is a diagram showing a relationship between a GW pattern (A) and a GW pattern (B) for the modulation system 256QAM and an LDPC code having a code length N of 64k bits.

In Fig. 355, a GW pattern (A) constituted by a GW pattern 0, 1, 2, and up to 177, 178, 179 is rewritten to a GW pattern (B).

According to the GW pattern (B) in Fig. 355, arrangement of bit groups 0 through 179 for a 64k-bit LDPC code is interleaved to arrangement 0, 22, 44, 66, 88, 110, 132, 154, 1, 23, 45, 67, 89, 111, 133, 155, 2, 24, 46, 68, 90, 112, 134, 156, 3, 25, 47, 69, 91, 113, 135, 157, 4, 26, 48, 70, 92, 114, 136, 158, 5, 27, 49, 71, 93, 115, 137, 159, 6, 28, 50, 72, 94, 116, 138, 160, 7, 29, 51, 73, 95, 117, 139, 161, 8, 30, 52, 74, 96, 118, 140, 162, 9, 31, 53, 75, 97, 119, 141, 163, 10, 32, 54, 76, 98, 120, 142, 164, 11, 33, 55, 77, 99, 121, 143, 165, 12, 34, 56, 78, 100, 122, 144, 166, 13, 35, 57, 79, 101, 123, 145, 167, 14, 36, 58, 80, 102, 124, 146, 168, 15, 37, 59, 81, 103, 125, 147, 169, 16, 38, 60, 82, 104, 126, 148, 170, 17, 39, 61, 83, 105, 127, 149, 171, 18, 40, 62, 84, 106, 128, 150, 172, 19, 41, 63, 85, 107, 129, 151, 173, 20, 42, 64, 86, 108, 130, 152, 174, 21, 43, 65, 87, 109, 131, 153, 175, 176, 177, 178, 179.

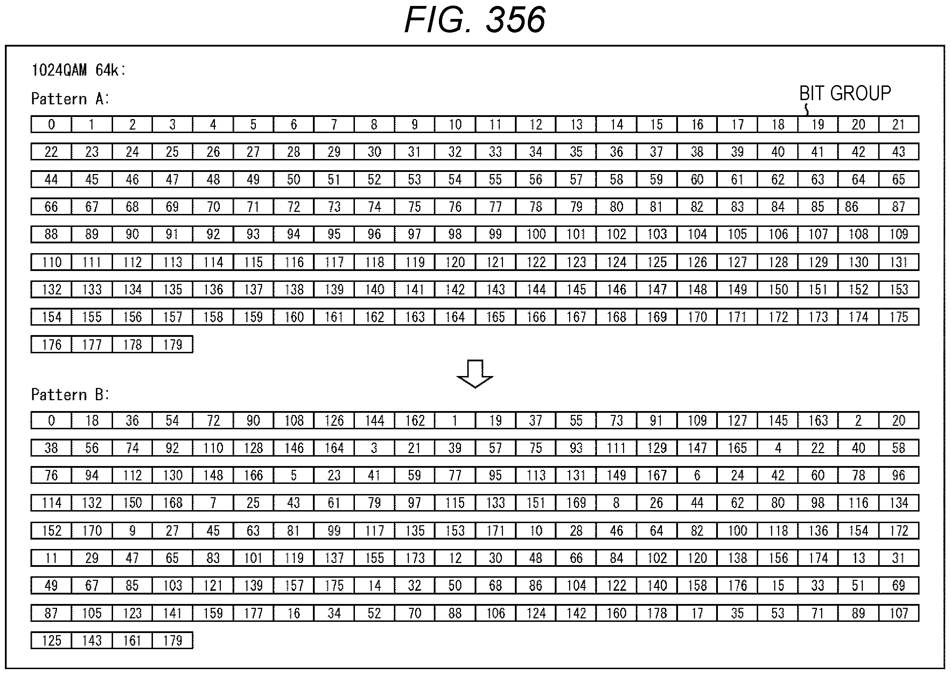

Fig. 356 is a diagram showing a relationship between a GW pattern (A) and a GW pattern (B) for the modulation system 1024QAM and an LDPC code having a code length N of 64k bits.

In Fig. 356, a GW pattern (A) constituted by a GW pattern 0, 1, 2, and up to 177, 178, 179 is rewritten to a GW pattern (B).

According to the GW pattern (B) in Fig. 356, arrangement of bit groups 0 through 179 for a 64k-bit LDPC code is interleaved to arrangement 0, 18, 36, 54, 72, 90, 108, 126, 144, 162, 1, 19, 37, 55, 73, 91, 109, 127, 145, 163, 2, 20, 38, 56, 74, 92, 110, 128, 146, 164, 3, 21, 39, 57, 75, 93, 111, 129, 147, 165, 4, 22, 40, 58, 76, 94, 112, 130, 148, 166, 5, 23, 41, 59, 77, 95, 113, 131, 149, 167, 6, 24, 42, 60, 78, 96, 114, 132, 150, 168, 7, 25, 43, 61, 79, 97, 115, 133, 151, 169, 8, 26, 44, 62, 80, 98, 116, 134, 152, 170, 9, 27, 45, 63, 81, 99, 117, 135, 153, 171, 10, 28, 46, 64, 82, 100, 118, 136, 154, 172, 11, 29, 47, 65, 83, 101, 119, 137, 155, 173, 12, 30, 48, 66, 84, 102, 120, 138, 156, 174, 13, 31, 49, 67, 85, 103, 121, 139, 157, 175, 14, 32, 50, 68, 86, 104, 122, 140, 158, 176, 15, 33, 51, 69, 87, 105, 123, 141, 159, 177, 16, 34, 52, 70, 88, 106, 124, 142, 160, 178, 17, 35, 53, 71, 89, 107, 125, 143, 161, 179.

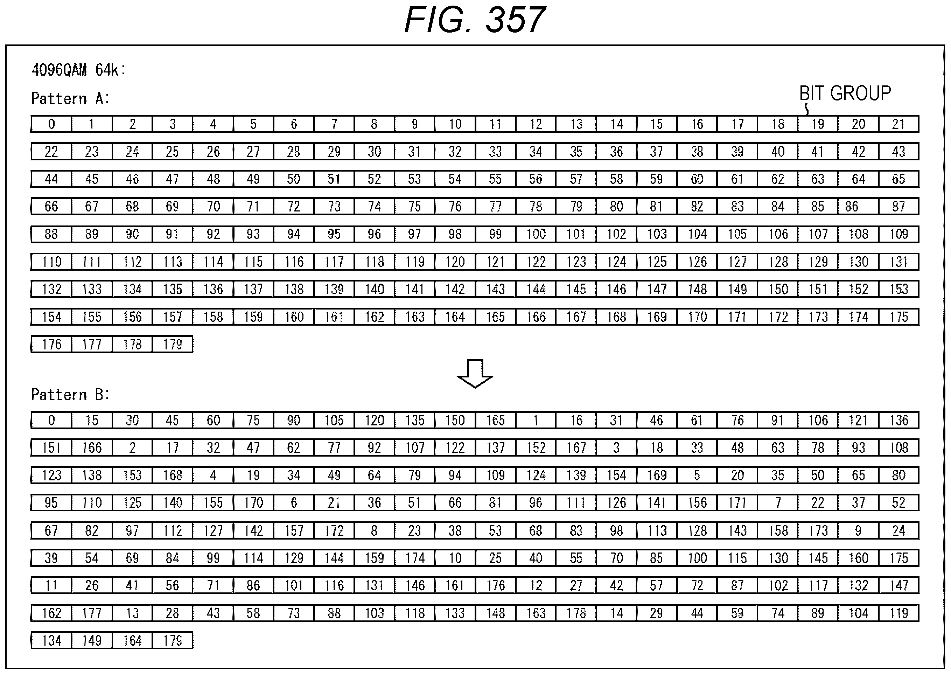

Fig. 357 is a diagram showing a relationship between a GW pattern (A) and a GW pattern (B) for the modulation system 4096QAM and an LDPC code having a code length N of 64k bits.

In Fig. 357, a GW pattern (A) constituted by a GW pattern 0, 1, 2, and up to 177, 178, 179 is rewritten to a GW pattern (B).

According to the GW pattern (B) in Fig. 357, arrangement of bit groups 0 through 179 for a 64k-bit LDPC code is interleaved to arrangement 0, 15, 30, 45, 60, 75, 90, 105, 120, 135, 150, 165, 1, 16, 31, 46, 61, 76, 91, 106, 121, 136, 151, 166, 2, 17, 32, 47, 62, 77, 92, 107, 122, 137, 152, 167, 3, 18, 33, 48, 63, 78, 93, 108, 123, 138, 153, 168, 4, 19, 34, 49, 64, 79, 94, 109, 124, 139, 154, 169, 5, 20, 35, 50, 65, 80, 95, 110, 125, 140, 155, 170, 6, 21, 36, 51, 66, 81, 96, 111, 126, 141, 156, 171, 7, 22, 37, 52, 67, 82, 97, 112, 127, 142, 157, 172, 8, 23, 38, 53, 68, 83, 98, 113, 128, 143, 158, 173, 9, 24, 39, 54, 69, 84, 99, 114, 129, 144, 159, 174, 10, 25, 40, 55, 70, 85, 100, 115, 130, 145, 160, 175, 11, 26, 41, 56, 71, 86, 101, 116, 131, 146, 161, 176, 12, 27, 42, 57, 72, 87, 102, 117, 132, 147, 162, 177, 13, 28, 43, 58, 73, 88, 103, 118, 133, 148, 163, 178, 14, 29, 44, 59, 74, 89, 104, 119, 134, 149, 164, 179.

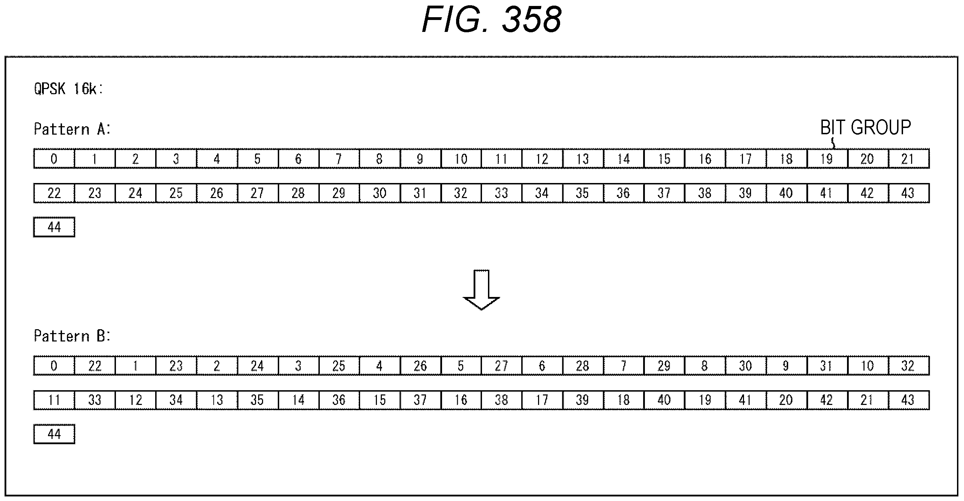

Fig. 358 is a diagram showing a relationship between a GW pattern (A) and a GW pattern (B) for the modulation system QPSK and an LDPC code having a code length N of 16k bits.

In Fig. 358, a GW pattern (A) constituted by a GW pattern 0, 1, 2, and up to 42, 43, 44 is rewritten to a GW pattern (B).

According to the GW pattern (B) in Fig. 358, arrangement of bit groups 0 through 44 for a 16k-bit LDPC code is interleaved to arrangement 0, 22, 1, 23, 2, 24, 3, 25, 4, 26, 5, 27, 6, 28, 7, 29, 8, 30, 9, 31, 10, 32, 11, 33, 12, 34, 13, 35, 14, 36, 15, 37, 16, 38, 17, 39, 18, 40, 19, 41, 20, 42, 21, 43, 44.

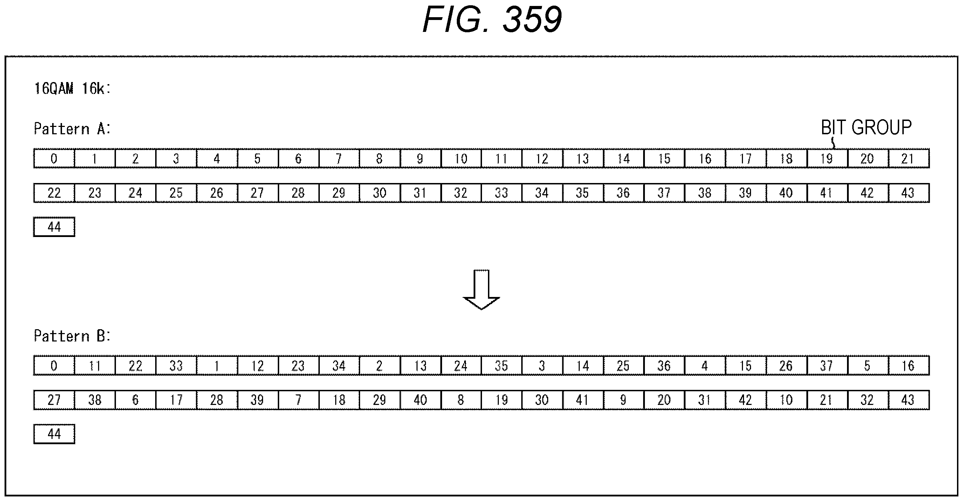

Fig. 359 is a diagram showing a relationship between a GW pattern (A) and a GW pattern (B) for the modulation system 16QAM and an LDPC code having a code length N of 16k bits.

In Fig. 359, a GW pattern (A) constituted by a GW pattern 0, 1, 2, and up to 42, 43, 44 is rewritten to a GW pattern (B).

According to the GW pattern (B) in Fig. 359, arrangement of bit groups 0 through 44 for a 16k-bit LDPC code is interleaved to arrangement 0, 11, 22, 33, 1, 12, 23, 34, 2, 13, 24, 35, 3, 14, 25, 36, 4, 15, 26, 37, 5, 16, 27, 38, 6, 17, 28, 39, 7, 18, 29, 40, 8, 19, 30, 41, 9, 20, 31, 42, 10, 21, 32, 43, 44.

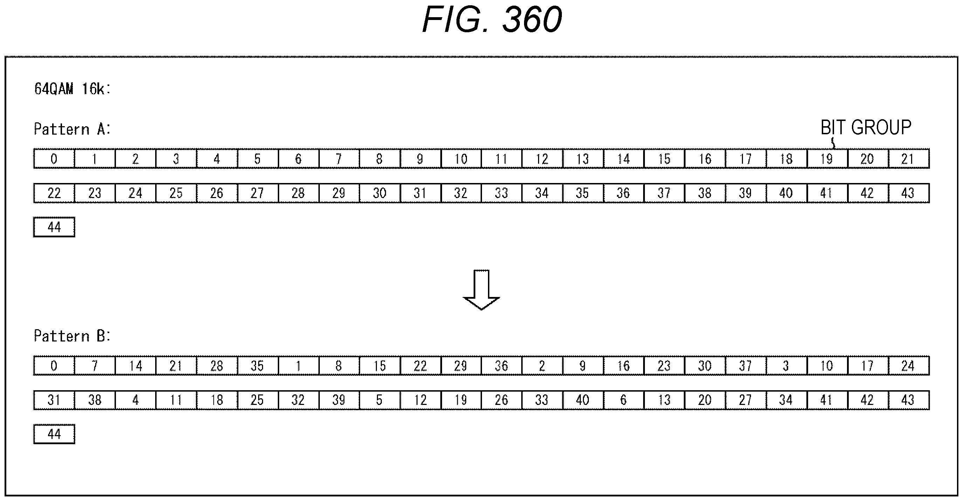

Fig. 360 is a diagram showing a relationship between a GW pattern (A) and a GW pattern (B) for the modulation system 64QAM and an LDPC code having a code length N of 16k bits.

In Fig. 360, a GW pattern (A) constituted by a GW pattern 0, 1, 2, and up to 42, 43, 44 is rewritten to a GW pattern (B).

According to the GW pattern (B) in Fig. 360, arrangement of bit groups 0 through 44 for a 16k-bit LDPC code is interleaved to arrangement 0, 7, 14, 21, 28, 35, 1, 8, 15, 22, 29, 36, 2, 9, 16, 23, 30, 37, 3, 10, 17, 24, 31, 38, 4, 11, 18, 25, 32, 39, 5, 12, 19, 26, 33, 40, 6, 13, 20, 27, 34, 41, 42, 43, 44.

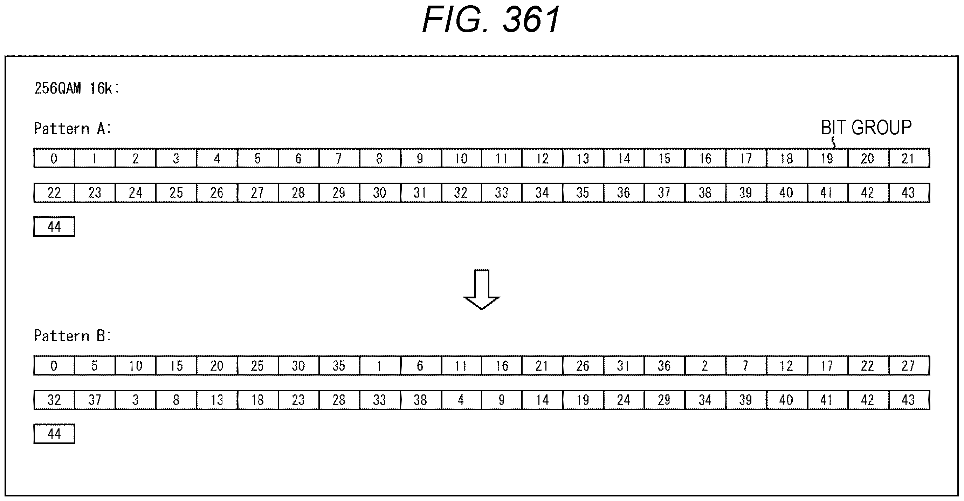

Fig. 361 is a diagram showing a relationship between a GW pattern (A) and a GW pattern (B) for the modulation system 256QAM and an LDPC code having a code length N of 16k bits.

In Fig. 361, a GW pattern (A) constituted by a GW pattern 0, 1, 2, and up to 42, 43, 44 is rewritten to a GW pattern (B).

According to the GW pattern (B) in Fig. 361, arrangement of bit groups 0 through 44 for a 16k-bit LDPC code is interleaved to arrangement 0, 5, 10, 15, 20, 25, 30, 35, 1, 6, 11, 16, 21, 26, 31, 36, 2, 7, 12, 17, 22, 27, 32, 37, 3, 8, 13, 18, 23, 28, 33, 38, 4, 9, 14, 19, 24, 29, 34, 39, 40, 41, 42, 43, 44.

<Configuration example of bit deinterleaver 165>

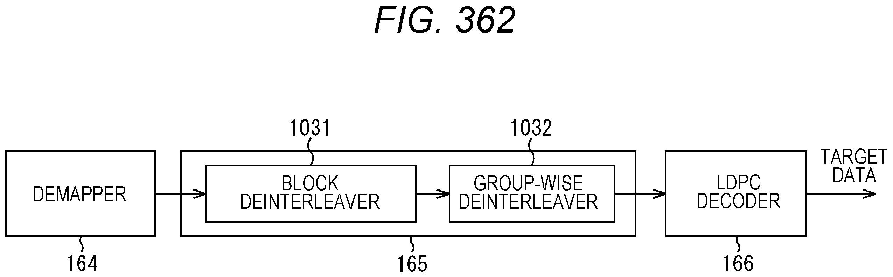

Fig. 362 is a block diagram showing a configuration example of the bit deinterleaver 165 shown in Fig. 207.
The bit deinterleaver 165 is constituted by a block deinterleaver 1031 and a group-wise deinterleaver 1032, and performs (bit) deinterleave for a symbol bit of a symbol as data received from the demapper 164 (Fig. 207).
More specifically, the block deinterleaver 1031 performs block deinterleave corresponding to block interleave performed by the block interleaver 1022 in Fig. 217 (reverse process of block interleave) for a target of a symbol bit of a symbol received from the demapper 164, i.e., block deinterleave for returning a position of (likelihood of) a sign bit of an LDPC code rearranged by block interleave to an original position, and supplies the resultant LDPC code to the group-wise deinterleaver 1032.
Note that the block deinterleaver 1031 corresponds to block deinterleave of the type A or the type B, and therefore performs block deinterleave of the type A or the type B.
The group-wise deinterleaver 1032 performs group-wise deinterleave for a target of the LDPC code received from the block deinterleaver 1031, as group-wise deinterleave corresponding to group-wise interleave performed by the group-wise interleaver 1021 in Fig. 217 (reverse process of group-wise interleave), i.e., group-wise deinterleave which rearranges, in units of bit group, a sign bit of an LDPC code whose arrangement has been changed by group-wise interleave to return the arrangement to the original arrangement, for example.
In this case, the group-wise deinterleaver 1032 rewrites a GW pattern for block deinterleave of the type A to a GW pattern for block deinterleave of the type B when performing block deinterleave of the type B on the assumption of execution of block deinterleave of the type A. More specifically, in this case, the group-wise deinterleaver 1032 rewrites an original GW pattern (A) to a converted GW pattern (B).
On the other hand, the group-wise deinterleaver 1032 rewrites a GW pattern for block deinterleave of the type B to a GW pattern for block deinterleave of the type A when performing block deinterleave of the type A on the assumption of execution of block deinterleave of the type B. More specifically, in this case, the group-wise deinterleaver 1032 rewrites an original GW pattern (B) to a converted GW pattern (A).
Note that the bit deinterleaver 165 is capable of performing all of reverse processes of parity deinterleave corresponding to parity interleave (reverse process of parity interleave, i.e., parity deinterleave for returning sign bit of LDPC code whose arrangement has been changed by parity interleave to original arrangement), block deinterleave corresponding to block interleave, and group-wise deinterleave corresponding to group-wise interleave when an LDPC code supplied from the demapper 164 to the bit deinterleaver 165 is parity interleaved, group-wise interleaved, and block interleaved.
Note that, while the bit deinterleaver 165 shown in Fig. 362 includes the block deinterleaver 1031 for performing block deinterleave corresponding to block interleave, and group-wise deinterleaver 1032 for performing group-wise deinterleave corresponding to group-wise interleave, the bit deinterleaver 165 does not include a block for performing parity deinterleave corresponding to parity interleave. Accordingly, the bit deinterleaver 165 does not perform parity interleave.
In this case, a block deinterleaved and group-wise deinterleaved, and not parity deinterleaved LDPC code is supplied from (group-wise deinterleaver 1032 of) the bit deinterleaver 165 to the LDPC decoder 166.
The LDPC decoder 166 performs LDPC decoding for the LDPC code received from the bit deinterleaver 165 by using a converted parity check matrix obtained by performing at least column permutation corresponding to parity interleave for the DVB system parity check matrix H used by the LDPC encoder 115 in Fig. 8 for LDPC encoding (or converted parity check matrix (Fig. 29) obtained by row permutation for ETRI system parity check matrix (Fig. 27)), and outputs resultant data as a decoding result of the LDPC target data.

<Configuration example of block deinterleaver 1031 corresponding to block deinterleave of type A>

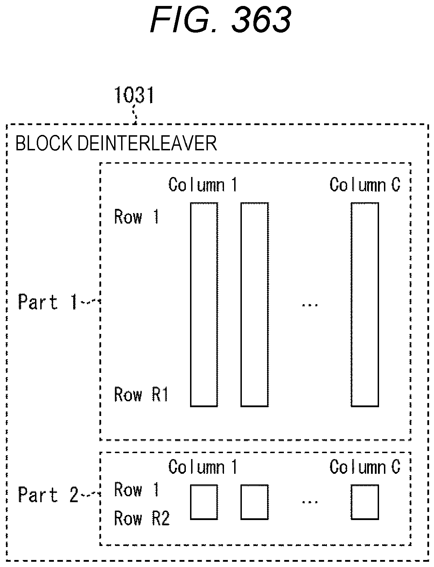

Fig. 363 is a block diagram showing a configuration example of the block deinterleaver 1031 shown in Fig. 362.
The block deinterleaver 1031 corresponding to block deinterleave of the type A is configured similarly to the block interleaver 1022 corresponding to block interleave of the type A described with reference to Fig. 218.
Accordingly, the block deinterleaver 1031 includes a storage area called part 1, and a storage area called part 2. Each of the parts 1 and 2 is constituted by a number C of columns as storage areas each of which stores 1 bit in the row direction, and a predetermined bit number in the column direction. The number C of the columns arranged in the row direction is the same number as a bit number m of a symbol.
The block deinterleaver 1031 writes and reads an LDPC code to and from the parts 1 and 2 to perform block deinterleave of the type A.
Note that writing of an LDPC code (corresponding to symbol) in block deinterleave of the type A is performed in the order of reading of the LDPC code by the block interleaver 1022 shown in Fig. 218.

In addition, in block deinterleave of the type A, reading of an LDPC code is performed in the order of writing of the LDPC code by the block interleaver 1022 shown in Fig. 218.

More specifically, while an LDPC code is written to the parts 1 and 2 in the column direction and read from the parts 1 and 2 in the row direction in block interleave of the type A performed by the block interleaver 1022 in Fig. 218, an LDPC code is written to the parts 1 and 2 in the row direction, and read from the parts 1 and 2 in the column direction in block deinterleave of the type A performed by the block deinterleaver 1031 in Fig. 363.

<Configuration example of block deinterleaver 1031 corresponding to block deinterleave of type B>

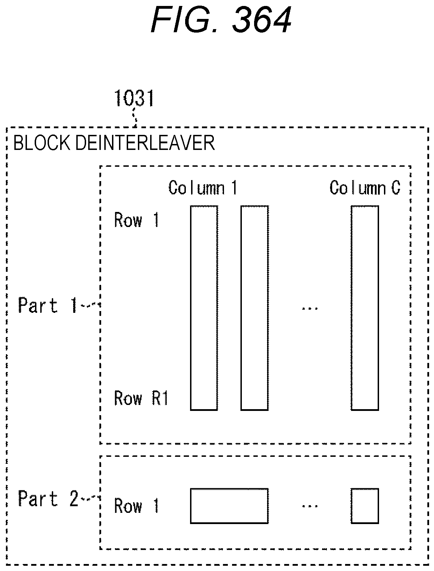

Fig. 364 is a block diagram showing a configuration example of the block deinterleaver 1031 shown in Fig. 362.

The block deinterleaver 1031 corresponding to block deinterleave of the type B is configured similarly to the block interleaver 1022 corresponding to block interleave of the type B described with reference to Fig. 224.

Accordingly, the block deinterleaver 1031 includes a storage area called part 1, and a storage area called part 2.

Parts 1 is constituted by a number C of columns as storage areas each of which stores 1 bit in the row direction and a predetermined bit number in the column direction. The number C of the columns arranged in the row direction is the same number as a bit number m of a symbol. On the other hand, the part 2 is constituted by rows as storage areas each of which stores 1 bit in the column direction, and a predetermined bit number in the row direction.

The block deinterleaver 1031 writes and reads an LDPC code to and from the parts 1 and 2 to perform block deinterleave of the type B.

Note that writing of an LDPC code (corresponding to symbol) in block deinterleave of the type B is performed in the order of reading of the LDPC code by the block interleaver 1022 shown in Fig. 224.

In addition, in block deinterleave of the type B, reading of an LDPC code is performed in the order of writing of the LDPC code by the block interleaver 1022 shown in Fig. 224.

More specifically, an LDPC code is written to the parts 1 and 2 in the row direction and read from the parts 1 and 2 in the row direction in block interleave of the type B performed by the block interleaver 1022 in Fig. 224, wherefore an LDPC code is written to the parts 1 and 2 in the row direction, and read from the parts 1 and 2 in the row direction in block deinterleave of the type B performed by the block deinterleaver 1031 in Fig. 364.

<Other configuration example of bit deinterleaver 165>

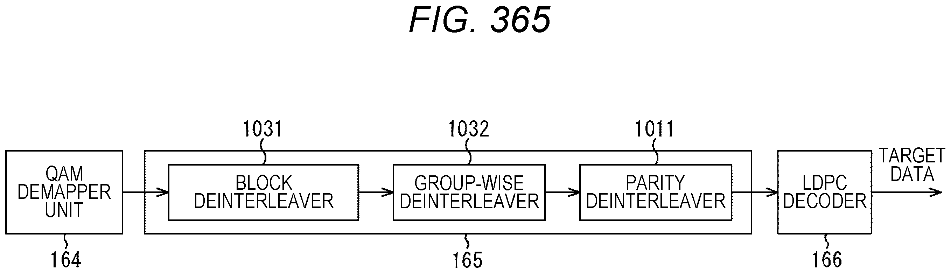

Fig. 365 is a block diagram showing another configuration example of the bit deinterleaver 165 shown in Fig. 207.

Note that parts in the figure identical to the corresponding parts in Fig. 362 have been given identical reference numbers. The same description of these parts is not repeated.

More specifically, the bit deinterleaver 165 in Fig. 365 is configured similarly to the example shown in Fig. 362 except that the parity deinterleaver 1011 is additionally provided.

The bit deinterleaver 165 in Fig. 365 is constituted by the block deinterleaver 1031, the group-wise deinterleaver 1032, and the parity deinterleaver 1011, and performs bit deinterleave for a sign bit of an LDPC code received from the demapper 164.

More specifically, the block deinterleaver 1031 performs block deinterleave corresponding to block interleave performed by the block interleaver 1022 of the transmission device 11 (i.e., reverse process of block interleave) for a target of an LDPC code received from the demapper 164, in other words, block deinterleave for returning a position of a sign bit changed by block interleave to an original position, and supplies the resultant LDPC code to the group-wise deinterleaver 1032.

The group-wise deinterleaver 1032 performs group-wise deinterleave corresponding to group-wise interleave as the rearranging process performed by the group-wise interleaver 1021 of the transmission device 11 for a target of an LDPC code received from the block deinterleaver 1031.

The LDPC code obtained by group-wise deinterleave is supplied from the group-wise deinterleaver 1032 to the parity deinterleaver 1011.

Note that parity deinterleave performed by the parity deinterleaver 1011, and LDPC decoding for the LDPC code performed by the LDPC decoder 166 are similar to the corresponding processing described with reference to Fig. 216, and therefore are not repeatedly described.

In addition, while each of the block deinterleaver 1031 performing block deinterleave, the group-wise deinterleaver 1032 performing group-wise deintelreave, and the parity deinterleaver 1011 performing group-wise deinterleave in Fig. 365 is separately configured for convenience of description, two or more of the block deinterleaver 1031, the group-wise deinterleaver 1032, and the parity deinterleaver 1011 may be formed integrally with each other similarly to the parity interleaver 23, the group-wise interleaver 1021, and the block interleaver 1022 of the transmission device 11.

<Configuration example of reception system>

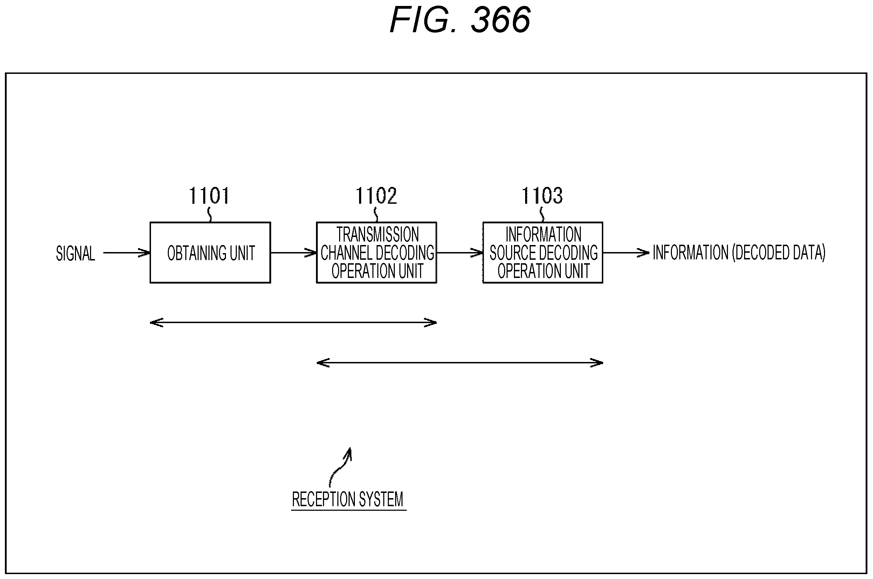

Fig. 366 is a block diagram showing a first configuration example of a reception system to which the reception device 12 is applicable.

The reception system shown in Fig. 366 is constituted by the obtaining unit 1101, a transmission channel decoding operation unit 1102, and an information source decoding operation unit 1103.

The obtaining unit 1101 obtains a signal which contains an LDPC code generated by performing at least LDPC encoding for LDPC target data such as image data and audio data of a program, via terrestrial digital broadcasting, satellite digital broadcasting, a CATV network, the Internet or other not-shown transmission channels (communication channels), and supplies the obtained signal to the transmission channel decoding operation unit 1102.

Here, when the signal obtained by the obtaining unit 1101 is broadcasted from a broadcasting station via a terrestrial wave, a satellite wave, a cable television (CATV) network or the like, the obtaining unit 1101 is constituted by a tuner, a set top box (STB) or the like. On the other hand, when the signal obtained by the obtaining unit 1101 is transmitted from a web server by multicast such as Internet protocol television (IPTV), the obtaining unit 1101 is constituted by a network interface (I/F) such as a network interface card (NIC).

The transmission channel decoding operation unit 1102 corresponds to the reception device 12. The transmission channel decoding operation unit 1102 performs a transmission channel decoding process containing at least a process performed for the signal obtained by the obtaining unit 1101 via the transmission channel to correct errors produced in the transmission channel, and supplies the resultant signal to the information source decoding operation unit 1103.

More specifically, the signal obtained by the obtaining unit 1101 via the transmission channel is a signal obtained by performing at least error correcting encoding for correcting errors produced in the transmission channel. The transmission channel decoding operation unit 1102 performs a transmission channel decoding process such as an error correcting process for the signal thus obtained.

Here, the error correcting encoding herein is LDPC encoding, BCH encoding or other processing. In this example, at least LDPC encoding is performed as the error correcting encoding.

In addition, the transmission channel decoding process may include demodulation of a modulation signal, for example.

The information source decoding operation unit 1103 performs an information source decoding process which includes at least a process for extending compressed information to original information.

More specifically, the signal obtained by the obtaining unit 1101 via the transmission channel may be a compressedly encoded signal containing compressed information to reduce a data amount such as image data and audio data as information. In this case, the information source decoding operation unit 1103 performs an information source decoding process such as a process for extending compressed information to original information (extension process) for the signal subjected to the transmission channel decoding process.

Note that the information source decoding operation unit 1103 does not perform the process for extending compressed information to original information when the signal obtained by the obtaining unit 1101 via the transmission channel is not compressedly encoded.

The extension process herein is moving picture experts group (MPEG) decoding, for example. In addition, the transmission channel decoding process may contain descrambling or other processing as well as the extension process.

According to the reception system thus configured, the obtaining unit 1101 obtains, via the transmission channel, a signal generated by compressed encoding such as MPEG encoding for data such as image data and audio data, and further error correction encoding such as LDPC encoding, and supplies the obtained signal to the transmission channel decoding operation unit 1102, for example.

The transmission channel decoding operation unit 1102 performs the transmission channel decoding process such as processing similar to processing performed by the transmission device 12 for a signal received from the obtaining unit 1101, and supplies the signal to the information source decoding operation unit 1103.

The information source decoding operation unit 1103 performs an information source decoding process such as MPEG decoding for the signal received from the transmission channel decoding operation unit 1102, and outputs resultant images and voices.

The foregoing reception system shown in Fig. 366 is applicable to a television tuner or the like for receiving television broadcasting as digital broadcasting, for example.

Note that each of the obtaining unit 1101, the transmission channel decoding operation unit 1102, and the information source decoding operation unit 1103 may be constituted by one individual device (such as hardware (integrated circuit (IC), or software module).

In addition, the obtaining unit 1101, the transmission channel decoding operation unit 1102, and the information source decoding operation unit 1103 may be constituted such that each of a set of the obtaining unit 1101 and the transmission channel decoding operation unit 1102, a set of the transmission channel decoding operation unit 1102 and the information source decoding operation unit 1103, or a set of the obtaining unit 1101, the transmission channel decoding operation unit 1102, and the information source decoding operation unit 1103 constitute an independent device.

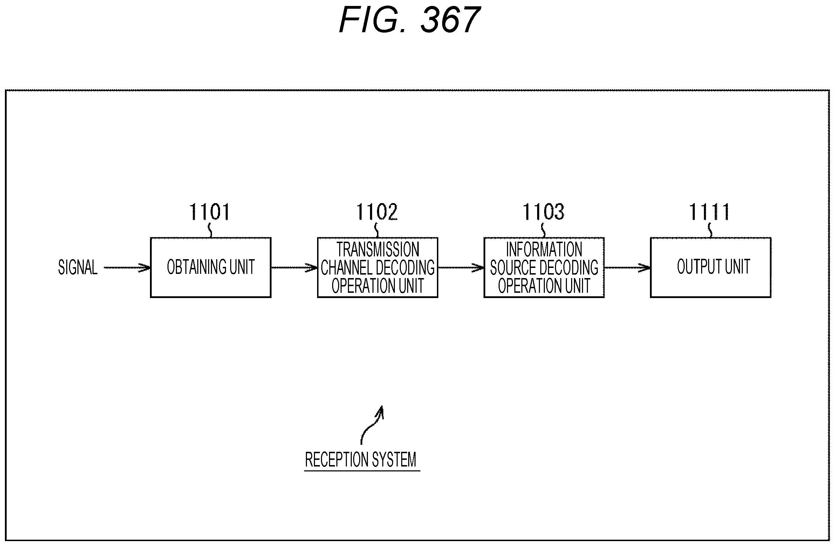

Fig. 367 is a block diagram showing a second configuration example of a reception system to which the reception device 12 is applicable.

Note that parts in the figure identical to the corresponding parts in Fig. 366 have been given identical reference numbers. The same description of these parts is not repeated.

The reception system in Fig. 367 is similar to the example shown in Fig. 366 in that the obtaining unit 1101, the transmission channel decoding operation unit 1102, and the information source decoding operation unit 1103 are provided, but is different from the example shown in Fig. 366 in that an output unit 1111 is newly provided.

The output unit 1111 is a display device which displays images, or a speaker which outputs voices, for example. The output unit 1111 outputs images and voices as signals output from the information source decoding operation unit 1103. More specifically, the output unit 1111 displays images, or outputs voices.

The reception system thus configured and shown in Fig. 367 is applicable to TV (television receiver) for receiving television broadcasting as digital broadcasting, a radio receiver for receiving radio broadcasting or the like, for example.

Note that a signal output from the transmission channel decoding operation unit 1102 is supplied to the output unit 1111 when the signal obtained by the obtaining unit 1101 is not compressedly encoded.

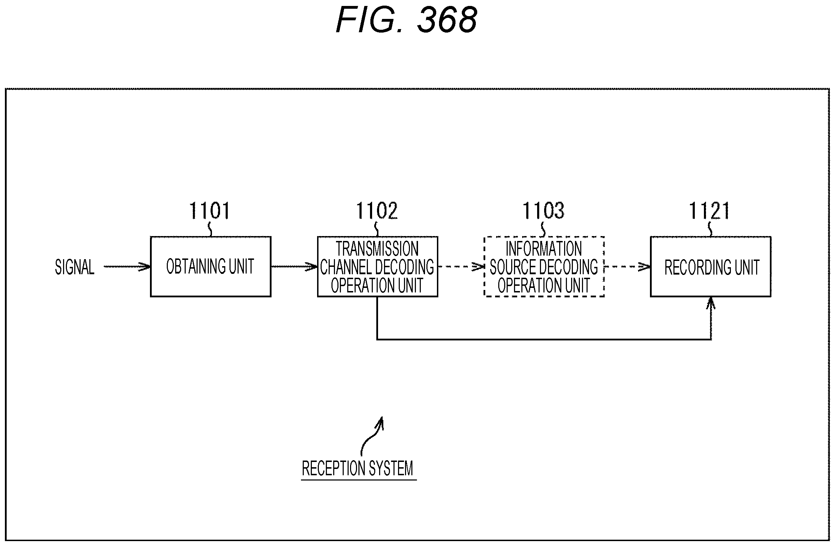

Fig. 368 is a block diagram showing a third configuration example of a reception system to which the reception device 12 is applicable.

Note that parts in the figure identical to the corresponding parts in Fig. 366 have been given identical reference numbers. The same description of these parts is not repeated.

The reception system in Fig. 368 is similar to the example shown in Fig. 366 in that the reception system includes the obtaining unit 1101 and the transmission channel decoding operation unit 1102.

However, the reception system shown in Fig. 368 is different from the example shown in Fig. 366 in that the reception system does not include the information source decoding operation unit 1103, but additionally includes a recording unit 1121.

The recording unit 1121 records (stores) a signal output from the transmission channel decoding process 1102 (such as TS packets of TS of MPEG) in an optical disk, a hard disk (magnetic desk), a flash memory, or other recording (storage) medium.

The foregoing reception system shown in Fig. 368 is applicable to a recorder for recording television broadcasting, for example.

Note that the reception system in Fig. 368 may include the information source decoding operation unit 1103 which records signals obtained by an information source decoding process, i.e., records decoded images and voices in the recording unit 1121.

<Computer of embodiment>

A series of processes described herein may be executed either by hardware or software. When the series of processes is performed by software, programs constituting the software are installed in a general-purpose computer, for example.

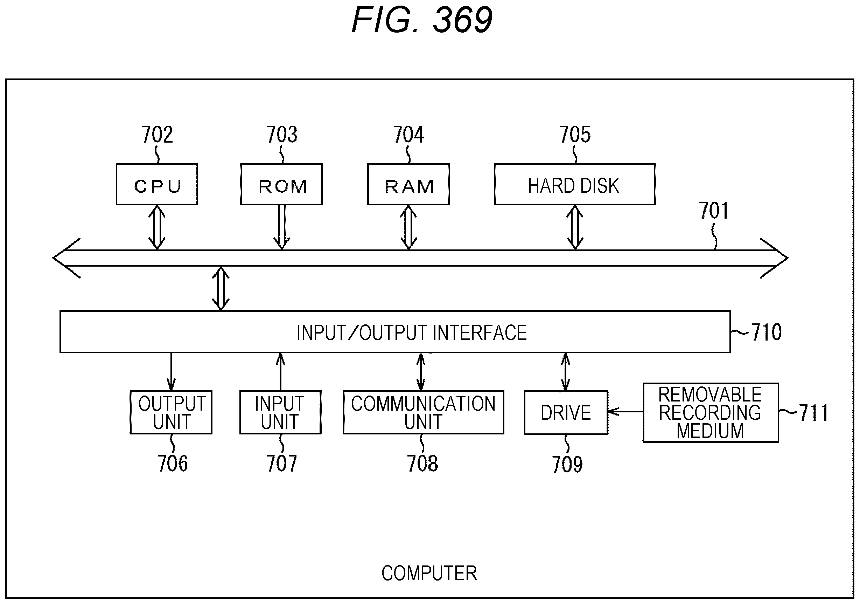

Fig. 369 shows a configuration example of a computer according to an embodiment. The computer includes programs installed to execute the series of processes described herein.

The programs may be recorded beforehand in a hard disk 705 or a ROM 703 as a recording medium contained in the computer.

Alternatively, the programs may be temporarily or permanently stored (recorded) in a removable recording medium 711 such as a flexible disk, a compact disk read only memory (CD-ROM), a magneto-optical (MO) disk, a digital versatile disc (DVD), a magnetic disk, and a semiconductor memory. The removable recording medium 711 thus configured may be provided as so-called package software.

Note that the programs may be installed in the computer from the removable recording medium 711 described above, or may be wirelessly transferred to the computer from a download site via an artificial satellite for digital satellite broadcasting, or wirelessly transferred to the computer via a network such as a local area network (LAN) and the Internet. The programs transferred to the computer in this manner are received by the computer via a communication unit 708, and installed in the built-in hard disk 705 of the computer.

The computer contains a central processing unit (CPU) 702. An input/output interface 710 is connected to the CPU 702 via a bus 701. When a command is input to the CPU 702 via the input/output interface 710 from a user through operation of an input unit 707 constituted by a keyboard, a mouse, a microphone or the like, the CPU 702 executes the programs stored in the read only memory (ROM) 703 in accordance with the command. In addition, the CPU 702 loads, to a random access memory (RAM) 704, programs stored in the hard disk 705, programs transferred from a satellite or a network, received via the communication unit 708, and installed in the hard disk 705, and programs read from the removable recording medium 711 attached to a drive 709 and installed in the hard disk 705, and executes the programs. Under these programs, the CPU 702 performs the processes shown in the foregoing flowcharts, or the processes using the configurations in the foregoing block diagrams. In this case, the CPU 702 outputs the processing results from an output unit 706 constituted by a liquid crystal display (LCD), a speaker or the like via the input/output interface 710, transmits the processing results from the communication unit 708, or records the processing results in the hard disk 705, for example, as necessary.

Here, processing steps describing the programs under which the computer executes various types of processes in the present specification need not be performed in time series in the order described in the flowcharts, but may be processes performed in parallel or individually (such as parallel processes or processes by objects), for example.

Moreover, the programs may be performed by one computer, or shared by a plurality of computers. In addition, the programs may be transferred to and executed by a remote computer.

Note that embodiments of the present technology are not limited to the specific embodiment described herein. Various modifications and changes may be made without departing from the subject matters of the present technology.

More specifically, new LDPC codes (parity check matrix initial value table of new LDPC codes) described above may be transmitted via the communication channel 13 (Fig. 7) constituted by any one of a satellite line, a terrestrial wave, and a cable (wired line), or others, for example. Moreover, new LDPC codes may be transmitted via data transmission other than digital broadcasting.

Furthermore, GW patterns described above are applicable to targets other than new LDPC codes. In addition, modulation systems to which GW patterns described above are applied are not limited to QPSK, 16QAM, 64QAM, 256QAM, 1024QAM, and 4096QAM.

Note that effects to be produced are not limited to the effects described in the present specification presented only by way of example, but may include other effects.

REFERENCE SIGNS LIST

| 11 | Transmission device |
| 12 | Reception device |
| 23 | Parity interleaver |
| 24 | Group-wise interleaver |
| 25 | Block interleaver |
| 54 | Block deinterleaver |
| 55 | Group-wise deinterleaver |
| 111 | Mode adaptation/multiplexer |
| 112 | Padder |
| 113 | BB scrambler |
| 114 | BCH encoder |
| 115 | LDPC encoder |
| 116 | Bit interleaver |
| 117 | Mapper |
| 118 | Time interleaver |
| 119 | SISO/MISO encoder |
| 120 | Frequency interleaver |
| 121 | BCH encoder |
| 122 | LDPC encoder |
| 123 | Mapper |
| 124 | Frequency interleaver |
| 131 | Frame builder/resource allocation unit |
| 132 | OFDM generation unit |
| 151 | OFDM operation unit |
| 152 | Frame management unit |
| 153 | Frequency deinterleaver |
| 154 | Demapper |
| 155 | LDPC decoder |
| 156 | BCH decoder |
| 161 | Frequency deinterleaver |
| 162 | SISO/MISO decoder |

163     Time deinterleaver
164     Demapper
165     Bit deinterleaver
166     LDPC decoder
167     BCH decoder
168     BB descrambler
169     Null deletion unit
170     Demultiplexer
300     Edge data storage memory
301     Selector
302     Check node calculation unit
303     Cyclic shift circuit
304     Edge data storage memory
305     Selector
306     Reception data memory
307     Variable node calculation unit
308     Cyclic shift circuit
309     Decode word calculation unit
310     Reception data rearrangement unit
311     Decode data rearrangement unit
601     Encoding operation unit
602     Storage unit
611     Coding rate setting unit
612     Initial value table reading unit
613     Parity check matrix generation unit
614     Information bit reading unit
615     Encoded parity calculation unit
616     Control unit
701     Bus
702     CPU
703     ROM
704     RAM
705     Hard disk
706     Output unit
707     Input unit
708     Communication unit
709     Drive
710     Input/output interface
711     Removable recording medium
1001    Reverse permutation unit
1002    Memory
1011    Parity deinterleaver
1021    Group-wise interleaver
1022    Block interleaver
1031    Block deinterleaver
1032    Group-wise deinterleaver
1101    Obtaining unit
1101    Transmission channel decoding operation unit
1103    Information source decoding operation unit
1111    Output unit
1121    Recording unit

**Claims**

1.  A data processing device comprising:

        a group-wise interleave unit that performs group-wise interleave for interleaving a low-density parity-check (LDPC) code having a code length N of 16200 bits or 64800 bits in units of bit group of 360 bits; and

a block interleave unit that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system, wherein a system of block interleave performed by the block interleave unit includes a type A that repeats writing of the group-wise interleaved LDPC code to the m columns in a column direction of the columns, and a type B that repeats writing of the group-wise interleaved LDPC code to the m columns in a row direction of the columns in units of bit group,

modulation and coding (MODCOD) as a combination of the LDPC code and the modulation system includes MODCOD-A as MODCOD that assumes execution of block interleave of the type A, and MODCOD-B as MODCOD that assumes execution of block interleave of the type B, and

the group-wise interleave unit performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A.

2. A data processing method comprising:

a group-wise interleave step that performs group-wise interleave for interleaving a low-density parity-check (LDPC) code having a code length N of 16200 bits or 64800 bits in units of bit group of 360 bits; and

a block interleave step that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system, wherein

a system of block interleave performed by the block interleave step includes a type A that repeats writing of the group-wise interleaved LDPC code to the m columns in a column direction of the columns, and a type B that repeats writing of the group-wise interleaved LDPC code to the m columns in a row direction of the columns in units of bit group,

modulation and coding (MODCOD) as a combination of the LDPC code and the modulation system includes MODCOD-A as MODCOD that assumes execution of block interleave of the type A, and MODCOD-B as MODCOD that assumes execution of block interleave of the type B, and

group-wise interleave in the group-wise interleave step performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A.

3. A data processing device, wherein
a transmission device includes

a group-wise interleave unit that performs group-wise interleave for interleaving a low-density parity-check (LDPC) code having a code length N of 16200 bits or 64800 bits in units of bit group of 360 bits,

a block interleave unit that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system,

a system of block interleave performed by the block interleave unit, and including a type A that repeats writing of the group-wise interleaved LDPC code to the m columns in a column direction of the columns, and a type B that repeats writing of the group-wise interleaved LDPC code to the m columns in a row direction in units of bit group,

modulation and coding (MODCOD) as a combination of the LDPC code and the modulation system the MODCOD including MODCOD-A as MODCOD that assumes execution of block interleave of the type A, and MODCOD-B as MODCOD that assumes execution of block interleave of the type B, and

the group-wise interleave unit that performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A,

the data processing device comprising:

a block deinterleave unit that performs block deinterleave for returning m bits of the symbol obtained from data transmitted from the transmission device to the group-wise interleaved LDPC code; and
a group-wise deinterleave unit that performs group-wise deinterleave for returning arrangement of the group-wise interleaved LDPC code to original arrangement.

4. A data processing method, wherein
a transmission device includes

a group-wise interleave unit that performs group-wise interleave for interleaving a low-density parity-check (LDPC) code having a code length N of 16200 bits or 64800 bits in units of bit group of 360 bits,
a block interleave unit that writes the group-wise interleaved LDPC code to m columns as storage areas arranged in a row direction, and block interleaves m bits obtained by reading the LDPC code bit by bit from each of the m columns into one symbol corresponding to any one of $2^m$ signal points defined by a modulation system,
a system of block interleave performed by the block interleave unit, and including a type A that repeats writing of the group-wise interleaved LDPC code to the m columns in a column direction of the columns, and a type B that repeats writing of the group-wise interleaved LDPC code to the m columns in a row direction of the columns in units of bit group,
modulation and coding (MODCOD) as a combination of the LDPC code and the modulation system the MODCOD including MODCOD-A as MODCOD that assumes execution of block interleave of the type A, and MODCOD-B as MODCOD that assumes execution of block interleave of the type B, and
the group-wise interleave unit that performs group-wise interleave for the LDPC code of the MODCOD-B such that a block interleave result identical to a block interleave result of the type B is obtainable at the time of execution of the type A for block interleave of the LDPC code of the MODCOD-B, or performs group-wise interleave for the LDPC code of the MODCOD-A such that a block interleave result identical to a block interleave result of the type A is obtainable at the time of execution of the type B for block interleave of the LDPC code of the MODCOD-A,

the data processing method comprising:

a block deinterleave step that performs block deinterleave for returning m bits of the symbol obtained from data transmitted from the transmission device to the group-wise interleaved LDPC code; and
a group-wise deinterleave step that performs group-wise deinterleave for returning arrangement of the group-wise interleaved LDPC code to original arrangement.

# FIG. 1

$$H = \begin{bmatrix} & & & & \vdots & & & & \\ \cdots 1 \cdots 1 \cdot & 1 & \cdots 1 \cdots 1 \cdots 1 \\ & & & & \vdots & & & & \\ & & & & 1 & & & & \\ & & & & \vdots & & & & \end{bmatrix}$$

# FIG. 2

```
        ( START )
           │
           ▼
┌──────────────────────────┐
│ RECEIVE RECEPTION VALUE u_oi │ S11
│      u_j=0, k=0          │
└──────────────────────────┘
           │
           ▼ ◄─────────────┐
┌──────────────────────────┐│
│   OBTAIN MESSAGE v_i,     │ S12
│   AND MESSAGE u_j         ││
│   SET k=k+1               ││
└──────────────────────────┘│
           │                │
           ▼      S13        │
      No  ╱─────────╲ ───────┘
     ◄────  k>C ?   ╲
          ╲─────────╱
           │Yes
           ▼
┌──────────────────────────┐
│  OBTAIN AND OUTPUT        │ S14
│     MESSAGE v_i           │
└──────────────────────────┘
           │
           ▼
         ( END )
```

# FIG. 3

$$H = \begin{bmatrix} 1 & 1 & 1 & 0 & 0 & 0 & 1 & 0 & 1 & 1 & 0 & 0 \\ 1 & 1 & 0 & 1 & 1 & 0 & 0 & 0 & 0 & 0 & 1 & 1 \\ 0 & 0 & 1 & 1 & 1 & 1 & 1 & 0 & 0 & 1 & 0 & 0 \\ 0 & 0 & 0 & 1 & 1 & 1 & 0 & 1 & 1 & 0 & 0 & 1 \\ 1 & 1 & 0 & 0 & 0 & 1 & 0 & 1 & 0 & 1 & 1 & 0 \\ 0 & 0 & 1 & 0 & 0 & 0 & 1 & 1 & 1 & 0 & 1 & 1 \end{bmatrix}$$

# FIG. 4

CHECK NODE

VARIABLE NODE

# FIG. 5

# FIG. 6

# FIG. 7

TRANSMISSION SYSTEM

FIG. 8

EP 3 247 043 A1

# FIG. 9

## FIG. 10

PARITY CHECK MATRIX

EP 3 247 043 A1

## FIG. 11

$H_T =$

PARITY MATRIX $H_T$

## FIG. 12

INFORMATION MATRIX $H_A$    PARITY MATRIX $H_T$

PARITY CHECK MATRIX

X    COLUMN WEIGHT 3    COLUMN WEIGHT 2    1    M

KX    K3    M−1    1

FIG. 13

| | N=64800 | | | | N=16200 | | | |
|---|---|---|---|---|---|---|---|---|
| Nominal CODING RATE | X | KX | K3 | M | X | KX | K3 | M |
| 1/4 | 12 | 5400 | 10800 | 48600 | 12 | 1440 | 1800 | 12960 |
| 1/3 | 12 | 7200 | 14400 | 43200 | 12 | 1800 | 3600 | 10800 |
| 2/5 | 12 | 8640 | 17280 | 38880 | 12 | 2160 | 4320 | 9720 |
| 1/2 | 8 | 12960 | 19440 | 32400 | 8 | 1800 | 5400 | 9000 |
| 3/5 | 12 | 12960 | 25920 | 25920 | 12 | 3240 | 6480 | 6480 |
| 2/3 | 13 | 4320 | 38880 | 21600 | 13 | 1080 | 9720 | 5400 |
| 3/4 | 12 | 5400 | 43200 | 16200 | 12 | 360 | 11520 | 4320 |
| 4/5 | 11 | 6480 | 45360 | 12960 | – | 0 | 12600 | 3600 |
| 5/6 | 13 | 5400 | 48600 | 10800 | 13 | 360 | 12960 | 2880 |
| 8/9 | 4 | 7200 | 50400 | 7200 | 4 | 1800 | 12600 | 1800 |
| 9/10 | 4 | 6480 | 51840 | 6480 | ――― | ――― | ――― | ――― |

COLUMN NUMBER OF EACH COLUMN WEIGHT

EP 3 247 043 A1

## FIG. 14

SIGN BIT

Erasure       Erasure

VARIABLE NODE

CHECK NODE

# FIG. 15

ECHELON STRUCTURE
OF PARITY MATRIX

A

SIGN BIT

Erasure   Erasure

~VARIABLE NODE

~CHECK NODE

ECHELON STRUCTURE
PART IN Tanner Graph

B

# FIG. 16

ADJOINING ELEMENTS ARE SEPARATED BY 360 COLUMNS.

PARITY MATRIX

$M = q \times 360$ ROWS

*ROW PERMUTATION IS PERFORMED IN THIS EXAMPLE, BUT ONLY COLUMN PERMUTATION IS SIGNIFICANT IN "interleave".

ONLY THIS SHIFT INCREASES RESISTANCE OF Parity BITS TO Burst ERRORS.

# FIG. 17

```
         ( START )
             │
             ▼
    ┌──────────────────┐ S101
    │   ENCODE LDPC    │
    └──────────────────┘
             │
             ▼
┌────────────────────────────────────────────────────────┐ S102
│                   BIT INTERLEAVE                        │
│   (PARITY INTERLEAVE, GROUP-WISE INTERLEAVE,            │
│               BLOCK INTERLEAVE)                         │
└────────────────────────────────────────────────────────┘
             │
             ▼
    ┌──────────────────┐ S103
    │  MAP, MODULATE   │
    └──────────────────┘
             │
             ▼
         ( END )
```

# FIG. 18

115

**LDPC ENCODER**

ENCODING OPERATION UNIT — 601

611 — CODING RATE SETTING UNIT

TARGET DATA → 612 — INITIAL VALUE TABLE READING UNIT → LDPC CODE

613 — PARITY CHECK MATRIX GENERATION UNIT

614 — INFORMATION BIT READING UNIT

615 — ENCODING PARITY CALCULATION UNIT

616 — CONTROL UNIT

STORAGE UNIT — 602

PARITY CHECK MATRIX
INITIAL VALUE TABLE
(EACH CODING RATE)

EP 3 247 043 A1

## FIG. 19

```
                    ( START )
                        |
S201 |  SET CODING RATE OF PARITY CHECK MATRIX  | ←
                        |
S202 |  READ PARITY CHECK MATRIX INITIAL VALUE
        TABLE CORRESPONDING TO CODING RATE  |
                        |
S203 |  DETERMINE LDPC CODING PARITY CHECK MATRIX H  |
                        |
S204 |  READ INFORMATION BIT COLUMN  |
                        |
S205 |  PERFORM LDPC-ENCODING FOR
        INFORMATION BIT COLUMN BY PARITY CHECK
        MATRIX H, AND PARITY CALCULATION  |
                        |
S206 <  ENCODING END?  > No
                        | Yes
                    ( END )
```

## FIG. 20

```
┌─r1/4  16K ─────────────────────────────────────────────
 6295  9626  304  7695  4839  4936  1660  144  11203  5567  6347  12557
 10691  4988  3859  3734  3071  3494  7687  10313  5964  8069  8296  11090
 10774  3613  5208  11177  7676  3549  8746  6583  7239  12265  2674  4292
 11869  3708  5981  8718  4908  10650  6805  3334  2627  10461  9285  11120
 7844  3079  10773
 3385  10854  5747
 1360  12010  12202
 6189  4241  2343
 9840  12726  4977
```

## FIG. 21

INDICATE ROW NUMBERS OF PARITY CHECK MATRIX (INFORMATION MATRIX $H_A$)
FROM FIRST COLUMN AT 360 COLUMN INTERVALS

ROW NUMBERS OF PARITY CHECK MATRIX →

1ST COLUMN OF $H_A$ →
361ST COLUMN OF $H_A$ →
721ST COLUMN OF $H_A$ →
1081ST COLUMN OF $H_A$ →

```
0  2084  1613  1548  1286  1460  3196  4297  2481  3369  3451  4620  2622
1  122   1516  3448  2880  1407  1847  3799  3529  373   971   4358  3108
2  259   3399  929   2650  864   3996  3833  107   5287  164   3125  2350
3  342   3529
4  4198  2147
5  1880  4836
6  3864  4910
7  243   1542
8  3011  1436
9  2167  2512
10 4606  1003
11 2835  705
12 3426  2365
13 3848  2474
14 1360  1743
0  163   2536
1  2583  1180
2  1542  509
3  4418  1005
4  5212  5117
5  2155  2922
6  347   2696
7  226   4296
8  1560  487
9  3926  1640
10 149   2928
11 2364  563
12 635   688
13 231   1684
14 1129  3894
```

$h_{3,5}$

PARITY CHECK MATRIX
INITIAL VALUE TABLE

EP 3 247 043 A1

# FIG. 22

# FIG. 23

2 6 18
2 10 19
22
19
15

PROVIDED BY CRC/ETRI

# FIG. 24

EP 3 247 043 A1

FIG. 25

EP 3 247 043 A1

PROVIDED BY CRC/ETRI

*FIG. 26*

124

*FIG. 27*

FIG. 28

EP 3 247 043 A1

# FIG. 29

EP 3 247 043 A1

# FIG. 30

```
N=16200, rate=8/15
    5 519 825 1871 2098 2478 2659 2820 3200 3294 3650 3804 3949 4426 4460 4503 456
8 4590 4949 5219 5662 5738 5905 5911 6160 6404 6637 6708 6737 6814 7263 7412
   81 391 1272 1633 2062 2882 3443 3503 3535 3908 4033 4163 4490 4929 5262 5399 5
576 5768 5910 6331 6430 6844 6867 7201 7274 7290 7343 7350 7378 7387 7440 7554
  105 975 3421 3480 4120 4444 5957 5971 6119 6617 6761 6810 7067 7353
  6 138 485 1444 1512 2615 2990 3109 5604 6435 6513 6632 6704 7507
  20 858 1051 2539 3049 5162 5308 6158 6391 6604 6744 7071 7195 7238
  1140 5838 6203 6748
  6282 6466 6481 6638
  2346 2592 5436 7487
  2219 3897 5896 7528
  2897 6028 7018
  1285 1863 5324
  3075 6005 6466
  5 6020 7551
  2121 3751 7507
  4027 5488 7542
  2 6012 7011
  3823 5531 5687
  1379 2262 5297
  1882 7498 7551
  3749 4806 7227
  2 2074 6898
  17 616 7482
  9 6823 7480
  5195 5880 7559
```

# FIG. 31

```
┌─ N=16200, rate=10/15 ─────────────────────────────────────────────────────────
│  352 747 894 1437 1688 1807 1883 2119 2159 3321 3400 3543 3588 3770 3821 4384 4
│ 470 4884 5012 5036 5084 5101 5271 5281 5353
│  505 915 1156 1269 1518 1650 2153 2256 2344 2465 2509 2867 2875 3007 3254 3519
│ 3687 4331 4439 4532 4940 5011 5076 5113 5367
│  268 346 650 919 1260 4389 4653 4721 4838 5054 5157 5162 5275 5362
│  220 236 828 1590 1792 3259 3647 4276 4281 4325 4963 4974 5003 5037
│  381 737 1099 1409 2364 2955 3228 3341 3473 3985 4257 4730 5173 5242
│  88 771 1640 1737 1803 2408 2575 2974 3167 3464 3780 4501 4901 5047
│  749 1502 2201 3189
│  2873 3245 3427
│  2158 2605 3165
│  1 3438 3606
│  10 3019 5221
│  371 2901 2923
│  9 3935 4683
│  1937 3502 3735
│  507 3128 4994
│  25 3854 4550
│  1178 4737 5366
│  2 223 5304
│  1146 5175 5197
│  1816 2313 3649
│  740 1951 3844
│  1320 3703 4791
│  1754 2905 4058
│  7 917 5277
│  3048 3954 5396
│  4804 4824 5105
│  2812 3895 5226
│  0 5318 5358
│  1483 2324 4826
│  2266 4752 5387
```

# FIG. 32

```
N=16200, rate=12/15
3  394 1014 1214 1361 1477 1534 1660 1856 2745 2987 2991 3124 3155
59  136  528  781  803  928 1293 1489 1944 2041 2200 2613 2690 2847
155  245  311  621 1114 1269 1281 1783 1995 2047 2672 2803 2885 3014
79  870  974 1326 1449 1531 2077 2317 2467 2627 2811 3083 3101 3132
4  582  660  902 1048 1482 1697 1744 1928 2628 2699 2728 3045 3104
175  395  429 1027 1061 1068 1154 1168 1175 2147 2359 2376 2613 2682
1388 2241 3118 3148
143  506 2067 3148
1594 2217 2705
398  988 2551
1149 2588 2654
678 2844 3115
1508 1547 1954
1199 1267 1710
2589 3163 3207
1 2583 2974
2766 2897 3166
929 1823 2742
1113 3007 3239
1753 2478 3127
0  509 1811
1672 2646 2984
965 1462 3230
3 1077 2917
1183 1316 1662
968 1593 3239
64 1996 2226
1442 2058 3181
513  973 1058
1263 3185 3229
681 1394 3017
419 2853 3217
3 2404 3175
2417 2792 2854
1879 2940 3235
647 1704 3060
```

EP 3 247 043 A1

# FIG. 33

```
┌─ N=64800, rate=7/15 ──────────────────────────────────────────────
    7 15 26 69 1439 3712 5756 5792 5911 8456 10579 19462 19782 21709 23214 25142 2
6040 30206 30475 31211 31427 32105 32989 33082 33502 34116 34241 34288 34292 343
18 34373 34390 34465
    83 1159 2271 6500 6807 7823 10344 10700 13367 14162 14242 14352 15015 17301 18
952 20811 24974 25795 27868 28081 33077 33204 33262 33350 33516 33677 33680 3393
0 34090 34250 34290 34377 34398
    25 2281 2995 3321 6006 7482 8428 11489 11601 14011 17409 26210 29945 30675 311
01 31355 31421 31543 31697 32056 32216 33282 33453 33487 33696 34044 34107 34213
34247 34261 34276 34467 34495
    0 43 87 2530 4485 4595 9951 11212 12270 12344 15566 21335 24699 26580 28518 28
564 28812 29821 30418 31467 31871 32513 32597 33187 33402 33706 33838 33932 3397
7 34084 34283 34440 34473
    81 3344 5540 7711 13308 15400 15885 18265 18632 22209 23657 27736 29158 29701
29845 30409 30654 30855 31420 31604 32519 32901 33267 33444 33525 33712 33878 34
031 34172 34432 34496 34502 34541
    42 50 66 2501 4706 6715 6970 8637 9999 14555 22776 26479 27442 27984 28534 295
87 31309 31783 31907 31927 31934 32313 32369 32830 33364 33434 33553 33654 33725
33889 33962 34467 34482
    6534 7122 8723 13137 13183 15818 18307 19324 20017 26389 29326 31464 32678 336
68 34217
    50 113 2119 5038 5581 6397 6550 10987 22308 25141 25943 29299 30186 33240 3339
9
    7262 8787 9246 10032 10505 13090 14587 14790 16374 19946 21129 25726 31033 336
60 33675
    5004 5087 5291 7949 9477 11845 12698 14585 15239 17486 18100 18259 21409 21789
24280
    28 82 3939 5007 6682 10312 12485 14384 21570 25512 26612 26854 30371 31114 326
89
    437 3055 9100 9517 12369 19030 19950 21328 24196 24236 25928 28458 30013 32181
33560
    18 3590 4832 7053 8919 21149 24256 26543 27266 30747 31839 32671 33089 33571 3
4296
    2678 4569 4667 6551 7639 10057 24276 24563 25818 26592 27879 28028 29444 29873
34017
    72 77 2874 9092 10041 13669 20676 20778 25566 28470 28888 30338 31772 32143 33
939
    296 2196 7309 11901 14025 15733 16768 23587 25489 30936 31533 33749 34331 3443
1 34507
    6 8144 12490 13275 14140 18706 20251 20644 21441 21938 23703 34190 34444 34463
34495
    5108 14499 15734 19222 24695 25667 28359 28432 30411 30720 34161 34386 34465 3
4511 34522
    61 89 3042 5524 12128 22505 22700 22919 24454 30526 33437 34114 34188 34490 34
502
    11 83 4668 4856 6361 11633 15342 16393 16958 26613 29136 30917 32559 34346 345
04
    3185 9728 25062
    1643 5531 21573
    2285 6088 24083
```

## FIG. 34

```
78 14678 19119
49 13705 33535
21192 32280 32781
10753 21469 22084
10082 11950 13889
7861 25107 29167
14051 34171 34430
706 894 8316
29693 30445 32281
10202 30964 34448
15815 32453 34463
4102 21608 24740
4472 29399 31435
1162 7118 23226
4791 33548 34096
1084 34099 34418
1765 20745 33714
1302 21300 33655
33 8736 16646
53 18671 19089
21 572 2028
3339 11506 16745
285 6111 12643
27 10336 11586
21046 32728 34538
22215 24195 34026
19975 26938 29374
16473 26777 34212
20 29260 32784
35 31645 32837
26132 34410 34495
12446 20649 26851
6796 10992 31061
0 46 8420
10 636 22885
7183 16342 18305
1 5604 28258
6071 18675 34489
16786 25023 33323
3573 5081 10925
5067 31761 34415
3735 33534 34522
85 32829 34518
6555 23368 34559
22083 29335 29390
6738 21110 34316
120 4192 11123
3313 4144 20824
27783 28550 31034
6597 8164 34427
```

# FIG. 35

```
18009 23474 32460
94 6342 12656
17 31962 34535
15091 24955 28545
15 3213 28298
26562 30236 34537
16832 20334 24628
4841 20669 26509
18055 23700 34534
23576 31496 34492
10699 13826 34440
```

# FIG. 36

N=64800, rate=9/15

113 1557 3316 5680 6241 10407 13404 13947 14040 14353 15522 15698 16079 17363 19374 19543 20530 22833 24339

271 1361 6236 7006 7307 7333 12768 15441 15568 17923 18341 20321 21502 22023 2 3938 25351 25590 25876 25910

73 605 872 4008 6279 7653 10346 10799 12482 12935 13604 15909 16526 19782 2050 6 22804 23629 24859 25600

1445 1690 4304 4851 8919 9176 9252 13783 16076 16675 17274 18806 18882 20819 2 1958 22451 23869 23999 24177

1290 2337 5661 6371 8996 10102 10941 11360 12242 14918 16808 20571 23374 24046 25045 25060 25662 25783 25913

28 42 1926 3421 3503 8558 9453 10168 15820 17473 19571 19685 22790 23336 23367 23890 24061 25657 25680

0 1709 4041 4932 5968 7123 8430 9564 10596 11026 14761 19484 20762 20858 23803 24016 24795 25853 25863

29 1625 6500 6609 16831 18517 18568 18738 19387 20159 20544 21603 21941 24137 24269 24416 24803 25154 25395

55 66 871 3700 11426 13221 15001 16367 17601 18380 22796 23488 23938 25476 256 35 25678 25807 25857 25872

1 19 5958 8548 8860 11489 16845 18450 18469 19496 20190 23173 25262 25566 2566 8 25679 25858 25888 25915

7520 7690 8855 9183 14654 16695 17121 17854 18083 18428 19633 20470 20736 2172 0 22335 23273 25083 25293 25403

48 58 410 1299 3786 10668 18523 18963 20864 22106 22308 23033 23107 23128 2399 0 24286 24409 24595 25802

12 51 3894 6539 8276 10885 11644 12777 13427 14039 15954 17078 19053 20537 228 63 24521 25087 25463 25838

3509 8748 9581 11509 15884 16230 17583 19264 20900 21001 21310 22547 22756 229 59 24768 24814 25594 25626 25880

21 29 69 1448 2386 4601 6626 6667 10242 13141 13852 14137 18640 19951 22449 23 454 24431 25512 25814

18 53 7890 9934 10063 16728 19040 19809 20825 21522 21800 23582 24556 25031 25 547 25562 25733 25789 25906

4096 4582 5766 5894 6517 10027 12182 13247 15207 17041 18958 20133 20503 22228 24332 24613 25689 25855 25883

0 25 819 5539 7076 7536 7695 9532 13668 15051 17683 19665 20253 21996 24136 24 890 25758 25784 25807

34 40 44 4215 6076 7427 7965 8777 11017 15593 19542 22202 22973 23397 23423 24 418 24873 25107 25644

1595 6216 22850 25439
1562 15172 19517 22362
7508 12879 24324 24496
6298 15819 16757 18721
11173 15175 19966 21195
59 13505 16941 23793
2267 4830 12023 20587
8827 9278 13072 16664
14419 17463 23398 25348
6112 16534 20423 22698
493 8914 21103 24799

# FIG. 37

```
6896 12761 13206 25873
2 1380 12322 21701
11600 21306 25753 25790
8421 13076 14271 15401
9630 14112 19017 20955
212 13932 21781 25824
5961 9110 16654 19636
58 5434 9936 12770
6575 11433 19798
2731 7338 20926
14253 18463 25404
21791 24805 25869
2 11646 15850
6075 8586 23819
18435 22093 24852
2103 2368 11704
10925 17402 18232
9062 25061 25674
18497 20853 23404
18606 19364 19551
7 1022 25543
6744 15481 25868
9081 17305 25164
8 23701 25883
9680 19955 22848
56 4564 19121
5595 15086 25892
3174 17127 23183
19397 19817 20275
12561 24571 25825
7111 9889 25865
19104 20189 21851
549 9686 25548
6586 20325 25906
3224 20710 21637
641 15215 25754
13484 23729 25818
2043 7493 24246
16860 25230 25768
22047 24200 24902
9391 18040 19499
7855 24336 25069
23834 25570 25852
1977 8800 25756
6671 21772 25859
3279 6710 24444
24099 25117 25820
5553 12306 25915
48 11107 23907
10832 11974 25773
```

# FIG. 38

```
2223 17905 25484
16782 17135 20446
475 2861 3457
16218 22449 24362
11716 22200 25897
8315 15009 22633
13 20480 25852
12352 18658 25687
3681 14794 23703
30 24531 25846
4103 22077 24107
23837 25622 25812
3627 13387 25839
908 5367 19388
0 6894 25795
20322 23546 25181
8178 25260 25437
2449 13244 22565
31 18928 22741
1312 5134 14838
6085 13937 24220
66 14633 25670
47 22512 25472
8867 24704 25279
6742 21623 22745
147 9948 24178
8522 24261 24307
19202 22406 24609
```

# FIG. 39

N=64800, rate=11/15

```
696 989 1238 3091 3116 3738 4269 6406 7033 8048 9157 10254 12033 16456 16912
444 1488 6541 8626 10735 12447 13111 13706 14135 15195 15947 16453 16916 17137
17268
401 460 992 1145 1576 1678 2238 2320 4280 6770 10027 12486 15363 16714 17157
1161 3108 3727 4508 5092 5348 5582 7727 11793 12515 12917 13362 14247 16717 17
205
542 1190 6883 7911 8349 8835 10489 11631 14195 15009 15454 15482 16632 17040 1
7063
17 487 776 880 5077 6172 9771 11446 12798 16016 16109 16171 17087 17132 17226
1337 3275 3462 4229 9246 10180 10845 10866 12250 13633 14482 16024 16812 17186
17241
15 980 2305 3674 5971 8224 11499 11752 11770 12897 14082 14836 15311 16391 172
09
0 3926 5869 8696 9351 9391 11371 14052 14172 14636 14974 16619 16961 17033 172
37
3033 5317 6501 8579 10698 12168 12966 14019 15392 15806 15991 16493 16690 1706
2 17090
981 1205 4400 6410 11003 13319 13405 14695 15846 16297 16492 16563 16616 16862
16953
1725 4276 8869 9588 14062 14486 15474 15548 16300 16432 17042 17050 17060 1717
5 17273
1807 5921 9960 10011 14305 14490 14872 15852 16054 16061 16306 16799 16833 171
36 17262
2826 4752 6017 6540 7016 8201 14245 14419 14716 15983 16569 16652 17171 17179
17247
1662 2516 3345 5229 8086 9686 11456 12210 14595 15808 16011 16421 16825 17112
17195
2890 4821 5987 7226 8823 9869 12468 14694 15352 15805 16075 16462 17102 17251
17263
3751 3890 4382 5720 10281 10411 11350 12721 13121 14127 14980 15202 15335 1673
5 17123
26 30 2805 5457 6630 7188 7477 7556 11065 16608 16859 16909 16943 17030 17103
40 4524 5043 5566 9645 10204 10282 11696 13080 14837 15607 16274 17034 17225 1
7266
904 3157 6284 7151 7984 11712 12887 13767 15547 16099 16753 16829 17044 17250
17259
7 311 4876 8334 9249 11267 14072 14559 15003 15235 15686 16331 17177 17238 172
53
4410 8066 8596 9631 10369 11249 12610 15769 16791 16960 17018 17037 17062 1716
5 17204
24 8261 9691 10138 11607 12782 12786 13424 13933 15262 15795 16476 17084 17193
17220
88 11622 14705 15890
304 2026 2638 6018
1163 4268 11620 17232
9701 11785 14463 17260
4118 10952 12224 17006
3647 10823 11521 12060
1717 3753 9199 11642
```

## FIG. 40

```
2187 14280 17220
14787 16903 17061
381 3534 4294
3149 6947 8323
12562 16724 16881
7289 9997 15306
5615 13152 17260
5666 16926 17027
4190 7798 16831
4778 10629 17180
10001 13884 15453
6 2237 8203
7831 15144 15160
9186 17204 17243
9435 17168 17237
42 5701 17159
7812 14259 15715
39 4513 6658
38 9368 11273
1119 4785 17182
5620 16521 16729
16 6685 17242
210 3452 12383
466 14462 16250
10548 12633 13962
1452 6005 16453
22 4120 13684
5195 11563 16522
5518 16705 17201
12233 14552 15471
6067 13440 17248
8660 8967 17061
8673 12176 15051
5959 15767 16541
3244 12109 12414
31 15913 16323
3270 15686 16653
24 7346 14675
12 1531 8740
6228 7565 16667
16936 17122 17162
4868 8451 13183
3714 4451 16919
11313 13801 17132
17070 17191 17242
1911 11201 17186
14 17190 17254
11760 16008 16832
14543 17033 17278
16129 16765 17155
```

# FIG. 41

```
6891 15561 17007
12741 14744 17116
8992 16661 17277
1861 11130 16742
4822 13331 16192
13281 14027 14989
38 14887 17141
10698 13452 15674
4 2539 16877
857 17170 17249
11449 11906 12867
285 14118 16831
15191 17214 17242
39 728 16915
2469 12969 15579
16644 17151 17164
2592 8280 10448
9236 12431 17173
9064 16892 17233
4526 16146 17038
31 2116 16083
15837 16951 17031
5362 8382 16618
6137 13199 17221
2841 15068 17068
24 3620 17003
9880 15718 16764
1784 10240 17209
2731 10293 10846
3121 8723 16598
8563 15662 17088
13 1167 14676
29 13850 15963
3654 7553 8114
23 4362 14865
4434 14741 16688
8362 13901 17244
13687 16736 17232
46 4229 13394
13169 16383 16972
16031 16681 16952
3384 9894 12580
9841 14414 16165
5013 17099 17115
2130 8941 17266
6907 15428 17241
16 1860 17235
2151 16014 16643
14954 15958 17222
3969 8419 15116
```

# FIG. 42

31  15593  16984
11514  16605  17255

# FIG. 43

N=64800, rate=13/15

142 2307 2598 2650 4028 4434 5781 5881 6016 6323 6681 6698 8125
2932 4928 5248 5256 5983 6773 6828 7789 8426 8494 8534 8539 8583
899 3295 3833 5399 6820 7400 7753 7890 8109 8451 8529 8564 8602
21 3060 4720 5429 5636 5927 6966 8110 8170 8247 8355 8365 8616
20 1745 2838 3799 4380 4418 4646 5059 7343 8161 8302 8456 8631
9 6274 6725 6792 7195 7333 8027 8186 8209 8273 8442 8548 8632
494 1365 2405 3799 5188 5291 7644 7926 8139 8458 8504 8594 8625
192 574 1179 4387 4695 5089 5831 7673 7789 8298 8301 8612 8632
11 20 1406 6111 6176 6256 6708 6834 7828 8232 8457 8495 8602
6 2654 3554 4483 4966 5866 6795 8069 8249 8301 8497 8509 8623
21 1144 2355 3124 6773 6805 6887 7742 7994 8358 8374 8580 8611
335 4473 4883 5528 6096 7543 7586 7921 8197 8319 8394 8489 8636
2919 4331 4419 4735 6366 6393 6844 7193 8165 8205 8544 8586 8617
12 19 742 930 3009 4330 6213 6224 7292 7430 7792 7922 8137
710 1439 1588 2434 3516 5239 6248 6827 8230 8448 8515 8581 8619
200 1075 1868 5581 7349 7642 7698 8037 8201 8210 8320 8391 8526
3 2501 4252 5256 5292 5567 6136 6321 6430 6486 7571 8521 8636
3062 4599 5885 6529 6616 7314 7319 7567 8024 8153 8302 8372 8598
105 381 1574 4351 5452 5603 5943 7467 7788 7933 8362 8513 8587
787 1857 3386 3659 6550 7131 7965 8015 8040 8312 8484 8525 8537
15 1118 4226 5197 5575 5761 6762 7038 8260 8338 8444 8512 8568
36 5216 5368 5616 6029 6591 8038 8067 8299 8351 8565 8578 8585
1 23 4300 4530 5426 5532 5817 6967 7124 7979 8022 8270 8437
629 2133 4828 5475 5875 5890 7194 8042 8345 8385 8518 8598 8612
11 1065 3782 4237 4993 7104 7863 7904 8104 8228 8321 8383 8565
2131 2274 3168 3215 3220 5597 6347 7812 8238 8354 8527 8557 8614
5600 6591 7491 7696
1766 8281 8626
1725 2280 5120
1650 3445 7652
4312 6911 8626
15 1013 5892
2263 2546 2979
1545 5873 7406
67 726 3697
2860 6443 8542
17 911 2820
1561 4580 6052
79 5269 7134
22 2410 2424
3501 5642 8627
808 6950 8571
4099 6389 7482
4023 5000 7833
5476 5765 7917
1008 3194 7207
20 495 5411
1703 8388 8635
6 4395 4921

# FIG. 44

```
200 2053 8206
1089 5126 5562
10 4193 7720
1967 2151 4608
22 738 3513
3385 5066 8152
440 1118 8537
3429 6058 7716
5213 7519 8382
5564 8365 8620
43 3219 8603
4 5409 5815
5 6376 7654
4091 5724 5953
5348 6754 8613
1634 6398 6632
72 2058 8605
3497 5811 7579
3846 6743 8559
15 5933 8629
2133 5859 7068
4151 4617 8566
2960 8270 8410
2059 3617 8210
544 1441 6895
4043 7482 8592
294 2180 8524
3058 8227 8373
364 5756 8617
5383 8555 8619
1704 2480 4181
7338 7929 7990
2615 3905 7981
4298 4548 8296
8262 8319 8630
892 1893 8028
5694 7237 8595
1487 5012 5810
4335 8593 8624
3509 4531 5273
10 22 830
4161 5208 6280
275 7063 8634
4 2725 3113
2279 7403 8174
1637 3328 3930
2810 4939 5624
3 1234 7687
2799 7740 8616
22 7701 8636
```

# FIG. 45

```
4302 7857 7993
7477 7794 8592
9 6111 8591
5 8606 8628
347 3497 4033
1747 2613 8636
1827 5600 7042
580 1822 6842
232 7134 7783
4629 5000 7231
951 2806 4947
571 3474 8577
2437 2496 7945
23 5873 8162
12 1168 7686
8315 8540 8596
1766 2506 4733
929 1516 3338
21 1216 6555
782 1452 8617
8 6083 6087
667 3240 4583
4030 4661 5790
559 7122 8553
3202 4388 4909
2533 3673 8594
1991 3954 6206
6835 7900 7980
189 5722 8573
2680 4928 4998
243 2579 7735
4281 8132 8566
7656 7671 8609
1116 2291 4166
21 388 8021
6 1123 8369
311 4918 8511
0 3248 6290
13 6762 7172
4209 5632 7563
49 127 8074
581 1735 4075
0 2235 5470
2178 5820 6179
16 3575 6054
1095 4564 6458
9 1581 5953
2537 6469 8552
14 3874 4844
0 3269 3551
```

# FIG. 46

```
2114 7372 7926
1875 2388 4057
3232 4042 6663
9 401 583
13 4100 6584
2299 4190 4410
21 3670 4979
```

# FIG. 47

N=64800, rate=6/15

```
   1606 3402 4961 6751 7132 11516 12300 12482 12592 13342 13764 14123 21576 23946
 24533 25376 25667 26836 31799 34173 35462 36153 36740 37085 37152 37468 37658
   4621 5007 6910 8732 9757 11508 13099 15513 16335 18052 19512 21319 23663 25628
 27208 31333 32219 33003 33239 33447 36200 36473 36938 37201 37283 37495 38642
   16 1094 2020 3080 4194 5098 5631 6877 7889 8237 9804 10067 11017 11366 13136 1
 3354 15379 18934 20199 24522 26172 28666 30386 32714 36390 37015 37162
   700 897 1708 6017 6490 7372 7825 9546 10398 16605 18561 18745 21625 22137 2369
 3 24340 24966 25015 26995 28586 28895 29687 33938 34520 34858 37056 38297
   159 2010 2573 3617 4452 4958 5556 5832 6481 8227 9924 10836 14954 15594 16623
 18065 19249 22394 22677 23408 23731 24076 24776 27007 28222 30343 38371
   3118 3545 4768 4992 5227 6732 8170 9397 10522 11508 15536 20218 21921 28599 29
 445 29758 29968 31014 32027 33685 34378 35867 36323 36728 36870 38335 38623
   1264 4254 6936 9165 9486 9950 10861 11653 13697 13961 15164 15665 18444 19470
 20313 21189 24371 26431 26999 28086 28251 29261 31981 34015 35850 36129 37186
   111 1307 1628 2041 2524 5358 7988 8191 10322 11905 12919 14127 15515 15711 170
 61 19024 21195 22902 23727 24401 24608 25111 25228 27338 35398 37794 38196
   961 3035 7174 7948 13355 13607 14971 18189 18339 18665 18875 19142 20615 21136
 21309 21758 23366 24745 25849 25982 27583 30006 31118 32106 36469 36583 37920
   2990 3549 4273 4808 5707 6021 6509 7456 8240 10044 12262 12660 13085 14750 156
 80 16049 21587 23997 25803 28343 28693 34393 34860 35490 36021 37737 38296
   955 4323 5145 6885 8123 9730 11840 12216 19194 20313 23056 24248 24830 25268 2
 6617 26801 28557 29753 30745 31450 31973 32839 33025 33296 35710 37366 37509
   264 605 4181 4483 5156 7238 8863 10939 11251 12964 16254 17511 20017 22395 228
 18 23261 23422 24064 26329 27723 28186 30434 31956 33971 34372 36764 38123
   520 2562 2794 3528 3860 4402 5676 6963 8655 9018 9783 11933 16336 17193 17320
 19035 20606 23579 23769 24123 24966 27866 32457 34011 34499 36620 37526
   10106 10637 10906 34242
   1856 15100 19378 21848
   943 11191 27806 29411
   4575 6359 13629 19383
   4476 4953 18782 24313
   5441 6381 21840 35943
   9638 9763 12546 30120
   9587 10626 11047 25700
   4088 15298 28768 35047
   2332 6363 8782 28863
   4625 4933 28298 30289
   3541 4918 18257 31746
   1221 25233 26757 34892
   8150 16677 27934 30021
   8500 25016 33043 38070
   7374 10207 16189 35811
   611 18480 20064 38261
   25416 27352 36089 38469
   1667 17614 25839 32776
   4118 12481 21912 37945
   5573 13222 23619 31271
   18271 26251 27182 30587
   14690 26430 26799 34355
```

PROVIDED BY Samsung

# FIG. 48

```
13688 16040 20716 34558
2740 14957 23436 32540
3491 14365 14681 36858
4796 6238 25203 27854
1731 12816 17344 26025
19182 21662 23742 27872
6502 13641 17509 34713
12246 12372 16746 27452
1589 21528 30621 34003
12328 20515 30651 31432
3415 22656 23427 36395
632 5209 25958 31085
619 3690 19648 37778
9528 13581 26965 36447
2147 26249 26968 28776
15698 18209 30683
1132 19888 34111
4608 25513 38874
475 1729 34100
7348 32277 38587
182 16473 33082
3865 9678 21265
4447 20151 27618
6335 14371 38711
704 9695 28858
4856 9757 30546
1993 19361 30732
756 28000 29138
3821 24076 31813
4611 12326 32291
7628 21515 34995
1246 13294 30068
6466 33233 35865
14484 23274 38150
21269 36411 37450
23129 26195 37653
```

PROVIDED BY Samsung

# FIG. 49

N=64800, rate=8/15

2768 3039 4059 5856 6245 7013 8157 9341 9802 10470 11521 12083 16610 18361 2032 1 24601 27420 28206 29788

2739 8244 8891 9157 12624 12973 15534 16622 16919 18402 18780 19854 20220 2054 3 22306 25540 27478 27678 28053

1727 2268 6246 7815 9010 9556 10134 10472 11389 14599 15719 16204 17342 17666 18850 22058 25579 25860 29207

28 1346 3721 5565 7019 9240 12355 13109 14800 16040 16839 17369 17631 19357 19 473 19891 20381 23911 29683

869 2450 4386 5316 6160 7107 10362 11132 11271 13149 16397 16532 17113 19894 2 2043 22784 27383 28615 28804

508 4292 5831 8559 10044 10412 11283 14810 15888 17243 17538 19903 20528 22090 22652 27235 27384 28208 28485

389 2248 5840 6043 7000 9054 11075 11760 12217 12565 13587 15403 19422 19528 2 1493 25142 27777 28566 28702

1015 2002 5764 6777 9346 9629 11039 11153 12690 13068 13990 16841 17702 20021 24106 26300 29332 30081 30196

1480 3084 3467 4401 4798 5187 7851 11368 12323 14325 14546 16360 17158 18010 2 1333 25612 26556 26906 27005

6925 8876 12392 14529 15253 15437 19226 19950 20321 23021 23651 24393 24653 26 668 27205 28269 28529 29041 29292

2547 3404 3538 4666 5126 5468 7695 8799 14732 15072 15881 17410 18971 19609 19 717 22150 24941 27908 29018

888 1581 2311 5511 7218 9107 10454 12252 13662 15714 15894 17025 18671 24304 2 5316 25556 28489 28977 29212

1047 1494 1718 4645 5030 6811 7868 8146 10611 15767 17682 18391 22614 23021 23 763 25478 26491 29088 29757

59 1781 1900 3814 4121 8044 8906 9175 11156 14841 15789 16033 16755 17292 1855 0 19310 22505 29567 29850

1952 3057 4399 9476 10171 10769 11335 11569 15002 19501 20621 22642 23452 2436 0 25109 25290 25828 28505 29122

2895 3070 3437 4764 4905 6670 9244 11845 13352 13573 13975 14600 15871 17996 1 9672 20079 20579 25327 27958

612 1528 2004 4244 4599 4926 5843 7684 10122 10443 12267 14368 18413 19058 229 85 24257 26202 26596 27899

1361 2195 4146 6708 7158 7538 9138 9998 14862 15359 16076 18925 21401 21573 22 503 24146 24247 27778 29312

5229 6235 7134 7655 9139 13527 15408 16058 16705 18320 19909 20901 22238 22437 23654 25131 27550 28247 29903

697 2035 4887 5275 6909 9166 11805 15338 16381 18403 20425 20688 21547 24590 2 5171 26726 28848 29224 29412

5379 17329 22659 23062

11814 14759 22329 22936

2423 2811 10296 12727

8460 15260 16769 17290

14191 14608 29536 30187

7103 10069 20111 22850

4285 15413 26448 29069

548 2137 9189 10928

4581 7077 23382 23949

PROVIDED BY Samsung

## FIG. 50

```
3942 17248 19486 27922
8668 10230 16922 26678
6158 9980 13788 28198
12422 16076 24206 29887
8778 10649 18747 22111
21029 22677 27150 28980
7918 15423 27672 27803
5927 18086 23525
3397 15058 30224
24016 25880 26268
1096 4775 7912
3259 17301 20802
129 8396 15132
17825 28119 28676
2343 8382 28840
3907 18374 20939
1132 1290 8786
1481 4710 28846
2185 3705 26834
5496 15681 21854
12697 13407 22178
12788 21227 22894
629 2854 6232
2289 18227 27458
7593 21935 23001
3836 7081 12282
7925 18440 23135
497 6342 9717
11199 22046 30067
12572 28045 28990
1240 2023 10933
19566 20629 25186
6442 13303 28813
4765 10572 16180
552 19301 24286
6782 18480 21383
11267 12288 15758
771 5652 15531
16131 20047 25649
13227 23035 24450
4839 13467 27488
2852 4677 22993
2504 28116 29524
12518 17374 24267
1222 11859 27922
9660 17286 18261
232 11296 29978
9750 11165 16295
4894 9505 23622
10861 11980 14110
```

# FIG. 51

```
2128 15883 22836
6274 17243 21989
10866 13202 22517
11159 16111 21608
3719 18787 22100
1756 2020 23901
20913 29473 30103
2729 15091 26976
4410 8217 12963
5395 24564 28235
3859 17909 23051
5733 26005 29797
1935 3492 29773
11903 21380 29914
6091 10469 29997
2895 8930 15594
1827 10028 20070
```

PROVIDED BY Samsung

## FIG. 52

N=64800, rate=12/15

584 1472 1621 1867 3338 3568 3723 4185 5126 5889 7737 8632 8940 9725
221 445 590 3779 3835 6939 7743 8280 8448 8491 9367 10042 11242 12917
4662 4837 4900 5029 6449 6687 6751 8684 9936 11681 11811 11886 12089 12909
2418 3018 3647 4210 4473 7447 7502 9490 10067 11092 11139 11256 12201 12383
2591 2947 3349 3406 4417 4519 5176 6672 8498 8863 9201 11294 11376 12184
27 101 197 290 871 1727 3911 5411 6676 8701 9350 10310 10798 12439
1765 1897 2923 3584 3901 4048 6963 7054 7132 9165 10184 10824 11278 12669
2183 3740 4808 5217 5660 6375 6787 8219 8466 9037 10353 10583 11118 12762
73 1594 2146 2715 3501 3572 3639 3725 6959 7187 8406 10120 10507 10691
240 732 1215 2185 2788 2830 3499 3881 4197 4991 6425 7061 9756 10491
831 1568 1828 3424 4319 4516 4639 6018 9702 10203 10417 11240 11518 12458
2024 2970 3048 3638 3676 4152 5284 5779 5926 9426 9945 10873 11787 11837
1049 1218 1651 2328 3493 4363 5750 6483 7613 8782 9738 9803 11744 11937
1193 2060 2289 2964 3478 4592 4756 6709 7162 8231 8326 11140 11908 12243
978 2120 2439 3338 3850 4589 6567 8745 9656 9708 10161 10542 10711 12639
2403 2938 3117 3247 3711 5593 5844 5932 7801 10152 10226 11498 12162 12941
1781 2229 2276 2533 3582 3951 5279 5774 7930 9824 10920 11038 12340 12440
289 384 1980 2230 3464 3873 5958 8656 8942 9006 10175 11425 11745 12530
155 354 1090 1330 2002 2236 3559 3705 4922 5958 6576 8564 9972 12760
303 876 2059 2142 5244 5330 6644 7576 8614 9598 10410 10718 11033 12957
3449 3617 4408 4602 4727 6182 8835 8928 9372 9644 10237 10747 11655 12747
811 2565 2820 8677 8974 9632 11069 11548 11839 12107 12411 12695 12812 12890
972 4123 4943 6385 6449 7339 7477 8379 9177 9359 10074 11709 12552 12831
842 973 1541 2262 2905 5276 6758 7099 7894 8128 8325 8663 8875 10050
474 791 968 3902 4924 4965 5085 5908 6109 6329 7931 9038 9401 10568
1397 4461 4658 5911 6037 7127 7318 8678 8924 9000 9473 9602 10446 12692
1334 7571 12881
1393 1447 7972
633 1257 10597
4843 5102 11056
3294 8015 10513
1108 10374 10546
5353 7824 10111
3398 7674 8569
7719 9478 10503
2997 9418 9581
5777 6519 11229
1966 5214 9899
6 4088 5827
836 9248 9612
483 7229 7548
7865 8289 9804
2915 11098 11900
6180 7096 9481
1431 6786 8924
748 6757 8625
3312 4475 7204
1852 8958 11020
1915 2903 4006

# FIG. 53

```
6776 10886 12531
2594 9998 12742
159 2002 12079
853 3281 3762
5201 5798 6413
3882 6062 12047
4133 6775 9657
228 6874 11183
7433 10728 10864
7735 8073 12734
2844 4621 11779
3909 7103 12804
6002 9704 11060
5864 6856 7681
3652 5869 7605
2546 2657 4461
2423 4203 9111
244 1855 4691
1106 2178 6371
391 1617 10126
250 9259 10603
3435 4614 6924
1742 8045 9529
7667 8875 11451
4023 6108 6911
8621 10184 11650
6726 10861 12348
3228 6302 7388
1 1137 5358
381 2424 8537
3256 7508 10044
1980 2219 4569
2468 5699 10319
2803 3314 12808
8578 9642 11533
829 4585 7923
59 329 5575
1067 5709 6867
1175 4744 12219
109 2518 6756
2105 10626 11153
5192 10696 10749
6260 7641 8233
2998 3094 11214
3398 6466 11494
6574 10448 12160
2734 10755 12780
1028 7958 10825
8545 8602 10793
392 3398 11417
```

## FIG. 54

```
6639 9291 12571
1067 7919 8934
1064 2848 12753
6076 8656 12690
5504 6193 10171
1951 7156 7356
4389 4780 7889
526 4804 9141
1238 3648 10464
2587 5624 12557
5560 5903 11963
1134 2570 3297
10041 11583 12157
1263 9585 12912
3744 7898 10646
45 9074 10315
1051 6188 10038
2242 8394 12712
3598 9025 12651
2295 3540 5610
1914 4378 12423
1766 3635 12759
5177 9586 11143
943 3590 11649
4864 6905 10454
5852 6042 10421
6095 8285 12349
2070 7171 8563
718 12234 12716
512 10667 11353
3629 6485 7040
2880 8865 11466
4490 10220 11796
5440 8819 9103
5262 7543 12411
516 7779 10940
2515 5843 9202
4684 5994 10586
573 2270 3324
7870 8317 10322
6856 7638 12909
1583 7669 10781
8141 9085 12555
3903 5485 9992
4467 11998 12904
```

## FIG. 55

```
N=16200, rate=6/15
    27 430 519 828 1897 1943 2513 2600 2640 3310 3415 4266 5044 5100 5328 5483 592
8 6204 6392 6416 6602 7019 7415 7623 8112 8485 8724 8994 9445 9667
    27 174 188 631 1172 1427 1779 2217 2270 2601 2813 3196 3582 3895 3908 3948 446
3 4955 5120 5809 5988 6478 6604 7096 7673 7735 7795 8925 9613 9670
    27 370 617 852 910 1030 1326 1521 1606 2118 2248 2909 3214 3413 3623 3742 3752
4317 4694 5300 5687 6039 6100 6232 6491 6621 6860 7304 8542 8634
    990 1753 7635 8540
    933 1415 5666 8745
    27 6567 8707 9216
    2341 8692 9580 9615
    260 1092 5839 6080
    352 3750 4847 7726
    4610 6580 9506 9597
    2512 2974 4814 9348
    1461 4021 5060 7009
    1796 2883 5553 8306
    1249 5422 7057
    3965 6968 9422
    1498 2931 5092
    27 1090 6215
    26 4232 6354                                    PROVIDED BY LGE
```

## FIG. 56

```
N=16200, rate=7/15
    553 742 901 1327 1544 2179 2519 3131 3280 3603 3789 3792 4253 5340 5934 5962 6
004 6698 7793 8001 8058 8126 8276 8559
    503 590 598 1185 1266 1336 1806 2473 3021 3356 3490 3680 3936 4501 4659 5891 6
132 6340 6602 7447 8007 8045 8059 8249
    795 831 947 1330 1502 2041 2328 2513 2814 2829 4048 4802 6044 6109 6461 6777 6
800 7099 7126 8095 8428 8519 8556 8610
    601 787 899 1757 2259 2518 2783 2816 2823 2949 3396 4330 4494 4684 4700 4837 4
881 4975 5130 5464 6554 6912 7094 8297
    4229 5628 7917 7992
    1506 3374 4174 5547
    4275 5650 8208 8533
    1504 1747 3433 6345
    3659 6955 7575 7852
    607 3002 4913 6453
    3533 6860 7895 8048
    4094 6366 8314
    2206 4513 5411
    32 3882 5149
    389 3121 4626
    1308 4419 6520
    2092 2373 6849
    1815 3679 7152
    3582 3979 6948
    1049 2135 3754
    2276 4442 6591                                  PROVIDED BY LGE
```

# FIG. 57

```
N=16200, rate=9/15
212 255 540 967 1033 1517 1538 3124 3408 3800 4373 4864 4905 5163 5177 6186
275 660 1351 2211 2876 3063 3433 4088 4273 4544 4618 4632 5548 6101 6111 6136
279 335 494 865 1662 1681 3414 3775 4252 4595 5272 5471 5796 5907 5986 6008
345 352 3094 3188 4297 4338 4490 4865 5303 6477
222 681 1218 3169 3850 4878 4954 5666 6001 6237
172 512 1536 1559 2179 2227 3334 4049 6464
716 934 1694 2890 3276 3608 4332 4468 5945
1133 1593 1825 2571 3017 4251 5221 5639 5845
1076 1222 6465
159 5064 6078
374 4073 5357
2833 5526 5845
1594 3639 5419
1028 1392 4239
115 622 2175
300 1748 6245
2724 3276 5349
1433 6117 6448
485 663 4955
711 1132 4315
177 3266 4339
1171 4841 4982
33 1584 3692
2820 3485 4249
1716 2428 3125
250 2275 6338
108 1719 4961
```

# FIG. 58

```
N=16200, rate=11/15
49 719 784 794 968 2382 2685 2873 2974 2995 3540 4179
272 281 374 1279 2034 2067 2112 3429 3613 3815 3838 4216
206 714 820 1800 1925 2147 2168 2769 2806 3253 3415 4311
62 159 166 605 1496 1711 2652 3016 3347 3517 3654 4113
363 733 1118 2062 2613 2736 3143 3427 3664 4100 4157 4314
57 142 436 983 1364 2105 2113 3074 3639 3835 4164 4242
870 921 950 1212 1861 2128 2707 2993 3730 3968 3983 4227
185 2684 3263
2035 2123 2913
883 2221 3521
1344 1773 4132
438 3178 3650
543 756 1639
1057 2337 2898
171 3298 3929
1626 2960 3503
484 3050 3323
2283 2336 4189
2732 4132 4318
225 2335 3497
600 2246 2658
1240 2790 3020
301 1097 3539
1222 1267 2594
1364 2004 3603
1142 1185 2147
564 1505 2086
697 991 2908
1467 2073 3462
2574 2818 3637
748 2577 2772
1151 1419 4129
164 1238 3401
```

PROVIDED BY LGE

# FIG. 59

```
N=16200,  rate=13/15
71 334 645 779 786 1124 1131 1267 1379 1554 1766 1798 1939
6 183 364 506 512 922 972 981 1039 1121 1537 1840 2111
6 71 153 204 253 268 781 799 873 1118 1194 1661 2036
6 247 353 581 921 940 1108 1146 1208 1268 1511 1527 1671
6 37 466 548 747 1142 1203 1271 1512 1516 1837 1904 2125
6 171 863 953 1025 1244 1378 1396 1723 1783 1816 1914 2121
1268 1360 1647 1769
6 458 1231 1414
183 535 1244 1277
107 360 498 1456
6 2007 2059 2120
1480 1523 1670 1927
139 573 711 1790
6 1541 1889 2023
6 374 957 1174
287 423 872 1285
6 1809 1918
65 818 1396
590 766 2107
192 814 1843
775 1163 1256
42 735 1415
334 1008 2055
109 596 1785
406 534 1852
684 719 1543
401 465 1040
112 392 621
82 897 1950
887 1962 2125
793 1088 2159
723 919 1139
610 839 1302
218 1080 1816
627 1646 1749
496 1165 1741
916 1055 1662
182 722 945
5 595 1674
```

PROVIDED BY LGE

# FIG. 60

N=64800, rate=10/15

316 1271 3692 9495 12147 12849 14928 16671 16938 17864 19108 20502 21097 21115
2341 2559 2643 2816 2865 5137 5331 7000 7523 8023 10439 10797 13208 15041
5556 6858 7677 10162 10207 11349 12321 12398 14787 15743 15859 15952 19313 20879
349 573 910 2702 3654 6214 9246 9353 10638 11772 14447 14953 16620 19888
204 1390 2887 3835 6230 6533 7443 7876 9299 10291 10896 13960 18287 20086
541 2429 2838 7144 8523 8637 10490 10585 11074 12074 15762 16812 17900 18548
733 1659 3838 5323 5805 7882 9429 10682 13697 16909 18846 19587 19592 20904
1134 2136 4631 4653 4718 5197 10410 11666 14996 15305 16048 17417 18960 20303
734 1001 1283 4959 10016 10176 10973 11578 12051 15550 15915 19022 19430 20121
745 4057 5855 9885 10594 10989 13156 13219 13351 13631 13685 14577 17713 20386
968 1446 2130 2502 3092 3787 5323 8104 8418 9998 11681 13972 17747 17929
3020 3857 5275 5786 6319 8608 11943 14062 17144 17752 18001 18453 19311 21414
709 747 1038 2181 5320 8292 10584 10859 13964 15009 15277 16953 20675 21509
1663 3247 5003 5760 7186 7360 10346 14211 14717 14792 15155 16128 17355 17970
516 578 1914 6147 9419 11148 11434 13289 13325 13332 19106 19257 20962 21556
5009 5632 6531 9430 9886 10621 11765 13969 16178 16413 18110 18249 20616 20759
457 2686 3318 4608 5620 5858 6480 7430 9602 12691 14664 18777 20152 20848
33 2877 5334 6851 7907 8654 10688 15401 16123 17942 17969 18747 18931 20224
87 897 7636 8663 11425 12288 12672 14199 16435 17615 17950 18953 19667 20281
1042 1832 2545 2719 2947 3672 3700 6249 6398 6833 11114 14283 17694 20477
326 488 2662 2880 3009 5357 6587 8882 11604 14374 18781 19051 19057 20508
854 1294 2436 2852 4903 6466 7761 9072 9564 10321 13638 15658 16946 19119
194 899 1711 2408 2786 5391 7108 8079 8716 11453 17303 19484 20989 21389
1631 3121 3994 5005 7810 8850 10315 10589 13407 17162 18624 18758 19311 20301
736 2424 4792 5600 6370 10061 16053 16775 18600
1254 8163 8876 9157 12141 14587 16545 17175 18191
388 6641 8974 10607 10716 14477 16825 17191 18400
5578 6082 6824 7360 7745 8655 11402 11665 12428
3603 8729 13463 14698 15210 19112 19550 20727 21052
48 1732 3805 5158 15442 16909 19854 21071 21579
11707 14014 21531
1542 4133 4925
10083 13505 21198
14300 15765 16752
778 1237 11215
1325 3199 14534
2007 14510 20599
1996 5881 16429
5111 15018 15980
4989 10681 12810
3763 10715 16515
2259 10080 15642
9032 11319 21305
3915 15213 20884
11150 15022 20201
1147 6749 19625
12139 12939 18870
3840 4634 10244

# FIG. 61

```
1018 10231 17720
2708 13056 13393
5781 11588 18888
1345 2036 5252
5908 8143 15141
1804 13693 18640
10433 13965 16950
9568 10122 15945
547 6722 14015
321 12844 14095
2632 10513 14936
6369 11995 20321
9920 19136 21529
1990 2726 10183
5763 12118 15467
503 10006 19564
9839 11942 19472
11205 13552 15389
8841 13797 19697
124 6053 18224
6477 14406 21146
1224 8027 16011
3046 4422 17717
739 12308 17760
4014 4130 7835
2266 5652 11981
2711 7970 18317
2196 15229 17217
8636 13302 16764
5612 15010 16657
615 1249 4639
3821 12073 18506
1066 16522 21536
11307 18363 19740
3240 8560 10391
3124 11424 20779
1604 8861 17394
2083 7400 8093
3218 7454 9155
9855 15998 20533
316 2850 20652
5583 9768 10333
7147 7713 18339
12607 17428 21418
14216 16954 18164
8477 15970 18488
1632 8032 9751
4573 9080 13507
11747 12441 13876
1183 15605 16675
```

# FIG. 62

```
4408 10264 17109
5495 7882 12150
1010 3763 5065
9828 18054 21599
6342 7353 15358
6362 9462 19999
7184 13693 17622
4343 4654 10995
7099 8466 18520
11505 14395 15138
6779 16691 18726
7146 12644 20196
5865 16728 19634
4657 8714 21246
4580 5279 18750
3767 6620 18905
9209 13093 17575
12486 15875 19791
8046 14636 17491
2120 4643 13206
6186 9675 12601
784 5770 21585
```

PROVIDED BY LGE

# FIG. 63

N=64800, rate=9/15

218 592 1116 2229 2989 3217 3922 4338 5063 7196 8516 9168 10774 12013 12355 12485 13238 13315 13365 15102 16325 16379 17222 17866 19091 21096 21677 22183 22884 23023 23059 23295 23694 24888 25755

142 556 754 1359 1813 2861 3733 4015 4103 4137 4590 5431 7423 8429 9924 10043 11764 12672 13476 14250 15182 15575 15835 16093 16893 17014 17993 18328 19778 20782 22151 22347 23841 25434 25647

8 1287 1813 2927 4094 4691 5599 7087 7503 8777 9100 11299 11310 12283 12638 12774 12983 13161 13750 13899 14093 14581 15066 18310 19537 21141 21530 21920 22726 23080 23250 23588 23749 25129 25493

170 2231 2273 4646 5468 5912 7624 7804 8019 8715 9157 10173 10978 13144 14209 14508 15118 15510 16699 17285 18189 18842 19164 19242 19568 20657 20745 22599 22754 24105 24136 24644 25091 25259 25476

611 3593 5689 5980 6779 7830 8200 8420 8701 10161 10601 10863 11251 11540 12306 12364 12396 13247 13256 13454 13683 13810 13912 14254 14665 15530 16749 18022 21173 21359 21564 21860 23562 23936 25873

225 490 1197 1357 2322 3436 3759 5720 5886 10068 10994 12476 13186 13403 13774 14376 14505 14946 15555 16515 17068 17581 18317 19533 19993 20376 20597 21656 23103 23230 23860 24883 25100 25576 25835

910 1479 3144 3600 4255 5851 6277 6587 7337 8562 9592 11428 11534 12127 12452 13565 14336 15311 15470 16915 17520 18194 18324 18385 18575 19627 20126 20219 21108 21294 22218 22466 22541 23614 24218

120 6693 11582 11756 14656 16088 24473 24811

990 3571 8517 10259 14187 15732 17864 23697

2366 5536 8236 14281 16178 19247 25431 25641

9056 10221 16011 17287 22095 22694 23634 24541

1138 3241 4444 11816 14651 17585 20317 24036

3166 5421 7828 11855 13148 16492 22830 25181

3644 5858 7555 12551 14018 15716 20181 20877

3405 7546 10508 12355 12455 16386 22014 22846

5305 12878 13734 15949 16747 17458 18068 23552

2717 4365 5192 9626 11487 17811 24163 25201

4705 5787 12649 14298 15570 19876 23193 24688

3394 4960 9629 11445 19031 23128 23563 25774

1648 4768 8372 11388 11448 13373 14773 15814

4043 10049 13225 14765 18206 19663 20316 25534

8820 15709 17949 18383 18624 19746 23307 25346

221 10075 12281 13163 16430 18834 20637 21646

264 296 2837 4856 9223 10324 16336 18557

4532 7935 12782 16508 17549 21310 23929 24846

5143 5666 6753 8248 12394 13840 14926 15611

4289 9811 10826 11025 11425 15567 20767 25246

1826 4386 6372 6698 7467 20479 23360 24751

740 1873 3727 8628 11803 21326 24482 25134

315 664 2026 10700 12624 21194 24678 24802

8431 9604 11559 12120 19557 21047 21161 21584

6275 8787 9830 10580 12795 15287 20794 21063

3780 7735 9717 10410 14334 19217 24239 24857

4214 9796 10451 17817 18072 18697 19265 24591

2497 5485 6337 10065 13070 14240 20115 23668

# FIG. 64

```
750 14148 17061 18247 22764 23024 24172 25347
8665 9325 11559 13331 20047 20633 22239 24771
2380 6028 6722 7577 10971 12640 25689 25899
726 2719 3466 4360 4490 4570 14908 21224
9935 11724 17848 20984
3206 5876 21624 22202
2016 6467 18748 21565
8700 14455 25199
3226 4420 10829
14098 15408 17937
974 3658 7162
112 3354 12949
2534 5898 8903
1419 8178 8313
11829 19776 25767
15438 17714 19803
220 2577 9487
158 5317 9608
3503 11020 23289
11919 14584 19928
1594 3696 16179
10671 16931 17471
1753 4357 7056
3522 12686 17448
6249 7005 16719
1635 2568 13330
6630 9681 24490
5839 9707 15176
5793 21197 22913
8105 19194 24006
2614 11400 20796
11519 13935 20122
4911 17744 20743
5136 6333 25790
7467 12085 25881
2460 10009 24753
7494 7741 11636
8801 12817 24194
14311 15139 16691
826 3907 19556
5009 10578 17371
953 6240 6283
7644 13421 18814
11989 12118 24827
10905 19182 21977
9089 20001 23153
2195 8597 23530
11195 15654 25877
5761 12774 20592
14546 19182 22537
```

## FIG. 65

```
6708 16466 21216
5969 14367 21850
4267 10268 16960
7643 15766 25598
7842 17639 23802
10516 11135 13663
483 5940 7305
9003 11614 22948
21555 24593 25102
3680 7927 19104
10255 13278 20938
16574 18589 19391
7647 16916 18999
740 6115 18541
4233 10673 17021
3520 10970 11696
5172 19013 24821
4867 19496 23534
16451 19269 20178
9275 12726 13369
6508 10234 10389
4614 6489 11229
1861 12769 15928
```

PROVIDED BY NERC

## FIG. 66

N=16200, rate=5/15

```
69 244 706 5145 5994 6066 6763 6815 8509
257 541 618 3933 6188 7048 7484 8424 9104
69 500 536 1494 1669 7075 7553 8202 10305
11 189 340 2103 3199 6775 7471 7918 10530
333 400 434 1806 3264 5693 8534 9274 10344
111 129 260 3562 3676 3680 3809 5169 7308 8280
100 303 342 3133 3952 4226 4713 5053 5717 9931
83 87 374 828 2460 4943 6311 8657 9272 9571
114 166 325 2680 4698 7703 7886 8791 9978 10684
281 542 549 1671 3178 3955 7153 7432 9052 10219
202 271 608 3860 4173 4203 5169 6871 8113 9757
16 359 419 3333 4198 4737 6170 7987 9573 10095
235 244 584 4640 5007 5563 6029 6816 7678 9968
123 449 646 2460 3845 4161 6610 7245 7686 8651
136 231 468 835 2622 3292 5158 5294 6584 9926
3085 4683 8191 9027 9922 9928 10550
2462 3185 3976 4091 8089 8772 9342
```

PROVIDED BY CRC/ETRI

## FIG. 67

N=64800, rate=5/15

```
221 1011 1218 4299 7143 8728 11072 15533 17356 33909 36833
360 1210 1375 2313 3493 16822 21373 23588 23656 26267 34098
544 1347 1433 2457 9186 10945 13583 14858 19195 34606 37441
37 596 715 4134 8091 12106 24307 24658 34108 40591 42883
235 398 1204 2075 6742 11670 13512 23231 24784 27915 34752
204 873 890 13550 16570 19774 34012 35249 37655 39885 42890
221 371 514 11984 14972 15690 28827 29069 30531 31018 43121
280 549 1435 1889 3310 10234 11575 15243 20748 30469 36005
223 666 1248 13304 14433 14732 18943 21248 23127 38529 39272
370 819 1065 9461 10319 25294 31958 33542 37458 39681 40039
585 870 1028 5087 5216 12228 16216 16381 16937 27132 27893
164 167 1210 7386 11151 20413 22713 23134 24188 36771 38992
298 511 809 4620 7347 8873 19602 24162 29198 34304 41145
105 830 1212 2415 14759 15440 16361 16748 22123 32684 42575
659 665 668 6458 22130 25972 30697 31074 32048 36078 37129
91 808 953 8015 8988 13492 13987 15979 28355 34509 39698
594 983 1265 3028 4029 9366 11069 11512 27066 40939 41639
506 740 1321 1484 10747 16376 17384 20285 31502 38925 42606
338 356 975 2022 3578 18689 18772 19826 22914 24733 27431
709 1264 1366 4617 8893 25226 27800 29080 30277 37781 39644
840 1179 1338 2973 3541 7043 12712 15005 17149 19910 36795
1009 1267 1380 4919 12679 22889 29638 30987 34637 36232 37284
466 913 1247 1646 3049 5924 9014 20539 34546 35029 36540
374 697 984 1654 5870 10883 11684 20294 28888 31612 34031
117 240 635 5093 8673 11323 12456 14145 21397 39619 42559
122 1265 1427 13528 14282 15241 16852 17227 34723 36836 39791
595 1180 1310 6952 17916 24725 24971 27243 29555 32138 35987
140 470 1017 13222 13253 18462 20806 21117 28673 31598 37235
7 710 1072 8014 10804 13303 14292 16690 26676 36443 41966
48 189 759 12438 14523 16388 23178 27315 28656 29111 29694
285 387 410 4294 4467 5949 25386 27898 34880 41169 42614
474 545 1320 10506 13186 18126 27110 31498 35353 36193 37322
1075 1130 1424 11390 13312 14161 16927 25071 25844 34287 38151
161 396 427 5944 17281 22201 25218 30143 35566 38261 42513
233 247 694 1446 3180 3507 9069 20764 21940 33422 39358
271 508 1013 6271 21760 21858 24887 29808 31099 35475 39924
8 674 1329 3135 5110 14460 28108 28388 31043 31137 31863
1035 1222 1409 8287 16083 24450 24888 29356 30329 37834 39684
391 1090 1128 1866 4095 10643 13121 14499 20056 22195 30593
55 161 1402 6289 6837 8791 17937 21425 26602 30461 37241
110 377 1228 6875 13253 17032 19008 23274 32285 33452 41630
360 638 1355 5933 12593 13533 23377 23881 24586 26040 41663
535 1240 1333 3354 10860 16032 32573 34908 34957 39255 40759
526 936 1321 7992 10260 18527 28248 29356 32636 34666 35552
336 785 875 7530 13062 13075 18925 27963 28703 33688 36502
36 591 1062 1518 3821 7048 11197 17781 19408 22731 24783
214 1145 1223 1546 9475 11170 16061 21273 38688 40051 42479
1136 1226 1423 20227 22573 24951 26462 29586 34915 42441 43048
26 276 1425 6048 7224 7917 8747 27559 28515 35002 37649
```

# FIG. 68

```
127 294 437 4029 8585 9647 11904 24115 28514 36893 39722
748 1093 1403 9536 19305 20468 31049 38667 40502 40720 41949
96 638 743 9806 12101 17751 22732 24937 32007 32594 38504
649 904 1079 2770 3337 9158 20125 24619 32921 33698 35173
401 518 984 7372 12438 12582 18704 35874 39420 39503 39790
10 451 1077 8078 16320 17409 25807 28814 30613 41261 42955
405 592 1178 15936 18418 19585 21966 24219 30637 34536 37838
50 584 851 9720 11919 22544 22545 25851 35567 41587 41876
911 1113 1176 1806 10058 10809 14220 19044 20748 29424 36671
441 550 1135 1956 11254 18699 30249 33099 34587 35243 39952
510 1016 1281 8621 13467 13780 15170 16289 20925 26426 34479
4969 5223 17117 21950 22144 24043 27151 39809
11452 13622 18918 19670 23995 32647 37200 37399
6351 6426 13185 13973 16699 22524 31070 31916
4098 10617 14854 18004 28580 36158 37500 38552
```

PROVIDED BY CRC/ETRI

# FIG. 69

N=64800, rate=6/15

```
 71  276  856  6867 12964 17373 18159 26420 28460 28477
257  322  672  2533  5316  6578  9037 10231 13845 36497
233  765  904  1366  3875 13145 15409 18620 23910 30825
100  224  405 12776 13868 14787 16781 23886 29099 31419
 23  496  891  2512 12589 14074 19392 20339 27658 28684
473  712  759  1283  4374  9898 12551 13814 24242 32728
511  567  815 11823 17106 17900 19338 22315 24396 26448
 45  733  836  1923  3727 17468 25746 33806 35995 36657
 17  487  675  2670  3922  5145 18009 23993 31073 36624
 72  751  773  1937 17324 28512 30666 30934 31016 31849
257  343  594 14041 19141 24914 26864 28809 32055 34753
 99  241  491  2650  9670 17433 17785 18988 22235 30742
198  299  655  6737  8304 10917 16092 19387 20755 37690
351  916  926 18151 21708 23216 30321 33578 34052 37949
 54  332  373  2010  3332  5623 16301 34337 36451 37861
139  257 1068 11090 20289 29694 29732 32640 35133 36404
457  885  968  2115  4956  5422  5949 17570 26673 32387
137  570  619  5006  6099  7979 14429 16650 25443 32789
 46  282  287 10258 18383 20258 27186 27494 28429 38266
445  486 1058  1868  9976 11294 20364 23695 30826 35330
134  900  931 12518 14544 17715 19623 21111 33868 34570
 62   66  586  8020 20270 23831 31041 31965 32224 35189
174  290  784  6740 14673 17642 26286 27382 33447 34879
332  675 1033  1838 12004 15439 20765 31721 34225 38863
527  558  832  3867  6318  8317 10883 13466 18427 25377
431  780 1021  1112  2873  7675 13059 17793 20570 20771
339  536 1015  5725  6916 10846 14487 21156 28123 32614
456  830 1078  7511 11801 12362 12705 17401 28867 34032
222  538  989  5593  6022  8302 14008 23445 25127 29022
 37  393  788  3025  7768 11367 22276 22761 28232 30394
234  257 1045  1307  2908  6337 26530 28142 34129 35997
 35   46  978  9912  9978 12567 17843 24194 34887 35206
 39  959  967  5027 10847 14657 18859 28075 28214 36325
275  477  823 11376 18073 28997 30521 31661 31941 32116
185  580  966 11733 12013 12760 13358 19372 32534 35504
760  891 1046 11150 20358 21638 29930 31014 33050 34840
360  389 1057  5316  5938 14186 16404 32445 34021 35722
306  344  679  5224  6674 10305 18753 25583 30585 36943
103  171 1016  8780 11741 12144 19470 20955 22495 27377
818  832  894  3883 14279 14497 22505 28129 28719 31246
215  411  760  5886 25612 28556 32213 32704 35901 36130
229  489 1067  2385  8587 20565 23431 28102 30147 32859
288  664  980  8138  8531 21676 23787 26708 28798 34490
 89  552  847  6656  9889 23949 26226 27080 31236 35823
 66  142  443  3339  3813  7977 14944 15464 19186 25983
605  876  931 16682 17669 25800 28220 33432 35738 37382
346  423  806  5669  7668  8789  9928 19724 24039 27893
 48  460 1055  3512  7389  7549 20216 22180 28221 35437
187  636  824  1678  4508 13588 19683 21750 30311 33480
```

# FIG. 70

```
25 768 935 2856 8187 9052 21850 29941 33217 34293
349 624 716 2698 6395 6435 8974 10649 15932 17378
336 410 871 3582 9830 10885 13892 18027 19203 36659
176 849 1078 17302 19379 27964 28164 28720 32557 35495
234 890 1075 9431 9605 9700 10113 11332 12679 24268
516 638 733 8851 19871 22740 25791 30152 32659 35568
253 830 879 2086 16885 22952 23765 25389 34656 37293
94 954 998 2003 3369 6870 7321 29856 31373 34888
79 350 933 4853 6252 11932 12058 21631 24552 24876
246 647 778 4036 10391 10656 13194 32335 32360 34179
149 339 436 6971 8356 8715 11577 22376 28684 31249
36 149 220 6936 18408 19192 19288 23063 28411 35312
273 683 1042 6327 10011 18041 21704 29097 30791 31425
46 138 722 2701 10984 13002 19930 26625 28458 28965
12 1009 1040 1990 2930 5302 21215 22625 23011 29288
125 241 819 2245 3199 8415 21133 26786 27226 38838
45 476 1075 7393 15141 20414 31244 33336 35004 38391
432 578 667 1343 10466 11314 11507 23314 27720 34465
248 291 556 1971 3989 8992 18000 19998 23932 34652
68 694 837 2246 7472 7873 11078 12868 20937 35591
272 924 949 2030 4360 6203 9737 19705 19902 38039
21 314 979 2311 2632 4109 19527 21920 31413 34277
197 253 804 1249 4315 10021 14358 20559 27099 30525
9802 16164 17499 22378 22403 22704 26742 29908
9064 10904 12305 14057 16156 26000 32613 34536
5178 6319 10239 19343 25628 30577 31110 32291
```

## FIG. 71

N=64800, rate=7/15

```
460 792 1007 4580 11452 13130 26882 27020 32439
35 472 1056 7154 12700 13326 13414 16828 19102
45 440 772 4854 7863 26945 27684 28651 31875
744 812 892 1509 9018 12925 14140 21357 25106
271 474 761 4268 6706 9609 19701 19707 24870
223 477 662 1987 9247 18376 22148 24948 27694
44 379 786 8823 12322 14666 16377 28688 29924
104 219 562 5832 19665 20615 21043 22759 32180
41 43 870 7963 13718 14136 17216 30470 33428
592 744 887 4513 6192 18116 19482 25032 34095
456 821 1078 7162 7443 8774 15567 17243 33085
151 666 977 6946 10358 11172 18129 19777 32234
236 793 870 2001 6805 9047 13877 30131 34252
297 698 772 3449 4204 11608 22950 26071 27512
202 428 474 3205 3726 6223 7708 20214 25283
139 719 915 1447 2938 11864 15932 21748 28598
135 853 902 3239 18590 20579 30578 33374 34045
9 13 971 11834 13642 17628 21669 24741 30965
344 531 730 1880 16895 17587 21901 28620 31957
7 192 380 3168 3729 5518 6827 20372 34168
28 521 681 4313 7465 14209 21501 23364 25980
269 393 898 3561 11066 11985 17311 26127 30309
42 82 707 4880 4890 9818 23340 25959 31695
189 262 707 6573 14082 22259 24230 24390 24664
383 568 573 5498 13449 13990 16904 22629 34203
585 596 820 2440 2488 21956 28261 28703 29591
755 763 795 5636 16433 21714 23452 31150 34545
23 343 669 1159 3507 13096 17978 24241 34321
316 384 944 4872 8491 18913 21085 23198 24798
64 314 765 3706 7136 8634 14227 17127 23437
220 693 899 8791 12417 13487 18335 22126 27428
285 794 1045 8624 8801 9547 19167 21894 32657
386 621 1045 1634 1882 3172 13686 16027 22448
95 622 693 2827 7098 11452 14112 18831 31308
446 813 928 7976 8935 13146 27117 27766 33111
89 138 241 3218 9283 20458 31484 31538 34216
277 420 704 9281 12576 12788 14496 15357 20585
141 643 758 4894 10264 15144 16357 22478 26461
17 108 160 13183 15424 17939 19276 23714 26655
109 285 608 1682 20223 21791 24615 29622 31983
123 515 622 7037 13946 15292 15606 16262 23742
264 565 923 6460 13622 13934 23181 25475 26134
202 548 789 8003 10993 12478 16051 25114 27579
121 450 575 5972 10062 18693 21852 23874 28031
507 560 889 12064 13316 19629 21547 25461 28732
664 786 1043 9137 9294 10163 23389 31436 34297
45 830 907 10730 16541 21232 30354 30605 31847
203 507 1060 6971 12216 13321 17861 22671 29825
369 881 952 3035 12279 12775 17682 17805 34281
```

# FIG. 72

```
683 709 1032 3787 17623 24138 26775 31432 33626
524 792 1042 12249 14765 18601 25811 32422 33163
137 639 688 7182 8169 10443 22530 24597 29039
159 643 749 16386 17401 24135 28429 33468 33469
107 481 555 7322 13234 19344 23498 26581 31378
249 389 523 3421 10150 17616 19085 20545 32069
395 738 1045 2415 3005 3820 19541 23543 31068
27 293 703 1717 3460 8326 8501 10290 32625
126 247 515 6031 9549 10643 22067 29490 34450
331 471 1007 3020 3922 7580 23358 28620 30946
222 542 1021 3291 3652 13130 16349 33009 34348
532 719 1038 5891 7528 23252 25472 31395 31774
145 398 774 7816 13887 14936 23708 31712 33160
88 536 600 1239 1887 12195 13782 16726 27998
151 269 585 1445 3178 3970 15568 20358 21051
650 819 865 15567 18546 25571 32038 33350 33620
93 469 800 6059 10405 12296 17515 21354 22231
97 206 951 6161 16376 27022 29192 30190 30665
412 549 986 5833 10583 10766 24946 28878 31937
72 604 659 5267 12227 21714 32120 33472 33974
25 902 912 1137 2975 9642 11598 25919 28278
420 976 1055 8473 11512 20198 21662 25443 30119
1 24 932 6426 11899 13217 13935 16548 29737
53 618 988 6280 7267 11676 13575 15532 25787
111 739 809 8133 12717 12741 20253 20608 27850
120 683 943 14496 15162 15440 18660 27543 32404
600 754 1055 7873 9679 17351 27268 33508
344 756 1054 7102 7193 22903 24720 27883
582 1003 1046 11344 23756 27497 27977 32853
28 429 509 11106 11767 12729 13100 31792
131 555 907 5113 10259 10300 20580 23029
406 915 977 12244 20259 26616 27899 32228
46 195 224 1229 4116 10263 13608 17830
19 819 953 7965 9998 13959 30580 30754
164 1003 1032 12920 15975 16582 22624 27357
8433 11894 13531 17675 25889 31384
3166 3813 8596 10368 25104 29584
2466 8241 12424 13376 24837 32711
```

PROVIDED BY CRC/ETRI

## FIG. 73

# FIG. 74

# FIG. 75

CODE LENGTH : N=16200
CODING RATE : {8, 10, 12}/15

| Rate | PERFORMANCE THRESHOLD (Es/NO) | MINIMUM CYCLE LENGTH |
|------|------|------|
| 8/15 | 0. 805765 | 6 |
| 10/15 | 2. 471011 | 6 |
| 12/15 | 4. 269922 | 6 |

| X1 | X2 | Y1 | Y2 | 2 | 1 | M |

KX1    KX2     KY1     KY2     M−1

| Rate | X1 | KX1 | X2 | KX2 | Y1 | KY1 | Y2 | KY2 | M |
|------|-----|------|-----|------|-----|------|-----|-------|------|
| 8/15 | 32 | 720 | 14 | 1080 | 4 | 1440 | 3 | 5400 | 7560 |
| 10/15 | 25 | 720 | 14 | 1440 | 4 | 360 | 3 | 8280 | 5400 |
| 12/15 | 14 | 2160 | — | 0 | 4 | 720 | 3 | 10080 | 3240 |

## FIG. 76

CODE LENGTH : N=64800
CODING RATE : {7, 9, 11, 13} /15

| Rate | PERFORMANCE THRESHOLD (Es/NO) | MINIMUM CYCLE LENGTH |
|------|------|------|
| 7/15 | -0. 093751 | 6 |
| 9/15 | 1. 658523 | 8 |
| 11/15 | 3. 351930 | 6 |
| 13/15 | 5. 301749 | 6 |

| X1 | X2 | Y1 | Y2 | 2 | 1 | M |

KX1  KX2   KY1    KY2     M−1

| Rate | X1 | KX1 | X2 | KX2 | Y1 | KY1 | Y2 | KY2 | M |
|------|----|----|----|----|----|----|----|----|----|
| 7/15 | 33 | 2160 | 15 | 5040 | 4 | 0 | 3 | 23040 | 34560 |
| 9/15 | 19 | 6840 | — | 0 | 4 | 6840 | 3 | 25200 | 25920 |
| 11/15 | 15 | 8280 | — | 0 | 4 | 2520 | 3 | 36720 | 17280 |
| 13/15 | 13 | 9360 | — | 0 | 4 | 360 | 3 | 46440 | 8640 |

# FIG. 77

CODE LENGTH : N=64800
CODING RATE : {6, 8, 12} /15

| Rate | X1 | KX1 | X2 | KX2 | Y1 | KY1 | Y2 | KY2 | M |
|------|-----|------|-----|------|-----|-------|-----|-------|-------|
| 6/15 | 27 | 4680 | — | 0 | 4 | 13680 | 3 | 7560 | 38880 |
| 8/15 | 19 | 7200 | — | 0 | 4 | 5760 | 3 | 21600 | 30240 |
| 12/15 | 14 | 9360 | — | 0 | 4 | 0 | 3 | 42480 | 12960 |

# FIG. 78

CODE LENGTH : N=16200
CODING RATE : {6, 7, 9, 11, 13}/15

| X1 | X2 | Y1 | Y2 | 2 | 1 | M |

KX1  KX2  KY1  KY2  M-1

| Rate | X1 | KX1 | X2 | KX2 | Y1 | KY1 | Y2 | KY2 | M |
|------|----|----|----|----|----|----|----|----|----|
| 6/15 | 30 | 1080 | – | – | 4 | 3600 | 3 | 1800 | 9720 |
| 7/15 | 24 | 1440 | – | – | 4 | 2520 | 3 | 3600 | 8640 |
| 9/15 | 16 | 1080 | 10 | 720 | 9 | 1080 | 3 | 6840 | 6480 |
| 11/15 | 12 | 2520 | – | – | – | – | 3 | 9360 | 4320 |
| 13/15 | 13 | 2160 | – | – | 4 | 3600 | 3 | 8280 | 2160 |

PROVIDED BY LGE

# FIG. 79

CODE LENGTH :　N=64800
CODING RATE : 10/15

| X1 | X2 | Y1 | Y2 | 2 | 1 | M |

KX1　KX2　　KY1　　KY2　　　M−1

| Rate | X1 | KX1 | X2 | KX2 | Y1 | KY1 | Y2 | KY2 | M |
|------|-----|------|----|------|----|------|----|-------|-------|
| 10/15 | 14 | 8640 | 9 | 2160 | 4 | 0 | 3 | 32400 | 21600 |

PROVIDED BY LGE

# FIG. 80

CODE LENGTH : N=64800
CODING RATE : 9/15

| X1 | X2 | Y1 | Y2 | 2 | 1 | M |

KX1  KX2  KY1  KY2  M−1

| Rate | X1 | KX1 | X2 | KX2 | Y1 | KY1 | Y2 | KY2 | M |
|------|-----|------|----|-------|----|------|----|-------|-------|
| 9/15 | 35 | 2520 | 8 | 11520 | 4 | 1080 | 3 | 23760 | 25920 |

PROVIDED BY NERC

# FIG. 81

CODE LENGTH : N=16200
CODING RATE : 5/15

High-rate accumulator-based code

| Rate | N | K | N−K | g | Q1 | Q2 |
|------|-------|------|-------|-----|----|----|
| 5/15 | 16200 | 5400 | 10800 | 720 | 2  | 28 |

* Q1=g/360, Q2=(N−K−g)/360

PROVIDED BY CRC/ETRI

Low-rate single parity check code

# FIG. 82

CODE LENGTH : N=64800
CODING RATE : {5, 6, 7}/15

High-rate accumulator-based code

| Rate | N | K | N-K | M1 | M2 | Q1 | Q2 |
|------|-------|-------|-------|------|-------|----|-----|
| 5/15 | 64800 | 21600 | 43200 | 1440 | 41760 | 4 | 116 |
| 6/15 | 64800 | 25920 | 38880 | 1080 | 37800 | 3 | 105 |
| 7/15 | 64800 | 30240 | 34560 | 1080 | 33480 | 3 | 93 |

* M1=g, M2=N-K-g, Q1=M1/360, Q2=M2/360

PROVIDED BY CRC/ETRI

# FIG. 83

# FIG. 84

*FIG. 85*

# FIG. 86

NUC for CR 5/15

NUC for CR 6/15

PROVIDED BY Samsung

NUC for CR 7/15

PROVIDED BY Samsung

NUC for CR 8/15

NUC for CR 9/15

PROVIDED BY Samsung

NUC for CR 10/15

NUC for CR 11/15

PROVIDED BY Samsung

NUC for CR 12/15

NUC for CR 13/15

PROVIDED BY Samsung

*FIG. 87*

FIG. 88

EP 3 247 043 A1

## FIG. 89

| Input cell word y | Constellation point zq |
|:---:|:---:|
| (00) | $(1+1i)/\sqrt{2}$ |
| (01) | $(1-1i)/\sqrt{2}$ |
| (10) | $(-1+1i)/\sqrt{2}$ |
| (11) | $(-1-1i)/\sqrt{2}$ |

## FIG. 90

| w/Shape | NUC_16_5/15 | NUC_16_6/15 | NUC_16_7/15 | NUC_16_8/15 |
|---|---|---|---|---|
| w0 | 0.5309 + 1.1928i | 0.5115 + 1.2092i | 0.5029 + 1.1949i | 0.4951 + 1.2068i |
| w1 | 1.1928 + 0.5309i | 1.2092 + 0.5115i | 1.1962 + 0.5050i | 1.2068 + 0.4951i |
| w2 | 0.2842 + 0.4633i | 0.2663 + 0.4530i | 0.2632 + 0.4959i | 0.2575 + 0.4819i |
| w3 | 0.4633 + 0.2842i | 0.4530 + 0.2663i | 0.4993 + 0.2625i | 0.4819 + 0.2575i |

| w/Shape | NUC_16_9/15 | NUC_16_10/15 | NUC_16_11/15 | NUC_16_12/15 | NUC_16_13/15 |
|---|---|---|---|---|---|
| w0 | 0.4967 + 1.1932i | 0.4487 + 1.1657i | 0.9342 + 0.9847i | 0.9555 + 0.9555i | 0.9517 + 0.9511i |
| w1 | 1.1896 + 0.4896i | 1.2080 + 0.5377i | 0.9866 + 0.2903i | 0.9555 + 0.2949i | 0.9524 + 0.3061i |
| w2 | 0.2452 + 0.5326i | 0.2213 + 0.4416i | 0.2716 + 0.9325i | 0.2949 + 0.9555i | 0.3067 + 0.9524i |
| w3 | 0.5210 + 0.2440i | 0.6186 + 0.2544i | 0.2901 + 0.2695i | 0.2949 + 0.2949i | 0.3061 + 0.3067i |

## FIG. 91

| w/Shape | NUC_64_5/15 | NUC_64_6/15 | NUC_64_7/15 | NUC_64_8/15 |
|---|---|---|---|---|
| w0 | 1.4327+0.3305i | 1.4521+0.3005i | 1.4865+0.2932i | 1.4827+0.2920i |
| w1 | 1.0909+0.2971i | 1.2657+0.8178i | 1.2618+0.8446i | 1.2563+0.8411i |
| w2 | 1.2484+0.7803i | 1.0666+0.2744i | 1.0271+0.2345i | 1.0211+0.2174i |
| w3 | 0.9762+0.5715i | 0.9500+0.5641i | 0.8976+0.5624i | 0.8798+0.5702i |
| w4 | 0.3309+1.4326i | 0.3011+1.4529i | 0.2943+1.4811i | 0.2920+1.4827i |
| w5 | 0.2979+1.0923i | 0.8202+1.2651i | 0.8402+1.2602i | 0.8410+1.2563i |
| w6 | 0.7829+1.2477i | 0.2750+1.0676i | 0.2356+1.0261i | 0.2174+1.0211i |
| w7 | 0.5739+0.9763i | 0.5656+0.9499i | 0.5632+0.8957i | 0.5702+0.8798i |
| w8 | 0.3901+0.2112i | 0.3553+0.1948i | 0.3147+0.1567i | 0.3040+0.1475i |
| w9 | 0.5317+0.2475i | 0.3569+0.2094i | 0.3116+0.1730i | 0.3028+0.1691i |
| w10 | 0.3945+0.2289i | 0.5596+0.2431i | 0.6512+0.2053i | 0.6855+0.1871i |
| w11 | 0.5236+0.2894i | 0.5410+0.3002i | 0.5965+0.3353i | 0.6126+0.3563i |
| w12 | 0.2108+0.3911i | 0.1946+0.3566i | 0.1567+0.3125i | 0.1475+0.3040i |
| w13 | 0.2475+0.5327i | 0.2094+0.3579i | 0.1733+0.3091i | 0.1691+0.3028i |
| w14 | 0.2287+0.3955i | 0.2430+0.5607i | 0.2056+0.6506i | 0.1871+0.6855i |
| w15 | 0.2898+0.5246i | 0.3004+0.5417i | 0.3364+0.5943i | 0.3563+0.6126i |

| w/Shape | NUC_64_9/15 | NUC_64_10/15 | NUC_64_11/15 | NUC_64_12/15 | NUC_64_13/15 |
|---|---|---|---|---|---|
| w0 | 1.4678+0.3029i | 1.4388+0.2878i | 1.4443+0.2683i | 1.4480+0.2403i | 1.4303+0.2329i |
| w1 | 1.2296+0.8500i | 1.2150+0.8133i | 0.7471+1.2243i | 0.6406+1.1995i | 0.6297+1.1818i |
| w2 | 1.0496+0.2245i | 1.0386+0.2219i | 1.1749+0.7734i | 1.0952+0.9115i | 1.0803+0.9154i |
| w3 | 0.8739+0.6079i | 0.8494+0.6145i | 0.7138+0.8201i | 0.6868+0.8108i | 0.6870+0.8095i |
| w4 | 0.2834+1.4645i | 0.2931+1.4656i | 0.1638+1.0769i | 1.0500+0.1642i | 1.0444+0.1681i |
| w5 | 0.8084+1.2532i | 0.8230+1.2278i | 0.2927+1.4217i | 0.7170+0.1473i | 0.7240+0.1548i |
| w6 | 0.2038+1.0260i | 0.2069+1.0649i | 0.1462+0.7457i | 1.0519+0.5188i | 1.0553+0.5250i |
| w7 | 0.5574+0.8905i | 0.5677+0.8971i | 0.4134+0.7408i | 0.7146+0.4532i | 0.7142+0.4710i |
| w8 | 0.3884+0.1313i | 0.4119+0.1177i | 1.0203+0.1517i | 0.1677+1.0405i | 0.2114+1.4305i |
| w9 | 0.3771+0.1914i | 0.3998+0.2516i | 0.6653+0.1357i | 0.2402+1.4087i | 0.2020+1.0575i |
| w10 | 0.7243+0.1752i | 0.7442+0.1559i | 0.9639+0.4465i | 0.1369+0.7073i | 0.1221+0.6613i |
| w11 | 0.6116+0.4008i | 0.5954+0.4328i | 0.6746+0.4339i | 0.4044+0.7057i | 0.3735+0.7557i |
| w12 | 0.1358+0.2445i | 0.1166+0.1678i | 0.1271+0.1428i | 0.1374+0.1295i | 0.1455+0.1275i |
| w13 | 0.1677+0.2860i | 0.1582+0.3325i | 0.3782+0.1406i | 0.4185+0.1357i | 0.4322+0.1389i |
| w14 | 0.1555+0.6756i | 0.1355+0.7408i | 0.1311+0.4288i | 0.1325+0.3998i | 0.1432+0.3852i |
| w15 | 0.3472+0.6007i | 0.3227+0.6200i | 0.3919+0.4276i | 0.4122+0.4120i | 0.4220+0.4278i |

# FIG. 92

| w/Shape | NUC_256_5/15 | NUC_256_6/15 | NUC_256_7/15 | NUC_256_8/15 |
|---|---|---|---|---|
| w0 | 0.3454+1.7407i | 0.6800+1.6926i | 0.1256+0.2068i | 1.0804+1.3788i |
| w1 | 0.2848+1.4216i | 0.3911+1.3845i | 0.1255+0.2077i | 1.0487+0.9862i |
| w2 | 0.2900+1.4180i | 0.2191+1.7524i | 0.1265+0.2240i | 1.6464+0.7428i |
| w3 | 0.2737+1.3492i | 0.2274+1.4208i | 0.1264+0.2247i | 1.3245+0.9414i |
| w4 | 0.9875+1.4751i | 0.8678+1.2487i | 0.1557+0.2325i | 0.7198+1.2427i |
| w5 | 0.8056+1.2096i | 0.7275+1.1867i | 0.1555+0.2328i | 0.8106+1.0040i |
| w6 | 0.8024+1.2105i | 0.8747+1.0470i | 0.1594+0.2448i | 0.5595+1.0317i |
| w7 | 0.7833+1.1501i | 0.7930+1.0406i | 0.1590+0.2447i | 0.6118+0.9722i |
| w8 | 0.2418+1.0058i | 0.2098+0.9768i | 0.1383+0.6402i | 1.6768+0.2002i |
| w9 | 0.2421+1.0268i | 0.2241+1.0454i | 0.1417+0.6402i | 0.9997+0.6844i |
| w10 | 0.2430+1.0283i | 0.1858+0.9878i | 0.1344+0.6027i | 1.4212+0.4769i |
| w11 | 0.2435+1.0473i | 0.1901+1.0659i | 0.1366+0.6023i | 1.1479+0.6312i |
| w12 | 0.5486+0.8834i | 0.5547+0.8312i | 0.3330+0.5789i | 0.8079+0.6566i |
| w13 | 0.5600+0.8986i | 0.5479+0.8651i | 0.3228+0.5787i | 0.7284+0.6957i |
| w14 | 0.5596+0.8990i | 0.6073+0.8182i | 0.3099+0.5483i | 0.5724+0.7031i |
| w15 | 0.5732+0.9141i | 0.5955+0.8420i | 0.3017+0.5493i | 0.6302+0.7259i |
| w16 | 1.7418+0.3438i | 1.4070+0.1790i | 0.4168+0.1173i | 0.1457+1.4010i |
| w17 | 1.4213+0.2870i | 1.7227+0.2900i | 0.4168+0.1185i | 0.1806+1.7346i |
| w18 | 1.4197+0.2879i | 1.3246+0.2562i | 0.4205+0.1200i | 0.1174+1.1035i |
| w19 | 1.3494+0.2745i | 1.3636+0.3654i | 0.4202+0.1215i | 0.1095+1.0132i |
| w20 | 1.4793+0.9955i | 1.3708+1.2834i | 0.3852+0.1797i | 0.4357+1.3836i |
| w21 | 1.2123+0.8007i | 1.6701+0.8493i | 0.3860+0.1803i | 0.5853+1.6820i |
| w22 | 1.2118+0.7988i | 1.1614+0.7909i | 0.3867+0.1760i | 0.3439+1.0889i |
| w23 | 1.1521+0.7597i | 1.2241+0.7367i | 0.3879+0.1765i | 0.3234+0.9962i |
| w24 | 1.0044+0.2394i | 0.9769+0.1863i | 0.7366+0.1528i | 0.1092+0.6174i |
| w25 | 1.0250+0.2403i | 0.9452+0.2057i | 0.7255+0.1884i | 0.1074+0.6307i |
| w26 | 1.0252+0.2408i | 1.0100+0.2182i | 0.7219+0.1535i | 0.1109+0.6996i |
| w27 | 1.0460+0.2418i | 0.9795+0.2417i | 0.7117+0.1857i | 0.1076+0.7345i |
| w28 | 0.8845+0.5424i | 0.8241+0.4856i | 0.5825+0.4149i | 0.3291+0.6264i |
| w29 | 0.8997+0.5562i | 0.8232+0.4837i | 0.6012+0.4001i | 0.3126+0.6373i |
| w30 | 0.9000+0.5558i | 0.8799+0.5391i | 0.5715+0.3988i | 0.3392+0.6999i |
| w31 | 0.9148+0.5690i | 0.8796+0.5356i | 0.5889+0.3864i | 0.3202+0.7282i |
| w32 | 0.1817+0.3255i | 0.1376+0.3342i | 0.1671+1.7095i | 0.9652+0.1066i |
| w33 | 0.1824+0.3255i | 0.1383+0.3292i | 0.4420+1.6137i | 0.9075+0.1666i |
| w34 | 0.1624+0.3255i | 0.1363+0.3322i | 0.1477+1.3874i | 0.9724+0.1171i |
| w35 | 0.1621+0.3256i | 0.1370+0.3273i | 0.3135+1.3073i | 0.9186+0.1752i |
| w36 | 0.1790+0.3237i | 0.1655+0.3265i | 1.0214+1.3784i | 0.6342+0.1372i |
| w37 | 0.1788+0.3238i | 0.1656+0.3227i | 0.7434+1.5169i | 0.6550+0.1495i |
| w38 | 0.1791+0.3239i | 0.1634+0.3246i | 0.7869+1.1040i | 0.6290+0.1393i |
| w39 | 0.1791+0.3240i | 0.1636+0.3208i | 0.6252+1.2041i | 0.6494+0.1504i |
| w40 | 0.2113+0.6186i | 0.1779+0.6841i | 0.1526+0.9140i | 1.3127+0.1240i |
| w41 | 0.2119+0.6257i | 0.1828+0.6845i | 0.1914+0.9087i | 0.9572+0.4344i |
| w42 | 0.2122+0.6254i | 0.1745+0.6828i | 0.1530+1.0179i | 1.2403+0.2631i |
| w43 | 0.2127+0.6319i | 0.1793+0.6829i | 0.2095+1.0084i | 1.0254+0.4130i |
| w44 | 0.3178+0.5735i | 0.3547+0.6009i | 0.5021+0.7976i | 0.8098+0.4214i |
| w45 | 0.3213+0.5787i | 0.3593+0.6011i | 0.4537+0.8238i | 0.6773+0.4284i |
| w46 | 0.3215+0.5788i | 0.3576+0.5990i | 0.5663+0.8802i | 0.5995+0.4102i |
| w47 | 0.3257+0.5842i | 0.3624+0.5994i | 0.5021+0.9146i | 0.6531+0.4101i |
| w48 | 0.3188+0.1624i | 0.2697+0.1443i | 1.7030+0.1913i | 0.1250+0.1153i |
| w49 | 0.3195+0.1623i | 0.2704+0.1433i | 1.6116+0.5458i | 0.1252+0.1158i |
| w50 | 0.3195+0.1624i | 0.2644+0.1442i | 1.3788+0.1641i | 0.1245+0.1152i |
| w51 | 0.3201+0.1623i | 0.2650+0.1432i | 1.3121+0.4320i | 0.1247+0.1156i |
| w52 | 0.3184+0.1783i | 0.2763+0.1638i | 1.2722+1.1406i | 0.3768+0.1244i |
| w53 | 0.3186+0.1785i | 0.2768+0.1626i | 1.4536+0.8623i | 0.3707+0.1237i |
| w54 | 0.3183+0.1791i | 0.2715+0.1630i | 1.0204+0.9078i | 0.3779+0.1260i |
| w55 | 0.3200+0.1794i | 0.2719+0.1618i | 1.1634+0.7212i | 0.3717+0.1252i |
| w56 | 0.6175+0.2099i | 0.6488+0.1696i | 0.9979+0.1554i | 0.1161+0.3693i |
| w57 | 0.6234+0.2098i | 0.6462+0.1706i | 0.9681+0.2706i | 0.1157+0.3645i |
| w58 | 0.6230+0.2110i | 0.6456+0.1745i | 1.0796+0.1672i | 0.1178+0.3469i |
| w59 | 0.6291+0.2117i | 0.6431+0.1753i | 1.0514+0.3095i | 0.1171+0.3424i |
| w60 | 0.5723+0.3146i | 0.5854+0.3186i | 0.7488+0.6179i | 0.3530+0.3899i |
| w61 | 0.5781+0.3186i | 0.5862+0.3187i | 0.8017+0.5598i | 0.3422+0.3808i |
| w62 | 0.5779+0.3183i | 0.5864+0.3275i | 0.8168+0.6803i | 0.3014+0.3755i |
| w63 | 0.5831+0.3226i | 0.5873+0.3254i | 0.8882+0.5928i | 0.3509+0.3656i |

# FIG. 93

| w/Shape | NUC_256_9/15 | NUC_256_10/15 | NUC_256_11/15 | NUC_256_12/15 | NUC_256_13/15 |
|---|---|---|---|---|---|
| w0 | 0.0899+0.1337i | 1.6097+0.1548i | 0.0591+0.3040i | 1.1980+1.1541i | 1.5315+0.2812i |
| w1 | 0.0910+0.1377i | 1.5549+0.4605i | 0.1067+0.3390i | 0.9192+1.2082i | 0.9982+1.2680i |
| w2 | 0.0873+0.3862i | 1.3226+0.1290i | 0.0687+0.4930i | 1.2778+0.8523i | 1.2823+0.9828i |
| w3 | 0.0883+0.3873i | 1.2772+0.3829i | 0.1491+0.4854i | 1.0390+0.9253i | 1.0130+1.0317i |
| w4 | 0.1115+0.1442i | 1.2753+1.0242i | 0.0887+0.2236i | 0.6057+1.2200i | 0.5551+1.2232i |
| w5 | 0.1135+0.1472i | 1.4434+0.7540i | 0.1828+0.2696i | 0.7371+1.4217i | 0.7500+1.3030i |
| w6 | 0.2067+0.3591i | 1.0491+0.8476i | 0.3356+0.3853i | 0.8678+1.0021i | 0.6087+1.0227i |
| w7 | 0.1975+0.3621i | 1.1861+0.6253i | 0.2702+0.3881i | 0.8412+0.9448i | 0.7948+1.0535i |
| w8 | 0.1048+0.7533i | 0.9326+0.0970i | 0.0835+0.7880i | 1.2128+0.5373i | 1.4036+0.5215i |
| w9 | 0.1770+0.7412i | 0.8962+0.2804i | 0.2394+0.7591i | 1.0048+0.5185i | 0.9890+0.6534i |
| w10 | 0.1022+0.5904i | 1.1044+0.1102i | 0.0760+0.6412i | 1.4321+0.6343i | 1.2520+0.7351i |
| w11 | 0.1191+0.5890i | 1.0648+0.3267i | 0.1987+0.6157i | 1.0245+0.7152i | 1.0227+0.8252i |
| w12 | 0.4264+0.6230i | 0.7325+0.6071i | 0.5245+0.6123i | 0.6384+0.6073i | 0.6403+0.6582i |
| w13 | 0.3650+0.6689i | 0.8260+0.4559i | 0.3927+0.6985i | 0.8175+0.5684i | 0.8060+0.6652i |
| w14 | 0.3254+0.5153i | 0.8744+0.7153i | 0.4287+0.4942i | 0.8568+0.7801i | 0.6373+0.8319i |
| w15 | 0.2959+0.5302i | 0.9882+0.5300i | 0.3318+0.5634i | 0.8311+0.7459i | 0.8148+0.8469i |
| w16 | 0.3256+0.0768i | 0.1646+1.6407i | 0.0989+0.0607i | 0.1349+1.4742i | 0.0882+1.1910i |
| w17 | 0.3266+0.0870i | 0.4867+1.5743i | 0.2630+0.0643i | 0.1105+1.2309i | 0.1233+1.4227i |
| w18 | 0.4721+0.0994i | 0.1363+1.3579i | 0.4932+0.0751i | 0.0634+0.9796i | 0.0755+0.9944i |
| w19 | 0.4721+0.1206i | 0.4023+1.3026i | 0.4161+0.0867i | 0.1891+1.0198i | 0.2181+0.9629i |
| w20 | 0.2927+0.1267i | 1.0542+1.2584i | 0.0968+0.0986i | 0.4142+1.4461i | 0.4487+1.4550i |
| w21 | 0.2947+0.1296i | 0.7875+1.4450i | 0.2399+0.1452i | 0.3323+1.2279i | 0.3074+1.2765i |
| w22 | 0.3823+0.2592i | 0.8687+1.0407i | 0.4202+0.2731i | 0.4998+0.9827i | 0.4457+0.9787i |
| w23 | 0.3944+0.2521i | 0.6502+1.1951i | 0.3814+0.2140i | 0.3467+1.0202i | 0.3244+1.0818i |
| w24 | 0.7755+0.1118i | 0.0982+0.9745i | 0.8082+0.0772i | 0.0680+0.6501i | 0.0654+0.6354i |
| w25 | 0.7513+0.2154i | 0.2842+0.9344i | 0.7885+0.2238i | 0.2016+0.6464i | 0.1971+0.6324i |
| w26 | 0.8591+0.1033i | 0.1142+1.1448i | 0.8399+0.0777i | 0.0719+0.8075i | 0.0689+0.8037i |
| w27 | 0.8448+0.1787i | 0.3385+1.0973i | 0.8420+0.1790i | 0.2088+0.8146i | 0.2018+0.7986i |
| w28 | 0.5806+0.4930i | 0.6062+0.7465i | 0.6417+0.5007i | 0.4809+0.6296i | 0.4855+0.6442i |
| w29 | 0.6538+0.4155i | 0.4607+0.8538i | 0.7299+0.3774i | 0.3374+0.6412i | 0.3382+0.6322i |
| w30 | 0.4981+0.3921i | 0.7263+0.8764i | 0.5309+0.3792i | 0.4955+0.8008i | 0.4757+0.8090i |
| w31 | 0.5373+0.3586i | 0.5450+1.0067i | 0.5944+0.3031i | 0.3431+0.8141i | 0.3361+0.7848i |
| w32 | 0.1630+1.6621i | 0.2655+0.0746i | 0.1546+1.5857i | 1.2731+0.1108i | 1.1297+0.0851i |
| w33 | 0.4720+1.5898i | 0.2664+0.0759i | 0.4570+1.5271i | 1.0794+0.0977i | 0.9487+0.0716i |
| w34 | 0.1268+1.3488i | 0.4571+0.0852i | 0.1299+1.3287i | 1.5126+0.1256i | 1.3237+0.1117i |
| w35 | 0.3752+1.2961i | 0.4516+0.1062i | 0.3843+1.2747i | 0.9029+0.0853i | 0.9393+0.2065i |
| w36 | 1.0398+1.2991i | 0.2559+0.1790i | 1.0096+1.2448i | 0.5429+0.0694i | 0.6190+0.0700i |
| w37 | 0.7733+1.4772i | 0.2586+0.1772i | 0.7469+1.4138i | 0.6795+0.0559i | 0.7738+0.0686i |
| w38 | 0.3380+1.0552i | 0.3592+0.2811i | 0.3493+1.0396i | 0.5628+0.1945i | 0.6220+0.2081i |
| w39 | 0.6242+1.2081i | 0.3728+0.2654i | 0.6271+1.1808i | 0.7326+0.1410i | 0.7757+0.2088i |
| w40 | 0.1103+0.9397i | 0.7706+0.0922i | 0.0962+0.9482i | 1.2283+0.3217i | 1.1814+0.4884i |
| w41 | 0.2415+0.9155i | 0.7407+0.2280i | 0.2325+0.9136i | 1.0269+0.3281i | 0.9824+0.4891i |
| w42 | 0.1118+1.1163i | 0.6180+0.0927i | 0.1111+1.1188i | 1.4663+0.3716i | 1.1993+0.3009i |
| w43 | 0.3079+1.0866i | 0.6019+0.1658i | 0.3278+1.0767i | 0.9085+0.2470i | 0.9901+0.3353i |
| w44 | 0.5647+0.7638i | 0.6007+0.4980i | 0.6212+0.7418i | 0.6160+0.4549i | 0.6359+0.4984i |
| w45 | 0.4385+0.8433i | 0.6673+0.3928i | 0.4618+0.8431i | 0.7818+0.4247i | 0.8014+0.4986i |
| w46 | 0.6846+0.3841i | 0.4786+0.3935i | 0.7246+0.8784i | 0.5938+0.3170i | 0.6291+0.3515i |
| w47 | 0.5165+1.0034i | 0.5176+0.3391i | 0.5361+0.9967i | 0.7600+0.2850i | 0.7895+0.3529i |
| w48 | 1.6489+0.1630i | 0.0757+0.1003i | 1.6072+0.1609i | 0.0595+0.0707i | 0.0671+0.0678i |
| w49 | 1.5848+0.4983i | 0.0753+0.1004i | 1.5432+0.4731i | 0.1722+0.0706i | 0.1990+0.0681i |
| w50 | 1.3437+0.1389i | 0.0777+0.4788i | 1.3489+0.1333i | 0.0599+0.2119i | 0.0672+0.2013i |
| w51 | 1.2850+0.4025i | 0.0867+0.4754i | 1.2954+0.3928i | 0.1748+0.2114i | 0.2001+0.2020i |
| w52 | 1.2728+1.0661i | 0.1023+0.2243i | 1.2390+1.0268i | 0.4134+0.0701i | 0.4732+0.0691i |
| w53 | 1.4509+0.7925i | 0.1010+0.2242i | 1.4186+0.7856i | 0.2935+0.0705i | 0.3357+0.0687i |
| w54 | 1.0249+0.8794i | 0.1950+0.3919i | 1.0410+0.8559i | 0.4231+0.2066i | 0.4760+0.2085i |
| w55 | 1.1758+0.6545i | 0.1881+0.3988i | 1.1906+0.6380i | 0.2979+0.2100i | 0.3369+0.2036i |
| w56 | 0.9629+0.1113i | 0.0930+0.8122i | 0.9742+0.0932i | 0.0638+0.5002i | 0.0662+0.4806i |
| w57 | 0.9226+0.2849i | 0.2215+0.7840i | 0.9407+0.2747i | 0.1905+0.4966i | 0.1986+0.4811i |
| w58 | 1.1062+0.1118i | 0.0937+0.6514i | 1.1464+0.1111i | 0.0612+0.3552i | 0.0673+0.3384i |
| w59 | 1.0674+0.3393i | 0.1540+0.6366i | 1.1015+0.3295i | 0.1810+0.3533i | 0.1996+0.3401i |
| w60 | 0.7234+0.6223i | 0.4810+0.6306i | 0.7601+0.6105i | 0.4630+0.4764i | 0.4830+0.4908i |
| w61 | 0.8211+0.4860i | 0.3856+0.7037i | 0.8677+0.4536i | 0.3231+0.4895i | 0.3383+0.4845i |
| w62 | 0.8457+0.7260i | 0.3527+0.5230i | 0.8874+0.7222i | 0.4416+0.3397i | 0.4783+0.3476i |
| w63 | 0.9640+0.5518i | 0.3100+0.5559i | 1.0145+0.5366i | 0.3083+0.3490i | 0.3375+0.3430i |

## FIG. 94

| u/Shape | NUC_1k_5/15 | NUC_1k_6/15 | NUC_1k_7/15 | NUC_1k_8/15 | NUC_1k_9/15 | NUC_1k_10/15 | NUC_1k_11/15 | NUC_1k_12/15 | NUC_1k_13/15 |
|---|---|---|---|---|---|---|---|---|---|
| u1 | 0.9997 | 1.0003 | 0.9963 | 1.0005 | 1.0011 | 1.0772 | 1.2776 | 2.5983 | 2.9754 |
| u2 | 0.9916 | 1.0149 | 1.1928 | 2.0897 | 2.7364 | 2.8011 | 3.2278 | 4.5193 | 4.9976 |
| u3 | 0.9911 | 1.0158 | 1.1963 | 2.0888 | 2.7353 | 2.9634 | 3.6845 | 6.1649 | 7.0187 |
| u4 | 2.4349 | 2.6848 | 3.0187 | 3.9945 | 4.7973 | 4.8127 | 5.5155 | 8.2107 | 9.1029 |
| u5 | 2.4346 | 2.6903 | 3.0304 | 3.9931 | 4.7912 | 5.1864 | 6.3531 | 9.9594 | 11.2221 |
| u6 | 2.486 | 2.882 | 3.6381 | 5.3843 | 6.7638 | 6.7838 | 8.0757 | 12.0321 | 13.4239 |
| u7 | 2.4864 | 2.8747 | 3.6181 | 5.3894 | 6.7793 | 7.5029 | 9.3579 | 13.9574 | 15.6992 |
| u8 | 4.4576 | 4.7815 | 5.5244 | 7.5206 | 9.0009 | 9.2380 | 11.0655 | 16.2598 | 18.0937 |
| u9 | 4.4646 | 4.7619 | 5.4955 | 7.6013 | 9.1536 | 10.3200 | 12.7075 | 18.4269 | 20.6137 |
| u10 | 4.9706 | 5.5779 | 6.7182 | 9.3371 | 11.3648 | 12.0115 | 14.5719 | 20.9273 | 23.2898 |
| u11 | 4.9552 | 5.6434 | 6.9391 | 9.8429 | 12.0321 | 13.5356 | 16.5813 | 23.4863 | 26.1557 |
| u12 | 6.7222 | 7.3854 | 8.7621 | 11.9255 | 14.393 | 15.6099 | 18.8402 | 26.4823 | 29.2399 |
| u13 | 7.0327 | 7.8797 | 9.6592 | 13.3962 | 16.1857 | 17.7524 | 21.3824 | 29.7085 | 32.5936 |
| u14 | 8.5382 | 9.635 | 11.7195 | 15.8981 | 19.1014 | 20.5256 | 24.2862 | 33.6247 | 36.309 |
| u15 | 10.4411 | 11.7874 | 14.3731 | 19.1591 | 22.8664 | 24.1254 | 27.7376 | 38.5854 | 40.584 |

# FIG. 95

**A**

| | | | | | | | | | | | | | | | | |
|---|---|---|---|---|---|---|---|---|---|---|---|---|---|---|---|---|
| $y0,q$ | 1 | 1 | 1 | 1 | 1 | 1 | 1 | 1 | 1 | 1 | 1 | 1 | 1 | 1 | 1 | 1 |
| $y2,q$ | 0 | 0 | 0 | 0 | 0 | 0 | 0 | 0 | 1 | 1 | 1 | 1 | 1 | 1 | 1 | 1 |
| $y4,q$ | 0 | 0 | 0 | 0 | 1 | 1 | 1 | 1 | 1 | 1 | 1 | 1 | 0 | 0 | 0 | 0 |
| $y6,q$ | 0 | 0 | 1 | 1 | 1 | 1 | 0 | 0 | 0 | 0 | 1 | 1 | 1 | 1 | 0 | 0 |
| $y8,q$ | 0 | 1 | 1 | 0 | 0 | 1 | 1 | 0 | 0 | 1 | 1 | 0 | 0 | 1 | 1 | 0 |
| $Re(z_q)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-1$ |
| $Y0,q$ | 0 | 0 | 0 | 0 | 0 | 0 | 0 | 0 | 0 | 0 | 0 | 0 | 0 | 0 | 0 | 0 |
| $y2,q$ | 1 | 1 | 1 | 1 | 1 | 1 | 1 | 1 | 0 | 0 | 0 | 0 | 0 | 0 | 0 | 0 |
| $y4,q$ | 0 | 0 | 0 | 0 | 1 | 1 | 1 | 1 | 1 | 1 | 1 | 1 | 0 | 0 | 0 | 0 |
| $y6,q$ | 0 | 0 | 1 | 1 | 1 | 1 | 0 | 0 | 0 | 0 | 1 | 1 | 1 | 1 | 0 | 0 |
| $y8,q$ | 0 | 1 | 1 | 0 | 0 | 1 | 1 | 0 | 0 | 1 | 1 | 0 | 0 | 1 | 1 | 0 |
| $Re(z_q)$ | 1 | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

**B**

| | | | | | | | | | | | | | | | | |
|---|---|---|---|---|---|---|---|---|---|---|---|---|---|---|---|---|
| $y1,q$ | 1 | 1 | 1 | 1 | 1 | 1 | 1 | 1 | 1 | 1 | 1 | 1 | 1 | 1 | 1 | 1 |
| $y3,q$ | 0 | 0 | 0 | 0 | 0 | 0 | 0 | 0 | 1 | 1 | 1 | 1 | 1 | 1 | 1 | 1 |
| $y5,q$ | 0 | 0 | 0 | 0 | 1 | 1 | 1 | 1 | 1 | 1 | 1 | 1 | 0 | 0 | 0 | 0 |
| $y7,q$ | 0 | 0 | 1 | 1 | 1 | 1 | 0 | 0 | 0 | 0 | 1 | 1 | 1 | 1 | 0 | 0 |
| $y9,q$ | 0 | 1 | 1 | 0 | 0 | 1 | 1 | 0 | 0 | 1 | 1 | 0 | 0 | 1 | 1 | 0 |
| $Im(z_q)$ | $-u_{15}$ | $-u_{14}$ | $-u_{13}$ | $-u_{12}$ | $-u_{11}$ | $-u_{10}$ | $-u_9$ | $-u_8$ | $-u_7$ | $-u_6$ | $-u_5$ | $-u_4$ | $-u_3$ | $-u_2$ | $-u_1$ | $-1$ |
| $y1,q$ | 0 | 0 | 0 | 0 | 0 | 0 | 0 | 0 | 0 | 0 | 0 | 0 | 0 | 0 | 0 | 0 |
| $y3,q$ | 1 | 1 | 1 | 1 | 1 | 1 | 1 | 1 | 0 | 0 | 0 | 0 | 0 | 0 | 0 | 0 |
| $y5,q$ | 0 | 0 | 0 | 0 | 1 | 1 | 1 | 1 | 1 | 1 | 1 | 1 | 0 | 0 | 0 | 0 |
| $y7,q$ | 0 | 0 | 1 | 1 | 1 | 1 | 0 | 0 | 0 | 0 | 1 | 1 | 1 | 1 | 0 | 0 |
| $y9,q$ | 0 | 1 | 1 | 0 | 0 | 1 | 1 | 0 | 0 | 1 | 1 | 0 | 0 | 1 | 1 | 0 |
| $Im(z_q)$ | 1 | $u_1$ | $u_2$ | $u_3$ | $u_4$ | $u_5$ | $u_6$ | $u_7$ | $u_8$ | $u_9$ | $u_{10}$ | $u_{11}$ | $u_{12}$ | $u_{13}$ | $u_{14}$ | $u_{15}$ |

# FIG. 96

| u/code rate | 5/15 | 6/15 | 7/15 | 8/15 | 9/15 | 10/15 | 11/15 | 12/15 | 13/15 |
|---|---|---|---|---|---|---|---|---|---|
| u1 | 1.0004 | 0.9998 | 0.9988 | 0.9999 | 0.9999 | 1.0009 | 1.0043 | 2.031 | 2.7135 |
| u2 | 1.0009 | 0.9984 | 0.9996 | 1.0004 | 1.0364 | 2.272 | 2.7379 | 3.8448 | 4.6426 |
| u3 | 1.0008 | 0.9983 | 0.998 | 1.0013 | 1.037 | 2.2732 | 2.746 | 4.8763 | 6.3617 |
| u4 | 0.9953 | 1.2356 | 2.0374 | 2.5341 | 2.7604 | 4.1332 | 4.6828 | 6.8402 | 8.3598 |
| u5 | 0.9956 | 1.2354 | 2.0374 | 2.5347 | 2.7604 | 4.1327 | 4.7079 | 7.912 | 10.0999 |
| u6 | 0.9956 | 1.2372 | 2.0374 | 2.5328 | 2.8536 | 5.4651 | 6.4365 | 9.7373 | 12.0627 |
| u7 | 0.9957 | 1.2366 | 2.0366 | 2.5362 | 2.8534 | 5.4655 | 6.5065 | 10.8859 | 13.8413 |
| u8 | 2.5769 | 2.9864 | 3.93 | 4.5077 | 4.7342 | 7.4777 | 8.4445 | 12.8891 | 15.9032 |
| u9 | 2.5774 | 2.9867 | 3.931 | 4.5089 | 4.7345 | 7.478 | 8.6065 | 14.1091 | 17.7263 |
| u10 | 2.5794 | 2.9906 | 3.9297 | 4.5202 | 5.0028 | 8.9382 | 10.254 | 15.9704 | 19.7625 |
| u11 | 2.5793 | 2.9912 | 3.9294 | 4.5204 | 5.0025 | 8.9384 | 10.5627 | 17.2797 | 21.6431 |
| u12 | 2.6756 | 3.5858 | 5.277 | 6.2318 | 6.6184 | 10.9166 | 12.3025 | 19.2948 | 23.7857 |
| u13 | 2.6764 | 3.5859 | 5.2757 | 6.2314 | 6.6189 | 10.9185 | 12.8281 | 20.7185 | 25.7402 |
| u14 | 2.6747 | 3.577 | 5.2792 | 6.3219 | 7.215 | 12.5855 | 14.3539 | 22.6727 | 27.9051 |
| u15 | 2.6746 | 3.5775 | 5.2795 | 6.3212 | 7.2149 | 12.5908 | 15.1126 | 24.2439 | 29.9595 |
| u16 | 4.6252 | 5.474 | 7.4011 | 8.3718 | 8.9581 | 14.7944 | 16.7817 | 26.3916 | 32.2702 |
| u17 | 4.6243 | 5.4757 | 7.3997 | 8.372 | 8.9585 | 14.8184 | 17.7277 | 28.1062 | 34.4336 |
| u18 | 4.6188 | 5.4675 | 7.4646 | 8.7429 | 9.94 | 16.6805 | 19.2664 | 30.2335 | 36.7993 |
| u19 | 4.62 | 5.4681 | 7.4665 | 8.7398 | 9.9394 | 16.8025 | 20.3968 | 32.1242 | 39.1019 |
| u20 | 5.246 | 6.7028 | 9.1828 | 10.5001 | 11.5978 | 18.9131 | 22.1002 | 34.4644 | 41.6513 |
| u21 | 5.2441 | 6.7104 | 9.1919 | 10.4999 | 11.6041 | 19.325 | 23.4306 | 36.5679 | 44.1297 |
| u22 | 5.2556 | 6.8816 | 9.641 | 11.4966 | 12.9965 | 21.168 | 25.1704 | 39.027 | 46.8305 |
| u23 | 5.2584 | 6.8738 | 9.6278 | 11.5018 | 13.088 | 22.0945 | 26.7556 | 41.4123 | 49.5435 |
| u24 | 7.0279 | 8.6613 | 11.7039 | 13.483 | 14.878 | 24.1425 | 28.7536 | 44.2002 | 52.5353 |
| u25 | 7.0459 | 8.6344 | 11.6913 | 13.5672 | 15.2586 | 25.575 | 30.6214 | 46.9287 | 55.5551 |
| u26 | 7.4305 | 9.4101 | 12.9619 | 15.1187 | 16.8096 | 27.6541 | 32.829 | 50.0315 | 58.8707 |
| u27 | 7.3941 | 9.5027 | 13.2128 | 15.6519 | 17.8237 | 29.6567 | 35.1146 | 53.2678 | 62.3471 |
| u28 | 8.8516 | 11.1654 | 15.161 | 17.6098 | 19.6965 | 32.2679 | 37.8272 | 57.0085 | 66.2558 |
| u29 | 9.1461 | 11.7322 | 16.204 | 19.1046 | 21.4926 | 35.0526 | 40.7685 | 61.0847 | 70.5087 |
| u30 | 10.4828 | 13.5243 | 18.4804 | 21.5413 | 23.9997 | 38.6023 | 44.3725 | 65.9903 | 75.5397 |
| u31 | 12.3176 | 15.7967 | 21.4433 | 24.7641 | 27.2995 | 43.2007 | 48.9596 | 72.1993 | 81.8379 |

# FIG. 97

**A**

| $y_{0,q}$ | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| $y_{2,q}$ | 0 | 0 | 0 | 0 | 0 | 0 | 0 | 0 | 0 | 0 | 0 | 0 | 0 | 0 | 0 | 0 |
| $y_{4,q}$ | 0 | 0 | 0 | 0 | 0 | 0 | 0 | 0 | 1 | 1 | 1 | 1 | 1 | 1 | 1 | 1 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $\mathrm{Re}(z_q)$ | $\tilde{u}_{31}$ | $\tilde{u}_{30}$ | $\tilde{u}_{29}$ | $\tilde{u}_{28}$ | $\tilde{u}_{27}$ | $\tilde{u}_{26}$ | $\tilde{u}_{25}$ | $\tilde{u}_{24}$ | $\tilde{u}_{23}$ | $\tilde{u}_{22}$ | $\tilde{u}_{21}$ | $\tilde{u}_{20}$ | $\tilde{u}_{19}$ | $\tilde{u}_{18}$ | $\tilde{u}_{17}$ | $\tilde{u}_{16}$ |
| $y_{0,q}$ | 1 | 1 | 1 | 1 | 1 | 1 | 1 | 1 | 1 | 1 | 1 | 1 | 1 | 1 | 1 | 1 |
| $y_{2,q}$ | 1 | 1 | 1 | 1 | 1 | 1 | 1 | 1 | 1 | 1 | 1 | 1 | 1 | 1 | 1 | 1 |
| $y_{4,q}$ | 1 | 1 | 1 | 1 | 1 | 1 | 1 | 1 | 0 | 0 | 0 | 0 | 0 | 0 | 0 | 0 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $\mathrm{Re}(z_q)$ | $\tilde{u}_{15}$ | $\tilde{u}_{14}$ | $\tilde{u}_{13}$ | $\tilde{u}_{12}$ | $\tilde{u}_{11}$ | $\tilde{u}_{10}$ | $\tilde{u}_{9}$ | $\tilde{u}_{8}$ | $\tilde{u}_{7}$ | $\tilde{u}_{6}$ | $\tilde{u}_{5}$ | $\tilde{u}_{4}$ | $\tilde{u}_{3}$ | $\tilde{u}_{2}$ | $\tilde{u}_{1}$ | $\tilde{1}$ |
| $y_{0,q}$ | 0 | 0 | 0 | 0 | 0 | 0 | 0 | 0 | 0 | 0 | 0 | 0 | 0 | 0 | 0 | 0 |
| $y_{2,q}$ | 1 | 1 | 1 | 1 | 1 | 1 | 1 | 1 | 1 | 1 | 1 | 1 | 1 | 1 | 1 | 1 |
| $y_{4,q}$ | 0 | 0 | 0 | 0 | 0 | 0 | 0 | 0 | 1 | 1 | 1 | 1 | 1 | 1 | 1 | 1 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $\mathrm{Re}(z_q)$ | 1 | $u_{1}$ | $u_{2}$ | $u_{3}$ | $u_{4}$ | $u_{5}$ | $u_{6}$ | $u_{7}$ | $u_{8}$ | $u_{9}$ | $u_{10}$ | $u_{11}$ | $u_{12}$ | $u_{13}$ | $u_{14}$ | $u_{15}$ |
| $y_{0,q}$ | 0 | 0 | 0 | 0 | 0 | 0 | 0 | 0 | 0 | 0 | 0 | 0 | 0 | 0 | 0 | 0 |
| $y_{2,q}$ | 0 | 0 | 0 | 0 | 0 | 0 | 0 | 0 | 0 | 0 | 0 | 0 | 0 | 0 | 0 | 0 |
| $y_{4,q}$ | 1 | 1 | 1 | 1 | 1 | 1 | 1 | 1 | 0 | 0 | 0 | 0 | 0 | 0 | 0 | 0 |
| $y_{6,q}$ | 0 | 0 | 0 | 0 | 1 | 1 | 1 | 1 | 1 | 1 | 1 | 1 | 0 | 0 | 0 | 0 |
| $y_{8,q}$ | 0 | 0 | 1 | 1 | 1 | 1 | 0 | 0 | 0 | 0 | 1 | 1 | 1 | 1 | 0 | 0 |
| $y_{10,q}$ | 0 | 1 | 1 | 0 | 0 | 1 | 1 | 0 | 0 | 1 | 1 | 0 | 0 | 1 | 1 | 0 |
| $\mathrm{Re}(z_q)$ | $u_{16}$ | $u_{17}$ | $u_{18}$ | $u_{19}$ | $u_{20}$ | $u_{21}$ | $u_{22}$ | $u_{23}$ | $u_{24}$ | $u_{25}$ | $u_{26}$ | $u_{27}$ | $u_{28}$ | $u_{29}$ | $u_{30}$ | $u_{31}$ |

**B**

| $y_{1,q}$ | 1 | 1 | 1 | 1 | 1 | 1 | 1 | 1 | 1 | 1 | 1 | 1 | 1 | 1 | 1 | 1 |
|---|---|---|---|---|---|---|---|---|---|---|---|---|---|---|---|---|
| $y_{3,q}$ | 0 | 0 | 0 | 0 | 0 | 0 | 0 | 0 | 0 | 0 | 0 | 0 | 0 | 0 | 0 | 0 |
| $y_{5,q}$ | 0 | 0 | 0 | 0 | 0 | 0 | 0 | 0 | 1 | 1 | 1 | 1 | 1 | 1 | 1 | 1 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $\mathrm{Im}(z_q)$ | $-u_{31}$ | $-u_{30}$ | $-u_{29}$ | $-u_{28}$ | $-u_{27}$ | $-u_{26}$ | $-u_{25}$ | $-u_{24}$ | $-u_{23}$ | $-u_{22}$ | $-u_{21}$ | $-u_{20}$ | $-u_{19}$ | $-u_{18}$ | $-u_{17}$ | $-u_{16}$ |
| $y_{1,q}$ | 1 | 1 | 1 | 1 | 1 | 1 | 1 | 1 | 1 | 1 | 1 | 1 | 1 | 1 | 1 | 1 |
| $y_{3,q}$ | 1 | 1 | 1 | 1 | 1 | 1 | 1 | 1 | 1 | 1 | 1 | 1 | 1 | 1 | 1 | 1 |
| $y_{5,q}$ | 1 | 1 | 1 | 1 | 1 | 1 | 1 | 1 | 0 | 0 | 0 | 0 | 0 | 0 | 0 | 0 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $\mathrm{Im}(z_q)$ | $-u_{15}$ | $-u_{14}$ | $-u_{13}$ | $-u_{12}$ | $-u_{11}$ | $-u_{10}$ | $-u_{9}$ | $-u_{8}$ | $-u_{7}$ | $-u_{6}$ | $-u_{5}$ | $-u_{4}$ | $-u_{3}$ | $-u_{2}$ | $-u_{1}$ | $-1$ |
| $y_{1,q}$ | 0 | 0 | 0 | 0 | 0 | 0 | 0 | 0 | 0 | 0 | 0 | 0 | 0 | 0 | 0 | 0 |
| $y_{3,q}$ | 1 | 1 | 1 | 1 | 1 | 1 | 1 | 1 | 1 | 1 | 1 | 1 | 1 | 1 | 1 | 1 |
| $y_{5,q}$ | 0 | 0 | 0 | 0 | 0 | 0 | 0 | 0 | 1 | 1 | 1 | 1 | 1 | 1 | 1 | 1 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $\mathrm{Im}(z_q)$ | 1 | $u_{1}$ | $u_{2}$ | $u_{3}$ | $u_{4}$ | $u_{5}$ | $u_{6}$ | $u_{7}$ | $u_{8}$ | $u_{9}$ | $u_{10}$ | $u_{11}$ | $u_{12}$ | $u_{13}$ | $u_{14}$ | $u_{15}$ |
| $y_{1,q}$ | 0 | 0 | 0 | 0 | 0 | 0 | 0 | 0 | 0 | 0 | 0 | 0 | 0 | 0 | 0 | 0 |
| $y_{3,q}$ | 0 | 0 | 0 | 0 | 0 | 0 | 0 | 0 | 0 | 0 | 0 | 0 | 0 | 0 | 0 | 0 |
| $y_{5,q}$ | 1 | 1 | 1 | 1 | 1 | 1 | 1 | 1 | 0 | 0 | 0 | 0 | 0 | 0 | 0 | 0 |
| $y_{7,q}$ | 0 | 0 | 0 | 0 | 1 | 1 | 1 | 1 | 1 | 1 | 1 | 1 | 0 | 0 | 0 | 0 |
| $y_{9,q}$ | 0 | 0 | 1 | 1 | 1 | 1 | 0 | 0 | 0 | 0 | 1 | 1 | 1 | 1 | 0 | 0 |
| $y_{11,q}$ | 0 | 1 | 1 | 0 | 0 | 1 | 1 | 0 | 0 | 1 | 1 | 0 | 0 | 1 | 1 | 0 |
| $\mathrm{Im}(z_q)$ | $u_{16}$ | $u_{17}$ | $u_{18}$ | $u_{19}$ | $u_{20}$ | $u_{21}$ | $u_{22}$ | $u_{23}$ | $u_{24}$ | $u_{25}$ | $u_{26}$ | $u_{27}$ | $u_{28}$ | $u_{29}$ | $u_{30}$ | $u_{31}$ |

FIG. 98

FIG. 99

# FIG. 100

## FIG. 101

| w/Shape | NUC_16_5/15 | NUC_16_6/15 | NUC_16_7/15 | NUC_16_8/15 |
|---|---|---|---|---|
| w0 | 0.3192 + 0.5011i | 0.5115 + 1.2092i | 0.2593 + 0.489i | 0.2535 + 0.4923i |
| w1 | 0.5011 + 0.3192i | 1.2092 + 0.5115i | 0.489 + 0.2593i | 0.4923 + 0.2535i |
| w2 | 0.5575 + 1.1559i | 0.2663 + 0.453i | 0.5074 + 1.1984i | 0.4927 + 1.2044i |
| w3 | 1.1559 + 0.5575i | 0.453 + 0.2663i | 1.1984 + 0.5074i | 1.2044 + 0.4927i |

| w/Shape | NUC_16_9/15 | NUC_16_10/15 | NUC_16_11/15 | NUC_16_12/15 | NUC_16_13/15 |
|---|---|---|---|---|---|
| w0 | 0.2386 + 0.5296i | 0.4487 + 1.1657i | 0.9342 + 0.9847i | 0.9555 + 0.9555i | 0.9517 + 0.9511i |
| w1 | 0.5296 + 0.2386i | 1.208 + 0.5377i | 0.9866 + 0.2903i | 0.9555 + 0.2949i | 0.9524 + 0.3061i |
| w2 | 0.4882 + 1.1934i | 0.2213 + 0.4416i | 0.2716 + 0.9325i | 0.2949 + 0.9555i | 0.3067 + 0.9524i |
| w3 | 1.1934 + 0.4882i | 0.6186 + 0.2544i | 0.2901 + 0.2695i | 0.2949 + 0.2949i | 0.3061 + 0.3067i |

EP 3 247 043 A1

# FIG. 102

| w/Shape | NUC_64_5/15 | NUC_64_6/15 | NUC_64_7/15 | NUC_64_8/15 |
|---|---|---|---|---|
| w0 | 1.4327 + 0.3305i | 1.4521 + 0.3005i | 0.1567 + 0.3112i | 1.4827 + 0.292i |
| w1 | 1.0909 + 0.2971i | 1.2657 + 0.8178i | 0.1709 + 0.3037i | 1.2563 + 0.8411i |
| w2 | 1.2484 + 0.7803i | 1.0666 + 0.2744i | 0.2093 + 0.6562i | 1.0211 + 0.2174i |
| w3 | 0.9762 + 0.5715i | 0.95 + 0.5641i | 0.3315 + 0.6038i | 0.8798 + 0.5702i |
| w4 | 0.3309 + 1.4326i | 0.3011 + 1.4529i | 0.3112 + 0.1567i | 0.292 + 1.4827i |
| w5 | 0.2979 + 1.0923i | 0.8202 + 1.2651i | 0.3037 + 0.1709i | 0.841 + 1.2563i |
| w6 | 0.7829 + 1.2477i | 0.275 + 1.0676i | 0.6562 + 0.2093i | 0.2174 + 1.0211i |
| w7 | 0.5739 + 0.9763i | 0.5656 + 0.9499i | 0.6038 + 0.3315i | 0.5702 + 0.8798i |
| w8 | 0.3901 + 0.2112i | 0.3553 + 0.1948i | 0.2959 + 1.4877i | 0.304 + 0.1475i |
| w9 | 0.5317 + 0.2475i | 0.3569 + 0.2094i | 0.8427 + 1.2612i | 0.3028 + 0.1691i |
| w10 | 0.3945 + 0.2289i | 0.5596 + 0.2431i | 0.2389 + 1.0228i | 0.6855 + 0.1871i |
| w11 | 0.5236 + 0.2894i | 0.541 + 0.3002i | 0.5559 + 0.8912i | 0.6126 + 0.3563i |
| w12 | 0.2108 + 0.3911i | 0.1946 + 0.3566i | 1.4877 + 0.2959i | 0.1475 + 0.304i |
| w13 | 0.2475 + 0.5327i | 0.2094 + 0.3579i | 1.2612 + 0.8427i | 0.1691 + 0.3028i |
| w14 | 0.2287 + 0.3955i | 0.243 + 0.5607i | 1.0228 + 0.2389i | 0.1871 + 0.6855i |
| w15 | 0.2898 + 0.5246i | 0.3004 + 0.5417i | 0.8912 + 0.5559i | 0.3563 + 0.6126i |

| w/Shape | NUC_64_9/15 | NUC_64_10/15 | NUC_64_11/15 | NUC_64_12/15 | NUC_64_13/15 |
|---|---|---|---|---|---|
| w0 | 0.1305 + 0.3311i | 0.1177 + 0.1729i | 1.4443 + 0.2683i | 1.448 + 0.2403i | 1.4319 + 0.23i |
| w1 | 0.1633 + 0.3162i | 0.1601 + 0.3212i | 0.7471 + 1.2243i | 0.6406 + 1.1995i | 1.0762 + 0.925i |
| w2 | 0.1622 + 0.7113i | 0.1352 + 0.7279i | 1.1749 + 0.7734i | 1.0952 + 0.9115i | 0.629 + 1.182i |
| w3 | 0.3905 + 0.6163i | 0.3246 + 0.6148i | 0.7138 + 0.8201i | 0.6868 + 0.8108i | 0.6851 + 0.8072i |
| w4 | 0.3311 + 0.1305i | 0.4192 + 0.1179i | 0.1638 + 1.0769i | 1.05 + 0.1642i | 1.0443 + 0.1688i |
| w5 | 0.3162 + 0.1633i | 0.4033 + 0.2421i | 0.2927 + 1.4217i | 0.717 + 0.1473i | 1.0635 + 0.5305i |
| w6 | 0.7113 + 0.1622i | 0.7524 + 0.1581i | 0.1462 + 0.7457i | 1.0519 + 0.5188i | 0.722 + 0.154i |
| w7 | 0.6163 + 0.3905i | 0.5996 + 0.433i | 0.4134 + 0.7408i | 0.7146 + 0.4532i | 0.7151 + 0.4711i |
| w8 | 0.2909 + 1.4626i | 0.2902 + 1.4611i | 1.0203 + 0.1517i | 0.1677 + 1.0405i | 0.2099 + 1.4205i |
| w9 | 0.8285 + 1.2399i | 0.818 + 1.2291i | 0.6653 + 0.1357i | 0.2402 + 1.4087i | 0.119 + 0.6677i |
| w10 | 0.2062 + 1.0367i | 0.2036 + 1.0575i | 0.9639 + 0.4465i | 0.1369 + 0.7073i | 0.2031 + 1.0551i |
| w11 | 0.5872 + 0.8789i | 0.5641 + 0.8965i | 0.6746 + 0.4339i | 0.4044 + 0.7057i | 0.3722 + 0.7548i |
| w12 | 1.4626 + 0.2909i | 1.4453 + 0.2907i | 0.1271 + 0.1428i | 0.1374 + 0.1295i | 0.1438 + 0.1287i |
| w13 | 1.2399 + 0.8285i | 1.2157 + 0.8186i | 0.3782 + 0.1406i | 0.4185 + 0.1357i | 0.1432 + 0.3903i |
| w14 | 1.0367 + 0.2062i | 1.0447 + 0.2242i | 0.1311 + 0.4288i | 0.1325 + 0.3998i | 0.4298 + 0.1384i |
| w15 | 0.8789 + 0.5872i | 0.8497 + 0.6176i | 0.3919 + 0.4276i | 0.4122 + 0.412i | 0.4215 + 0.4279i |

# FIG. 103

| w/Shape | NUC_256_5/15 | NUC_256_6/15 | NUC_256_7/15 | NUC_256_8/15 |
|---|---|---|---|---|
| w0 | 0.1524 + 0.3087i | 0.143 + 0.3078i | 0.117 + 0.3003i | 0.0995 + 0.2435i |
| w1 | 0.1525 + 0.3087i | 0.143 + 0.3077i | 0.1171 + 0.3003i | 0.0996 + 0.2434i |
| w2 | 0.1513 + 0.3043i | 0.1413 + 0.3003i | 0.1204 + 0.3233i | 0.1169 + 0.3886i |
| w3 | 0.1513 + 0.3043i | 0.1414 + 0.3002i | 0.1204 + 0.3233i | 0.1179 + 0.3883i |
| w4 | 0.1682 + 0.3004i | 0.1637 + 0.2973i | 0.1454 + 0.2877i | 0.1192 + 0.2345i |
| w5 | 0.1682 + 0.3005i | 0.1636 + 0.2973i | 0.1453 + 0.2877i | 0.1192 + 0.2345i |
| w6 | 0.1663 + 0.2964i | 0.1604 + 0.2905i | 0.1566 + 0.3074i | 0.1953 + 0.3558i |
| w7 | 0.1663 + 0.2964i | 0.1603 + 0.2905i | 0.1565 + 0.3074i | 0.1944 + 0.3563i |
| w8 | 0.1964 + 0.6584i | 0.1768 + 0.6686i | 0.1427 + 0.6856i | 0.1293 + 0.7217i |
| w9 | 0.1965 + 0.6583i | 0.1793 + 0.6679i | 0.1582 + 0.6826i | 0.1616 + 0.7151i |
| w10 | 0.1967 + 0.6652i | 0.1769 + 0.6707i | 0.1422 + 0.6584i | 0.1287 + 0.6355i |
| w11 | 0.1968 + 0.6652i | 0.1793 + 0.67i | 0.1529 + 0.656i | 0.1456 + 0.6318i |
| w12 | 0.3371 + 0.5987i | 0.3506 + 0.5981i | 0.384 + 0.5856i | 0.4191 + 0.6016i |
| w13 | 0.337 + 0.5987i | 0.3484 + 0.5974i | 0.3723 + 0.5931i | 0.3916 + 0.6198i |
| w14 | 0.3414 + 0.6039i | 0.3523 + 0.5975i | 0.3651 + 0.566i | 0.3585 + 0.5403i |
| w15 | 0.3413 + 0.6039i | 0.3501 + 0.5987i | 0.3559 + 0.5718i | 0.3439 + 0.5497i |
| w16 | 0.3087 + 0.1524i | 0.3078 + 0.143i | 0.3003 + 0.117i | 0.2435 + 0.0995i |
| w17 | 0.3087 + 0.1525i | 0.3077 + 0.143i | 0.3003 + 0.1171i | 0.2434 + 0.0996i |
| w18 | 0.3043 + 0.1513i | 0.3003 + 0.1413i | 0.3233 + 0.1204i | 0.3886 + 0.1169i |
| w19 | 0.3043 + 0.1513i | 0.3002 + 0.1414i | 0.3233 + 0.1204i | 0.3883 + 0.1179i |
| w20 | 0.3004 + 0.1682i | 0.2973 + 0.1637i | 0.2877 + 0.1454i | 0.2345 + 0.1192i |
| w21 | 0.3005 + 0.1682i | 0.2973 + 0.1636i | 0.2877 + 0.1453i | 0.2345 + 0.1192i |
| w22 | 0.2964 + 0.1663i | 0.2905 + 0.1604i | 0.3074 + 0.1566i | 0.3558 + 0.1953i |
| w23 | 0.2964 + 0.1663i | 0.2905 + 0.1603i | 0.3074 + 0.1565i | 0.3563 + 0.1944i |
| w24 | 0.6584 + 0.1964i | 0.6686 + 0.1768i | 0.6856 + 0.1427i | 0.7217 + 0.1293i |
| w25 | 0.6583 + 0.1965i | 0.6679 + 0.1793i | 0.6826 + 0.1582i | 0.7151 + 0.1616i |
| w26 | 0.6652 + 0.1967i | 0.6707 + 0.1769i | 0.6584 + 0.1422i | 0.6355 + 0.1287i |
| w27 | 0.6652 + 0.1968i | 0.67 + 0.1793i | 0.656 + 0.1529i | 0.6318 + 0.1456i |
| w28 | 0.5987 + 0.3371i | 0.5981 + 0.3506i | 0.5856 + 0.384i | 0.6016 + 0.4191i |
| w29 | 0.5987 + 0.337i | 0.5974 + 0.3484i | 0.5931 + 0.3723i | 0.6198 + 0.3916i |
| w30 | 0.6039 + 0.3414i | 0.5975 + 0.3523i | 0.566 + 0.3651i | 0.5403 + 0.3585i |
| w31 | 0.6039 + 0.3413i | 0.5987 + 0.3501i | 0.5718 + 0.3559i | 0.5497 + 0.3439i |
| w32 | 0.3183 + 1.5992i | 0.2071 + 1.669i | 0.1683 + 1.7041i | 0.1665 + 1.6859i |
| w33 | 0.3186 + 1.5991i | 0.4482 + 1.621i | 0.4972 + 1.6388i | 0.4919 + 1.6211i |
| w34 | 0.2756 + 1.3848i | 0.208 + 1.3641i | 0.1495 + 1.356i | 0.138 + 1.3498i |
| w35 | 0.2759 + 1.3847i | 0.3207 + 1.3397i | 0.3814 + 1.3099i | 0.3914 + 1.2989i |
| w36 | 0.906 + 1.3557i | 1.0341 + 1.3264i | 1.0862 + 1.3238i | 1.0746 + 1.3096i |
| w37 | 0.9058 + 1.3559i | 0.8297 + 1.463i | 0.8074 + 1.5101i | 0.7987 + 1.494i |
| w38 | 0.7846 + 1.1739i | 0.8178 + 1.1114i | 0.8534 + 1.0644i | 0.8585 + 1.0504i |
| w39 | 0.7843 + 1.1741i | 0.7138 + 1.1809i | 0.6568 + 1.1958i | 0.6419 + 1.1951i |
| w40 | 0.2257 + 0.9956i | 0.1957 + 0.9674i | 0.1552 + 0.9481i | 0.1334 + 0.9483i |
| w41 | 0.2259 + 0.9956i | 0.217 + 0.9629i | 0.22 + 0.9352i | 0.2402 + 0.9271i |
| w42 | 0.2276 + 1.0326i | 0.1977 + 1.0341i | 0.1577 + 1.0449i | 0.1323 + 1.0786i |
| w43 | 0.2278 + 1.0326i | 0.2288 + 1.0277i | 0.2548 + 1.0255i | 0.291 + 1.047i |
| w44 | 0.5446 + 0.8635i | 0.5458 + 0.8224i | 0.5609 + 0.78i | 0.5784 + 0.7848i |
| w45 | 0.5445 + 0.8636i | 0.5276 + 0.8342i | 0.506 + 0.8167i | 0.486 + 0.8252i |
| w46 | 0.5694 + 0.891i | 0.5916 + 0.8709i | 0.6276 + 0.8501i | 0.6693 + 0.8561i |
| w47 | 0.5692 + 0.8911i | 0.5651 + 0.8883i | 0.5452 + 0.9052i | 0.5348 + 0.9459i |
| w48 | 1.5992 + 0.3183i | 1.669 + 0.2071i | 1.7041 + 0.1683i | 1.6859 + 0.1665i |
| w49 | 1.5991 + 0.3186i | 1.621 + 0.4482i | 1.6388 + 0.4972i | 1.6211 + 0.4919i |
| w50 | 1.3848 + 0.2756i | 1.3641 + 0.208i | 1.356 + 0.1495i | 1.3498 + 0.136i |
| w51 | 1.3847 + 0.2759i | 1.3397 + 0.3207i | 1.3099 + 0.3814i | 1.2989 + 0.3914i |
| w52 | 1.3557 + 0.906i | 1.3264 + 1.0341i | 1.3238 + 1.0862i | 1.3096 + 1.0746i |
| w53 | 1.3559 + 0.9058i | 1.463 + 0.8297i | 1.5101 + 0.8074i | 1.494 + 0.7987i |
| w54 | 1.1739 + 0.7846i | 1.1114 + 0.8178i | 1.0644 + 0.8534i | 1.0504 + 0.8585i |
| w55 | 1.1741 + 0.7843i | 1.1809 + 0.7138i | 1.1958 + 0.6568i | 1.1951 + 0.6419i |
| w56 | 0.9956 + 0.2257i | 0.9674 + 0.1957i | 0.9481 + 0.1552i | 0.9483 + 0.1334i |
| w57 | 0.9956 + 0.2259i | 0.9629 + 0.217i | 0.9352 + 0.22i | 0.9271 + 0.2402i |
| w58 | 1.0326 + 0.2276i | 1.0341 + 0.1977i | 1.0449 + 0.1577i | 1.0786 + 0.1323i |
| w59 | 1.0326 + 0.2278i | 1.0277 + 0.2288i | 1.0255 + 0.2548i | 1.047 + 0.291i |
| w60 | 0.8635 + 0.5446i | 0.8224 + 0.5458i | 0.78 + 0.5609i | 0.7848 + 0.5764i |
| w61 | 0.8636 + 0.5445i | 0.8342 + 0.5276i | 0.8167 + 0.506i | 0.8252 + 0.486i |
| w62 | 0.891 + 0.5694i | 0.8709 + 0.5916i | 0.8501 + 0.6276i | 0.8561 + 0.6693i |
| w63 | 0.8911 + 0.5692i | 0.8883 + 0.5651i | 0.9052 + 0.5452i | 0.9459 + 0.5348i |

# FIG. 104

| w/Shape | NUC_256_9/15 | NUC_256_10/15 | NUC_256_11/15 | NUC_256_12/15 | NUC_256_13/15 |
|---|---|---|---|---|---|
| w0 | 0.0899 + 0.1337i | 0.0754 + 0.231i | 0.0593 + 0.2193i | 1.198 + 1.1541i | 1.2412 + 1.0688i |
| w1 | 0.091 + 0.1377i | 0.0768 + 0.2305i | 0.069 + 0.3047i | 0.9192 + 1.2082i | 1.2668 + 0.8034i |
| w2 | 0.0873 + 0.3862i | 0.0924 + 0.4136i | 0.0663 + 0.4879i | 1.2778 + 0.8523i | 0.986 + 1.1758i |
| w3 | 0.0883 + 0.3873i | 0.1043 + 0.4125i | 0.1151 + 0.4474i | 1.039 + 0.9253i | 1.0365 + 0.9065i |
| w4 | 0.1115 + 0.1442i | 0.0829 + 0.1135i | 0.1689 + 0.2163i | 0.6057 + 1.22i | 1.2111 + 0.5135i |
| w5 | 0.1135 + 0.1472i | 0.0836 + 0.1149i | 0.1971 + 0.2525i | 0.7371 + 1.4217i | 1.4187 + 0.6066i |
| w6 | 0.2067 + 0.3591i | 0.2682 + 0.3856i | 0.3096 + 0.3796i | 0.6678 + 1.0021i | 1.0103 + 0.4879i |
| w7 | 0.1975 + 0.3621i | 0.2531 + 0.3906i | 0.2489 + 0.3933i | 0.8412 + 0.9448i | 1.038 + 0.6906i |
| w8 | 0.1048 + 0.7533i | 0.0836 + 0.7817i | 0.079 + 0.797i | 1.2128 + 0.5373i | 0.6963 + 1.3442i |
| w9 | 0.177 + 0.7412i | 0.2052 + 0.7808i | 0.234 + 0.771i | 1.0048 + 0.5165i | 0.7089 + 1.1122i |
| w10 | 0.1022 + 0.5904i | 0.0838 + 0.6034i | 0.0723 + 0.6395i | 1.4321 + 0.6343i | 0.1256 + 1.4745i |
| w11 | 0.1191 + 0.589i | 0.1394 + 0.5961i | 0.1896 + 0.6163i | 1.0245 + 0.7152i | 0.8331 + 0.9455i |
| w12 | 0.4284 + 0.623i | 0.4861 + 0.6331i | 0.509 + 0.6272i | 0.6384 + 0.6073i | 0.6615 + 0.6012i |
| w13 | 0.385 + 0.6689i | 0.3661 + 0.7034i | 0.3787 + 0.7126i | 0.8175 + 0.5684i | 0.6894 + 0.7594i |
| w14 | 0.3254 + 0.5153i | 0.3732 + 0.5159i | 0.4079 + 0.5049i | 0.6568 + 0.7801i | 0.8373 + 0.5633i |
| w15 | 0.2959 + 0.5302i | 0.3095 + 0.5511i | 0.3088 + 0.5677i | 0.8311 + 0.7459i | 0.8552 + 0.741i |
| w16 | 0.3256 + 0.0768i | 0.303 + 0.0811i | 0.0675 + 0.0826i | 0.1349 + 1.4742i | 1.2666 + 0.1027i |
| w17 | 0.3266 + 0.087i | 0.3017 + 0.0853i | 0.3475 + 0.0595i | 0.1105 + 1.2309i | 1.4915 + 0.1198i |
| w18 | 0.4721 + 0.0994i | 0.4758 + 0.0932i | 0.5482 + 0.0626i | 0.0634 + 0.9796i | 1.0766 + 0.0945i |
| w19 | 0.4721 + 0.1206i | 0.4676 + 0.1242i | 0.4784 + 0.1124i | 0.1891 + 1.0198i | 0.9007 + 0.0848i |
| w20 | 0.2927 + 0.1267i | 0.2425 + 0.1081i | 0.1674 + 0.0751i | 0.4142 + 1.4461i | 1.2454 + 0.3064i |
| w21 | 0.2947 + 0.1296i | 0.2447 + 0.1115i | 0.2856 + 0.1132i | 0.3323 + 1.2279i | 1.4646 + 0.36i |
| w22 | 0.3823 + 0.2592i | 0.3837 + 0.2813i | 0.4134 + 0.3028i | 0.4998 + 0.9827i | 1.057 + 0.2995i |
| w23 | 0.3944 + 0.2521i | 0.3959 + 0.2642i | 0.4235 + 0.2289i | 0.3467 + 1.0202i | 0.914 + 0.253i |
| w24 | 0.7755 + 0.1118i | 0.7929 + 0.0859i | 0.8258 + 0.084i | 0.068 + 0.6501i | 0.5461 + 0.0679i |
| w25 | 0.7513 + 0.2154i | 0.7652 + 0.2324i | 0.7936 + 0.2483i | 0.2016 + 0.6464i | 0.5681 + 0.1947i |
| w26 | 0.6591 + 0.1033i | 0.6365 + 0.0872i | 0.6788 + 0.0783i | 0.0719 + 0.8075i | 0.6874 + 0.0537i |
| w27 | 0.6446 + 0.1787i | 0.6207 + 0.1757i | 0.6501 + 0.2025i | 0.2088 + 0.8146i | 0.7875 + 0.1492i |
| w28 | 0.5906 + 0.493i | 0.6149 + 0.5145i | 0.6246 + 0.5211i | 0.4809 + 0.6296i | 0.629 + 0.4553i |
| w29 | 0.6538 + 0.4155i | 0.6987 + 0.3934i | 0.7241 + 0.3961i | 0.3374 + 0.6412i | 0.6007 + 0.3177i |
| w30 | 0.4981 + 0.3921i | 0.5063 + 0.4029i | 0.5144 + 0.4089i | 0.4955 + 0.8008i | 0.7885 + 0.4231i |
| w31 | 0.5373 + 0.3586i | 0.5526 + 0.3356i | 0.5918 + 0.3146i | 0.3431 + 0.8141i | 0.7627 + 0.2849i |
| w32 | 0.163 + 1.6621i | 0.1598 + 1.6262i | 0.1631 + 1.5801i | 1.2731 + 0.1108i | 0.0816 + 1.1632i |
| w33 | 0.472 + 1.5898i | 0.4733 + 1.5637i | 0.4806 + 1.5133i | 1.0794 + 0.0977i | 0.083 + 0.9813i |
| w34 | 0.1268 + 1.3488i | 0.1307 + 1.3502i | 0.128 + 1.3365i | 1.5126 + 0.1256i | 0.2528 + 1.2315i |
| w35 | 0.3752 + 1.2961i | 0.3877 + 1.2983i | 0.375 + 1.2897i | 0.9029 + 0.0853i | 0.2502 + 1.01i |
| w36 | 1.0398 + 1.2991i | 1.0328 + 1.2617i | 1.0324 + 1.2029i | 0.5429 + 0.0694i | 0.0732 + 0.6827i |
| w37 | 0.7733 + 1.4772i | 0.7675 + 1.4398i | 0.7737 + 1.3837i | 0.6795 + 0.0559i | 0.0811 + 0.8293i |
| w38 | 0.838 + 1.0552i | 0.8496 + 1.0508i | 0.835 + 1.0529i | 0.5628 + 0.1945i | 0.2159 + 0.6673i |
| w39 | 0.6242 + 1.2081i | 0.6297 + 1.1967i | 0.6147 + 1.1949i | 0.7326 + 0.141i | 0.2359 + 0.8283i |
| w40 | 0.1103 + 0.9397i | 0.091 + 0.9531i | 0.0929 + 0.9596i | 1.2283 + 0.3217i | 0.4302 + 1.4458i |
| w41 | 0.2415 + 0.9155i | 0.2849 + 0.9198i | 0.2768 + 0.926i | 1.0269 + 0.3261i | 0.5852 + 0.968i |
| w42 | 0.1118 + 1.1163i | 0.108 + 1.134i | 0.1095 + 1.1349i | 1.4663 + 0.3716i | 0.4528 + 1.2074i |
| w43 | 0.3079 + 1.0866i | 0.3214 + 1.0926i | 0.325 + 1.0941i | 0.9085 + 0.247i | 0.4167 + 1.0099i |
| w44 | 0.5647 + 0.7838i | 0.5941 + 0.7527i | 0.6086 + 0.7556i | 0.616 + 0.4549i | 0.5035 + 0.6307i |
| w45 | 0.4385 + 0.8433i | 0.4371 + 0.8528i | 0.4514 + 0.8566i | 0.7818 + 0.4247i | 0.5359 + 0.7954i |
| w46 | 0.6846 + 0.8841i | 0.7093 + 0.888i | 0.7161 + 0.8933i | 0.5938 + 0.317i | 0.358 + 0.6532i |
| w47 | 0.5165 + 1.0034i | 0.5235 + 1.009i | 0.5294 + 1.0121i | 0.76 + 0.285i | 0.3841 + 0.8207i |
| w48 | 1.6489 + 0.163i | 1.618 + 0.1602i | 1.5809 + 0.1471i | 0.0595 + 0.0707i | 0.0576 + 0.0745i |
| w49 | 1.5848 + 0.4983i | 1.554 + 0.4734i | 1.5253 + 0.4385i | 0.1722 + 0.0706i | 0.0581 + 0.2241i |
| w50 | 1.3437 + 0.1389i | 1.3411 + 0.1336i | 1.338 + 0.1363i | 0.0599 + 0.2119i | 0.172 + 0.0742i |
| w51 | 1.285 + 0.4025i | 1.2883 + 0.3955i | 1.2837 + 0.4026i | 0.1748 + 0.2114i | 0.1753 + 0.2222i |
| w52 | 1.2728 + 1.0661i | 1.2561 + 1.0337i | 1.2476 + 0.9785i | 0.4134 + 0.0701i | 0.0652 + 0.5269i |
| w53 | 1.4509 + 0.7925i | 1.4311 + 0.7676i | 1.4137 + 0.7196i | 0.2935 + 0.0705i | 0.0611 + 0.3767i |
| w54 | 1.0249 + 0.8794i | 1.0362 + 0.8626i | 1.0246 + 0.8681i | 0.4231 + 0.2066i | 0.1972 + 0.5178i |
| w55 | 1.1758 + 0.6545i | 1.1845 + 0.6419i | 1.1771 + 0.6494i | 0.2979 + 0.21i | 0.1838 + 0.3695i |
| w56 | 0.9629 + 0.1113i | 0.9546 + 0.0957i | 0.9782 + 0.0985i | 0.0638 + 0.5002i | 0.4145 + 0.0709i |
| w57 | 0.9226 + 0.2849i | 0.9163 + 0.2834i | 0.9383 + 0.2922i | 0.1905 + 0.4966i | 0.4266 + 0.21i |
| w58 | 1.1062 + 0.1118i | 1.1282 + 0.1128i | 1.1455 + 0.1158i | 0.0612 + 0.3552i | 0.2912 + 0.073i |
| w59 | 1.0874 + 0.3393i | 1.0838 + 0.334i | 1.0972 + 0.3418i | 0.181 + 0.3533i | 0.2292 + 0.2177i |
| w60 | 0.7234 + 0.6223i | 0.7329 + 0.6204i | 0.7446 + 0.6273i | 0.463 + 0.4764i | 0.4766 + 0.4821i |
| w61 | 0.8211 + 0.486i | 0.8428 + 0.4615i | 0.8573 + 0.4721i | 0.3231 + 0.4895i | 0.4497 + 0.3448i |
| w62 | 0.8457 + 0.726i | 0.868 + 0.7295i | 0.8787 + 0.7377i | 0.4416 + 0.3397i | 0.3334 + 0.5025i |
| w63 | 0.964 + 0.5518i | 0.9959 + 0.5426i | 1.0059 + 0.5518i | 0.3083 + 0.349i | 0.3125 + 0.3601i |

# FIG. 105

## FIG. 106

| | N=64800 | | | | | |
|---|---|---|---|---|---|---|
| | QPSK | 16QAM | 64QAM | 256QAM | 1024QAM | 4096QAM |
| C | 2 | 4 | 6 | 8 | 10 | 12 |
| R1 | 32400 | 16200 | 10800 | 7920 | 6480 | 5400 |
| R2 | 0 | 0 | 0 | 180 | 0 | 0 |

| | N=16200 | | | | | |
|---|---|---|---|---|---|---|
| | QPSK | 16QAM | 64QAM | 256QAM | 1024QAM | 4096QAM |
| C | 2 | 4 | 6 | 8 | 10 | 12 |
| R1 | 7920 | 3960 | 2520 | 1800 | 1440 | 1080 |
| R2 | 180 | 90 | 180 | 225 | 180 | 270 |

C: column NUMBER (SYMBOL BIT NUMBER)
R1: ROW NUMBER OF Part1
R2: ROW NUMBER OF Part2

EP 3 247 043 A1

# FIG. 107

## FIG. 108

EP 3 247 043 A1

*FIG. 109*

BIT GROUP

205

# FIG. 110

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 6 | 14 | 1 | 127 | 161 | 177 | 75 | 123 | 62 | 103 | 17 | 18 | 167 | 88 | 27 | 34 | 8 | 110 | 7 | 78 | 94 | 44 |
|---|---|---|---|---|---|---|---|---|---|---|---|---|---|---|---|---|---|---|---|---|---|
| 45 | 166 | 149 | 61 | 163 | 145 | 155 | 157 | 82 | 130 | 70 | 92 | 151 | 139 | 160 | 133 | 26 | 2 | 79 | 15 | 95 | 122 |
| 126 | 178 | 101 | 24 | 138 | 146 | 179 | 30 | 86 | 58 | 11 | 121 | 159 | 49 | 84 | 132 | 117 | 119 | 50 | 52 | 4 | 51 |
| 48 | 74 | 114 | 59 | 40 | 131 | 33 | 89 | 66 | 136 | 72 | 16 | 134 | 37 | 164 | 77 | 99 | 173 | 20 | 158 | 156 | 90 |
| 41 | 176 | 81 | 42 | 60 | 109 | 22 | 150 | 105 | 120 | 12 | 64 | 56 | 68 | 111 | 21 | 148 | 53 | 169 | 97 | 108 | 35 |
| 140 | 91 | 115 | 152 | 36 | 106 | 154 | 0 | 25 | 54 | 63 | 172 | 80 | 168 | 142 | 118 | 162 | 135 | 73 | 83 | 153 | 141 |
| 9 | 28 | 55 | 31 | 112 | 107 | 85 | 100 | 175 | 23 | 57 | 47 | 38 | 170 | 137 | 76 | 147 | 93 | 19 | 98 | 124 | 39 |
| 87 | 174 | 144 | 46 | 10 | 129 | 69 | 71 | 125 | 96 | 116 | 171 | 128 | 65 | 102 | 5 | 43 | 143 | 104 | 13 | 67 | 29 |
| 3 | 113 | 32 | 165 | | | | | | | | | | | | | | | | | | |

EP 3 247 043 A1

# FIG. 111

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 103 | 116 | 158 | 0 | 27 | 73 | 140 | 30 | 148 | 36 | 153 | 154 | 10 | 174 | 122 | 178 | 6 | 106 | 162 | 59 | 142 | 112 |
|---|---|---|---|---|---|---|---|---|---|---|---|---|---|---|---|---|---|---|---|---|---|
| 7 | 74 | 11 | 51 | 49 | 72 | 31 | 65 | 156 | 95 | 171 | 105 | 173 | 168 | 1 | 155 | 125 | 82 | 86 | 161 | 57 | 165 |
| 54 | 26 | 121 | 25 | 157 | 93 | 22 | 34 | 33 | 39 | 19 | 46 | 150 | 141 | 12 | 9 | 79 | 118 | 24 | 17 | 85 | 117 |
| 67 | 58 | 129 | 160 | 89 | 61 | 146 | 77 | 130 | 102 | 101 | 137 | 94 | 69 | 14 | 133 | 60 | 149 | 136 | 16 | 108 | 41 |
| 90 | 28 | 144 | 13 | 175 | 114 | 2 | 18 | 63 | 68 | 21 | 109 | 53 | 123 | 75 | 81 | 143 | 169 | 42 | 119 | 138 | 104 |
| 4 | 131 | 145 | 8 | 5 | 76 | 15 | 88 | 177 | 124 | 45 | 97 | 64 | 100 | 37 | 132 | 38 | 44 | 107 | 35 | 43 | 80 |
| 50 | 91 | 152 | 78 | 166 | 55 | 115 | 170 | 159 | 147 | 167 | 87 | 83 | 29 | 96 | 172 | 48 | 98 | 62 | 139 | 70 | 164 |
| 84 | 47 | 151 | 134 | 126 | 113 | 179 | 110 | 111 | 128 | 32 | 52 | 66 | 40 | 135 | 176 | 99 | 127 | 163 | 3 | 120 | 71 |
| 56 | 92 | 23 | 20 | | | | | | | | | | | | | | | | | | |

# FIG. 112

# FIG. 113

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 72 | 59 | 65 | 61 | 80 | 2 | 66 | 23 | 69 | 101 | 19 | 16 | 53 | 109 | 74 | 106 | 113 | 56 | 97 | 30 | 164 | 15 |
|---|---|---|---|---|---|---|---|---|---|---|---|---|---|---|---|---|---|---|---|---|---|
| 25 | 20 | 117 | 76 | 50 | 82 | 178 | 13 | 169 | 36 | 107 | 40 | 122 | 138 | 42 | 96 | 27 | 163 | 46 | 64 | 124 | 57 |
| 87 | 120 | 168 | 166 | 39 | 177 | 22 | 67 | 134 | 9 | 102 | 28 | 148 | 91 | 83 | 88 | 167 | 32 | 99 | 140 | 60 | 152 |
| 1 | 123 | 29 | 154 | 26 | 70 | 149 | 171 | 12 | 6 | 55 | 100 | 62 | 86 | 114 | 174 | 132 | 139 | 7 | 45 | 103 | 130 |
| 31 | 49 | 151 | 119 | 79 | 41 | 118 | 126 | 3 | 179 | 110 | 111 | 51 | 93 | 145 | 73 | 133 | 54 | 104 | 161 | 37 | 129 |
| 63 | 38 | 95 | 159 | 89 | 112 | 115 | 136 | 33 | 68 | 17 | 35 | 137 | 173 | 143 | 78 | 77 | 141 | 150 | 58 | 158 | 125 |
| 156 | 24 | 105 | 98 | 43 | 84 | 92 | 128 | 165 | 153 | 108 | 0 | 121 | 170 | 131 | 144 | 47 | 157 | 11 | 155 | 176 | 48 |
| 135 | 4 | 116 | 146 | 127 | 52 | 162 | 142 | 8 | 5 | 34 | 85 | 90 | 44 | 172 | 94 | 160 | 175 | 75 | 71 | 18 | 147 |
| 10 | 21 | 14 | 81 | | | | | | | | | | | | | | | | | | |

EP 3 247 043 A1

# FIG. 114

EP 3 247 043 A1

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

↕

| 8 | 27 | 7 | 70 | 75 | 84 | 50 | 131 | 146 | 99 | 96 | 141 | 155 | 157 | 82 | 57 | 120 | 38 | 137 | 13 | 83 | 23 |
|---|----|---|----|----|----|----|-----|-----|----|----|-----|-----|-----|----|----|-----|----|-----|----|----|----|
| 40 | 9 | 56 | 171 | 124 | 172 | 39 | 142 | 20 | 128 | 133 | 2 | 89 | 153 | 103 | 112 | 129 | 151 | 162 | 106 | 14 | 62 |
| 107 | 110 | 73 | 71 | 177 | 154 | 80 | 176 | 24 | 91 | 32 | 173 | 25 | 16 | 17 | 159 | 21 | 92 | 6 | 67 | 81 | 37 |
| 15 | 136 | 100 | 64 | 102 | 163 | 168 | 18 | 78 | 76 | 45 | 140 | 123 | 118 | 58 | 122 | 11 | 19 | 86 | 98 | 119 | 111 |
| 26 | 138 | 125 | 74 | 97 | 63 | 10 | 152 | 161 | 175 | 87 | 52 | 60 | 22 | 79 | 104 | 30 | 158 | 54 | 145 | 49 | 34 |
| 166 | 109 | 179 | 174 | 93 | 41 | 116 | 48 | 3 | 29 | 134 | 167 | 105 | 132 | 114 | 169 | 147 | 144 | 77 | 61 | 170 | 90 |
| 178 | 0 | 43 | 149 | 130 | 117 | 47 | 44 | 36 | 115 | 88 | 101 | 148 | 69 | 46 | 94 | 143 | 164 | 139 | 126 | 160 | 156 |
| 33 | 113 | 65 | 121 | 53 | 42 | 66 | 165 | 85 | 127 | 135 | 5 | 55 | 150 | 72 | 35 | 31 | 51 | 4 | 1 | 68 | 12 |
| 28 | 95 | 59 | 108 | | | | | | | | | | | | | | | | | | |

210

# FIG. 115

# FIG. 116

BIT GROUP

| | | | | | | | | | | | | | | | | | | | | | |
|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

$\Updownarrow$

| | | | | | | | | | | | | | | | | | | | | | |
|---|---|---|---|---|---|---|---|---|---|---|---|---|---|---|---|---|---|---|---|---|---|
| 11 | 5 | 8 | 18 | 1 | 25 | 32 | 31 | 19 | 21 | 50 | 102 | 65 | 85 | 45 | 86 | 98 | 104 | 64 | 78 | 72 | 53 |
| 103 | 79 | 93 | 41 | 82 | 108 | 112 | 116 | 120 | 124 | 128 | 132 | 136 | 140 | 144 | 148 | 152 | 156 | 160 | 164 | 168 | 172 |
| 176 | 4 | 12 | 15 | 3 | 10 | 20 | 26 | 34 | 23 | 33 | 68 | 63 | 69 | 92 | 44 | 90 | 75 | 56 | 100 | 47 | 106 |
| 42 | 39 | 97 | 99 | 89 | 52 | 109 | 113 | 117 | 121 | 125 | 129 | 133 | 137 | 141 | 145 | 149 | 153 | 157 | 161 | 165 | 169 |
| 173 | 177 | 6 | 16 | 14 | 7 | 13 | 36 | 28 | 29 | 37 | 73 | 70 | 54 | 76 | 91 | 66 | 80 | 88 | 51 | 96 | 81 |
| 95 | 38 | 57 | 105 | 107 | 59 | 61 | 110 | 114 | 118 | 122 | 126 | 130 | 134 | 138 | 142 | 146 | 150 | 154 | 158 | 162 | 166 |
| 170 | 174 | 178 | 0 | 9 | 17 | 2 | 27 | 30 | 24 | 22 | 35 | 77 | 74 | 46 | 94 | 62 | 87 | 83 | 101 | 49 | 43 |
| 84 | 48 | 60 | 67 | 71 | 58 | 40 | 55 | 111 | 115 | 119 | 123 | 127 | 131 | 135 | 139 | 143 | 147 | 151 | 155 | 159 | 163 |
| 167 | 171 | 175 | 179 | | | | | | | | | | | | | | | | | | |

FIG. 117

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 9 | 18 | 15 | 13 | 35 | 26 | 28 | 99 | 40 | 68 | 85 | 58 | 63 | 104 | 50 | 52 | 94 | 69 | 108 | 114 | 120 | 126 |
|---|----|----|----|----|----|----|----|----|----|----|----|----|-----|----|----|----|----|-----|-----|-----|-----|
| 132 | 138 | 144 | 150 | 156 | 162 | 168 | 174 | 8 | 16 | 17 | 24 | 37 | 23 | 22 | 103 | 64 | 43 | 47 | 56 | 92 | 59 |
| 70 | 42 | 106 | 60 | 109 | 115 | 121 | 127 | 133 | 139 | 145 | 151 | 157 | 163 | 169 | 175 | 4 | 1 | 10 | 19 | 30 | 31 |
| 89 | 86 | 77 | 81 | 51 | 79 | 83 | 48 | 45 | 62 | 67 | 65 | 110 | 116 | 122 | 128 | 134 | 140 | 146 | 152 | 158 | 164 |
| 170 | 176 | 6 | 2 | 0 | 25 | 20 | 34 | 98 | 105 | 82 | 96 | 90 | 107 | 53 | 74 | 73 | 93 | 55 | 102 | 111 | 117 |
| 123 | 129 | 135 | 141 | 147 | 153 | 159 | 165 | 171 | 177 | 14 | 7 | 3 | 27 | 21 | 33 | 44 | 97 | 38 | 75 | 72 | 41 |
| 84 | 80 | 100 | 87 | 76 | 57 | 112 | 118 | 124 | 130 | 136 | 142 | 148 | 154 | 160 | 166 | 172 | 178 | 5 | 11 | 12 | 32 |
| 29 | 36 | 88 | 71 | 78 | 95 | 49 | 54 | 61 | 66 | 46 | 39 | 101 | 91 | 113 | 119 | 125 | 131 | 137 | 143 | 149 | 155 |
| 161 | 167 | 173 | 179 | | | | | | | | | | | | | | | | | | |

EP 3 247 043 A1

FIG. 118

BIT GROUP

EP 3 247 043 A1

# FIG. 119

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
|----|----|----|----|----|----|----|----|----|----|----|----|----|----|----|----|----|----|----|----|----|----|

| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
|----|----|----|----|----|----|----|----|----|----|----|----|----|----|----|----|----|----|----|----|----|----|

| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
|----|----|----|----|----|----|----|----|----|----|----|----|-----|-----|-----|-----|-----|-----|-----|-----|-----|-----|

| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
|-----|-----|-----|-----|-----|-----|-----|-----|-----|-----|-----|-----|-----|-----|-----|-----|-----|-----|-----|-----|-----|-----|

| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
|-----|-----|-----|-----|-----|-----|-----|-----|-----|-----|-----|-----|-----|-----|-----|-----|-----|-----|-----|-----|-----|-----|

| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
|-----|-----|-----|-----|-----|-----|-----|-----|-----|-----|-----|-----|-----|-----|-----|-----|-----|-----|-----|-----|-----|-----|

| 176 | 177 | 178 | 179 |
|-----|-----|-----|-----|

⇕

| 21 | 11 | 12 | 9 | 0 | 6 | 24 | 25 | 85 | 103 | 118 | 122 | 71 | 101 | 41 | 93 | 55 | 73 | 100 | 40 | 106 | 119 |
|----|----|----|---|---|---|----|----|----|-----|-----|-----|----|-----|----|----|----|----|-----|----|-----|-----|

| 45 | 80 | 128 | 68 | 129 | 61 | 124 | 36 | 126 | 117 | 114 | 132 | 136 | 140 | 144 | 148 | 152 | 156 | 160 | 164 | 168 | 172 |
|----|----|-----|----|-----|----|-----|----|-----|-----|-----|-----|-----|-----|-----|-----|-----|-----|-----|-----|-----|-----|

| 176 | 20 | 18 | 10 | 13 | 16 | 8 | 26 | 27 | 54 | 111 | 52 | 44 | 87 | 113 | 115 | 58 | 116 | 49 | 77 | 95 | 86 |
|-----|----|----|----|----|----|---|----|----|----|-----|----|----|----|-----|-----|----|-----|----|----|----|----|

| 30 | 78 | 81 | 56 | 125 | 53 | 89 | 94 | 50 | 123 | 65 | 83 | 133 | 137 | 141 | 145 | 149 | 153 | 157 | 161 | 165 | 169 |
|----|----|----|----|-----|----|----|----|----|-----|----|----|-----|-----|-----|-----|-----|-----|-----|-----|-----|-----|

| 173 | 177 | 2 | 17 | 1 | 4 | 7 | 15 | 29 | 82 | 32 | 102 | 76 | 121 | 92 | 130 | 127 | 62 | 107 | 38 | 46 | 43 |
|-----|-----|---|----|---|---|---|----|----|----|----|-----|----|-----|----|-----|-----|----|-----|----|----|----|

| 110 | 75 | 104 | 70 | 91 | 69 | 96 | 120 | 42 | 34 | 79 | 35 | 105 | 134 | 138 | 142 | 146 | 150 | 154 | 158 | 162 | 166 |
|-----|----|-----|----|----|----|----|-----|----|----|----|----|-----|-----|-----|-----|-----|-----|-----|-----|-----|-----|

| 170 | 174 | 178 | 19 | 5 | 3 | 14 | 22 | 28 | 23 | 109 | 51 | 108 | 131 | 33 | 84 | 88 | 64 | 63 | 59 | 57 | 97 |
|-----|-----|-----|----|---|---|----|----|----|----|-----|----|-----|-----|----|----|----|----|----|----|----|----|

| 98 | 48 | 31 | 99 | 37 | 72 | 39 | 74 | 66 | 60 | 67 | 47 | 112 | 90 | 135 | 139 | 143 | 147 | 151 | 155 | 159 | 163 |
|----|----|----|----|----|----|----|----|----|----|----|----|-----|----|-----|-----|-----|-----|-----|-----|-----|-----|

| 167 | 171 | 175 | 179 |
|-----|-----|-----|-----|

## FIG. 120

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 12 | 15 | 2 | 16 | 27 | 50 | 35 | 74 | 38 | 70 | 108 | 32 | 112 | 54 | 30 | 122 | 72 | 116 | 36 | 90 | 49 | 85 |
|----|----|----|----|----|----|----|----|----|----|-----|----|-----|----|----|-----|----|-----|----|----|----|----|
| 132 | 138 | 144 | 150 | 156 | 162 | 168 | 174 | 0 | 14 | 9 | 5 | 23 | 66 | 68 | 52 | 96 | 117 | 84 | 128 | 100 | 63 |
| 60 | 127 | 81 | 99 | 53 | 55 | 103 | 95 | 133 | 139 | 145 | 151 | 157 | 163 | 169 | 175 | 10 | 22 | 13 | 11 | 28 | 104 |
| 37 | 57 | 115 | 46 | 65 | 129 | 107 | 75 | 119 | 110 | 31 | 43 | 97 | 78 | 125 | 58 | 134 | 140 | 146 | 152 | 158 | 164 |
| 170 | 176 | 4 | 19 | 6 | 8 | 24 | 44 | 101 | 94 | 118 | 130 | 69 | 71 | 83 | 34 | 86 | 124 | 48 | 106 | 89 | 40 |
| 102 | 91 | 135 | 141 | 147 | 153 | 159 | 165 | 171 | 177 | 3 | 20 | 7 | 17 | 25 | 87 | 41 | 120 | 47 | 80 | 59 | 62 |
| 88 | 45 | 56 | 131 | 61 | 126 | 113 | 92 | 51 | 98 | 136 | 142 | 148 | 154 | 160 | 166 | 172 | 178 | 21 | 18 | 1 | 26 |
| 29 | 39 | 73 | 121 | 105 | 77 | 42 | 114 | 93 | 82 | 111 | 109 | 67 | 79 | 123 | 64 | 76 | 33 | 137 | 143 | 149 | 155 |
| 161 | 167 | 173 | 179 | | | | | | | | | | | | | | | | | | |

EP 3 247 043 A1

FIG. 121

BIT GROUP

# FIG. 122

EP 3 247 043 A1

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 0 | 4 | 8 | 12 | 16 | 20 | 24 | 28 | 32 | 36 | 40 | 44 | 48 | 52 | 56 | 60 | 64 | 68 | 72 | 76 | 80 | 84 |
|---|---|---|----|----|----|----|----|----|----|----|----|----|----|----|----|----|----|----|----|----|----|
| 88 | 92 | 96 | 100 | 104 | 108 | 112 | 116 | 120 | 124 | 128 | 132 | 136 | 140 | 144 | 148 | 152 | 156 | 160 | 164 | 168 | 172 |
| 176 | 1 | 5 | 9 | 13 | 17 | 21 | 25 | 29 | 33 | 37 | 41 | 45 | 49 | 53 | 57 | 61 | 65 | 69 | 73 | 77 | 81 |
| 85 | 89 | 93 | 97 | 101 | 105 | 109 | 113 | 117 | 121 | 125 | 129 | 133 | 137 | 141 | 145 | 149 | 153 | 157 | 161 | 165 | 169 |
| 173 | 177 | 2 | 6 | 10 | 14 | 18 | 22 | 26 | 30 | 34 | 38 | 42 | 46 | 50 | 54 | 58 | 62 | 66 | 70 | 74 | 78 |
| 82 | 86 | 90 | 94 | 98 | 102 | 106 | 110 | 114 | 118 | 122 | 126 | 130 | 134 | 138 | 142 | 146 | 150 | 154 | 158 | 162 | 166 |
| 170 | 174 | 178 | 3 | 7 | 11 | 15 | 19 | 23 | 27 | 31 | 35 | 39 | 43 | 47 | 51 | 55 | 59 | 63 | 67 | 71 | 75 |
| 79 | 83 | 87 | 91 | 95 | 99 | 103 | 107 | 111 | 115 | 119 | 123 | 127 | 131 | 135 | 139 | 143 | 147 | 151 | 155 | 159 | 163 |
| 167 | 171 | 175 | 179 | | | | | | | | | | | | | | | | | | |

# FIG. 123

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 | 45 | 46 | 47 | 48 | 49 | 50 | 51 | 52 | 53 | 54 | 55 | 56 | 57 | 58 | 59 | 60 | 61 | 62 | 63 | 64 | 65 |

| 66 | 67 | 68 | 69 | 70 | 71 | 72 | 73 | 74 | 75 | 76 | 77 | 78 | 79 | 80 | 81 | 82 | 83 | 84 | 85 | 86 | 87 |

| 88 | 89 | 90 | 91 | 92 | 93 | 94 | 95 | 96 | 97 | 98 | 99 | 100 | 101 | 102 | 103 | 104 | 105 | 106 | 107 | 108 | 109 |

| 110 | 111 | 112 | 113 | 114 | 115 | 116 | 117 | 118 | 119 | 120 | 121 | 122 | 123 | 124 | 125 | 126 | 127 | 128 | 129 | 130 | 131 |

| 132 | 133 | 134 | 135 | 136 | 137 | 138 | 139 | 140 | 141 | 142 | 143 | 144 | 145 | 146 | 147 | 148 | 149 | 150 | 151 | 152 | 153 |

| 154 | 155 | 156 | 157 | 158 | 159 | 160 | 161 | 162 | 163 | 164 | 165 | 166 | 167 | 168 | 169 | 170 | 171 | 172 | 173 | 174 | 175 |

| 176 | 177 | 178 | 179 |

⇕

| 8 | 112 | 92 | 165 | 12 | 55 | 5 | 126 | 87 | 70 | 69 | 94 | 103 | 78 | 137 | 148 | 9 | 60 | 13 | 7 | 178 | 79 |

| 43 | 136 | 34 | 68 | 118 | 152 | 49 | 15 | 99 | 61 | 66 | 28 | 109 | 125 | 33 | 167 | 81 | 93 | 97 | 26 | 35 | 30 |

| 153 | 131 | 122 | 71 | 107 | 130 | 76 | 4 | 95 | 42 | 58 | 134 | 0 | 89 | 75 | 40 | 129 | 31 | 80 | 101 | 52 | 16 |

| 142 | 44 | 138 | 46 | 116 | 27 | 82 | 88 | 143 | 128 | 72 | 29 | 83 | 117 | 172 | 14 | 51 | 159 | 48 | 160 | 100 | 1 |

| 102 | 90 | 22 | 3 | 114 | 19 | 108 | 113 | 39 | 73 | 111 | 155 | 106 | 105 | 91 | 150 | 54 | 25 | 135 | 139 | 147 | 36 |

| 56 | 123 | 6 | 67 | 104 | 96 | 157 | 10 | 62 | 164 | 86 | 74 | 133 | 120 | 174 | 53 | 140 | 156 | 171 | 149 | 127 | 85 |

| 59 | 124 | 84 | 11 | 21 | 132 | 41 | 145 | 158 | 32 | 17 | 23 | 50 | 169 | 170 | 38 | 18 | 151 | 24 | 166 | 175 | 2 |

| 47 | 57 | 98 | 20 | 177 | 161 | 154 | 176 | 163 | 37 | 110 | 168 | 141 | 64 | 65 | 173 | 162 | 121 | 45 | 77 | 115 | 179 |

| 63 | 119 | 146 | 144 |

## FIG. 124

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 103 | 138 | 168 | 82 | 116 | 45 | 178 | 28 | 160 | 2 | 129 | 148 | 150 | 23 | 54 | 106 | 24 | 78 | 49 | 87 | 145 | 179 |
| 26 | 112 | 119 | 12 | 18 | 174 | 21 | 48 | 134 | 137 | 102 | 147 | 152 | 72 | 68 | 3 | 22 | 169 | 30 | 64 | 108 | 142 |
| 131 | 13 | 115 | 121 | 37 | 17 | 133 | 136 | 101 | 59 | 161 | 25 | 164 | 43 | 167 | 144 | 41 | 85 | 111 | 56 | 91 | 58 |
| 128 | 154 | 172 | 57 | 75 | 157 | 19 | 4 | 86 | 73 | 15 | 38 | 35 | 9 | 105 | 123 | 34 | 56 | 41 | 91 | 60 | 90 |
| 74 | 149 | 146 | 62 | 163 | 31 | 16 | 88 | 6 | 155 | 130 | 89 | 107 | 135 | 79 | 8 | 124 | 96 | 175 | 171 | 114 | 162 |
| 33 | 66 | 126 | 71 | 44 | 158 | 51 | 165 | 173 | 120 | 7 | 111 | 170 | 140 | 1 | 156 | 76 | 52 | 153 | 175 | 36 | 47 |
| 110 | 63 | 132 | 29 | 95 | 143 | 98 | 70 | 20 | 122 | 53 | 27 | 97 | 159 | 139 | 76 | 80 | 117 | 52 | 61 | 46 | 125 |
| 94 | 50 | 67 | 81 | 69 | 65 | 40 | 127 | 77 | 32 | 39 | 99 | 100 | 93 | 55 | 80 | 117 | 92 | 55 | 92 | 118 | 0 |
| 5 | 83 | 177 | 104 | | | | | | | | | | | | | | | | | | |

220

FIG. 125

BIT GROUP

# FIG. 126

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 | 45 | 46 | 47 | 48 | 49 | 50 | 51 | 52 | 53 | 54 | 55 | 56 | 57 | 58 | 59 | 60 | 61 | 62 | 63 | 64 | 65 |

| 66 | 67 | 68 | 69 | 70 | 71 | 72 | 73 | 74 | 75 | 76 | 77 | 78 | 79 | 80 | 81 | 82 | 83 | 84 | 85 | 86 | 87 |

| 88 | 89 | 90 | 91 | 92 | 93 | 94 | 95 | 96 | 97 | 98 | 99 | 100 | 101 | 102 | 103 | 104 | 105 | 106 | 107 | 108 | 109 |

| 110 | 111 | 112 | 113 | 114 | 115 | 116 | 117 | 118 | 119 | 120 | 121 | 122 | 123 | 124 | 125 | 126 | 127 | 128 | 129 | 130 | 131 |

| 132 | 133 | 134 | 135 | 136 | 137 | 138 | 139 | 140 | 141 | 142 | 143 | 144 | 145 | 146 | 147 | 148 | 149 | 150 | 151 | 152 | 153 |

| 154 | 155 | 156 | 157 | 158 | 159 | 160 | 161 | 162 | 163 | 164 | 165 | 166 | 167 | 168 | 169 | 170 | 171 | 172 | 173 | 174 | 175 |

| 176 | 177 | 178 | 179 |

⇕

| 37 | 98 | 160 | 63 | 18 | 6 | 94 | 136 | 8 | 50 | 0 | 75 | 65 | 32 | 107 | 60 | 108 | 17 | 21 | 156 | 157 | 5 |

| 73 | 66 | 38 | 177 | 162 | 130 | 171 | 76 | 57 | 126 | 103 | 62 | 120 | 134 | 154 | 101 | 143 | 29 | 13 | 149 | 16 | 33 |

| 55 | 56 | 159 | 128 | 23 | 146 | 153 | 141 | 169 | 49 | 46 | 152 | 89 | 155 | 111 | 127 | 48 | 14 | 93 | 41 | 7 | 78 |

| 135 | 69 | 123 | 179 | 36 | 87 | 27 | 58 | 88 | 170 | 125 | 110 | 15 | 97 | 178 | 90 | 121 | 173 | 30 | 102 | 10 | 80 |

| 104 | 166 | 64 | 4 | 147 | 1 | 52 | 45 | 148 | 68 | 158 | 31 | 140 | 100 | 85 | 115 | 151 | 70 | 39 | 82 | 122 | 79 |

| 12 | 91 | 133 | 132 | 22 | 163 | 47 | 19 | 119 | 144 | 35 | 25 | 42 | 83 | 92 | 26 | 72 | 138 | 54 | 124 | 24 | 74 |

| 118 | 117 | 168 | 71 | 109 | 112 | 106 | 176 | 175 | 44 | 145 | 11 | 9 | 161 | 96 | 77 | 174 | 137 | 34 | 84 | 2 | 164 |

| 129 | 43 | 150 | 61 | 53 | 20 | 165 | 113 | 142 | 116 | 95 | 3 | 28 | 40 | 81 | 99 | 139 | 114 | 59 | 67 | 172 | 131 |

| 105 | 167 | 51 | 86 |

EP 3 247 043 A1

# FIG. 127

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 58 | 70 | 23 | 32 | 26 | 63 | 55 | 48 | 35 | 41 | 53 | 20 | 38 | 51 | 61 | 65 | 44 | 29 | 7 | 2 | 113 | 68 |
|---|---|---|---|---|---|---|---|---|---|----|----|----|----|----|----|----|----|----|----|----|----|
| 96 | 104 | 106 | 89 | 27 | 0 | 119 | 21 | 4 | 49 | 46 | 100 | 13 | 36 | 57 | 98 | 102 | 9 | 42 | 39 | 33 | 62 |
| 22 | 95 | 101 | 15 | 91 | 25 | 93 | 132 | 69 | 87 | 47 | 59 | 67 | 124 | 17 | 11 | 31 | 43 | 40 | 37 | 85 | 50 |
| 97 | 140 | 45 | 92 | 56 | 30 | 34 | 60 | 107 | 24 | 52 | 94 | 64 | 5 | 71 | 90 | 66 | 103 | 88 | 86 | 84 | 19 |
| 169 | 159 | 147 | 126 | 28 | 130 | 14 | 162 | 144 | 166 | 108 | 153 | 115 | 135 | 120 | 122 | 112 | 139 | 151 | 156 | 16 | 172 |
| 164 | 123 | 99 | 54 | 136 | 81 | 105 | 128 | 116 | 150 | 155 | 76 | 18 | 142 | 170 | 175 | 83 | 146 | 78 | 109 | 73 | 131 |
| 127 | 82 | 167 | 77 | 110 | 79 | 137 | 152 | 3 | 173 | 148 | 72 | 158 | 117 | 1 | 6 | 12 | 8 | 161 | 74 | 143 | 133 |
| 168 | 171 | 134 | 163 | 138 | 121 | 141 | 160 | 111 | 10 | 149 | 80 | 75 | 165 | 157 | 174 | 129 | 145 | 114 | 125 | 154 | 118 |
| 176 | 177 | 178 | 179 | | | | | | | | | | | | | | | | | | |

FIG. 128

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 40 | 159 | 100 | 14 | 88 | 75 | 53 | 24 | 157 | 84 | 23 | 77 | 140 | 145 | 32 | 28 | 112 | 39 | 76 | 50 | 93 | 27 |
| 107 | 25 | 152 | 101 | 127 | 5 | 129 | 71 | 9 | 21 | 96 | 73 | 35 | 106 | 158 | 49 | 136 | 30 | 137 | 115 | 139 | 48 |
| 167 | 85 | 74 | 72 | 7 | 110 | 161 | 41 | 170 | 147 | 82 | 128 | 149 | 33 | 8 | 120 | 47 | 68 | 58 | 67 | 87 | 155 |
| 11 | 18 | 103 | 151 | 29 | 36 | 83 | 135 | 79 | 150 | 97 | 54 | 70 | 138 | 156 | 31 | 121 | 34 | 20 | 130 | 61 | 57 |
| 2 | 166 | 117 | 15 | 6 | 165 | 118 | 98 | 116 | 131 | 109 | 62 | 126 | 175 | 22 | 111 | 164 | 16 | 133 | 102 | 55 | 105 |
| 64 | 177 | 78 | 37 | 162 | 124 | 119 | 19 | 4 | 69 | 132 | 65 | 123 | 160 | 17 | 52 | 38 | 1 | 80 | 90 | 42 | 81 |
| 104 | 13 | 144 | 51 | 114 | 3 | 43 | 146 | 163 | 59 | 45 | 89 | 122 | 169 | 44 | 94 | 86 | 99 | 66 | 171 | 173 | 0 |
| 141 | 148 | 176 | 26 | 143 | 178 | 60 | 153 | 142 | 91 | 179 | 12 | 168 | 113 | 95 | 174 | 56 | 134 | 92 | 46 | 108 | 125 |
| 10 | 172 | 154 | 63 | | | | | | | | | | | | | | | | | | |

FIG. 129

## FIG. 130

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 116 | 47 | 155 | 89 | 109 | 137 | 103 | 60 | 114 | 14 | 148 | 100 | 28 | 132 | 129 | 105 | 154 | 7 | 167 | 140 | 160 | 30 |
|---|---|---|---|---|---|---|---|---|---|----|----|----|----|----|----|----|----|----|----|----|----|
| 57 | 32 | 81 | 11 | 3 | 45 | 69 | 147 | 125 | 52 | 20 | 22 | 156 | 168 | 17 | 93 | 53 | 151 | 61 | 149 | 56 | 62 |
| 112 | 48 | 11 | 21 | 166 | 73 | 158 | 104 | 79 | 128 | 135 | 126 | 63 | 26 | 44 | 97 | 13 | 123 | 151 | 41 | 118 | 35 |
| 131 | 8 | 90 | 58 | 134 | 6 | 78 | 130 | 82 | 106 | 99 | 178 | 102 | 29 | 108 | 120 | 107 | 139 | 23 | 85 | 36 | 172 |
| 174 | 138 | 95 | 145 | 170 | 122 | 50 | 19 | 91 | 67 | 101 | 92 | 27 | 94 | 66 | 171 | 80 | 39 | 68 | 9 | 59 | 146 |
| 15 | 31 | 38 | 49 | 37 | 64 | 77 | 152 | 144 | 72 | 165 | 163 | 1 | 2 | 111 | 80 | 124 | 39 | 43 | 136 | 153 | |
| 75 | 42 | 113 | 18 | 164 | 133 | 142 | 98 | 96 | 4 | 51 | 150 | 24 | 76 | 25 | 176 | 34 | 143 | | | | |
| 173 | 169 | 40 | 65 | 157 | 175 | 70 | 33 | 141 | 71 | 119 | 6 | 162 | 177 | 12 | 84 | 117 | 0 | 88 | 161 | 55 | |
| 54 | 83 | 74 | 159 | | | | | | | | | | | | | | | | | | |

## FIG. 131

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇔

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 62 | 17 | 10 | 25 | 174 | 13 | 159 | 14 | 108 | 0 | 42 | 57 | 78 | 67 | 41 | 132 | 110 | 87 | 77 | 27 | 88 | 56 |
| 8 | 161 | 7 | 164 | 171 | 44 | 75 | 176 | 145 | 165 | 157 | 34 | 142 | 98 | 103 | 52 | 11 | 82 | 141 | 116 | 15 | 158 |
| 139 | 120 | 36 | 61 | 20 | 112 | 144 | 53 | 128 | 24 | 96 | 122 | 114 | 104 | 150 | 50 | 80 | 30 | 109 | 33 | 5 | 95 |
| 59 | 16 | 134 | 105 | 111 | 21 | 40 | 146 | 18 | 133 | 60 | 23 | 160 | 106 | 32 | 79 | 55 | 6 | 1 | 154 | 117 | 19 |
| 152 | 167 | 166 | 30 | 35 | 100 | 74 | 131 | 99 | 156 | 39 | 76 | 86 | 43 | 178 | 155 | 179 | 177 | 136 | 175 | 81 | 64 |
| 124 | 153 | 84 | 163 | 135 | 115 | 125 | 47 | 45 | 143 | 72 | 48 | 172 | 97 | 85 | 107 | 126 | 91 | 129 | 137 | 83 | 118 |
| 54 | 2 | 9 | 58 | 169 | 73 | 123 | 4 | 92 | 168 | 162 | 94 | 138 | 119 | 22 | 31 | 63 | 89 | 90 | 69 | 49 | 173 |
| 28 | 127 | 26 | 29 | 101 | 170 | 93 | 140 | 147 | 149 | 148 | 66 | 65 | 121 | 12 | 71 | 37 | 70 | 102 | 46 | 38 | 68 |
| 130 | 3 | 113 | 151 | | | | | | | | | | | | | | | | | | |

227

FIG. 132

# FIG. 133

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 18 | 150 | 165 | 42 | 81 | 48 | 63 | 45 | 93 | 152 | 25 | 16 | 174 | 29 | 47 | 83 | 8 | 60 | 30 | 66 | 11 | 113 |
|---|---|---|---|---|---|---|---|---|---|---|---|---|---|---|---|---|---|---|---|---|---|
| 44 | 148 | 4 | 155 | 59 | 33 | 134 | 99 | 32 | 176 | 109 | 72 | 36 | 111 | 106 | 73 | 170 | 126 | 64 | 88 | 20 | 17 |
| 172 | 154 | 120 | 121 | 139 | 77 | 98 | 43 | 105 | 133 | 19 | 41 | 78 | 15 | 7 | 145 | 94 | 136 | 131 | 163 | 65 | 31 |
| 96 | 79 | 119 | 143 | 10 | 95 | 9 | 146 | 14 | 118 | 162 | 37 | 97 | 49 | 22 | 51 | 127 | 6 | 71 | 132 | 87 | 21 |
| 39 | 38 | 54 | 115 | 159 | 161 | 84 | 108 | 13 | 102 | 135 | 103 | 156 | 67 | 173 | 76 | 75 | 164 | 52 | 142 | 69 | 130 |
| 56 | 153 | 74 | 166 | 158 | 124 | 141 | 58 | 116 | 85 | 175 | 169 | 168 | 147 | 35 | 62 | 5 | 123 | 100 | 90 | 122 | 101 |
| 149 | 112 | 140 | 86 | 68 | 89 | 125 | 27 | 177 | 160 | 0 | 80 | 55 | 151 | 53 | 2 | 70 | 167 | 114 | 129 | 179 | 138 |
| 1 | 92 | 26 | 50 | 28 | 110 | 61 | 82 | 91 | 117 | 107 | 178 | 34 | 157 | 137 | 128 | 40 | 24 | 57 | 3 | 171 | 46 |
| 104 | 12 | 144 | 23 | | | | | | | | | | | | | | | | | | |

EP 3 247 043 A1

# FIG. 134

EP 3 247 043 A1

BIT GROUP

| | | | | | | | | | | | | | | | | | | | | | |
|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| | | | | | | | | | | | | | | | | | | | | | |
|---|---|---|---|---|---|---|---|---|---|---|---|---|---|---|---|---|---|---|---|---|---|
| 18 | 8 | 166 | 117 | 4 | 111 | 142 | 148 | 176 | 91 | 120 | 144 | 99 | 124 | 20 | 25 | 31 | 78 | 36 | 72 | 2 | 98 |
| 93 | 74 | 174 | 52 | 152 | 62 | 88 | 75 | 23 | 97 | 147 | 15 | 71 | 1 | 127 | 138 | 81 | 83 | 68 | 94 | 112 | 119 |
| 121 | 89 | 163 | 85 | 86 | 28 | 17 | 64 | 14 | 44 | 158 | 159 | 150 | 32 | 128 | 70 | 90 | 29 | 30 | 63 | 100 | 65 |
| 129 | 140 | 177 | 46 | 84 | 92 | 10 | 33 | 58 | 7 | 96 | 151 | 171 | 40 | 76 | 6 | 3 | 37 | 104 | 57 | 135 | 103 |
| 141 | 107 | 116 | 160 | 41 | 153 | 175 | 55 | 130 | 118 | 131 | 42 | 27 | 133 | 95 | 179 | 34 | 21 | 87 | 106 | 105 | 108 |
| 79 | 134 | 113 | 26 | 164 | 114 | 73 | 102 | 77 | 22 | 110 | 161 | 43 | 122 | 123 | 82 | 5 | 48 | 139 | 60 | 49 | 154 |
| 115 | 146 | 67 | 69 | 137 | 109 | 143 | 24 | 101 | 45 | 16 | 12 | 19 | 178 | 80 | 51 | 47 | 149 | 50 | 172 | 170 | 169 |
| 61 | 9 | 39 | 136 | 59 | 38 | 54 | 156 | 126 | 125 | 145 | 0 | 13 | 155 | 132 | 162 | 11 | 157 | 66 | 165 | 173 | 56 |
| 168 | 167 | 53 | 35 | | | | | | | | | | | | | | | | | | |

# FIG. 135

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 |

⇕

| 77 | 50 | 109 | 128 | 153 | 12 | 48 | 17 | 147 | 55 | 173 | 172 | 135 | 121 | 99 | 162 | 52 | 40 | 129 | 168 | 103 | 87 |
| 134 | 105 | 179 | 10 | 131 | 151 | 3 | 26 | 100 | 15 | 123 | 88 | 18 | 91 | 54 | 160 | 49 | 1 | 76 | 80 | 74 | 31 |
| 47 | 58 | 161 | 9 | 16 | 34 | 41 | 21 | 177 | 11 | 63 | 6 | 39 | 165 | 169 | 125 | 114 | 57 | 37 | 67 | 93 | 96 |
| 73 | 106 | 83 | 166 | 24 | 51 | 142 | 65 | 43 | 64 | 53 | 72 | 156 | 81 | 4 | 155 | 33 | 163 | 56 | 150 | 70 | 167 |
| 107 | 112 | 144 | 149 | 36 | 32 | 35 | 59 | 101 | 29 | 127 | 138 | 176 | 90 | 141 | 92 | 170 | 102 | 119 | 25 | 75 | 14 |
| 0 | 68 | 20 | 97 | 110 | 28 | 89 | 118 | 154 | 126 | 2 | 22 | 124 | 85 | 175 | 78 | 46 | 152 | 23 | 86 | 27 | 79 |
| 130 | 66 | 45 | 113 | 111 | 62 | 61 | 7 | 30 | 133 | 108 | 171 | 143 | 60 | 178 | 5 | 122 | 44 | 38 | 148 | 157 | 84 |
| 42 | 139 | 145 | 8 | 104 | 115 | 71 | 137 | 132 | 146 | 164 | 98 | 13 | 117 | 174 | 158 | 95 | 116 | 140 | 94 | 136 | 120 |
| 82 | 69 | 159 | 19 |

FIG. 136

## FIG. 137

EP 3 247 043 A1

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 49 | 2 | 57 | 47 | 31 | 35 | 24 | 39 | 59 | 0 | 45 | 41 | 55 | 53 | 51 | 37 | 33 | 43 | 56 | 38 | 48 | 32 |
|---|---|---|---|---|---|---|---|---|---|----|----|----|----|----|----|----|----|----|----|----|----|
| 50 | 23 | 34 | 54 | 1 | 36 | 44 | 52 | 40 | 58 | 122 | 46 | 42 | 30 | 3 | 75 | 73 | 65 | 145 | 71 | 79 | 67 |
| 69 | 83 | 85 | 147 | 63 | 81 | 77 | 61 | 5 | 26 | 62 | 64 | 74 | 70 | 82 | 149 | 76 | 4 | 78 | 84 | 80 | 86 |
| 66 | 68 | 72 | 6 | 60 | 154 | 103 | 95 | 101 | 143 | 9 | 89 | 141 | 128 | 97 | 137 | 133 | 7 | 13 | 99 | 91 | 93 |
| 87 | 11 | 136 | 90 | 88 | 94 | 10 | 8 | 14 | 96 | 104 | 92 | 132 | 142 | 100 | 98 | 12 | 102 | 152 | 139 | 150 | 106 |
| 146 | 130 | 27 | 108 | 153 | 112 | 114 | 29 | 110 | 134 | 116 | 15 | 127 | 125 | 123 | 120 | 148 | 151 | 113 | 126 | 124 | 135 |
| 129 | 109 | 25 | 28 | 158 | 117 | 105 | 115 | 111 | 131 | 107 | 121 | 18 | 170 | 164 | 20 | 140 | 160 | 166 | 162 | 119 | 155 |
| 168 | 178 | 22 | 174 | 172 | 176 | 16 | 157 | 159 | 171 | 161 | 118 | 17 | 163 | 21 | 165 | 19 | 179 | 177 | 167 | 138 | 173 |
| 156 | 144 | 169 | 175 | | | | | | | | | | | | | | | | | | |

233

# FIG. 138

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 71 | 38 | 98 | 159 | 1 | 32 | 28 | 177 | 125 | 102 | 83 | 17 | 121 | 151 | 66 | 92 | 140 | 6 | 165 | 23 | 75 | 91 |
|---|---|---|---|---|---|---|---|---|---|---|---|---|---|---|---|---|---|---|---|---|---|
| 87 | 108 | 163 | 50 | 77 | 39 | 110 | 128 | 73 | 148 | 14 | 5 | 68 | 37 | 53 | 93 | 149 | 26 | 166 | 48 | 79 | 10 |
| 122 | 150 | 103 | 178 | 119 | 101 | 61 | 34 | 8 | 86 | 36 | 138 | 146 | 72 | 179 | 143 | 147 | 89 | 4 | 107 | 33 | 144 |
| 141 | 40 | 100 | 29 | 118 | 63 | 46 | 20 | 153 | 90 | 152 | 124 | 7 | 30 | 31 | 43 | 78 | 120 | 85 | 25 | 52 | 47 |
| 64 | 81 | 175 | 94 | 115 | 15 | 112 | 99 | 13 | 21 | 42 | 169 | 76 | 19 | 168 | 16 | 27 | 162 | 167 | 164 | 97 | 82 |
| 44 | 106 | 12 | 109 | 132 | 145 | 161 | 174 | 95 | 0 | 105 | 134 | 173 | 84 | 9 | 65 | 88 | 54 | 67 | 116 | 154 | 80 |
| 22 | 172 | 60 | 111 | 133 | 56 | 170 | 104 | 131 | 123 | 24 | 49 | 113 | 136 | 55 | 3 | 157 | 156 | 35 | 58 | 45 | 155 |
| 70 | 59 | 57 | 171 | 176 | 74 | 117 | 18 | 127 | 114 | 11 | 69 | 158 | 129 | 139 | 62 | 135 | 96 | 142 | 41 | 130 | 160 |
| 2 | 126 | 51 | 137 | | | | | | | | | | | | | | | | | | |

## FIG. 139

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 66 | 61 | 150 | 157 | 63 | 42 | 78 | 44 | 23 | 154 | 133 | 101 | 82 | 26 | 84 | 123 | 89 | 31 | 45 | 102 | 36 | 134 |
|---|---|---|---|---|---|---|---|---|---|---|---|---|---|---|---|---|---|---|---|---|---|
| 83 | 117 | 170 | 27 | 73 | 137 | 25 | 32 | 62 | 91 | 4 | 20 | 144 | 145 | 21 | 74 | 113 | 148 | 24 | 135 | 5 | 19 |
| 2 | 34 | 43 | 168 | 14 | 64 | 142 | 115 | 87 | 38 | 147 | 39 | 51 | 152 | 56 | 86 | 122 | 76 | 57 | 129 | 172 | 6 |
| 126 | 10 | 97 | 85 | 164 | 3 | 80 | 90 | 79 | 124 | 138 | 120 | 17 | 103 | 99 | 116 | 46 | 98 | 162 | 151 | 143 | 11 |
| 175 | 160 | 96 | 132 | 81 | 171 | 94 | 65 | 118 | 161 | 125 | 178 | 95 | 112 | 88 | 174 | 13 | 35 | 1 | 167 | 0 | 128 |
| 12 | 58 | 29 | 169 | 67 | 28 | 119 | 166 | 60 | 55 | 54 | 130 | 92 | 146 | 177 | 149 | 111 | 9 | 173 | 179 | 176 | 75 |
| 77 | 114 | 48 | 159 | 8 | 141 | 107 | 139 | 52 | 100 | 136 | 105 | 127 | 47 | 18 | 69 | 109 | 16 | 121 | 59 | 163 | 165 |
| 108 | 106 | 70 | 22 | 93 | 41 | 33 | 110 | 53 | 140 | 153 | 158 | 50 | 15 | 37 | 72 | 156 | 7 | 131 | 49 | 71 | 68 |
| 104 | 30 | 40 | 155 | | | | | | | | | | | | | | | | | | |

# FIG. 140

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇕

| 75 | 83 | 11 | 24 | 86 | 104 | 156 | 76 | 37 | 173 | 127 | 61 | 43 | 139 | 106 | 69 | 49 | 2 | 128 | 140 | 68 | 14 |
|----|----|----|----|----|-----|-----|----|----|-----|-----|----|----|-----|-----|----|----|---|-----|-----|----|----|
| 100 | 8 | 36 | 73 | 148 | 65 | 16 | 47 | 177 | 6 | 132 | 45 | 5 | 30 | 13 | 22 | 29 | 27 | 101 | 150 | 23 | 90 |
| 41 | 93 | 89 | 92 | 135 | 4 | 71 | 87 | 44 | 124 | 26 | 64 | 1 | 129 | 157 | 130 | 107 | 18 | 91 | 118 | 3 | 82 |
| 144 | 113 | 121 | 54 | 84 | 97 | 122 | 120 | 7 | 154 | 56 | 134 | 57 | 161 | 33 | 116 | 28 | 96 | 72 | 172 | 12 | 115 |
| 38 | 164 | 32 | 167 | 145 | 17 | 88 | 39 | 151 | 80 | 0 | 136 | 169 | 142 | 74 | 147 | 126 | 166 | 163 | 40 | 110 | 171 |
| 50 | 160 | 131 | 70 | 175 | 103 | 125 | 77 | 162 | 31 | 85 | 66 | 67 | 52 | 108 | 159 | 133 | 42 | 153 | 21 | 51 | 119 |
| 123 | 98 | 35 | 48 | 111 | 149 | 25 | 58 | 60 | 158 | 102 | 59 | 117 | 20 | 141 | 143 | 46 | 53 | 155 | 15 | 165 | 152 |
| 112 | 176 | 105 | 178 | 99 | 174 | 168 | 114 | 179 | 78 | 10 | 19 | 62 | 63 | 170 | 138 | 34 | 109 | 9 | 146 | 95 | 94 |
| 55 | 137 | 81 | 79 | | | | | | | | | | | | | | | | | | |

EP 3 247 043 A1

# FIG. 141

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 | 45 | 46 | 47 | 48 | 49 | 50 | 51 | 52 | 53 | 54 | 55 | 56 | 57 | 58 | 59 | 60 | 61 | 62 | 63 | 64 | 65 |

| 66 | 67 | 68 | 69 | 70 | 71 | 72 | 73 | 74 | 75 | 76 | 77 | 78 | 79 | 80 | 81 | 82 | 83 | 84 | 85 | 86 | 87 |

| 88 | 89 | 90 | 91 | 92 | 93 | 94 | 95 | 96 | 97 | 98 | 99 | 100 | 101 | 102 | 103 | 104 | 105 | 106 | 107 | 108 | 109 |

| 110 | 111 | 112 | 113 | 114 | 115 | 116 | 117 | 118 | 119 | 120 | 121 | 122 | 123 | 124 | 125 | 126 | 127 | 128 | 129 | 130 | 131 |

| 132 | 133 | 134 | 135 | 136 | 137 | 138 | 139 | 140 | 141 | 142 | 143 | 144 | 145 | 146 | 147 | 148 | 149 | 150 | 151 | 152 | 153 |

| 154 | 155 | 156 | 157 | 158 | 159 | 160 | 161 | 162 | 163 | 164 | 165 | 166 | 167 | 168 | 169 | 170 | 171 | 172 | 173 | 174 | 175 |

| 176 | 177 | 178 | 179 |

⇕

| 98 | 159 | 59 | 125 | 163 | 89 | 26 | 4 | 102 | 70 | 92 | 36 | 37 | 142 | 176 | 95 | 71 | 19 | 87 | 45 | 81 | 47 |

| 65 | 170 | 103 | 48 | 67 | 61 | 64 | 35 | 76 | 80 | 140 | 77 | 10 | 167 | 178 | 155 | 120 | 156 | 151 | 12 | 58 | 5 |

| 83 | 137 | 41 | 109 | 2 | 66 | 133 | 62 | 135 | 28 | 93 | 128 | 86 | 57 | 153 | 161 | 110 | 52 | 147 | 141 | 31 | 79 |

| 32 | 88 | 160 | 84 | 150 | 6 | 100 | 73 | 126 | 164 | 17 | 42 | 101 | 7 | 55 | 105 | 91 | 22 | 130 | 154 | 1 | 82 |

| 14 | 0 | 9 | 21 | 50 | 165 | 72 | 138 | 175 | 106 | 108 | 3 | 169 | 30 | 157 | 54 | 18 | 20 | 44 | 34 | 134 | 107 |

| 56 | 53 | 15 | 162 | 38 | 166 | 24 | 33 | 60 | 85 | 145 | 115 | 43 | 39 | 40 | 124 | 149 | 144 | 132 | 96 | 11 | 146 |

| 90 | 129 | 119 | 111 | 171 | 8 | 152 | 121 | 173 | 131 | 49 | 27 | 118 | 16 | 148 | 68 | 177 | 94 | 179 | 13 | 114 | 75 |

| 51 | 117 | 25 | 46 | 136 | 143 | 139 | 113 | 127 | 174 | 74 | 29 | 122 | 158 | 69 | 97 | 78 | 63 | 99 | 112 | 104 | 116 |

| 172 | 168 | 23 | 123 |

EP 3 247 043 A1

# FIG. 142

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 |
|----|

| 21 | 41 | 15 | 29 | 0 | 23 | 16 | 12 | 38 | 43 | 2 | 3 | 4 | 20 | 31 | 27 | 5 | 33 | 28 | 30 | 36 | 8 |
|----|----|----|----|---|----|----|----|----|----|---|---|---|----|----|----|---|----|----|----|----|---|

| 40 | 13 | 6 | 9 | 18 | 24 | 7 | 39 | 10 | 17 | 37 | 1 | 19 | 22 | 25 | 26 | 14 | 32 | 34 | 11 | 35 | 42 |
|----|----|---|---|----|----|---|----|----|----|----|---|----|----|----|----|----|----|----|----|----|----|

| 44 |
|----|

## FIG. 143

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇕

| 1 | 3 | 2 | 8 | 5 | 23 | 13 | 12 | 18 | 19 | 17 | 20 | 24 | 26 | 28 | 30 | 32 | 34 | 36 | 38 | 40 | 42 |

| 0 | 4 | 6 | 7 | 21 | 16 | 10 | 15 | 9 | 11 | 22 | 14 | 25 | 27 | 29 | 31 | 33 | 35 | 37 | 39 | 41 | 43 |

| 44 |

EP 3 247 043 A1

239

# FIG. 144

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

| 1 | 4 | 5 | 6 | 24 | 21 | 18 | 7 | 17 | 12 | 8 | 20 | 23 | 29 | 28 | 30 | 32 | 34 | 36 | 38 | 40 | 42 |

| 0 | 2 | 3 | 14 | 22 | 13 | 10 | 25 | 9 | 27 | 19 | 16 | 15 | 26 | 11 | 31 | 33 | 35 | 37 | 39 | 41 | 43 |

| 44 |

## FIG. 145

EP 3 247 043 A1

# FIG. 146

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

| 37 | 0 | 41 | 19 | 43 | 8 | 38 | 3 | 29 | 13 | 22 | 6 | 4 | 2 | 9 | 26 | 39 | 15 | 12 | 10 | 33 | 17 |

| 20 | 16 | 21 | 44 | 42 | 27 | 7 | 11 | 30 | 34 | 24 | 1 | 23 | 35 | 36 | 25 | 31 | 18 | 28 | 32 | 40 | 5 |

| 14 |

FIG. 147

# FIG. 148

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇕

| 27 | 11 | 20 | 1 | 7 | 5 | 29 | 35 | 9 | 10 | 34 | 18 | 25 | 28 | 6 | 13 | 17 | 0 | 23 | 16 | 41 | 15 |

| 19 | 44 | 24 | 37 | 4 | 31 | 8 | 32 | 14 | 42 | 12 | 2 | 40 | 30 | 36 | 39 | 43 | 21 | 3 | 22 | 26 | 33 |

| 38 |

EP 3 247 043 A1

FIG. 149

BIT GROUP

EP 3 247 043 A1

## FIG. 150

## FIG. 151

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

| 36 | 6 | 2 | 20 | 43 | 17 | 33 | 22 | 23 | 25 | 13 | 0 | 10 | 7 | 21 | 1 | 19 | 26 | 8 | 14 | 31 | 35 |

| 16 | 5 | 29 | 40 | 11 | 9 | 4 | 34 | 15 | 42 | 32 | 28 | 18 | 37 | 30 | 39 | 24 | 41 | 3 | 38 | 27 | 12 |

| 44 |

EP 3 247 043 A1

## FIG. 152

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇕

| 14 | 22 | 18 | 11 | 28 | 26 | 2 | 38 | 10 | 0 | 5 | 12 | 24 | 17 | 29 | 16 | 39 | 13 | 23 | 8 | 25 | 43 |

| 34 | 33 | 27 | 15 | 7 | 1 | 9 | 35 | 40 | 32 | 30 | 20 | 36 | 31 | 21 | 41 | 44 | 3 | 42 | 6 | 19 | 37 |

| 4 |

## FIG. 153

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | | | | | | | | | | | | | | | | | | | | | |

⇕

| 17 | 11 | 14 | 7 | 10 | 2 | 26 | 0 | 32 | 29 | 22 | 33 | 12 | 20 | 28 | 27 | 39 | 37 | 15 | 4 | 5 |
|----|----|----|---|----|---|----|---|----|----|----|----|----|----|----|----|----|----|----|---|---|
| 8 | 13 | 38 | 18 | 23 | 34 | 24 | 6 | 1 | 9 | 16 | 44 | 21 | 3 | 36 | 30 | 40 | 35 | 43 | 42 | 25 | 19 |
| 41 | | | | | | | | | | | | | | | | | | | | | |

FIG. 154

# FIG. 155

EP 3 247 043 A1

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇕

| 41 | 2 | 12 | 6 | 33 | 1 | 13 | 11 | 26 | 10 | 39 | 43 | 36 | 23 | 42 | 7 | 44 | 20 | 8 | 38 | 18 | 22 |

| 24 | 40 | 4 | 28 | 29 | 19 | 14 | 5 | 9 | 0 | 30 | 25 | 35 | 37 | 27 | 32 | 31 | 34 | 21 | 3 | 15 | 17 |

| 16 |

FIG. 156

## FIG. 157

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇕

| 28 | 21 | 10 | 15 | 8 | 22 | 26 | 2 | 14 | 1 | 27 | 3 | 39 | 20 | 34 | 25 | 12 | 6 | 7 | 40 | 30 | 29 |

| 38 | 16 | 43 | 33 | 4 | 35 | 9 | 32 | 5 | 36 | 0 | 41 | 37 | 18 | 17 | 13 | 24 | 42 | 31 | 23 | 19 | 11 |

| 44 |

EP 3 247 043 A1

# FIG. 158

## FIG. 159

## FIG. 160

## FIG. 161

# FIG. 162

AWGN 64k 16NUC R7/15

Rayleigh(NoErasure)64k 16NUC R7/15

# FIG. 163

# FIG. 164

## FIG. 165

# FIG. 166

AWGN 64k 64NUC R9/15

BER(w bit)
BER(w/o bit)
FER(w bit)
FER(w/o bit)

Rayleigh(No Erasure)64k 64NUC R9/15

BER(w bit)
BER(w/o bit)
FER(w bit)
FER(w/o bit)

## FIG. 167

## FIG. 168

# FIG. 169

AWGN 64k 64NUC R11/15

Rayleigh(NoErasure)64k 64NUC R11/15

# FIG. 170

# FIG. 171

# FIG. 172

AWGN 64k 64NUC R13/15

Rayleigh(NoErasure)64k 64NUC R13/15

# FIG. 173

# FIG. 174

# FIG. 175

# FIG. 176

# FIG. 177

# FIG. 178

AWGN 64k 256NUC R11/15

Rayleigh(No Erasure)64k 256NUC R11/15

# FIG. 179

## FIG. 180

# FIG. 181

AWGN 64k 1024NUC(1D) R7/15

Rayleigh(No Erasure)64k 1024NUC(1D) R7/15

## FIG. 182

# FIG. 183

# FIG. 184

AWGN 64k 1024NUC(1D) R9/15

Rayleigh(No Erasure)64k 1024NUC(1D) R9/15

## FIG. 185

# FIG. 186

AWGN 64k 1024NUC(1D) R13/15

Rayleigh(No Erasure)64k 1024NUC(1D) R13/15

# FIG. 187

64k rate 6/15 LDPC+BCH(t=12)4096NUC AWGN it=50

64k rate 6/15 LDPC+BCH(t=12)4096NUC Rayleigh it=50

# FIG. 188

64k rate 7/15 LDPC+BCH(t=12)4096NUC AWGN it=50

64k rate 7/15 LDPC+BCH(t=12)4096NUC Rayleigh it=50

# FIG. 189

64k rate 8/15 LDPC+BCH(t=12)4096NUC AWGN it=50

64k rate 8/15 LDPC+BCH(t=12)4096NUC Rayleigh it=50

# FIG. 190

64k rate 9/15 LDPC+BCH(t=12)4096NUC AWGN it=50

64k rate 9/15 LDPC+BCH(t=12)4096NUC Rayleigh it=50

# FIG. 191

AWGN 16K QPSK R6/15

Rayleigh(No Erasure)16K QPSK R6/15

# FIG. 192

# FIG. 193

AWGN 16K QPSK R10/15

Legend:
— BER(w/o bil)
— BER(w bil)
---□--- FER(w/o bil)
---■--- FER(w bil)

Rayleigh(No Erasure)16K QPSK R10/15

Legend:
— BER(w/o bil)
— BER(w bil)
---□--- FER(w/o bil)
---■--- FER(w bil)

## FIG. 194

# FIG. 195

# FIG. 196

# FIG. 197

AWGN 16K 16NUC R10/15

Legend: BER(w/o bil), BER(w bil), FER(w/o bil), FER(w bil)

BER/FER vs Es/NO

Rayleigh(No Erasure)16K 16NUC R10/15

Legend: BER(w/o bil), BER(w bil), FER(w/o bil), FER(w bil)

BER/FER vs Es/NO

## FIG. 198

## FIG. 199

# FIG. 200

AWGN 16K 64NUC R8/15

Legend: BER(w/o bil), BER(w bil), FER(w/o bil), FER(w bil)

Es/NO

Rayleigh(No Erasure)16K 64NUC R8/15

Legend: BER(w/o bil), BER(w bil), FER(w/o bil), FER(w bil)

Es/NO

# FIG. 201

# FIG. 202

AWGN 16K 64NUC R12/15

Legend:
- BER(w/o bil)
- BER(w bil)
- FER(w/o bil)
- FER(w bil)

Es/NO

Rayleigh(No Erasure)16K 64NUC R12/15

Legend:
- BER(w/o bil)
- BER(w bil)
- FER(w/o bil)
- FER(w bil)

Es/NO

# FIG. 203

AWGN 16K 256NUC R6/15

Rayleigh(No Erasure)16K 256NUC R6/15

# FIG. 204

# FIG. 205

## FIG. 206

RECEPTION DEVICE — 12

*FIG. 207*

151 — OFDM operation

152 — Frame Management

153 — Frequency De-Interleaver

154 — Demapper

155 — LDPC decoder

156 — BCH decoder → signalling

161 — Frequency De-Interleaver

162 — SISO/MISO decoder

163 — Time De-Interleaver

164 — Demapper

165 — Bit Deinterleaver

166 — LDPC decoder

167 — BCH decoder

168 — BB Descrambler

169 — Null deletion

170 — De-Multiplexer → Output streams

## FIG. 208

DEMAPPER → BLOCK DEINTERLEAVER → GROUP-WISE DEINTERLEAVER → LDPC DECODER → TARGET DATA

164    54    55    166
165

# FIG. 209

```
        ┌─────────────┐
        │    START    │
        └─────────────┘
               │
               ▼
        ┌─────────────┐ S111
        │    DEMAP    │
        └─────────────┘
               │
               ▼
┌───────────────────────────────────────────────────┐ S112
│              BIT-DEINTERLEAVE                       │
│  (BLOCK DEINTERLEAVE, GROUP-WISE DEINTERLEAVE)      │
└───────────────────────────────────────────────────┘
               │
               ▼
        ┌─────────────┐ S113
        │ LDPC DECODE │
        └─────────────┘
               │
               ▼
        ┌─────────────┐
        │     END     │
        └─────────────┘
```

FIG. 210

FIG. 211

FIG. 212

# FIG. 213

FROM
COMMUNICATION CHANNEL

310

RECEPTION DATA
REARRANGEMENT
UNIT

D314

RECEPTION
LLR

306

D313

PROCEED TO NEXT WHEN
RESPECTIVE FIFOS ARE EMPTY

309

$309_1$
$309_2$
$309_3$

D309

DECODED DATA
REARRANGEMENT
UNIT

311

DECODING
RESULT

$309_4$
$309_5$

D315

D316

304

$304_1$

D306₁

D307

PROCEED TO NEXT WHEN
RESPECTIVE FIFOS ARE EMPTY

D301

$304_2$
$304_3$

Matrix DATA

D305

a-4 a-3 a-2 a-1 a-0
b-4 b-3 b-2 b-1 b-0
c-4 c-3 c-2 c-1 c-0

300

$300_1$

D300₁

$302_2$
$302_3$

$302_1$

$302_4$

Matrix DATA

D312

$300_2$

$300_3$

0-8 0-7 0-6 0-5 0-4 0-3 0-2 0-1 0-0
1-8 1-7 1-6 1-5 1-4 1-3 1-2 1-1 1-0
2-8 2-7 2-6 2-5 2-4 2-3 2-2 2-1 2-0
3-8 3-7 3-6 3-5 3-4 3-3 3-2 3-1 3-0

$300_4$

$300_5$

4-8 4-7 4-6 4-5 4-4 4-3 4-2 4-1 4-0
5-8 5-7 5-6 5-5 5-4 5-3 5-2 5-1 5-0

CYCLIC
SHIFT
CIRCUIT

D303

303

D304

$304_4$
$304_5$
$304_6$
$304_7$
$304_8$
$304_9$
$304_{10}$
$304_{11}$
$304_{12}$
$304_{13}$
$304_{14}$
$304_{15}$
$304_{16}$
$304_{17}$
$304_{18}$

d-2 d-1 d-0
e-2 e-1 e-0
f-2 f-1 f-0
g-2 g-1 g-0
h-2 h-1 h-0
i-2 i-1 i-0
j-2 j-1 j-0
k-2 k-1 k-0
l-2 l-1 l-0
m-1 m-0
n-1 n-0
o-1 o-0
p-1 p-0
q-1 q-0
r-1 r-0

D308

$307_1$
$307_2$
$307_3$

$307_4$
$307_5$

307

CYCLIC
SHIFT
CIRCUIT

D310

308

D311

$300_6$

D300₆

301

$302_5$

302

D302

305

D306₁₈

EP 3 247 043 A1

# FIG. 214

FROM COMMUNICATION CHANNEL

RECEPTION LLR — 306

D313

PROCEED TO NEXT WHEN RESPECTIVE FIFOS ARE EMPTY

D309

309

$309_1$  $309_2$  $309_3$

311

DECODED DATA REARRANGEMENT UNIT

DECODING RESULT

$309_4$  D315  $309_5$

D316

304

$304_1$  $D306_1$  D307

PROCEED TO NEXT WHEN RESPECTIVE FIFOS ARE EMPTY

D301

$302_2$  D305
$302_1$  $302_3$
$302_4$

Matrix DATA

$304_2$  | a-4 | a-3 | a-2 | a-1 | a-0 |
$304_3$  | b-4 | b-3 | b-2 | b-1 | b-0 |
Matrix DATA  | c-4 | c-3 | c-2 | c-1 | c-0 |
$304_4$  | d-2 | d-1 | d-0 |
$304_5$  | e-2 | e-1 | e-0 |
$304_6$  | f-2 | f-1 | f-0 |
$304_7$  | g-2 | g-1 | g-0 |
$304_8$  | h-2 | h-1 | h-0 |
$304_9$  | i-2 | i-1 | i-0 |
$304_{10}$  | j-2 | j-1 | j-0 |
$304_{11}$  | k-2 | k-1 | k-0 |
$304_{12}$  | l-2 | l-1 | l-0 |
$304_{13}$  | m-1 | m-0 |
$304_{14}$  | n-1 | n-0 |
$304_{15}$  | o-1 | o-0 |
$304_{16}$  | p-1 | p-0 |
$304_{17}$  | q-1 | q-0 |
$304_{18}$  | r-1 | r-0 |
$D306_{18}$

305

Matrix DATA

300

$300_1$  $D300_1$

D312

| 0-8 | 0-7 | 0-6 | 0-5 | 0-4 | 0-3 | 0-2 | 0-1 | 0-0 |
$300_2$  | 1-8 | 1-7 | 1-6 | 1-5 | 1-4 | 1-3 | 1-2 | 1-1 | 1-0 |
$300_3$  | 2-8 | 2-7 | 2-6 | 2-5 | 2-4 | 2-3 | 2-2 | 2-1 | 2-0 |
| 3-8 | 3-7 | 3-6 | 3-5 | 3-4 | 3-3 | 3-2 | 3-1 | 3-0 |
$300_4$  | 4-8 | 4-7 | 4-6 | 4-5 | 4-4 | 4-3 | 4-2 | 4-1 | 4-0 |
$300_5$  | 5-8 | 5-7 | 5-6 | 5-5 | 5-4 | 5-3 | 5-2 | 5-1 | 5-0 |

$300_6$  $D300_6$

301

D302  D303  303  D304

$302_5$  302

CYCLIC SHIFT CIRCUIT

D308

$307_1$  $307_2$  $307_3$

CYCLIC SHIFT CIRCUIT

$307_4$  D310  308
$307_5$  307

D311

EP 3 247 043 A1

# FIG. 215

54

BLOCK DEINTERLEAVER

Part 1

Column 1    Column C

Row 1

...

Row R1

Part 2

Column 1    Column C

Row 1
Row R2

...

EP 3 247 043 A1

# FIG. 216

EP 3 247 043 A1

# FIG. 217

# FIG. 218

1022

BLOCK INTERLEAVER

Part 1

Column 1 ... Column C

Row 1

Row R1

Part 2

Column 1 ... Column C

Row 1
Row R2

## FIG. 219

| | N=64800 | | | | | |
|---|---|---|---|---|---|---|
| | QPSK | 16QAM | 64QAM | 256QAM | 1024QAM | 4096QAM |
| C | 2 | 4 | 6 | 8 | 10 | 12 |
| R1 | 32400 | 16200 | 10800 | 7920 | 6480 | 5400 |
| R2 | 0 | 0 | 0 | 180 | 0 | 0 |

| | N=16200 | | | | | |
|---|---|---|---|---|---|---|
| | QPSK | 16QAM | 64QAM | 256QAM | 1024QAM | 4096QAM |
| C | 2 | 4 | 6 | 8 | 10 | 12 |
| R1 | 7920 | 3960 | 2520 | 1800 | 1440 | 1080 |
| R2 | 180 | 90 | 180 | 225 | 180 | 270 |

C: column NUMBER (SYMBOL BIT NUMBER)
R1: ROW NUMBER OF Part1
R2: ROW NUMBER OF Part2

EP 3 247 043 A1

# FIG. 220

# FIG. 221

FIG. 222

EP 3 247 043 A1

FIG. 223

# FIG. 224

# FIG. 225

EP 3 247 043 A1

FIG. 226

# FIG. 227

TypeB : Case2

360    Ng=14

PIL OUTPUT | 1 | 2 | 3 | 4 | 5 | 6 | 7 | 8 | 9 | 10 | 11 | 12 | 13 | 14 |

GWI OUTPUT | 4 | 7 | 13 | 2 | 12 | 8 | 10 | 1 | 14 | 11 | 3 | 6 | 9 | 5 |

BLI write    $N_c=4$

360    $N_{r1}=3*360$

Part1

Part2    $N_{r2}=2*360$

BLI read

Part1

Part2

1022    BLOCK INTERLEAVER

EP 3 247 043 A1

# FIG. 228

Case1

GW PATTERN FOR Type A

PIL OUTPUT: | 1 | 2 | 3 | 4 | 5 | 6 | 7 | 8 | 9 | 10 | 11 | 12 |

GWI OUTPUT: | 4 | 12 | 5 | 7 | 8 | 11 | 9 | 10 | 3 | 2 | 1 | 6 |

$360$  $N_g=12$

Type A BLI write  $N_c=4$

$360$  $N_{r1}=3*360$

Part1

BLOCK INTERLEAVER — 1022

GW PATTERN FOR Type B

PIL OUTPUT: | 1 | 2 | 3 | 4 | 5 | 6 | 7 | 8 | 9 | 10 | 11 | 12 |

GWI OUTPUT: | 4 | 7 | 9 | 2 | 12 | 8 | 10 | 1 | 5 | 11 | 3 | 6 |

$360$  $N_g=12$

Type B BLI write  $N_c=4$

$360$  $N_{r1}=3*360$

Part1

BLOCK INTERLEAVER — 1022

EP 3 247 043 A1

FIG. 229

EP 3 247 043 A1

## FIG. 230

| CR MOD | 2 | 3 | 4 | 5 | 6 | 7 | 8 | 9 | 10 | 11 | 12 | 13 |
|---|---|---|---|---|---|---|---|---|---|---|---|---|
| 2 | A | A | A | A | A | A | A | A | A | A | A | A |
| 4 | A | A | A | B | A | A | B | B | A | A | A | A |
| 6 | A | A | A | A | A | B | A | B | B | A | A | B |
| 8 | A | A | A | B | B | B | B | A | B | B | A | B |
| 10 | A | A | A | B | A | B | A | B | B | B | A | A |
| 12 | A | A | A | A | A | A | A | A | A | A | A | A |

EP 3 247 043 A1

# FIG. 231

QPSK CR 2/15:

Original Pattern (A):

BIT GROUP

| 70 | 149 | 136 | 153 | 104 | 110 | 134 | 61 | 129 | 126 | 58 | 150 | 177 | 168 | 78 | 71 | 120 | 60 | 155 | 175 | 9 | 161 |
|----|-----|-----|-----|-----|-----|-----|----|-----|-----|----|-----|-----|-----|----|----|-----|----|-----|-----|---|-----|
| 103 | 123 | 91 | 173 | 57 | 106 | 143 | 151 | 89 | 86 | 35 | 77 | 133 | 31 | 7 | 23 | 51 | 5 | 121 | 83 | 64 | 176 |
| 119 | 98 | 49 | 130 | 128 | 79 | 162 | 32 | 172 | 87 | 131 | 45 | 114 | 93 | 96 | 39 | 68 | 105 | 85 | 109 | 13 | 33 |
| 145 | 18 | 12 | 54 | 111 | 14 | 156 | 8 | 16 | 73 | 2 | 84 | 47 | 42 | 101 | 63 | 88 | 25 | 52 | 170 | 24 | 69 |
| 142 | 178 | 20 | 65 | 97 | 66 | 80 | 11 | 59 | 19 | 115 | 154 | 26 | 147 | 28 | 50 | 160 | 102 | 55 | 139 | 125 | 116 |
| 138 | 167 | 53 | 169 | 165 | 99 | 159 | 148 | 179 | 0 | 146 | 90 | 6 | 100 | 74 | 117 | 48 | 75 | 135 | 41 | 137 | 76 |
| 92 | 164 | 113 | 152 | 72 | 36 | 3 | 163 | 15 | 46 | 21 | 44 | 108 | 34 | 56 | 140 | 127 | 158 | 94 | 67 | 122 | 1 |
| 27 | 171 | 30 | 157 | 112 | 81 | 118 | 43 | 29 | 124 | 22 | 62 | 37 | 40 | 4 | 107 | 166 | 82 | 95 | 10 | 144 | 141 |
| 132 | 174 | 38 | 17 | | | | | | | | | | | | | | | | | | |

Converted Pattern (B):

| 70 | 20 | 149 | 65 | 136 | 97 | 153 | 66 | 104 | 80 | 110 | 11 | 134 | 59 | 61 | 19 | 129 | 115 | 126 | 154 | 58 | 26 |
|----|----|-----|----|-----|----|-----|----|-----|----|-----|----|-----|----|----|----|-----|-----|-----|-----|----|----|
| 150 | 147 | 177 | 28 | 168 | 50 | 78 | 160 | 71 | 102 | 120 | 55 | 60 | 139 | 155 | 125 | 175 | 116 | 9 | 138 | 161 | 167 |
| 103 | 53 | 123 | 169 | 91 | 165 | 173 | 99 | 57 | 159 | 106 | 148 | 143 | 179 | 151 | 0 | 89 | 146 | 86 | 90 | 35 | 6 |
| 77 | 100 | 133 | 74 | 31 | 117 | 7 | 48 | 23 | 75 | 51 | 135 | 5 | 41 | 121 | 137 | 83 | 76 | 64 | 92 | 176 | 164 |
| 119 | 113 | 98 | 152 | 49 | 72 | 130 | 36 | 128 | 3 | 79 | 163 | 162 | 15 | 32 | 46 | 172 | 21 | 87 | 44 | 131 | 108 |
| 45 | 34 | 114 | 56 | 93 | 140 | 96 | 127 | 39 | 158 | 68 | 94 | 105 | 67 | 85 | 122 | 109 | 1 | 13 | 27 | 33 | 171 |
| 145 | 30 | 18 | 157 | 12 | 112 | 54 | 81 | 111 | 118 | 14 | 43 | 156 | 29 | 8 | 124 | 16 | 22 | 73 | 62 | 2 | 37 |
| 84 | 40 | 47 | 4 | 42 | 107 | 101 | 166 | 63 | 82 | 88 | 95 | 25 | 10 | 52 | 144 | 170 | 141 | 24 | 132 | 69 | 174 |
| 142 | 38 | 178 | 17 | | | | | | | | | | | | | | | | | | |

EP 3 247 043 A1

# FIG. 232

QPSK CR 3/15:

Original Pattern (A):

BIT GROUP

| 75 | 170 | 132 | 174 | 7 | 111 | 30 | 4 | 49 | 133 | 50 | 160 | 92 | 106 | 27 | 126 | 116 | 178 | 41 | 166 | 88 | 84 |
|---|---|---|---|---|---|---|---|---|---|---|---|---|---|---|---|---|---|---|---|---|---|
| 80 | 153 | 103 | 51 | 58 | 107 | 167 | 39 | 108 | 24 | 145 | 96 | 74 | 65 | 8 | 40 | 76 | 140 | 44 | 68 | 125 | 119 |
| 82 | 53 | 152 | 102 | 38 | 28 | 86 | 162 | 171 | 61 | 93 | 147 | 117 | 32 | 150 | 26 | 59 | 3 | 148 | 173 | 141 | 130 |
| 154 | 97 | 33 | 172 | 115 | 118 | 127 | 6 | 16 | 0 | 143 | 9 | 100 | 67 | 98 | 110 | 2 | 169 | 47 | 83 | 164 | 155 |
| 123 | 159 | 42 | 105 | 12 | 158 | 81 | 20 | 66 | 57 | 121 | 25 | 1 | 90 | 175 | 35 | 60 | 79 | 87 | 135 | 10 | 139 |
| 156 | 177 | 77 | 89 | 73 | 113 | 52 | 109 | 134 | 36 | 176 | 54 | 69 | 146 | 31 | 15 | 71 | 18 | 95 | 124 | 85 | 14 |
| 78 | 129 | 161 | 19 | 72 | 13 | 122 | 21 | 63 | 137 | 120 | 144 | 91 | 157 | 48 | 34 | 46 | 22 | 29 | 104 | 45 | 56 |
| 151 | 62 | 43 | 94 | 163 | 99 | 64 | 138 | 101 | 23 | 11 | 17 | 136 | 128 | 114 | 112 | 165 | 5 | 142 | 179 | 37 | 70 |
| 131 | 55 | 168 | 149 | | | | | | | | | | | | | | | | | | |

Converted Pattern (B):

| 75 | 42 | 170 | 105 | 132 | 12 | 174 | 158 | 7 | 81 | 111 | 20 | 30 | 66 | 4 | 57 | 49 | 121 | 133 | 25 | 50 | 1 |
|---|---|---|---|---|---|---|---|---|---|---|---|---|---|---|---|---|---|---|---|---|---|
| 160 | 90 | 92 | 175 | 106 | 35 | 27 | 60 | 126 | 79 | 116 | 87 | 178 | 135 | 41 | 10 | 166 | 139 | 88 | 156 | 84 | 177 |
| 80 | 77 | 153 | 89 | 103 | 73 | 51 | 113 | 58 | 52 | 107 | 109 | 167 | 134 | 39 | 36 | 108 | 176 | 24 | 54 | 145 | 69 |
| 96 | 146 | 74 | 31 | 65 | 15 | 8 | 71 | 40 | 18 | 76 | 95 | 140 | 124 | 44 | 85 | 68 | 14 | 125 | 78 | 119 | 129 |
| 82 | 161 | 53 | 19 | 152 | 72 | 102 | 13 | 38 | 122 | 28 | 21 | 86 | 63 | 162 | 137 | 171 | 120 | 61 | 144 | 93 | 91 |
| 147 | 157 | 117 | 48 | 32 | 34 | 150 | 46 | 26 | 22 | 59 | 29 | 3 | 104 | 148 | 45 | 173 | 56 | 141 | 151 | 130 | 62 |
| 154 | 43 | 97 | 94 | 33 | 163 | 172 | 99 | 115 | 64 | 118 | 138 | 127 | 101 | 6 | 23 | 16 | 11 | 0 | 17 | 143 | 136 |
| 9 | 128 | 100 | 114 | 67 | 112 | 98 | 165 | 110 | 5 | 2 | 142 | 169 | 179 | 47 | 37 | 83 | 70 | 164 | 131 | 155 | 55 |
| 123 | 168 | 159 | 149 | | | | | | | | | | | | | | | | | | |

EP 3 247 043 A1

## FIG. 233

QPSK CR 4/15:

Original Pattern (A):

| | | | | | | | | | | | | | | | | | | | | | |
|---|---|---|---|---|---|---|---|---|---|---|---|---|---|---|---|---|---|---|---|---|---|
| 141 | 86 | 22 | 20 | 176 | 21 | 37 | 82 | 6 | 122 | 130 | 40 | 62 | 44 | 24 | 117 | 8 | 145 | 36 | 79 | 172 | 149 |
| 127 | 163 | 9 | 160 | 73 | 100 | 16 | 153 | 124 | 110 | 49 | 154 | 152 | 4 | 168 | 54 | 177 | 158 | 113 | 57 | 2 | 102 |
| 161 | 147 | 18 | 103 | 1 | 41 | 104 | 144 | 39 | 105 | 131 | 77 | 69 | 108 | 159 | 61 | 45 | 156 | 0 | 83 | 157 | 119 |
| 112 | 118 | 92 | 109 | 75 | 67 | 142 | 96 | 51 | 139 | 31 | 166 | 179 | 89 | 167 | 23 | 34 | 60 | 93 | 165 | 128 | 90 |
| 19 | 33 | 70 | 173 | 174 | 129 | 55 | 98 | 88 | 97 | 146 | 123 | 84 | 111 | 132 | 71 | 140 | 136 | 10 | 115 | 63 | 46 |
| 42 | 50 | 138 | 81 | 59 | 53 | 15 | 52 | 72 | 164 | 150 | 29 | 17 | 91 | 101 | 14 | 38 | 35 | 66 | 64 | 7 | 125 |
| 151 | 56 | 126 | 171 | 68 | 121 | 28 | 65 | 106 | 78 | 47 | 143 | 12 | 169 | 120 | 27 | 74 | 48 | 133 | 43 | 116 | 137 |
| 94 | 3 | 25 | 134 | 13 | 107 | 162 | 32 | 99 | 85 | 175 | 80 | 170 | 5 | 135 | 178 | 11 | 26 | 76 | 95 | 87 | 155 |
| 58 | 30 | 148 | 114 | | | | | | | | | | | | | | | | | | |

Converted Pattern (B):

| | | | | | | | | | | | | | | | | | | | | | |
|---|---|---|---|---|---|---|---|---|---|---|---|---|---|---|---|---|---|---|---|---|---|
| 141 | 70 | 86 | 173 | 22 | 174 | 20 | 129 | 176 | 55 | 21 | 98 | 37 | 88 | 82 | 97 | 6 | 146 | 122 | 123 | 130 | 84 |
| 40 | 111 | 62 | 132 | 44 | 71 | 24 | 140 | 117 | 136 | 8 | 10 | 145 | 115 | 36 | 63 | 79 | 46 | 172 | 42 | 149 | 50 |
| 127 | 138 | 163 | 81 | 9 | 59 | 160 | 53 | 73 | 15 | 100 | 52 | 16 | 72 | 153 | 164 | 124 | 150 | 110 | 29 | 49 | 17 |
| 154 | 91 | 152 | 101 | 4 | 14 | 168 | 38 | 54 | 35 | 177 | 66 | 158 | 64 | 113 | 7 | 57 | 125 | 2 | 151 | 102 | 56 |
| 161 | 126 | 147 | 171 | 18 | 68 | 103 | 121 | 1 | 28 | 41 | 65 | 104 | 106 | 144 | 78 | 39 | 47 | 105 | 143 | 131 | 12 |
| 77 | 169 | 69 | 120 | 108 | 27 | 159 | 74 | 61 | 48 | 45 | 133 | 156 | 43 | 0 | 116 | 83 | 137 | 157 | 94 | 119 | 3 |
| 112 | 25 | 118 | 134 | 92 | 13 | 109 | 107 | 75 | 162 | 67 | 32 | 142 | 99 | 96 | 85 | 51 | 175 | 139 | 80 | 31 | 170 |
| 166 | 5 | 179 | 135 | 89 | 178 | 167 | 11 | 23 | 26 | 34 | 76 | 60 | 95 | 93 | 87 | 165 | 155 | 128 | 58 | 90 | 30 |
| 19 | 148 | 33 | 114 | | | | | | | | | | | | | | | | | | |

EP 3 247 043 A1

# FIG. 234

QPSK CR 5/15:

Original Pattern (A): <span>BIT GROUP</span>

| 39 | 47 | 96 | 176 | 33 | 75 | 165 | 38 | 27 | 58 | 90 | 76 | 17 | 46 | 10 | 91 | 133 | 69 | 171 | 32 | 117 | 78 |
|----|----|----|-----|----|----|-----|----|----|----|----|----|----|----|----|----|-----|----|-----|----|-----|----|
| 13 | 146 | 101 | 36 | 0 | 138 | 25 | 77 | 122 | 49 | 14 | 125 | 140 | 93 | 130 | 2 | 104 | 102 | 128 | 4 | 111 | 151 |
| 84 | 167 | 35 | 127 | 156 | 55 | 82 | 85 | 66 | 114 | 8 | 147 | 115 | 113 | 5 | 31 | 100 | 106 | 48 | 52 | 67 | 107 |
| 18 | 126 | 112 | 50 | 9 | 143 | 28 | 160 | 71 | 79 | 43 | 98 | 86 | 94 | 64 | 3 | 166 | 105 | 103 | 118 | 63 | 51 |
| 139 | 172 | 141 | 175 | 56 | 74 | 95 | 29 | 45 | 129 | 120 | 168 | 92 | 150 | 7 | 162 | 153 | 137 | 108 | 159 | 157 | 173 |
| 23 | 89 | 132 | 57 | 37 | 70 | 134 | 40 | 21 | 149 | 80 | 1 | 121 | 59 | 110 | 142 | 152 | 15 | 154 | 145 | 12 | 170 |
| 54 | 155 | 99 | 22 | 123 | 72 | 177 | 131 | 116 | 44 | 158 | 73 | 11 | 65 | 164 | 119 | 174 | 34 | 83 | 53 | 24 | 42 |
| 60 | 26 | 161 | 68 | 178 | 41 | 148 | 109 | 87 | 144 | 135 | 20 | 62 | 81 | 169 | 124 | 6 | 19 | 30 | 163 | 61 | 179 |
| 136 | 97 | 16 | 88 | | | | | | | | | | | | | | | | | | |

⬇

Converted Pattern (B):

| 39 | 141 | 47 | 175 | 96 | 56 | 176 | 74 | 33 | 95 | 75 | 29 | 165 | 45 | 38 | 129 | 27 | 120 | 58 | 168 | 90 | 92 |
|----|-----|----|-----|----|----|-----|----|----|----|----|----|-----|----|----|-----|----|-----|----|-----|----|----|
| 76 | 150 | 17 | 7 | 46 | 162 | 10 | 153 | 91 | 137 | 133 | 108 | 69 | 159 | 171 | 157 | 32 | 173 | 117 | 23 | 78 | 89 |
| 13 | 132 | 146 | 57 | 101 | 37 | 36 | 70 | 0 | 134 | 138 | 40 | 25 | 21 | 77 | 149 | 122 | 80 | 49 | 1 | 14 | 121 |
| 125 | 59 | 140 | 110 | 93 | 142 | 130 | 152 | 2 | 15 | 104 | 154 | 102 | 145 | 128 | 12 | 4 | 170 | 111 | 54 | 151 | 155 |
| 84 | 99 | 167 | 22 | 35 | 123 | 127 | 72 | 156 | 177 | 55 | 131 | 82 | 116 | 85 | 44 | 66 | 158 | 114 | 73 | 8 | 11 |
| 147 | 65 | 115 | 164 | 113 | 119 | 5 | 174 | 31 | 34 | 100 | 83 | 106 | 53 | 48 | 24 | 52 | 42 | 67 | 60 | 107 | 26 |
| 18 | 161 | 126 | 68 | 112 | 178 | 50 | 41 | 9 | 148 | 143 | 109 | 28 | 87 | 160 | 144 | 71 | 135 | 79 | 20 | 43 | 62 |
| 98 | 81 | 86 | 169 | 94 | 124 | 64 | 6 | 3 | 19 | 166 | 30 | 105 | 163 | 103 | 61 | 118 | 179 | 63 | 136 | 51 | 97 |
| 139 | 16 | 172 | 88 | | | | | | | | | | | | | | | | | | |

# FIG. 235

QPSK CR 6/15:

Original Pattern (A):

BIT GROUP

| 0 | 14 | 19 | 21 | 2 | 11 | 22 | 9 | 8 | 7 | 16 | 3 | 26 | 24 | 27 | 80 | 100 | 121 | 107 | 31 | 36 | 42 |
|---|----|----|----|---|----|----|---|---|---|----|---|----|----|----|----|-----|-----|-----|----|----|----|
| 46 | 49 | 75 | 93 | 127 | 95 | 119 | 73 | 61 | 63 | 117 | 89 | 99 | 129 | 52 | 111 | 124 | 48 | 122 | 82 | 106 | 91 |
| 92 | 71 | 103 | 102 | 81 | 113 | 101 | 97 | 33 | 115 | 59 | 112 | 90 | 51 | 126 | 85 | 123 | 40 | 83 | 53 | 69 | 70 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 4 | 5 | 10 | 12 | 20 | 6 | 18 | 13 | 17 | 15 | 1 | 29 | 28 | 23 | 25 | 67 | 116 | 66 | 104 | 44 |
| 50 | 47 | 84 | 76 | 65 | 130 | 56 | 128 | 77 | 39 | 94 | 87 | 120 | 62 | 88 | 74 | 35 | 110 | 131 | 98 | 60 | 37 |
| 45 | 78 | 125 | 41 | 34 | 118 | 38 | 72 | 108 | 58 | 43 | 109 | 57 | 105 | 68 | 86 | 79 | 96 | 32 | 114 | 64 | 55 |
| 30 | 54 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 |

Converted Pattern (B):

| 0 | 4 | 14 | 5 | 19 | 10 | 21 | 12 | 2 | 20 | 11 | 6 | 22 | 18 | 9 | 13 | 8 | 17 | 7 | 15 | 16 | 1 |
|---|---|----|---|----|----|----|----|---|----|----|---|----|----|---|----|---|----|---|----|----|---|
| 3 | 29 | 26 | 28 | 24 | 23 | 27 | 25 | 80 | 67 | 100 | 116 | 121 | 66 | 107 | 104 | 31 | 44 | 36 | 50 | 42 | 47 |
| 46 | 84 | 49 | 76 | 75 | 65 | 93 | 130 | 127 | 56 | 95 | 128 | 119 | 77 | 73 | 39 | 61 | 94 | 63 | 87 | 117 | 120 |
| 89 | 62 | 99 | 88 | 129 | 74 | 52 | 35 | 111 | 110 | 124 | 131 | 48 | 98 | 122 | 60 | 82 | 37 | 106 | 45 | 91 | 78 |
| 92 | 125 | 71 | 41 | 103 | 34 | 102 | 118 | 81 | 38 | 113 | 72 | 101 | 108 | 97 | 58 | 33 | 43 | 115 | 109 | 59 | 57 |
| 112 | 105 | 90 | 68 | 51 | 86 | 126 | 79 | 85 | 96 | 123 | 32 | 40 | 114 | 83 | 64 | 53 | 55 | 69 | 30 | 70 | 54 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 |

EP 3 247 043 A1

# FIG. 236

EP 3 247 043 A1

QPSK CR 7/15:

Original Pattern (A):

BIT GROUP

| | | | | | | | | | | | | | | | | | | | | | |
|---|---|---|---|---|---|---|---|---|---|---|---|---|---|---|---|---|---|---|---|---|---|
| 152 | 172 | 113 | 167 | 100 | 163 | 159 | 144 | 114 | 47 | 161 | 125 | 99 | 89 | 179 | 123 | 149 | 177 | 1 | 132 | 37 | 26 |
| 16 | 57 | 166 | 81 | 133 | 112 | 33 | 151 | 117 | 83 | 52 | 178 | 85 | 124 | 143 | 28 | 59 | 130 | 31 | 157 | 170 | 44 |
| 61 | 102 | 155 | 111 | 153 | 55 | 54 | 176 | 17 | 68 | 169 | 20 | 104 | 38 | 147 | 7 | 174 | 6 | 90 | 15 | 56 | 120 |
| 13 | 34 | 48 | 122 | 110 | 154 | 76 | 64 | 75 | 84 | 162 | 77 | 103 | 156 | 128 | 150 | 87 | 27 | 42 | 3 | 23 | 96 |
| 171 | 145 | 91 | 24 | 78 | 5 | 69 | 175 | 8 | 29 | 106 | 137 | 131 | 43 | 93 | 160 | 108 | 164 | 12 | 140 | 71 | 63 |
| 141 | 109 | 129 | 82 | 80 | 173 | 105 | 9 | 66 | 65 | 92 | 32 | 41 | 72 | 74 | 4 | 36 | 94 | 67 | 158 | 10 | 88 |
| 142 | 45 | 126 | 2 | 86 | 118 | 73 | 79 | 121 | 148 | 95 | 70 | 51 | 53 | 21 | 115 | 135 | 25 | 168 | 11 | 136 | 18 |
| 138 | 134 | 119 | 146 | 0 | 97 | 22 | 165 | 40 | 19 | 60 | 46 | 14 | 49 | 139 | 58 | 101 | 39 | 116 | 127 | 30 | 98 |
| 50 | 107 | 35 | 62 | | | | | | | | | | | | | | | | | | |

⇩

Converted Pattern (B):

| | | | | | | | | | | | | | | | | | | | | | |
|---|---|---|---|---|---|---|---|---|---|---|---|---|---|---|---|---|---|---|---|---|---|
| 152 | 91 | 172 | 24 | 113 | 78 | 167 | 5 | 100 | 69 | 163 | 175 | 159 | 8 | 144 | 29 | 114 | 106 | 47 | 137 | 161 | 131 |
| 125 | 43 | 99 | 93 | 89 | 160 | 179 | 108 | 123 | 164 | 149 | 12 | 177 | 40 | 1 | 71 | 132 | 63 | 37 | 141 | 26 | 109 |
| 16 | 129 | 57 | 82 | 166 | 80 | 81 | 173 | 133 | 105 | 112 | 9 | 33 | 66 | 151 | 65 | 117 | 92 | 83 | 32 | 52 | 41 |
| 178 | 72 | 85 | 74 | 124 | 4 | 143 | 36 | 28 | 94 | 59 | 67 | 130 | 158 | 31 | 10 | 157 | 88 | 170 | 142 | 44 | 45 |
| 61 | 126 | 102 | 2 | 155 | 86 | 111 | 118 | 153 | 73 | 55 | 79 | 54 | 121 | 176 | 148 | 17 | 95 | 68 | 70 | 169 | 51 |
| 20 | 53 | 104 | 21 | 38 | 115 | 147 | 135 | 7 | 25 | 174 | 168 | 6 | 11 | 90 | 136 | 15 | 18 | 56 | 138 | 120 | 134 |
| 13 | 119 | 34 | 146 | 48 | 0 | 122 | 97 | 110 | 22 | 154 | 165 | 76 | 40 | 64 | 19 | 75 | 60 | 84 | 46 | 162 | 14 |
| 77 | 49 | 103 | 139 | 156 | 58 | 128 | 101 | 150 | 39 | 87 | 116 | 27 | 127 | 42 | 30 | 3 | 98 | 23 | 50 | 96 | 107 |
| 171 | 35 | 145 | 62 | | | | | | | | | | | | | | | | | | |

EP 3 247 043 A1

# FIG. 237

QPSK CR 8/15:

Original Pattern (A):                                                                                          BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
| 44 | 46 | 48 | 50 | 52 | 54 | 56 | 58 | 60 | 62 | 64 | 66 | 68 | 70 | 72 | 74 | 76 | 78 | 80 | 82 | 84 | 86 |
| 88 | 90 | 92 | 94 | 96 | 98 | 100 | 102 | 104 | 106 | 108 | 110 | 112 | 114 | 116 | 118 | 120 | 122 | 124 | 126 | 128 | 130 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 1 | 3 | 5 | 7 | 9 | 11 | 13 | 15 | 17 | 19 | 21 | 23 | 25 | 27 | 29 | 31 | 33 | 35 | 37 | 39 |
| 41 | 43 | 45 | 47 | 49 | 51 | 53 | 55 | 57 | 59 | 61 | 63 | 65 | 67 | 69 | 71 | 73 | 75 | 77 | 79 | 81 | 83 |
| 85 | 87 | 89 | 91 | 93 | 95 | 97 | 99 | 101 | 103 | 105 | 107 | 109 | 111 | 113 | 115 | 117 | 119 | 121 | 123 | 125 | 127 |
| 129 | 131 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 |

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 |

# FIG. 238

EP 3 247 043 A1

QPSK CR 9/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
|---|---|---|---|---|----|----|----|----|----|----|----|----|----|----|----|----|----|----|----|----|----|
| 44 | 46 | 48 | 50 | 52 | 54 | 56 | 58 | 60 | 62 | 64 | 66 | 68 | 70 | 72 | 74 | 76 | 78 | 80 | 82 | 84 | 86 |
| 88 | 90 | 92 | 94 | 96 | 98 | 100 | 102 | 104 | 106 | 108 | 110 | 112 | 114 | 116 | 118 | 120 | 122 | 124 | 126 | 128 | 130 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 1 | 3 | 5 | 7 | 9 | 11 | 13 | 15 | 17 | 19 | 21 | 23 | 25 | 27 | 29 | 31 | 33 | 35 | 37 | 39 |
| 41 | 43 | 45 | 47 | 49 | 51 | 53 | 55 | 57 | 59 | 61 | 63 | 65 | 67 | 69 | 71 | 73 | 75 | 77 | 79 | 81 | 83 |
| 85 | 87 | 89 | 91 | 93 | 95 | 97 | 99 | 101 | 103 | 105 | 107 | 109 | 111 | 113 | 115 | 117 | 119 | 121 | 123 | 125 | 127 |
| 129 | 131 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 | | | | | | | | | | | | | | | | | | |

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

# FIG. 239

QPSK CR 10/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
|---|---|---|---|---|----|----|----|----|----|----|----|----|----|----|----|----|----|----|----|----|----|
| 44 | 46 | 48 | 50 | 52 | 54 | 56 | 58 | 60 | 62 | 64 | 66 | 68 | 70 | 72 | 74 | 76 | 78 | 80 | 82 | 84 | 86 |
| 88 | 90 | 92 | 94 | 96 | 98 | 100 | 102 | 104 | 106 | 108 | 110 | 112 | 114 | 116 | 118 | 120 | 122 | 124 | 126 | 128 | 130 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 1 | 3 | 5 | 7 | 9 | 11 | 13 | 15 | 17 | 19 | 21 | 23 | 25 | 27 | 29 | 31 | 33 | 35 | 37 | 39 |
| 41 | 43 | 45 | 47 | 49 | 51 | 53 | 55 | 57 | 59 | 61 | 63 | 65 | 67 | 69 | 71 | 73 | 75 | 77 | 79 | 81 | 83 |
| 85 | 87 | 89 | 91 | 93 | 95 | 97 | 99 | 101 | 103 | 105 | 107 | 109 | 111 | 113 | 115 | 117 | 119 | 121 | 123 | 125 | 127 |
| 129 | 131 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 | | | | | | | | | | | | | | | | | | |

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

EP 3 247 043 A1

# FIG. 240

QPSK CR 11/15:

Original Pattern (A):

<span style="float:right">BIT GROUP</span>

| | | | | | | | | | | | | | | | | | | | | | |
|---|---|---|---|---|---|---|---|---|---|---|---|---|---|---|---|---|---|---|---|---|---|---|
| 0 | 14 | 19 | 21 | 2 | 11 | 22 | 9 | 8 | 7 | 16 | 3 | 26 | 24 | 27 | 80 | 100 | 121 | 107 | 31 | 36 | 42 |
| 46 | 49 | 75 | 93 | 127 | 95 | 119 | 73 | 61 | 63 | 117 | 89 | 99 | 129 | 52 | 111 | 124 | 48 | 122 | 82 | 106 | 91 |
| 92 | 71 | 103 | 102 | 81 | 113 | 101 | 97 | 33 | 115 | 59 | 112 | 90 | 51 | 126 | 85 | 123 | 40 | 83 | 53 | 69 | 70 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 4 | 5 | 10 | 12 | 20 | 6 | 18 | 13 | 17 | 15 | 1 | 29 | 28 | 23 | 25 | 67 | 116 | 66 | 104 | 44 |
| 50 | 47 | 84 | 76 | 65 | 130 | 56 | 128 | 77 | 39 | 94 | 87 | 120 | 62 | 88 | 74 | 35 | 110 | 131 | 98 | 60 | 37 |
| 45 | 78 | 125 | 41 | 34 | 118 | 38 | 72 | 108 | 58 | 43 | 109 | 57 | 105 | 68 | 86 | 79 | 96 | 32 | 114 | 64 | 55 |
| 30 | 54 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 | | | | | | | | | | | | | | | | | | |

Converted Pattern (B):

| | | | | | | | | | | | | | | | | | | | | | |
|---|---|---|---|---|---|---|---|---|---|---|---|---|---|---|---|---|---|---|---|---|---|---|
| 0 | 4 | 14 | 5 | 19 | 10 | 21 | 12 | 2 | 20 | 11 | 6 | 22 | 18 | 9 | 13 | 8 | 17 | 7 | 15 | 16 | 1 |
| 3 | 29 | 26 | 28 | 24 | 23 | 27 | 25 | 80 | 67 | 100 | 116 | 121 | 66 | 107 | 104 | 31 | 44 | 36 | 50 | 42 | 47 |
| 46 | 84 | 49 | 76 | 75 | 65 | 93 | 130 | 127 | 56 | 95 | 128 | 119 | 77 | 73 | 39 | 61 | 94 | 63 | 87 | 117 | 120 |
| 89 | 62 | 99 | 88 | 129 | 74 | 52 | 35 | 111 | 110 | 124 | 131 | 48 | 98 | 122 | 60 | 82 | 37 | 106 | 45 | 91 | 78 |
| 92 | 125 | 71 | 41 | 103 | 34 | 102 | 118 | 81 | 38 | 113 | 72 | 101 | 108 | 97 | 58 | 33 | 43 | 115 | 109 | 59 | 57 |
| 112 | 105 | 90 | 68 | 51 | 86 | 126 | 79 | 85 | 96 | 123 | 32 | 40 | 114 | 83 | 64 | 53 | 55 | 69 | 30 | 70 | 54 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

EP 3 247 043 A1

# FIG. 241

QPSK CR 12/15:

Original Pattern (A):

BIT GROUP

| | | | | | | | | | | | | | | | | | | | | |
|---|---|---|---|---|---|---|---|---|---|---|---|---|---|---|---|---|---|---|---|---|---|
| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
| 44 | 46 | 48 | 50 | 52 | 54 | 56 | 58 | 60 | 62 | 64 | 66 | 68 | 70 | 72 | 74 | 76 | 78 | 80 | 82 | 84 | 86 |
| 88 | 90 | 92 | 94 | 96 | 98 | 100 | 102 | 104 | 106 | 108 | 110 | 112 | 114 | 116 | 118 | 120 | 122 | 124 | 126 | 128 | 130 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 1 | 3 | 5 | 7 | 9 | 11 | 13 | 15 | 17 | 19 | 21 | 23 | 25 | 27 | 29 | 31 | 33 | 35 | 37 | 39 |
| 41 | 43 | 45 | 47 | 49 | 51 | 53 | 55 | 57 | 59 | 61 | 63 | 65 | 67 | 69 | 71 | 73 | 75 | 77 | 79 | 81 | 83 |
| 85 | 87 | 89 | 91 | 93 | 95 | 97 | 99 | 101 | 103 | 105 | 107 | 109 | 111 | 113 | 115 | 117 | 119 | 121 | 123 | 125 | 127 |
| 129 | 131 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 | | | | | | | | | | | | | | | | | | |

Converted Pattern (B):

| | | | | | | | | | | | | | | | | | | | | |
|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

# FIG. 242

QPSK CR 13/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
| 44 | 46 | 48 | 50 | 52 | 54 | 56 | 58 | 60 | 62 | 64 | 66 | 68 | 70 | 72 | 74 | 76 | 78 | 80 | 82 | 84 | 86 |
| 88 | 90 | 92 | 94 | 96 | 98 | 100 | 102 | 104 | 106 | 108 | 110 | 112 | 114 | 116 | 118 | 120 | 122 | 124 | 126 | 128 | 130 |
| 132 | 134 | 136 | 138 | 140 | 142 | 144 | 146 | 148 | 150 | 152 | 154 | 156 | 158 | 160 | 162 | 164 | 166 | 168 | 170 | 172 | 174 |
| 176 | 178 | 1 | 3 | 5 | 7 | 9 | 11 | 13 | 15 | 17 | 19 | 21 | 23 | 25 | 27 | 29 | 31 | 33 | 35 | 37 | 39 |
| 41 | 43 | 45 | 47 | 49 | 51 | 53 | 55 | 57 | 59 | 61 | 63 | 65 | 67 | 69 | 71 | 73 | 75 | 77 | 79 | 81 | 83 |
| 85 | 87 | 89 | 91 | 93 | 95 | 97 | 99 | 101 | 103 | 105 | 107 | 109 | 111 | 113 | 115 | 117 | 119 | 121 | 123 | 125 | 127 |
| 129 | 131 | 133 | 135 | 137 | 139 | 141 | 143 | 145 | 147 | 149 | 151 | 153 | 155 | 157 | 159 | 161 | 163 | 165 | 167 | 169 | 171 |
| 173 | 175 | 177 | 179 |

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 |

EP 3 247 043 A1

# FIG. 243

16QAM CR 2/15:

Original Pattern (A):

BIT GROUP

| | | | | | | | | | | | | | | | | | | | | |
|---|---|---|---|---|---|---|---|---|---|---|---|---|---|---|---|---|---|---|---|---|
| 5 | 58 | 29 | 154 | 125 | 34 | 0 | 169 | 80 | 59 | 13 | 42 | 77 | 167 | 32 | 87 | 24 | 92 | 124 | 143 | 114 | 120 |
| 166 | 138 | 64 | 136 | 149 | 57 | 18 | 101 | 119 | 35 | 33 | 113 | 75 | 108 | 104 | 3 | 27 | 39 | 172 | 159 | 129 | 62 |
| 146 | 142 | 19 | 147 | 111 | 70 | 74 | 79 | 10 | 132 | 1 | 161 | 155 | 90 | 15 | 133 | 47 | 112 | 84 | 28 | 160 | 117 |
| 150 | 49 | 7 | 81 | 44 | 63 | 118 | 4 | 158 | 148 | 82 | 69 | 36 | 162 | 86 | 71 | 22 | 26 | 61 | 40 | 126 | 170 |
| 177 | 23 | 91 | 68 | 56 | 110 | 21 | 93 | 107 | 85 | 20 | 128 | 109 | 66 | 83 | 12 | 179 | 141 | 97 | 78 | 157 | 72 |
| 130 | 99 | 165 | 45 | 11 | 152 | 168 | 14 | 16 | 2 | 137 | 140 | 121 | 173 | 50 | 55 | 94 | 144 | 73 | 51 | 98 | 174 |
| 178 | 17 | 100 | 9 | 122 | 54 | 38 | 156 | 131 | 127 | 164 | 102 | 116 | 176 | 30 | 37 | 139 | 95 | 43 | 135 | 53 | 89 |
| 106 | 171 | 76 | 175 | 153 | 96 | 151 | 115 | 52 | 6 | 123 | 134 | 31 | 103 | 163 | 65 | 105 | 48 | 25 | 8 | 60 | 67 |
| 88 | 46 | 41 | 145 | | | | | | | | | | | | | | | | | | |

⇩

Converted Pattern (B):

| | | | | | | | | | | | | | | | | | | | | |
|---|---|---|---|---|---|---|---|---|---|---|---|---|---|---|---|---|---|---|---|---|---|
| 5 | 142 | 91 | 9 | 58 | 19 | 68 | 122 | 29 | 147 | 56 | 54 | 154 | 111 | 110 | 38 | 125 | 70 | 21 | 156 | 34 | 74 |
| 93 | 131 | 0 | 79 | 107 | 127 | 169 | 10 | 85 | 164 | 80 | 132 | 20 | 102 | 59 | 1 | 128 | 116 | 13 | 161 | 109 | 176 |
| 42 | 155 | 66 | 30 | 77 | 90 | 83 | 37 | 167 | 15 | 12 | 139 | 32 | 133 | 179 | 95 | 87 | 47 | 141 | 43 | 24 | 112 |
| 97 | 135 | 92 | 84 | 78 | 53 | 124 | 28 | 157 | 89 | 143 | 160 | 72 | 106 | 114 | 117 | 130 | 171 | 120 | 150 | 99 | 76 |
| 166 | 49 | 165 | 175 | 138 | 7 | 45 | 153 | 64 | 81 | 11 | 96 | 136 | 44 | 152 | 151 | 149 | 63 | 168 | 115 | 57 | 118 |
| 14 | 52 | 18 | 4 | 16 | 6 | 101 | 158 | 2 | 123 | 119 | 148 | 137 | 134 | 35 | 82 | 140 | 31 | 33 | 69 | 121 | 103 |
| 113 | 36 | 173 | 163 | 75 | 162 | 50 | 65 | 108 | 86 | 55 | 105 | 104 | 71 | 94 | 48 | 3 | 22 | 144 | 25 | 27 | 26 |
| 73 | 8 | 39 | 61 | 51 | 60 | 172 | 40 | 98 | 67 | 159 | 126 | 174 | 88 | 129 | 170 | 178 | 46 | 62 | 177 | 17 | 41 |
| 146 | 23 | 100 | 145 | | | | | | | | | | | | | | | | | | |

# FIG. 244

16QAM CR 3/15:

Original Pattern (A):

BIT GROUP

| 52 | 92 | 175 | 26 | 45 | 81 | 117 | 74 | 119 | 147 | 120 | 135 | 144 | 87 | 3 | 51 | 20 | 170 | 143 | 125 | 15 | 39 |
|---|---|---|---|---|---|---|---|---|---|---|---|---|---|---|---|---|---|---|---|---|---|
| 5 | 174 | 79 | 16 | 176 | 44 | 19 | 69 | 11 | 111 | 121 | 37 | 160 | 88 | 50 | 76 | 129 | 138 | 157 | 86 | 113 | 164 |
| 142 | 98 | 9 | 93 | 166 | 78 | 73 | 167 | 168 | 40 | 131 | 27 | 89 | 156 | 177 | 171 | 116 | 152 | 0 | 127 | 36 | 8 |
| 153 | 59 | 75 | 13 | 105 | 55 | 122 | 132 | 172 | 2 | 58 | 126 | 162 | 30 | 77 | 158 | 17 | 96 | 100 | 42 | 63 | 134 |
| 154 | 6 | 90 | 128 | 83 | 60 | 146 | 124 | 178 | 99 | 123 | 108 | 133 | 159 | 151 | 145 | 61 | 53 | 68 | 31 | 41 | 94 |
| 35 | 21 | 49 | 82 | 80 | 4 | 155 | 7 | 57 | 95 | 62 | 56 | 65 | 140 | 163 | 148 | 23 | 161 | 169 | 47 | 67 | 139 |
| 72 | 43 | 110 | 46 | 150 | 109 | 115 | 32 | 14 | 179 | 85 | 165 | 112 | 25 | 64 | 173 | 10 | 102 | 114 | 71 | 66 | 84 |
| 24 | 141 | 29 | 104 | 107 | 54 | 12 | 91 | 1 | 118 | 136 | 18 | 101 | 149 | 130 | 103 | 106 | 38 | 70 | 48 | 28 | 137 |
| 97 | 34 | 22 | 33 | | | | | | | | | | | | | | | | | | |

⇩

Converted Pattern (B):

| 52 | 98 | 90 | 46 | 92 | 9 | 128 | 150 | 175 | 93 | 83 | 109 | 26 | 166 | 60 | 115 | 45 | 78 | 146 | 32 | 81 | 73 |
|---|---|---|---|---|---|---|---|---|---|---|---|---|---|---|---|---|---|---|---|---|---|
| 124 | 14 | 117 | 167 | 178 | 179 | 74 | 168 | 99 | 85 | 119 | 40 | 123 | 165 | 147 | 131 | 108 | 112 | 120 | 27 | 133 | 25 |
| 135 | 89 | 159 | 64 | 144 | 156 | 151 | 173 | 87 | 177 | 145 | 10 | 3 | 171 | 61 | 102 | 51 | 116 | 53 | 114 | 20 | 152 |
| 68 | 71 | 170 | 0 | 31 | 66 | 143 | 127 | 41 | 84 | 125 | 36 | 94 | 24 | 15 | 8 | 35 | 141 | 39 | 153 | 21 | 29 |
| 5 | 59 | 49 | 104 | 174 | 75 | 82 | 107 | 79 | 13 | 80 | 54 | 16 | 105 | 4 | 12 | 176 | 55 | 155 | 91 | 44 | 122 |
| 7 | 1 | 19 | 132 | 57 | 118 | 69 | 172 | 95 | 136 | 11 | 2 | 62 | 18 | 111 | 58 | 56 | 101 | 121 | 126 | 65 | 149 |
| 37 | 162 | 140 | 130 | 160 | 30 | 163 | 103 | 88 | 77 | 148 | 106 | 50 | 158 | 23 | 38 | 76 | 17 | 161 | 70 | 129 | 96 |
| 169 | 48 | 138 | 100 | 47 | 28 | 157 | 42 | 67 | 137 | 86 | 63 | 139 | 97 | 113 | 134 | 72 | 34 | 164 | 154 | 43 | 22 |
| 142 | 6 | 110 | 33 | | | | | | | | | | | | | | | | | | |

EP 3 247 043 A1

## FIG. 245

16QAM CR 4/15:

Original Pattern (A):

EP 3 247 043 A1

BIT GROUP

| | | | | | | | | | | | | | | | | | | | | | |
|---|---|---|---|---|---|---|---|---|---|---|---|---|---|---|---|---|---|---|---|---|---|
| 165 | 8 | 136 | 2 | 58 | 30 | 127 | 64 | 38 | 164 | 123 | 45 | 78 | 17 | 47 | 105 | 159 | 134 | 124 | 147 | 148 | 109 |
| 67 | 98 | 157 | 57 | 156 | 170 | 46 | 12 | 172 | 29 | 9 | 3 | 144 | 97 | 83 | 151 | 26 | 52 | 10 | 39 | 50 | 104 |
| 92 | 163 | 72 | 125 | 36 | 14 | 55 | 48 | 1 | 149 | 33 | 110 | 6 | 130 | 140 | 89 | 77 | 22 | 171 | 139 | 112 | 113 |
| 152 | 16 | 7 | 85 | 11 | 28 | 153 | 73 | 62 | 44 | 135 | 116 | 4 | 61 | 117 | 53 | 111 | 178 | 94 | 81 | 68 | 114 |
| 173 | 75 | 101 | 88 | 65 | 99 | 126 | 141 | 43 | 15 | 18 | 90 | 35 | 24 | 142 | 25 | 120 | 19 | 154 | 0 | 174 | 93 |
| 167 | 150 | 107 | 86 | 129 | 175 | 87 | 21 | 66 | 106 | 82 | 179 | 118 | 41 | 95 | 145 | 37 | 23 | 168 | 166 | 49 | 103 |
| 108 | 56 | 91 | 69 | 128 | 121 | 96 | 133 | 100 | 161 | 143 | 119 | 102 | 59 | 20 | 40 | 70 | 79 | 80 | 51 | 13 | 177 |
| 131 | 132 | 176 | 155 | 31 | 63 | 5 | 162 | 76 | 42 | 160 | 115 | 71 | 158 | 54 | 137 | 146 | 32 | 169 | 122 | 138 | 84 |
| 74 | 60 | 34 | 27 | | | | | | | | | | | | | | | | | | |

Converted Pattern (B):

| | | | | | | | | | | | | | | | | | | | | | |
|---|---|---|---|---|---|---|---|---|---|---|---|---|---|---|---|---|---|---|---|---|---|
| 165 | 163 | 101 | 69 | 8 | 72 | 88 | 128 | 136 | 125 | 65 | 121 | 2 | 36 | 99 | 96 | 58 | 14 | 126 | 133 | 30 | 55 |
| 141 | 100 | 127 | 48 | 43 | 161 | 64 | 1 | 15 | 143 | 38 | 149 | 18 | 119 | 164 | 33 | 90 | 102 | 123 | 110 | 35 | 59 |
| 45 | 6 | 24 | 20 | 78 | 130 | 142 | 40 | 17 | 140 | 25 | 70 | 47 | 89 | 120 | 79 | 105 | 77 | 19 | 80 | 159 | 22 |
| 154 | 51 | 134 | 171 | 0 | 13 | 124 | 139 | 174 | 177 | 147 | 112 | 93 | 131 | 148 | 113 | 167 | 132 | 109 | 152 | 150 | 176 |
| 67 | 16 | 107 | 155 | 98 | 7 | 86 | 31 | 157 | 85 | 129 | 63 | 57 | 11 | 175 | 5 | 156 | 28 | 87 | 162 | 170 | 153 |
| 21 | 76 | 46 | 73 | 66 | 42 | 12 | 62 | 106 | 160 | 172 | 44 | 82 | 115 | 29 | 135 | 179 | 71 | 9 | 116 | 118 | 158 |
| 3 | 4 | 41 | 54 | 144 | 61 | 95 | 137 | 97 | 117 | 145 | 146 | 83 | 53 | 37 | 32 | 151 | 111 | 23 | 169 | 26 | 178 |
| 168 | 122 | 52 | 94 | 166 | 138 | 10 | 81 | 49 | 84 | 39 | 68 | 103 | 74 | 50 | 114 | 108 | 60 | 104 | 173 | 56 | 34 |
| 92 | 75 | 91 | 27 | | | | | | | | | | | | | | | | | | |

# FIG. 246

16QAM CR 5/15:

Original Pattern (B):

BIT GROUP

| 129 | 65 | 160 | 140 | 32 | 50 | 162 | 86 | 177 | 57 | 157 | 9 | 134 | 104 | 24 | 7 | 122 | 46 | 17 | 77 | 31 | 92 |
|---|---|---|---|---|---|---|---|---|---|---|---|---|---|---|---|---|---|---|---|---|---|
| 163 | 148 | 133 | 99 | 18 | 0 | 167 | 101 | 110 | 135 | 124 | 71 | 107 | 5 | 123 | 69 | 108 | 141 | 179 | 96 | 113 | 83 |
| 176 | 52 | 117 | 81 | 125 | 59 | 15 | 137 | 170 | 63 | 112 | 88 | 34 | 61 | 106 | 3 | 42 | 100 | 152 | 87 | 171 | 72 |
| 161 | 4 | 178 | 64 | 150 | 10 | 128 | 49 | 26 | 75 | 41 | 102 | 28 | 2 | 168 | 93 | 156 | 12 | 38 | 45 | 151 | 142 |
| 44 | 66 | 25 | 139 | 173 | 51 | 29 | 147 | 175 | 90 | 164 | 80 | 131 | 58 | 114 | 145 | 121 | 70 | 115 | 146 | 120 | 55 |
| 158 | 8 | 39 | 97 | 159 | 138 | 33 | 47 | 116 | 79 | 174 | 74 | 21 | 6 | 130 | 54 | 109 | 76 | 35 | 98 | 155 | 144 |
| 36 | 94 | 23 | 78 | 165 | 56 | 154 | 89 | 132 | 67 | 119 | 143 | 40 | 53 | 20 | 136 | 172 | 91 | 27 | 13 | 127 | 73 |
| 105 | 85 | 30 | 103 | 19 | 84 | 37 | 48 | 153 | 11 | 166 | 60 | 111 | 14 | 169 | 95 | 118 | 1 | 126 | 68 | 22 | 149 |
| 43 | 62 | 16 | 82 | | | | | | | | | | | | | | | | | | |

Converted Pattern (A):

| 129 | 32 | 177 | 134 | 122 | 31 | 133 | 167 | 124 | 123 | 179 | 176 | 125 | 170 | 34 | 42 | 171 | 178 | 128 | 41 | 168 | 38 |
|---|---|---|---|---|---|---|---|---|---|---|---|---|---|---|---|---|---|---|---|---|---|
| 44 | 173 | 175 | 131 | 121 | 120 | 39 | 33 | 174 | 130 | 35 | 36 | 165 | 132 | 40 | 172 | 127 | 30 | 37 | 166 | 169 | 126 |
| 43 | 65 | 50 | 57 | 104 | 46 | 92 | 99 | 101 | 71 | 69 | 96 | 52 | 59 | 63 | 61 | 100 | 72 | 64 | 49 | 102 | 93 |
| 45 | 66 | 51 | 90 | 58 | 70 | 55 | 97 | 47 | 74 | 54 | 98 | 94 | 56 | 67 | 53 | 91 | 73 | 103 | 48 | 60 | 95 |
| 68 | 62 | 160 | 162 | 157 | 24 | 17 | 163 | 18 | 110 | 107 | 108 | 113 | 117 | 15 | 112 | 106 | 152 | 161 | 150 | 26 | 28 |
| 156 | 151 | 25 | 29 | 164 | 114 | 115 | 158 | 159 | 116 | 21 | 109 | 155 | 23 | 154 | 119 | 20 | 27 | 105 | 19 | 153 | 111 |
| 118 | 22 | 16 | 140 | 86 | 9 | 7 | 77 | 148 | 0 | 135 | 5 | 141 | 83 | 81 | 137 | 88 | 3 | 87 | 4 | 10 | 75 |
| 2 | 12 | 142 | 139 | 147 | 80 | 145 | 146 | 8 | 138 | 79 | 6 | 76 | 144 | 78 | 89 | 143 | 136 | 13 | 85 | 84 | 11 |
| 14 | 1 | 149 | 82 | | | | | | | | | | | | | | | | | | |

EP 3 247 043 A1

# FIG. 247

16QAM CR 6/15:

Original Pattern (A):

BIT GROUP

| 55 | 146 | 83 | 52 | 62 | 176 | 160 | 68 | 53 | 56 | 81 | 97 | 79 | 113 | 163 | 61 | 58 | 69 | 133 | 108 | 66 | 71 |
| 86 | 144 | 57 | 67 | 116 | 59 | 70 | 156 | 172 | 65 | 149 | 155 | 82 | 138 | 136 | 141 | 111 | 96 | 170 | 90 | 140 | 64 |
| 159 | 15 | 14 | 37 | 54 | 44 | 63 | 43 | 18 | 47 | 7 | 25 | 34 | 29 | 30 | 26 | 39 | 16 | 41 | 45 | 36 | 0 |
| 23 | 32 | 28 | 27 | 38 | 48 | 33 | 22 | 49 | 51 | 60 | 46 | 21 | 4 | 3 | 20 | 13 | 50 | 35 | 24 | 40 | 17 |
| 42 | 6 | 112 | 93 | 127 | 101 | 94 | 115 | 105 | 31 | 19 | 177 | 74 | 10 | 145 | 162 | 102 | 120 | 126 | 95 | 73 | 152 |
| 129 | 174 | 125 | 72 | 128 | 78 | 171 | 8 | 142 | 178 | 154 | 85 | 107 | 75 | 12 | 9 | 151 | 77 | 117 | 109 | 80 | 106 |
| 134 | 98 | 1 | 122 | 173 | 161 | 150 | 110 | 175 | 166 | 131 | 119 | 103 | 139 | 148 | 157 | 114 | 147 | 87 | 158 | 121 | 164 |
| 104 | 89 | 179 | 123 | 118 | 99 | 88 | 11 | 92 | 165 | 84 | 168 | 124 | 169 | 2 | 130 | 167 | 153 | 137 | 143 | 91 | 100 |
| 5 | 76 | 132 | 135 | | | | | | | | | | | | | | | | | | |

Converted Pattern (B):

| 55 | 15 | 112 | 122 | 146 | 14 | 93 | 173 | 83 | 37 | 127 | 161 | 52 | 54 | 101 | 150 | 62 | 44 | 94 | 110 | 176 | 63 |
| 115 | 175 | 160 | 43 | 105 | 166 | 68 | 18 | 31 | 131 | 53 | 47 | 19 | 119 | 56 | 7 | 177 | 103 | 81 | 25 | 74 | 139 |
| 97 | 34 | 10 | 148 | 79 | 29 | 145 | 157 | 113 | 30 | 162 | 114 | 163 | 26 | 102 | 147 | 61 | 39 | 120 | 87 | 58 | 16 |
| 126 | 158 | 69 | 41 | 95 | 121 | 133 | 45 | 73 | 164 | 108 | 36 | 152 | 104 | 66 | 0 | 129 | 89 | 71 | 23 | 174 | 179 |
| 86 | 32 | 125 | 123 | 144 | 28 | 72 | 118 | 57 | 27 | 128 | 99 | 67 | 38 | 78 | 88 | 116 | 48 | 171 | 11 | 59 | 33 |
| 8 | 92 | 70 | 22 | 142 | 165 | 156 | 49 | 178 | 84 | 172 | 51 | 154 | 168 | 65 | 60 | 85 | 124 | 149 | 46 | 107 | 169 |
| 155 | 21 | 75 | 2 | 82 | 4 | 12 | 130 | 138 | 3 | 9 | 167 | 136 | 20 | 151 | 153 | 141 | 13 | 77 | 137 | 111 | 50 |
| 117 | 143 | 96 | 35 | 109 | 91 | 170 | 24 | 80 | 100 | 90 | 40 | 106 | 5 | 140 | 17 | 134 | 76 | 64 | 42 | 98 | 132 |
| 159 | 6 | 1 | 135 | | | | | | | | | | | | | | | | | | |

EP 3 247 043 A1

# FIG. 248

16QAM CR 7/15:

Original Pattern (A):

BIT GROUP

| 174 | 148 | 56 | 168 | 38 | 7 | 110 | 9 | 42 | 153 | 160 | 15 | 46 | 21 | 121 | 88 | 114 | 85 | 13 | 83 | 74 | 81 |
|---|---|---|---|---|---|---|---|---|---|---|---|---|---|---|---|---|---|---|---|---|---|
| 70 | 27 | 119 | 118 | 144 | 31 | 80 | 109 | 73 | 141 | 93 | 45 | 16 | 77 | 108 | 57 | 36 | 78 | 124 | 79 | 169 | 143 |
| 6 | 58 | 75 | 67 | 5 | 104 | 125 | 140 | 172 | 8 | 39 | 17 | 29 | 159 | 86 | 87 | 41 | 99 | 89 | 47 | 128 | 43 |
| 161 | 154 | 101 | 163 | 116 | 94 | 120 | 71 | 158 | 145 | 37 | 112 | 68 | 95 | 1 | 113 | 64 | 72 | 90 | 92 | 35 | 167 |
| 44 | 149 | 66 | 28 | 82 | 178 | 176 | 152 | 23 | 115 | 130 | 98 | 123 | 102 | 24 | 129 | 150 | 34 | 136 | 171 | 54 | 107 |
| 2 | 3 | 60 | 69 | 10 | 117 | 91 | 157 | 33 | 105 | 155 | 62 | 162 | 40 | 127 | 14 | 165 | 26 | 52 | 19 | 48 | 137 |
| 4 | 22 | 122 | 173 | 18 | 11 | 111 | 106 | 76 | 53 | 61 | 147 | 97 | 175 | 32 | 59 | 166 | 179 | 135 | 177 | 103 | 100 |
| 139 | 50 | 146 | 134 | 133 | 96 | 49 | 126 | 151 | 84 | 156 | 30 | 138 | 164 | 132 | 12 | 0 | 20 | 63 | 170 | 142 | 65 |
| 55 | 25 | 51 | 131 | | | | | | | | | | | | | | | | | | |

Converted Pattern (B):

| 174 | 58 | 66 | 173 | 148 | 75 | 28 | 18 | 56 | 67 | 82 | 11 | 168 | 5 | 178 | 111 | 38 | 104 | 176 | 106 | 7 | 125 |
|---|---|---|---|---|---|---|---|---|---|---|---|---|---|---|---|---|---|---|---|---|---|
| 152 | 76 | 110 | 140 | 23 | 53 | 9 | 172 | 115 | 61 | 42 | 8 | 130 | 147 | 153 | 39 | 98 | 97 | 160 | 17 | 123 | 175 |
| 15 | 29 | 102 | 32 | 46 | 159 | 24 | 59 | 21 | 86 | 129 | 166 | 121 | 87 | 150 | 179 | 88 | 41 | 34 | 135 | 114 | 99 |
| 136 | 177 | 85 | 89 | 171 | 103 | 13 | 47 | 54 | 100 | 83 | 128 | 107 | 139 | 74 | 43 | 2 | 50 | 81 | 161 | 3 | 146 |
| 70 | 154 | 60 | 134 | 27 | 101 | 69 | 133 | 119 | 163 | 10 | 96 | 118 | 116 | 117 | 49 | 144 | 94 | 91 | 126 | 31 | 120 |
| 157 | 151 | 80 | 71 | 33 | 84 | 109 | 158 | 105 | 156 | 73 | 145 | 155 | 30 | 141 | 37 | 62 | 138 | 93 | 112 | 162 | 164 |
| 45 | 68 | 40 | 132 | 16 | 95 | 127 | 12 | 77 | 1 | 14 | 0 | 108 | 113 | 165 | 20 | 57 | 64 | 26 | 63 | 36 | 72 |
| 52 | 170 | 78 | 90 | 19 | 142 | 124 | 92 | 48 | 65 | 79 | 35 | 137 | 55 | 169 | 167 | 4 | 25 | 143 | 44 | 22 | 51 |
| 6 | 149 | 122 | 131 | | | | | | | | | | | | | | | | | | |

EP 3 247 043 A1

# FIG. 249

16QAM CR 8/15:

Original Pattern (B):                                                    BIT GROUP

| 71 | 81 | 170 | 101 | 143 | 77 | 128 | 112 | 155 | 41 | 40 | 54 | 57 | 28 | 179 | 114 | 97 | 13 | 18 | 151 | 91 | 88 |
| 79 | 92 | 137 | 27 | 122 | 107 | 135 | 82 | 125 | 103 | 74 | 36 | 9 | 93 | 0 | 86 | 63 | 158 | 148 | 25 | 167 | 116 |
| 70 | 43 | 102 | 106 | 149 | 24 | 169 | 113 | 127 | 34 | 165 | 100 | 136 | 75 | 134 | 156 | 96 | 84 | 178 | 150 | 140 | 20 |
| 126 | 73 | 68 | 130 | 121 | 48 | 53 | 22 | 129 | 99 | 11 | 33 | 124 | 157 | 161 | 29 | 123 | 160 | 55 | 26 | 168 | 98 |
| 67 | 15 | 7 | 94 | 144 | 1 | 61 | 65 | 146 | 42 | 172 | 115 | 59 | 76 | 4 | 162 | 39 | 85 | 12 | 72 | 58 | 44 |
| 132 | 47 | 141 | 35 | 176 | 104 | 139 | 80 | 6 | 95 | 87 | 90 | 173 | 163 | 69 | 32 | 8 | 154 | 145 | 23 | 177 | 111 |
| 60 | 38 | 171 | 62 | 46 | 21 | 5 | 153 | 49 | 78 | 2 | 109 | 147 | 89 | 166 | 152 | 138 | 31 | 14 | 131 | 50 | 37 |
| 16 | 117 | 66 | 19 | 10 | 159 | 142 | 105 | 3 | 164 | 51 | 83 | 174 | 108 | 52 | 17 | 64 | 119 | 45 | 133 | 175 | 110 |
| 56 | 30 | 120 | 118 | | | | | | | | | | | | | | | | | | |

Converted Pattern (A):

| 71 | 143 | 155 | 57 | 97 | 91 | 137 | 135 | 74 | 0 | 148 | 70 | 149 | 127 | 136 | 96 | 140 | 68 | 53 | 11 | 161 | 55 |
| 67 | 144 | 146 | 59 | 39 | 58 | 141 | 139 | 87 | 69 | 145 | 60 | 46 | 49 | 147 | 138 | 50 | 66 | 142 | 51 | 52 | 45 |
| 56 | 81 | 77 | 41 | 28 | 13 | 88 | 27 | 82 | 36 | 86 | 25 | 43 | 24 | 34 | 75 | 84 | 20 | 130 | 22 | 33 | 29 |
| 26 | 15 | 1 | 42 | 76 | 85 | 44 | 35 | 80 | 90 | 32 | 23 | 38 | 21 | 78 | 89 | 31 | 37 | 19 | 105 | 83 | 17 |
| 133 | 30 | 170 | 128 | 40 | 179 | 18 | 79 | 122 | 125 | 9 | 63 | 167 | 102 | 169 | 165 | 134 | 178 | 126 | 121 | 129 | 124 |
| 123 | 168 | 7 | 61 | 172 | 4 | 12 | 132 | 176 | 6 | 173 | 8 | 177 | 171 | 5 | 2 | 166 | 14 | 16 | 10 | 3 | 174 |
| 64 | 175 | 120 | 101 | 112 | 54 | 114 | 151 | 92 | 107 | 103 | 93 | 158 | 116 | 106 | 113 | 100 | 156 | 150 | 73 | 48 | 99 |
| 157 | 160 | 98 | 94 | 65 | 115 | 162 | 72 | 47 | 104 | 95 | 163 | 154 | 111 | 62 | 153 | 109 | 152 | 131 | 117 | 159 | 164 |
| 108 | 119 | 110 | 118 | | | | | | | | | | | | | | | | | | |

EP 3 247 043 A1

# FIG. 250

16QAM CR 9/15:

Original Pattern (B):

BIT GROUP

| | | | | | | | | | | | | | | | | | | | | | |
|---|---|---|---|---|---|---|---|---|---|---|---|---|---|---|---|---|---|---|---|---|---|---|
| 23 | 89 | 10 | 142 | 19 | 41 | 1 | 146 | 68 | 87 | 9 | 51 | 114 | 92 | 121 | 69 | 107 | 97 | 166 | 162 | 55 | 174 |
| 126 | 149 | 110 | 128 | 172 | 28 | 111 | 78 | 82 | 120 | 71 | 52 | 5 | 141 | 29 | 30 | 132 | 148 | 72 | 85 | 17 | 160 |
| 156 | 154 | 131 | 164 | 65 | 76 | 125 | 50 | 16 | 130 | 129 | 143 | 133 | 98 | 0 | 42 | 63 | 83 | 173 | 49 | 74 | 43 |
| 8 | 147 | 61 | 36 | 167 | 119 | 27 | 86 | 102 | 48 | 115 | 99 | 38 | 163 | 73 | 101 | 4 | 153 | 118 | 90 | 124 | 151 |
| 66 | 93 | 123 | 157 | 24 | 44 | 168 | 80 | 15 | 39 | 178 | 45 | 21 | 37 | 11 | 136 | 113 | 77 | 122 | 158 | 64 | 81 |
| 6 | 60 | 54 | 35 | 13 | 57 | 171 | 100 | 117 | 46 | 62 | 33 | 175 | 137 | 59 | 103 | 127 | 70 | 108 | 88 | 179 | 40 |
| 112 | 104 | 170 | 140 | 67 | 32 | 105 | 159 | 26 | 96 | 169 | 135 | 109 | 47 | 177 | 56 | 116 | 79 | 106 | 150 | 25 | 94 |
| 134 | 152 | 22 | 84 | 176 | 139 | 20 | 34 | 165 | 138 | 7 | 91 | 12 | 145 | 58 | 95 | 2 | 144 | 53 | 75 | 14 | 155 |
| 18 | 31 | 3 | 161 | | | | | | | | | | | | | | | | | | |

Converted Pattern (A):

| | | | | | | | | | | | | | | | | | | | | | |
|---|---|---|---|---|---|---|---|---|---|---|---|---|---|---|---|---|---|---|---|---|---|---|
| 23 | 19 | 68 | 114 | 107 | 55 | 110 | 111 | 71 | 29 | 72 | 156 | 65 | 16 | 133 | 63 | 74 | 61 | 27 | 115 | 73 | 118 |
| 66 | 24 | 15 | 21 | 113 | 64 | 54 | 171 | 62 | 59 | 108 | 112 | 67 | 26 | 109 | 116 | 25 | 22 | 20 | 7 | 58 | 53 |
| 18 | 89 | 41 | 87 | 92 | 97 | 174 | 128 | 78 | 52 | 30 | 85 | 154 | 76 | 130 | 98 | 83 | 43 | 36 | 86 | 99 | 101 |
| 90 | 93 | 44 | 39 | 37 | 77 | 81 | 35 | 100 | 33 | 103 | 88 | 104 | 32 | 96 | 47 | 79 | 94 | 84 | 34 | 91 | 95 |
| 75 | 31 | 10 | 1 | 9 | 121 | 166 | 126 | 172 | 82 | 5 | 132 | 17 | 131 | 125 | 129 | 0 | 173 | 8 | 167 | 102 | 38 |
| 4 | 124 | 123 | 168 | 178 | 11 | 122 | 6 | 13 | 117 | 175 | 127 | 179 | 170 | 105 | 169 | 177 | 106 | 134 | 176 | 165 | 12 |
| 2 | 14 | 3 | 142 | 146 | 51 | 69 | 162 | 149 | 28 | 120 | 141 | 148 | 160 | 164 | 50 | 143 | 42 | 49 | 147 | 119 | 48 |
| 163 | 153 | 151 | 157 | 80 | 45 | 136 | 158 | 60 | 57 | 46 | 137 | 70 | 40 | 140 | 159 | 135 | 56 | 150 | 152 | 139 | 138 |
| 145 | 144 | 155 | 161 | | | | | | | | | | | | | | | | | | |

# FIG. 251

16QAM CR 10/15:

Original Pattern (A):

BIT GROUP

| 68 | 71 | 54 | 19 | 25 | 21 | 102 | 32 | 105 | 29 | 16 | 79 | 53 | 82 | 107 | 91 | 67 | 94 | 85 | 48 | 83 | 58 |
|---|---|---|---|---|---|---|---|---|---|---|---|---|---|---|---|---|---|---|---|---|---|
| 42 | 57 | 28 | 76 | 31 | 26 | 96 | 65 | 119 | 114 | 109 | 9 | 125 | 81 | 43 | 103 | 93 | 70 | 46 | 89 | 112 | 61 |
| 45 | 66 | 38 | 77 | 115 | 56 | 87 | 113 | 100 | 75 | 72 | 60 | 47 | 92 | 36 | 98 | 4 | 59 | 6 | 44 | 20 | 86 |
| 3 | 73 | 95 | 104 | 8 | 34 | 0 | 84 | 111 | 35 | 30 | 64 | 55 | 80 | 40 | 97 | 101 | 2 | 69 | 63 | 74 | 62 |
| 118 | 110 | 159 | 18 | 50 | 33 | 7 | 175 | 51 | 131 | 106 | 134 | 88 | 140 | 117 | 132 | 147 | 153 | 116 | 161 | 10 | 39 |
| 126 | 136 | 90 | 37 | 174 | 41 | 158 | 5 | 120 | 12 | 52 | 99 | 146 | 144 | 78 | 155 | 128 | 165 | 141 | 179 | 150 | 157 |
| 171 | 143 | 108 | 170 | 22 | 49 | 11 | 27 | 160 | 178 | 133 | 142 | 121 | 168 | 173 | 123 | 13 | 15 | 154 | 127 | 139 | 151 |
| 163 | 172 | 138 | 176 | 145 | 129 | 162 | 152 | 177 | 137 | 149 | 167 | 1 | 14 | 169 | 124 | 148 | 164 | 130 | 17 | 156 | 122 |
| 23 | 166 | 135 | 24 | | | | | | | | | | | | | | | | | | |

⇩

Converted Pattern (B):

| 68 | 66 | 159 | 170 | 71 | 38 | 18 | 22 | 54 | 77 | 50 | 49 | 19 | 115 | 33 | 11 | 25 | 56 | 7 | 27 | 21 | 87 |
|---|---|---|---|---|---|---|---|---|---|---|---|---|---|---|---|---|---|---|---|---|---|
| 175 | 160 | 102 | 113 | 51 | 178 | 32 | 100 | 131 | 133 | 105 | 75 | 106 | 142 | 29 | 72 | 134 | 121 | 16 | 60 | 88 | 168 |
| 79 | 47 | 140 | 173 | 53 | 92 | 117 | 123 | 82 | 36 | 132 | 13 | 107 | 98 | 147 | 15 | 91 | 4 | 153 | 154 | 67 | 59 |
| 116 | 127 | 94 | 6 | 161 | 139 | 85 | 44 | 10 | 151 | 48 | 20 | 39 | 163 | 83 | 86 | 126 | 172 | 58 | 3 | 136 | 138 |
| 42 | 73 | 90 | 176 | 57 | 95 | 37 | 145 | 28 | 104 | 174 | 129 | 76 | 8 | 41 | 162 | 31 | 34 | 158 | 152 | 26 | 0 |
| 5 | 177 | 96 | 84 | 120 | 137 | 65 | 111 | 12 | 149 | 119 | 35 | 52 | 167 | 114 | 30 | 99 | 1 | 109 | 64 | 146 | 14 |
| 9 | 55 | 144 | 169 | 125 | 80 | 78 | 124 | 81 | 40 | 155 | 148 | 43 | 97 | 128 | 164 | 103 | 101 | 165 | 130 | 93 | 2 |
| 141 | 17 | 70 | 69 | 179 | 156 | 46 | 63 | 150 | 122 | 89 | 74 | 157 | 23 | 112 | 62 | 171 | 166 | 61 | 118 | 143 | 135 |
| 45 | 110 | 108 | 24 | | | | | | | | | | | | | | | | | | |

## FIG. 252

16QAM CR 11/15:

Original Pattern (A):

<span>BIT GROUP</span>

| | | | | | | | | | | | | | | | | | | | | | |
|---|---|---|---|---|---|---|---|---|---|---|---|---|---|---|---|---|---|---|---|---|---|
| 21 | 11 | 12 | 9 | 0 | 6 | 24 | 25 | 85 | 103 | 118 | 122 | 71 | 101 | 41 | 93 | 55 | 73 | 100 | 40 | 106 | 119 |
| 45 | 80 | 128 | 68 | 129 | 61 | 124 | 36 | 126 | 117 | 114 | 132 | 136 | 140 | 144 | 148 | 152 | 156 | 160 | 164 | 168 | 172 |
| 176 | 20 | 18 | 10 | 13 | 16 | 8 | 26 | 27 | 54 | 111 | 52 | 44 | 87 | 113 | 115 | 58 | 116 | 49 | 77 | 95 | 86 |
| 30 | 78 | 81 | 56 | 125 | 53 | 89 | 94 | 50 | 123 | 65 | 83 | 133 | 137 | 141 | 145 | 149 | 153 | 157 | 161 | 165 | 169 |
| 173 | 177 | 2 | 17 | 1 | 4 | 7 | 15 | 29 | 82 | 32 | 102 | 76 | 121 | 92 | 130 | 127 | 62 | 107 | 38 | 46 | 43 |
| 110 | 75 | 104 | 70 | 91 | 69 | 96 | 120 | 42 | 34 | 79 | 35 | 105 | 134 | 138 | 142 | 146 | 150 | 154 | 158 | 162 | 166 |
| 170 | 174 | 178 | 19 | 5 | 3 | 14 | 22 | 28 | 23 | 109 | 51 | 108 | 131 | 33 | 84 | 88 | 64 | 63 | 59 | 57 | 97 |
| 98 | 48 | 31 | 99 | 37 | 72 | 39 | 74 | 66 | 60 | 67 | 47 | 112 | 90 | 135 | 139 | 143 | 147 | 151 | 155 | 159 | 163 |
| 167 | 171 | 175 | 179 | | | | | | | | | | | | | | | | | | |

Converted Pattern (B):

| | | | | | | | | | | | | | | | | | | | | | |
|---|---|---|---|---|---|---|---|---|---|---|---|---|---|---|---|---|---|---|---|---|---|
| 21 | 20 | 2 | 19 | 11 | 18 | 17 | 5 | 12 | 10 | 1 | 3 | 9 | 13 | 4 | 14 | 0 | 16 | 7 | 22 | 6 | 8 |
| 15 | 28 | 24 | 26 | 29 | 23 | 25 | 27 | 82 | 109 | 85 | 54 | 32 | 51 | 103 | 111 | 102 | 108 | 118 | 52 | 76 | 131 |
| 122 | 44 | 121 | 33 | 71 | 87 | 92 | 84 | 101 | 113 | 130 | 88 | 41 | 115 | 127 | 64 | 93 | 58 | 62 | 63 | 55 | 116 |
| 107 | 59 | 73 | 49 | 38 | 57 | 100 | 77 | 46 | 97 | 40 | 95 | 43 | 98 | 106 | 86 | 110 | 48 | 119 | 30 | 75 | 31 |
| 45 | 78 | 104 | 99 | 80 | 81 | 70 | 37 | 128 | 56 | 91 | 72 | 68 | 125 | 69 | 39 | 129 | 53 | 96 | 74 | 61 | 89 |
| 120 | 66 | 124 | 94 | 42 | 60 | 36 | 50 | 34 | 67 | 126 | 123 | 79 | 47 | 117 | 65 | 35 | 112 | 114 | 83 | 105 | 90 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

EP 3 247 043 A1

# FIG. 253

16QAM CR 12/15:

Original Pattern (A):

BIT GROUP

| 120 | 32 | 38 | 113 | 71 | 31 | 65 | 109 | 36 | 106 | 134 | 66 | 29 | 86 | 136 | 108 | 83 | 70 | 79 | 81 | 105 | 48 |
| 30 | 125 | 107 | 44 | 99 | 75 | 64 | 78 | 51 | 95 | 88 | 49 | 60 | 54 | 122 | 140 | 137 | 89 | 74 | 129 | 82 | 164 |
| 59 | 3 | 67 | 92 | 98 | 42 | 77 | 28 | 121 | 87 | 18 | 21 | 93 | 72 | 2 | 142 | 112 | 9 | 50 | 8 | 90 | 139 |
| 14 | 97 | 63 | 85 | 104 | 124 | 52 | 20 | 118 | 34 | 5 | 94 | 41 | 68 | 80 | 110 | 12 | 133 | 131 | 53 | 116 | 123 |
| 96 | 61 | 111 | 33 | 173 | 165 | 175 | 166 | 169 | 174 | 159 | 148 | 158 | 155 | 145 | 178 | 126 | 100 | 154 | 156 | 179 | 157 |
| 46 | 149 | 171 | 37 | 153 | 163 | 152 | 146 | 177 | 103 | 160 | 147 | 76 | 172 | 144 | 150 | 132 | 176 | 168 | 167 | 162 | 170 |
| 138 | 151 | 161 | 40 | 26 | 130 | 119 | 114 | 117 | 115 | 84 | 57 | 62 | 13 | 47 | 24 | 0 | 7 | 10 | 69 | 19 | 127 |
| 17 | 16 | 27 | 91 | 4 | 73 | 35 | 102 | 15 | 55 | 23 | 25 | 11 | 56 | 45 | 58 | 128 | 43 | 135 | 1 | 143 | 141 |
| 6 | 22 | 101 | 39 | | | | | | | | | | | | | | | | | | |

Converted Pattern (B):

| 120 | 3 | 111 | 40 | 32 | 67 | 33 | 26 | 38 | 92 | 173 | 130 | 113 | 98 | 165 | 119 | 71 | 42 | 175 | 114 | 31 | 77 |
| 166 | 117 | 65 | 28 | 169 | 115 | 109 | 121 | 174 | 84 | 36 | 87 | 159 | 57 | 106 | 18 | 148 | 62 | 134 | 21 | 158 | 13 |
| 66 | 93 | 155 | 47 | 29 | 72 | 145 | 24 | 86 | 2 | 178 | 0 | 136 | 142 | 126 | 7 | 108 | 112 | 100 | 10 | 83 | 9 |
| 154 | 69 | 70 | 50 | 156 | 19 | 79 | 8 | 179 | 127 | 81 | 90 | 157 | 17 | 105 | 139 | 46 | 16 | 48 | 14 | 149 | 27 |
| 30 | 97 | 171 | 91 | 125 | 63 | 37 | 4 | 107 | 85 | 153 | 73 | 44 | 104 | 163 | 35 | 99 | 124 | 152 | 102 | 75 | 52 |
| 146 | 15 | 64 | 20 | 177 | 55 | 78 | 118 | 103 | 23 | 51 | 34 | 160 | 25 | 95 | 5 | 147 | 11 | 88 | 94 | 76 | 56 |
| 49 | 41 | 172 | 45 | 60 | 68 | 144 | 58 | 54 | 80 | 150 | 128 | 122 | 110 | 132 | 43 | 140 | 12 | 176 | 135 | 137 | 133 |
| 168 | 1 | 89 | 131 | 167 | 143 | 74 | 53 | 162 | 141 | 129 | 116 | 170 | 6 | 82 | 123 | 138 | 22 | 164 | 96 | 151 | 101 |
| 59 | 61 | 161 | 39 | | | | | | | | | | | | | | | | | | |

EP 3 247 043 A1

# FIG. 254

EP 3 247 043 A1

16QAM CR 13/15:

Original Pattern (A):

BIT GROUP

| | | | | | | | | | | | | | | | | | | | | |
|---|---|---|---|---|---|---|---|---|---|---|---|---|---|---|---|---|---|---|---|---|
| 0 | 4 | 8 | 12 | 16 | 20 | 24 | 28 | 32 | 36 | 40 | 44 | 48 | 52 | 56 | 60 | 64 | 68 | 72 | 76 | 80 | 84 |
| 88 | 92 | 96 | 100 | 104 | 108 | 112 | 116 | 120 | 124 | 128 | 132 | 136 | 140 | 144 | 148 | 152 | 156 | 160 | 164 | 168 | 172 |
| 176 | 1 | 5 | 9 | 13 | 17 | 21 | 25 | 29 | 33 | 37 | 41 | 45 | 49 | 53 | 57 | 61 | 65 | 69 | 73 | 77 | 81 |
| 85 | 89 | 93 | 97 | 101 | 105 | 109 | 113 | 117 | 121 | 125 | 129 | 133 | 137 | 141 | 145 | 149 | 153 | 157 | 161 | 165 | 169 |
| 173 | 177 | 2 | 6 | 10 | 14 | 18 | 22 | 26 | 30 | 34 | 38 | 42 | 46 | 50 | 54 | 58 | 62 | 66 | 70 | 74 | 78 |
| 82 | 86 | 90 | 94 | 98 | 102 | 106 | 110 | 114 | 118 | 122 | 126 | 130 | 134 | 138 | 142 | 146 | 150 | 154 | 158 | 162 | 166 |
| 170 | 174 | 178 | 3 | 7 | 11 | 15 | 19 | 23 | 27 | 31 | 35 | 39 | 43 | 47 | 51 | 55 | 59 | 63 | 67 | 71 | 75 |
| 79 | 83 | 87 | 91 | 95 | 99 | 103 | 107 | 111 | 115 | 119 | 123 | 127 | 131 | 135 | 139 | 143 | 147 | 151 | 155 | 159 | 163 |
| 167 | 171 | 175 | 179 | | | | | | | | | | | | | | | | | | |

Converted Pattern (B):

| | | | | | | | | | | | | | | | | | | | | |
|---|---|---|---|---|---|---|---|---|---|---|---|---|---|---|---|---|---|---|---|---|---|
| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

# FIG. 255

EP 3 247 043 A1

64QAM CR 2/15:

Original Pattern (A):

BIT GROUP

| 57 | 149 | 83 | 142 | 29 | 20 | 30 | 52 | 5 | 100 | 156 | 22 | 130 | 167 | 121 | 126 | 137 | 158 | 132 | 82 | 138 | 128 |
|---|---|---|---|---|---|---|---|---|---|---|---|---|---|---|---|---|---|---|---|---|---|
| 89 | 88 | 162 | 32 | 107 | 3 | 97 | 166 | 125 | 129 | 1 | 6 | 68 | 148 | 40 | 87 | 0 | 80 | 49 | 24 | 78 | 101 |
| 43 | 112 | 75 | 172 | 23 | 154 | 12 | 146 | 19 | 135 | 48 | 170 | 123 | 147 | 95 | 91 | 13 | 35 | 127 | 61 | 60 | 139 |
| 44 | 59 | 55 | 109 | 157 | 177 | 153 | 165 | 66 | 152 | 77 | 98 | 131 | 11 | 81 | 62 | 175 | 141 | 171 | 51 | 155 | 76 |
| 150 | 174 | 58 | 143 | 37 | 63 | 31 | 41 | 140 | 118 | 94 | 27 | 10 | 70 | 56 | 93 | 176 | 124 | 151 | 106 | 46 | 163 |
| 179 | 4 | 18 | 144 | 178 | 161 | 145 | 71 | 114 | 7 | 105 | 133 | 84 | 86 | 17 | 21 | 28 | 54 | 74 | 65 | 110 | 122 |
| 169 | 64 | 111 | 119 | 42 | 85 | 73 | 8 | 116 | 79 | 120 | 69 | 53 | 115 | 67 | 104 | 16 | 173 | 92 | 15 | 159 | 134 |
| 99 | 96 | 117 | 38 | 9 | 26 | 164 | 47 | 103 | 113 | 136 | 168 | 102 | 14 | 45 | 72 | 25 | 50 | 34 | 36 | 90 | 160 |
| 2 | 33 | 39 | 108 | | | | | | | | | | | | | | | | | | |

Converted Pattern (B):

| 57 | 125 | 13 | 58 | 105 | 92 | 149 | 129 | 35 | 143 | 133 | 15 | 83 | 1 | 127 | 37 | 84 | 159 | 142 | 6 | 61 | 63 |
|---|---|---|---|---|---|---|---|---|---|---|---|---|---|---|---|---|---|---|---|---|---|
| 86 | 134 | 29 | 68 | 60 | 31 | 17 | 99 | 20 | 148 | 139 | 41 | 21 | 96 | 30 | 40 | 44 | 140 | 28 | 117 | 52 | 87 |
| 59 | 118 | 54 | 38 | 5 | 0 | 55 | 94 | 74 | 9 | 100 | 80 | 109 | 27 | 65 | 26 | 156 | 49 | 157 | 10 | 110 | 164 |
| 22 | 24 | 177 | 70 | 122 | 47 | 130 | 78 | 153 | 56 | 169 | 103 | 167 | 101 | 165 | 93 | 64 | 113 | 121 | 43 | 66 | 176 |
| 111 | 136 | 126 | 112 | 152 | 124 | 119 | 168 | 137 | 75 | 77 | 151 | 42 | 102 | 158 | 172 | 98 | 106 | 85 | 14 | 132 | 23 |
| 131 | 46 | 73 | 45 | 82 | 154 | 11 | 163 | 8 | 72 | 138 | 12 | 81 | 179 | 116 | 25 | 128 | 146 | 62 | 4 | 79 | 50 |
| 89 | 19 | 175 | 18 | 120 | 34 | 88 | 135 | 141 | 144 | 69 | 36 | 162 | 48 | 171 | 178 | 53 | 90 | 32 | 170 | 51 | 161 |
| 115 | 160 | 107 | 123 | 155 | 145 | 67 | 2 | 3 | 147 | 76 | 71 | 104 | 33 | 97 | 95 | 150 | 114 | 16 | 39 | 166 | 91 |
| 174 | 7 | 173 | 108 | | | | | | | | | | | | | | | | | | |

## FIG. 256

64QAM CR 3/15:

Original Pattern (A):

BIT GROUP

| 74 | 72 | 104 | 62 | 122 | 35 | 130 | 0 | 95 | 150 | 139 | 151 | 133 | 109 | 31 | 59 | 18 | 148 | 9 | 105 | 57 | 132 |
|---|---|---|---|---|---|---|---|---|---|---|---|---|---|---|---|---|---|---|---|---|---|
| 102 | 100 | 115 | 101 | 7 | 21 | 141 | 30 | 8 | 1 | 93 | 92 | 163 | 108 | 52 | 159 | 24 | 89 | 117 | 88 | 178 | 113 |
| 98 | 179 | 144 | 156 | 54 | 164 | 12 | 63 | 39 | 22 | 25 | 137 | 13 | 41 | 44 | 80 | 87 | 111 | 145 | 23 | 85 | 166 |
| 83 | 55 | 154 | 20 | 84 | 58 | 26 | 126 | 170 | 103 | 11 | 33 | 172 | 155 | 116 | 169 | 142 | 70 | 161 | 47 | 3 | 162 |
| 77 | 19 | 28 | 97 | 124 | 6 | 168 | 107 | 60 | 76 | 143 | 121 | 42 | 157 | 65 | 43 | 173 | 56 | 171 | 90 | 131 | 119 |
| 94 | 5 | 68 | 138 | 149 | 73 | 67 | 53 | 61 | 4 | 86 | 99 | 75 | 36 | 15 | 48 | 177 | 167 | 174 | 51 | 176 | 81 |
| 120 | 158 | 123 | 34 | 49 | 128 | 10 | 134 | 147 | 96 | 160 | 50 | 146 | 16 | 38 | 78 | 91 | 152 | 46 | 127 | 27 | 175 |
| 135 | 79 | 125 | 82 | 2 | 129 | 153 | 14 | 40 | 32 | 114 | 106 | 17 | 110 | 140 | 71 | 136 | 112 | 45 | 64 | 29 | 69 |
| 118 | 66 | 37 | 165 |

Converted Pattern (B):

| 74 | 8 | 87 | 28 | 86 | 46 | 72 | 1 | 111 | 97 | 99 | 127 | 104 | 93 | 145 | 124 | 75 | 27 | 62 | 92 | 23 | 6 |
|---|---|---|---|---|---|---|---|---|---|---|---|---|---|---|---|---|---|---|---|---|---|
| 36 | 175 | 122 | 163 | 85 | 168 | 15 | 135 | 35 | 108 | 166 | 107 | 48 | 79 | 130 | 52 | 83 | 60 | 177 | 125 | 0 | 159 |
| 55 | 76 | 167 | 82 | 95 | 24 | 154 | 143 | 174 | 2 | 150 | 89 | 20 | 121 | 51 | 129 | 139 | 117 | 84 | 42 | 176 | 153 |
| 151 | 88 | 58 | 157 | 81 | 14 | 133 | 178 | 26 | 65 | 120 | 40 | 109 | 113 | 126 | 43 | 158 | 32 | 31 | 98 | 170 | 173 |
| 123 | 114 | 59 | 179 | 103 | 56 | 34 | 106 | 18 | 144 | 11 | 171 | 49 | 17 | 148 | 156 | 33 | 90 | 128 | 110 | 9 | 54 |
| 172 | 131 | 10 | 140 | 105 | 164 | 155 | 119 | 134 | 71 | 57 | 12 | 116 | 94 | 147 | 136 | 132 | 63 | 169 | 5 | 96 | 112 |
| 102 | 39 | 142 | 68 | 160 | 45 | 100 | 22 | 70 | 138 | 50 | 64 | 115 | 25 | 161 | 149 | 146 | 29 | 101 | 137 | 47 | 73 |
| 16 | 69 | 7 | 13 | 3 | 67 | 38 | 118 | 21 | 41 | 162 | 53 | 78 | 66 | 141 | 44 | 77 | 61 | 91 | 37 | 30 | 80 |
| 19 | 4 | 152 | 165 |

EP 3 247 043 A1

# FIG. 257

64QAM CR 4/15:

Original Pattern (A):

BIT GROUP

| 141 | 80 | 47 | 89 | 44 | 7 | 46 | 11 | 175 | 173 | 99 | 2 | 155 | 52 | 86 | 128 | 174 | 33 | 170 | 31 | 35 | 162 |
|---|---|---|---|---|---|---|---|---|---|---|---|---|---|---|---|---|---|---|---|---|---|
| 64 | 95 | 92 | 4 | 16 | 49 | 137 | 104 | 29 | 9 | 60 | 167 | 50 | 23 | 43 | 176 | 121 | 71 | 132 | 103 | 144 | 39 |
| 12 | 90 | 114 | 131 | 106 | 76 | 118 | 66 | 24 | 58 | 122 | 150 | 57 | 149 | 93 | 53 | 14 | 73 | 165 | 82 | 126 | 97 |
| 59 | 133 | 154 | 153 | 72 | 36 | 5 | 96 | 120 | 134 | 101 | 61 | 115 | 0 | 28 | 42 | 18 | 145 | 156 | 85 | 146 | 6 |
| 161 | 10 | 22 | 138 | 127 | 151 | 87 | 54 | 20 | 139 | 140 | 152 | 13 | 91 | 111 | 25 | 123 | 77 | 78 | 69 | 3 | 177 |
| 41 | 81 | 19 | 107 | 45 | 148 | 70 | 160 | 51 | 21 | 116 | 48 | 157 | 17 | 125 | 142 | 83 | 110 | 37 | 98 | 179 | 129 |
| 168 | 172 | 1 | 40 | 166 | 159 | 147 | 56 | 100 | 63 | 26 | 169 | 135 | 15 | 75 | 84 | 163 | 79 | 143 | 113 | 94 | 74 |
| 102 | 30 | 38 | 178 | 68 | 108 | 136 | 105 | 158 | 117 | 34 | 109 | 67 | 62 | 32 | 119 | 124 | 171 | 8 | 55 | 65 | 130 |
| 88 | 112 | 27 | 164 | | | | | | | | | | | | | | | | | | |

Converted Pattern (B):

| 141 | 29 | 14 | 22 | 116 | 143 | 80 | 9 | 73 | 138 | 48 | 113 | 47 | 60 | 165 | 127 | 157 | 94 | 89 | 167 | 82 | 151 |
|---|---|---|---|---|---|---|---|---|---|---|---|---|---|---|---|---|---|---|---|---|---|
| 17 | 74 | 44 | 50 | 126 | 87 | 125 | 102 | 7 | 23 | 97 | 54 | 142 | 30 | 46 | 43 | 59 | 20 | 83 | 38 | 11 | 176 |
| 133 | 139 | 110 | 178 | 175 | 121 | 154 | 140 | 37 | 68 | 173 | 71 | 153 | 152 | 98 | 108 | 99 | 132 | 72 | 13 | 179 | 136 |
| 2 | 103 | 36 | 91 | 129 | 105 | 155 | 144 | 5 | 111 | 168 | 158 | 52 | 39 | 96 | 25 | 172 | 117 | 86 | 12 | 120 | 123 |
| 1 | 34 | 128 | 90 | 134 | 77 | 40 | 109 | 174 | 114 | 101 | 78 | 166 | 67 | 33 | 131 | 61 | 69 | 159 | 62 | 170 | 106 |
| 115 | 3 | 147 | 32 | 31 | 76 | 0 | 177 | 56 | 119 | 35 | 118 | 28 | 41 | 100 | 124 | 162 | 66 | 42 | 81 | 63 | 171 |
| 64 | 24 | 18 | 19 | 26 | 8 | 95 | 58 | 145 | 107 | 169 | 55 | 92 | 122 | 156 | 45 | 135 | 65 | 4 | 150 | 85 | 148 |
| 15 | 130 | 16 | 57 | 146 | 70 | 75 | 88 | 49 | 149 | 6 | 160 | 84 | 112 | 137 | 93 | 161 | 51 | 163 | 27 | 104 | 53 |
| 10 | 21 | 79 | 164 | | | | | | | | | | | | | | | | | | |

EP 3 247 043 A1

# FIG. 258

64QAM CR 5/15:

Original Pattern (A):                                                                                          BIT GROUP

| 166 | 54 | 6 | 27 | 141 | 134 | 58 | 46 | 55 | 91 | 56 | 100 | 172 | 80 | 18 | 152 | 12 | 108 | 170 | 29 | 144 | 147 |
|---|---|---|---|---|---|---|---|---|---|---|---|---|---|---|---|---|---|---|---|---|---|
| 106 | 165 | 17 | 127 | 57 | 88 | 35 | 72 | 5 | 63 | 118 | 1 | 85 | 77 | 61 | 62 | 84 | 159 | 92 | 102 | 98 | 177 |
| 132 | 139 | 59 | 149 | 11 | 8 | 154 | 129 | 33 | 15 | 143 | 4 | 95 | 101 | 53 | 42 | 40 | 9 | 111 | 130 | 123 | 82 |
| 81 | 114 | 119 | 175 | 157 | 41 | 38 | 128 | 161 | 52 | 142 | 7 | 26 | 145 | 2 | 68 | 28 | 126 | 121 | 70 | 16 | 65 |
| 83 | 125 | 50 | 79 | 37 | 74 | 164 | 168 | 160 | 122 | 60 | 32 | 24 | 138 | 75 | 69 | 0 | 36 | 97 | 117 | 14 | 109 |
| 173 | 120 | 112 | 87 | 176 | 124 | 151 | 67 | 13 | 94 | 105 | 133 | 64 | 76 | 153 | 31 | 136 | 140 | 150 | 39 | 96 | 66 |
| 3 | 115 | 20 | 99 | 171 | 49 | 25 | 45 | 22 | 30 | 156 | 158 | 163 | 135 | 21 | 146 | 90 | 169 | 78 | 93 | 178 | 116 |
| 19 | 155 | 110 | 73 | 104 | 167 | 44 | 113 | 162 | 89 | 47 | 43 | 86 | 48 | 107 | 71 | 137 | 51 | 174 | 103 | 131 | 179 |
| 148 | 10 | 23 | 34 | | | | | | | | | | | | | | | | | | |

⇩

Converted Pattern (B):

| 166 | 5 | 40 | 50 | 105 | 78 | 54 | 63 | 9 | 79 | 133 | 93 | 6 | 118 | 111 | 37 | 64 | 178 | 27 | 1 | 130 | 74 |
|---|---|---|---|---|---|---|---|---|---|---|---|---|---|---|---|---|---|---|---|---|---|
| 76 | 116 | 141 | 85 | 123 | 164 | 153 | 19 | 134 | 77 | 82 | 168 | 31 | 155 | 58 | 61 | 81 | 160 | 136 | 110 | 46 | 62 |
| 114 | 122 | 140 | 73 | 55 | 84 | 119 | 60 | 150 | 104 | 91 | 159 | 175 | 32 | 39 | 167 | 56 | 92 | 157 | 24 | 96 | 44 |
| 100 | 102 | 41 | 138 | 66 | 113 | 172 | 98 | 38 | 75 | 3 | 162 | 80 | 177 | 128 | 69 | 115 | 89 | 18 | 132 | 161 | 0 |
| 20 | 47 | 152 | 139 | 52 | 36 | 99 | 43 | 12 | 59 | 142 | 97 | 171 | 86 | 108 | 149 | 7 | 117 | 49 | 48 | 170 | 11 |
| 26 | 14 | 25 | 107 | 29 | 8 | 145 | 109 | 45 | 71 | 144 | 154 | 2 | 173 | 22 | 137 | 147 | 129 | 68 | 120 | 30 | 51 |
| 106 | 33 | 28 | 112 | 156 | 174 | 165 | 15 | 126 | 87 | 158 | 103 | 17 | 143 | 121 | 176 | 163 | 131 | 127 | 4 | 70 | 124 |
| 135 | 179 | 57 | 95 | 16 | 151 | 21 | 148 | 88 | 101 | 65 | 67 | 146 | 10 | 35 | 53 | 83 | 13 | 90 | 23 | 72 | 42 |
| 125 | 94 | 169 | 34 | | | | | | | | | | | | | | | | | | |

EP 3 247 043 A1

# FIG. 259

64QAM CR 6/15:

Original Pattern (A):

BIT GROUP

| | | | | | | | | | | | | | | | | | | | | | |
|---|---|---|---|---|---|---|---|---|---|---|---|---|---|---|---|---|---|---|---|---|---|
| 29 | 17 | 38 | 37 | 27 | 43 | 31 | 35 | 16 | 46 | 44 | 9 | 23 | 1 | 34 | 45 | 14 | 18 | 156 | 19 | 22 | 40 |
| 50 | 24 | 56 | 49 | 26 | 42 | 69 | 47 | 59 | 61 | 66 | 52 | 64 | 65 | 67 | 54 | 170 | 68 | 132 | 51 | 70 | 41 |
| 21 | 5 | 160 | 7 | 13 | 55 | 62 | 53 | 63 | 58 | 3 | 167 | 71 | 57 | 151 | 60 | 36 | 25 | 74 | 39 | 32 | 72 |
| 85 | 86 | 107 | 113 | 48 | 88 | 2 | 129 | 137 | 20 | 73 | 166 | 75 | 77 | 142 | 174 | 15 | 149 | 28 | 145 | 92 | 169 |
| 30 | 133 | 163 | 119 | 82 | 176 | 152 | 134 | 139 | 148 | 164 | 99 | 173 | 104 | 83 | 106 | 112 | 135 | 153 | 0 | 128 | 144 |
| 98 | 171 | 94 | 97 | 143 | 110 | 118 | 127 | 84 | 79 | 108 | 126 | 131 | 93 | 111 | 91 | 4 | 125 | 162 | 157 | 158 | 109 |
| 140 | 123 | 154 | 150 | 80 | 11 | 12 | 146 | 96 | 81 | 165 | 8 | 89 | 138 | 105 | 141 | 103 | 6 | 100 | 161 | 172 | 78 |
| 101 | 115 | 179 | 147 | 116 | 136 | 122 | 87 | 33 | 130 | 124 | 175 | 120 | 90 | 102 | 10 | 114 | 159 | 76 | 177 | 178 | 121 |
| 168 | 95 | 117 | 155 | | | | | | | | | | | | | | | | | | |

⇩

Converted Pattern (B):

| | | | | | | | | | | | | | | | | | | | | | |
|---|---|---|---|---|---|---|---|---|---|---|---|---|---|---|---|---|---|---|---|---|---|
| 29 | 59 | 36 | 163 | 108 | 100 | 17 | 61 | 25 | 119 | 126 | 161 | 38 | 66 | 74 | 82 | 131 | 172 | 37 | 52 | 39 | 176 |
| 93 | 78 | 27 | 64 | 32 | 152 | 111 | 101 | 43 | 65 | 72 | 134 | 91 | 115 | 31 | 67 | 85 | 139 | 4 | 179 | 35 | 54 |
| 86 | 148 | 125 | 147 | 16 | 170 | 107 | 164 | 162 | 116 | 46 | 68 | 113 | 99 | 157 | 136 | 44 | 132 | 48 | 173 | 158 | 122 |
| 9 | 51 | 88 | 104 | 109 | 87 | 23 | 70 | 2 | 83 | 140 | 33 | 1 | 41 | 129 | 106 | 123 | 130 | 34 | 21 | 137 | 112 |
| 154 | 124 | 45 | 5 | 20 | 135 | 150 | 175 | 14 | 160 | 73 | 153 | 80 | 120 | 18 | 7 | 166 | 0 | 11 | 90 | 156 | 13 |
| 75 | 128 | 12 | 102 | 19 | 55 | 77 | 144 | 146 | 10 | 22 | 62 | 142 | 98 | 96 | 114 | 40 | 53 | 174 | 171 | 81 | 159 |
| 50 | 63 | 15 | 94 | 165 | 76 | 24 | 58 | 149 | 97 | 8 | 177 | 56 | 3 | 28 | 143 | 89 | 178 | 49 | 167 | 145 | 110 |
| 138 | 121 | 26 | 71 | 92 | 118 | 105 | 168 | 42 | 57 | 169 | 127 | 141 | 95 | 69 | 151 | 30 | 84 | 103 | 117 | 47 | 60 |
| 133 | 79 | 6 | 155 | | | | | | | | | | | | | | | | | | |

EP 3 247 043 A1

# FIG. 260

64QAM CR 7/15:

Original Pattern (B):

BIT GROUP

| 103 | 36 | 155 | 175 | 52 | 130 | 16 | 178 | 141 | 86 | 49 | 129 | 73 | 84 | 142 | 177 | 110 | 8 | 96 | 77 | 139 | 167 |
| 109 | 2 | 17 | 37 | 146 | 169 | 54 | 134 | 101 | 78 | 135 | 70 | 153 | 6 | 29 | 41 | 143 | 63 | 47 | 124 | 90 | 31 |
| 152 | 98 | 59 | 133 | 15 | 79 | 164 | 67 | 50 | 128 | 23 | 34 | 154 | 69 | 45 | 9 | 27 | 35 | 156 | 170 | 113 | 127 |
| 102 | 82 | 149 | 176 | 46 | 13 | 22 | 30 | 163 | 60 | 114 | 11 | 92 | 44 | 157 | 74 | 48 | 132 | 24 | 87 | 140 | 66 |
| 118 | 123 | 104 | 89 | 136 | 64 | 107 | 14 | 99 | 43 | 115 | 71 | 117 | 12 | 26 | 38 | 147 | 62 | 57 | 131 | 94 | 33 |
| 151 | 172 | 116 | 10 | 25 | 75 | 144 | 179 | 51 | 120 | 20 | 80 | 160 | 174 | 106 | 1 | 21 | 88 | 137 | 61 | 105 | 5 |
| 18 | 32 | 158 | 72 | 56 | 125 | 28 | 42 | 161 | 168 | 53 | 7 | 100 | 40 | 145 | 171 | 55 | 3 | 95 | 83 | 162 | 173 |
| 119 | 126 | 91 | 39 | 150 | 165 | 112 | 122 | 93 | 76 | 138 | 166 | 108 | 121 | 97 | 81 | 148 | 65 | 111 | 4 | 19 | 85 |
| 159 | 68 | 58 | 0 | | | | | | | | | | | | | | | | | | |

Converted Pattern (A):

| 103 | 16 | 73 | 96 | 17 | 101 | 29 | 90 | 15 | 23 | 27 | 102 | 22 | 92 | 24 | 104 | 99 | 26 | 94 | 25 | 20 | 21 |
| 18 | 28 | 100 | 95 | 91 | 93 | 97 | 19 | 36 | 178 | 84 | 77 | 37 | 78 | 41 | 31 | 79 | 34 | 35 | 82 | 30 | 44 |
| 87 | 89 | 43 | 38 | 33 | 75 | 80 | 88 | 32 | 42 | 40 | 83 | 39 | 76 | 81 | 85 | 155 | 141 | 142 | 139 | 146 | 135 |
| 143 | 152 | 164 | 154 | 156 | 149 | 163 | 157 | 140 | 136 | 115 | 147 | 151 | 144 | 160 | 137 | 158 | 161 | 145 | 162 | 150 | 138 |
| 148 | 159 | 175 | 86 | 177 | 167 | 169 | 70 | 63 | 98 | 67 | 69 | 170 | 176 | 60 | 74 | 66 | 64 | 71 | 62 | 172 | 179 |
| 174 | 61 | 72 | 168 | 171 | 173 | 165 | 166 | 65 | 68 | 52 | 49 | 110 | 109 | 54 | 153 | 47 | 59 | 50 | 45 | 113 | 46 |
| 114 | 48 | 118 | 107 | 117 | 57 | 116 | 51 | 106 | 105 | 56 | 53 | 55 | 119 | 112 | 108 | 111 | 58 | 130 | 129 | 8 | 2 |
| 134 | 6 | 124 | 133 | 128 | 9 | 127 | 13 | 11 | 132 | 123 | 14 | 12 | 131 | 10 | 120 | 1 | 5 | 125 | 7 | 3 | 126 |
| 122 | 121 | 4 | 0 | | | | | | | | | | | | | | | | | | |

EP 3 247 043 A1

# FIG. 261

EP 3 247 043 A1

64QAM CR 8/15:

Original Pattern (A):

BIT GROUP

| 86 | 71 | 51 | 48 | 89 | 94 | 46 | 81 | 67 | 49 | 80 | 37 | 55 | 61 | 36 | 57 | 52 | 92 | 60 | 82 | 76 | 72 |
|---|---|---|---|---|---|---|---|---|---|---|---|---|---|---|---|---|---|---|---|---|---|
| 44 | 42 | 91 | 62 | 50 | 90 | 40 | 78 | 53 | 58 | 47 | 85 | 70 | 4 | 69 | 43 | 54 | 84 | 93 | 38 | 8 | 64 |
| 6 | 18 | 77 | 95 | 66 | 59 | 83 | 73 | 17 | 87 | 3 | 75 | 65 | 88 | 79 | 14 | 151 | 117 | 32 | 22 | 123 | 30 |
| 33 | 162 | 144 | 9 | 121 | 108 | 139 | 142 | 24 | 34 | 20 | 157 | 159 | 138 | 143 | 29 | 140 | 163 | 150 | 175 | 114 | 31 |
| 12 | 35 | 145 | 28 | 27 | 26 | 16 | 98 | 102 | 103 | 133 | 161 | 21 | 25 | 107 | 153 | 45 | 156 | 23 | 125 | 141 | 56 |
| 166 | 5 | 1 | 170 | 119 | 68 | 134 | 41 | 74 | 179 | 2 | 129 | 169 | 101 | 99 | 109 | 127 | 168 | 176 | 11 | 0 | 122 |
| 110 | 113 | 146 | 132 | 165 | 19 | 13 | 39 | 7 | 164 | 106 | 172 | 154 | 149 | 10 | 173 | 131 | 167 | 63 | 147 | 155 | 100 |
| 171 | 158 | 160 | 15 | 178 | 148 | 152 | 104 | 124 | 177 | 97 | 130 | 118 | 137 | 111 | 126 | 120 | 105 | 115 | 136 | 112 | 96 |
| 135 | 116 | 174 | 128 | | | | | | | | | | | | | | | | | | |

Converted Pattern (B):

| 86 | 53 | 151 | 145 | 2 | 63 | 71 | 58 | 117 | 28 | 129 | 147 | 51 | 47 | 32 | 27 | 169 | 155 | 48 | 85 | 22 | 26 |
|---|---|---|---|---|---|---|---|---|---|---|---|---|---|---|---|---|---|---|---|---|---|
| 101 | 100 | 89 | 70 | 123 | 16 | 99 | 171 | 94 | 4 | 30 | 98 | 109 | 158 | 46 | 69 | 33 | 102 | 127 | 160 | 81 | 43 |
| 162 | 103 | 168 | 15 | 67 | 54 | 144 | 133 | 176 | 178 | 49 | 84 | 9 | 161 | 11 | 148 | 80 | 93 | 121 | 21 | 0 | 152 |
| 37 | 38 | 108 | 25 | 122 | 104 | 55 | 8 | 139 | 107 | 110 | 124 | 61 | 64 | 142 | 153 | 113 | 177 | 36 | 6 | 24 | 45 |
| 146 | 97 | 57 | 18 | 34 | 156 | 132 | 130 | 52 | 77 | 20 | 23 | 165 | 118 | 92 | 95 | 157 | 125 | 19 | 137 | 60 | 66 |
| 159 | 141 | 13 | 111 | 82 | 59 | 138 | 56 | 39 | 126 | 76 | 83 | 143 | 166 | 7 | 120 | 72 | 73 | 29 | 5 | 164 | 105 |
| 44 | 17 | 140 | 1 | 106 | 115 | 42 | 87 | 163 | 170 | 172 | 136 | 91 | 3 | 150 | 119 | 154 | 112 | 62 | 75 | 175 | 68 |
| 149 | 96 | 50 | 65 | 114 | 134 | 10 | 135 | 90 | 88 | 31 | 41 | 173 | 116 | 40 | 79 | 12 | 74 | 131 | 174 | 78 | 14 |
| 35 | 179 | 167 | 128 | | | | | | | | | | | | | | | | | | |

## FIG. 262

64QAM CR 9/15:

Original Pattern (B):

| | | | | | | | | | | | | | | | | | | | | | |
|---|---|---|---|---|---|---|---|---|---|---|---|---|---|---|---|---|---|---|---|---|---|
| 175 | 60 | 133 | 11 | 5 | 4 | 70 | 97 | 131 | 80 | 42 | 136 | 50 | 104 | 32 | 75 | 176 | 87 | 109 | 61 | 39 | 107 |
| 0 | 172 | 23 | 90 | 54 | 160 | 48 | 173 | 27 | 100 | 129 | 14 | 7 | 142 | 20 | 103 | 38 | 126 | 157 | 144 | 21 | 64 |
| 44 | 79 | 105 | 146 | 49 | 93 | 1 | 84 | 81 | 145 | 18 | 15 | 106 | 91 | 12 | 169 | 63 | 71 | 125 | 37 | 120 | 138 |
| 17 | 113 | 31 | 130 | 140 | 8 | 25 | 74 | 134 | 115 | 9 | 171 | 46 | 68 | 33 | 116 | 2 | 179 | 52 | 92 | 36 | 78 |
| 164 | 177 | 24 | 72 | 122 | 118 | 162 | 121 | 16 | 73 | 45 | 53 | 77 | 110 | 30 | 66 | 29 | 76 | 158 | 148 | 111 | 94 |
| 43 | 83 | 139 | 10 | 56 | 98 | 114 | 117 | 152 | 174 | 47 | 62 | 128 | 85 | 155 | 178 | 26 | 96 | 41 | 82 | 150 | 143 |
| 58 | 69 | 127 | 86 | 13 | 141 | 35 | 101 | 149 | 108 | 3 | 154 | 51 | 95 | 132 | 135 | 163 | 137 | 28 | 102 | 123 | 112 |
| 151 | 167 | 59 | 19 | 156 | 119 | 153 | 168 | 55 | 65 | 34 | 6 | 159 | 170 | 57 | 67 | 40 | 89 | 147 | 165 | 22 | 99 |
| 124 | 88 | 161 | 166 | | | | | | | | | | | | | | | | | | |

Converted Pattern (A):

| | | | | | | | | | | | | | | | | | | | | | |
|---|---|---|---|---|---|---|---|---|---|---|---|---|---|---|---|---|---|---|---|---|---|
| 175 | 70 | 50 | 109 | 23 | 27 | 20 | 21 | 49 | 18 | 63 | 17 | 25 | 46 | 52 | 24 | 16 | 30 | 111 | 56 | 47 | 26 |
| 58 | 35 | 51 | 28 | 59 | 55 | 57 | 22 | 60 | 97 | 104 | 61 | 90 | 100 | 103 | 64 | 93 | 15 | 71 | 113 | 74 | 68 |
| 92 | 72 | 73 | 66 | 94 | 98 | 62 | 96 | 69 | 101 | 95 | 102 | 19 | 65 | 67 | 99 | 133 | 131 | 32 | 39 | 54 | 129 |
| 38 | 44 | 1 | 106 | 125 | 31 | 134 | 33 | 36 | 122 | 45 | 29 | 43 | 114 | 128 | 41 | 127 | 149 | 132 | 123 | 156 | 34 |
| 40 | 124 | 11 | 80 | 75 | 107 | 160 | 14 | 126 | 79 | 84 | 91 | 37 | 130 | 115 | 116 | 78 | 118 | 53 | 76 | 83 | 117 |
| 85 | 82 | 86 | 108 | 135 | 112 | 119 | 6 | 89 | 88 | 5 | 42 | 176 | 0 | 48 | 7 | 157 | 105 | 81 | 12 | 120 | 140 |
| 9 | 2 | 164 | 162 | 77 | 158 | 139 | 152 | 155 | 150 | 13 | 3 | 163 | 151 | 153 | 159 | 147 | 161 | 4 | 136 | 87 | 172 |
| 173 | 142 | 144 | 146 | 145 | 169 | 138 | 8 | 171 | 179 | 177 | 121 | 110 | 148 | 10 | 174 | 178 | 143 | 141 | 154 | 137 | 167 |
| 168 | 170 | 165 | 166 | | | | | | | | | | | | | | | | | | |

EP 3 247 043 A1

# FIG. 263

64QAM CR 10/15:

Original Pattern (B):                                                                              BIT GROUP

| 16 | 163 | 92 | 56 | 111 | 141 | 65 | 118 | 78 | 55 | 5 | 148 | 19 | 153 | 75 | 128 | 32 | 178 | 22 | 156 | 99 | 124 |
|----|-----|----|----|-----|-----|----|-----|----|----|----|-----|----|-----|----|-----|----|-----|----|-----|----|-----|
| 4 | 168 | 20 | 115 | 87 | 122 | 9 | 166 | 27 | 155 | 94 | 134 | 38 | 137 | 67 | 161 | 90 | 127 | 43 | 171 | 64 | 162 |
| 98 | 133 | 34 | 138 | 73 | 154 | 100 | 58 | 103 | 169 | 23 | 117 | 88 | 50 | 13 | 175 | 68 | 39 | 102 | 54 | 37 | 149 |
| 29 | 150 | 104 | 59 | 3 | 139 | 69 | 110 | 77 | 131 | 42 | 142 | 25 | 158 | 80 | 47 | 35 | 143 | 72 | 151 | 84 | 57 |
| 8 | 176 | 61 | 46 | 41 | 51 | 10 | 173 | 63 | 107 | 125 | 48 | 11 | 177 | 24 | 30 | 91 | 76 | 109 | 140 | 74 | 114 |
| 82 | 120 | 1 | 79 | 66 | 119 | 93 | 159 | 36 | 174 | 26 | 112 | 101 | 123 | 44 | 145 | 60 | 157 | 97 | 45 | 33 | 167 |
| 70 | 152 | 85 | 126 | 40 | 135 | 62 | 108 | 95 | 49 | 31 | 147 | 71 | 113 | 89 | 132 | 6 | 144 | 18 | 105 | 83 | 130 |
| 2 | 172 | 17 | 164 | 81 | 52 | 7 | 179 | 28 | 160 | 136 | 121 | 14 | 146 | 15 | 106 | 86 | 129 | 12 | 170 | 21 | 116 |
| 96 | 53 | 0 | 165 | | | | | | | | | | | | | | | | | | |

⇩

Converted Pattern (A):

| 16 | 65 | 19 | 22 | 20 | 27 | 67 | 64 | 73 | 23 | 68 | 29 | 69 | 25 | 72 | 61 | 63 | 24 | 74 | 66 | 26 | 60 |
|----|----|----|----|----|----|----|----|----|----|----|----|----|----|----|----|----|----|----|----|----|----|
| 70 | 62 | 71 | 18 | 17 | 28 | 15 | 21 | 163 | 118 | 153 | 156 | 115 | 155 | 161 | 162 | 154 | 117 | 39 | 150 | 110 | 158 |
| 151 | 46 | 107 | 30 | 114 | 119 | 112 | 157 | 152 | 108 | 113 | 105 | 164 | 160 | 106 | 116 | 92 | 78 | 75 | 99 | 87 | 94 |
| 90 | 98 | 100 | 88 | 102 | 104 | 77 | 80 | 84 | 41 | 125 | 91 | 82 | 93 | 101 | 97 | 85 | 95 | 89 | 83 | 81 | 136 |
| 86 | 96 | 56 | 55 | 128 | 124 | 122 | 134 | 127 | 133 | 58 | 50 | 54 | 59 | 131 | 47 | 57 | 51 | 48 | 76 | 120 | 159 |
| 123 | 45 | 126 | 49 | 132 | 130 | 52 | 121 | 129 | 53 | 111 | 5 | 32 | 4 | 9 | 38 | 43 | 34 | 103 | 13 | 37 | 3 |
| 42 | 35 | 8 | 10 | 11 | 109 | 1 | 36 | 44 | 33 | 40 | 31 | 6 | 2 | 7 | 14 | 12 | 0 | 141 | 148 | 178 | 168 |
| 166 | 137 | 171 | 138 | 169 | 175 | 149 | 139 | 142 | 143 | 176 | 173 | 177 | 140 | 79 | 174 | 145 | 167 | 135 | 147 | 144 | 172 |
| 179 | 146 | 170 | 165 | | | | | | | | | | | | | | | | | | |

# FIG. 264

64QAM CR 11/15:

Original Pattern (A):

EP 3 247 043 A1

BIT GROUP

| 12 | 15 | 2 | 16 | 27 | 50 | 35 | 74 | 38 | 70 | 108 | 32 | 112 | 54 | 30 | 122 | 72 | 116 | 36 | 90 | 49 | 85 |
| 132 | 138 | 144 | 150 | 156 | 162 | 168 | 174 | 0 | 14 | 9 | 5 | 23 | 66 | 68 | 52 | 96 | 117 | 84 | 128 | 100 | 63 |
| 60 | 127 | 81 | 99 | 53 | 55 | 103 | 95 | 133 | 139 | 145 | 151 | 157 | 163 | 169 | 175 | 10 | 22 | 13 | 11 | 28 | 104 |
| 37 | 57 | 115 | 46 | 65 | 129 | 107 | 75 | 119 | 110 | 31 | 43 | 97 | 78 | 125 | 58 | 134 | 140 | 146 | 152 | 158 | 164 |
| 170 | 176 | 4 | 19 | 6 | 8 | 24 | 44 | 101 | 94 | 118 | 130 | 69 | 71 | 83 | 34 | 86 | 124 | 48 | 106 | 89 | 40 |
| 102 | 91 | 135 | 141 | 147 | 153 | 159 | 165 | 171 | 177 | 3 | 20 | 7 | 17 | 25 | 87 | 41 | 120 | 47 | 80 | 59 | 62 |
| 88 | 45 | 56 | 131 | 61 | 126 | 113 | 92 | 51 | 98 | 136 | 142 | 148 | 154 | 160 | 166 | 172 | 178 | 21 | 18 | 1 | 26 |
| 29 | 39 | 73 | 121 | 105 | 77 | 42 | 114 | 93 | 82 | 111 | 109 | 67 | 79 | 123 | 64 | 76 | 33 | 137 | 143 | 149 | 155 |
| 161 | 167 | 173 | 179 |

Converted Pattern (B):

| 12 | 0 | 10 | 4 | 3 | 21 | 15 | 14 | 22 | 19 | 20 | 18 | 2 | 9 | 13 | 6 | 7 | 1 | 16 | 5 | 11 | 8 |
| 17 | 26 | 27 | 23 | 28 | 24 | 25 | 29 | 50 | 66 | 104 | 44 | 87 | 39 | 35 | 68 | 37 | 101 | 41 | 73 | 74 | 52 |
| 57 | 94 | 120 | 121 | 38 | 96 | 115 | 118 | 47 | 105 | 70 | 117 | 46 | 130 | 80 | 77 | 108 | 84 | 65 | 69 | 59 | 42 |
| 32 | 128 | 129 | 71 | 62 | 114 | 112 | 100 | 107 | 83 | 88 | 93 | 54 | 63 | 75 | 34 | 45 | 82 | 30 | 60 | 119 | 86 |
| 56 | 111 | 122 | 127 | 110 | 124 | 131 | 109 | 72 | 81 | 31 | 48 | 61 | 67 | 116 | 99 | 43 | 106 | 126 | 79 | 36 | 53 |
| 97 | 89 | 113 | 123 | 90 | 55 | 78 | 40 | 92 | 64 | 49 | 103 | 125 | 102 | 51 | 76 | 85 | 95 | 58 | 91 | 98 | 33 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 |

# FIG. 265

64QAM CR 12/15:

Original Pattern (A):

BIT GROUP

| 83 | 93 | 94 | 47 | 55 | 40 | 38 | 77 | 110 | 124 | 87 | 61 | 102 | 76 | 33 | 35 | 92 | 59 | 74 | 11 | 138 | 72 |
|----|----|----|----|----|----|----|----|----|----|----|----|----|----|----|----|----|----|----|----|----|----|
| 67 | 37 | 10 | 95 | 139 | 131 | 44 | 57 | 97 | 53 | 142 | 0 | 136 | 9 | 143 | 86 | 100 | 21 | 15 | 75 | 62 | 19 |
| 65 | 129 | 101 | 79 | 22 | 68 | 73 | 23 | 18 | 81 | 98 | 112 | 8 | 128 | 103 | 25 | 43 | 126 | 54 | 90 | 28 | 109 |
| 46 | 91 | 41 | 82 | 113 | 134 | 52 | 105 | 78 | 27 | 135 | 96 | 56 | 140 | 64 | 66 | 89 | 34 | 120 | 108 | 63 | 45 |
| 69 | 121 | 88 | 39 | 29 | 133 | 106 | 117 | 127 | 32 | 42 | 58 | 71 | 118 | 51 | 84 | 85 | 80 | 104 | 132 | 111 | 30 |
| 26 | 48 | 50 | 31 | 141 | 116 | 123 | 114 | 70 | 107 | 178 | 145 | 173 | 36 | 144 | 130 | 176 | 171 | 175 | 125 | 99 | 162 |
| 159 | 20 | 164 | 115 | 169 | 172 | 165 | 161 | 151 | 119 | 122 | 152 | 157 | 4 | 137 | 148 | 153 | 170 | 154 | 166 | 13 | 150 |
| 16 | 167 | 174 | 163 | 49 | 6 | 168 | 147 | 146 | 1 | 149 | 158 | 179 | 12 | 5 | 160 | 177 | 60 | 24 | 156 | 7 | 155 |
| 17 | 3 | 2 | 14 | | | | | | | | | | | | | | | | | | |

Converted Pattern (B):

| 83 | 97 | 43 | 88 | 178 | 154 | 93 | 53 | 126 | 39 | 145 | 166 | 94 | 142 | 54 | 29 | 173 | 13 | 47 | 0 | 90 | 133 |
|----|----|----|----|----|----|----|----|----|----|----|----|----|----|----|----|----|----|----|----|----|----|
| 36 | 150 | 55 | 136 | 28 | 106 | 144 | 16 | 40 | 9 | 109 | 117 | 130 | 167 | 38 | 143 | 46 | 127 | 176 | 174 | 77 | 86 |
| 91 | 32 | 171 | 163 | 110 | 100 | 41 | 42 | 175 | 49 | 124 | 21 | 82 | 58 | 125 | 6 | 87 | 15 | 113 | 71 | 99 | 168 |
| 61 | 75 | 134 | 118 | 162 | 147 | 102 | 62 | 52 | 51 | 159 | 146 | 76 | 19 | 105 | 84 | 20 | 1 | 33 | 65 | 78 | 85 |
| 164 | 149 | 35 | 129 | 27 | 80 | 115 | 158 | 92 | 101 | 135 | 104 | 169 | 179 | 59 | 79 | 96 | 132 | 172 | 12 | 74 | 22 |
| 56 | 111 | 165 | 5 | 11 | 68 | 140 | 30 | 161 | 160 | 138 | 73 | 64 | 26 | 151 | 177 | 72 | 23 | 66 | 48 | 119 | 60 |
| 67 | 18 | 89 | 50 | 122 | 24 | 37 | 81 | 34 | 31 | 152 | 156 | 10 | 98 | 120 | 141 | 157 | 7 | 95 | 112 | 108 | 116 |
| 4 | 155 | 139 | 8 | 63 | 123 | 137 | 17 | 131 | 128 | 45 | 114 | 148 | 3 | 44 | 103 | 69 | 70 | 153 | 2 | 57 | 25 |
| 121 | 107 | 170 | 14 | | | | | | | | | | | | | | | | | | |

EP 3 247 043 A1

# FIG. 266

64QAM CR 13/15:

Original Pattern (B):

EP 3 247 043 A1

BIT GROUP

| 146 | 91 | 63 | 144 | 46 | 12 | 58 | 137 | 25 | 79 | 70 | 33 | 134 | 148 | 66 | 38 | 163 | 118 | 139 | 130 | 72 | 92 |
|---|---|---|---|---|---|---|---|---|---|---|---|---|---|---|---|---|---|---|---|---|---|
| 160 | 23 | 133 | 153 | 128 | 86 | 152 | 106 | 53 | 93 | 61 | 5 | 158 | 172 | 121 | 135 | 44 | 149 | 168 | 0 | 124 | 143 |
| 27 | 30 | 151 | 114 | 113 | 43 | 138 | 89 | 159 | 17 | 120 | 136 | 102 | 81 | 170 | 176 | 142 | 104 | 21 | 78 | 155 | 8 |
| 52 | 95 | 62 | 40 | 174 | 6 | 131 | 48 | 18 | 1 | 179 | 34 | 123 | 77 | 26 | 84 | 157 | 85 | 56 | 147 | 67 | 76 |
| 162 | 10 | 51 | 103 | 140 | 87 | 175 | 115 | 4 | 101 | 69 | 80 | 169 | 75 | 49 | 97 | 154 | 83 | 14 | 2 | 132 | 96 |
| 16 | 37 | 166 | 109 | 54 | 42 | 28 | 32 | 171 | 119 | 55 | 94 | 65 | 20 | 165 | 3 | 47 | 90 | 117 | 88 | 177 | 11 |
| 59 | 68 | 73 | 41 | 150 | 111 | 127 | 100 | 110 | 31 | 167 | 13 | 122 | 145 | 71 | 22 | 173 | 116 | 126 | 141 | 29 | 39 |
| 178 | 57 | 125 | 36 | 19 | 7 | 156 | 107 | 9 | 98 | 74 | 45 | 161 | 112 | 50 | 99 | 24 | 35 | 164 | 64 | 129 | 15 |
| 60 | 82 | 108 | 105 | | | | | | | | | | | | | | | | | | |

Converted Pattern (A):

| 146 | 58 | 134 | 139 | 133 | 53 | 121 | 124 | 113 | 120 | 142 | 52 | 131 | 123 | 56 | 51 | 4 | 49 | 132 | 54 | 55 | 47 |
|---|---|---|---|---|---|---|---|---|---|---|---|---|---|---|---|---|---|---|---|---|---|
| 59 | 127 | 122 | 126 | 125 | 9 | 50 | 129 | 91 | 137 | 148 | 130 | 153 | 93 | 135 | 143 | 43 | 136 | 104 | 95 | 48 | 77 |
| 147 | 103 | 101 | 97 | 96 | 42 | 94 | 90 | 68 | 100 | 145 | 141 | 36 | 98 | 99 | 15 | 63 | 25 | 66 | 72 | 128 | 61 |
| 44 | 27 | 138 | 102 | 21 | 62 | 18 | 26 | 67 | 140 | 69 | 154 | 16 | 28 | 65 | 117 | 73 | 110 | 71 | 29 | 19 | 74 |
| 24 | 60 | 144 | 79 | 38 | 92 | 86 | 5 | 149 | 30 | 89 | 81 | 78 | 40 | 1 | 84 | 76 | 87 | 80 | 83 | 37 | 32 |
| 20 | 88 | 41 | 31 | 22 | 39 | 7 | 45 | 35 | 82 | 46 | 70 | 163 | 160 | 152 | 158 | 168 | 151 | 159 | 170 | 155 | 174 |
| 179 | 157 | 162 | 175 | 169 | 14 | 166 | 171 | 165 | 177 | 150 | 167 | 173 | 178 | 156 | 161 | 164 | 108 | 12 | 33 | 118 | 23 |
| 106 | 172 | 0 | 114 | 17 | 176 | 8 | 6 | 34 | 85 | 10 | 115 | 75 | 2 | 109 | 119 | 3 | 11 | 111 | 13 | 116 | 57 |
| 107 | 112 | 64 | 105 | | | | | | | | | | | | | | | | | | |

## FIG. 267

EP 3 247 043 A1

256QAM CR 2/15:

Original Pattern (A):

BIT GROUP

| 112 | 78 | 104 | 6 | 59 | 80 | 49 | 120 | 114 | 27 | 113 | 3 | 109 | 44 | 69 | 164 | 91 | 137 | 39 | 31 | 21 | 127 |
|---|---|---|---|---|---|---|---|---|---|---|---|---|---|---|---|---|---|---|---|---|---|
| 151 | 8 | 47 | 176 | 117 | 68 | 122 | 148 | 79 | 73 | 7 | 166 | 51 | 50 | 116 | 66 | 152 | 61 | 29 | 107 | 22 | 154 |
| 118 | 94 | 24 | 35 | 55 | 38 | 88 | 54 | 2 | 15 | 19 | 67 | 101 | 74 | 169 | 138 | 41 | 162 | 175 | 136 | 62 | 161 |
| 121 | 163 | 115 | 135 | 123 | 25 | 140 | 156 | 58 | 33 | 119 | 111 | 146 | 129 | 150 | 147 | 97 | 18 | 60 | 4 | 81 | 168 |
| 43 | 105 | 36 | 65 | 13 | 5 | 108 | 145 | 23 | 70 | 20 | 173 | 159 | 100 | 128 | 172 | 170 | 1 | 37 | 83 | 102 | 103 |
| 157 | 139 | 179 | 32 | 144 | 92 | 131 | 75 | 155 | 14 | 9 | 149 | 63 | 11 | 134 | 53 | 99 | 17 | 57 | 90 | 30 | 98 |
| 64 | 40 | 87 | 158 | 77 | 93 | 124 | 46 | 171 | 141 | 133 | 85 | 177 | 132 | 26 | 160 | 42 | 34 | 82 | 96 | 48 | 10 |
| 142 | 125 | 178 | 153 | 72 | 45 | 89 | 52 | 28 | 126 | 143 | 167 | 76 | 86 | 130 | 110 | 174 | 16 | 165 | 56 | 84 | 95 |
| 0 | 106 | 12 | 71 | | | | | | | | | | | | | | | | | | |

Converted Pattern (B):

| 112 | 151 | 118 | 121 | 43 | 157 | 64 | 142 | 78 | 8 | 94 | 163 | 105 | 139 | 40 | 125 | 104 | 47 | 24 | 115 | 36 | 179 |
|---|---|---|---|---|---|---|---|---|---|---|---|---|---|---|---|---|---|---|---|---|---|
| 87 | 178 | 6 | 176 | 35 | 135 | 65 | 32 | 158 | 153 | 59 | 117 | 55 | 123 | 13 | 144 | 77 | 72 | 80 | 68 | 38 | 25 |
| 5 | 92 | 93 | 45 | 49 | 122 | 88 | 140 | 108 | 131 | 124 | 89 | 120 | 148 | 54 | 156 | 145 | 75 | 46 | 52 | 114 | 79 |
| 2 | 58 | 23 | 155 | 171 | 28 | 27 | 73 | 15 | 33 | 70 | 14 | 141 | 126 | 113 | 7 | 19 | 119 | 20 | 9 | 133 | 143 |
| 3 | 166 | 67 | 111 | 173 | 149 | 85 | 167 | 109 | 51 | 101 | 146 | 159 | 63 | 177 | 76 | 44 | 50 | 74 | 129 | 100 | 11 |
| 132 | 86 | 69 | 116 | 169 | 150 | 128 | 134 | 26 | 130 | 164 | 66 | 138 | 147 | 172 | 53 | 160 | 110 | 91 | 152 | 41 | 97 |
| 170 | 99 | 42 | 174 | 137 | 61 | 162 | 18 | 1 | 17 | 34 | 16 | 39 | 29 | 175 | 60 | 37 | 57 | 82 | 165 | 31 | 107 |
| 136 | 4 | 83 | 90 | 96 | 56 | 21 | 22 | 62 | 81 | 102 | 30 | 48 | 84 | 127 | 154 | 161 | 168 | 103 | 98 | 10 | 95 |
| 0 | 106 | 12 | 71 | | | | | | | | | | | | | | | | | | |

# FIG. 268

256QAM CR 3/15:

Original Pattern (A):

BIT GROUP

| 136 | 28 | 85 | 38 | 40 | 89 | 133 | 117 | 3 | 58 | 154 | 77 | 14 | 179 | 96 | 101 | 26 | 169 | 37 | 83 | 162 | 165 |
| 24 | 66 | 109 | 126 | 10 | 155 | 70 | 157 | 105 | 175 | 67 | 158 | 32 | 42 | 147 | 140 | 30 | 7 | 92 | 59 | 119 | 56 |
| 0 | 5 | 90 | 174 | 13 | 47 | 76 | 88 | 86 | 108 | 27 | 18 | 12 | 8 | 61 | 145 | 75 | 125 | 112 | 69 | 120 | 137 |
| 116 | 20 | 178 | 98 | 176 | 29 | 68 | 168 | 124 | 21 | 35 | 150 | 131 | 159 | 163 | 84 | 23 | 123 | 65 | 103 | 93 | 99 |
| 102 | 31 | 64 | 74 | 46 | 94 | 80 | 129 | 142 | 128 | 148 | 111 | 134 | 173 | 60 | 118 | 2 | 170 | 135 | 1 | 115 | 143 |
| 95 | 177 | 73 | 43 | 11 | 114 | 91 | 78 | 107 | 172 | 25 | 36 | 164 | 149 | 153 | 110 | 44 | 146 | 82 | 127 | 45 | 33 |
| 50 | 41 | 52 | 156 | 34 | 4 | 79 | 141 | 138 | 122 | 53 | 160 | 81 | 16 | 100 | 130 | 71 | 121 | 132 | 9 | 22 | 113 |
| 6 | 152 | 15 | 171 | 17 | 57 | 49 | 151 | 161 | 63 | 55 | 139 | 166 | 97 | 19 | 51 | 72 | 167 | 106 | 48 | 144 | 87 |
| 104 | 62 | 54 | 39 |

⇩

Converted Pattern (B):

| 136 | 24 | 0 | 116 | 102 | 95 | 50 | 6 | 28 | 66 | 5 | 20 | 31 | 177 | 41 | 152 | 85 | 109 | 90 | 178 | 64 | 73 |
| 52 | 15 | 38 | 126 | 174 | 98 | 74 | 43 | 156 | 171 | 40 | 10 | 13 | 176 | 46 | 11 | 34 | 17 | 89 | 155 | 47 | 29 |
| 94 | 114 | 4 | 57 | 133 | 70 | 76 | 68 | 80 | 91 | 79 | 49 | 117 | 157 | 88 | 168 | 129 | 78 | 141 | 151 | 3 | 105 |
| 86 | 124 | 142 | 107 | 138 | 161 | 58 | 175 | 108 | 21 | 128 | 172 | 122 | 63 | 154 | 67 | 27 | 35 | 148 | 25 | 53 | 55 |
| 77 | 158 | 18 | 150 | 111 | 36 | 160 | 139 | 14 | 32 | 12 | 131 | 134 | 164 | 81 | 166 | 179 | 42 | 8 | 159 | 173 | 149 |
| 16 | 97 | 96 | 147 | 61 | 163 | 60 | 153 | 100 | 19 | 101 | 140 | 145 | 84 | 118 | 110 | 130 | 51 | 26 | 30 | 75 | 23 |
| 2 | 44 | 71 | 72 | 169 | 7 | 125 | 123 | 170 | 146 | 121 | 167 | 37 | 92 | 112 | 65 | 135 | 82 | 132 | 106 | 83 | 59 |
| 69 | 103 | 1 | 127 | 9 | 48 | 162 | 119 | 120 | 93 | 115 | 45 | 22 | 144 | 165 | 56 | 137 | 99 | 143 | 33 | 113 | 87 |
| 104 | 62 | 54 | 39 |

EP 3 247 043 A1

# FIG. 269

256QAM CR 4/15:

Original Pattern (A):

BIT GROUP

| 13 | 121 | 137 | 29 | 27 | 1 | 70 | 116 | 35 | 132 | 109 | 51 | 55 | 58 | 11 | 67 | 136 | 25 | 145 | 7 | 75 | 107 |
|---|---|---|---|---|---|---|---|---|---|---|---|---|---|---|---|---|---|---|---|---|---|
| 45 | 21 | 127 | 52 | 90 | 22 | 100 | 123 | 69 | 112 | 155 | 92 | 151 | 59 | 5 | 179 | 44 | 87 | 56 | 139 | 65 | 170 |
| 46 | 0 | 124 | 78 | 166 | 8 | 61 | 97 | 120 | 103 | 4 | 19 | 64 | 79 | 28 | 134 | 93 | 86 | 60 | 135 | 126 | 53 |
| 63 | 14 | 122 | 17 | 150 | 76 | 42 | 39 | 23 | 153 | 95 | 66 | 50 | 141 | 176 | 34 | 161 | 26 | 106 | 10 | 43 | 85 |
| 131 | 2 | 147 | 148 | 144 | 54 | 115 | 146 | 101 | 172 | 114 | 119 | 3 | 96 | 133 | 99 | 167 | 164 | 9 | 142 | 68 | 149 |
| 94 | 83 | 16 | 175 | 73 | 38 | 143 | 159 | 130 | 84 | 169 | 18 | 138 | 102 | 72 | 47 | 32 | 160 | 82 | 81 | 168 | 30 |
| 12 | 173 | 156 | 158 | 125 | 98 | 62 | 178 | 48 | 163 | 117 | 110 | 91 | 37 | 80 | 105 | 31 | 174 | 111 | 49 | 113 | 108 |
| 74 | 157 | 128 | 24 | 118 | 40 | 88 | 177 | 154 | 6 | 162 | 129 | 77 | 36 | 165 | 20 | 89 | 140 | 15 | 33 | 104 | 152 |
| 71 | 171 | 57 | 41 | | | | | | | | | | | | | | | | | | |

Converted Pattern (B):

| 13 | 45 | 46 | 63 | 131 | 94 | 12 | 74 | 121 | 21 | 0 | 14 | 2 | 83 | 173 | 157 | 137 | 127 | 124 | 122 | 147 | 16 |
|---|---|---|---|---|---|---|---|---|---|---|---|---|---|---|---|---|---|---|---|---|---|
| 156 | 128 | 29 | 52 | 78 | 17 | 148 | 175 | 158 | 24 | 27 | 90 | 166 | 150 | 144 | 73 | 125 | 118 | 1 | 22 | 8 | 76 |
| 54 | 38 | 98 | 40 | 70 | 100 | 61 | 42 | 115 | 143 | 62 | 88 | 116 | 123 | 97 | 39 | 146 | 159 | 178 | 177 | 35 | 69 |
| 120 | 23 | 101 | 130 | 48 | 154 | 132 | 112 | 103 | 153 | 172 | 84 | 163 | 6 | 109 | 155 | 4 | 95 | 114 | 169 | 117 | 162 |
| 51 | 92 | 19 | 66 | 119 | 18 | 110 | 129 | 55 | 151 | 64 | 50 | 3 | 138 | 91 | 77 | 58 | 59 | 79 | 141 | 96 | 102 |
| 37 | 36 | 11 | 5 | 28 | 176 | 133 | 72 | 80 | 165 | 67 | 179 | 134 | 34 | 99 | 47 | 105 | 20 | 136 | 44 | 93 | 161 |
| 167 | 32 | 31 | 89 | 25 | 87 | 86 | 26 | 164 | 160 | 174 | 140 | 145 | 56 | 60 | 106 | 9 | 82 | 111 | 15 | 7 | 139 |
| 135 | 10 | 142 | 81 | 49 | 33 | 75 | 65 | 126 | 43 | 68 | 168 | 113 | 104 | 107 | 170 | 53 | 85 | 149 | 30 | 108 | 152 |
| 71 | 171 | 57 | 41 | | | | | | | | | | | | | | | | | | |

EP 3 247 043 A1

## FIG. 270

256QAM CR 5/15:

Original Pattern (B):

BIT GROUP

| | | | | | | | | | | | | | | | | | | | | | |
|---|---|---|---|---|---|---|---|---|---|---|---|---|---|---|---|---|---|---|---|---|---|
| 39 | 45 | 128 | 84 | 143 | 148 | 2 | 75 | 43 | 50 | 130 | 87 | 137 | 151 | 7 | 71 | 55 | 51 | 133 | 90 | 140 | 149 |
| 6 | 177 | 37 | 124 | 99 | 83 | 23 | 159 | 0 | 176 | 41 | 121 | 96 | 89 | 30 | 161 | 18 | 172 | 60 | 49 | 134 | 104 |
| 139 | 166 | 14 | 179 | 62 | 48 | 129 | 105 | 146 | 160 | 16 | 174 | 33 | 54 | 132 | 112 | 145 | 150 | 9 | 77 | 34 | 117 |
| 92 | 82 | 136 | 165 | 4 | 67 | 36 | 44 | 101 | 81 | 141 | 156 | 3 | 175 | 58 | 47 | 91 | 102 | 32 | 158 | 13 | 178 |
| 63 | 118 | 100 | 85 | 26 | 167 | 1 | 173 | 38 | 116 | 131 | 107 | 138 | 162 | 8 | 72 | 42 | 115 | 98 | 108 | 24 | 152 |
| 17 | 171 | 64 | 123 | 94 | 110 | 28 | 147 | 19 | 169 | 61 | 46 | 97 | 106 | 144 | 164 | 5 | 70 | 59 | 53 | 127 | 88 |
| 31 | 153 | 10 | 73 | 66 | 119 | 126 | 111 | 29 | 155 | 15 | 170 | 57 | 120 | 125 | 80 | 142 | 168 | 11 | 68 | 56 | 52 |
| 95 | 103 | 27 | 154 | 21 | 78 | 40 | 122 | 93 | 86 | 25 | 163 | 20 | 79 | 35 | 114 | 135 | 109 | 22 | 157 | 12 | 69 |
| 65 | 74 | 76 | 113 | | | | | | | | | | | | | | | | | | |

⇩

Converted Pattern (A):

| | | | | | | | | | | | | | | | | | | | | | |
|---|---|---|---|---|---|---|---|---|---|---|---|---|---|---|---|---|---|---|---|---|---|
| 39 | 43 | 55 | 37 | 41 | 60 | 62 | 33 | 34 | 36 | 58 | 63 | 38 | 42 | 64 | 61 | 59 | 66 | 57 | 56 | 40 | 35 |
| 45 | 50 | 51 | 124 | 121 | 49 | 48 | 54 | 117 | 44 | 47 | 118 | 116 | 115 | 123 | 46 | 53 | 119 | 120 | 52 | 122 | 114 |
| 128 | 130 | 133 | 99 | 96 | 134 | 129 | 132 | 92 | 101 | 91 | 100 | 131 | 98 | 94 | 97 | 127 | 126 | 125 | 95 | 93 | 135 |
| 84 | 87 | 90 | 83 | 89 | 104 | 105 | 112 | 82 | 81 | 102 | 85 | 107 | 108 | 110 | 106 | 88 | 111 | 80 | 103 | 86 | 109 |
| 143 | 137 | 140 | 23 | 30 | 139 | 146 | 145 | 136 | 141 | 32 | 26 | 138 | 24 | 28 | 144 | 31 | 29 | 142 | 27 | 25 | 22 |
| 148 | 151 | 149 | 159 | 161 | 166 | 160 | 150 | 165 | 156 | 158 | 167 | 162 | 152 | 147 | 164 | 153 | 155 | 168 | 154 | 163 | 157 |
| 2 | 7 | 6 | 0 | 18 | 14 | 16 | 9 | 4 | 3 | 13 | 1 | 8 | 17 | 19 | 5 | 10 | 15 | 11 | 21 | 20 | 12 |
| 75 | 71 | 177 | 176 | 172 | 179 | 174 | 77 | 67 | 175 | 178 | 173 | 72 | 171 | 169 | 70 | 73 | 170 | 68 | 78 | 79 | 69 |
| 65 | 74 | 76 | 113 | | | | | | | | | | | | | | | | | | |

EP 3 247 043 A1

# FIG. 271

256QAM CR 6/15:

Original Pattern (B):

BIT GROUP

| | | | | | | | | | | | | | | | | | | | | | |
|---|---|---|---|---|---|---|---|---|---|---|---|---|---|---|---|---|---|---|---|---|---|
| 99 | 100 | 15 | 107 | 54 | 76 | 153 | 174 | 61 | 0 | 36 | 71 | 62 | 137 | 108 | 114 | 65 | 98 | 151 | 19 | 112 | 109 |
| 152 | 117 | 35 | 93 | 43 | 90 | 154 | 73 | 150 | 165 | 23 | 16 | 91 | 5 | 169 | 175 | 120 | 149 | 26 | 59 | 49 | 56 |
| 156 | 136 | 110 | 80 | 58 | 55 | 40 | 103 | 159 | 83 | 127 | 111 | 155 | 167 | 11 | 52 | 116 | 142 | 133 | 1 | 2 | 96 |
| 77 | 86 | 122 | 6 | 131 | 29 | 51 | 21 | 17 | 45 | 126 | 12 | 3 | 168 | 41 | 30 | 37 | 64 | 164 | 78 | 8 | 118 |
| 113 | 39 | 48 | 140 | 14 | 60 | 82 | 134 | 25 | 33 | 50 | 84 | 28 | 105 | 123 | 145 | 7 | 27 | 34 | 92 | 115 | 147 |
| 74 | 10 | 68 | 102 | 67 | 63 | 101 | 18 | 66 | 129 | 24 | 4 | 119 | 87 | 42 | 170 | 143 | 121 | 38 | 57 | 95 | 148 |
| 89 | 81 | 158 | 171 | 32 | 22 | 69 | 53 | 130 | 104 | 161 | 75 | 141 | 9 | 47 | 79 | 162 | 146 | 124 | 157 | 70 | 106 |
| 31 | 132 | 166 | 128 | 138 | 125 | 44 | 13 | 85 | 88 | 135 | 144 | 173 | 163 | 20 | 46 | 97 | 94 | 139 | 172 | 72 | 160 |
| 176 | 177 | 178 | 179 | | | | | | | | | | | | | | | | | | |

Converted Pattern (A):

| | | | | | | | | | | | | | | | | | | | | | |
|---|---|---|---|---|---|---|---|---|---|---|---|---|---|---|---|---|---|---|---|---|---|
| 99 | 61 | 65 | 35 | 23 | 26 | 58 | 155 | 2 | 51 | 41 | 113 | 25 | 7 | 68 | 24 | 38 | 32 | 141 | 70 | 44 | 20 |
| 100 | 0 | 98 | 93 | 16 | 59 | 55 | 167 | 96 | 21 | 30 | 39 | 33 | 27 | 102 | 4 | 57 | 22 | 9 | 106 | 13 | 46 |
| 15 | 36 | 151 | 43 | 91 | 49 | 40 | 11 | 77 | 17 | 37 | 48 | 50 | 34 | 67 | 119 | 95 | 69 | 47 | 31 | 85 | 97 |
| 107 | 71 | 19 | 90 | 5 | 56 | 103 | 52 | 86 | 45 | 64 | 140 | 84 | 92 | 63 | 87 | 148 | 53 | 79 | 132 | 88 | 94 |
| 54 | 62 | 112 | 154 | 169 | 156 | 159 | 116 | 122 | 126 | 164 | 14 | 28 | 115 | 101 | 42 | 89 | 130 | 162 | 166 | 135 | 139 |
| 76 | 137 | 109 | 73 | 175 | 136 | 83 | 142 | 6 | 12 | 78 | 60 | 105 | 147 | 18 | 170 | 81 | 104 | 146 | 128 | 144 | 172 |
| 153 | 108 | 152 | 150 | 120 | 110 | 127 | 133 | 131 | 3 | 8 | 82 | 123 | 74 | 66 | 143 | 158 | 161 | 124 | 138 | 173 | 72 |
| 174 | 114 | 117 | 165 | 149 | 80 | 111 | 1 | 29 | 168 | 118 | 134 | 145 | 10 | 129 | 121 | 171 | 75 | 157 | 125 | 163 | 160 |
| 176 | 177 | 178 | 179 | | | | | | | | | | | | | | | | | | |

## FIG. 272

EP 3 247 043 A1

256QAM CR 7/15:

Original Pattern (B):

BIT GROUP

| | | | | | | | | | | | | | | | | | | | | | |
|---|---|---|---|---|---|---|---|---|---|---|---|---|---|---|---|---|---|---|---|---|---|
| 24 | 157 | 0 | 43 | 126 | 172 | 135 | 65 | 32 | 18 | 114 | 42 | 162 | 67 | 104 | 61 | 23 | 11 | 4 | 96 | 163 | 75 |
| 109 | 58 | 79 | 154 | 3 | 95 | 168 | 73 | 103 | 60 | 84 | 148 | 113 | 40 | 164 | 173 | 143 | 49 | 29 | 156 | 7 | 89 |
| 132 | 179 | 138 | 53 | 85 | 12 | 117 | 36 | 122 | 66 | 107 | 64 | 28 | 147 | 2 | 90 | 131 | 70 | 144 | 55 | 26 | 15 |
| 112 | 35 | 128 | 176 | 106 | 59 | 80 | 19 | 6 | 92 | 129 | 174 | 99 | 62 | 82 | 13 | 121 | 41 | 127 | 71 | 139 | 63 |
| 25 | 151 | 9 | 39 | 159 | 69 | 142 | 52 | 77 | 21 | 119 | 38 | 167 | 178 | 101 | 56 | 87 | 155 | 5 | 91 | 166 | 169 |
| 146 | 50 | 81 | 20 | 111 | 88 | 165 | 177 | 108 | 47 | 27 | 149 | 115 | 33 | 161 | 72 | 102 | 57 | 86 | 16 | 110 | 97 |
| 123 | 68 | 100 | 48 | 31 | 14 | 8 | 93 | 130 | 170 | 133 | 44 | 78 | 150 | 118 | 94 | 158 | 76 | 134 | 46 | 83 | 152 |
| 1 | 37 | 160 | 171 | 136 | 54 | 22 | 17 | 116 | 34 | 125 | 175 | 105 | 45 | 30 | 153 | 10 | 98 | 124 | 74 | 137 | 51 |
| 120 | 141 | 140 | 145 | | | | | | | | | | | | | | | | | | |

⇩

Converted Pattern (A):

| | | | | | | | | | | | | | | | | | | | | | |
|---|---|---|---|---|---|---|---|---|---|---|---|---|---|---|---|---|---|---|---|---|---|
| 24 | 32 | 23 | 79 | 84 | 29 | 85 | 28 | 26 | 80 | 82 | 25 | 77 | 87 | 81 | 27 | 86 | 31 | 78 | 83 | 22 | 30 |
| 157 | 18 | 11 | 154 | 148 | 156 | 12 | 147 | 15 | 19 | 13 | 151 | 21 | 155 | 20 | 149 | 16 | 14 | 150 | 152 | 17 | 153 |
| 0 | 114 | 4 | 3 | 113 | 7 | 117 | 2 | 112 | 6 | 121 | 9 | 119 | 5 | 111 | 115 | 110 | 8 | 118 | 1 | 116 | 10 |
| 43 | 42 | 96 | 95 | 40 | 89 | 36 | 90 | 35 | 92 | 41 | 39 | 38 | 91 | 88 | 33 | 97 | 93 | 94 | 37 | 34 | 98 |
| 126 | 162 | 163 | 168 | 164 | 132 | 122 | 131 | 128 | 129 | 127 | 159 | 167 | 166 | 165 | 161 | 123 | 130 | 158 | 160 | 125 | 124 |
| 172 | 67 | 75 | 73 | 173 | 179 | 66 | 70 | 176 | 174 | 71 | 69 | 178 | 169 | 177 | 72 | 68 | 170 | 76 | 171 | 175 | 74 |
| 135 | 104 | 109 | 103 | 143 | 138 | 107 | 144 | 106 | 99 | 139 | 142 | 101 | 146 | 108 | 102 | 100 | 133 | 134 | 136 | 105 | 137 |
| 65 | 61 | 58 | 60 | 49 | 53 | 64 | 55 | 59 | 62 | 63 | 52 | 56 | 50 | 47 | 57 | 48 | 44 | 46 | 54 | 45 | 51 |
| 120 | 141 | 140 | 145 | | | | | | | | | | | | | | | | | | |

# FIG. 273

256QAM CR 8/15:

Original Pattern (B):

BIT GROUP

| 85 | 3 | 148 | 161 | 96 | 99 | 154 | 13 | 78 | 160 | 61 | 36 | 21 | 141 | 121 | 115 | 82 | 1 | 59 | 72 | 43 | 135 |
|---|---|---|---|---|---|---|---|---|---|---|---|---|---|---|---|---|---|---|---|---|---|
| 168 | 139 | 46 | 10 | 56 | 67 | 108 | 134 | 111 | 105 | 66 | 89 | 137 | 130 | 104 | 143 | 113 | 11 | 84 | 157 | 32 | 73 |
| 90 | 38 | 117 | 146 | 53 | 2 | 60 | 93 | 91 | 71 | 114 | 19 | 47 | 4 | 26 | 75 | 109 | 41 | 50 | 153 | 54 | 163 |
| 31 | 24 | 106 | 42 | 170 | 62 | 80 | 164 | 65 | 128 | 12 | 142 | 167 | 155 | 88 | 8 | 22 | 131 | 158 | 33 | 178 | 145 |
| 70 | 9 | 51 | 69 | 102 | 140 | 173 | 147 | 83 | 165 | 30 | 126 | 100 | 138 | 171 | 103 | 45 | 159 | 27 | 74 | 97 | 122 |
| 120 | 16 | 52 | 162 | 132 | 124 | 94 | 133 | 172 | 149 | 86 | 77 | 25 | 68 | 177 | 64 | 174 | 15 | 0 | 125 | 63 | 35 |
| 34 | 40 | 179 | 20 | 44 | 7 | 55 | 28 | 101 | 150 | 110 | 18 | 119 | 5 | 29 | 76 | 107 | 136 | 112 | 144 | 48 | 81 |
| 57 | 49 | 92 | 95 | 118 | 17 | 156 | 166 | 23 | 129 | 79 | 37 | 175 | 152 | 87 | 6 | 58 | 127 | 98 | 123 | 39 | 14 |

| 116 | 169 | 176 | 151 |
|---|---|---|---|

Converted Pattern (A):

| 85 | 78 | 82 | 46 | 66 | 84 | 53 | 47 | 54 | 80 | 88 | 70 | 83 | 45 | 52 | 86 | 0 | 44 | 119 | 48 | 156 | 87 |
|---|---|---|---|---|---|---|---|---|---|---|---|---|---|---|---|---|---|---|---|---|---|
| 3 | 160 | 1 | 10 | 89 | 157 | 2 | 4 | 163 | 164 | 8 | 9 | 165 | 159 | 162 | 77 | 125 | 7 | 5 | 81 | 166 | 6 |
| 148 | 61 | 59 | 56 | 137 | 32 | 60 | 26 | 31 | 65 | 22 | 51 | 30 | 27 | 132 | 25 | 63 | 55 | 29 | 57 | 23 | 58 |
| 161 | 36 | 72 | 67 | 130 | 73 | 93 | 75 | 24 | 128 | 131 | 69 | 126 | 74 | 124 | 68 | 35 | 28 | 76 | 49 | 129 | 127 |
| 96 | 21 | 43 | 108 | 104 | 90 | 91 | 109 | 106 | 12 | 158 | 102 | 100 | 97 | 94 | 177 | 34 | 101 | 107 | 92 | 79 | 98 |
| 99 | 141 | 135 | 134 | 143 | 38 | 71 | 41 | 42 | 142 | 33 | 140 | 138 | 122 | 133 | 64 | 40 | 150 | 136 | 95 | 37 | 123 |
| 154 | 121 | 168 | 111 | 113 | 117 | 114 | 50 | 170 | 167 | 178 | 173 | 171 | 120 | 172 | 174 | 179 | 110 | 112 | 118 | 175 | 39 |
| 13 | 115 | 139 | 105 | 11 | 146 | 19 | 153 | 62 | 155 | 145 | 147 | 103 | 16 | 149 | 15 | 20 | 18 | 144 | 17 | 152 | 14 |

| 116 | 169 | 176 | 151 |
|---|---|---|---|

EP 3 247 043 A1

# FIG. 274

EP 3 247 043 A1

256QAM CR 9/15:

Original Pattern (A):

BIT GROUP

| 58 | 70 | 23 | 32 | 26 | 63 | 55 | 48 | 35 | 41 | 53 | 20 | 38 | 51 | 61 | 65 | 44 | 29 | 7 | 2 | 113 | 68 |
|----|----|----|----|----|----|----|----|----|----|----|----|----|----|----|----|----|----|----|----|----|----|
| 96 | 104 | 106 | 89 | 27 | 0 | 119 | 21 | 4 | 49 | 46 | 100 | 13 | 36 | 57 | 98 | 102 | 9 | 42 | 39 | 33 | 62 |
| 22 | 95 | 101 | 15 | 91 | 25 | 93 | 132 | 69 | 87 | 47 | 59 | 67 | 124 | 17 | 11 | 31 | 43 | 40 | 37 | 85 | 50 |
| 97 | 140 | 45 | 92 | 56 | 30 | 34 | 60 | 107 | 24 | 52 | 94 | 64 | 5 | 71 | 90 | 66 | 103 | 88 | 86 | 84 | 19 |
| 169 | 159 | 147 | 126 | 28 | 130 | 14 | 162 | 144 | 166 | 108 | 153 | 115 | 135 | 120 | 122 | 112 | 139 | 151 | 156 | 16 | 172 |
| 164 | 123 | 99 | 54 | 136 | 81 | 105 | 128 | 116 | 150 | 155 | 76 | 18 | 142 | 170 | 175 | 83 | 146 | 78 | 109 | 73 | 131 |
| 127 | 82 | 167 | 77 | 110 | 79 | 137 | 152 | 3 | 173 | 148 | 72 | 158 | 117 | 1 | 6 | 12 | 8 | 161 | 74 | 143 | 133 |
| 168 | 171 | 134 | 163 | 138 | 121 | 141 | 160 | 111 | 10 | 149 | 80 | 75 | 165 | 157 | 174 | 129 | 145 | 114 | 125 | 154 | 118 |

| 176 | 177 | 178 | 179 |
|-----|-----|-----|-----|

⇩

Converted Pattern (B):

| 58 | 96 | 22 | 97 | 169 | 164 | 127 | 168 | 70 | 104 | 95 | 140 | 159 | 123 | 82 | 171 | 23 | 106 | 101 | 45 | 147 | 99 |
|----|----|----|----|----|----|----|----|----|----|----|----|----|----|----|----|----|----|----|----|----|----|
| 167 | 134 | 32 | 89 | 15 | 92 | 126 | 54 | 77 | 163 | 26 | 27 | 91 | 56 | 28 | 136 | 110 | 138 | 63 | 0 | 25 | 30 |
| 130 | 81 | 79 | 121 | 55 | 119 | 93 | 34 | 14 | 105 | 137 | 141 | 48 | 21 | 132 | 60 | 162 | 128 | 152 | 160 | 35 | 4 |
| 69 | 107 | 144 | 116 | 3 | 111 | 41 | 49 | 87 | 24 | 166 | 150 | 173 | 10 | 53 | 46 | 47 | 52 | 108 | 155 | 148 | 149 |
| 20 | 100 | 59 | 94 | 153 | 76 | 72 | 80 | 38 | 13 | 67 | 64 | 115 | 18 | 158 | 75 | 51 | 36 | 124 | 5 | 135 | 142 |
| 117 | 165 | 61 | 57 | 17 | 71 | 120 | 170 | 1 | 157 | 65 | 98 | 11 | 90 | 122 | 175 | 6 | 174 | 44 | 102 | 31 | 66 |
| 112 | 83 | 12 | 129 | 29 | 9 | 43 | 103 | 139 | 146 | 8 | 145 | 7 | 42 | 40 | 88 | 151 | 78 | 161 | 114 | 2 | 39 |
| 37 | 86 | 156 | 109 | 74 | 125 | 113 | 33 | 85 | 84 | 16 | 73 | 143 | 154 | 68 | 62 | 50 | 19 | 172 | 131 | 133 | 118 |

| 176 | 177 | 178 | 179 |
|-----|-----|-----|-----|

# FIG. 275

256QAM CR 10/15:

Original Pattern (B):   BIT GROUP

| | | | | | | | | | | | | | | | | | | | | | |
|---|---|---|---|---|---|---|---|---|---|---|---|---|---|---|---|---|---|---|---|---|---|
| 45 | 31 | 67 | 35 | 159 | 157 | 177 | 2 | 44 | 23 | 73 | 148 | 163 | 118 | 176 | 4 | 14 | 97 | 142 | 37 | 143 | 149 |
| 179 | 3 | 12 | 32 | 140 | 42 | 167 | 166 | 41 | 126 | 13 | 30 | 144 | 57 | 113 | 147 | 173 | 6 | 52 | 24 | 39 | 64 |
| 80 | 112 | 104 | 174 | 11 | 151 | 71 | 109 | 162 | 79 | 171 | 127 | 46 | 92 | 38 | 132 | 81 | 120 | 100 | 1 | 53 | 88 |
| 76 | 60 | 103 | 139 | 99 | 125 | 48 | 93 | 135 | 161 | 77 | 110 | 107 | 121 | 18 | 95 | 69 | 63 | 83 | 111 | 170 | 7 |
| 16 | 98 | 141 | 61 | 86 | 116 | 172 | 130 | 49 | 25 | 40 | 65 | 87 | 108 | 101 | 5 | 21 | 89 | 75 | 43 | 82 | 146 |
| 105 | 128 | 17 | 29 | 106 | 34 | 160 | 155 | 175 | 124 | 15 | 28 | 134 | 62 | 119 | 145 | 72 | 10 | 58 | 91 | 74 | 36 |
| 68 | 150 | 8 | 9 | 54 | 26 | 137 | 56 | 165 | 115 | 114 | 0 | 47 | 27 | 22 | 20 | 168 | 154 | 102 | 123 | 50 | 94 |
| 66 | 33 | 85 | 59 | 164 | 131 | 51 | 90 | 70 | 138 | 84 | 117 | 178 | 122 | 19 | 96 | 156 | 55 | 78 | 158 | 169 | 129 |
| 133 | 152 | 136 | 153 | | | | | | | | | | | | | | | | | | |

Converted Pattern (A):

| | | | | | | | | | | | | | | | | | | | | | |
|---|---|---|---|---|---|---|---|---|---|---|---|---|---|---|---|---|---|---|---|---|---|
| 45 | 44 | 14 | 12 | 13 | 52 | 11 | 46 | 53 | 48 | 18 | 16 | 49 | 21 | 17 | 15 | 58 | 54 | 47 | 50 | 51 | 19 |
| 31 | 23 | 97 | 32 | 30 | 24 | 151 | 92 | 88 | 93 | 95 | 98 | 25 | 89 | 29 | 28 | 91 | 26 | 27 | 94 | 90 | 96 |
| 67 | 73 | 142 | 140 | 144 | 39 | 71 | 38 | 76 | 135 | 69 | 141 | 40 | 75 | 106 | 134 | 74 | 137 | 22 | 66 | 70 | 156 |
| 35 | 148 | 37 | 42 | 57 | 64 | 109 | 132 | 60 | 161 | 63 | 61 | 65 | 43 | 34 | 62 | 36 | 56 | 20 | 33 | 138 | 55 |
| 159 | 163 | 143 | 167 | 113 | 80 | 162 | 81 | 103 | 77 | 83 | 86 | 87 | 82 | 160 | 119 | 68 | 165 | 168 | 85 | 84 | 78 |
| 157 | 118 | 149 | 166 | 147 | 112 | 79 | 120 | 139 | 110 | 111 | 116 | 108 | 146 | 155 | 145 | 150 | 115 | 154 | 59 | 117 | 158 |
| 177 | 176 | 179 | 41 | 173 | 104 | 171 | 100 | 99 | 107 | 170 | 172 | 101 | 105 | 175 | 72 | 8 | 114 | 102 | 164 | 178 | 169 |
| 2 | 4 | 3 | 126 | 6 | 174 | 127 | 1 | 125 | 121 | 7 | 130 | 5 | 128 | 124 | 10 | 9 | 0 | 123 | 131 | 122 | 129 |
| 133 | 152 | 136 | 153 | | | | | | | | | | | | | | | | | | |

# FIG. 276

EP 3 247 043 A1

256QAM CR 11/15:

Original Pattern (B):

BIT GROUP

| | | | | | | | | | | | | | | | | | | | | | |
|---|---|---|---|---|---|---|---|---|---|---|---|---|---|---|---|---|---|---|---|---|---|
| 27 | 68 | 35 | 117 | 138 | 83 | 127 | 10 | 60 | 73 | 47 | 115 | 155 | 81 | 170 | 9 | 65 | 66 | 52 | 112 | 150 | 77 |
| 171 | 161 | 22 | 20 | 39 | 106 | 147 | 90 | 126 | 165 | 23 | 16 | 45 | 113 | 154 | 86 | 173 | 158 | 24 | 71 | 40 | 107 |
| 136 | 94 | 128 | 163 | 31 | 72 | 33 | 101 | 134 | 80 | 175 | 7 | 61 | 19 | 49 | 111 | 135 | 92 | 130 | 6 | 62 | 74 |
| 43 | 116 | 133 | 89 | 129 | 8 | 28 | 15 | 34 | 105 | 146 | 84 | 174 | 4 | 32 | 75 | 44 | 118 | 132 | 96 | 169 | 159 |
| 58 | 18 | 42 | 100 | 141 | 87 | 131 | 157 | 63 | 11 | 48 | 108 | 151 | 79 | 177 | 168 | 26 | 17 | 36 | 102 | 137 | 95 |
| 122 | 1 | 25 | 21 | 50 | 120 | 153 | 97 | 121 | 0 | 55 | 14 | 46 | 114 | 152 | 91 | 178 | 3 | 30 | 13 | 37 | 103 |
| 145 | 82 | 125 | 166 | 57 | 76 | 51 | 99 | 144 | 85 | 123 | 162 | 56 | 12 | 53 | 119 | 139 | 78 | 179 | 5 | 64 | 70 |
| 54 | 110 | 148 | 93 | 172 | 164 | 29 | 69 | 38 | 109 | 143 | 88 | 124 | 160 | 59 | 67 | 41 | 104 | 149 | 98 | 176 | 2 |
| 167 | 156 | 140 | 142 | | | | | | | | | | | | | | | | | | |

⇩

Converted Pattern (A):

| | | | | | | | | | | | | | | | | | | | | | |
|---|---|---|---|---|---|---|---|---|---|---|---|---|---|---|---|---|---|---|---|---|---|
| 27 | 60 | 65 | 22 | 23 | 24 | 31 | 61 | 62 | 28 | 32 | 58 | 63 | 26 | 25 | 55 | 30 | 57 | 56 | 64 | 29 | 59 |
| 68 | 73 | 66 | 20 | 16 | 71 | 72 | 19 | 74 | 15 | 75 | 18 | 11 | 17 | 21 | 14 | 13 | 76 | 12 | 70 | 69 | 67 |
| 35 | 47 | 52 | 39 | 45 | 40 | 33 | 49 | 43 | 34 | 44 | 42 | 48 | 36 | 50 | 46 | 37 | 51 | 53 | 54 | 38 | 41 |
| 117 | 115 | 112 | 106 | 113 | 107 | 101 | 111 | 116 | 105 | 118 | 100 | 108 | 102 | 120 | 114 | 103 | 99 | 119 | 110 | 109 | 104 |
| 138 | 155 | 150 | 147 | 154 | 136 | 134 | 135 | 133 | 146 | 132 | 141 | 151 | 137 | 153 | 152 | 145 | 144 | 139 | 148 | 143 | 149 |
| 83 | 81 | 77 | 90 | 86 | 94 | 80 | 92 | 89 | 84 | 96 | 87 | 79 | 95 | 97 | 91 | 82 | 85 | 78 | 93 | 88 | 98 |
| 127 | 170 | 171 | 126 | 173 | 128 | 175 | 130 | 129 | 174 | 169 | 131 | 177 | 122 | 121 | 178 | 125 | 123 | 179 | 172 | 124 | 176 |
| 10 | 9 | 161 | 165 | 158 | 163 | 7 | 6 | 8 | 4 | 159 | 157 | 168 | 1 | 0 | 3 | 166 | 162 | 5 | 164 | 160 | 2 |
| 167 | 156 | 140 | 142 | | | | | | | | | | | | | | | | | | |

# FIG. 277

256QAM CR 12/15:

Original Pattern (A):

BIT GROUP

| 51 | 122 | 91 | 111 | 95 | 100 | 119 | 130 | 78 | 57 | 65 | 26 | 61 | 126 | 105 | 143 | 70 | 132 | 39 | 102 | 115 | 116 |
| 6 | 14 | 3 | 21 | 71 | 134 | 2 | 0 | 140 | 106 | 7 | 118 | 23 | 35 | 20 | 17 | 50 | 48 | 112 | 13 | 66 | 5 |
| 75 | 42 | 129 | 107 | 30 | 45 | 137 | 114 | 37 | 87 | 53 | 85 | 101 | 141 | 120 | 99 | 88 | 117 | 64 | 28 | 135 | 138 |
| 108 | 113 | 58 | 97 | 38 | 124 | 86 | 33 | 74 | 32 | 29 | 128 | 67 | 104 | 80 | 127 | 56 | 34 | 89 | 94 | 49 | 55 |
| 93 | 136 | 68 | 62 | 54 | 40 | 81 | 103 | 121 | 76 | 44 | 84 | 96 | 123 | 154 | 98 | 82 | 142 | 46 | 169 | 131 | 72 |
| 47 | 69 | 125 | 31 | 83 | 36 | 59 | 90 | 79 | 52 | 133 | 60 | 92 | 139 | 110 | 27 | 73 | 43 | 77 | 109 | 63 | 41 |
| 168 | 147 | 161 | 165 | 175 | 162 | 164 | 158 | 157 | 160 | 150 | 171 | 167 | 145 | 151 | 153 | 9 | 155 | 170 | 146 | 166 | 149 |
| 15 | 159 | 11 | 176 | 152 | 156 | 144 | 148 | 172 | 178 | 24 | 22 | 179 | 4 | 163 | 174 | 173 | 19 | 10 | 177 | 12 | 16 |
| 1 | 8 | 18 | 25 |

Converted Pattern (B):

| 51 | 6 | 75 | 108 | 93 | 47 | 168 | 15 | 122 | 14 | 42 | 113 | 136 | 69 | 147 | 159 | 91 | 3 | 129 | 58 | 68 | 125 |
| 161 | 11 | 111 | 21 | 107 | 97 | 62 | 31 | 165 | 176 | 95 | 71 | 30 | 38 | 54 | 83 | 175 | 152 | 100 | 134 | 45 | 124 |
| 40 | 36 | 162 | 156 | 119 | 2 | 137 | 86 | 81 | 59 | 164 | 144 | 130 | 0 | 114 | 33 | 103 | 90 | 158 | 148 | 78 | 140 |
| 37 | 74 | 121 | 79 | 157 | 172 | 57 | 106 | 87 | 32 | 76 | 52 | 160 | 178 | 65 | 7 | 53 | 29 | 44 | 133 | 150 | 24 |
| 26 | 118 | 85 | 128 | 84 | 60 | 171 | 22 | 61 | 23 | 101 | 67 | 96 | 92 | 167 | 179 | 126 | 35 | 141 | 104 | 123 | 139 |
| 145 | 4 | 105 | 20 | 120 | 80 | 154 | 110 | 151 | 163 | 143 | 17 | 99 | 127 | 98 | 27 | 153 | 174 | 70 | 50 | 88 | 56 |
| 82 | 73 | 9 | 173 | 132 | 48 | 117 | 34 | 142 | 43 | 155 | 19 | 39 | 112 | 64 | 89 | 46 | 77 | 170 | 10 | 102 | 13 |
| 28 | 94 | 169 | 109 | 146 | 177 | 115 | 66 | 135 | 49 | 131 | 63 | 166 | 12 | 116 | 5 | 138 | 55 | 72 | 41 | 149 | 16 |
| 1 | 8 | 18 | 25 |

## FIG. 278

256QAM CR 13/15:

Original Pattern (B):

BIT GROUP

| 59 | 85 | 108 | 128 | 49 | 91 | 163 | 3 | 58 | 16 | 106 | 126 | 74 | 141 | 167 | 35 | 57 | 82 | 30 | 123 | 68 | 95 |
|---|---|---|---|---|---|---|---|---|---|---|---|---|---|---|---|---|---|---|---|---|---|
| 160 | 42 | 62 | 21 | 102 | 131 | 52 | 142 | 157 | 10 | 55 | 79 | 24 | 130 | 73 | 92 | 179 | 2 | 61 | 11 | 104 | 122 |
| 45 | 140 | 159 | 43 | 148 | 19 | 23 | 111 | 76 | 135 | 169 | 39 | 63 | 77 | 25 | 117 | 75 | 94 | 155 | 5 | 145 | 14 |
| 26 | 127 | 46 | 138 | 158 | 38 | 64 | 86 | 105 | 118 | 50 | 137 | 175 | 7 | 144 | 84 | 22 | 113 | 54 | 98 | 172 | 9 |
| 146 | 17 | 27 | 114 | 51 | 139 | 156 | 37 | 147 | 78 | 103 | 115 | 66 | 97 | 168 | 34 | 60 | 83 | 107 | 121 | 48 | 93 |
| 174 | 33 | 65 | 87 | 99 | 124 | 71 | 136 | 154 | 0 | 150 | 20 | 101 | 112 | 70 | 96 | 170 | 1 | 149 | 80 | 28 | 125 |
| 53 | 90 | 173 | 6 | 153 | 13 | 29 | 116 | 72 | 88 | 165 | 8 | 143 | 12 | 31 | 119 | 47 | 89 | 164 | 40 | 151 | 81 |
| 109 | 110 | 44 | 134 | 162 | 36 | 152 | 15 | 100 | 129 | 67 | 133 | 166 | 41 | 56 | 18 | 32 | 120 | 69 | 132 | 161 | 4 |
| 177 | 176 | 178 | 171 | | | | | | | | | | | | | | | | | | |

Converted Pattern (A):

| 59 | 58 | 57 | 62 | 55 | 61 | 148 | 63 | 145 | 64 | 144 | 146 | 147 | 60 | 65 | 150 | 149 | 153 | 143 | 151 | 152 | 56 |
|---|---|---|---|---|---|---|---|---|---|---|---|---|---|---|---|---|---|---|---|---|---|
| 85 | 16 | 82 | 21 | 79 | 11 | 19 | 77 | 14 | 86 | 84 | 17 | 78 | 83 | 87 | 20 | 80 | 13 | 12 | 81 | 15 | 18 |
| 108 | 106 | 30 | 102 | 24 | 104 | 23 | 25 | 26 | 105 | 22 | 27 | 103 | 107 | 99 | 101 | 28 | 29 | 31 | 109 | 100 | 32 |
| 128 | 126 | 123 | 131 | 130 | 122 | 111 | 117 | 127 | 118 | 113 | 114 | 115 | 121 | 124 | 112 | 125 | 116 | 119 | 110 | 129 | 120 |
| 49 | 74 | 68 | 52 | 73 | 45 | 76 | 75 | 46 | 50 | 54 | 51 | 66 | 48 | 71 | 70 | 53 | 72 | 47 | 44 | 67 | 69 |
| 91 | 141 | 95 | 142 | 92 | 140 | 135 | 94 | 138 | 137 | 98 | 139 | 97 | 93 | 136 | 96 | 90 | 88 | 89 | 134 | 133 | 132 |
| 163 | 167 | 160 | 157 | 179 | 159 | 169 | 155 | 158 | 175 | 172 | 156 | 168 | 174 | 154 | 170 | 173 | 165 | 164 | 162 | 166 | 161 |
| 3 | 35 | 42 | 10 | 2 | 43 | 39 | 5 | 38 | 7 | 9 | 37 | 34 | 33 | 0 | 1 | 6 | 8 | 40 | 36 | 41 | 4 |
| 177 | 176 | 178 | 171 | | | | | | | | | | | | | | | | | | |

## FIG. 279

EP 3 247 043 A1

1024QAM CR 2/15:

Original Pattern (A):

BIT GROUP

| 157 | 25 | 107 | 160 | 37 | 138 | 111 | 35 | 29 | 44 | 15 | 162 | 66 | 20 | 49 | 126 | 89 | 147 | 159 | 174 | 142 | 26 |
|---|---|---|---|---|---|---|---|---|---|---|---|---|---|---|---|---|---|---|---|---|---|
| 146 | 10 | 164 | 152 | 57 | 110 | 83 | 167 | 169 | 16 | 6 | 172 | 62 | 173 | 7 | 145 | 4 | 67 | 115 | 50 | 39 | 72 |
| 79 | 74 | 40 | 132 | 42 | 30 | 163 | 161 | 55 | 143 | 63 | 117 | 86 | 121 | 2 | 28 | 69 | 150 | 24 | 177 | 43 | 158 |
| 27 | 21 | 128 | 46 | 118 | 114 | 127 | 135 | 92 | 76 | 19 | 94 | 179 | 3 | 52 | 101 | 137 | 84 | 73 | 108 | 91 | 120 |
| 47 | 1 | 102 | 58 | 68 | 82 | 59 | 119 | 64 | 31 | 61 | 105 | 103 | 151 | 124 | 70 | 8 | 155 | 90 | 166 | 41 | 45 |
| 178 | 113 | 140 | 75 | 148 | 109 | 100 | 125 | 11 | 116 | 34 | 36 | 176 | 170 | 156 | 136 | 171 | 122 | 78 | 87 | 106 | 123 |
| 149 | 17 | 99 | 175 | 18 | 9 | 165 | 153 | 12 | 81 | 77 | 60 | 93 | 104 | 13 | 5 | 88 | 96 | 141 | 133 | 154 | 144 |
| 48 | 97 | 23 | 14 | 98 | 53 | 134 | 112 | 65 | 0 | 130 | 32 | 168 | 33 | 131 | 22 | 38 | 56 | 80 | 95 | 71 | 85 |
| 139 | 129 | 51 | 54 | | | | | | | | | | | | | | | | | | |

⇩

Converted Pattern (B):

| 157 | 159 | 7 | 63 | 127 | 102 | 41 | 171 | 93 | 65 | 25 | 174 | 145 | 117 | 135 | 58 | 45 | 122 | 104 | 0 | 107 | 142 |
|---|---|---|---|---|---|---|---|---|---|---|---|---|---|---|---|---|---|---|---|---|---|
| 4 | 86 | 92 | 68 | 178 | 78 | 13 | 130 | 160 | 26 | 67 | 121 | 76 | 82 | 113 | 87 | 5 | 32 | 37 | 146 | 115 | 2 |
| 19 | 59 | 140 | 106 | 88 | 168 | 138 | 10 | 50 | 28 | 94 | 119 | 75 | 123 | 96 | 33 | 111 | 164 | 39 | 69 | 179 | 64 |
| 148 | 149 | 141 | 131 | 35 | 152 | 72 | 150 | 3 | 31 | 109 | 17 | 133 | 22 | 29 | 57 | 79 | 24 | 52 | 61 | 100 | 99 |
| 154 | 38 | 44 | 110 | 74 | 177 | 101 | 105 | 125 | 175 | 144 | 56 | 15 | 83 | 40 | 43 | 137 | 103 | 11 | 18 | 48 | 80 |
| 162 | 167 | 132 | 158 | 84 | 151 | 116 | 9 | 97 | 95 | 66 | 169 | 42 | 27 | 73 | 124 | 34 | 165 | 23 | 71 | 20 | 16 |
| 30 | 21 | 108 | 70 | 36 | 153 | 14 | 85 | 49 | 6 | 163 | 128 | 91 | 8 | 176 | 12 | 98 | 139 | 126 | 172 | 161 | 46 |
| 120 | 155 | 170 | 81 | 53 | 129 | 89 | 62 | 55 | 118 | 47 | 90 | 156 | 77 | 134 | 51 | 147 | 173 | 143 | 114 | 1 | 166 |
| 136 | 60 | 112 | 54 | | | | | | | | | | | | | | | | | | |

# FIG. 280

1024QAM CR 3/15:

Original Pattern (A):

BIT GROUP

| 113 | 153 | 13 | 8 | 103 | 115 | 137 | 69 | 151 | 111 | 18 | 38 | 42 | 150 | 179 | 130 | 148 | 6 | 4 | 31 | 44 | 68 |
| 145 | 126 | 106 | 24 | 100 | 93 | 21 | 35 | 143 | 57 | 166 | 65 | 53 | 41 | 122 | 7 | 29 | 25 | 136 | 162 | 158 | 26 |
| 124 | 32 | 17 | 168 | 56 | 12 | 39 | 176 | 131 | 132 | 51 | 89 | 101 | 160 | 49 | 87 | 14 | 55 | 127 | 37 | 169 | 110 |
| 83 | 134 | 107 | 46 | 33 | 114 | 108 | 82 | 125 | 109 | 95 | 174 | 62 | 164 | 144 | 16 | 121 | 58 | 80 | 2 | 163 | 159 |
| 157 | 90 | 104 | 23 | 172 | 112 | 19 | 133 | 102 | 75 | 45 | 86 | 63 | 22 | 54 | 105 | 155 | 77 | 178 | 70 | 98 | 40 |
| 118 | 84 | 78 | 0 | 99 | 123 | 5 | 34 | 71 | 96 | 175 | 10 | 30 | 72 | 28 | 74 | 154 | 61 | 91 | 85 | 135 | 152 |
| 15 | 88 | 165 | 60 | 52 | 149 | 147 | 59 | 116 | 120 | 3 | 64 | 140 | 67 | 94 | 27 | 9 | 81 | 43 | 11 | 167 | 139 |
| 92 | 129 | 20 | 117 | 128 | 50 | 119 | 47 | 1 | 156 | 142 | 170 | 171 | 48 | 177 | 66 | 161 | 79 | 73 | 76 | 173 | 97 |
| 36 | 141 | 146 | 138 | | | | | | | | | | | | | | | | | | |

Converted Pattern (B):

| 113 | 4 | 122 | 51 | 108 | 104 | 98 | 154 | 140 | 1 | 153 | 31 | 7 | 89 | 82 | 23 | 40 | 61 | 67 | 156 | 13 | 44 |
| 29 | 101 | 125 | 172 | 118 | 91 | 94 | 142 | 8 | 68 | 25 | 160 | 109 | 112 | 84 | 85 | 27 | 170 | 103 | 145 | 136 | 49 |
| 95 | 19 | 78 | 135 | 9 | 171 | 115 | 126 | 162 | 87 | 174 | 133 | 0 | 152 | 81 | 48 | 137 | 106 | 158 | 14 | 62 | 102 |
| 99 | 15 | 43 | 177 | 69 | 24 | 26 | 55 | 164 | 75 | 123 | 88 | 11 | 66 | 151 | 100 | 124 | 127 | 144 | 45 | 5 | 165 |
| 167 | 161 | 111 | 93 | 32 | 37 | 16 | 86 | 34 | 60 | 139 | 79 | 18 | 21 | 17 | 169 | 121 | 63 | 71 | 52 | 92 | 73 |
| 38 | 35 | 168 | 110 | 58 | 22 | 96 | 149 | 129 | 76 | 42 | 143 | 56 | 83 | 80 | 54 | 175 | 147 | 20 | 173 | 150 | 57 |
| 12 | 134 | 2 | 105 | 10 | 59 | 117 | 97 | 179 | 166 | 39 | 107 | 163 | 155 | 30 | 116 | 128 | 36 | 130 | 65 | 176 | 46 |
| 159 | 77 | 72 | 120 | 50 | 141 | 148 | 53 | 131 | 33 | 157 | 178 | 28 | 3 | 119 | 146 | 6 | 41 | 132 | 114 | 90 | 70 |
| 74 | 64 | 47 | 138 | | | | | | | | | | | | | | | | | | |

EP 3 247 043 A1

# FIG. 281

1024QAM CR 4/15:

Original Pattern (A):

| 114 | 133 | 4 | 73 | 8 | 139 | 7 | 5 | 177 | 88 | 66 | 11 | 24 | 74 | 49 | 45 | 167 | 81 | 117 | 137 | 46 | 22 |
| 165 | 51 | 68 | 110 | 6 | 1 | 16 | 132 | 130 | 143 | 169 | 2 | 20 | 140 | 94 | 21 | 91 | 126 | 172 | 27 | 162 | 34 |
| 113 | 142 | 166 | 115 | 106 | 160 | 84 | 136 | 175 | 0 | 26 | 151 | 69 | 174 | 59 | 159 | 161 | 170 | 52 | 164 | 80 | 108 |
| 3 | 23 | 101 | 33 | 125 | 111 | 63 | 124 | 98 | 40 | 145 | 9 | 39 | 155 | 149 | 147 | 67 | 76 | 48 | 120 | 119 | 53 |
| 54 | 138 | 179 | 156 | 127 | 13 | 152 | 129 | 123 | 141 | 109 | 89 | 121 | 50 | 10 | 37 | 104 | 144 | 86 | 178 | 96 | 148 |
| 128 | 56 | 64 | 153 | 95 | 12 | 105 | 41 | 154 | 99 | 25 | 171 | 92 | 17 | 134 | 19 | 61 | 32 | 85 | 102 | 14 | 71 |
| 146 | 163 | 173 | 118 | 57 | 18 | 36 | 42 | 78 | 31 | 97 | 55 | 58 | 116 | 90 | 168 | 43 | 72 | 15 | 112 | 93 | 60 |
| 38 | 103 | 87 | 158 | 35 | 29 | 176 | 150 | 77 | 79 | 122 | 47 | 28 | 135 | 100 | 83 | 65 | 131 | 75 | 157 | 62 | 70 |
| 44 | 30 | 107 | 82 | | | | | | | | | | | | | | | | | | |

Converted Pattern (B):

| 114 | 117 | 94 | 26 | 63 | 179 | 96 | 61 | 58 | 77 | 133 | 137 | 21 | 151 | 124 | 156 | 148 | 32 | 116 | 79 | 4 | 46 |
| 91 | 69 | 98 | 127 | 128 | 85 | 90 | 122 | 73 | 22 | 126 | 174 | 40 | 13 | 56 | 102 | 168 | 47 | 8 | 165 | 172 | 59 |
| 145 | 152 | 64 | 14 | 43 | 28 | 139 | 51 | 27 | 159 | 9 | 129 | 153 | 71 | 72 | 135 | 7 | 68 | 162 | 161 | 39 | 123 |
| 95 | 146 | 15 | 100 | 5 | 110 | 34 | 170 | 155 | 141 | 12 | 163 | 112 | 83 | 177 | 6 | 113 | 52 | 149 | 109 | 105 | 173 |
| 93 | 65 | 88 | 1 | 142 | 164 | 147 | 89 | 41 | 118 | 60 | 131 | 66 | 16 | 166 | 80 | 67 | 121 | 154 | 57 | 38 | 75 |
| 11 | 132 | 115 | 108 | 76 | 50 | 99 | 18 | 103 | 157 | 24 | 130 | 106 | 3 | 48 | 10 | 25 | 36 | 87 | 62 | 74 | 143 |
| 160 | 23 | 120 | 37 | 171 | 42 | 158 | 70 | 49 | 169 | 84 | 101 | 119 | 104 | 92 | 78 | 35 | 44 | 45 | 2 | 136 | 33 |
| 53 | 144 | 17 | 31 | 29 | 30 | 167 | 20 | 175 | 125 | 54 | 86 | 134 | 97 | 176 | 107 | 81 | 140 | 0 | 111 | 138 | 178 |
| 19 | 55 | 150 | 82 | | | | | | | | | | | | | | | | | | |

EP 3 247 043 A1

# FIG. 282

1024QAM CR 5/15:

Original Pattern (B):

BIT GROUP

| 128 | 4 | 162 | 8 | 77 | 29 | 91 | 44 | 176 | 107 | 149 | 1 | 150 | 9 | 119 | 99 | 71 | 124 | 104 | 41 | 62 | 5 |
|---|---|---|---|---|---|---|---|---|---|---|---|---|---|---|---|---|---|---|---|---|---|
| 118 | 50 | 174 | 54 | 111 | 40 | 156 | 92 | 46 | 11 | 17 | 52 | 47 | 97 | 179 | 24 | 153 | 145 | 129 | 2 | 12 | 88 |
| 101 | 139 | 114 | 69 | 96 | 32 | 134 | 55 | 167 | 132 | 123 | 136 | 112 | 102 | 159 | 31 | 87 | 141 | 15 | 61 | 84 | 98 |
| 37 | 63 | 20 | 85 | 53 | 7 | 39 | 117 | 170 | 138 | 116 | 126 | 161 | 120 | 57 | 13 | 76 | 6 | 121 | 155 | 175 | 38 |
| 158 | 35 | 86 | 78 | 10 | 103 | 166 | 95 | 125 | 172 | 67 | 30 | 177 | 73 | 151 | 169 | 163 | 23 | 108 | 43 | 81 | 157 |
| 58 | 105 | 65 | 26 | 122 | 135 | 146 | 72 | 142 | 34 | 133 | 0 | 148 | 89 | 168 | 60 | 109 | 83 | 18 | 27 | 131 | 70 |
| 56 | 48 | 64 | 93 | 68 | 127 | 21 | 75 | 110 | 80 | 14 | 49 | 82 | 143 | 115 | 178 | 154 | 100 | 59 | 74 | 152 | 51 |
| 137 | 140 | 36 | 42 | 19 | 25 | 94 | 45 | 164 | 16 | 113 | 79 | 22 | 28 | 66 | 106 | 130 | 171 | 147 | 90 | 144 | 165 |
| 3 | 173 | 160 | 33 | | | | | | | | | | | | | | | | | | |

Converted Pattern (A):

| 128 | 149 | 62 | 46 | 129 | 134 | 87 | 53 | 57 | 86 | 177 | 58 | 133 | 131 | 110 | 59 | 94 | 130 | 4 | 1 | 5 | 11 |
|---|---|---|---|---|---|---|---|---|---|---|---|---|---|---|---|---|---|---|---|---|---|
| 2 | 55 | 141 | 7 | 13 | 78 | 73 | 105 | 0 | 70 | 80 | 74 | 45 | 171 | 162 | 150 | 118 | 17 | 12 | 167 | 15 | 39 |
| 76 | 10 | 151 | 65 | 148 | 56 | 14 | 152 | 164 | 147 | 8 | 9 | 50 | 52 | 88 | 132 | 61 | 117 | 6 | 103 | 169 | 26 |
| 89 | 48 | 49 | 51 | 16 | 90 | 77 | 119 | 174 | 47 | 101 | 123 | 84 | 170 | 121 | 166 | 163 | 122 | 168 | 64 | 82 | 137 |
| 113 | 144 | 29 | 99 | 54 | 97 | 139 | 136 | 98 | 138 | 155 | 95 | 23 | 135 | 60 | 93 | 143 | 140 | 79 | 165 | 91 | 71 |
| 111 | 179 | 114 | 112 | 37 | 116 | 175 | 125 | 108 | 146 | 109 | 68 | 115 | 36 | 22 | 3 | 44 | 124 | 40 | 24 | 69 | 102 |
| 63 | 126 | 38 | 172 | 43 | 72 | 83 | 127 | 178 | 42 | 28 | 173 | 176 | 104 | 156 | 153 | 96 | 159 | 20 | 161 | 158 | 67 |
| 81 | 142 | 18 | 21 | 154 | 19 | 66 | 160 | 107 | 41 | 92 | 145 | 32 | 31 | 85 | 120 | 35 | 30 | 157 | 34 | 27 | 75 |
| 100 | 25 | 106 | 33 | | | | | | | | | | | | | | | | | | |

## FIG. 283

1024QAM CR 6/15:

Original Pattern (A):

BIT GROUP

| 66 | 21 | 51 | 55 | 54 | 24 | 33 | 12 | 70 | 63 | 47 | 65 | 145 | 8 | 0 | 57 | 23 | 71 | 59 | 14 | 40 | 42 |
|----|----|----|----|----|----|----|----|----|----|----|----|-----|---|---|----|----|----|----|----|----|----|
| 62 | 56 | 2 | 43 | 64 | 58 | 67 | 53 | 68 | 61 | 39 | 52 | 69 | 1 | 22 | 31 | 161 | 38 | 30 | 19 | 17 | 18 |
| 4 | 41 | 25 | 44 | 136 | 29 | 36 | 26 | 126 | 177 | 15 | 37 | 148 | 9 | 13 | 45 | 46 | 152 | 50 | 49 | 27 | 77 |
| 60 | 35 | 48 | 178 | 28 | 34 | 106 | 127 | 76 | 131 | 105 | 138 | 75 | 130 | 101 | 167 | 117 | 173 | 113 | 108 | 92 | 135 |
| 124 | 121 | 97 | 149 | 143 | 81 | 32 | 96 | 3 | 78 | 107 | 86 | 98 | 16 | 162 | 150 | 111 | 158 | 172 | 139 | 74 | 142 |
| 166 | 7 | 5 | 119 | 20 | 144 | 151 | 90 | 11 | 156 | 100 | 175 | 83 | 155 | 159 | 128 | 88 | 87 | 93 | 103 | 94 | 140 |
| 165 | 6 | 137 | 157 | 10 | 85 | 141 | 129 | 146 | 122 | 73 | 112 | 132 | 125 | 174 | 169 | 168 | 79 | 84 | 118 | 179 | 147 |
| 91 | 160 | 163 | 115 | 89 | 80 | 102 | 104 | 134 | 82 | 95 | 133 | 164 | 154 | 120 | 110 | 170 | 114 | 153 | 72 | 109 | 171 |
| 176 | 99 | 116 | 123 | | | | | | | | | | | | | | | | | | |

Converted Pattern (B):

| 66 | 59 | 22 | 15 | 106 | 97 | 74 | 88 | 132 | 134 | 21 | 14 | 31 | 37 | 127 | 149 | 142 | 87 | 125 | 82 | 51 | 40 |
|----|----|----|----|-----|----|----|----|-----|-----|----|----|----|----|-----|-----|-----|----|-----|----|----|----|
| 161 | 148 | 76 | 143 | 166 | 93 | 174 | 95 | 55 | 42 | 38 | 9 | 131 | 81 | 7 | 103 | 169 | 133 | 54 | 62 | 30 | 13 |
| 105 | 32 | 5 | 94 | 168 | 164 | 24 | 56 | 19 | 45 | 138 | 96 | 119 | 140 | 79 | 154 | 33 | 2 | 17 | 46 | 75 | 3 |
| 20 | 165 | 84 | 120 | 12 | 43 | 18 | 152 | 130 | 78 | 144 | 6 | 118 | 110 | 70 | 64 | 4 | 50 | 101 | 107 | 151 | 137 |
| 179 | 170 | 63 | 58 | 41 | 49 | 167 | 86 | 90 | 157 | 147 | 114 | 47 | 67 | 25 | 27 | 117 | 98 | 11 | 10 | 91 | 153 |
| 65 | 53 | 44 | 77 | 173 | 16 | 156 | 85 | 160 | 72 | 145 | 68 | 136 | 60 | 113 | 162 | 100 | 141 | 163 | 109 | 8 | 61 |
| 29 | 35 | 108 | 150 | 175 | 129 | 115 | 171 | 0 | 39 | 36 | 48 | 92 | 111 | 83 | 146 | 89 | 176 | 57 | 52 | 26 | 178 |
| 135 | 158 | 155 | 122 | 80 | 99 | 23 | 69 | 126 | 28 | 124 | 172 | 159 | 73 | 102 | 116 | 71 | 1 | 177 | 34 | 121 | 139 |
| 128 | 112 | 104 | 123 | | | | | | | | | | | | | | | | | | |

EP 3 247 043 A1

# FIG. 284

1024QAM CR 7/15:

Original Pattern (B):

BIT GROUP

| 117 | 61 | 46 | 179 | 24 | 161 | 142 | 133 | 11 | 6 | 121 | 44 | 103 | 76 | 22 | 63 | 136 | 151 | 33 | 8 | 123 | 60 |
|---|---|---|---|---|---|---|---|---|---|---|---|---|---|---|---|---|---|---|---|---|---|
| 105 | 175 | 18 | 160 | 138 | 147 | 10 | 0 | 125 | 57 | 49 | 75 | 21 | 154 | 140 | 150 | 9 | 169 | 124 | 55 | 48 | 173 |
| 23 | 157 | 97 | 129 | 30 | 7 | 122 | 54 | 99 | 74 | 19 | 153 | 94 | 128 | 15 | 170 | 87 | 59 | 51 | 80 | 111 | 64 |
| 137 | 146 | 13 | 2 | 83 | 62 | 45 | 176 | 108 | 71 | 91 | 131 | 34 | 168 | 82 | 56 | 102 | 72 | 26 | 155 | 92 | 132 |
| 31 | 166 | 119 | 36 | 101 | 178 | 113 | 67 | 98 | 152 | 14 | 5 | 118 | 41 | 104 | 177 | 114 | 70 | 96 | 134 | 32 | 162 |
| 84 | 40 | 100 | 174 | 110 | 158 | 93 | 149 | 27 | 4 | 86 | 38 | 53 | 77 | 115 | 159 | 143 | 130 | 35 | 163 | 89 | 58 |
| 106 | 73 | 20 | 66 | 90 | 127 | 16 | 3 | 85 | 37 | 107 | 172 | 116 | 156 | 95 | 144 | 17 | 165 | 81 | 43 | 50 | 78 |
| 109 | 68 | 135 | 126 | 29 | 167 | 120 | 39 | 47 | 171 | 112 | 69 | 141 | 145 | 28 | 1 | 88 | 42 | 52 | 79 | 25 | 65 |
| 139 | 148 | 12 | 164 | | | | | | | | | | | | | | | | | | |

Converted Pattern (A):

| 117 | 121 | 123 | 125 | 124 | 122 | 87 | 83 | 82 | 119 | 118 | 84 | 86 | 89 | 85 | 81 | 120 | 88 | 61 | 44 | 60 | 57 |
|---|---|---|---|---|---|---|---|---|---|---|---|---|---|---|---|---|---|---|---|---|---|
| 55 | 54 | 59 | 62 | 56 | 36 | 41 | 40 | 38 | 58 | 37 | 43 | 39 | 42 | 46 | 103 | 105 | 49 | 48 | 99 | 51 | 45 |
| 102 | 101 | 104 | 100 | 53 | 106 | 107 | 50 | 47 | 52 | 179 | 76 | 175 | 75 | 173 | 74 | 80 | 176 | 72 | 178 | 177 | 174 |
| 77 | 73 | 172 | 78 | 171 | 79 | 24 | 22 | 18 | 21 | 23 | 19 | 111 | 108 | 26 | 113 | 114 | 110 | 115 | 20 | 116 | 109 |
| 112 | 25 | 161 | 63 | 160 | 154 | 157 | 153 | 64 | 71 | 155 | 67 | 70 | 158 | 159 | 66 | 156 | 68 | 69 | 65 | 142 | 136 |
| 138 | 140 | 97 | 94 | 137 | 91 | 92 | 98 | 96 | 93 | 143 | 90 | 95 | 135 | 141 | 139 | 133 | 151 | 147 | 150 | 129 | 128 |
| 146 | 131 | 132 | 152 | 134 | 149 | 130 | 127 | 144 | 126 | 145 | 148 | 11 | 33 | 10 | 9 | 30 | 15 | 13 | 34 | 31 | 14 |
| 32 | 27 | 35 | 16 | 17 | 29 | 28 | 12 | 6 | 8 | 0 | 169 | 7 | 170 | 2 | 168 | 166 | 5 | 162 | 4 | 163 | 3 |
| 165 | 167 | 1 | 164 | | | | | | | | | | | | | | | | | | |

# FIG. 285

EP 3 247 043 A1

1024QAM CR 8/15:

Original Pattern (A):

BIT GROUP

| 77 | 48 | 82 | 51 | 57 | 69 | 65 | 6 | 71 | 90 | 84 | 81 | 50 | 88 | 61 | 55 | 53 | 73 | 39 | 13 | 79 | 75 |
|---|---|---|---|---|---|---|---|---|---|---|---|---|---|---|---|---|---|---|---|---|---|
| 41 | 18 | 38 | 89 | 49 | 93 | 36 | 64 | 47 | 40 | 42 | 76 | 70 | 56 | 3 | 72 | 2 | 54 | 52 | 145 | 19 | 78 |
| 80 | 63 | 87 | 67 | 86 | 10 | 1 | 58 | 17 | 14 | 175 | 91 | 68 | 85 | 94 | 15 | 43 | 74 | 60 | 66 | 37 | 92 |
| 4 | 9 | 16 | 83 | 46 | 44 | 102 | 30 | 112 | 122 | 110 | 29 | 20 | 105 | 138 | 101 | 174 | 33 | 137 | 136 | 131 | 166 |
| 59 | 34 | 62 | 125 | 28 | 26 | 45 | 24 | 23 | 21 | 157 | 98 | 35 | 95 | 22 | 32 | 103 | 27 | 113 | 31 | 119 | 173 |
| 168 | 118 | 120 | 114 | 149 | 159 | 155 | 179 | 160 | 161 | 130 | 123 | 172 | 139 | 124 | 153 | 0 | 109 | 167 | 128 | 107 | 117 |
| 147 | 177 | 96 | 164 | 152 | 11 | 148 | 158 | 129 | 163 | 176 | 151 | 171 | 8 | 106 | 144 | 150 | 169 | 108 | 162 | 143 | 111 |
| 141 | 133 | 178 | 134 | 146 | 99 | 132 | 142 | 104 | 115 | 135 | 121 | 100 | 12 | 170 | 156 | 126 | 5 | 127 | 154 | 97 | 140 |
| 116 | 165 | 7 | 25 | | | | | | | | | | | | | | | | | | |

⇩

Converted Pattern (B):

| 77 | 39 | 3 | 175 | 102 | 62 | 119 | 0 | 171 | 104 | 48 | 13 | 72 | 91 | 30 | 125 | 173 | 109 | 8 | 115 | 82 | 79 |
|---|---|---|---|---|---|---|---|---|---|---|---|---|---|---|---|---|---|---|---|---|---|
| 2 | 68 | 112 | 28 | 168 | 167 | 106 | 135 | 51 | 75 | 54 | 85 | 122 | 26 | 118 | 128 | 144 | 121 | 57 | 41 | 52 | 94 |
| 110 | 45 | 120 | 107 | 150 | 100 | 69 | 18 | 145 | 15 | 29 | 24 | 114 | 117 | 169 | 12 | 65 | 38 | 19 | 43 | 20 | 23 |
| 149 | 147 | 108 | 170 | 6 | 89 | 78 | 74 | 105 | 21 | 159 | 177 | 162 | 156 | 71 | 49 | 80 | 60 | 138 | 157 | 155 | 96 |
| 143 | 126 | 90 | 93 | 63 | 66 | 101 | 98 | 179 | 164 | 111 | 5 | 84 | 36 | 87 | 37 | 174 | 35 | 160 | 152 | 141 | 127 |
| 81 | 64 | 67 | 92 | 33 | 95 | 161 | 11 | 133 | 154 | 50 | 47 | 86 | 4 | 137 | 22 | 130 | 148 | 178 | 97 | 88 | 40 |
| 10 | 9 | 136 | 32 | 123 | 158 | 134 | 140 | 61 | 42 | 1 | 16 | 131 | 103 | 172 | 129 | 146 | 116 | 55 | 76 | 58 | 83 |
| 166 | 27 | 139 | 163 | 99 | 165 | 53 | 70 | 17 | 46 | 59 | 113 | 124 | 176 | 132 | 7 | 73 | 56 | 14 | 44 | 34 | 31 |
| 153 | 151 | 142 | 25 | | | | | | | | | | | | | | | | | | |

# FIG. 286

1024QAM CR 9/15:

Original Pattern (B):

| | | | | | | | | | | | | | | | | | | | | | |
|---|---|---|---|---|---|---|---|---|---|---|---|---|---|---|---|---|---|---|---|---|---|
| 42 | 36 | 135 | 126 | 3 | 17 | 82 | 87 | 172 | 32 | 65 | 70 | 143 | 131 | 10 | 1 | 85 | 147 | 31 | 176 | 66 | 47 |
| 97 | 128 | 8 | 9 | 146 | 73 | 162 | 164 | 57 | 64 | 139 | 91 | 5 | 110 | 150 | 83 | 18 | 27 | 48 | 45 | 133 | 132 |
| 111 | 124 | 89 | 78 | 177 | 19 | 46 | 50 | 102 | 103 | 122 | 4 | 74 | 161 | 175 | 34 | 60 | 58 | 136 | 100 | 115 | 118 |
| 81 | 75 | 28 | 21 | 40 | 61 | 140 | 138 | 113 | 112 | 157 | 151 | 23 | 30 | 69 | 41 | 94 | 96 | 7 | 109 | 152 | 149 |
| 33 | 179 | 71 | 43 | 92 | 105 | 12 | 13 | 154 | 159 | 178 | 24 | 44 | 49 | 107 | 98 | 16 | 2 | 76 | 155 | 35 | 168 |
| 62 | 56 | 129 | 141 | 116 | 123 | 160 | 77 | 25 | 170 | 54 | 39 | 90 | 95 | 121 | 11 | 72 | 153 | 169 | 167 | 51 | 67 |
| 104 | 134 | 0 | 117 | 79 | 80 | 26 | 29 | 37 | 55 | 99 | 142 | 108 | 114 | 86 | 88 | 166 | 163 | 59 | 63 | 101 | 93 |
| 119 | 15 | 144 | 145 | 165 | 22 | 52 | 53 | 130 | 137 | 125 | 6 | 158 | 84 | 20 | 174 | 38 | 68 | 127 | 106 | 14 | 120 |
| 148 | 156 | 171 | 173 | | | | | | | | | | | | | | | | | | |

Converted Pattern (A):

| | | | | | | | | | | | | | | | | | | | | | |
|---|---|---|---|---|---|---|---|---|---|---|---|---|---|---|---|---|---|---|---|---|---|
| 42 | 65 | 66 | 57 | 48 | 46 | 60 | 40 | 69 | 71 | 44 | 62 | 54 | 51 | 37 | 59 | 52 | 38 | 36 | 70 | 47 | 64 |
| 45 | 50 | 58 | 61 | 41 | 43 | 49 | 56 | 39 | 67 | 55 | 63 | 53 | 68 | 135 | 143 | 97 | 139 | 133 | 102 | 136 | 140 |
| 94 | 92 | 107 | 129 | 90 | 104 | 99 | 101 | 130 | 127 | 126 | 131 | 128 | 91 | 132 | 103 | 100 | 138 | 96 | 105 | 98 | 141 |
| 95 | 134 | 142 | 93 | 137 | 106 | 3 | 10 | 8 | 5 | 111 | 122 | 115 | 113 | 7 | 12 | 16 | 116 | 121 | 0 | 108 | 119 |
| 125 | 14 | 17 | 1 | 9 | 110 | 124 | 4 | 118 | 112 | 109 | 13 | 2 | 123 | 11 | 117 | 114 | 15 | 6 | 120 | 82 | 85 |
| 146 | 150 | 89 | 74 | 81 | 157 | 152 | 154 | 76 | 160 | 72 | 79 | 86 | 144 | 158 | 148 | 87 | 147 | 73 | 83 | 78 | 161 |
| 75 | 151 | 149 | 159 | 155 | 77 | 153 | 80 | 88 | 145 | 84 | 156 | 172 | 31 | 162 | 18 | 177 | 175 | 28 | 23 | 33 | 178 |
| 35 | 25 | 169 | 26 | 166 | 165 | 20 | 171 | 32 | 176 | 164 | 27 | 19 | 34 | 21 | 30 | 179 | 24 | 168 | 170 | 167 | 29 |
| 163 | 22 | 174 | 173 | | | | | | | | | | | | | | | | | | |

EP 3 247 043 A1

# FIG. 287

1024QAM CR 10/15:

Original Pattern (B):

EP 3 247 043 A1

| | | | | | | | | | | BIT GROUP |
|---|---|---|---|---|---|---|---|---|---|---|

| 100 | 22 | 60 | 121 | 40 | 44 | 164 | 170 | 176 | 101 | 88 | 26 | 35 | 4 | 21 | 173 | 140 | 145 | 175 | 174 | 81 | 28 |
|---|---|---|---|---|---|---|---|---|---|---|---|---|---|---|---|---|---|---|---|---|---|
| 72 | 112 | 132 | 106 | 42 | 56 | 151 | 147 | 82 | 49 | 91 | 64 | 179 | 89 | 160 | 52 | 139 | 17 | 97 | 63 | 116 | 131 |
| 154 | 71 | 109 | 96 | 135 | 146 | 55 | 38 | 166 | 117 | 65 | 127 | 120 | 129 | 15 | 136 | 74 | 23 | 98 | 43 | 123 | 130 |
| 69 | 99 | 143 | 161 | 46 | 51 | 94 | 61 | 83 | 67 | 156 | 33 | 144 | 148 | 163 | 47 | 92 | 2 | 122 | 24 | 86 | 75 |
| 108 | 152 | 14 | 77 | 7 | 10 | 29 | 19 | 104 | 128 | 142 | 1 | 79 | 107 | 162 | 0 | 118 | 66 | 54 | 153 | 141 | 9 |
| 85 | 37 | 32 | 114 | 53 | 134 | 41 | 158 | 178 | 138 | 76 | 50 | 78 | 84 | 172 | 48 | 133 | 168 | 125 | 13 | 169 | 25 |
| 16 | 8 | 124 | 159 | 167 | 58 | 5 | 11 | 68 | 95 | 27 | 110 | 93 | 62 | 102 | 137 | 126 | 150 | 87 | 105 | 113 | 30 |
| 119 | 6 | 103 | 57 | 31 | 149 | 80 | 70 | 45 | 165 | 111 | 73 | 36 | 157 | 171 | 3 | 20 | 18 | 90 | 12 | 59 | 39 |
| 115 | 34 | 177 | 155 | | | | | | | | | | | | | | | | | | |

Converted Pattern (A):

| 100 | 88 | 81 | 82 | 97 | 55 | 74 | 46 | 163 | 14 | 79 | 85 | 76 | 169 | 68 | 87 | 80 | 20 | 22 | 26 | 28 | 49 |
|---|---|---|---|---|---|---|---|---|---|---|---|---|---|---|---|---|---|---|---|---|---|
| 63 | 38 | 23 | 51 | 47 | 77 | 107 | 37 | 50 | 25 | 95 | 105 | 70 | 18 | 60 | 35 | 72 | 91 | 116 | 166 | 98 | 94 |
| 92 | 7 | 162 | 32 | 78 | 16 | 27 | 113 | 45 | 90 | 121 | 4 | 112 | 64 | 131 | 117 | 43 | 61 | 2 | 10 | 0 | 114 |
| 84 | 8 | 110 | 30 | 165 | 12 | 40 | 21 | 132 | 179 | 154 | 65 | 123 | 83 | 122 | 29 | 118 | 53 | 172 | 124 | 93 | 119 |
| 111 | 59 | 44 | 173 | 106 | 89 | 71 | 127 | 130 | 67 | 24 | 19 | 66 | 134 | 48 | 159 | 62 | 6 | 73 | 39 | 164 | 140 |
| 42 | 160 | 109 | 120 | 69 | 156 | 86 | 104 | 54 | 41 | 133 | 167 | 102 | 103 | 36 | 115 | 170 | 145 | 56 | 52 | 96 | 129 |
| 99 | 33 | 75 | 128 | 153 | 158 | 168 | 58 | 137 | 57 | 157 | 34 | 176 | 175 | 151 | 139 | 135 | 15 | 143 | 144 | 108 | 142 |
| 141 | 178 | 125 | 5 | 126 | 31 | 171 | 177 | 101 | 174 | 147 | 17 | 146 | 136 | 161 | 148 | 152 | 1 | 9 | 138 | 13 | 11 |
| 150 | 149 | 3 | 155 | | | | | | | | | | | | | | | | | | |

# FIG. 288

1024QAM CR 11/15:

Original Pattern (B):

BIT GROUP

| 33 | 73 | 90 | 107 | 99 | 94 | 53 | 151 | 124 | 8 | 12 | 117 | 21 | 58 | 158 | 77 | 72 | 59 | 123 | 2 | 125 | 157 |
| 50 | 62 | 109 | 75 | 42 | 146 | 118 | 153 | 85 | 10 | 131 | 70 | 32 | 41 | 24 | 143 | 113 | 1 | 93 | 162 | 20 | 35 |
| 74 | 45 | 149 | 161 | 173 | 4 | 28 | 23 | 127 | 148 | 34 | 61 | 96 | 144 | 171 | 140 | 119 | 16 | 126 | 39 | 40 | 57 |
| 165 | 106 | 172 | 139 | 81 | 47 | 164 | 92 | 63 | 105 | 108 | 170 | 3 | 135 | 101 | 121 | 68 | 6 | 111 | 65 | 147 | 150 |
| 122 | 7 | 84 | 46 | 22 | 103 | 86 | 169 | 134 | 44 | 175 | 167 | 89 | 128 | 27 | 31 | 56 | 43 | 102 | 156 | 160 | 141 |
| 67 | 9 | 110 | 159 | 133 | 78 | 154 | 176 | 174 | 5 | 82 | 11 | 25 | 80 | 130 | 163 | 88 | 36 | 166 | 137 | 104 | 48 |
| 129 | 87 | 95 | 55 | 49 | 145 | 178 | 0 | 98 | 64 | 54 | 100 | 37 | 79 | 69 | 38 | 177 | 136 | 114 | 17 | 52 | 19 |
| 30 | 97 | 51 | 168 | 132 | 138 | 83 | 76 | 13 | 18 | 115 | 71 | 91 | 179 | 112 | 155 | 15 | 14 | 26 | 60 | 29 | 116 |
| 66 | 120 | 142 | 152 | | | | | | | | | | | | | | | | | | |

⇩

Converted Pattern (A):

| 33 | 12 | 125 | 85 | 93 | 28 | 119 | 81 | 101 | 84 | 89 | 67 | 82 | 104 | 98 | 114 | 83 | 15 | 73 | 117 | 157 | 10 |
| 162 | 23 | 16 | 47 | 121 | 46 | 128 | 9 | 11 | 48 | 64 | 17 | 76 | 14 | 90 | 21 | 50 | 131 | 20 | 127 | 126 | 164 |
| 68 | 22 | 27 | 110 | 25 | 129 | 54 | 52 | 13 | 26 | 107 | 58 | 62 | 70 | 35 | 148 | 39 | 92 | 6 | 103 | 31 | 159 |
| 80 | 87 | 100 | 19 | 18 | 60 | 99 | 158 | 109 | 32 | 74 | 34 | 40 | 63 | 111 | 86 | 56 | 133 | 130 | 95 | 37 | 30 |
| 115 | 29 | 94 | 77 | 75 | 41 | 45 | 61 | 57 | 105 | 65 | 169 | 43 | 78 | 163 | 55 | 79 | 97 | 71 | 116 | 53 | 72 |
| 42 | 24 | 149 | 96 | 165 | 108 | 147 | 134 | 102 | 154 | 88 | 49 | 69 | 51 | 91 | 66 | 151 | 59 | 146 | 143 | 161 | 144 |
| 106 | 170 | 150 | 44 | 156 | 176 | 36 | 145 | 38 | 168 | 179 | 120 | 124 | 123 | 118 | 113 | 173 | 171 | 172 | 3 | 122 | 175 |
| 160 | 174 | 166 | 178 | 177 | 132 | 112 | 142 | 8 | 2 | 153 | 1 | 4 | 140 | 139 | 135 | 7 | 167 | 141 | 5 | 137 | 0 |
| 136 | 138 | 155 | 152 | | | | | | | | | | | | | | | | | | |

EP 3 247 043 A1

FIG. 289

1024QAM CR 12/15:

Original Pattern (A):

BIT GROUP

| 91 | 19 | 11 | 106 | 14 | 40 | 20 | 67 | 32 | 22 | 31 | 23 | 78 | 68 | 79 | 141 | 117 | 95 | 88 | 136 | 52 | 121 |
|----|----|----|-----|----|----|----|----|----|----|----|----|----|----|----|-----|-----|----|----|-----|----|-----|
| 1 | 133 | 4 | 2 | 21 | 122 | 38 | 12 | 69 | 111 | 81 | 82 | 58 | 46 | 112 | 60 | 33 | 73 | 53 | 92 | 75 | 48 |
| 47 | 110 | 80 | 76 | 138 | 87 | 85 | 65 | 130 | 57 | 102 | 83 | 64 | 86 | 100 | 39 | 49 | 125 | 108 | 119 | 6 | 118 |
| 35 | 61 | 71 | 30 | 45 | 94 | 26 | 116 | 98 | 37 | 55 | 44 | 70 | 25 | 7 | 34 | 114 | 135 | 128 | 137 | 84 | 51 |
| 28 | 97 | 27 | 89 | 29 | 62 | 50 | 139 | 56 | 109 | 77 | 59 | 127 | 142 | 96 | 105 | 99 | 90 | 13 | 124 | 120 | 115 |
| 126 | 143 | 149 | 74 | 41 | 178 | 129 | 18 | 131 | 42 | 165 | 101 | 134 | 36 | 140 | 132 | 103 | 72 | 164 | 93 | 54 | 166 |
| 43 | 123 | 113 | 0 | 154 | 10 | 63 | 107 | 162 | 157 | 66 | 104 | 17 | 147 | 167 | 174 | 179 | 3 | 173 | 160 | 155 | 161 |
| 152 | 156 | 177 | 24 | 170 | 9 | 159 | 16 | 15 | 148 | 5 | 146 | 163 | 172 | 175 | 151 | 169 | 176 | 150 | 153 | 171 | 158 |
| 168 | 144 | 8 | 145 | | | | | | | | | | | | | | | | | | |

Converted Pattern (B):

| 91 | 88 | 112 | 102 | 26 | 27 | 120 | 103 | 17 | 15 | 19 | 136 | 60 | 83 | 116 | 89 | 115 | 72 | 147 | 148 | 11 | 52 |
|----|----|-----|-----|----|----|-----|-----|----|----|----|-----|----|----|-----|----|-----|----|-----|-----|----|-----|
| 33 | 64 | 98 | 29 | 126 | 164 | 167 | 5 | 106 | 121 | 73 | 86 | 37 | 62 | 143 | 93 | 174 | 146 | 14 | 1 | 53 | 100 |
| 55 | 50 | 149 | 54 | 179 | 163 | 40 | 133 | 92 | 39 | 44 | 139 | 74 | 166 | 3 | 172 | 20 | 4 | 75 | 49 | 70 | 56 |
| 41 | 43 | 173 | 175 | 67 | 2 | 48 | 125 | 25 | 109 | 178 | 123 | 160 | 151 | 32 | 21 | 47 | 108 | 7 | 77 | 129 | 113 |
| 155 | 169 | 22 | 122 | 110 | 119 | 34 | 59 | 18 | 0 | 161 | 176 | 31 | 38 | 80 | 6 | 114 | 127 | 131 | 154 | 152 | 150 |
| 23 | 12 | 76 | 118 | 135 | 142 | 42 | 10 | 156 | 153 | 78 | 69 | 138 | 35 | 128 | 96 | 165 | 63 | 177 | 171 | 68 | 111 |
| 87 | 61 | 137 | 105 | 101 | 107 | 24 | 158 | 79 | 81 | 85 | 71 | 84 | 99 | 134 | 162 | 170 | 168 | 141 | 82 | 65 | 30 |
| 51 | 90 | 36 | 157 | 9 | 144 | 117 | 58 | 130 | 45 | 28 | 13 | 140 | 66 | 159 | 8 | 95 | 46 | 57 | 94 | 97 | 124 |
| 132 | 104 | 16 | 145 | | | | | | | | | | | | | | | | | | |

EP 3 247 043 A1

# FIG. 290

1024QAM CR 13/15:

Original Pattern (A):

BIT GROUP

| 49 | 2 | 57 | 47 | 31 | 35 | 24 | 39 | 59 | 0 | 45 | 41 | 55 | 53 | 51 | 37 | 33 | 43 | 56 | 38 | 48 | 32 |
|---|---|---|---|---|---|---|---|---|---|---|---|---|---|---|---|---|---|---|---|---|---|
| 50 | 23 | 34 | 54 | 1 | 36 | 44 | 52 | 40 | 58 | 122 | 46 | 42 | 30 | 3 | 75 | 73 | 65 | 145 | 71 | 79 | 67 |
| 69 | 83 | 85 | 147 | 63 | 81 | 77 | 61 | 5 | 26 | 62 | 64 | 74 | 70 | 82 | 149 | 76 | 4 | 78 | 84 | 80 | 86 |
| 66 | 68 | 72 | 6 | 60 | 154 | 103 | 95 | 101 | 143 | 9 | 89 | 141 | 128 | 97 | 137 | 133 | 7 | 13 | 99 | 91 | 93 |
| 87 | 11 | 136 | 90 | 88 | 94 | 10 | 8 | 14 | 96 | 104 | 92 | 132 | 142 | 100 | 98 | 12 | 102 | 152 | 139 | 150 | 106 |
| 146 | 130 | 27 | 108 | 153 | 112 | 114 | 29 | 110 | 134 | 116 | 15 | 127 | 125 | 123 | 120 | 148 | 151 | 113 | 126 | 124 | 135 |
| 129 | 109 | 25 | 28 | 158 | 117 | 105 | 115 | 111 | 131 | 107 | 121 | 18 | 170 | 164 | 20 | 140 | 160 | 166 | 162 | 119 | 155 |
| 168 | 178 | 22 | 174 | 172 | 176 | 16 | 157 | 159 | 171 | 161 | 118 | 17 | 163 | 21 | 165 | 19 | 179 | 177 | 167 | 138 | 173 |
| 156 | 144 | 169 | 175 | | | | | | | | | | | | | | | | | | |

Converted Pattern (B):

| 49 | 56 | 3 | 62 | 103 | 136 | 150 | 148 | 18 | 159 | 2 | 38 | 75 | 64 | 95 | 90 | 106 | 151 | 170 | 171 | 57 | 48 |
|---|---|---|---|---|---|---|---|---|---|---|---|---|---|---|---|---|---|---|---|---|---|
| 73 | 74 | 101 | 88 | 146 | 113 | 164 | 161 | 47 | 32 | 65 | 70 | 143 | 94 | 130 | 126 | 20 | 118 | 31 | 50 | 145 | 82 |
| 9 | 10 | 27 | 124 | 140 | 17 | 35 | 23 | 71 | 149 | 89 | 8 | 108 | 135 | 160 | 163 | 24 | 34 | 79 | 76 | 141 | 14 |
| 153 | 129 | 166 | 21 | 39 | 54 | 67 | 4 | 128 | 96 | 112 | 109 | 162 | 165 | 59 | 1 | 69 | 78 | 97 | 104 | 114 | 25 |
| 119 | 19 | 0 | 36 | 83 | 84 | 137 | 92 | 29 | 28 | 155 | 179 | 45 | 44 | 85 | 80 | 133 | 132 | 110 | 158 | 168 | 177 |
| 41 | 52 | 147 | 86 | 7 | 142 | 134 | 117 | 178 | 167 | 55 | 40 | 63 | 66 | 13 | 100 | 116 | 105 | 22 | 138 | 53 | 58 |
| 81 | 68 | 99 | 98 | 15 | 115 | 174 | 173 | 51 | 122 | 77 | 72 | 91 | 12 | 127 | 111 | 172 | 156 | 37 | 46 | 61 | 6 |
| 93 | 102 | 125 | 131 | 176 | 144 | 33 | 42 | 5 | 60 | 87 | 152 | 123 | 107 | 16 | 169 | 43 | 30 | 26 | 154 | 11 | 139 |
| 120 | 121 | 157 | 175 | | | | | | | | | | | | | | | | | | |

EP 3 247 043 A1

## FIG. 291

4096QAM CR 2/15:

Original Pattern (A):

BIT GROUP

| 14 | 129 | 71 | 96 | 171 | 36 | 144 | 64 | 162 | 4 | 86 | 128 | 113 | 7 | 105 | 131 | 2 | 133 | 106 | 79 | 11 | 152 |
| 26 | 118 | 158 | 126 | 17 | 55 | 45 | 111 | 138 | 84 | 6 | 52 | 167 | 38 | 20 | 101 | 31 | 120 | 5 | 112 | 74 | 69 |
| 121 | 9 | 154 | 15 | 146 | 116 | 63 | 1 | 114 | 83 | 124 | 109 | 39 | 75 | 123 | 57 | 49 | 30 | 21 | 40 | 43 | 77 |
| 157 | 44 | 13 | 99 | 34 | 147 | 166 | 56 | 155 | 176 | 95 | 102 | 119 | 161 | 37 | 159 | 97 | 68 | 122 | 163 | 89 | 61 |
| 107 | 22 | 10 | 127 | 87 | 103 | 179 | 172 | 66 | 59 | 8 | 145 | 88 | 132 | 110 | 54 | 47 | 153 | 25 | 32 | 73 | 42 |
| 148 | 150 | 28 | 91 | 18 | 24 | 19 | 53 | 136 | 48 | 76 | 35 | 151 | 173 | 149 | 142 | 160 | 94 | 117 | 169 | 165 | 141 |
| 80 | 67 | 170 | 164 | 82 | 65 | 60 | 135 | 168 | 23 | 100 | 134 | 90 | 98 | 125 | 85 | 137 | 81 | 41 | 156 | 50 | 3 |
| 29 | 16 | 72 | 177 | 0 | 78 | 62 | 139 | 93 | 46 | 12 | 175 | 130 | 51 | 178 | 92 | 115 | 174 | 27 | 70 | 58 | 33 |
| 104 | 140 | 108 | 143 | | | | | | | | | | | | | | | | | | |

Converted Pattern (B):

| 14 | 131 | 138 | 9 | 49 | 176 | 10 | 153 | 76 | 164 | 41 | 175 | 129 | 2 | 84 | 154 | 30 | 95 | 127 | 25 | 35 | 82 |
| 156 | 130 | 71 | 133 | 6 | 15 | 21 | 102 | 87 | 32 | 151 | 65 | 50 | 51 | 96 | 106 | 52 | 146 | 40 | 119 | 103 | 73 |
| 173 | 60 | 3 | 178 | 171 | 79 | 167 | 116 | 43 | 161 | 179 | 42 | 149 | 135 | 29 | 92 | 36 | 11 | 38 | 63 | 77 | 37 |
| 172 | 148 | 142 | 168 | 16 | 115 | 144 | 152 | 20 | 1 | 157 | 159 | 66 | 150 | 160 | 23 | 72 | 174 | 64 | 26 | 101 | 114 |
| 44 | 97 | 59 | 28 | 94 | 100 | 177 | 27 | 162 | 118 | 31 | 83 | 13 | 68 | 8 | 91 | 117 | 134 | 0 | 70 | 4 | 158 |
| 120 | 124 | 99 | 122 | 145 | 18 | 169 | 90 | 78 | 58 | 86 | 126 | 5 | 109 | 34 | 163 | 88 | 24 | 165 | 98 | 62 | 33 |
| 128 | 17 | 112 | 39 | 147 | 89 | 132 | 19 | 141 | 125 | 139 | 104 | 113 | 55 | 74 | 75 | 166 | 61 | 110 | 53 | 80 | 85 |
| 93 | 140 | 7 | 45 | 69 | 123 | 56 | 107 | 54 | 136 | 67 | 137 | 46 | 108 | 105 | 111 | 121 | 57 | 155 | 22 | 47 | 48 |
| 170 | 81 | 12 | 143 | | | | | | | | | | | | | | | | | | |

EP 3 247 043 A1

# FIG. 292

EP 3 247 043 A1

4096QAM CR 3/15:

Original Pattern (A):

BIT GROUP

| 136 | 20 | 44 | 36 | 17 | 120 | 89 | 142 | 66 | 35 | 42 | 116 | 14 | 119 | 117 | 29 | 47 | 125 | 11 | 158 | 74 | 25 |
|---|---|---|---|---|---|---|---|---|---|---|---|---|---|---|---|---|---|---|---|---|---|
| 37 | 175 | 41 | 145 | 100 | 131 | 173 | 179 | 16 | 77 | 112 | 40 | 58 | 23 | 82 | 168 | 106 | 83 | 34 | 49 | 122 | 2 |
| 157 | 107 | 79 | 137 | 53 | 96 | 33 | 70 | 19 | 38 | 121 | 90 | 118 | 126 | 165 | 109 | 154 | 140 | 10 | 178 | 143 | 92 |
| 63 | 176 | 146 | 134 | 177 | 139 | 3 | 113 | 172 | 9 | 50 | 138 | 61 | 93 | 94 | 88 | 132 | 105 | 151 | 170 | 86 | 12 |
| 1 | 7 | 56 | 59 | 101 | 155 | 95 | 54 | 85 | 13 | 39 | 15 | 76 | 130 | 97 | 110 | 174 | 72 | 150 | 55 | 73 | 99 |
| 111 | 162 | 26 | 21 | 156 | 28 | 160 | 149 | 133 | 104 | 81 | 69 | 84 | 4 | 6 | 147 | 48 | 115 | 169 | 127 | 161 | 71 |
| 68 | 80 | 91 | 98 | 8 | 57 | 171 | 135 | 52 | 5 | 141 | 65 | 75 | 163 | 43 | 144 | 167 | 159 | 129 | 46 | 31 | 30 |
| 166 | 0 | 148 | 128 | 102 | 103 | 60 | 32 | 18 | 51 | 87 | 114 | 64 | 22 | 164 | 24 | 123 | 27 | 62 | 124 | 152 | 78 |
| 108 | 67 | 153 | 45 | | | | | | | | | | | | | | | | | | |

⇩

Converted Pattern (B):

| 136 | 29 | 16 | 107 | 154 | 9 | 56 | 72 | 81 | 98 | 129 | 114 | 20 | 47 | 77 | 79 | 140 | 50 | 59 | 150 | 69 | 8 |
|---|---|---|---|---|---|---|---|---|---|---|---|---|---|---|---|---|---|---|---|---|---|
| 46 | 64 | 44 | 125 | 112 | 137 | 10 | 138 | 101 | 55 | 84 | 57 | 31 | 22 | 36 | 11 | 40 | 53 | 178 | 61 | 155 | 73 |
| 4 | 171 | 30 | 164 | 17 | 158 | 58 | 96 | 143 | 93 | 95 | 99 | 6 | 135 | 166 | 24 | 120 | 74 | 23 | 33 | 92 | 94 |
| 54 | 111 | 147 | 52 | 0 | 123 | 89 | 25 | 82 | 70 | 63 | 88 | 85 | 162 | 48 | 5 | 148 | 27 | 142 | 37 | 168 | 19 |
| 176 | 132 | 13 | 26 | 115 | 141 | 128 | 62 | 66 | 175 | 106 | 38 | 146 | 105 | 39 | 21 | 169 | 65 | 102 | 124 | 35 | 41 |
| 83 | 121 | 134 | 151 | 15 | 156 | 127 | 75 | 103 | 152 | 42 | 145 | 34 | 90 | 177 | 170 | 76 | 28 | 161 | 163 | 60 | 78 |
| 116 | 100 | 49 | 118 | 139 | 86 | 130 | 160 | 71 | 43 | 32 | 108 | 14 | 131 | 122 | 126 | 3 | 12 | 97 | 149 | 68 | 144 |
| 18 | 67 | 119 | 173 | 2 | 165 | 113 | 1 | 110 | 133 | 80 | 167 | 51 | 153 | 117 | 179 | 157 | 109 | 172 | 7 | 174 | 104 |
| 91 | 159 | 87 | 45 | | | | | | | | | | | | | | | | | | |

# FIG. 293

4096QAM CR 4/15:

Original Pattern (A):

| 91 | 52 | 36 | 30 | 35 | 6 | 121 | 29 | 150 | 47 | 163 | 2 | 89 | 39 | 65 | 157 | 64 | 122 | 101 | 40 | 84 | 69 |
| 90 | 129 | 10 | 9 | 15 | 162 | 21 | 171 | 43 | 44 | 132 | 158 | 104 | 4 | 72 | 169 | 177 | 103 | 76 | 28 | 78 | 53 |
| 1 | 151 | 161 | 88 | 148 | 42 | 160 | 109 | 100 | 126 | 138 | 108 | 38 | 25 | 3 | 112 | 17 | 124 | 155 | 172 | 134 | 86 |
| 119 | 94 | 145 | 178 | 68 | 26 | 130 | 140 | 115 | 152 | 139 | 37 | 22 | 102 | 14 | 118 | 11 | 98 | 154 | 61 | 146 | 164 |
| 107 | 131 | 159 | 63 | 93 | 7 | 79 | 5 | 137 | 165 | 59 | 77 | 55 | 80 | 117 | 13 | 173 | 144 | 85 | 153 | 66 | 106 |
| 49 | 34 | 48 | 41 | 143 | 142 | 27 | 136 | 18 | 111 | 175 | 123 | 147 | 114 | 19 | 125 | 166 | 149 | 113 | 46 | 31 | 141 |
| 120 | 57 | 74 | 8 | 20 | 96 | 170 | 128 | 97 | 16 | 60 | 110 | 156 | 45 | 82 | 105 | 62 | 99 | 23 | 92 | 32 | 50 |
| 73 | 56 | 167 | 95 | 24 | 168 | 33 | 116 | 75 | 127 | 81 | 67 | 179 | 174 | 70 | 12 | 58 | 87 | 176 | 0 | 51 | 135 |
| 83 | 133 | 54 | 71 | | | | | | | | | | | | | | | | | | |

Converted Pattern (B):

| 91 | 157 | 43 | 151 | 17 | 152 | 159 | 144 | 175 | 8 | 23 | 67 | 52 | 44 | 161 | 124 | 139 | 63 | 85 | 123 | 20 |
| 92 | 179 | 36 | 122 | 132 | 88 | 155 | 37 | 93 | 153 | 147 | 96 | 32 | 30 | 101 | 158 | 148 | 172 | 22 | 7 | 66 |
| 114 | 170 | 50 | 70 | 35 | 40 | 104 | 42 | 134 | 102 | 79 | 106 | 19 | 73 | 12 | 6 | 84 | 4 | 160 | 86 | 14 |
| 5 | 49 | 125 | 97 | 56 | 58 | 121 | 69 | 72 | 109 | 119 | 118 | 137 | 34 | 16 | 167 | 87 | 29 | 90 | 169 | 100 |
| 94 | 11 | 165 | 48 | 149 | 60 | 95 | 176 | 156 | 150 | 129 | 177 | 126 | 145 | 98 | 59 | 113 | 110 | 24 | 0 | 47 | 10 |
| 103 | 138 | 178 | 154 | 77 | 143 | 46 | 156 | 168 | 51 | 163 | 9 | 76 | 108 | 61 | 55 | 142 | 31 | 45 | 33 | 135 |
| 2 | 15 | 28 | 38 | 26 | 146 | 80 | 27 | 141 | 82 | 116 | 83 | 89 | 162 | 25 | 130 | 164 | 117 | 136 | 120 | 105 |
| 75 | 133 | 39 | 21 | 53 | 3 | 140 | 107 | 13 | 18 | 57 | 62 | 127 | 54 | 65 | 171 | 1 | 112 | 115 | 131 | 173 | 111 |
| 74 | 99 | 81 | 71 | | | | | | | | | | | | | | | | | | |

BIT GROUP

# FIG. 294

EP 3 247 043 A1

4096QAM CR 5/15:

Original Pattern (A):

BIT GROUP

| 146 | 89 | 57 | 16 | 164 | 138 | 91 | 78 | 90 | 66 | 122 | 12 | 9 | 157 | 14 | 68 | 112 | 128 | 74 | 45 | 28 | 87 |
|---|---|---|---|---|---|---|---|---|---|---|---|---|---|---|---|---|---|---|---|---|---|
| 158 | 56 | 61 | 168 | 18 | 161 | 95 | 99 | 139 | 22 | 65 | 130 | 166 | 118 | 150 | 49 | 142 | 44 | 36 | 1 | 121 | 6 |
| 46 | 29 | 88 | 47 | 0 | 58 | 105 | 43 | 80 | 64 | 107 | 21 | 55 | 151 | 8 | 145 | 163 | 7 | 98 | 123 | 17 | 11 |
| 153 | 136 | 52 | 3 | 13 | 34 | 160 | 102 | 125 | 114 | 152 | 84 | 32 | 97 | 33 | 60 | 62 | 79 | 37 | 129 | 38 | 165 |
| 71 | 75 | 59 | 144 | 127 | 132 | 104 | 53 | 162 | 103 | 120 | 54 | 155 | 116 | 48 | 77 | 76 | 73 | 113 | 119 | 179 | 177 |
| 41 | 19 | 92 | 109 | 31 | 143 | 178 | 108 | 39 | 140 | 106 | 40 | 5 | 25 | 81 | 176 | 101 | 124 | 126 | 72 | 111 | 4 |
| 173 | 156 | 134 | 86 | 174 | 2 | 170 | 35 | 175 | 137 | 15 | 24 | 69 | 96 | 30 | 117 | 67 | 171 | 149 | 169 | 63 | 23 |
| 20 | 167 | 27 | 147 | 51 | 10 | 82 | 131 | 85 | 110 | 94 | 135 | 172 | 148 | 50 | 154 | 42 | 70 | 115 | 26 | 83 | 141 |
| 100 | 133 | 93 | 159 | | | | | | | | | | | | | | | | | | |

Converted Pattern (B):

| 146 | 68 | 139 | 29 | 163 | 114 | 59 | 73 | 106 | 86 | 149 | 135 | 89 | 112 | 22 | 88 | 7 | 152 | 144 | 113 | 40 | 174 |
|---|---|---|---|---|---|---|---|---|---|---|---|---|---|---|---|---|---|---|---|---|---|
| 169 | 172 | 57 | 128 | 65 | 47 | 98 | 84 | 127 | 119 | 5 | 2 | 63 | 148 | 16 | 74 | 130 | 0 | 123 | 32 | 132 | 179 |
| 25 | 170 | 23 | 50 | 164 | 45 | 166 | 58 | 17 | 97 | 104 | 177 | 81 | 35 | 20 | 154 | 138 | 28 | 118 | 105 | 11 | 33 |
| 53 | 41 | 176 | 175 | 167 | 42 | 91 | 87 | 150 | 43 | 153 | 60 | 162 | 19 | 101 | 137 | 27 | 70 | 78 | 158 | 49 | 80 |
| 136 | 62 | 103 | 92 | 124 | 15 | 147 | 115 | 90 | 56 | 142 | 64 | 52 | 79 | 120 | 109 | 126 | 24 | 51 | 26 | 66 | 61 |
| 44 | 107 | 3 | 37 | 54 | 31 | 72 | 69 | 10 | 83 | 122 | 168 | 36 | 21 | 13 | 129 | 155 | 143 | 111 | 96 | 82 | 141 |
| 12 | 18 | 1 | 55 | 34 | 38 | 116 | 178 | 4 | 30 | 131 | 100 | 9 | 161 | 121 | 151 | 160 | 165 | 48 | 108 | 173 | 117 |
| 85 | 133 | 157 | 95 | 6 | 8 | 102 | 71 | 77 | 39 | 156 | 67 | 110 | 93 | 14 | 99 | 46 | 145 | 125 | 75 | 76 | 140 |
| 134 | 171 | 94 | 159 | | | | | | | | | | | | | | | | | | |

## FIG. 295

4096QAM CR 6/15:

Original Pattern (A):

BIT GROUP

| 66 | 21 | 51 | 55 | 117 | 24 | 33 | 12 | 70 | 63 | 47 | 65 | 145 | 8 | 0 | 57 | 23 | 71 | 59 | 14 | 40 | 42 |
|----|----|----|----|-----|----|----|----|----|----|----|----|-----|---|---|----|----|----|----|----|----|----|
| 15 | 56 | 2 | 43 | 64 | 58 | 67 | 53 | 68 | 61 | 39 | 52 | 69 | 1 | 22 | 31 | 161 | 38 | 30 | 19 | 17 | 18 |
| 4 | 41 | 25 | 44 | 136 | 29 | 36 | 26 | 126 | 177 | 62 | 37 | 148 | 9 | 13 | 45 | 46 | 152 | 50 | 49 | 27 | 77 |
| 60 | 35 | 48 | 178 | 28 | 34 | 106 | 127 | 76 | 131 | 105 | 138 | 75 | 130 | 101 | 167 | 54 | 173 | 113 | 108 | 92 | 135 |
| 124 | 121 | 97 | 149 | 143 | 81 | 32 | 96 | 3 | 78 | 107 | 86 | 98 | 16 | 162 | 150 | 111 | 158 | 172 | 139 | 74 | 142 |
| 166 | 7 | 5 | 119 | 20 | 144 | 151 | 90 | 11 | 156 | 100 | 175 | 83 | 155 | 159 | 128 | 88 | 87 | 93 | 103 | 94 | 140 |
| 165 | 6 | 137 | 157 | 10 | 85 | 141 | 129 | 146 | 122 | 73 | 112 | 132 | 125 | 174 | 169 | 168 | 79 | 84 | 118 | 179 | 147 |
| 91 | 160 | 163 | 115 | 89 | 80 | 102 | 104 | 134 | 82 | 95 | 133 | 164 | 154 | 120 | 110 | 170 | 114 | 153 | 72 | 109 | 171 |
| 176 | 99 | 116 | 123 | | | | | | | | | | | | | | | | | | |

Converted Pattern (B):

| 66 | 57 | 68 | 41 | 46 | 131 | 97 | 158 | 100 | 157 | 84 | 133 | 21 | 23 | 61 | 25 | 152 | 105 | 149 | 172 | 175 | 10 |
|----|----|----|----|----|-----|----|-----|-----|-----|----|-----|----|----|----|----|-----|-----|-----|-----|-----|----|
| 118 | 164 | 51 | 71 | 39 | 44 | 50 | 138 | 143 | 139 | 83 | 85 | 179 | 154 | 55 | 59 | 52 | 136 | 49 | 75 | 81 | 74 |
| 155 | 141 | 147 | 120 | 117 | 14 | 69 | 29 | 27 | 130 | 32 | 142 | 159 | 129 | 91 | 110 | 24 | 40 | 1 | 36 | 77 | 101 |
| 96 | 166 | 128 | 146 | 160 | 170 | 33 | 42 | 22 | 26 | 60 | 167 | 3 | 7 | 88 | 122 | 163 | 114 | 12 | 15 | 31 | 126 |
| 35 | 54 | 78 | 5 | 87 | 73 | 115 | 153 | 70 | 56 | 161 | 177 | 48 | 173 | 107 | 119 | 93 | 112 | 89 | 72 | 63 | 2 |
| 38 | 62 | 178 | 113 | 86 | 20 | 103 | 132 | 80 | 109 | 47 | 43 | 30 | 37 | 28 | 108 | 98 | 144 | 94 | 125 | 102 | 171 |
| 65 | 64 | 19 | 148 | 34 | 92 | 16 | 151 | 140 | 174 | 104 | 176 | 145 | 58 | 17 | 9 | 106 | 135 | 162 | 90 | 165 | 169 |
| 134 | 99 | 8 | 67 | 18 | 13 | 127 | 124 | 150 | 11 | 6 | 168 | 82 | 116 | 0 | 53 | 4 | 45 | 76 | 121 | 111 | 156 |
| 137 | 79 | 95 | 123 | | | | | | | | | | | | | | | | | | |

EP 3 247 043 A1

# FIG. 296

4096QAM CR 7/15:

Original Pattern (A):

BIT GROUP

| 59 | 60 | 0 | 48 | 87 | 30 | 29 | 146 | 142 | 8 | 150 | 171 | 20 | 121 | 23 | 122 | 144 | 76 | 162 | 106 | 50 | 39 |
| 63 | 108 | 165 | 74 | 16 | 85 | 58 | 43 | 161 | 34 | 13 | 92 | 79 | 82 | 175 | 86 | 69 | 68 | 15 | 113 | 84 | 118 |
| 27 | 93 | 120 | 61 | 73 | 104 | 10 | 38 | 45 | 7 | 173 | 75 | 24 | 77 | 137 | 21 | 37 | 46 | 3 | 6 | 168 | 148 |
| 109 | 123 | 103 | 140 | 64 | 117 | 158 | 114 | 136 | 112 | 31 | 70 | 134 | 163 | 98 | 91 | 33 | 115 | 95 | 176 | 154 | 107 |
| 97 | 131 | 111 | 129 | 40 | 66 | 170 | 41 | 74 | 138 | 99 | 179 | 81 | 157 | 32 | 19 | 26 | 62 | 172 | 78 | 160 | 57 |
| 22 | 159 | 51 | 135 | 2 | 55 | 164 | 153 | 155 | 14 | 42 | 149 | 127 | 133 | 83 | 96 | 139 | 89 | 36 | 125 | 130 | 143 |
| 147 | 67 | 18 | 102 | 94 | 35 | 101 | 44 | 49 | 177 | 88 | 11 | 105 | 151 | 12 | 132 | 25 | 128 | 119 | 65 | 145 | 4 |
| 54 | 90 | 71 | 167 | 166 | 1 | 156 | 56 | 124 | 17 | 141 | 72 | 9 | 28 | 5 | 110 | 100 | 47 | 80 | 169 | 116 | 53 |
| 152 | 52 | 126 | 178 | | | | | | | | | | | | | | | | | | |

Converted Pattern (B):

| 59 | 122 | 161 | 93 | 37 | 112 | 111 | 62 | 42 | 102 | 119 | 72 | 60 | 144 | 34 | 120 | 46 | 31 | 129 | 172 | 149 | 94 |
| 65 | 9 | 0 | 76 | 13 | 61 | 3 | 70 | 40 | 78 | 127 | 35 | 145 | 28 | 48 | 162 | 92 | 73 | 6 | 134 | 66 | 160 |
| 133 | 101 | 4 | 5 | 87 | 106 | 79 | 104 | 168 | 163 | 170 | 57 | 83 | 44 | 54 | 110 | 30 | 50 | 82 | 10 | 148 | 98 |
| 41 | 22 | 96 | 49 | 90 | 100 | 29 | 39 | 175 | 38 | 109 | 91 | 74 | 159 | 139 | 177 | 71 | 47 | 146 | 63 | 86 | 45 |
| 123 | 33 | 138 | 51 | 89 | 88 | 167 | 80 | 142 | 108 | 69 | 7 | 103 | 115 | 99 | 135 | 36 | 11 | 166 | 169 | 8 | 165 |
| 68 | 173 | 140 | 95 | 179 | 2 | 125 | 105 | 1 | 116 | 150 | 174 | 15 | 75 | 64 | 176 | 81 | 55 | 130 | 151 | 156 | 53 |
| 171 | 16 | 113 | 24 | 117 | 154 | 157 | 164 | 143 | 12 | 56 | 152 | 20 | 85 | 84 | 77 | 158 | 107 | 32 | 153 | 147 | 132 |
| 124 | 52 | 121 | 58 | 118 | 137 | 114 | 97 | 19 | 155 | 67 | 25 | 17 | 126 | 23 | 43 | 27 | 21 | 136 | 131 | 26 | 14 |
| 18 | 128 | 141 | 178 | | | | | | | | | | | | | | | | | | |

EP 3 247 043 A1

# FIG. 297

EP 3 247 043 A1

4096QAM CR 8/15:

Original Pattern (A):

BIT GROUP

| 77 | 48 | 82 | 51 | 57 | 69 | 65 | 6 | 71 | 90 | 84 | 81 | 50 | 88 | 61 | 55 | 53 | 73 | 39 | 13 | 79 | 75 |
| 41 | 18 | 38 | 89 | 49 | 93 | 36 | 64 | 47 | 40 | 42 | 76 | 70 | 56 | 3 | 72 | 2 | 54 | 52 | 145 | 19 | 78 |
| 80 | 63 | 87 | 67 | 86 | 10 | 1 | 58 | 17 | 14 | 175 | 91 | 68 | 85 | 94 | 15 | 43 | 74 | 60 | 66 | 37 | 92 |
| 4 | 9 | 16 | 83 | 46 | 44 | 102 | 30 | 112 | 122 | 110 | 29 | 20 | 105 | 138 | 101 | 174 | 33 | 137 | 136 | 131 | 166 |
| 59 | 34 | 62 | 125 | 28 | 26 | 45 | 24 | 23 | 21 | 157 | 98 | 35 | 95 | 22 | 32 | 103 | 27 | 113 | 31 | 119 | 173 |
| 168 | 118 | 120 | 114 | 149 | 159 | 155 | 179 | 160 | 161 | 130 | 123 | 172 | 139 | 124 | 153 | 0 | 109 | 167 | 128 | 107 | 117 |
| 147 | 177 | 96 | 164 | 152 | 11 | 148 | 158 | 129 | 163 | 176 | 151 | 171 | 8 | 106 | 144 | 150 | 169 | 108 | 162 | 143 | 111 |
| 141 | 133 | 178 | 134 | 146 | 99 | 132 | 142 | 104 | 115 | 135 | 121 | 100 | 12 | 170 | 156 | 126 | 5 | 127 | 154 | 97 | 140 |
| 116 | 165 | 7 | 25 | | | | | | | | | | | | | | | | | | |

⇩

Converted Pattern (B):

| 77 | 55 | 47 | 63 | 43 | 122 | 62 | 27 | 130 | 164 | 108 | 121 | 48 | 53 | 40 | 87 | 74 | 110 | 125 | 113 | 123 | 152 |
| 162 | 100 | 82 | 73 | 42 | 67 | 60 | 29 | 28 | 31 | 172 | 11 | 143 | 12 | 51 | 39 | 76 | 86 | 66 | 20 | 26 | 119 |
| 139 | 148 | 111 | 170 | 57 | 13 | 70 | 10 | 37 | 105 | 45 | 173 | 124 | 158 | 141 | 156 | 69 | 79 | 56 | 1 | 92 | 138 |
| 24 | 168 | 153 | 129 | 133 | 126 | 65 | 75 | 3 | 58 | 4 | 101 | 23 | 118 | 0 | 163 | 178 | 5 | 6 | 41 | 72 | 17 |
| 9 | 174 | 21 | 120 | 109 | 176 | 134 | 127 | 71 | 18 | 2 | 14 | 16 | 33 | 157 | 114 | 167 | 151 | 146 | 154 | 90 | 38 |
| 54 | 175 | 83 | 137 | 98 | 149 | 128 | 171 | 99 | 97 | 84 | 89 | 52 | 91 | 46 | 136 | 35 | 159 | 107 | 8 | 132 | 140 |
| 81 | 49 | 145 | 68 | 44 | 131 | 95 | 155 | 117 | 106 | 142 | 116 | 50 | 93 | 19 | 85 | 102 | 166 | 22 | 179 | 147 | 144 |
| 104 | 165 | 88 | 36 | 78 | 94 | 30 | 59 | 32 | 160 | 177 | 150 | 115 | 7 | 61 | 64 | 80 | 15 | 112 | 34 | 103 | 161 |
| 96 | 169 | 135 | 25 | | | | | | | | | | | | | | | | | | |

# FIG. 298

4096QAM CR 9/15:

Original Pattern (A):

BIT GROUP

| 67 | 79 | 72 | 175 | 1 | 92 | 63 | 65 | 36 | 73 | 18 | 3 | 43 | 78 | 5 | 40 | 82 | 20 | 15 | 76 | 28 | 84 |
|----|----|----|-----|---|----|----|----|----|----|----|---|----|----|---|----|----|----|----|----|----|----|
| 59 | 91 | 93 | 54 | 58 | 60 | 2 | 19 | 66 | 44 | 85 | 48 | 0 | 50 | 166 | 89 | 41 | 24 | 83 | 75 | 55 | 64 |
| 52 | 98 | 39 | 141 | 34 | 74 | 33 | 45 | 99 | 46 | 10 | 69 | 94 | 101 | 56 | 9 | 97 | 96 | 37 | 14 | 31 | 70 |
| 106 | 113 | 80 | 62 | 100 | 13 | 32 | 88 | 57 | 127 | 53 | 68 | 146 | 61 | 7 | 107 | 71 | 51 | 161 | 81 | 49 | 86 |
| 95 | 103 | 30 | 25 | 126 | 87 | 22 | 47 | 27 | 171 | 102 | 6 | 132 | 77 | 90 | 38 | 167 | 4 | 35 | 26 | 118 | 140 |
| 104 | 128 | 179 | 124 | 109 | 159 | 42 | 110 | 21 | 105 | 148 | 142 | 134 | 23 | 117 | 122 | 160 | 12 | 154 | 114 | 156 | 151 |
| 145 | 169 | 11 | 139 | 177 | 129 | 155 | 178 | 138 | 176 | 147 | 121 | 136 | 165 | 170 | 133 | 149 | 150 | 174 | 168 | 125 | 116 |
| 115 | 164 | 29 | 119 | 153 | 157 | 162 | 173 | 112 | 144 | 172 | 123 | 137 | 16 | 120 | 131 | 111 | 135 | 163 | 17 | 130 | 152 |
| 108 | 8 | 158 | 143 | | | | | | | | | | | | | | | | | | |

Converted Pattern (B):

| 67 | 40 | 66 | 98 | 97 | 127 | 30 | 4 | 148 | 139 | 174 | 123 | 79 | 82 | 44 | 39 | 96 | 53 | 25 | 35 | 142 | 177 |
|----|----|----|----|----|-----|----|---|-----|-----|-----|-----|----|----|----|----|----|----|----|----|-----|-----|
| 168 | 137 | 72 | 20 | 85 | 141 | 37 | 68 | 126 | 26 | 134 | 129 | 125 | 16 | 175 | 15 | 48 | 34 | 14 | 146 | 87 | 118 |
| 23 | 155 | 116 | 120 | 1 | 76 | 0 | 74 | 31 | 61 | 22 | 140 | 117 | 178 | 115 | 131 | 92 | 28 | 50 | 33 | 70 | 7 |
| 47 | 104 | 122 | 138 | 164 | 111 | 63 | 84 | 166 | 45 | 106 | 107 | 27 | 128 | 160 | 176 | 29 | 135 | 65 | 59 | 89 | 99 |
| 113 | 71 | 171 | 179 | 12 | 147 | 119 | 163 | 36 | 91 | 41 | 46 | 80 | 51 | 102 | 124 | 154 | 121 | 153 | 17 | 73 | 93 |
| 24 | 10 | 62 | 161 | 6 | 109 | 114 | 136 | 157 | 130 | 18 | 54 | 83 | 69 | 100 | 81 | 132 | 159 | 156 | 165 | 162 | 152 |
| 3 | 58 | 75 | 94 | 13 | 49 | 77 | 42 | 151 | 170 | 173 | 108 | 43 | 60 | 55 | 101 | 32 | 86 | 90 | 110 | 145 | 133 |
| 112 | 8 | 78 | 2 | 64 | 56 | 88 | 95 | 38 | 21 | 169 | 149 | 144 | 158 | 5 | 19 | 52 | 9 | 57 | 103 | 167 | 105 |
| 11 | 150 | 172 | 143 | | | | | | | | | | | | | | | | | | |

EP 3 247 043 A1

# FIG. 299

4096QAM CR 10/15:

Original Pattern (A):

EP 3 247 043 A1

BIT GROUP

| 36 | 21 | 117 | 71 | 38 | 108 | 42 | 61 | 13 | 88 | 97 | 68 | 2 | 67 | 50 | 64 | 95 | 63 | 100 | 9 | 82 | 51 |
|---|---|---|---|---|---|---|---|---|---|---|---|---|---|---|---|---|---|---|---|---|---|
| 45 | 78 | 31 | 18 | 103 | 39 | 119 | 25 | 40 | 28 | 72 | 11 | 73 | 86 | 131 | 84 | 111 | 24 | 58 | 60 | 81 | 37 |
| 89 | 1 | 93 | 56 | 69 | 96 | 35 | 57 | 116 | 130 | 55 | 74 | 41 | 169 | 54 | 14 | 26 | 65 | 83 | 165 | 107 | 0 |
| 52 | 144 | 75 | 101 | 8 | 115 | 118 | 85 | 48 | 112 | 80 | 90 | 32 | 173 | 76 | 33 | 16 | 77 | 164 | 104 | 46 | 20 |
| 98 | 109 | 29 | 114 | 7 | 110 | 99 | 53 | 133 | 70 | 87 | 106 | 145 | 4 | 113 | 27 | 59 | 34 | 5 | 102 | 148 | 142 |
| 79 | 19 | 44 | 159 | 174 | 155 | 136 | 94 | 43 | 49 | 152 | 161 | 66 | 3 | 121 | 135 | 147 | 17 | 157 | 30 | 153 | 154 |
| 137 | 168 | 92 | 149 | 171 | 10 | 177 | 134 | 143 | 176 | 179 | 105 | 172 | 47 | 146 | 160 | 23 | 175 | 141 | 91 | 140 | 163 |
| 132 | 6 | 126 | 124 | 12 | 170 | 167 | 151 | 125 | 139 | 150 | 15 | 129 | 162 | 120 | 166 | 156 | 62 | 158 | 178 | 128 | 127 |
| 22 | 122 | 123 | 138 | | | | | | | | | | | | | | | | | | |

Converted Pattern (B):

| 36 | 64 | 40 | 1 | 26 | 112 | 29 | 34 | 152 | 149 | 141 | 15 | 21 | 95 | 28 | 93 | 65 | 80 | 114 | 5 | 161 | 171 |
|---|---|---|---|---|---|---|---|---|---|---|---|---|---|---|---|---|---|---|---|---|---|
| 91 | 129 | 117 | 63 | 72 | 56 | 83 | 90 | 7 | 102 | 66 | 10 | 140 | 162 | 71 | 100 | 11 | 69 | 165 | 32 | 110 | 148 |
| 3 | 177 | 163 | 120 | 38 | 9 | 73 | 96 | 107 | 173 | 99 | 142 | 121 | 134 | 132 | 166 | 108 | 82 | 86 | 35 | 0 | 76 |
| 53 | 79 | 135 | 143 | 6 | 156 | 42 | 51 | 131 | 57 | 52 | 33 | 133 | 19 | 147 | 176 | 126 | 62 | 61 | 45 | 84 | 116 |
| 144 | 16 | 70 | 44 | 17 | 179 | 124 | 158 | 13 | 78 | 111 | 130 | 75 | 77 | 87 | 159 | 157 | 105 | 12 | 178 | 88 | 31 |
| 24 | 55 | 101 | 164 | 106 | 174 | 30 | 172 | 170 | 128 | 97 | 18 | 58 | 74 | 8 | 104 | 145 | 155 | 153 | 47 | 167 | 127 |
| 68 | 103 | 60 | 41 | 115 | 46 | 4 | 136 | 154 | 146 | 151 | 22 | 2 | 39 | 81 | 169 | 118 | 20 | 113 | 94 | 137 | 160 |
| 125 | 122 | 67 | 119 | 37 | 54 | 85 | 98 | 27 | 43 | 168 | 23 | 139 | 123 | 50 | 25 | 89 | 14 | 48 | 109 | 59 | 49 |
| 92 | 175 | 150 | 138 | | | | | | | | | | | | | | | | | | |

## FIG. 300

4096QAM CR 11/15:

Original Pattern (A):

BIT GROUP

| 77 | 97 | 3 | 44 | 119 | 72 | 83 | 116 | 40 | 0 | 111 | 8 | 68 | 43 | 24 | 102 | 49 | 92 | 65 | 31 | 93 | 60 |
|----|----|----|----|----|----|----|----|----|----|----|----|----|----|----|----|----|----|----|----|----|----|
| 17 | 76 | 89 | 118 | 70 | 87 | 15 | 67 | 22 | 59 | 95 | 46 | 38 | 125 | 48 | 58 | 140 | 104 | 73 | 47 | 14 | 120 |
| 1 | 50 | 80 | 63 | 62 | 45 | 9 | 25 | 114 | 19 | 82 | 54 | 150 | 121 | 130 | 123 | 37 | 55 | 23 | 98 | 81 | 122 |
| 103 | 85 | 126 | 101 | 78 | 5 | 128 | 148 | 57 | 12 | 107 | 36 | 2 | 109 | 52 | 39 | 66 | 115 | 42 | 156 | 90 | 51 |
| 91 | 29 | 84 | 18 | 144 | 10 | 94 | 64 | 100 | 86 | 71 | 27 | 30 | 32 | 110 | 33 | 113 | 131 | 35 | 34 | 112 | 26 |
| 108 | 16 | 61 | 56 | 75 | 41 | 117 | 69 | 172 | 96 | 149 | 127 | 124 | 173 | 13 | 74 | 105 | 53 | 161 | 146 | 174 | 79 |
| 88 | 28 | 129 | 134 | 139 | 136 | 145 | 170 | 135 | 158 | 154 | 162 | 7 | 169 | 99 | 106 | 137 | 165 | 143 | 4 | 175 | 138 |
| 133 | 171 | 168 | 147 | 167 | 141 | 163 | 176 | 179 | 142 | 11 | 177 | 153 | 151 | 159 | 132 | 20 | 164 | 6 | 157 | 178 | 21 |
| 166 | 155 | 160 | 152 | | | | | | | | | | | | | | | | | | |

Converted Pattern (B):

| 77 | 102 | 22 | 50 | 37 | 12 | 84 | 131 | 149 | 134 | 143 | 177 | 97 | 49 | 59 | 80 | 55 | 107 | 18 | 35 | 127 | 139 |
|----|----|----|----|----|----|----|----|----|----|----|----|----|----|----|----|----|----|----|----|----|----|
| 4 | 153 | 3 | 92 | 95 | 63 | 23 | 36 | 144 | 34 | 124 | 136 | 175 | 151 | 44 | 65 | 46 | 62 | 98 | 2 | 10 | 112 |
| 173 | 145 | 138 | 159 | 119 | 31 | 38 | 45 | 81 | 109 | 94 | 26 | 13 | 170 | 133 | 132 | 72 | 93 | 125 | 9 | 122 | 52 |
| 64 | 108 | 74 | 135 | 171 | 20 | 83 | 60 | 48 | 25 | 103 | 39 | 100 | 16 | 105 | 158 | 168 | 164 | 116 | 17 | 58 | 114 |
| 85 | 66 | 86 | 61 | 53 | 154 | 147 | 6 | 40 | 76 | 140 | 19 | 126 | 115 | 71 | 56 | 161 | 162 | 167 | 157 | 0 | 89 |
| 104 | 82 | 101 | 42 | 27 | 75 | 146 | 7 | 141 | 178 | 111 | 118 | 73 | 54 | 78 | 156 | 30 | 41 | 174 | 169 | 163 | 21 |
| 8 | 70 | 47 | 150 | 5 | 90 | 32 | 117 | 79 | 99 | 176 | 166 | 68 | 87 | 14 | 121 | 128 | 51 | 110 | 69 | 88 | 106 |
| 179 | 155 | 43 | 15 | 120 | 130 | 148 | 91 | 33 | 172 | 28 | 137 | 142 | 160 | 24 | 67 | 1 | 123 | 57 | 29 | 113 | 96 |
| 129 | 165 | 11 | 152 | | | | | | | | | | | | | | | | | | |

EP 3 247 043 A1

## FIG. 301

4096QAM CR 12/15:

Original Pattern (A):

| 110 | 16 | 64 | 100 | 55 | 70 | 48 | 26 | 60 | 71 | 93 | 1 | 59 | 88 | 97 | 136 | 67 | 94 | 90 | 72 | 49 | 23 |
| 41 | 92 | 9 | 35 | 37 | 113 | 101 | 111 | 8 | 52 | 56 | 19 | 134 | 151 | 84 | 126 | 159 | 63 | 44 | 65 | 139 | 31 |
| 57 | 103 | 22 | 116 | 172 | 38 | 95 | 36 | 46 | 141 | 114 | 4 | 106 | 149 | 85 | 86 | 66 | 51 | 121 | 105 | 109 | 87 |
| 6 | 135 | 127 | 47 | 123 | 39 | 10 | 148 | 43 | 131 | 147 | 45 | 143 | 5 | 108 | 81 | 2 | 140 | 120 | 132 | 76 | 58 |
| 137 | 18 | 29 | 125 | 17 | 30 | 32 | 156 | 133 | 78 | 91 | 161 | 104 | 174 | 53 | 61 | 50 | 74 | 77 | 33 | 171 | 138 |
| 28 | 69 | 112 | 119 | 12 | 102 | 20 | 167 | 99 | 122 | 117 | 24 | 98 | 115 | 124 | 42 | 7 | 79 | 75 | 128 | 82 | 68 |
| 80 | 3 | 11 | 54 | 96 | 40 | 129 | 142 | 107 | 73 | 175 | 14 | 83 | 150 | 165 | 118 | 89 | 130 | 15 | 163 | 34 | 166 |
| 173 | 146 | 168 | 153 | 154 | 177 | 62 | 145 | 0 | 178 | 155 | 157 | 179 | 144 | 158 | 152 | 13 | 25 | 176 | 162 | 169 | 164 |
| 27 | 21 | 160 | 170 |

Converted Pattern (B):

| 110 | 136 | 8 | 103 | 66 | 131 | 29 | 74 | 117 | 54 | 15 | 157 | 16 | 67 | 52 | 22 | 51 | 147 | 125 | 77 | 24 | 96 |
| 163 | 179 | 64 | 94 | 56 | 116 | 121 | 45 | 17 | 33 | 98 | 40 | 34 | 144 | 100 | 90 | 19 | 172 | 105 | 143 | 30 | 171 |
| 115 | 129 | 166 | 158 | 55 | 72 | 134 | 38 | 109 | 5 | 32 | 138 | 124 | 142 | 173 | 152 | 70 | 49 | 151 | 95 | 87 | 108 |
| 156 | 28 | 42 | 107 | 146 | 13 | 48 | 23 | 84 | 36 | 6 | 81 | 133 | 69 | 7 | 73 | 168 | 25 | 26 | 41 | 126 | 46 |
| 135 | 2 | 78 | 112 | 79 | 175 | 153 | 176 | 60 | 92 | 159 | 141 | 127 | 140 | 91 | 119 | 75 | 14 | 154 | 162 | 71 | 9 |
| 63 | 114 | 47 | 120 | 161 | 12 | 128 | 83 | 177 | 169 | 93 | 35 | 44 | 4 | 123 | 132 | 104 | 102 | 82 | 150 | 62 | 164 |
| 1 | 37 | 65 | 106 | 39 | 76 | 174 | 20 | 68 | 165 | 145 | 27 | 59 | 113 | 139 | 149 | 10 | 58 | 53 | 167 | 80 | 118 |
| 0 | 21 | 88 | 101 | 31 | 85 | 148 | 137 | 61 | 99 | 3 | 89 | 178 | 160 | 97 | 111 | 57 | 86 | 43 | 18 | 50 | 122 |
| 11 | 130 | 155 | 170 |

# FIG. 302

4096QAM CR 13/15:

Original Pattern (A):

BIT GROUP

| 87 | 50 | 6 | 42 | 82 | 54 | 96 | 0 | 62 | 124 | 109 | 126 | 23 | 64 | 53 | 20 | 41 | 111 | 145 | 135 | 68 | 2 |
|----|----|----|----|----|----|----|----|----|----|----|----|----|----|----|----|----|----|----|----|----|----|
| 122 | 128 | 107 | 7 | 28 | 14 | 125 | 136 | 154 | 10 | 92 | 99 | 84 | 86 | 151 | 108 | 24 | 94 | 148 | 29 | 123 | 13 |
| 88 | 52 | 35 | 61 | 102 | 132 | 95 | 70 | 40 | 129 | 101 | 36 | 51 | 150 | 142 | 152 | 121 | 131 | 116 | 97 | 104 | 31 |
| 59 | 137 | 83 | 112 | 113 | 57 | 77 | 32 | 93 | 49 | 58 | 117 | 78 | 1 | 149 | 37 | 11 | 100 | 85 | 79 | 72 | 66 |
| 130 | 18 | 63 | 55 | 91 | 46 | 146 | 21 | 143 | 44 | 110 | 75 | 138 | 16 | 76 | 45 | 114 | 144 | 119 | 38 | 140 | 65 |
| 30 | 133 | 153 | 33 | 89 | 71 | 115 | 105 | 90 | 56 | 25 | 103 | 147 | 73 | 60 | 47 | 118 | 27 | 69 | 9 | 74 | 48 |
| 19 | 39 | 43 | 34 | 81 | 139 | 3 | 164 | 106 | 134 | 5 | 67 | 80 | 141 | 120 | 98 | 155 | 8 | 156 | 162 | 163 | 165 |
| 26 | 161 | 168 | 176 | 159 | 170 | 4 | 127 | 22 | 173 | 157 | 171 | 178 | 158 | 17 | 174 | 179 | 167 | 12 | 172 | 166 | 160 |
| 177 | 169 | 175 | 15 | | | | | | | | | | | | | | | | | | |

⇩

Converted Pattern (B):

| 87 | 20 | 154 | 52 | 121 | 49 | 63 | 144 | 25 | 34 | 156 | 171 | 50 | 41 | 10 | 35 | 131 | 58 | 55 | 119 | 103 | 81 |
|----|----|----|----|----|----|----|----|----|----|----|----|----|----|----|----|----|----|----|----|----|----|
| 162 | 178 | 6 | 111 | 92 | 61 | 116 | 117 | 91 | 38 | 147 | 139 | 163 | 158 | 42 | 145 | 99 | 102 | 97 | 78 | 46 | 140 |
| 73 | 3 | 165 | 17 | 82 | 135 | 84 | 132 | 104 | 1 | 146 | 65 | 60 | 164 | 26 | 174 | 54 | 68 | 86 | 95 | 31 | 149 |
| 21 | 30 | 47 | 106 | 161 | 179 | 96 | 2 | 151 | 70 | 59 | 37 | 143 | 133 | 118 | 134 | 168 | 167 | 0 | 122 | 108 | 40 |
| 137 | 11 | 44 | 153 | 27 | 5 | 176 | 12 | 62 | 128 | 24 | 129 | 83 | 100 | 110 | 33 | 69 | 67 | 159 | 172 | 124 | 107 |
| 94 | 101 | 112 | 85 | 75 | 89 | 9 | 80 | 170 | 166 | 109 | 7 | 148 | 36 | 113 | 79 | 138 | 71 | 74 | 141 | 4 | 160 |
| 126 | 28 | 29 | 51 | 57 | 72 | 16 | 115 | 48 | 120 | 127 | 177 | 23 | 14 | 123 | 150 | 77 | 66 | 76 | 105 | 19 | 98 |
| 22 | 169 | 64 | 125 | 13 | 142 | 32 | 130 | 45 | 90 | 39 | 155 | 173 | 175 | 53 | 136 | 88 | 152 | 93 | 18 | 114 | 56 |
| 43 | 8 | 157 | 15 | | | | | | | | | | | | | | | | | | |

EP 3 247 043 A1

FIG. 303

| CR\MOD | 2 | 3 | 4 | 5 | 6 | 7 | 8 | 9 | 10 | 11 | 12 | 13 |
|---|---|---|---|---|---|---|---|---|---|---|---|---|
| 2 | A | A | A | A | B | B | A | B | A | A | A | A |
| 4 | A | A | A | A | B | B | A | B | A | B | A | B |
| 6 | A | A | A | A | B | B | A | B | A | A | A | A |
| 8 | A | A | A | A | B | A | A | A | A | B | A | A |

EP 3 247 043 A1

# FIG. 304

QPSK CR 2/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |

| 44 |

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

EP 3 247 043 A1

# FIG. 305

QPSK CR 3/15:

Original Pattern (A):

BIT GROUP

| 15 | 22 | 34 | 19 | 7 | 17 | 28 | 43 | 30 | 32 | 14 | 1 | 11 | 0 | 3 | 9 | 10 | 38 | 24 | 4 | 23 | 18 |

| 27 | 39 | 29 | 33 | 8 | 2 | 40 | 21 | 20 | 36 | 44 | 12 | 37 | 13 | 35 | 6 | 31 | 26 | 16 | 25 | 42 | 5 |

| 41 |

⇩

Converted Pattern (B):

| 15 | 27 | 22 | 39 | 34 | 29 | 19 | 33 | 7 | 8 | 17 | 2 | 28 | 40 | 43 | 21 | 30 | 20 | 32 | 36 | 14 | 44 |

| 1 | 12 | 11 | 37 | 0 | 13 | 3 | 35 | 9 | 6 | 10 | 31 | 38 | 26 | 24 | 16 | 4 | 25 | 23 | 42 | 18 | 5 |

| 41 |

EP 3 247 043 A1

# FIG. 306

QPSK CR 4/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
|---|---|---|---|---|----|----|----|----|----|----|----|----|----|----|----|----|----|----|----|----|----|

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |
|---|---|---|---|---|----|----|----|----|----|----|----|----|----|----|----|----|----|----|----|----|----|

| 44 |
|----|

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 |
|----|

EP 3 247 043 A1

# FIG. 307

QPSK CR 5/15:

Original Pattern (A):

BIT GROUP

| 35 | 7 | 29 | 11 | 14 | 32 | 38 | 28 | 20 | 17 | 25 | 39 | 19 | 4 | 1 | 12 | 10 | 30 | 0 | 44 | 43 | 2 |

| 21 | 5 | 13 | 34 | 37 | 23 | 15 | 36 | 18 | 42 | 16 | 33 | 31 | 27 | 22 | 3 | 6 | 40 | 24 | 41 | 9 | 26 |

| 8 |

⇩

Converted Pattern (B):

| 35 | 21 | 7 | 5 | 29 | 13 | 11 | 34 | 14 | 37 | 32 | 23 | 38 | 15 | 28 | 36 | 20 | 18 | 17 | 42 | 25 | 16 |

| 39 | 33 | 19 | 31 | 4 | 27 | 1 | 22 | 12 | 3 | 10 | 6 | 30 | 40 | 0 | 24 | 44 | 41 | 43 | 9 | 2 | 26 |

| 8 |

## FIG. 308

QPSK CR 6/15:

Original Pattern (B):                                                                                    BIT GROUP

| 7 | 4 | 0 | 5 | 27 | 30 | 25 | 13 | 31 | 9 | 34 | 10 | 17 | 11 | 8 | 12 | 15 | 16 | 18 | 19 | 20 | 21 |

| 22 | 23 | 1 | 35 | 24 | 29 | 33 | 6 | 26 | 14 | 32 | 28 | 2 | 3 | 36 | 37 | 38 | 39 | 40 | 41 | 42 | 43 |

| 44 |

⇩

Converted Pattern (A):

| 7 | 0 | 27 | 25 | 31 | 34 | 17 | 8 | 15 | 18 | 20 | 22 | 1 | 24 | 33 | 26 | 32 | 2 | 36 | 38 | 40 | 42 |

| 4 | 5 | 30 | 13 | 9 | 10 | 11 | 12 | 16 | 19 | 21 | 23 | 35 | 29 | 6 | 14 | 28 | 3 | 37 | 39 | 41 | 43 |

| 44 |

EP 3 247 043 A1

# FIG. 309

QPSK CR 7/15:

Original Pattern (B):

BIT GROUP

| 3 | 7 | 1 | 4 | 18 | 21 | 22 | 6 | 9 | 5 | 17 | 14 | 13 | 15 | 10 | 20 | 8 | 19 | 16 | 12 | 0 | 11 |

| 2 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

Converted Pattern (A):

| 3 | 1 | 18 | 22 | 9 | 17 | 13 | 10 | 8 | 16 | 0 | 2 | 24 | 26 | 28 | 30 | 32 | 34 | 36 | 38 | 40 | 42 |

| 7 | 4 | 21 | 6 | 5 | 14 | 15 | 20 | 19 | 12 | 11 | 23 | 25 | 27 | 29 | 31 | 33 | 35 | 37 | 39 | 41 | 43 |

| 44 |

EP 3 247 043 A1

## FIG. 310

EP 3 247 043 A1

QPSK CR 8/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |

| 44 |

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

# FIG. 311

QPSK CR 9/15:

Original Pattern (B):

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|---|---|---|---|---|---|---|---|---|---|---|---|---|---|---|---|---|---|---|---|---|---|

| 44 |
|---|

Converted Pattern (A):

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
|---|---|---|---|---|---|---|---|---|---|---|---|---|---|---|---|---|---|---|---|---|---|

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |
|---|---|---|---|---|---|---|---|---|---|---|---|---|---|---|---|---|---|---|---|---|---|

| 44 |
|---|

EP 3 247 043 A1

# FIG. 312

QPSK CR 10/15:

Original Pattern (A):

BIT GROUP

| 1 | 4 | 5 | 6 | 24 | 21 | 18 | 7 | 17 | 12 | 8 | 20 | 23 | 29 | 28 | 30 | 32 | 34 | 36 | 38 | 40 | 42 |

| 0 | 2 | 3 | 14 | 22 | 13 | 10 | 25 | 9 | 27 | 19 | 16 | 15 | 26 | 11 | 31 | 33 | 35 | 37 | 39 | 41 | 43 |

| 44 |

⇩

Converted Pattern (B):

| 1 | 0 | 4 | 2 | 5 | 3 | 6 | 14 | 24 | 22 | 21 | 13 | 18 | 10 | 7 | 25 | 17 | 9 | 12 | 27 | 8 | 19 |

| 20 | 16 | 23 | 15 | 29 | 26 | 28 | 11 | 30 | 31 | 32 | 33 | 34 | 35 | 36 | 37 | 38 | 39 | 40 | 41 | 42 | 43 |

| 44 |

EP 3 247 043 A1

# FIG. 313

QPSK CR 11/15:

Original Pattern (A):

EP 3 247 043 A1

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |

| 44 |

⬇

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

# FIG. 314

QPSK CR 12/15:

Original Pattern (A):

BIT GROUP

| 0 | 2 | 4 | 6 | 8 | 10 | 12 | 14 | 16 | 18 | 20 | 22 | 24 | 26 | 28 | 30 | 32 | 34 | 36 | 38 | 40 | 42 |
|---|---|---|---|---|----|----|----|----|----|----|----|----|----|----|----|----|----|----|----|----|----|

| 1 | 3 | 5 | 7 | 9 | 11 | 13 | 15 | 17 | 19 | 21 | 23 | 25 | 27 | 29 | 31 | 33 | 35 | 37 | 39 | 41 | 43 |
|---|---|---|---|---|----|----|----|----|----|----|----|----|----|----|----|----|----|----|----|----|----|

| 44 |
|----|

⇩

Converted Pattern (B):

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 |
|----|

EP 3 247 043 A1

# FIG. 315

QPSK CR 13/15:

Original Pattern (A):

BIT GROUP

| 26 | 10 | 12 | 38 | 28 | 15 | 0 | 44 | 34 | 24 | 14 | 8 | 40 | 30 | 20 | 13 | 42 | 32 | 22 | 11 | 9 | 36 |

| 25 | 7 | 5 | 37 | 27 | 4 | 16 | 43 | 33 | 23 | 2 | 18 | 39 | 29 | 19 | 6 | 41 | 31 | 21 | 3 | 17 | 35 |

| 1 |

Converted Pattern (B):

| 26 | 25 | 10 | 7 | 12 | 5 | 38 | 37 | 28 | 27 | 15 | 4 | 0 | 16 | 44 | 43 | 34 | 33 | 24 | 23 | 14 | 2 |

| 8 | 18 | 40 | 39 | 30 | 29 | 20 | 19 | 13 | 6 | 42 | 41 | 32 | 31 | 22 | 21 | 11 | 3 | 9 | 17 | 36 | 35 |

| 1 |

EP 3 247 043 A1

## FIG. 316

16QAM CR 2/15:

Original Pattern (A):

BIT GROUP

| 5 | 33 | 18 | 8 | 29 | 10 | 21 | 14 | 30 | 26 | 11 | 23 | 27 | 4 | 7 | 6 | 24 | 44 | 38 | 31 | 34 | 43 |
|---|----|----|---|----|----|----|----|----|----|----|----|----|---|---|---|----|----|----|----|----|----|

| 13 | 0 | 15 | 42 | 17 | 2 | 20 | 12 | 40 | 39 | 35 | 32 | 1 | 3 | 41 | 37 | 9 | 25 | 19 | 22 | 16 | 28 |
|----|---|----|----|----|---|----|----|----|----|----|----|---|---|----|----|---|----|----|----|----|----|

| 36 |
|----|

⇩

Converted Pattern (B):

| 5 | 23 | 13 | 32 | 33 | 27 | 0 | 1 | 18 | 4 | 15 | 3 | 8 | 7 | 42 | 41 | 29 | 6 | 17 | 37 | 10 | 24 |
|---|----|----|----|----|----|---|---|----|---|----|---|---|---|----|----|----|---|----|----|----|----|

| 2 | 9 | 21 | 44 | 20 | 25 | 14 | 38 | 12 | 19 | 30 | 31 | 40 | 22 | 26 | 34 | 39 | 16 | 11 | 43 | 35 | 28 |
|---|---|----|----|----|----|----|----|----|----|----|----|----|----|----|----|----|----|----|----|----|----|

| 36 |
|----|

## FIG. 317

16QAM CR 3/15:

Original Pattern (A):

BIT GROUP

| 18 | 16 | 5 | 29 | 26 | 43 | 23 | 6 | 1 | 24 | 7 | 19 | 37 | 2 | 27 | 3 | 10 | 15 | 36 | 39 | 22 | 12 |

| 35 | 33 | 4 | 17 | 30 | 31 | 21 | 9 | 11 | 41 | 0 | 32 | 20 | 40 | 25 | 8 | 34 | 38 | 28 | 14 | 44 | 13 |

| 42 |

⇩

Converted Pattern (B):

| 18 | 19 | 35 | 32 | 16 | 37 | 33 | 20 | 5 | 2 | 4 | 40 | 29 | 27 | 17 | 25 | 26 | 3 | 30 | 8 | 43 | 10 |

| 31 | 34 | 23 | 15 | 21 | 38 | 6 | 36 | 9 | 28 | 1 | 39 | 11 | 14 | 24 | 22 | 41 | 44 | 7 | 12 | 0 | 13 |

| 42 |

EP 3 247 043 A1

# FIG. 318

EP 3 247 043 A1

16QAM CR 4/15:

Original Pattern (A):                                                           BIT GROUP

| 34 | 3 | 19 | 35 | 25 | 2 | 17 | 36 | 26 | 38 | 0 | 40 | 27 | 10 | 7 | 43 | 21 | 28 | 15 | 6 | 1 | 37 |

| 18 | 30 | 32 | 33 | 29 | 22 | 12 | 13 | 5 | 23 | 44 | 14 | 4 | 31 | 20 | 39 | 42 | 11 | 9 | 16 | 41 | 8 |

| 24 |

⬇

Converted Pattern (B):

| 34 | 40 | 18 | 14 | 3 | 27 | 30 | 4 | 19 | 10 | 32 | 31 | 35 | 7 | 33 | 20 | 25 | 43 | 29 | 39 | 2 | 21 |

| 22 | 42 | 17 | 28 | 12 | 11 | 36 | 15 | 13 | 9 | 26 | 6 | 5 | 16 | 38 | 1 | 23 | 41 | 0 | 37 | 44 | 8 |

| 24 |

## FIG. 319

16QAM CR 5/15:

Original Pattern (A):

BIT GROUP

| 3 | 33 | 39 | 2 | 38 | 29 | 0 | 10 | 25 | 17 | 7 | 21 | 44 | 37 | 8 | 34 | 20 | 1 | 4 | 31 | 11 | 42 |
|---|----|----|---|----|----|---|----|----|----|---|----|----|----|---|----|----|---|---|----|----|----|

| 22 | 13 | 12 | 28 | 26 | 43 | 30 | 14 | 16 | 23 | 24 | 15 | 5 | 18 | 9 | 36 | 6 | 19 | 32 | 40 | 41 | 35 |
|----|----|----|----|----|----|----|----|----|----|----|----|---|----|---|----|---|----|----|----|----|----|

| 27 |
|----|

Converted Pattern (B):

| 3 | 21 | 22 | 15 | 33 | 44 | 13 | 5 | 39 | 37 | 12 | 18 | 2 | 8 | 28 | 9 | 38 | 34 | 26 | 36 | 29 | 20 |
|---|----|----|----|----|----|----|---|----|----|----|----|---|---|----|---|----|----|----|----|----|----|

| 43 | 6 | 0 | 1 | 30 | 19 | 10 | 4 | 14 | 32 | 25 | 31 | 16 | 40 | 17 | 11 | 23 | 41 | 7 | 42 | 24 | 35 |
|----|---|---|---|----|----|----|---|----|----|----|----|----|----|----|----|----|----|---|----|----|----|

| 27 |
|----|

## FIG. 320

EP 3 247 043 A1

16QAM CR 6/15:

Original Pattern (B):

BIT GROUP

| 12 | 13 | 15 | 30 | 27 | 25 | 11 | 34 | 9 | 4 | 31 | 22 | 6 | 32 | 7 | 21 | 17 | 3 | 1 | 26 | 10 | 33 |

| 19 | 2 | 18 | 5 | 28 | 35 | 8 | 16 | 29 | 23 | 14 | 0 | 20 | 24 | 36 | 37 | 38 | 39 | 40 | 41 | 42 | 43 |

| 44 |

⇩

Converted Pattern (A):

| 12 | 27 | 9 | 6 | 17 | 10 | 18 | 8 | 14 | 36 | 40 | 13 | 25 | 4 | 32 | 3 | 33 | 5 | 16 | 0 | 37 | 41 |

| 15 | 11 | 31 | 7 | 1 | 19 | 28 | 29 | 20 | 38 | 42 | 30 | 34 | 22 | 21 | 26 | 2 | 35 | 23 | 24 | 39 | 43 |

| 44 |

## FIG. 321

16QAM CR 7/15:

Original Pattern (B):

<span style="float:right">BIT GROUP</span>

| 19 | 3 | 32 | 38 | 16 | 17 | 29 | 33 | 14 | 10 | 6 | 2 | 20 | 15 | 40 | 39 | 12 | 22 | 23 | 34 | 31 | 13 |

| 44 | 43 | 36 | 24 | 37 | 42 | 0 | 9 | 4 | 21 | 5 | 35 | 26 | 41 | 7 | 28 | 11 | 25 | 8 | 18 | 1 | 30 |

| 27 |

⇩

Converted Pattern (A):

| 19 | 16 | 14 | 20 | 12 | 31 | 36 | 0 | 5 | 7 | 8 | 3 | 17 | 10 | 15 | 22 | 13 | 24 | 9 | 35 | 28 | 18 |

| 32 | 29 | 6 | 40 | 23 | 44 | 37 | 4 | 26 | 11 | 1 | 38 | 33 | 2 | 39 | 34 | 43 | 42 | 21 | 41 | 25 | 30 |

| 27 |

EP 3 247 043 A1

## FIG. 322

16QAM CR 8/15:

Original Pattern (A):

BIT GROUP

| 36 | 5 | 22 | 26 | 1 | 13 | 3 | 33 | 9 | 6 | 23 | 20 | 35 | 10 | 17 | 41 | 30 | 15 | 21 | 42 | 29 | 11 |

| 37 | 4 | 2 | 38 | 44 | 0 | 18 | 19 | 8 | 31 | 28 | 43 | 14 | 34 | 32 | 25 | 40 | 12 | 16 | 24 | 39 | 27 |

| 7 |

⇩

Converted Pattern (B):

| 36 | 20 | 37 | 43 | 5 | 35 | 4 | 14 | 22 | 10 | 2 | 34 | 26 | 17 | 38 | 32 | 1 | 41 | 44 | 25 | 13 | 30 |

| 0 | 40 | 3 | 15 | 18 | 12 | 33 | 21 | 19 | 16 | 9 | 42 | 8 | 24 | 6 | 29 | 31 | 39 | 23 | 11 | 28 | 27 |

| 7 |

EP 3 247 043 A1

# FIG. 323

16QAM CR 9/15:

Original Pattern (B):

BIT GROUP

| 4 | 6 | 19 | 2 | 5 | 30 | 20 | 11 | 22 | 12 | 15 | 0 | 36 | 37 | 38 | 39 | 26 | 14 | 34 | 35 | 16 | 13 |
|---|---|----|---|---|----|----|----|----|----|----|---|----|----|----|----|----|----|----|----|----|----|

| 18 | 42 | 7 | 10 | 25 | 43 | 40 | 17 | 41 | 24 | 33 | 31 | 23 | 32 | 21 | 3 | 27 | 28 | 8 | 9 | 29 | 1 |
|----|----|---|----|----|----|----|----|----|----|----|----|----|----|----|---|----|----|---|---|----|---|

| 44 |
|----|

⇩

Converted Pattern (A):

| 4 | 5 | 22 | 36 | 26 | 16 | 7 | 40 | 33 | 21 | 8 | 6 | 30 | 12 | 37 | 14 | 13 | 10 | 17 | 31 | 3 | 9 |
|---|---|----|----|----|----|---|----|----|----|---|---|----|----|----|----|----|----|----|----|---|---|

| 19 | 20 | 15 | 38 | 34 | 18 | 25 | 41 | 23 | 27 | 29 | 2 | 11 | 0 | 39 | 35 | 42 | 43 | 24 | 32 | 28 | 1 |
|----|----|----|----|----|----|----|----|----|----|----|---|----|---|----|----|----|----|----|----|----|---|

| 44 |
|----|

EP 3 247 043 A1

FIG. 324

## FIG. 325

EP 3 247 043 A1

16QAM CR 11/15:

Original Pattern (B):

BIT GROUP

| 2 | 4 | 41 | 8 | 13 | 7 | 0 | 24 | 3 | 22 | 5 | 32 | 10 | 9 | 36 | 37 | 29 | 11 | 25 | 16 | 20 | 21 |

| 35 | 34 | 15 | 1 | 6 | 14 | 27 | 30 | 33 | 12 | 17 | 28 | 23 | 40 | 26 | 31 | 38 | 39 | 18 | 19 | 42 | 43 |

| 44 |

⇩

Converted Pattern (A):

| 2 | 13 | 3 | 10 | 29 | 20 | 15 | 27 | 17 | 26 | 18 | 4 | 7 | 22 | 9 | 11 | 21 | 1 | 30 | 28 | 31 | 19 |

| 41 | 0 | 5 | 36 | 25 | 35 | 6 | 33 | 23 | 38 | 42 | 8 | 24 | 32 | 37 | 16 | 34 | 14 | 12 | 40 | 39 | 43 |

| 44 |

## FIG. 326

16QAM CR 12/15:

Original Pattern (A):                                              BIT GROUP

| 3 | 6 | 7 | 27 | 2 | 23 | 10 | 30 | 22 | 28 | 24 | 20 | 37 | 21 | 4 | 14 | 11 | 42 | 16 | 9 | 15 | 26 |

| 33 | 40 | 5 | 8 | 44 | 34 | 18 | 0 | 32 | 29 | 19 | 41 | 38 | 17 | 25 | 43 | 35 | 36 | 13 | 39 | 12 | 1 |

| 31 |

Converted Pattern (B):

| 3 | 20 | 33 | 41 | 6 | 37 | 40 | 38 | 7 | 21 | 5 | 17 | 27 | 4 | 8 | 25 | 2 | 14 | 44 | 43 | 23 | 11 |

| 34 | 35 | 10 | 42 | 18 | 36 | 30 | 16 | 0 | 13 | 22 | 9 | 32 | 39 | 28 | 15 | 29 | 12 | 24 | 26 | 19 | 1 |

| 31 |

EP 3 247 043 A1

## FIG. 327

16QAM CR 13/15:

Original Pattern (B):

BIT GROUP

| 12 | 7 | 20 | 43 | 29 | 13 | 32 | 30 | 25 | 0 | 17 | 18 | 9 | 1 | 41 | 42 | 6 | 33 | 28 | 14 | 16 | 11 |

| 39 | 40 | 15 | 4 | 23 | 5 | 2 | 24 | 22 | 38 | 10 | 8 | 19 | 34 | 26 | 36 | 37 | 27 | 21 | 31 | 3 | 35 |

| 44 |

⇩

Converted Pattern (A):

| 12 | 29 | 25 | 9 | 6 | 16 | 15 | 2 | 10 | 26 | 21 | 7 | 13 | 0 | 1 | 33 | 11 | 4 | 24 | 8 | 36 | 31 |

| 20 | 32 | 17 | 41 | 28 | 39 | 23 | 22 | 19 | 37 | 3 | 43 | 30 | 18 | 42 | 14 | 40 | 5 | 38 | 34 | 27 | 35 |

| 44 |

## FIG. 328

64QAM CR 2/15:

Original Pattern (A):

BIT GROUP

| 7 | 11 | 4 | 38 | 19 | 25 | 2 | 43 | 15 | 26 | 18 | 14 | 9 | 29 | 44 | 32 | 0 | 5 | 35 | 10 | 1 | 12 |

| 6 | 36 | 21 | 33 | 37 | 34 | 3 | 31 | 20 | 16 | 40 | 23 | 41 | 22 | 30 | 39 | 13 | 24 | 17 | 42 | 28 | 8 |

| 27 |

⬇

Converted Pattern (B):

| 7 | 43 | 44 | 12 | 3 | 22 | 11 | 15 | 32 | 6 | 31 | 30 | 4 | 26 | 0 | 36 | 20 | 39 | 38 | 18 | 5 | 21 |

| 16 | 13 | 19 | 14 | 35 | 33 | 40 | 24 | 25 | 9 | 10 | 37 | 23 | 17 | 2 | 29 | 1 | 34 | 41 | 42 | 28 | 8 |

| 27 |

EP 3 247 043 A1

FIG. 329

64QAM CR 3/15:

Original Pattern (A):

BIT GROUP

| 19 | 34 | 22 | 6 | 29 | 25 | 23 | 36 | 7 | 8 | 24 | 16 | 27 | 43 | 11 | 35 | 5 | 28 | 13 | 4 | 3 | 17 |

| 15 | 38 | 20 | 0 | 26 | 12 | 1 | 39 | 31 | 41 | 44 | 30 | 9 | 21 | 42 | 18 | 14 | 32 | 10 | 2 | 37 | 33 |

| 40 |

⇩

Converted Pattern (B):

| 19 | 36 | 11 | 17 | 1 | 21 | 34 | 7 | 35 | 15 | 39 | 42 | 22 | 8 | 5 | 38 | 31 | 18 | 6 | 24 | 28 | 20 |

| 41 | 14 | 29 | 16 | 13 | 0 | 44 | 32 | 25 | 27 | 4 | 26 | 30 | 10 | 23 | 43 | 3 | 12 | 9 | 2 | 37 | 33 |

| 40 |

EP 3 247 043 A1

# FIG. 330

64QAM CR 4/15:

Original Pattern (A):

BIT GROUP

| 41 | 34 | 32 | 37 | 5 | 8 | 13 | 15 | 30 | 31 | 22 | 25 | 42 | 20 | 23 | 17 | 1 | 40 | 44 | 12 | 6 | 43 |
|----|----|----|----|---|---|----|----|----|----|----|----|----|----|----|----|---|----|----|----|---|----|

| 7 | 29 | 33 | 16 | 11 | 0 | 35 | 4 | 14 | 28 | 21 | 3 | 24 | 19 | 18 | 36 | 10 | 38 | 26 | 2 | 39 | 27 |
|---|----|----|----|----|---|----|---|----|----|----|---|----|----|----|----|----|----|----|---|----|----|

| 9 |
|---|

⇩

Converted Pattern (B):

| 41 | 15 | 23 | 43 | 35 | 19 | 34 | 30 | 17 | 7 | 4 | 18 | 32 | 31 | 1 | 29 | 14 | 36 | 37 | 22 | 40 | 33 |
|----|----|----|----|----|----|----|----|----|---|---|----|----|----|---|----|----|----|----|----|----|----|

| 28 | 10 | 5 | 25 | 44 | 16 | 21 | 38 | 8 | 42 | 12 | 11 | 3 | 26 | 13 | 20 | 6 | 0 | 24 | 2 | 39 | 27 |
|----|----|---|----|----|----|----|----|---|----|----|----|---|----|----|----|---|---|----|---|----|----|

| 9 |
|---|

# FIG. 331

64QAM CR 5/15:

Original Pattern (A):

BIT GROUP

| 25 | 44 | 8 | 39 | 37 | 2 | 11 | 7 | 0 | 12 | 4 | 31 | 33 | 38 | 43 | 21 | 26 | 13 | 28 | 29 | 1 | 27 |
|----|----|---|----|----|---|----|---|---|----|---|----|----|----|----|----|----|----|----|----|---|----|

| 18 | 17 | 34 | 3 | 42 | 10 | 19 | 20 | 32 | 36 | 40 | 9 | 41 | 5 | 35 | 30 | 22 | 15 | 16 | 6 | 24 | 23 |
|----|----|----|---|----|----|----|----|----|----|----|---|----|---|----|----|----|----|----|---|----|----|

| 14 |
|----|

⇩

Converted Pattern (B):

| 25 | 7 | 43 | 27 | 19 | 5 | 44 | 0 | 21 | 18 | 20 | 35 | 8 | 12 | 26 | 17 | 32 | 30 | 39 | 4 | 13 | 34 |
|----|---|----|----|----|---|----|---|----|----|----|----|---|----|----|----|----|----|----|---|----|----|

| 36 | 22 | 37 | 31 | 28 | 3 | 40 | 15 | 2 | 33 | 29 | 42 | 9 | 16 | 11 | 38 | 1 | 10 | 41 | 6 | 24 | 23 |
|----|----|----|----|----|---|----|----|---|----|----|----|---|----|----|----|---|----|----|---|----|----|

| 14 |
|----|

## FIG. 332

64QAM CR 6/15:

Original Pattern (B):

BIT GROUP

| 31 | 12 | 39 | 32 | 30 | 24 | 28 | 15 | 38 | 23 | 27 | 41 | 0 | 6 | 17 | 37 | 42 | 20 | 11 | 4 | 40 | 2 |
|----|----|----|----|----|----|----|----|----|----|----|----|----|----|----|----|----|----|----|----|----|----|

| 3 | 26 | 10 | 7 | 13 | 25 | 1 | 18 | 8 | 5 | 14 | 36 | 35 | 33 | 22 | 9 | 44 | 16 | 34 | 19 | 21 | 29 |
|----|----|----|----|----|----|----|----|----|----|----|----|----|----|----|----|----|----|----|----|----|----|

| 43 |
|----|

⇩

Converted Pattern (A):

| 31 | 28 | 0 | 11 | 10 | 8 | 22 | 12 | 15 | 6 | 4 | 7 | 5 | 9 | 39 | 38 | 17 | 40 | 13 | 14 | 44 | 32 |
|----|----|----|----|----|----|----|----|----|----|----|----|----|----|----|----|----|----|----|----|----|----|----|

| 23 | 37 | 2 | 25 | 36 | 16 | 30 | 27 | 42 | 3 | 1 | 35 | 34 | 24 | 41 | 20 | 26 | 18 | 33 | 19 | 21 | 29 |
|----|----|----|----|----|----|----|----|----|----|----|----|----|----|----|----|----|----|----|----|----|----|----|

| 43 |
|----|

EP 3 247 043 A1

# FIG. 333

64QAM CR 7/15:

Original Pattern (B):

BIT GROUP

| 2 | 14 | 10 | 0 | 37 | 42 | 38 | 40 | 24 | 29 | 28 | 35 | 18 | 16 | 20 | 27 | 41 | 30 | 15 | 19 | 9 | 43 |

| 25 | 3 | 6 | 7 | 31 | 32 | 26 | 36 | 17 | 1 | 13 | 5 | 39 | 33 | 4 | 8 | 23 | 22 | 11 | 34 | 44 | 12 |

| 21 |

⇩

Converted Pattern (A):

| 2 | 38 | 18 | 15 | 6 | 17 | 4 | 14 | 40 | 16 | 19 | 7 | 1 | 8 | 10 | 24 | 20 | 9 | 31 | 13 | 23 | 0 |

| 29 | 27 | 43 | 32 | 5 | 22 | 37 | 28 | 41 | 25 | 26 | 39 | 11 | 42 | 35 | 30 | 3 | 36 | 33 | 34 | 44 | 12 |

| 21 |

EP 3 247 043 A1

## FIG. 334

64QAM CR 8/15:

Original Pattern (A):

BIT GROUP

| 36 | 6 | 2 | 20 | 43 | 17 | 33 | 22 | 23 | 25 | 13 | 0 | 10 | 7 | 21 | 1 | 19 | 26 | 8 | 14 | 31 | 35 |

| 16 | 5 | 29 | 40 | 11 | 9 | 4 | 34 | 15 | 42 | 32 | 28 | 18 | 37 | 30 | 39 | 24 | 41 | 3 | 38 | 27 | 12 |

| 44 |

⇩

Converted Pattern (B):

| 36 | 22 | 21 | 35 | 4 | 37 | 6 | 23 | 1 | 16 | 34 | 30 | 2 | 25 | 19 | 5 | 15 | 39 | 20 | 13 | 26 | 29 |

| 42 | 24 | 43 | 0 | 8 | 40 | 32 | 41 | 17 | 10 | 14 | 11 | 28 | 3 | 33 | 7 | 31 | 9 | 18 | 38 | 27 | 12 |

| 44 |

EP 3 247 043 A1

## FIG. 335

EP 3 247 043 A1

64QAM CR 9/15:

Original Pattern (B):                                                                                                    BIT GROUP

| 21 | 5 | 43 | 38 | 40 | 1 | 3 | 17 | 11 | 37 | 10 | 41 | 9 | 15 | 25 | 44 | 14 | 27 | 7 | 18 | 20 | 35 |

| 16 | 0 | 6 | 19 | 8 | 22 | 29 | 28 | 34 | 31 | 33 | 30 | 32 | 42 | 13 | 4 | 24 | 26 | 36 | 2 | 23 | 12 |

| 39 |

⇩

Converted Pattern (A):

| 21 | 3 | 9 | 7 | 6 | 34 | 13 | 5 | 17 | 15 | 18 | 19 | 31 | 4 | 43 | 11 | 25 | 20 | 8 | 33 | 24 | 38 |

| 37 | 44 | 35 | 22 | 30 | 26 | 40 | 10 | 14 | 16 | 29 | 32 | 36 | 1 | 41 | 27 | 0 | 28 | 42 | 2 | 23 | 12 |

| 39 |

# FIG. 336

64QAM CR 10/15:

Original Pattern (A):                                                                          BIT GROUP

| 14 | 22 | 18 | 11 | 28 | 26 | 2 | 38 | 10 | 0 | 5 | 12 | 24 | 17 | 29 | 16 | 39 | 13 | 23 | 8 | 25 | 43 |

| 34 | 33 | 27 | 15 | 7 | 1 | 9 | 35 | 40 | 32 | 30 | 20 | 36 | 31 | 21 | 41 | 44 | 3 | 42 | 6 | 19 | 37 |

| 4 |

Converted Pattern (B):

| 14 | 38 | 29 | 43 | 9 | 31 | 22 | 10 | 16 | 34 | 35 | 21 | 18 | 0 | 39 | 33 | 40 | 41 | 11 | 5 | 13 | 27 |

| 32 | 44 | 28 | 12 | 23 | 15 | 30 | 3 | 26 | 24 | 8 | 7 | 20 | 42 | 2 | 17 | 25 | 1 | 36 | 6 | 19 | 37 |

| 4 |

EP 3 247 043 A1

# FIG. 337

64QAM CR 11/15:

Original Pattern (A):

BIT GROUP

| 31 | 20 | 21 | 25 | 4 | 16 | 9 | 3 | 17 | 24 | 5 | 10 | 12 | 28 | 6 | 19 | 8 | 15 | 13 | 11 | 29 | 22 |

| 27 | 14 | 23 | 34 | 26 | 18 | 42 | 2 | 37 | 44 | 39 | 33 | 35 | 41 | 0 | 36 | 7 | 40 | 38 | 1 | 30 | 32 |

| 43 |

⇩

Converted Pattern (B):

| 31 | 3 | 6 | 22 | 42 | 41 | 20 | 17 | 19 | 27 | 2 | 0 | 21 | 24 | 8 | 14 | 37 | 36 | 25 | 5 | 15 | 23 |

| 44 | 7 | 4 | 10 | 13 | 34 | 39 | 40 | 16 | 12 | 11 | 26 | 33 | 38 | 9 | 28 | 29 | 18 | 35 | 1 | 30 | 32 |

| 43 |

EP 3 247 043 A1

# FIG. 338

64QAM CR 12/15:

Original Pattern (A):

BIT GROUP

| 17 | 11 | 14 | 7 | 31 | 10 | 2 | 26 | 0 | 32 | 29 | 22 | 33 | 12 | 20 | 28 | 27 | 39 | 37 | 15 | 4 | 5 |

| 8 | 13 | 38 | 18 | 23 | 34 | 24 | 6 | 1 | 9 | 16 | 44 | 21 | 3 | 36 | 30 | 40 | 35 | 43 | 42 | 25 | 19 |

| 41 |

⇩

Converted Pattern (B):

| 17 | 26 | 20 | 5 | 24 | 3 | 11 | 0 | 28 | 8 | 6 | 36 | 14 | 32 | 27 | 13 | 1 | 30 | 7 | 29 | 39 | 38 |

| 9 | 40 | 31 | 22 | 37 | 18 | 16 | 35 | 10 | 33 | 15 | 23 | 44 | 43 | 2 | 12 | 4 | 34 | 21 | 42 | 25 | 19 |

| 41 |

EP 3 247 043 A1

# FIG. 339

64QAM CR 13/15:

Original Pattern (A):

BIT GROUP

| 9 | 7 | 15 | 10 | 11 | 12 | 13 | 6 | 21 | 17 | 14 | 20 | 26 | 8 | 25 | 32 | 34 | 23 | 2 | 4 | 31 | 18 |

| 5 | 27 | 29 | 3 | 38 | 36 | 39 | 43 | 41 | 42 | 40 | 44 | 1 | 28 | 33 | 22 | 16 | 19 | 24 | 0 | 30 | 35 |

| 37 |

⇩

Converted Pattern (B):

| 9 | 6 | 25 | 18 | 39 | 28 | 7 | 21 | 32 | 5 | 43 | 33 | 15 | 17 | 34 | 27 | 41 | 22 | 10 | 14 | 23 | 29 |

| 42 | 16 | 11 | 20 | 2 | 3 | 40 | 19 | 12 | 26 | 4 | 38 | 44 | 24 | 13 | 8 | 31 | 36 | 1 | 0 | 30 | 35 |

| 37 |

EP 3 247 043 A1

# FIG. 340

256QAM CR 2/15:

Original Pattern (A):

BIT GROUP

| 31 | 3 | 38 | 9 | 34 | 6 | 4 | 18 | 15 | 1 | 21 | 19 | 42 | 20 | 12 | 13 | 30 | 26 | 14 | 2 | 10 | 35 |

| 28 | 44 | 23 | 11 | 22 | 16 | 29 | 40 | 27 | 37 | 25 | 41 | 5 | 43 | 39 | 36 | 7 | 24 | 32 | 17 | 33 | 8 |

| 0 |

⇩

Converted Pattern (B):

| 31 | 6 | 21 | 13 | 10 | 11 | 27 | 43 | 3 | 4 | 19 | 30 | 35 | 22 | 37 | 39 | 38 | 18 | 42 | 26 | 28 | 16 |

| 25 | 36 | 9 | 15 | 20 | 14 | 44 | 29 | 41 | 7 | 34 | 1 | 12 | 2 | 23 | 40 | 5 | 24 | 32 | 17 | 33 | 8 |

| 0 |

EP 3 247 043 A1

## FIG. 341

256QAM CR 3/15:

Original Pattern (A):

BIT GROUP

| 5 | 22 | 23 | 26 | 29 | 27 | 16 | 1 | 4 | 25 | 41 | 21 | 12 | 2 | 6 | 8 | 7 | 19 | 44 | 42 | 39 | 40 |

| 43 | 35 | 10 | 28 | 13 | 15 | 37 | 32 | 3 | 24 | 36 | 38 | 11 | 18 | 33 | 30 | 14 | 9 | 34 | 20 | 0 | 17 |

| 31 |

⇩

Converted Pattern (B):

| 5 | 27 | 41 | 8 | 39 | 28 | 3 | 18 | 22 | 16 | 21 | 7 | 40 | 13 | 24 | 33 | 23 | 1 | 12 | 19 | 43 | 15 |

| 36 | 30 | 26 | 4 | 2 | 44 | 35 | 37 | 38 | 14 | 29 | 25 | 6 | 42 | 10 | 32 | 11 | 9 | 34 | 20 | 0 | 17 |

| 31 |

EP 3 247 043 A1

## FIG. 342

256QAM CR 4/15:

Original Pattern (A):

BIT GROUP

| 38 | 20 | 0 | 34 | 33 | 41 | 14 | 30 | 44 | 7 | 37 | 8 | 4 | 9 | 43 | 15 | 19 | 32 | 23 | 5 | 22 | 26 |

| 10 | 12 | 3 | 31 | 36 | 21 | 24 | 11 | 16 | 18 | 17 | 29 | 35 | 42 | 13 | 40 | 1 | 28 | 2 | 25 | 6 | 39 |

| 27 |

⇩

Converted Pattern (B):

| 38 | 41 | 37 | 15 | 22 | 31 | 16 | 42 | 20 | 14 | 8 | 19 | 26 | 36 | 18 | 13 | 0 | 30 | 4 | 32 | 10 | 21 |

| 17 | 40 | 34 | 44 | 9 | 23 | 12 | 24 | 29 | 1 | 33 | 7 | 43 | 5 | 3 | 11 | 35 | 28 | 2 | 25 | 6 | 39 |

| 27 |

EP 3 247 043 A1

# FIG. 343

256QAM CR 5/15:

Original Pattern (A):

BIT GROUP

| 4 | 23 | 3 | 6 | 18 | 5 | 0 | 2 | 7 | 26 | 21 | 27 | 39 | 42 | 38 | 31 | 1 | 34 | 20 | 37 | 40 | 24 |

| 43 | 25 | 33 | 9 | 22 | 36 | 30 | 35 | 11 | 10 | 17 | 32 | 13 | 12 | 41 | 15 | 14 | 19 | 16 | 8 | 44 | 29 |

| 28 |

Converted Pattern (B):

| 4 | 5 | 21 | 31 | 40 | 9 | 11 | 12 | 23 | 0 | 27 | 1 | 24 | 22 | 10 | 41 | 3 | 2 | 39 | 34 | 43 | 36 |

| 17 | 15 | 6 | 7 | 42 | 20 | 25 | 30 | 32 | 14 | 18 | 26 | 38 | 37 | 33 | 35 | 13 | 19 | 16 | 8 | 44 | 29 |

| 28 |

EP 3 247 043 A1

# FIG. 344

256QAM CR 6/15:

Original Pattern (B):

BIT GROUP

| 17 | 13 | 25 | 24 | 14 | 21 | 1 | 37 | 2 | 3 | 11 | 22 | 18 | 5 | 10 | 23 | 12 | 4 | 26 | 16 | 38 | 36 |
|----|----|----|----|----|----|---|----|---|---|----|----|----|---|----|----|----|---|----|----|----|----|

| 33 | 39 | 0 | 6 | 7 | 31 | 32 | 34 | 27 | 35 | 15 | 9 | 30 | 28 | 19 | 8 | 20 | 29 | 40 | 41 | 42 | 43 |
|----|----|---|---|---|----|----|----|----|----|----|---|----|----|----|---|----|----|----|----|----|----|

| 44 |
|----|

Converted Pattern (A):

| 17 | 2 | 12 | 0 | 15 | 13 | 3 | 4 | 6 | 9 | 25 | 11 | 26 | 7 | 30 | 24 | 22 | 16 | 31 | 28 | 14 | 18 |
|----|---|----|---|----|----|---|---|---|---|----|----|----|---|----|----|----|----|----|----|----|----|

| 38 | 32 | 19 | 21 | 5 | 36 | 34 | 8 | 1 | 10 | 33 | 27 | 20 | 37 | 23 | 39 | 35 | 29 | 40 | 41 | 42 | 43 |
|----|----|----|----|---|----|----|---|---|----|----|----|----|----|----|----|----|----|----|----|----|----|

| 44 |
|----|

EP 3 247 043 A1

## FIG. 345

EP 3 247 043 A1

256QAM CR 7/15:

Original Pattern (A):

BIT GROUP

| 13 | 16 | 4 | 12 | 44 | 15 | 8 | 14 | 0 | 3 | 30 | 20 | 35 | 21 | 10 | 6 | 19 | 17 | 26 | 39 | 7 | 24 |

| 9 | 27 | 5 | 37 | 23 | 32 | 40 | 31 | 38 | 42 | 34 | 25 | 36 | 2 | 22 | 43 | 33 | 28 | 1 | 18 | 11 | 41 |

| 29 |

⇩

Converted Pattern (B):

| 13 | 15 | 30 | 6 | 7 | 37 | 38 | 2 | 16 | 8 | 20 | 19 | 24 | 23 | 42 | 22 | 4 | 14 | 35 | 17 | 9 | 32 |

| 34 | 43 | 12 | 0 | 21 | 26 | 27 | 40 | 25 | 33 | 44 | 3 | 10 | 39 | 5 | 31 | 36 | 28 | 1 | 18 | 11 | 41 |

| 29 |

## FIG. 346

256QAM CR 8/15:

Original Pattern (A):

BIT GROUP

| 41 | 2 | 12 | 6 | 33 | 1 | 13 | 11 | 26 | 10 | 39 | 43 | 36 | 23 | 42 | 7 | 44 | 20 | 8 | 38 | 18 | 22 |

| 24 | 40 | 4 | 28 | 29 | 19 | 14 | 5 | 9 | 0 | 30 | 25 | 35 | 37 | 27 | 32 | 31 | 34 | 21 | 3 | 15 | 17 |

| 16 |

⇩

Converted Pattern (B):

| 41 | 1 | 39 | 7 | 18 | 28 | 9 | 37 | 2 | 13 | 43 | 44 | 22 | 29 | 0 | 27 | 12 | 11 | 36 | 20 | 24 | 19 |

| 30 | 32 | 6 | 26 | 23 | 8 | 40 | 14 | 25 | 31 | 33 | 10 | 42 | 38 | 4 | 5 | 35 | 34 | 21 | 3 | 15 | 17 |

| 16 |

EP 3 247 043 A1

# FIG. 347

256QAM CR 9/15:

Original Pattern (A):

BIT GROUP

| 5 | 7 | 9 | 22 | 10 | 12 | 3 | 43 | 6 | 4 | 24 | 13 | 14 | 11 | 15 | 18 | 19 | 17 | 16 | 41 | 25 | 26 |
|---|---|---|----|----|----|---|----|---|---|----|----|----|----|----|----|----|----|----|----|----|----|

| 20 | 23 | 21 | 33 | 31 | 28 | 39 | 36 | 30 | 37 | 27 | 32 | 34 | 35 | 29 | 2 | 42 | 0 | 1 | 8 | 40 | 38 |
|----|----|----|----|----|----|----|----|----|----|----|----|----|----|----|---|----|---|---|---|----|----|

| 44 |
|----|

⇩

Converted Pattern (B):

| 5 | 12 | 24 | 18 | 25 | 33 | 30 | 35 | 7 | 3 | 13 | 19 | 26 | 31 | 37 | 29 | 9 | 43 | 14 | 17 | 20 | 28 |
|---|----|----|----|----|----|----|----|---|---|----|----|----|----|----|----|---|----|----|----|----|----|

| 27 | 2 | 22 | 6 | 11 | 16 | 23 | 39 | 32 | 42 | 10 | 4 | 15 | 41 | 21 | 36 | 34 | 0 | 1 | 8 | 40 | 38 |
|----|---|----|---|----|----|----|----|----|----|----|---|----|----|----|----|----|---|---|---|----|----|

| 44 |
|----|

EP 3 247 043 A1

## FIG. 348

EP 3 247 043 A1

256QAM CR 10/15:

Original Pattern (A):

BIT GROUP

| 28 | 20 | 18 | 38 | 39 | 2 | 3 | 30 | 19 | 4 | 14 | 36 | 7 | 0 | 25 | 17 | 10 | 6 | 33 | 15 | 8 | 26 |

| 42 | 24 | 11 | 21 | 23 | 5 | 40 | 41 | 29 | 32 | 37 | 44 | 43 | 31 | 35 | 34 | 22 | 1 | 16 | 27 | 9 | 13 |

| 12 |

⇩

Converted Pattern (B):

| 28 | 2 | 14 | 17 | 8 | 21 | 29 | 31 | 20 | 3 | 36 | 10 | 26 | 23 | 32 | 35 | 18 | 30 | 7 | 6 | 42 | 5 |

| 37 | 34 | 38 | 19 | 0 | 33 | 24 | 40 | 44 | 22 | 39 | 4 | 25 | 15 | 11 | 41 | 43 | 1 | 16 | 27 | 9 | 13 |

| 12 |

# FIG. 349

256QAM CR 11/15:

Original Pattern (B):

BIT GROUP

| 8 | 13 | 0 | 11 | 9 | 4 | 36 | 37 | 16 | 3 | 10 | 14 | 24 | 20 | 33 | 34 | 25 | 2 | 21 | 31 | 12 | 19 |

| 7 | 5 | 27 | 23 | 26 | 1 | 18 | 22 | 35 | 6 | 32 | 30 | 28 | 15 | 29 | 17 | 39 | 38 | 40 | 41 | 42 | 43 |

| 44 |

⇩

Converted Pattern (A):

| 8 | 16 | 25 | 27 | 32 | 13 | 3 | 2 | 23 | 30 | 0 | 10 | 21 | 26 | 28 | 11 | 14 | 31 | 1 | 15 | 9 | 24 |

| 12 | 18 | 29 | 4 | 20 | 19 | 22 | 17 | 36 | 33 | 7 | 35 | 39 | 37 | 34 | 5 | 6 | 38 | 40 | 41 | 42 | 43 |

| 44 |

EP 3 247 043 A1

## FIG. 350

256QAM CR 12/15:

Original Pattern (A):

BIT GROUP

| 28 | 21 | 10 | 15 | 8 | 22 | 26 | 2 | 14 | 1 | 27 | 3 | 39 | 20 | 34 | 25 | 12 | 6 | 7 | 40 | 30 | 29 |

| 38 | 16 | 43 | 33 | 4 | 35 | 9 | 32 | 5 | 36 | 0 | 41 | 37 | 18 | 17 | 13 | 24 | 42 | 31 | 23 | 19 | 11 |

| 44 |

⇩

Converted Pattern (B):

| 28 | 22 | 27 | 25 | 30 | 33 | 5 | 18 | 21 | 26 | 3 | 12 | 29 | 4 | 36 | 17 | 10 | 2 | 39 | 6 | 38 | 35 |

| 0 | 13 | 15 | 14 | 20 | 7 | 16 | 9 | 41 | 24 | 8 | 1 | 34 | 40 | 43 | 32 | 37 | 42 | 31 | 23 | 19 | 11 |

| 44 |

EP 3 247 043 A1

# FIG. 351

256QAM CR 13/15:

Original Pattern (A):

BIT GROUP

| 9 | 13 | 10 | 7 | 11 | 6 | 1 | 14 | 12 | 8 | 21 | 15 | 4 | 36 | 25 | 30 | 24 | 28 | 29 | 20 | 27 | 5 |

| 18 | 17 | 22 | 33 | 0 | 16 | 23 | 31 | 42 | 3 | 40 | 39 | 41 | 43 | 37 | 44 | 26 | 2 | 19 | 38 | 32 | 35 |

| 34 |

Converted Pattern (B):

| 9 | 6 | 21 | 30 | 27 | 33 | 42 | 43 | 13 | 1 | 15 | 24 | 5 | 0 | 3 | 37 | 10 | 14 | 4 | 28 | 18 | 16 |

| 40 | 44 | 7 | 12 | 36 | 29 | 17 | 23 | 39 | 26 | 11 | 8 | 25 | 20 | 22 | 31 | 41 | 2 | 19 | 38 | 32 | 35 |

| 34 |

FIG. 352

QPSK 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

Pattern B:

| 0 | 90 | 1 | 91 | 2 | 92 | 3 | 93 | 4 | 94 | 5 | 95 | 6 | 96 | 7 | 97 | 8 | 98 | 9 | 99 | 10 | 100 |
|---|----|---|----|---|----|---|----|---|----|---|----|---|----|---|----|---|----|---|----|----|-----|
| 11 | 101 | 12 | 102 | 13 | 103 | 14 | 104 | 15 | 105 | 16 | 106 | 17 | 107 | 18 | 108 | 19 | 109 | 20 | 110 | 21 | 111 |
| 22 | 112 | 23 | 113 | 24 | 114 | 25 | 115 | 26 | 116 | 27 | 117 | 28 | 118 | 29 | 119 | 30 | 120 | 31 | 121 | 32 | 122 |
| 33 | 123 | 34 | 124 | 35 | 125 | 36 | 126 | 37 | 127 | 38 | 128 | 39 | 129 | 40 | 130 | 41 | 131 | 42 | 132 | 43 | 133 |
| 44 | 134 | 45 | 135 | 46 | 136 | 47 | 137 | 48 | 138 | 49 | 139 | 50 | 140 | 51 | 141 | 52 | 142 | 53 | 143 | 54 | 144 |
| 55 | 145 | 56 | 146 | 57 | 147 | 58 | 148 | 59 | 149 | 60 | 150 | 61 | 151 | 62 | 152 | 63 | 153 | 64 | 154 | 65 | 155 |
| 66 | 156 | 67 | 157 | 68 | 158 | 69 | 159 | 70 | 160 | 71 | 161 | 72 | 162 | 73 | 163 | 74 | 164 | 75 | 165 | 76 | 166 |
| 77 | 167 | 78 | 168 | 79 | 169 | 80 | 170 | 81 | 171 | 82 | 172 | 83 | 173 | 84 | 174 | 85 | 175 | 86 | 176 | 87 | 177 |
| 88 | 178 | 89 | 179 | | | | | | | | | | | | | | | | | | |

EP 3 247 043 A1

# FIG. 353

16QAM 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇩

Pattern B:

| 0 | 45 | 90 | 135 | 1 | 46 | 91 | 136 | 2 | 47 | 92 | 137 | 3 | 48 | 93 | 138 | 4 | 49 | 94 | 139 | 5 | 50 |
|---|----|----|-----|---|----|----|-----|---|----|----|-----|---|----|----|-----|---|----|----|-----|---|----|
| 95 | 140 | 6 | 51 | 96 | 141 | 7 | 52 | 97 | 142 | 8 | 53 | 98 | 143 | 9 | 54 | 99 | 144 | 10 | 55 | 100 | 145 |
| 11 | 56 | 101 | 146 | 12 | 57 | 102 | 147 | 13 | 58 | 103 | 148 | 14 | 59 | 104 | 149 | 15 | 60 | 105 | 150 | 16 | 61 |
| 106 | 151 | 17 | 62 | 107 | 152 | 18 | 63 | 108 | 153 | 19 | 64 | 109 | 154 | 20 | 65 | 110 | 155 | 21 | 66 | 111 | 156 |
| 22 | 67 | 112 | 157 | 23 | 68 | 113 | 158 | 24 | 69 | 114 | 159 | 25 | 70 | 115 | 160 | 26 | 71 | 116 | 161 | 27 | 72 |
| 117 | 162 | 28 | 73 | 118 | 163 | 29 | 74 | 119 | 164 | 30 | 75 | 120 | 165 | 31 | 76 | 121 | 166 | 32 | 77 | 122 | 167 |
| 33 | 78 | 123 | 168 | 34 | 79 | 124 | 169 | 35 | 80 | 125 | 170 | 36 | 81 | 126 | 171 | 37 | 82 | 127 | 172 | 38 | 83 |
| 128 | 173 | 39 | 84 | 129 | 174 | 40 | 85 | 130 | 175 | 41 | 86 | 131 | 176 | 42 | 87 | 132 | 177 | 43 | 88 | 133 | 178 |
| 44 | 89 | 134 | 179 | | | | | | | | | | | | | | | | | | |

# FIG. 354

64QAM 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

Pattern B:

| 0 | 30 | 60 | 90 | 120 | 150 | 1 | 31 | 61 | 91 | 121 | 151 | 2 | 32 | 62 | 92 | 122 | 152 | 3 | 33 | 63 | 93 |
|---|----|----|----|-----|-----|---|----|----|----|-----|-----|---|----|----|----|-----|-----|---|----|----|----|
| 123 | 153 | 4 | 34 | 64 | 94 | 124 | 154 | 5 | 35 | 65 | 95 | 125 | 155 | 6 | 36 | 66 | 96 | 126 | 156 | 7 | 37 |
| 67 | 97 | 127 | 157 | 8 | 38 | 68 | 98 | 128 | 158 | 9 | 39 | 69 | 99 | 129 | 159 | 10 | 40 | 70 | 100 | 130 | 160 |
| 11 | 41 | 71 | 101 | 131 | 161 | 12 | 42 | 72 | 102 | 132 | 162 | 13 | 43 | 73 | 103 | 133 | 163 | 14 | 44 | 74 | 104 |
| 134 | 164 | 15 | 45 | 75 | 105 | 135 | 165 | 16 | 46 | 76 | 106 | 136 | 166 | 17 | 47 | 77 | 107 | 137 | 167 | 18 | 48 |
| 78 | 108 | 138 | 168 | 19 | 49 | 79 | 109 | 139 | 169 | 20 | 50 | 80 | 110 | 140 | 170 | 21 | 51 | 81 | 111 | 141 | 171 |
| 22 | 52 | 82 | 112 | 142 | 172 | 23 | 53 | 83 | 113 | 143 | 173 | 24 | 54 | 84 | 114 | 144 | 174 | 25 | 55 | 85 | 115 |
| 145 | 175 | 26 | 56 | 86 | 116 | 146 | 176 | 27 | 57 | 87 | 117 | 147 | 177 | 28 | 58 | 88 | 118 | 148 | 178 | 29 | 59 |
| 89 | 119 | 149 | 179 | | | | | | | | | | | | | | | | | | |

# FIG. 355

256QAM 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

⇩

Pattern B:

| 0 | 22 | 44 | 66 | 88 | 110 | 132 | 154 | 1 | 23 | 45 | 67 | 89 | 111 | 133 | 155 | 2 | 24 | 46 | 68 | 90 | 112 |
|---|---|---|---|---|---|---|---|---|---|---|---|---|---|---|---|---|---|---|---|---|---|
| 134 | 156 | 3 | 25 | 47 | 69 | 91 | 113 | 135 | 157 | 4 | 26 | 48 | 70 | 92 | 114 | 136 | 158 | 5 | 27 | 49 | 71 |
| 93 | 115 | 137 | 159 | 6 | 28 | 50 | 72 | 94 | 116 | 138 | 160 | 7 | 29 | 51 | 73 | 95 | 117 | 139 | 161 | 8 | 30 |
| 52 | 74 | 96 | 118 | 140 | 162 | 9 | 31 | 53 | 75 | 97 | 119 | 141 | 163 | 10 | 32 | 54 | 76 | 98 | 120 | 142 | 164 |
| 11 | 33 | 55 | 77 | 99 | 121 | 143 | 165 | 12 | 34 | 56 | 78 | 100 | 122 | 144 | 166 | 13 | 35 | 57 | 79 | 101 | 123 |
| 145 | 167 | 14 | 36 | 58 | 80 | 102 | 124 | 146 | 168 | 15 | 37 | 59 | 81 | 103 | 125 | 147 | 169 | 16 | 38 | 60 | 82 |
| 104 | 126 | 148 | 170 | 17 | 39 | 61 | 83 | 105 | 127 | 149 | 171 | 18 | 40 | 62 | 84 | 106 | 128 | 150 | 172 | 19 | 41 |
| 63 | 85 | 107 | 129 | 151 | 173 | 20 | 42 | 64 | 86 | 108 | 130 | 152 | 174 | 21 | 43 | 65 | 87 | 109 | 131 | 153 | 175 |
| 176 | 177 | 178 | 179 | | | | | | | | | | | | | | | | | | |

## FIG. 356

1024QAM 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|---|---|---|---|---|---|---|---|---|---|---|---|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

Pattern B:

| 0 | 18 | 36 | 54 | 72 | 90 | 108 | 126 | 144 | 162 | 1 | 19 | 37 | 55 | 73 | 91 | 109 | 127 | 145 | 163 | 2 | 20 |
|---|---|---|---|---|---|---|---|---|---|---|---|---|---|---|---|---|---|---|---|---|---|
| 38 | 56 | 74 | 92 | 110 | 128 | 146 | 164 | 3 | 21 | 39 | 57 | 75 | 93 | 111 | 129 | 147 | 165 | 4 | 22 | 40 | 58 |
| 76 | 94 | 112 | 130 | 148 | 166 | 5 | 23 | 41 | 59 | 77 | 95 | 113 | 131 | 149 | 167 | 6 | 24 | 42 | 60 | 78 | 96 |
| 114 | 132 | 150 | 168 | 7 | 25 | 43 | 61 | 79 | 97 | 115 | 133 | 151 | 169 | 8 | 26 | 44 | 62 | 80 | 98 | 116 | 134 |
| 152 | 170 | 9 | 27 | 45 | 63 | 81 | 99 | 117 | 135 | 153 | 171 | 10 | 28 | 46 | 64 | 82 | 100 | 118 | 136 | 154 | 172 |
| 11 | 29 | 47 | 65 | 83 | 101 | 119 | 137 | 155 | 173 | 12 | 30 | 48 | 66 | 84 | 102 | 120 | 138 | 156 | 174 | 13 | 31 |
| 49 | 67 | 85 | 103 | 121 | 139 | 157 | 175 | 14 | 32 | 50 | 68 | 86 | 104 | 122 | 140 | 158 | 176 | 15 | 33 | 51 | 69 |
| 87 | 105 | 123 | 141 | 159 | 177 | 16 | 34 | 52 | 70 | 88 | 106 | 124 | 142 | 160 | 178 | 17 | 35 | 53 | 71 | 89 | 107 |
| 125 | 143 | 161 | 179 | | | | | | | | | | | | | | | | | | |

# FIG. 357

4096QAM 64k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|
| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
| 44 | 45 | 46 | 47 | 48 | 49 | 50 | 51 | 52 | 53 | 54 | 55 | 56 | 57 | 58 | 59 | 60 | 61 | 62 | 63 | 64 | 65 |
| 66 | 67 | 68 | 69 | 70 | 71 | 72 | 73 | 74 | 75 | 76 | 77 | 78 | 79 | 80 | 81 | 82 | 83 | 84 | 85 | 86 | 87 |
| 88 | 89 | 90 | 91 | 92 | 93 | 94 | 95 | 96 | 97 | 98 | 99 | 100 | 101 | 102 | 103 | 104 | 105 | 106 | 107 | 108 | 109 |
| 110 | 111 | 112 | 113 | 114 | 115 | 116 | 117 | 118 | 119 | 120 | 121 | 122 | 123 | 124 | 125 | 126 | 127 | 128 | 129 | 130 | 131 |
| 132 | 133 | 134 | 135 | 136 | 137 | 138 | 139 | 140 | 141 | 142 | 143 | 144 | 145 | 146 | 147 | 148 | 149 | 150 | 151 | 152 | 153 |
| 154 | 155 | 156 | 157 | 158 | 159 | 160 | 161 | 162 | 163 | 164 | 165 | 166 | 167 | 168 | 169 | 170 | 171 | 172 | 173 | 174 | 175 |
| 176 | 177 | 178 | 179 | | | | | | | | | | | | | | | | | | |

Pattern B:

| 0 | 15 | 30 | 45 | 60 | 75 | 90 | 105 | 120 | 135 | 150 | 165 | 1 | 16 | 31 | 46 | 61 | 76 | 91 | 106 | 121 | 136 |
|---|----|----|----|----|----|----|-----|-----|-----|-----|-----|---|----|----|----|----|----|----|-----|-----|-----|
| 151 | 166 | 2 | 17 | 32 | 47 | 62 | 77 | 92 | 107 | 122 | 137 | 152 | 167 | 3 | 18 | 33 | 48 | 63 | 78 | 93 | 108 |
| 123 | 138 | 153 | 168 | 4 | 19 | 34 | 49 | 64 | 79 | 94 | 109 | 124 | 139 | 154 | 169 | 5 | 20 | 35 | 50 | 65 | 80 |
| 95 | 110 | 125 | 140 | 155 | 170 | 6 | 21 | 36 | 51 | 66 | 81 | 96 | 111 | 126 | 141 | 156 | 171 | 7 | 22 | 37 | 52 |
| 67 | 82 | 97 | 112 | 127 | 142 | 157 | 172 | 8 | 23 | 38 | 53 | 68 | 83 | 98 | 113 | 128 | 143 | 158 | 173 | 9 | 24 |
| 39 | 54 | 69 | 84 | 99 | 114 | 129 | 144 | 159 | 174 | 10 | 25 | 40 | 55 | 70 | 85 | 100 | 115 | 130 | 145 | 160 | 175 |
| 11 | 26 | 41 | 56 | 71 | 86 | 101 | 116 | 131 | 146 | 161 | 176 | 12 | 27 | 42 | 57 | 72 | 87 | 102 | 117 | 132 | 147 |
| 162 | 177 | 13 | 28 | 43 | 58 | 73 | 88 | 103 | 118 | 133 | 148 | 163 | 178 | 14 | 29 | 44 | 59 | 74 | 89 | 104 | 119 |
| 134 | 149 | 164 | 179 | | | | | | | | | | | | | | | | | | |

## FIG. 358

QPSK 16k:

Pattern A:                                                                BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇩

Pattern B:

| 0 | 22 | 1 | 23 | 2 | 24 | 3 | 25 | 4 | 26 | 5 | 27 | 6 | 28 | 7 | 29 | 8 | 30 | 9 | 31 | 10 | 32 |

| 11 | 33 | 12 | 34 | 13 | 35 | 14 | 36 | 15 | 37 | 16 | 38 | 17 | 39 | 18 | 40 | 19 | 41 | 20 | 42 | 21 | 43 |

| 44 |

## FIG. 359

16QAM 16k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 |
|----|

⇩

Pattern B:

| 0 | 11 | 22 | 33 | 1 | 12 | 23 | 34 | 2 | 13 | 24 | 35 | 3 | 14 | 25 | 36 | 4 | 15 | 26 | 37 | 5 | 16 |
|---|----|----|----|---|----|----|----|---|----|----|----|---|----|----|----|---|----|----|----|---|----|

| 27 | 38 | 6 | 17 | 28 | 39 | 7 | 18 | 29 | 40 | 8 | 19 | 30 | 41 | 9 | 20 | 31 | 42 | 10 | 21 | 32 | 43 |
|----|----|---|----|----|----|---|----|----|----|---|----|----|----|---|----|----|----|----|----|----|----|

| 44 |
|----|

EP 3 247 043 A1

## FIG. 360

64QAM 16k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |

| 44 |

⇩

Pattern B:

| 0 | 7 | 14 | 21 | 28 | 35 | 1 | 8 | 15 | 22 | 29 | 36 | 2 | 9 | 16 | 23 | 30 | 37 | 3 | 10 | 17 | 24 |

| 31 | 38 | 4 | 11 | 18 | 25 | 32 | 39 | 5 | 12 | 19 | 26 | 33 | 40 | 6 | 13 | 20 | 27 | 34 | 41 | 42 | 43 |

| 44 |

# FIG. 361

256QAM 16k:

Pattern A:

BIT GROUP

| 0 | 1 | 2 | 3 | 4 | 5 | 6 | 7 | 8 | 9 | 10 | 11 | 12 | 13 | 14 | 15 | 16 | 17 | 18 | 19 | 20 | 21 |
|---|---|---|---|---|---|---|---|---|---|----|----|----|----|----|----|----|----|----|----|----|----|

| 22 | 23 | 24 | 25 | 26 | 27 | 28 | 29 | 30 | 31 | 32 | 33 | 34 | 35 | 36 | 37 | 38 | 39 | 40 | 41 | 42 | 43 |
|----|----|----|----|----|----|----|----|----|----|----|----|----|----|----|----|----|----|----|----|----|----|

| 44 |
|----|

⇩

Pattern B:

| 0 | 5 | 10 | 15 | 20 | 25 | 30 | 35 | 1 | 6 | 11 | 16 | 21 | 26 | 31 | 36 | 2 | 7 | 12 | 17 | 22 | 27 |
|---|---|----|----|----|----|----|----|---|---|----|----|----|----|----|----|---|---|----|----|----|----|

| 32 | 37 | 3 | 8 | 13 | 18 | 23 | 28 | 33 | 38 | 4 | 9 | 14 | 19 | 24 | 29 | 34 | 39 | 40 | 41 | 42 | 43 |
|----|----|---|---|----|----|----|----|----|----|---|---|----|----|----|----|----|----|----|----|----|----|

| 44 |
|----|

EP 3 247 043 A1

EP 3 247 043 A1

## FIG. 362

# FIG. 363

# FIG. 364

# FIG. 365

# FIG. 366

## FIG. 367

SIGNAL → **1101** OBTAINING UNIT → **1102** TRANSMISSION CHANNEL DECODING OPERATION UNIT → **1103** INFORMATION SOURCE DECODING OPERATION UNIT → **1111** OUTPUT UNIT

RECEPTION SYSTEM

## FIG. 368

SIGNAL → **1101** OBTAINING UNIT → **1102** TRANSMISSION CHANNEL DECODING OPERATION UNIT ⇢ **1103** INFORMATION SOURCE DECODING OPERATION UNIT ⇢ **1121** RECORDING UNIT

RECEPTION SYSTEM

FIG. 369

**INTERNATIONAL SEARCH REPORT**

| International application No. |
| --- |
| PCT/JP2016/050017 |

A. CLASSIFICATION OF SUBJECT MATTER
*H03M13/19*(2006.01)i, *H03M13/27*(2006.01)i

According to International Patent Classification (IPC) or to both national classification and IPC

B. FIELDS SEARCHED

Minimum documentation searched (classification system followed by classification symbols)
H03M13/19, H03M13/27

Documentation searched other than minimum documentation to the extent that such documents are included in the fields searched
| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)
CiNii, IEEE Xplore

C. DOCUMENTS CONSIDERED TO BE RELEVANT

| Category* | Citation of document, with indication, where appropriate, of the relevant passages | Relevant to claim No. |
| --- | --- | --- |
| A | WO 2012/157286 A1 (Panasonic Corp.), 22 November 2012 (22.11.2012), paragraphs [0082] to [0083]; fig. 24 & US 2014/0129895 A1 paragraphs [0148] to [0149]; fig. 24 & EP 2525496 A1 & CN 103636131 A | 1-4 |
| A | JP 2002-76915 A (Sony Corp.), 15 March 2002 (15.03.2002), paragraphs [0624] to [0628]; fig. 52 & US 2003/0088821 A1 paragraphs [0750] to [0754]; fig. 56 & WO 2002/019537 A1 & EP 1315299 A1 | 1-4 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 27 January 2016 (27.01.16) | 09 February 2016 (09.02.16) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

**INTERNATIONAL SEARCH REPORT**

| International application No. |
|---|
| PCT/JP2016/050017 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 10-163887 A  (Matsushita Electric Industrial Co., Ltd.), 19 June 1998 (19.06.1998), paragraphs [0015] to [0037]; fig. 1, 8 (Family: none) | 1-4 |
| A | Advanced Television Systems Committee, ATSC Digital Television Standard - Part 2: RF/Transmission System Characteristics [online], Internet:<URL:http://atsc.org/standards/atsc-standards/>, 2011.12.15, pp.11-18 | 1-4 |
| P,A | Advanced Television Systems Committee, ATSC Candidate Standard: Physical Layer Protocol [online], Internet:<URL:http://atsc.org/standards/candidate-standards/>, 2015.09.28, pp.35-40 | 1-4 |

Form PCT/ISA/210 (continuation of second sheet) (January 2015)

**EP 3 247 043 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4224777 B

**Non-patent literature cited in the description**

- **H. JIN ; A. KHANDEKAR ; R. J. MCELIECE.** Irregular Repeat-Accumulate Codes. *Proceedings of 2nd International Symposium on Turbo codes and Related Topics,* September 2000, 1-8

- **S.Y.CHUNG ; G.D.FORNEY ; T.J.RICHARDSON ; R.URBANKE.** On the Design of Low-Density Parity-Check Codes within 0.0045 dB of the Shannon Limit. *IEEE Communications Leggers,* February 2001, vol. 5 (2